(19) Europäisches Patentamt
European Patent Office
Office européen des brevets

(11) EP 4 198 164 A1

(12) **EUROPEAN PATENT APPLICATION**

(43) Date of publication:
**21.06.2023 Bulletin 2023/25**

(21) Application number: **22213777.0**

(22) Date of filing: **15.12.2022**

(51) International Patent Classification (IPC):
***C23C 14/24*** *(2006.01)* ***C23C 14/12*** *(2006.01)*
***H10K 71/16*** *(2023.01)* ***H10K 85/30*** *(2023.01)*
***H10K 50/12*** *(2023.01)*

(52) Cooperative Patent Classification (CPC):
**C23C 14/24; C23C 14/12; C23C 14/243; H10K 50/12; H10K 71/164; H10K 85/341; H10K 85/342; H10K 85/346**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **17.12.2021 KR 20210181735**

(71) Applicant: **Samsung Electronics Co., Ltd.
Gyeonggi-do 16677 (KR)**

(72) Inventors:
- **LEE, Sunghun
16678 Suwon-si (KR)**
- **KWAK, Seungyeon
16678 Suwon-si (KR)**
- **SIM, Myungsun
16678 Suwon-si (KR)**

(74) Representative: **Elkington and Fife LLP
Prospect House
8 Pembroke Road
Sevenoaks, Kent TN13 1XR (GB)**

(54) **MIXED LAYER, METHOD OF PREPARING THE MIXED LAYER, LIGHT-EMITTING DEVICE, AND ELECTRONIC APPARATUS**

(57) A mixed layer including: a matrix material; and a dopant composition, wherein the dopant composition is doped in the matrix material, the dopant composition comprises a first dopant and a second dopant, an amount by weight of the matrix material is greater than an amount by weight of the dopant composition in the mixed layer, the matrix material, the first dopant, and the second dopant are different from each other, the matrix material does not include a transition metal, the first dopant includes a transition metal, the mixed layer is a layer formed by deposition of the matrix material, the first dopant, and the second dopant, the mixed layer has a concentration profile of the dopant composition with respect to a thickness of the mixed layer, provided that $T_{m1} > T_p > T_{m1+2}$ is satisfied, wherein $T_{m1}$, $T_p$, and $T_{m1+2}$ are respectively as described herein.

FIG. 1

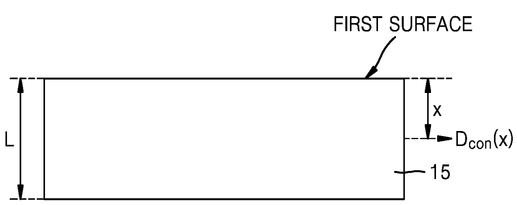


EP 4 198 164 A1

## Description

### FIELD OF THE INVENTION

The present disclosure relates to a mixed layer, a method of preparing the mixed layer, a light-emitting device including the mixed layer, and an electronic apparatus including the light-emitting device.

### BACKGROUND OF THE INVENTION

From among light-emitting devices, organic light-emitting devices (OLEDs) are self-emissive devices, which have improved characteristics in terms of viewing angles, response time, luminance, driving voltage, and response speed. In addition, OLEDs may produce full-color images.

In an example, an organic light-emitting device includes an anode, a cathode, and an organic layer arranged between the anode and the cathode, wherein the organic layer includes an emission layer. A hole transport region may be located between the anode and the emission layer, and an electron transport region may be located between the emission layer and the cathode. Holes provided from the anode move toward the emission layer through the hole transport region, and electrons provided from the cathode move toward the emission layer through the electron transport region. The holes and the electrons recombine in the emission layer to produce excitons. These excitons transition from an excited state to a ground state, thereby generating light.

### SUMMARY OF THE INVENTION

Provided are a mixed layer in which a first dopant and a second dopant are effectively doped at substantially the same time (e.g., at the same time) without thermal denaturation, a light-emitting device having excellent luminescence efficiency and/or a long lifespan by including the mixed layer, and an electronic apparatus including the light-emitting device. In addition, provided is a method of preparing a mixed layer, the method being capable of providing excellent process stability and reduction in manufacturing costs.

Additional aspects will be set forth in part in the detailed description which follows and, in part, will be apparent from the detailed description, or may be learned by practice of the exemplary embodiments of the detailed description.

According to an aspect, provided is a mixed layer including:

a matrix material; and
a dopant composition,
wherein the dopant composition is doped in the matrix material,
wherein the dopant composition comprises a first dopant and a second dopant,
an amount by weight of the matrix material in the mixed layer is greater than an amount by weight of the dopant composition in the mixed layer,
the matrix material, the first dopant, and the second dopant are different from each other,
the matrix material does not include a transition metal,
the first dopant includes a transition metal,
the mixed layer is a layer formed by deposition of the matrix material, the first dopant, and the second dopant,
the mixed layer has a concentration profile of the dopant composition with respect to a thickness of the mixed layer, provided that $T_{m1} > T_p > T_{m1+2}$ is satisfied,

wherein,

$T_{m1}$ is a melting point of the first dopant,
$T_p$ is a deposition temperature used in forming the mixed layer, and
$T_{m1+2}$ is:

a melting point of a pre-mixed composition of the first dopant and the second dopant wherein the pre-mixed composition is crystalline; and
a fusion temperature of the pre-mixed composition of the first dopant and the second dopant when the pre-mixed composition is amorphous,
wherein the pre-mixed composition includes the first dopant and the second dopant, and is not doped in the matrix material.

The mixed layer may be a layer formed by deposition of a vapor-state matrix material and a vapor-state dopant

composition, and the vapor-state dopant composition may be a mixture of a vapor-state first dopant and a vapor-state second dopant.

The second dopant may or may not include a transition metal.

The mixed layer may be an emission layer, and

i) each of the first dopant and the second dopant may be an emitter;
ii) the first dopant may be an emitter, and the second dopant may be a sensitizer; or
iii) the first dopant may be a sensitizer, and the second dopant may be an emitter.

The mixed layer may be an emission layer, and

i) each of the first dopant and the second dopant may emit red light;
ii) each of the first dopant and the second dopant may emit green light; or
iii) each of the first dopant and the second dopant may emit blue light.

According to another aspect, provided is a method of preparing the mixed layer as described above, the method including:
preparing:

a substrate,
a first deposition source comprising the first dopant and the second dopant,
a second deposition source comprising the matrix material, and
a vapor-state dopant composition provision unit configured to provide a vapor-state dopant composition from the first deposition source, wherein the vapor-state dopant composition comprises a vapor-state first dopant and a vapor-state second dopant;
preparing a deposition source moving unit on which the first deposition source and the second deposition source are arranged with a distance therebetween such that a region wherein the vapor-state dopant composition is present overlaps a region wherein a vapor-state matrix material is present, the vapor-state matrix material being released from the second deposition source;
arranging the deposition source moving unit at a first end below a surface of the substrate such that the substrate faces the deposition source moving unit; and
depositing the matrix material, the first dopant, and the second dopant on the surface of the substrate by:
performing a one-way process of moving the deposition source moving unit in a direction away from the first end below the surface of the substrate and toward a second end, or
performing, one or more times, a reciprocating process of moving the deposition source moving unit in a direction away from the first end below the surface of the substrate and toward a second end, and then immediately moving the deposition source moving unit in a direction away from the second end and toward the first end,
wherein the first deposition source includes a first region and a second region, wherein the first region comprises the first dopant and does not comprise the second dopant, and wherein the second region comprises the second dopant and does not comprise the first dopant, wherein the first dopant and the second dopant in the first deposition source are not mixed with each other.

The vapor-state dopant composition provision unit may include:

a first unit configured to form the vapor-state dopant composition; and
a second unit configured to discharge the vapor-state dopant composition from the first unit.

A deposition temperature of the depositing may be lower than a melting point of the first dopant, and

when a pre-mixed composition of the first dopant and the second dopant is crystalline, the deposition temperature of the depositing may be higher than a melting point of the pre-mixed composition, and
when the pre-mixed composition of the first dopant and the second dopant is amorphous, the deposition temperature of the depositing may be higher than a fusion temperature of the pre-mixed composition,
wherein the pre-mixed composition includes the first dopant and the second dopant, and is not doped in the matrix material.

According to still another aspect, provided is a light-emitting device including:

a first electrode;
a second electrode facing the first electrode; and
an interlayer located between the first electrode and the second electrode,
wherein the interlayer includes the mixed layer as described herein.

The mixed layer included in the light-emitting device may be an emission layer.

The interlayer may include:

m light-emitting units that include at least one emission layer; and
m-1 charge generation layers that are arranged between two neighboring light-emitting units of the m light-emitting units,
wherein m may be an integer of 2 or greater, and
at least one light-emitting unit of the m light-emitting units may include the mixed layer as described herein.

The mixed layer included in the light-emitting unit may be an emission layer.

At least one light-emitting unit of the m light-emitting units may emit green light, and at least one light-emitting unit of the remaining light-emitting units may emit blue light.

According to still another aspect, provided is an electronic apparatus including the light-emitting device.

BRIEF DESCRIPTION OF THE DRAWINGS

The above and other aspects, features, and advantages of certain exemplary embodiments of the disclosure will be more apparent from the following detailed description and when taken in conjunction with the accompanying drawings, in which:

FIG. 1 is a diagram schematically illustrating a mixed layer according to one or more embodiments;
FIGS. 2A to 2G are diagrams sequentially illustrating a method of preparing a mixed layer, according to one or more embodiments;
FIG. 3 is a diagram illustrating one or more embodiments of a first deposition source and a vapor-state dopant composition provision unit;
FIG 4 is a graph of concentration of dopant composition (weight percent wt%) versus thickness of the mixed layer (x, nanometers (nm)), and is a diagram illustrating one or more embodiments of a concentration profile of a dopant composition for each thickness of a mixed layer, wherein the regions indicated beneath the x-axis by 151, 153, 155, 157, and 159 correspond to those regions as labelled in FIGS. 2A to 2G;
FIGS. 5 to 9 are graphs of concentration of dopant composition (weight percent wt%) versus thickness of the mixed layer (x, nanometers (nm)), and are each a diagram illustrating one or more embodiments of a concentration profile of a dopant composition for each thickness of a mixed layer;
FIG. 10 is a graph of concentration of dopant composition (wt%) versus thickness of a layer (x, nm), and shows a diagram illustrating a comparative concentration profile of a first dopant and a concentration profile of a second dopant for each thickness of a layer B, which is formed by using each of a deposition source B1 loaded with the first dopant and a deposition source B2 loaded with the second dopant, instead of a first deposition source loaded with the first dopant and the second dopant;
FIG. 11 is a diagram schematically illustrating a light-emitting device according to one or more embodiments; and
FIG. 12 is a diagram schematically illustrating a light-emitting device according to one or more embodiments.

DETAILED DESCRIPTION OF THE EMBODIMENTS

Reference will now be made in further detail to exemplary embodiments, examples of which are illustrated in the accompanying drawings, wherein like reference numerals refer to like elements throughout. In this regard, the present exemplary embodiments may have different forms and should not be construed as being limited to the detailed descriptions set forth herein. Accordingly, the exemplary embodiments are described in further detail below, and by referring to the figures, to explain certain aspects. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the

presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

Hereinafter, a work function or a highest occupied molecular orbital (HOMO) energy level is expressed as an absolute value from a vacuum level. In addition, when the work function or the HOMO energy level is referred to be "deep," "high" or "large," the work function or the HOMO energy level has a large absolute value based on "0 electron Volts (eV)" of the vacuum level, while when the work function or the HOMO energy level is referred to be "shallow," "low," or "small," the work function or HOMO energy level has a small absolute value based on "0 eV" of the vacuum level.

Description of FIGS. 1, 2A to 2G, and 3 to 10

A mixed layer 15 in FIG. 1 includes a matrix material and a dopant composition.

The dopant composition is doped in the matrix material.

The dopant composition includes (e.g., may be a mixture of) a first dopant and a second dopant. The dopant composition may further include materials other than the first dopant and the second dopant.

An amount by weight of the matrix material in the mixed layer may be greater than an amount by weight of the dopant composition in the mixed layer.

For example, a weight ratio of the matrix material to the dopant composition may be in a range of about 60:40 to about 99:1, about 70:30 to about 99:1, about 80:20 to about 99:1, about 60:40 to about 95:5, about 70:30 to about 95:5, or about 80:20 to about 95: 5.

The matrix material, the first dopant, and the second dopant are different from each other.

The matrix material does not include a transition metal.

For example, the matrix material may include a hole-transporting compound, an electron-transporting compound, a bipolar compound, or a combination thereof.

In one or more embodiments, the matrix material may not be an organometallic compound including a transition metal and at least one ligand bonded to the transition metal.

In one or more embodiments, the matrix material may be a mixture of a hole-transporting compound and an electron-transporting compound.

The first dopant includes a transition metal (for example, one transition metal).

For example, the first dopant may be an organometallic compound including a transition metal and at least one ligand bonded to the transition metal.

The first dopant may be electrically neutral, or have a net zero charge.

In one or more embodiments, the first dopant may include iridium or platinum.

The second dopant may or may not include a transition metal.

Each of the matrix material, the first dopant, and the second dopant will be described in further detail herein.

The mixed layer 15 may be a layer formed by deposition of the matrix material, the first dopant, and the second dopant. The deposition may be co-deposition in which the matrix material, the first dopant, and the second dopant are vaporized at substantially the same time (e.g., at the same time) and deposited on a surface of a substrate including a region in which the mixed layer 15 is to be formed. The deposition may be vacuum deposition performed under a substantially vacuum atmosphere.

x in $D_{con}(x)$ in FIG. 1 is a real number and a variable satisfying $0 \leq x \leq L$, L in FIG. 1 indicates a thickness (constant) of the mixed layer 15, and $D_{con}(x)$ in FIG. 1 indicates a "concentration of the dopant composition" at a position spaced apart by x from a first surface of the mixed layer 15 toward inside of the mixed layer 15, wherein $D_{con}(x)$ indicates a weight of the dopant composition in wt% based on 100 wt% of the total weight of the matrix material and the dopant composition at the position spaced apart by x from the first surface of the mixed layer 15 toward the inside of the mixed layer 15. For example, $D_{con}(x)$ may be in a range of about 1 wt% to about 40 wt%, about 3 wt% to about 30 wt%, or about 5 wt% to about 20 wt%.

The unit of x may be any arbitrary unit. For example, the unit of x may be nanometers (nm).

$D_{con}(x)$ may be evaluated through material analysis for each thickness of the mixed layer 15. For example, $D_{con}(x)$ may be evaluated using Orbitrap mass spectrometry and/or secondary ion mass spectrometry (SIMS). $D_{con}(x)$ may be expressed as a function of the thickness of the mixed layer 15 (the variable represented by x). Accordingly, the mixed layer 15 may have a concentration profile of the dopant composition with respect to the thickness of the mixed layer 15. The concentration profile of the dopant composition in the mixed layer 15 may be discontinuous or continuous.

FIGS. 2A to 2G sequentially illustrate one or more embodiments of a method of forming the mixed layer 15 on a surface of a substrate 12, and FIG. 3 illustrates one or more embodiments of a first deposition source 300 and a vapor-state dopant composition provision unit 320.

First, a) the substrate 12 on which the mixed layer 15 is to be formed, b) the first deposition source 300 includes (e.g., is loaded with) the first dopant and the second dopant, c) a second deposition source 400 includes (e.g., is loaded with) the matrix material, and d) the vapor-state dopant composition provision unit 320 (not shown in FIGS. 2A to 2G) for providing a vapor-state dopant composition, which is a composition of a vapor-state first dopant and a vapor-state second dopant released from the first deposition source, are prepared.

The substrate 12 may vary according to the use of the mixed layer 15. For example, when the mixed layer 15 is an emission layer of a light-emitting device, the substrate 12 may be a hole transport region formed on a first electrode.

The first deposition source 300 includes a first region and a second region, the first region includes the first dopant and does not include the second dopant, and the second region includes the second dopant and does not include the first dopant, so that the first dopant and the second dopant loaded in the first deposition source 300 are not mixed with each other. For example, the first dopant and the second dopant loaded in the first deposition source 300 are not in contact with each other. In one or more embodiments, the first dopant and the second dopant are loaded in the first deposition source 300 and do not form a pre-mixed composition (e.g., mixture) of the first dopant and the second dopant. The first deposition source 300 may further include materials other than the first dopant and the second dopant.

For example, a solid-state block-type first dopant and a solid-state block-type second dopant obtained by pressing the first dopant and the second dopant, respectively and separately, and may be spaced apart from each other and loaded into the first deposition source 300.

In one or more embodiments, the first deposition source 300 may further include a separation unit for separating the first region and the second region. For example, the separation unit may include a blocking plate for separating the first region and the second region, individual pockets for accommodating the first dopant and the second dopant, respectively, and the like.

The second deposition source 400 is loaded with the matrix material as described herein. When the matrix material includes two or more different materials, a pre-mixed composition of the different materials may be loaded in the second deposition source 400.

The vapor-state dopant composition provision unit 320 may be installed in combination with the first deposition source 300.

FIG. 3 is a diagram schematically illustrating one or more embodiments of the first deposition source 300 and the vapor-state dopant composition provision unit 320.

The first deposition source 300 in FIG. 3 includes a tray 301 for accommodating a first dopant 311 and a second dopant 312. The tray 301 includes a first region 311R including only the first dopant 311, a second region 312R including only the second dopant 312, and a separation unit 315 (for example, a blocking plate) for dividing the first region 311R and the second region 312R. The first region 311R includes only the first dopant 311, and the second region 312R includes only the second dopant 312, so that the first dopant 311 and the second dopant 312 are not mixed with each

other. In FIG. 3, instead of arranging the separation unit 315, the first dopant 311 that is solidified and the second dopant 312 that is solidified may be arranged to be spaced apart from each other.

The vapor-state dopant composition provision unit 320 includes a first unit 321 for forming a vapor-state dopant composition 319 and a second unit 322 for discharging the vapor-state dopant composition 319 from the first unit 321.

When the first deposition source 300 is turned on, a vapor-state first dopant 311V and a vapor-state second dopant 312V may be released from the first deposition source 300 to be accommodated and mixed in a space formed by the first unit 321, thereby forming the vapor-state dopant composition 319 which is a composition comprising the vapor-state first dopant 311V and the vapor-state second dopant 312V. The first unit 321 may be, for example, an inner plate as shown in FIG. 3, and by increasing internal pressure of the space formed by the first unit 321, the vapor-state first dopant 311V and the vapor-state second dopant 312V may be mixed to form the vapor-state dopant composition 319. The vapor-state dopant composition 319 may be discharged from the first unit 321 through the second unit 322 and used in a deposition process to be described below. The second unit 322 may be, for example, a nozzle or the like.

The term "pre-mixed composition of a material A and a material B" as used herein refers to a composition or mixture formed by pre-mixing the material A and the material B before forming a layer including the material A and the material B, and each of the material A and the material B may be in a solid state or a liquid state. For example, the pre-mixed composition may be prepared by a physical mixing method in which the material A and the material B are physically mixed, a sublimation mixing method in which the material A and the material B are sublimated in a sublimation purifier and then solidified, or the like.

Accordingly, the "pre-mixed composition of the first dopant and the second dopant" refers to a composition that is formed by pre-mixing the first dopant and the second dopant before forming the mixed layer 15, and thus is clearly distinguished from the "composition comprising the first dopant and the second dopant" in the mixed layer, which is a dopant composition doped in the mixed layer 15 through a deposition process. In other words, the pre-mixed composition includes the first dopant and the second dopant, and is not doped in the matrix material.

Next, a deposition source moving unit 350 on which the first deposition source 300 and the second deposition source 400 are arranged with a distance therebetween such that a deposition region C1 in which the vapor-state dopant composition 319 is present overlaps a deposition region C2 in which a vapor-state matrix material is present, the vapor-state matrix material being released from the second deposition source 400, is prepared. Here, an angle limiting plate 300A capable of defining each of the deposition region C1 in which the vapor-state dopant composition 319 is present and the deposition region C2 in which the vapor-state matrix material is present may be arranged at both sides of each of the first deposition source 300 and the second deposition source 400 (for convenience, illustration of the angle limiting plate 300A is omitted in FIGS. 2B to 2G). By adjusting the degree of overlap between the deposition region C1 in which the vapor-state dopant composition 319 is present and the deposition region C2 in which the vapor-state matrix material is present, the interval between the first deposition source 300 and the second deposition source 400, the arrangement order of the first deposition source 300 and the second deposition source 400, the amount of material released per hour from the first deposition source 300 and the second deposition source 400, the movement speed of the deposition source moving unit 350, the height and spacing of the angle limiting plate 300A, the number of reciprocations of the deposition source moving unit 350, the type of movement of the deposition source moving unit 350 (for example, one-way or reciprocal), or the like, the concentration profile of the dopant composition in the mixed layer 15 may be controlled (for example, see FIGS. 4 to 9).

Next, as shown in FIG. 2A, the deposition source moving unit 350 is arranged at a first end A below a surface of the substrate 12 such that the substrate 12 faces the deposition source moving unit 350. The deposition region C1 in which the vapor-state dopant composition 319 is present and the deposition region C2 in which the vapor-state matrix material is present may each have, as shown in FIG. 2A, a sectoral shape with a certain angle.

The first deposition source 300 and the second deposition source 400 may be arranged on the deposition source moving unit 350, and the deposition source moving unit 350 may be installed to reciprocate along a guide rail 340 arranged in a chamber. To this end, the deposition source moving unit 350 may be connected to a separate driving unit (not shown) to be driven.

As shown in FIG. 2A, in a state in which the first deposition source 300 and the second deposition source 400 are turned on or activated, the deposition source moving unit 350 on which the first deposition source 300 and the second deposition source 400 are arranged with a certain distance therebetween as described above may move in a direction B away from the first end A below the surface of the substrate 12 and toward a second end E. In this case, a region 151 in which the concentration of the dopant composition (that is, $D_{con}(x)$) is $N_2$ is mainly deposited on the surface of the substrate 12, so that the region 151 in which the concentration of the dopant composition is $N_2$ begins to form. The region 151 is formed to continuously extend as the deposition source moving unit 350 is moved in the direction B away from the first end A toward the second end E. As used herein, "$N_1$" indicates a minimum value of the dopant composition concentration in the mixed layer, and "$N_2$" indicates a maximum value of the dopant composition concentration in the mixed layer.

Then, as shown in FIG. 2B, when the deposition source moving unit 350 on which the first deposition source

300 and the second deposition source 400 are arranged continues to move in the direction B away from the first end A and toward the second end E, a region 153 (see "D2" in FIG. 2B) in which $D_{con}(x)$ gradually decreases begins to form under the region 151. The region 153 is formed to continuously extend as the deposition source moving unit 350 is moved in the direction B away from the first end A and toward the second end E.

Next, as shown in FIG. 2C, when the deposition source moving unit 350 on which the first deposition source 300 and the second deposition source 400 are arranged continues to move in the direction B away from the first end A and toward the second end E, a region 155' (see "D3" in FIG. 2C) in which $D_{con}(x)$ is $N_1$ begins to form under the region 153.

Then, when the deposition source moving unit 350 on which the first deposition source 300 and the second deposition source 400 are arranged is moved in the direction B away from the first end A and toward the second end E, and arrives at the second end E below the substrate 12, as shown in FIG. 2D, the region 151 in which $D_{con}(x)$ is $N_2$, the region 153 in which $D_{con}(x)$ gradually decreases, and the region 155' in which $D_{con}(x)$ is $N_1$ may be sequentially formed on the surface of the substrate 12.

Immediately afterwards, as shown in FIG. 2E, the direction of movement of the deposition source moving unit 350 that has arrived at the second end E below the substrate 12 is changed into a direction F away from the second end E and toward the first end A, and the deposition source moving unit 350 is moved. In this case, as shown in FIG. 2E, a region 155" in which $D_{con}(x)$ is $N_1$ begins to form.

Next, when the deposition source moving unit 350 is moved in the direction F away from the second end E and toward the first end A, as shown in FIG. 2F, a region 157 in which $D_{con}(x)$ gradually increases and a region 159 in which $D_{con}(x)$ is $N_2$ may be sequentially formed. In this case, since a surface of the region 155' and a surface of the region 155" are in direct contact with each other, and the region 155' and the region 155" have substantially the same (e.g., have the same) components as each other and are formed in one chamber, an interface S' between the region 155' and the region 155" may be substantially indistinct, and thus, the region 155' and the region 155" may be combined and represented as a region 155 in which $D_{con}(x)$ is $N_1$.

Then, as the deposition source moving unit 350 including the first deposition source 300 and the second deposition source 400 arrives at the first end A below the surface of the substrate 12, as shown in FIG. 2G, the region 151 where $D_{con}(x)$ is $N_2$, the region 153 where $D_{con}(x)$ gradually decreases, the region 155 where $D_{con}(x)$ is $N_1$, the region 157 where $D_{con}(x)$ gradually increases, and the region 159 where $D_{con}(x)$ is $N_2$ may be sequentially formed on the surface of the substrate 12.

As described with reference to FIGS. 2A to 2G, by performing, "one time", a reciprocating process of moving the deposition source moving unit 350 in the direction B away from the first end A below the surface of the substrate 12 and toward the second end E, and then immediately moving the deposition source moving unit 350 in the direction F away from the second end E and toward the first end A, as shown in FIG. 4, the mixed layer 15 having a dopant composition concentration profile may be formed.

FIG. 4 is a diagram illustrating one or more embodiments of the concentration profile of the dopant composition showing the concentration of the dopant composition (y-axis) for each thickness of the mixed layer 15 (x-axis) that is formed by performing the above-described reciprocating process "one time". L in FIG. 4 indicates a thickness of the mixed layer 15 as shown in FIG. 1, where x corresponds to a distance in nanometers (nm) extending from the first surface of the substrate. In FIG. 4, the regions indicated beneath the x-axis by 151, 153, 155, 157, and 159 correspond to those regions as labelled in FIGS. 2A to 2G. In FIG. 4, $X_{31}$, $X_{32}$, $X_{33}$, and $X_{34}$ may each be a real number satisfying $0 < X_{31} < X_{32} < X_{33} < X_{34} < L$, $D_{con}(x)$ (that is, the concentration of the dopant composition) with respect to x satisfying $0 \leq x \leq X_{31}$ may be $N_2$, $D_{con}(x)$ with respect to x satisfying $X_{31} < x < X_{32}$ may gradually decrease, $D_{con}(x)$ with respect to x satisfying $X_{32} \leq x \leq X_{33}$ may be $N_1$, $D_{con}(x)$ with respect to x satisfying $X_{33} < x < X_{34}$ may gradually increase, and $D_{con}(x)$ with respect to x satisfying $X_{34} \leq x \leq L$ may be $N_2$. x, L, and $D_{con}(x)$ are respectively the same as those described in the present specification, $N_1$ indicates a minimum value of the dopant composition concentration in the mixed layer 15, and $N_2$ indicates a maximum value of the dopant composition concentration in the mixed layer 15. For example, $N_2$ may be in a range of about 20 weight percent (wt%) to about 40 wt%, and $N_1$ may be in a range of about 1 wt% to about 5 wt%, based on a total weight of the mixed layer.

The mixed layer 15 may be formed, for example, by a deposition process in which the reciprocating process of the deposition source moving unit 350 described with reference to FIGS. 2A to 2G is performed one or more times.

For example, FIG. 5 is a diagram illustrating the dopant composition concentration profile in the mixed layer 15 that is formed by performing, "two consecutive times", the reciprocating process of the deposition source moving unit 350 described with reference to FIGS. 2A to 2G. L in FIG. 5 indicates a thickness of the mixed layer 15 as shown in FIG. 1, where x corresponds to a distance in nanometers (nm) extending from the first surface of the substrate. It may be confirmed that the dopant composition concentration profile of FIG. 5 is obtained by extending the dopant composition concentration profile of FIG. 4 according to the thickness of the mixed layer 15.

As described above, the mixed layer 15 is a layer formed by deposition of the vapor-state matrix material and the vapor-state dopant composition 319. The vapor-state dopant composition 319 is a mixture of a vapor-state first dopant and a vapor-state second dopant. Thus, for example, as shown in FIGS. 4 and 5, the mixed layer 15 may have

the concentration profile of the dopant composition (the composition or mixture of the first dopant and the second dopant) with respect to the thickness of the mixed layer 15.

FIG. 6 is a diagram illustrating another embodiment of the concentration profile of the dopant composition showing the concentration of the dopant composition (y-axis) for each thickness of the mixed layer 15 (x-axis) and is a concentration profile showing that the concentration of the dopant composition gradually decreases and increases according to the thickness of the mixed layer 15. L in FIG. 6 indicates a thickness of the mixed layer 15 as shown in FIG. 1, where x corresponds to a distance in nanometers (nm) extending from the first surface of the substrate.

FIG. 7 is a diagram illustrating the dopant composition concentration profile in the mixed layer 15 that is formed by performing, "two consecutive times", the reciprocating process of the deposition source moving unit 350 which may provide the concentration profile of the dopant composition of FIG. 6. L in FIG. 7 indicates a thickness of the mixed layer 15 as shown in FIG. 1, where x corresponds to a distance in nanometers (nm) extending from the first surface of the substrate. It may be confirmed that the dopant composition concentration profile of FIG. 7 is obtained by extending the dopant composition concentration profile of FIG. 6 according to the thickness of the mixed layer 15.

Meanwhile, the mixed layer 15 may be formed by one-way movement of the deposition source moving unit 350 as shown in FIGS. 2A to 2D, rather than the reciprocating movement of the deposition source moving unit 350 as shown in FIGS. 2A to 2G. As a result, for example, one or more embodiments of the concentration profile of the dopant composition as shown in FIGS. 8 and 9 may be realized.

FIG. 8 is a diagram illustrating another embodiment of the concentration profile of the dopant composition showing the concentration of the dopant composition (y-axis) for each thickness of the mixed layer 15 (x-axis), and is a concentration profile showing that the concentration of the dopant composition monotonically decreases according to the thickness of the mixed layer 15. L in FIG. 8 indicates a thickness of the mixed layer 15 as shown in FIG. 1, where x corresponds to a distance in nanometers (nm) extending from the first surface of the substrate. FIG. 9 is a diagram illustrating another embodiment of the concentration profile of the dopant composition showing the concentration of the dopant composition (y-axis) for each thickness of the mixed layer 15 (x-axis), and is a concentration profile showing that the concentration of the dopant composition monotonically increases according to the thickness of the mixed layer 15. L in FIG. 9 indicates a thickness of the mixed layer 15 as shown in FIG. 1, where x corresponds to a distance in nanometers (nm) extending from the first surface of the substrate.

The wording "concentration profile of the dopant composition" as used herein is a wording used for representing that a concentration profile of the first dopant with respect to the thickness of the mixed layer 15 and a concentration profile of the second dopant with respect to the thickness of the mixed layer 15 are substantially the same (e.g., are the same) at each thickness, and thus are not distinguished from each other based on the thickness of the mixed layer.

For comparison, FIG. 10 illustrates the concentration profiles of the first dopant and the second dopant with respect to a thickness of a layer B that is formed by using each of a deposition source B1 loaded with the first dopant and a deposition source B2 loaded with the second dopant, instead of the first deposition source 300 loaded with the first dopant and the second dopant, and by performing, "two consecutive times", the reciprocating process of the deposition source moving unit 350 described with reference to FIGS. 2A to 2G. In FIG. 10, x and L are respectively the same as those described in the present specification, $N_{11}$ indicates a minimum value of the first dopant concentration in the layer B, $N_{12}$ indicates a maximum value of the first dopant concentration in the layer B, $N_{21}$ indicates a minimum value of the second dopant concentration in the layer B, and $N_{22}$ indicates a maximum value of the second dopant concentration in the layer B.

In FIG. 10, which shows the comparative process, since each of the deposition source B1 and the deposition source B2 are used, the layer B has each of a concentration profile of the first dopant with respect to the thickness of the layer B and a concentration profile of the second dopant with respect to the thickness of the layer B, and the two concentration profiles are clearly distinguished from each other. Accordingly, the layer B does not have the "concentration profile of the dopant composition" as defined in the present specification because the concentration of the first dopant with respect to the thickness of the mixed layer and the concentration of the second dopant with respect to the thickness of the mixed layer are not substantially the same, or are not the same. In the layer B, the concentrations of the first dopant and the second dopant may be different at a specific thickness x (nm), and thus, effects that may be obtained by doping the first dopant and the second dopant in the matrix material at substantially the same time (e.g., at the same time) may not be fully realized, or may not be substantially realized.

However, in the mixed layer 15, the concentrations of the first dopant and the second dopant may be substantially the same (e.g., the same) in all thickness x (nm) ranges satisfying $0 \leq x \leq L$, and thus, the effects that may be obtained by doping the first dopant and the second dopant in the matrix material at substantially the same time (e.g. at the same time) may be fully realized.

Meanwhile, the mixed layer 15 satisfies the relationship where $T_{m1} > T_p > T_{m1+2}$.

Here, $T_{m1}$ is a melting point of the first dopant,

$T_p$ is a deposition temperature used in forming the mixed layer 15, and

$T_{m1+2}$ is:

a melting point of a pre-mixed composition of the first dopant and the second dopant, wherein the pre-mixed composition is crystalline, and

a fusion temperature of a pre-mixed composition of the first dopant and the second dopant, wherein the pre-mixed composition is amorphous. As used herein, "fusion temperature" refers to a temperature wherein a volume of the pre-mixed composition changes.

In the present specification, a melting point and a fusion temperature may be evaluated according to a known method. For example, the melting point and the fusion temperature may be evaluated by performing differential scanning calorimeter (DSC) analysis on the pre-mixed composition, or using a melting point apparatus.

In addition, a deposition temperature of the depositing process in the formation of the mixed layer 15 illustrated in FIGS. 2A to 2G may be lower than a melting point of the first dopant, and i) when a pre-mixed composition of the first dopant and the second dopant is crystalline, the deposition temperature of the depositing process may be greater than a melting point of the pre-mixed composition, and, ii) when the pre-mixed composition of the first dopant and the second dopant is amorphous, the deposition temperature of the depositing process may be greater than a fusion temperature of the pre-mixed composition.

When the first dopant including the transition metal is sublimed after melting, thermal denaturation such as separation of the transition metal and the ligand included in the first dopant may occur. However, since the mixed layer 15 satisfies $T_{m1} > T_p$, the first dopant including the transition metal is sublimated before melting and used for deposition, and thus, the first dopant may be doped in the mixed layer 15 without thermal denaturation.

In addition, as illustrated in FIG. 3, the tray 301 includes the first region 311R including only the first dopant 311 and the second region 312R including only the second dopant 312, respectively, and is formed by using the first deposition source 300 in which the first dopant 311 and the second dopant 312 are not pre-mixed with each other, and thus, the condition of $T_p > T_{m1+2}$ may be selected. Accordingly, the mixed layer 15 may be formed at a relatively high deposition temperature, and thus, process stability may be significantly improved when the mixed layer 15 is manufactured. Also, since deposition may be performed quickly at a relatively high deposition temperature, it is possible to increase productivity by reducing a tact time, thereby reducing manufacturing costs.

In the case where, to solve the issue that the concentration profile of the first dopant and the concentration profile of the second dopant separately exist (see FIG. 10 and the description of FIG. 10 above), a layer A is formed by using a deposition source A including the pre-mixed composition of the first dopant and the second dopant, instead of the first deposition source 300 that includes both the first region 311R including only the first dopant 311 and the second region 312R including only the second dopant 312 such that the first dopant 311 and the second dopant 312 are not mixed with each other, it is necessary to select the condition of $T_{m1+2} > T_p$. As described above, when the first dopant including a transition metal is sublimed after melting, thermal denaturation such as separation of the transition metal and the ligand included in the first dopant may occur. Thus, to prevent thermal denaturation of the first dopant during deposition, it is necessary to select the condition of $T_{m1+2} > T_p$ when the layer A is deposited using the deposition source A (see the device characteristics of the light-emitting devices including the layer A deposited under the condition of $T_p > T_{m1+2}$ in Evaluation Examples described below). Here, the pre-mixed composition of the first dopant and the second dopant i) may be changed into an amorphous state during pre-mixing, or ii) may have a melting point ($T_{m1+2}$) that is significantly lower than the melting point ($T_{m1}$) of the first dopant and the melting point ($T_{m2}$) of the second dopant. Accordingly, when the deposition source A is used, it is necessary to select a relatively low deposition temperature ($T_p$). However, when a deposition process is performed at a relatively low deposition temperature, the tact time may be lengthened, and thus, the process stability may be impaired, and the manufacturing costs may increase.

To summarize the above,

1) since the mixed layer 15 has a concentration profile of a dopant composition (a mixture of a first dopant and a second dopant) with respect to a thickness of the mixed layer 15, non-uniformity between a concentration of the first dopant and a concentration of the second dopant for each thickness of the mixed layer 15 may be prevented, and thus, effects that may be obtained by doping the first dopant and the second dopant in a matrix material at substantially the same time (e.g., at the same time) may be fully realized, and

2) since the mixed layer 15 satisfies the condition of $T_{m1} > T_p > T_{m1+2}$ as described above, in a deposition process for forming the mixed layer 15, i) thermal denaturation of the first dopant including a transition metal may be prevented, and thus, the mixed layer 15 having higher quality may be manufactured, and ii) a tact time for forming the mixed layer 15 may be relatively short, and thus, process stability may be improved, and manufacturing costs may be reduced.

In one or more embodiments, the second dopant in the mixed layer 15 may include a transition metal (for

example, one transition metal).

For example, the second dopant may be an organometallic compound including a transition metal and at least one ligand bonded to the transition metal.

The second dopant may be neutral or have net neutral charge.

In one or more embodiments, the second dopant may include iridium or platinum.

In one or more embodiments, the second dopant may include a transition metal, and the mixed layer may satisfy $T_{m2} > T_p$. Here, $T_p$ is the same as described in the present specification, and $T_{m2}$ indicates the melting point of the second dopant. Accordingly, since the second dopant including the transition metal is sublimated before melting and used for deposition, the second dopant may be doped in the mixed layer 15 without thermal denaturation.

In one or more embodiments, the second dopant may not include a transition metal. For example, the second dopant may be a fluorescent material. In one or more embodiments, the second dopant may be a compound including a cyclic group including a boron atom and a nitrogen atom as ring forming atoms.

In one or more embodiments, the mixed layer 15 may be an emission layer, and depending on the highest occupied molecular orbital (HOMO) energy level, the lowest unoccupied molecular orbital (LUMO) energy level, the triplet ($T_1$) energy level, the singlet ($S_1$) energy level, and the like between the matrix material, the first dopant, and the second dopant included in the mixed layer 15,

each of the first dopant and the second dopant may be an emitter;
the first dopant may be an emitter, and the second dopant may be a sensitizer; or
the first dopant may be a sensitizer, and the second dopant may be an emitter.

In one or more embodiments, the mixed layer 15 may be an emission layer, and

each of the first dopant and the second dopant may emit red light;
each of the first dopant and the second dopant may emit green light; or
each of the first dopant and the second dopant may emit blue light.

The mixed layer 15 may be used in various electronic devices, for example, light-emitting devices (for example, organic light-emitting devices). Thus, according to another aspect, provided is a light-emitting device including a first electrode, a second electrode facing the first electrode, and an interlayer arranged between the first electrode and the second electrode, wherein the interlayer includes the mixed layer 15.

In one or more embodiments, the interlayer may include an emission layer, and the emission layer may be the mixed layer 15.

In one or more embodiments, the interlayer may include a hole transport region arranged between the first electrode and the emission layer and an electron transport region arranged between the emission layer and the second electrode.

Meanwhile, the interlayer may include:

m light-emitting units that include at least one emission layer; and
m-1 charge generation layers that are arranged between two neighboring light-emitting units of the m light-emitting units,
wherein m may be an integer of 2 or more. For example, m may be 2, 3, 4, 5, 6, 7, 8, 9, or 10. In one or more embodiments, m may be 2, 3, 4, 5, 6, or 7.

That is, the light-emitting device may be a tandem light-emitting device.

In one or more embodiments, at least one light-emitting unit of the light-emitting units in the number of m may include the mixed layer 15 as described herein. For example, the mixed layer 15 included in the light-emitting unit may be an emission layer.

In one or more embodiments, at least one light-emitting unit of the light-emitting units in the number of m may emit green light.

In one or more embodiments, at least one light-emitting unit of the light-emitting units in the number of m may include the mixed layer 15 as described herein, the mixed layer 15 may be an emission layer, and the emission layer may emit green light.

In one or more embodiments, at least one light-emitting unit of the light-emitting units in the number of m may include the mixed layer 15 as described herein, and the light-emitting unit including the mixed layer 15 may emit green light.

In one or more embodiments, at least one light-emitting unit of the light-emitting units in the number of m may emit green light, and at least one light-emitting unit of the remaining light-emitting units may emit blue light.

According to another aspect, the light-emitting device may be included in an electronic apparatus. Thus, an

electronic apparatus including the light-emitting device is provided. The electronic apparatus may include, for example, a display, an illumination, a sensor, and the like.

Description of first dopant and second dopant

Hereinafter, a first dopant and a second dopant will be described in detail.

The first dopant may be a first compound, and the second dopant may be a second compound. Accordingly, the term "composition of the first compound and the second compound" as used herein refers to a "composition of the first dopant and the second dopant".

The first compound may emit first light having a first spectrum and λP(1) is the emission peak wavelength (nm) in the first spectrum, and the second compound may emit second light having a second spectrum and λP(2) is the emission peak wavelength (nm) in the second spectrum, wherein the absolute value of the difference between λP(1) and λP(2) may be in a range of about 0 nm to about 30 nm, about 0 nm to about 25 nm, about 0 nm to about 20 nm, about 0 nm to about 15 nm, or about 0 nm to about 10 nm, and λP(1) and λP(2) may each be in a range of about 500 nm to about 570 nm or about 500 nm to about 550 nm. In one or more embodiments, λP(1) and λP(2) may each be in a range of about 500 nm to about 540 nm or about 510 nm to about 540 nm.

λP(1) and λP(2) may be evaluated from the photoluminescence (PL) spectra measured with respect to a first film and a second film, respectively.

The term "first film" as used herein refers to a film including the first compound, and the term "second film" as used herein refers to a film including the second compound. The first film and the second film may be manufactured using various methods, such as a vacuum deposition method, a coating method, and a heating method. The first film and the second film may further include a compound, for example, a host described herein, other than the first compound and the second compound.

In one or more embodiments, the first compound and the second compound may each independently be an emitter.

In one or more embodiments, the first compound and the second compound may each be an emitter, and λP(1) and λP(2) may each be in a range of about 510 nm to about 540 nm.

In one or more embodiments, the first compound may be an emitter, and the second compound may be a sensitizer.

In one or more embodiments, the first compound may be a sensitizer, and the second compound may be an emitter.

In one or more embodiments, the first compound may be a sensitizer, the second compound may be an emitter, λP(1) may be in a range of about 500 nm to about 520 nm, and λP(2) may be in a range of about 510 nm to about 540 nm.

In one or more embodiments, the first compound and the second compound may each independently be a phosphorescent compound.

The phosphorescent compound may be an organometallic compound including a transition metal (for example, iridium, platinum, osmium, or the like), and may be electrically neutral.

For example, the phosphorescent compound may be a platinum-containing organometallic compound or an iridium-containing organometallic compound. In one or more embodiments, the platinum-containing organometallic compound may be a platinum-containing organometallic compound including platinum and a tetradentate ligand bonded to the platinum. For example, the tetradentate ligand may include carbon and oxygen (or, sulfur), and the platinum-containing organometallic compound may include a) a chemical bond between the carbon of the tetradentate ligand and the platinum and b) a chemical bond between the oxygen (or, sulfur) of the tetradentate ligand and the platinum.

In one or more embodiments, the first compound may be a phosphorescent compound, and the second compound may be a fluorescent compound.

The fluorescent compound may be a thermally activated delayed fluorescence compound or a prompt fluorescent compound.

The first compound and the second compound may each independently satisfy Condition 1 or Condition 2:

Condition 1
The first compound is a platinum-containing organometallic compound including platinum and a tetradentate ligand bonded to the platinum, and
the second compound is an iridium-containing organometallic compound.

Condition 2
Each of the first compound and the second compound is an iridium-containing organometallic compound.

In one or more embodiments, the first compound and the second compound may satisfy Condition 1,

μ(Pt) may be in a range of about 0.5 debye to about 5.0 debye,
μ(Pt) may be smaller than μ(Ir),
wherein μ(Pt) is a dipole moment of the first compound,
wherein μ(Ir) is a dipole moment of the second compound, and
each of μ(Pt) and μ(Ir) may be calculated based on density functional (DFT) theory. Any various programs may be used for the quantum mechanical calculation based on the DFT, and for example, a Gaussian 16 program may be used.

In the case of a composition of the first compound and the second compound that satisfy Condition 1, aggregation among molecules of the first compound in the composition, aggregation among molecules of the second compound in the composition, and/or aggregation among molecules of the first compound and molecules of the second compound in the composition may be substantially minimized. Accordingly, without any consideration about intermolecular aggregation, the amounts (for example, weight) of the first compound and the second compound in the composition may be relatively increased. Accordingly, the mixed layer 15 including the composition and a light-emitting device including the composition may have excellent luminescence efficiency and lifespan characteristics. In addition, when an light-emitting unit of a light-emitting device includes the composition of the first compound and the second compound that satisfy Condition 1, the hole flux in the light-emitting unit may be increased due to the composition, so that an exciton recombination zone in the light-emitting unit may be spaced apart from each of the interface between an emission layer and a hole transport region and the interface between an emission layer and an electron transport region, resulting in improved lifespan characteristics of the light-emitting device.

The platinum-containing organometallic compound may include one platinum atom and may not include metals other than platinum.

The platinum-containing organometallic compound may not include ligands other than the tetradentate ligand bonded to the platinum.

The tetradentate ligand bonded to the platinum in the platinum-containing organometallic compound may have excellent electrical characteristics and structural rigidity. In addition, the platinum-containing organometallic compound having the tetradentate ligand bonded to the platinum has a planar structure, and thus may have a relatively small dipole moment.

The iridium-containing organometallic compound may include one iridium atom, may not include metals other than iridium.

The terms "dipole moment of the first compound" and "dipole moment of the second compound" as used herein may refer to "total permanent dipole moment in the molecule of the first compound" and "total permanent dipole moment in the molecule of the second compound", respectively.

In one or more embodiments, μ(Pt) may be in a range of about 1.5 debye to about 5.0 debye.

In one or more embodiments, μ(Pt) may be in a range of about 0.5 debye to about 3.0 debye, about 1.0 debye to about 3.0 debye, about 1.5 debye to about 3.0 debye, about 1.7 debye to about 3.0 debye, or about 1.7 debye to about 2.7 debye.

In one or more embodiments, μ(Pt) may be in a range of about 2.0 debye to about 5.0 debye, about 3.0 debye to about 5.0 debye, or about 4.0 debye to about 5.0 debye.

In one or more embodiments, μ(Ir) may be in a range of about 4.0 debye to about 9.0 debye, about 4.5 debye to about 7.5 debye, or about 5.0 debye to about 7.0 debye.

In one or more embodiments, μ(Ir) - μ(Pt) may be in a range of about 0.3 debye to about 4.0 debye.

In one or more embodiments, μ(Ir) - μ(Pt) may be in a range of about 2.0 debye to about 4.0 debye or about 2.0 debye to about 3.0 debye.

In one or more embodiments, μ(Ir) - μ(Pt) may be in a range of about 0.3 debye to about 1.0 debye.

In one or more embodiments, in Condition 1,

λP(Pt) may be equal to λP(Ir),
λP(Pt) may be less than λP(Ir),
λP(Pt) may be greater than λP(Ir), or
λP(Pt) and λP(Ir) may each be in a range of about 510 nm to about 570 nm,
λP(Pt) and λP(Ir) may each be in a range of about 510 nm to about 540 nm,
λP(Pt) may be in a range of about 510 nm to about 530 nm, and λP(Ir) may be in a range of about 520 nm to about 540 nm,
λP(Pt) and λP(Ir) may each be in a range of about 540 nm to about 570 nm, or
vλP(Pt) may be in a range of about 540 nm to about 560 nm, and
λP(Ir) may be in a range of about 550 nm to about 570 nm.

In one or more embodiments, the composition of the first compound and the second compound may satisfy Condition 2, and at least one of Equation 1 to Equation 4. Accordingly, a light-emitting device including the mixed layer 15 including the composition of the first compound and the second compound that satisfies Condition 2 may have better luminescence efficiency and long lifespan:

Equation 1

$$\lambda P(Ir1) > \lambda P(Ir2)$$

Equation 2

$$PLQY(Ir1) > PLYQ(Ir2)$$

Equation 3

$$k_r(Ir1) > k_r(Ir2)$$

Equation 4

$$HOR(Ir1) > HOR(Ir2)$$

wherein, in Equations 1 to 4,

in relation to Equation 1, λP(Ir1) is the emission peak wavelength of the first compound, and λP(Ir2) is the emission peak wavelength of the second compound.
λP(Ir1) and λP(Ir2) may be evaluated from the PL spectra measured with respect to the first film and the second film, respectively.

In relation to Equation 2, PLQY(Ir1) is the PL quantum yield of the first compound, and PLQY(Ir2) is the PL quantum yield of the second compound.
PLQY(Ir1) and PLYQ(Ir2) may be measured with respect to the first film and the second film, respectively.
In relation to Equation 3, $k_r$(Ir1) is the radiative decay rate of the first compound, and $k_r$(Ir2) is the radiative decay rate of the second compound.
$k_r$(Ir1) and $k_r$(Ir2) may be evaluated from PL spectra and time-resolved PL spectra measured with respect to the first film and the second film, respectively.
In relation to Equation 4, HOR(Ir1) is the horizontal orientation ratio of the first compound, and HOR(Ir2) is the horizontal orientation ratio of the second compound.
HOR(Ir1) and HOR(Ir2) may be respectively evaluated from the emission intensity of the first film and the second film with respect to angle.
The first film and the second film are respectively the same as those described in the present specification.
In one or more embodiments, the composition of the first compound and the second compound that satisfies Condition 2 may satisfy

Equation 1,
at least one of Equation 2 to Equation 4, or
Equation 1, and at least one of Equation 2 to Equation 4.

In one or more embodiments, the composition of the first compound and the second compound that satisfies Condition 2 may further satisfy Equation 5:

Equation 5

$$HOMO(Ir1) < HOMO(Ir2)$$

wherein, in Equation 5,

HOMO(Ir1) is the HOMO energy level of the first compound,
HOMO(Ir2) is the HOMO energy level of the second compound, and
each of HOMO(Ir1) and HOMO(Ir2) is a negative value measured using an atmospheric photoelectron spectrometer.

Each of HOMO(Ir1) and HOMO(Ir2) may be a negative value measured using an atmospheric photoelectron spectrometer, for example, AC3 manufactured by RIKEN KEIKI Co., Ltd.

Since the composition of the first compound and the second compound satisfying Condition 2 satisfies Equation 5, the second compound in the composition has a shallower HOMO energy level than the first compound, and a relatively greater amount of holes may be trapped in the second compound. As a result, in a light-emitting device including the mixed layer 15 including the composition of the first compound and the second compound, without the phenomenon in which the first compound and the second compound are changed into an anionic state due to electrons injected into the composition and the increase in the driving voltage, holes and electrons may effectively recombine in the first compound and/or the second compound. Accordingly, the light-emitting device may have excellent luminescence efficiency characteristics and excellent lifespan characteristics.

In one or more embodiments, regarding the composition of the first compound and the second compound satisfying Condition 2,

|HOMO(Ir1) - HOMO(Ir2)| may be in a range of about 0.03 eV to about 0.30 eV,
HOMO(Ir1) may be the HOMO energy level of the first compound,
HOMO(Ir2) may be the HOMO energy level of the second compound,
|HOMO(Ir1) - HOMO(Ir2)| may be the absolute value of HOMO(Ir1) - HOMO(Ir2), and
each of HOMO(Ir1) and HOMO(Ir2) may be a negative value measured using an atmospheric photoelectron spectrometer.

In one or more embodiments, the platinum-containing organometallic compound in Condition 1 may be an organometallic compound comprising a) a chemical bond between the carbon of the tetradentate ligand and the platinum and b) a chemical bond between the oxygen of the tetradentate ligand and the platinum.

In one or more embodiments, each of the iridium-containing organometallic compounds in Condition 1 and Condition 2 may include a first ligand, a second ligand, and a third ligand,

a) the first ligand, the second ligand, and the third ligand may be identical to each other, b) the first ligand and the second ligand may be identical to each other, and the second ligand and the third ligand may be different from each other, or c) the first ligand, the second ligand, and the third ligand may be different from each other, and
the first ligand, the second ligand, and the third ligand may each be:

- a bidentate ligand bonded to the iridium of the iridium-containing organometallic compound via two nitrogen atoms;
- a bidentate ligand bonded to the iridium of the iridium-containing organometallic compound via nitrogen and carbon; or
- a bidentate ligand bonded to the iridium of the iridium-containing organometallic compound via two carbons.

In one or more embodiments, the platinum-containing organometallic compound may be an organometallic compound represented by Formula 1, and the iridium-containing organometallic compound may be an organometallic compound represented by Formula 2:

Formula 1

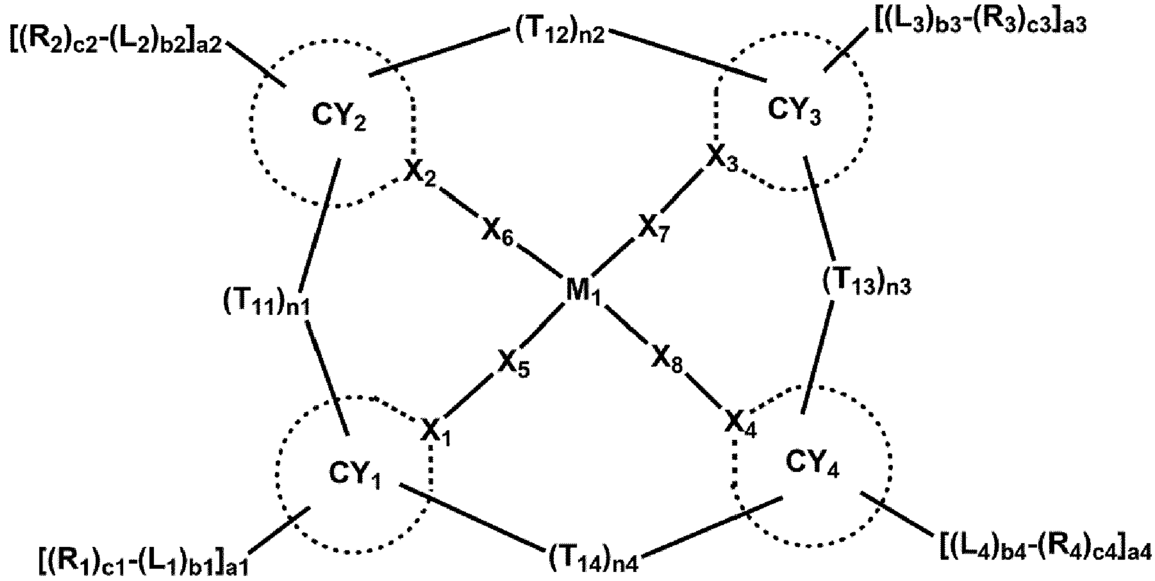

Formula 2 $M_2(L11)n11(L12)n12(L13)n13$

Formula 2-1

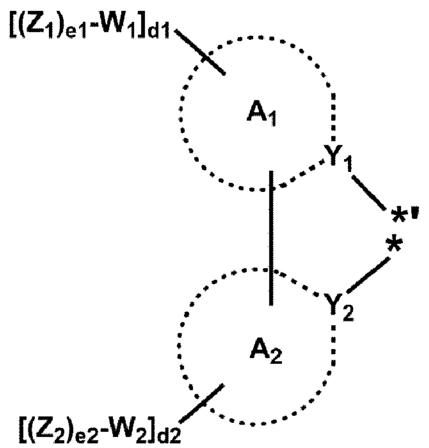

Formula 2-2

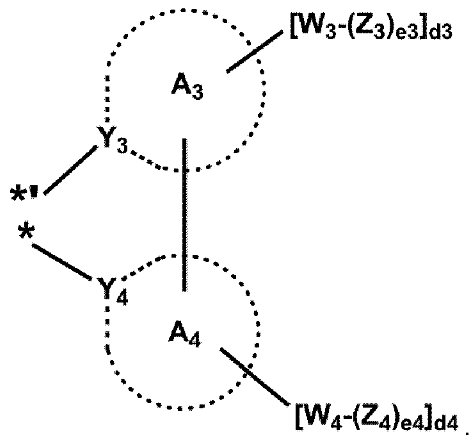

wherein,

$M_1$ in Formula 1 may be platinum (Pt), palladium (Pd), or gold (Au),
$M_2$ in Formula 2 may be iridium (Ir),
$L_{11}$ in Formula 2 may be a ligand represented by Formula 2-1,
$L_{12}$ in Formula 2 may be a ligand represented by Formula 2-2,
$L_{13}$ in Formula 2 may be a ligand represented by Formula 2-1 or 2-2,
$L_{11}$ and $L_{12}$ in Formula 2 may be different from each other,
n11, n12, and n13 in Formula 2 may each independently be 0, 1, 2, or 3, and the sum of n11, n12, and n13 may be 3,
$X_1$ to $X_4$ and $Y_1$ to $Y_4$ in Formulae 1, 2-1, and 2-2 may each independently be C or N,
$X_5$ to $X_8$ in Formula 1 may each independently be a chemical bond, O, S, N(R'), C(R')(R"), or C(=O), and at least one of $X_5$ to $X_8$ may not be a chemical bond,
in Formula 1, two of a bond between $X_5$ or $X_1$ and $M_1$, a bond between $X_6$ or $X_2$ and $M_1$, a bond between $X_7$ or $X_3$ and $M_1$, and a bond between $X_8$ or $X_4$ and $M_1$ may each be a coordinate bond, and the other two may each be a covalent bond,

ring $CY_1$ to ring $CY_4$ and ring $A_1$ to ring $A_4$ in Formulae 1, 2-1, and 2-2 may each independently be a $C_5$-$C_{30}$ carbocyclic group or a $C_1$-$C_{30}$ heterocyclic group,

$T_{11}$ to $T_{14}$ in Formula 1 may each independently be a single bond, a double bond, *-N($R_{5a}$)-*', *-B($R_{5a}$)-*', *-P($R_{5a}$)-*', *-C($R_{5a}$)($R_{5b}$)-*', *-Si($R_{5a}$)($R_{5b}$)-*', *-Ge($R_{5a}$)($R_{5b}$)-*', *-S-*', *-Se-*', *-O-*', *-C(=O)-*', *-S(=O)-*', *-S(=O)$_2$-*', *-C($R_{5a}$)=*', *=C($R_{5a}$)-*', *-C($R_{5a}$)=C($R_{5b}$)-*', *-C(=S)-*', *-C=C-*', a $C_5$-$C_{30}$ carbocyclic group unsubstituted or substituted with at least one $R_{10}$a, or a $C_1$-$C_{30}$ heterocyclic group unsubstituted or substituted with at least one $R_{10}$a,

n1 to n4 in Formula 1 may each independently be 0 or 1, and 3 or more of n1 to n4 may each be 1,

in Formula 1, when n1 is 0, $T_{11}$ may not exist, when n2 is 0, $T_{12}$ may not exist, when n3 is 0, $T_{13}$ may not exist, and when n4 is 0, $T_{14}$ may not exist,

$L_1$ to $L_4$ and $W_1$ to $W_4$ in Formulae 1, 2-1, and 2-2 may each independently be a single bond, a $C_1$-$C_{20}$ alkylene group unsubstituted or substituted with at least one $R_{10a}$, a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$,

b1 to b4 in Formula 1 may each independently be an integer from 1 to 10,

$R_1$ to $R_4$, $R_{5a}$, $R_{5b}$, R', R", and $Z_1$ to $Z_4$ in Formulae 1, 2-1, and 2-2 may each independently be hydrogen, deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$), -Ge($Q_3$)($Q_4$)($Q_5$), -B($Q_6$)($Q_7$), -P(=O)($Q_8$)($Q_9$), or -P($Q_8$)($Q_9$),

c1 to c4, a1 to a4, e1 to e4, and d1 to d4 in Formulae 1, 2-1, and 2-2 may each independently be an integer from 0 to 20,

the second compound may not be tris[2-phenylpyridine]iridium,

in Formulae 1, 2-1, and 2-2, at least one of i) two or more of a plurality of $R_1$(s), ii) two or more of a plurality of $R_2$(s), iii) two or more of a plurality of $R_3$(s), iv) two or more of a plurality of $R_4$(s), v) $R_{5a}$ and $R_{5b}$, vi) two or more of a plurality of $Z_1$($_S$), vii) two or more of a plurality of $Z_2$(s), viii) two or more of a plurality of $Z_3$(s), ix) two or more of a plurality of $Z_4$(s), x) two or more of $R_1$ to $R_4$, $R_{5a}$, and $R_{5b}$, and xi) two or more of $Z_1$ to $Z_4$ may optionally be bonded to each other to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$,

$R_{10a}$ is as described in connection with $R_1$,

* and *' each indicate a binding site to $M_2$,

at least one substituent of the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ aryl alkyl group, the substituted $C_7$-$C_{60}$ alkyl aryl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group may be:

deuterium, -F, -Cl, -Br, -I, -SFs, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, or $C_1$-$C_{60}$ alkoxy group, or a $C_1$-$C_{60}$ alkylthio group;

a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with at least one of deuterium, -F, -Cl, -Br, -I, -SFs, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a

phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, -N($Q_{11}$)($Q_{12}$), - Si($Q_{13}$)($Q_{14}$)($Q_{15}$), -Ge($Q_{13}$)($Q_{14}$)($Q_{15}$), -B($Q_{16}$)($Q_{17}$), -P(=O)($Q_{18}$)($Q_{19}$), -P($Q_{18}$)($Q_{19}$), or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each unsubstituted or substituted with at least one of deuterium, -F, -Cl, -Br, -I, -SFs, -$CD_3$, -$CD_2H$, -$CDH_2$, -$CF_3$, -$CF_2H$, -$CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, -N($Q_{21}$)($Q_{22}$), -Si($Q_{23}$)($Q_{24}$)($Q_{25}$), -Ge($Q_{23}$)($Q_{24}$)($Q_{25}$), -B($Q_{26}$)($Q_{27}$), -P(=O)($Q_{28}$)($Q_{29}$), -P($Q_{28}$)($Q_{29}$), or a combination thereof;

-N($Q_{31}$)($Q_{32}$), -Si($Q_{33}$)($Q_{34}$)($Q_{35}$), -Ge($Q_{33}$)($Q_{34}$)($Q_{35}$), -B($Q_{36}$)($Q_{37}$), - P(=O)($Q_{38}$)($Q_{39}$), or -P($Q_{38}$)($Q_{39}$); or a combination thereof, and

$Q_1$ to $Q_9$, $Q_{11}$ to $Q_{19}$, $Q_{21}$ to $Q_{29}$, and $Q_{31}$ to $Q_{39}$ may each independently be: hydrogen, deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each unsubstituted or substituted with deuterium, a $C_1$-$C_{60}$ alkyl group, a $C_6$-$C_{60}$ aryl group, or a combination thereof.

In Formula 2, n11 to n13 indicate the number of $L_{11}$(s) to the number of $L_{13}$(s), respectively, and may each independently be 0, 1, 2, or 3, wherein a sum of n11, n12, and n13 may be 3.

For example, in Formula 2, n11 may be 1, 2, or 3, and n12 and n13 may each independently be 0, 1, or 2.

In one or more embodiments, in Formula 2, n12 may be 1, 2, or 3, and n11 and n13 may each independently be 0, 1, or 2.

In one or more embodiments, n11 may be 1, n12 may be 2, and n13 may be 0.

In one or more embodiments, n11 may be 2, n12 may be 1, and n13 may be 0.

In one or more embodiments, n11 may be 3, and n12 and n13 may each be 0.

In one or more embodiments, n12 may be 3, and n11 and n13 may each be 0.

The iridium-containing organometallic compound represented by Formula 2 may be a heteroleptic complex or a homoleptic complex.

For example, the iridium-containing organometallic compound may be a heteroleptic complex.

$X_1$ to $X_4$ and $Y_1$ to $Y_4$ in Formulae 1, 2-1, and 2-2 may each independently be C or N.

For example, at least one of $X_1$ to $X_4$ in Formula 1 may be C.

In one or more embodiments, $X_1$ in Formula 1 may be C.

In one or more embodiments, in Formula 1, i) $X_1$ and $X_3$ may each be C, and $X_2$ and $X_4$ may each be N, or ii) $X_1$ and $X_4$ may each be C, and $X_2$ and $X_3$ may each be N.

In one or more embodiments, in Formulae 2-1 and 2-2, $Y_1$ and $Y_3$ may each be N, and $Y_2$ and $Y_4$ may each be C.

In Formula 1, $X_5$ to $X_8$ may each independently be a chemical bond, O, S, N(R'), C(R')(R"), or C(=O), and at least one of $X_5$ to $X_8$ may not be a chemical bond. R' and R" are respectively the same as those described in the present specification.

In one or more embodiments, $X_5$ in Formula 1 may not be a chemical bond.

In one or more embodiments, $X_5$ in Formula 1 may be O or S.

In one or more embodiments, in Formula 1, $X_5$ may be O or S, and $X_6$ to $X_8$ may each be a chemical bond.

In Formula 1, two of a bond between $X_5$ or $X_1$ and $M_1$, a bond between $X_6$ or $X_2$ and $M_1$, a bond between $X_7$ or $X_3$ and $M_1$, and a bond between $X_8$ or $X_4$ and $M_1$ may each be a coordinate bond, and the other two may each be a covalent bond.

For example, a bond between $X_2$ and M in Formula 1 may be a coordinate bond.

In one or more embodiments, in Formula 1, a bond between $X_5$ or $X_1$ and M and a bond between $X_3$ and M may each be a covalent bond, and a bond between $X_2$ and M and a bond between $X_4$ and M may each be a coordinate bond.

In one or more embodiments, the platinum-containing organometallic compound and the iridium-containing organometallic compound may each be electrically neutral.

Ring $CY_1$ to ring $CY_4$ and ring $A_1$ to ring $A_4$ in Formulae 1, 2-1, and 2-2 may each independently be a $C_5$-$C_{30}$ carbocyclic group or a $C_1$-$C_{30}$ heterocyclic group.

For example, each of ring $CY_1$, ring $CY_3$, and ring $CY_4$ may not be a benzimidazole group.

For example, ring $CY_1$ to ring $CY_4$ and ring $A_1$ to ring $A_4$ in Formulae 1, 2-1, and 2-2 may each independently be i) a first ring, ii) a second ring, iii) a condensed ring in which two or more first rings are condensed with each other, iv) a condensed ring in which two or more second rings are condensed with each other, or v) a condensed ring in which at least one first ring and at least one second ring are condensed with each other,

the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and

the second ring may be an adamantane group, a norbornane group, a norbornene group, a piperidine group, a cyclohexane group, a cyclohexene group, a benzene group, a pyridine group, a pyrimidine group, a pyrazine group, a pyridazine group, or a triazine group.

In one or more embodiments, ring $CY_1$ to ring $CY_4$ and ring $A_1$ to ring $A_4$ in Formulae 1, 2-1, and 2-2 may each independently be a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a pyrrole group, a furan group, a thiophene group, a silole group, a borole group, a phosphole group, a germole group, a selenophene group, an indene group, an indole group, a benzofuran group, a benzothiophene group, a benzosilole group, a benzoborole group, a benzophosphole group, a benzogermole group, a benzoselenophene group, a fluorene group, a carbazole group, a dibenzofuran group, a dibenzothiophene group, a dibenzosilole group, a dibenzoborole group, a dibenzophosphole group, a dibenzogermole group, a dibenzoselenophene group, a benzofluorene group, a benzocarbazole group, a naphthobenzofuran group, a naphthobenzothiophene group, a naphthobenzosilole group, a naphthobenzoborole group, a naphthobenzophosphole group, a naphthobenzogermole group, a naphthobenzoselenophene group, a dibenzofluorene group, a dibenzocarbazole group, a dinaphthofuran group, a dinaphthothiophene group, a dinaphthosilole group, a dinaphthoborole group, a dinaphthophosphole group, a dinaphthogermole group, a dinaphthoselenophene group, an indenophenanthrene group, an indolophenanthrene group, a phenanthrobenzofuran group, a phenanthrobenzothiophene group, a phenanthrobenzosilole group, a phenanthrobenzoborole group, a phenanthrobenzophosphole group, a phenanthrobenzogermole group, a phenanthrobenzoselenophene group, a dibenzothiophene 5-oxide group, a 9H-fluorene-9-one group, a dibenzothiophene 5,5-dioxide group, an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthrobenzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a pyrrole group, a pyrazole group, an imidazole group, a triazole group, an oxazole group, an isoxazole group, a thiazole group, an isothiazole group, an oxadiazole group, a thiadiazole

group, an azasilole group, an azaborole group, an azaphosphole group, an azagermole group, an azaselenophene group, a benzopyrrole group, a benzopyrazole group, a benzimidazole group, a benzoxazole group, a benzisoxazole group, a benzothiazole group, a benzisothiazole group, a benzoxadiazole group, a benzothiadiazole group, a pyridinopyrrole group, a pyridinopyrazole group, a pyridinoimidazole group, a pyridinooxazole group, a pyridinoisoxazole group, a pyridinothiazole group, a pyridinoisothiazole group, a pyridinooxadiazole group, a pyridinothiadiazole group, a pyrimidinopyrrole group, a pyrimidinopyrazole group, a pyrimidinoimidazole group, a pyrimidinooxazole group, a pyrimidinoisoxazole group, a pyrimidinothiazole group, a pyrimidinoisothiazole group, a pyrimidinooxadiazole group, a pyrimidinothiadiazole group, a naphthopyrrole group, a naphthopyrazole group, a naphthoimidazole group, a naphthooxazole group, a naphthoisoxazole group, a naphthothiazole group, a naphthoisothiazole group, a naphthooxadiazole group, a naphthothiadiazole group, a phenanthrenopyrrole group, a phenanthrenopyrazole group, a phenanthrenoimidazole group, a phenanthrenooxazole group, a phenanthrenoisoxazole group, a phenanthrenothiazole group, a phenanthrenoisothiazole group, a phenanthrenooxadiazole group, a phenanthrenothiadiazole group, a 5,6,7,8-tetrahydroisoquinoline group, a 5,6,7,8-tetrahydroquinoline group, an adamantane group, a norbornane group, a norbornene group, a benzene group condensed with a cyclohexane group, a benzene group condensed with a norbornane group, a pyridine group condensed with a cyclohexane group, or a pyridine group condensed with a norbornane group.

In one or more embodiments, ring $CY_1$ and ring $CY_3$ in Formula 1 may each independently be:

a benzene group, a naphthalene group, a phenanthrene group, a dibenzofuran group, a dibenzothiophene group, a dibenzoselenophene group, a carbazole group, a fluorene group, or a dibenzosilole group; or
a benzene group, a naphthalene group, a phenanthrene group, a dibenzofuran group, a dibenzothiophene group, a dibenzoselenophene group, a carbazole group, a fluorene group, or a dibenzosilole group, each condensed with a cyclohexane group, a cyclohexene group, a norbornane group, a piperidine group, or a combination thereof.

In one or more embodiments, ring $CY_2$ in Formula 1 may be:

an imidazole group, a benzimidazole group, a pyridine group, a pyrimidine group, a pyridazine group, a pyrazine group, a triazine group, a quinoline group, an isoquinoline group, a quinoxaline group, or a quinazoline group; or
an imidazole group, a benzimidazole group, a pyridine group, a pyrimidine group, a pyridazine group, a pyrazine group, a triazine group, a quinoline group, an isoquinoline group, a quinoxaline group, or a quinazoline group, each condensed with a cyclohexane group, a cyclohexene group, a norbornane group, a benzene group, a pyridine group, a pyrimidine group, or a combination thereof. In one or more embodiments, ring $CY_4$ in Formula 1 may be:
a pyridine group, a pyrimidine group, a pyridazine group, a pyrazine group, a triazine group, a quinoline group, an isoquinoline group, a quinoxaline group, a quinazoline group, an azadibenzofuran group, an azadibenzothiophene group, an azadibenzoselenophene group, an azacarbazole group, an azafluorene group, or an azadibenzosilole group; or
a pyridine group, a pyrimidine group, a pyridazine group, a pyrazine group, a triazine group, a quinoline group, an isoquinoline group, a quinoxaline group, a quinazoline group, an azadibenzofuran group, an azadibenzothiophene group, an azadibenzoselenophene group, an azacarbazole group, an azafluorene group, or an azadibenzosilole group, each condensed with a cyclohexane group, a cyclohexene group, a norbornane group, a benzene group, a pyridine group, a pyrimidine group, or a combination thereof.

Ring $A_1$ and ring $A_3$ in Formulae 2-1 and 2-2 may be different from each other.

In one or more embodiments, a $Y_1$-containing monocyclic group in ring $A_1$, a $Y_2$-containing monocyclic group in ring $A_2$, and $Y_4$-containing monocyclic group in ring $A_4$ may each be a 6-membered ring.

In one or more embodiments, a $Y_3$-containing monocyclic group in ring $A_3$ may be a 6-membered ring.

In one or more embodiments, a $Y_3$-containing monocyclic group in ring $A_3$ may be a 5-membered ring.

In one or more embodiments, a $Y_1$-containing monocyclic group in ring $A_1$ may be a 6-membered ring, and a $Y_3$-containing monocyclic group in ring $A_3$ may be a 5-membered ring.

In one or more embodiments, ring $A_1$ and ring $A_3$ in Formulae 2-1 and 2-2 may each independently be i) an A group, ii) a polycyclic group in which two or more A groups are condensed with each other, or iii) a polycyclic group in which at least one A group and at least one B group are condensed with each other,

the A group may be a pyridine group, a pyrimidine group, a pyridazine group, a pyrazine group, or a triazine group, and the B group may be a cyclohexane group, a cyclohexene group, a norbornane group, a benzene group, a furan group, a thiophene group, a selenophene group, a pyrrole group, a cyclopentadiene group, or a silole group.

In one or more embodiments, in Formula 2-2, ring $A_3$ may be i) a C group, ii) a polycyclic group in which two or more C groups are condensed with each other, or iii) a polycyclic group in which at least one C group and at least

one D group are condensed with each other,

the C group may be a pyrrole group, a pyrazole group, an imidazole group, a triazole group, an oxazole group, an isoxazole group, a thiazole group, or an isothiazole group, and
the D group may be a cyclohexane group, a cyclohexene group, a norbornane group, a benzene group, a furan group, a thiophene group, a selenophene group, a cyclopentadiene group, a silole group, a pyridine group, a pyrimidine group, a pyridazine group, a pyrazine group, or a triazine group.

In one or more embodiments, ring $A_1$ in Formula 2-1 may be:

a pyridine group, a pyrimidine group, a pyridazine group, or a pyrazine group; or
a pyridine group, a pyrimidine group, a pyridazine group, or a pyrazine group, each condensed with at least one of a cyclohexane group, a norbornane group, a benzene group, or a combination thereof.

In one or more embodiments, ring $A_3$ in Formula 2-2 may be:

a pyridine group, a pyrimidine group, a pyridazine group, or a pyrazine group;
a pyridine group, a pyrimidine group, a pyridazine group, or a pyrazine group, each condensed with at least one of a cyclohexane group, a norbornane group, a benzene group, or a combination thereof; or
an imidazole group, a benzimidazole group, a naphthoimidazole group, a phenanthrenoimidazole group, a pyridoimidazole group, an oxazole group, a benzoxazole group, a naphthooxazole group, a phenanthrenooxazole group, a pyridooxazole group, a thiazole group, a benzothiazole group, a naphthothiazole group, a phenanthrenothiazole group, or a pyridothiazole group.

In one or more embodiments, ring $A_2$ and ring $A_4$ in Formulae 2-1 and 2-2 may be different from each other.
In one or more embodiments, ring $A_2$ and ring $A_4$ in Formulae 2-1 and 2-2 may each independently be i) an E group, ii) a polycyclic group in which two or more E groups are condensed with each other, or iii) a polycyclic group in which at least one E group and at least one F group are condensed with each other,

the E group may be a benzene group, a pyridine group, a pyrimidine group, a pyridazine group, a pyrazine group, or a triazine group, and
the F group may be a furan group, a thiophene group, a selenophene group, a pyrrole group, a cyclopentadiene group, a silole group, a pyrazole group, an imidazole group, an oxazole group, a thiazole group, an isoxazole group, or an isothiazole group.

In one or more embodiments, ring $A_2$ in Formula 2-1 may be a polycyclic group in which two or more E groups and at least one F group are condensed with each other.
In one or more embodiments, ring $A_4$ in Formula 2-2 may be a polycyclic group in which two or more E groups and at least one F group are condensed with each other.
In one or more embodiments, ring $A_2$ in Formula 2-1 may be:

a benzene group, a naphthalene group, a phenanthrene group, a dibenzofuran group, a dibenzothiophene group, a dibenzoselenophene group, a carbazole group, a fluorene group, or a dibenzosilole group; or
a benzene group, a naphthalene group, a phenanthrene group, a dibenzofuran group, a dibenzothiophene group, a dibenzoselenophene group, a carbazole group, a fluorene group, or a dibenzosilole group, each condensed with at least one of a cyclohexane group, a norbornane group, a benzene group, or a combination thereof.

In one or more embodiments, ring $A_4$ in Formula 2-2 may be:

a benzene group, a naphthalene group, a phenanthrene group, a dibenzofuran group, a dibenzothiophene group, a dibenzoselenophene group, a carbazole group, a fluorene group, a dibenzosilole group, an azadibenzofuran group, an azadibenzothiophene group, an azadibenzoselenophene group, an azacarbazole group, an azafluorene group, or a dibenzosilole group; or
a benzene group, a naphthalene group, a phenanthrene group, a dibenzofuran group, a dibenzothiophene group, a dibenzoselenophene group, a carbazole group, a fluorene group, a dibenzosilole group, an azadibenzofuran group, an azadibenzothiophene group, an azadibenzoselenophene group, an azacarbazole group, an azafluorene group, or a dibenzosilole group, each condensed with at least one of a benzene group, a pyridine group, a pyrimidine group, a pyridazine group, a pyrazine group, a cyclohexane group, a norbornane group, a furan group, a thiophene

group, a selenophene group, a pyrrole group, a cyclopentadiene group, a silole group, a pyrazole group, an imidazole group, an oxazole group, a thiazole group, an isoxazole group, an isothiazole group, or a combination thereof.

$T_{11}$ to $T_{14}$ in Formula 1 may each independently be a single bond, a double bond, *-N($R_{5a}$)-*', *-B($R_{5a}$)-*', *-P($R_{5a}$)-*', *-C($R_{5a}$)($R_{5b}$)-*', *-Si($R_{5a}$)($R_{5b}$)-*', *-Ge($R_{5a}$)($R_{5b}$)-*', *-S-*', *-Se-*', *-O-*', *-C(=O)-*', *-S(=O)-*', *-S(=O)$_2$-*', *-C($R_{5a}$)=*', *=C($R_{5a}$)-*', *-C($R_{5a}$)=C($R_{5b}$)-*', *-C(=S)-*', *-C=C-*', a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$.

For example, $T_{11}$ and $T_{12}$ in Formula 1 may each be a single bond, and $T_{13}$ may be a single bond, *-N($R_{5a}$)-*', *-B($R_{5a}$)-*', *-P($R_{5a}$)-*', *-C($R_{5a}$)($R_{5b}$)-*', *-Si($R_{5a}$)($R_{5b}$)-*', *-Ge($R_{5a}$)($R_{5b}$)-*', *-S-*', or *-O-*'.

n1 to n4 in Formula 1 indicate the numbers of $T_{11}$ to $T_{14}$, respectively, and may each independently be 0 or 1, wherein three or more of n1 to n4 may each be 1. That is, the organometallic compound represented by Formula 1 may have a tetradentate ligand.

In Formula 1, when n1 is 0, $T_{11}$ may not exist (that is, ring $CY_1$ and ring $CY_2$ are not connected to each other), when n2 is 0, $T_{12}$ may not exist (that is, ring $CY_2$ and ring $CY_3$ are not connected to each other), when n3 is 0, $T_{13}$ may not exist (that is, ring $CY_3$ and ring $CY_4$ are not connected to each other), and when n4 is 0, $T_{14}$ may not exist (that is, ring $CY_4$ and ring $CY_1$ are not connected to each other).

In one or more embodiments, in Formula 1, n1 to n3 may each be 1, and n4 may be 0.

$L_1$ to $L_4$ and $W_1$ to $W_4$ in Formulae 1, 2-1, and 2-2 may each independently be a single bond, a $C_1$-$C_{20}$ alkylene group unsubstituted or substituted with at least one $R_{10a}$, a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$.

For example, $L_1$ to $L_4$ and $W_1$ to $W_4$ in Formulae 1, 2-1, and 2-2 may each independently be:

a single bond; or
a $C_1$-$C_{20}$ alkylene group, a cyclopentene group, a cyclohexane group, a cyclohexene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an iso-oxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group, each unsubstituted or substituted with at least one $R_{10a}$.

In one or more embodiments, $L_1$ to $L_4$ and $W_1$ to $W_4$ in Formulae 1, 2-1, and 2-2 may each independently be:

a single bond; or
a $C_1$-$C_{20}$ alkylene group, a benzene group, a naphthalene group, a pyridine group, a fluorene group, a carbazole group, a dibenzofuran group, or a dibenzothiophene group, each unsubstituted or substituted with at least one $R_{10a}$.

In one or more embodiments, $L_1$ to $L_4$ and $W_1$ to $W_4$ in Formulae 1, 2-1, and 2-2 may each independently be:

a single bond; or
a $C_1$-$C_{20}$ alkylene group, a benzene group, a naphthalene group, a dibenzofuran group, or a dibenzothiophene group, each unsubstituted or substituted with deuterium, -F, a cyano group, a $C_1$-$C_{20}$ alkyl group, a deuterated $C_1$-$C_{20}$ alkyl group, a fluorinated $C_1$-$C_{20}$ alkyl group, a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a phenyl group, a deuterated phenyl group, a fluorinated phenyl group, a ($C_1$-$C_{20}$ alkyl)phenyl group, a naphthyl group, a pyridinyl group, a furanyl

group, a thiophenyl group, a benzofuranyl group, a benzothiophenyl group, a dibenzofuranyl group, a dibenzothiophenyl group, or a combination thereof.

b1 to b4 in Formula 1 indicate the number of $L_1$(s) to the number of $L_4$(s), respectively, and may each independently be an integer from 1 to 10. When b1 is 2 or more, two or more of $L_1$(s) may be identical to or different from each other, when b2 is 2 or more, two or more of $L_2$(s) may be identical to or different from each other, when b3 is 2 or more, two or more of $L_3$(s) may be identical to or different from each other, and when b4 is 2 or more, two or more of $L_4$(s) may be identical to or different from each other. For example, b1 to b4 may each independently be 1, 2, or 3.

$R_1$ to $R_4$, $R_{5a}$, $R_{5b}$, R', R", and $Z_1$ to $Z_4$ in Formulae 1, 2-1, and 2-2 may each independently be hydrogen, deuterium, -F, -Cl, -Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ heteroarylalkyl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$), -Ge($Q_3$)($Q_4$)($Q_5$), -B($Q_6$)($Q_7$), -P(=O)($Q_8$)($Q_9$), or -P($Q_8$)($Q_9$). $Q_1$ to $Q_9$ are respectively the same as those described in the present specification.

In one or more embodiments, $R_1$ to $R_4$, $R_{5a}$, $R_{5b}$, R, R", and $Z_1$ to $Z_4$ in Formulae 1, 2-1, and 2-2 may each independently be:

hydrogen, deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_2$-$C_{20}$ alkenyl group, a $C_1$-$C_{20}$ alkoxy group, or a $C_1$-$C_{20}$ alkylthio group;
a $C_1$-$C_{20}$ alkyl group, a $C_2$-$C_{20}$ alkenyl group, a $C_1$-$C_{20}$ alkoxy group, or a $C_1$-$C_{20}$ alkylthio group, each substituted with at least one of deuterium, -F, -Cl, - Br, -I, -SFs, -$CD_3$, -$CD_2H$, -$CDH_2$, -$CF_3$, -$CF_2H$, -$CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1 ]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with at least one

of deuterium, -F, -Cl, - Br, -I, -SFs, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterated $C_1$-$C_{20}$ alkyl group, a fluorinated $C_1$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1 ]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a phenyl group, a ($C_1$-$C_{20}$ alkyl)phenyl group, a deuterated phenyl group, a fluorinated phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or

$-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$, or $-P(Q_8)(Q_8)$, and

$Q_1$ to $Q_9$ may each independently be:

deuterium, -F, $-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, $-CD_2CDH_2$, $-CF_3$, $-CF_2H$, $-CFH_2$, $-CH_2CF_3$, $-CH_2CF_2H$, $-CH_2CFH_2$, $-CHFCH_3$, - $CHFCF_2H$, $-CHFCFH_2$, $-CHFCF_3$, $-CF_2CF_3$, $-CF_2CF_2H$, or $-CF_2CFH_2$; or

an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, -F, a $C_1$-$C_{10}$ alkyl group, a phenyl group, or a combination thereof.

In one or more embodiments, $R_1$ to $R_4$, $R_{5a}$, $R_{5b}$, R', R", and $Z_1$ to $Z_4$ in Formulae 1, 2-1, and 2-2 may each independently be:

hydrogen, deuterium, -F, or a cyano group;

a $C_1$-$C_{20}$ alkyl group unsubstituted or substituted with at least one of deuterium, -F, a cyano group, a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a $C_1$-$C_{10}$ heterocycloalkyl group, a deuterated $C_1$-$C_{10}$ heterocycloalkyl group, a fluorinated $C_1$-$C_{10}$ heterocycloalkyl group, a ($C_1$-$C_{20}$ alkyl)$C_1$-$C_{10}$ heterocycloalkyl group, a phenyl group, a deuterated phenyl group, a fluorinated phenyl group, a ($C_1$-$C_{20}$ alkyl)phenyl group, a biphenyl group, a deuterated biphenyl group, a fluorinated biphenyl group, a ($C_1$-$C_{20}$ alkyl)biphenyl group, a dibenzofuranyl group, a deuterated dibenzofuranyl group, a fluorinated dibenzofuranyl group, a ($C_1$-$C_{20}$ alkyl)dibenzofuranyl group, a dibenzothiophenyl group, a deuterated dibenzothiophenyl group, a fluorinated dibenzothiophenyl group, a ($C_1$-$C_{20}$ alkyl)dibenzothiophenyl group, or a combination thereof;

a $C_3$-$C_{10}$ cycloalkyl group, a $C_1$-$C_{10}$ heterocycloalkyl group, a phenyl group, a biphenyl group, a naphthyl group, a pyridinyl group, a fluorenyl group, a carbazolyl group, a dibenzofuranyl group, or a dibenzothiophenyl group, each unsubstituted or substituted with at least one of deuterium, -F, a cyano group, a $C_1$-$C_{20}$ alkyl group, a deuterated $C_1$-$C_{20}$ alkyl group, fluorinated $C_1$-$C_{20}$ alkyl group, a $C_1$-$C_{20}$ alkoxy group, a deuterated $C_1$-$C_{20}$ alkoxy group, a fluorinated $C_1$-$C_{20}$ alkoxy group, a $C_1$-$C_{20}$ alkylthio group, a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a $C_1$-$C_{10}$ heterocycloalkyl group, a deuterated $C_1$-$C_{10}$ heterocycloalkyl group, a fluorinated $C_1$-$C_{10}$ heterocycloalkyl group, a ($C_1$-$C_{20}$ alkyl)$C_1$-$C_{10}$ heterocycloalkyl group, a phenyl group, a deuterated phenyl group, a fluorinated phenyl group, a ($C_1$-$C_{20}$ alkyl)phenyl group, a biphenyl group, a deuterated biphenyl group, a fluorinated biphenyl group, a ($C_1$-$C_{20}$ alkyl)biphenyl group, a dibenzofuranyl group, a deuterated dibenzofuranyl group, a fluorinated dibenzofuranyl group, a ($C_1$-$C_{20}$ alkyl)dibenzofuranyl group, a dibenzothiophenyl group, a deuterated dibenzothiophenyl group, a fluorinated

dibenzothiophenyl group, a ($C_1$-$C_{20}$ alkyl)dibenzothiophenyl group, or a combination thereof; or -Si($Q_3$)($Q_4$)($Q_5$) or -Ge($Q_3$)($Q_4$)($Q_5$).

In one or more embodiments, e1 and d1 in Formula 2-1 may each not be 0, and at least one of $Z_1$(s) may be a deuterated $C_1$-$C_{20}$ alkyl group, -Si($Q_3$)($Q_4$)($Q_5$), or - Ge($Q_3$)($Q_4$)($Q_5$). $Q_3$ to $Q_5$ are respectively the same as those described in the present specification.

For example, $Q_3$ to $Q_5$ may each independently be:

a $C_1$-$C_{60}$ alkyl group unsubstituted or substituted with at least one of deuterium, a $C_1$-$C_{60}$ alkyl group, a $C_6$-$C_{60}$ aryl group, or a combination thereof; or

a $C_6$-$C_{60}$ aryl group unsubstituted or substituted with at least one of deuterium, a $C_1$-$C_{60}$ alkyl group, a $C_6$-$C_{60}$ aryl group, or a combination thereof.

In one or more embodiments, $Q_3$ to $Q_5$ may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, - $CHDCH_3$, $-CHDCD_2H$, $-CHDCDH_2$, $-CHDCD_3$, $-CD_2CD_3$, $-CD_2CD_2H$, or - $CD_2CDH_2$; or

an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, a $C_1$-$C_{10}$ alkyl group, a phenyl group, or a combination thereof.

In one or more embodiments, $Q_3$ to $Q_5$ may be identical to each other.

In one or more embodiments, two or more of $Q_3$ to $Q_5$ may be different from each other.

In one or more embodiments, the iridium-containing organometallic compound may satisfy at least one of Condition 10-1 to Condition 10-8:

Condition 10-1
each of e1 and d1 in Formula 2-1 is not 0, and at least one $Z_1$ includes deuterium;

Condition 10-2
each of e2 and d2 in Formula 2-1 is not 0, and at least one $Z_2$ includes deuterium;

Condition 10-3
each of e3 and d3 in Formula 2-2 is not 0, and at least one $Z_3$ includes deuterium;

Condition 10-4
each of e4 and d4 in Formula 2-2 is not 0, and at least one $Z_4$ includes deuterium;

Condition 10-5
each of e1 and d1 in Formula 2-1 is not 0, and at least one $Z_1$ includes a fluoro group;

Condition 10-6
each of e2 and d2 in Formula 2-1 is not 0, and at least one $Z_2$ includes a fluoro group;

Condition 10-7
each of e3 and d3 in Formula 2-2 is not 0, and at least one $Z_3$ includes a fluoro group; and

Condition 10-8
each of e4 and d4 in Formula 2-2 is not 0, and at least one $Z_4$ includes a fluoro group.

In one or more embodiments, $R_1$ to $R_4$, $R_{5a}$, $R_{5b}$, R', R", and $Z_1$ to $Z_4$ in Formulae 1, 2-1, and 2-2 may each independently be hydrogen, deuterium, -F, $-CH_3$, $-CD_3$, $-CD_2H$, $-CDH_2$, $-CF_3$, $-CF_2H$, $-CFH_2$, a $C_2$-$C_{10}$ alkenyl group, a $C_1$-$C_{10}$ alkoxy group, a $C_1$-$C_{10}$ alkylthio group, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-227, a group represented by one of Formulae 9-201 to 9-227 in which at least one hydrogen is substituted with deuterium, a group represented by one of Formulae 9-201 to 9-227 in which at least one hydrogen is substituted

with -F, a group represented by one of Formulae 10-1 to 10-129, a group represented by one of Formulae 10-1 to 10-129 in which at least one hydrogen is substituted with deuterium, a group represented by one of Formulae 10-1 to 10-129 in which at least one hydrogen is substituted with -F, a group represented by one of Formulae 10-201 to 10-350, a group represented by one of Formulae 10-201 to 10-350 in which at least one hydrogen is substituted with deuterium, a group represented by one of Formulae 10-201 to 10-350 in which at least one hydrogen is substituted with -F, -Si($Q_3$)($Q_4$)($Q_5$), or -Ge($Q_3$)($Q_4$)($Q_5$) (wherein $Q_3$ to $Q_5$ are respectively the same as those described in the present specification):

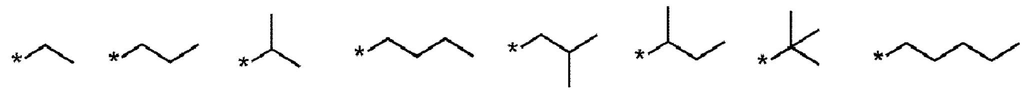

9-1 9-2 9-3 9-4 9-5 9-6 9-7 9-8

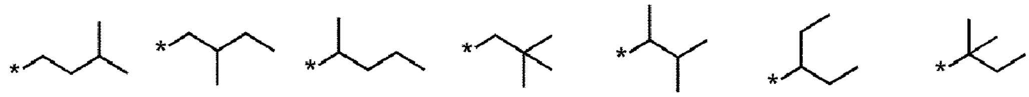

9-9 9-10 9-11 9-12 9-13 9-14 9-15

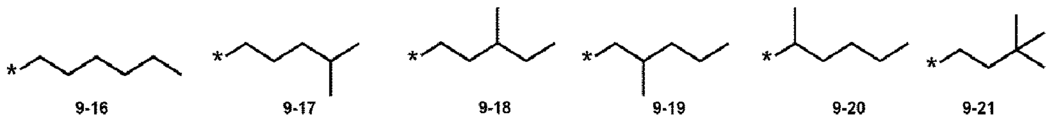

9-16 9-17 9-18 9-19 9-20 9-21

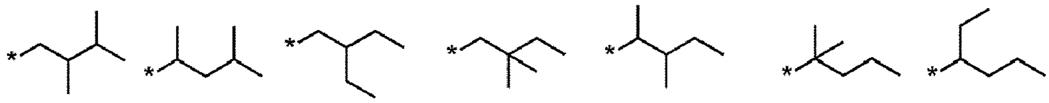

9-22 9-23 9-24 9-25 9-26 9-27 9-28

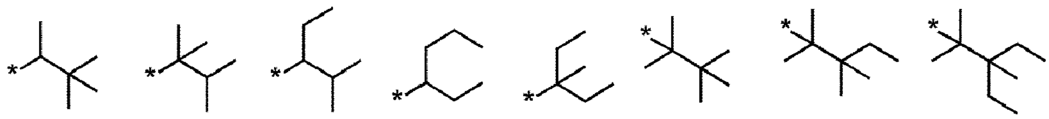

9-29 9-30 9-31 9-32 9-33 9-34 9-35 9-36

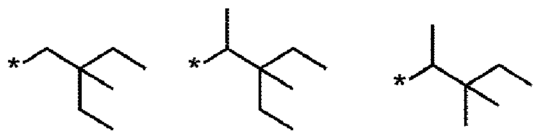

9-37 9-38 9-39

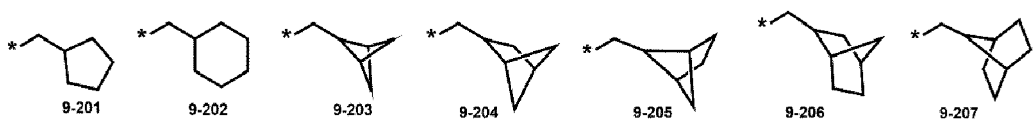

9-201 9-202 9-203 9-204 9-205 9-206 9-207

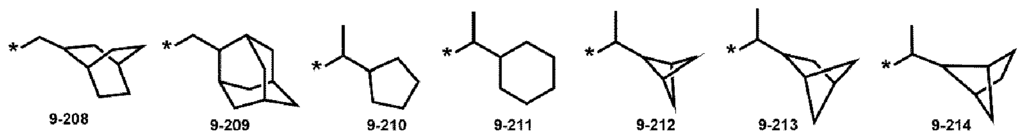

9-208 9-209 9-210 9-211 9-212 9-213 9-214

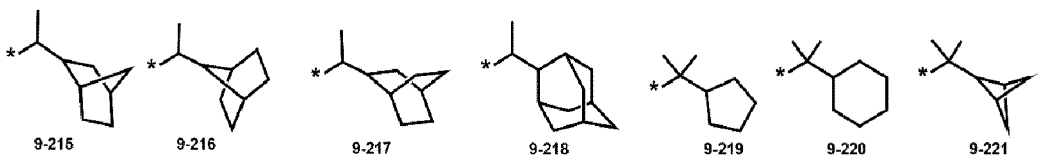

9-215 9-216 9-217 9-218 9-219 9-220 9-221

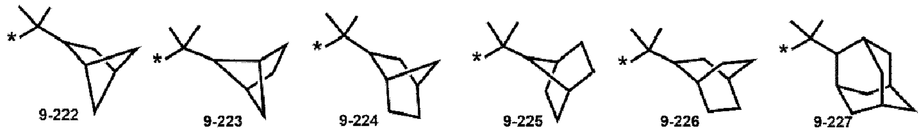

9-222 9-223 9-224 9-225 9-226 9-227

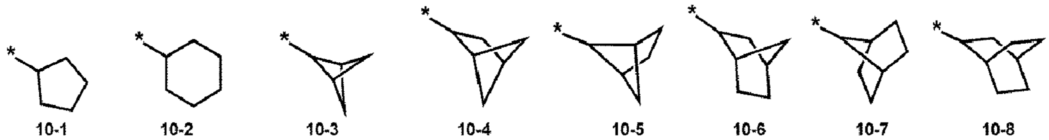

10-1 10-2 10-3 10-4 10-5 10-6 10-7 10-8

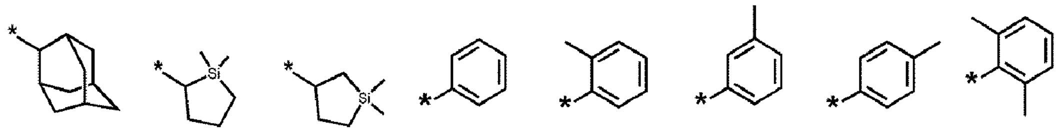

10-9 10-10 10-11 10-12 10-13 10-14 10-15 10-16

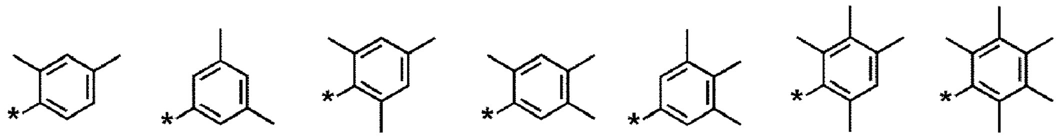

10-17 10-18 10-19 10-20 10-21 10-22 10-23

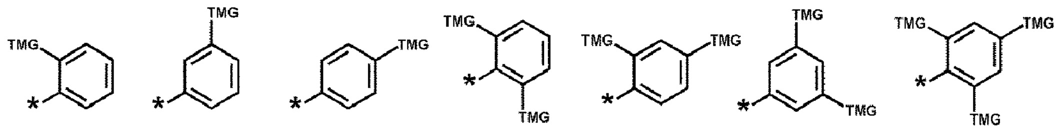

10-24 10-25 10-26 10-27 10-28 10-29 10-30

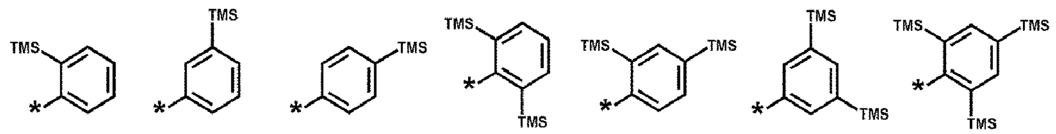

10-31 10-32 10-33 10-34 10-35 10-36 10-37

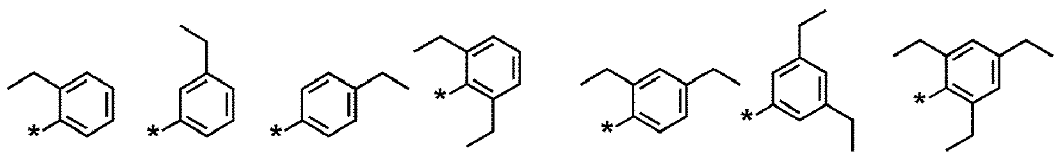

10-38 10-39 10-40 10-41 10-42 10-43 10-44

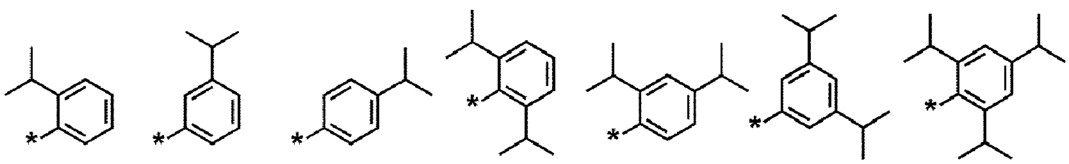

10-45 10-46 10-47 10-48 10-49 10-50 10-51

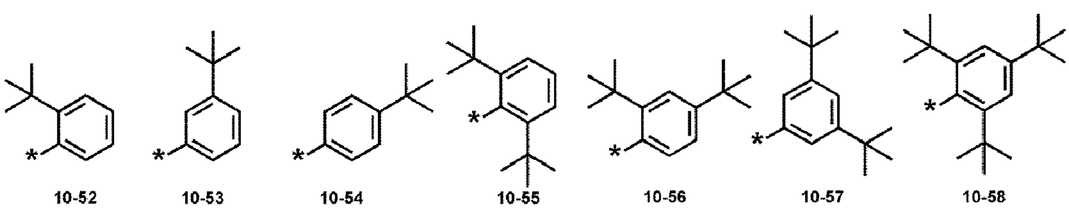

10-52 10-53 10-54 10-55 10-56 10-57 10-58

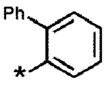
10-59
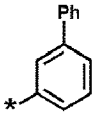
10-60
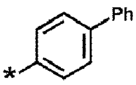
10-61
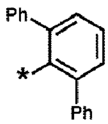
10-62
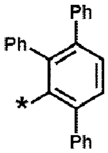
10-63
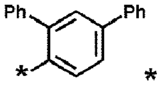
10-64
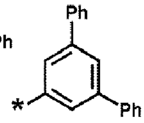
10-65
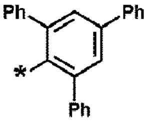
10-66

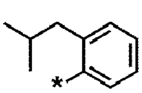
10-67
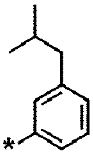
10-68
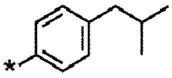
10-69
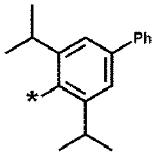
10-70
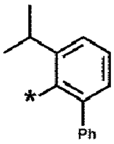
10-71
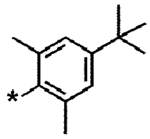
10-72

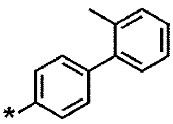
10-73
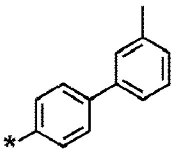
10-74
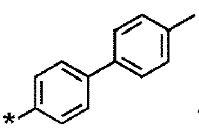
10-75
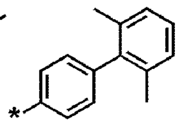
10-76
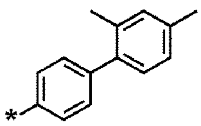
10-77

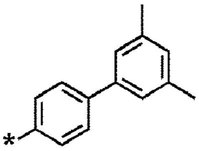
10-78
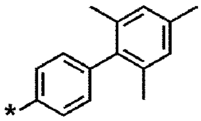
10-79
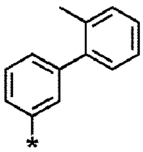
10-80
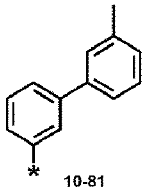
10-81
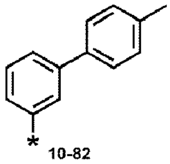
10-82

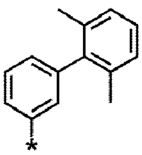
10-83
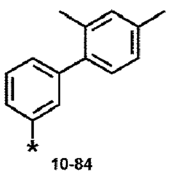
10-84
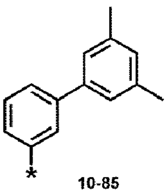
10-85
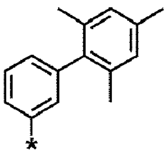
10-86
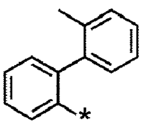
10-87
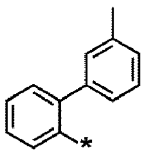
10-88

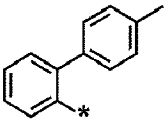
10-89
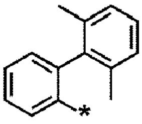
10-90
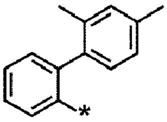
10-91
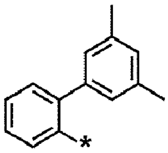
10-92
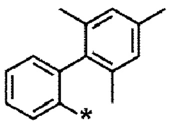
10-93
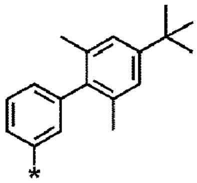
10-94

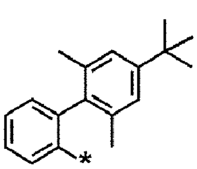
10-95
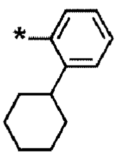
10-96
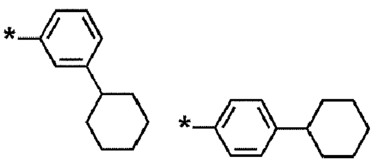
10-97
10-98
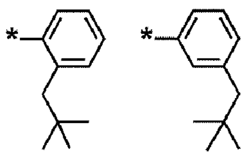
10-99
10-100

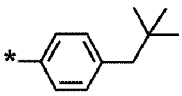
10-101

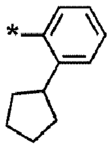
10-102

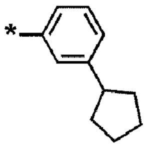
10-103

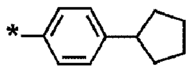
10-104

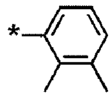
10-105

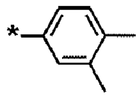
10-106

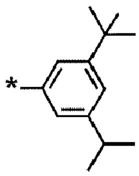
10-107

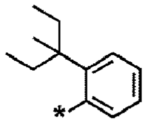
10-108

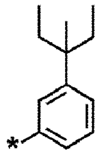
10-109

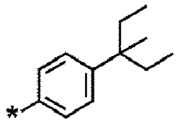
10-110

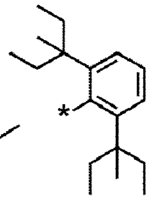
10-111

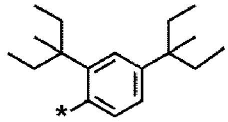
10-112

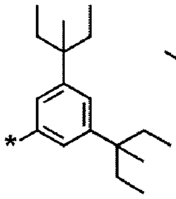
10-113

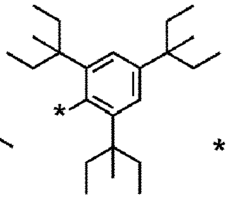
10-114

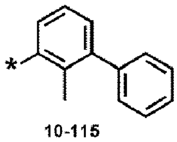
10-115

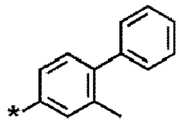
10-116

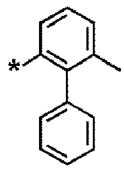
10-117

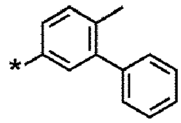
10-118

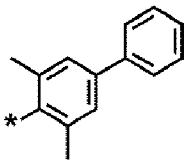
10-119

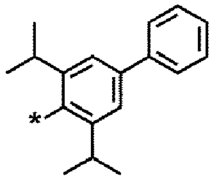
10-120

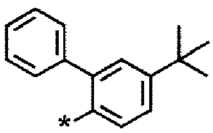
10-121

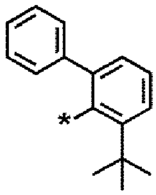
10-122

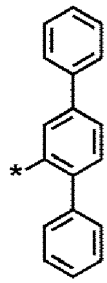
10-123

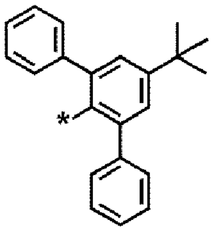
10-124

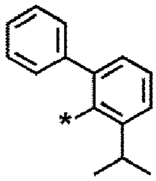
10-125

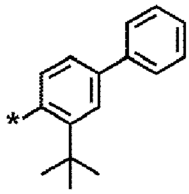
10-126

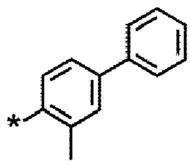
10-127

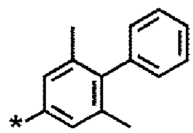
10-128

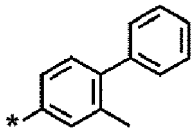
10-129

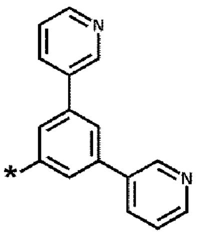
10-201

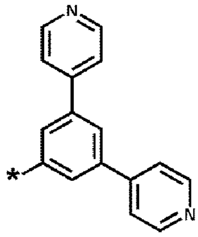
10-202

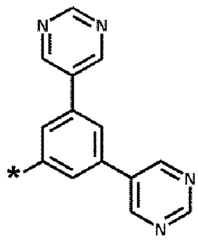
10-203

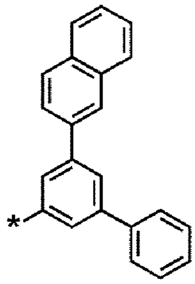
10-204

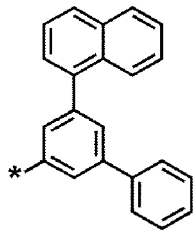
10-205

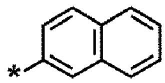
10-206

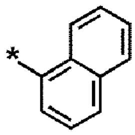
10-207

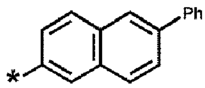
10-208

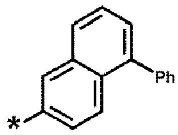
10-209

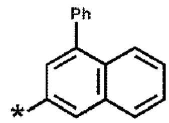
10-210

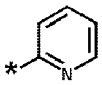
10-211

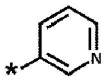
10-212

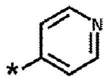
10-213

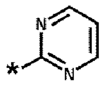
10-214

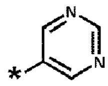
10-215

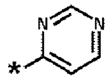
10-216

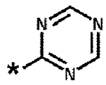
10-217

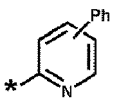
10-218

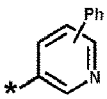
10-219

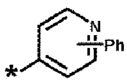
10-220

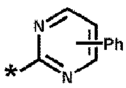
10-221

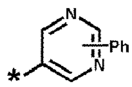
10-222

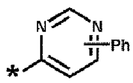
10-223

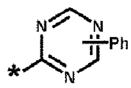
10-224

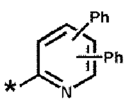
10-225

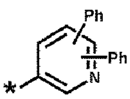
10-226

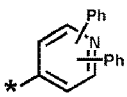
10-227

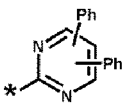
10-228

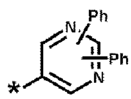
10-229

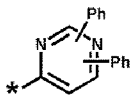
10-230

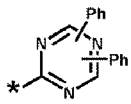
10-231

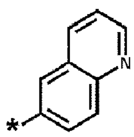
10-232

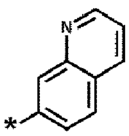
10-233

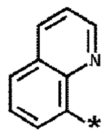
10-234

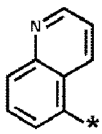
10-235

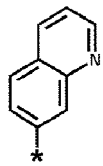
10-236

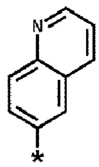
10-237

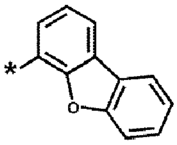
10-238

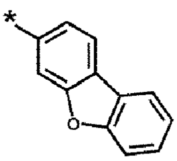
10-239

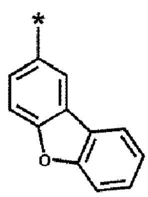
10-240

10-241

10-242

10-243

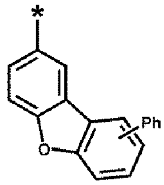
10-244

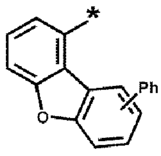
10-245

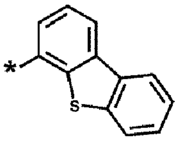
10-246

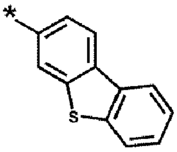
10-247

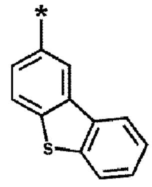
10-248

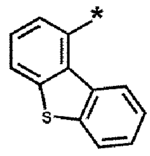
10-249

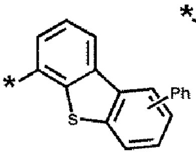
10-250

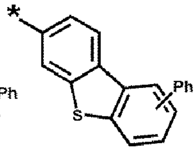
10-251

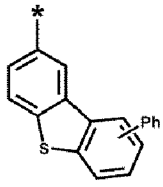
10-252

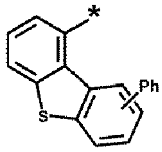
10-253

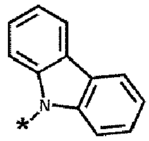
10-254

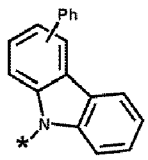
10-255

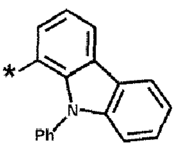
10-256

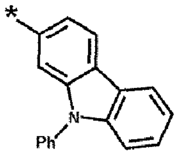
10-257

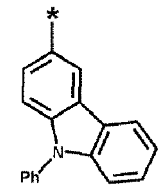
10-258

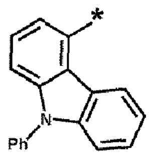
10-259

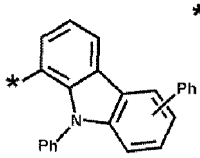
10-260

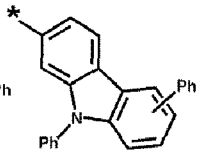
10-261

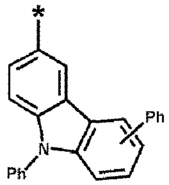
10-262

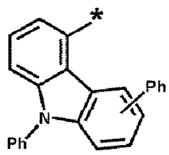
10-263

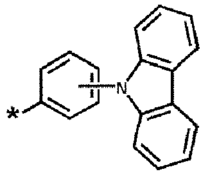
10-264

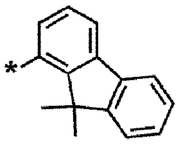
10-265

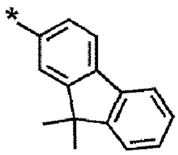
10-266

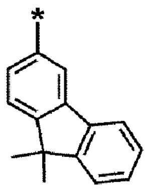
10-267

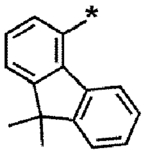
10-268

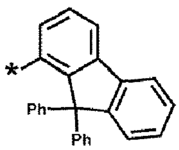
10-269

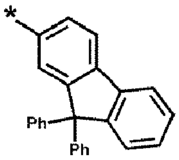
10-270

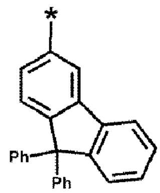
10-271

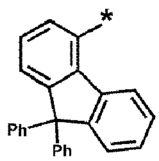
10-272

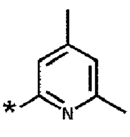
10-273

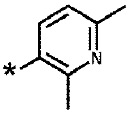
10-274

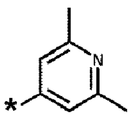
10-275

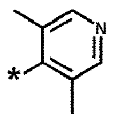
10-276

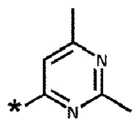
10-277

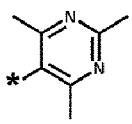
10-278

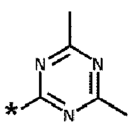
10-279

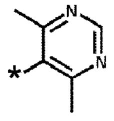
10-280

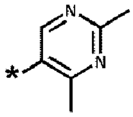
10-281

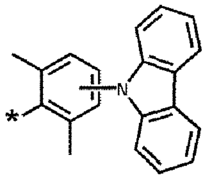
10-282

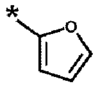
10-283

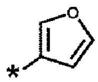
10-284

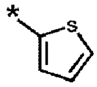
10-285

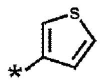
10-286

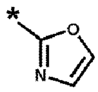
10-287

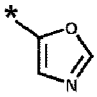
10-288

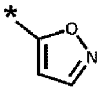
10-289

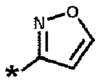
10-290

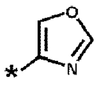
10-291

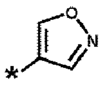
10-292

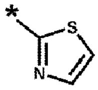
10-293

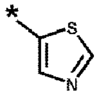
10-294

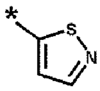
10-295

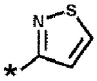
10-296

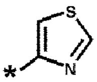
10-297

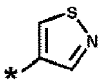
10-298

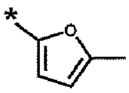
10-299

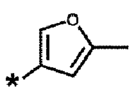
10-300

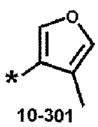
10-301

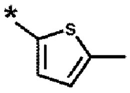
10-302

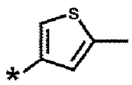
10-303

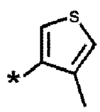
10-304

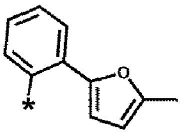
10-305

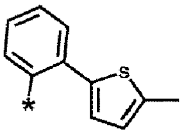
10-306

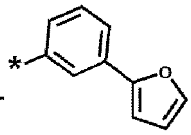
10-307

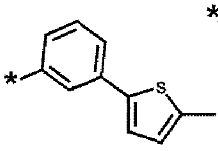
10-308

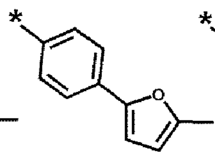
10-309

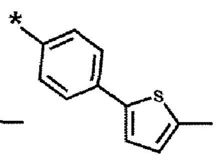
10-310

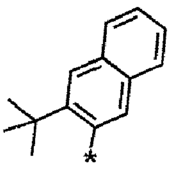
10-311

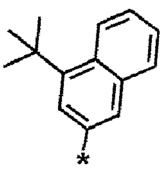
10-312

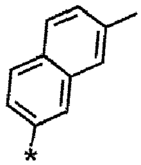
10-313

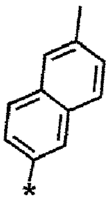
10-314

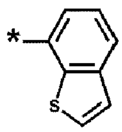
10-315

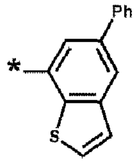
10-316

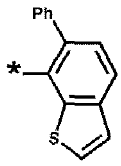
10-317

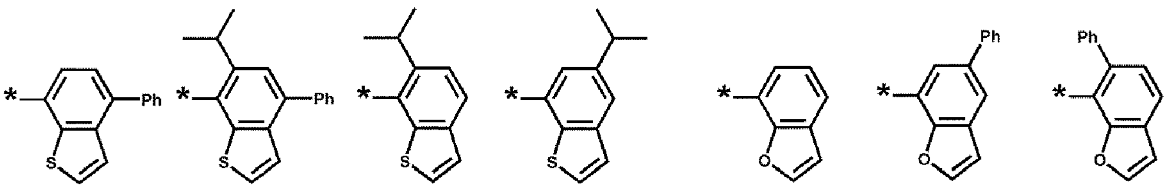
10-318 10-319 10-320 10-321 10-322 10-323 10-324

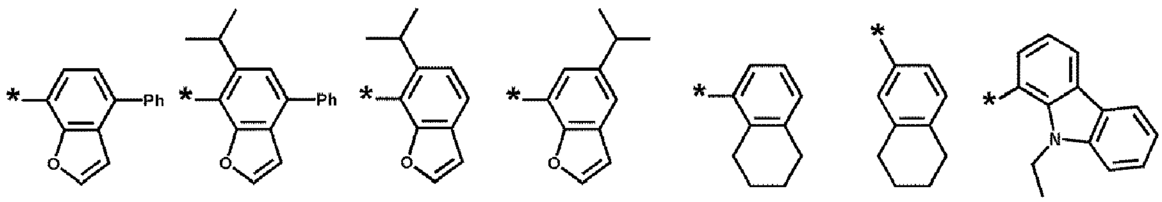
10-325 10-326 10-327 10-328 10-329 10-330 10-331

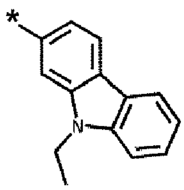 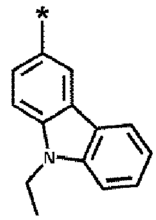 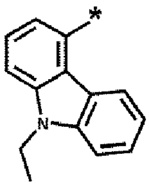 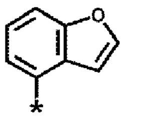 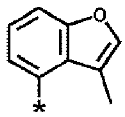 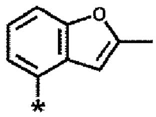

10-332 10-333 10-334 10-335 10-336 10-337

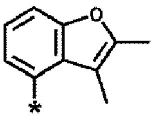 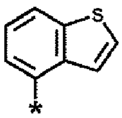 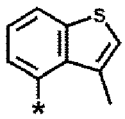 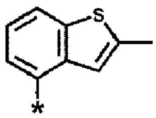 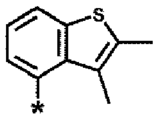 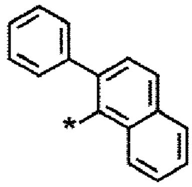

10-338 10-339 10-340 10-341 10-342 10-343

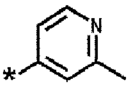 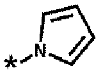 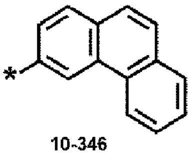 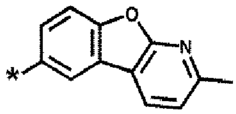 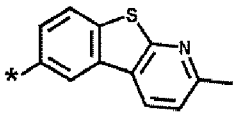

10-344 10-345 10-346 10-347 10-348

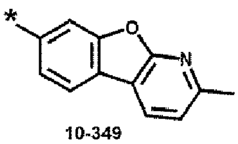 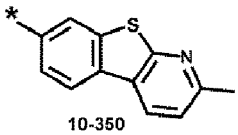

10-349 10-350

wherein, in Formulae 9-1 to 9-39, 9-201 to 9-227, 10-1 to 10-129, and 10-201 to 10-350, * indicates a binding site to an adjacent atom, "Ph" is a phenyl group, "TMS" is a trimethylsilyl group, and "TMG" is a trimethylgermyl group.

The "group represented by one of Formulae 9-1 to 9-39 in which at least one hydrogen is substituted with deuterium" and the "group represented by one of Formulae 9-201 to 9-227 in which at least one hydrogen is substituted with deuterium" may each be, for example, a group represented by one of Formulae 9-501 to 9-514 and 9-601 to 9-636:

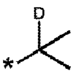 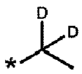 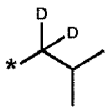 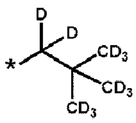 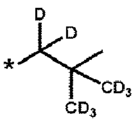 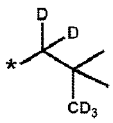 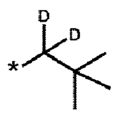

9-501 9-502 9-503 9-504 9-505 9-506 9-507

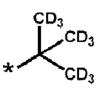 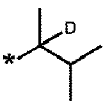 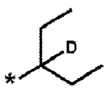 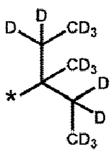 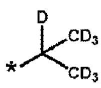 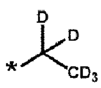 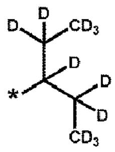

9-508 9-509 9-510 9-511 9-512 9-513 9-514

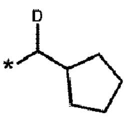 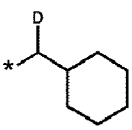 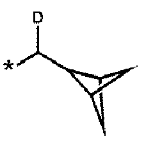 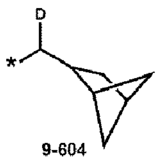 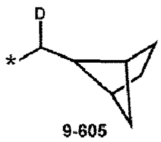 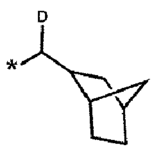 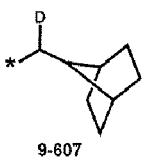

9-601 9-602 9-603 9-604 9-605 9-606 9-607

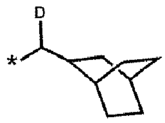 9-608 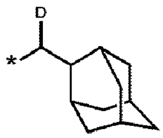 9-609 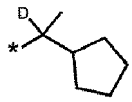 9-610 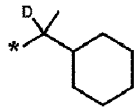 9-611 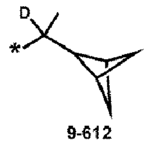 9-612 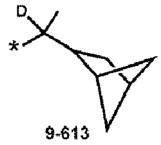 9-613

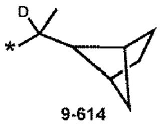 9-614 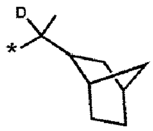 9-615 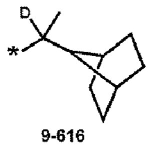 9-616 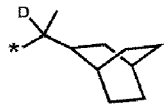 9-617 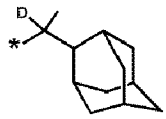 9-618 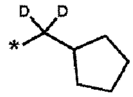 9-619

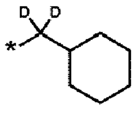 9-620 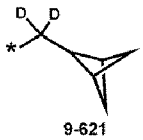 9-621 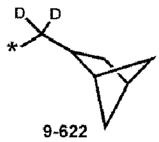 9-622 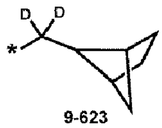 9-623 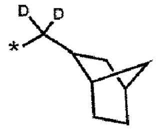 9-624 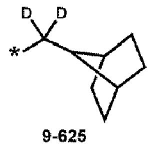 9-625

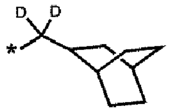 9-626 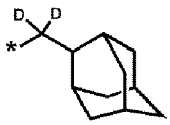 9-627 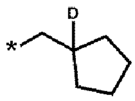 9-628 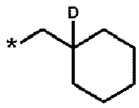 9-629 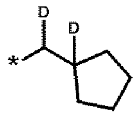 9-630 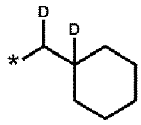 9-631

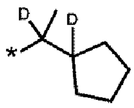 9-632 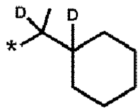 9-633 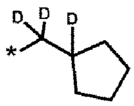 9-634 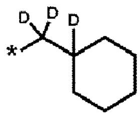 9-635 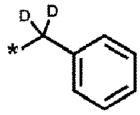 9-636

The "group represented by one of Formulae 9-1 to 9-39 in which at least one hydrogen is substituted with -F" and the "group represented by one of Formulae 9-201 to 9-227 in which at least one hydrogen is substituted with -F" may each be, for example, a group represented by one of Formulae 9-701 to 9-710:

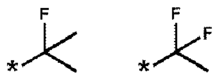 9-701 9-702 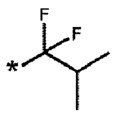 9-703 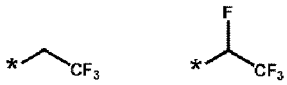 9-704 9-705 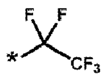 9-706 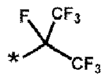 9-707

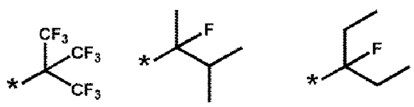 9-708 9-709 9-710

The "group represented by one of Formulae 10-1 to 10-129 in which at least one hydrogen is substituted with deuterium" and "the group represented by one of Formulae 10-201 to 10-350 in which at least one hydrogen is substituted with deuterium" may each be, for example, a group represented by one of Formulae 10-501 to 10-553:

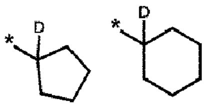 10-501 10-502 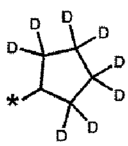 10-503 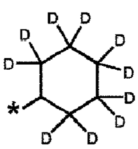 10-504 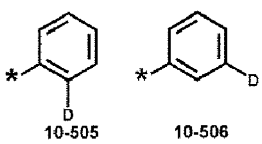 10-505 10-506 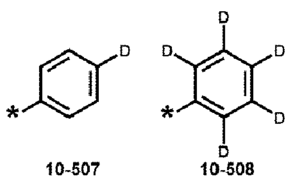 10-507 10-508

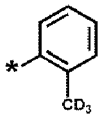
10-509
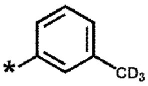
10-510
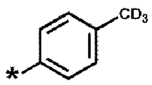
10-511
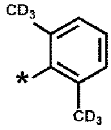
10-512
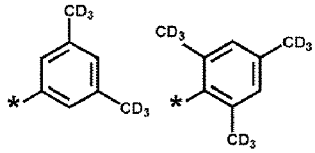
10-513
10-514
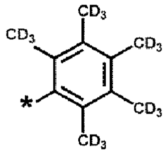
10-515

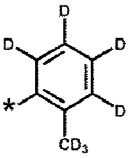
10-516
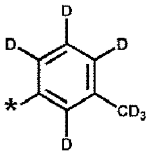
10-517
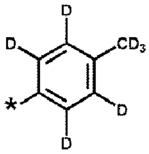
10-518
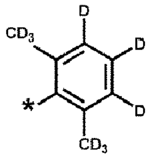
10-519
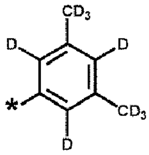
10-520
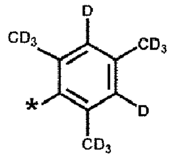
10-521

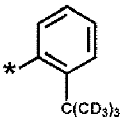
10-522
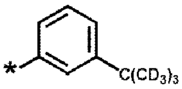
10-523
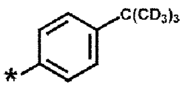
10-524
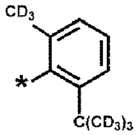
10-525
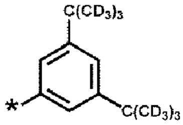
10-526
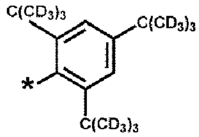
10-527

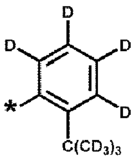
10-528
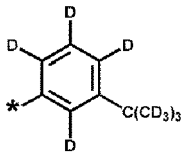
10-529
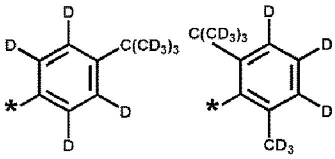
10-530
10-531
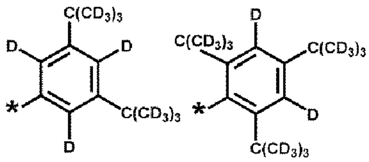
10-532
10-533

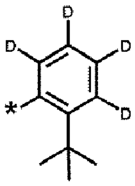
10-534
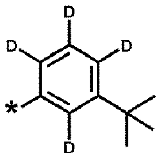
10-535
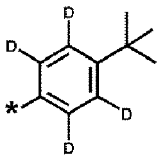
10-536
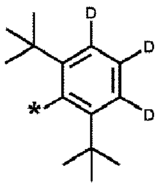
10-537
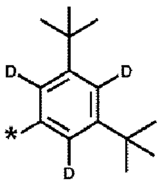
10-538
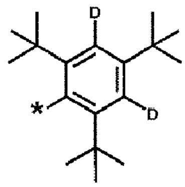
10-540

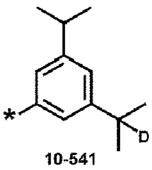
10-541
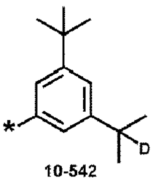
10-542
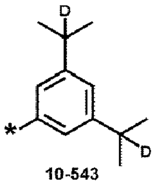
10-543
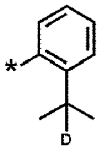
10-544
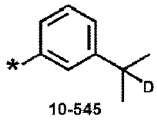
10-545
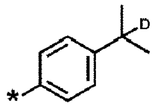
10-546

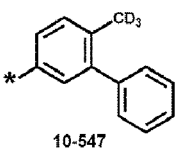
10-547
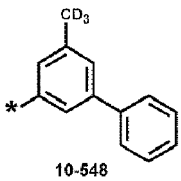
10-548
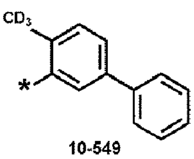
10-549
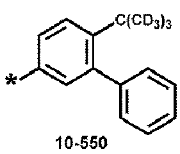
10-550
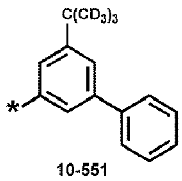
10-551

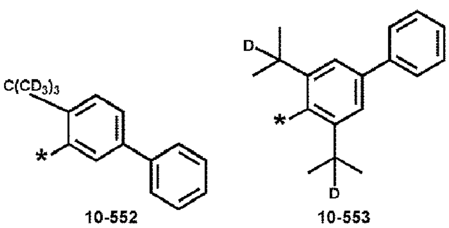
10-552
10-553

The "group represented by one of Formulae 10-1 to 10-129 in which at least one hydrogen is substituted with -F" and the "group represented by one of Formulae 10-201 to 10-350 in which at least one hydrogen is substituted with -F" may each be, for example, a group represented by one of Formulae 10-601 to 10-617:

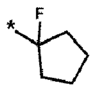
10-601
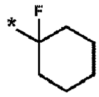
10-602
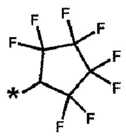
10-603
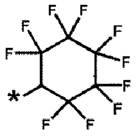
10-604
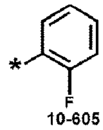
10-605
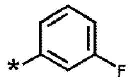
10-606
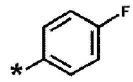
10-607
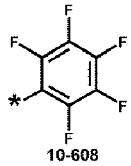
10-608

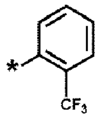
10-609
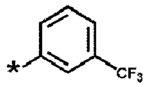
10-610
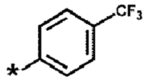
10-611
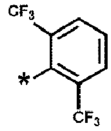
10-612
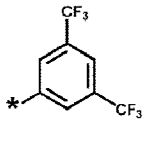
10-613
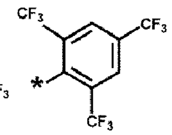
10-614
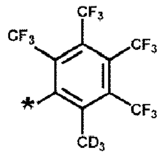
10-615

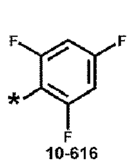
10-616
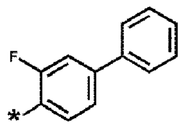
10-617

In Formulae 1, 2-1, and 2-2, c1 to c4 indicate the number of $R_1$(s) to the number of $R_4$(s), respectively; a1 to a4 indicate the number of groups represented by $*\text{-}[(L_1)_{b1}\text{-}(R_1)_{c1}]$, the number of groups represented by $*\text{-}[(L_2)_{b2}\text{-}(R_2)_{c2}]$, the number of groups represented by $*\text{-}[(L_3)_{b3}\text{-}(R_3)_{c3}]$, and the number of groups represented by $*\text{-}[(L_4)_{b4}\text{-}(R_4)_{c4}]$, respectively; e1 to e4 indicate the number of $Z_1$(s) to the number of $Z_4$(s), respectively; and d1 to d4 indicate the number of groups represented by $*\text{-}[W_1\text{-}(Z_1)_{e1}]$, the number of groups represented by $*\text{-}[W_2\text{-}(Z_2)_{e2}]$, the number of groups represented by $*\text{-}[W_3\text{-}(Z_3)_{e3}]$, and the number of groups represented by $*\text{-}[W_4\text{-}(Z_4)_{e4}]$, respectively, and c1 to c4, a1 to a4, e1 to e4, and d1 to d4 may each independently be an integer from 0 to 20. When c1 is 2 or more, two or more of $R_1$(s) may be identical to or different from each other, when c2 is 2 or more, two or more of $R_2$(s) may be identical to or different from each other, when c3 is 2 or more, two or more of $R_3$(s) may be identical to or different from each other, when c4 is 2 or more, two or more of $R_4$(s) may be identical to or different from each other, when a1 is 2 or more, two or more of groups represented by $*\text{-}[(L_1)_{b1}\text{-}(R_1)_{c1}]$ may be identical to or different from each other, when a2 is 2 or more, two or more of groups represented by $*\text{-}[(L_2)_{b2}\text{-}(R_2)_{c2}]$ may be identical to or different from each other, when a3 is 2 or more, two or more of groups represented by $*\text{-}[(L_3)_{b3}\text{-}(R_3)_{c3}]$ may be identical to or different from each other, when a4 is 2 or more, two or more of groups represented by $*\text{-}[(L_4)_{b4}\text{-}(R_1)_{c4}]$ may be identical to or different from each other, when e1 is 2 or more, two or more of $Z_1$(s) may be identical to or different from each other, when e2 is 2 or more, two or more of $Z_2$(s) may be identical to or different from each other, when e3 is 2 or more, two or more of $Z_3$(s) may be identical to or different from each other, when e4 is 2 or more, two or more of $Z_4$(s) may be identical to or different from each other, when d1 is 2 or more, two or more of groups represented by $*\text{-}[W_1\text{-}(Z_1)_{e1}]$ may be identical to or different from each other, when d2 is 2 or more, two or more of groups represented by $*\text{-}[W_2\text{-}(Z_2)_{e2}]$ may be identical to or different from each other, when d3 is 2 or more, two or more of groups represented by $*\text{-}[W_3\text{-}(Z_3)_{e3}]$ may be identical to or different from each other, and when d4 is 2 or more, two or more of groups represented by $*\text{-}[W_4\text{-}(Z_4)_{e1}]$ may be identical to or different from each other. For example, in Formulae 1, 2-1, and 2-2, c1 to c4, a1 to a4, e1 to e4, and d1 to d4 may each independently be 0, 1, 2, or 3.

In one or more embodiments, in Formula 2-1, a case where $Y_1$ is N, ring $A_1$ is a pyridine group, $Y_2$ is C, ring $A_2$ is a benzene group, and d1 and d2 are each 0 may be excluded.

In Formulae 1, 2-1, and 2-2, at least one of i) two or more of a plurality of $R_1$(s), ii) two or more of a plurality of $R_2$(s), iii) two or more of a plurality of $R_3$(s), iv) two or more of a plurality of $R_4$(s), v) $R_{5a}$ and $R_{5b}$, vi) two or more of a plurality of $Z_1$(s), vii) two or more of a plurality of $Z_2$(s), viii) two or more of a plurality of $Z_3$(s), ix) two or more of a plurality of $Z_4$(s), x) two or more of $R_1$ to $R_4$, $R_{5a}$, and $R_{5b}$, and xi) two or more of $Z_1$ to $Z_4$ may optionally be bonded to each other to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$.

$R_{10a}$ is as described in connection with $R_1$.

* and *' in the present specification each indicate a binding site to a neighboring atom, unless otherwise stated.

In one or more embodiments, in Formula 1, n1 may not be 0, n4 may be 0, and a group represented by

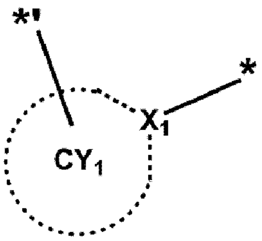

may be a group represented by one of Formulae CY1(1) to CY1(23):

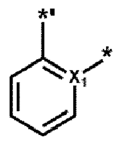
CY1(1)

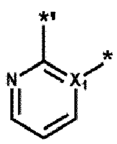
CY1(2)

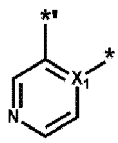
CY1(3)

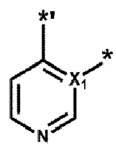
CY1(4)

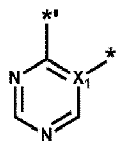
CY1(5)

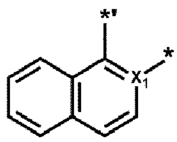
CY1(6)

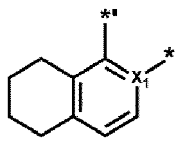
CY1(7)

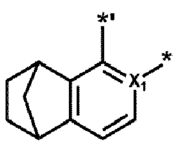
CY1(8)

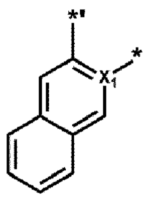
CY1(9)

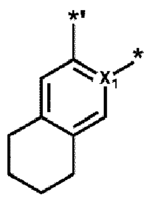
CY1(10)

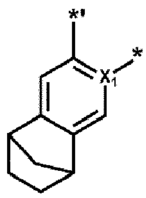
CY1(11)

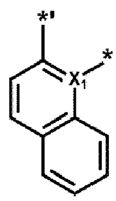
CY1(12)

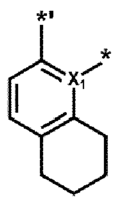
CY1(13)

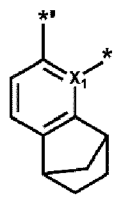
CY1(14)

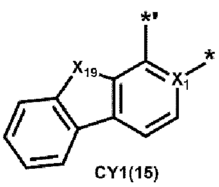
CY1(15)

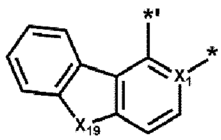
CY1(16)

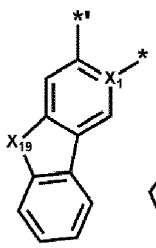
CY1(17)

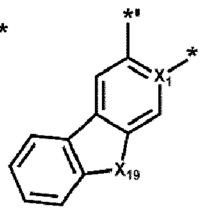
CY1(18)

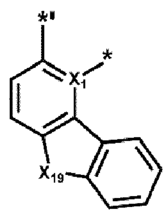
CY1(19)

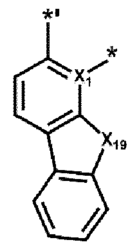
CY1(20)

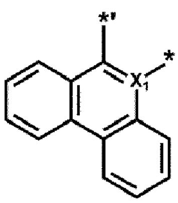
CY1(21)

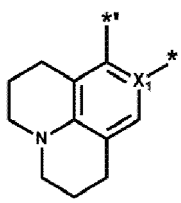
CY1(22)

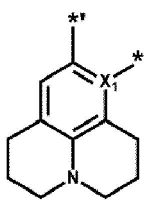
CY1(23)

wherein, in Formulae CY1(1) to CY1(23),

$X_1$ is as described in the present specification,
$X_{19}$ may be O, S, Se, $N(R_{19a})$, $C(R_{19a})(R_{19b})$, or $Si(R_{19a})(R_{19b})$,
$R_{19a}$ and $R_{19b}$ are respectively as those described in connection with $R_1$,
* indicates a binding site to $X_5$ or $M_1$ in Formula 1, and
*' indicates a binding site to $T_{11}$ in Formula 1.

In one or more embodiments, in Formula 1, n1 may be 1, n4 may be 0, and a group represented by

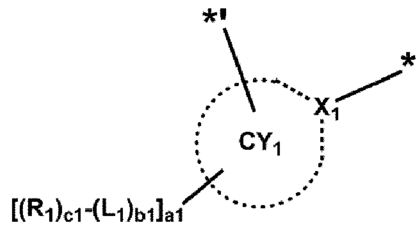

may be a group represented by one of Formulae CY1-1 to CY1-18:

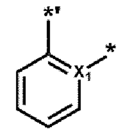
CY1-1

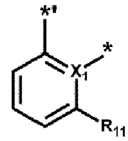
CY1-2

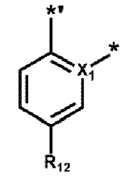
CY1-3

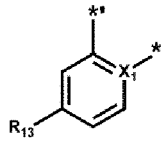
CY1-4

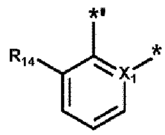
CY1-5

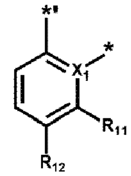
CY1-6

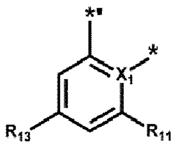
CY1-7

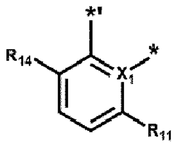
CY1-8

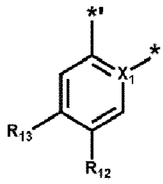
CY1-9

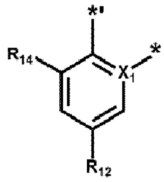
CY1-10

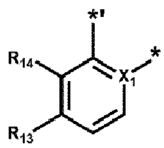
CY1-11

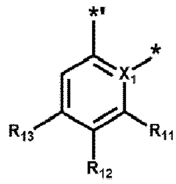
CY1-12

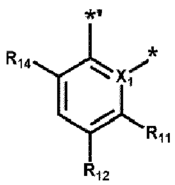
CY1-13

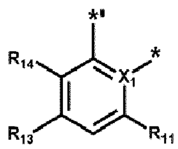
CY1-14

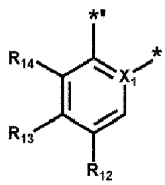
CY1-15

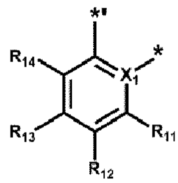
CY1-16

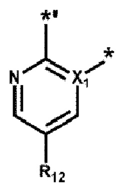
CY1-17

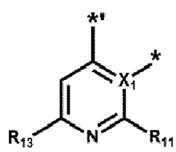
CY1-18

wherein, in Formulae CY1-1 to CY1-18,

$X_1$ is as described in the present specification,
$R_{11}$ to $R_{14}$ are each as described in connection with $R_1$, wherein $R_{11}$ to $R_{14}$ are each not hydrogen,
* indicates a binding site to $X_5$ or $M_1$ in Formula 1, and
*' indicates a binding site to $T_{11}$ in Formula 1.

In one or more embodiments, in Formula 1, n1 and n2 may each be 1, and ring $CY_2$ may be a group represented by Formula CY2A or CY2B:

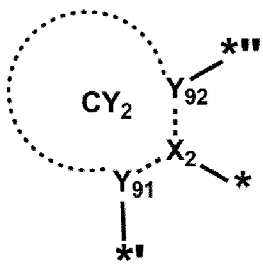
CY2A

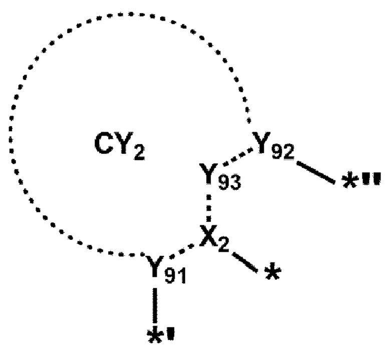
CY2B

wherein, in Formulae CY2A and CY2B,

$X_2$ and ring $CY_2$ are respectively as those described in the present specification,
$Y_{91}$ and $Y_{92}$ may each independently be N, C, or Si, and $Y_{93}$ may be O, S, N, C, or Si,
in Formulae CY2A and CY2B, a bond between $X_2$ and $Y_{91}$, a bond between $X_2$ and $Y_{92}$, a bond between $X_2$ and $Y_{93}$, and a bond between $Y_{92}$ and $Y_{93}$ may each be a chemical bond,
*' indicates a binding site to $T_{11}$ in Formula 1,
* indicates a binding site to $M_1$ in Formula 1, and
*" indicates a binding site to $T_{12}$ in Formula 1.

In one or more embodiments, in Formula 1, each of n1 and n2 may not be 0, and a group represented by

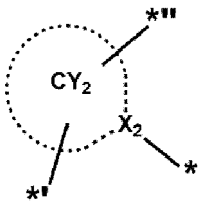

may be a group represented by one of Formulae CY2(1) to CY2(21):

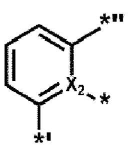
CY2(1)
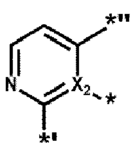
CY2(2)
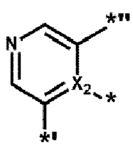
CY2(3)
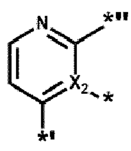
CY2(4)
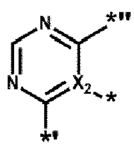
CY2(5)
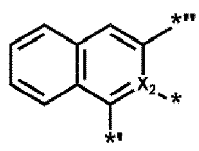
CY2(6)
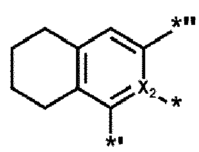
CY2(7)

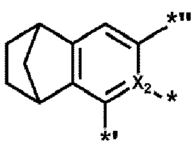
CY2(8)
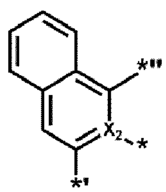
CY2(9)
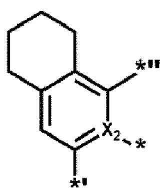
CY2(10)
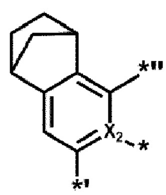
CY2(11)
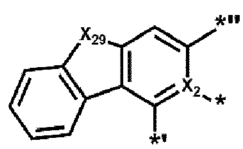
CY2(12)

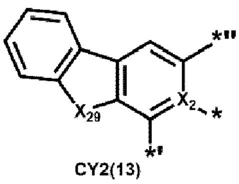
CY2(13)
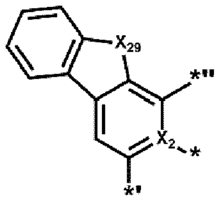
CY2(14)
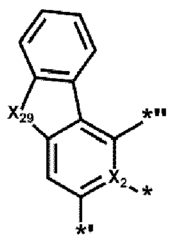
CY2(15)
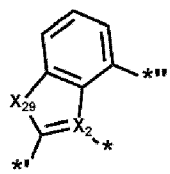
CY2(16)
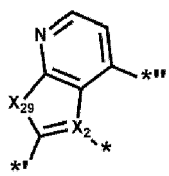
CY2(17)

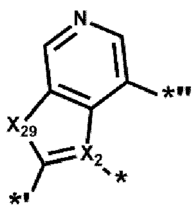
CY2(18)
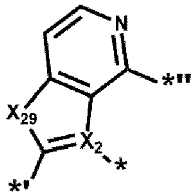
CY2(19)
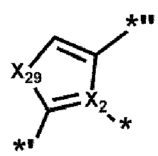
CY2(20)
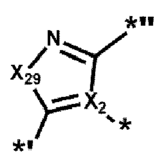
CY2(21)

wherein, in Formulae CY2(1) to CY2(21),

$X_2$ is as described in the present specification,
$X_{29}$ may be O, S, N-[$(L_2)_{b2}$-$(R_2)_{c2}$], C($R_{29a}$)($R_{29b}$), or Si($R_{29a}$)($R_{29b}$),
$L_2$, b2, $R_2$, and c2 are respectively as those described in the present specification,
$R_{29a}$ and $R_{29b}$ are each as described in connection with $R_2$,
*' indicates a binding site to $T_{11}$ in Formula 1,
* indicates a binding site to $X_6$ or $M_1$ in Formula 1, and
*" indicates a binding site to $T_{12}$ in Formula 1.

In one or more embodiments, in Formula 1, each of n1 and n2 may be 1, and a group represented by

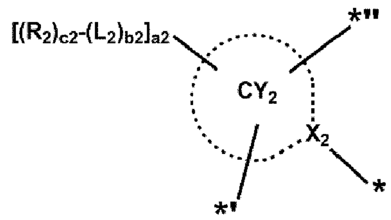

may be a group represented by one of Formulae CY2-1 to CY2-16:

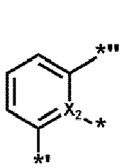 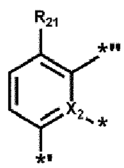 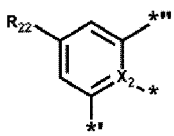 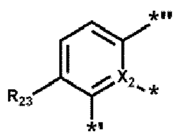 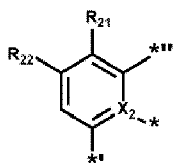 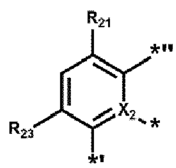

CY2-1 CY2-2 CY2-3 CY2-4 CY2-5 CY2-6

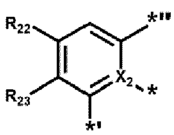 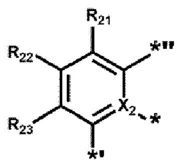 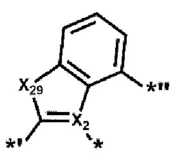 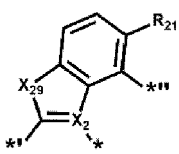 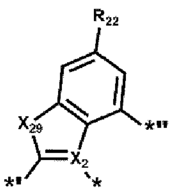 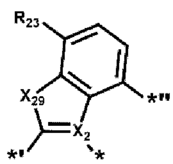

CY2-7 CY2-8 CY2-9 CY2-10 CY2-11 CY2-12

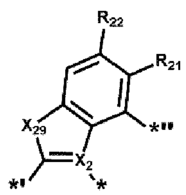 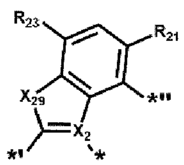 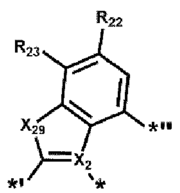 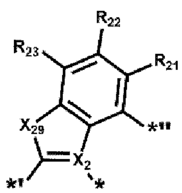

CY2-13 CY2-14 CY2-15 CY2-16

wherein, in Formulae CY2-1 to CY2-16,

$X_2$ is as described in the present specification,
$X_{29}$ may be O, S, N-[$(L_2)_{b2}$-$(R_2)_{c2}$], C($R_{29a}$)($R_{29b}$), or Si($R_{29a}$)($R_{29b}$),
$L_2$, b2, $R_2$, and c2 are respectively as those described in the present specification,
$R_{21}$ to $R_{23}$, $R_{29a}$, and $R_{29b}$ are each as described in connection with $R_2$, wherein $R_{21}$ to $R_{23}$ are each not hydrogen,
*' indicates a binding site to $T_{11}$ in Formula 1,
* indicates a binding site to $X_6$ or $M_1$ in Formula 1, and
*" indicates a binding site to $T_{12}$ in Formula 1.

In one or more embodiments, in Formula 1,

each of n1 and n2 may be 1,
a group represented by

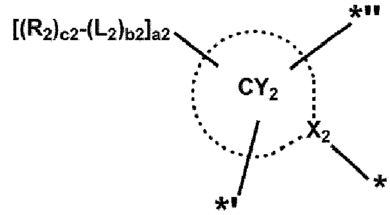

may be a group represented by one of Formulae CY2-9 to CY2-16,
$X_{29}$ in Formulae CY2-9 to CY2-16 may be N-$[(L_2)_{b2}$-$(R_2)_{c2}]$,
$L_2$ may be a benzene group unsubstituted or substituted with at least one R10a,
b2 may be 1 or 2,
c2 may be 1 or 2,
when c2 is 1, $R_2$ may be a phenyl group unsubstituted or substituted with at least one of deuterium, a $C_1$-$C_{20}$ alkyl group, a phenyl group, a deuterated phenyl group, a ($C_1$-$C_{20}$alkyl)phenyl group, or a combination thereof; and when c2 is 2, a) one of two $R_2$(s) may be a phenyl group unsubstituted or substituted with deuterium, a $C_1$-$C_{20}$ alkyl group, a phenyl group, a deuterated phenyl group, a ($C_1$-$C_{20}$ alkyl)phenyl group, or a combination thereof, and b) the other $R_2$ may be a $C_4$-$C_{20}$ alkyl group or a deuterated $C_1$-$C_{20}$ alkyl group, each unsubstituted or substituted with at least one $C_3$-$C_{10}$ cycloalkyl group.

In one or more embodiments, in Formula 1, each of n2 and n3 may not be 0, and a group represented by

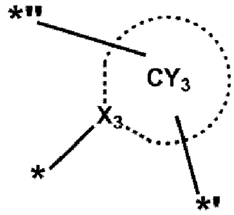

may be a group represented by one of Formulae CY3(1) to CY3(15):

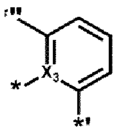
CY3(1)

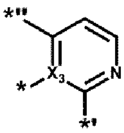
CY3(2)

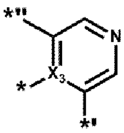
CY3(3)

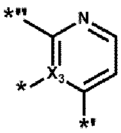
CY3(4)

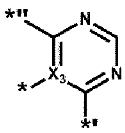
CY3(5)

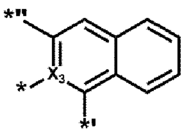
CY3(6)

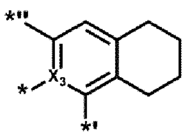
CY3(7)

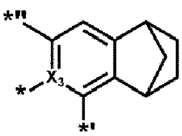
CY3(8)

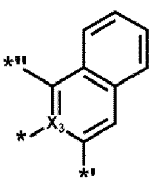
CY3(9)

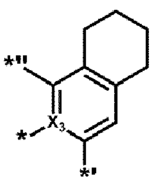
CY3(10)

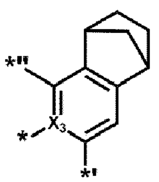
CY3(11)

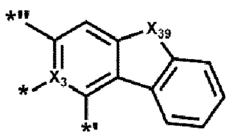
CY3(12)

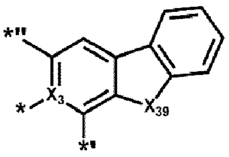
CY3(13)

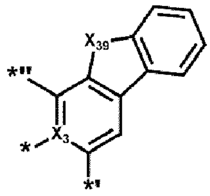
CY3(14)

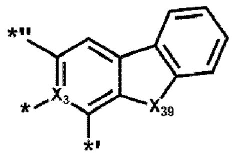
CY3(15)

wherein, in Formulae CY3(1) to CY3(15),

$X_3$ is as described in the present specification,
$X_{39}$ may be O, S, $N(Z_{39a})$, $C(R_{39a})(R_{39b})$, or $Si(R_{39a})(R_{39b})$,
$R_{39a}$ and $R_{39b}$ are each as described in connection with $R_3$,
*" indicates a binding site to $T_{12}$ in Formula 1,
* indicates a binding site to $X_7$ or $M_1$ in Formula 1, and
*' indicates a binding site to $T_{13}$ in Formula 1.

In one or more embodiments, in Formula 1, each of n2 and n3 may be 1, and a group represented by

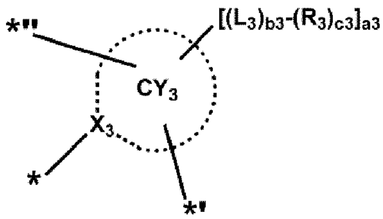

may be a group represented by one of Formulae CY3-1 to CY3-13:

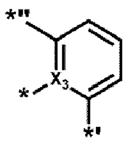
CY3-1

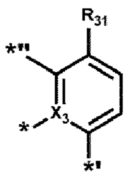
CY3-2

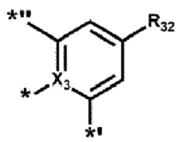
CY3-3

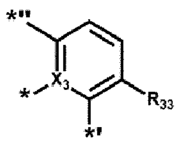
CY3-4

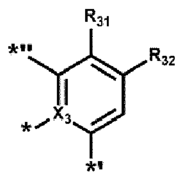
CY3-5

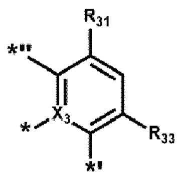
CY3-6

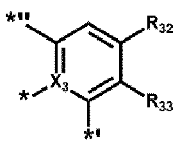
CY3-7

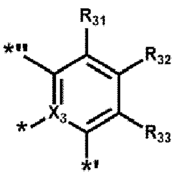
CY3-8

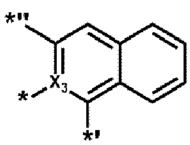
CY3-8

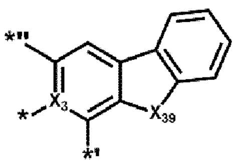
CY3-9

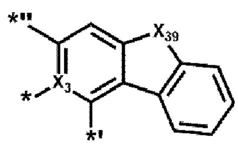
CY3-10

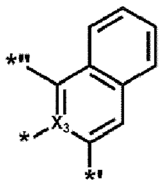
CY3-11

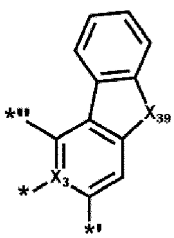
CY3-12

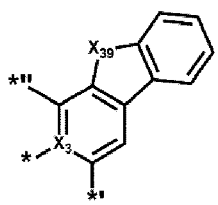
CY3-13

wherein, in Formulae CY3-1 to CY3-31,

$X_3$ is as described in the present specification,
$X_{39}$ may be O, S, N-[$(L_3)_{b3}$-$(R_3)_{c3}$], $C(R_{39a})(R_{39b})$, or $Si(R_{39a})(R_{39b})$,
$L_3$, b3, $R_3$, and c3 are respectively as those described in the present specification,
$R_{31}$ to $R_{33}$, $R_{39a}$, and $R_{39b}$ are each as described in connection with $R_3$, wherein $R_{31}$ to $R_{33}$ are each not hydrogen,
*" indicates a binding site to $T_{12}$ in Formula 1,
* indicates a binding site to $X_7$ or $M_1$ in Formula 1, and
*' indicates a binding site to $T_{13}$ in Formula 1.

In one or more embodiments, in Formula 1, n3 may not be 0, n4 may be 0, and a group represented by

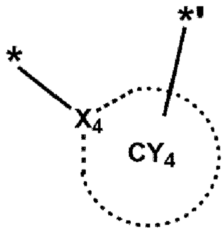

may be a group represented by one of Formulae CY4(1) to CY4(20):

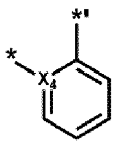
CY4(1)
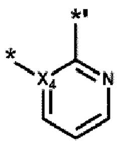
CY4(2)
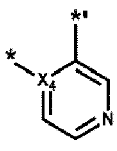
CY4(3)
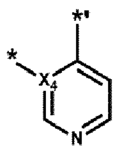
CY4(4)
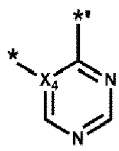
CY4(5)
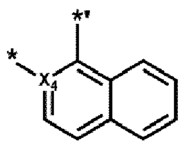
CY4(6)
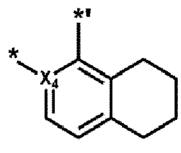
CY4(7)

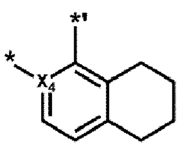
CY4(8)
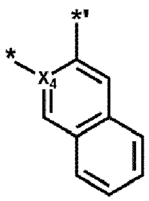
CY4(9)
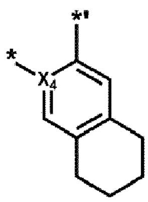
CY4(10)
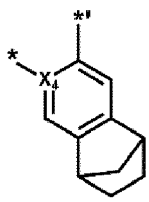
CY4(11)
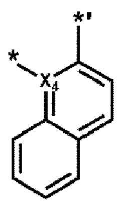
CY4(12)
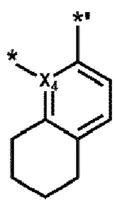
CY4(13)
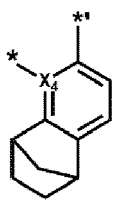
CY4(14)

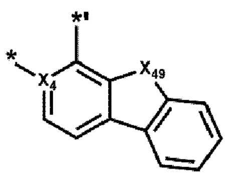
CY4(15)
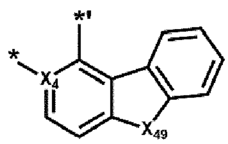
CY4(16)
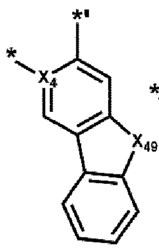
CY4(17)
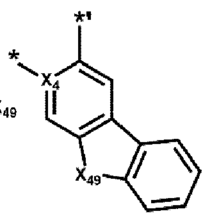
CY4(18)
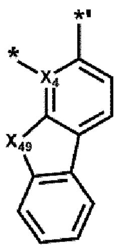
CY4(19)
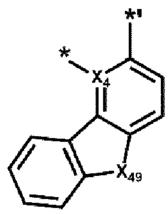
CY4(20)

wherein, in Formulae CY4(1) to CY4(20),

$X_4$ is as described in the present specification,
$X_{49}$ may be O, S, $N(R_{49a})$, $C(R_{49a})(R_{49b})$, or $Si(R_{49a})(R_{49b})$,
$R_{49a}$ and $R_{49b}$ are each as described in connection with $R_4$,
*' indicates a binding site to $T_{13}$ in Formula 1, and
* indicates a binding site to $X_8$ or $M_1$ in Formula 1.

In one or more embodiments, in Formula 1, n3 may be 1, n4 may be 0, and a group represented by

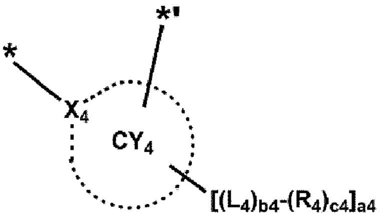

may be a group represented by one of Formulae CY4-1 to CY4-16:

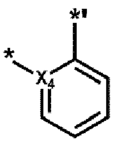
CY4-1

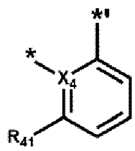
CY4-2

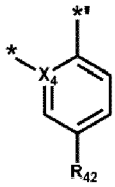
CY4-3

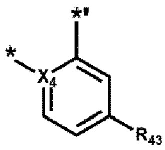
CY4-4

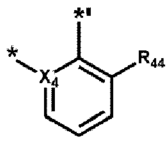
CY4-5

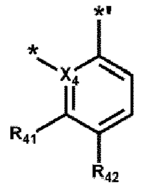
CY4-6

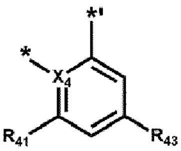
CY4-7

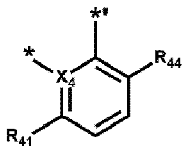
CY4-8

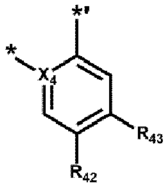
CY4-9

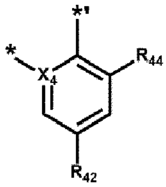
CY4-10

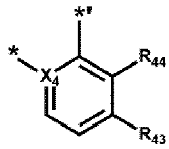
CY4-11

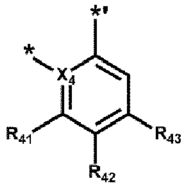
CY4-12

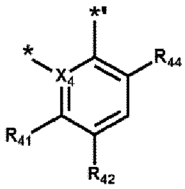
CY4-13

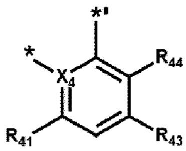
CY4-14

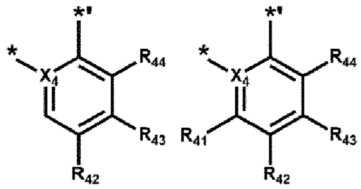
CY4-15 CY4-16

wherein, in Formulae CY4-1 to CY4-16,

$X_4$ is as described in the present specification,
$R_{41}$ to $R_{44}$ are each as described in connection with $R_4$, wherein $R_{41}$ to $R_{44}$ are each not hydrogen,
*' indicates a binding site to $T_{13}$ in Formula 1, and
* indicates a binding site to $X_8$ or $M_1$ in Formula 1.

In one or more embodiments, the platinum-containing organometallic compound may be a compound represented by one of Formulae 1-1 to 1-3:

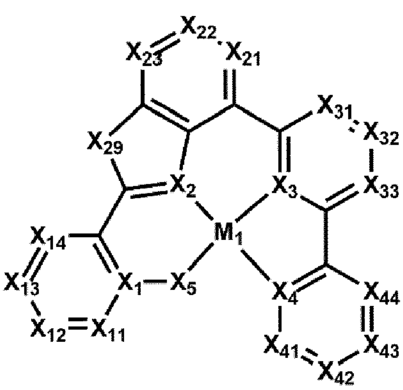
1-1

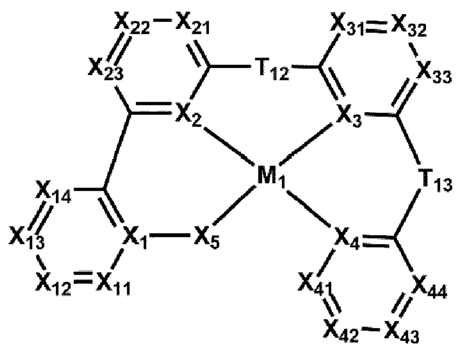
1-2

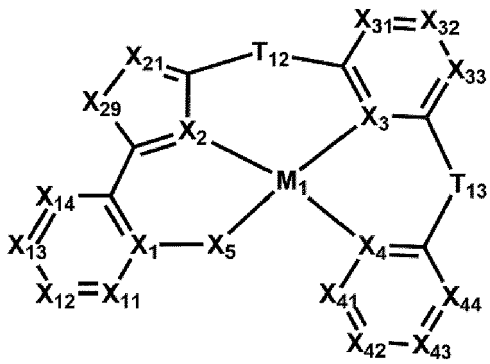

1-3

wherein, in Formulae 1-1 to 1-3,

$M_1$, $X_1$ to $X_5$, $T_{12}$, and $T_{13}$ are respectively as those described in the present specification,
$X_{11}$ may be N or C($R_{11}$), $X_{12}$ may be N or C($R_{12}$), $X_{13}$ may be N or C($R_{13}$), and $X_{14}$ may be N or C($R_{14}$),
$R_{11}$ to $R_{14}$ are each as described in connection with $R_1$,
two or more of $R_{11}$ to $R_{14}$ may optionally be bonded to each other to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$,
$X_{21}$ may be N or C($R_{21}$), $X_{22}$ may be N or C($R_{22}$), and $X_{23}$ may be N or C($R_{23}$),
$X_{29}$ may be O, S, N-[$(L_2)_{b2}$-$(R_2)_{c2}$], C($R_{29a}$)($R_{29b}$), or Si($R_{29a}$)($R_{29b}$),
$L_2$, b2, $R_2$, and c2 may each be as described herein,
$R_{21}$ to $R_{23}$, $R_{29a}$, and $R_{29b}$ are each as described in connection with $R_2$,
two or more of $R_{21}$ to $R_{23}$ may optionally be bonded to each other to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$,
$X_{31}$ may be N or C($R_{31}$), $X_{32}$ may be N or C($R_{32}$), and $X_{33}$ may be N or C(R33),
$R_{31}$ to $R_{33}$ are each as described in connection with $R_3$,
two or more of $R_{31}$ to $R_{33}$ may optionally be bonded to each other to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$,
$X_{41}$ may be N or C($R_{41}$), $X_{42}$ may be N or C($R_{42}$), $X_{43}$ may be N or C($R_{43}$), and $X_{44}$ may be N or C($R_{44}$),
$R_{41}$ to $R_{44}$ are each as described in connection with $R_4$, and
two or more of $R_{41}$ to $R_{44}$ may optionally be bonded to each other to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$.

In one or more embodiments,

$Y_1$ in Formula 2-1 may be N, and
a group represented by

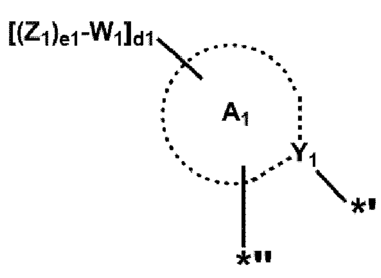

in Formula 2-1 may be a group represented by one of Formulae A1-1 to A1-3:

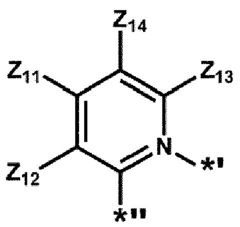
A1-1

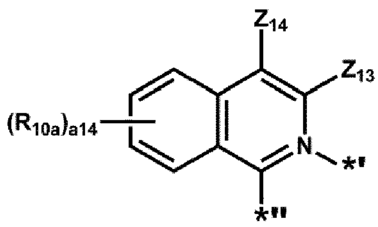
A1-2

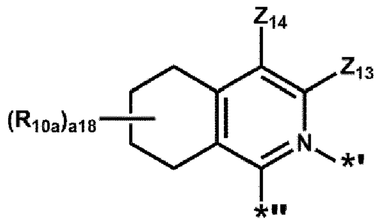
A1-3

wherein, in Formulae A1-1 to A1-3,

$Z_{11}$ to $Z_{14}$ are each as described in connection with $Z_1$,
$R_{10a}$ is as described in the present specification,
a14 may be an integer from 0 to 4,
a18 may be an integer from 0 to 8,
*' indicates a binding site to $M_2$ in Formula 2, and
*" indicates a binding site to ring $A_2$.

For example, $Z_{14}$ in Formulae A1-1 to A1-3 may be a deuterated $C_1$-$C_{20}$ alkyl group, -Si($Q_3$)($Q_4$)($Q_5$), or -Ge($Q_3$)($Q_4$)($Q_5$).

In one or more embodiments,

$Y_3$ in Formula 2-2 may be N, and
a group represented by

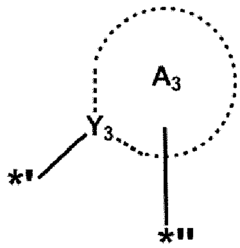

in Formula 2-2 may be a group represented by one of Formulae NR1 to NR48:

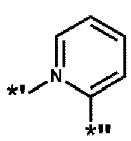
NR1

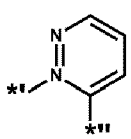
NR2

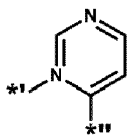
NR3

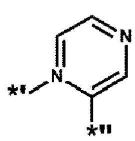
NR4

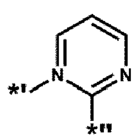
NR5

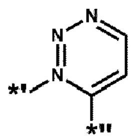
NR6

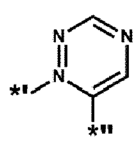
NR7

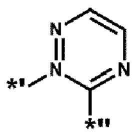
NR8

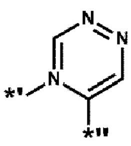
NR9

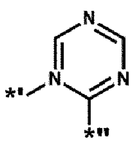
RN10

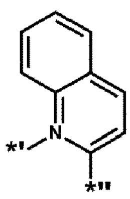
NR11

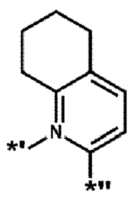
NR12

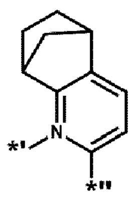
NR13

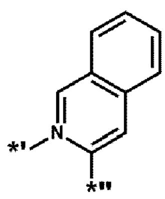
NR14

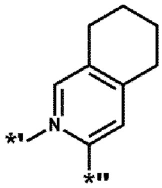
NR15

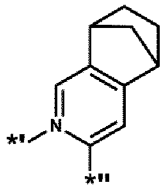
NR16

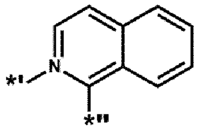
NR17

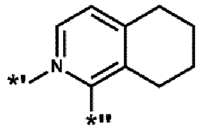
NR18

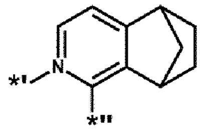
NR19

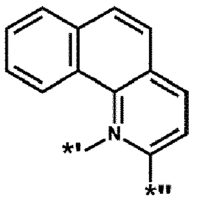
NR20

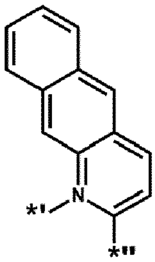
NR21

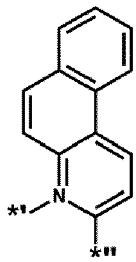
NR22

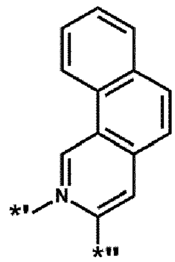
NR23

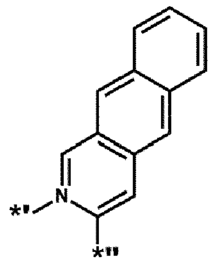
NR24

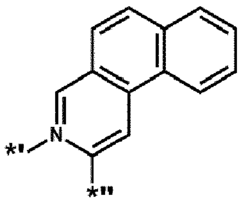
NR25

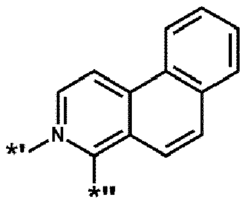
NR26

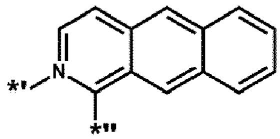
NR27

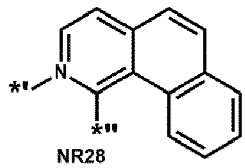
NR28

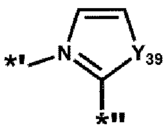
NR29

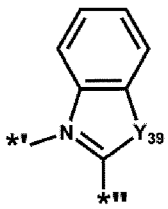
NR30

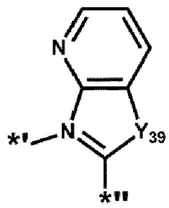
NR31

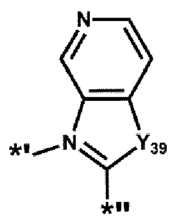
NR32

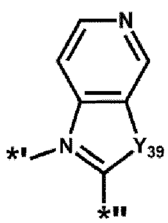
NR33

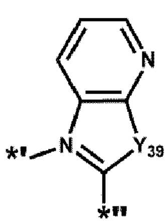
NR34

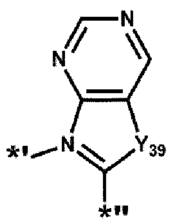
NR35

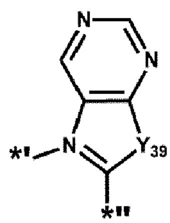
NR36

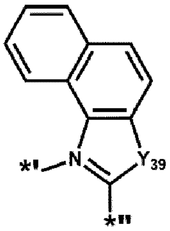
NR37

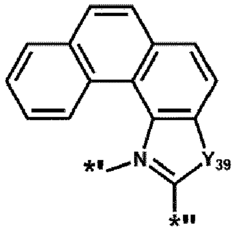
NR38

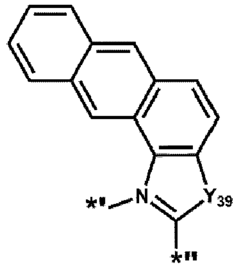
NR39

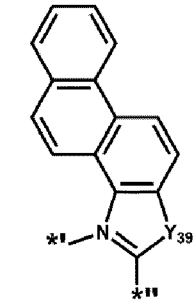
NR40

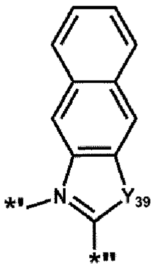
NR41

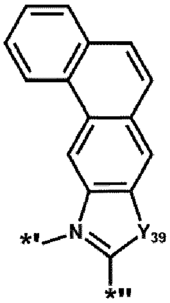
NR42

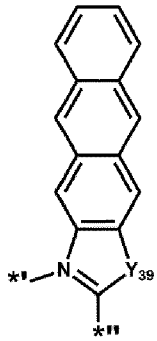
NR43

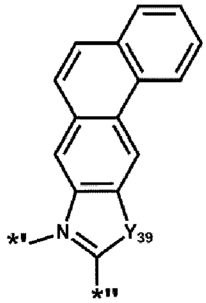
NR44

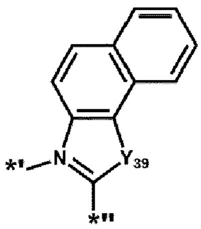
NR45

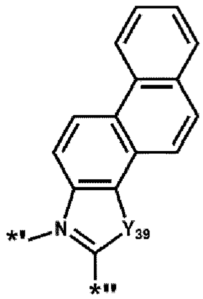
NR46

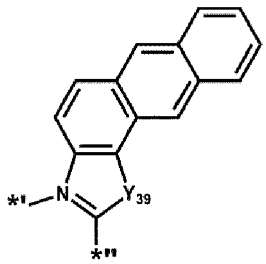
NR47

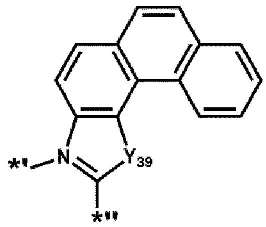
NR48

wherein, in Formulae NR1 to NR48,

$Y_{39}$ may be O, S, Se, N-[$W_3$-$(Z_3)_{e3}$], $C(Z_{39a})(Z_{39b})$, or $Si(Z_{39a})(Z_{39b})$,
$W_3$, $Z_3$, and e3 are each as described in the present specification, and $Z_{39a}$ and $Z_{39b}$ are each as described in connection with $Z_3$ in the present specification,
*' indicates a binding site to $M_2$ in Formula 2, and
*" indicates a binding site to ring $A_4$.

In one or more embodiments,

$Y_2$ and $Y_4$ in Formulae 2-1 and 2-2 may each be C, and
a group represented by

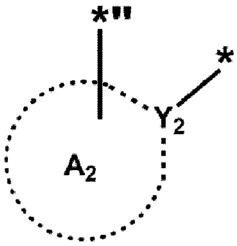

in Formula 2-1, and a group represented by

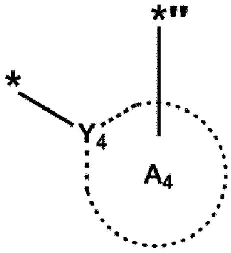

in Formula 2-2 may each independently be a group represented by one of Formulae CR1 to CR29:

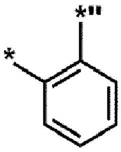
CR1

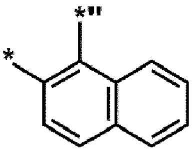
CR2

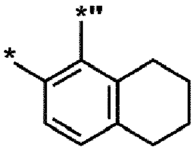
CR3

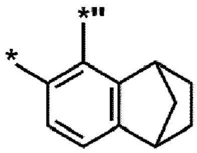
CR4

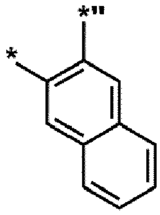
CR5

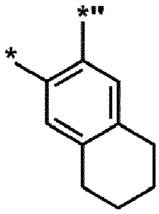
CR6

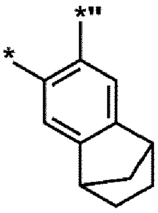
CR7

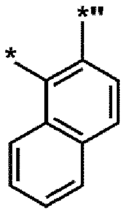
CR8

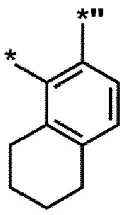
CR9

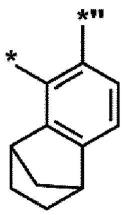
CR10

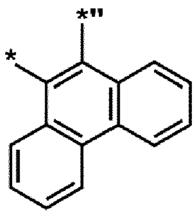
CR11

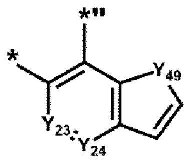
CR12

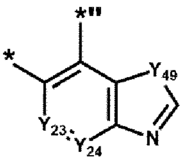
CR13

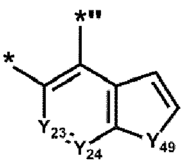
CR14

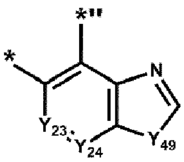
CR15

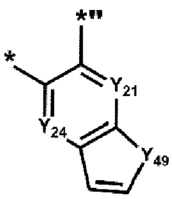
CR16

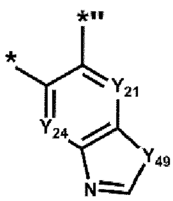
CR17

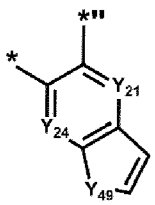
CR18

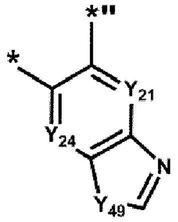
CR19

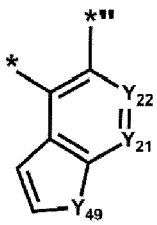
CR20

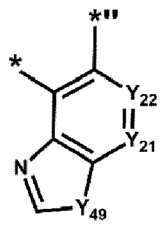
CR21

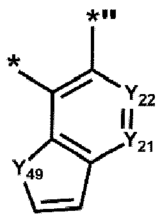
CR22

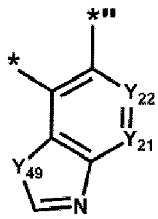
CR23

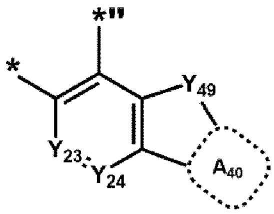
CR24

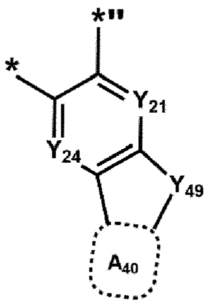
CR25

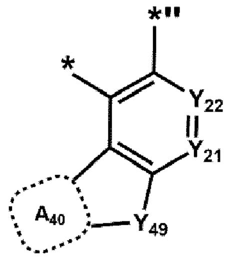
CR26

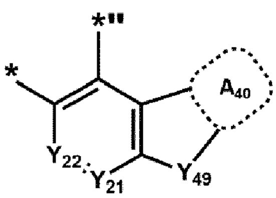
CR27

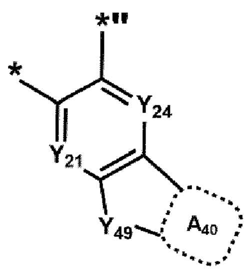
CR28

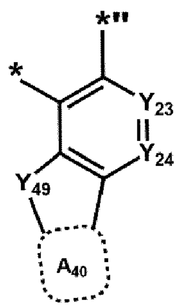
CR29

wherein, in Formulae CR1 to CR29,

$Y_{49}$ may be O, S, Se, N-[$W_2$-$(Z_2)_{e2}$], N-[$W_4$-$(Z_4)_{e4}$], C($Z_{29a}$)($Z_{29b}$), C(Z49a)(Z49b), Si(Z29a)(Z29b), or Si(Z49a)(Z49b), $W_2$, $W_4$, $Z_2$, $Z_4$, e2, and e4 are each as described in the present specification, $Z_{29a}$ and $Z_{29b}$ are each as described in connection with $Z_2$ in the present specification, and $Z_{49a}$ and $Z_{49b}$ are each as described in connection with $Z_4$ in the present specification,
$Y_{21}$ to $Y_{24}$ may each independently be N or C,
ring $A_{40}$ may be a $C_5$-$C_{30}$ carbocyclic group or a $C_1$-$C_{30}$ heterocyclic group (for example, a benzene group, a naphthalene group, a phenanthrene group, a pyridine group, a pyrimidine group, a pyrazine group, a pyridazine group, a quinoline group, an isoquinoline group, a benzoquinoline group, a benzoisoquinoline group, a quinoxaline group, a benzoquinoxaline group, a quinazoline group, or a benzoquinazoline group),
indicates a binding site to $M_2$ in Formula 2, and
*" indicates a binding site to ring $A_1$ or ring $A_3$.

In one or more embodiments,

a group represented by

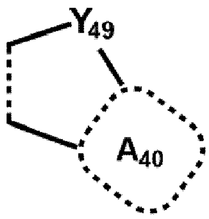

in Formulae CR24 to CR29 may be a group represented by one of Formulae CR(1) to CR(13):

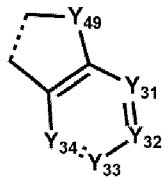

CR(1)

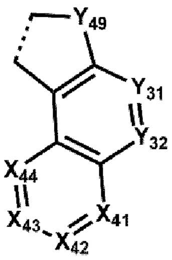

CY(2)

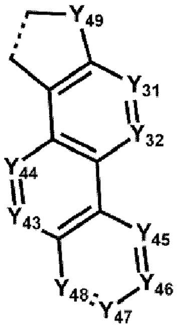

CR(3)

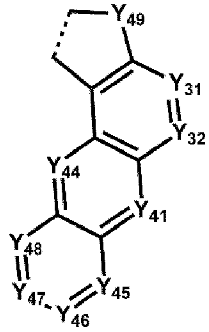

CR(4)

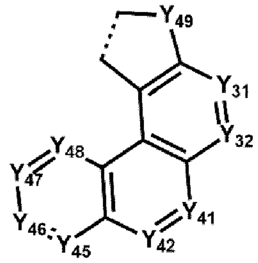

CR(5)

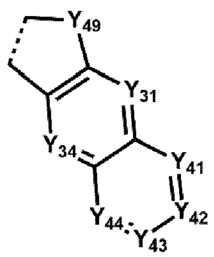

CR(6)

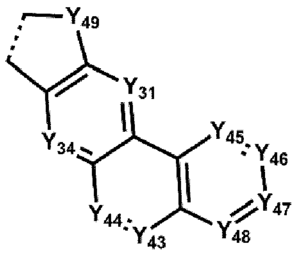

CR(7)

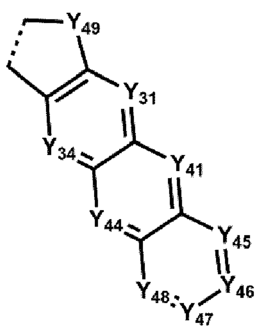

CR(8)

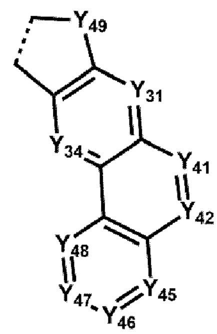

CR(9)

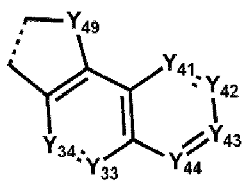

CR(10)

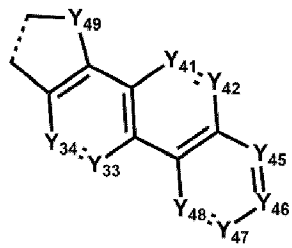

CR(11)

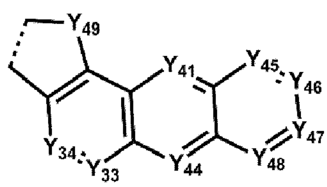

CR(12)

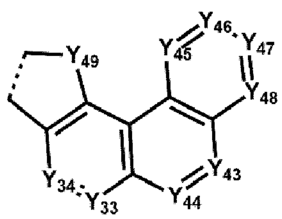

CR(13)

wherein, in Formulae CR(1) to CR(13),

$Y_{49}$ is as described in the present specification, and
$Y_{31}$ to $Y_{34}$ and $Y_{41}$ to $Y_{48}$ may each independently be C or N.

In one or more embodiments, the platinum-containing organometallic compound may include at least one deuterium.

In one or more embodiments, the iridium-containing organometallic compound may include at least one deuterium.

For example, the platinum-containing organometallic compound may be selected from compounds of [Group 1-1] to [Group 1-4]:

## Group 1-1

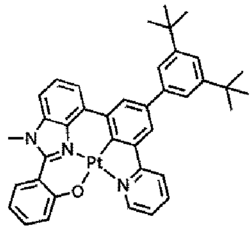
1-1

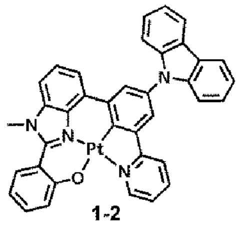
1-2

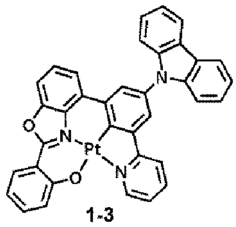
1-3

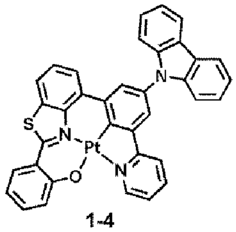
1-4

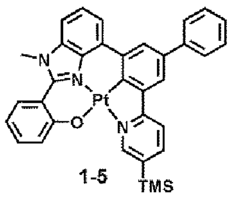
1-5

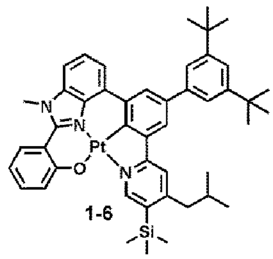
1-6

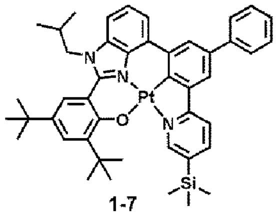
1-7

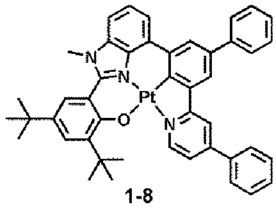
1-8

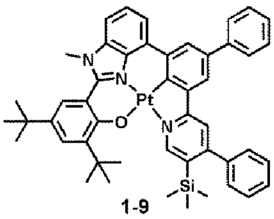
1-9

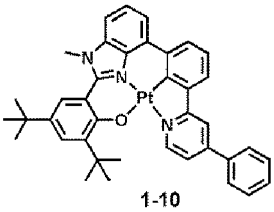
1-10

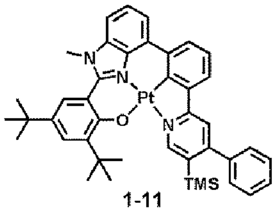
1-11

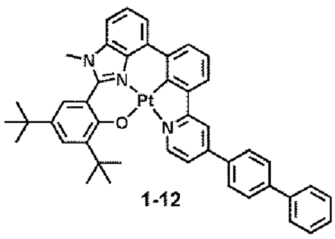
1-12

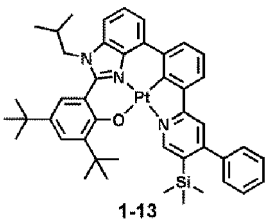
1-13

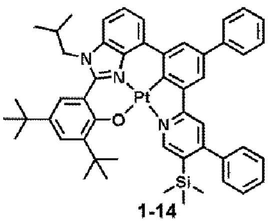
1-14

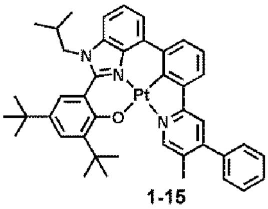
1-15

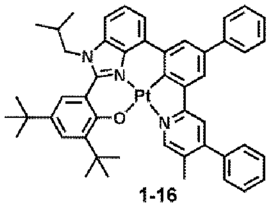
1-16

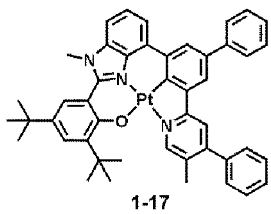
1-17

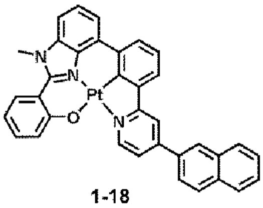
1-18

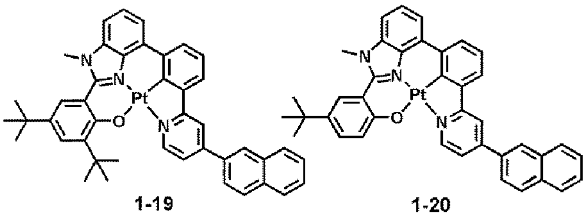
1-19

1-20

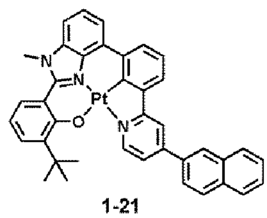
1-21

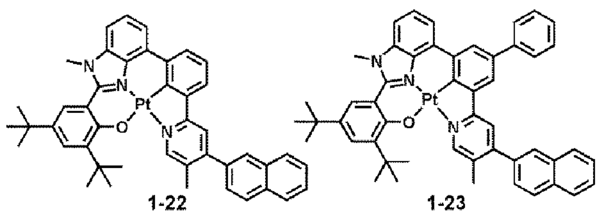
1-22

1-23

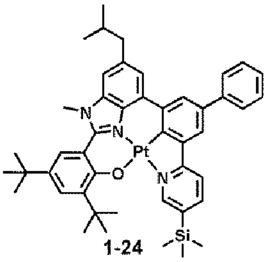
1-24

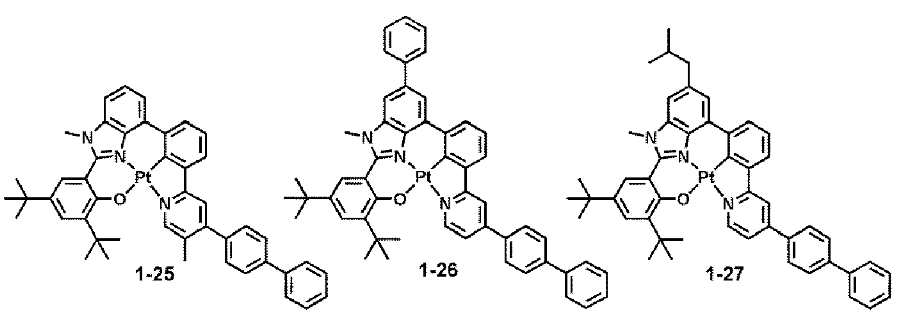

1-25 1-26 1-27

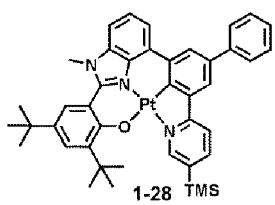

1-28

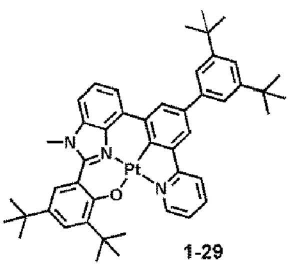

1-29

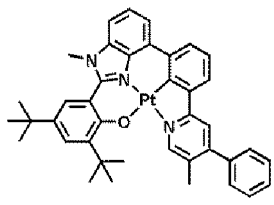

1-30

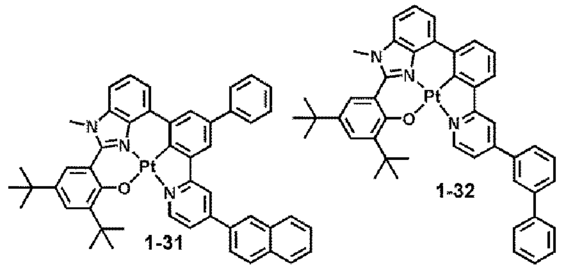

1-31 1-32

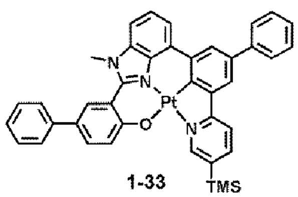

1-33

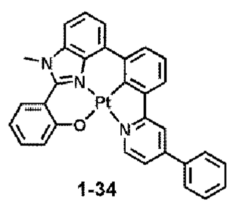

1-34

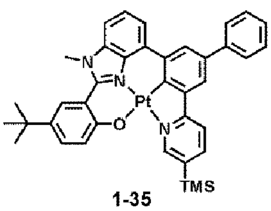

1-35

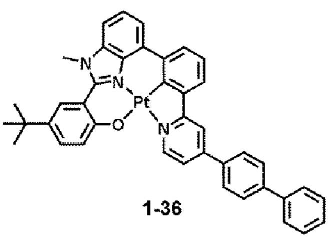

1-36

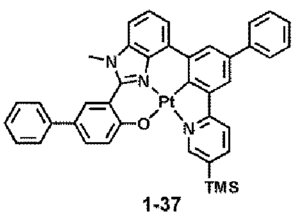

1-37

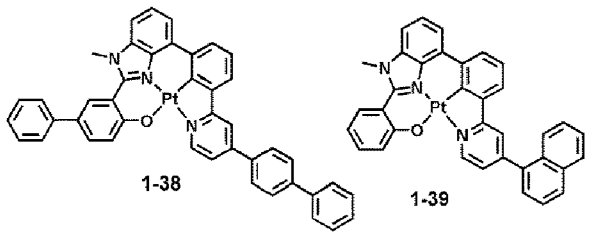

1-38 1-39

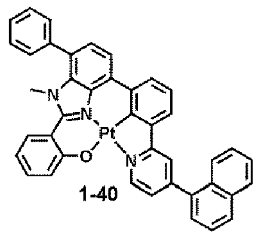

1-40

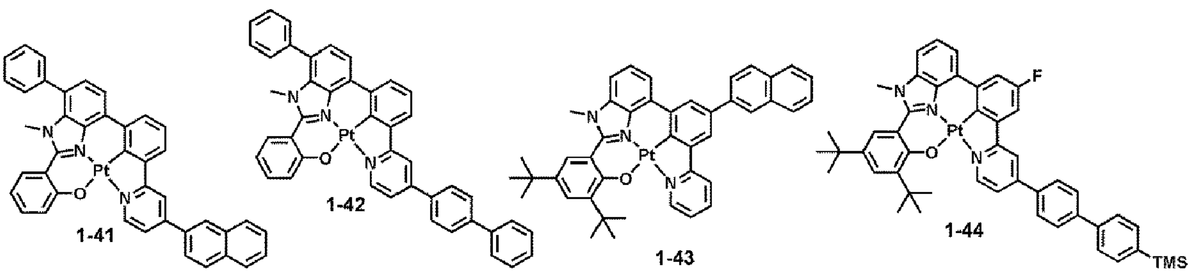

1-41 1-42 1-43 1-44

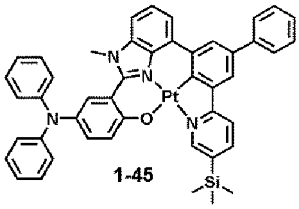
1-45

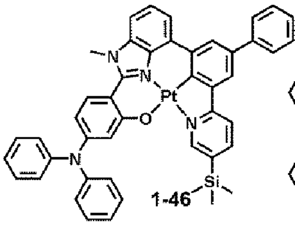
1-46

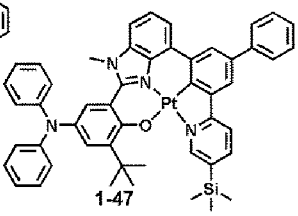
1-47

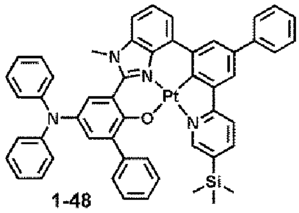
1-48

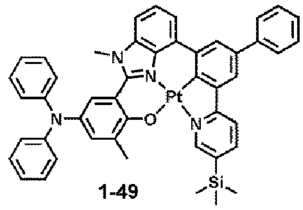
1-49

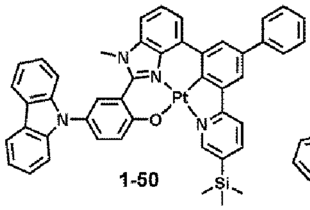
1-50

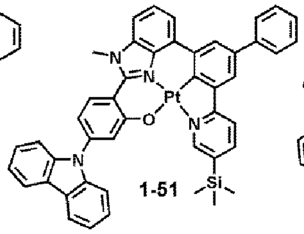
1-51

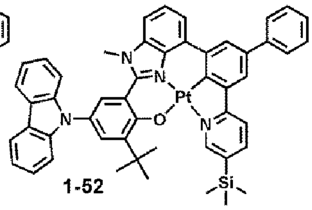
1-52

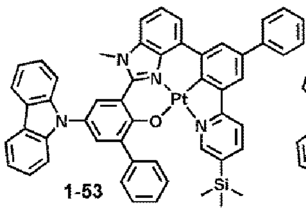
1-53

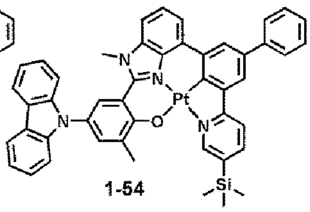
1-54

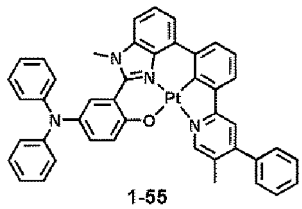
1-55

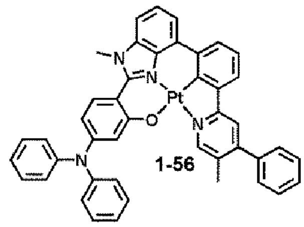
1-56

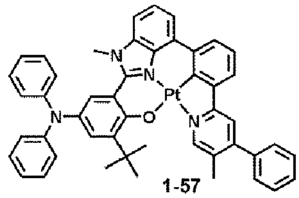
1-57

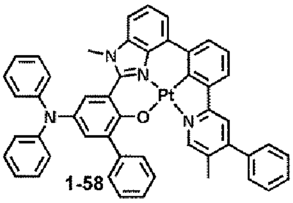
1-58

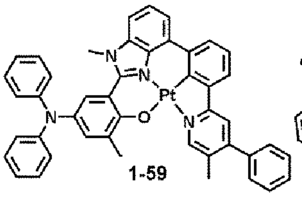
1-59

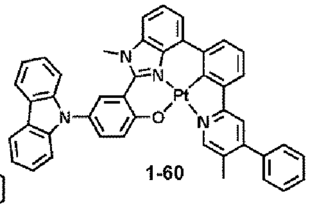
1-60

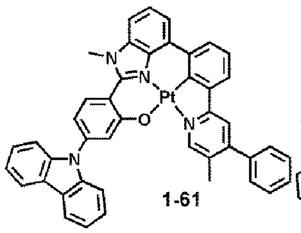
1-61

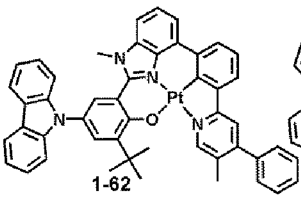
1-62

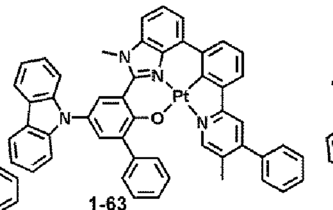
1-63

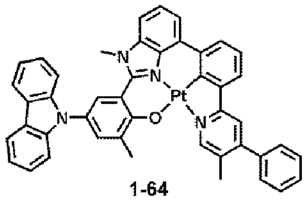
1-64

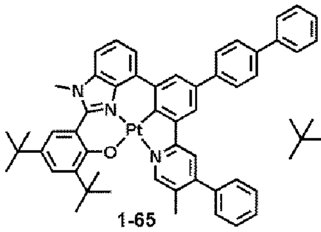
1-65

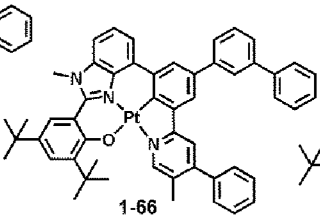
1-66

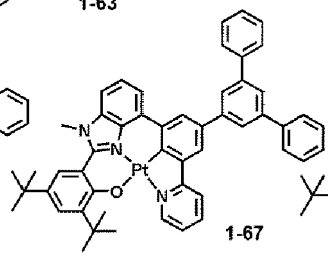
1-67

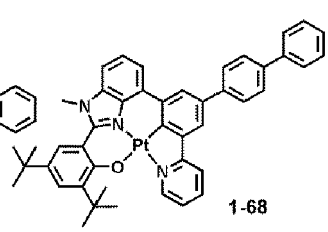
1-68

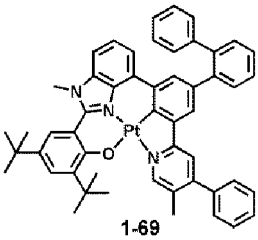
1-69
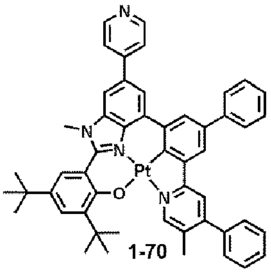
1-70
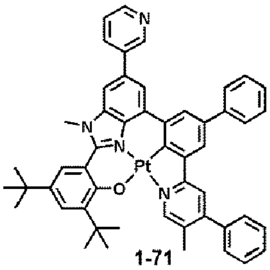
1-71
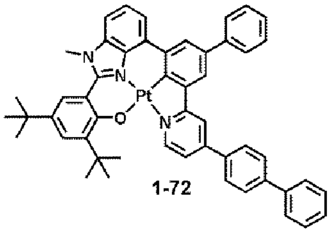
1-72

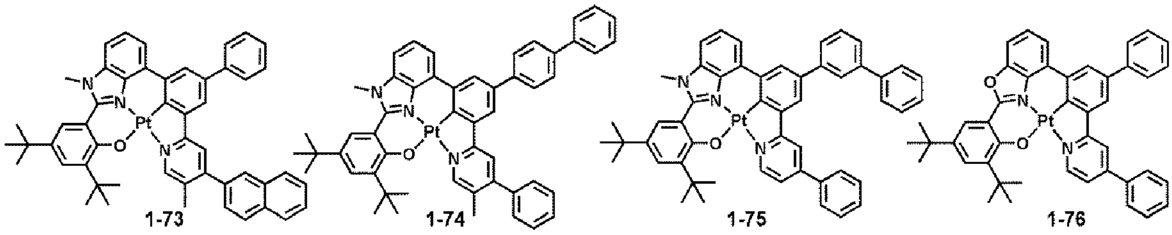
1-73 1-74 1-75 1-76

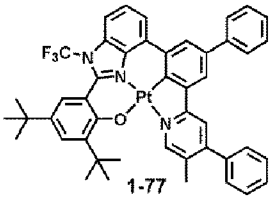
1-77
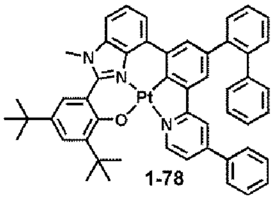
1-78
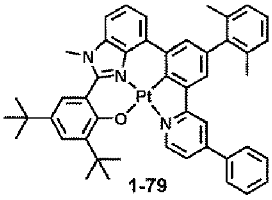
1-79
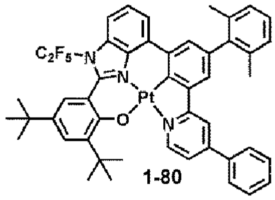
1-80

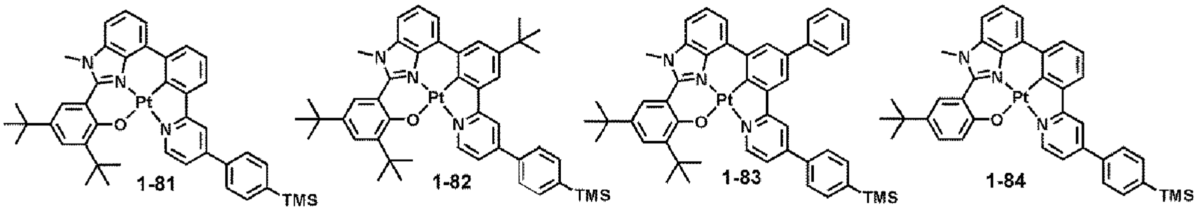
1-81 1-82 1-83 1-84

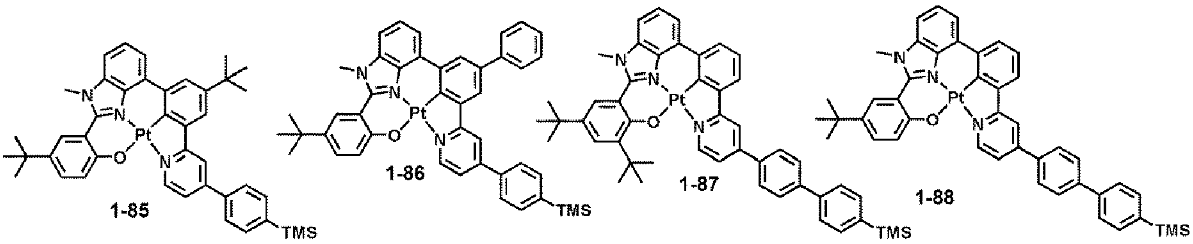
1-85 1-86 1-87 1-88

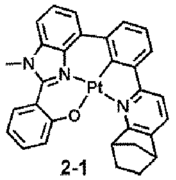
2-1

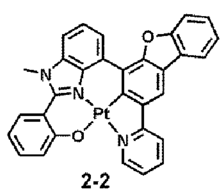
2-2

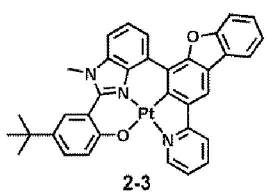
2-3

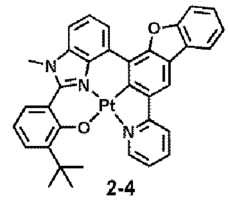
2-4

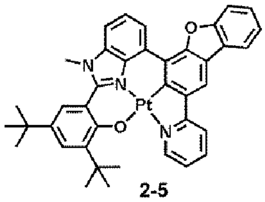
2-5

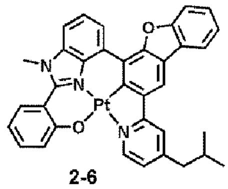
2-6

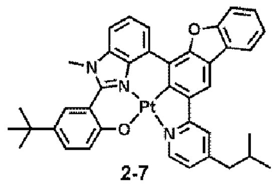
2-7

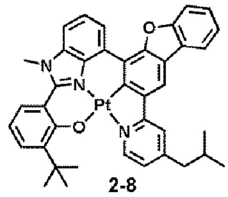
2-8

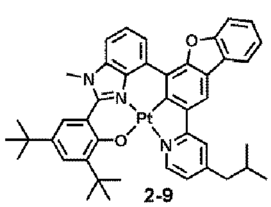
2-9

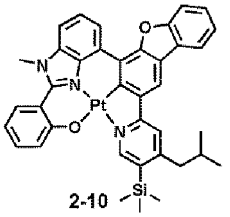
2-10

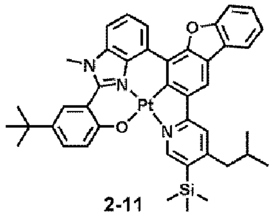
2-11

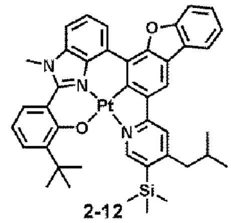
2-12

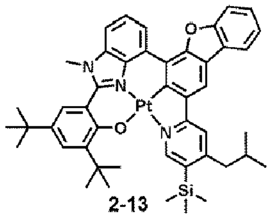
2-13

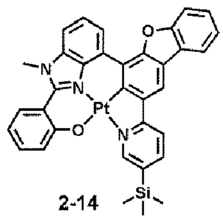
2-14

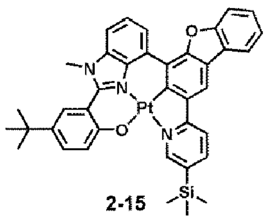
2-15

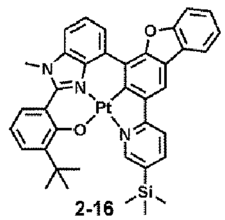
2-16

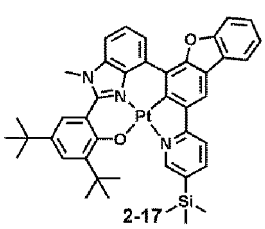
2-17

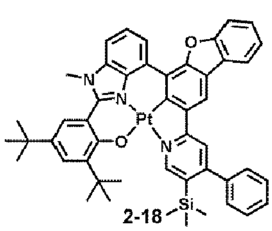
2-18

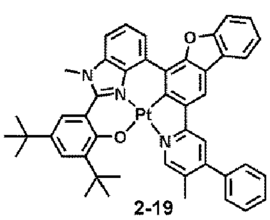
2-19

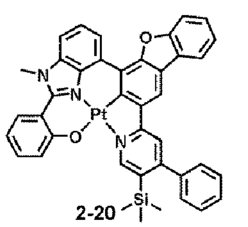
2-20

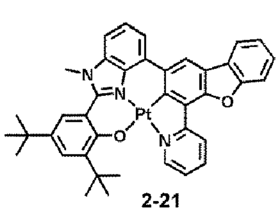
2-21

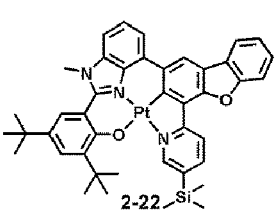
2-22

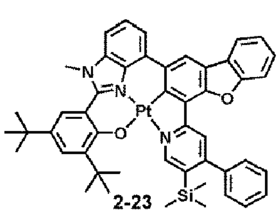
2-23

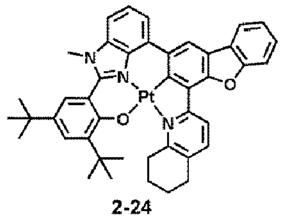
2-24

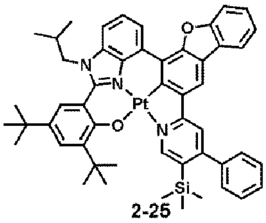
2-25

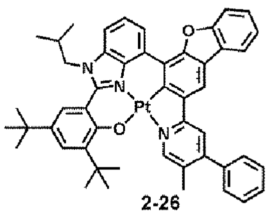
2-26

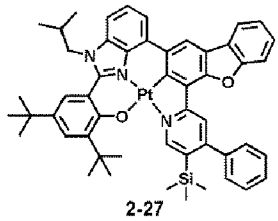
2-27

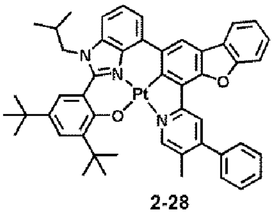
2-28

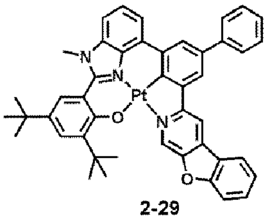
2-29

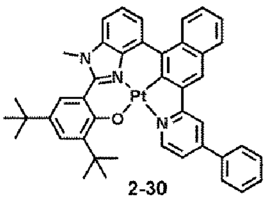
2-30

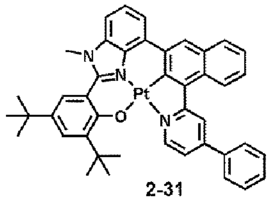
2-31

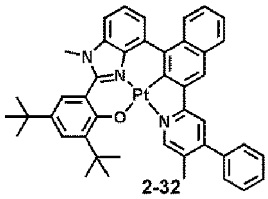
2-32

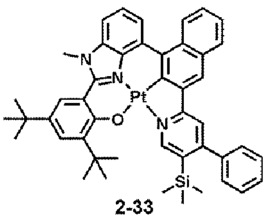
2-33

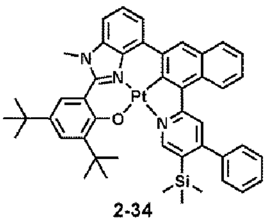
2-34

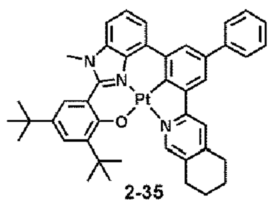
2-35

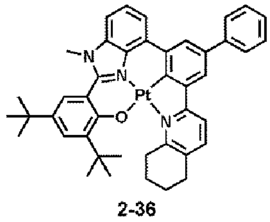
2-36

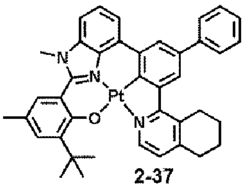
2-37

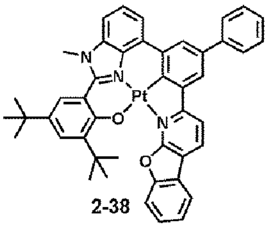
2-38

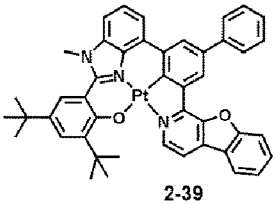
2-39

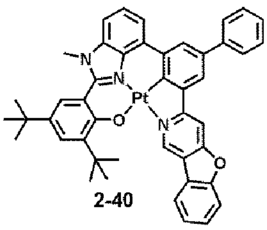
2-40

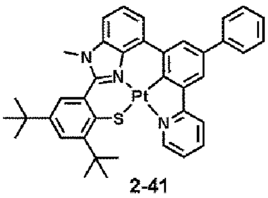
2-41

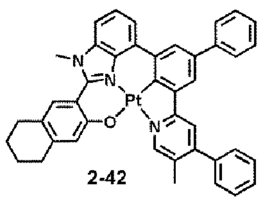
2-42

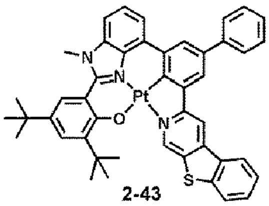
2-43

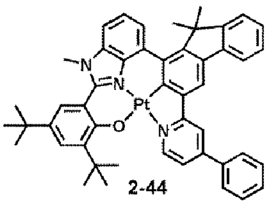
2-44

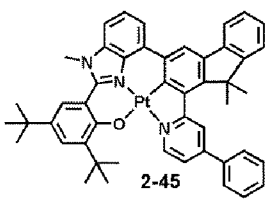
2-45

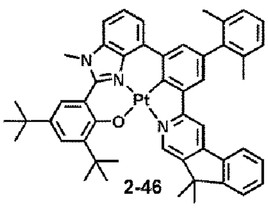
2-46

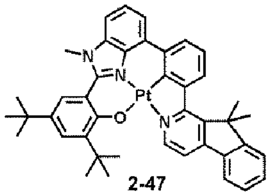
2-47

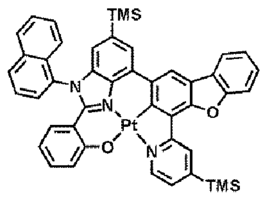
3-1

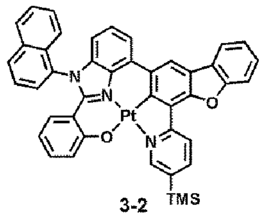
3-2

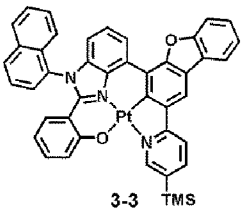
3-3

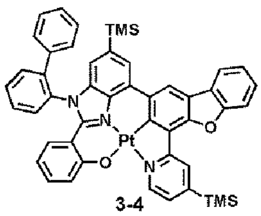
3-4

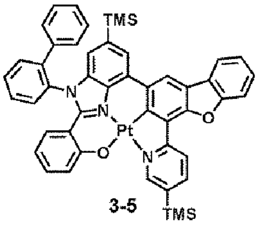
3-5

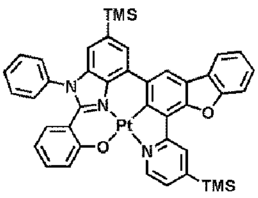
3-6

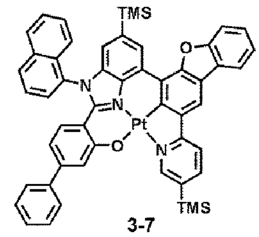
3-7

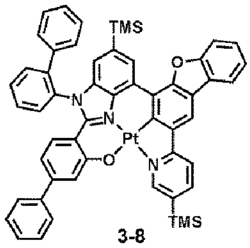
3-8

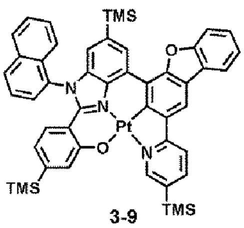
3-9

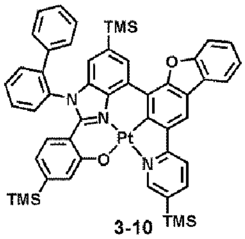
3-10

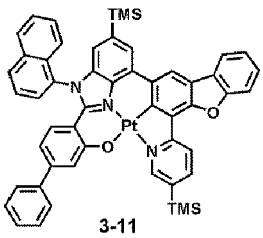
3-11

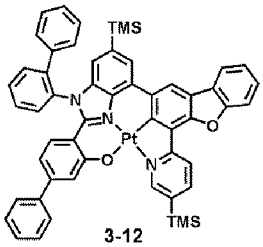
3-12

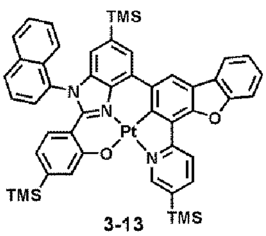
3-13

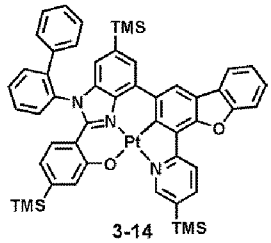
3-14

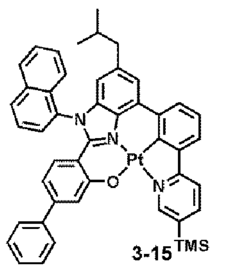
3-15

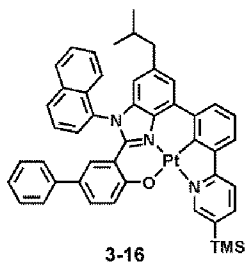
3-16

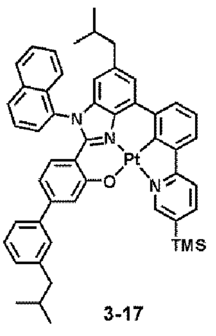
3-17

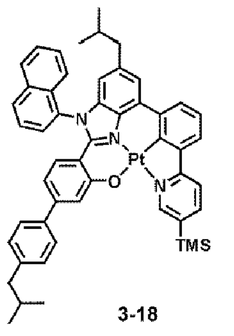
3-18

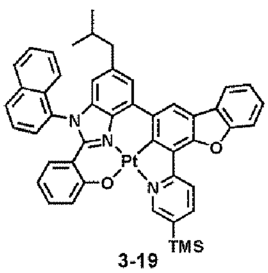
3-19

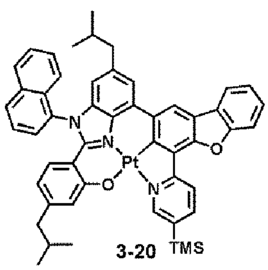
3-20

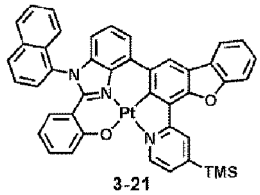
3-21

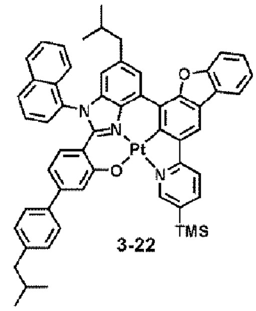
3-22

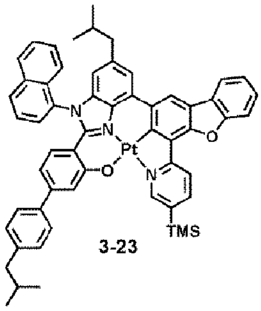
3-23

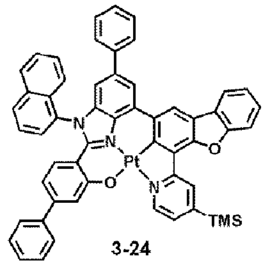
3-24

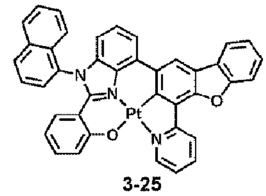
3-25

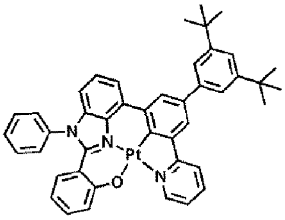
3-26

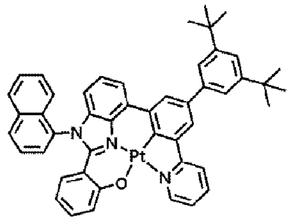
3-27

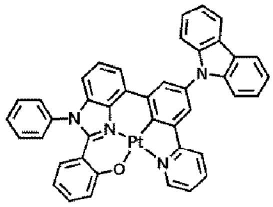
3-28

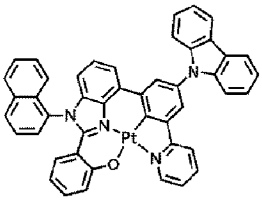
3-29

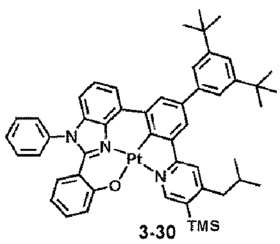
3-30

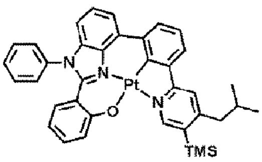
3-31

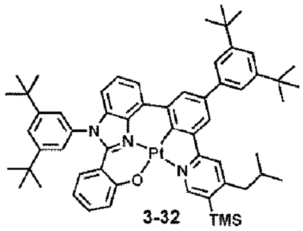
3-32

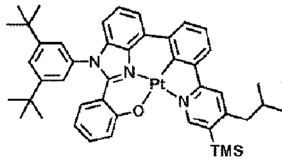
3-33

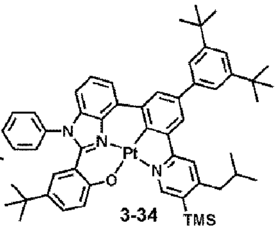
3-34

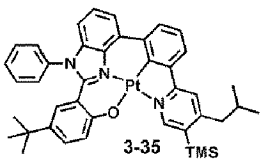
3-35

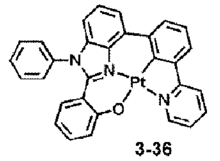
3-36

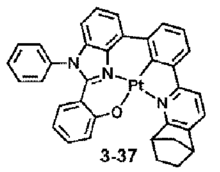
3-37

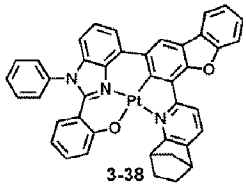
3-38

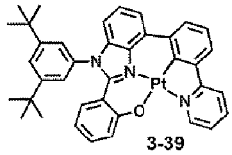
3-39

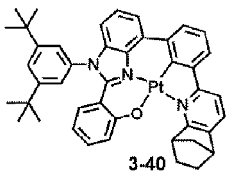
3-40

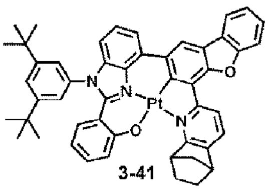
3-41

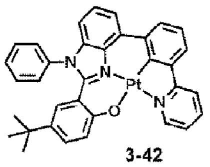
3-42

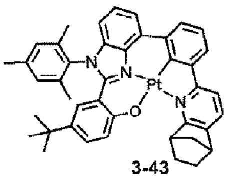
3-43

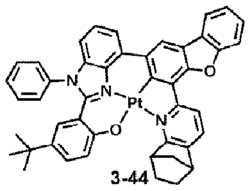
3-44

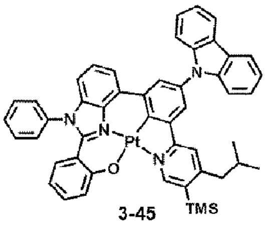
3-45

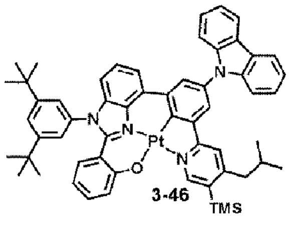
3-46

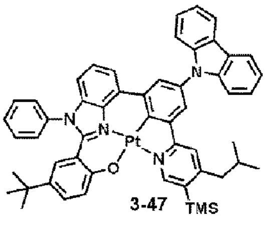
3-47

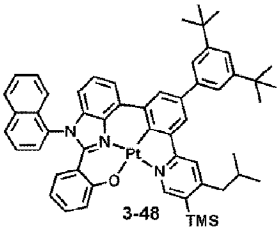
3-48

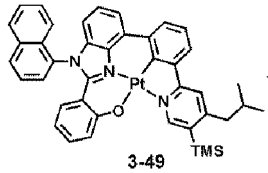
3-49

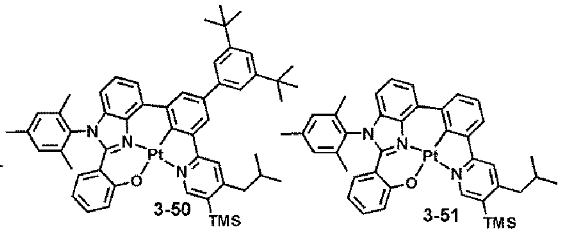
3-50

3-51

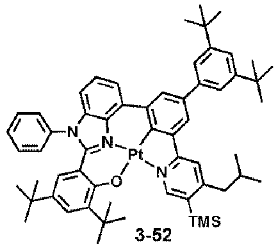
3-52

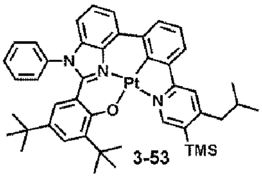
3-53

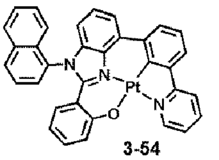
3-54

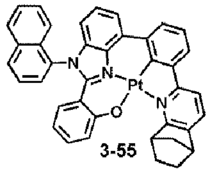
3-55

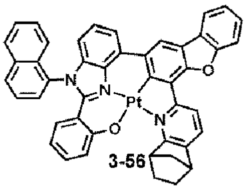
3-56

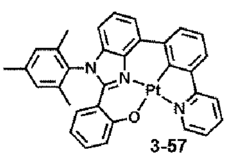
3-57

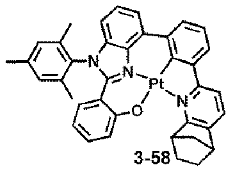
3-58

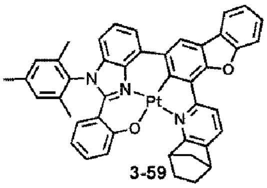
3-59

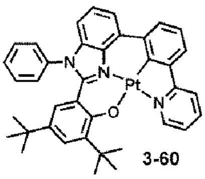
3-60

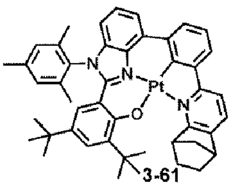
3-61

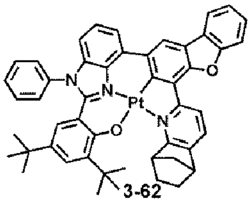
3-62

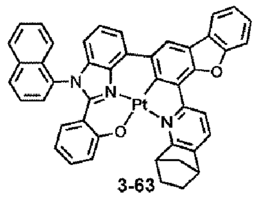
3-63

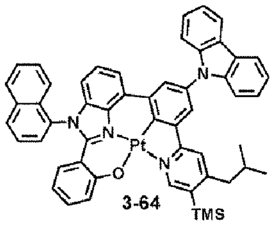
3-64

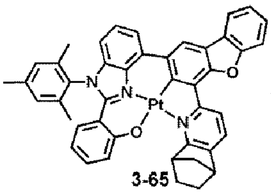
3-65

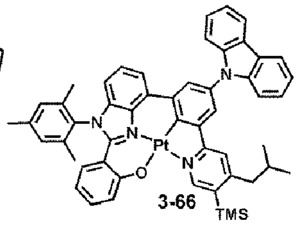
3-66

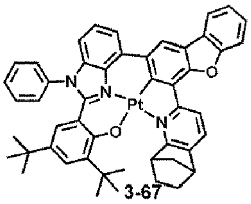
3-67

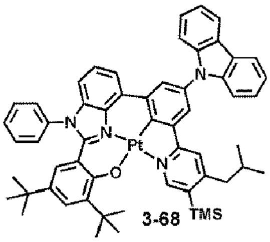
3-68

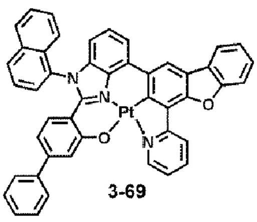
3-69

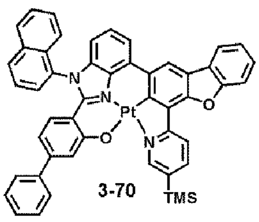
3-70

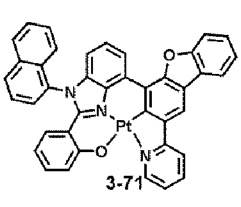
3-71

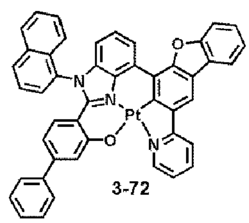
3-72

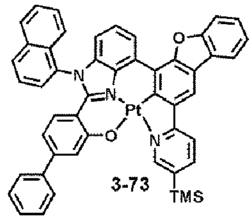
3-73
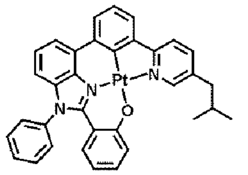
3-74
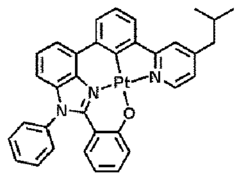
3-75
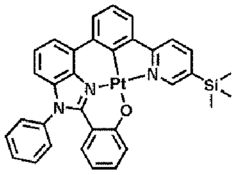
3-76

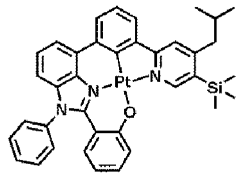
3-77
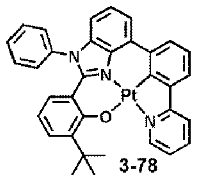
3-78
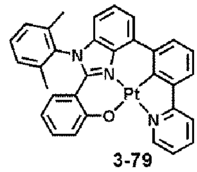
3-79
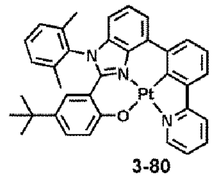
3-80

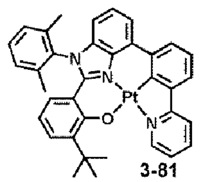
3-81
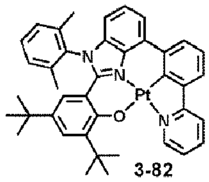
3-82
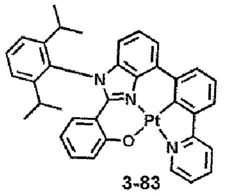
3-83
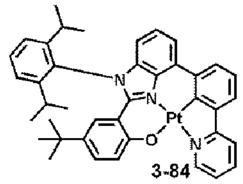
3-84

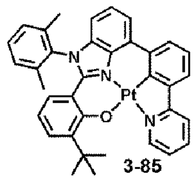
3-85
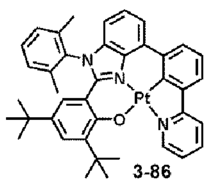
3-86
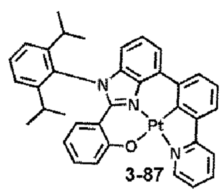
3-87
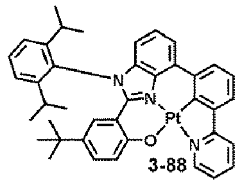
3-88

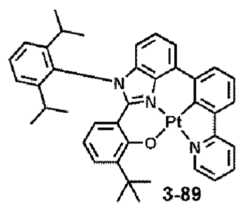
3-89
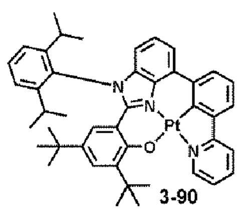
3-90
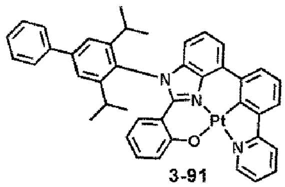
3-91
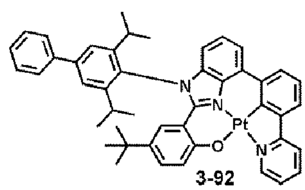
3-92

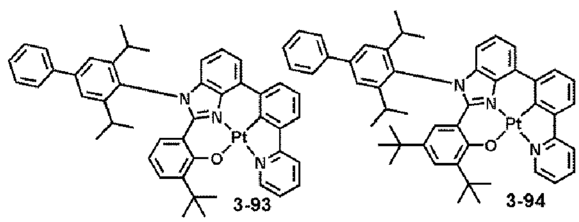
3-93
3-94
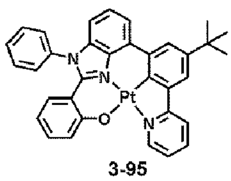
3-95
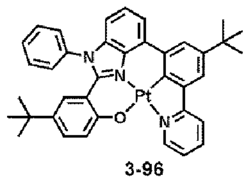
3-96

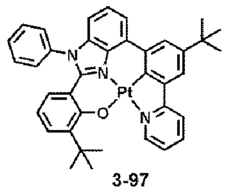
3-97

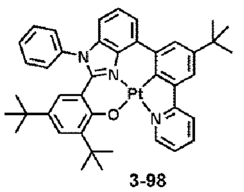
3-98

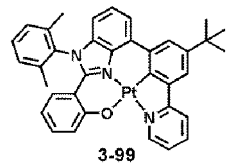
3-99

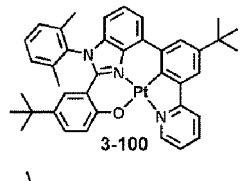
3-100

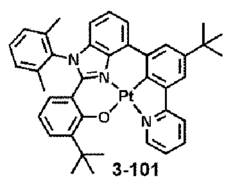
3-101

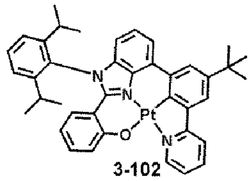
3-102

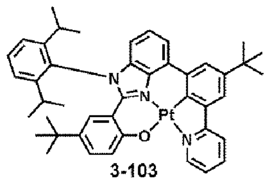
3-103

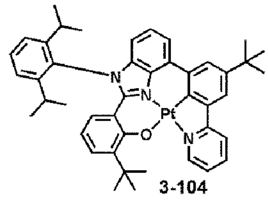
3-104

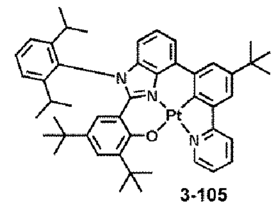
3-105

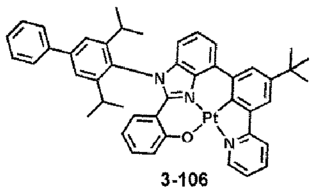
3-106

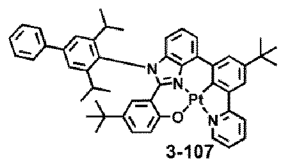
3-107

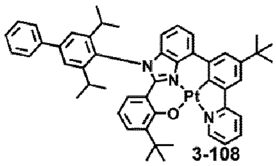
3-108

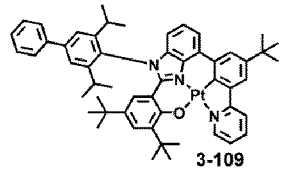
3-109

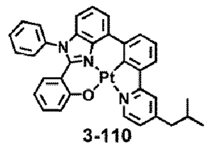
3-110

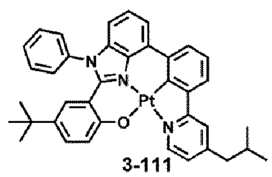
3-111

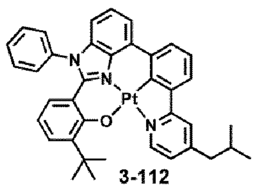
3-112

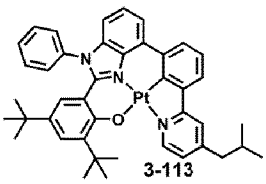
3-113

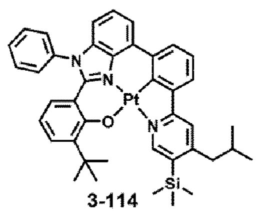
3-114

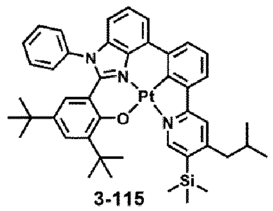
3-115

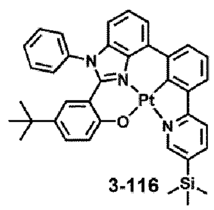
3-116

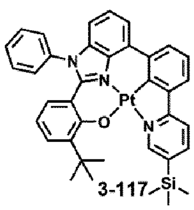
3-117

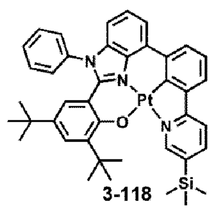
3-118

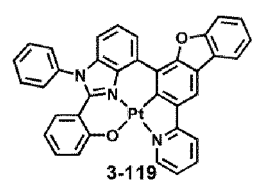
3-119

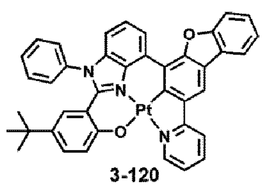
3-120

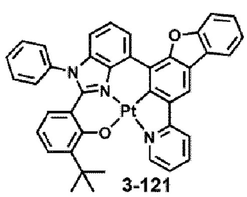
3-121

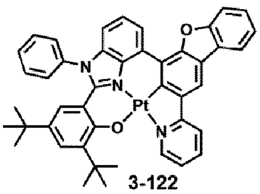
3-122

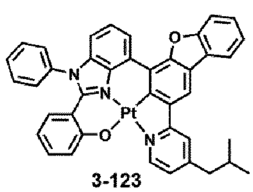
3-123

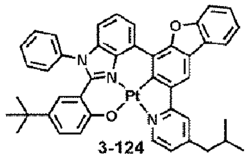
3-124

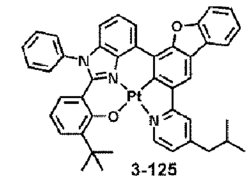
3-125

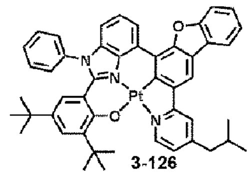
3-126

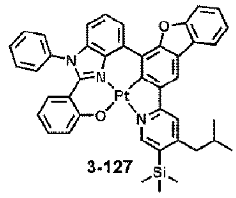
3-127

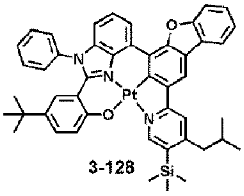
3-128

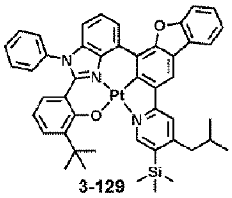
3-129

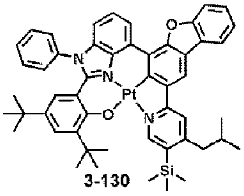
3-130

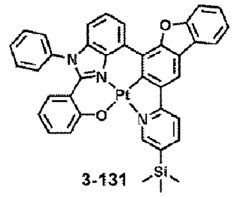
3-131

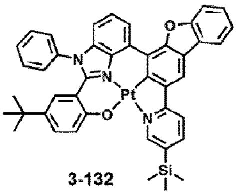
3-132

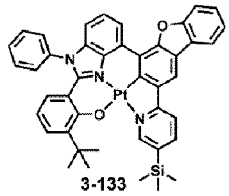
3-133

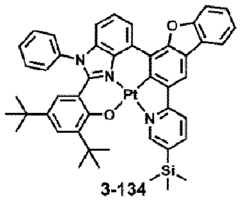
3-134

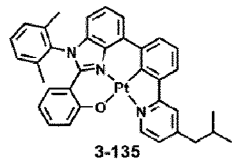
3-135

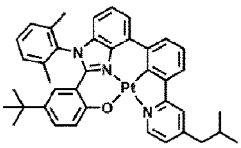
3-136

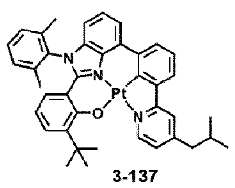
3-137

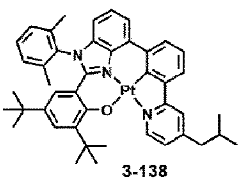
3-138

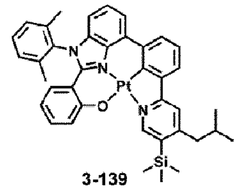
3-139

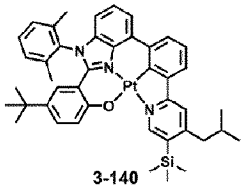
3-140

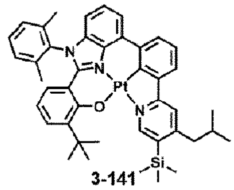
3-141

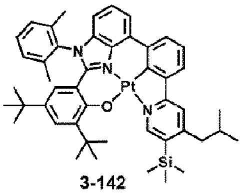
3-142

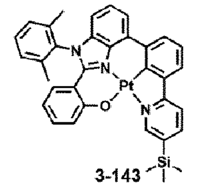
3-143

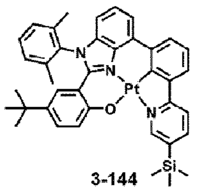
3-144

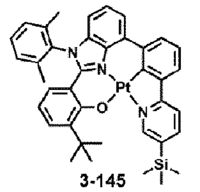
3-145

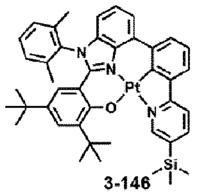
3-146

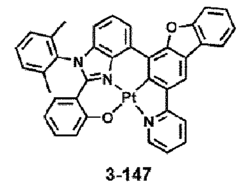
3-147

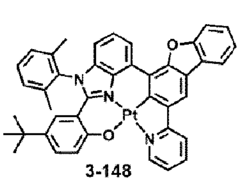
3-148

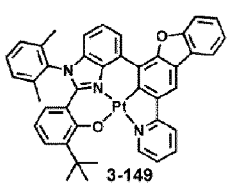
3-149

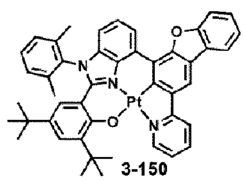
3-150

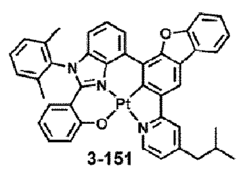
3-151

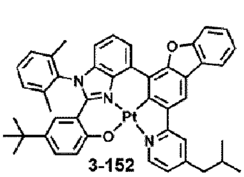
3-152

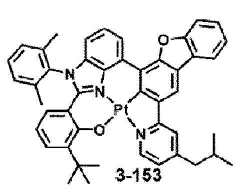
3-153

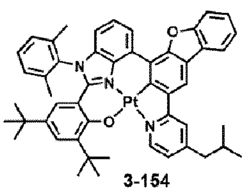
3-154

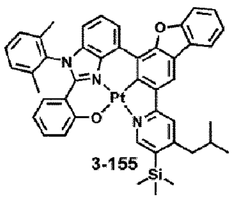
3-155

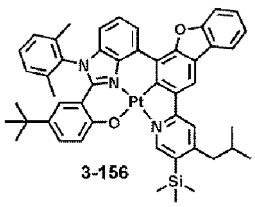
3-156

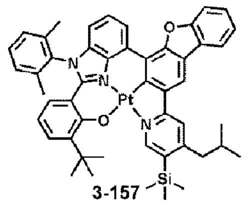
3-157

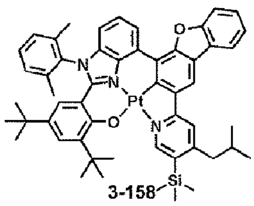
3-158

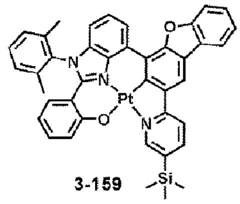
3-159

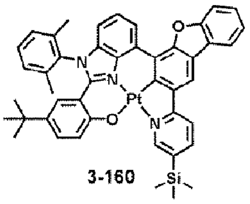
3-160

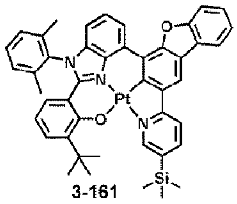
3-161

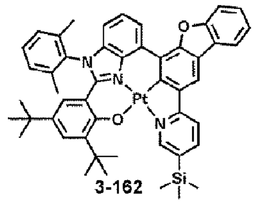
3-162

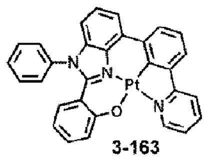
3-163

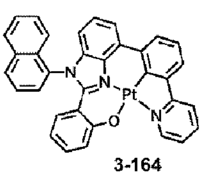
3-164

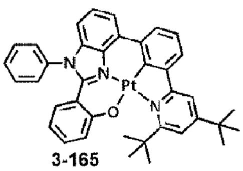
3-165

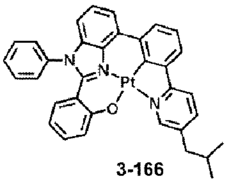
3-166

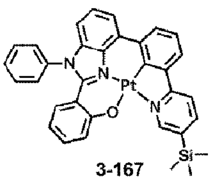
3-167

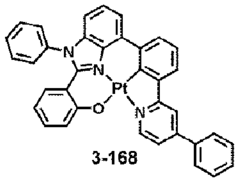
3-168

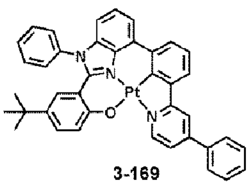
3-169

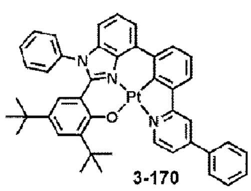
3-170

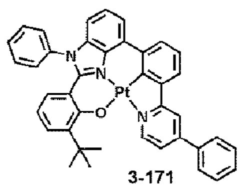
3-171

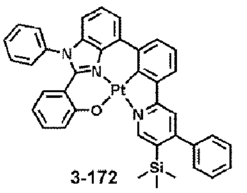
3-172

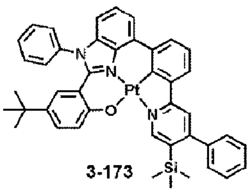
3-173

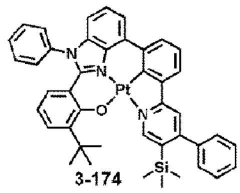
3-174

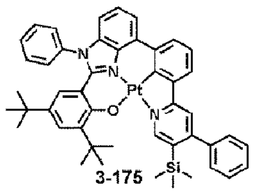
3-175

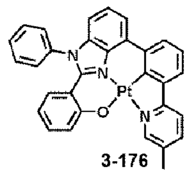
3-176

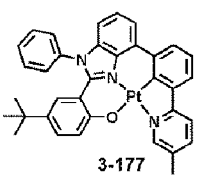
3-177

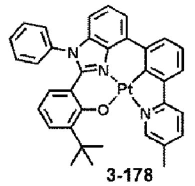
3-178

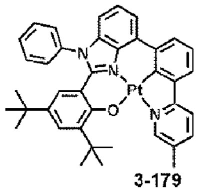
3-179

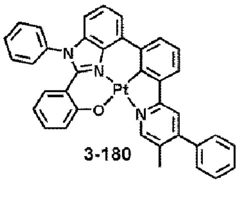
3-180

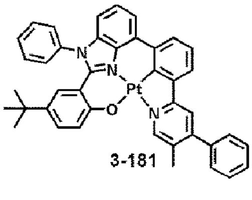
3-181

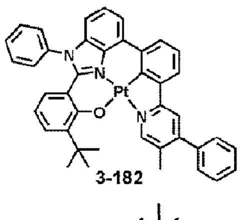
3-182

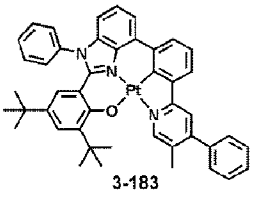
3-183

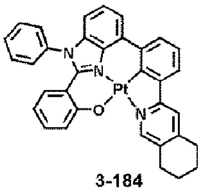
3-184

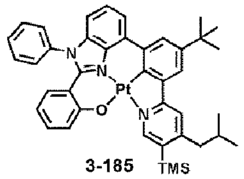
3-185

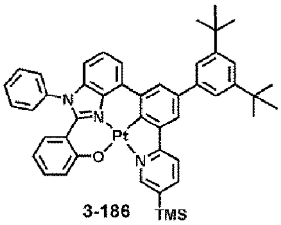
3-186

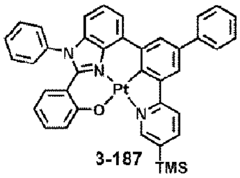
3-187

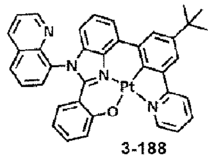
3-188
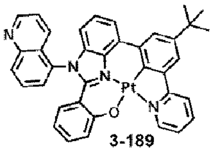
3-189
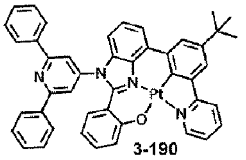
3-190
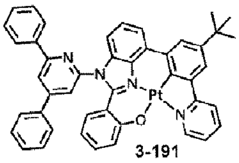
3-191

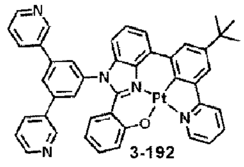
3-192
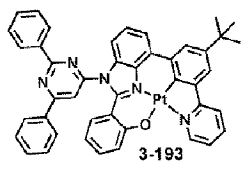
3-193
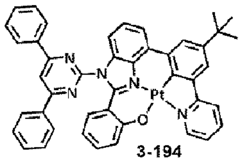
3-194
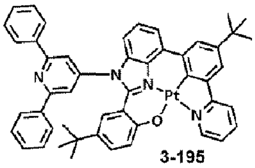
3-195

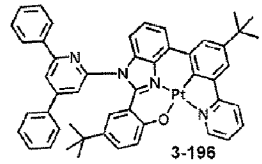
3-196
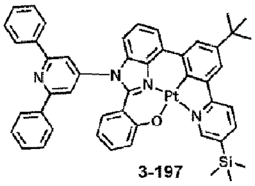
3-197
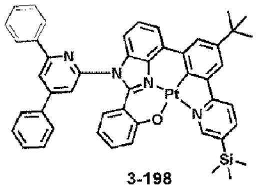
3-198
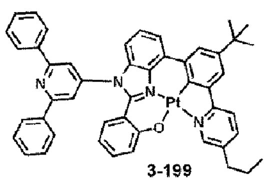
3-199

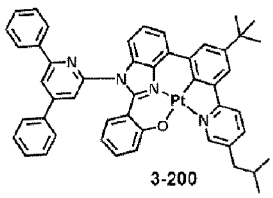
3-200
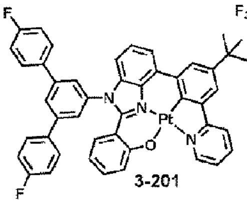
3-201
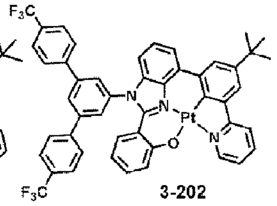
3-202
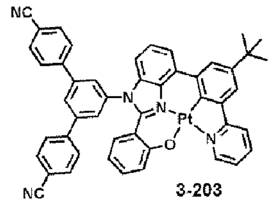
3-203

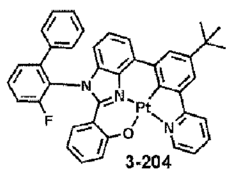
3-204
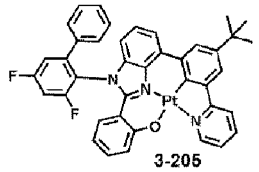
3-205
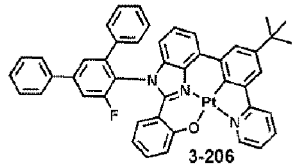
3-206
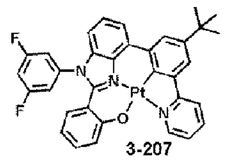
3-207

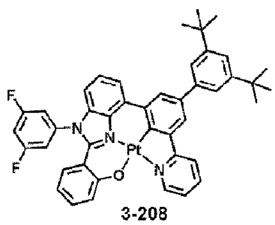
3-208
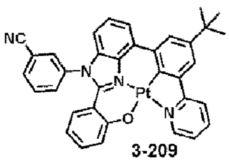
3-209
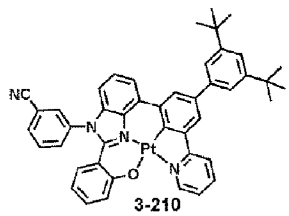
3-210
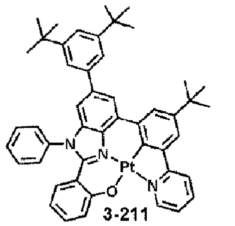
3-211

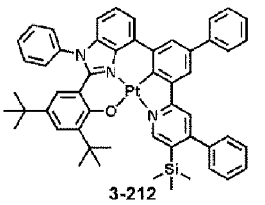
3-212
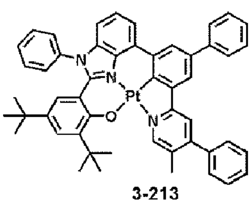
3-213
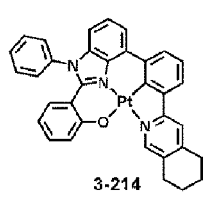
3-214
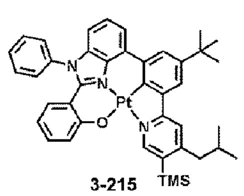
3-215

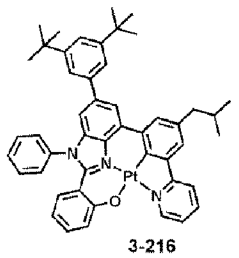
3-216
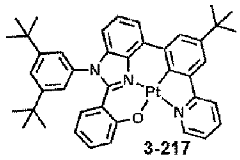
3-217
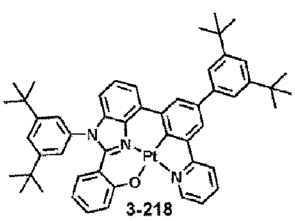
3-218

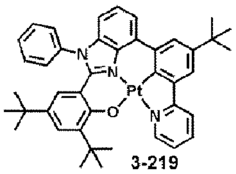
3-219

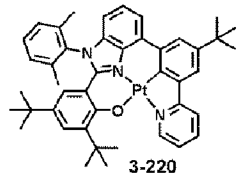
3-220

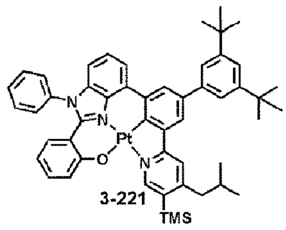
3-221

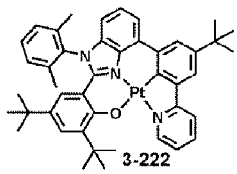
3-222

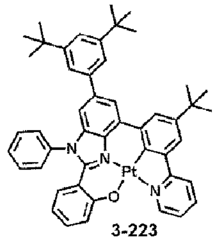
3-223

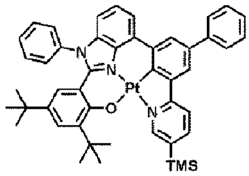
3-224

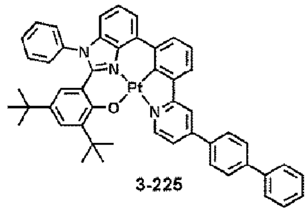
3-225

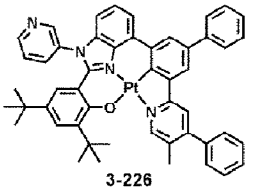
3-226

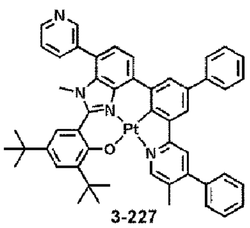
3-227

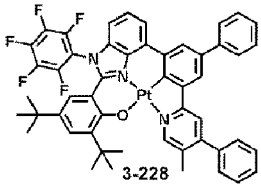
3-228

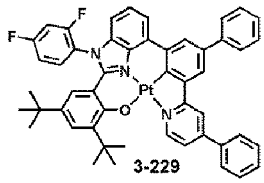
3-229

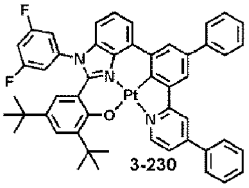
3-230

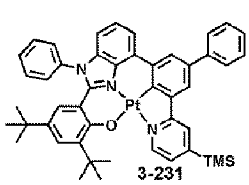
3-231

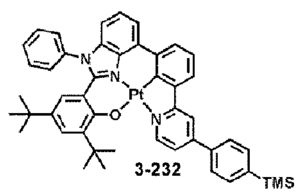
3-232

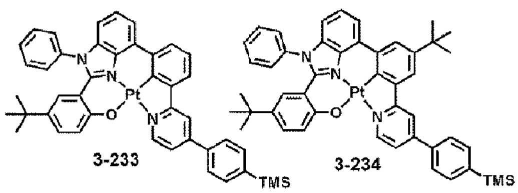
3-233

3-234

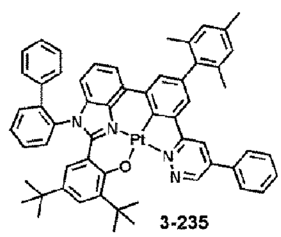
3-235

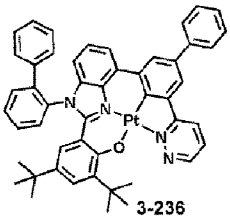
3-236

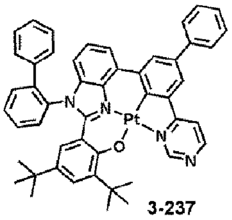
3-237

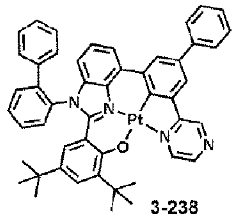
3-238

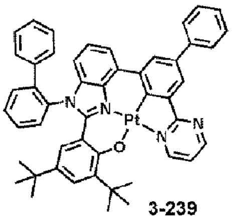
3-239

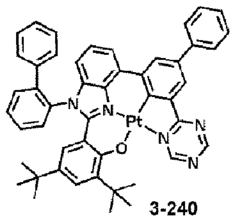
3-240

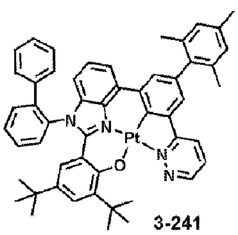
3-241

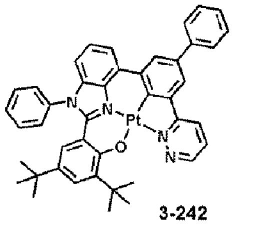
3-242

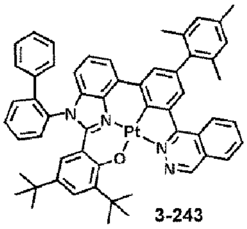
3-243

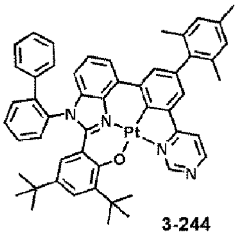
3-244

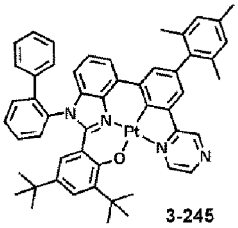
3-245

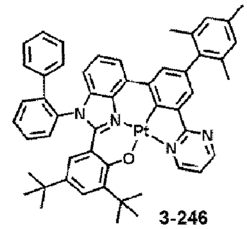
3-246

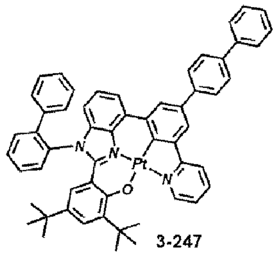
3-247

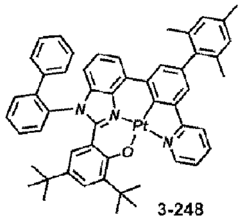
3-248

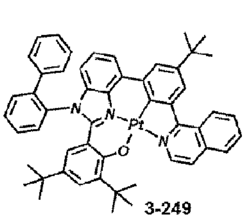
3-249

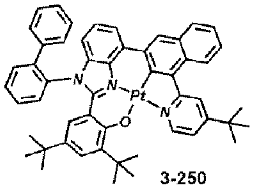
3-250

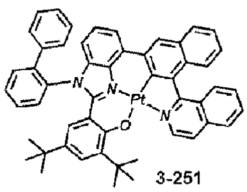
3-251

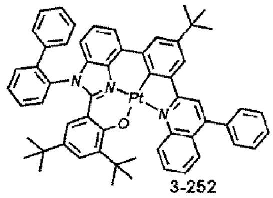
3-252

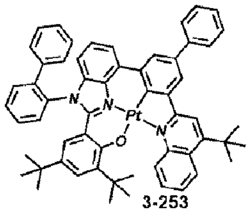
3-253

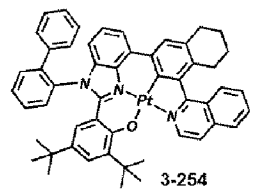
3-254

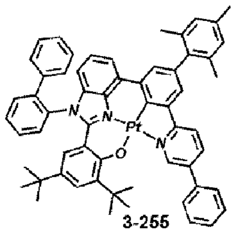
3-255

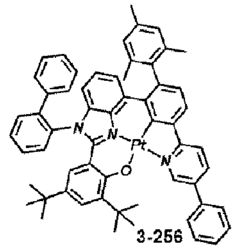
3-256

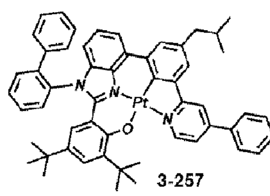
3-257

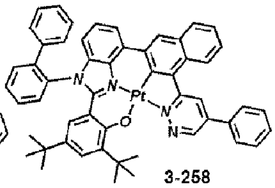
3-258

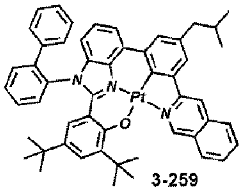
3-259

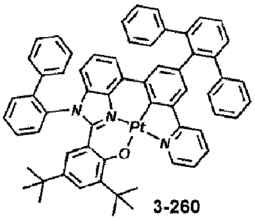
3-260

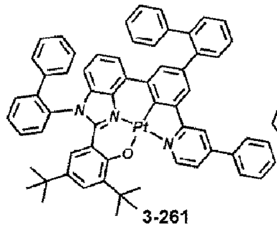
3-261

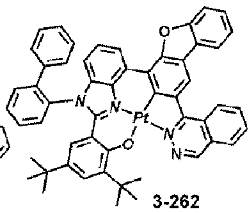
3-262

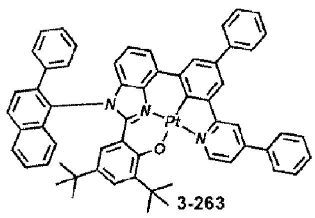
3-263

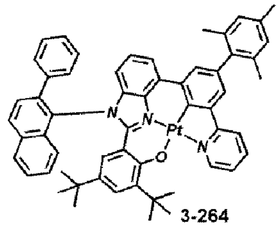
3-264

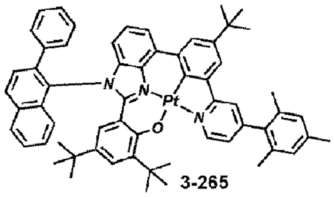
3-265

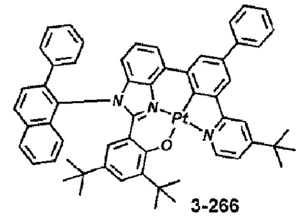
3-266

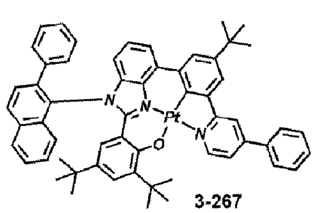
3-267

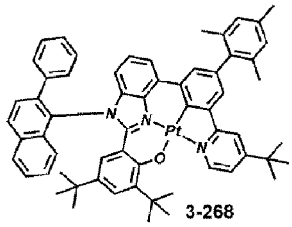
3-268

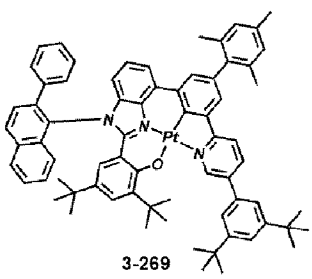
3-269

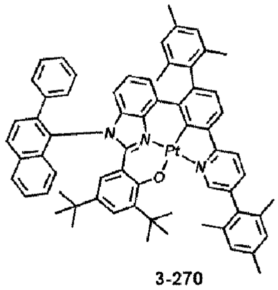
3-270

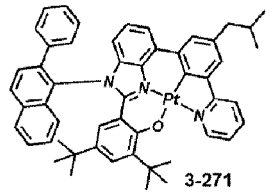
3-271

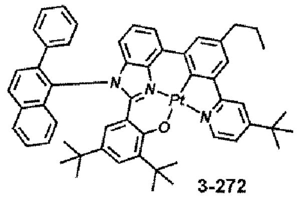
3-272

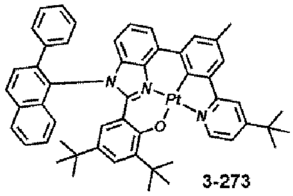
3-273

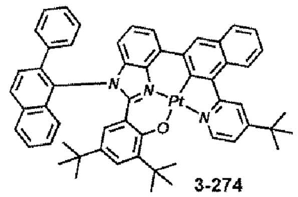
3-274

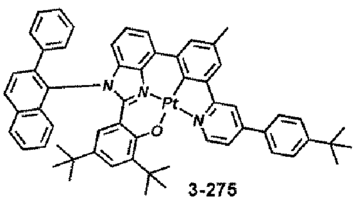
3-275

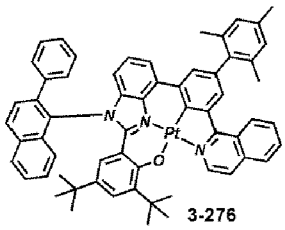
3-276

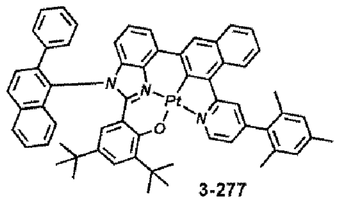
3-277

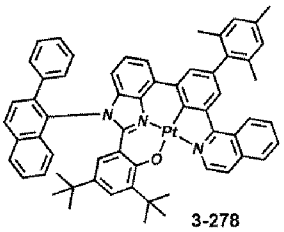
3-278

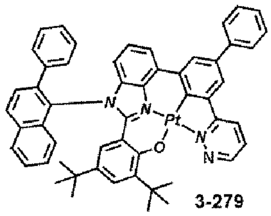
3-279

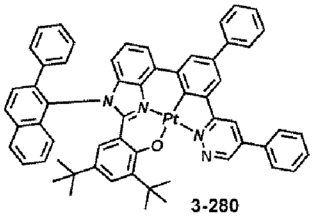
3-280

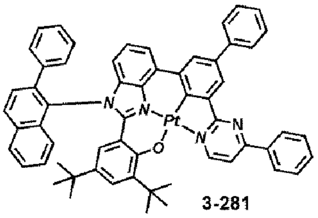
3-281

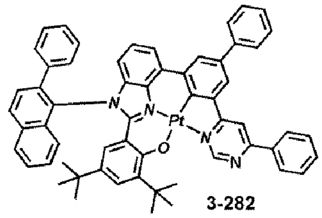
3-282

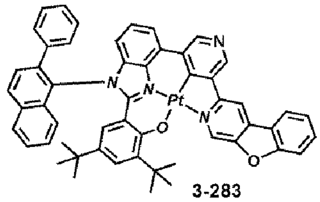
3-283

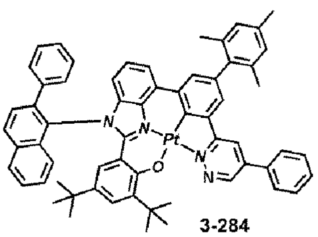
3-284

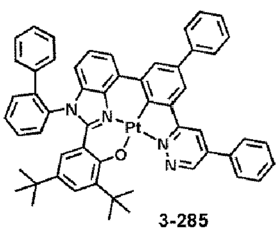
3-285

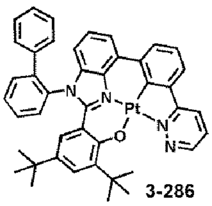
3-286

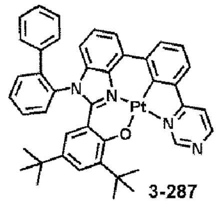
3-287

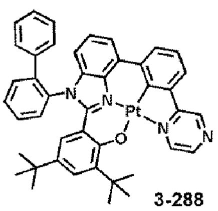
3-288

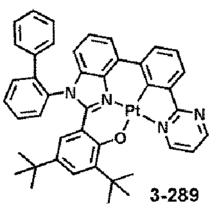
3-289

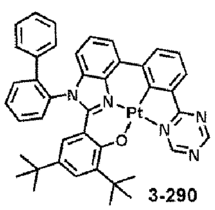
3-290

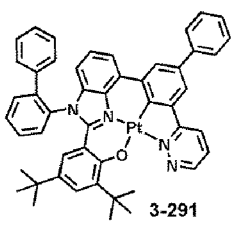
3-291

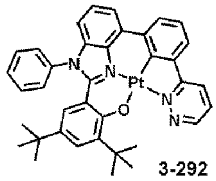
3-292

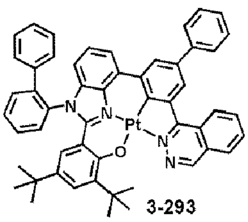
3-293

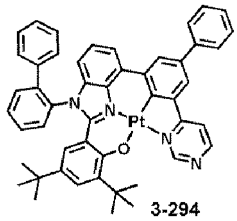
3-294

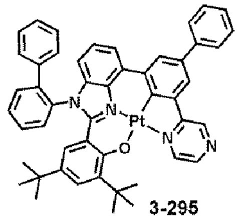
3-295

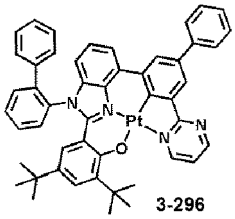
3-296

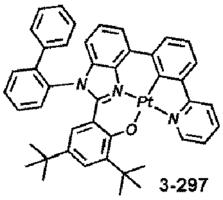
3-297

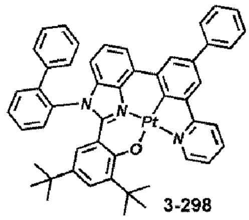
3-298

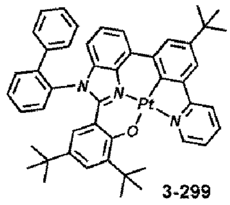
3-299

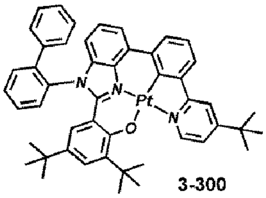
3-300

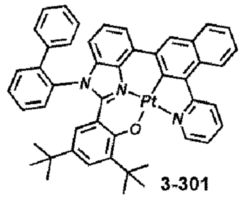
3-301

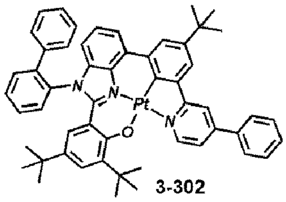
3-302

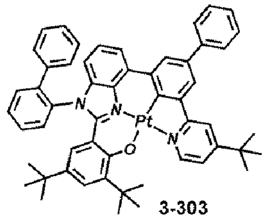
3-303

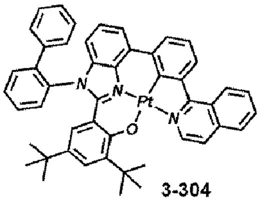
3-304

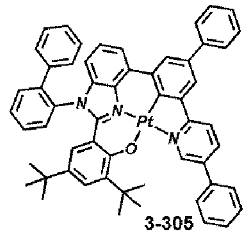
3-305

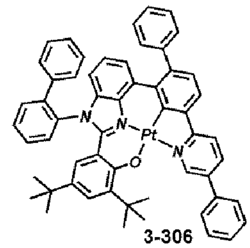
3-306

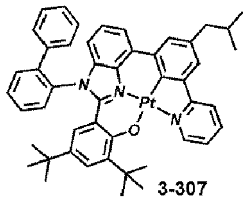
3-307

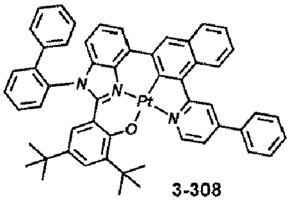
3-308

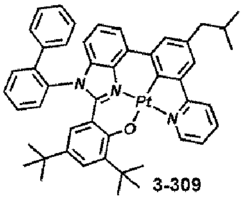
3-309

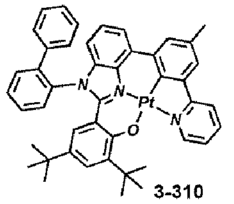
3-310

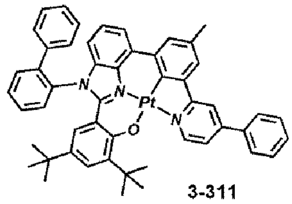
3-311

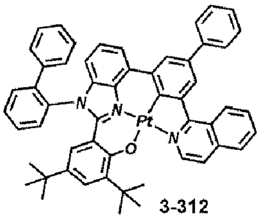
3-312

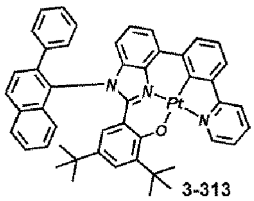
3-313

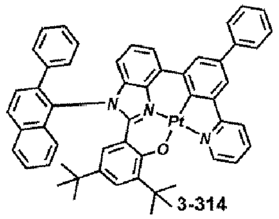
3-314

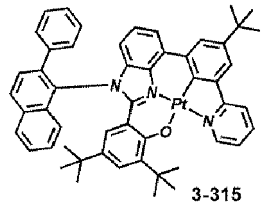
3-315

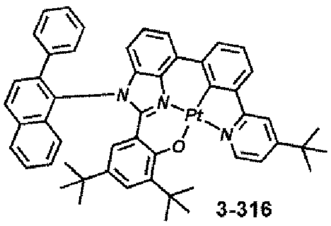
3-316

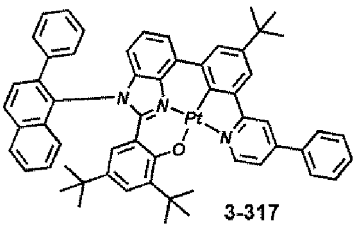
3-317

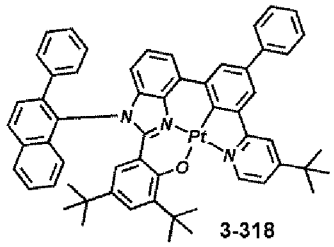
3-318

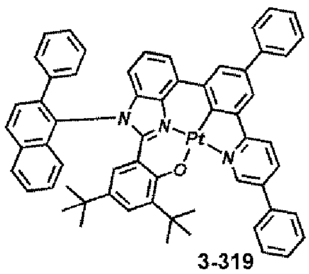
3-319

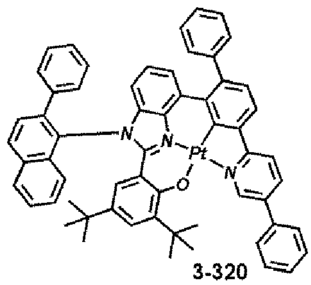
3-320

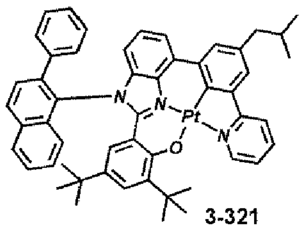
3-321

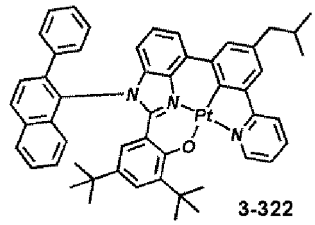
3-322

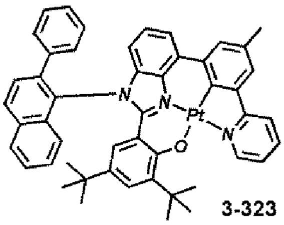
3-323

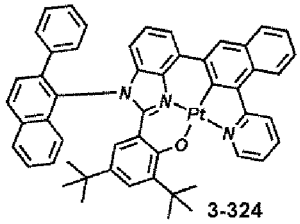
3-324

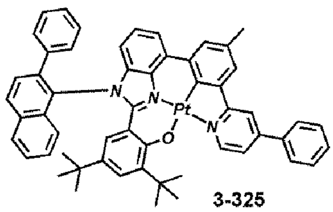
3-325

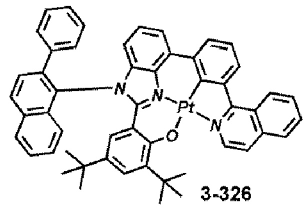
3-326

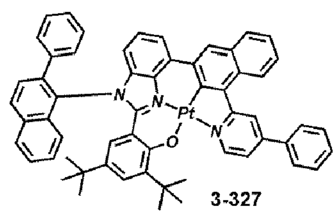
3-327

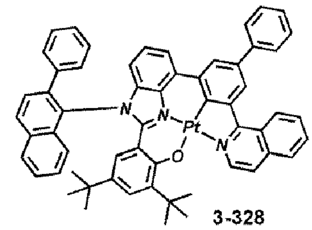
3-328

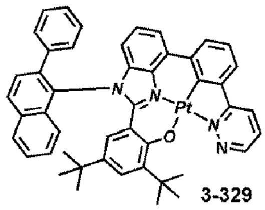
3-329

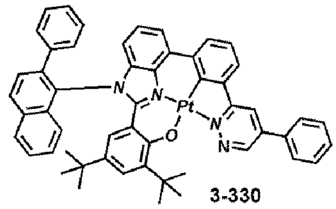
3-330

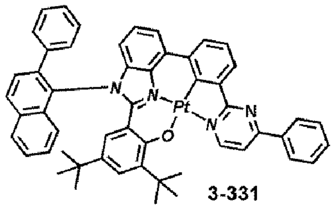
3-331

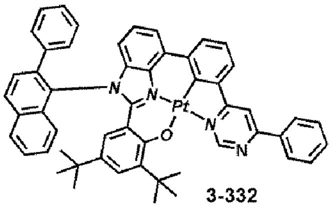
3-332

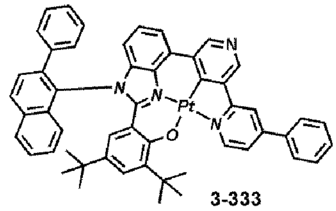
3-333

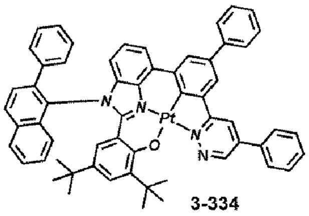
3-334

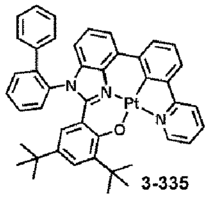
3-335

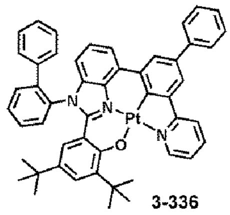
3-336

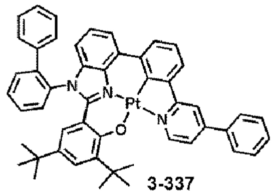
3-337

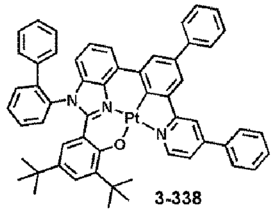
3-338

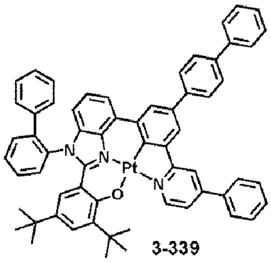
3-339

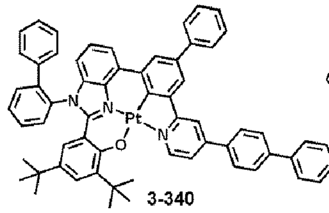
3-340

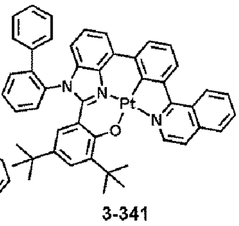
3-341

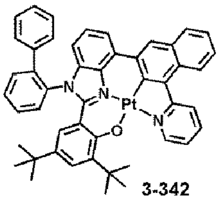
3-342

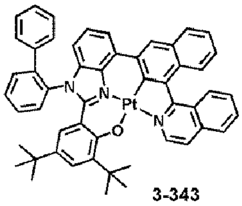
3-343

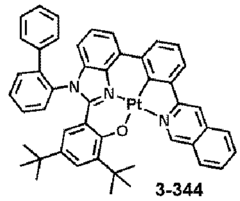
3-344

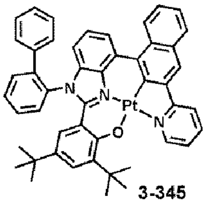
3-345

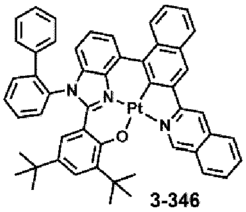
3-346

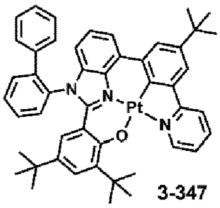
3-347

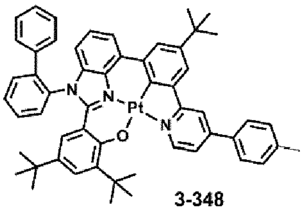
3-348

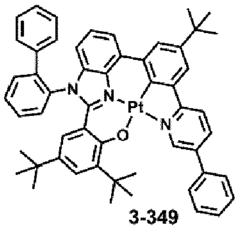
3-349

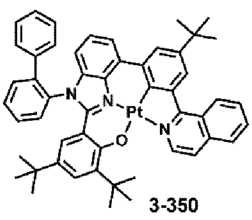
3-350

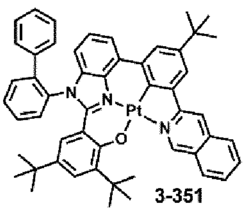
3-351

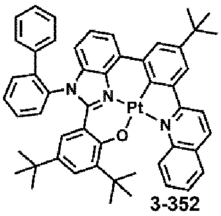
3-352

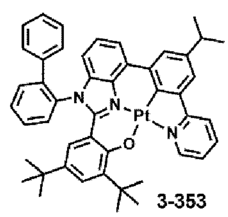
3-353

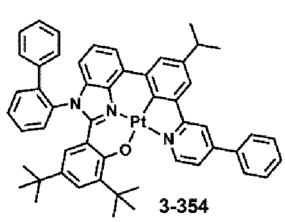
3-354

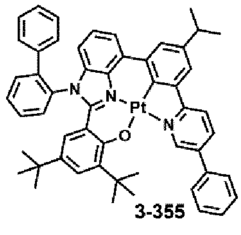
3-355

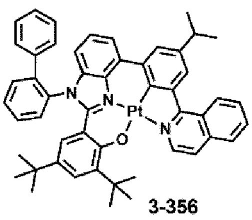
3-356

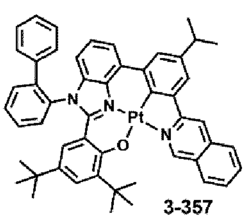
3-357

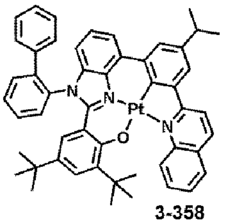
3-358

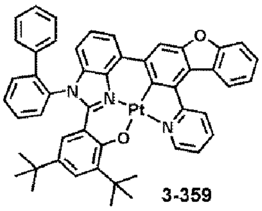
3-359

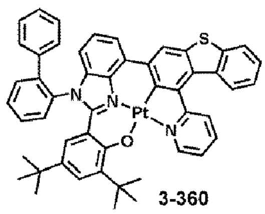
3-360

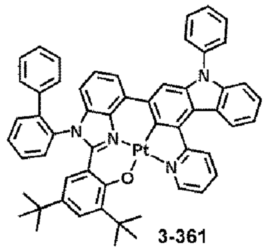
3-361

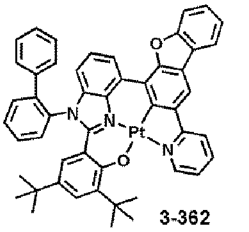
3-362

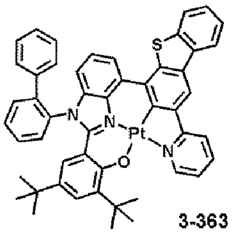
3-363

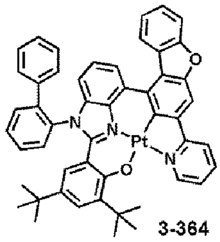
3-364

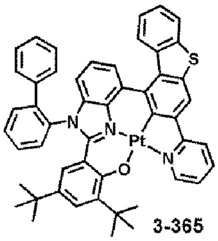
3-365

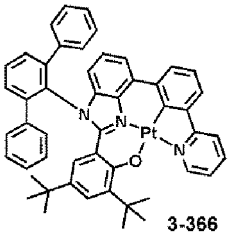
3-366

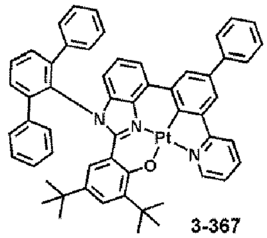
3-367

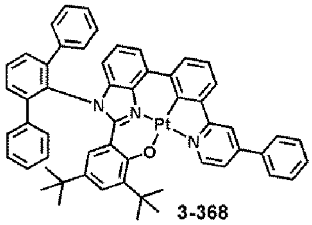
3-368

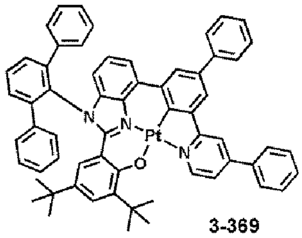
3-369

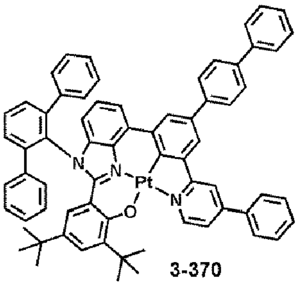
3-370

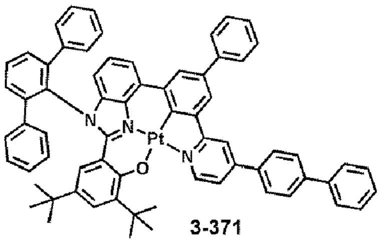
3-371

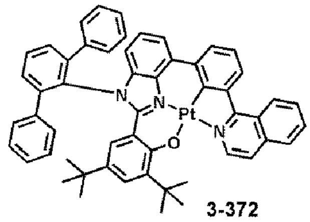
3-372

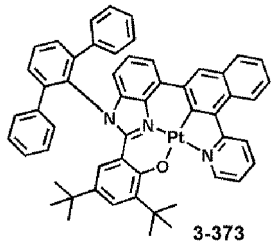
3-373

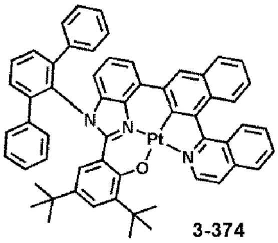
3-374

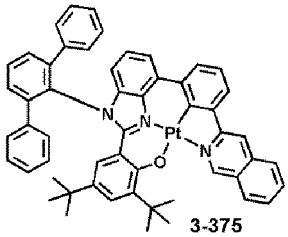
3-375

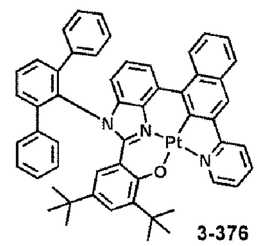
3-376

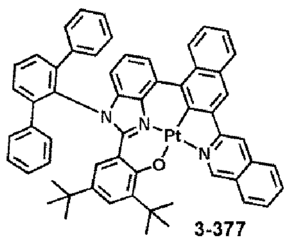
3-377

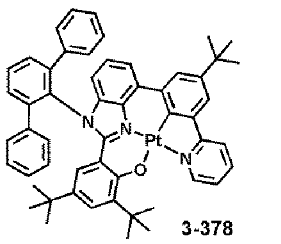
3-378

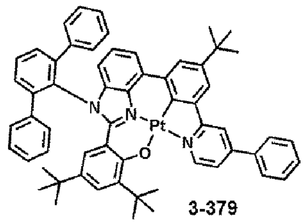
3-379

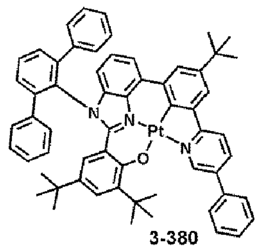
3-380

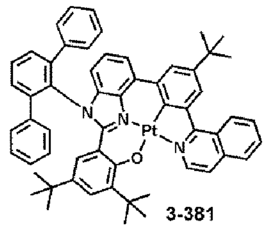
3-381

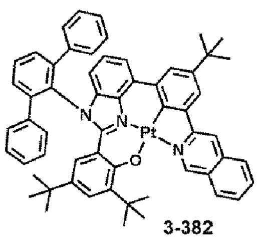
3-382

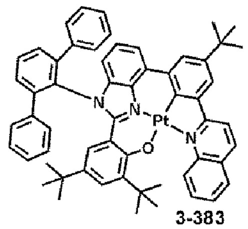
3-383

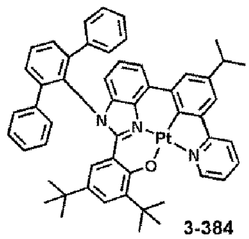
3-384

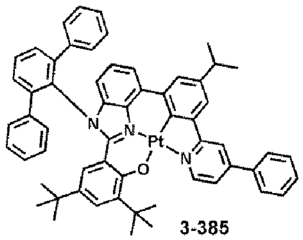
3-385

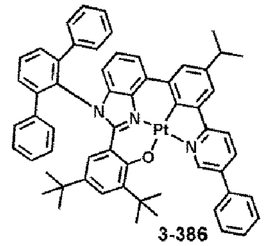
3-386

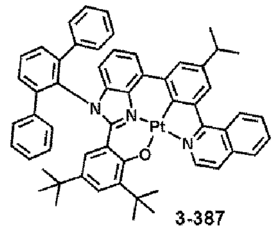
3-387

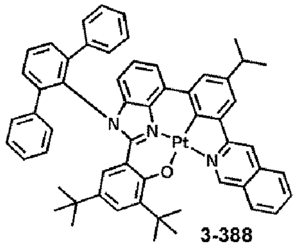
3-388

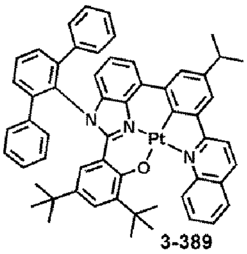
3-389

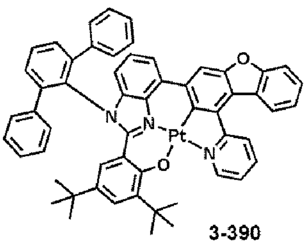
3-390

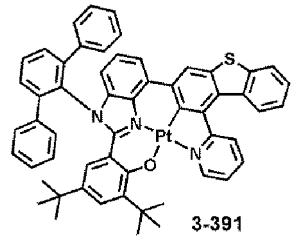
3-391

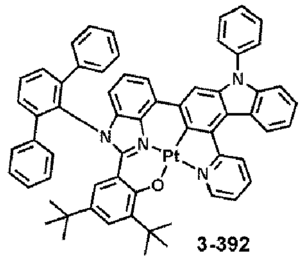
3-392

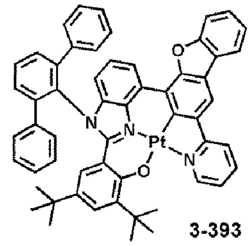
3-393

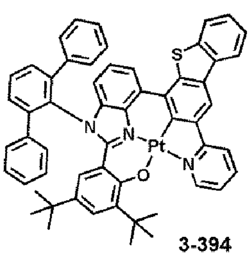
3-394

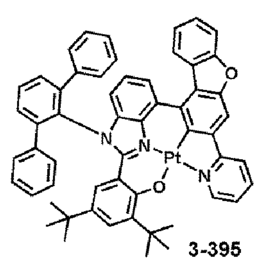
3-395

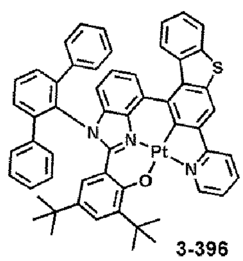
3-396

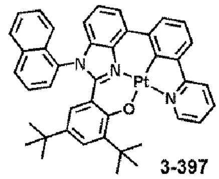
3-397

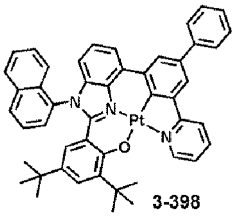
3-398

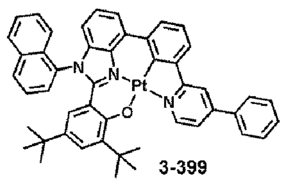
3-399

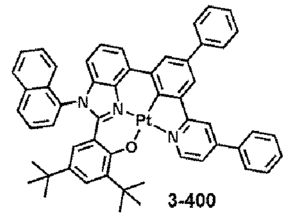
3-400

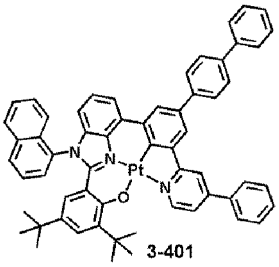
3-401

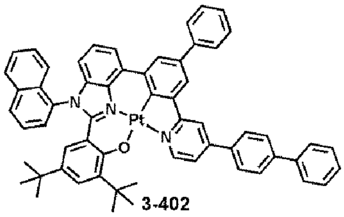
3-402

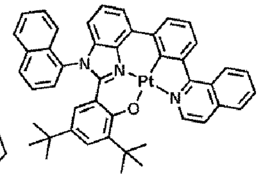
3-403

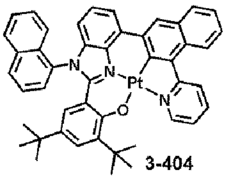
3-404

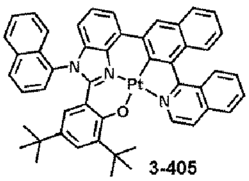
3-405

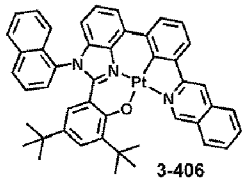
3-406

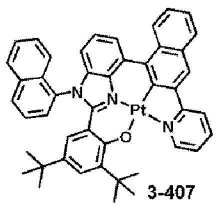
3-407

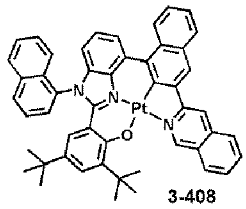
3-408

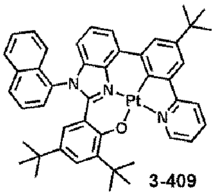
3-409

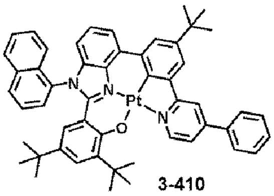
3-410

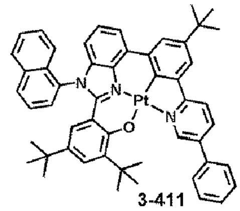
3-411

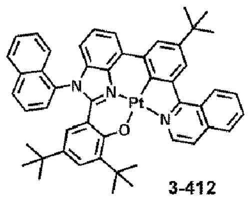
3-412

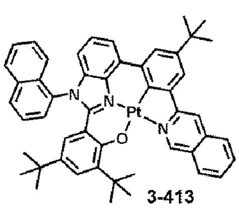
3-413

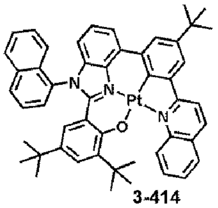
3-414

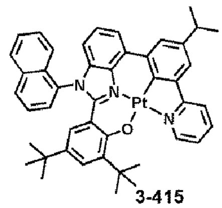
3-415

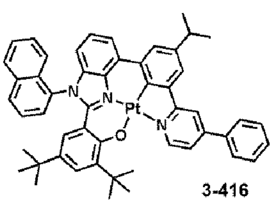
3-416

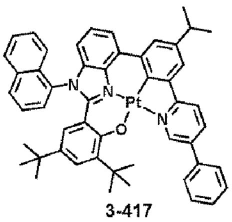
3-417

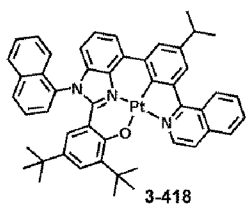
3-418

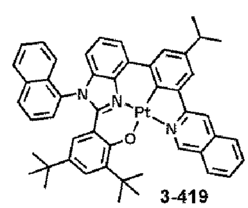
3-419

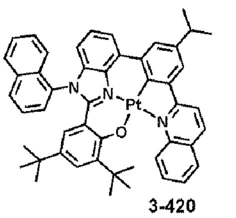
3-420

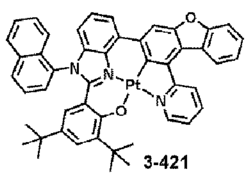
3-421

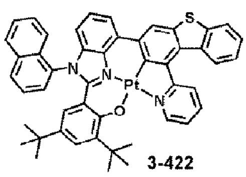
3-422

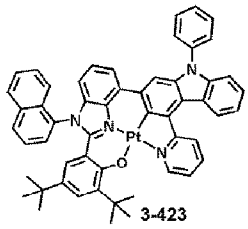
3-423

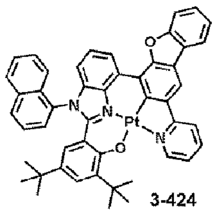
3-424

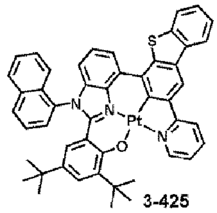
3-425

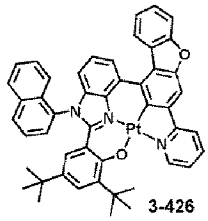
3-426

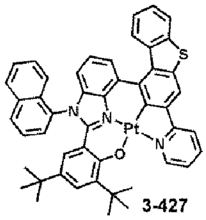
3-427

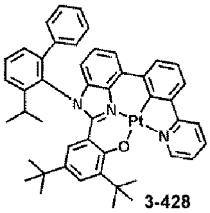
3-428

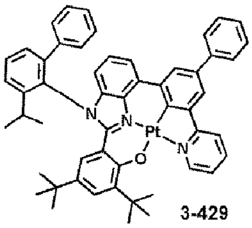
3-429

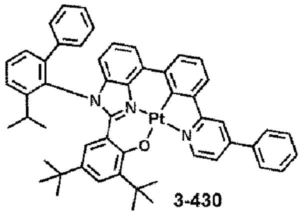
3-430

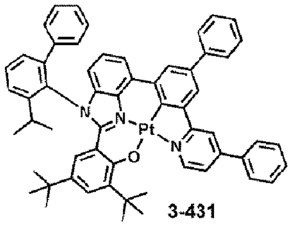
3-431

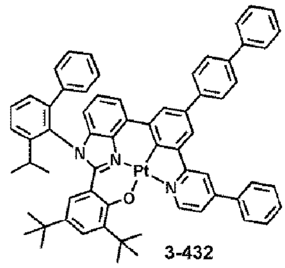
3-432

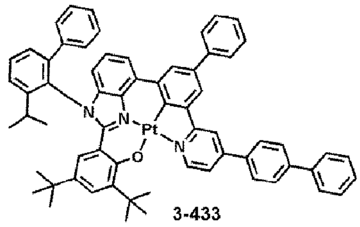
3-433

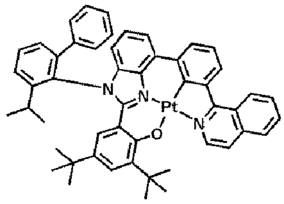
3-434

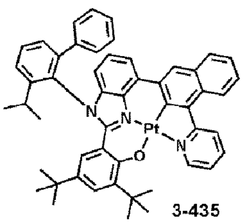
3-435

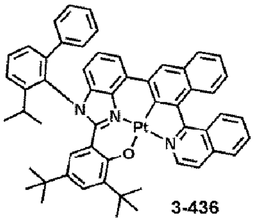
3-436

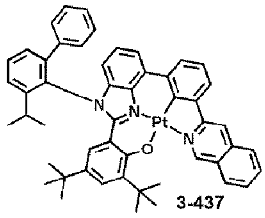
3-437

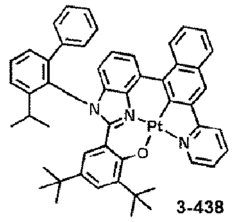
3-438

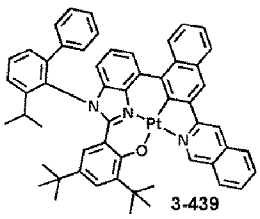
3-439

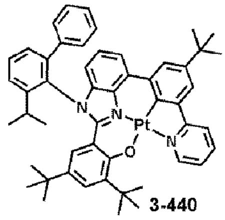
3-440

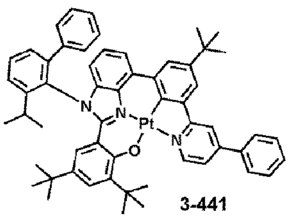
3-441

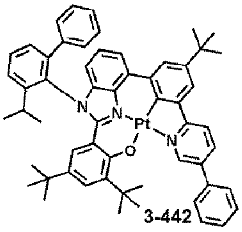
3-442

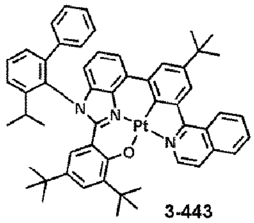
3-443

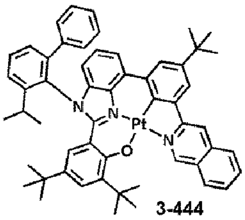
3-444

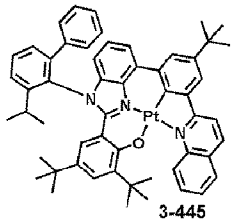
3-445

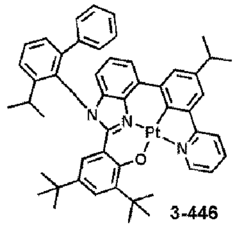
3-446

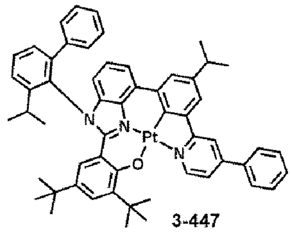
3-447

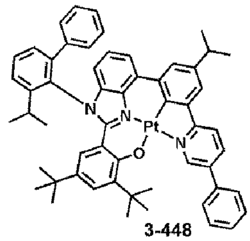
3-448

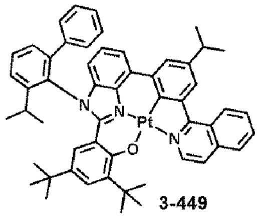
3-449

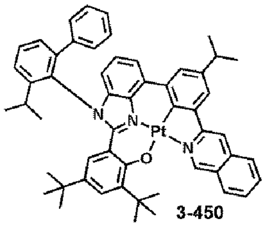
3-450

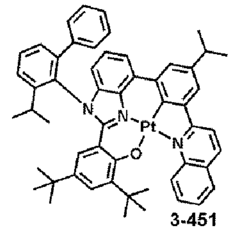
3-451

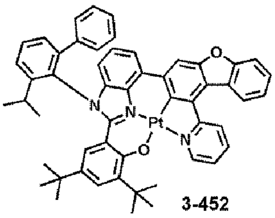
3-452

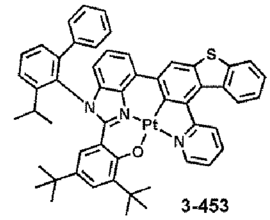
3-453

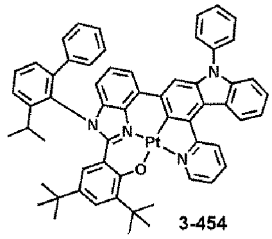
3-454

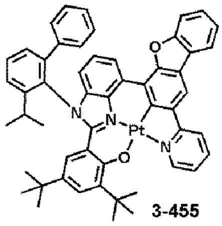
3-455

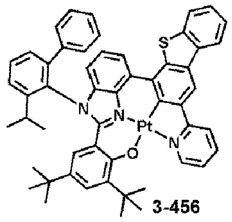
3-456

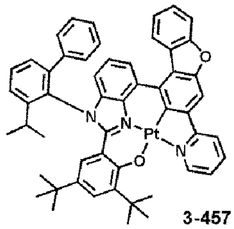
3-457

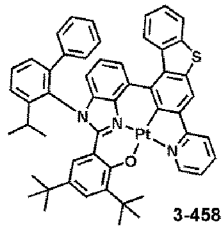
3-458

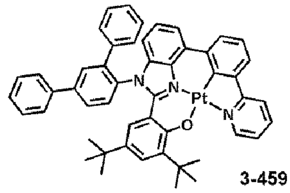
3-459

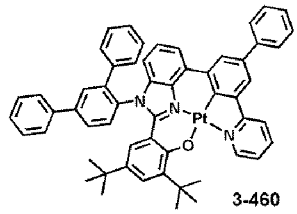
3-460

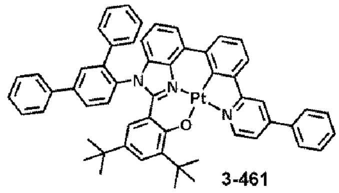
3-461

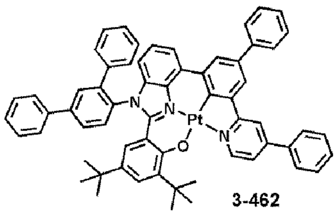
3-462

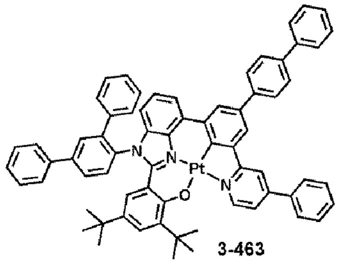
3-463

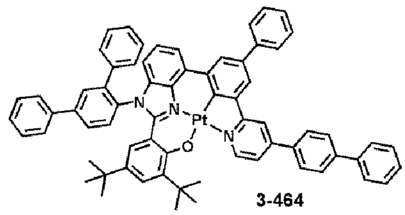
3-464

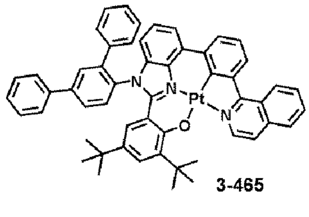
3-465

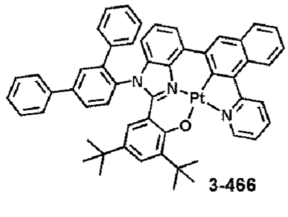
3-466

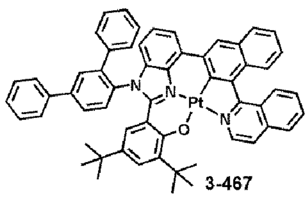
3-467

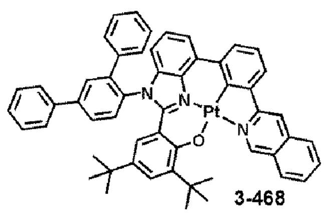
3-468

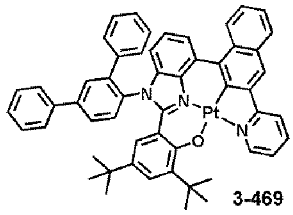
3-469

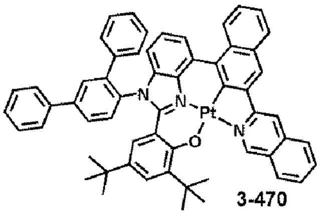
3-470

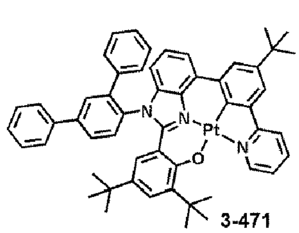
3-471

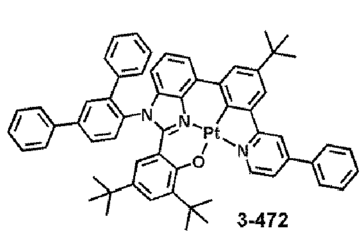
3-472

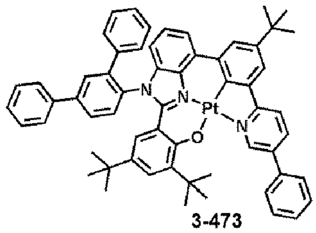
3-473

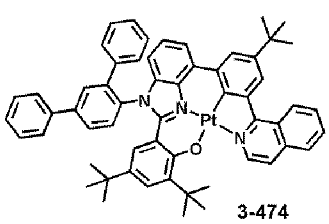
3-474

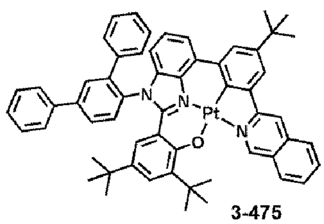
3-475

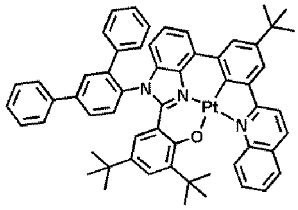
3-476

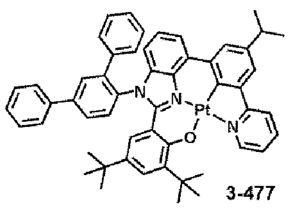
3-477

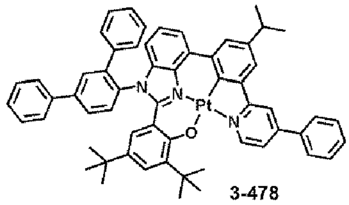
3-478

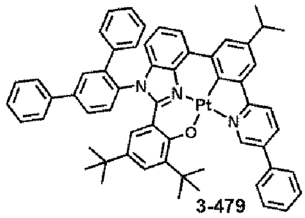
3-479

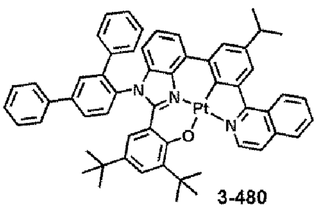
3-480

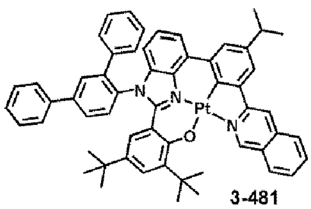
3-481

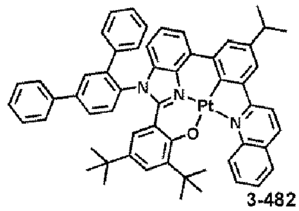
3-482

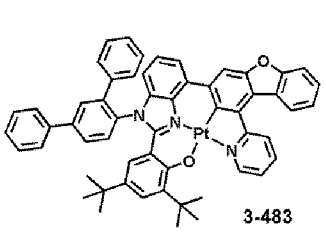
3-483

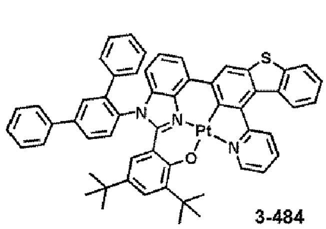
3-484

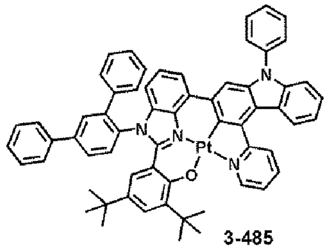
3-485

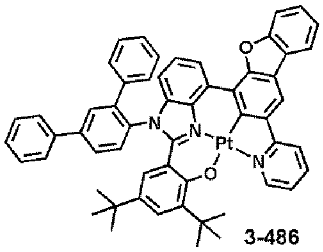
3-486

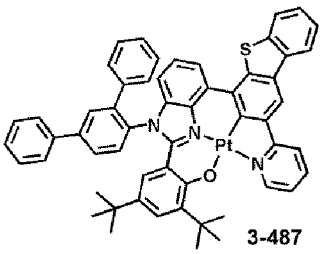
3-487

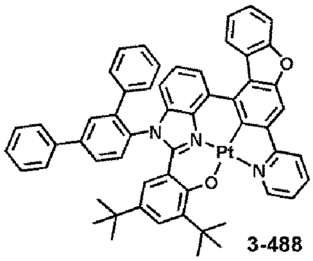
3-488

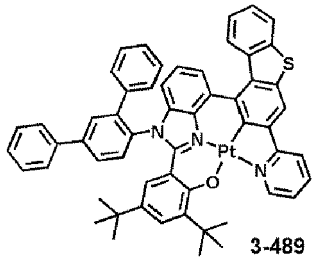
3-489

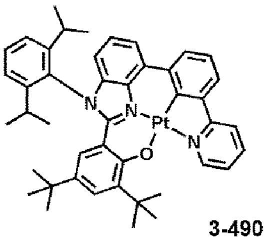
3-490

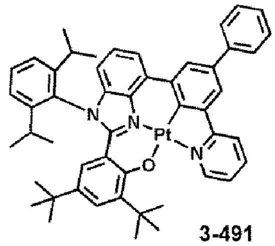
3-491

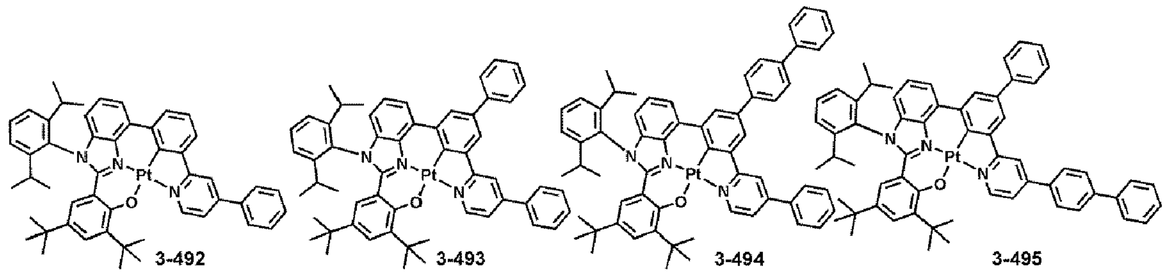
3-492 3-493 3-494 3-495

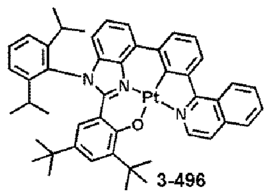
3-496

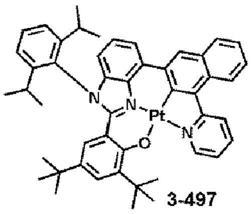
3-497

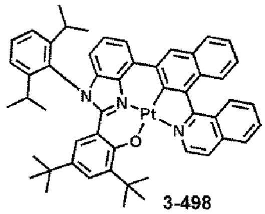
3-498

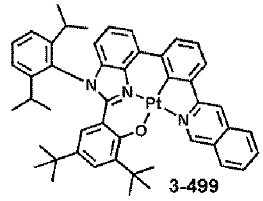
3-499

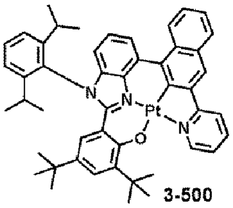
3-500

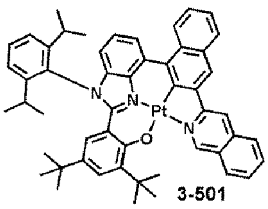
3-501

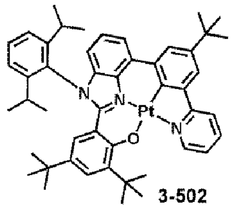
3-502

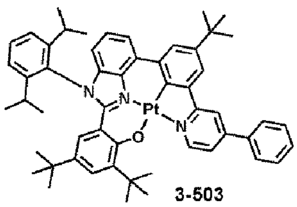
3-503

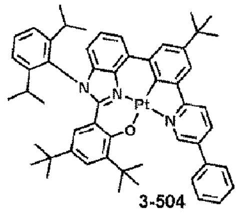
3-504

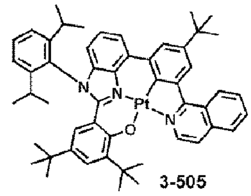
3-505

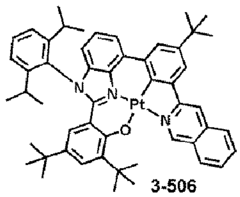
3-506

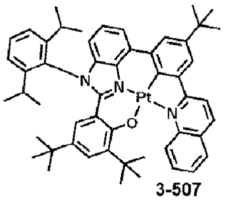
3-507

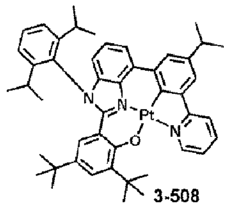
3-508

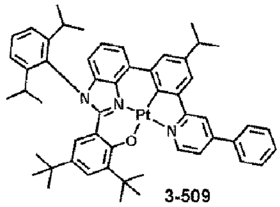
3-509

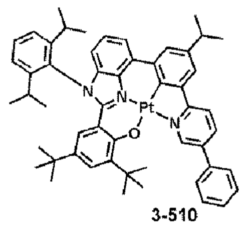
3-510

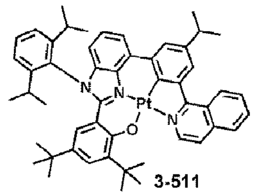
3-511

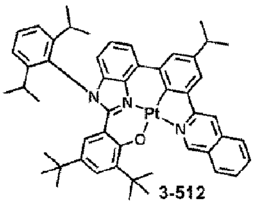
3-512

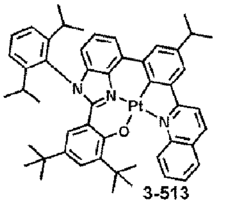
3-513

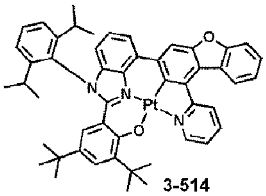
3-514

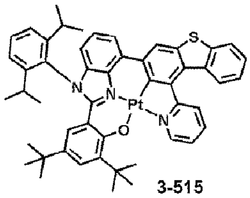
3-515

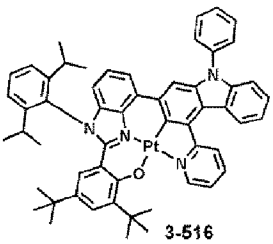
3-516

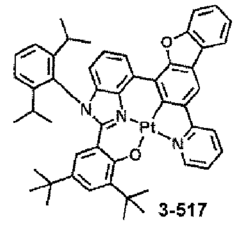
3-517

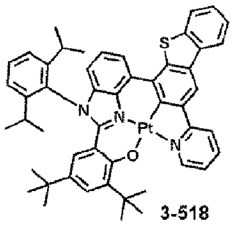
3-518

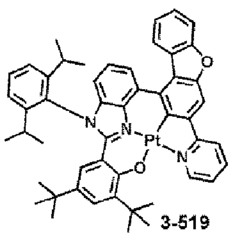
3-519

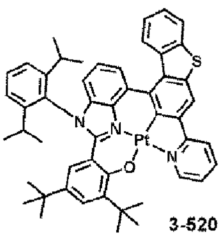
3-520

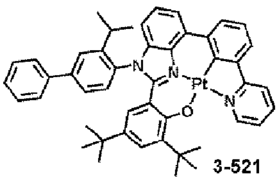
3-521

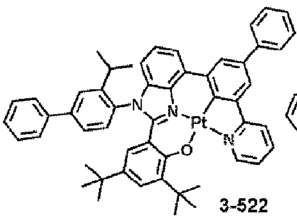
3-522

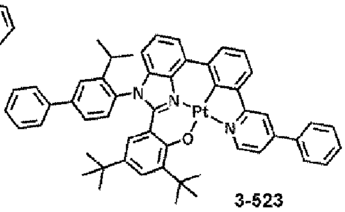
3-523

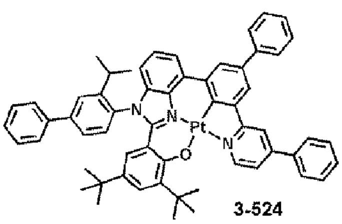
3-524

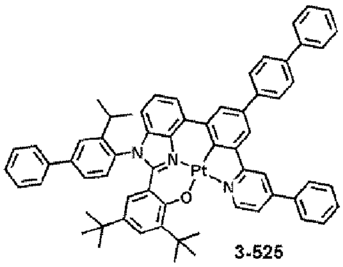
3-525

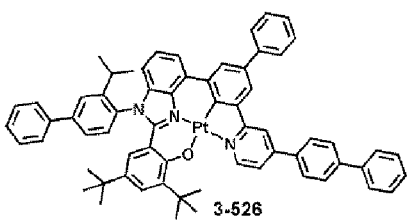
3-526

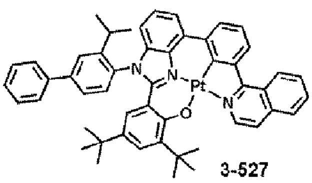
3-527

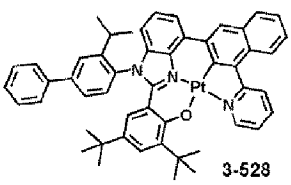
3-528

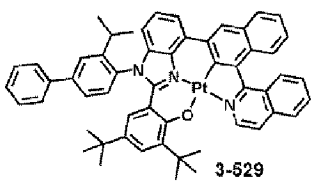
3-529

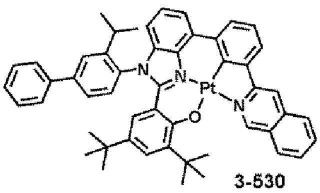
3-530

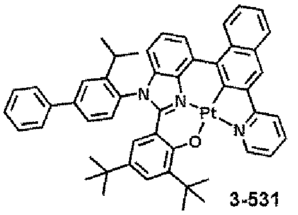
3-531

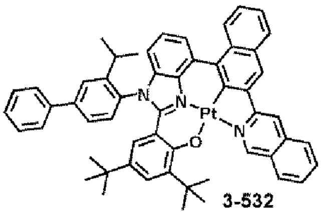
3-532

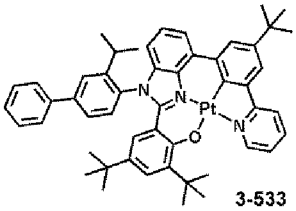
3-533

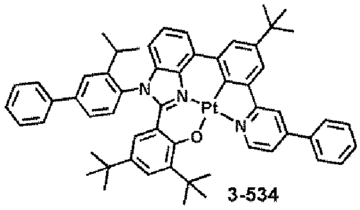
3-534

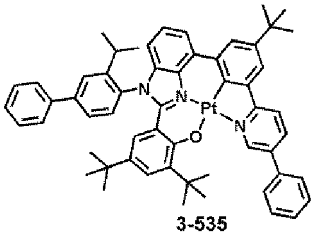
3-535

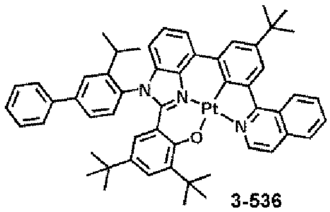
3-536

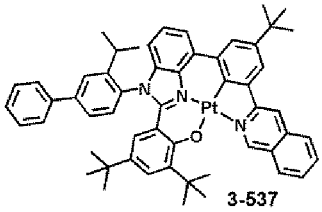
3-537

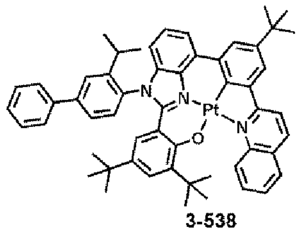
3-538

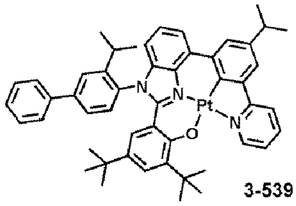
3-539

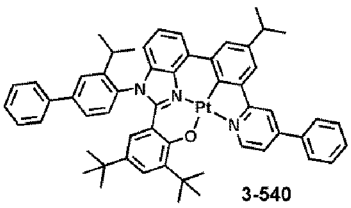
3-540

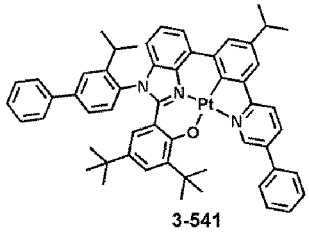
3-541

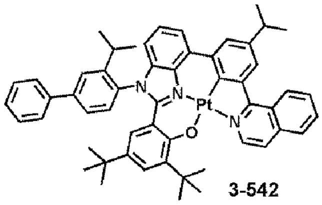
3-542

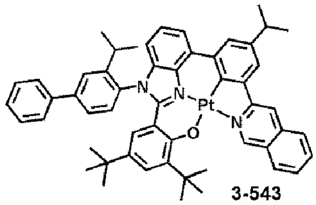
3-543

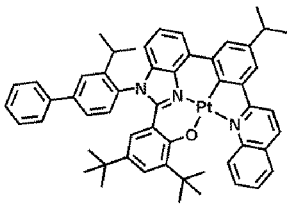
3-544

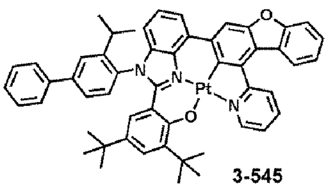
3-545

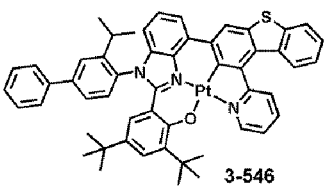
3-546

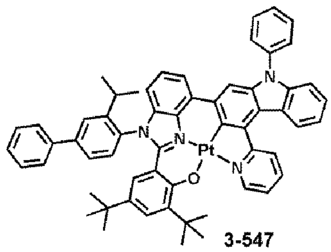
3-547

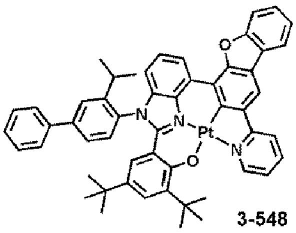
3-548

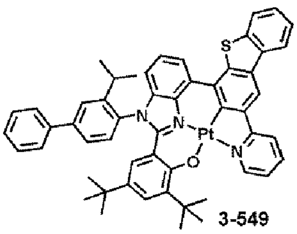
3-549

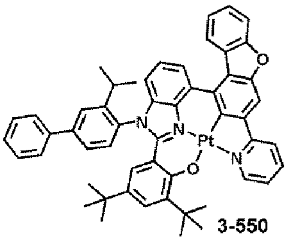
3-550

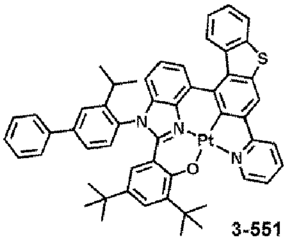
3-551

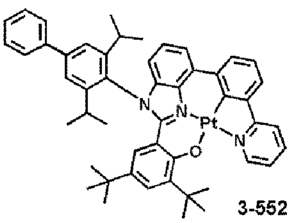
3-552

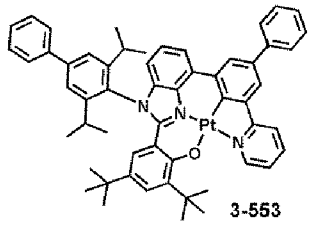
3-553

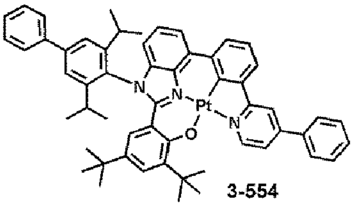
3-554

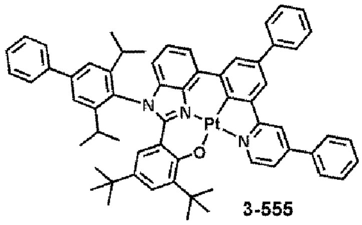
3-555

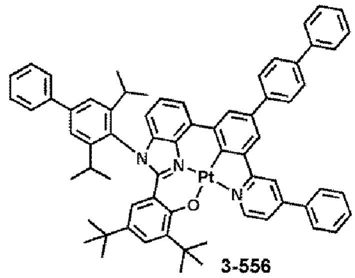
3-556

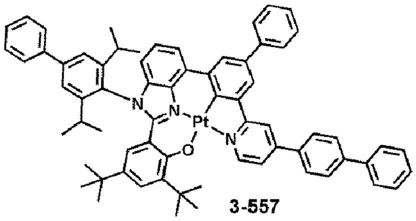
3-557

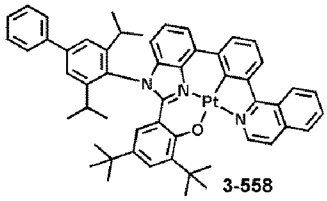
3-558

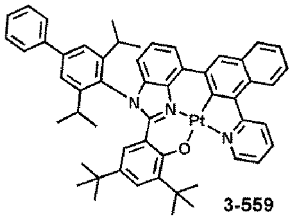
3-559

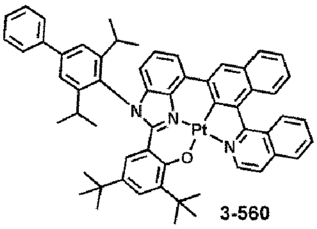
3-560

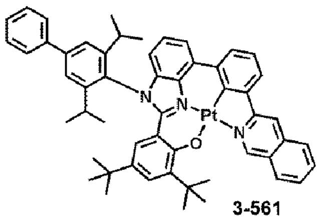
3-561

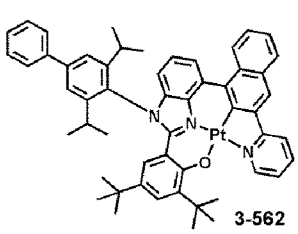
3-562

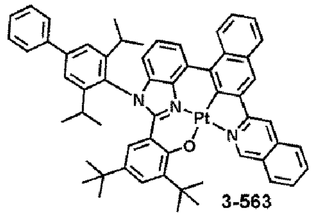
3-563

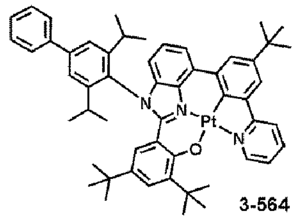
3-564

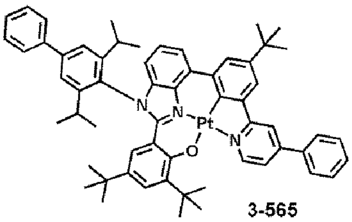
3-565

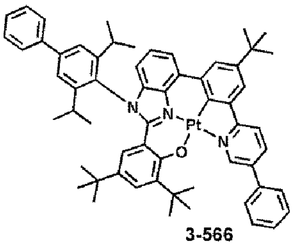
3-566

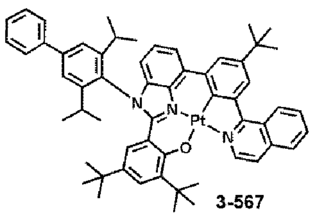
3-567

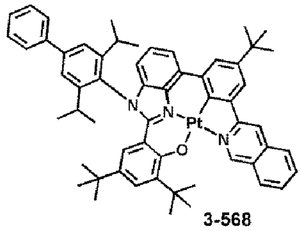
3-568

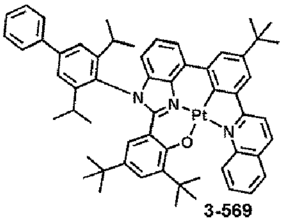
3-569

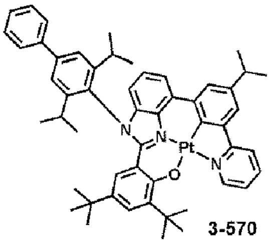
3-570

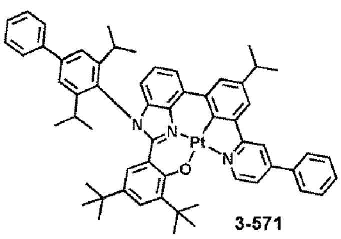
3-571

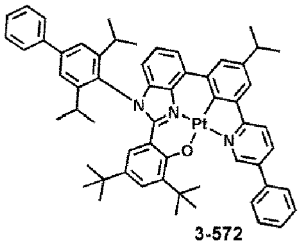
3-572

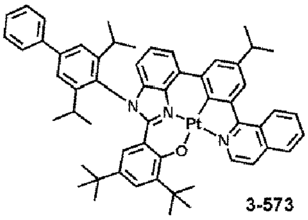
3-573

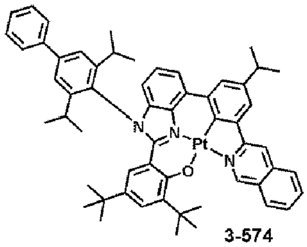
3-574

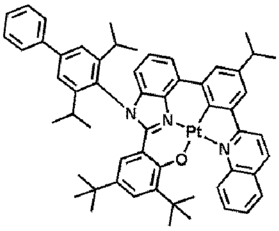
3-575

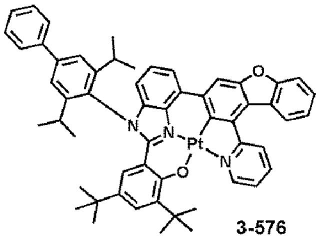
3-576

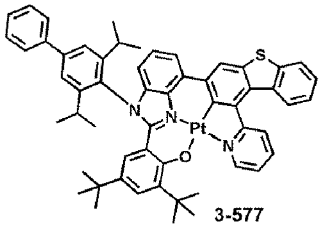
3-577

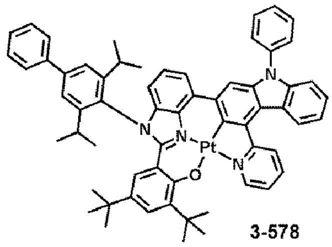
3-578

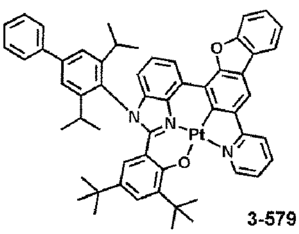
3-579

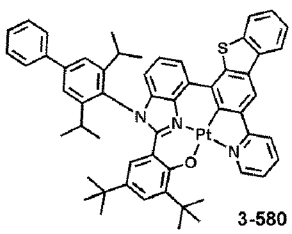
3-580

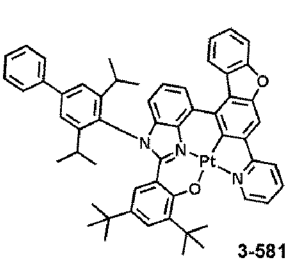
3-581

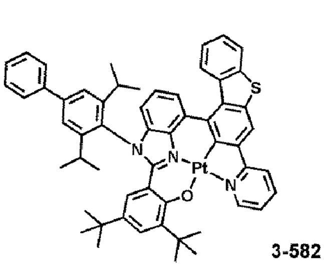
3-582

[Group 1-2]

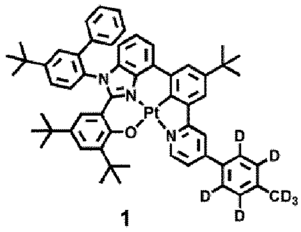
1

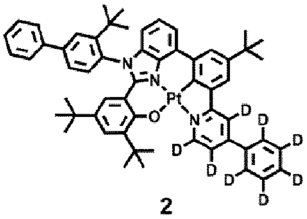
2

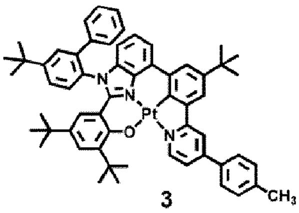
3

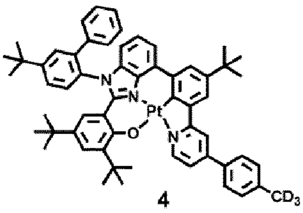
4

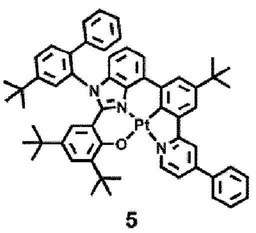
5

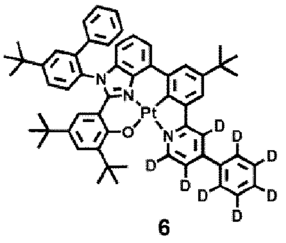
6

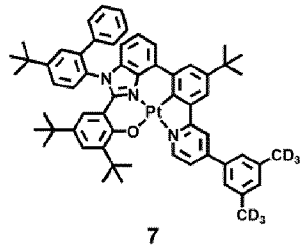
7

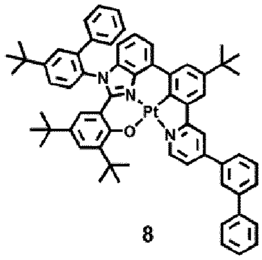
8

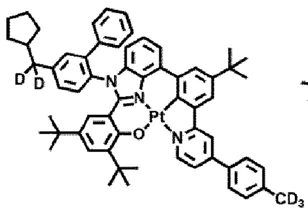
9

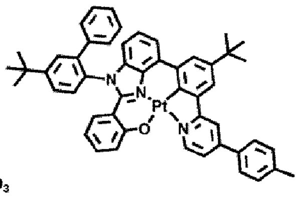
10

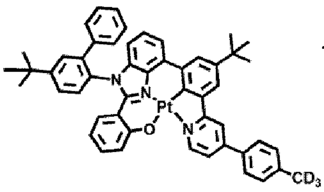
11

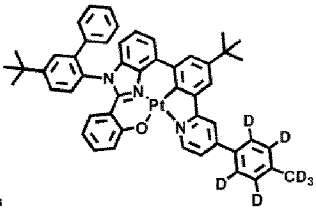
12

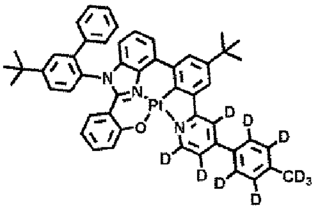
13

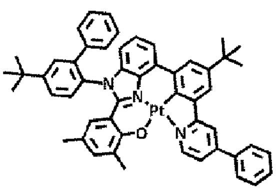
14

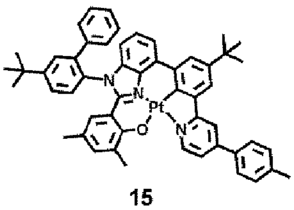
15

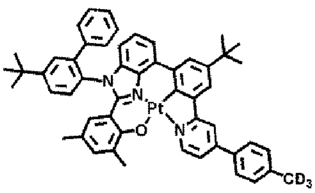
16

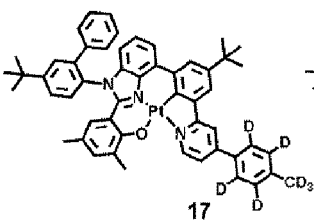
17

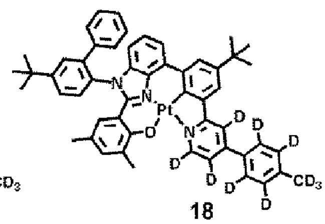
18

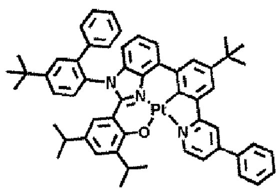
19

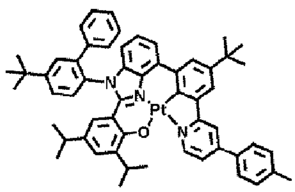
20

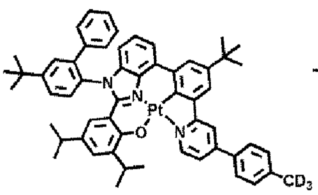
21

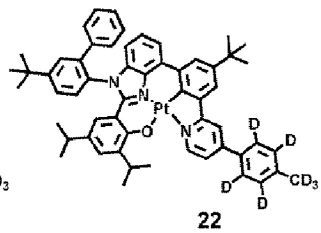
22

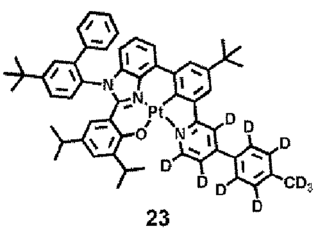
23

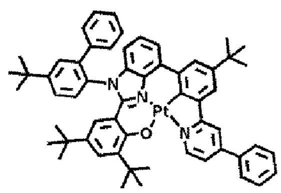
24

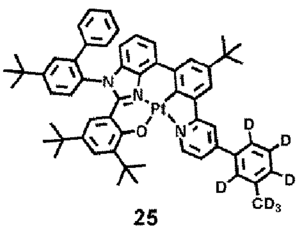
25

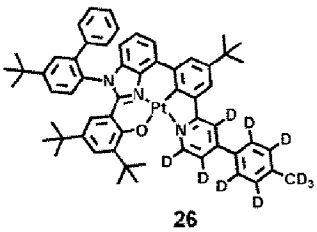
26

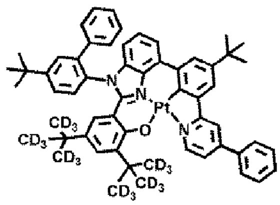
27

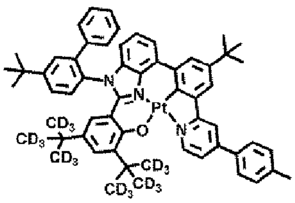
28

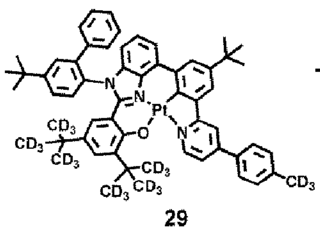
29

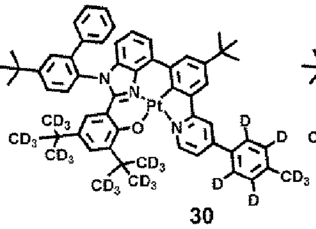
30

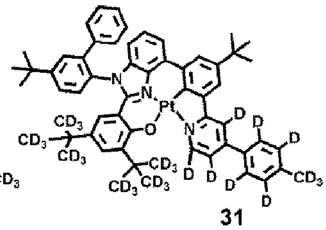
31

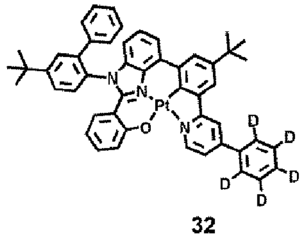
32

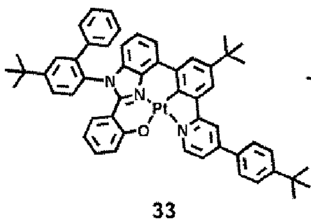
33

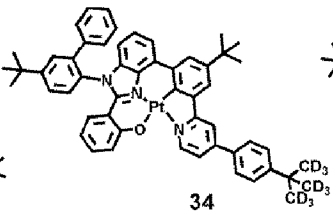
34

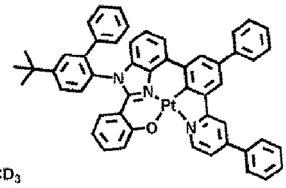
35

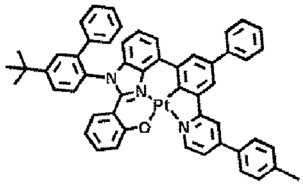
36

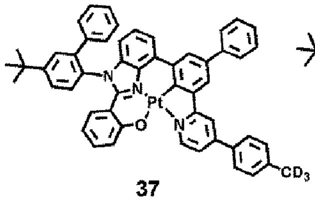
37

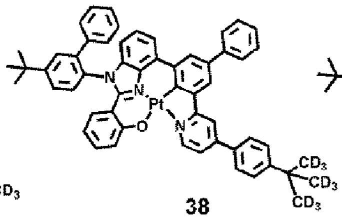
38

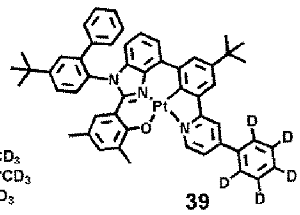
39

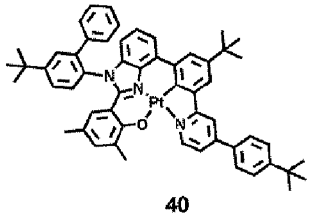
40

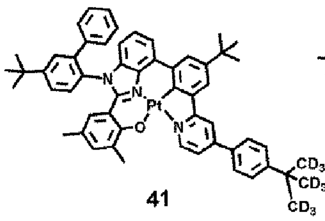
41

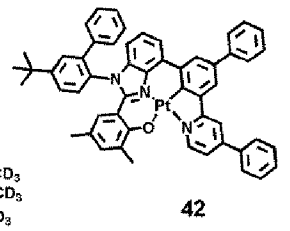
42

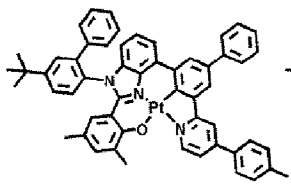
43

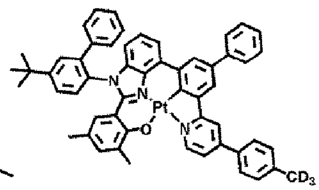
44

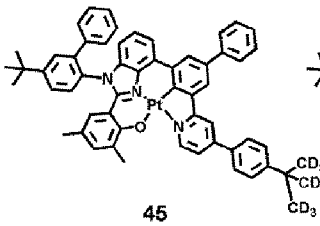
45

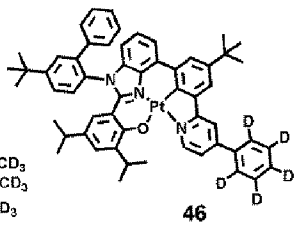
46

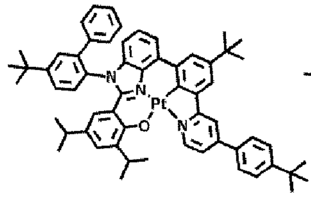
47

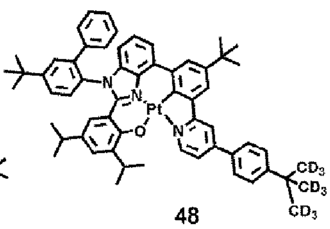
48

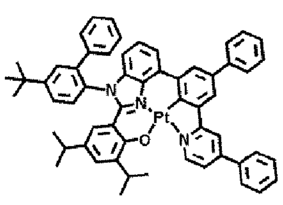
49
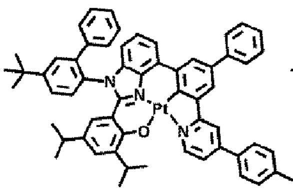
50
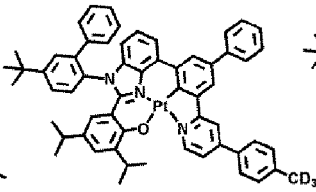
51
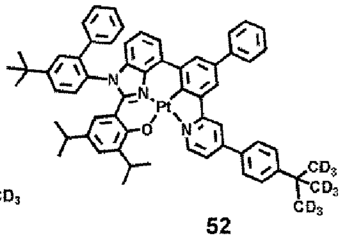
52

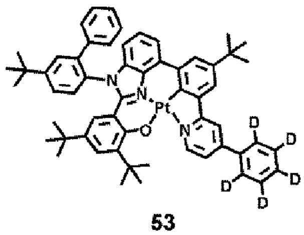
53
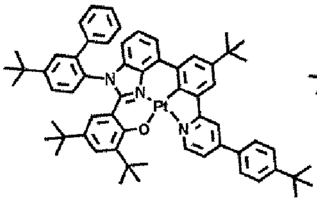
54
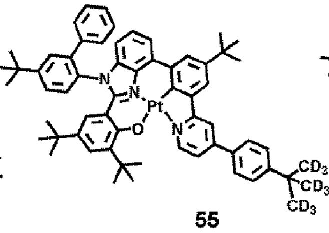
55
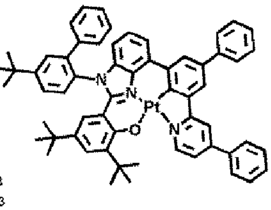
56

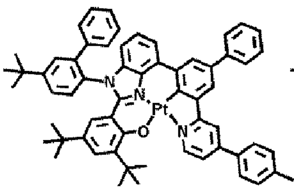
57
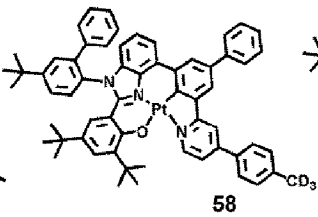
58
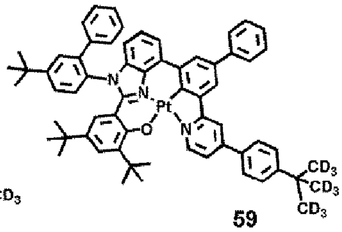
59
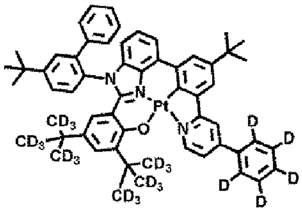
60

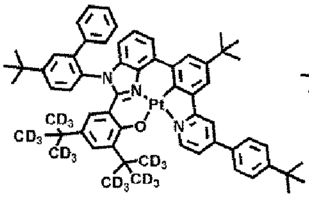
61
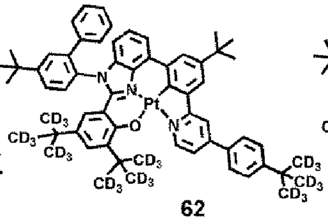
62
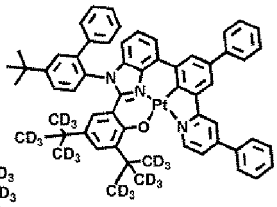
63
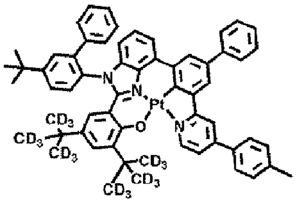
64

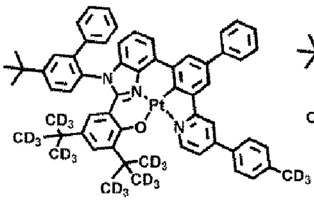
65
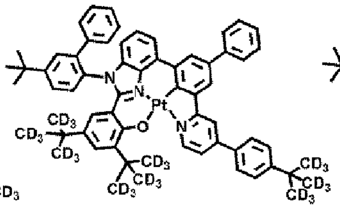
66
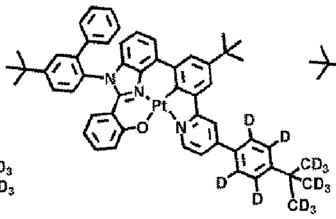
67
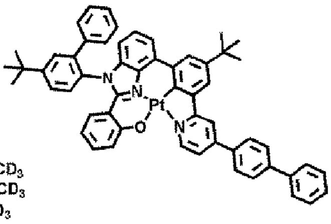
68

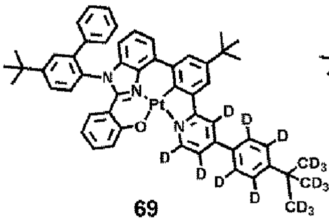
69
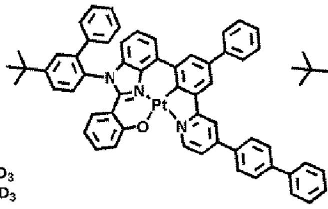
70
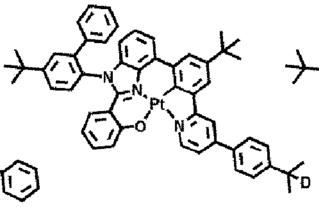
71
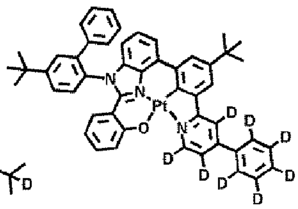
72

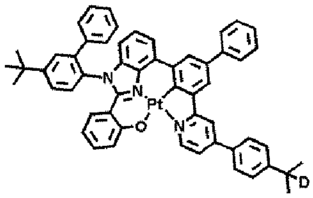

73

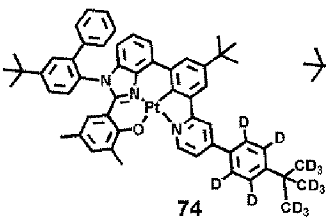

74

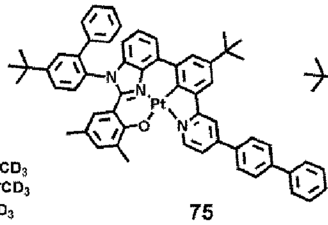

75

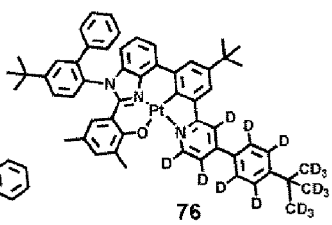

76

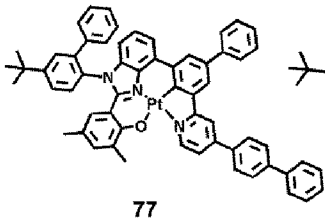

77

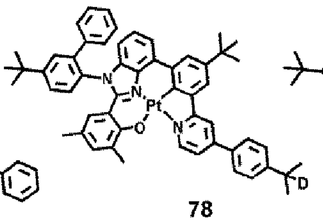

78

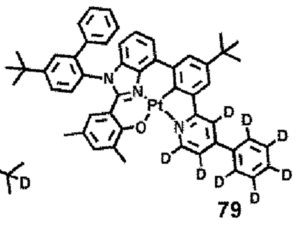

79

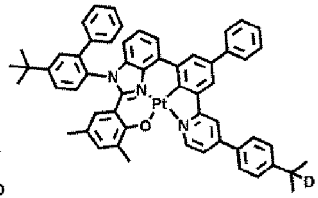

80

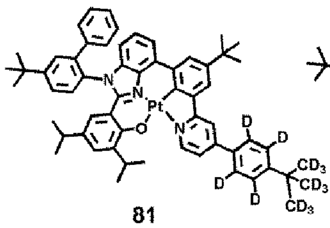

81

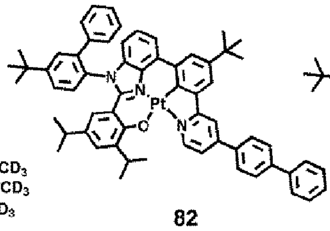

82

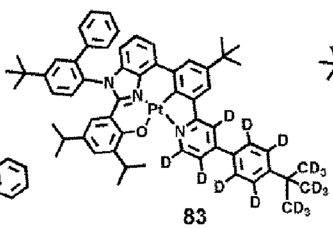

83

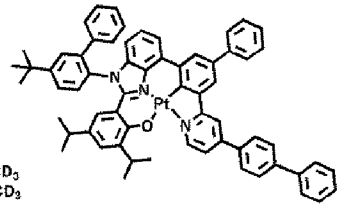

84

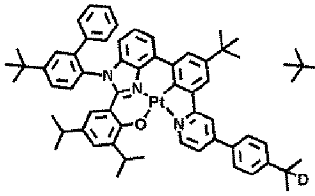

85

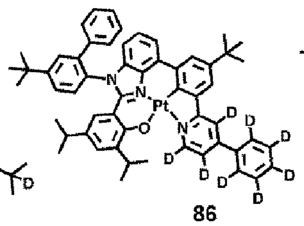

86

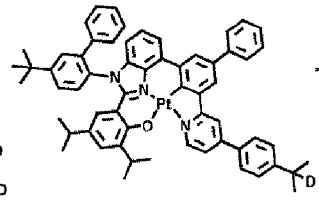

87

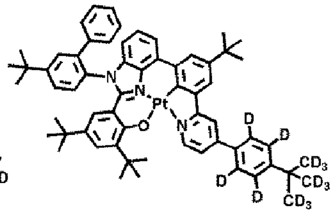

88

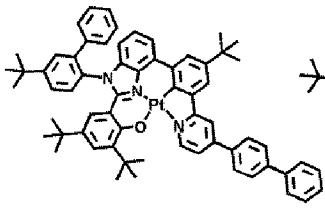

89

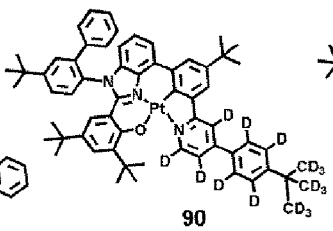

90

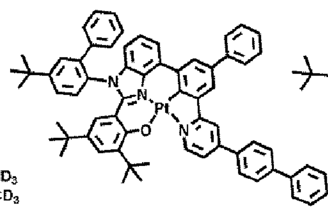

91

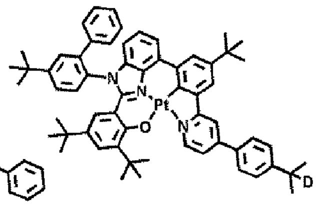

92

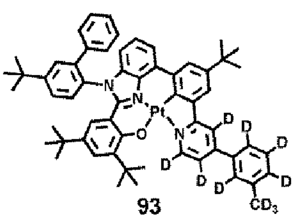

93

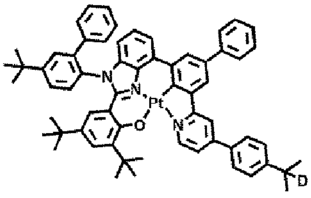

94

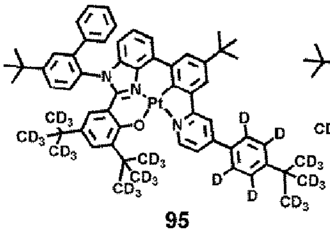

95

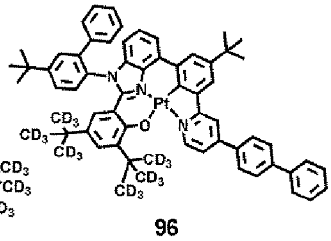

96

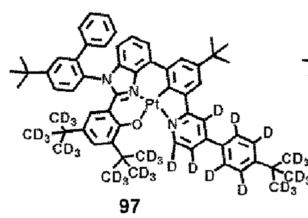
97
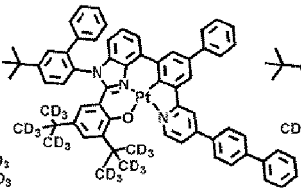
98
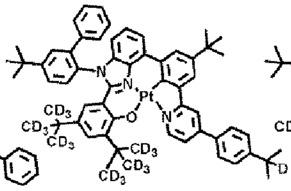
99
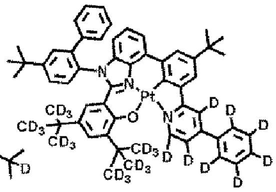
100

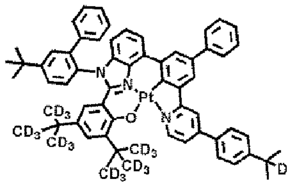
101
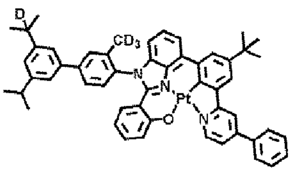
102
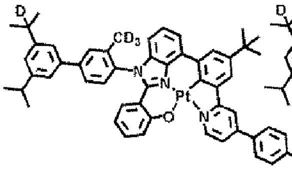
103
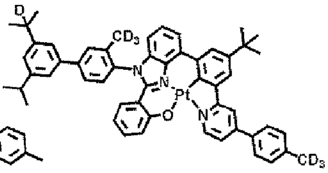
104

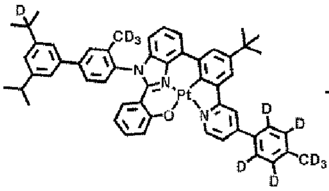
105
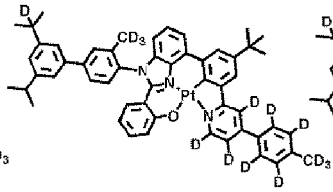
106
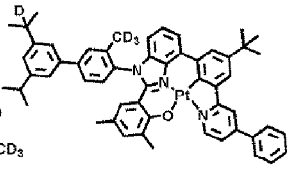
107
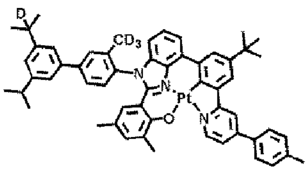
108

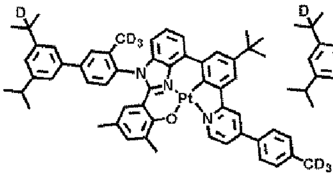
109
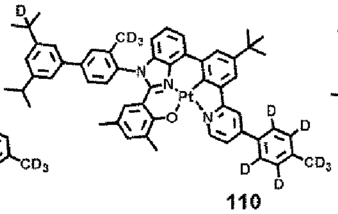
110
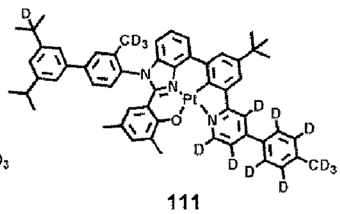
111
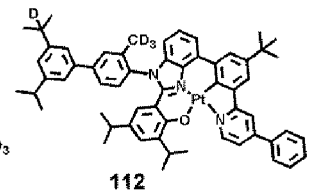
112

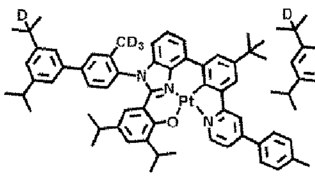
113
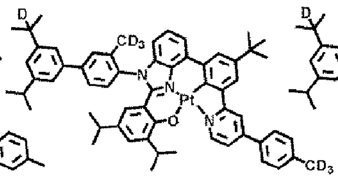
114
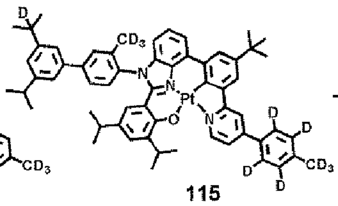
115
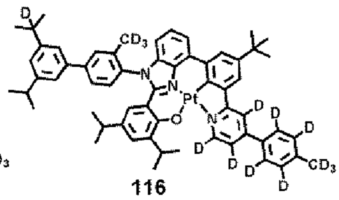
116

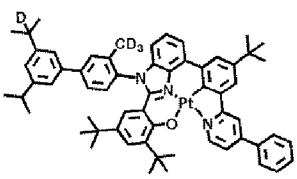
117
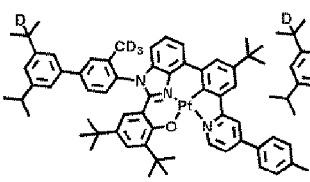
118
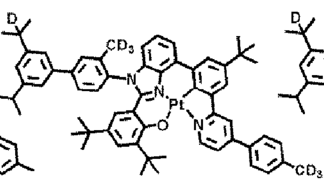
119
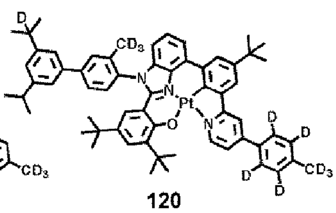
120

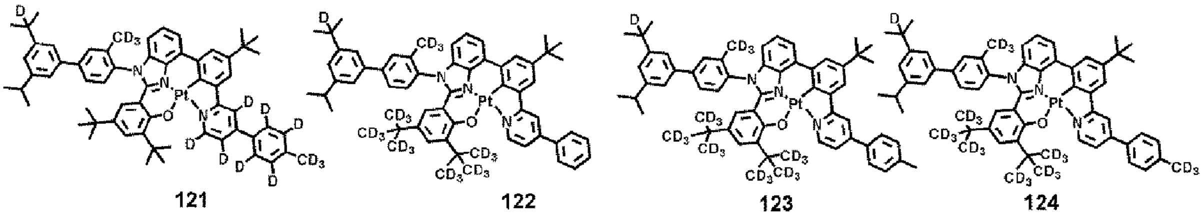

121 122 123 124

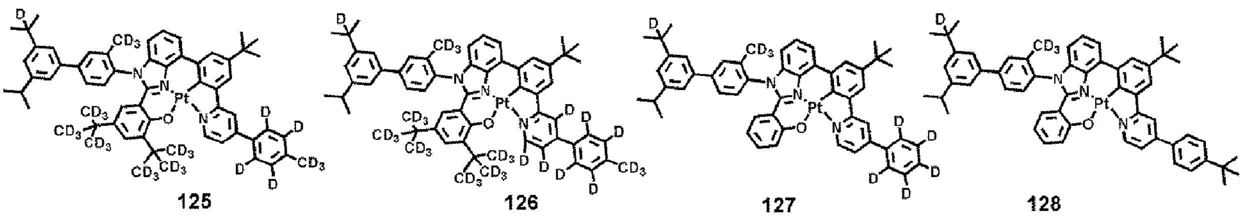

125 126 127 128

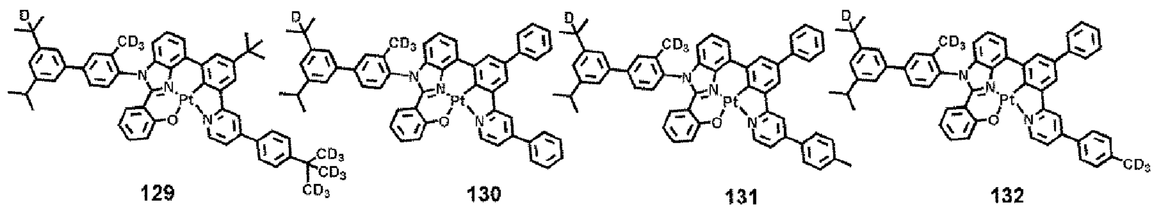

129 130 131 132

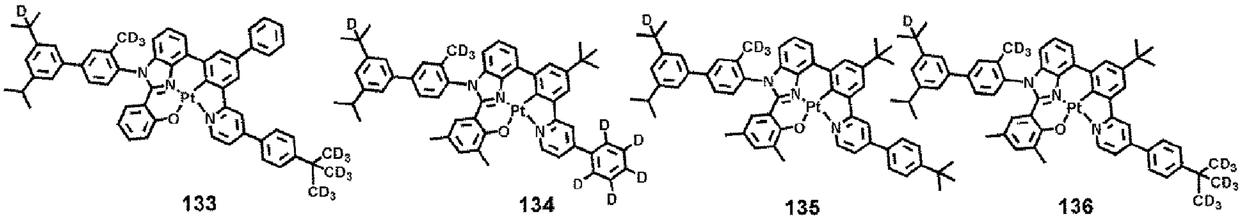

133 134 135 136

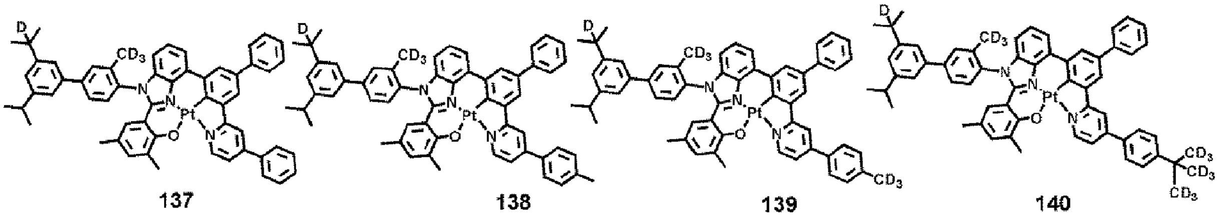

137 138 139 140

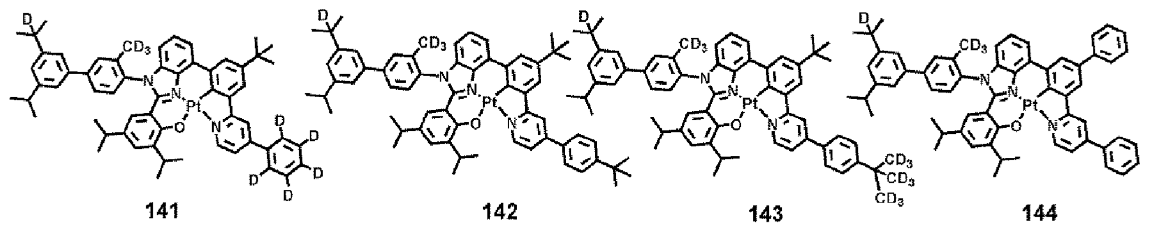

141 142 143 144

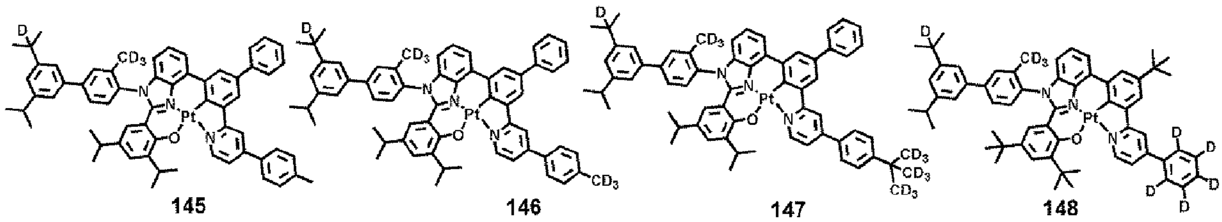

145 146 147 148

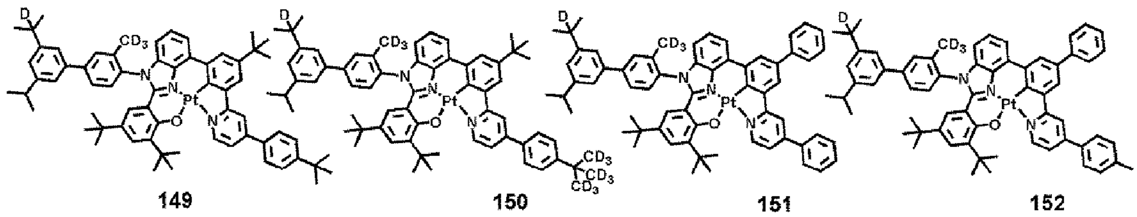

149 150 151 152

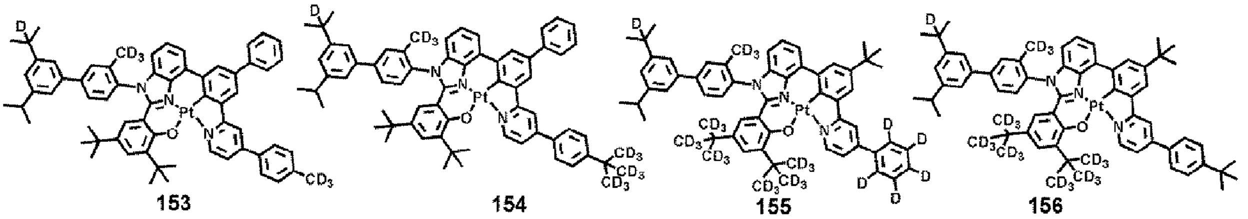

153 154 155 156

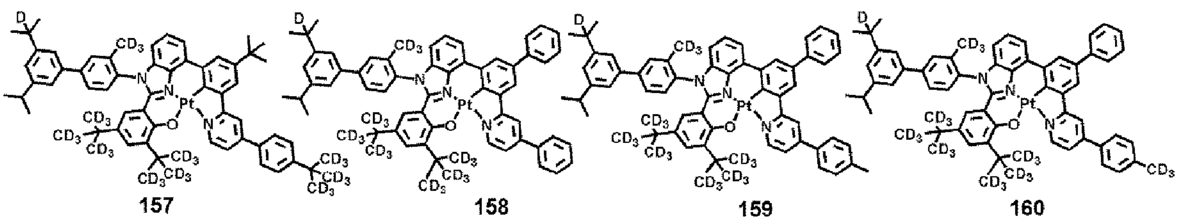

157 158 159 160

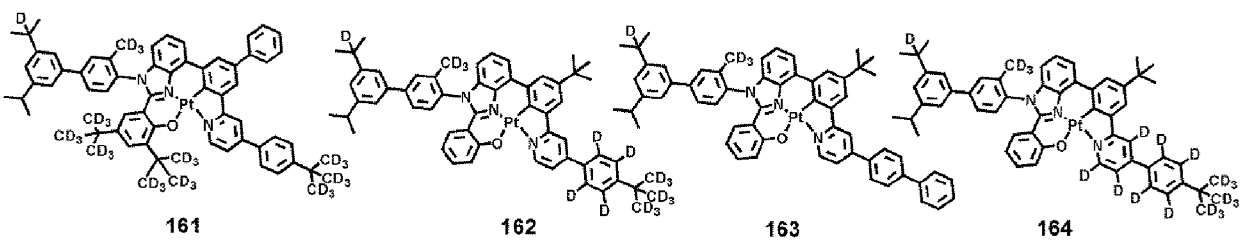

161 162 163 164

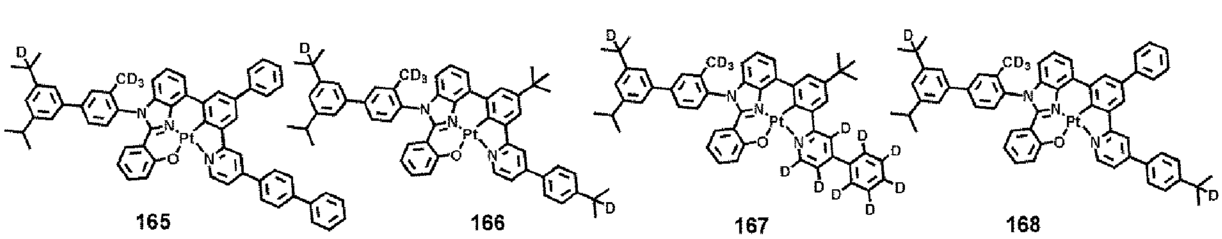

165 166 167 168

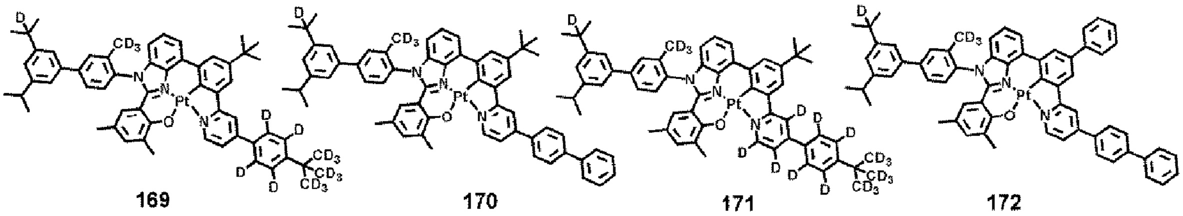

169 170 171 172

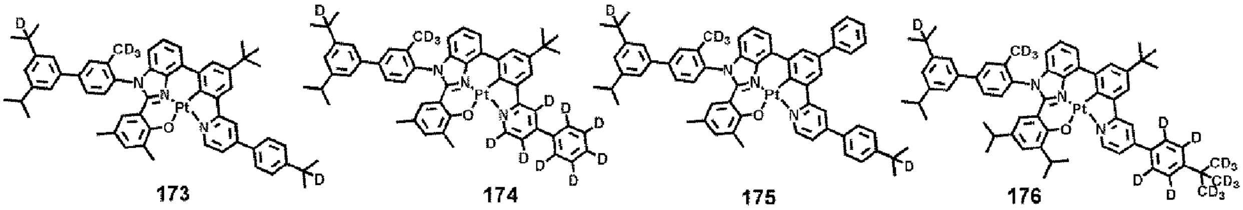

173 174 175 176

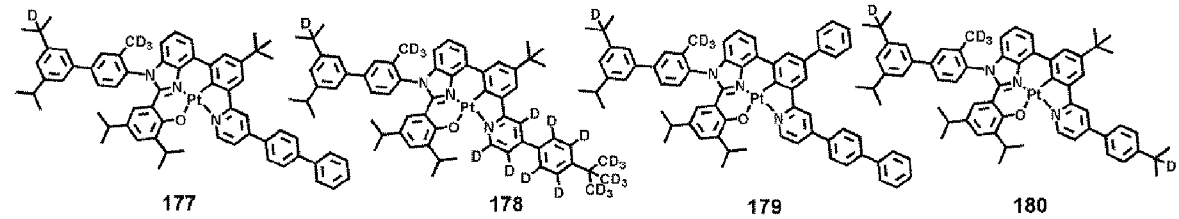

177 178 179 180

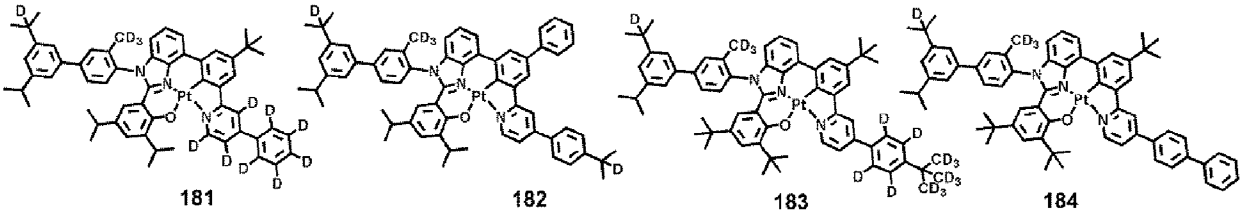

181 182 183 184

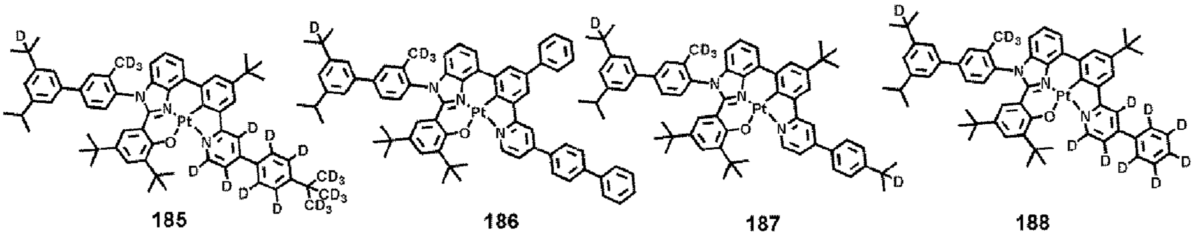

185 186 187 188

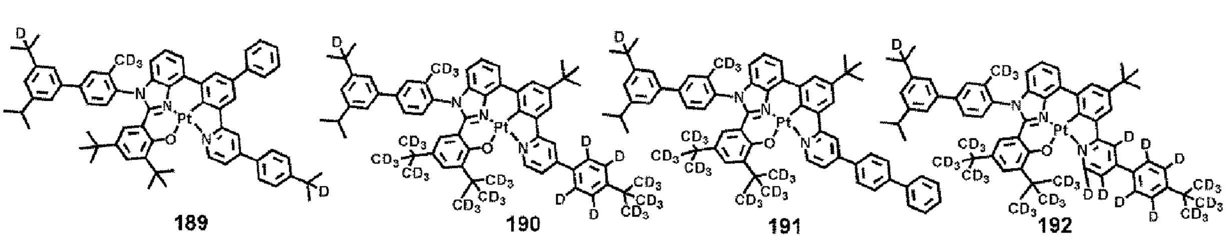

189 190 191 192

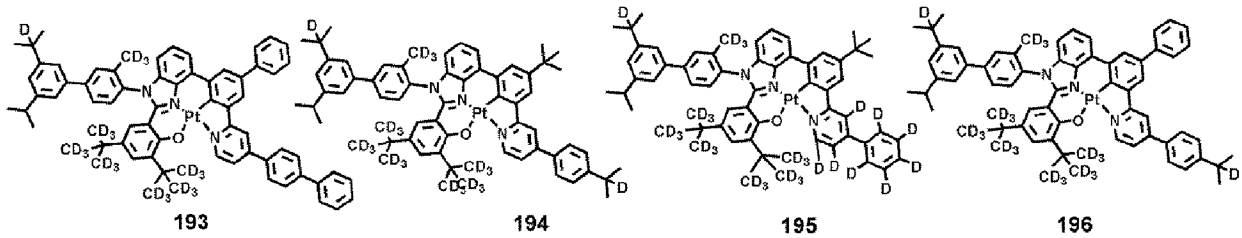

193 194 195 196

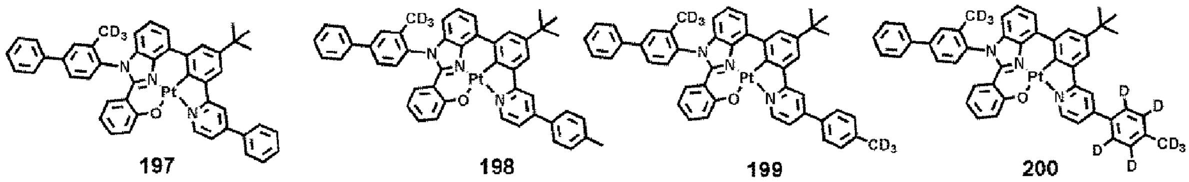

197 198 199 200

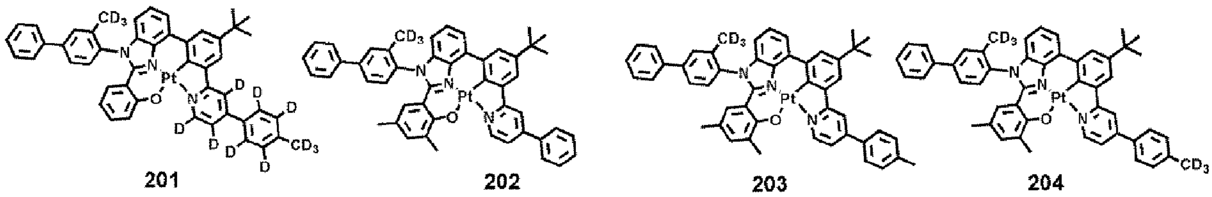

201 202 203 204

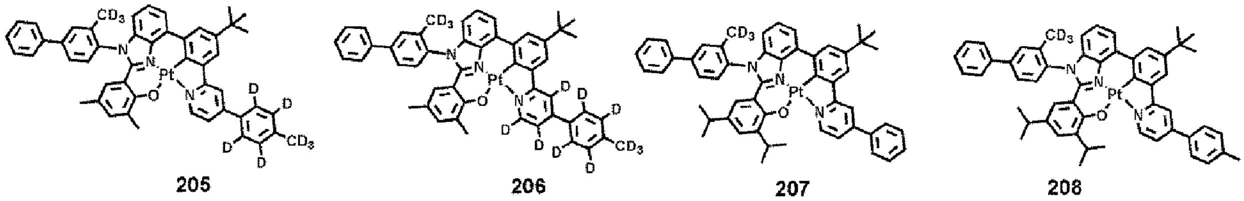

205 206 207 208

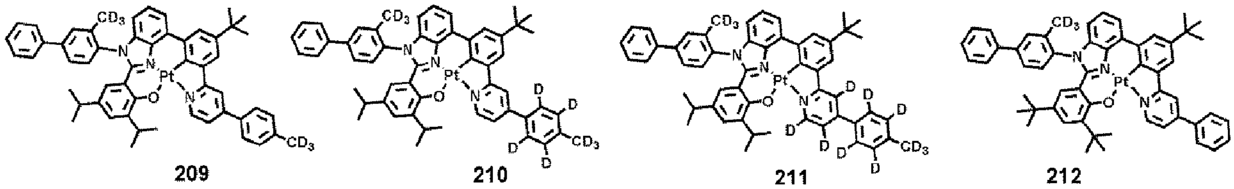

209 210 211 212

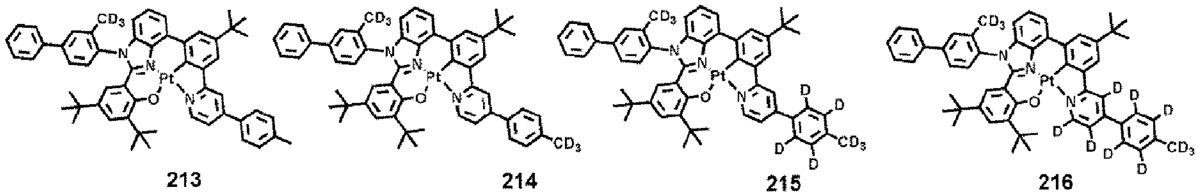

213 214 215 216

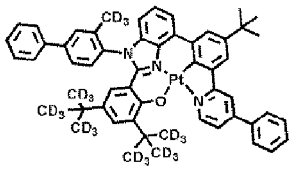

217

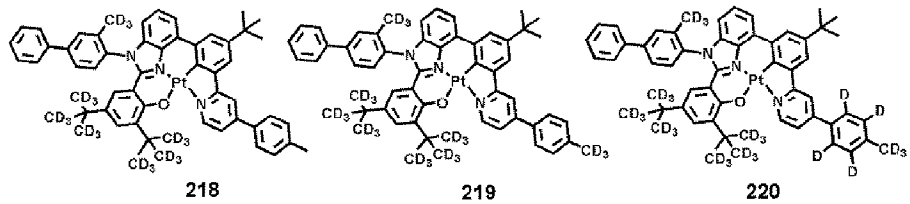

218 219 220

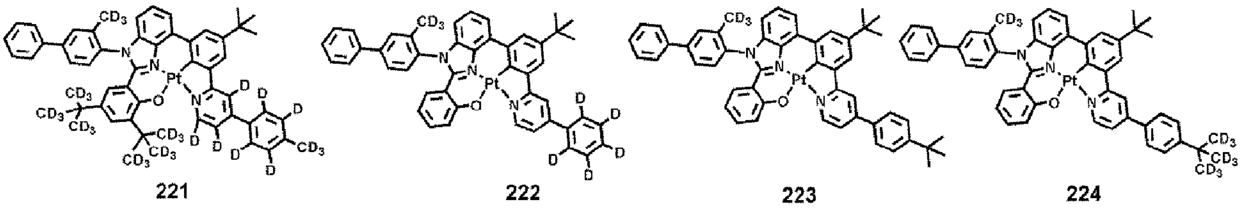

221 222 223 224

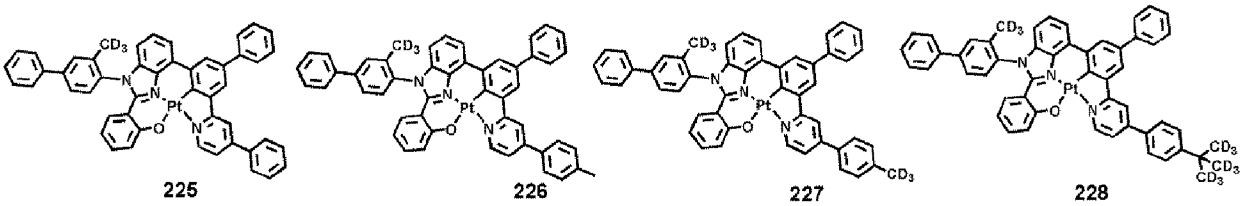

225 226 227 228

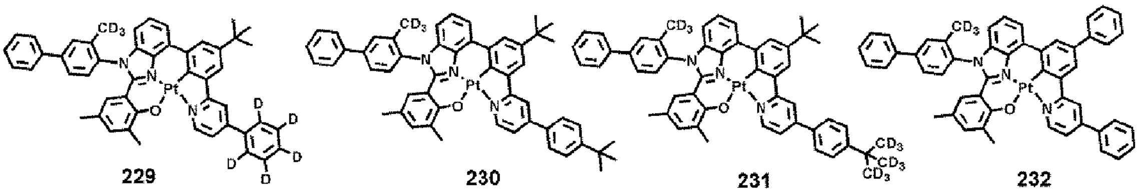

229 230 231 232

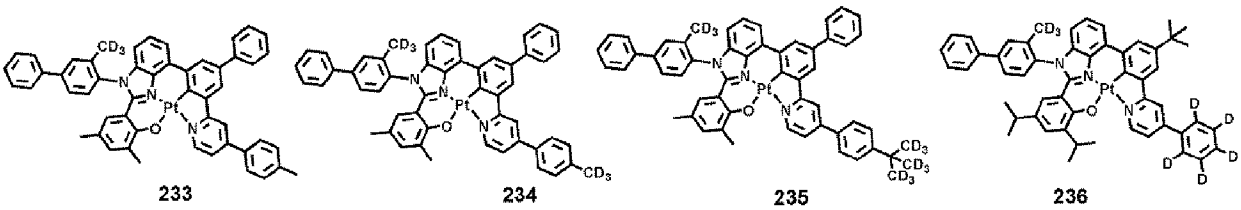

233 234 235 236

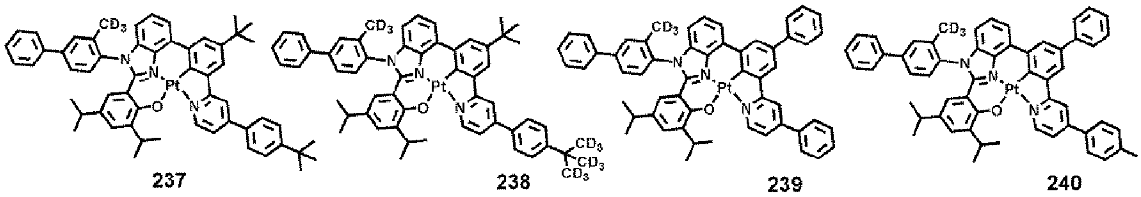

237 238 239 240

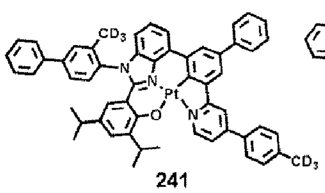
241

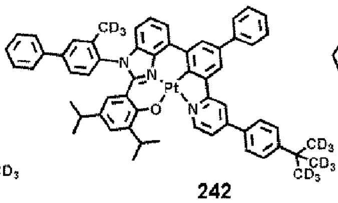
242

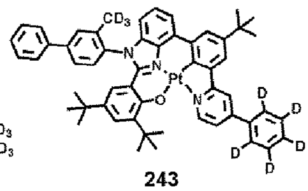
243

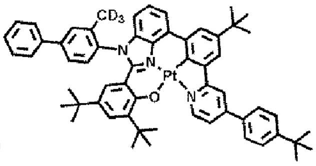
244

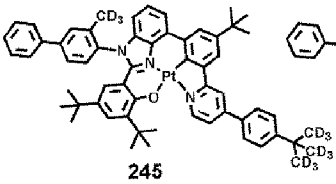
245

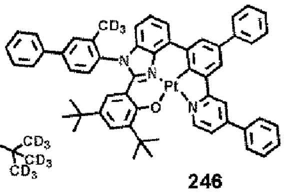
246

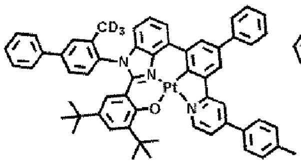
247

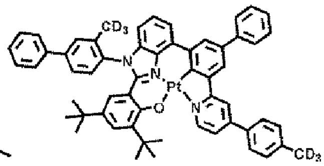
248

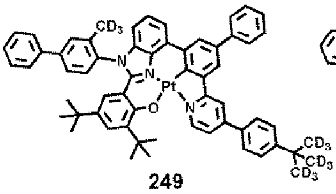
249

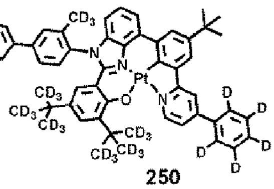
250

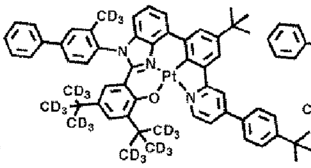
251

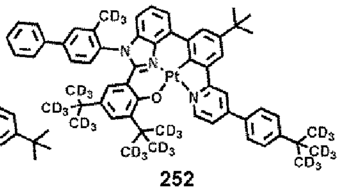
252

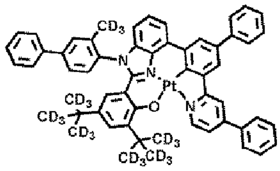
253

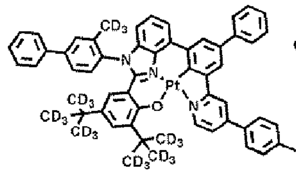
254

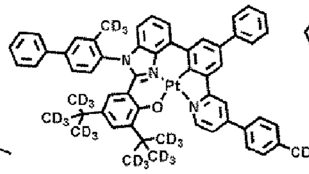
255

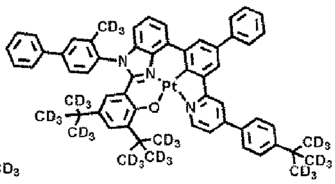
256

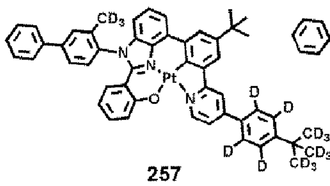
257

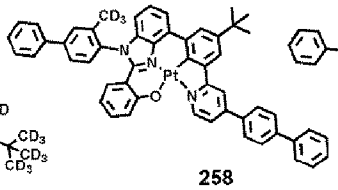
258

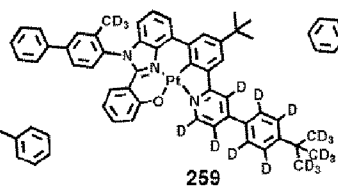
259

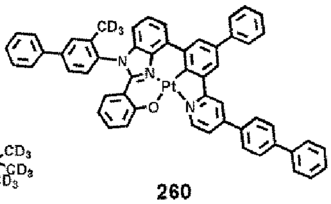
260

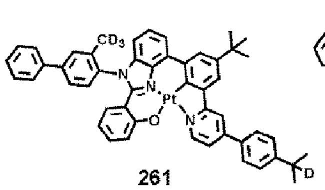
261

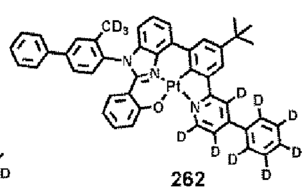
262

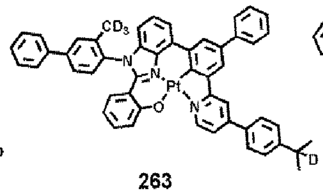
263

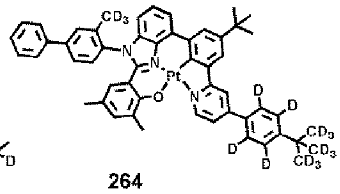
264

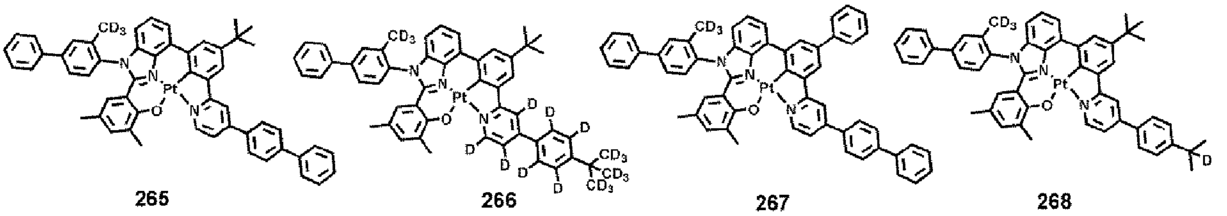

265 266 267 268

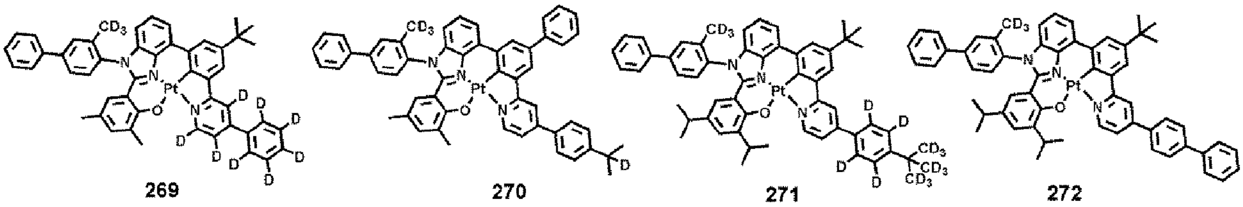

269 270 271 272

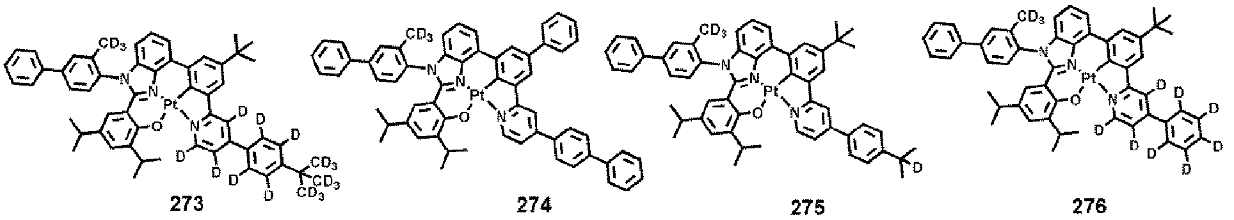

273 274 275 276

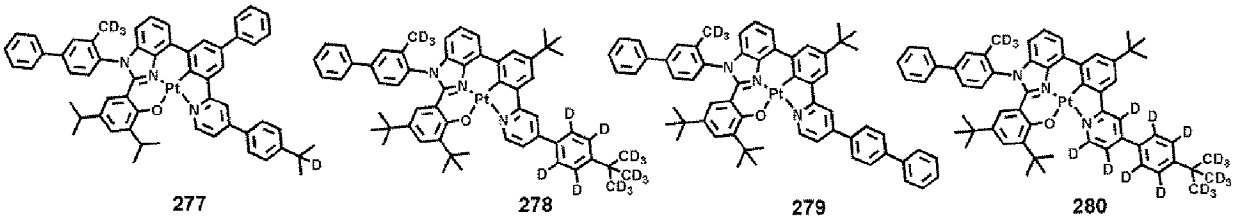

277 278 279 280

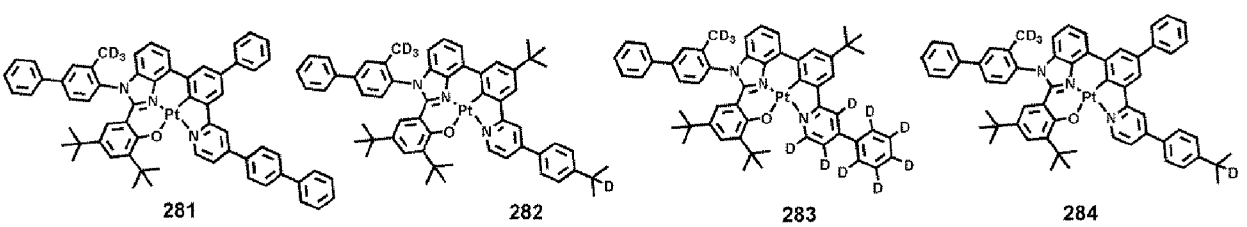

281 282 283 284

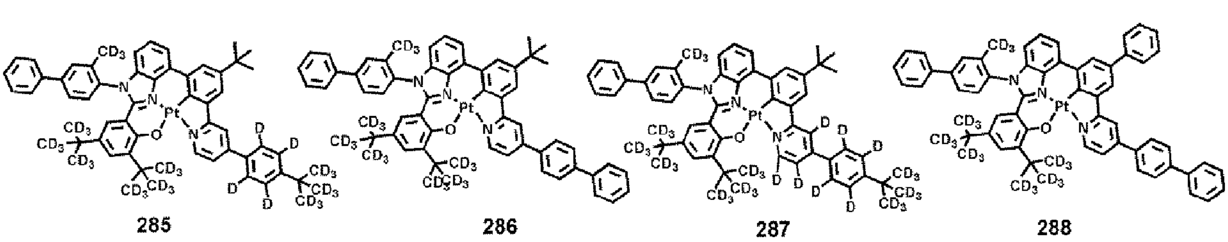

285 286 287 288

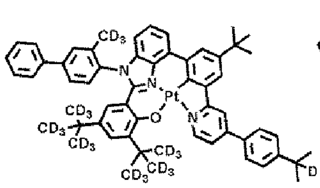

**289**

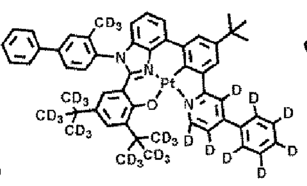

**290**

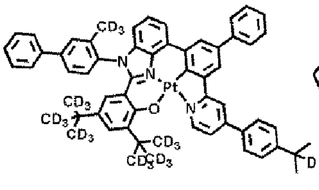

**291**

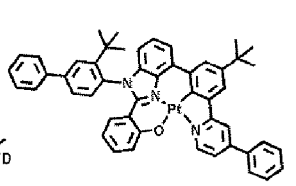

**292**

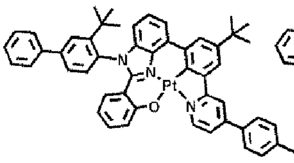

**293**

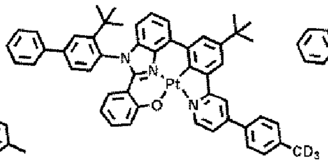

**294**

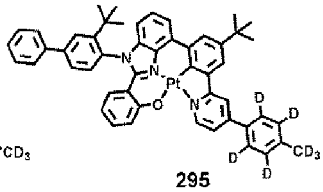

**295**

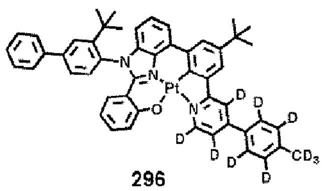

**296**

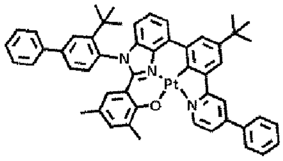

**297**

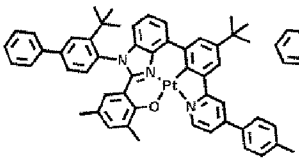

**298**

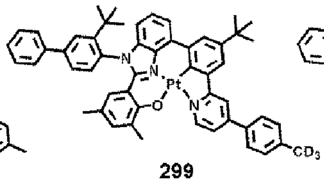

**299**

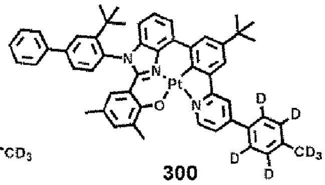

**300**

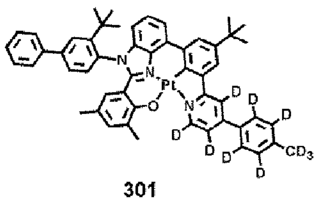

**301**

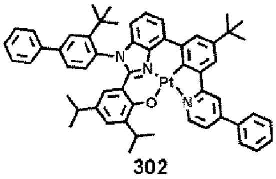

**302**

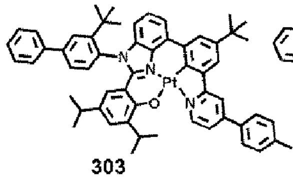

**303**

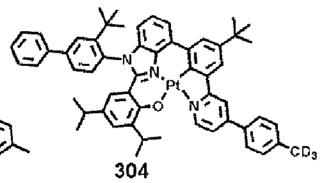

**304**

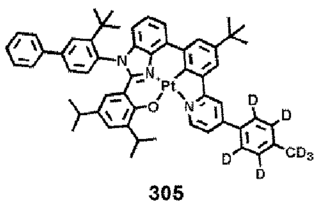

**305**

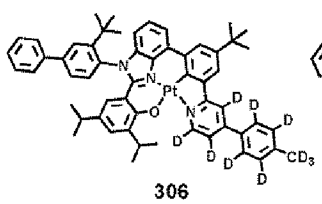

**306**

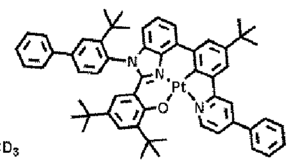

**307**

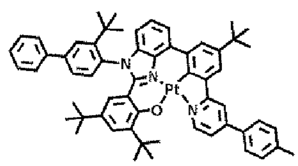

**308**

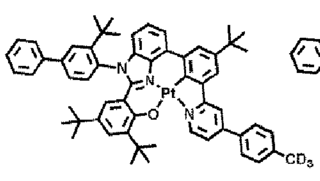

**309**

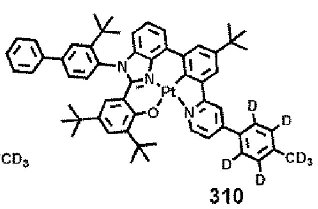

**310**

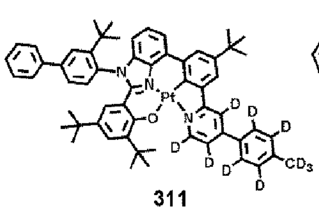

**311**

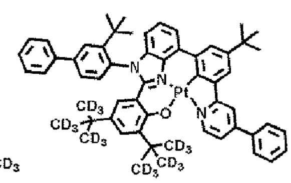

**312**

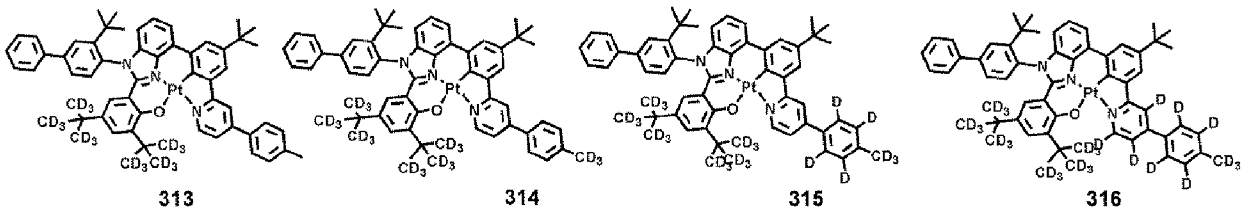

313 314 315 316

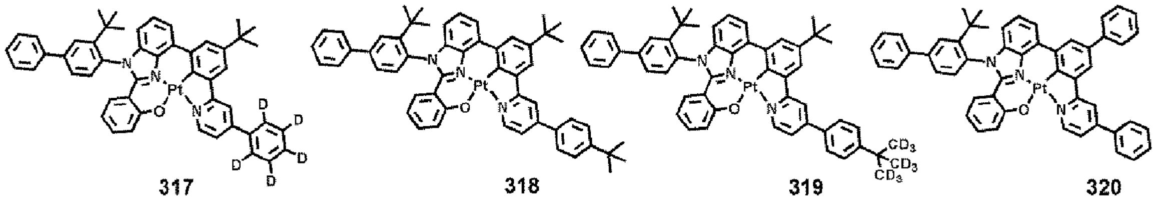

317 318 319 320

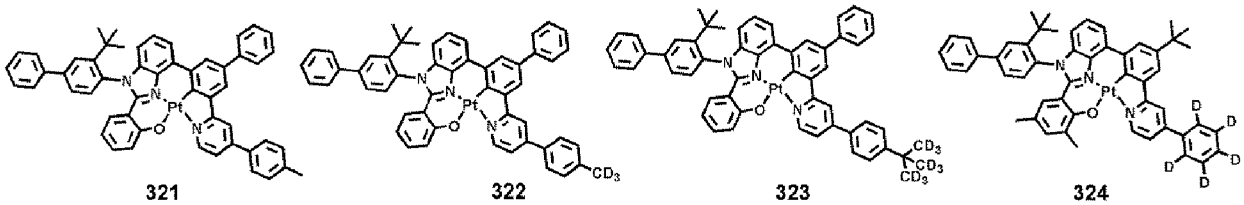

321 322 323 324

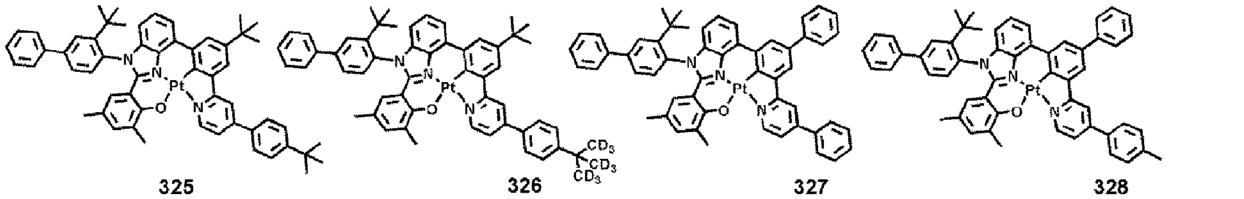

325 326 327 328

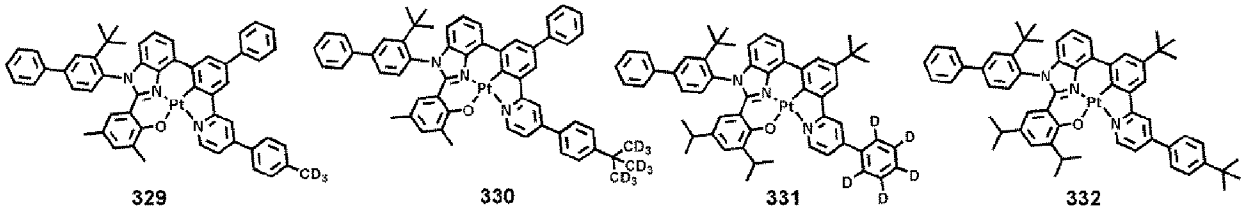

329 330 331 332

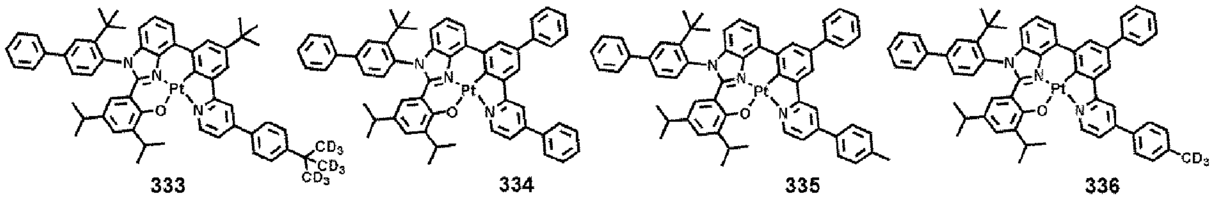

333 334 335 336

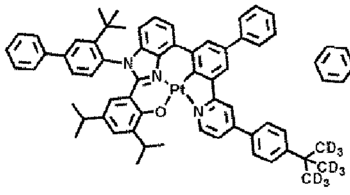
337
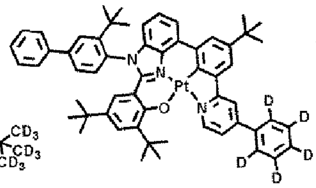
338
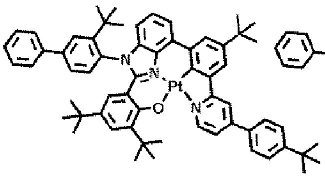
339
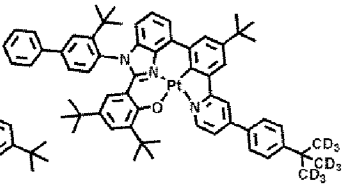
340

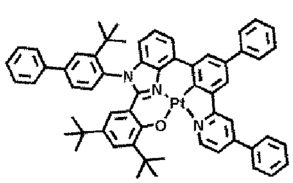
341
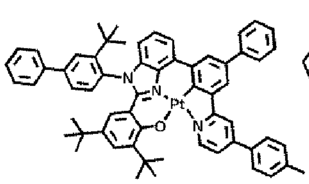
342
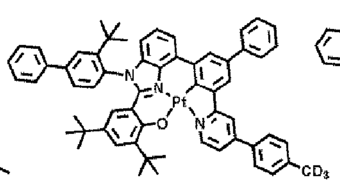
343
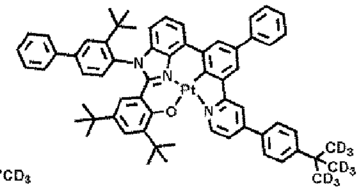
344

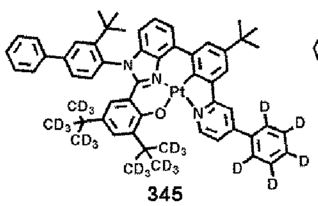
345
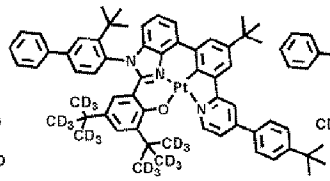
346
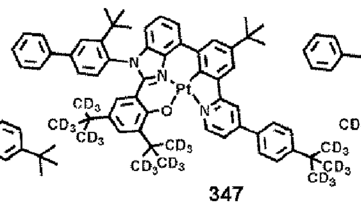
347
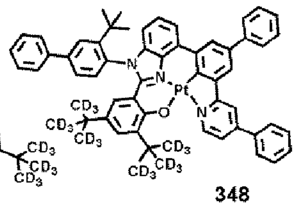
348

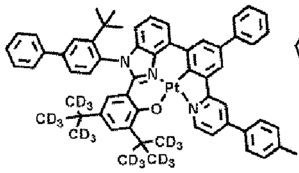
349
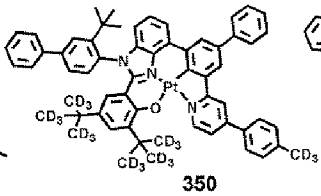
350
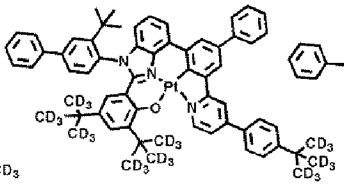
351
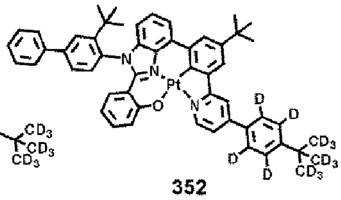
352

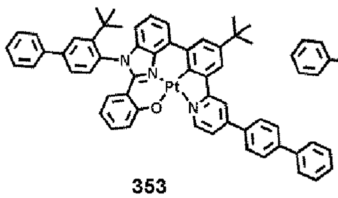
353
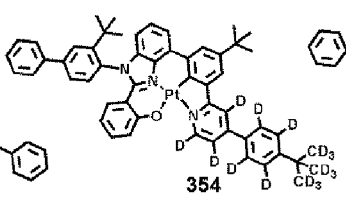
354
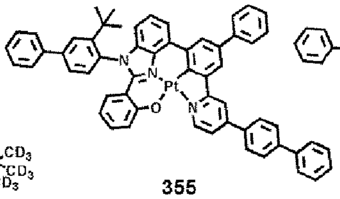
355
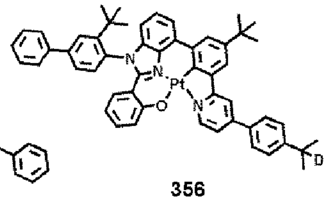
356

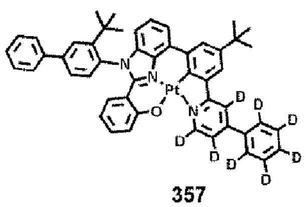
357
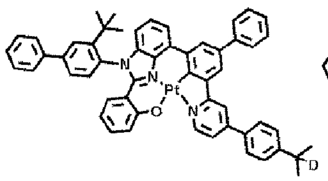
358
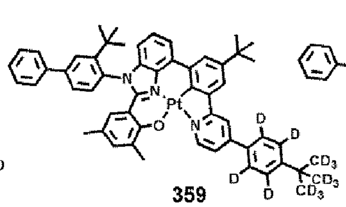
359
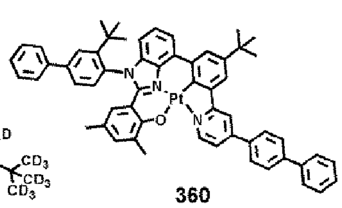
360

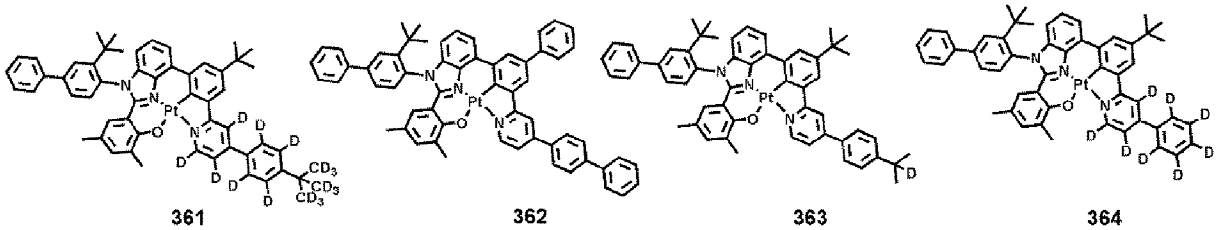

361 362 363 364

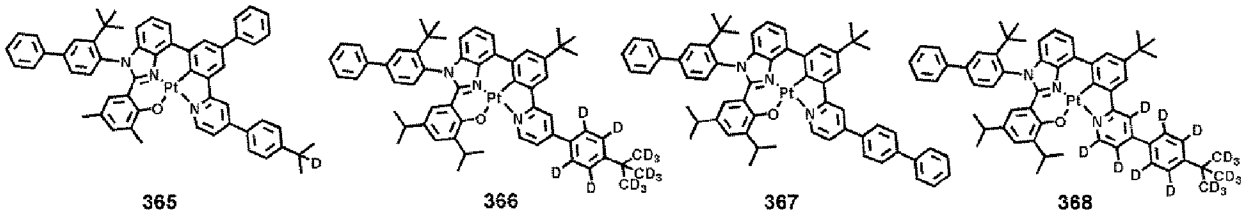

365 366 367 368

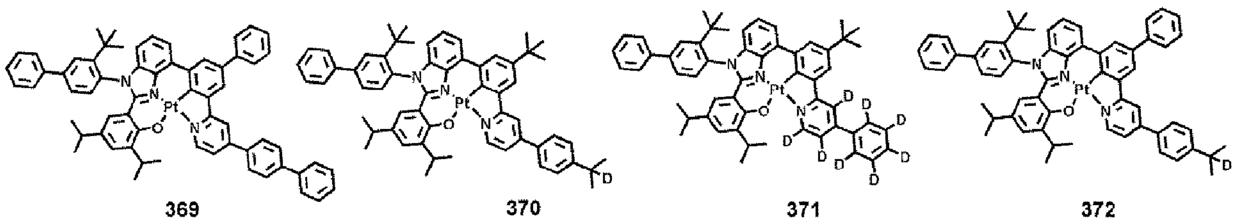

369 370 371 372

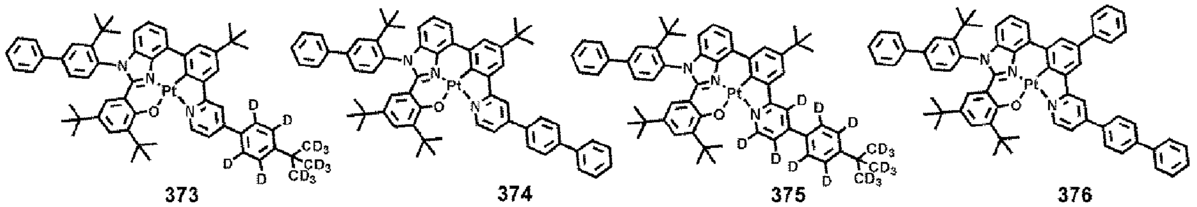

373 374 375 376

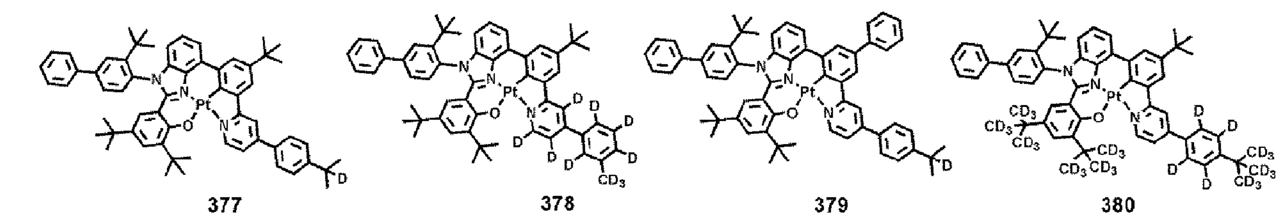

377 378 379 380

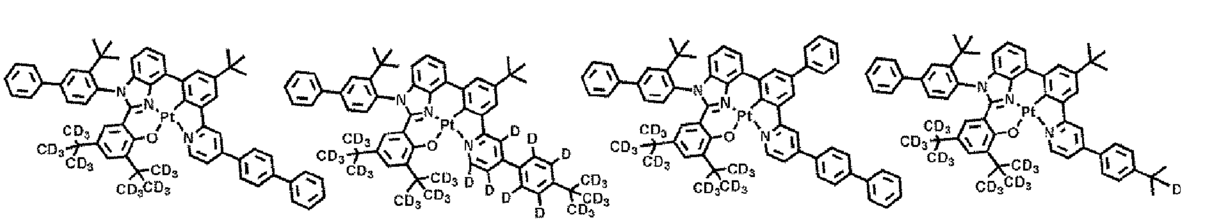

381 382 383 384

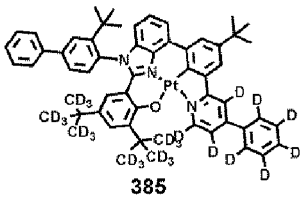

385

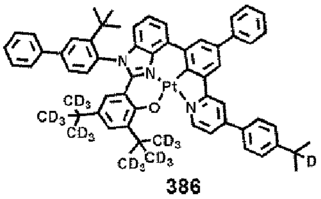

386

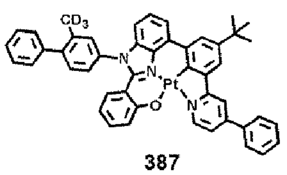

387

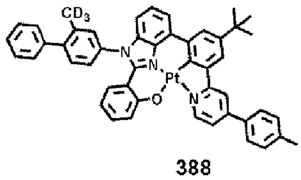

388

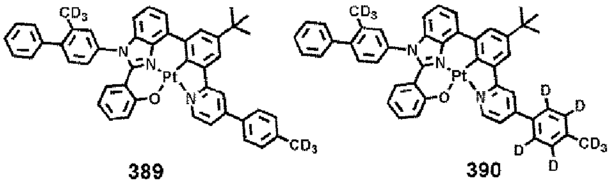

389 390

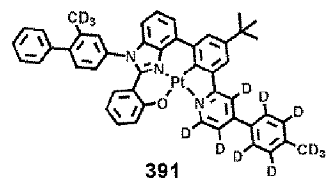

391

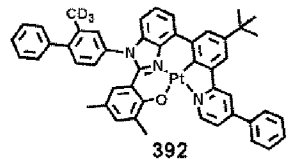

392

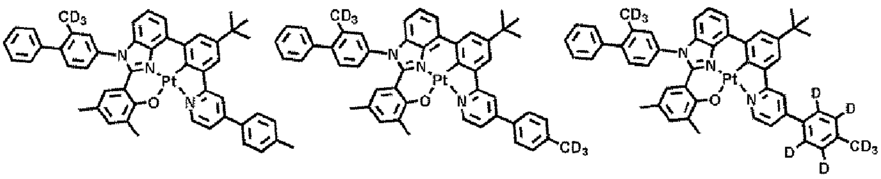

393 394 395

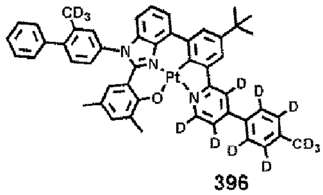

396

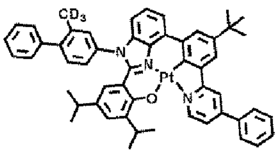

397

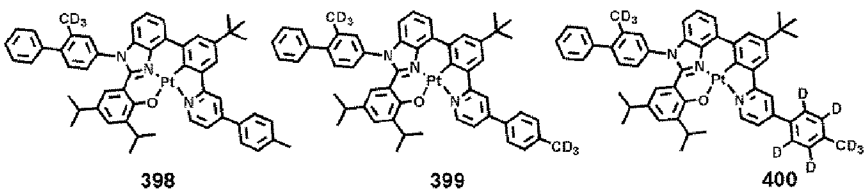

398 399 400

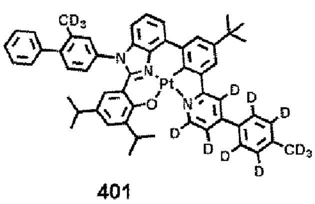

401

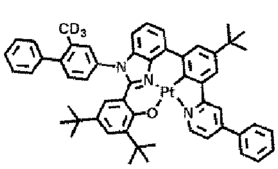

402

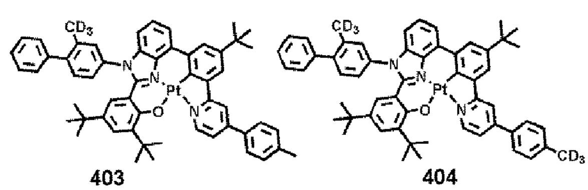

403 404

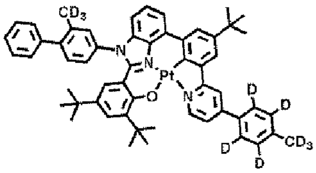

405

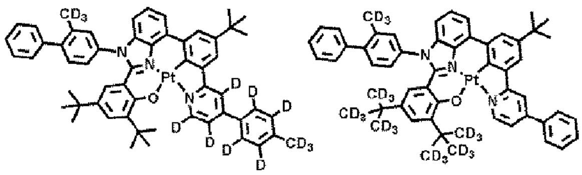

406 407

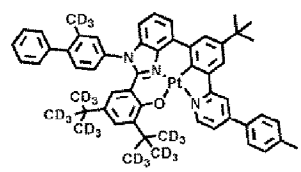

408

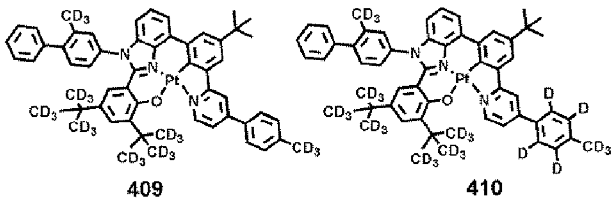

409 410

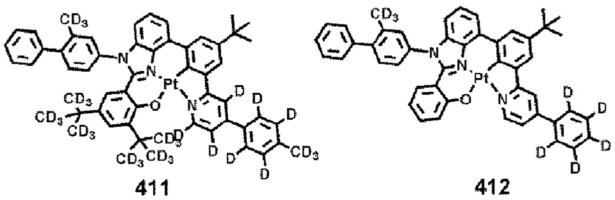

411 412

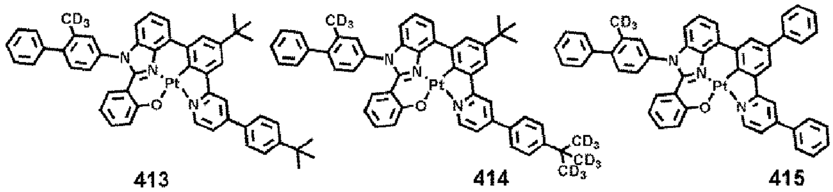

413 414 415

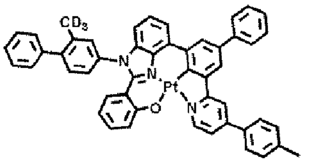

416

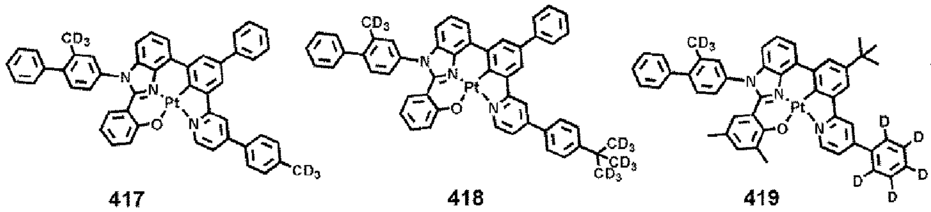

417 418 419

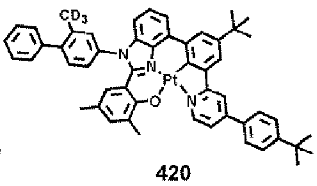

420

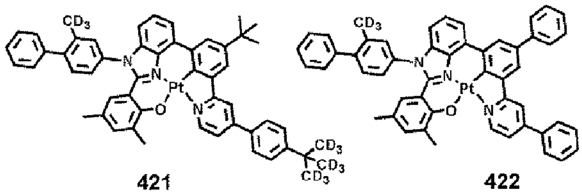

421 422

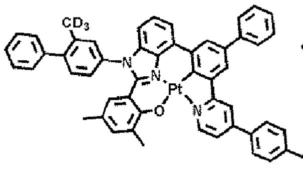

423

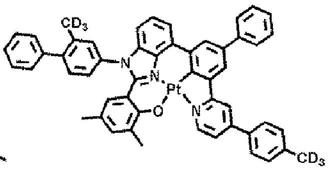

424

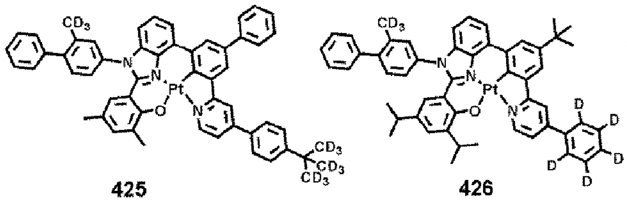

425 426

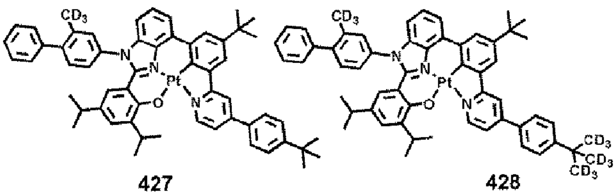

427 428

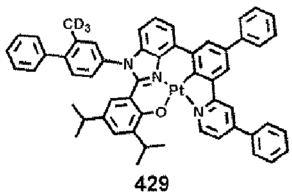

429

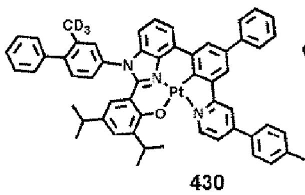

430

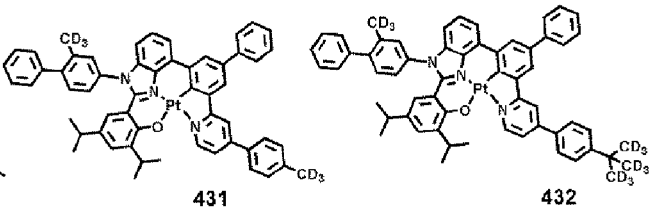

431 432

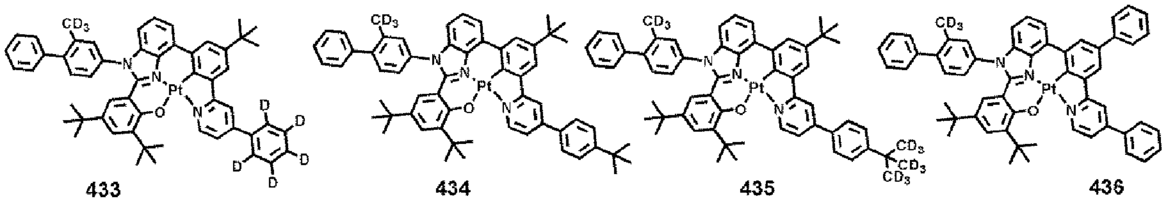

433 434 435 436

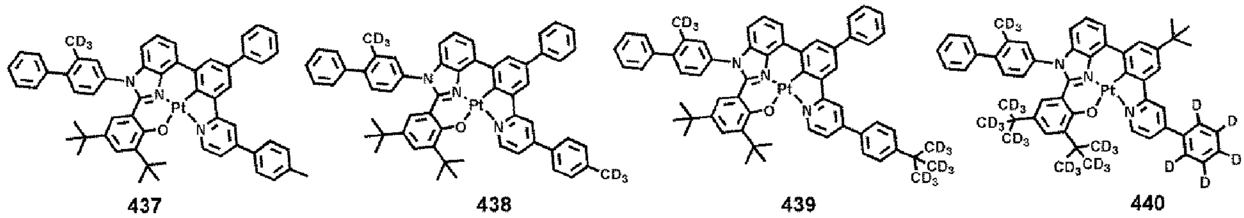

437 438 439 440

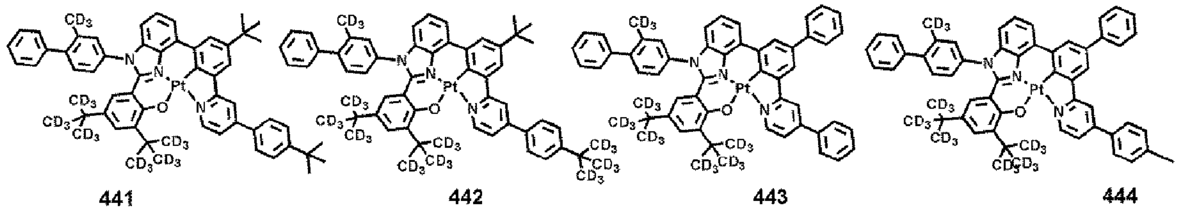

441 442 443 444

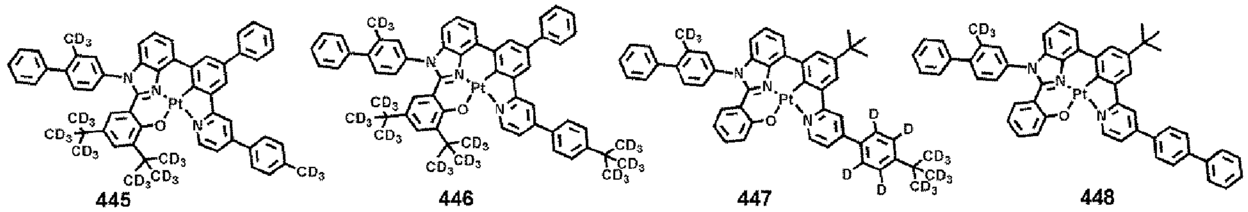

445 446 447 448

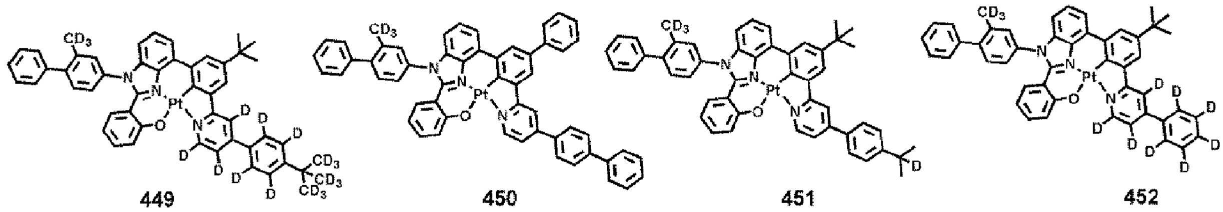

449 450 451 452

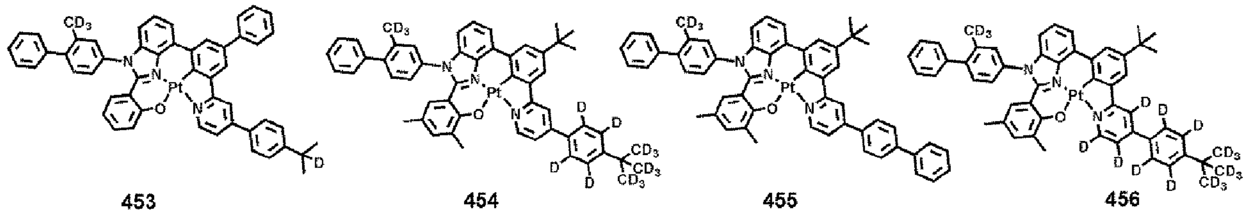

453 454 455 456

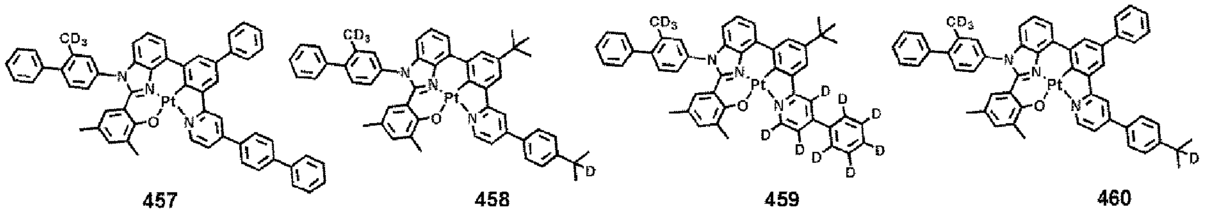

457 458 459 460

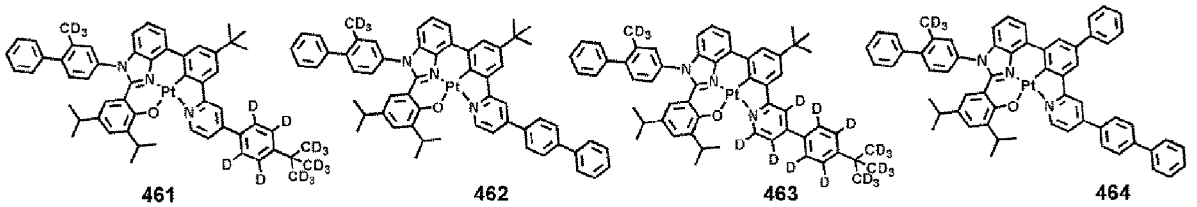

461 462 463 464

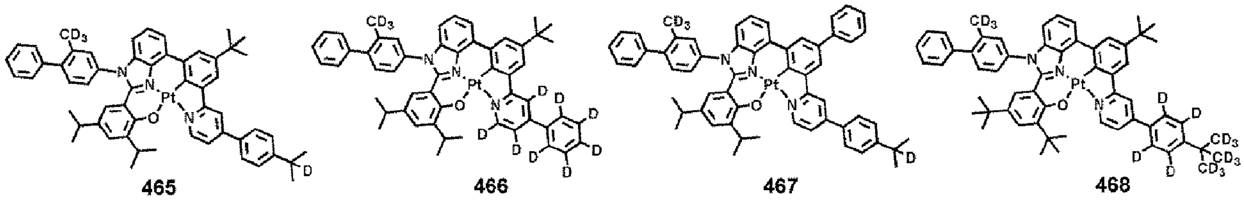

465 466 467 468

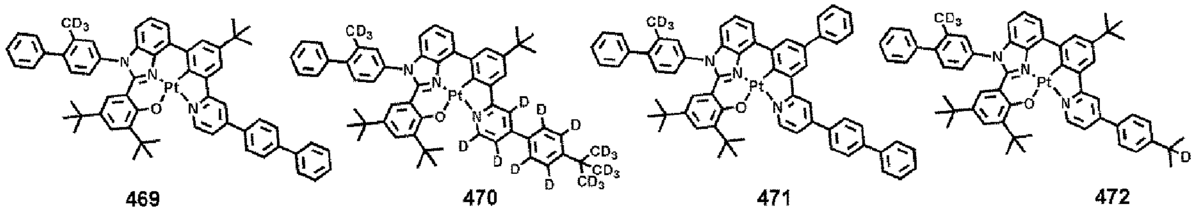

469 470 471 472

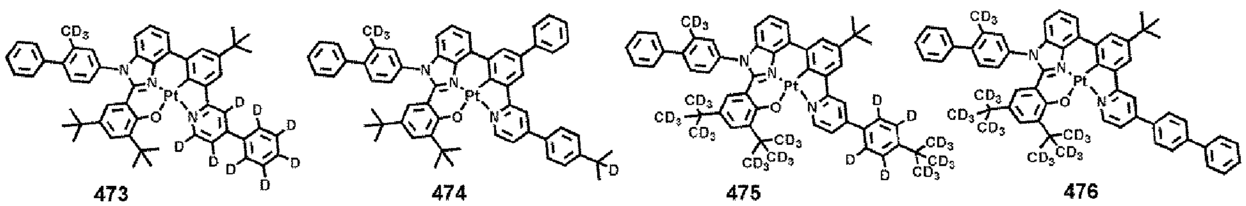

473 474 475 476

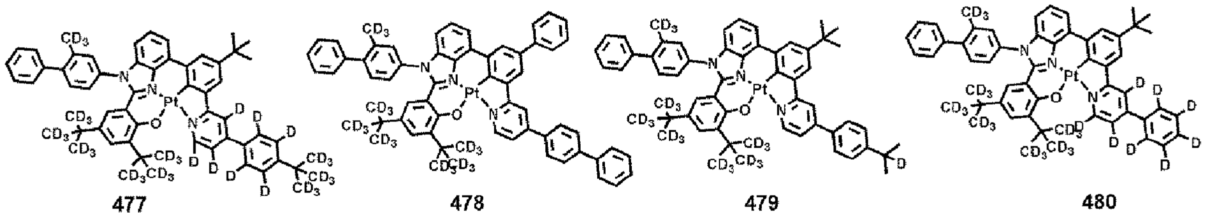

477 478 479 480

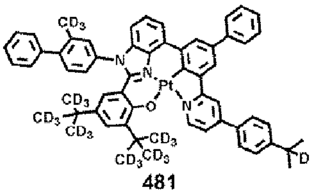
481

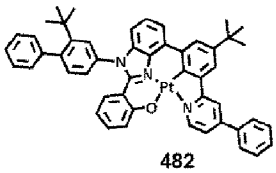
482

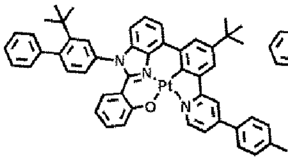
483

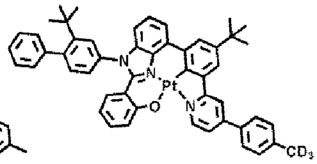
484

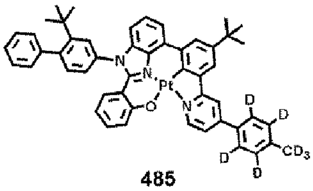
485

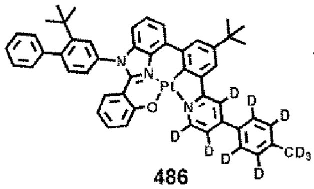
486

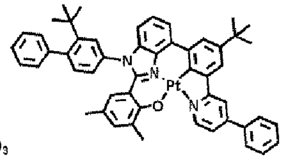
487

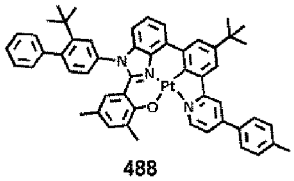
488

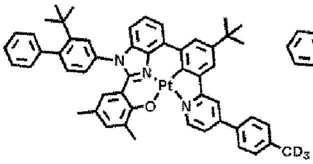
489

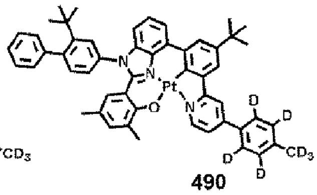
490

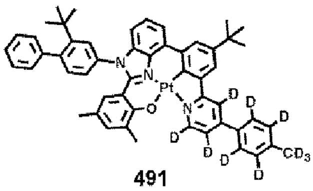
491

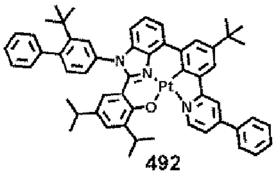
492

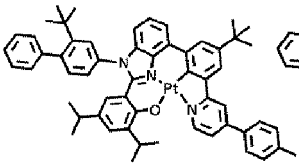
493

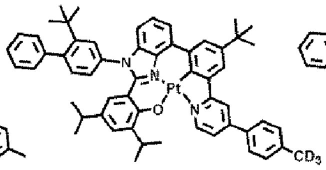
494

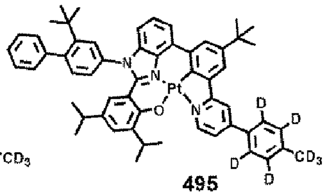
495

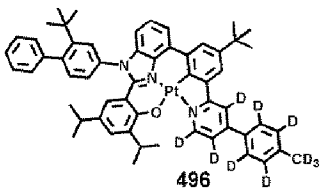
496

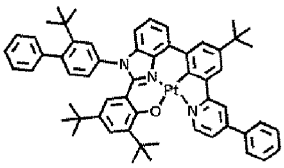
497

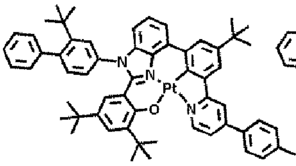
498

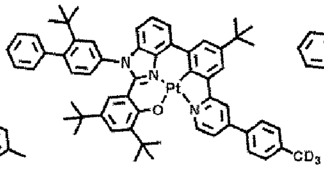
499

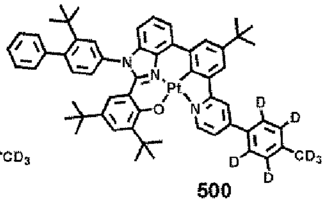
500

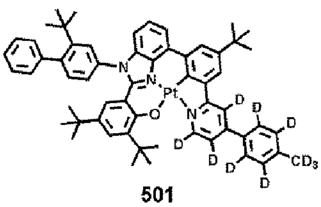
501

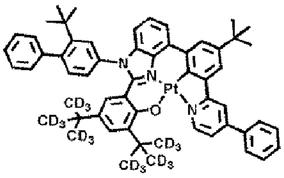
502

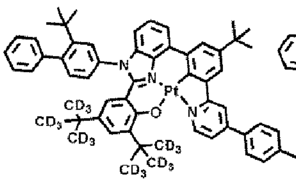
503

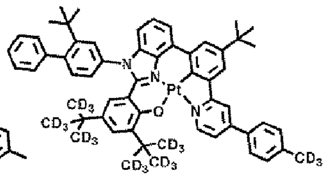
504

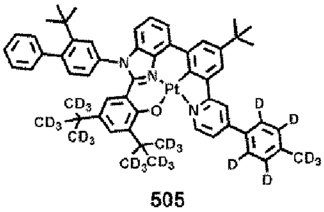
505

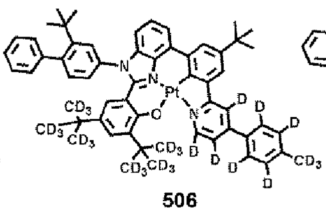
506

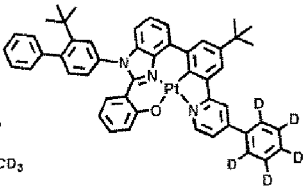
507

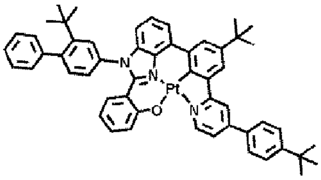
508

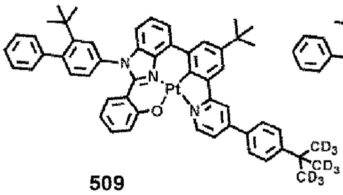
509

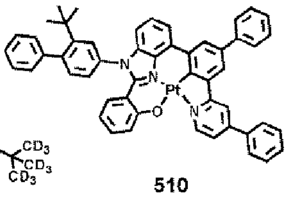
510

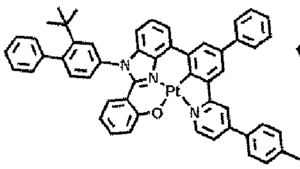
511

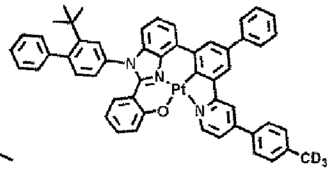
512

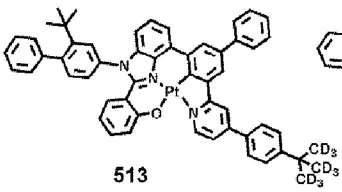
513

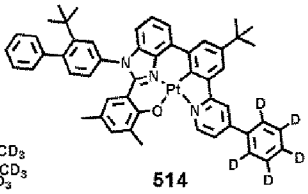
514

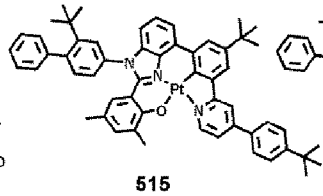
515

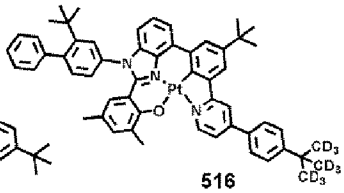
516

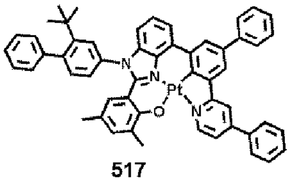
517

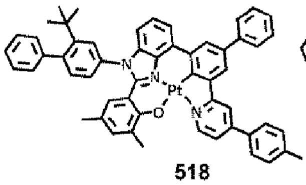
518

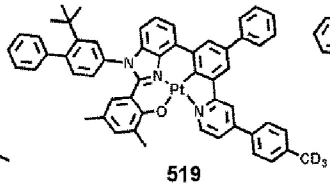
519

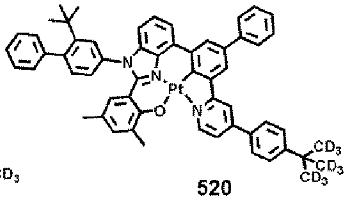
520

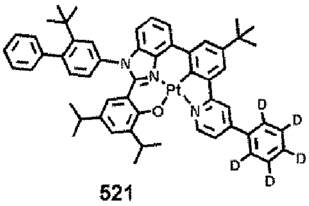
521

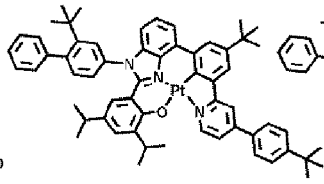
522

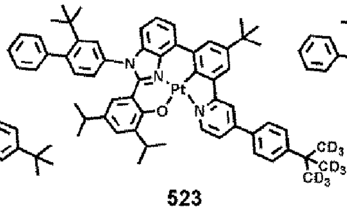
523

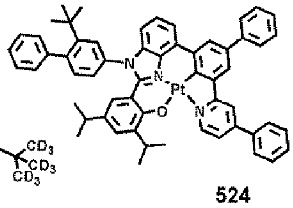
524

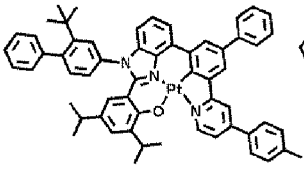
525

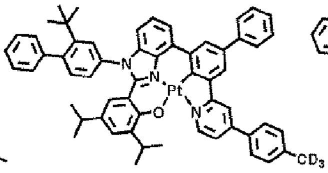
526

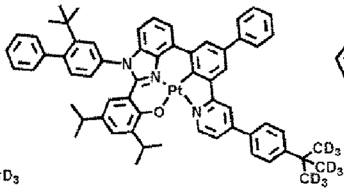
527

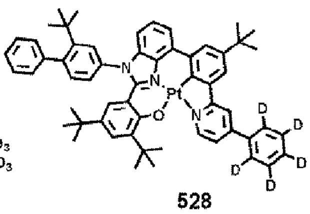
528

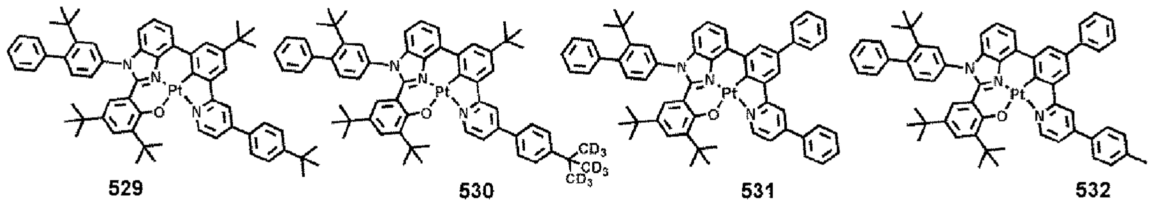

529 530 531 532

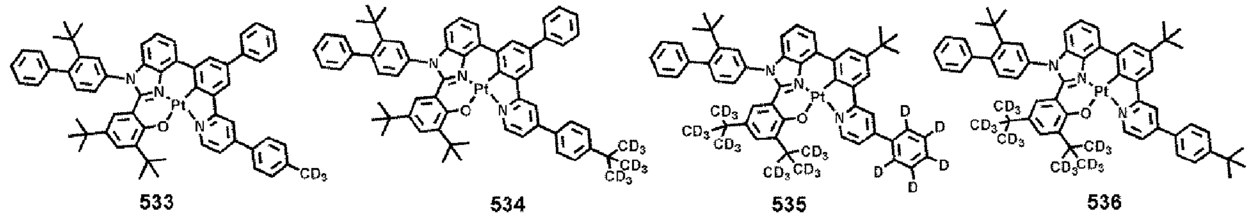

533 534 535 536

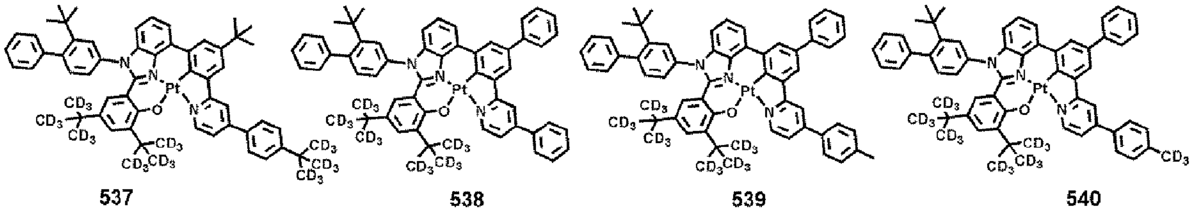

537 538 539 540

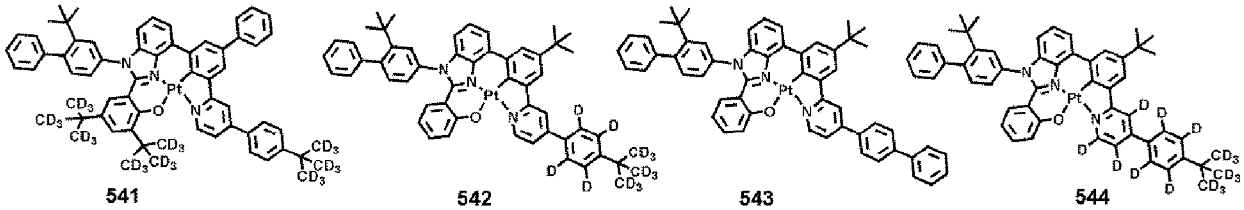

541 542 543 544

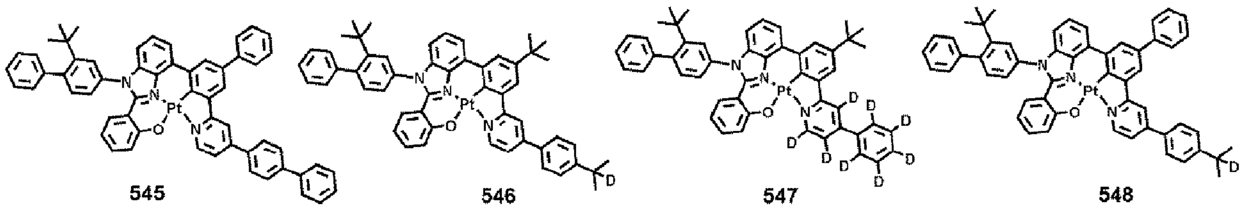

545 546 547 548

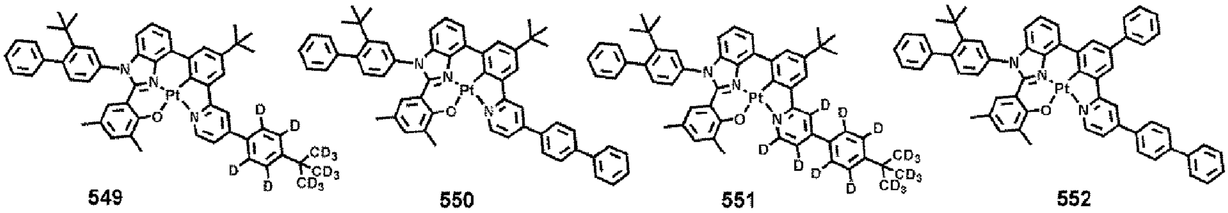

549 550 551 552

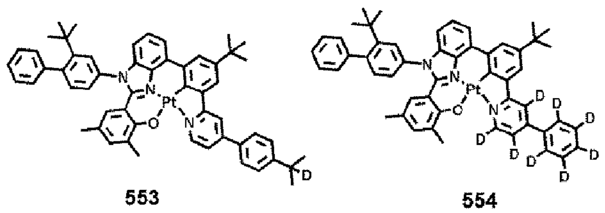

553

554

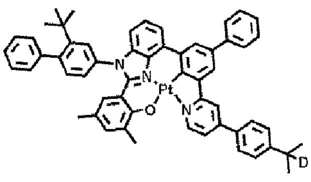

555

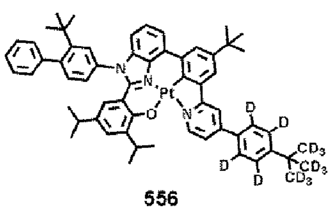

556

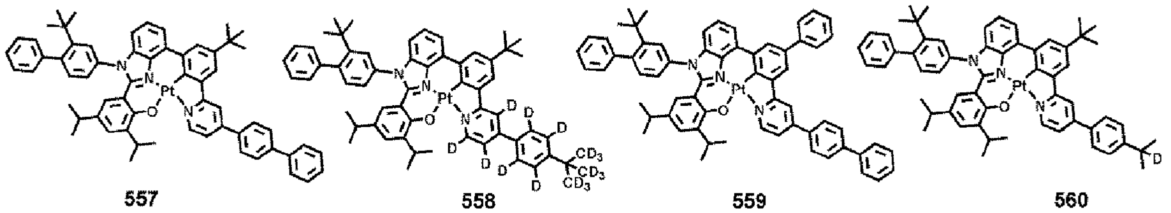

557

558

559

560

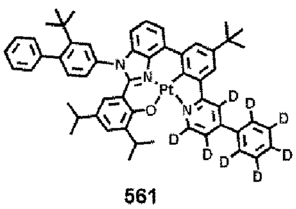

561

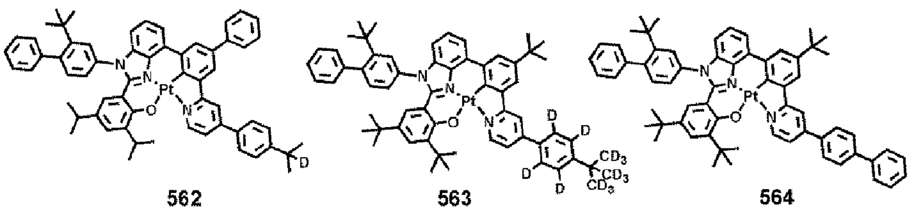

562

563

564

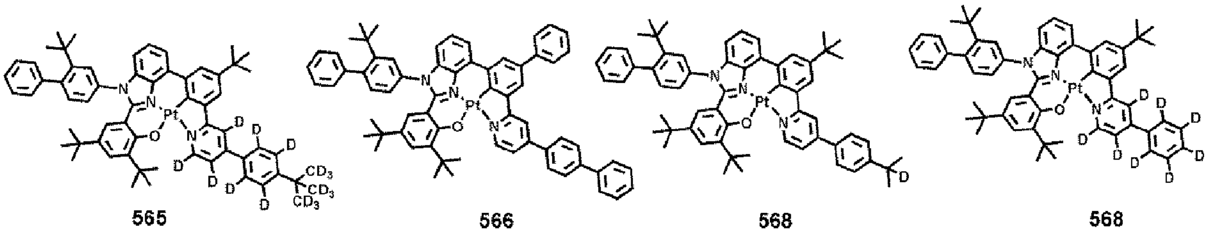

565

566

568

568

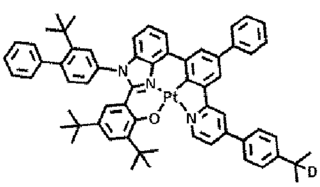

569

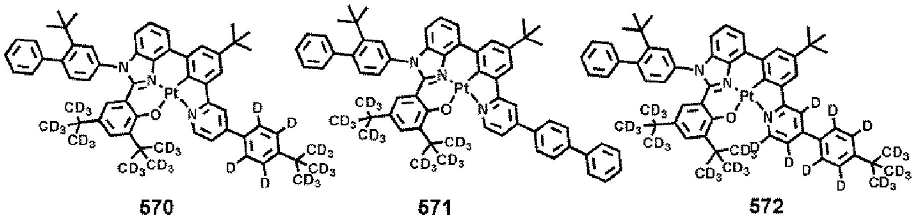

570

571

572

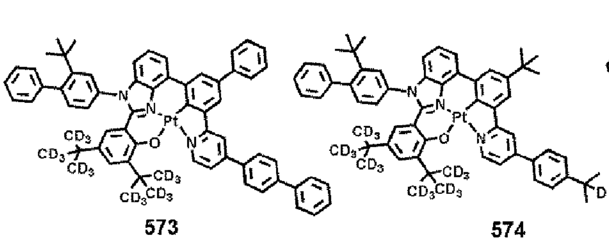

573

574

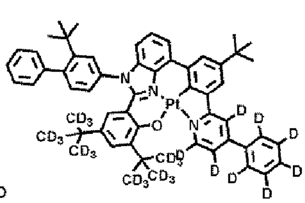

575

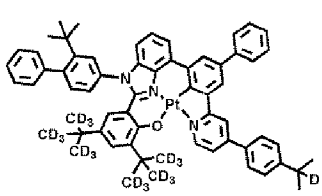

576

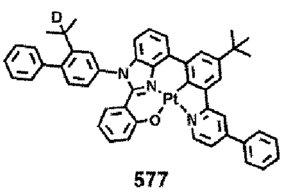

577

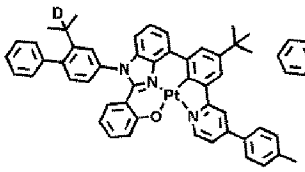

578

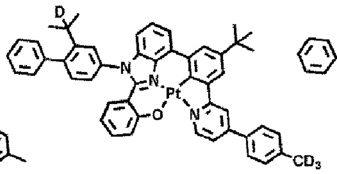

579

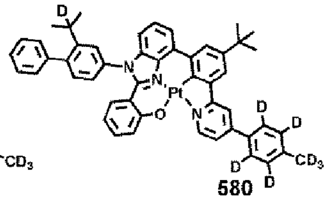

580

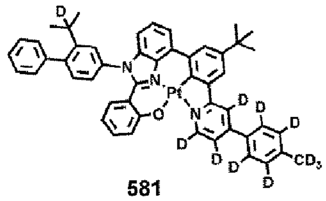

581

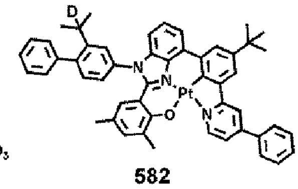

582

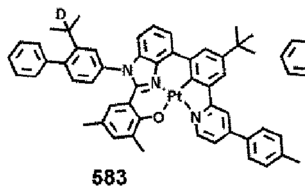

583

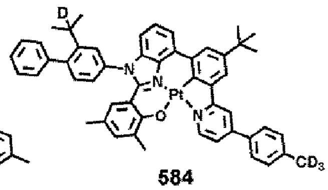

584

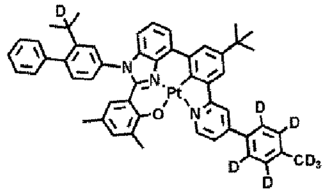

585

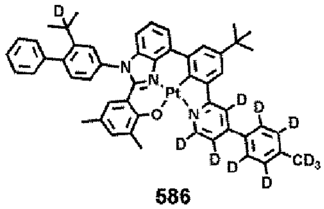

586

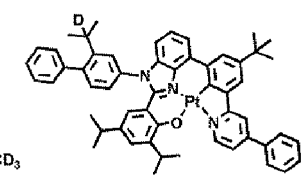

587

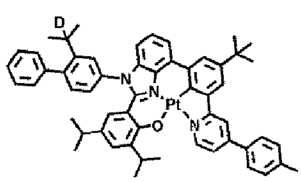

588

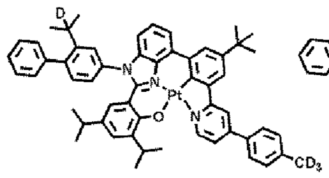

589

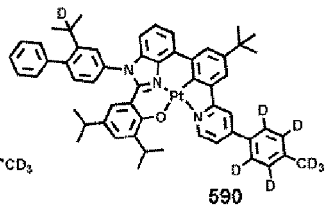

590

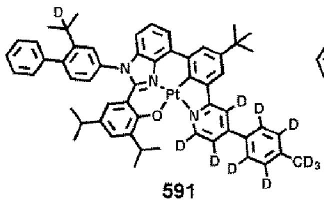

591

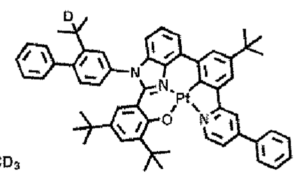

592

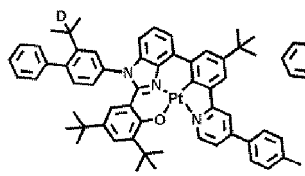

593

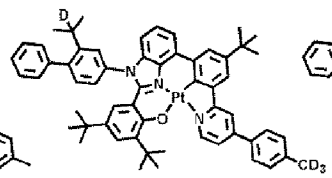

594

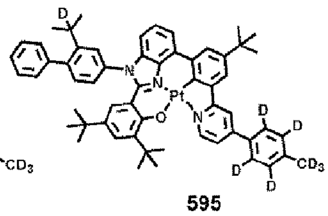

595

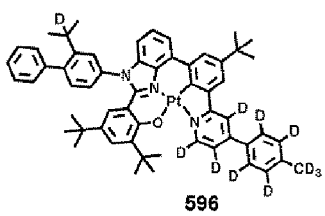

596

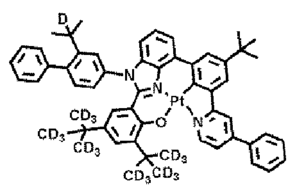

597

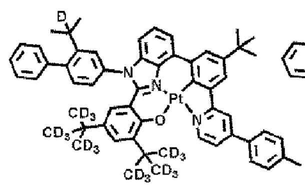

598

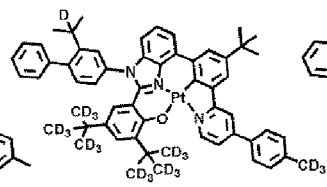

599

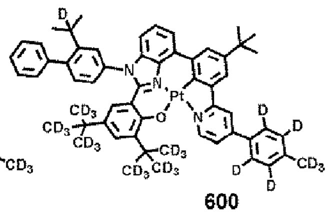

600

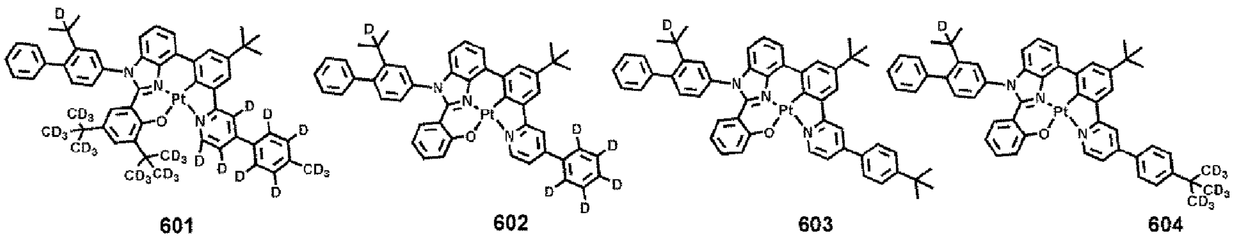

601 602 603 604

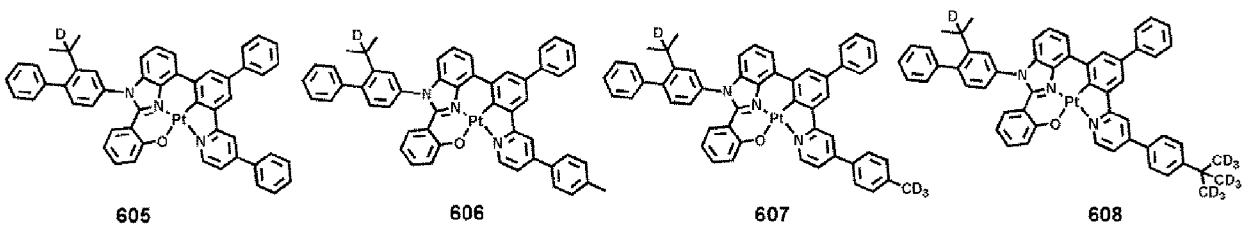

605 606 607 608

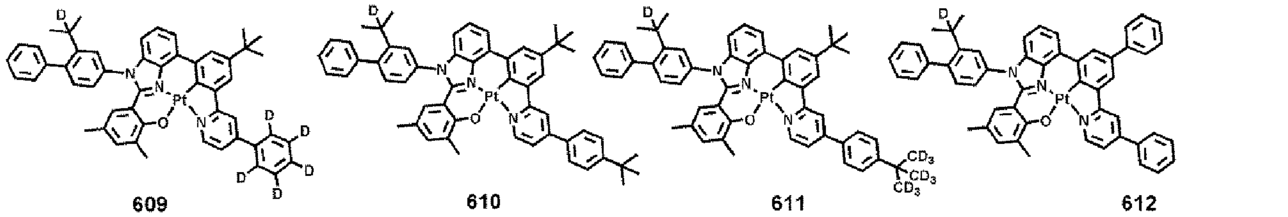

609 610 611 612

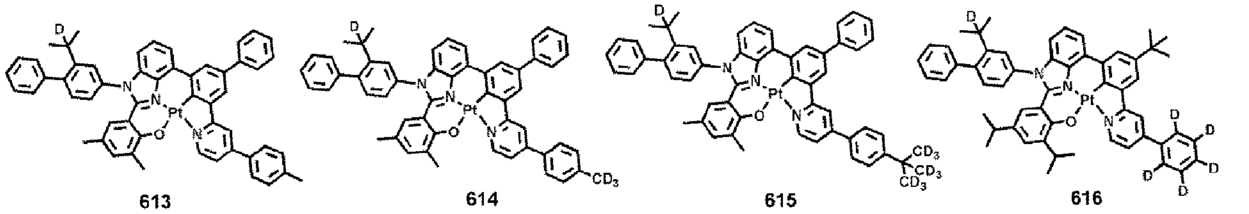

613 614 615 616

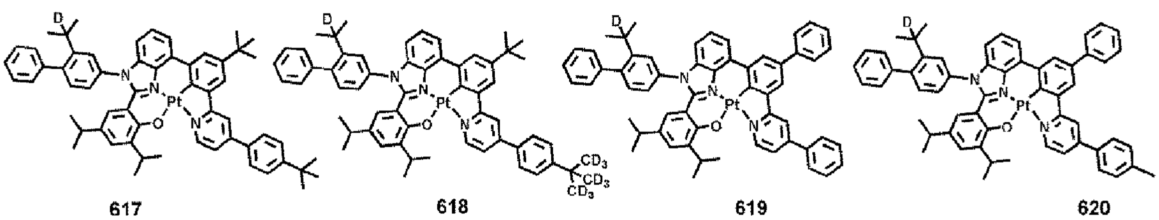

617 618 619 620

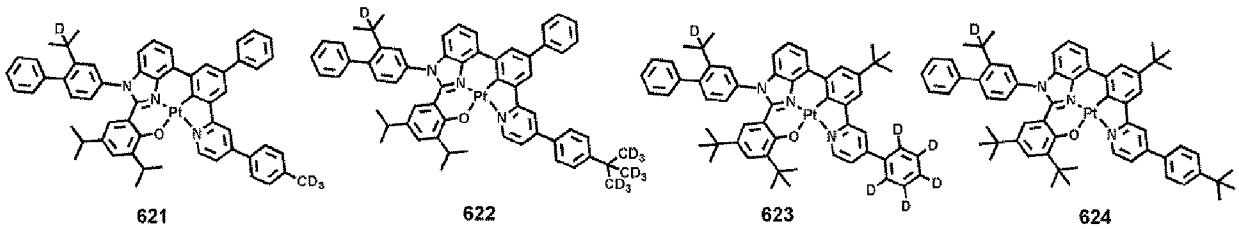

621 622 623 624

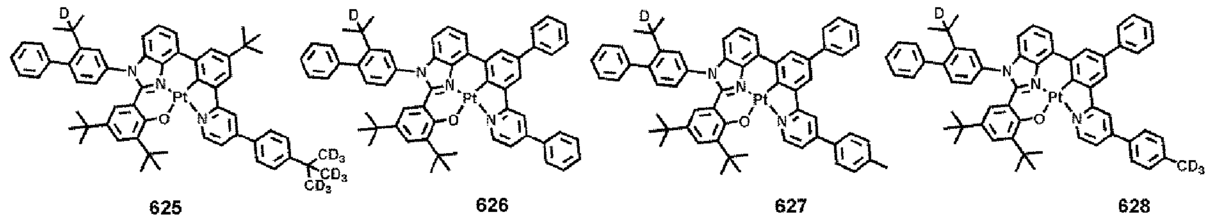

625 626 627 628

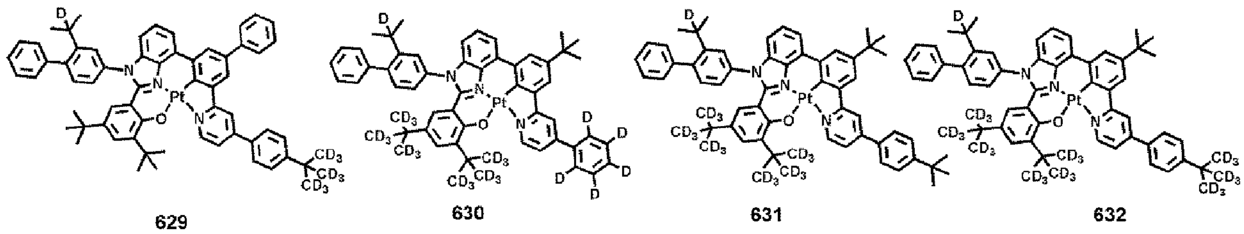

629 630 631 632

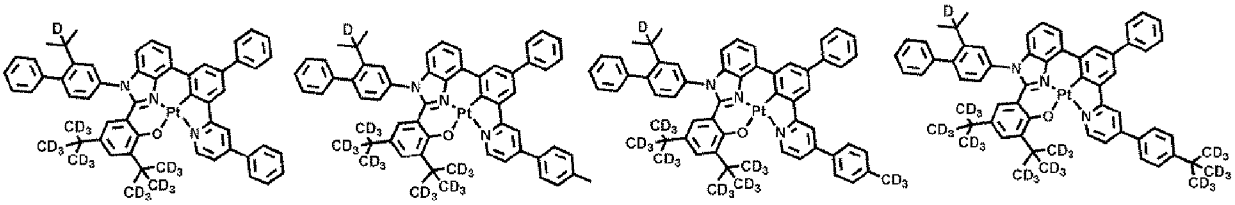

633 634 635 636

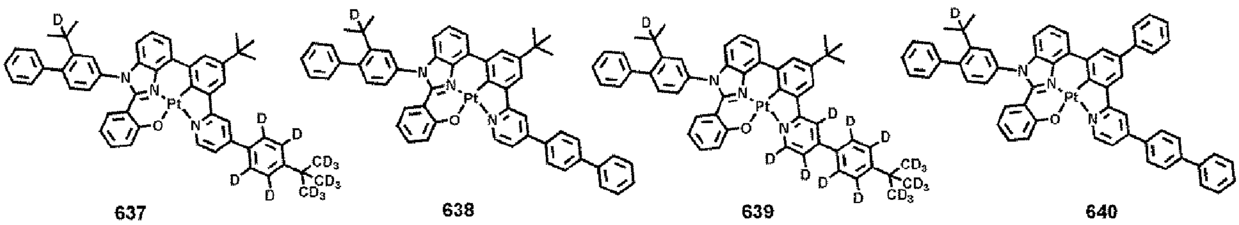

637 638 639 640

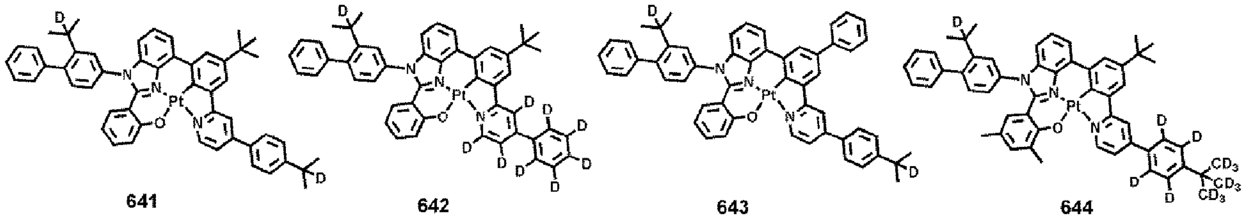

641 642 643 644

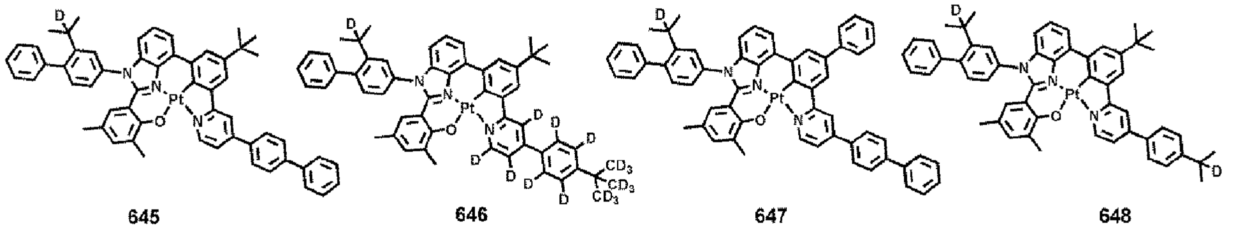

645 646 647 648

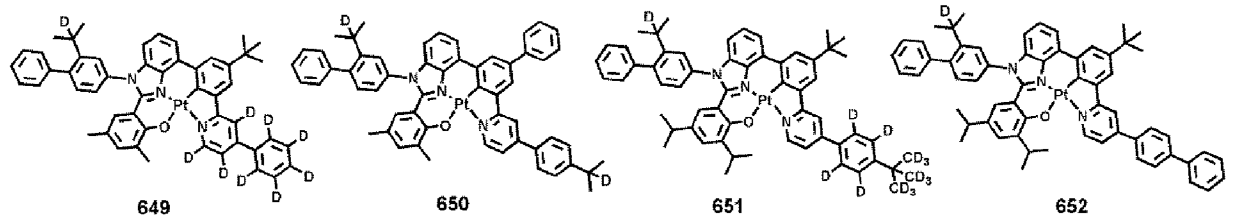

649 650 651 652

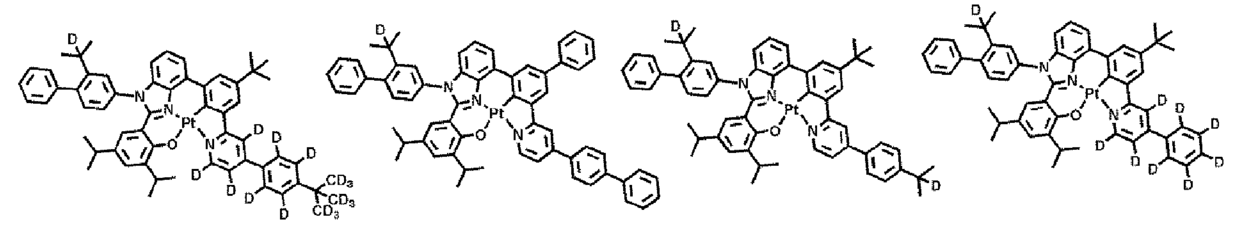

653 654 655 656

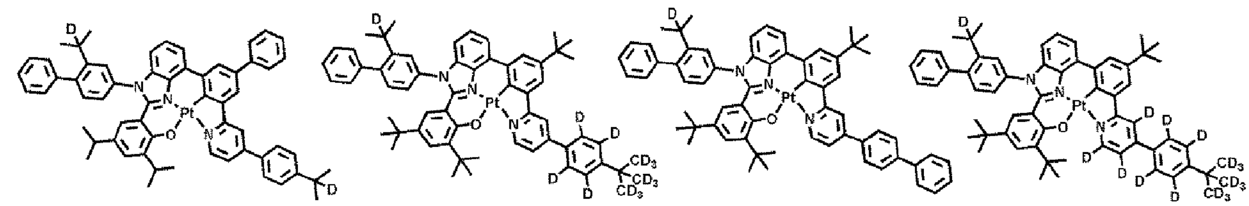

657 658 659 660

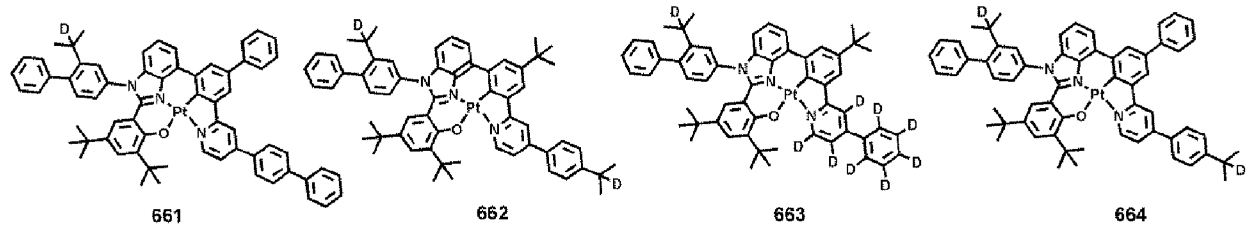

661 662 663 664

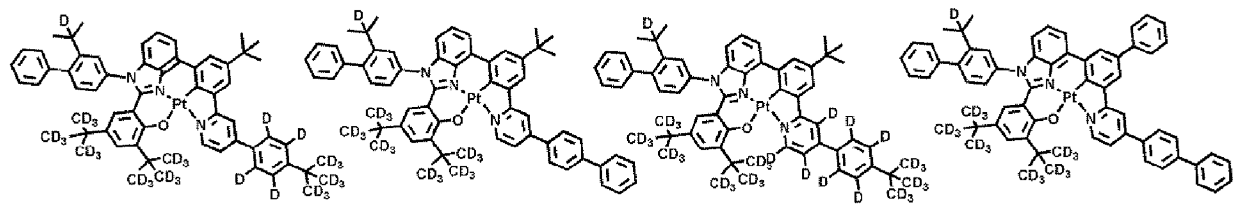

665 666 667 668

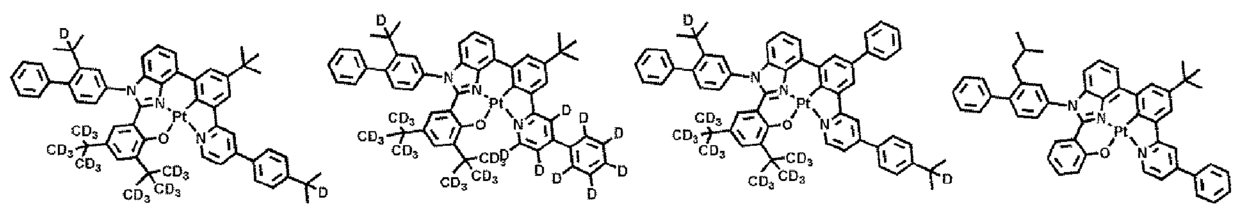

669 670 671 672

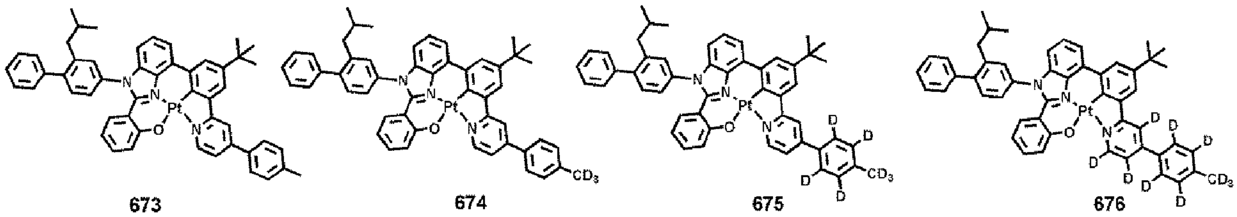

673 674 675 676

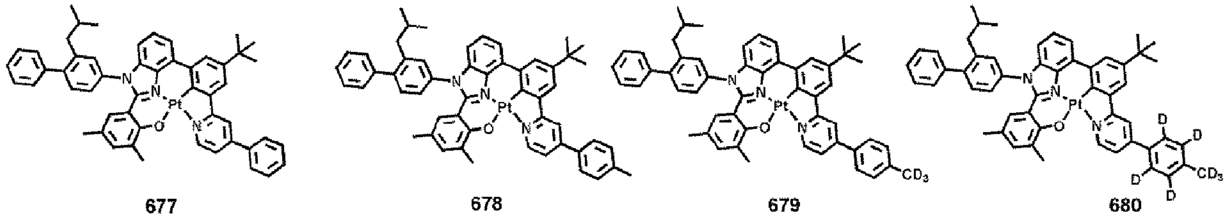

677 678 679 680

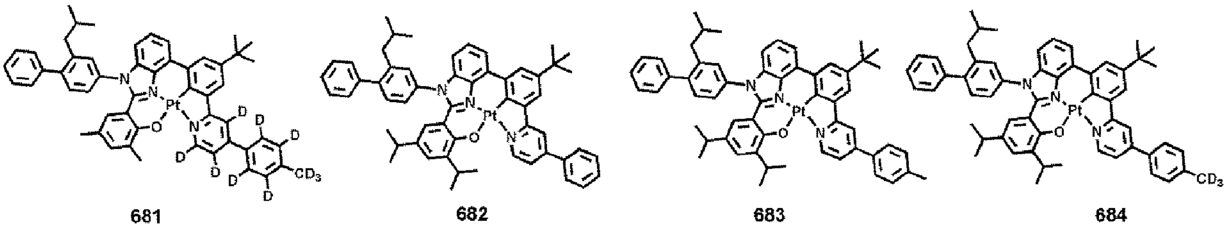

681 682 683 684

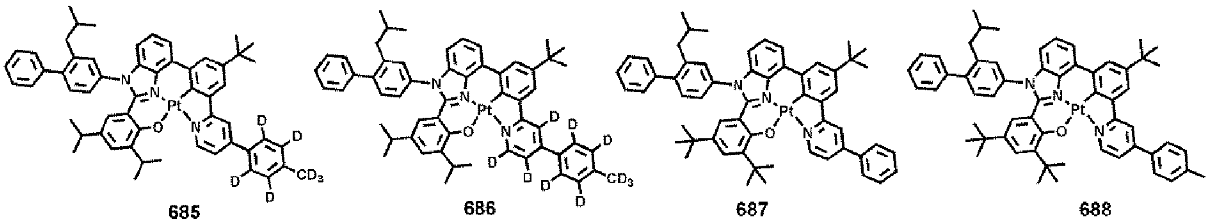

685 686 687 688

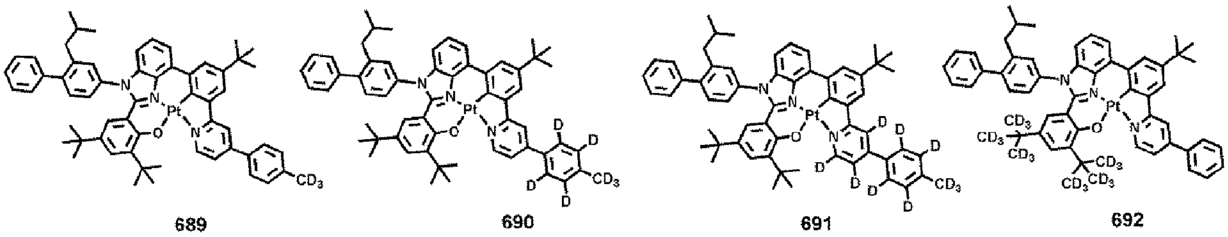

689 690 691 692

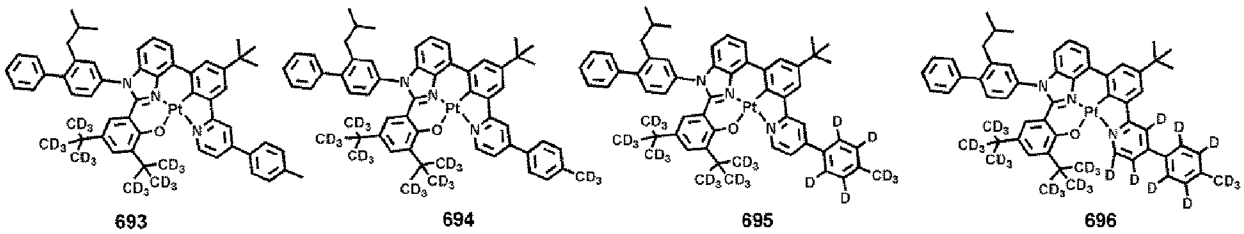

693 694 695 696

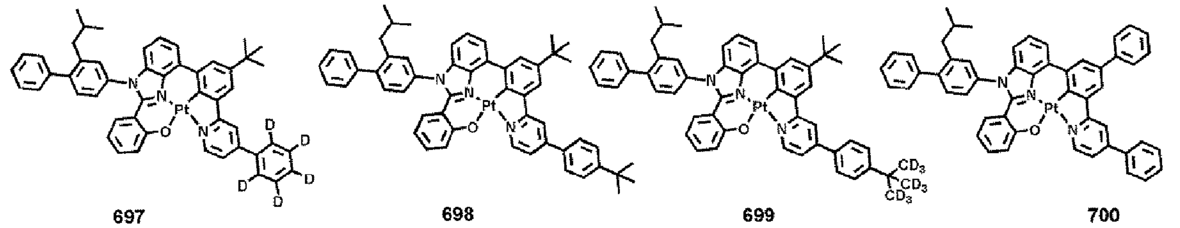

697 698 699 700

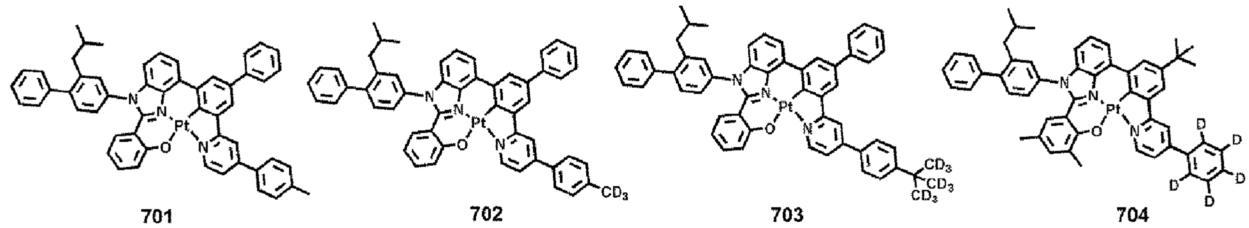

701 702 703 704

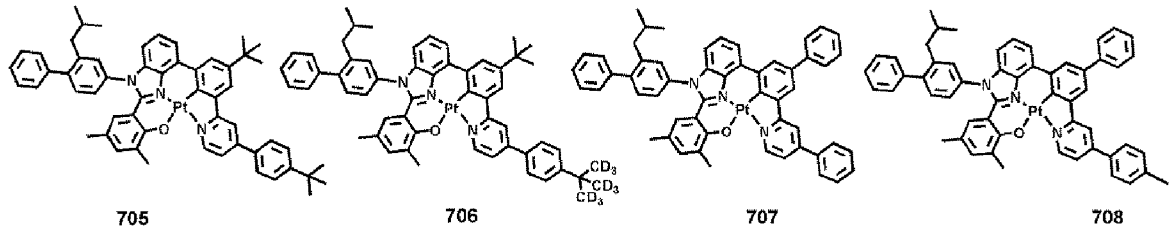

705 706 707 708

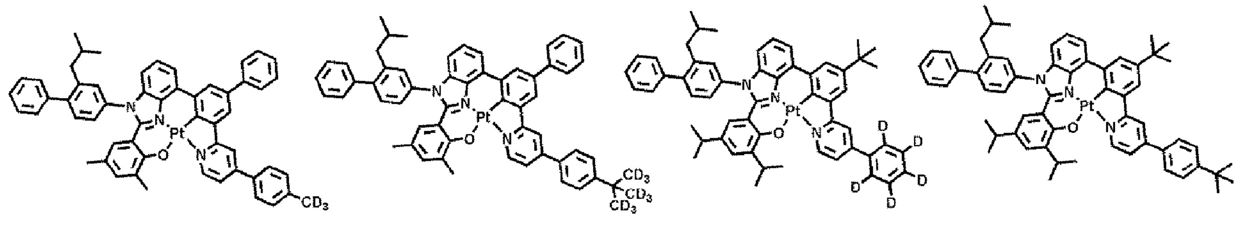

709 710 711 712

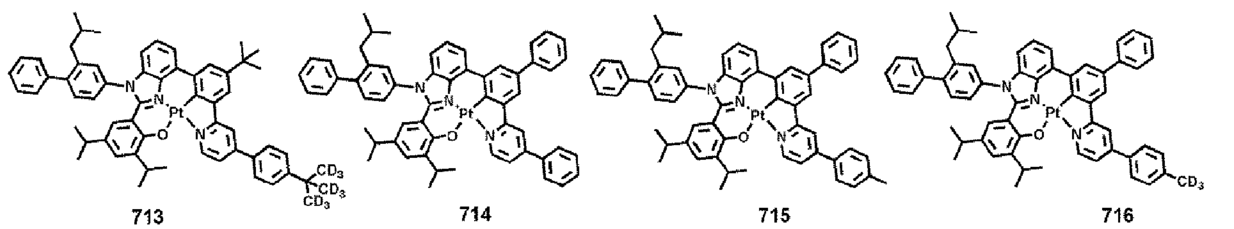

713 714 715 716

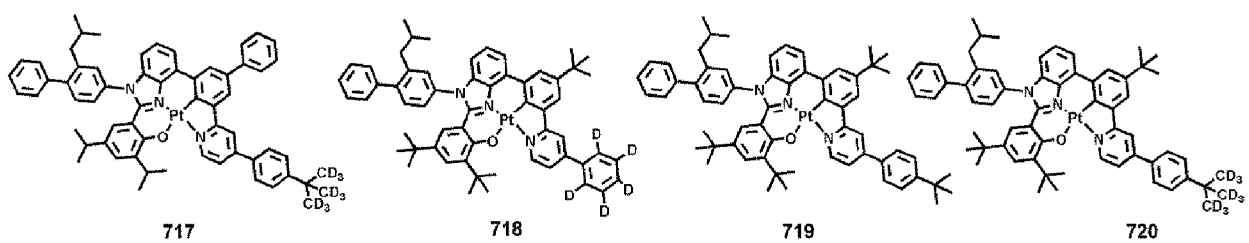

717 718 719 720

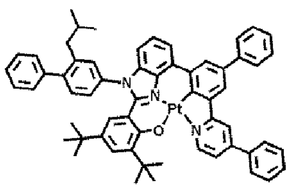
721

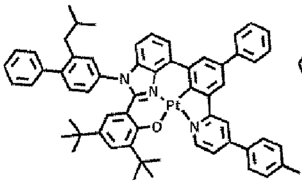
722

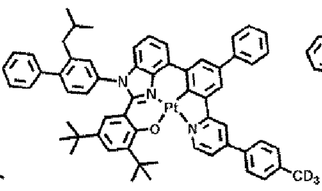
723

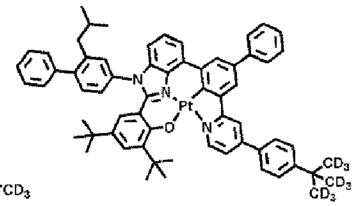
724

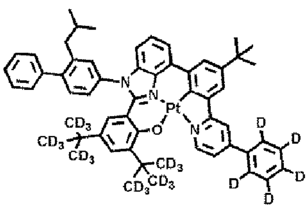
725

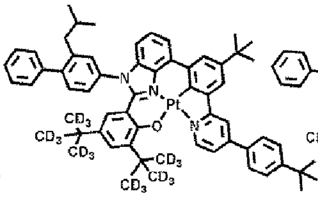
726

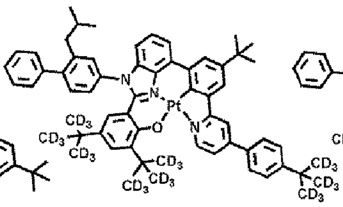
727

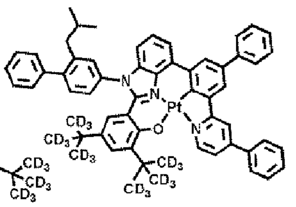
728

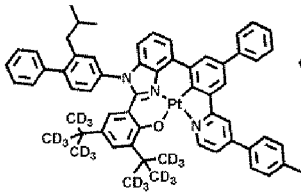
729

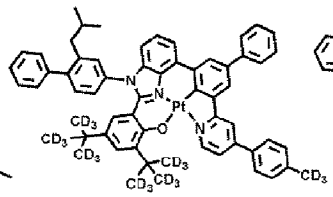
730

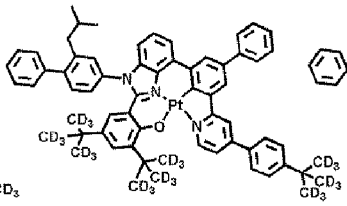
731

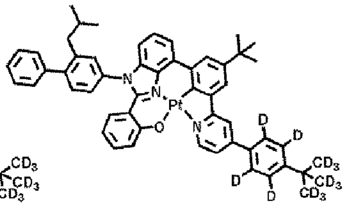
732

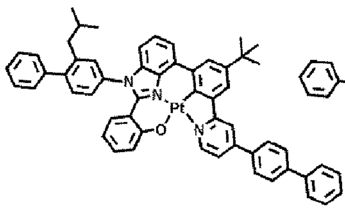
733

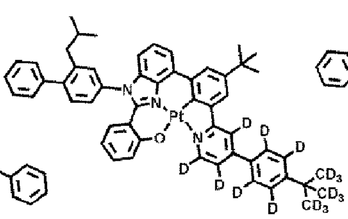
734

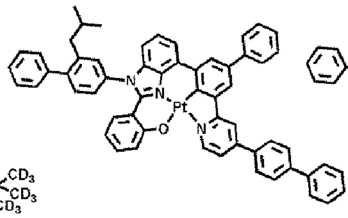
735

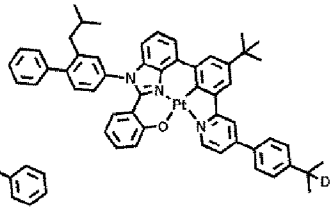
736

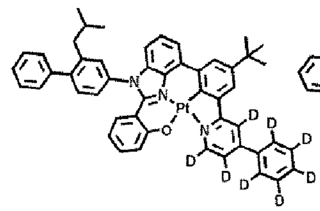
737

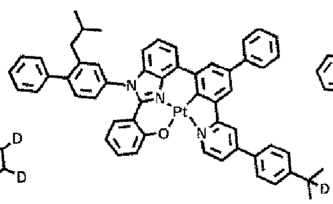
738

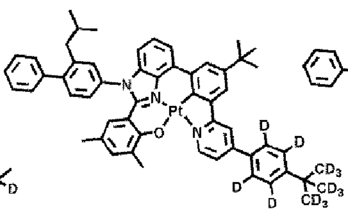
738

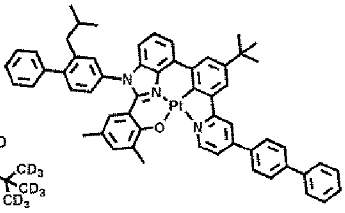
740

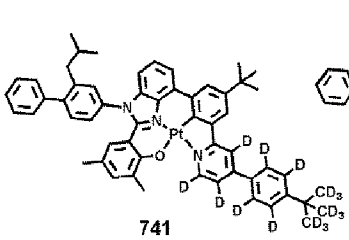
741

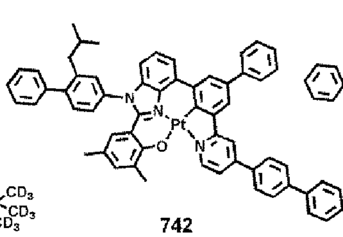
742

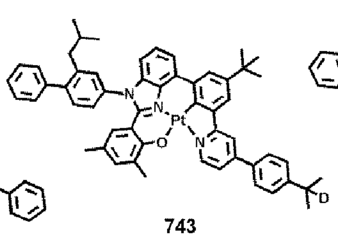
743

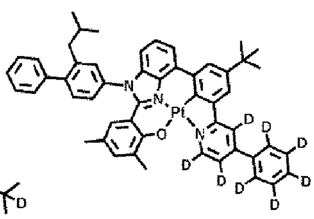
744

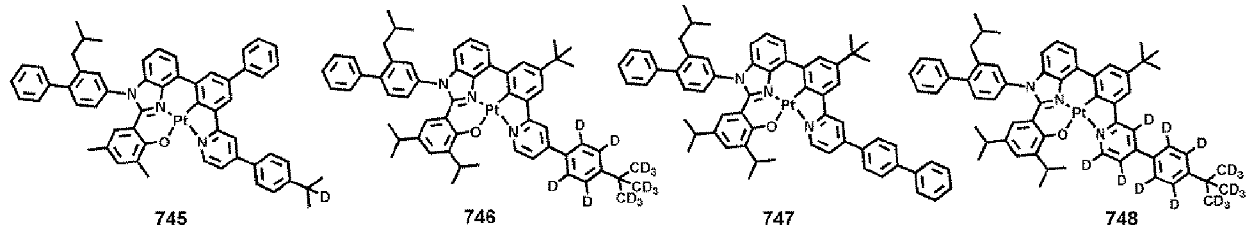

745 746 747 748

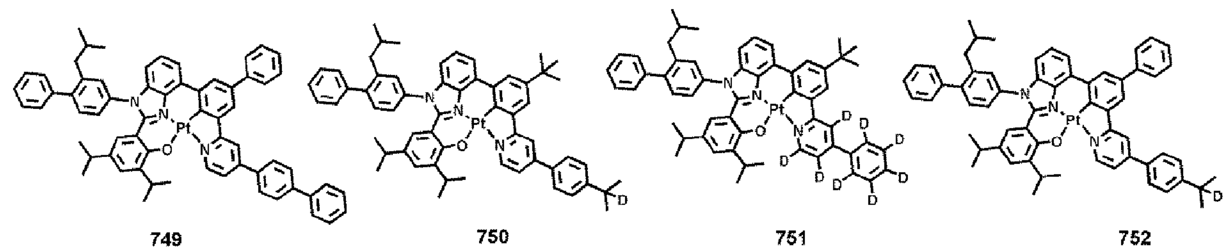

749 750 751 752

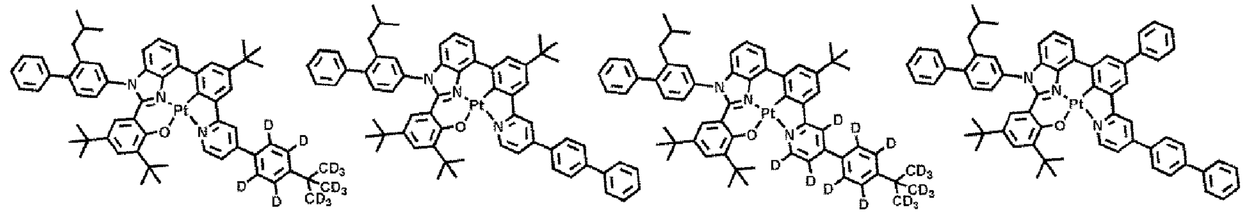

753 754 755 756

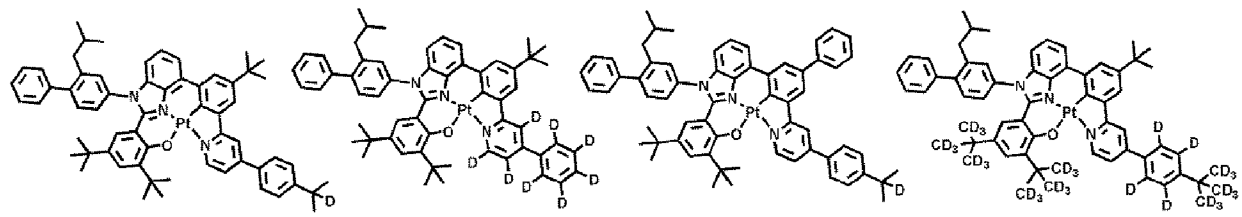

757 758 759 760

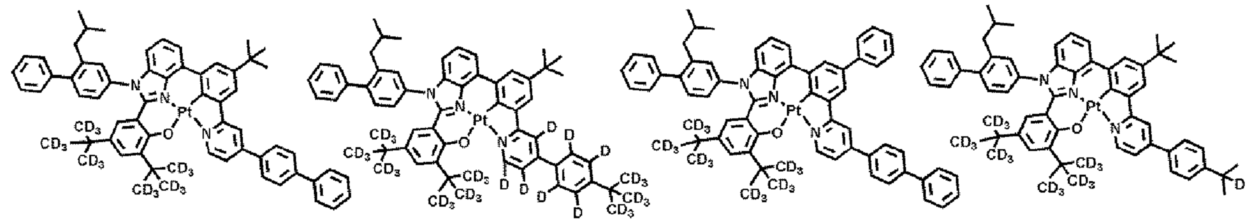

761 762 763 764

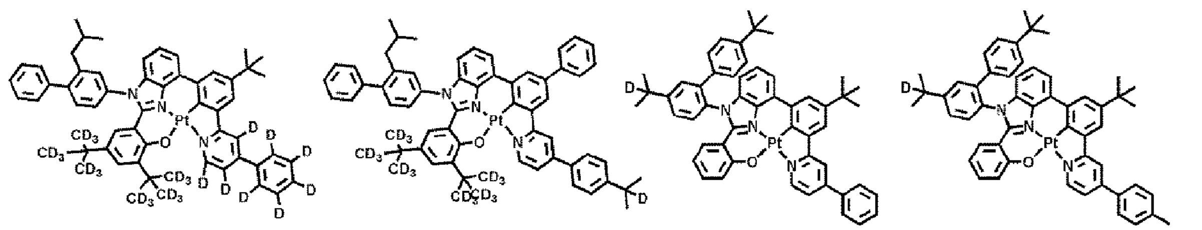

765 766 767 768

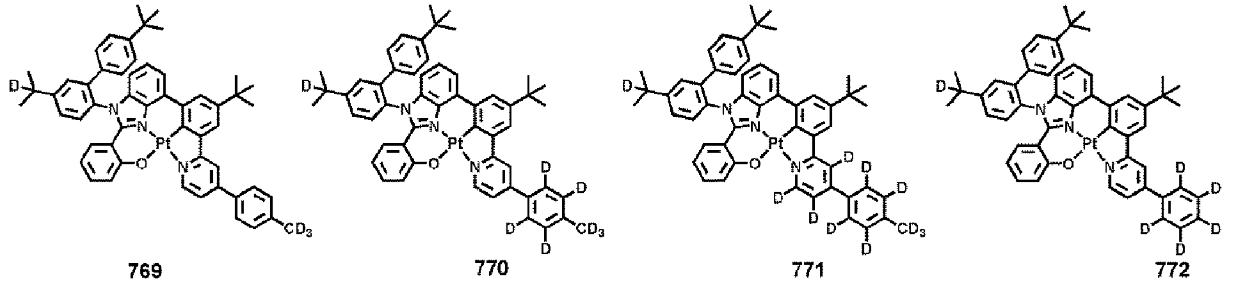

769 770 771 772

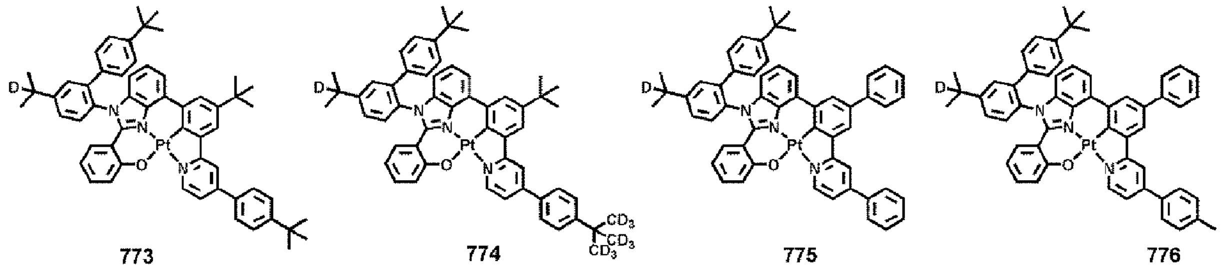

773 774 775 776

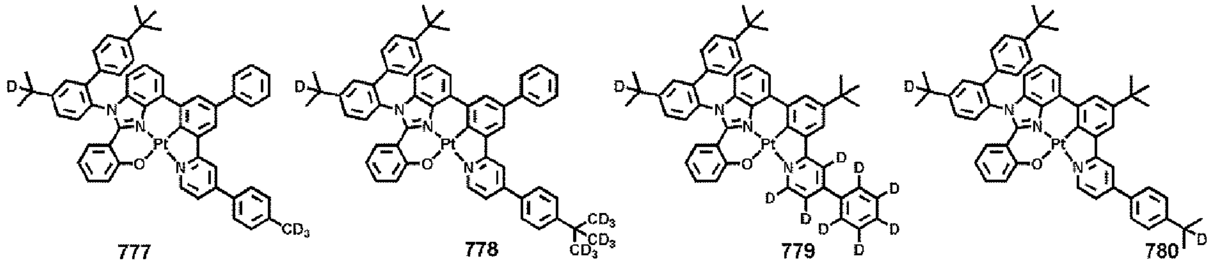

777 778 779 780

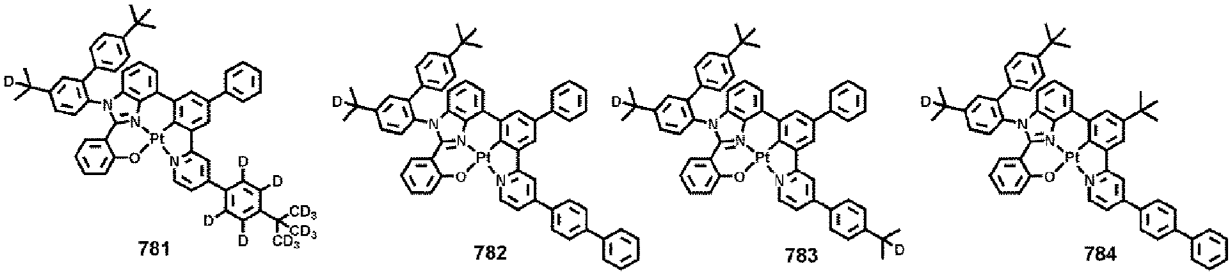

781 782 783 784

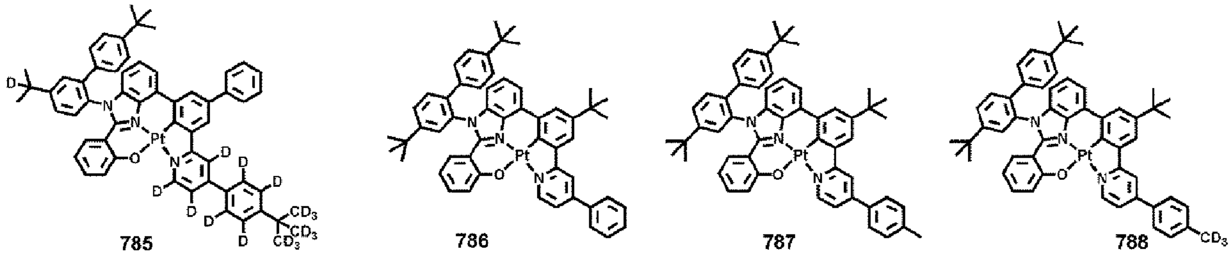

785 786 787 788

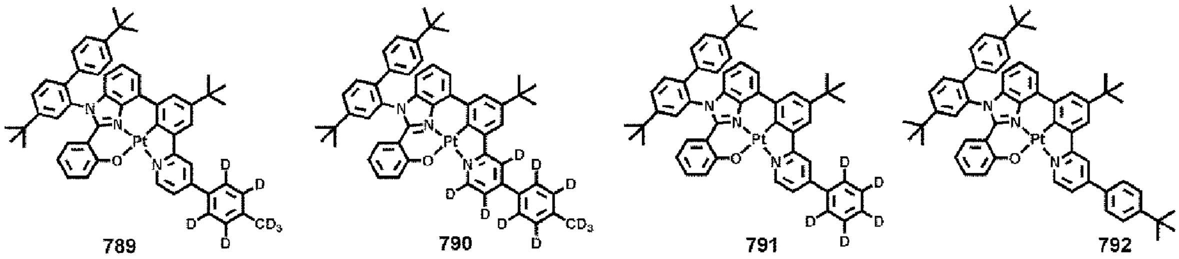

789 790 791 792

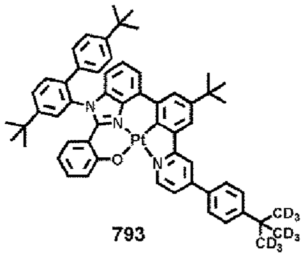
793
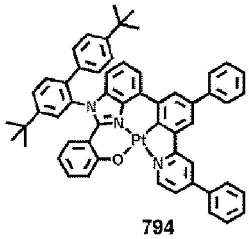
794
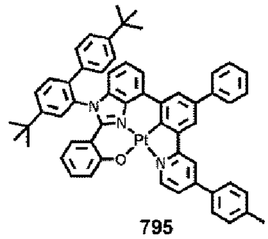
795
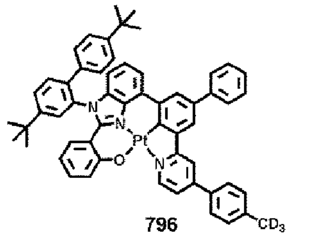
796

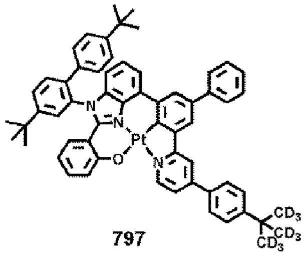
797
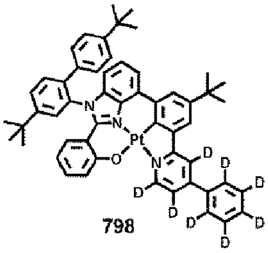
798
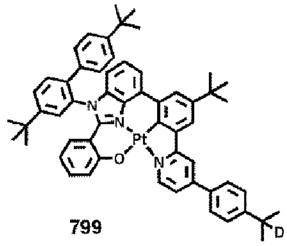
799
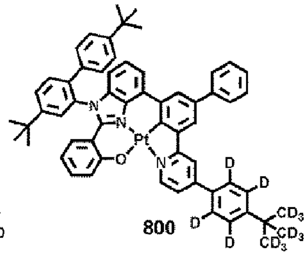
800

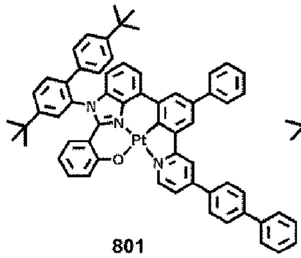
801
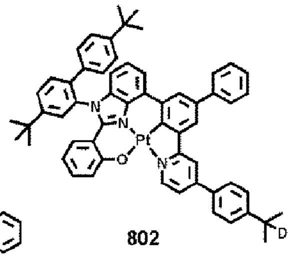
802
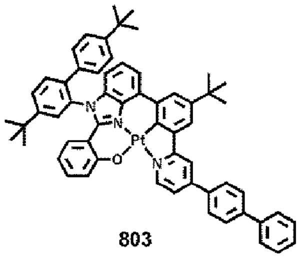
803
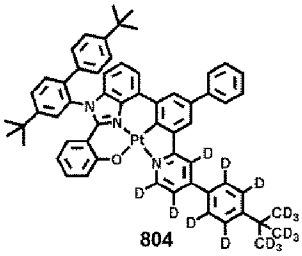
804

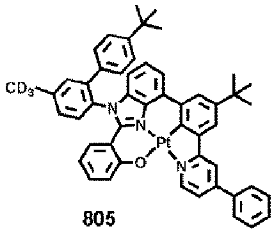
805
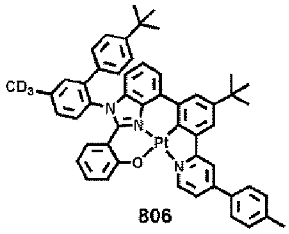
806
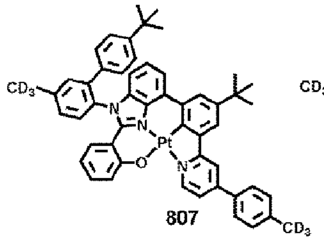
807
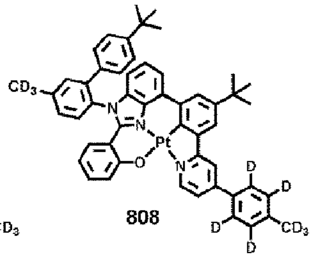
808

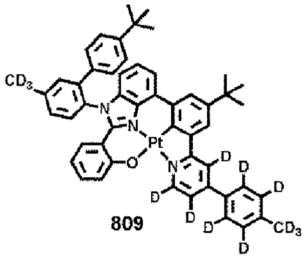
809
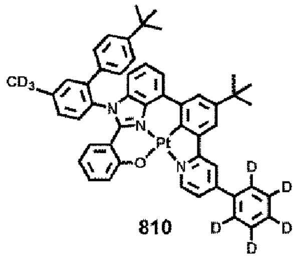
810
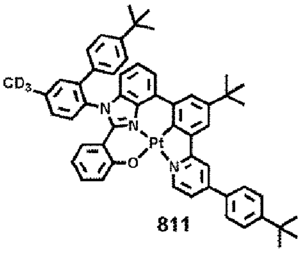
811
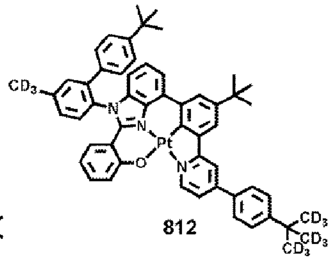
812

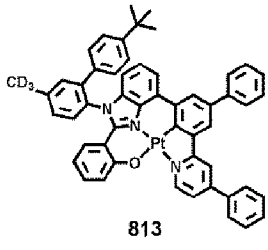
813
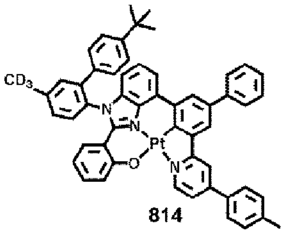
814
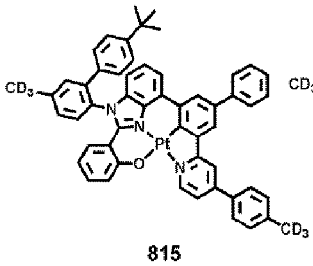
815
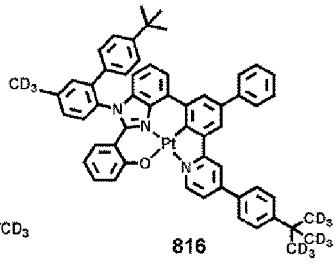
816

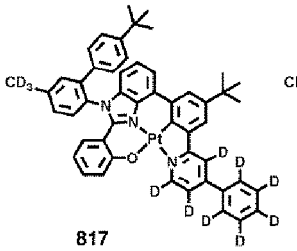
817

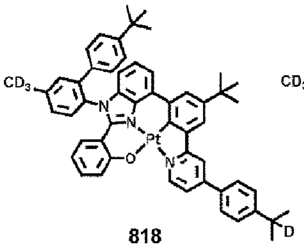
818

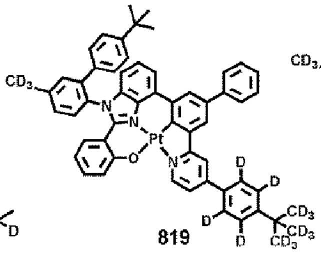
819

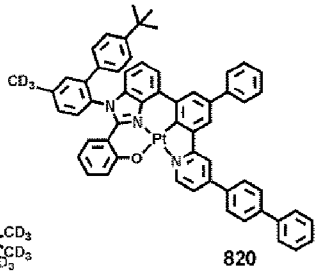
820

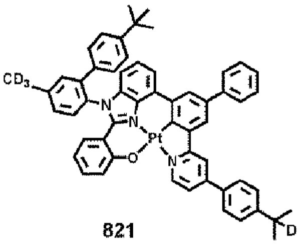
821

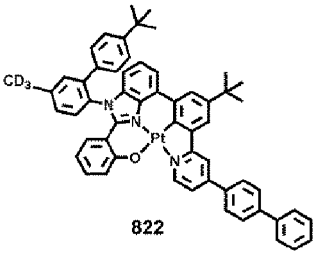
822

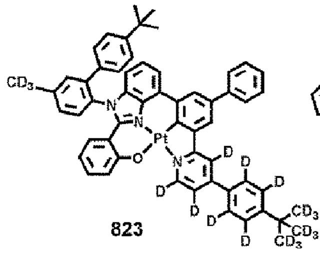
823

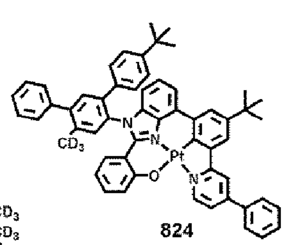
824

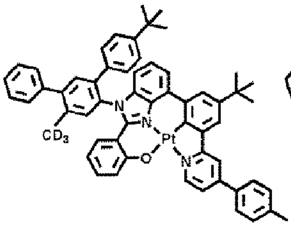
825

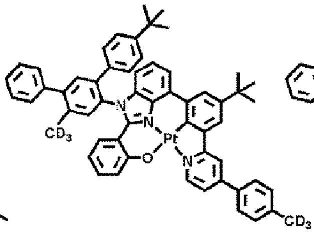
826

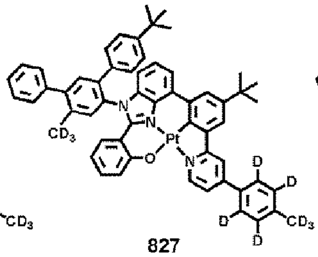
827

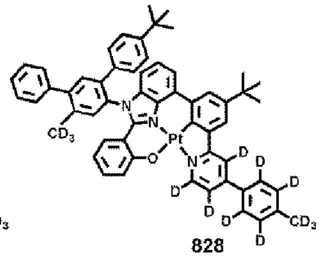
828

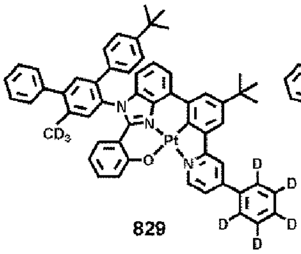
829

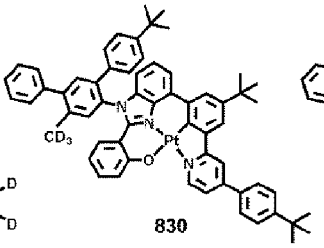
830

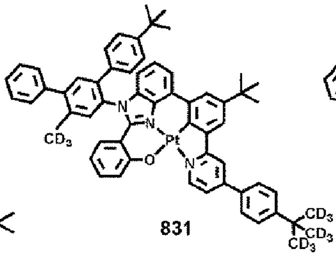
831

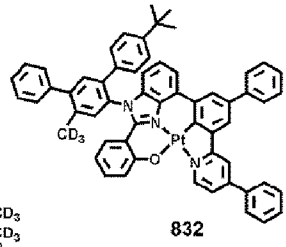
832

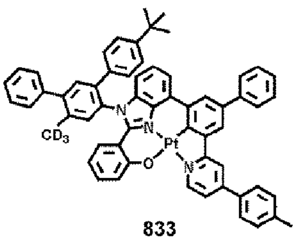
833

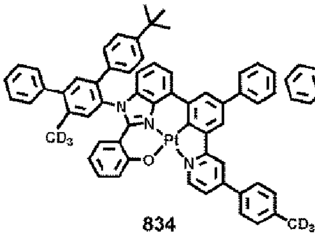
834

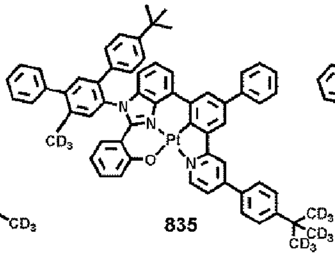
835

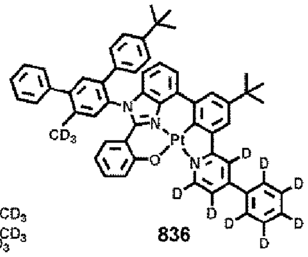
836

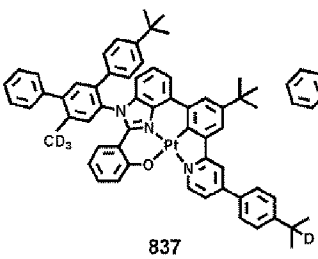
837

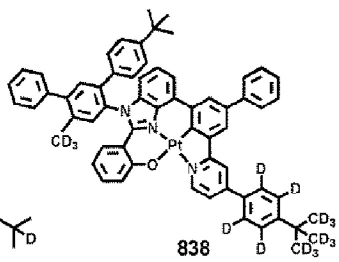
838

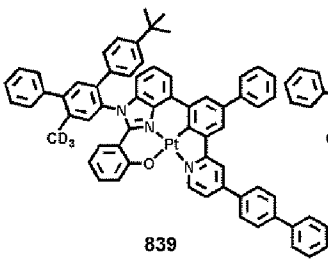
839

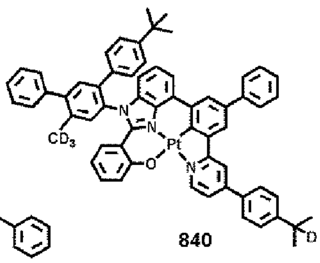
840

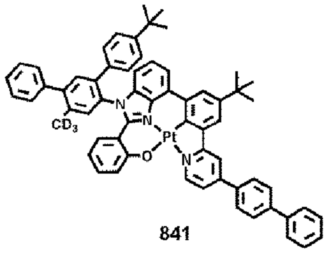
841

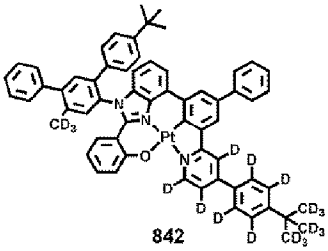
842

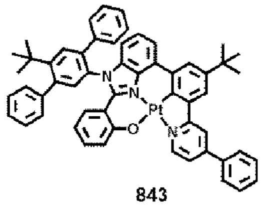
843

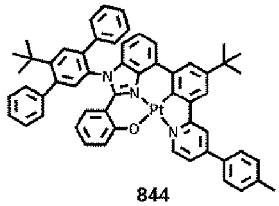
844

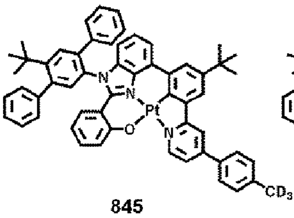
845

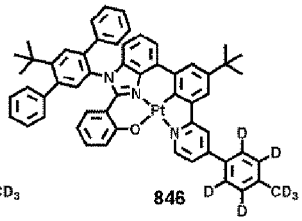
846

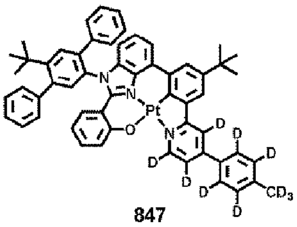
847

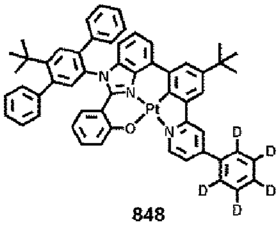
848

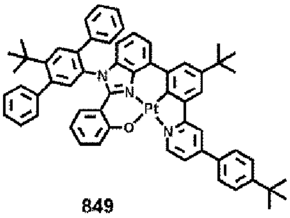
849

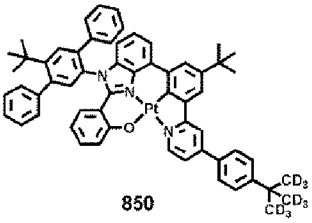
850

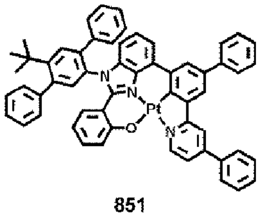
851

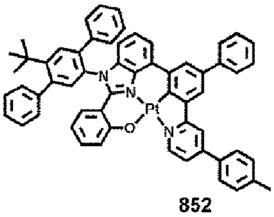
852

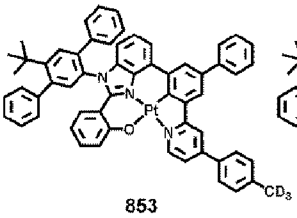
853

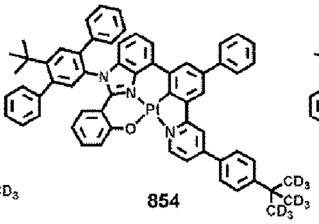
854

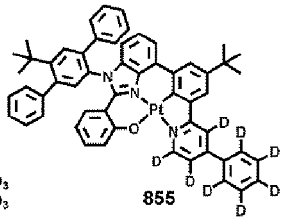
855

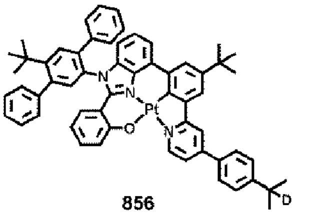
856

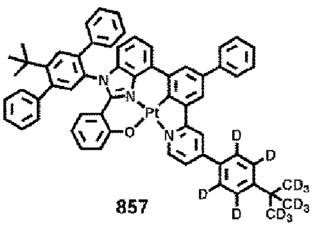
857

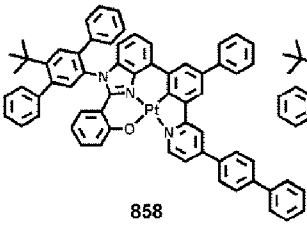
858

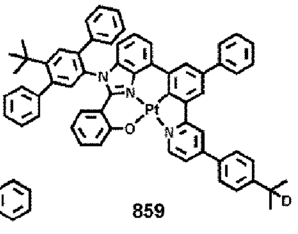
859

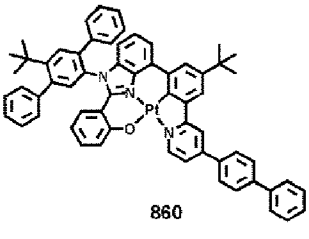
860

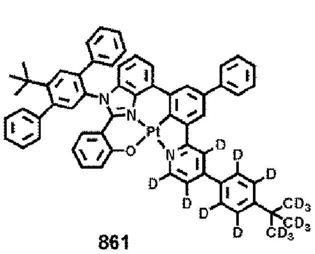
861

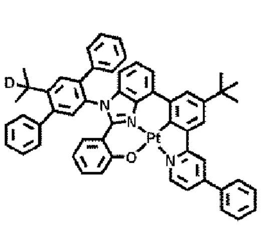
862

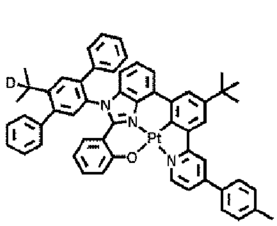
863

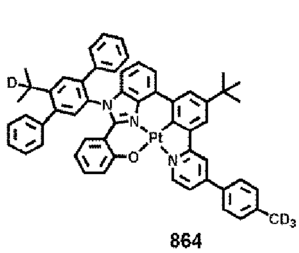
864

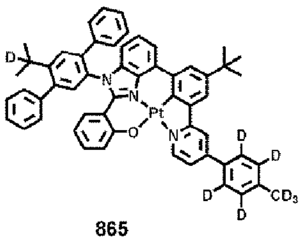
865

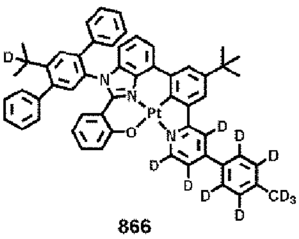
866

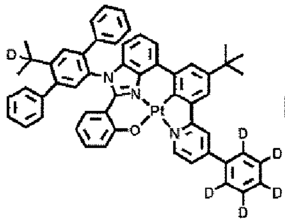
867

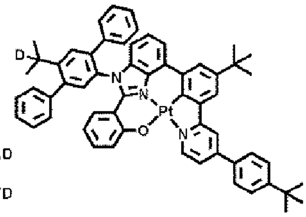
868

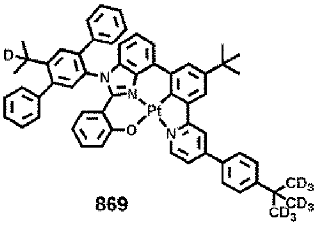
869

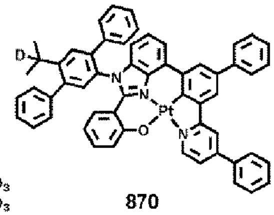
870

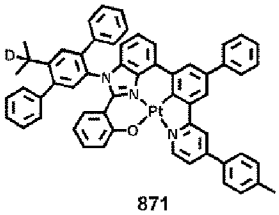
871

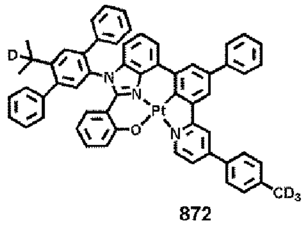
872

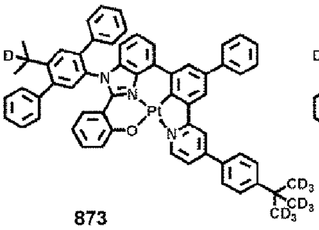
873

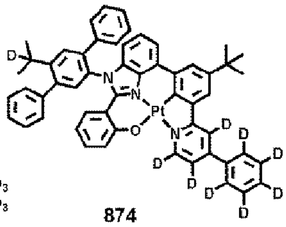
874

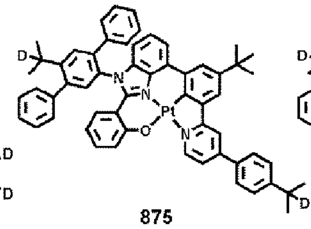
875

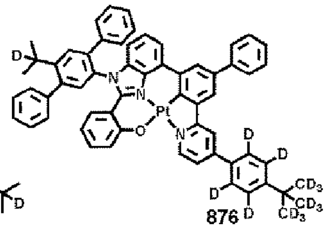
876

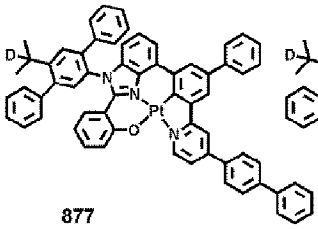
877

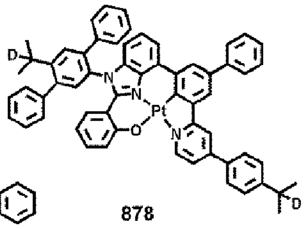
878

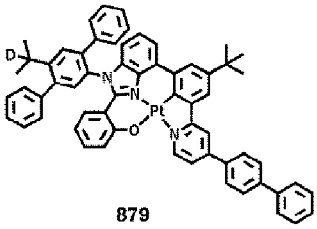
879

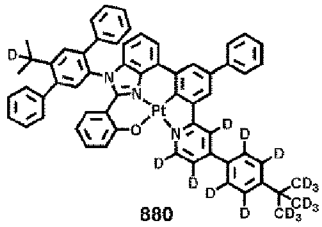
880

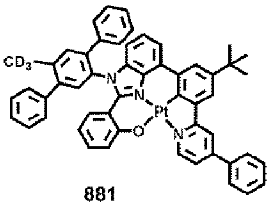
881

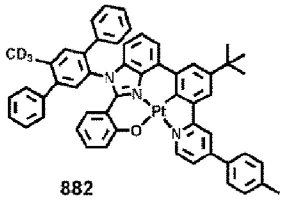
882

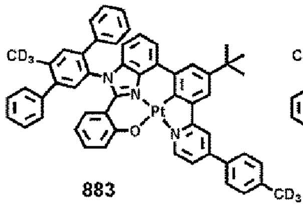
883

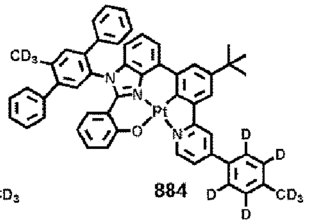
884

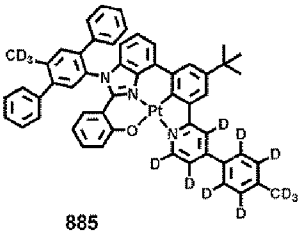
885

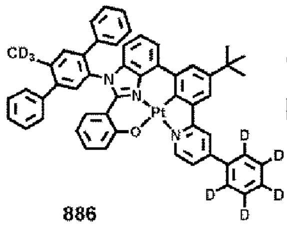
886

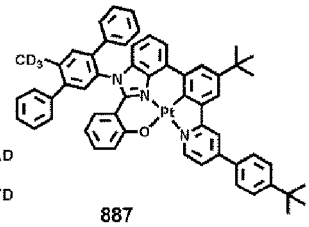
887

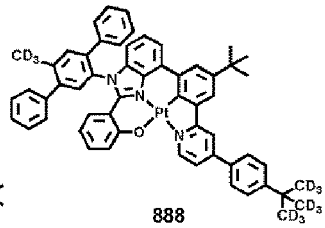
888

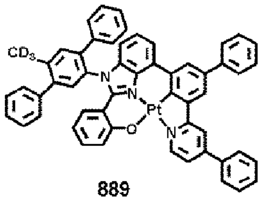
889

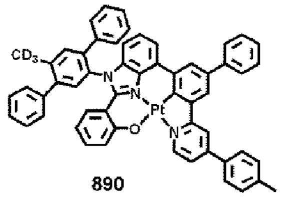
890

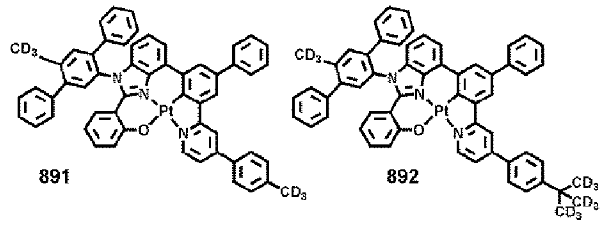
891

892

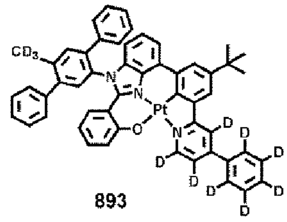
893

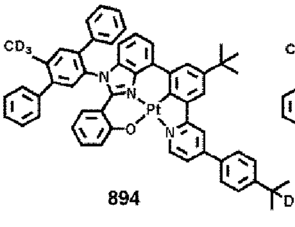
894

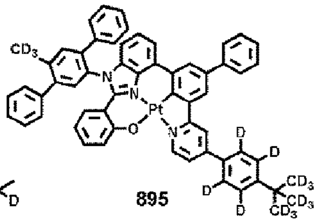
895

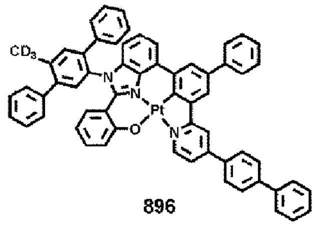
896

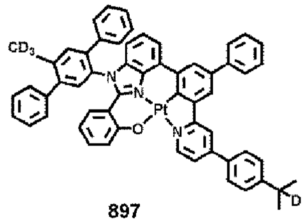
897

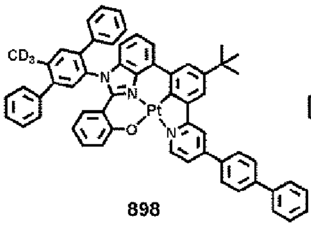
898

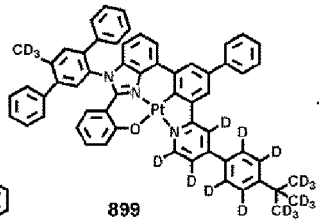
899

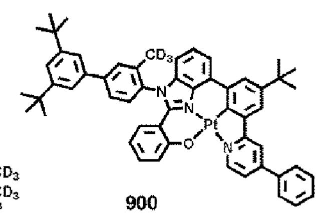
900

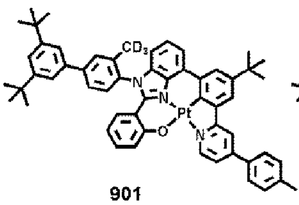
901

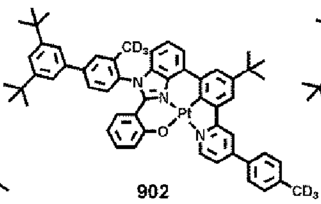
902

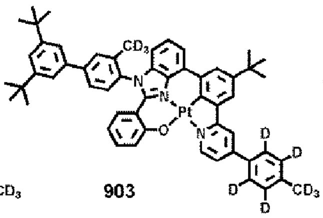
903

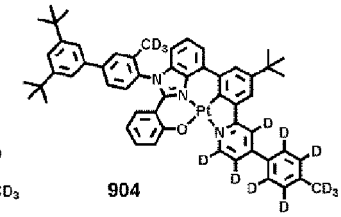
904

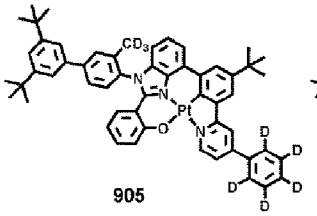
905

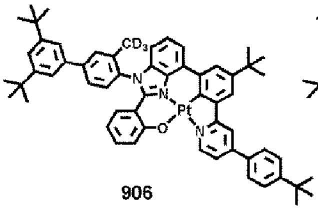
906

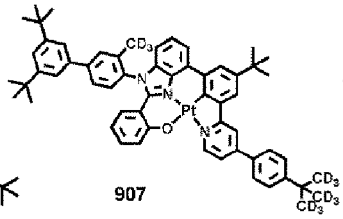
907

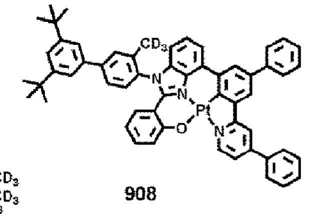
908

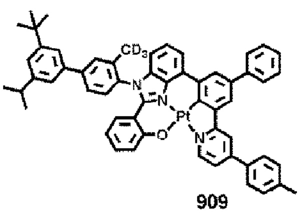
909

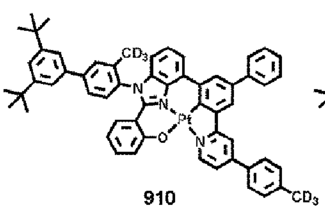
910

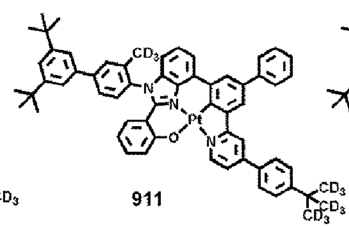
911

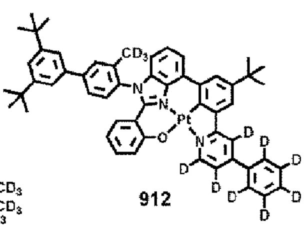
912

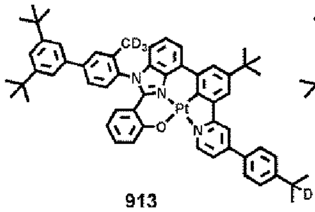
913
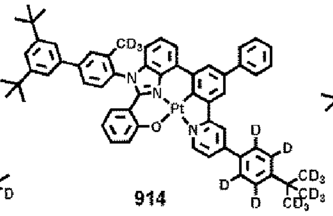
914
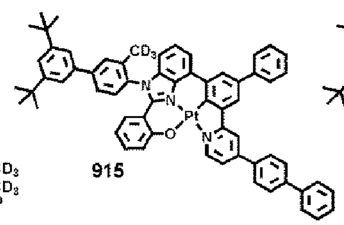
915
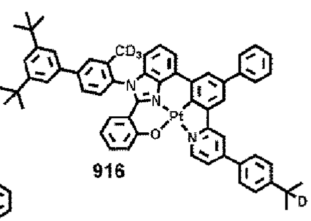
916

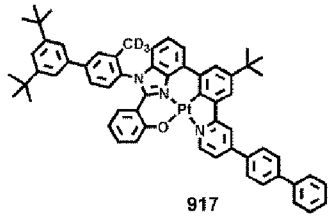
917
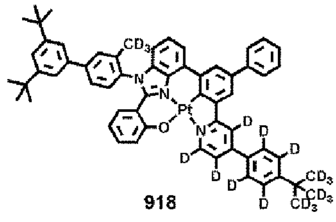
918
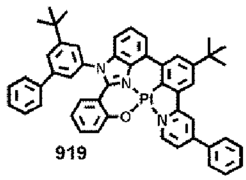
919
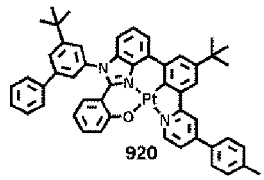
920

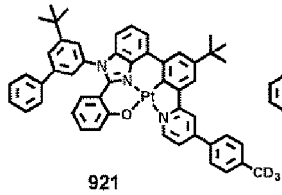
921
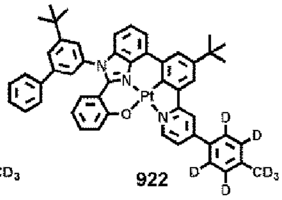
922
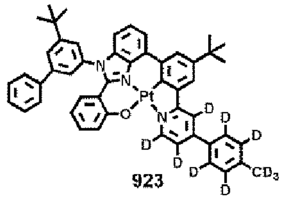
923
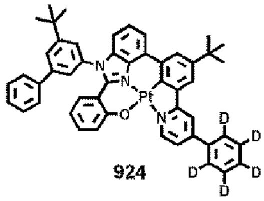
924

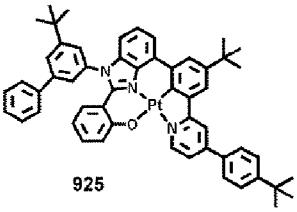
925
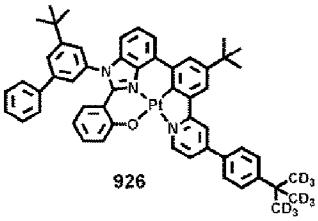
926
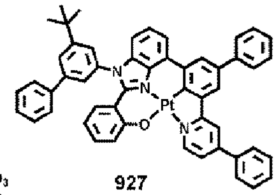
927
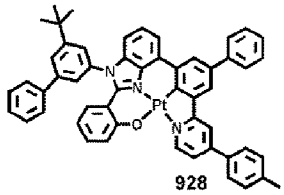
928

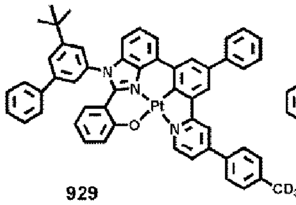
929
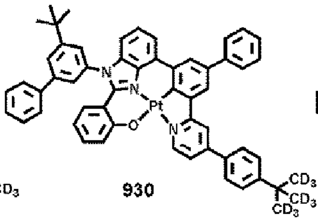
930
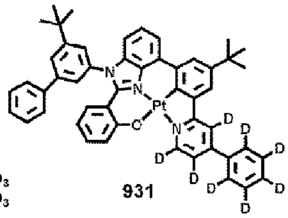
931
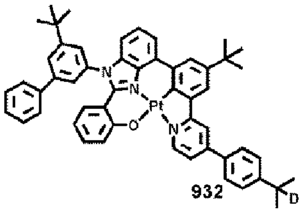
932

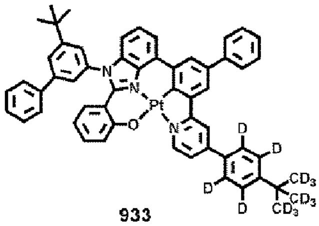
933
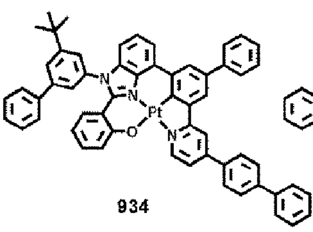
934
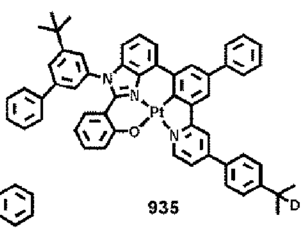
935
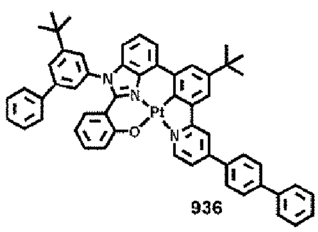
936

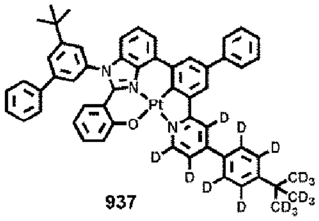
937

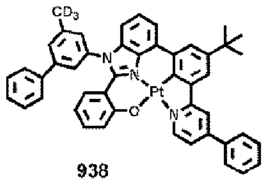
938

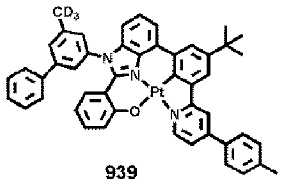
939

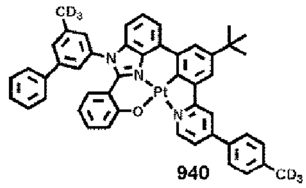
940

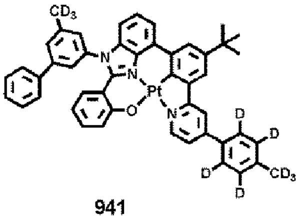
941

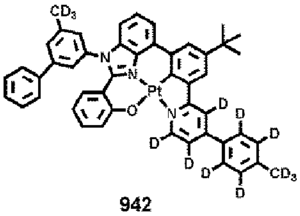
942

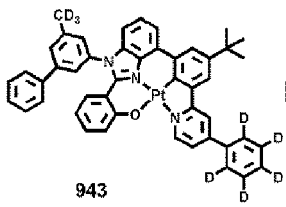
943

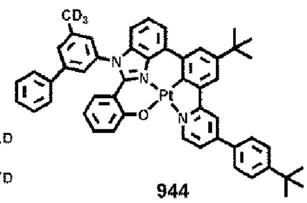
944

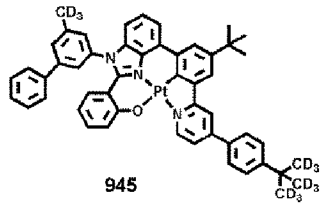
945

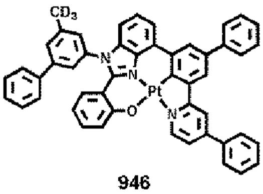
946

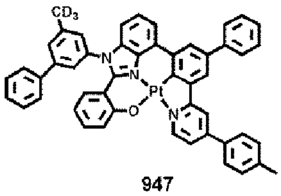
947

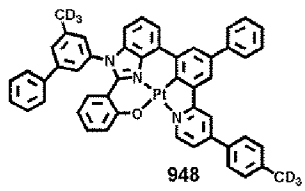
948

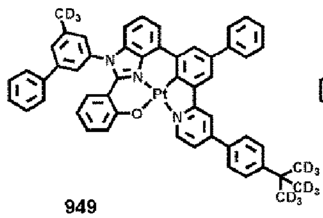
949

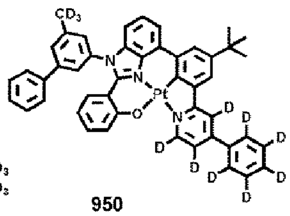
950

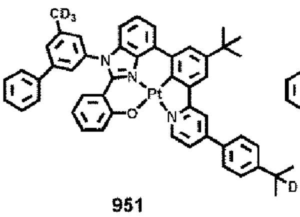
951

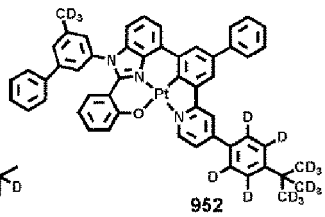
952

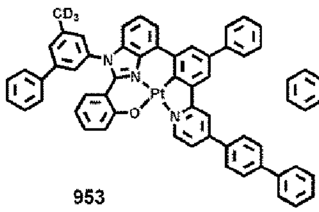
953

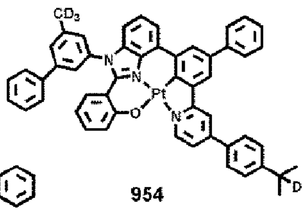
954

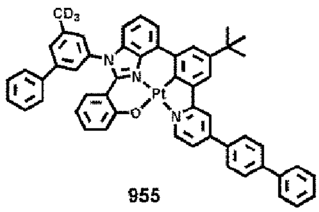
955

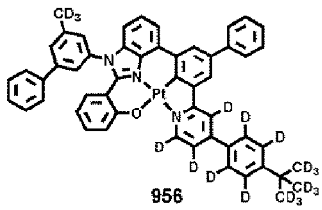
956

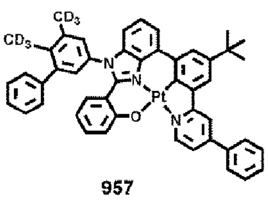
957

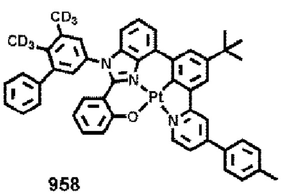
958

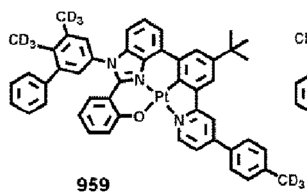
959

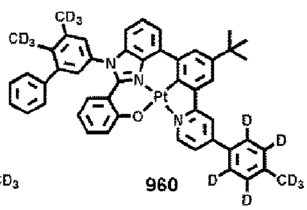
960

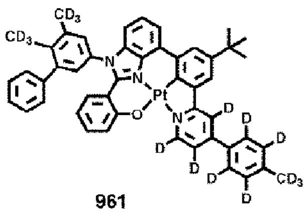
961
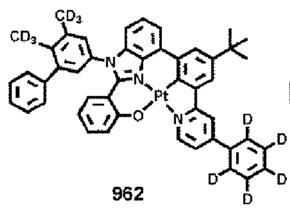
962
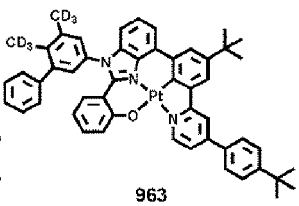
963
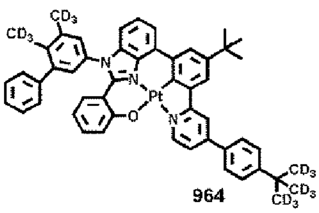
964

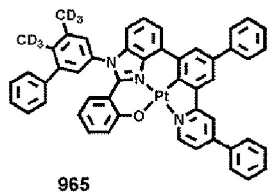
965
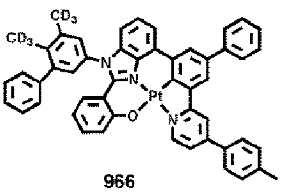
966
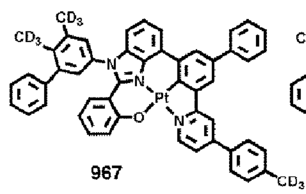
967
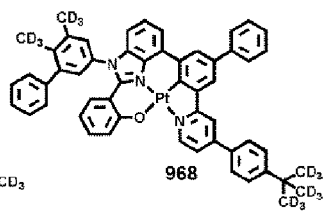
968

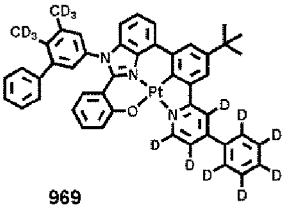
969
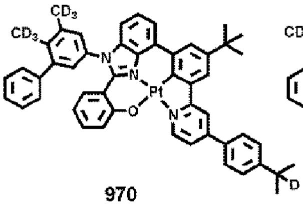
970
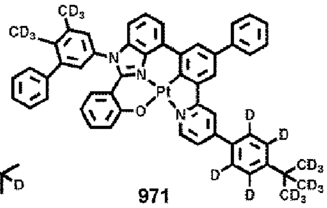
971
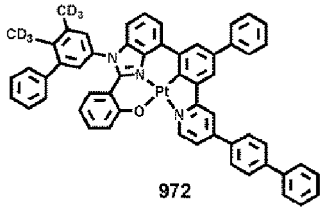
972

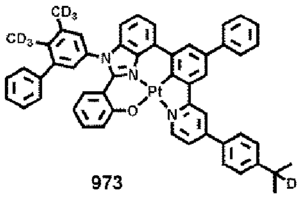
973
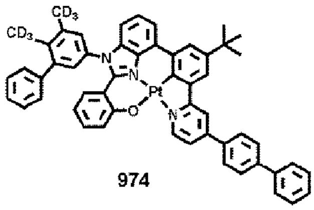
974
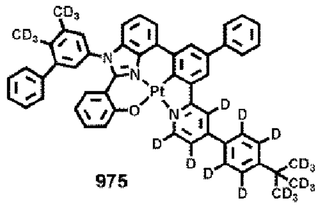
975
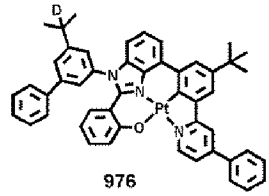
976

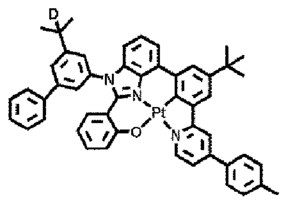
977
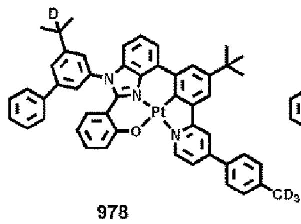
978
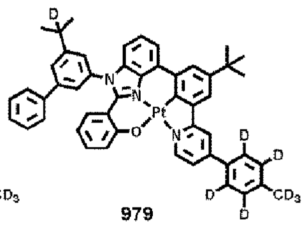
979
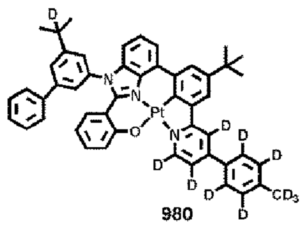
980

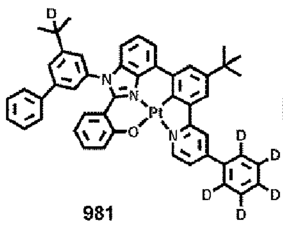
981
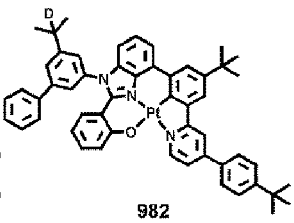
982
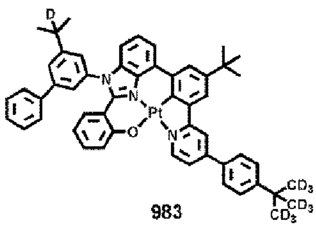
983
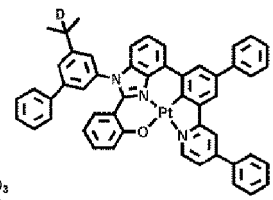
984

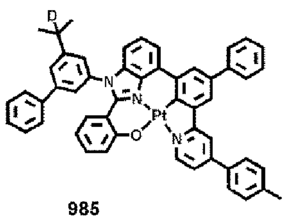
985
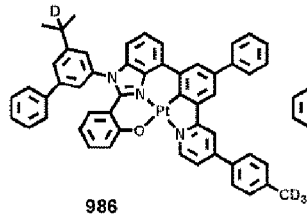
986
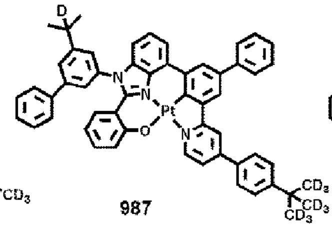
987
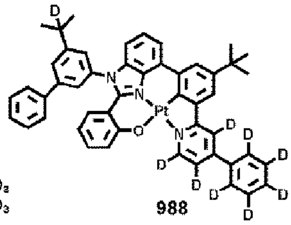
988

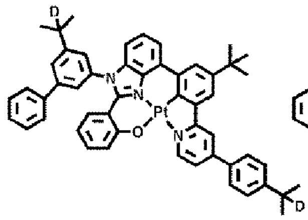
989
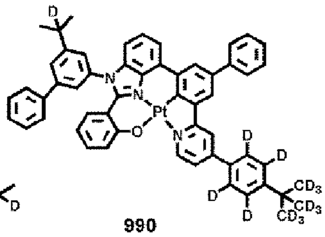
990
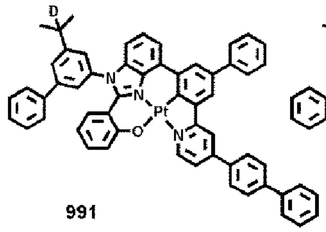
991
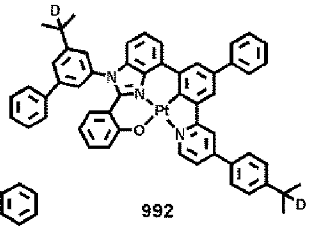
992

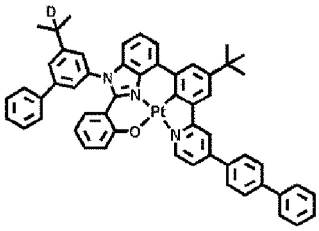
993
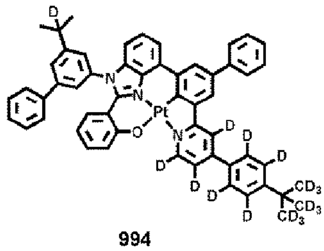
994
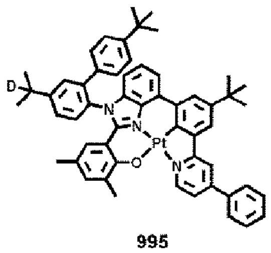
995
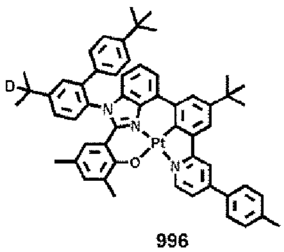
996

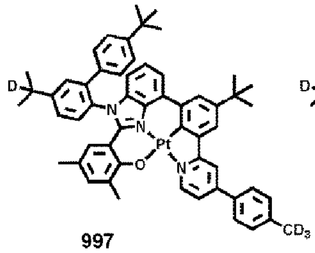
997
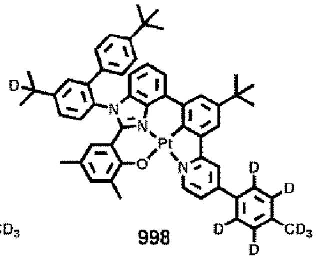
998
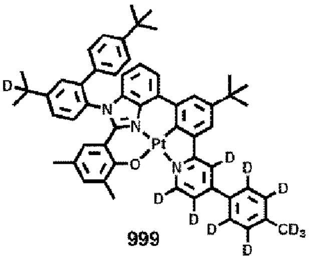
999
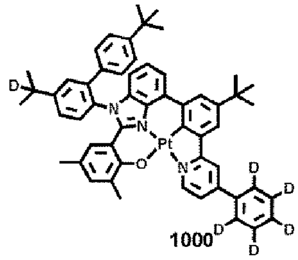
1000

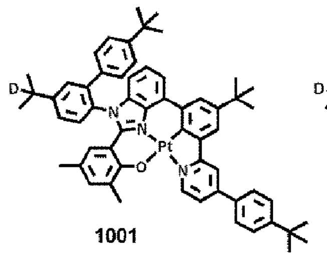
1001
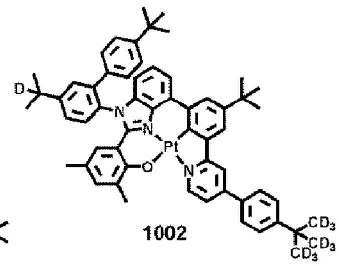
1002
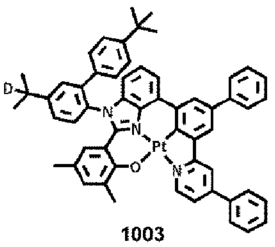
1003
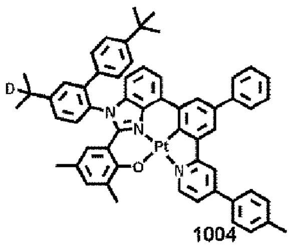
1004

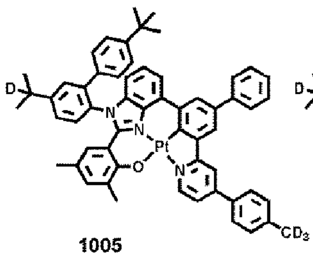
1005
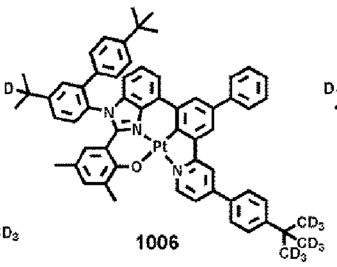
1006
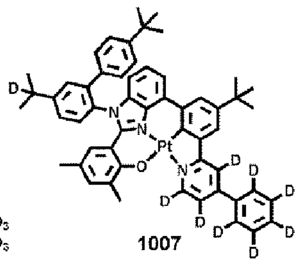
1007
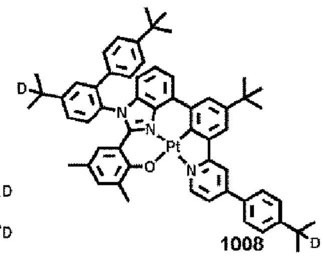
1008

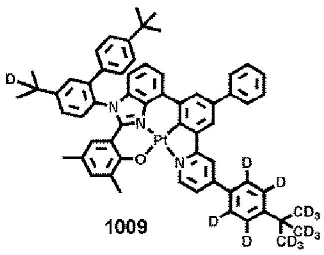
1009

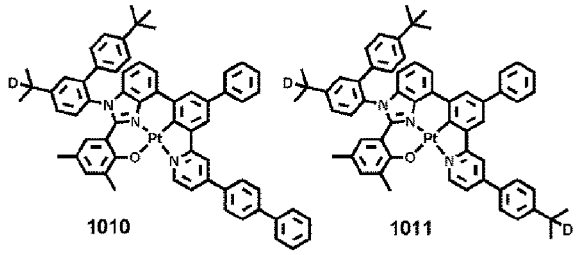
1010

1011

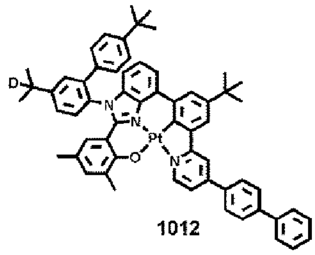
1012

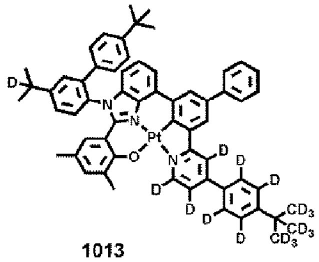
1013

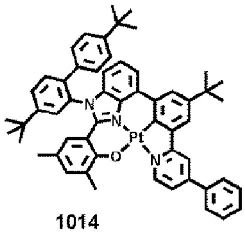
1014

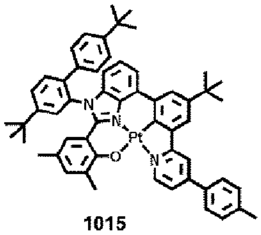
1015

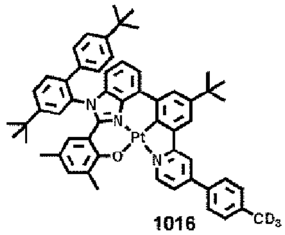
1016

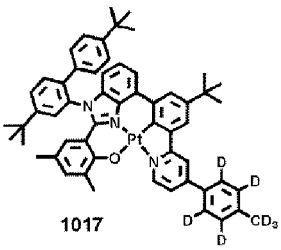
1017

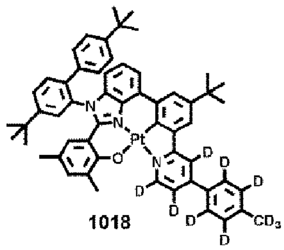
1018

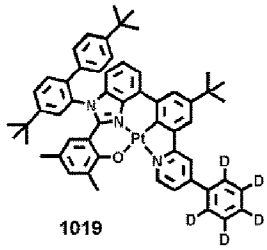
1019

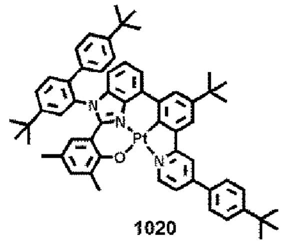
1020

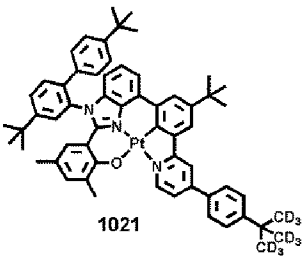
1021

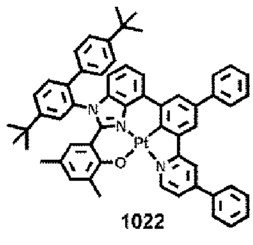
1022

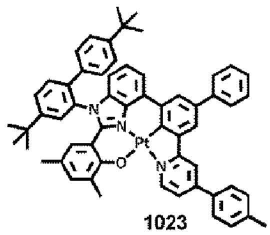
1023

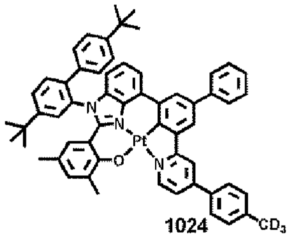
1024

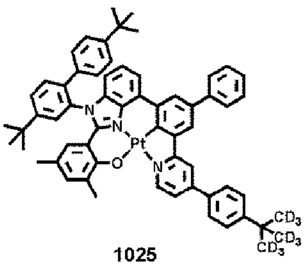
1025

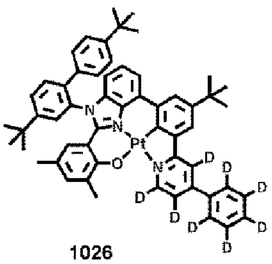
1026

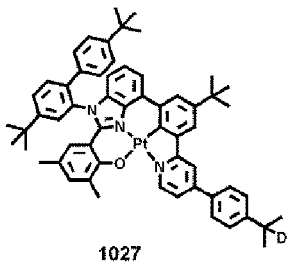
1027

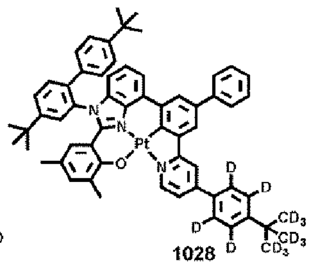
1028

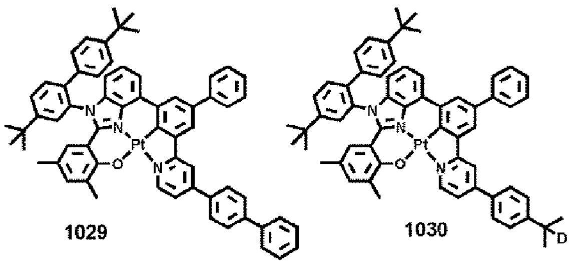
1029

1030

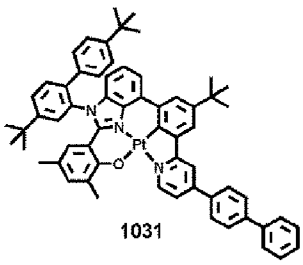
1031

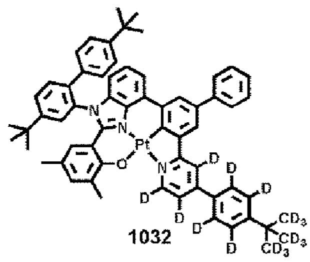
1032

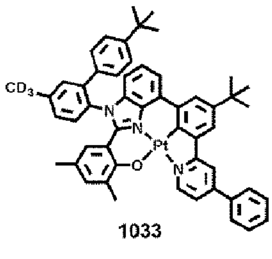
1033

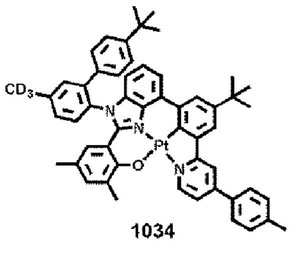
1034

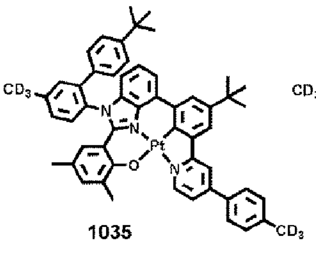
1035

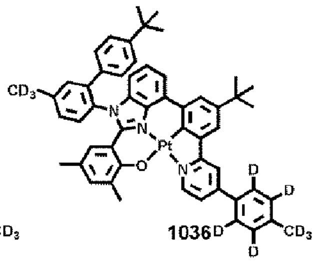
1036

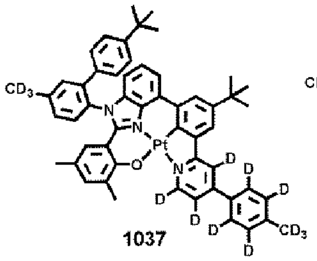
1037

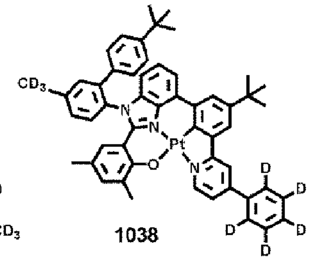
1038

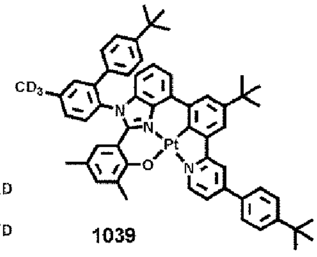
1039

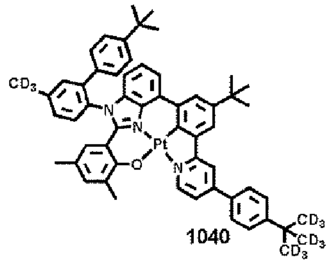
1040

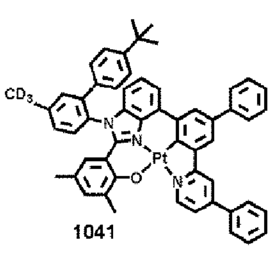
1041

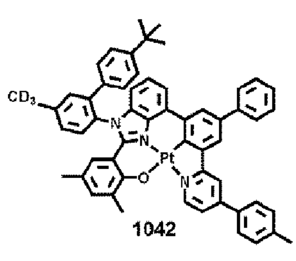
1042

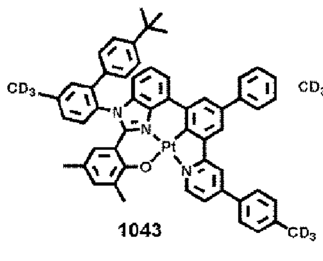
1043

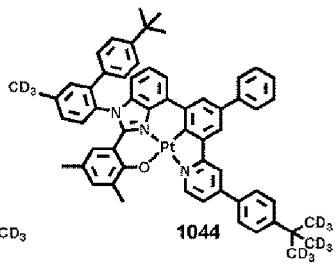
1044

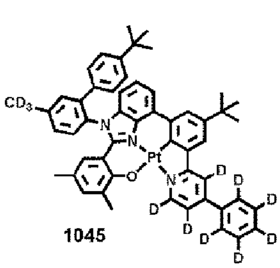
1045

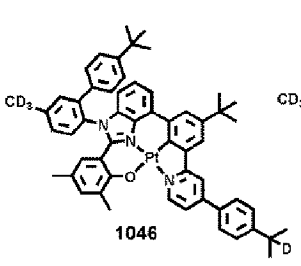
1046

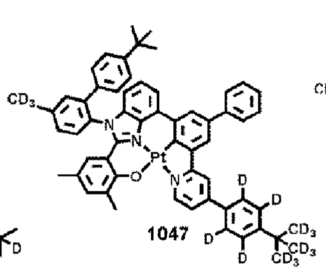
1047

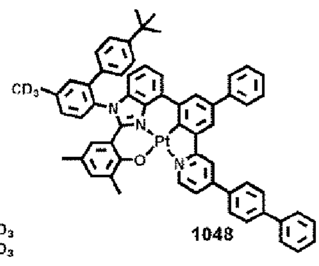
1048

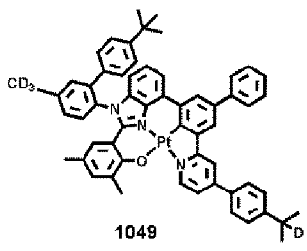
1049

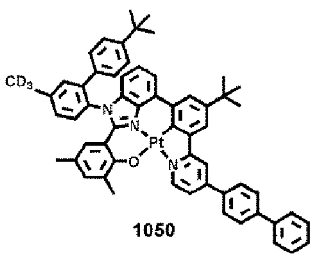
1050

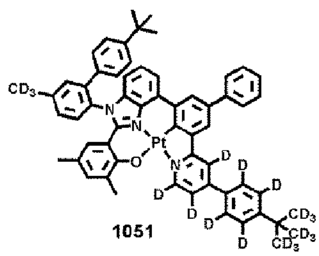
1051

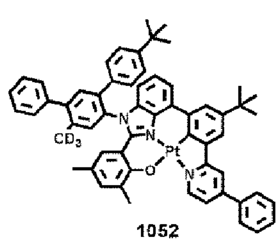
1052

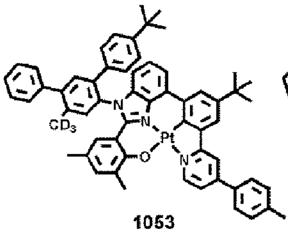
1053

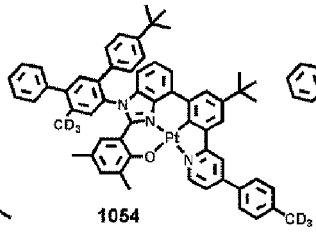
1054

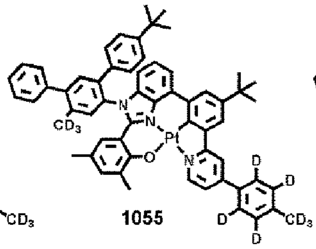
1055

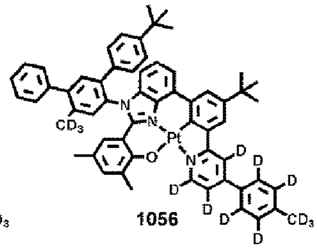
1056

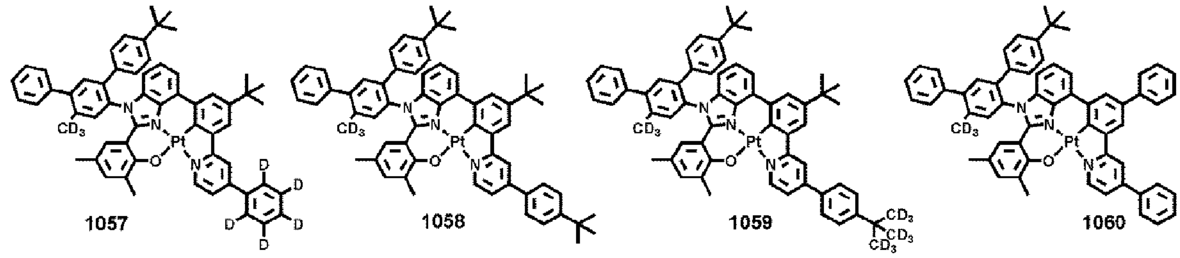

1057 1058 1059 1060

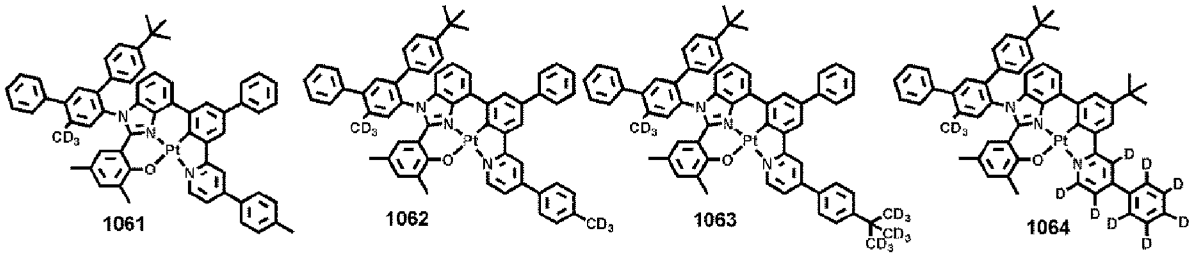

1061 1062 1063 1064

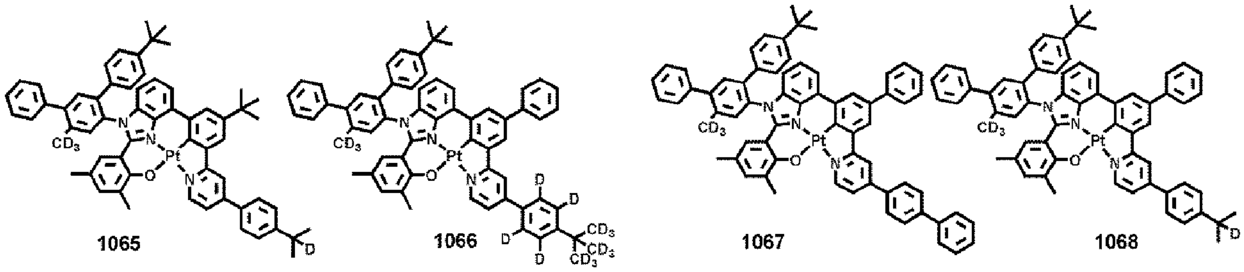

1065 1066 1067 1068

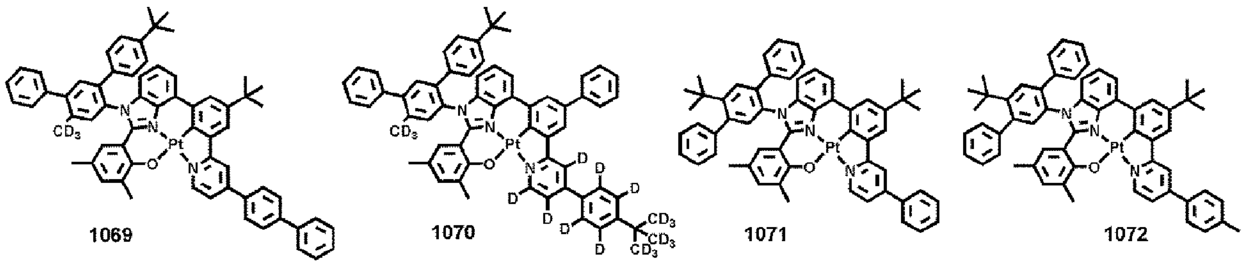

1069 1070 1071 1072

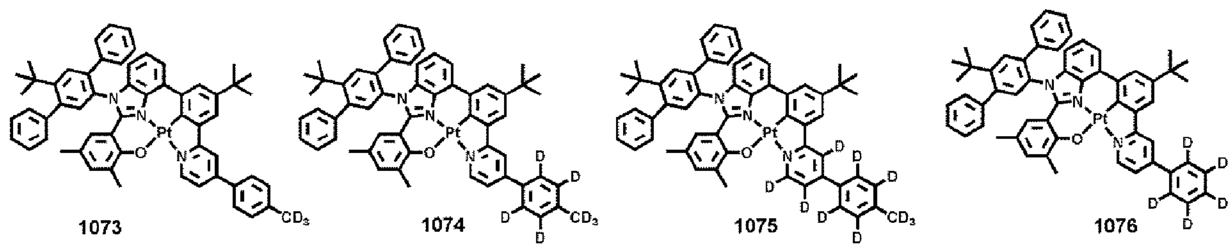

1073 1074 1075 1076

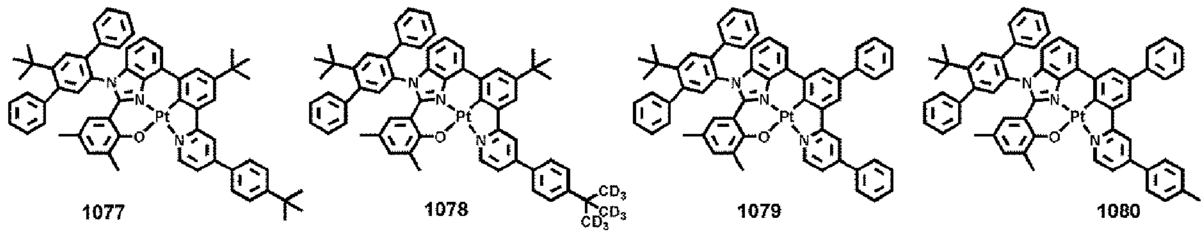

1077 1078 1079 1080

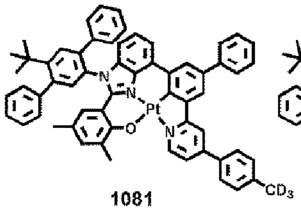
1081

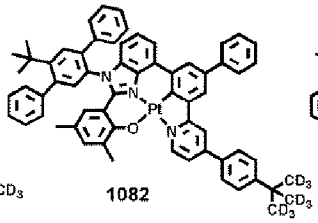
1082

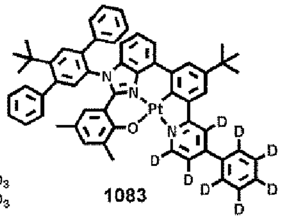
1083

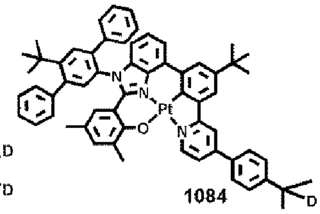
1084

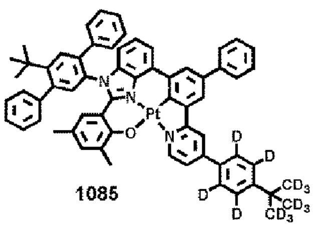
1085

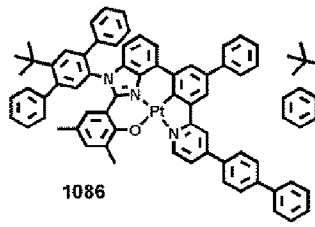
1086

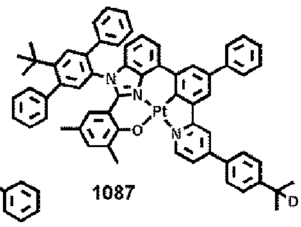
1087

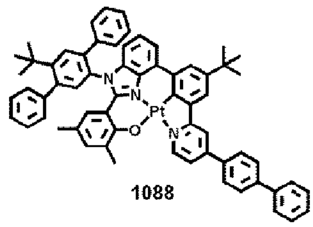
1088

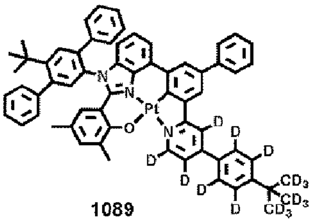
1089

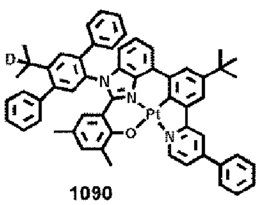
1090

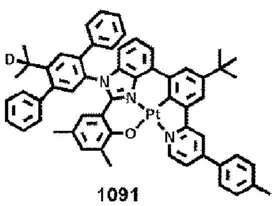
1091

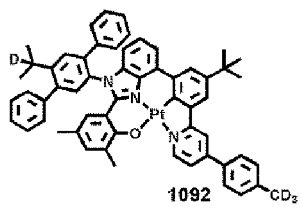
1092

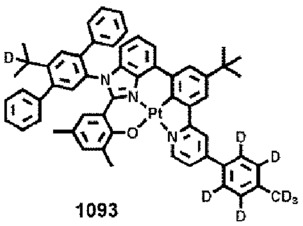
1093

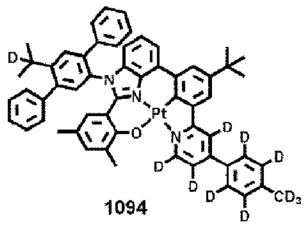
1094

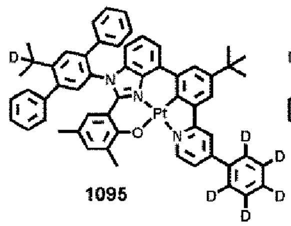
1095

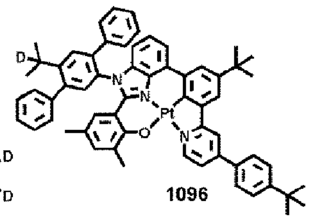
1096

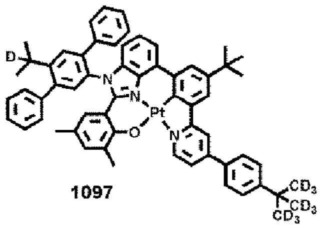
1097

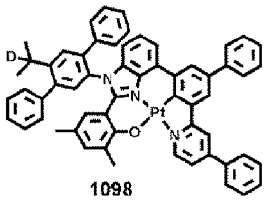
1098

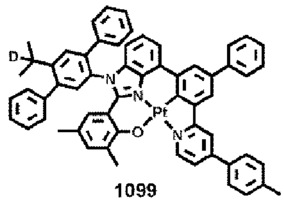
1099

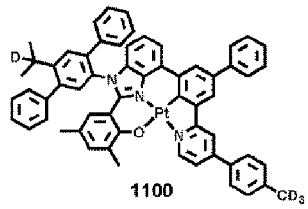
1100

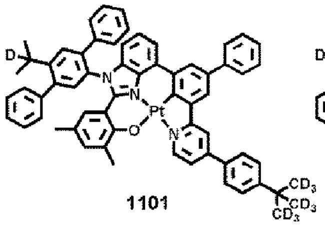
1101

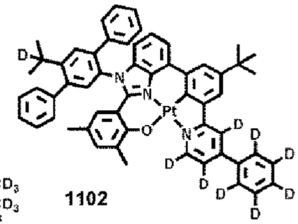
1102

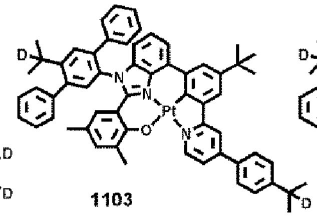
1103

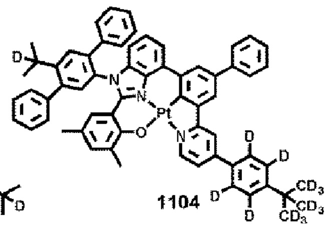
1104

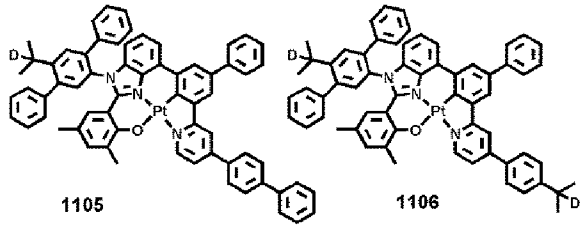

1105 1106

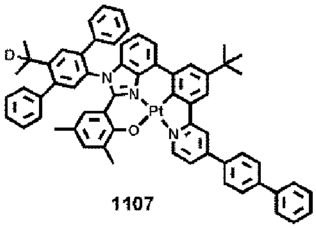

1107

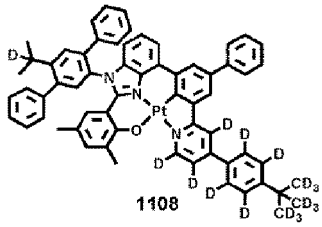

1108

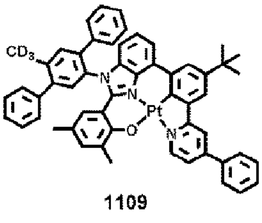

1109

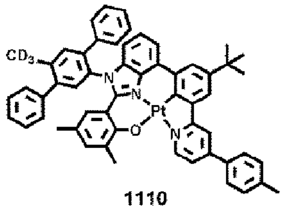

1110

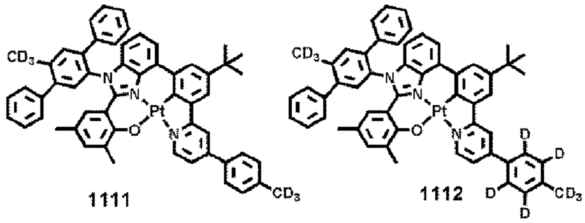

1111 1112

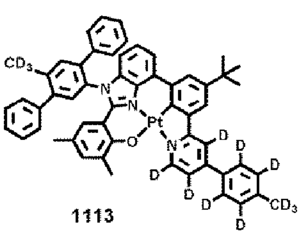

1113

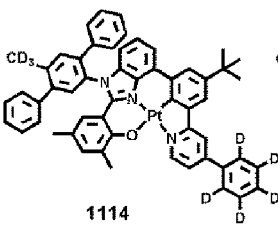

1114

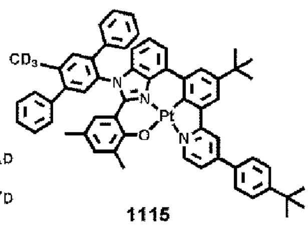

1115

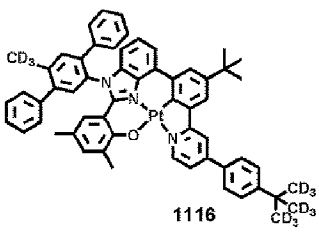

1116

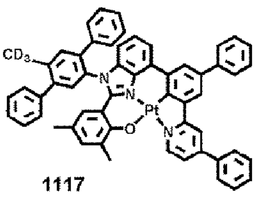

1117

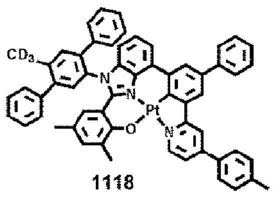

1118

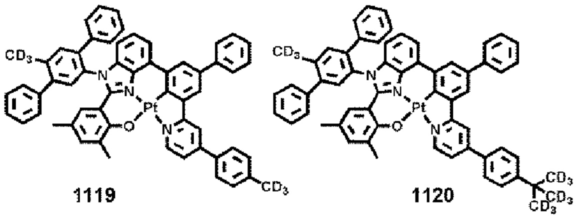

1119 1120

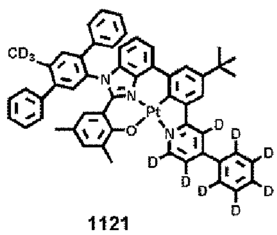

1121

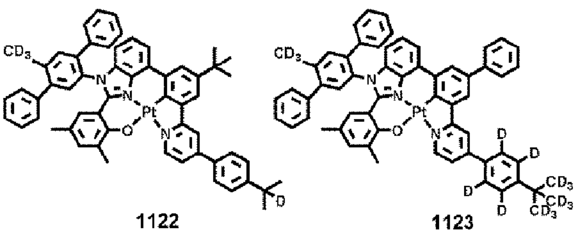

1122 1123

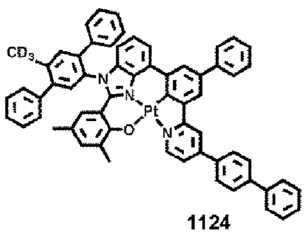

1124

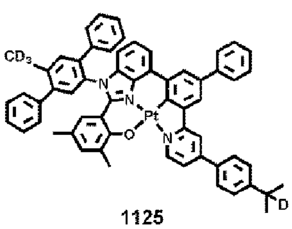

1125

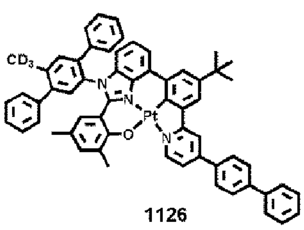

1126

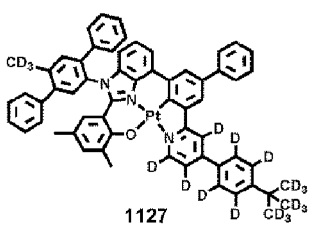

1127

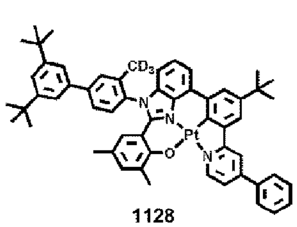

1128

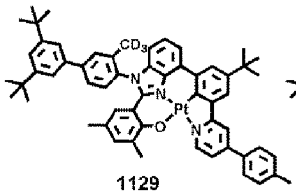
1129
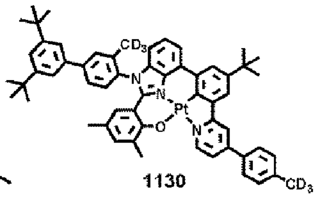
1130
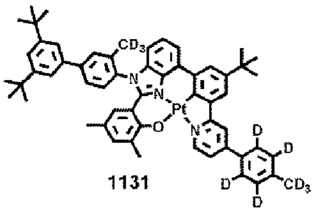
1131
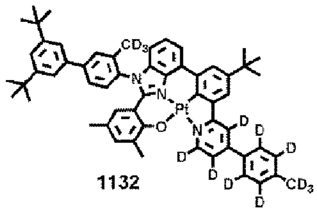
1132

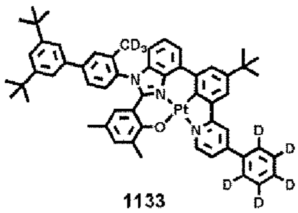
1133
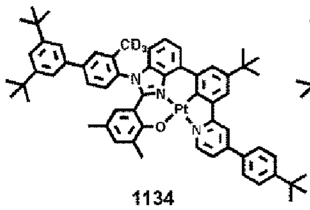
1134
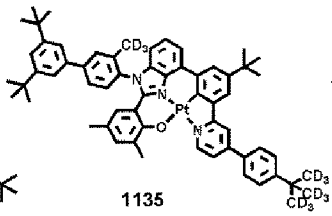
1135
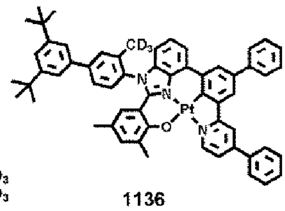
1136

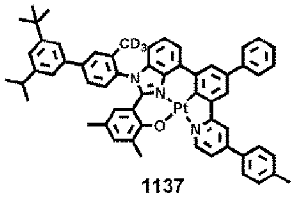
1137
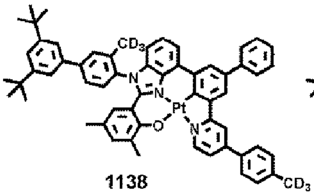
1138
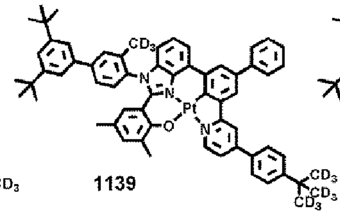
1139
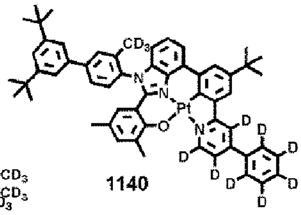
1140

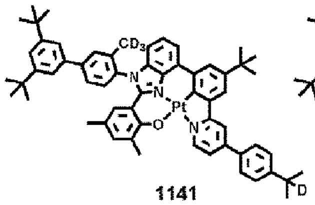
1141
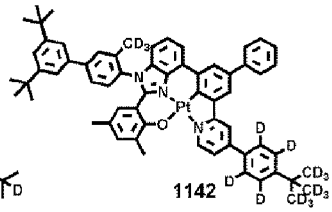
1142
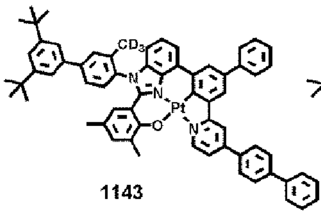
1143
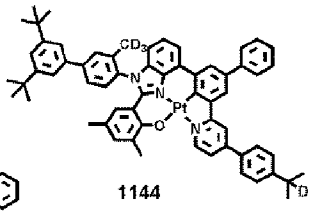
1144

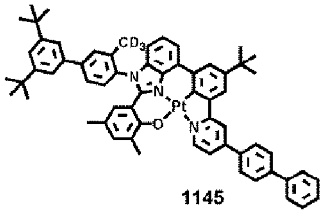
1145
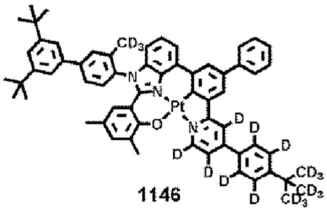
1146
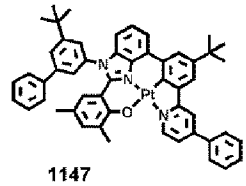
1147
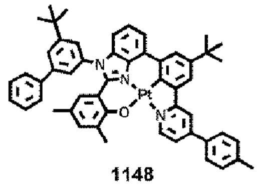
1148

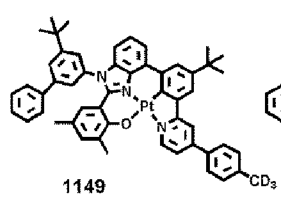
1149
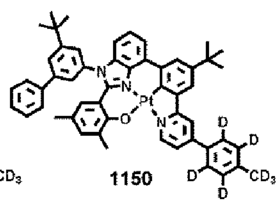
1150
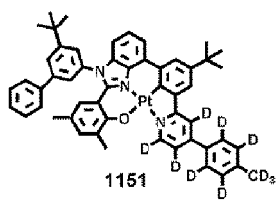
1151
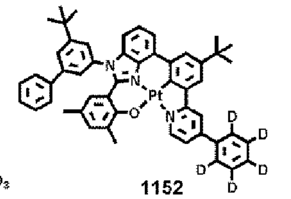
1152

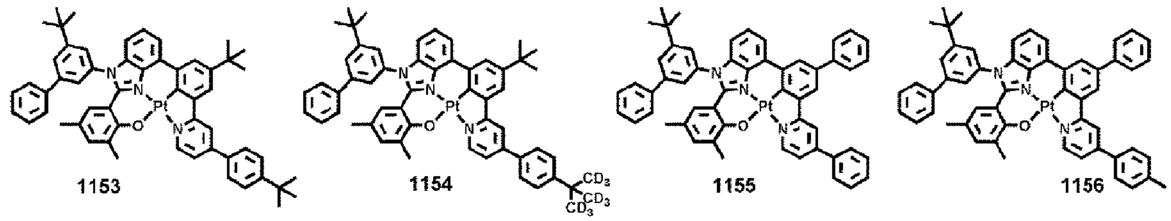

1153 1154 1155 1156

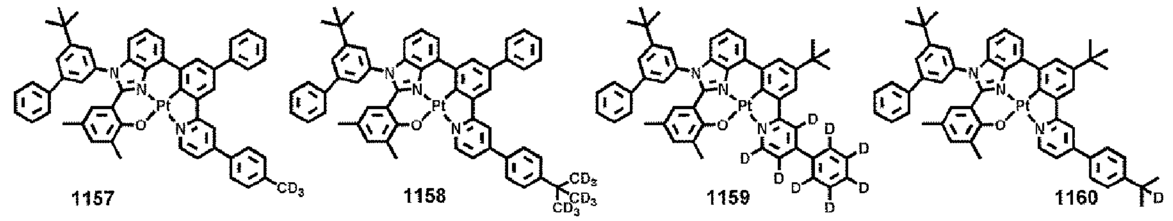

1157 1158 1159 1160

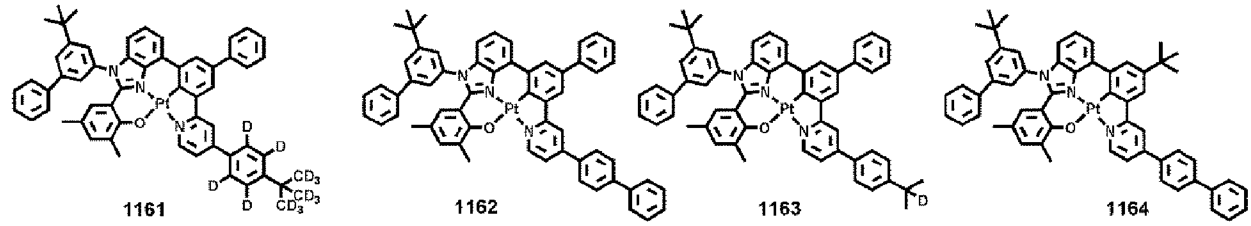

1161 1162 1163 1164

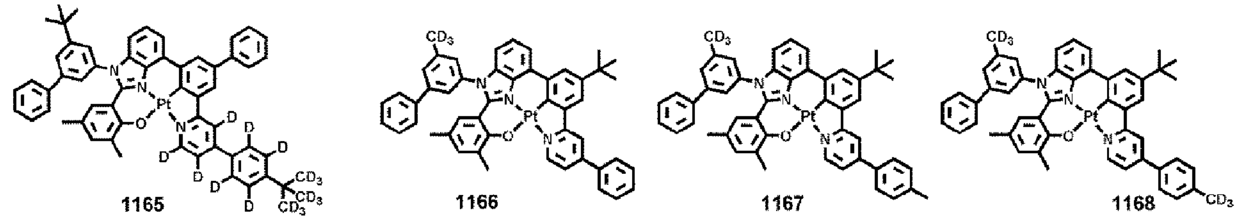

1165 1166 1167 1168

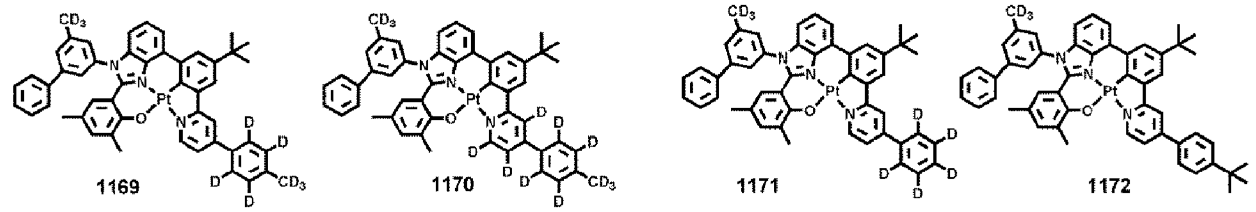

1169 1170 1171 1172

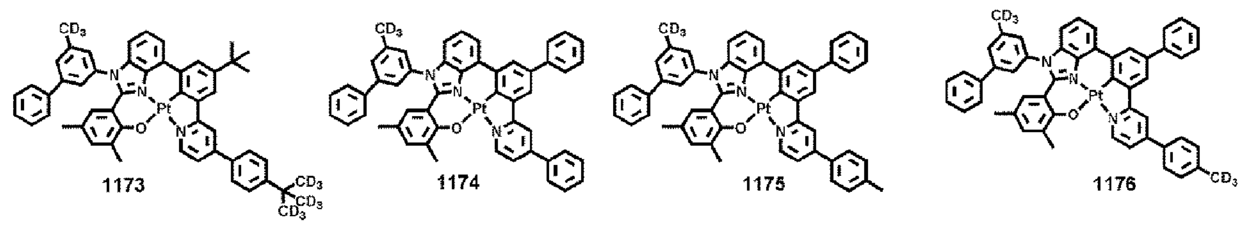

1173 1174 1175 1176

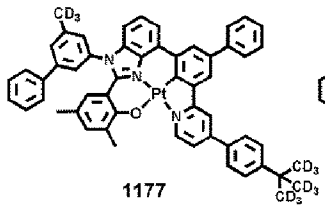
1177

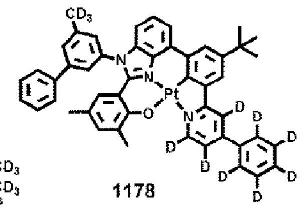
1178

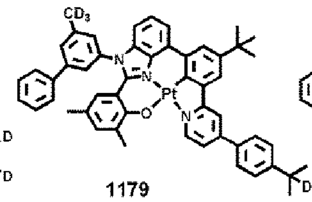
1179

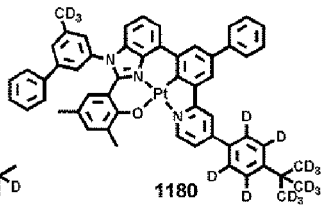
1180

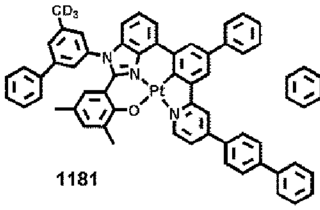
1181

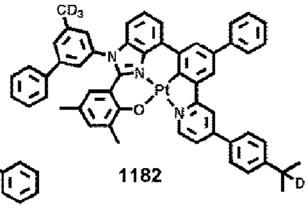
1182

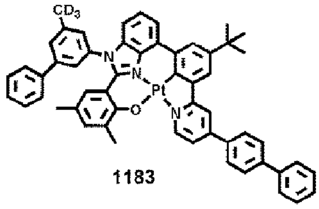
1183

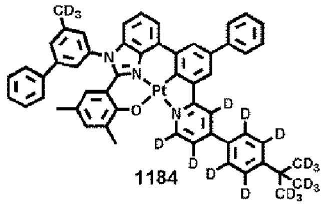
1184

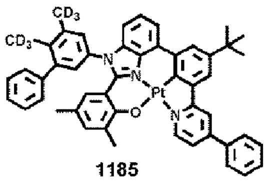
1185

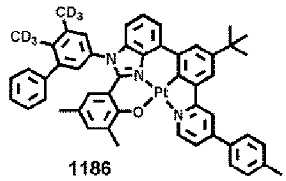
1186

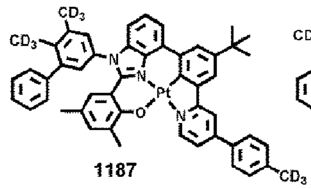
1187

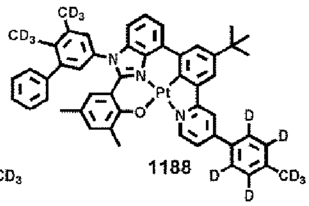
1188

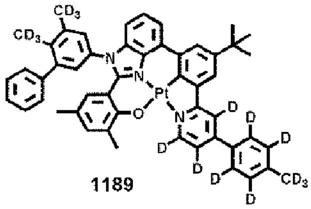
1189

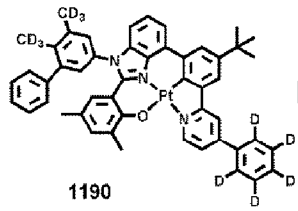
1190

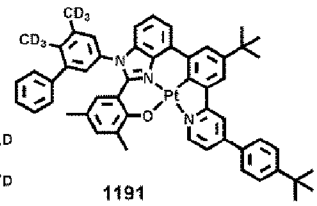
1191

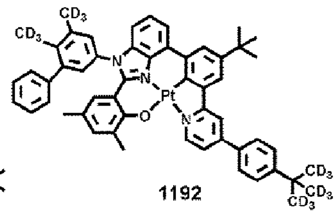
1192

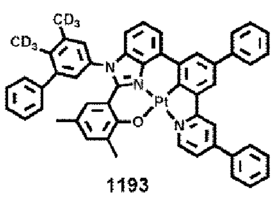
1193

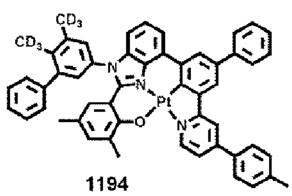
1194

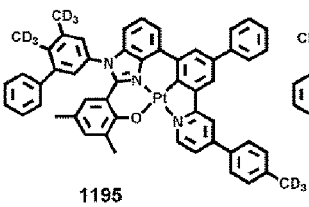
1195

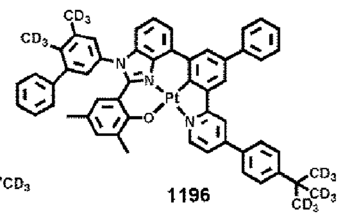
1196

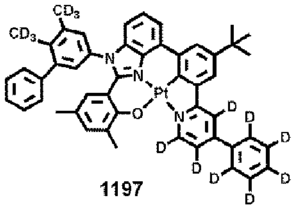
1197

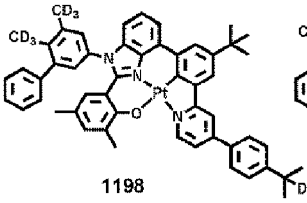
1198

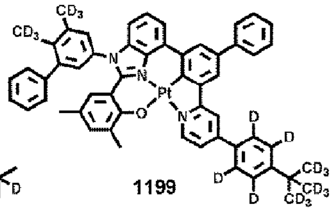
1199

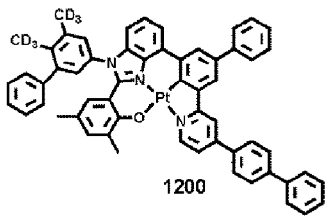
1200

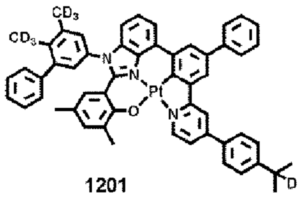
1201

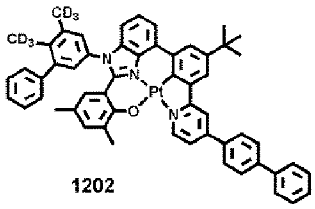
1202

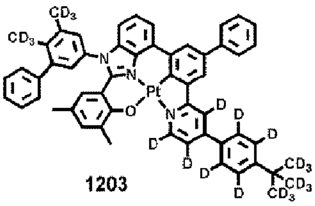
1203

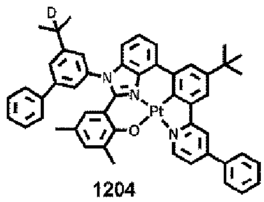
1204

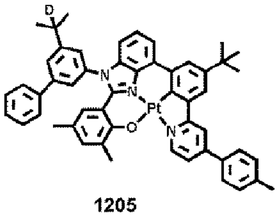
1205

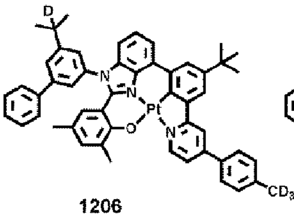
1206

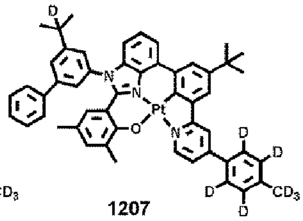
1207

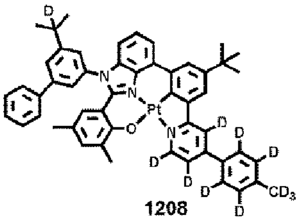
1208

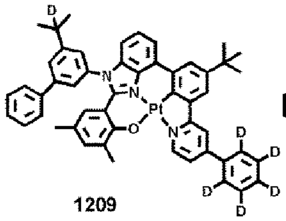
1209

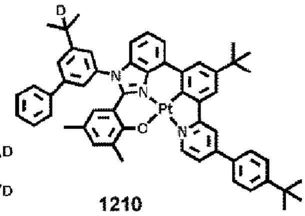
1210

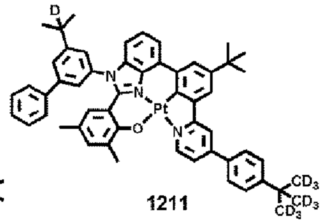
1211

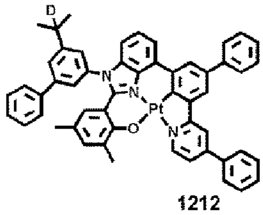
1212

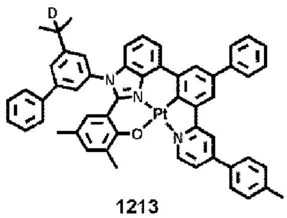
1213

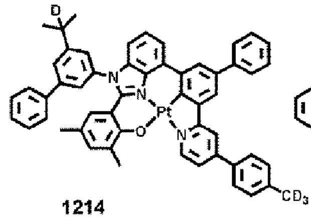
1214

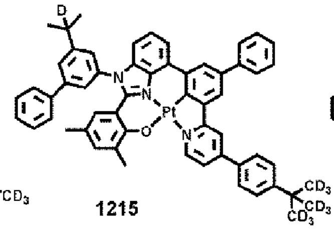
1215

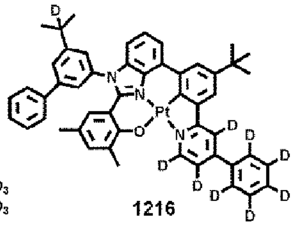
1216

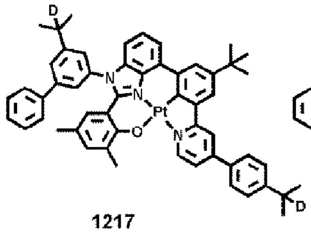
1217

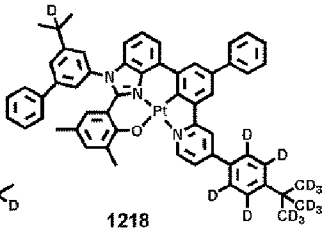
1218

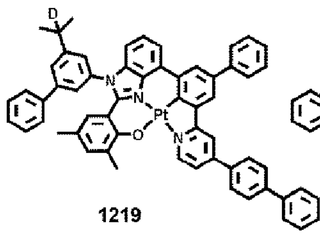
1219

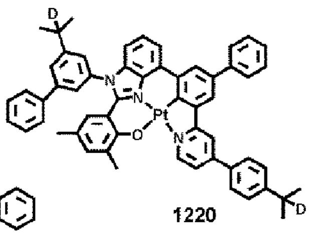
1220

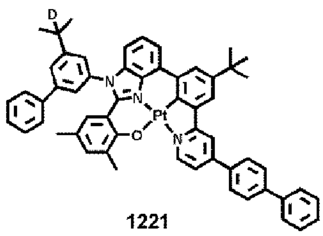
1221

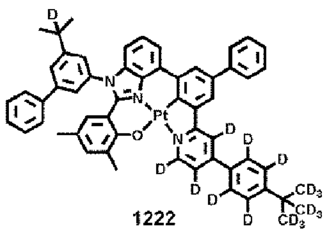
1222

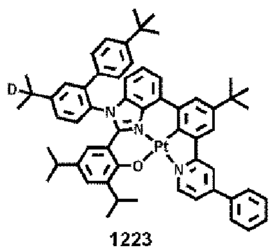
1223

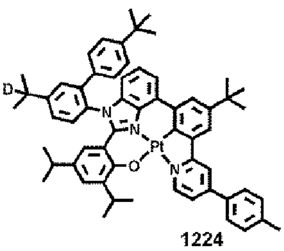
1224

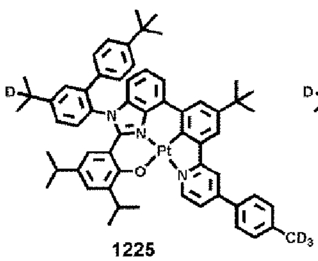
1225
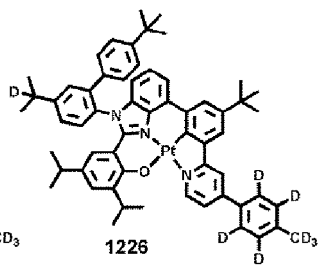
1226
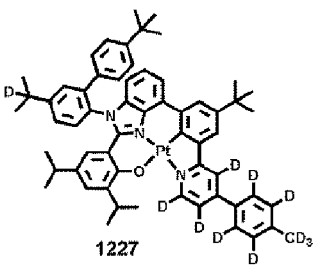
1227
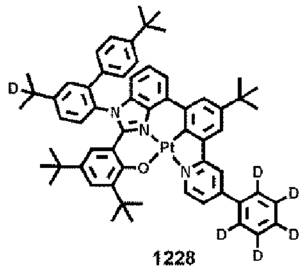
1228

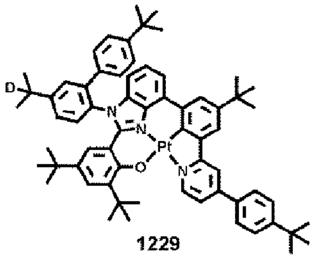
1229
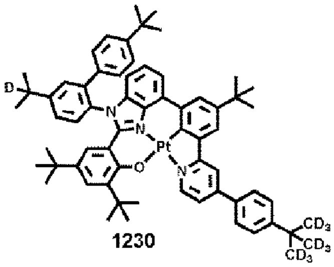
1230
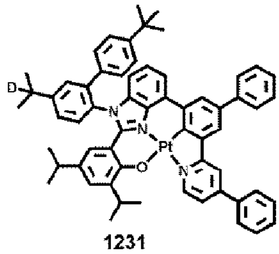
1231
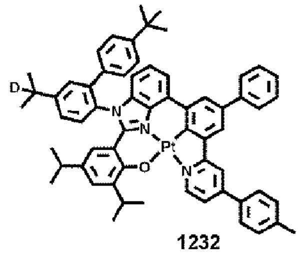
1232

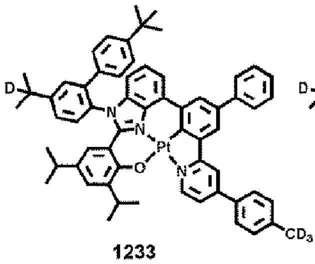
1233
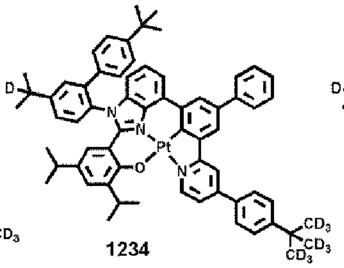
1234
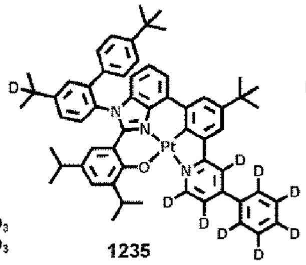
1235
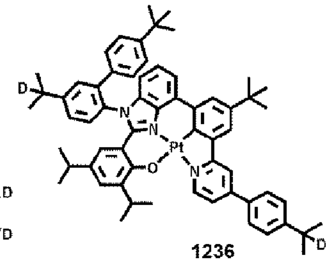
1236

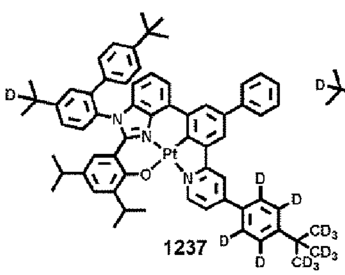
1237
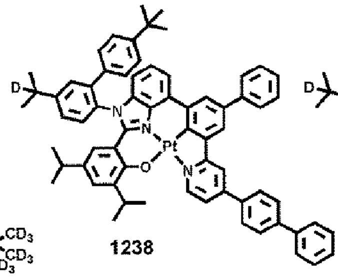
1238
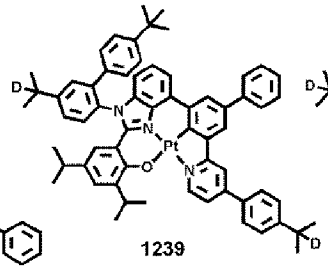
1239
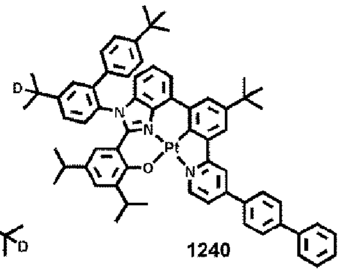
1240

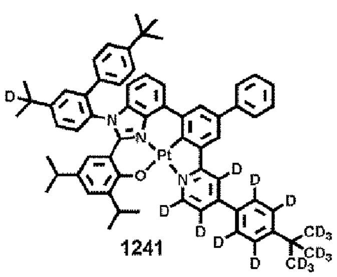
1241
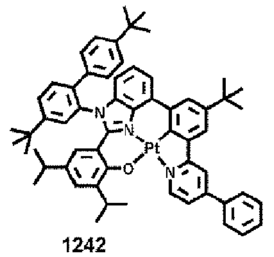
1242
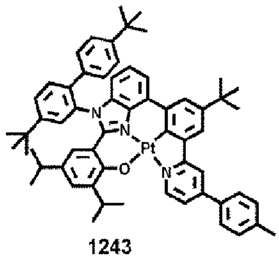
1243
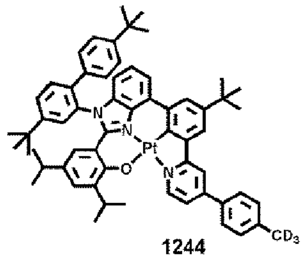
1244

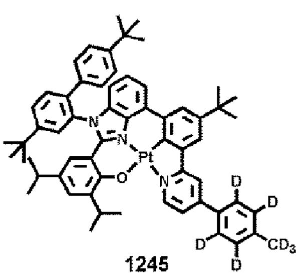
1245
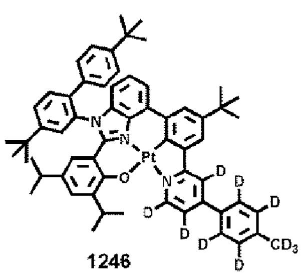
1246
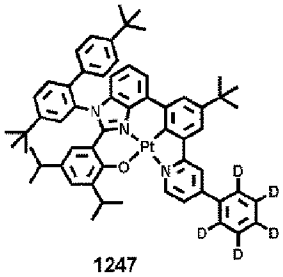
1247
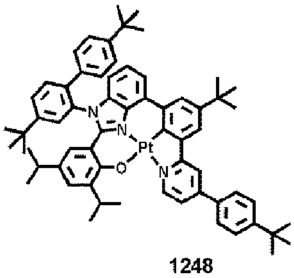
1248

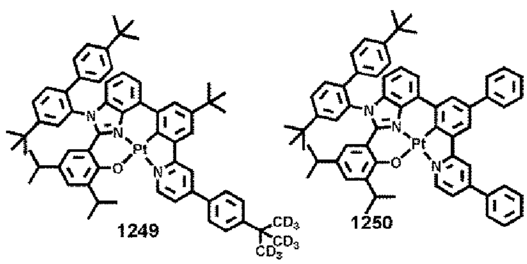

1249 1250

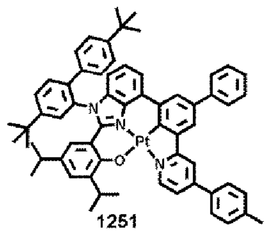

1251

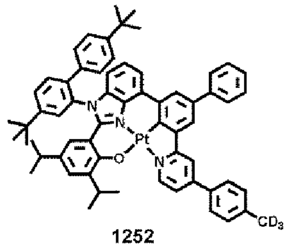

1252

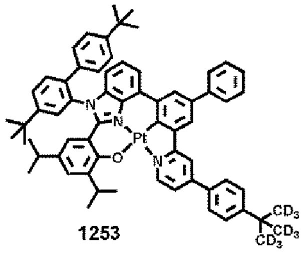

1253

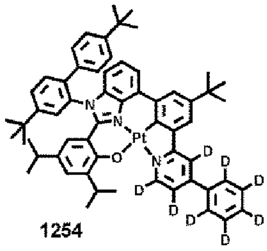

1254

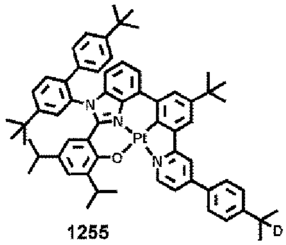

1255

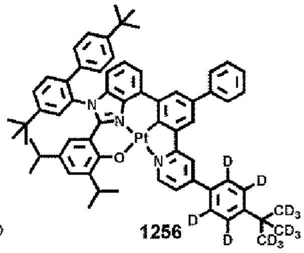

1256

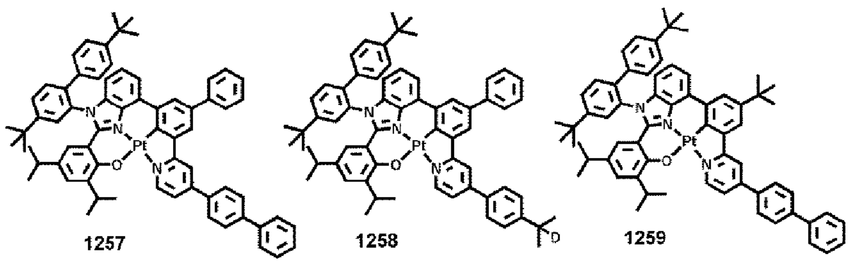

1257 1258 1259

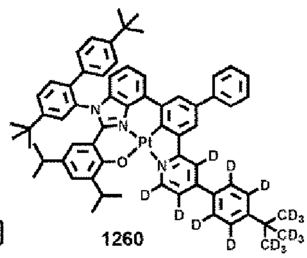

1260

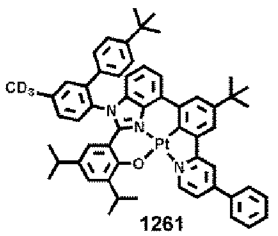

1261

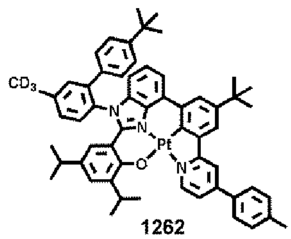

1262

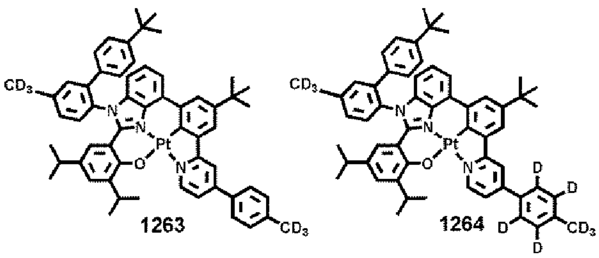

1263 1264

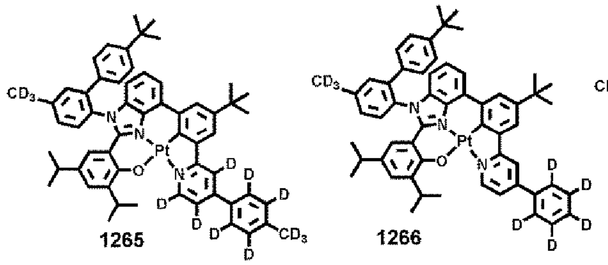

1265 1266

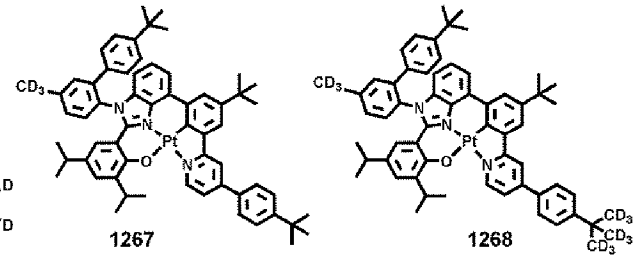

1267 1268

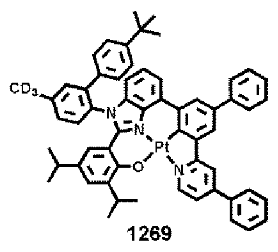

1269

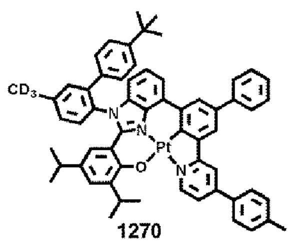

1270

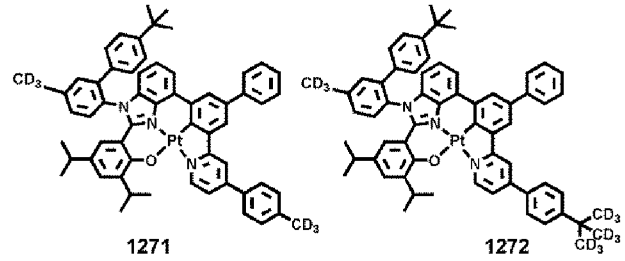

1271 1272

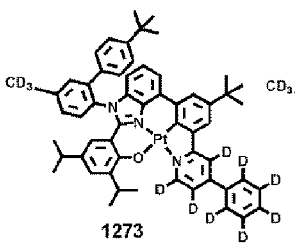
1273

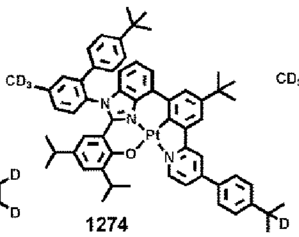
1274

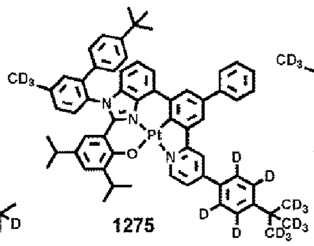
1275

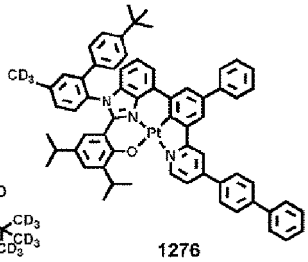
1276

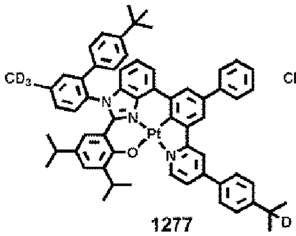
1277

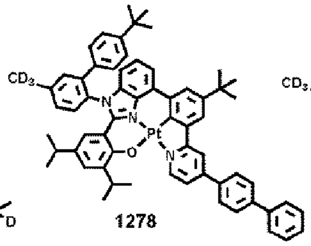
1278

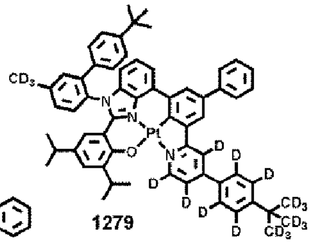
1279

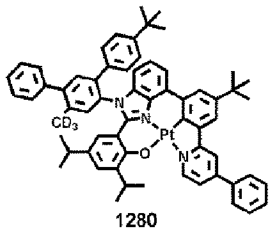
1280

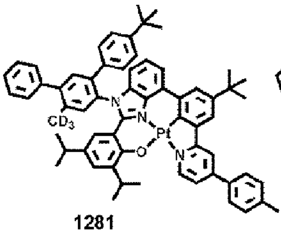
1281

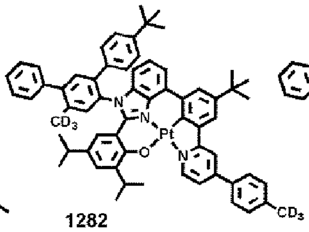
1282

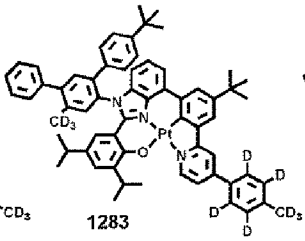
1283

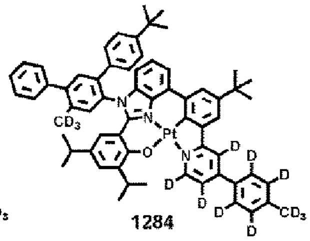
1284

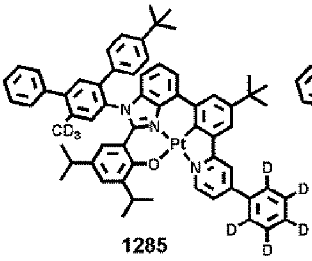
1285

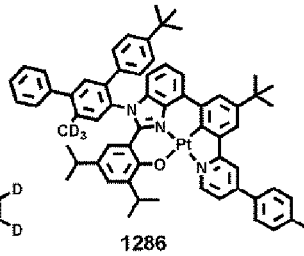
1286

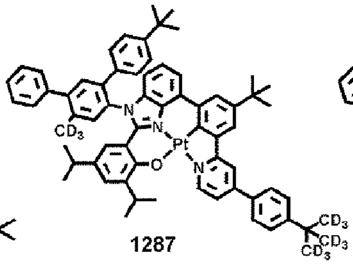
1287

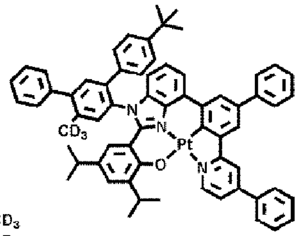
1288

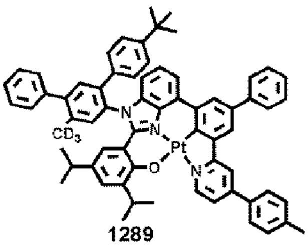
1289

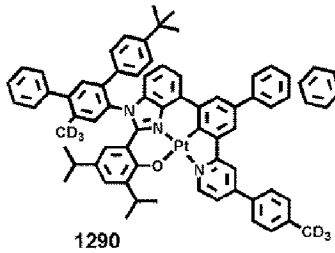
1290

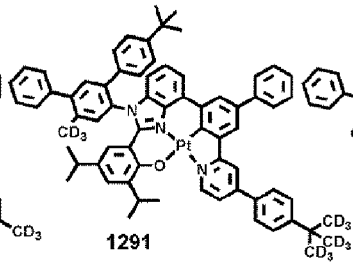
1291

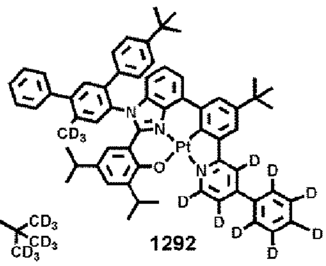
1292

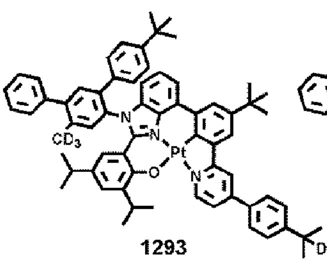
1293

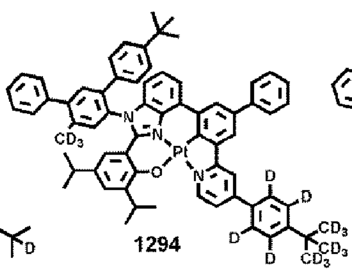
1294

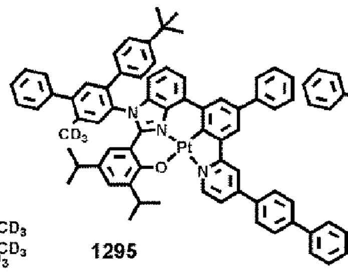
1295

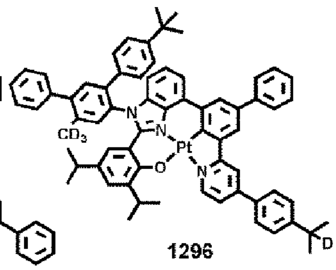
1296

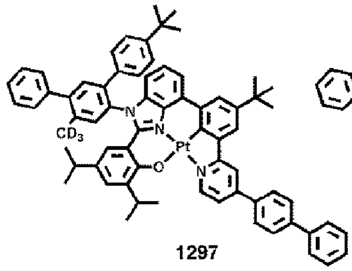
1297

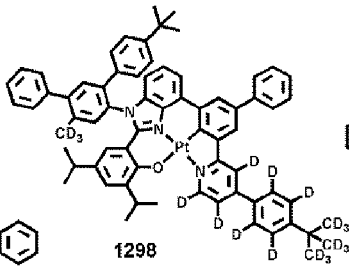
1298

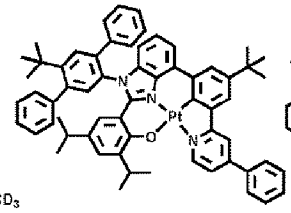
1299

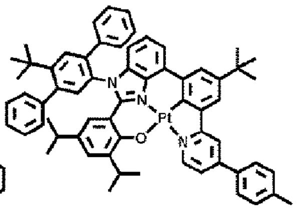
1300

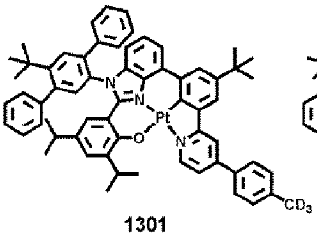
1301

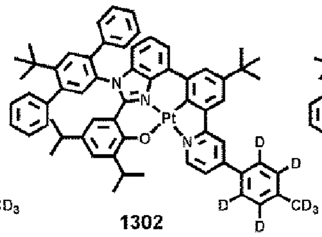
1302

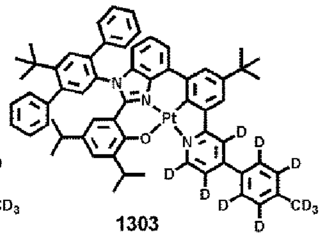
1303

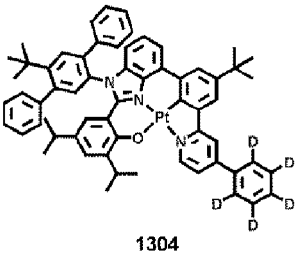
1304

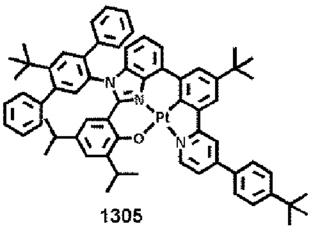
1305

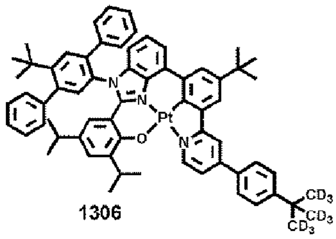
1306

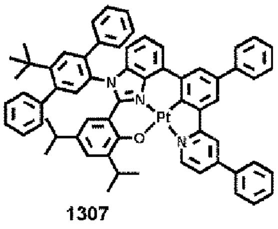
1307

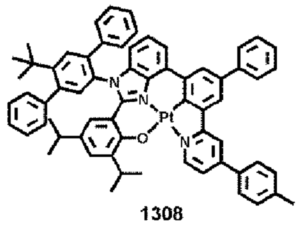
1308

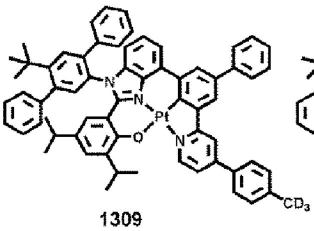
1309

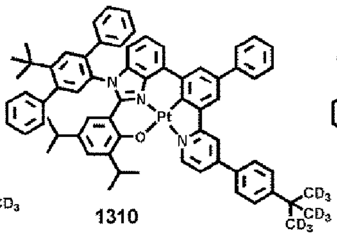
1310

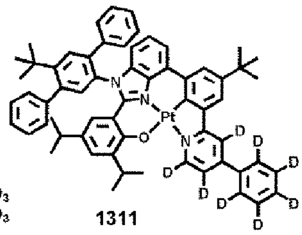
1311

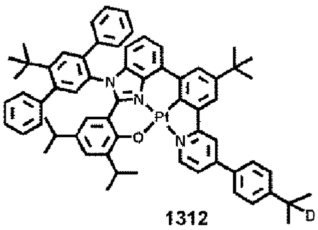
1312

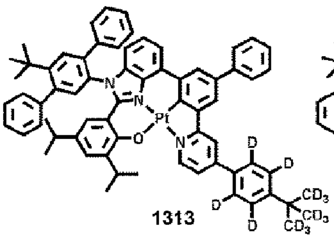
1313

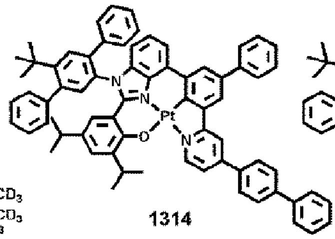
1314

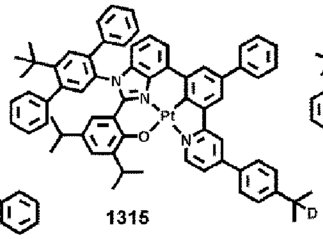
1315

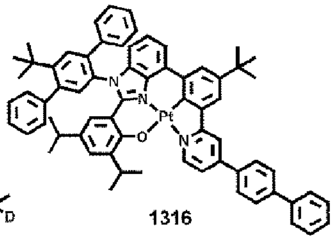
1316

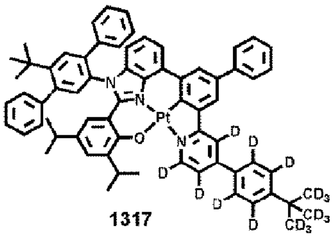
1317

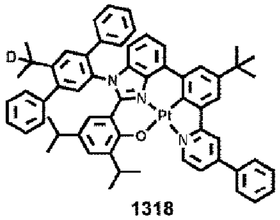
1318

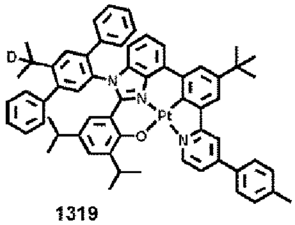
1319

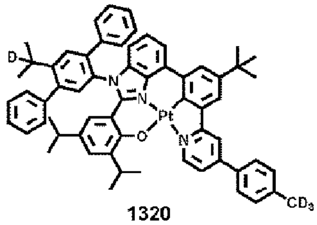
1320

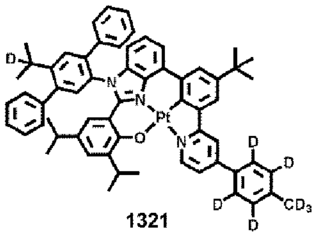
1321

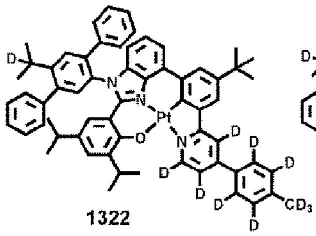
1322

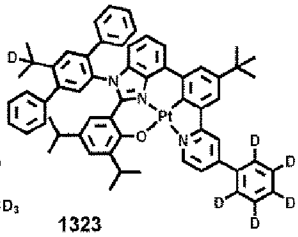
1323

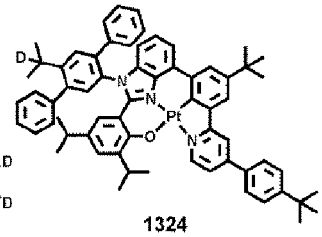
1324

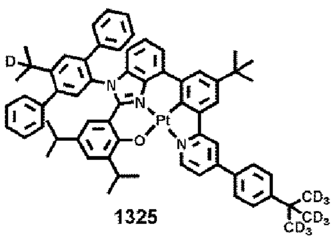
1325

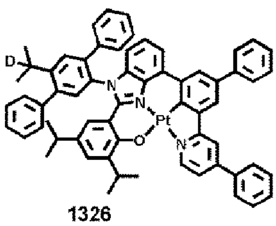
1326

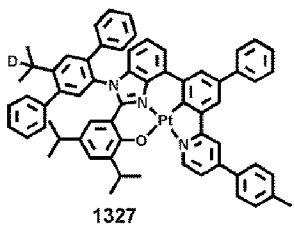
1327

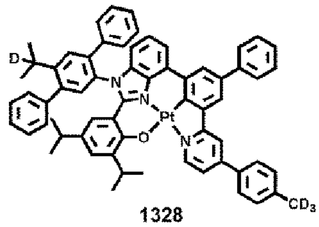
1328

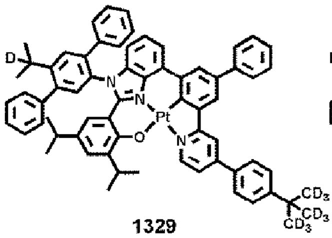
1329

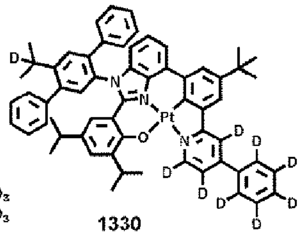
1330

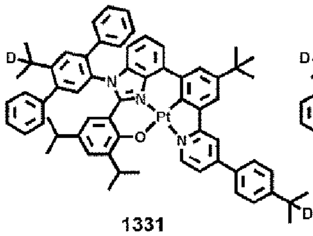
1331

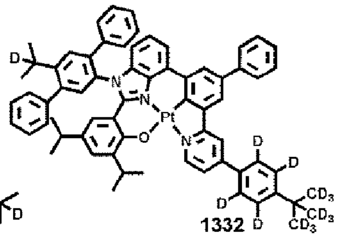
1332

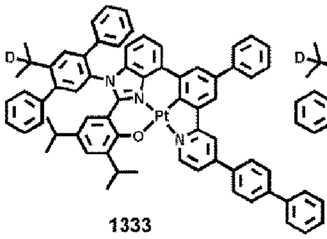
1333

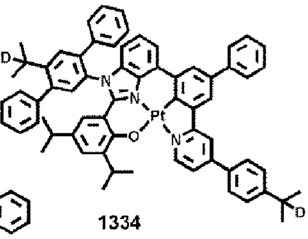
1334

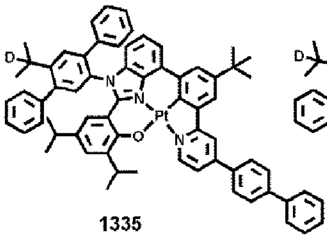
1335

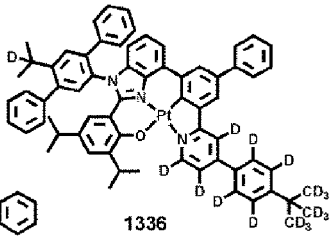
1336

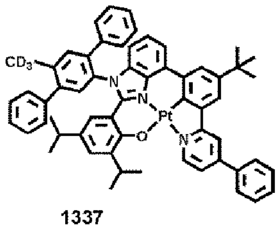
1337

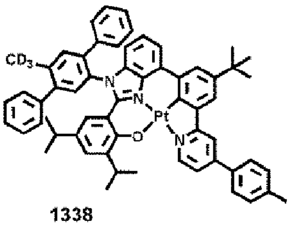
1338

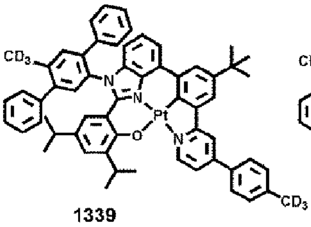
1339

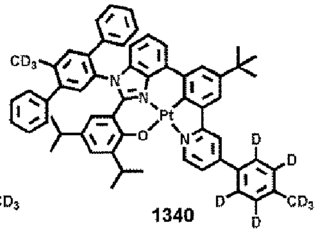
1340

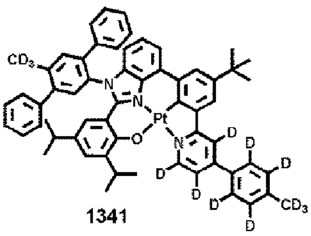
1341

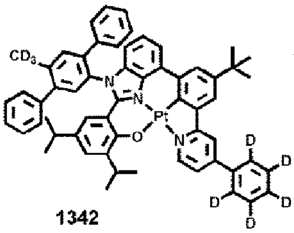
1342

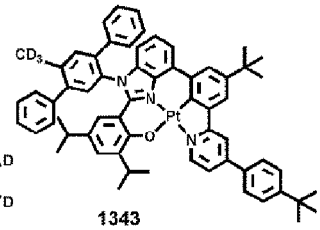
1343

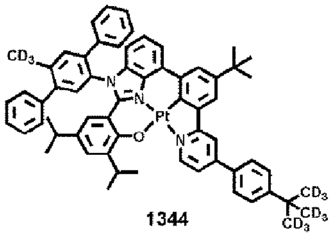
1344

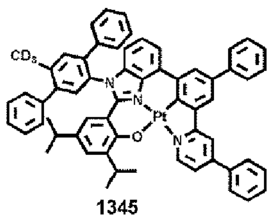
1345

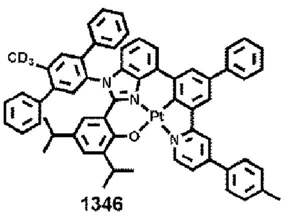
1346

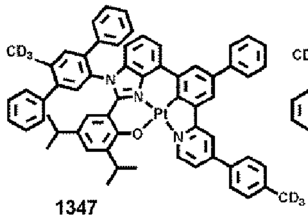
1347

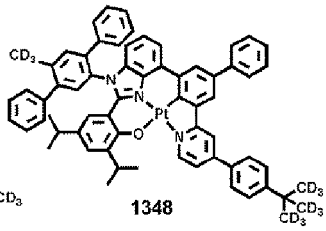
1348

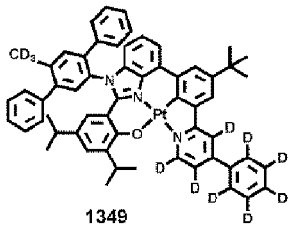
1349

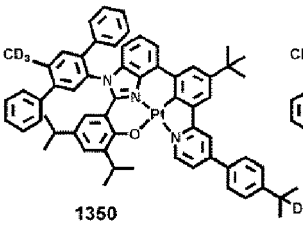
1350

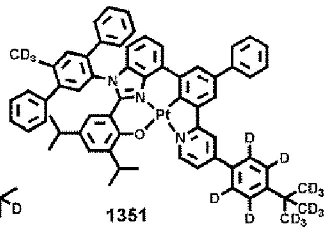
1351

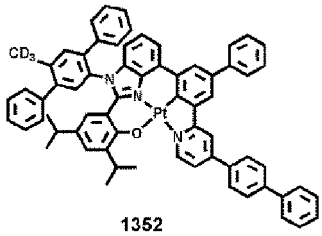
1352

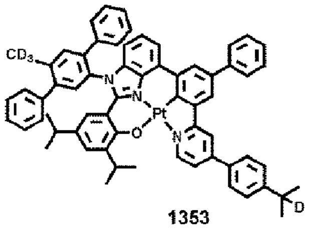
1353

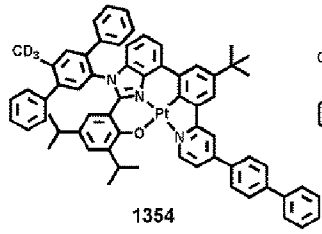
1354

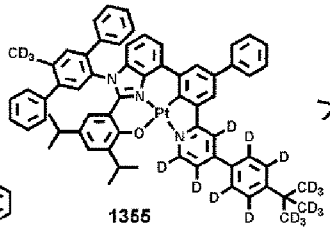
1355

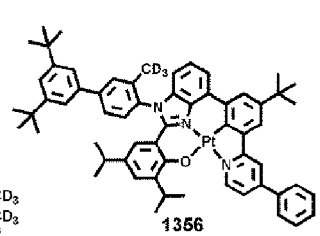
1356

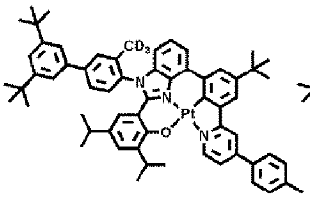
1357

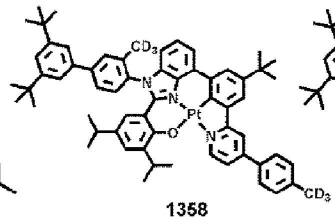
1358

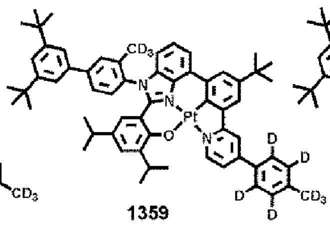
1359

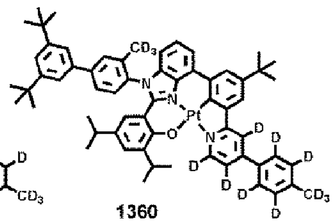
1360

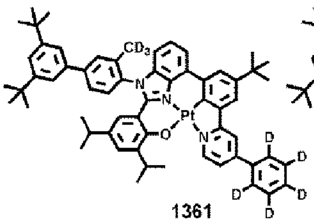
1361

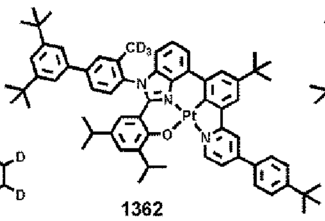
1362

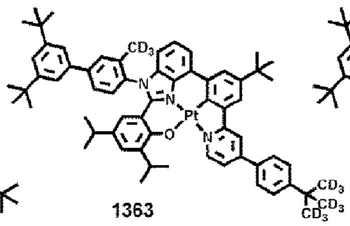
1363

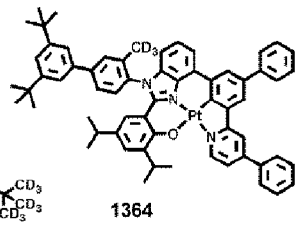
1364

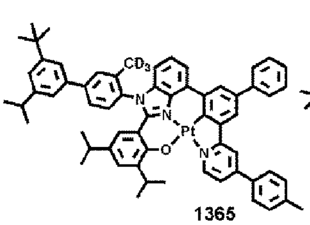
1365

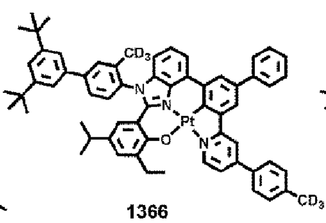
1366

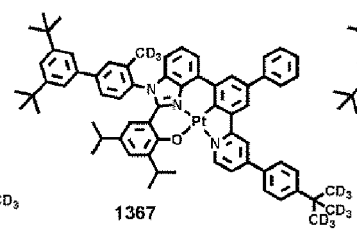
1367

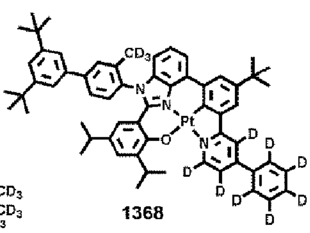
1368

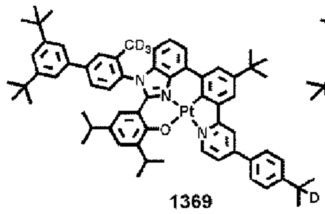
1369
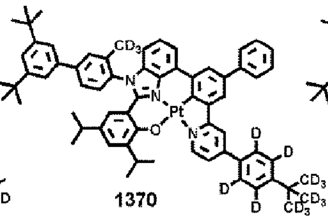
1370
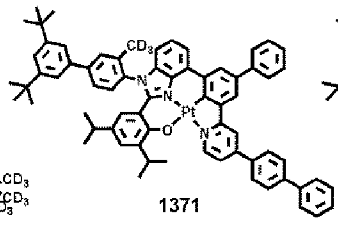
1371
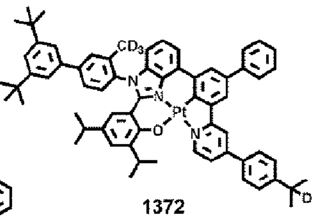
1372

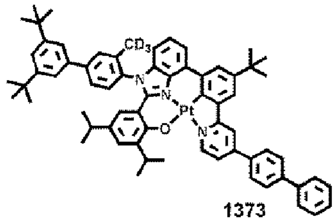
1373
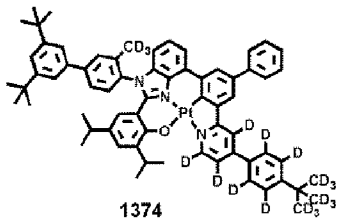
1374
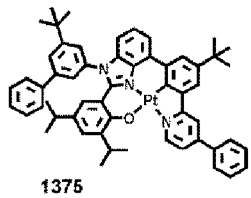
1375
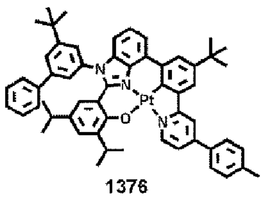
1376

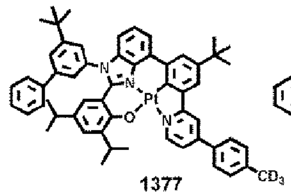
1377
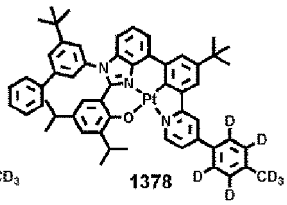
1378
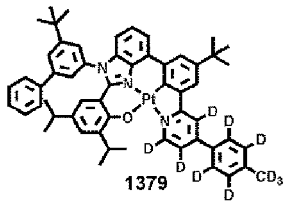
1379
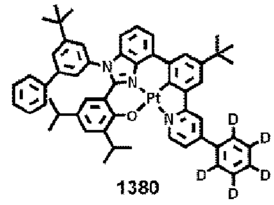
1380

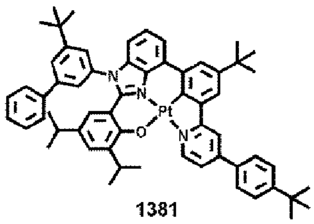
1381
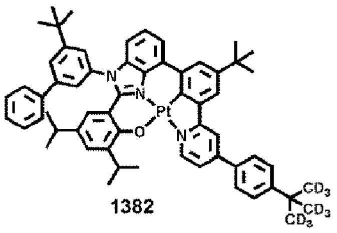
1382
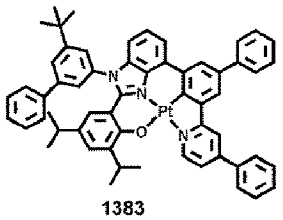
1383
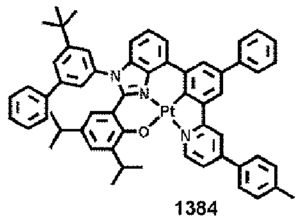
1384

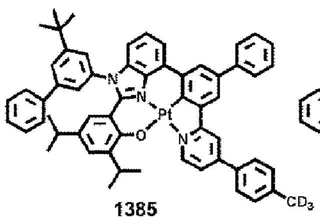
1385
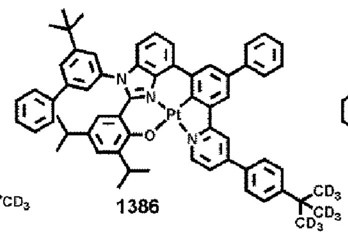
1386
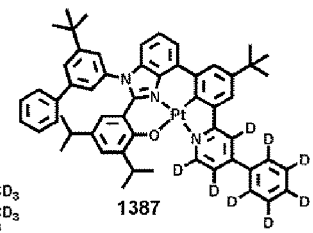
1387
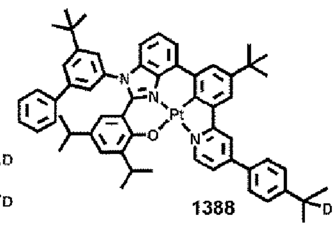
1388

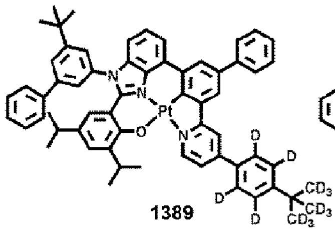
1389
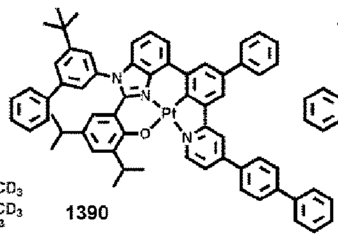
1390
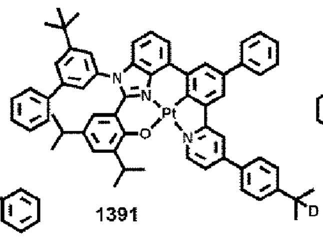
1391
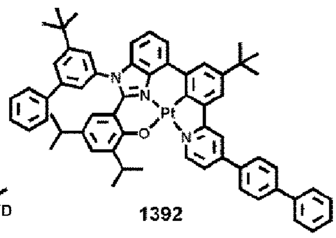
1392

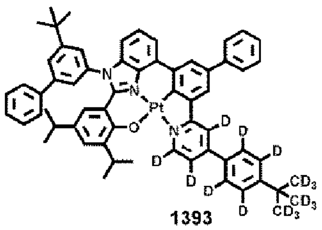
1393

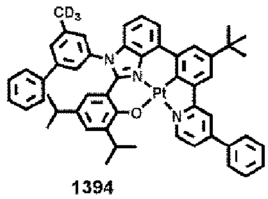
1394

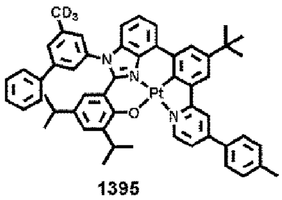
1395

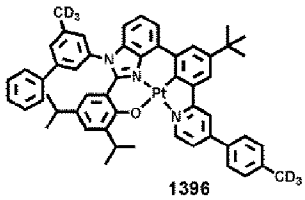
1396

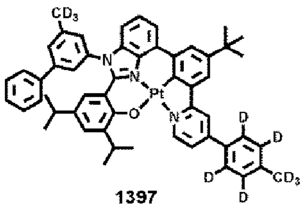
1397

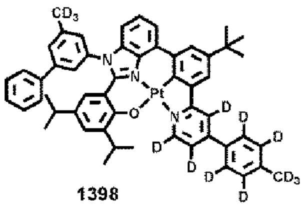
1398

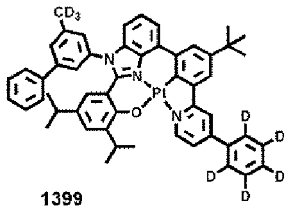
1399

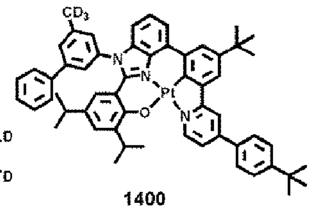
1400

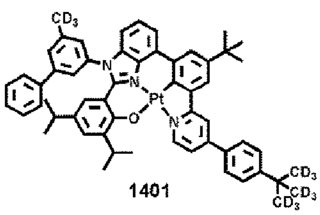
1401

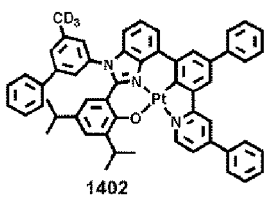
1402

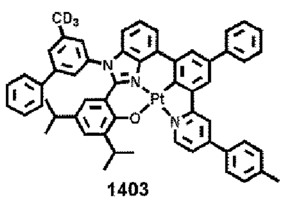
1403

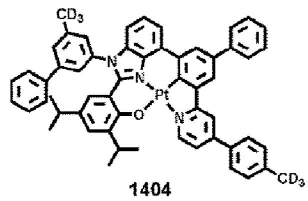
1404

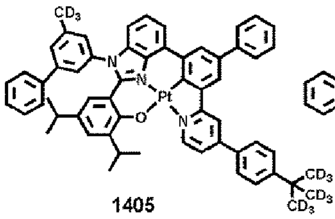
1405

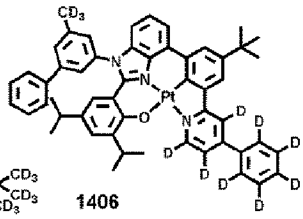
1406

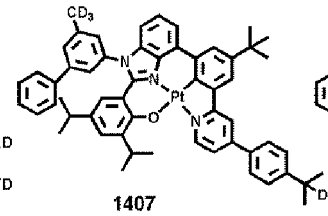
1407

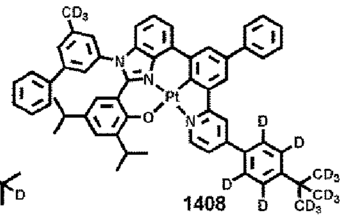
1408

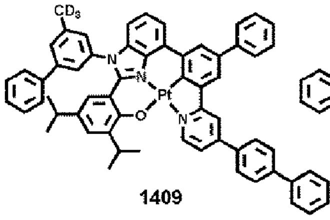
1409

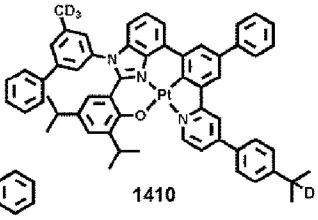
1410

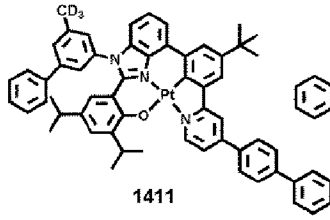
1411

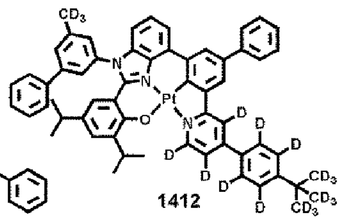
1412

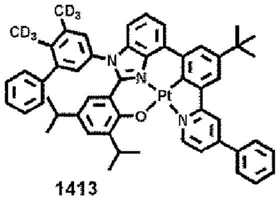
1413

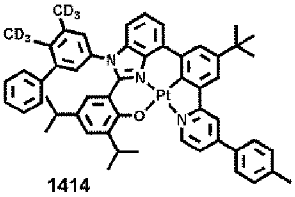
1414

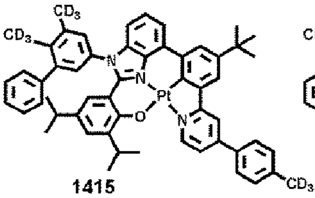
1415

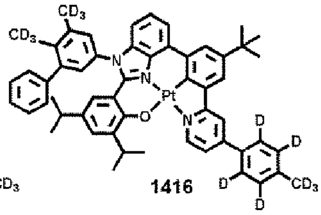
1416

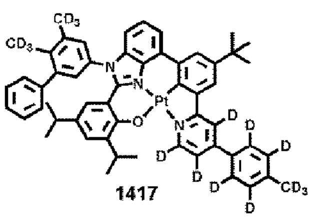
1417

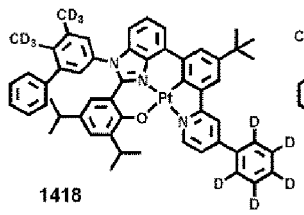
1418

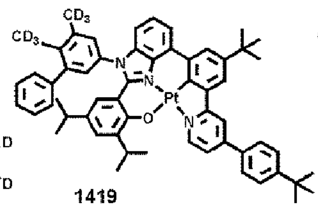
1419

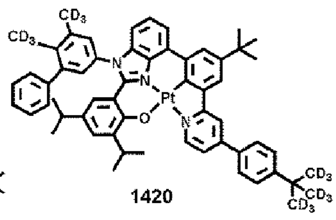
1420

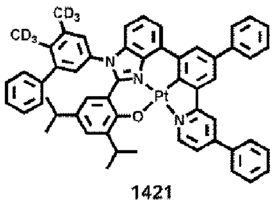
1421

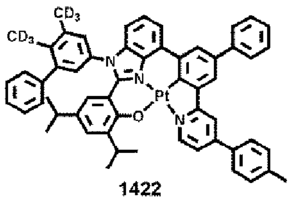
1422

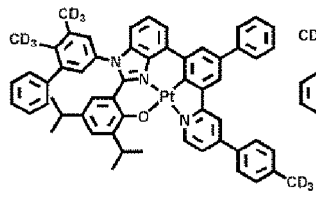
1423

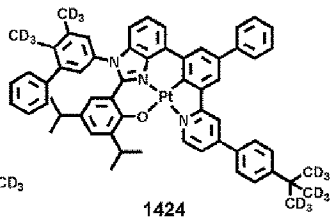
1424

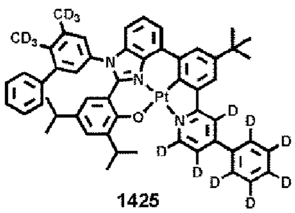
1425

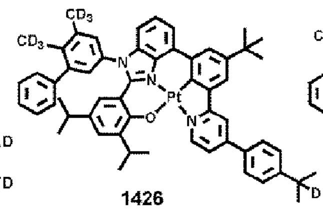
1426

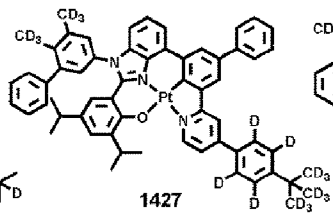
1427

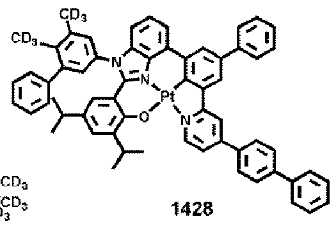
1428

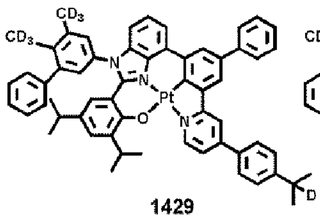
1429

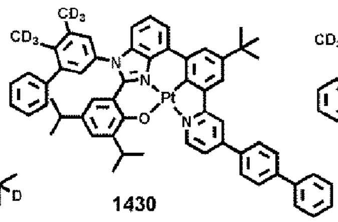
1430

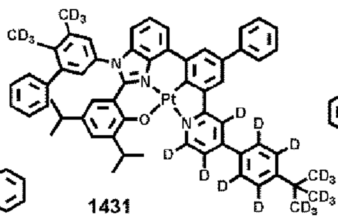
1431

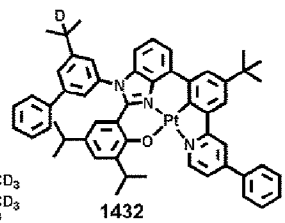
1432

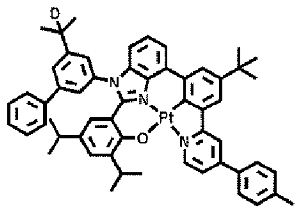
1433

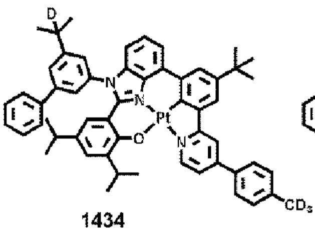
1434

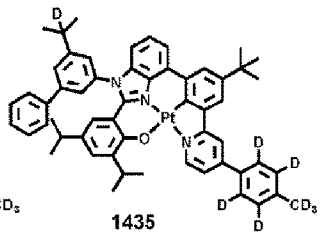
1435

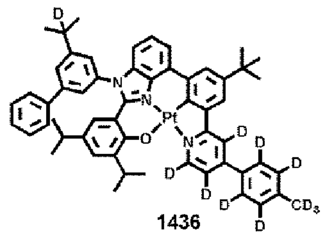
1436

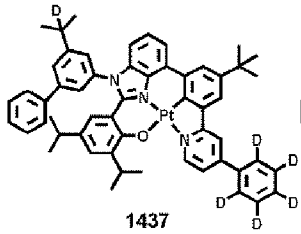
1437

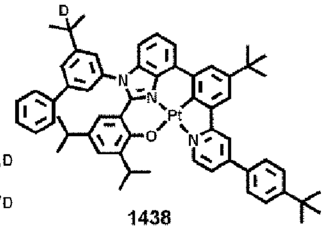
1438

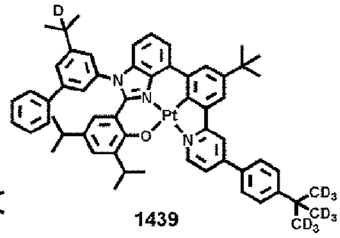
1439

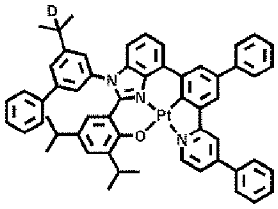
1440

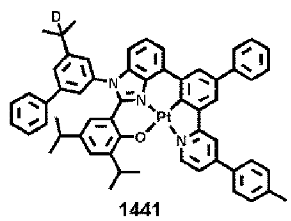

1441

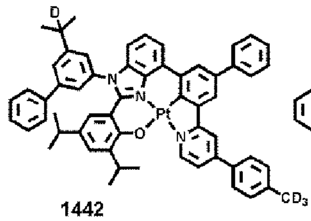

1442

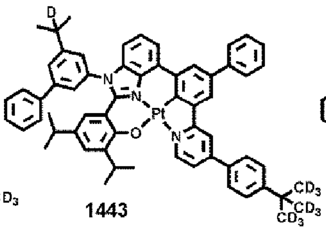

1443

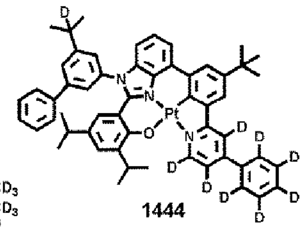

1444

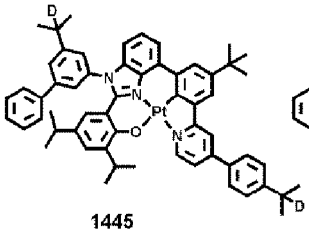

1445

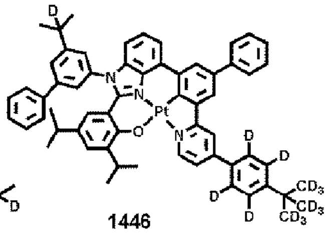

1446

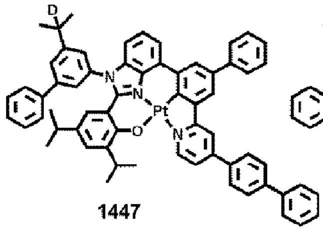

1447

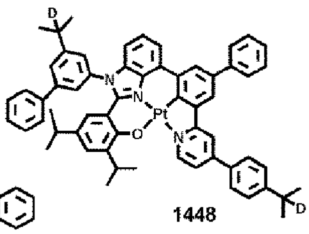

1448

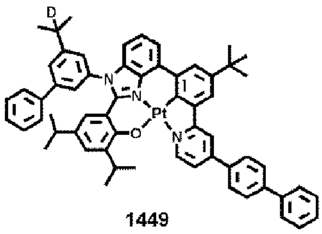

1449

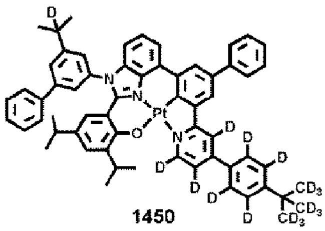

1450

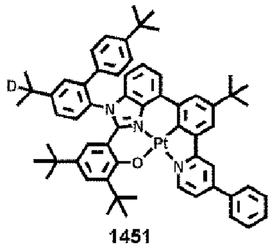

1451

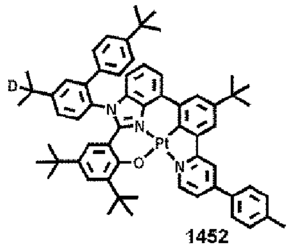

1452

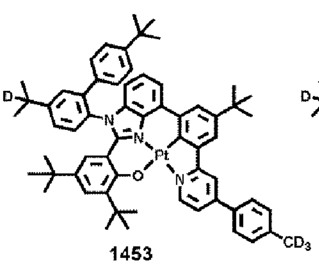

1453

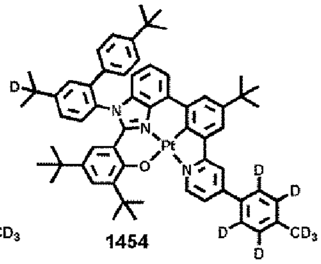

1454

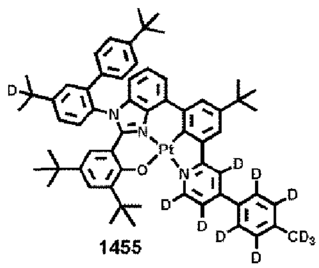

1455

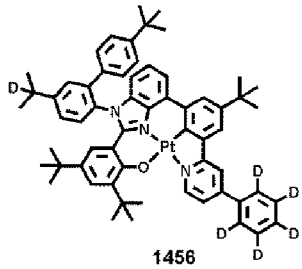

1456

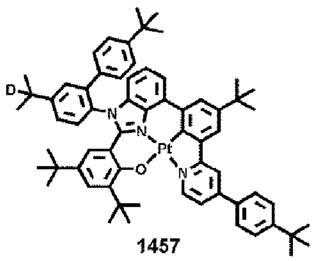

1457

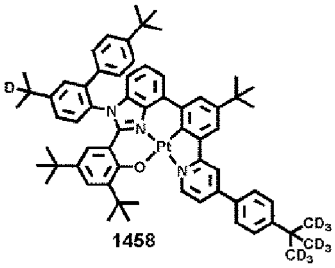

1458

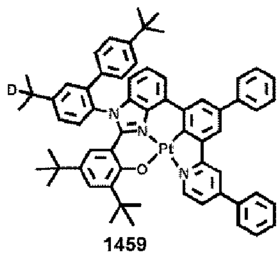

1459

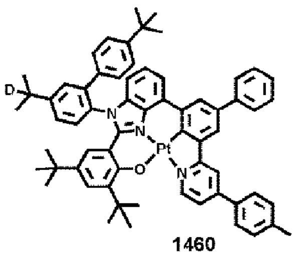

1460

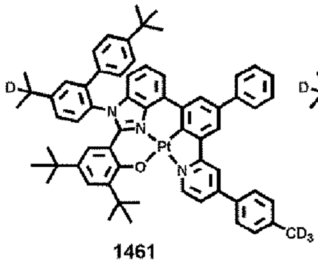

1461

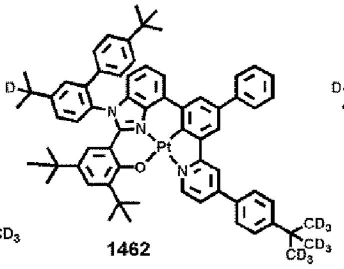

1462

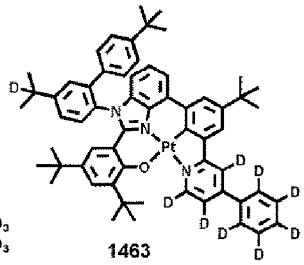

1463

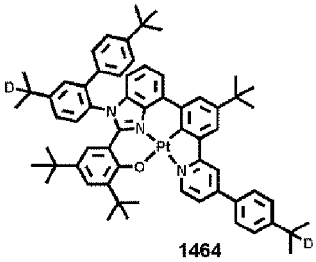

1464

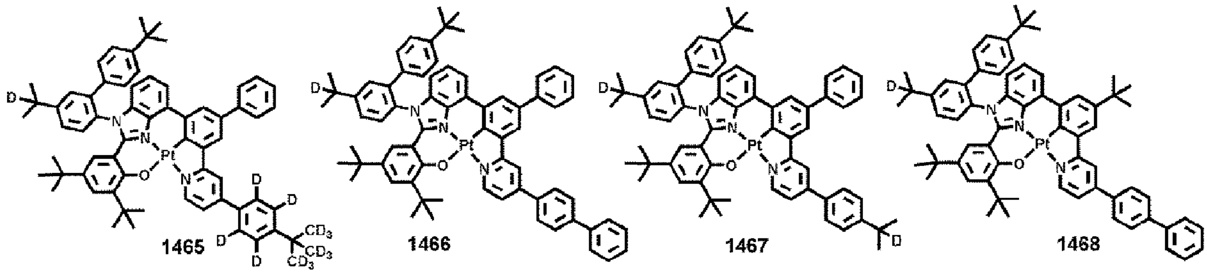

1465 1466 1467 1468

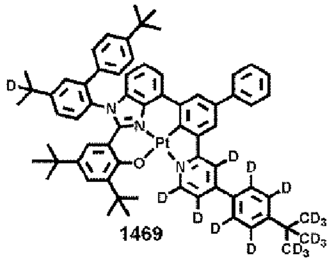

1469

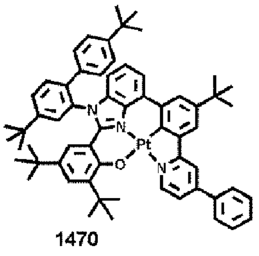

1470

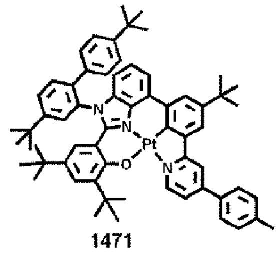

1471

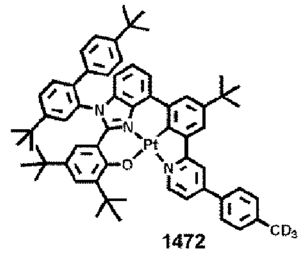

1472

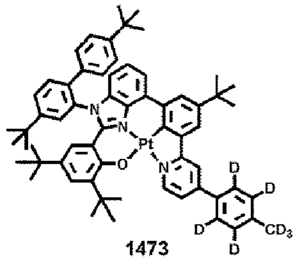

1473

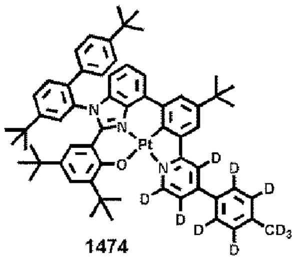

1474

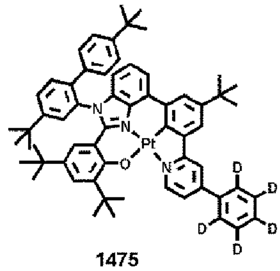

1475

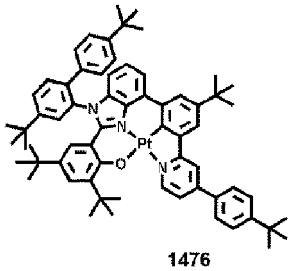

1476

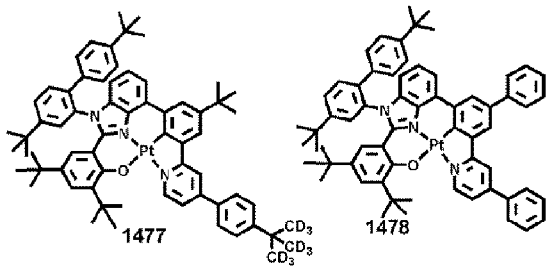

1477 1478

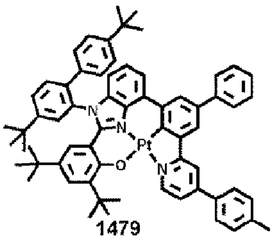

1479

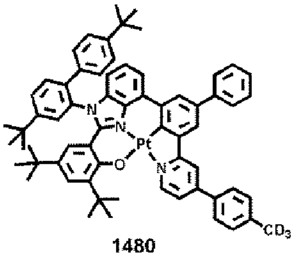

1480

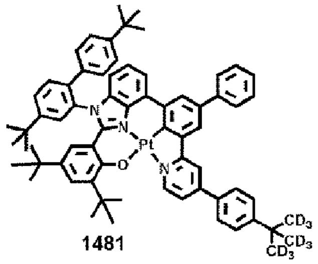

1481

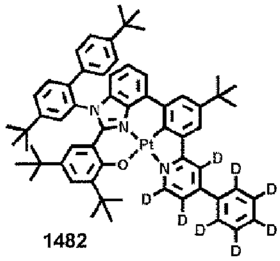

1482

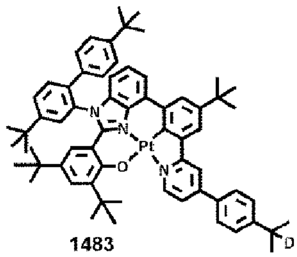

1483

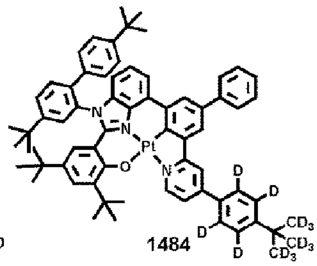

1484

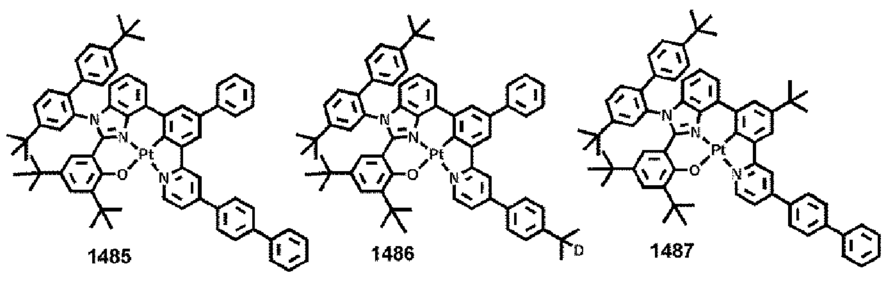

1485 1486 1487

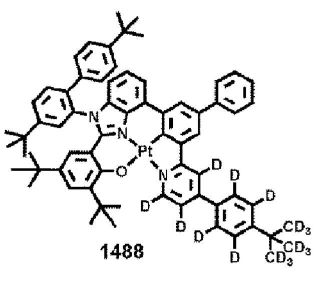

1488

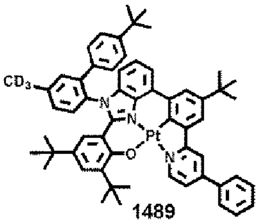
1489

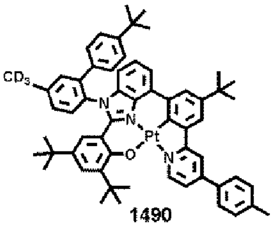
1490

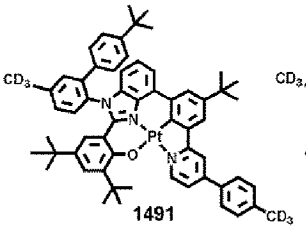
1491

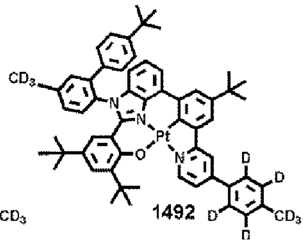
1492

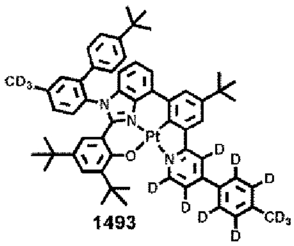
1493

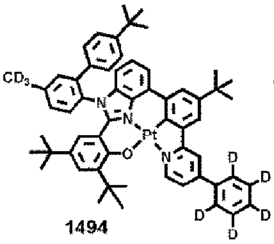
1494

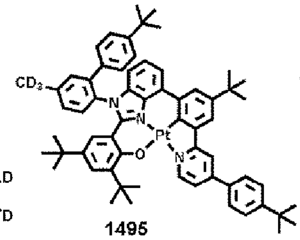
1495

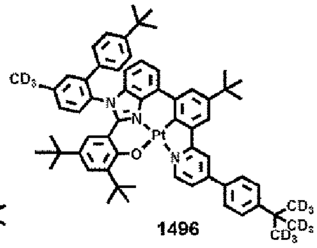
1496

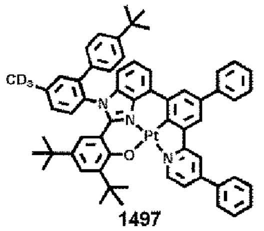
1497

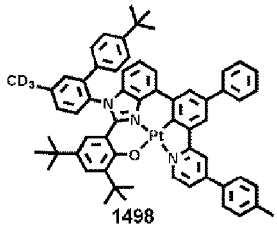
1498

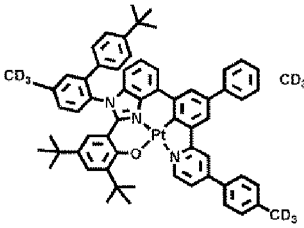
1499

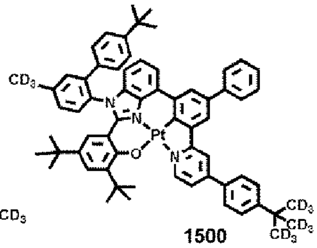
1500

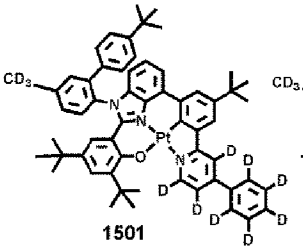
1501

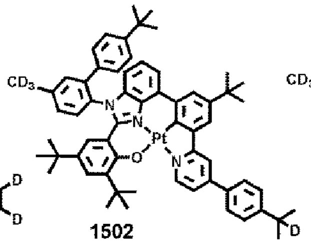
1502

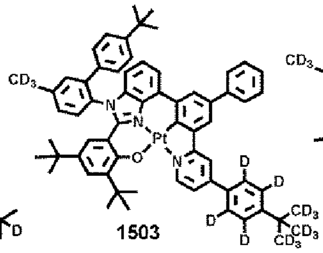
1503

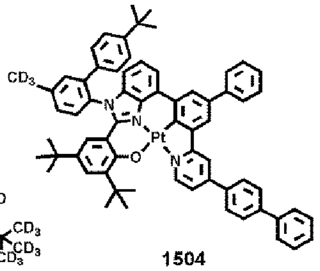
1504

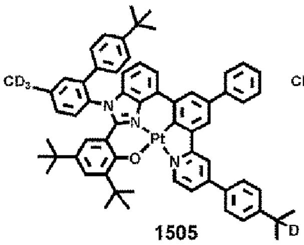
1505

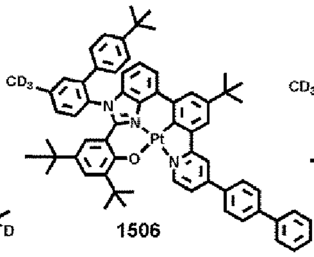
1506

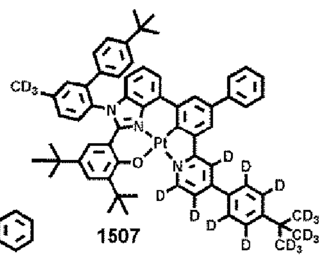
1507

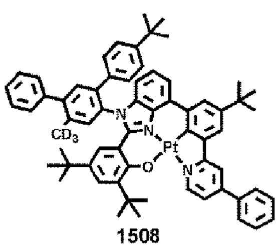
1508

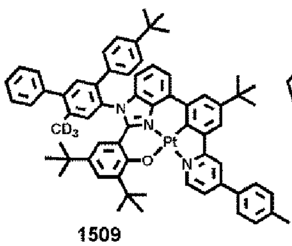
1509

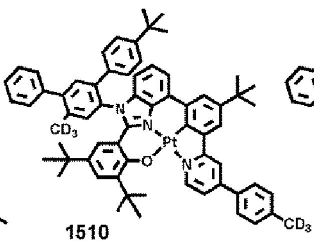
1510

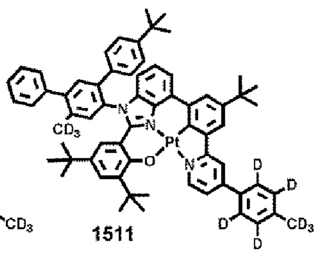
1511

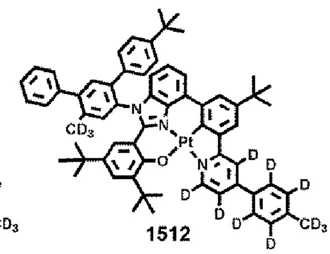
1512

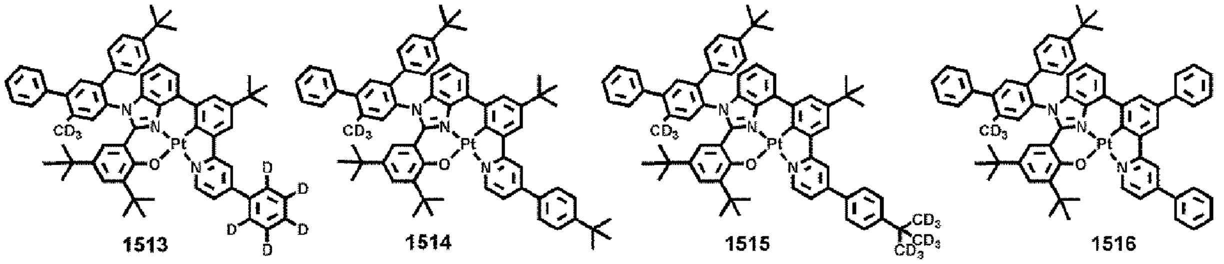

1513 1514 1515 1516

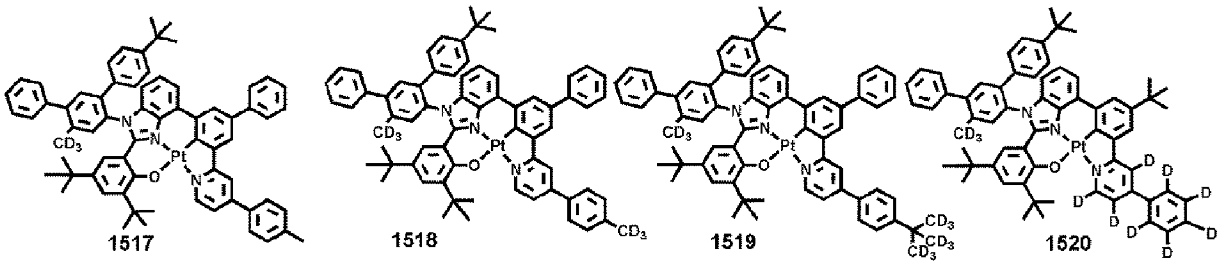

1517 1518 1519 1520

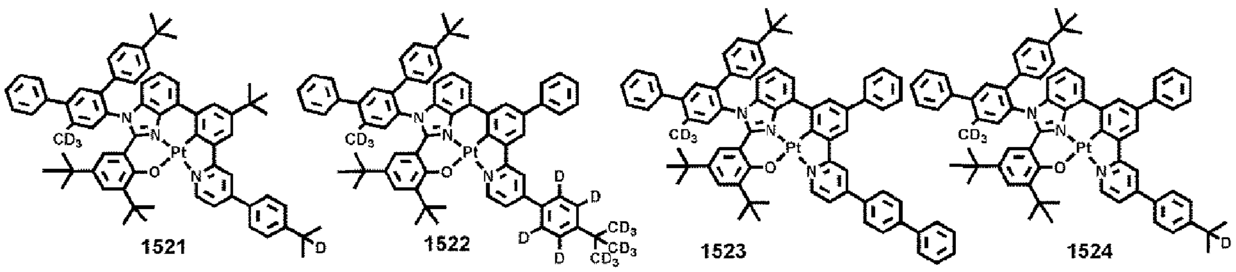

1521 1522 1523 1524

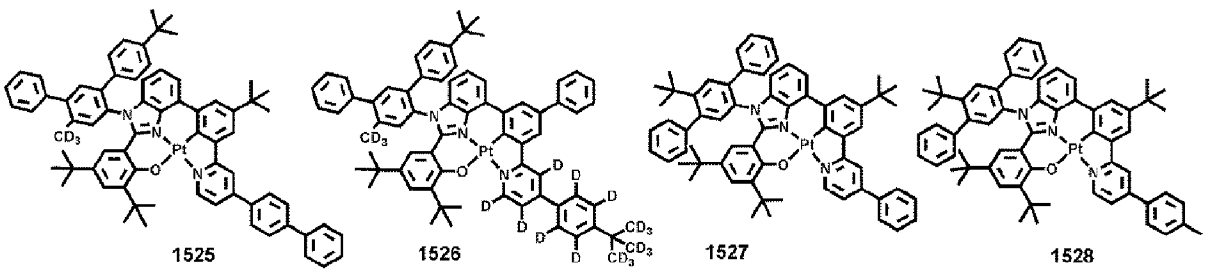

1525 1526 1527 1528

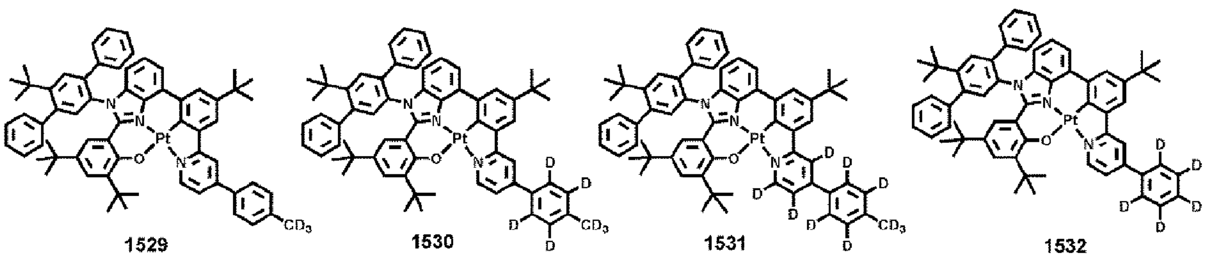

1529 1530 1531 1532

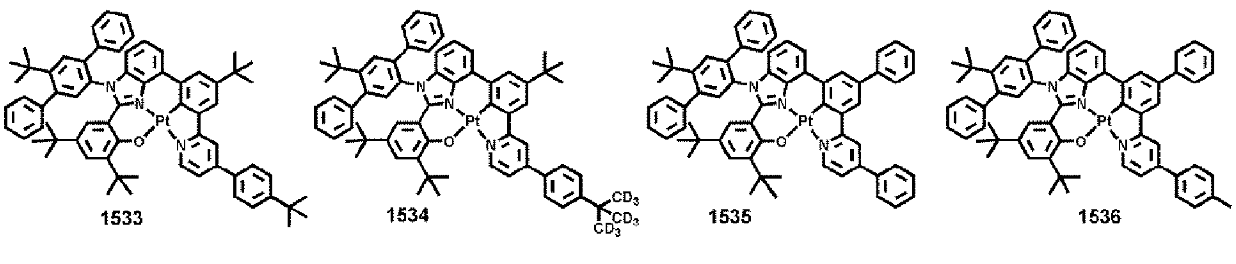

1533 1534 1535 1536

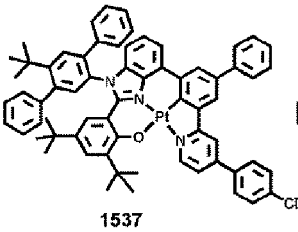
1537

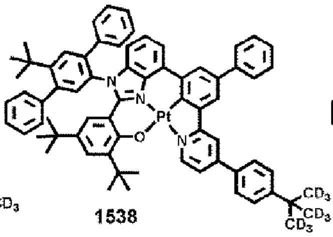
1538

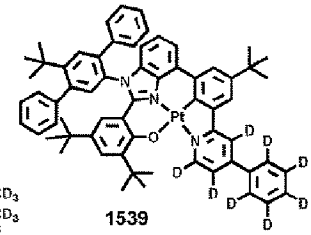
1539

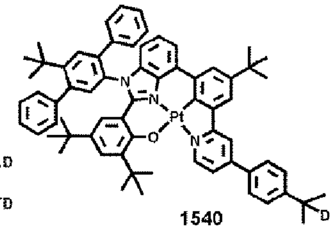
1540

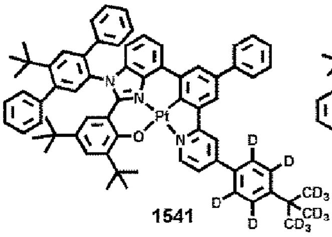
1541

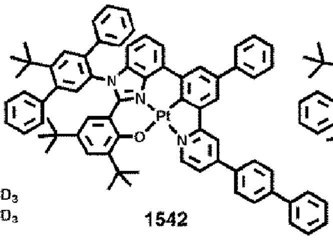
1542

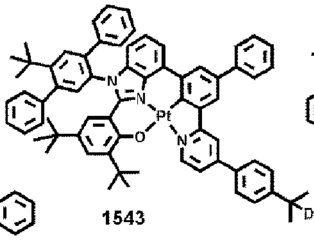
1543

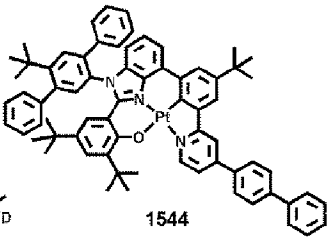
1544

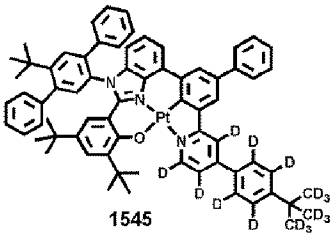
1545

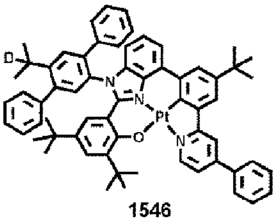
1546

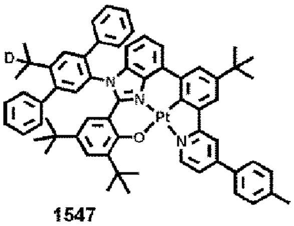
1547

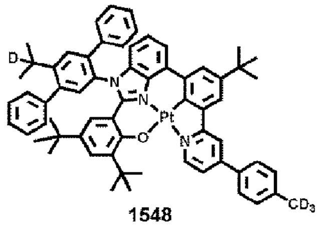
1548

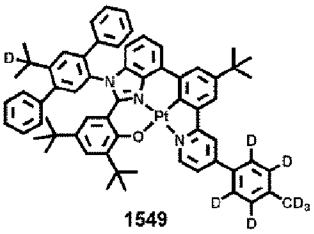
1549

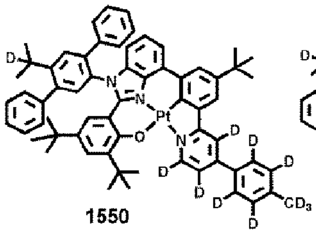
1550

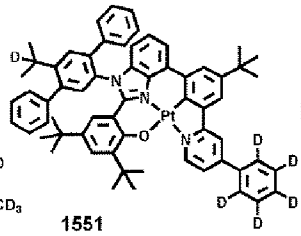
1551

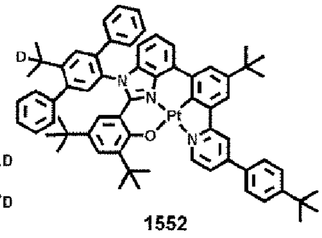
1552

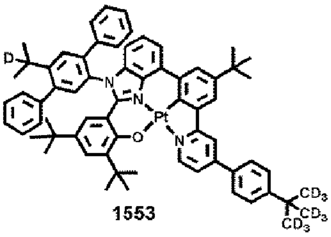
1553

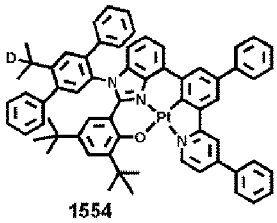
1554

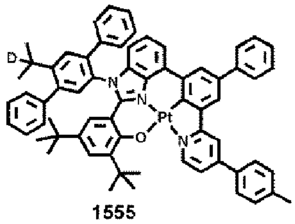
1555

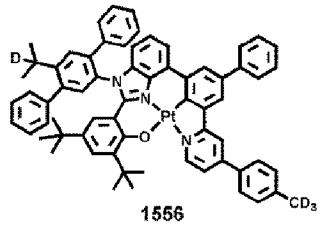
1556

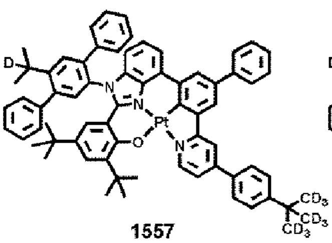
1557

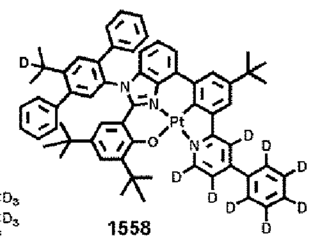
1558

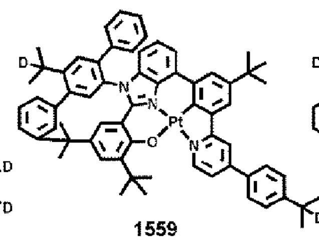
1559

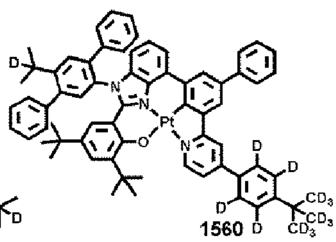
1560

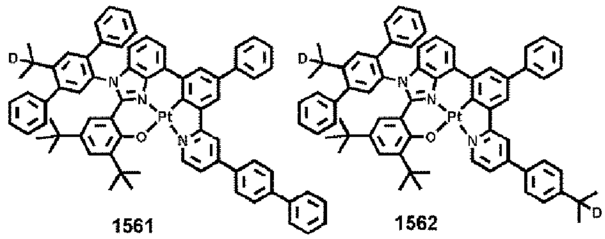

1561

1562

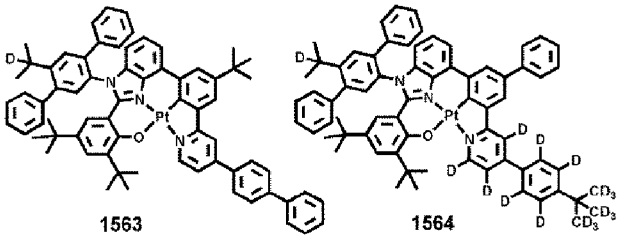

1563

1564

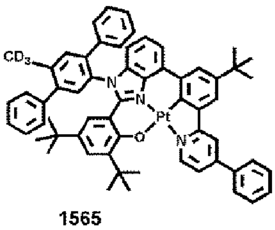

1565

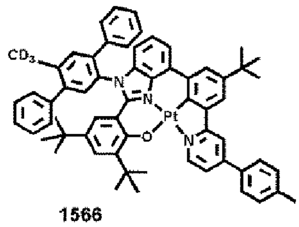

1566

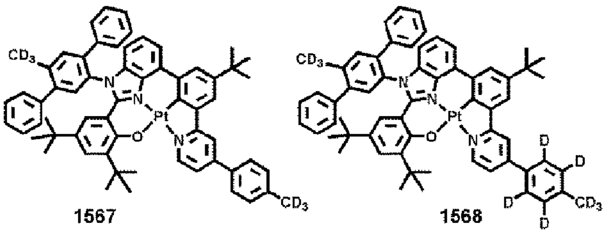

1567

1568

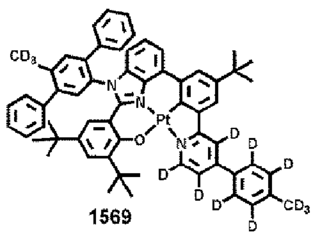

1569

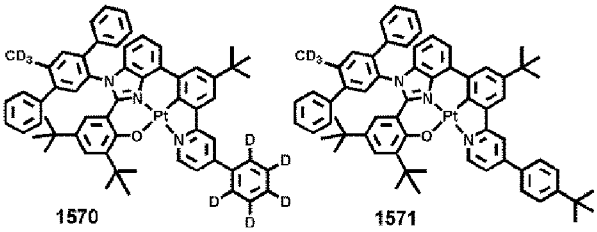

1570

1571

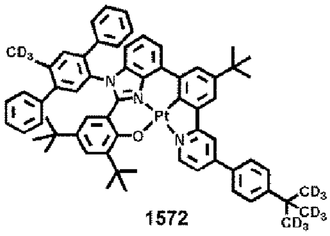

1572

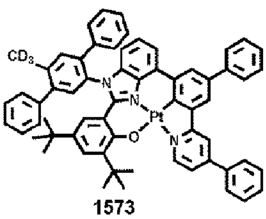

1573

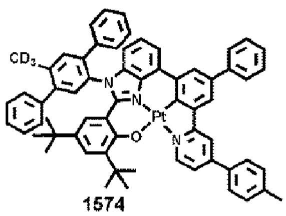

1574

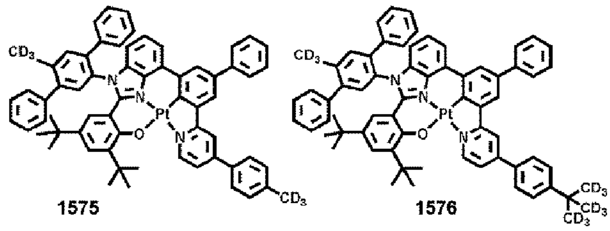

1575

1576

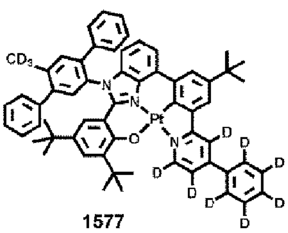

1577

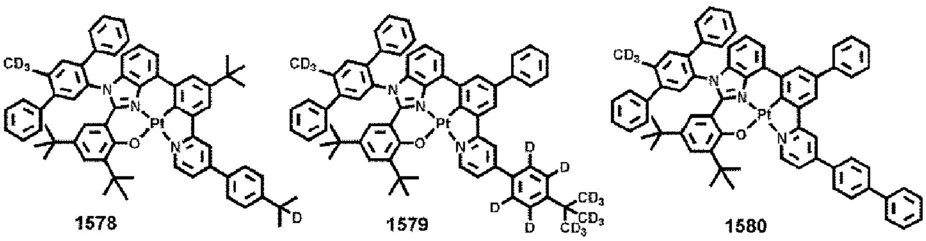

1578

1579

1580

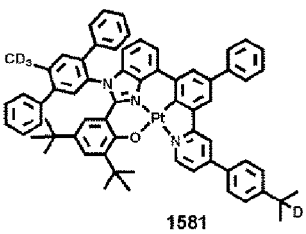

1581

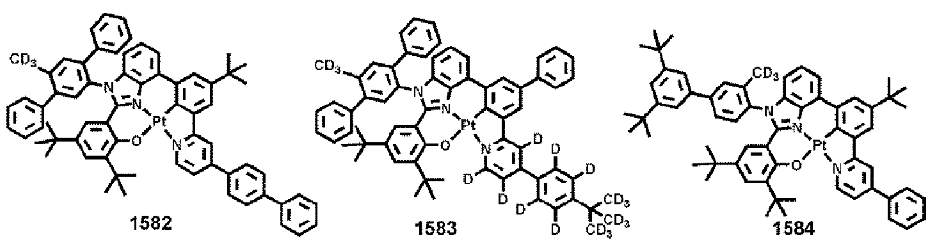

1582

1583

1584

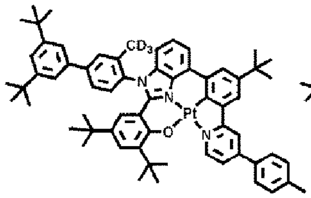
1585
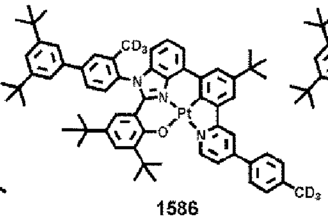
1586
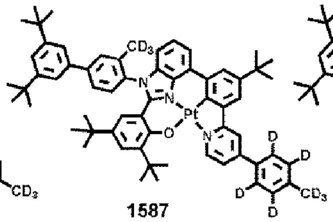
1587
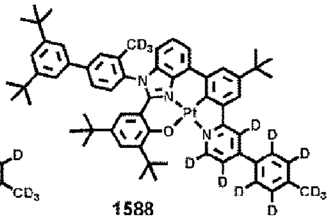
1588

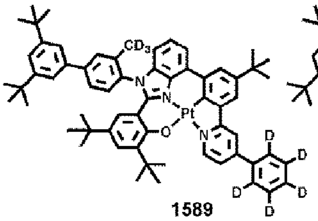
1589
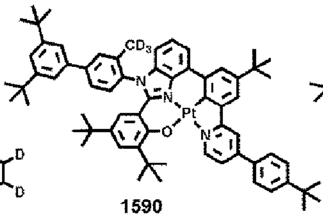
1590
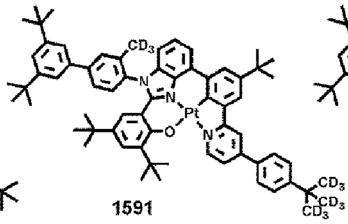
1591
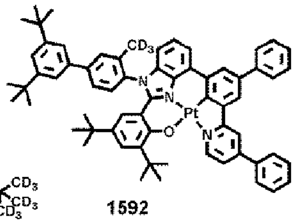
1592

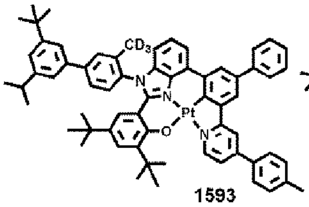
1593
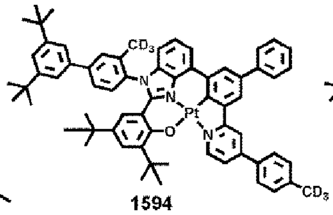
1594
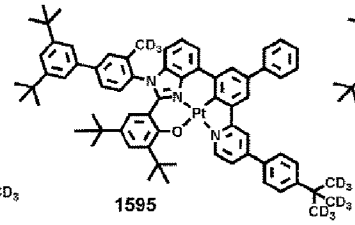
1595
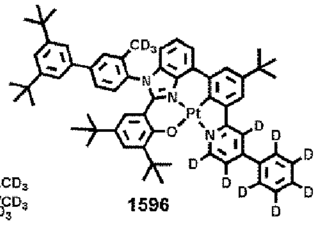
1596

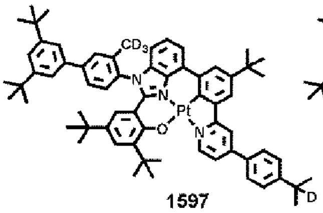
1597
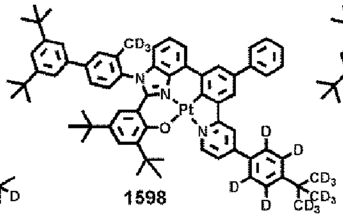
1598
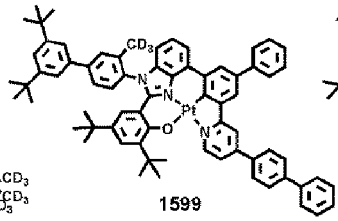
1599
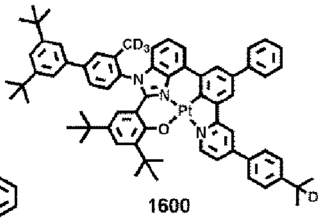
1600

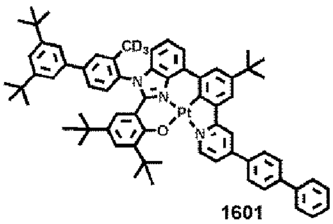
1601
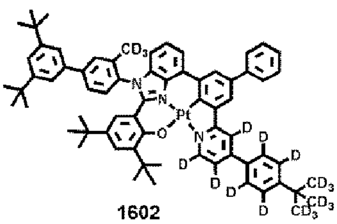
1602
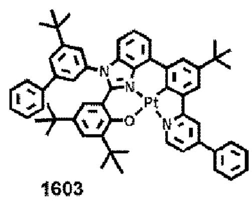
1603
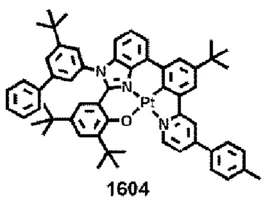
1604

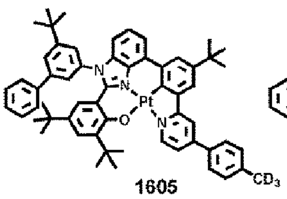
1605
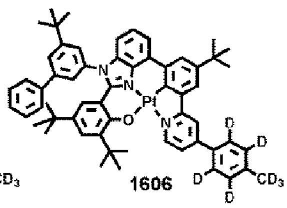
1606
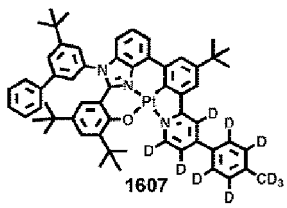
1607
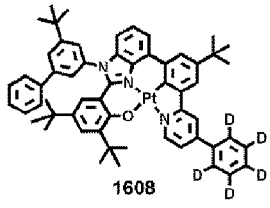
1608

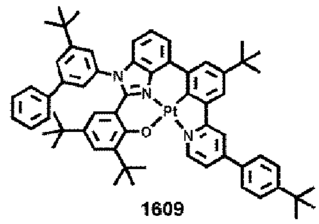
1609

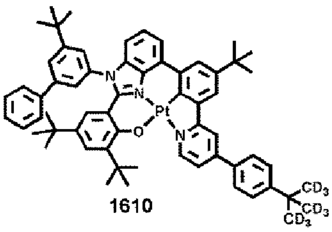
1610

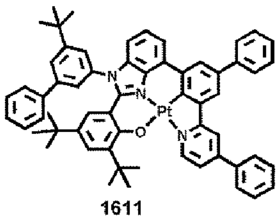
1611

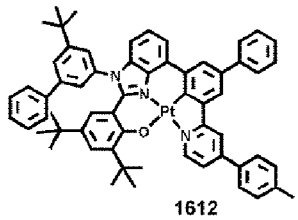
1612

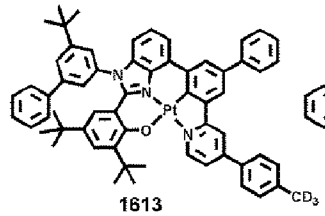
1613

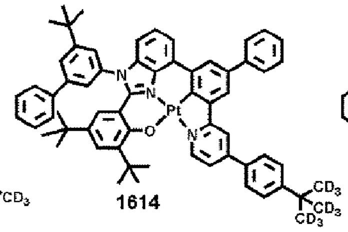
1614

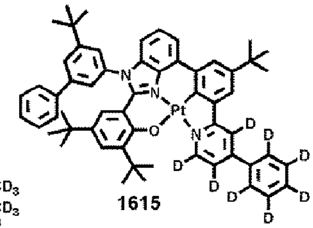
1615

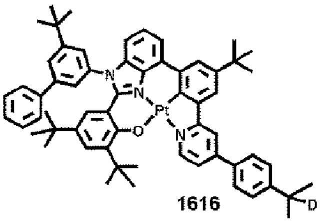
1616

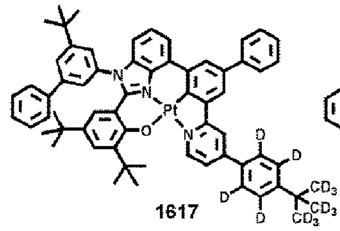
1617

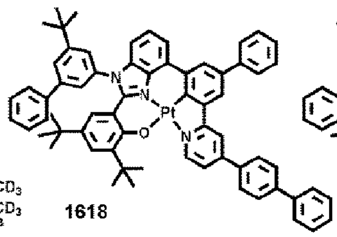
1618

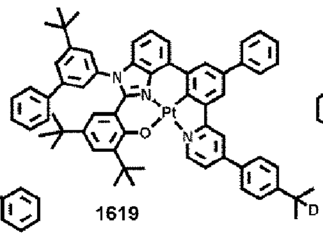
1619

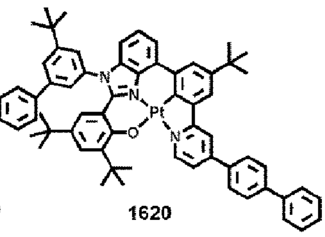
1620

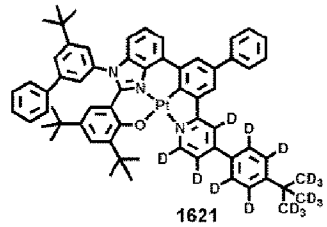
1621

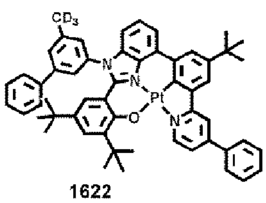
1622

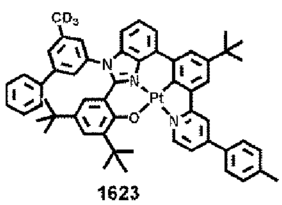
1623

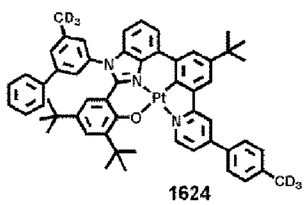
1624

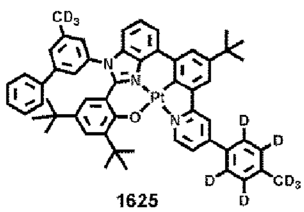
1625

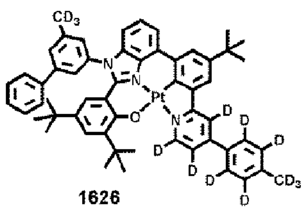
1626

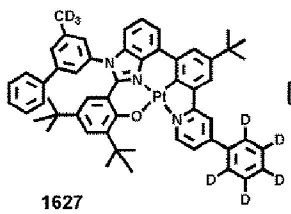
1627

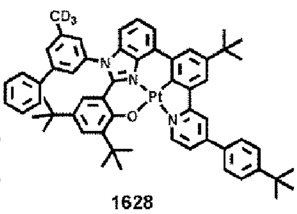
1628

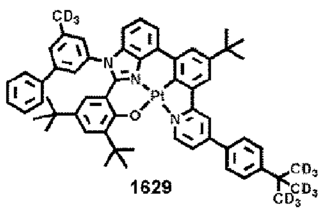
1629

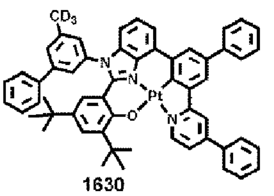
1630

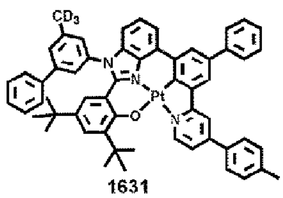
1631

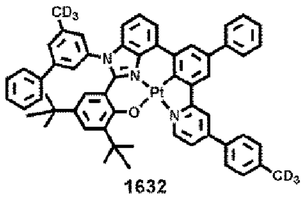
1632

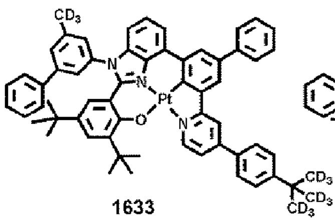
1633

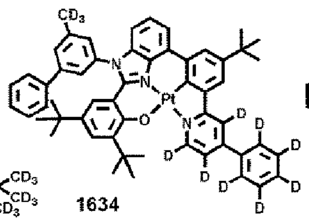
1634

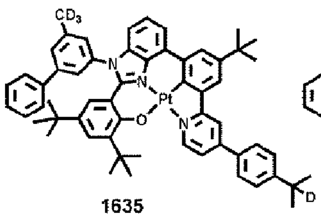
1635

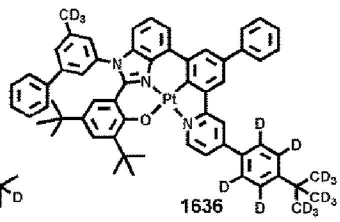
1636

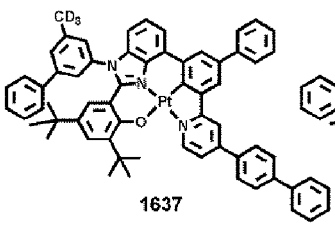
1637

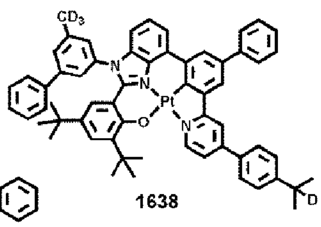
1638

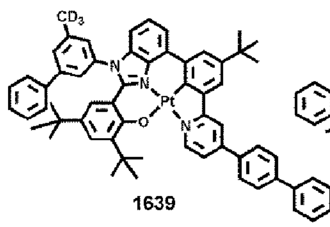
1639

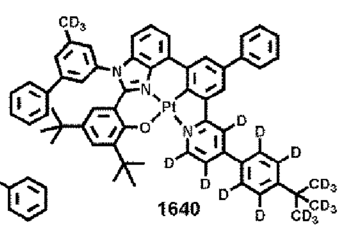
1640

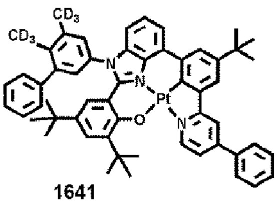
1641

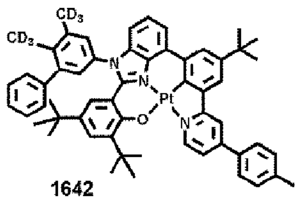
1642

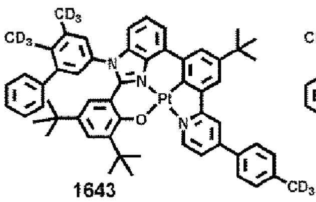
1643

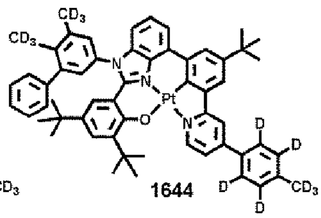
1644

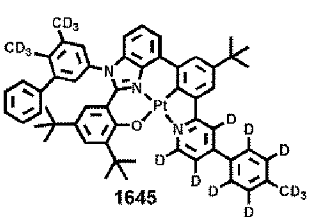
1645

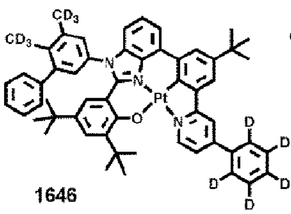
1646

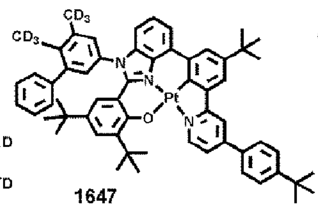
1647

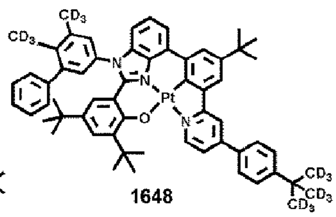
1648

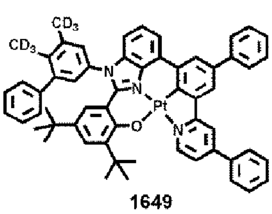
1649

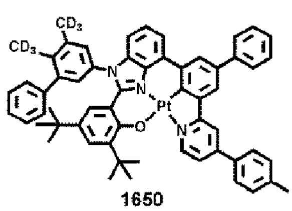
1650

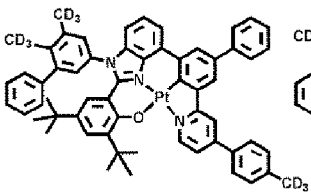
1651

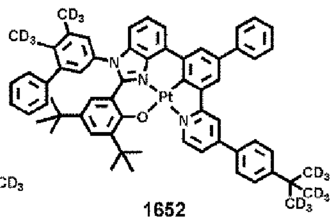
1652

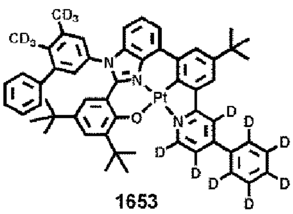
1653

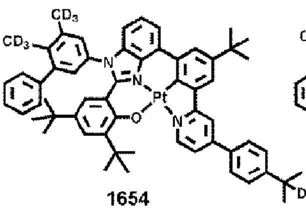
1654

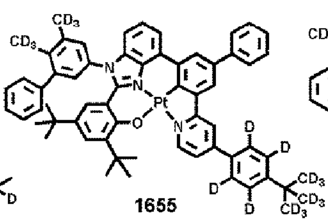
1655

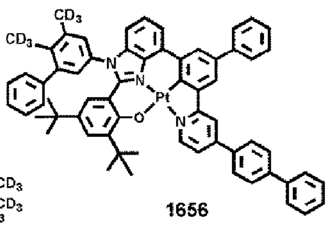
1656

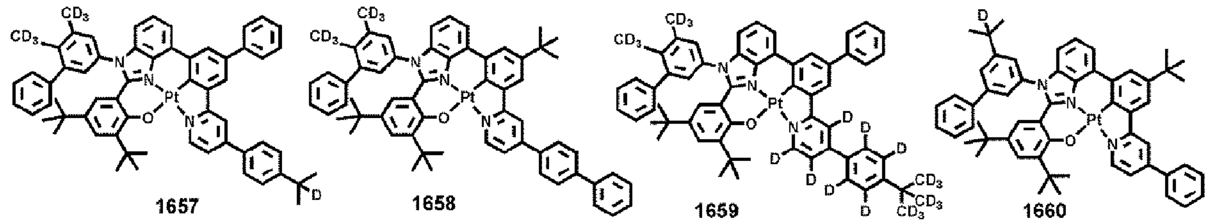

1657 1658 1659 1660

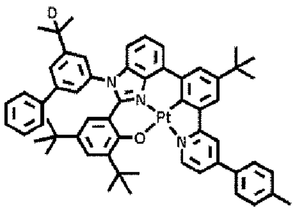

1661

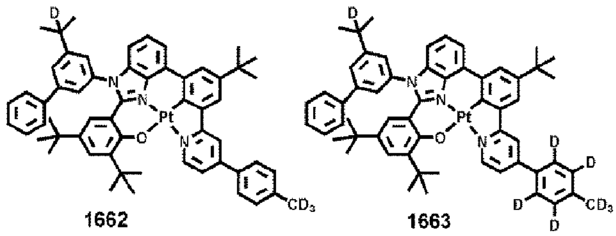

1662 1663

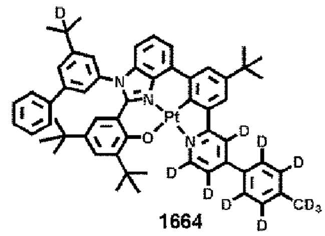

1664

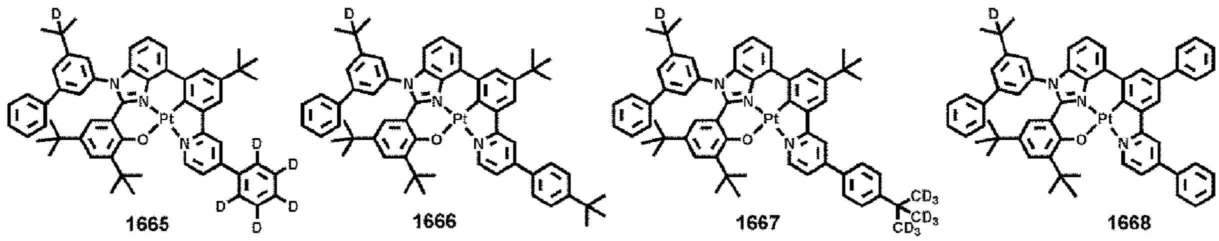

1665 1666 1667 1668

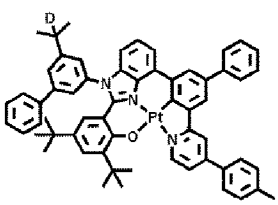

1669

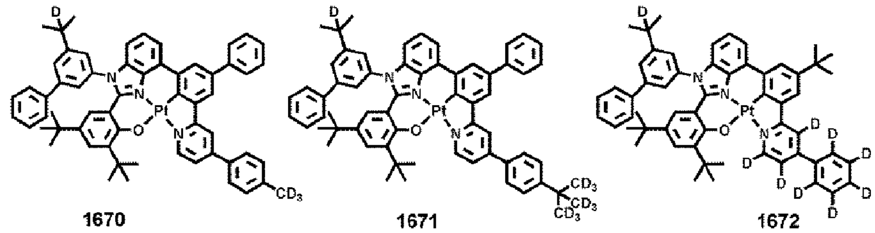

1670 1671 1672

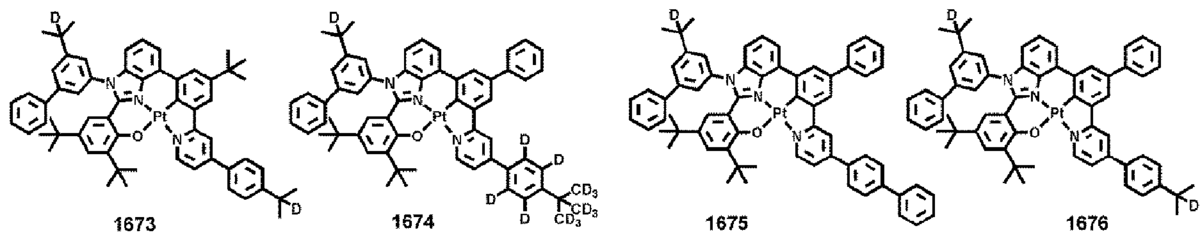

1673 1674 1675 1676

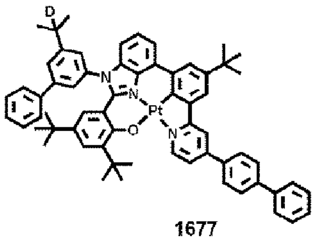

1677

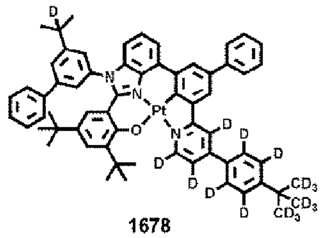

1678

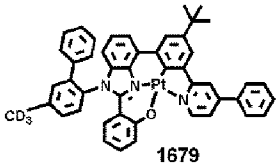
1679
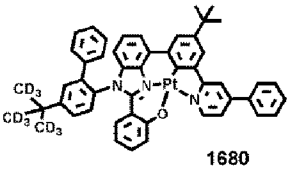
1680
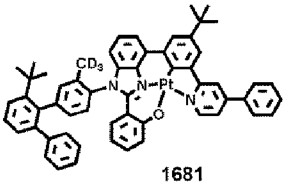
1681
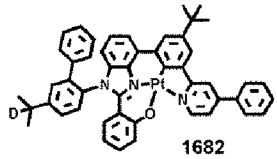
1682

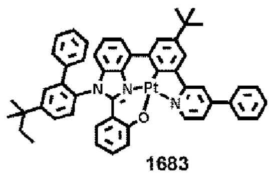
1683
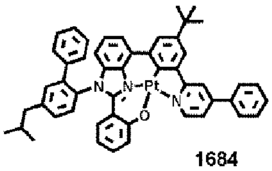
1684
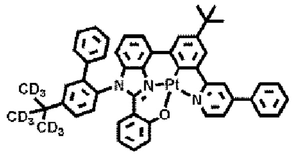
1685
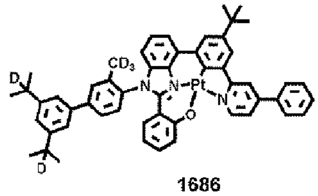
1686

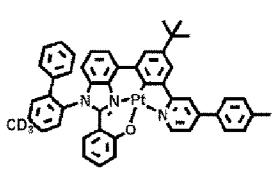
1687
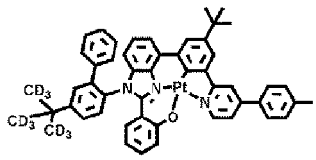
1688
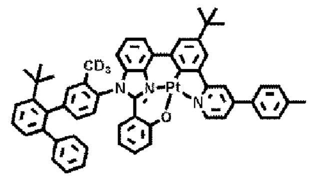
1689
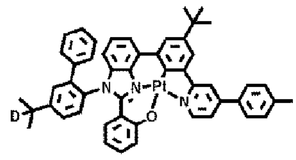
1690

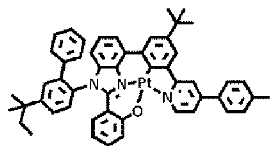
1691
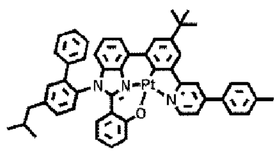
1692
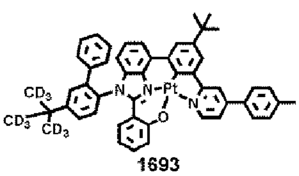
1693
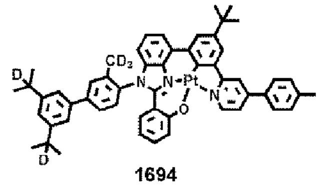
1694

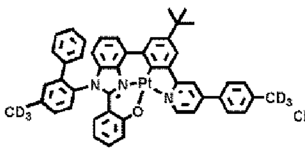
1695
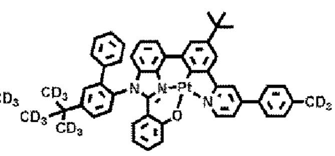
1696
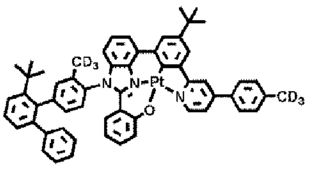
1697
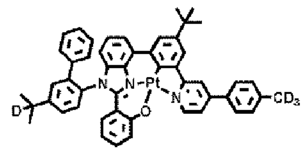
1698

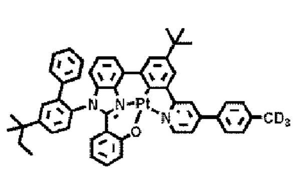
1699
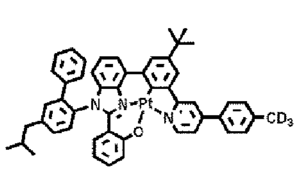
1700
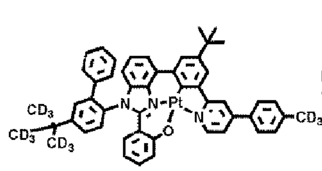
1701
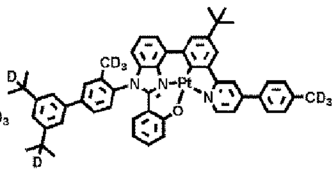
1702

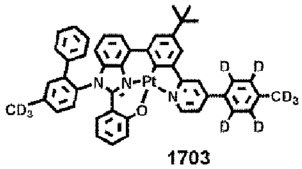

1703

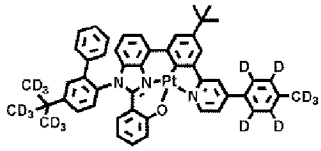

1704

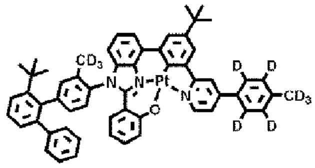

1705

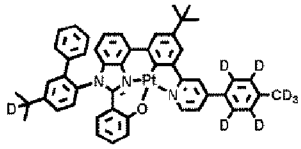

1706

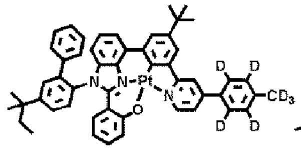

1707

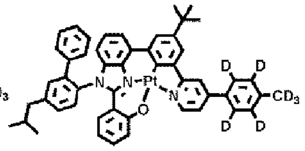

1708

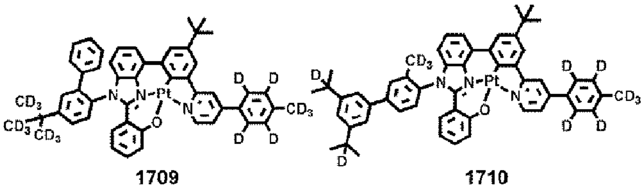

1709

1710

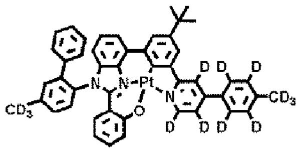

1711

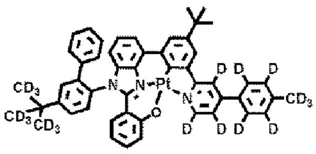

1712

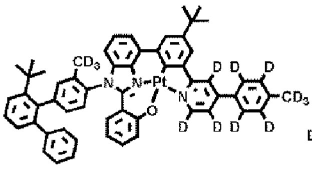

1713

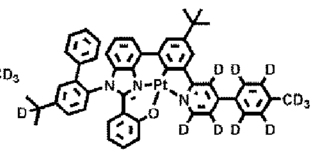

1714

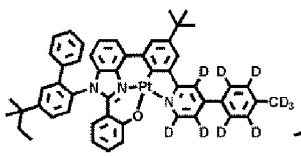

1715

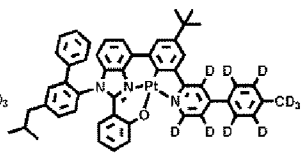

1716

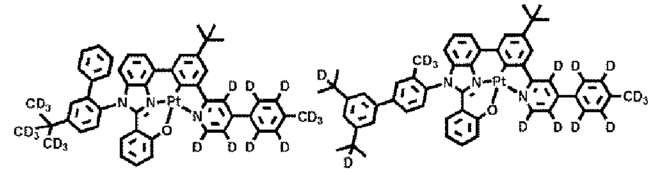

1717

1718

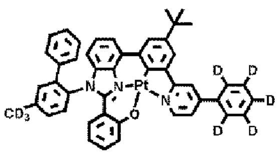

1719

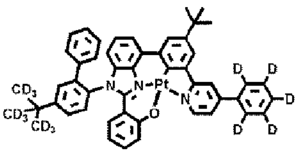

1720

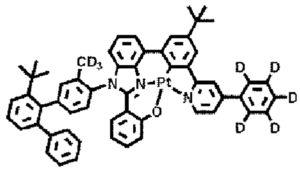

1721

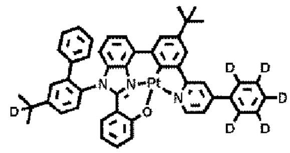

1722

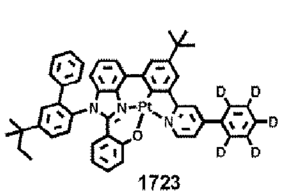

1723

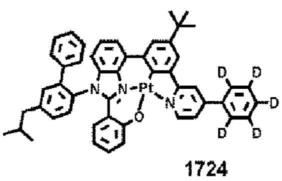

1724

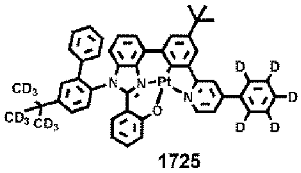

1725

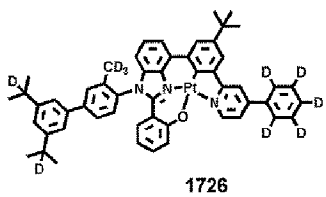

1726

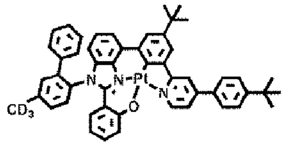
1727

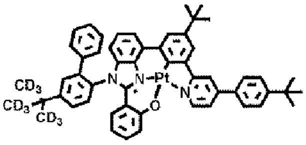
1728

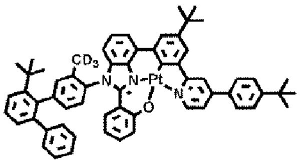
1729

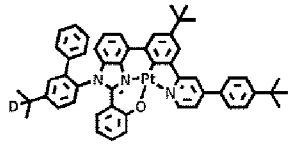
1730

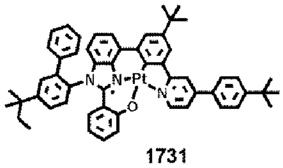
1731

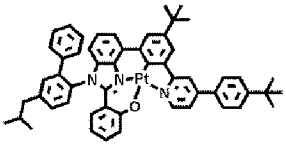
1732

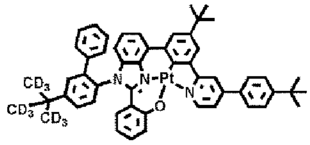
1733

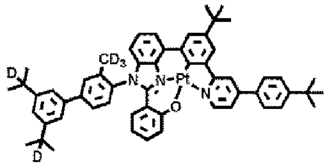
1734

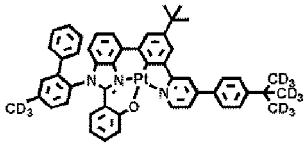
1735

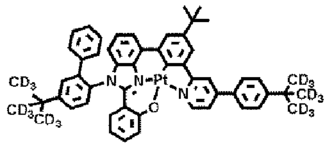
1736

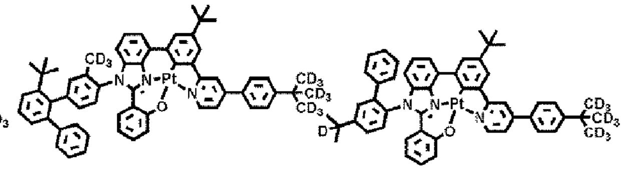
1737

1738

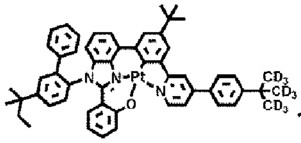
1739

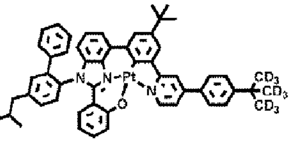
1740

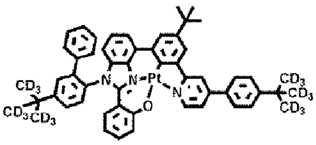
1741

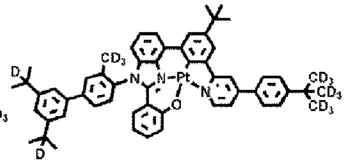
1742

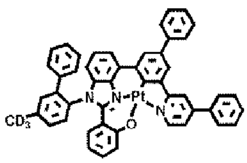
1743

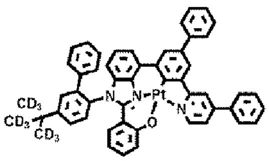
1744

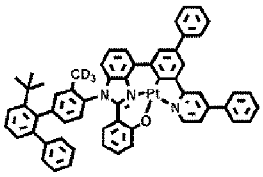
1745

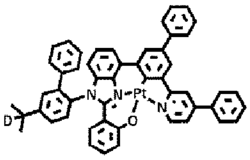
1746

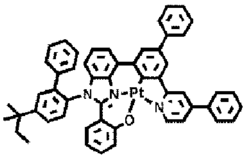
1747

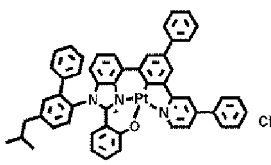
1748

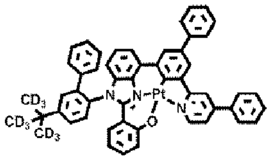
1749

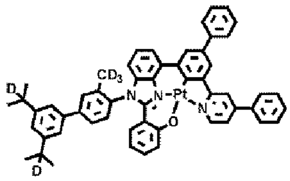
1750

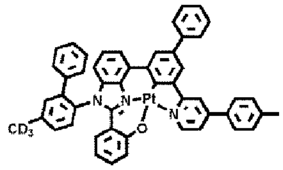
1751

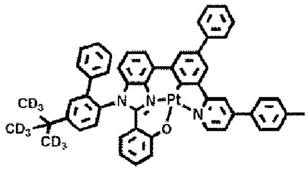
1752

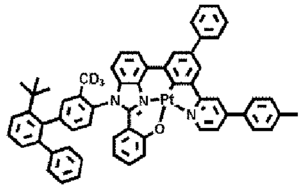
1753

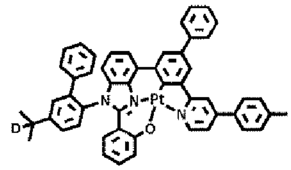
1754

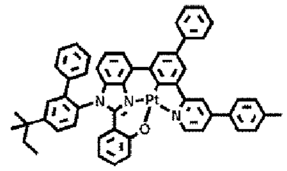
1755

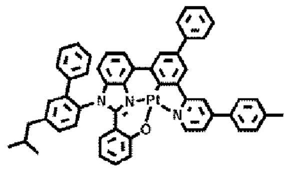
1756

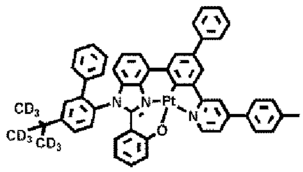
1757

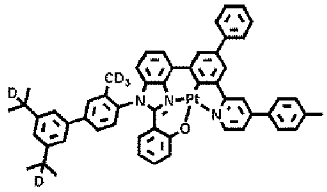
1758

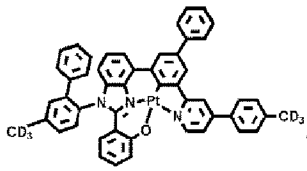
1759

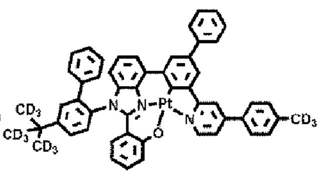
1760

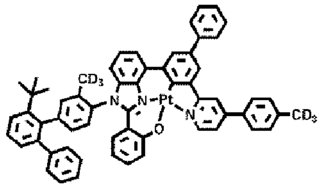
1761

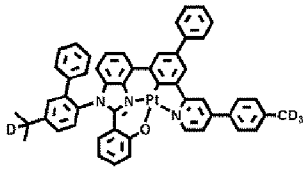
1762

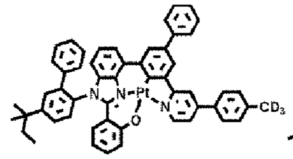
1763

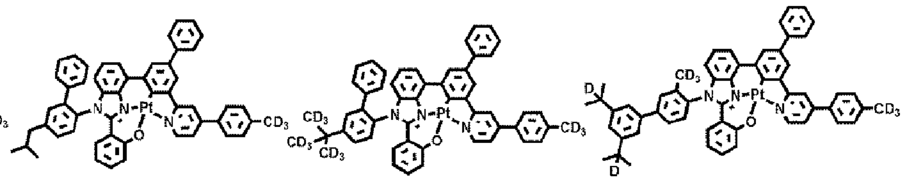
1764

1765

1766

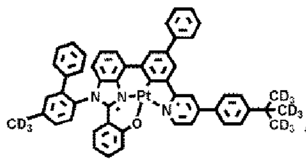
1767

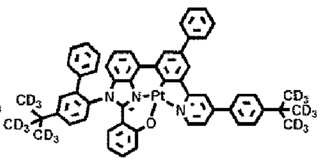
1768

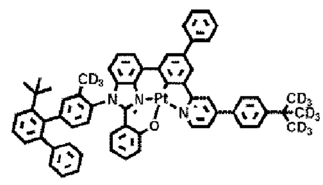
1769

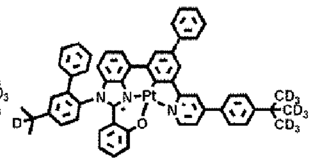
1770

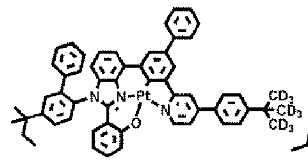
1771

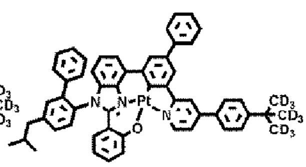
1772

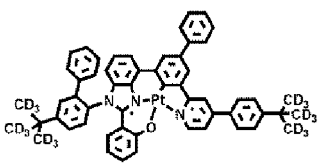
1773

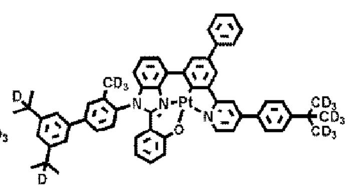
1774

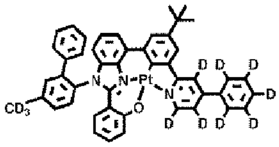
1775

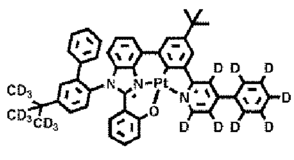
1776

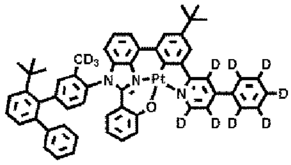
1777

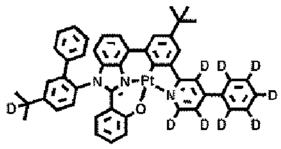
1778

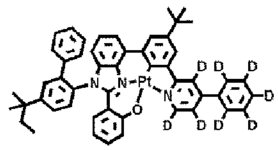
1779

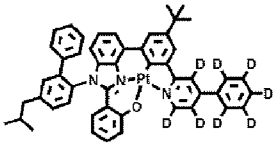
1780

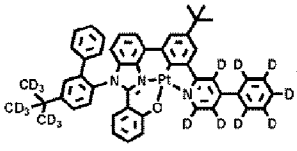
1781

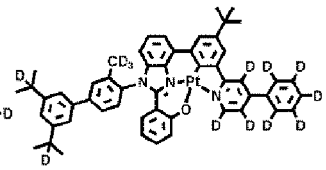
1782

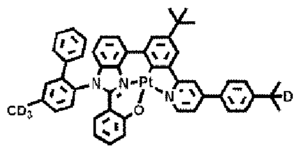
1783

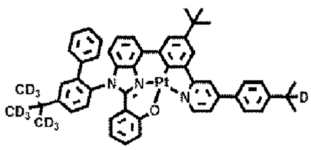
1784

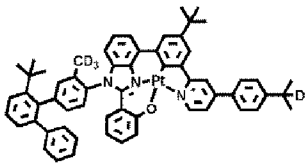
1785

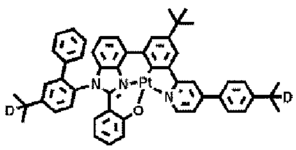
1786

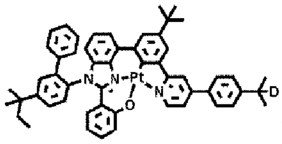
1787

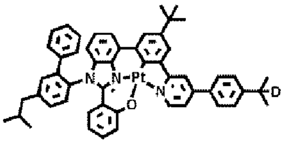
1788

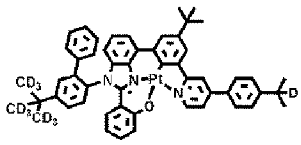
1789

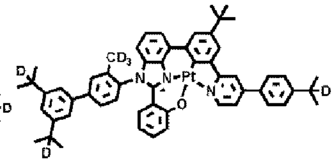
1790

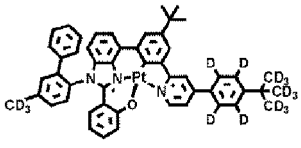
1791

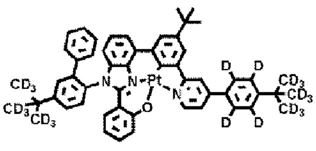
1792

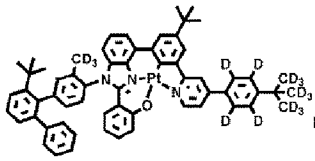
1793

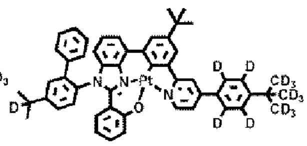
1794

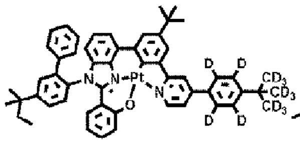
1795

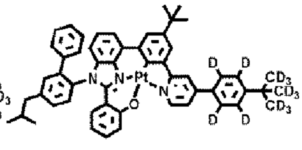
1796

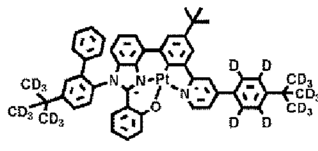
1797

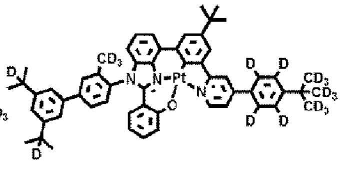
1798

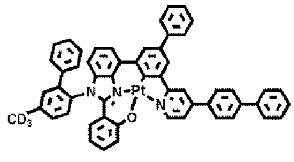
1799

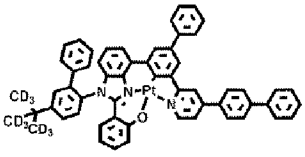
1800

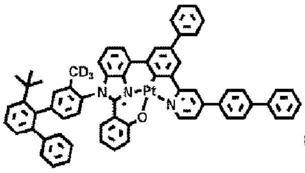
1801

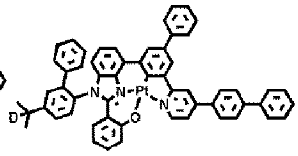
1802

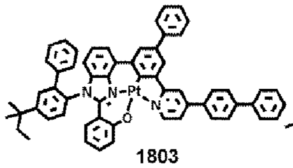
1803

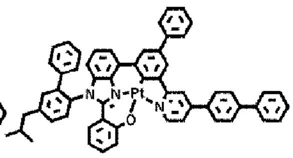
1804

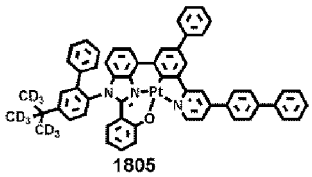
1805

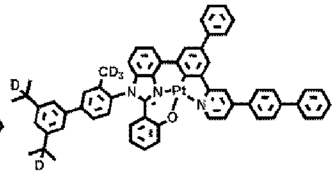
1806

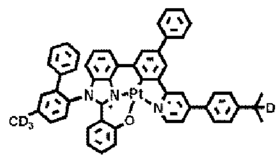
1807

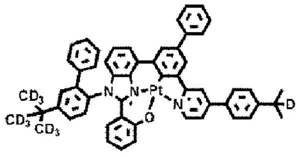
1808

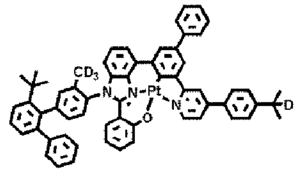
1809

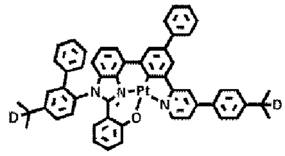
1810

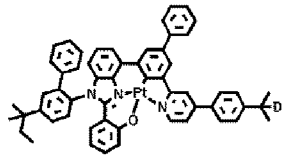
1811

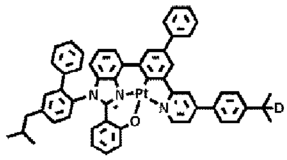
1812

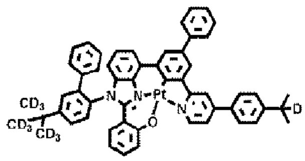
1813

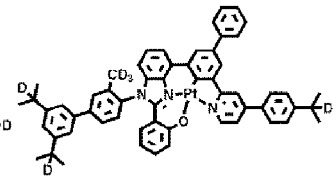
1814

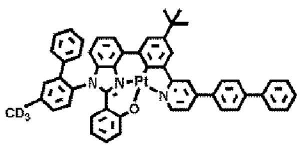
1815

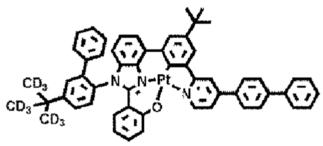
1816

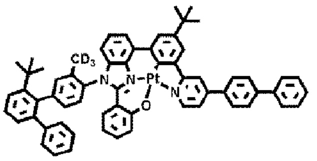
1817

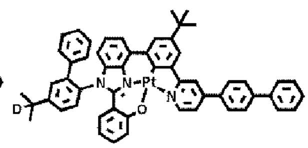
1818

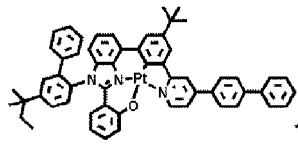
1819

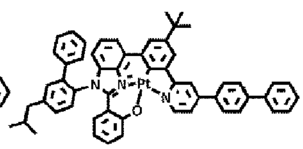
1820

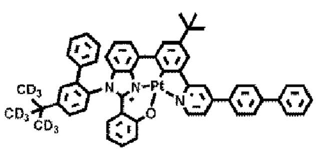
1821

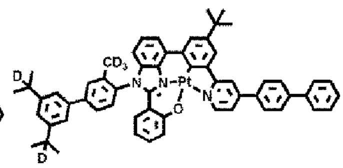
1822

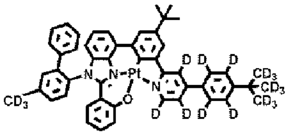

1823

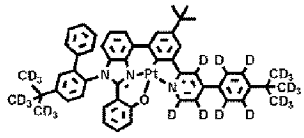

1824

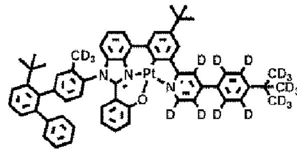

1825

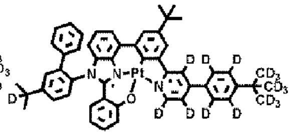

1826

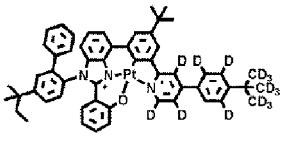

1827

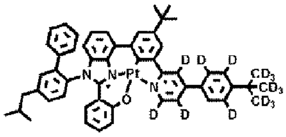

1828

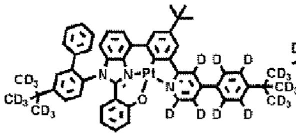

1829

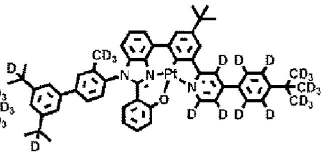

1830

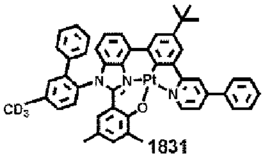

1831

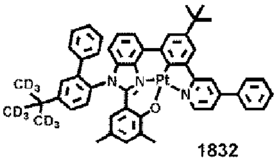

1832

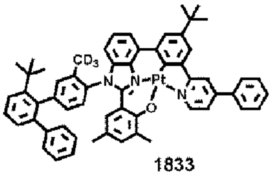

1833

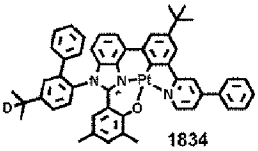

1834

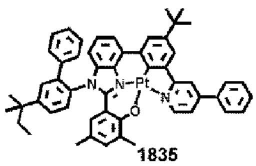

1835

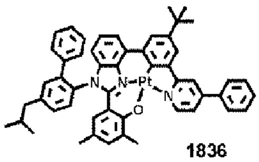

1836

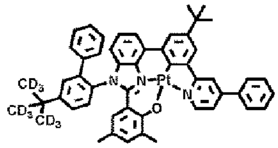

1837

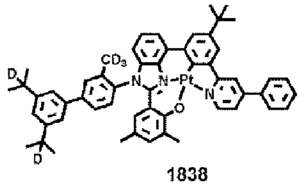

1838

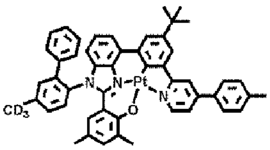

1839

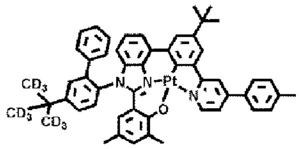

1840

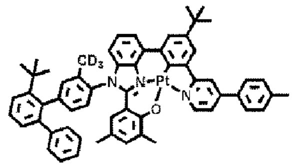

1841

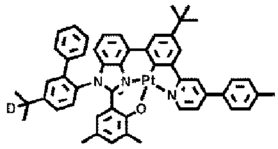

1842

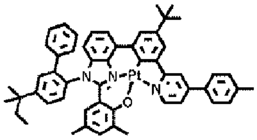

1843

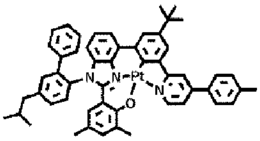

1844

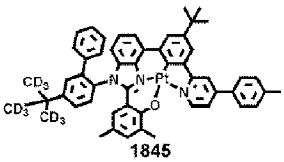

1845

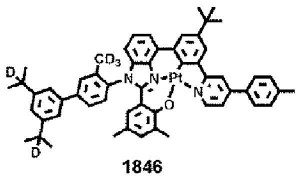

1846

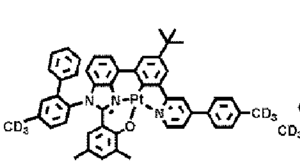

1847

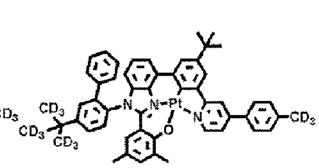

1848

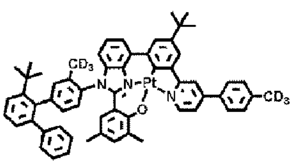

1849

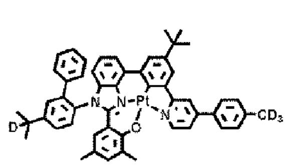

1850

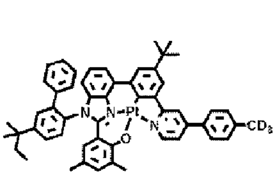

1851

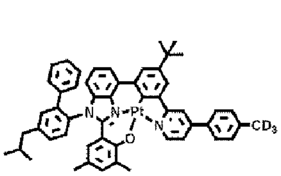

1852

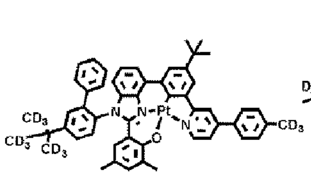

1853

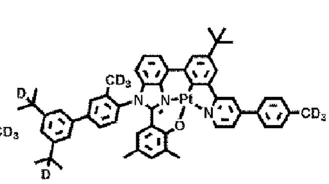

1854

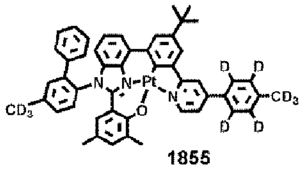
1855

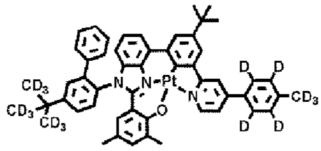
1856

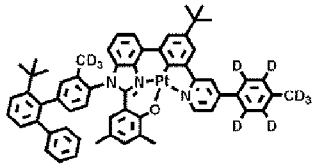
1857

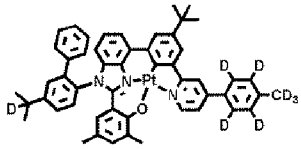
1858

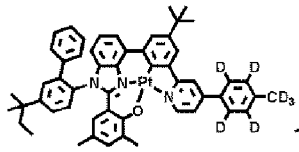
1859

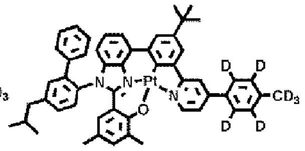
1860

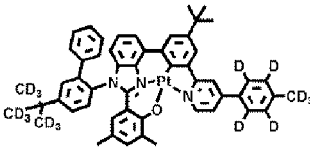
1861

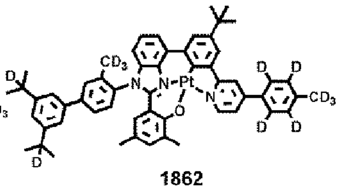
1862

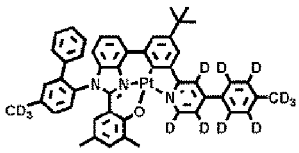
1863

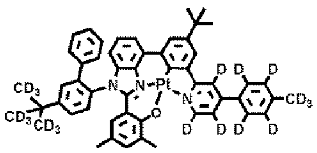
1864

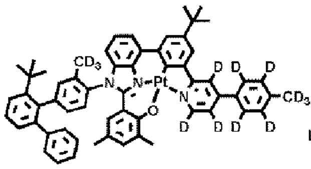
1865

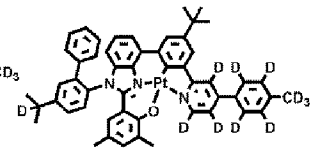
1866

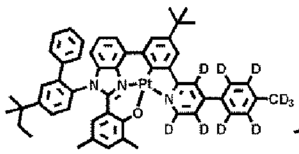
1867

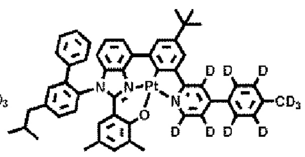
1868

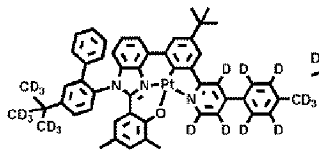
1869

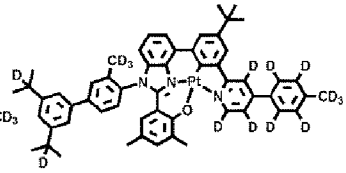
1870

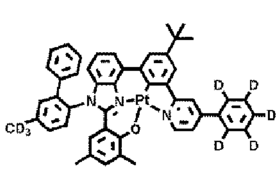
1871

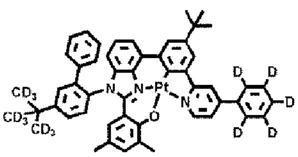
1872

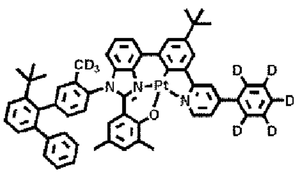
1873

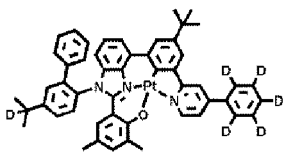
1874

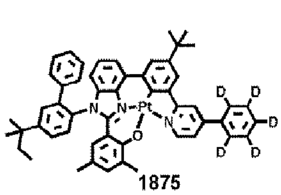
1875

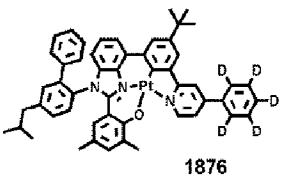
1876

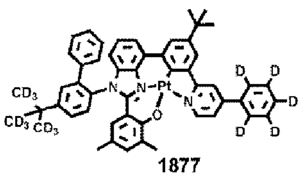
1877

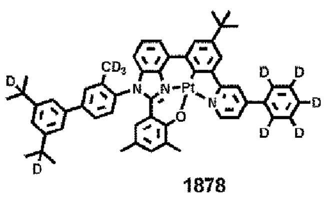
1878

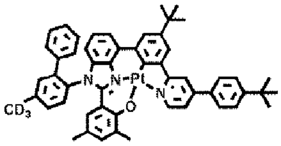
1879

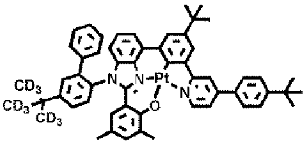
1880

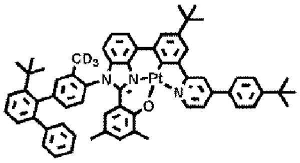
1881

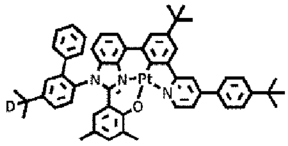
1882

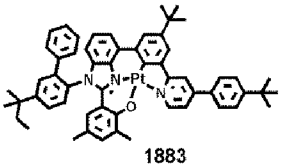
1883

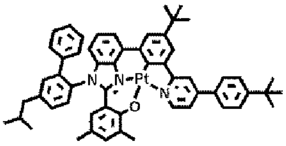
1884

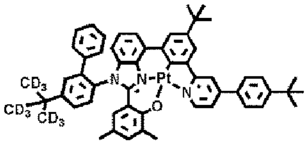
1885

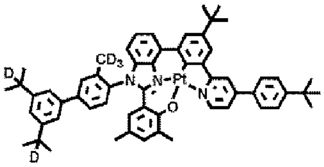
1886

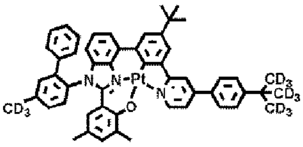
1887

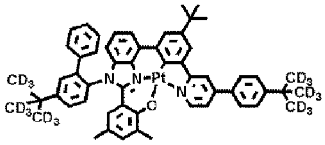
1888

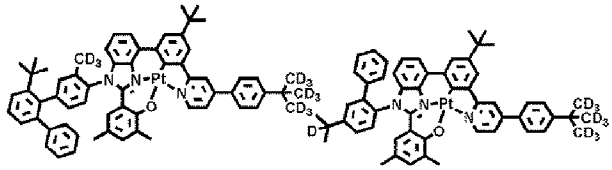
1889

1890

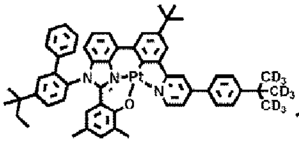
1891

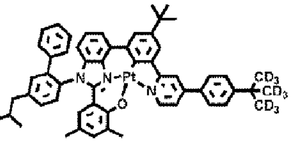
1892

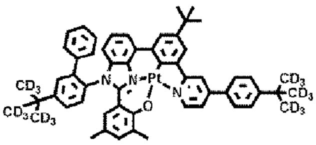
1893

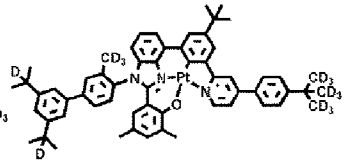
1894

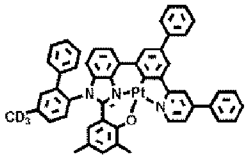
1895

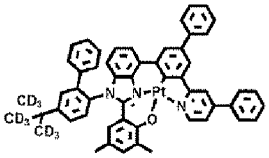
1896

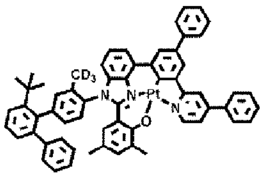
1897

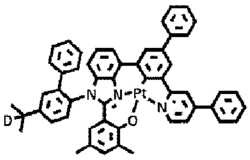
1898

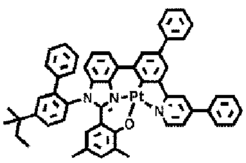
1899

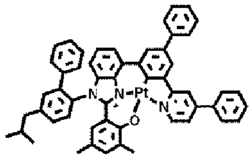
1900

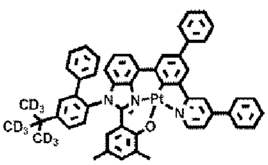
1901

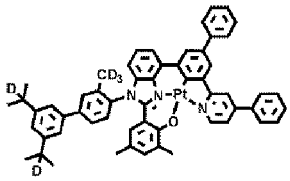
1902

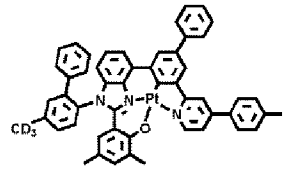

1903

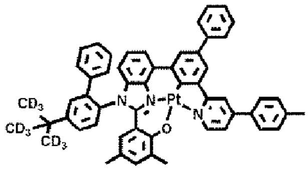

1904

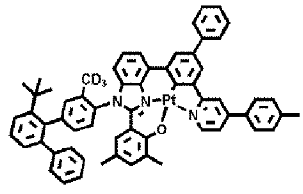

1905

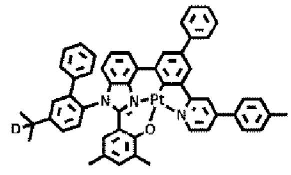

1906

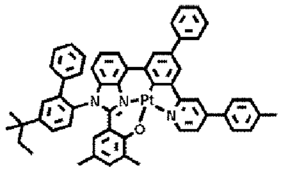

1907

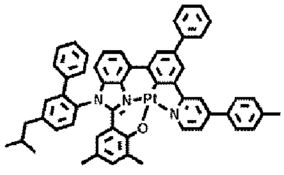

1908

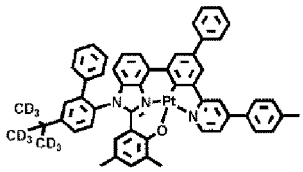

1909

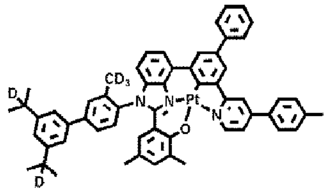

1910

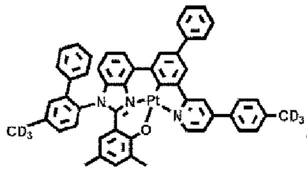

1911

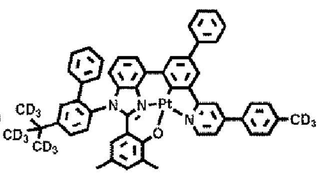

1912

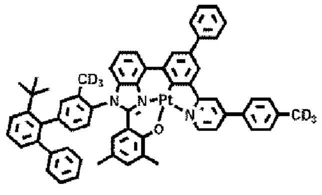

1913

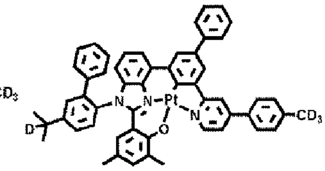

1914

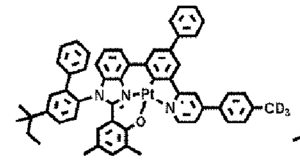

1915

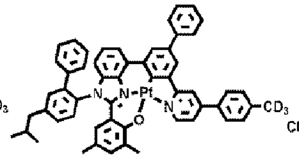

1916

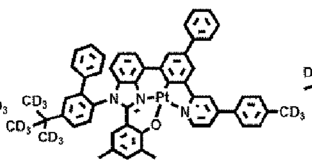

1917

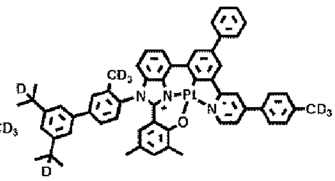

1918

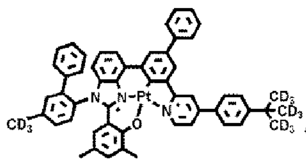

1919

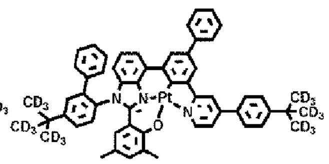

1920

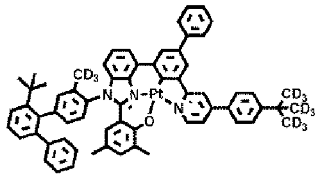

1921

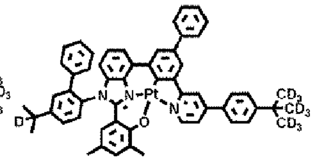

1922

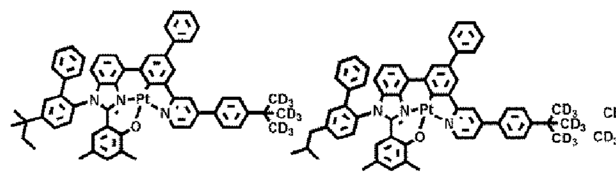

1923

1924

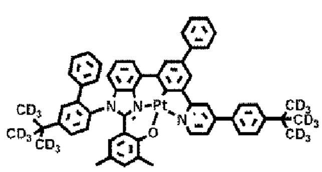

1925

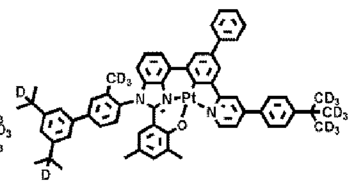

1926

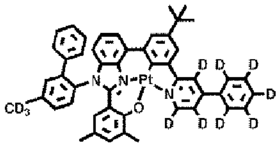

1927

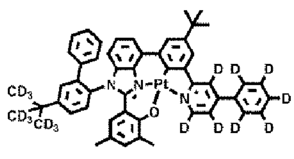

1928

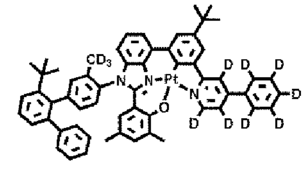

1929

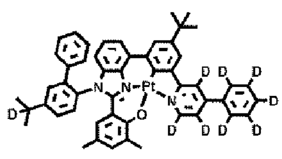

1930

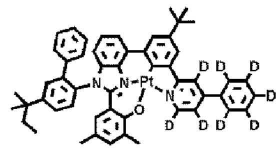

1931

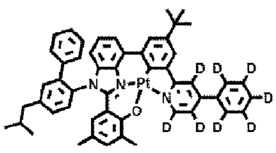

1932

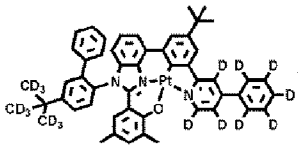

1933

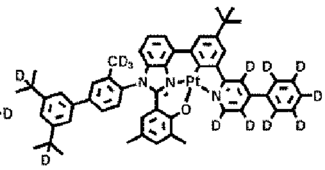

1934

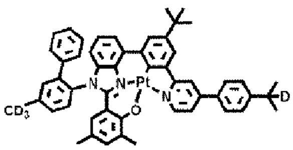

1935

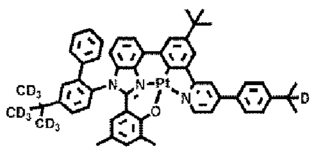

1936

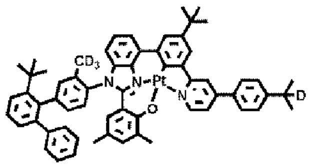

1937

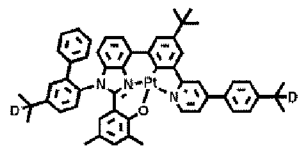

1938

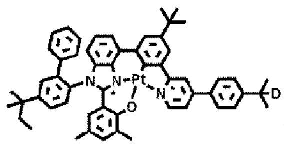

1939

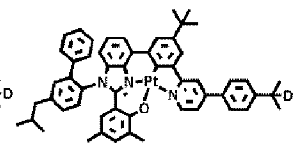

1940

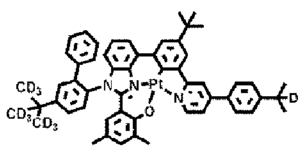

1941

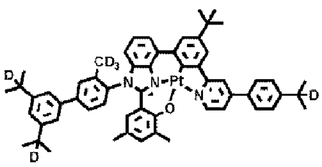

1942

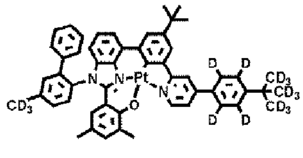

1943

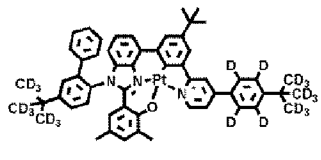

1944

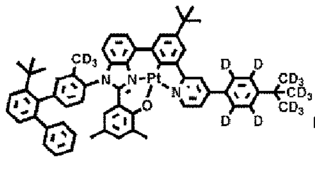

1945

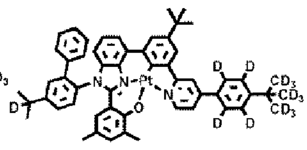

1946

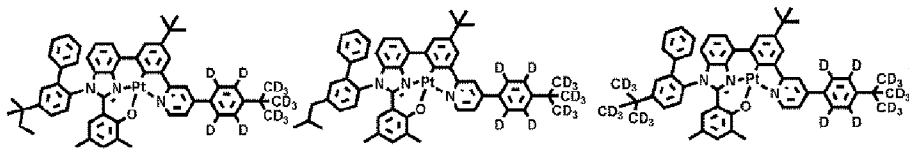

1947 1948 1949

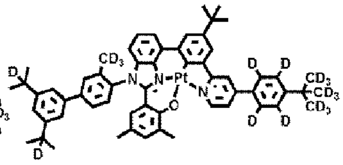

1950

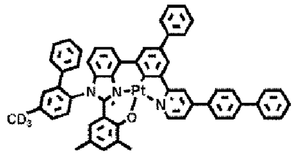
1951

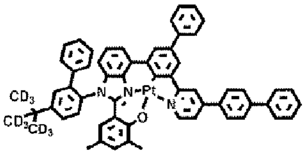
1952

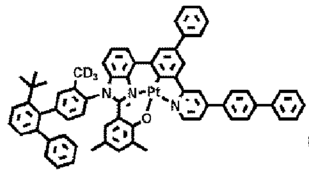
1953

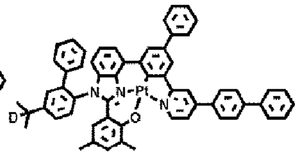
1954

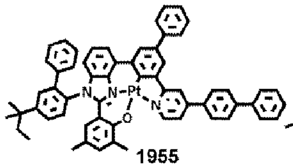
1955

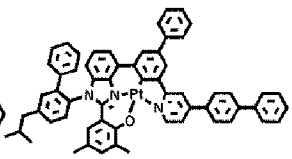
1956

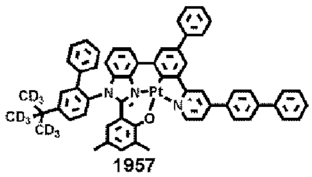
1957

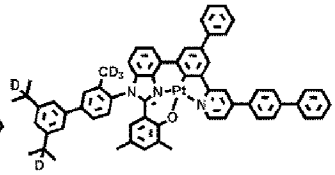
1958

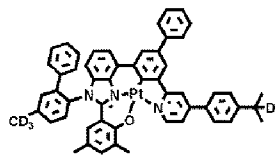
1959

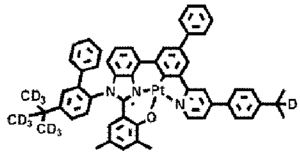
1960

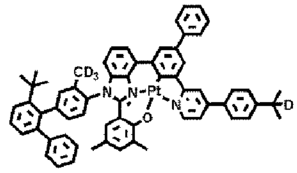
1961

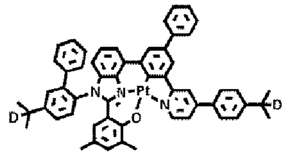
1962

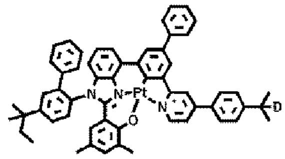
1963

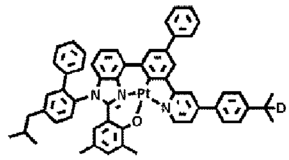
1964

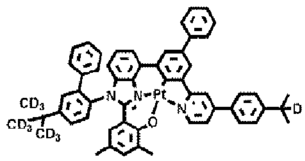
1965

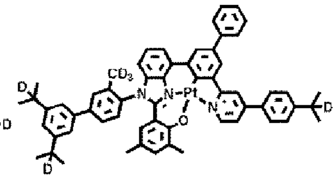
1966

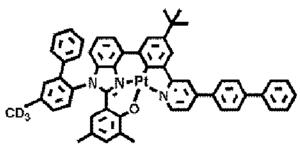
1967

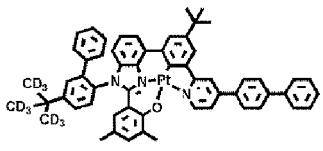
1968

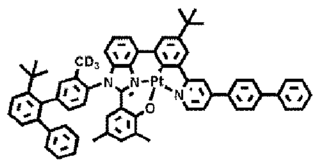
1969

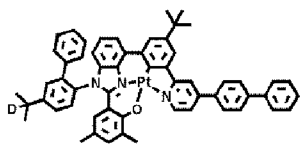
1970

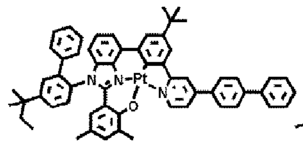
1971

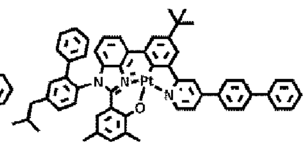
1972

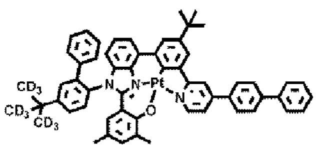
1973

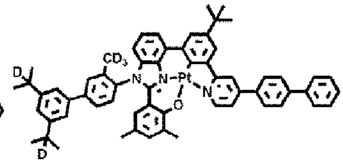
1974

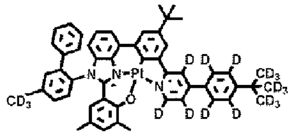
1975
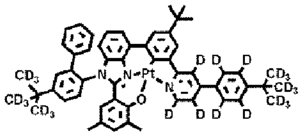
1976
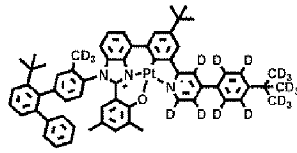
1977
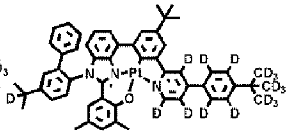
1978
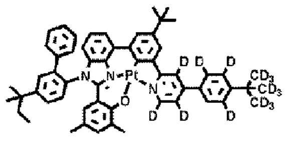
1979
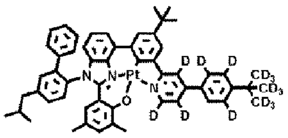
1980
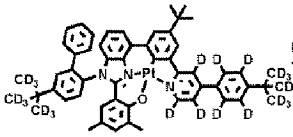
1981
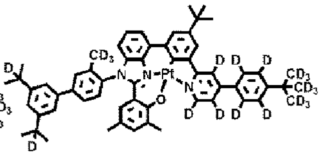
1982
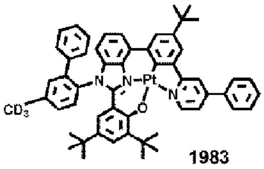
1983
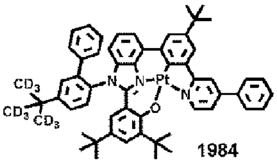
1984
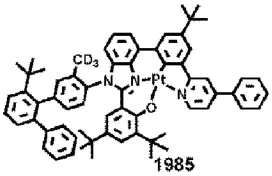
1985
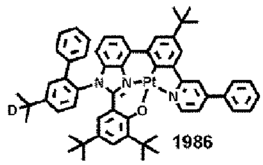
1986
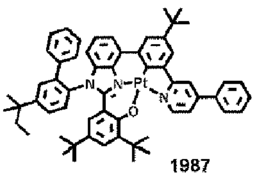
1987
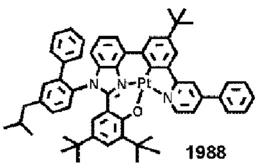
1988
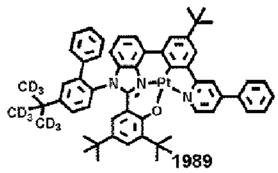
1989
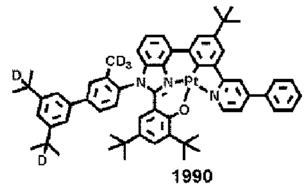
1990
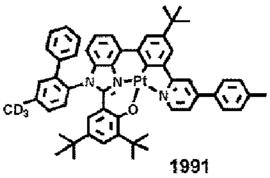
1991
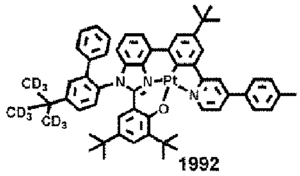
1992
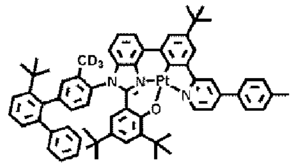
1993
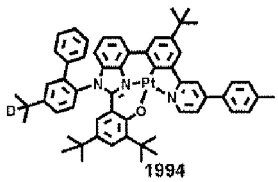
1994
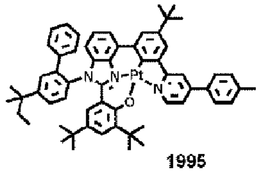
1995
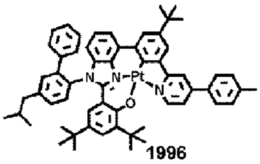
1996
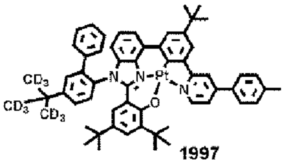
1997
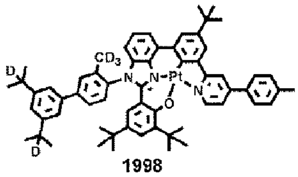
1998
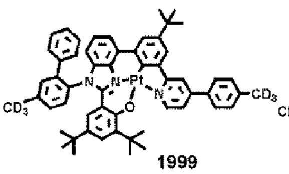
1999
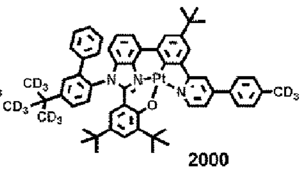
2000
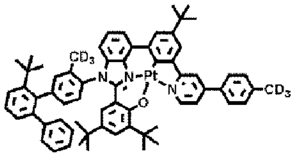
2001
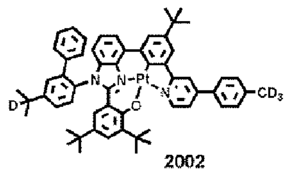
2002
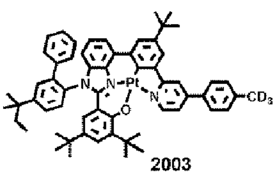
2003
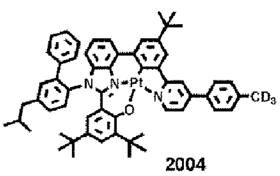
2004
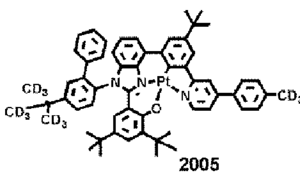
2005
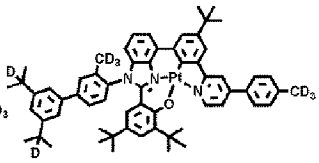
2006

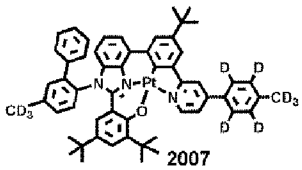
2007

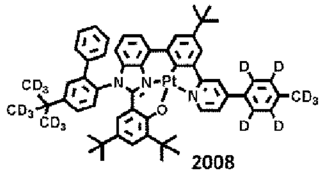
2008

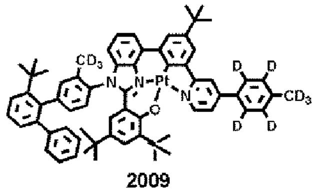
2009

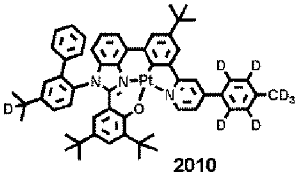
2010

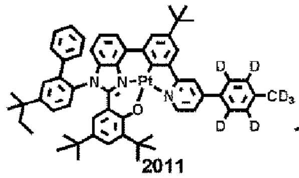
2011

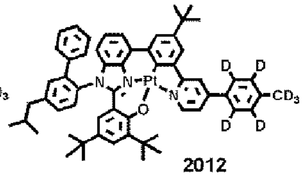
2012

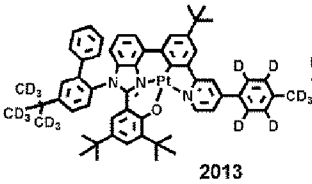
2013

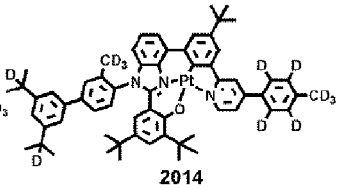
2014

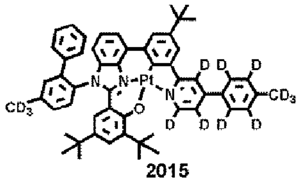
2015

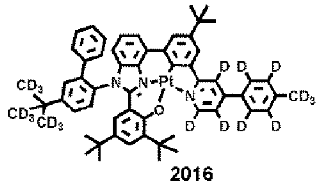
2016

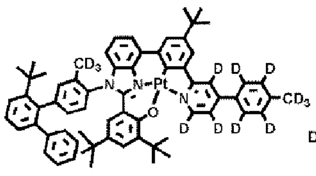
2017

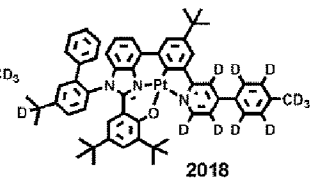
2018

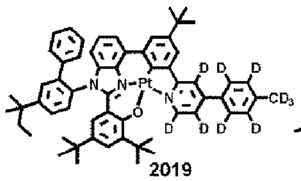
2019

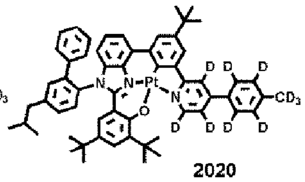
2020

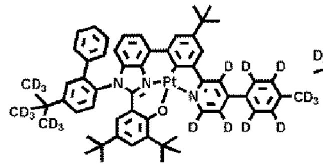
2021

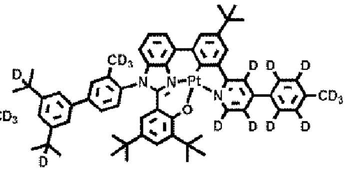
2022

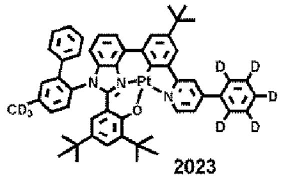
2023

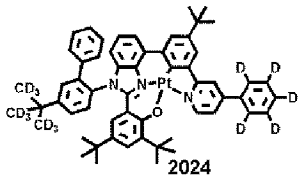
2024

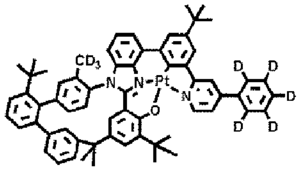
2025

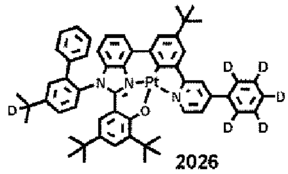
2026

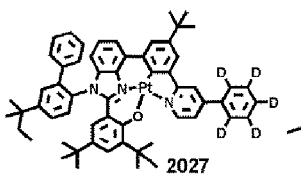
2027

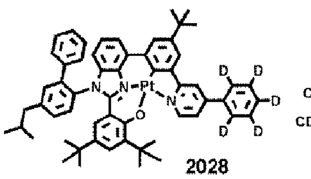
2028

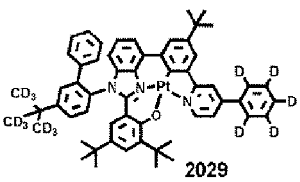
2029

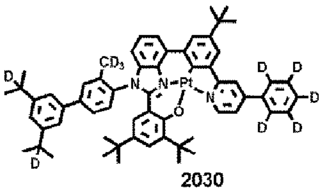
2030

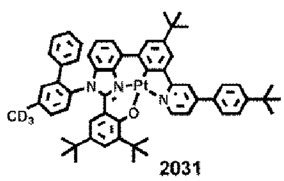
2031

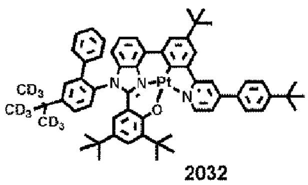
2032

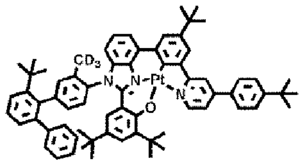
2033

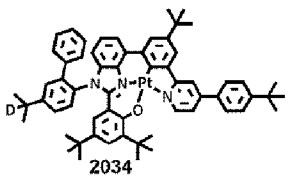
2034

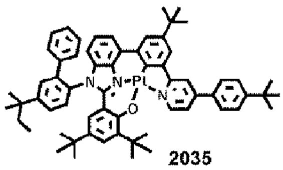
2035

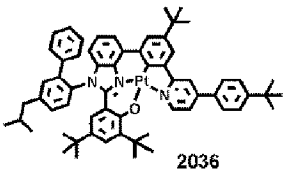
2036

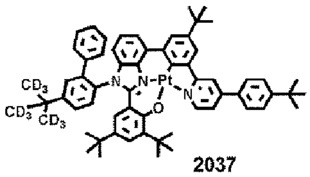
2037

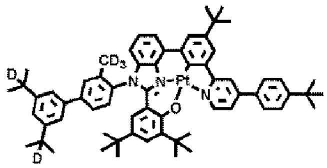
2038

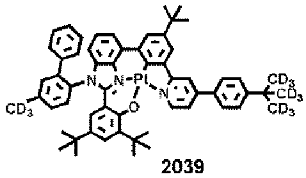
2039

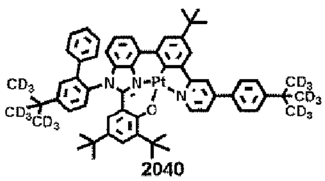
2040

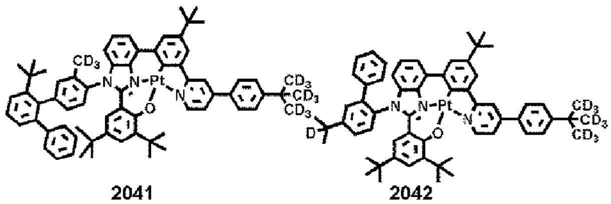
2041

2042

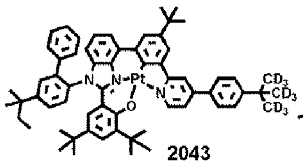
2043

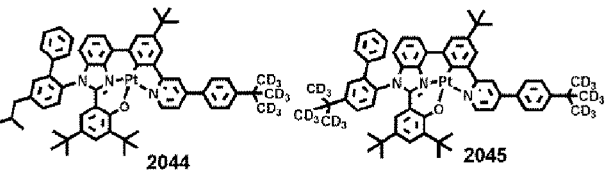
2044

2045

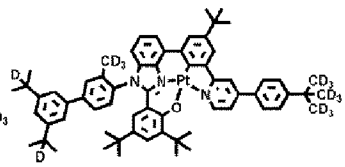
2046

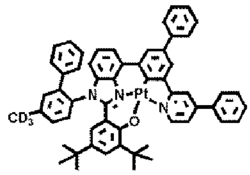
2047

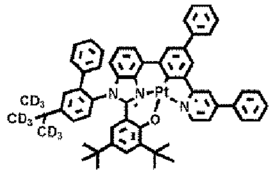
2048

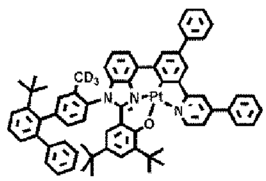
2049

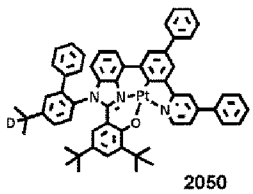
2050

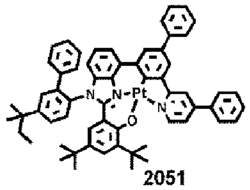
2051

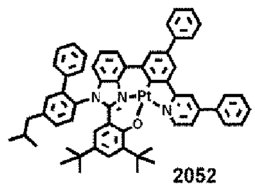
2052

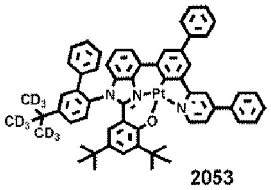
2053

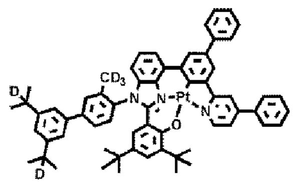
2054

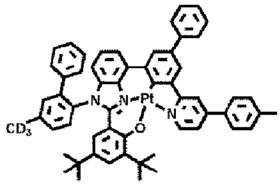
2055
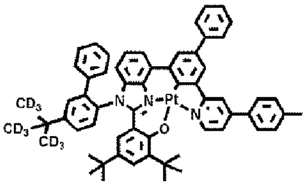
2056
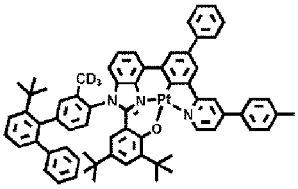
2057
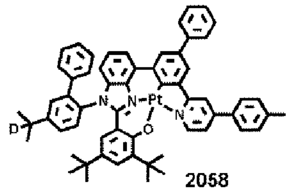
2058

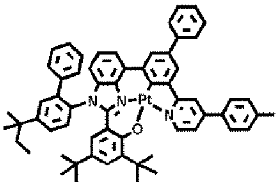
2059
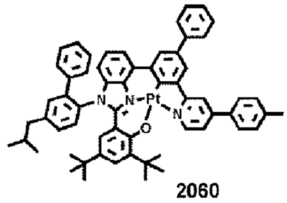
2060
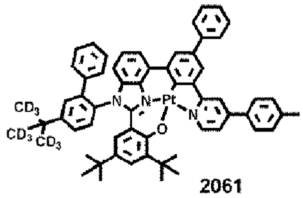
2061
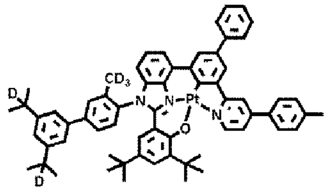
2062

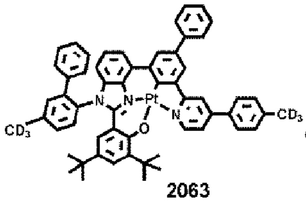
2063
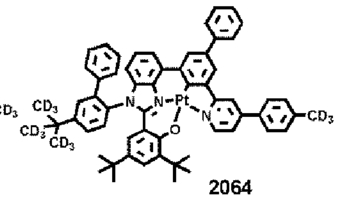
2064
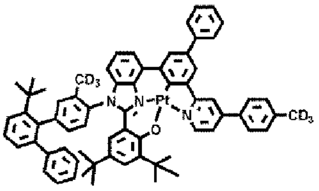
2065
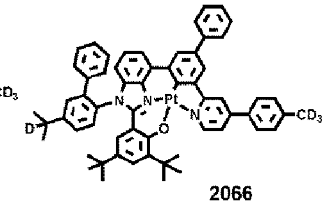
2066

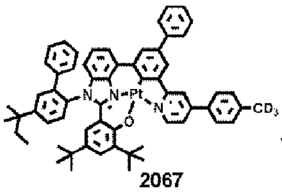
2067
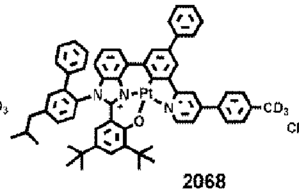
2068
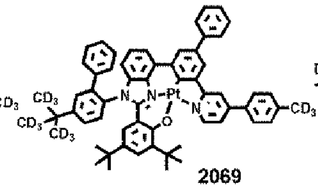
2069
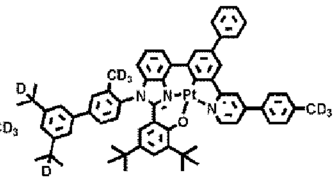
2070

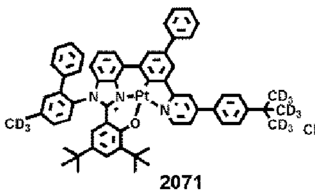
2071
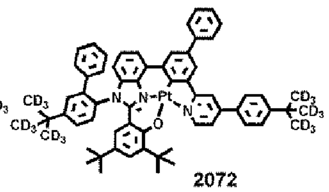
2072
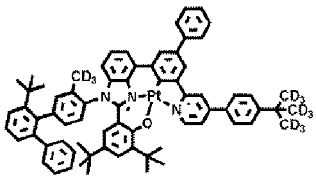
2073
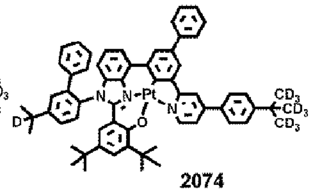
2074

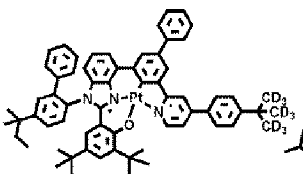
2075
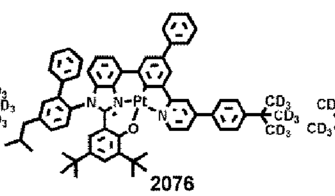
2076
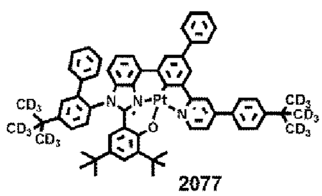
2077
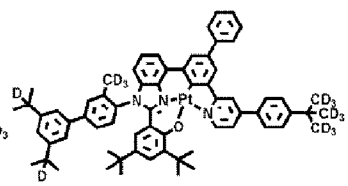
2078

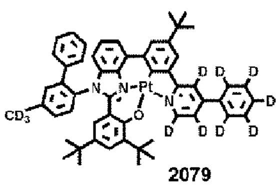
2079
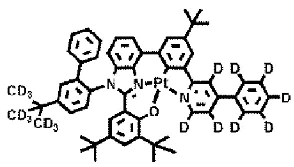
2080
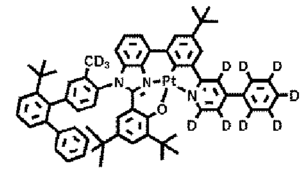
2081
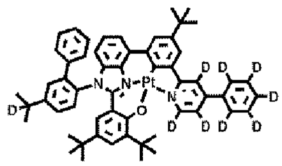
2082

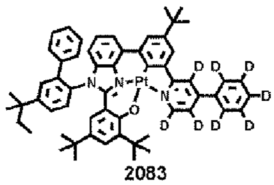
2083
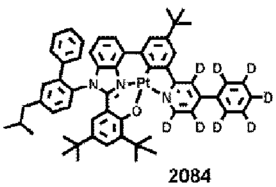
2084
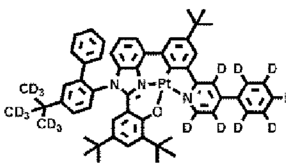
2085
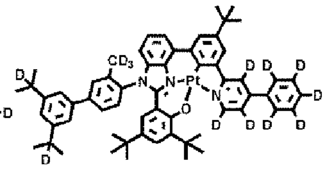
2086

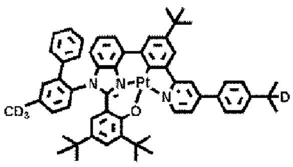
2087
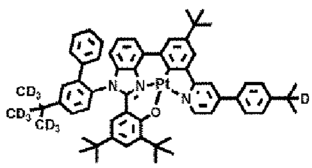
2088
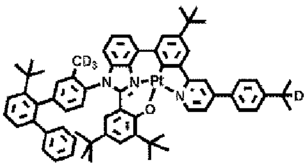
2089
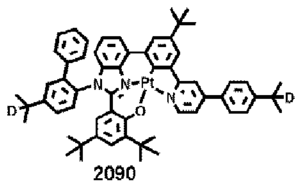
2090

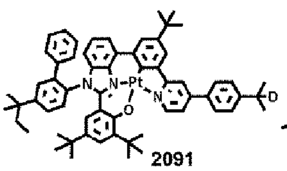
2091
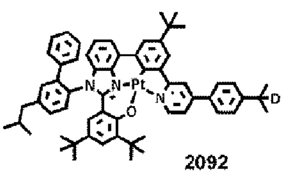
2092
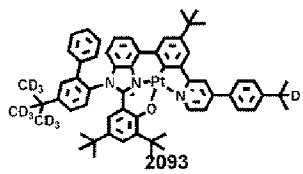
2093
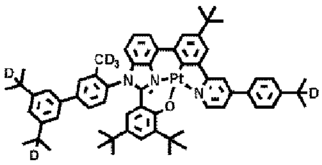
2094

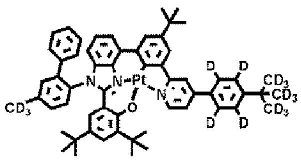
2095
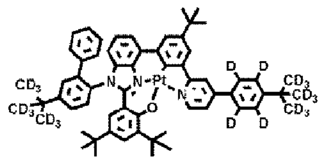
2096
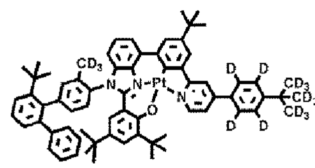
2097
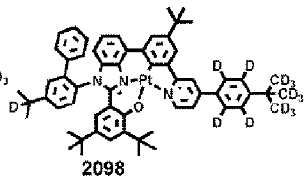
2098

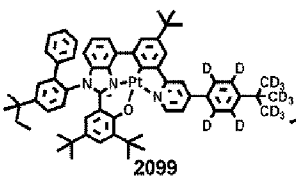
2099
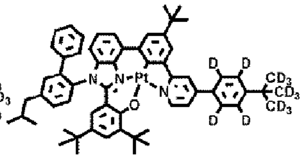
2100
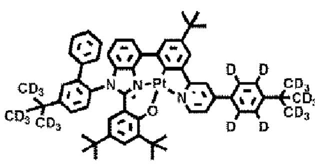
2101
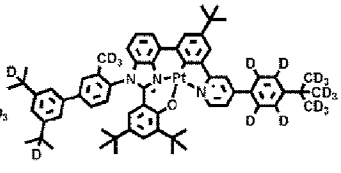
2102

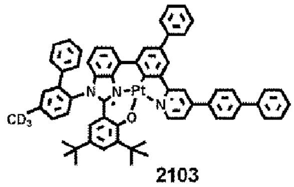
2103
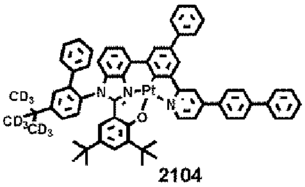
2104
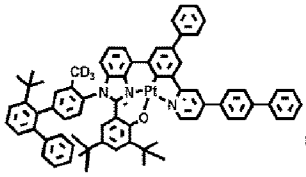
2105
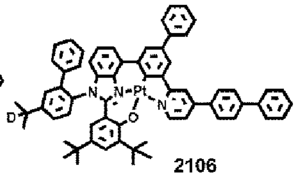
2106

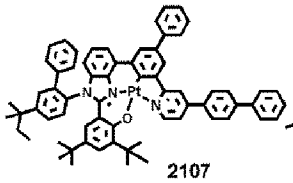
2107
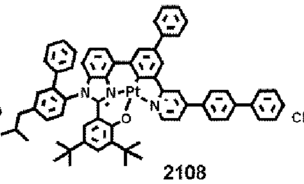
2108
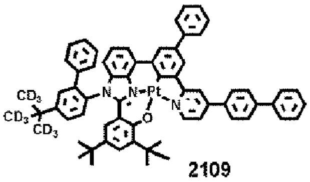
2109
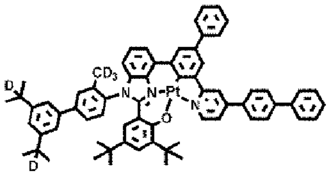
2110

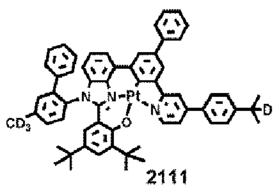
2111
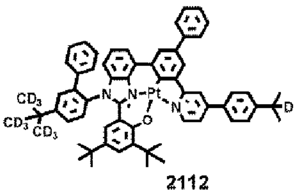
2112
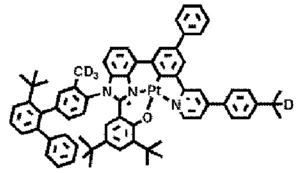
2113
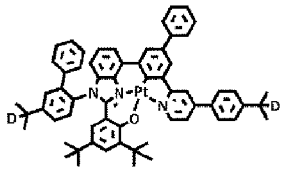
2114

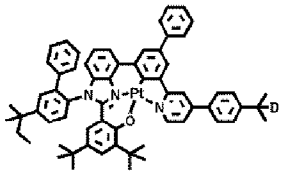
2115
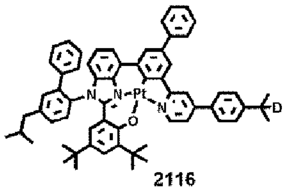
2116
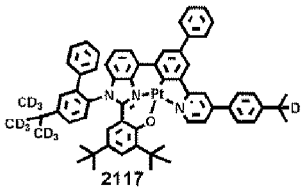
2117
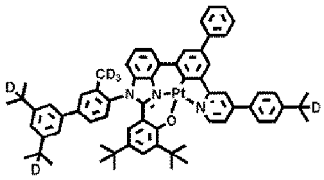
2118

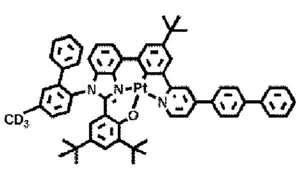
2119
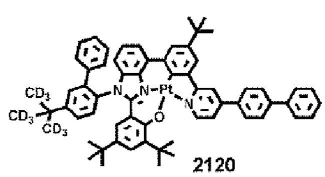
2120
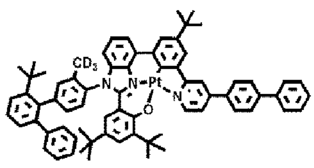
2121
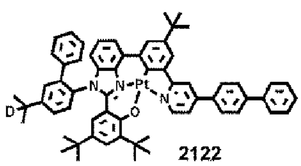
2122

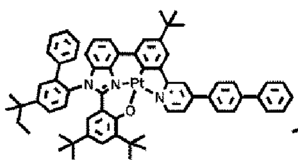
2123
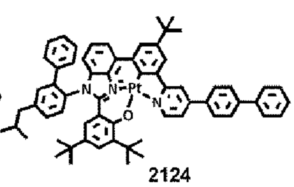
2124
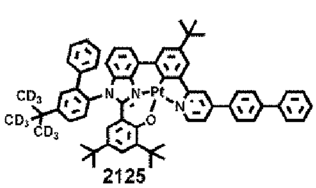
2125
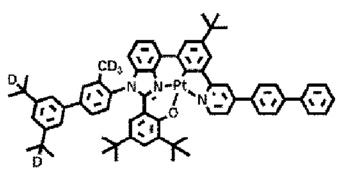
2126

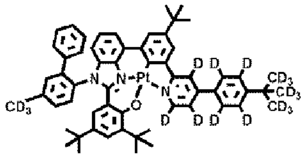
2127

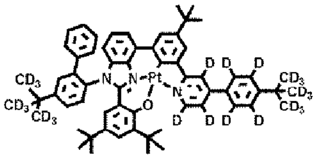
2128

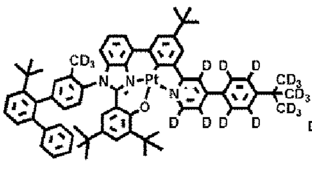
2129

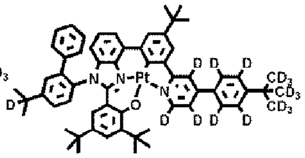
2130

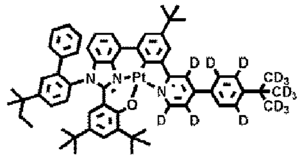
2131

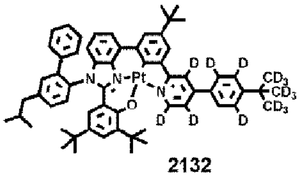
2132

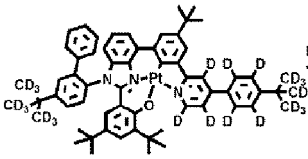
2133

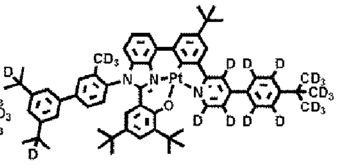
2134

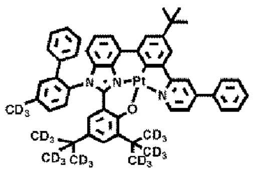
2135

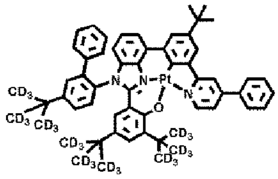
2136

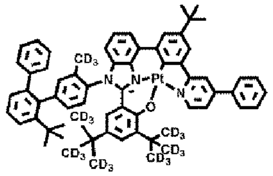
2137

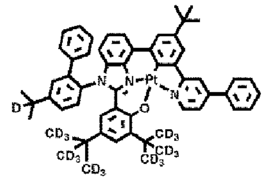
2138

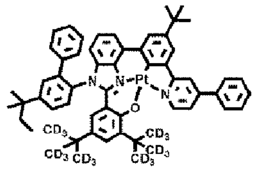
2139

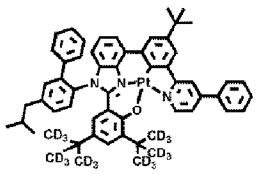
2140

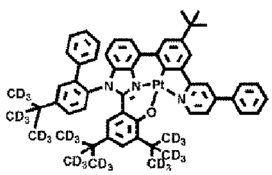
2141

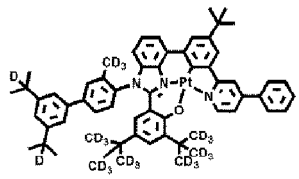
2142

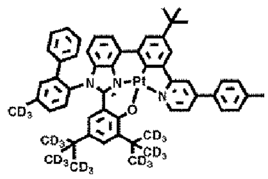
2143

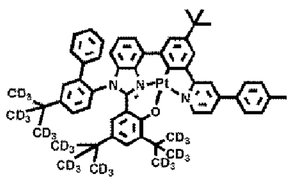
2144

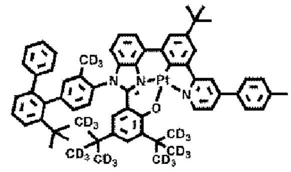
2145

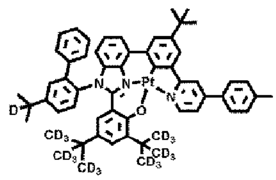
2146

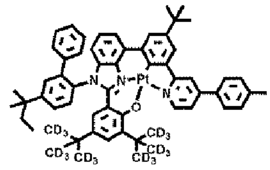
2147

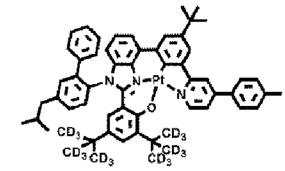
2148

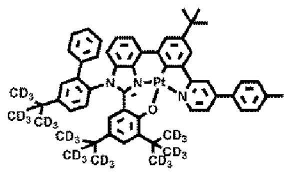
2149

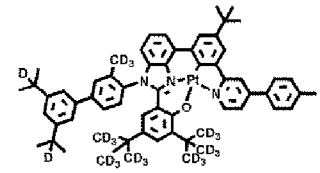
2150

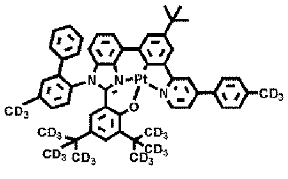
2151

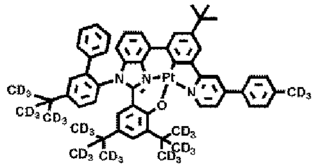
2152

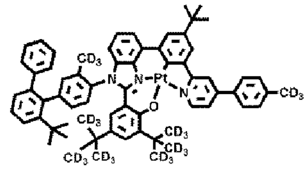
2153

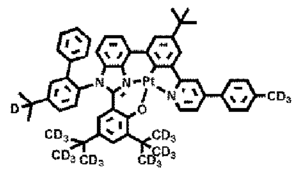
2154

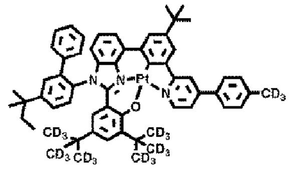
2155

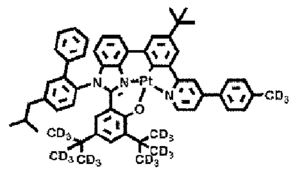
2156

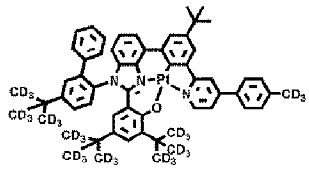
2157

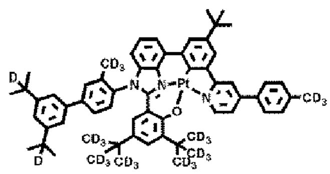
2158

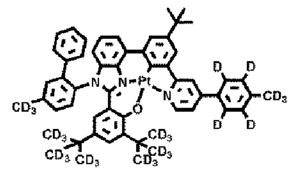
2159

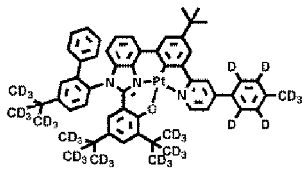
2160

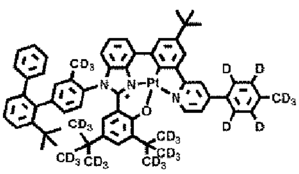
2161

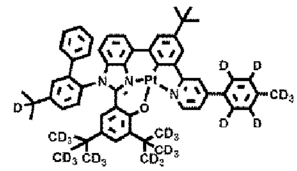
2162

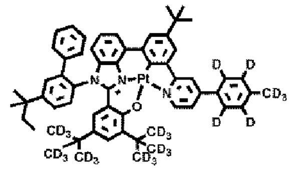
2163

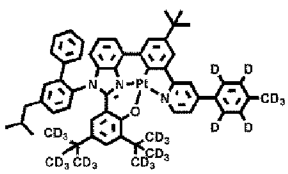
2164

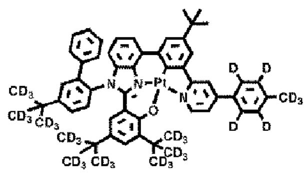
2165

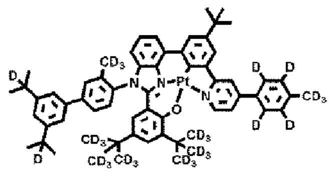
2166

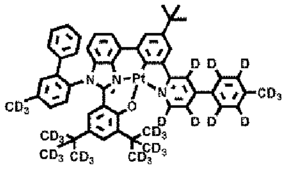
2167

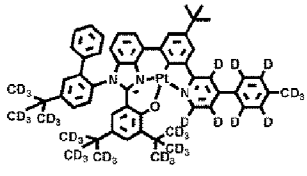
2168

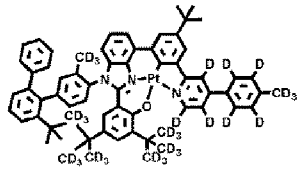
2169

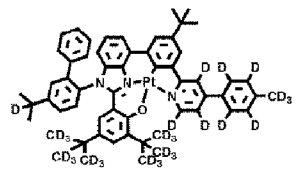
2170

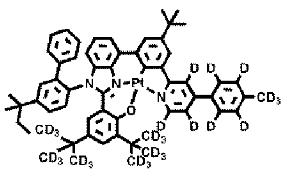
2171

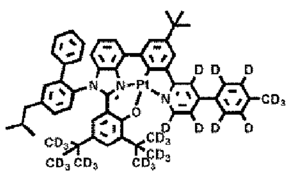
2172

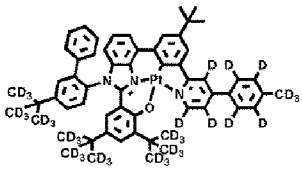
2173

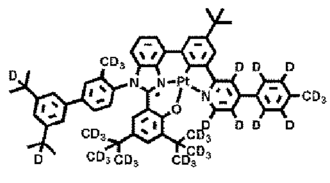
2174

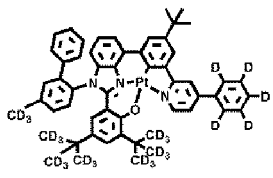
2175

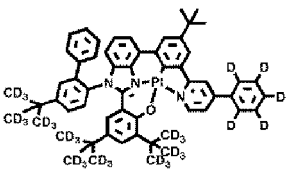
2176

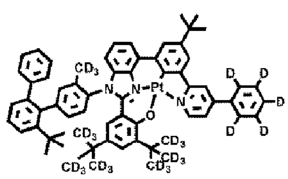
2177

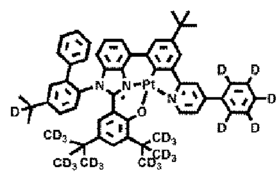
2178

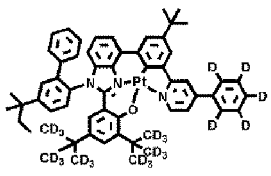
2179

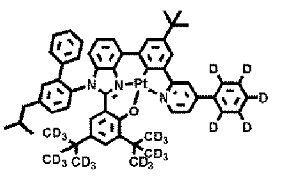
2180

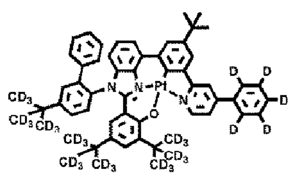
2181

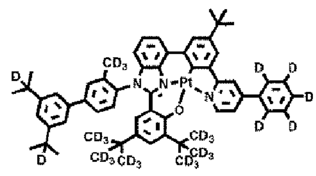
2182

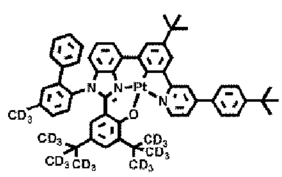
2183

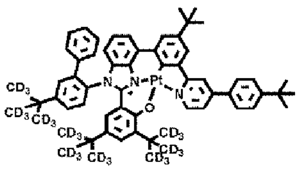
2184

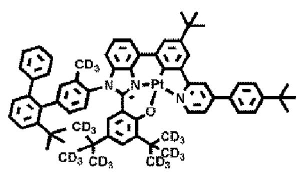
2185

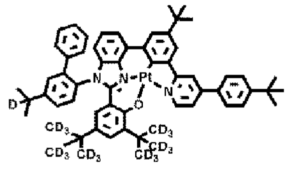
2186

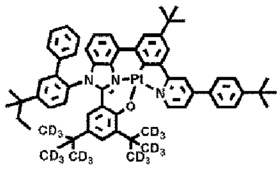
2187

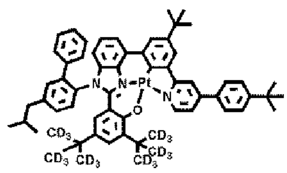
2188

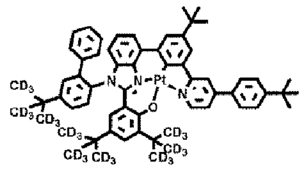
2189

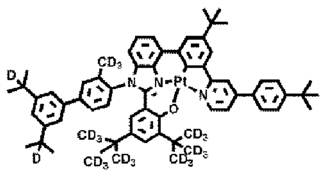
2190

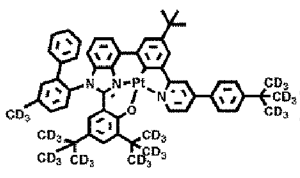
2191

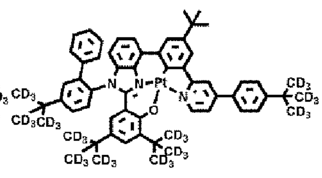
2192

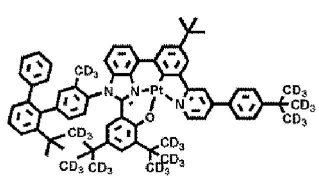
2193

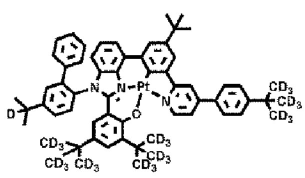
2194

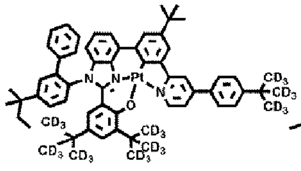
2195

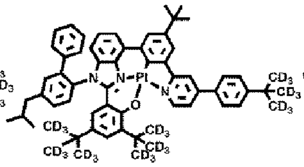
2196

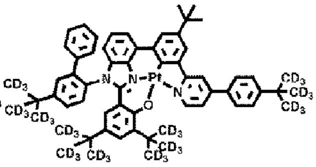
2197

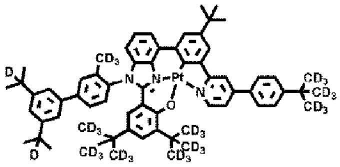
2198

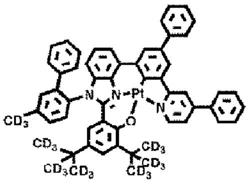
2199

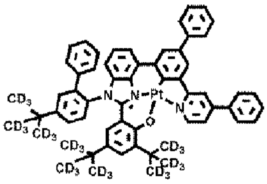
2200

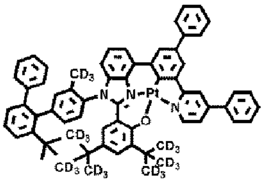
2201

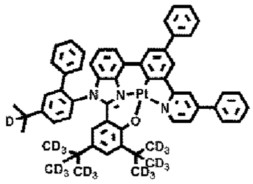
2202

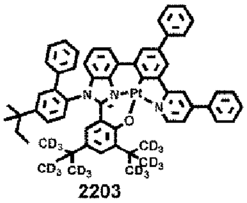
2203

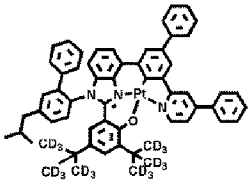
2204

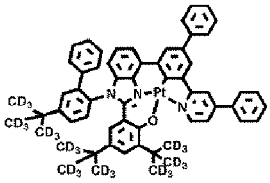
2205

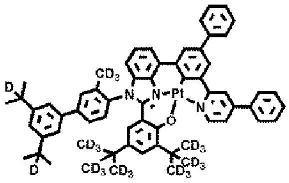
2206

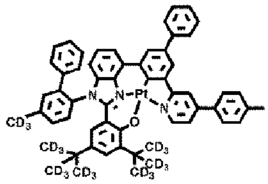
2207

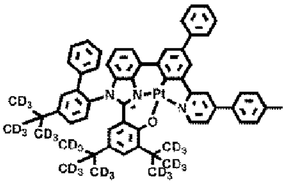
2208

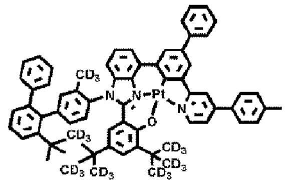
2209

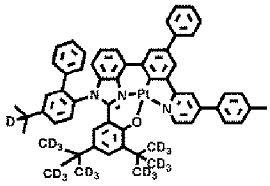
2210

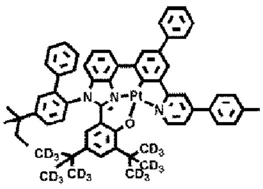
2211

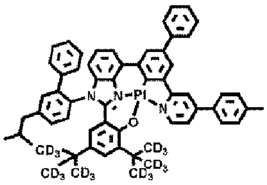
2212

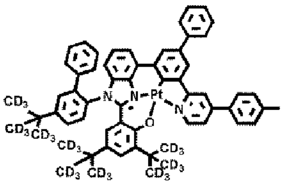
2213

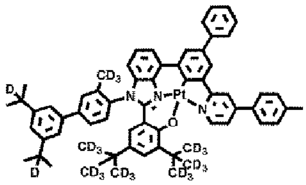
2214

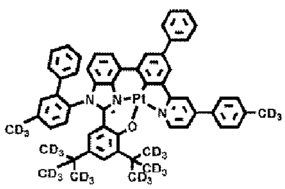
2215

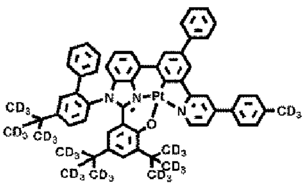
2216

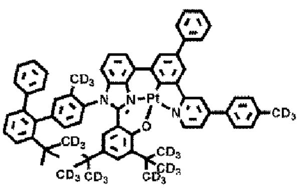
2217

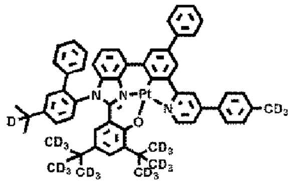
2218

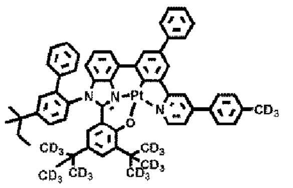

2219

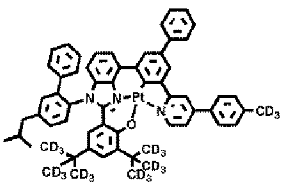

2220

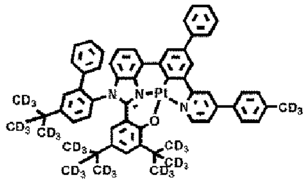

2221

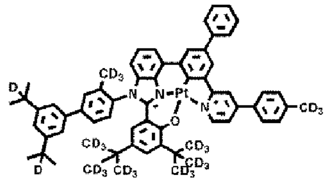

2222

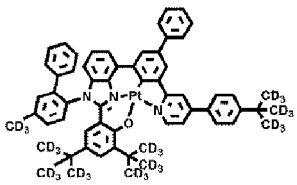

2223

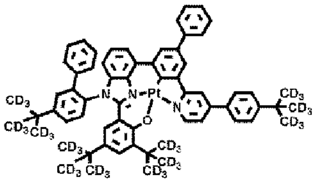

2224

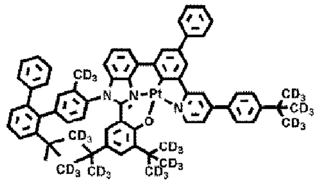

2225

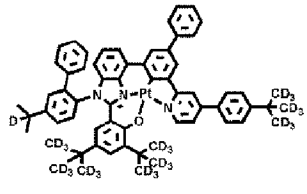

2226

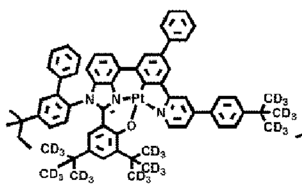

2227

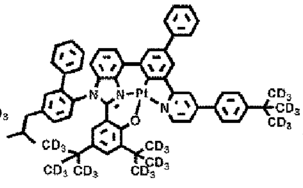

2228

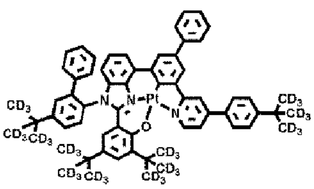

2229

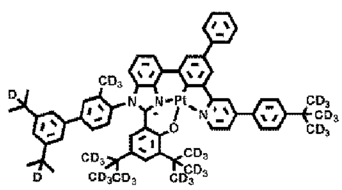

2230

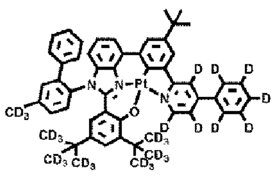

2231

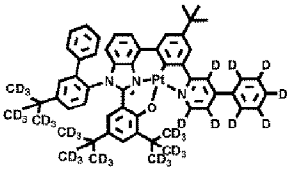

2232

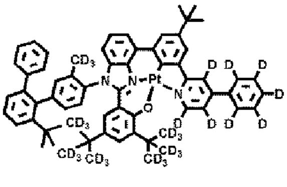

2233

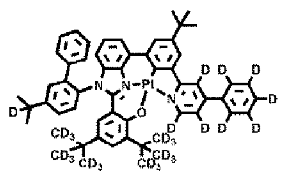

2234

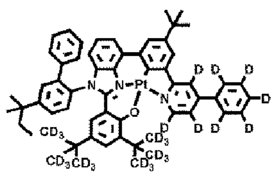

2235

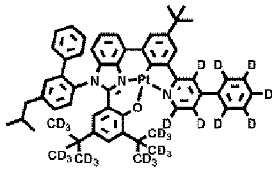

2236

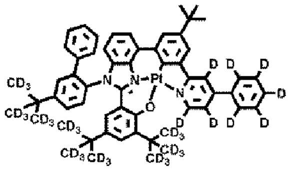

2237

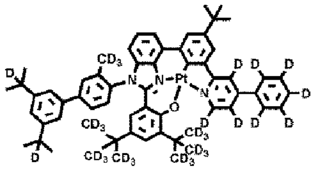

2238

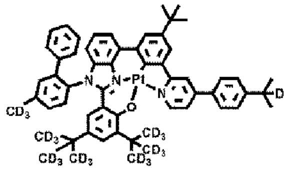

2239

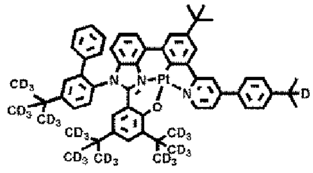

2240

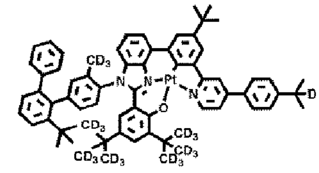

2241

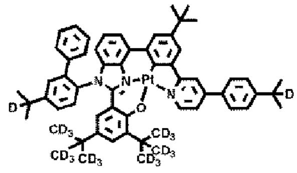

2242

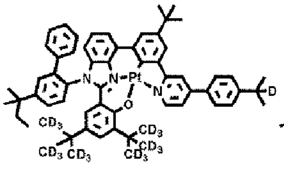
2243

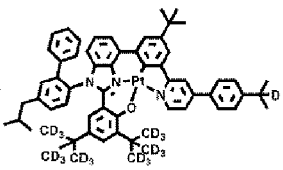
2244

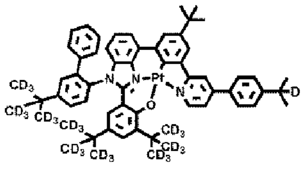
2245

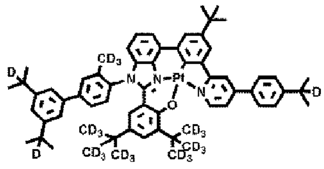
2246

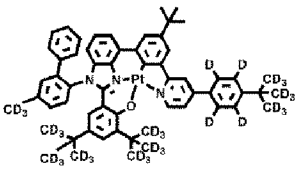
2247

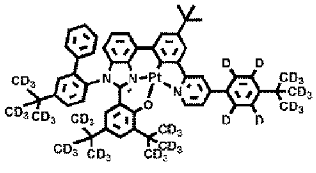
2248

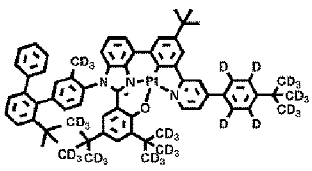
2249

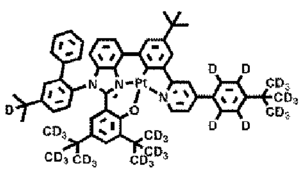
2250

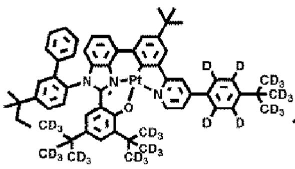
2251

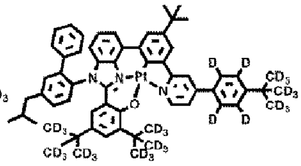
2252

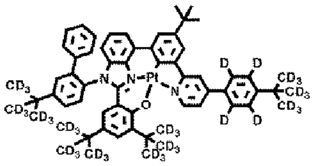
2253

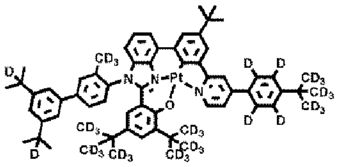
2254

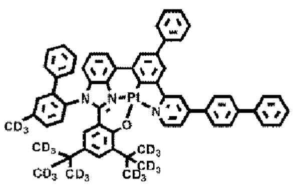
2255

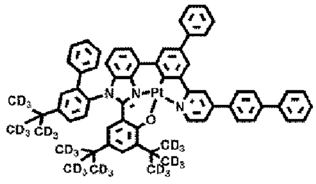
2256

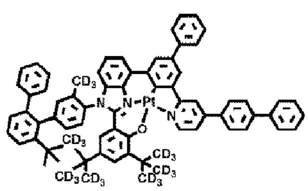
2257

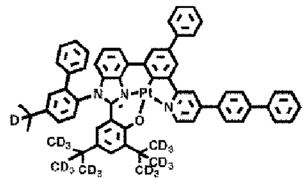
2258

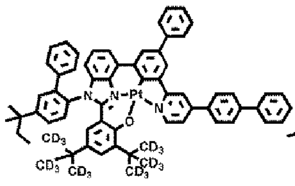
2259

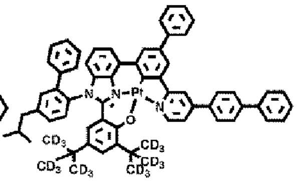
2260

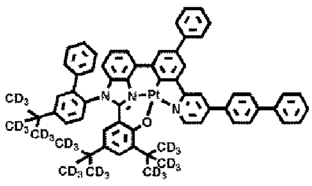
2261

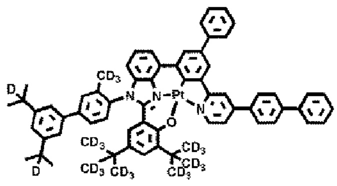
2262

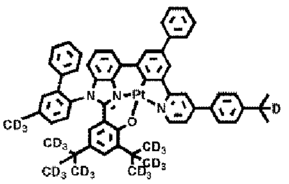
2263

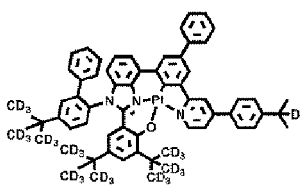
2264

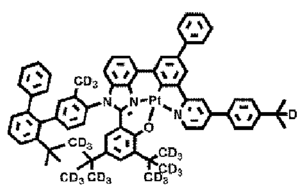
2265

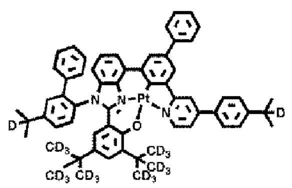
2266

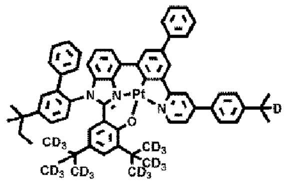
2267

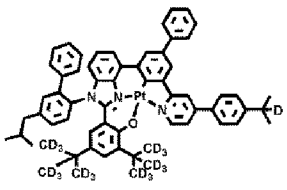
2268

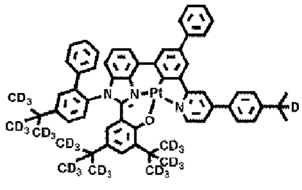
2269

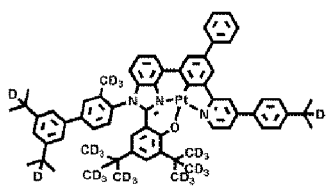
2270

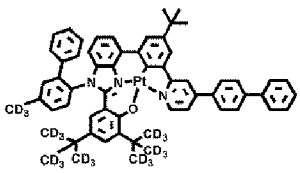
2271

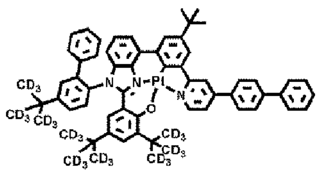
2272

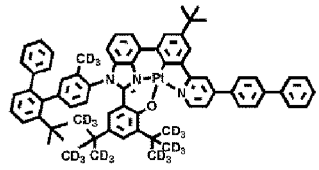
2273

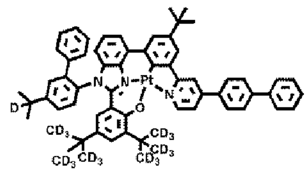
2274

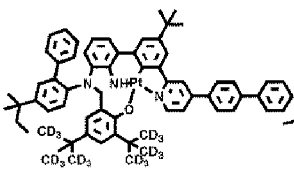
2275

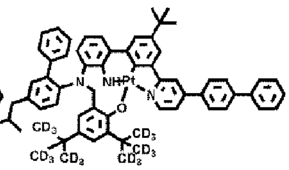
2276

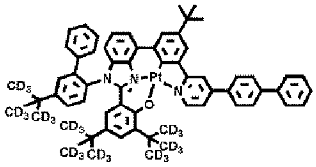
2277

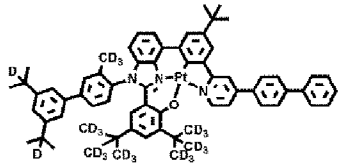
2278

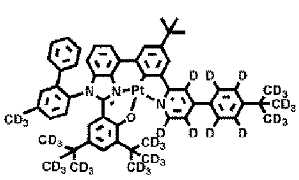
2279

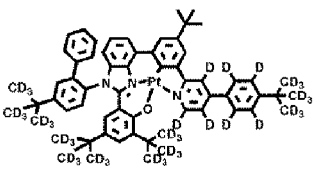
2280

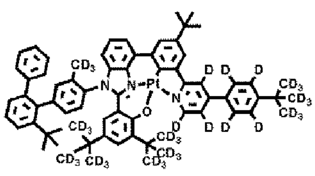
2281

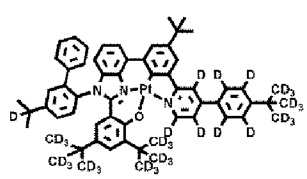
2282

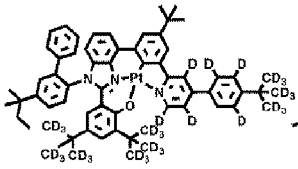
2283

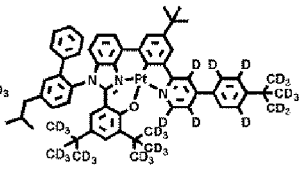
2284

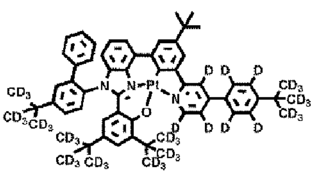
2285

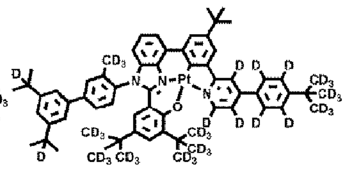
2286

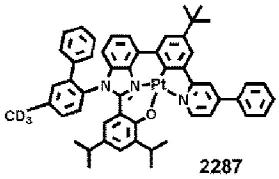
2287

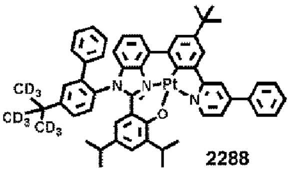
2288

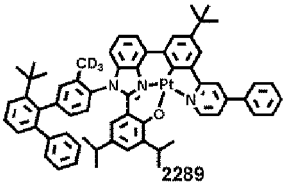
2289

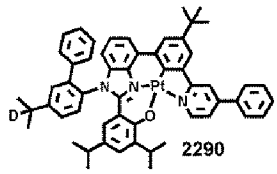
2290

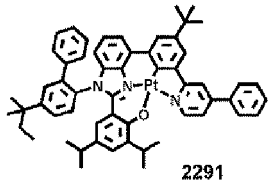
2291

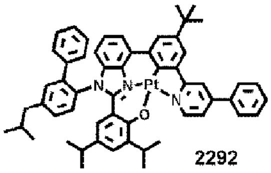
2292

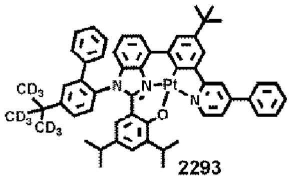
2293

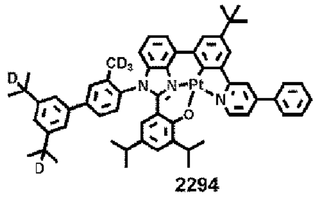
2294

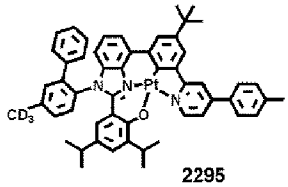
2295

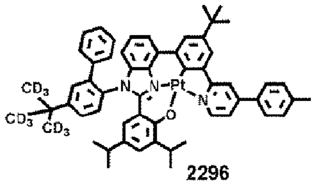
2296

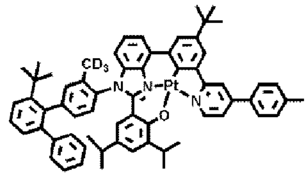
2297

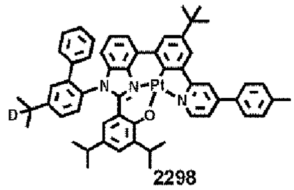
2298

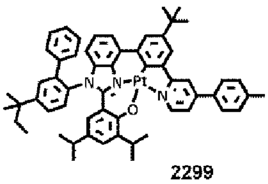
2299

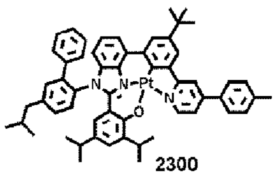
2300

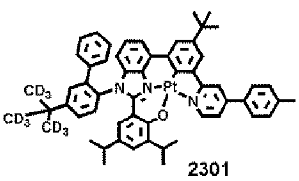
2301

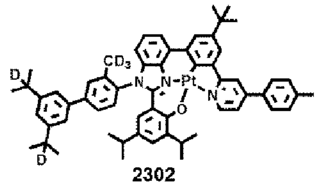
2302

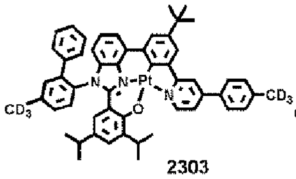
2303

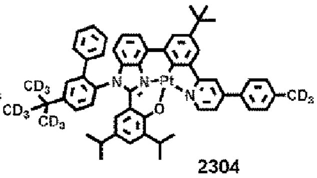
2304

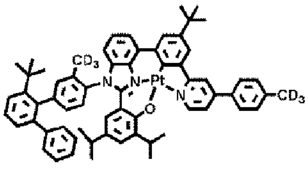
2305

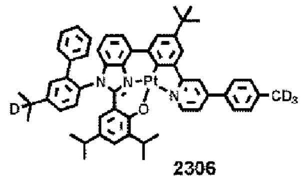
2306

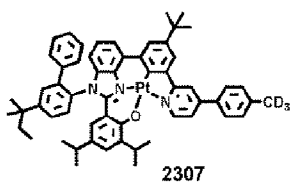
2307

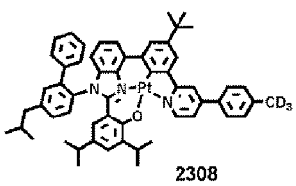
2308

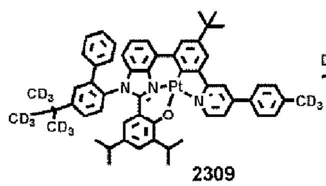
2309

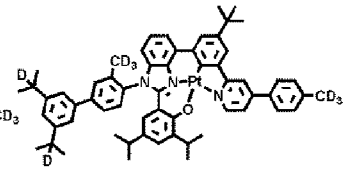
2310

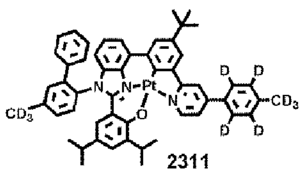
2311

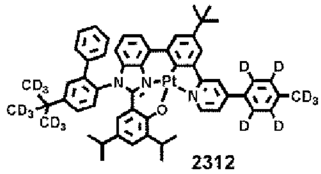
2312

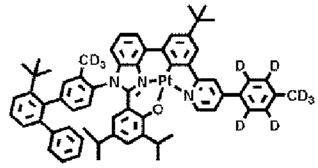
2313

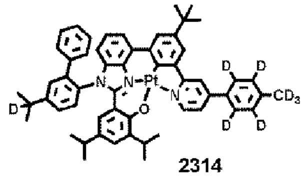
2314

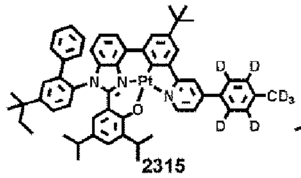
2315

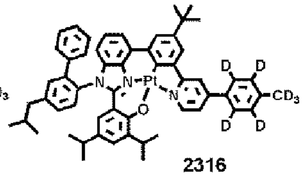
2316

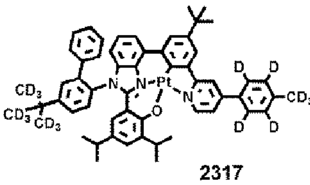
2317

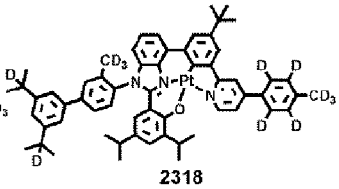
2318

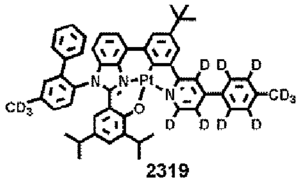
2319

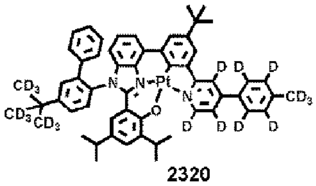
2320

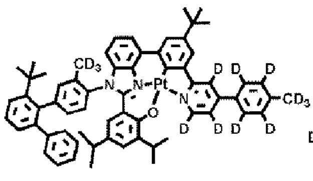
2321

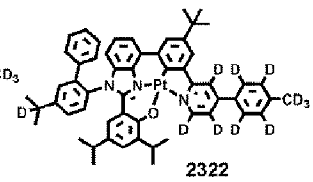
2322

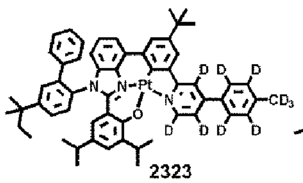
2323

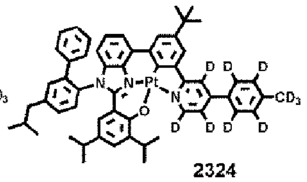
2324

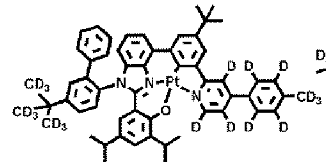
2325

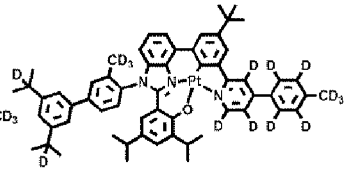
2326

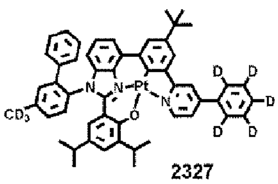
2327

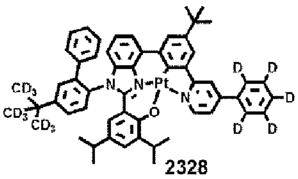
2328

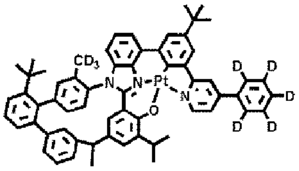
2329

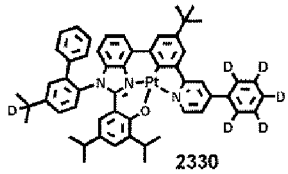
2330

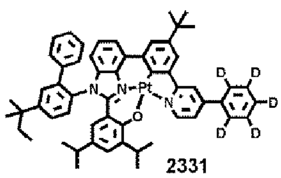
2331

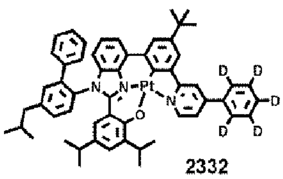
2332

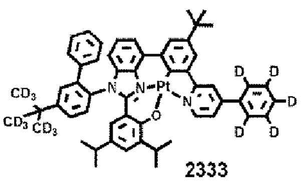
2333

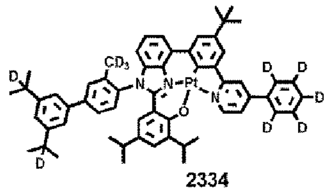
2334

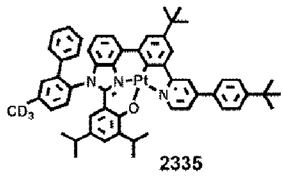
2335

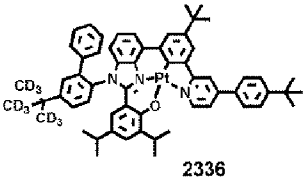
2336

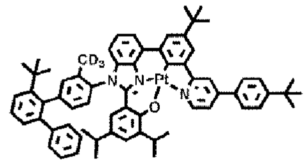
2337

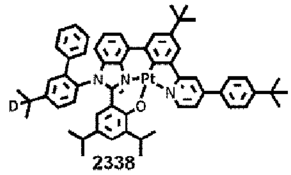
2338

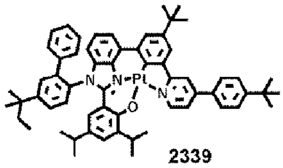
2339

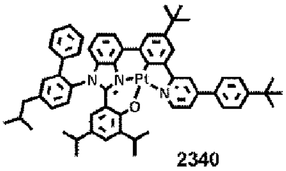
2340

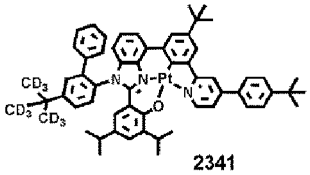
2341

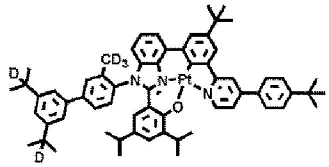
2342

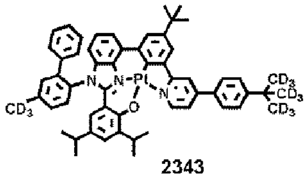
2343

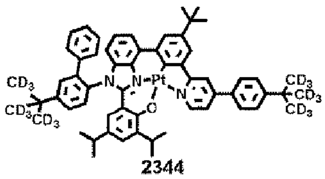
2344

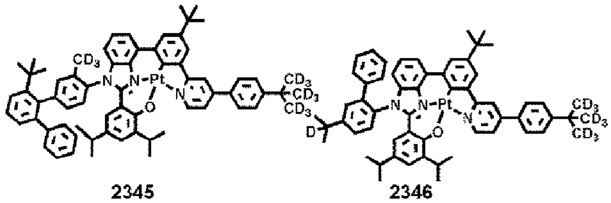
2345

2346

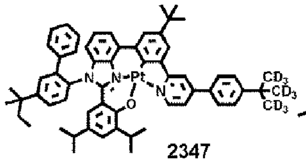
2347

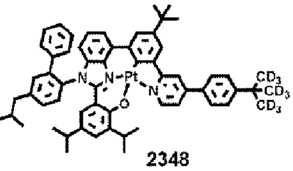
2348

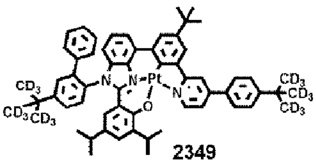
2349

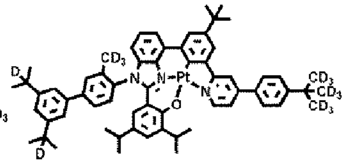
2350

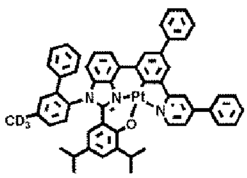
2351

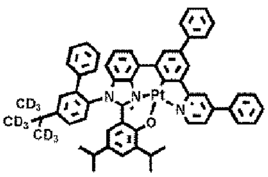
2352

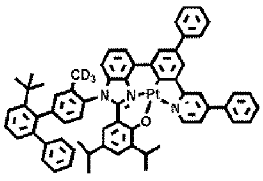
2353

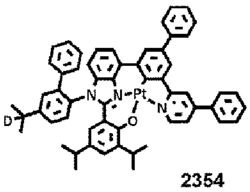
2354

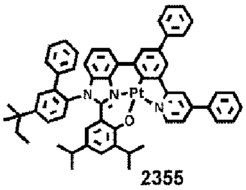
2355

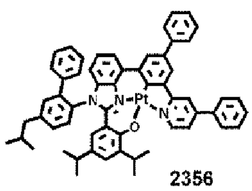
2356

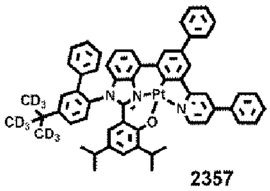
2357

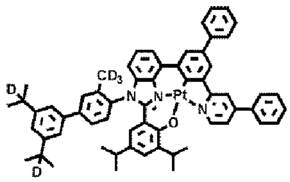
2358

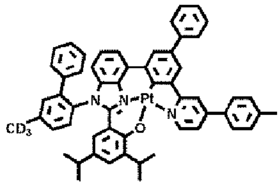
2359

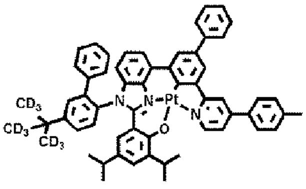
2360

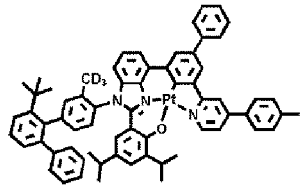
2361

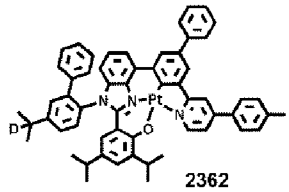
2362

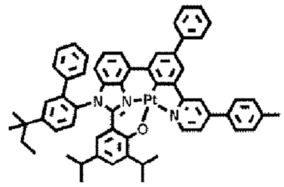
2363

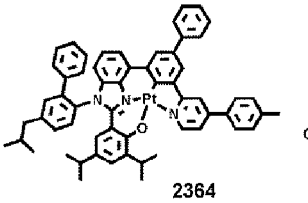
2364

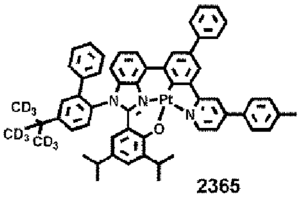
2365

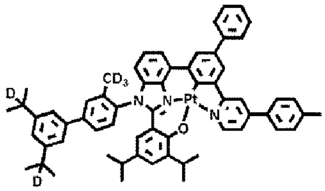
2366

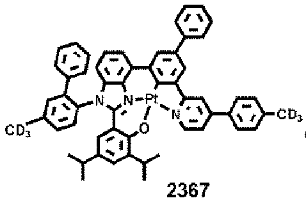
2367

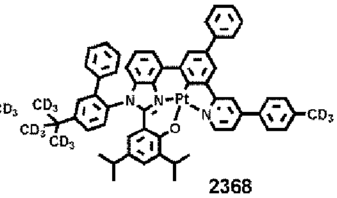
2368

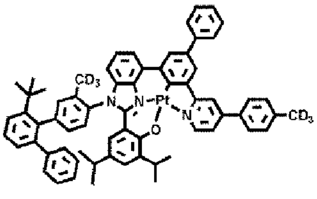
2369

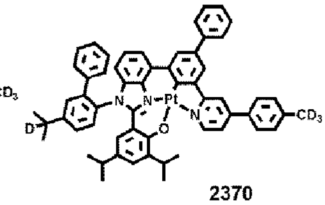
2370

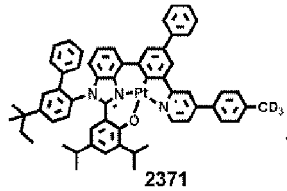
2371

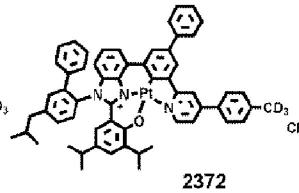
2372

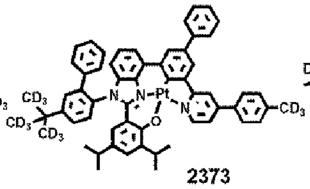
2373

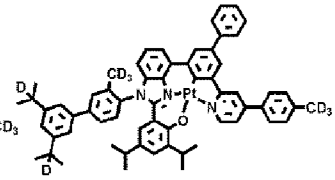
2374

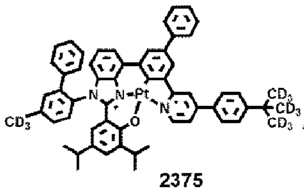
2375

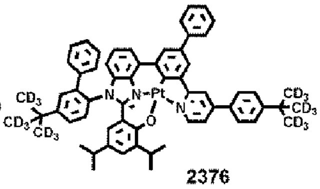
2376

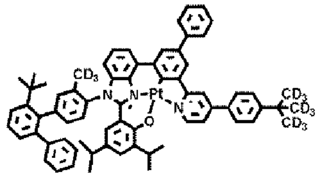
2377

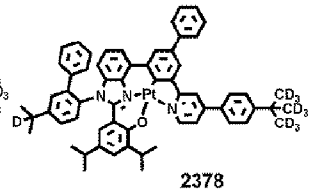
2378

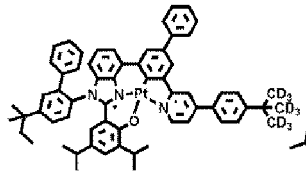
2379

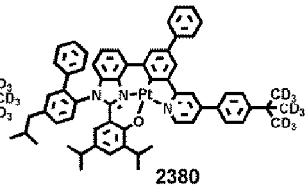
2380

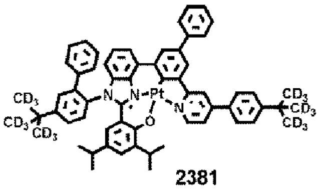
2381

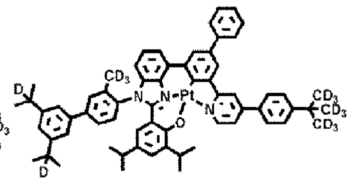
2382

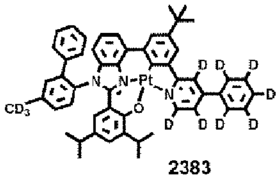
2383

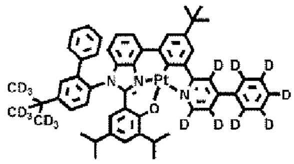
2384

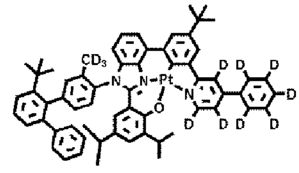
2385

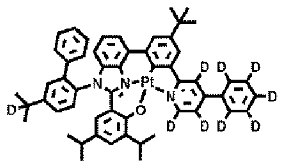
2386

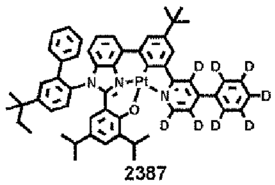
2387

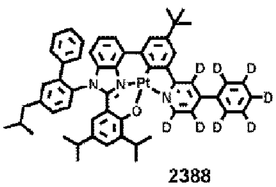
2388

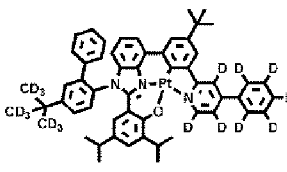
2389

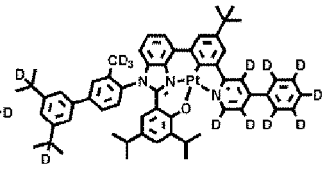
2390

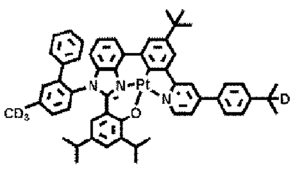
2391

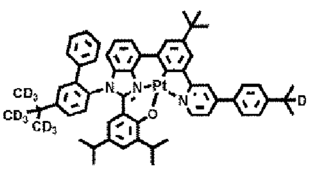
2392

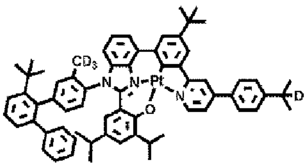
2393

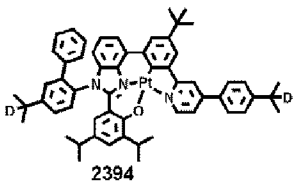
2394

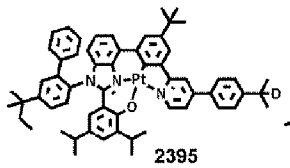
2395

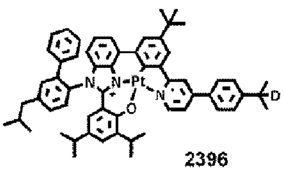
2396

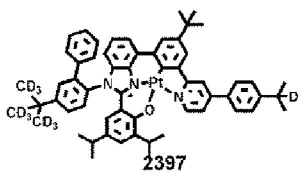
2397

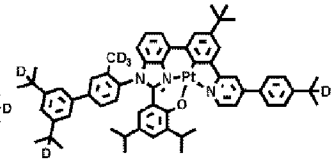
2398

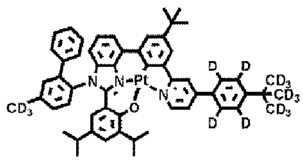
2399

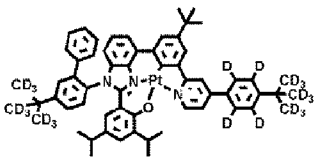
2400

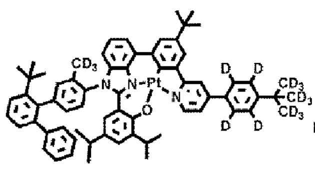
2401

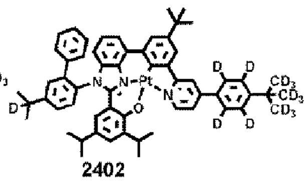
2402

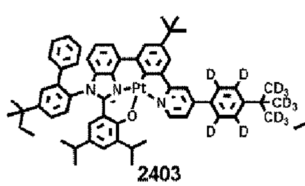
2403

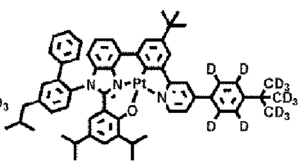
2404

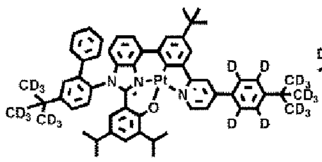
2405

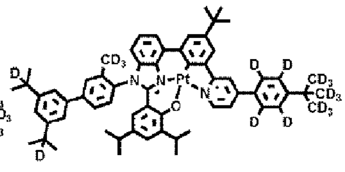
2406

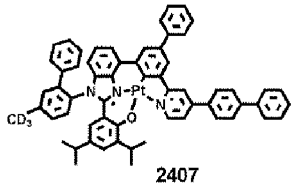
2407
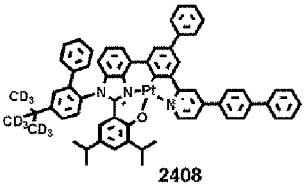
2408
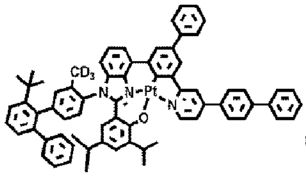
2409
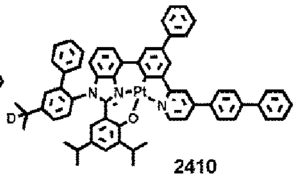
2410

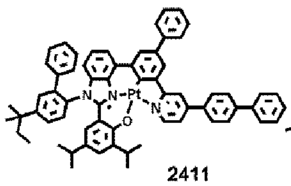
2411
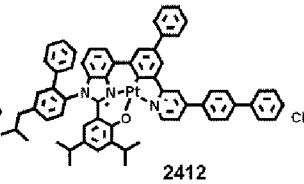
2412
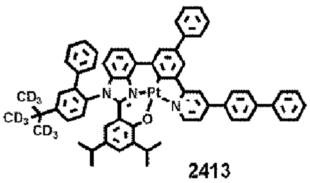
2413
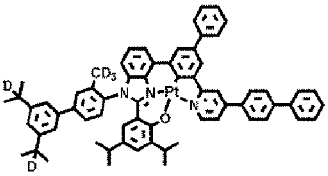
2414

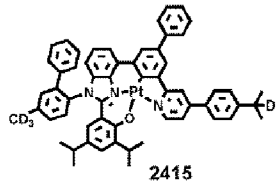
2415
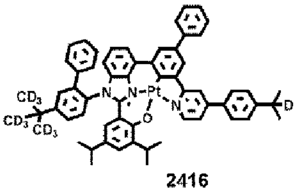
2416
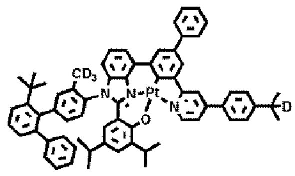
2417
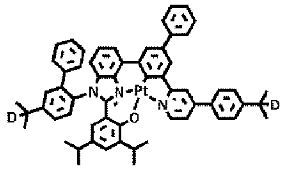
2418

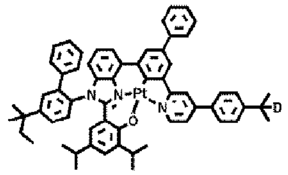
2419
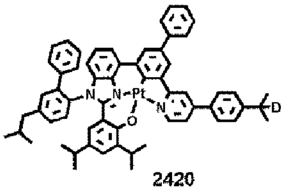
2420
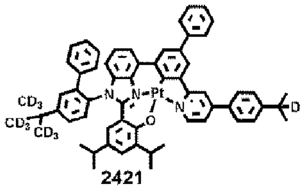
2421
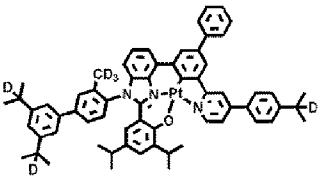
2422

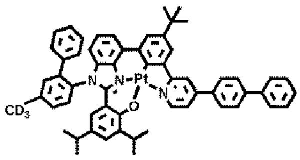
2423
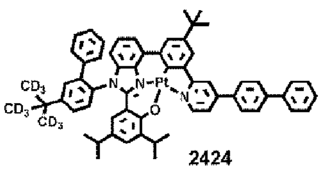
2424
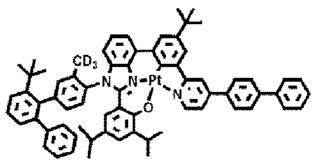
2425
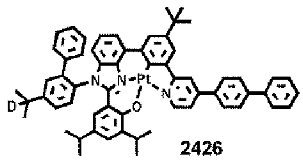
2426

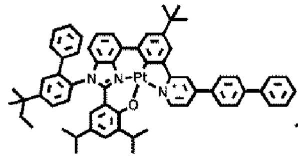
2427
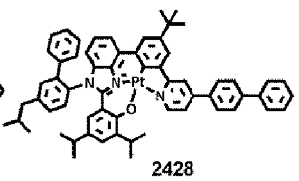
2428
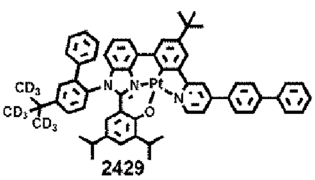
2429
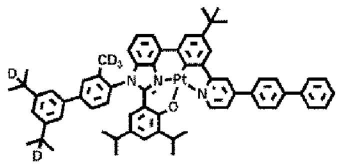
2430

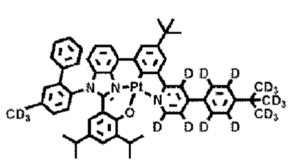
2431
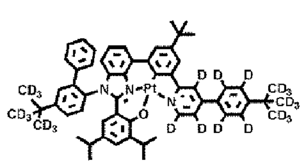
2432
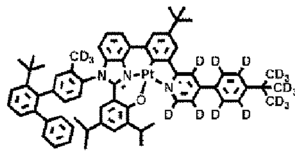
2433
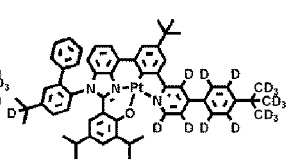
2434

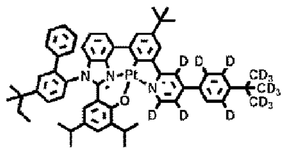
2435
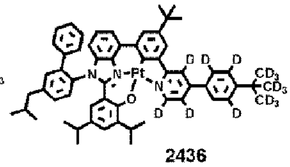
2436
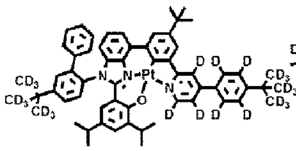
2437
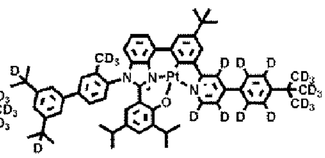
2438

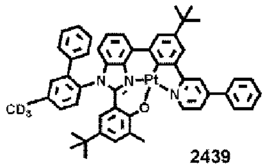
2439
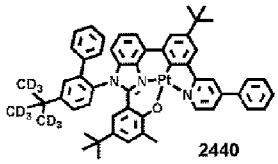
2440
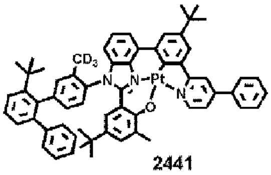
2441
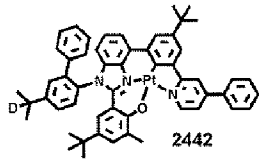
2442

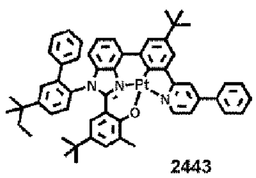
2443
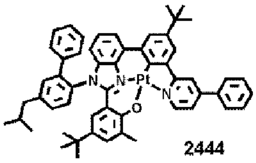
2444
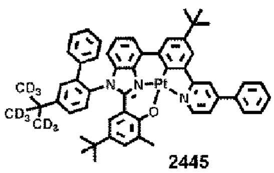
2445
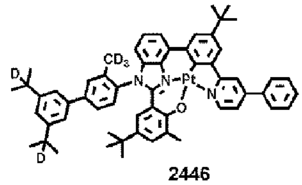
2446

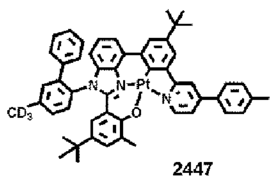
2447
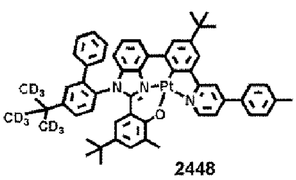
2448
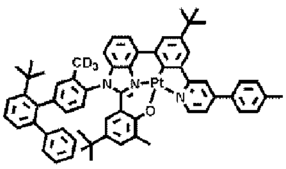
2449
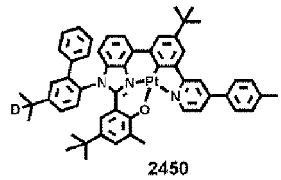
2450

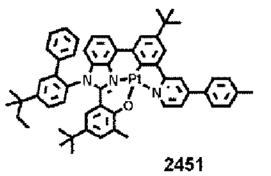
2451
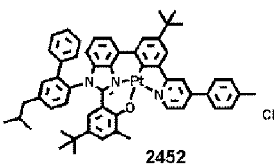
2452
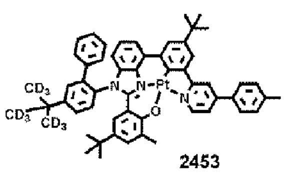
2453
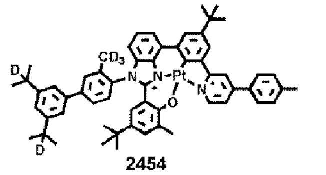
2454

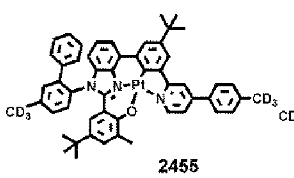
2455
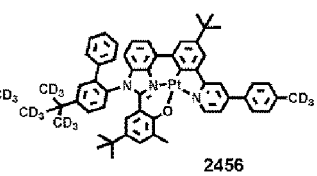
2456
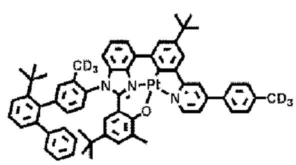
2457
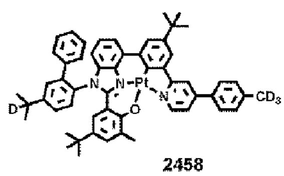
2458

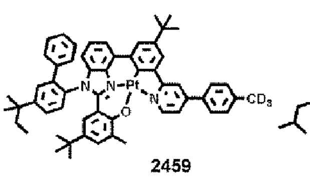
2459
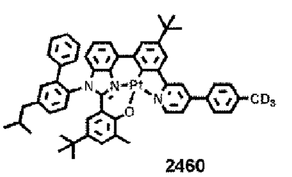
2460
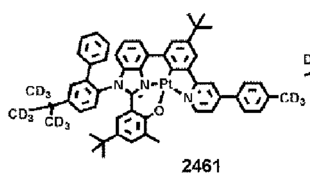
2461
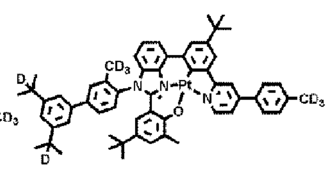
2462

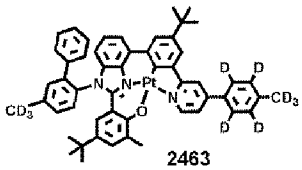
2463

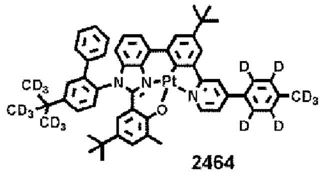
2464

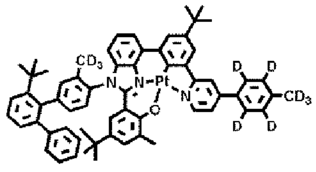
2465

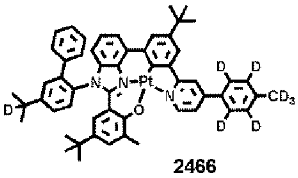
2466

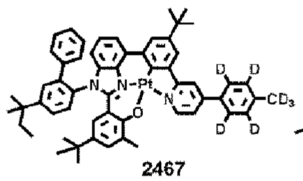
2467

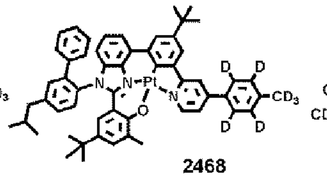
2468

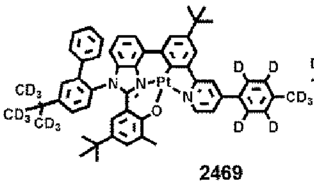
2469

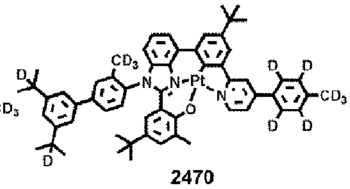
2470

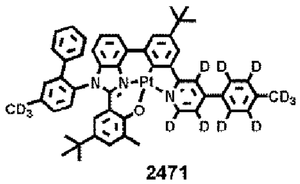
2471

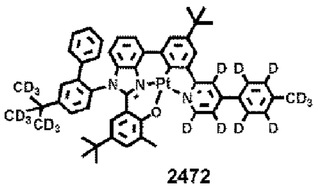
2472

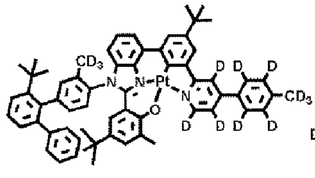
2473

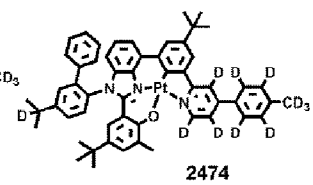
2474

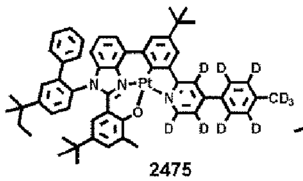
2475

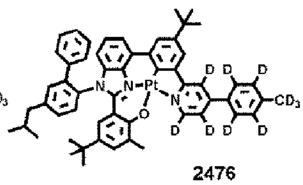
2476

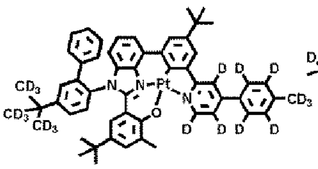
2477

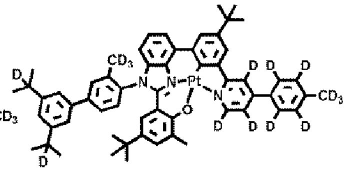
2478

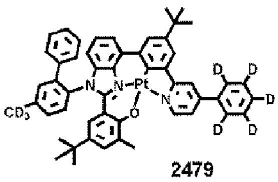
2479

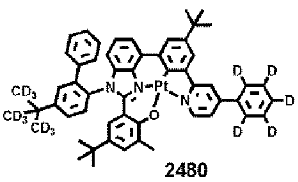
2480

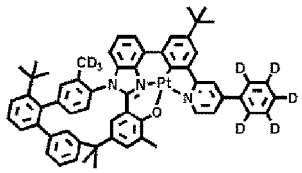
2481

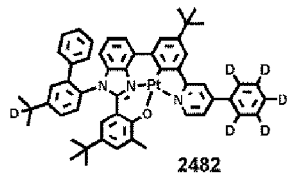
2482

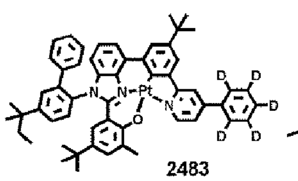
2483

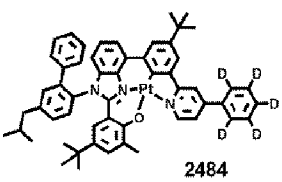
2484

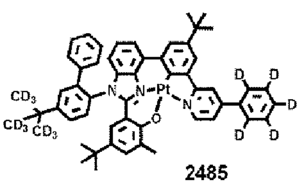
2485

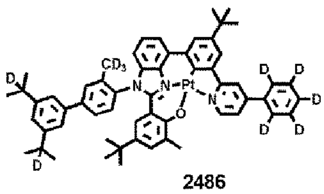
2486

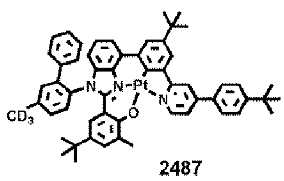

2487

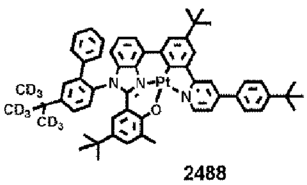

2488

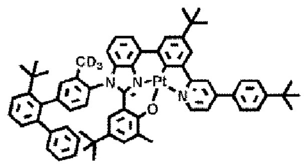

2489

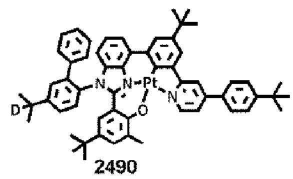

2490

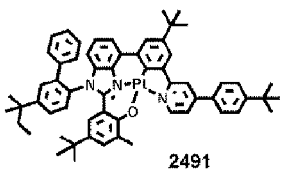

2491

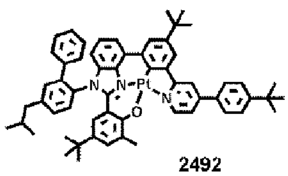

2492

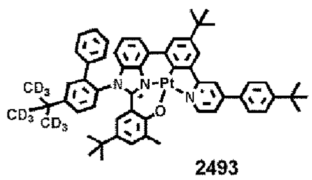

2493

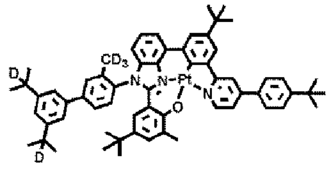

2494

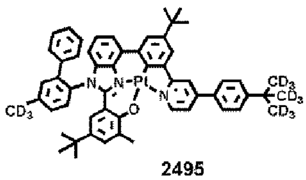

2495

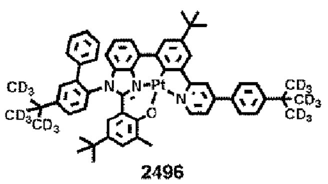

2496

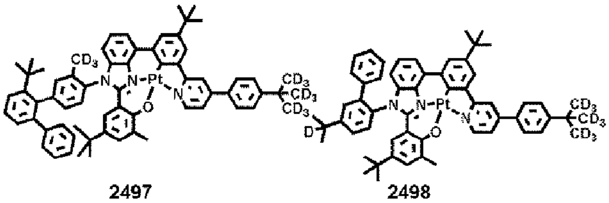

2497

2498

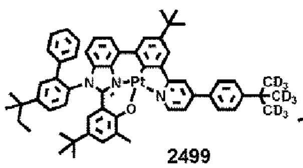

2499

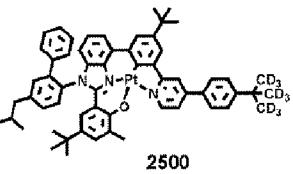

2500

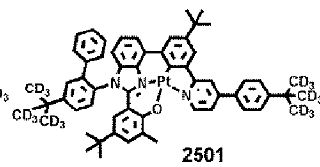

2501

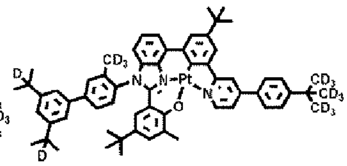

2502

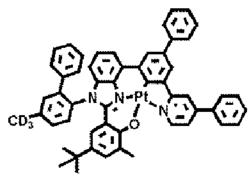

2503

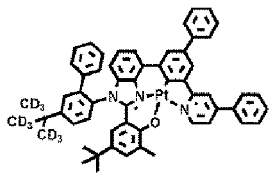

2504

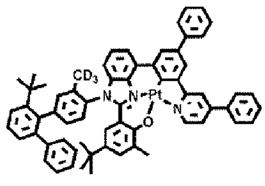

2505

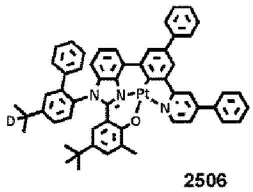

2506

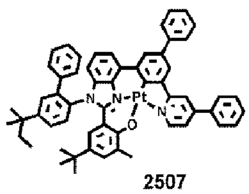

2507

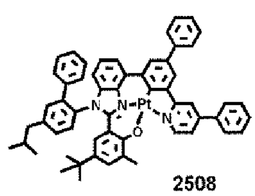

2508

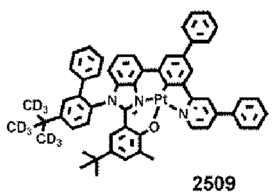

2509

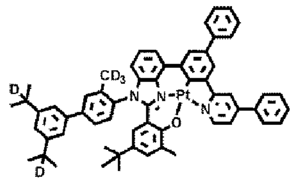

2510

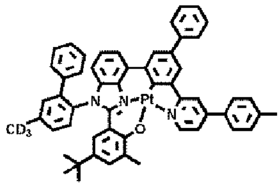
2511
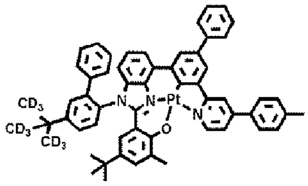
2512
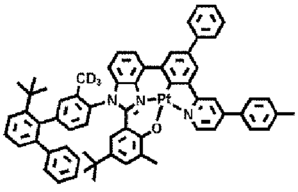
2513
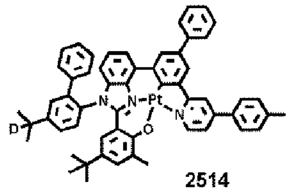
2514

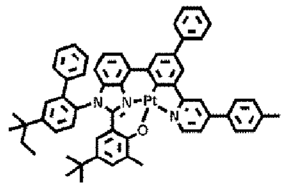
2515
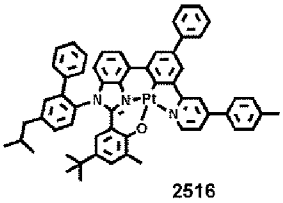
2516
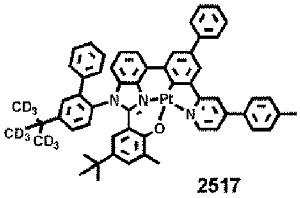
2517
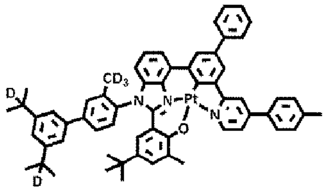
2518

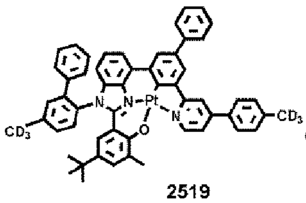
2519
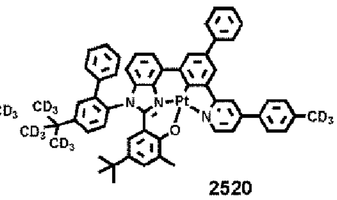
2520
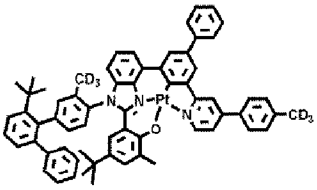
2521
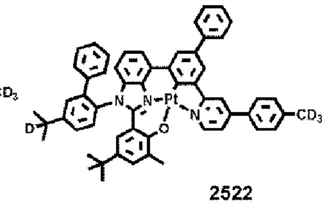
2522

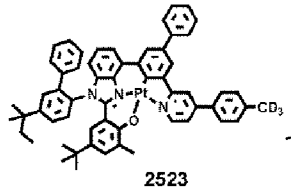
2523
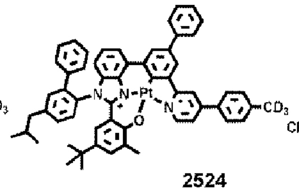
2524
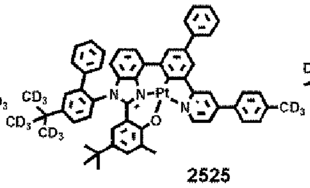
2525
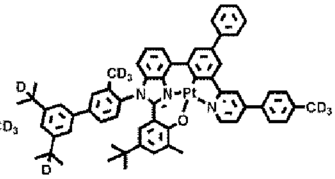
2526

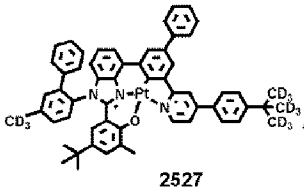
2527
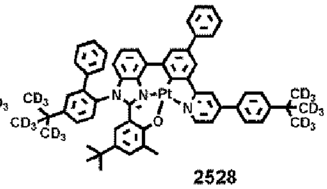
2528
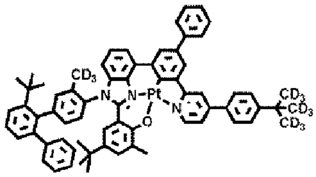
2529
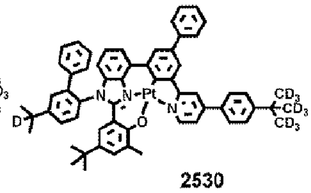
2530

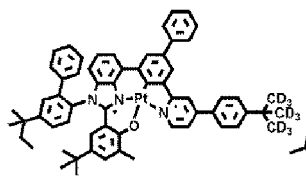
2531
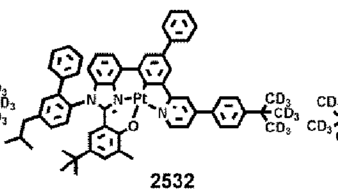
2532
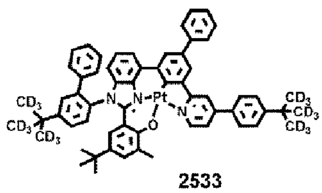
2533
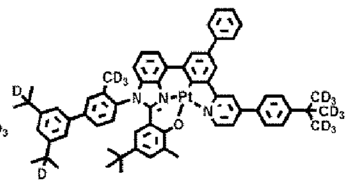
2534

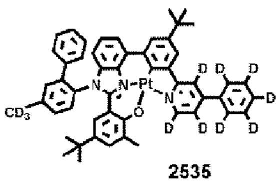
2535

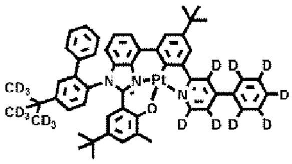
2536

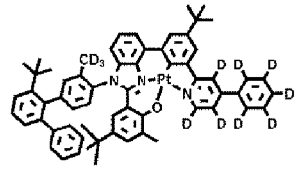
2537

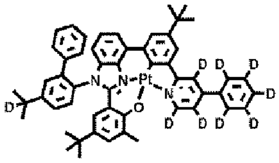
2538

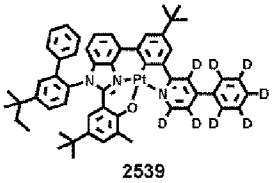
2539

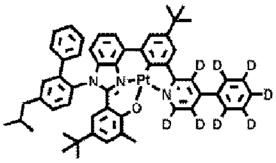
2540

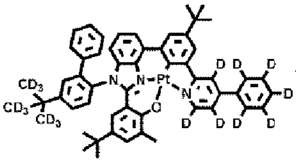
2541

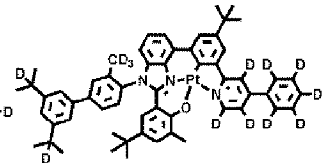
2542

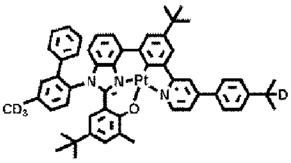
2543

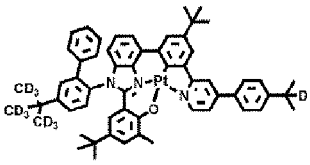
2544

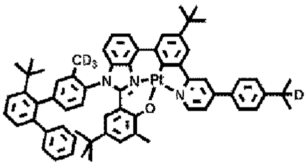
2545

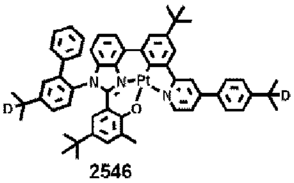
2546

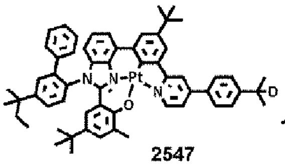
2547

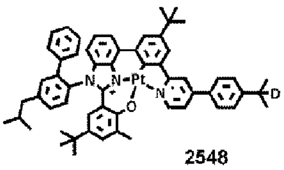
2548

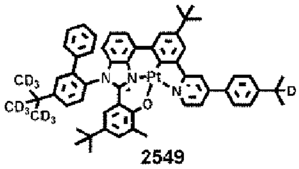
2549

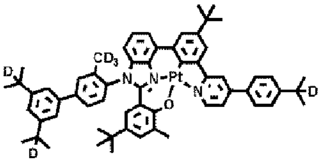
2550

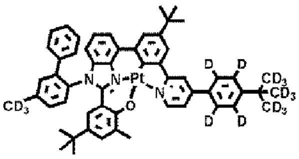
2551

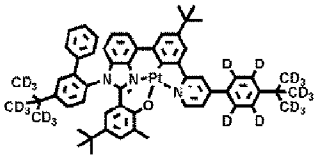
2552

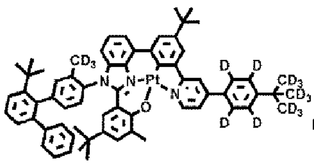
2553

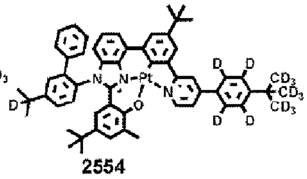
2554

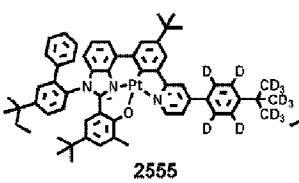
2555

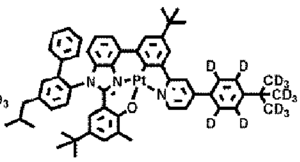
2556

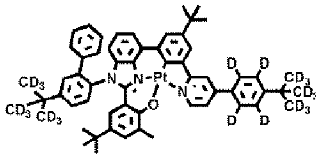
2557

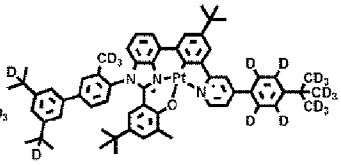
2558

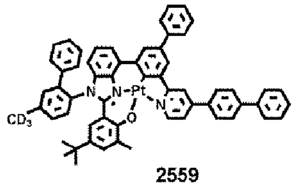
2559

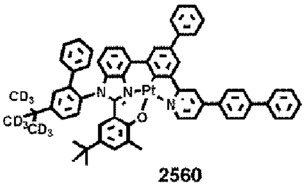
2560

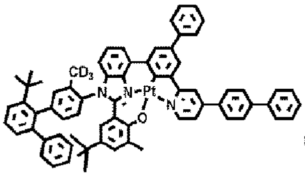
2561

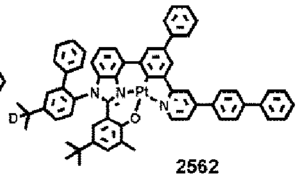
2562

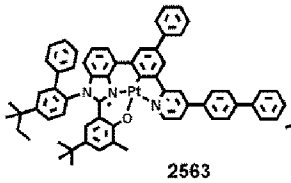
2563

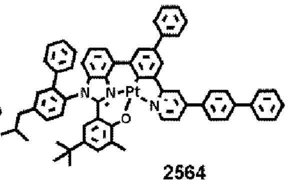
2564

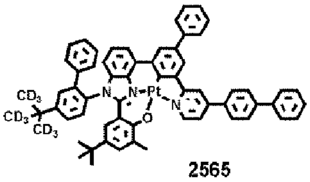
2565

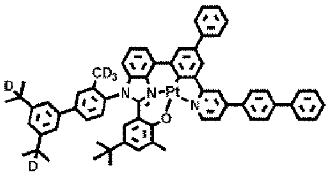
2566

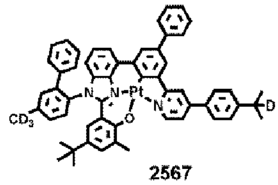
2567

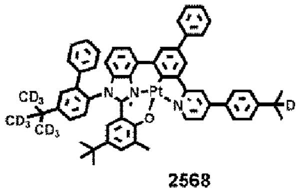
2568

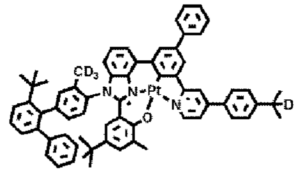
2569

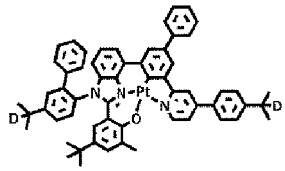
2570

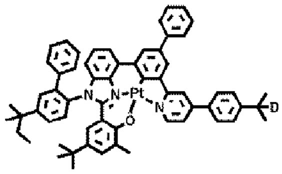
2571

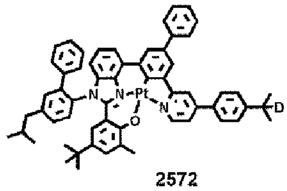
2572

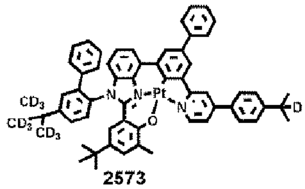
2573

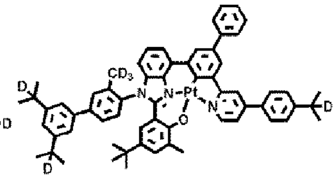
2574

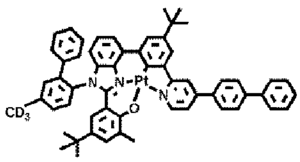
2575

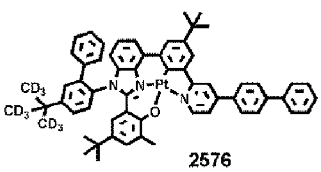
2576

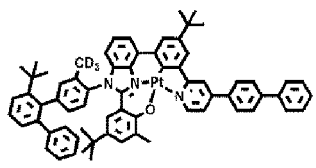
2577

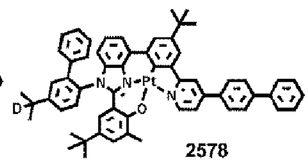
2578

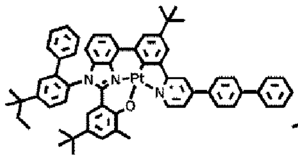
2579

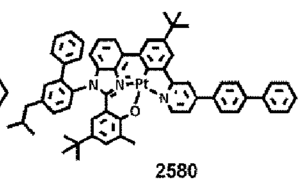
2580

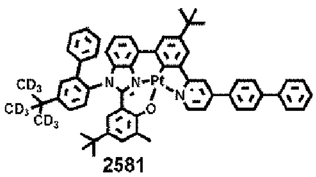
2581

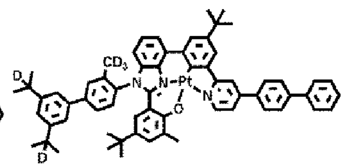
2582

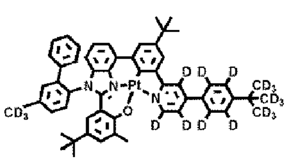
2583
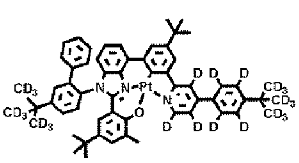
2584
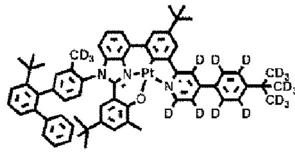
2585
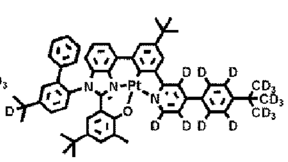
2586

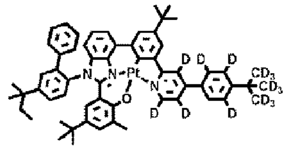
2587
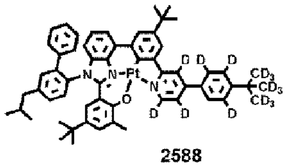
2588
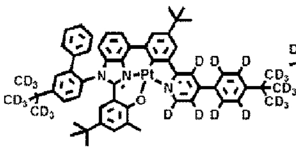
2589
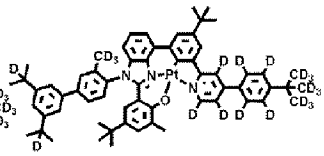
2590

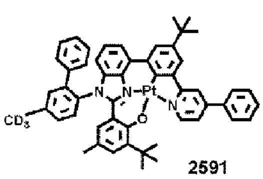
2591
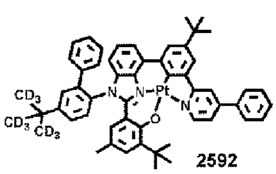
2592
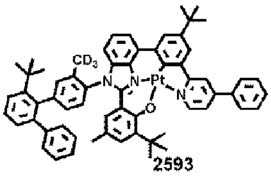
2593
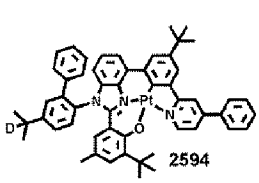
2594

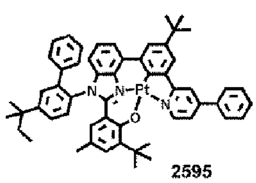
2595
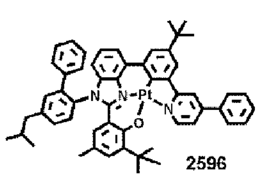
2596
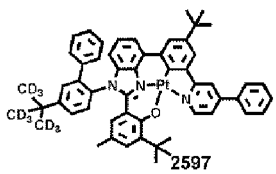
2597
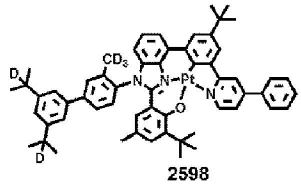
2598

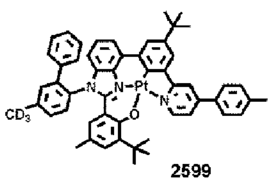
2599
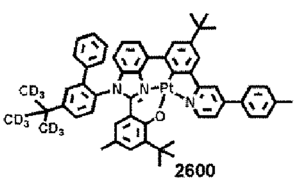
2600
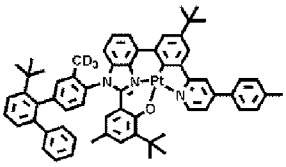
2601
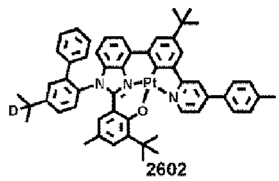
2602

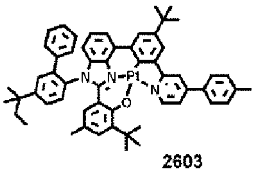
2603
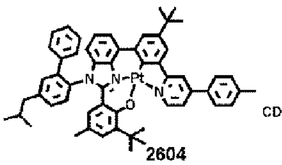
2604
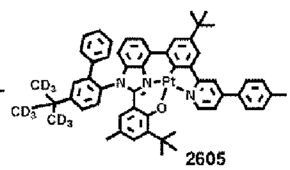
2605
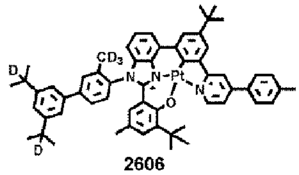
2606

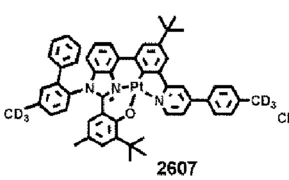
2607
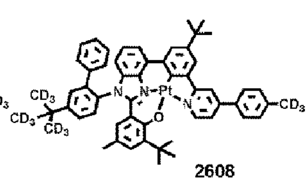
2608
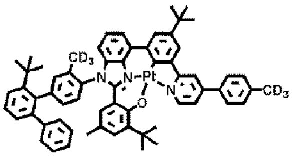
2609
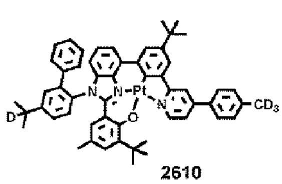
2610

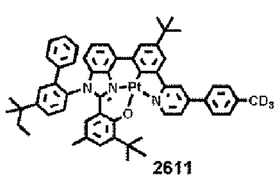
2611
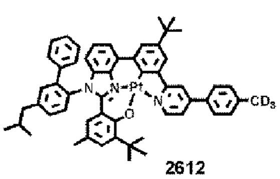
2612
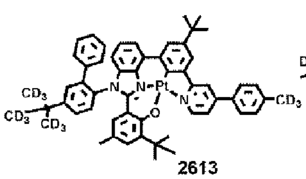
2613
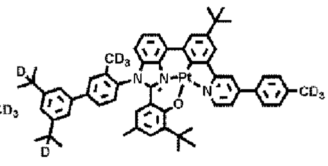
2614

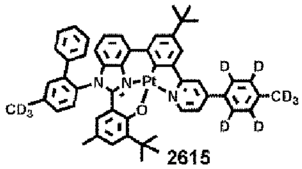
2615

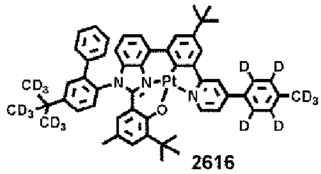
2616

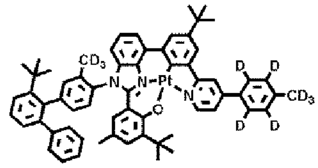
2617

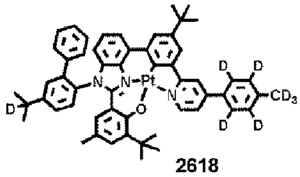
2618

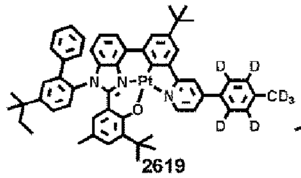
2619

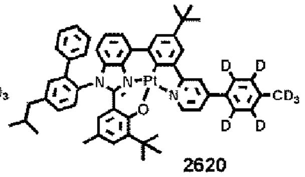
2620

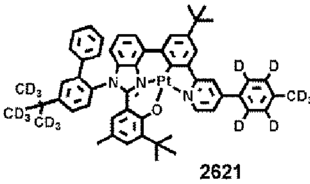
2621

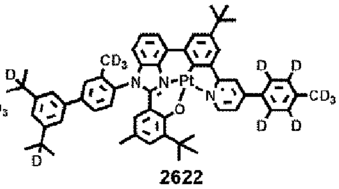
2622

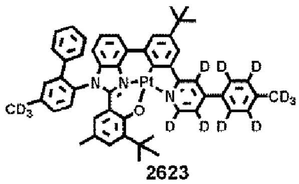
2623

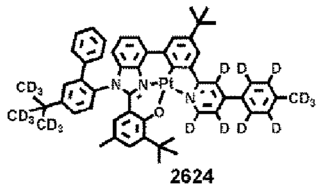
2624

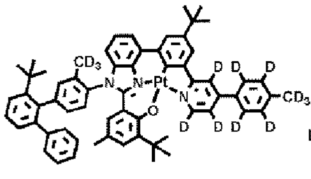
2625

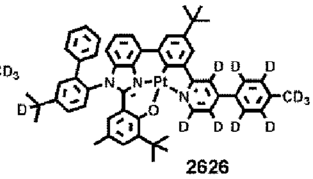
2626

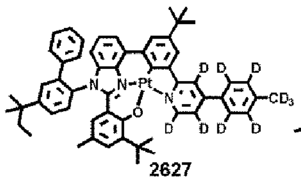
2627

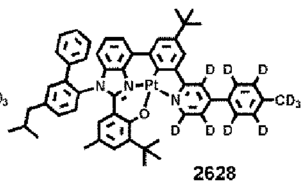
2628

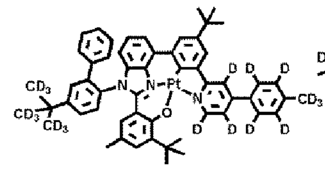
2629

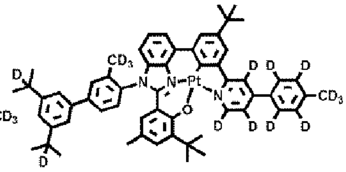
2630

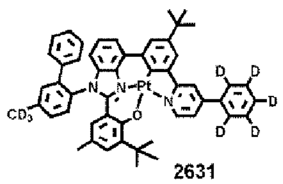
2631

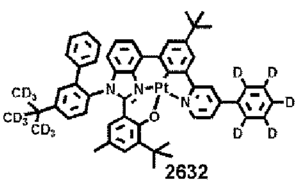
2632

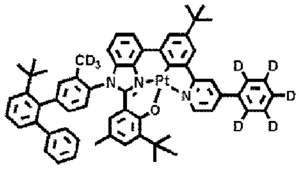
2633

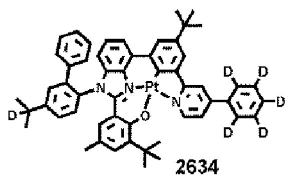
2634

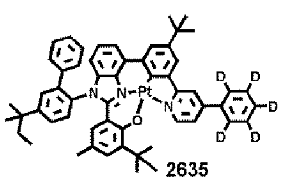
2635

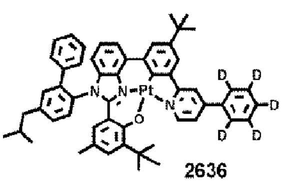
2636

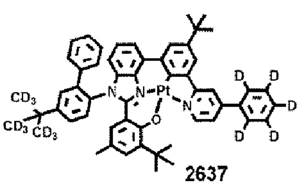
2637

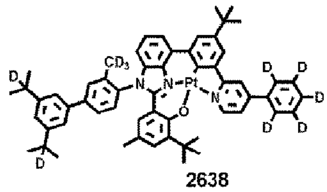
2638

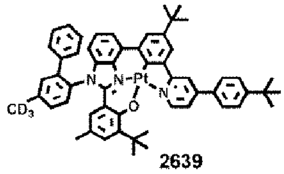
2639
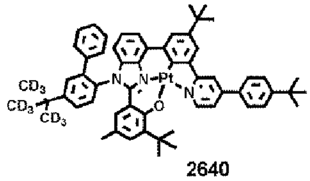
2640
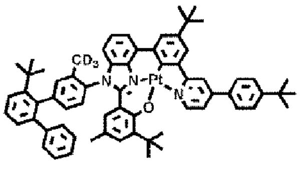
2641
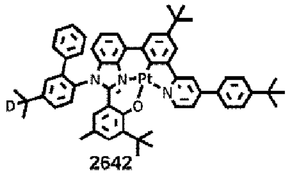
2642

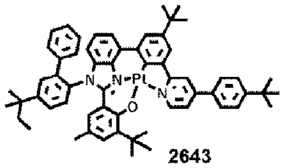
2643
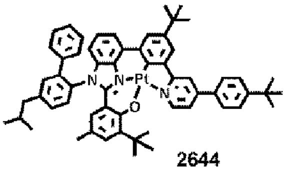
2644
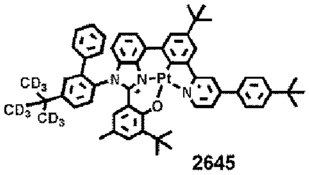
2645
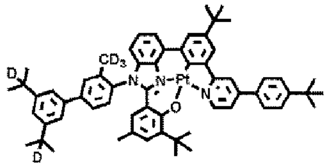
2646

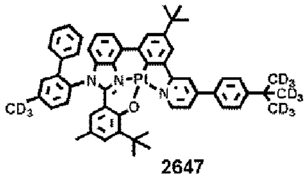
2647
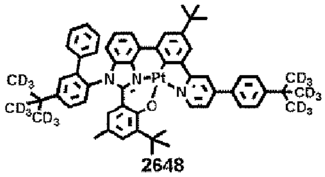
2648
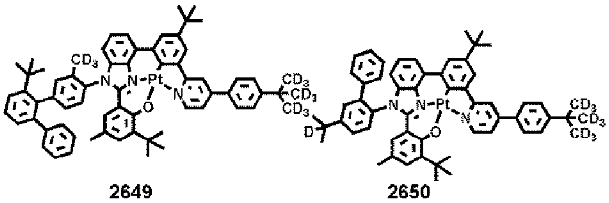
2649
2650

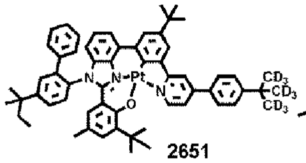
2651
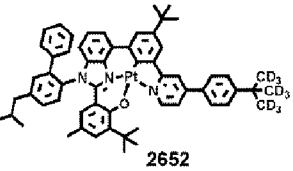
2652
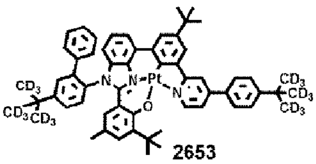
2653
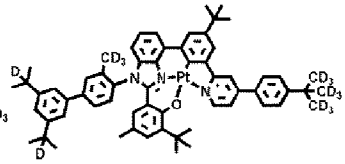
2654

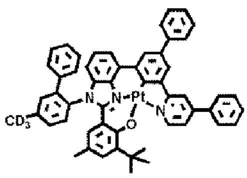
2655
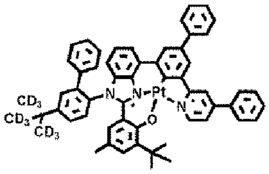
2656
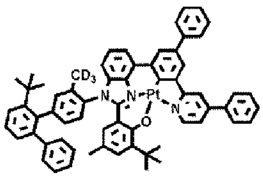
2657
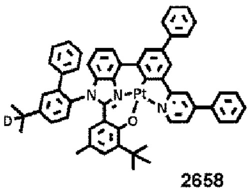
2658

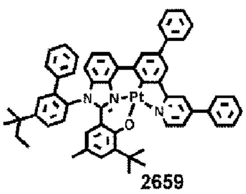
2659
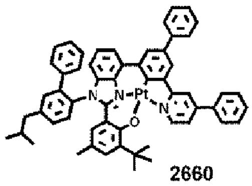
2660
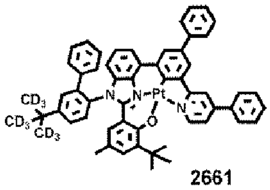
2661
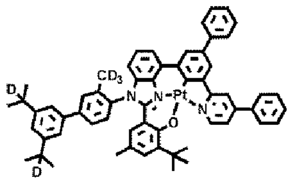
2662

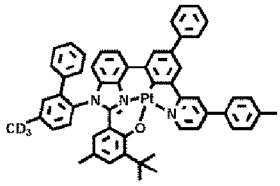
2663

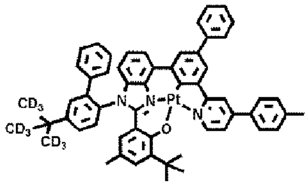
2664

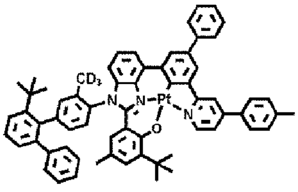
2665

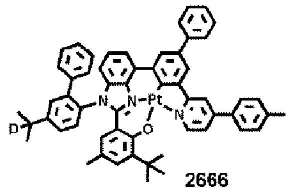
2666

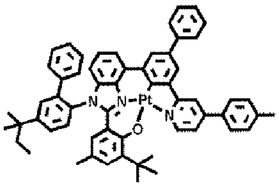
2667

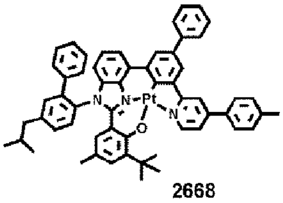
2668

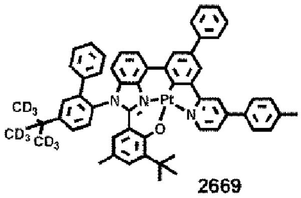
2669

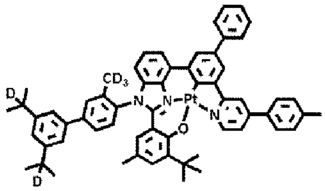
2670

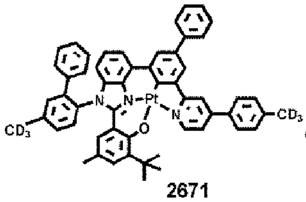
2671

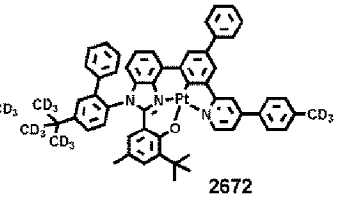
2672

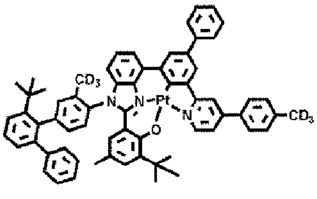
2673

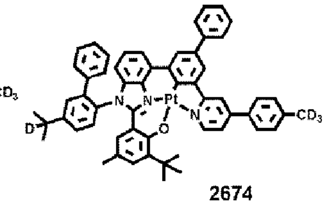
2674

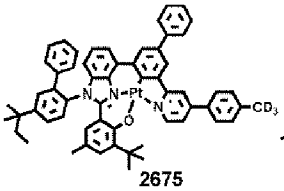
2675

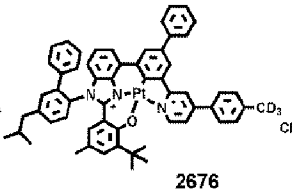
2676

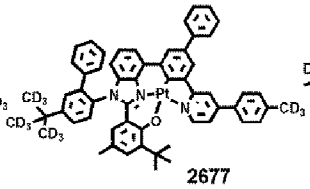
2677

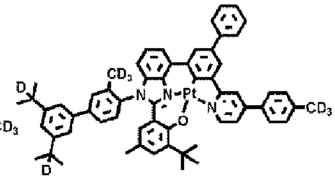
2678

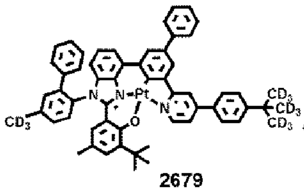
2679

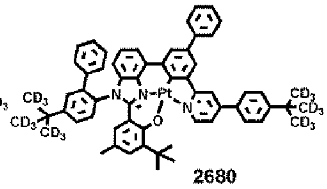
2680

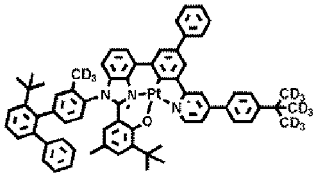
2681

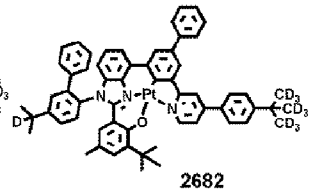
2682

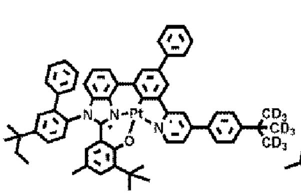
2683

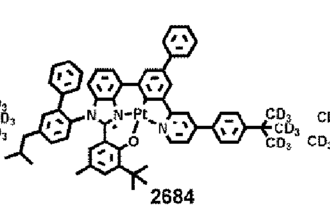
2684

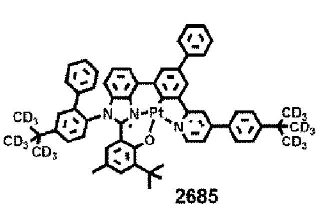
2685

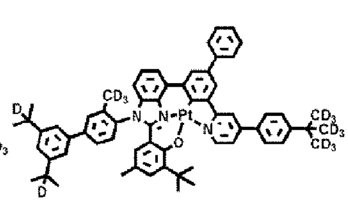
2686

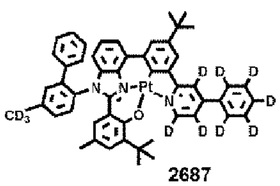
2687

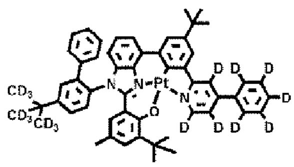
2688

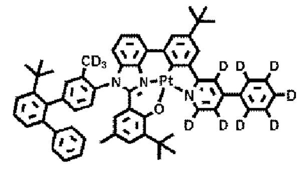
2689

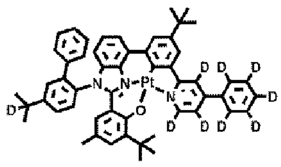
2690

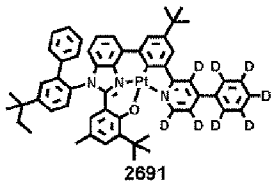
2691

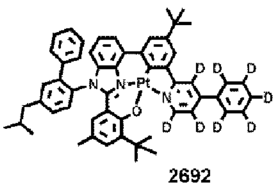
2692

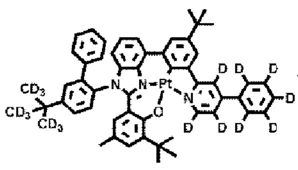
2693

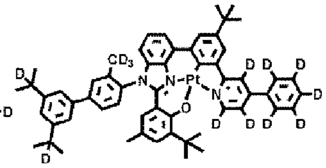
2694

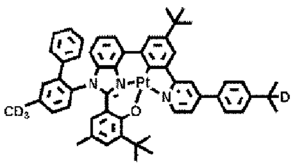
2695

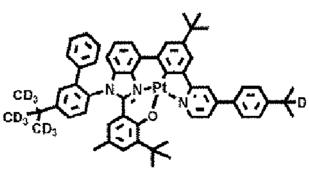
2696

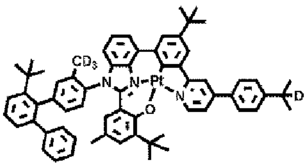
2697

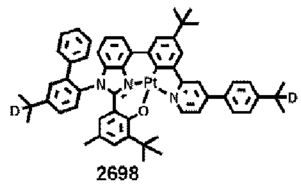
2698

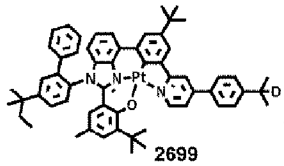
2699

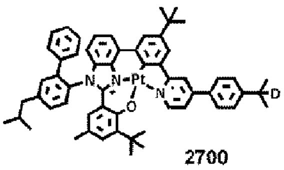
2700

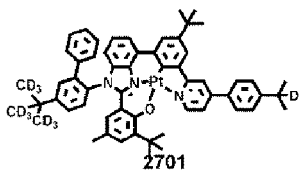
2701

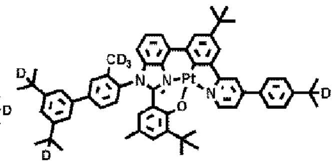
2702

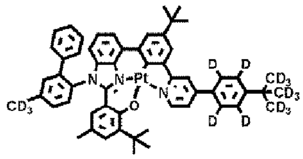
2703

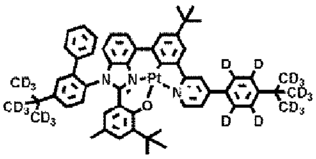
2704

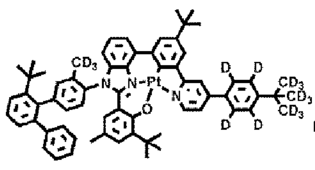
2705

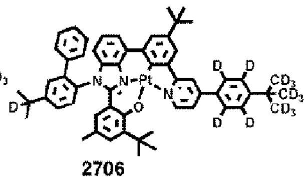
2706

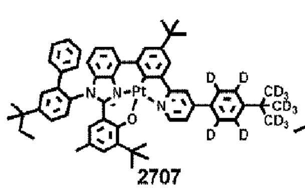
2707

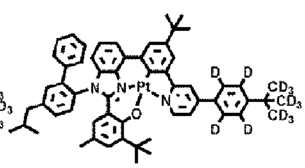
2708

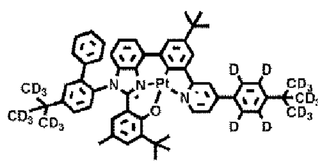
2709

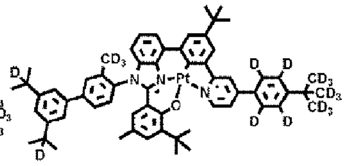
2710

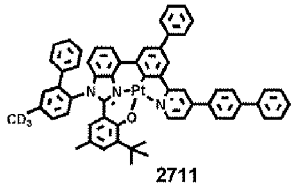
2711
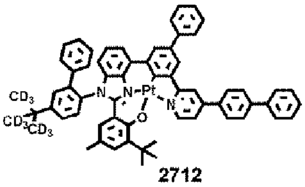
2712
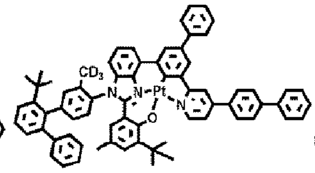
2713
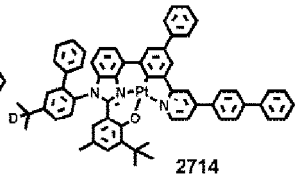
2714

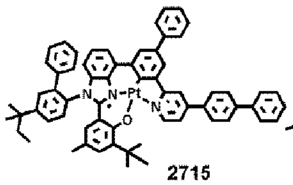
2715
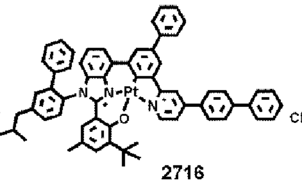
2716
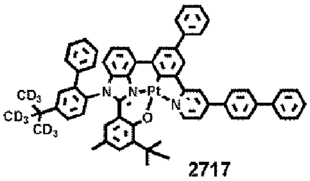
2717
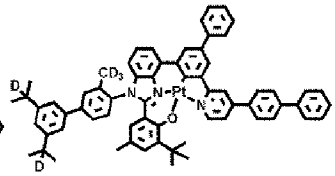
2718

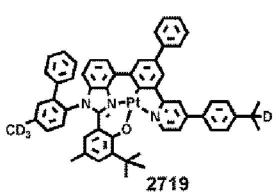
2719
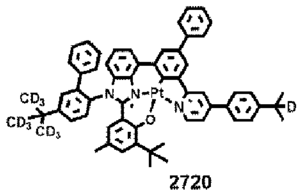
2720
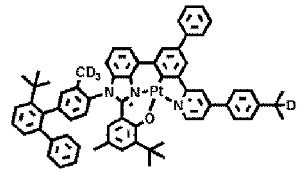
2721
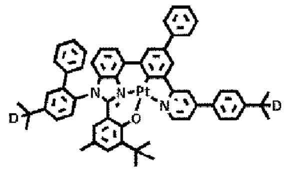
2722

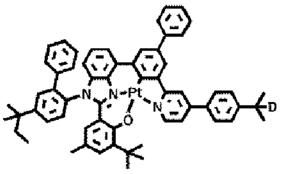
2723
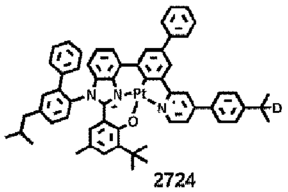
2724
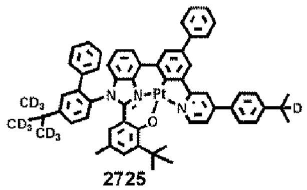
2725
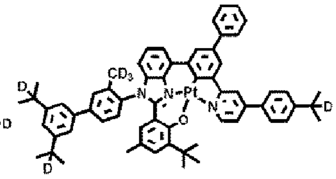
2726

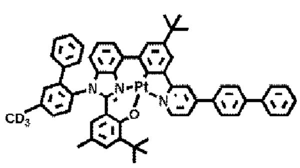
2727
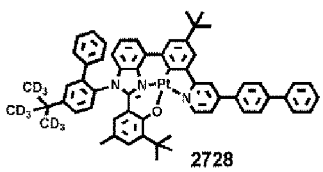
2728
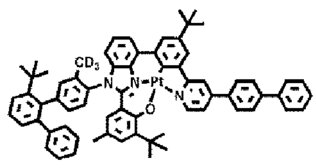
2729
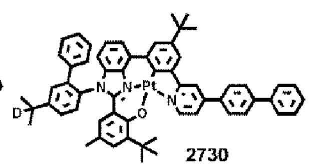
2730

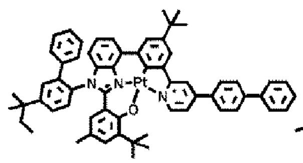
2731
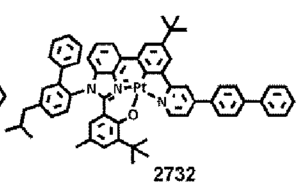
2732
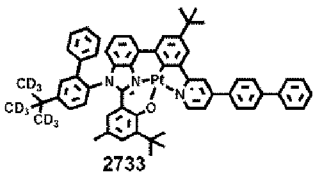
2733
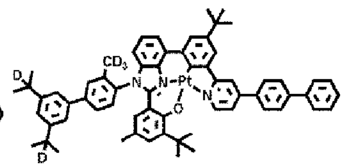
2734

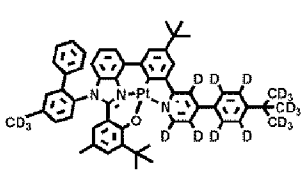

2735

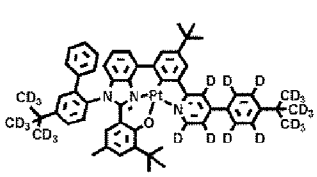

2736

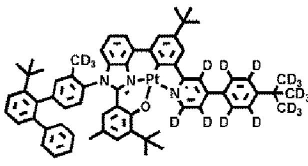

2737

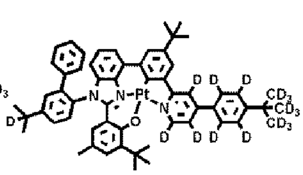

2738

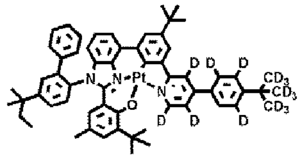

2739

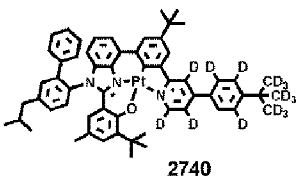

2740

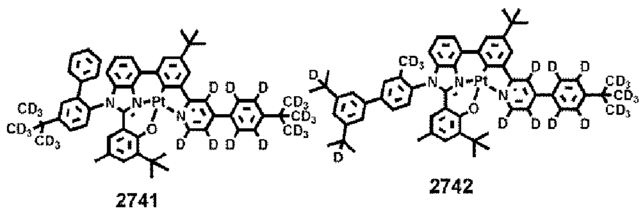

2741

2742

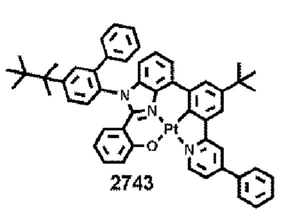

2743

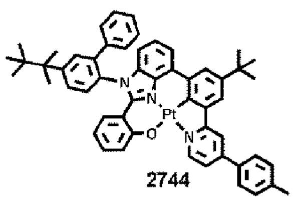

2744

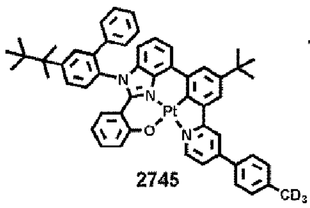

2745

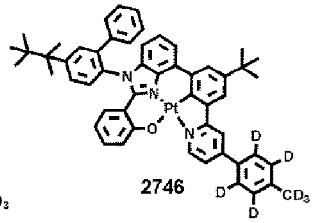

2746

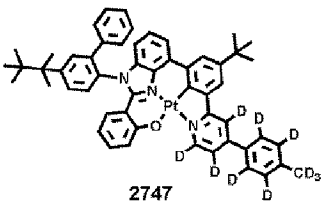

2747

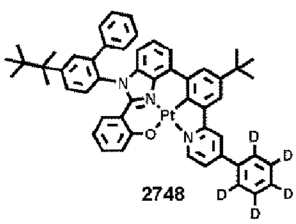

2748

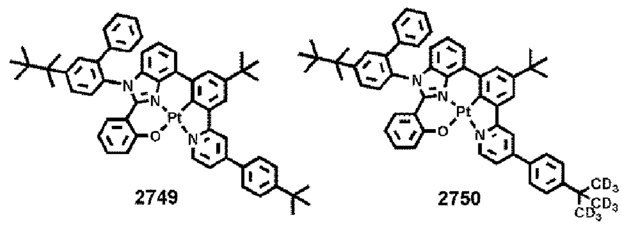

2749

2750

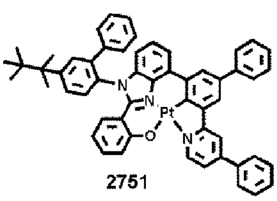

2751

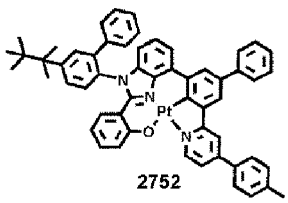

2752

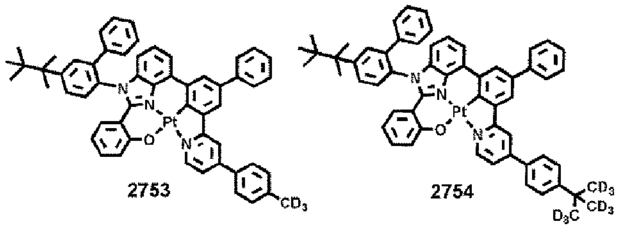

2753

2754

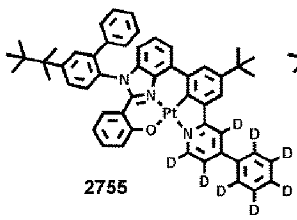
2755
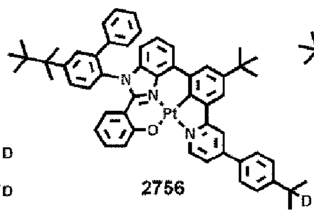
2756
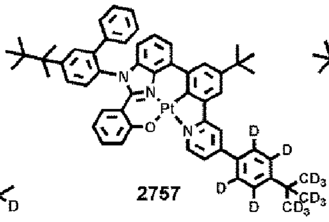
2757
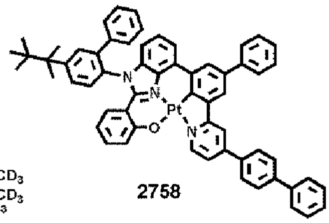
2758

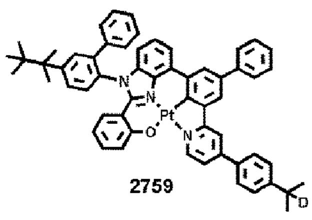
2759
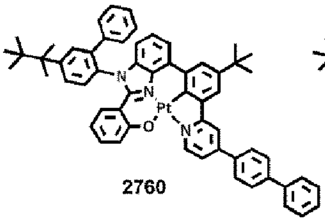
2760
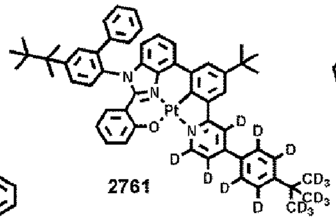
2761
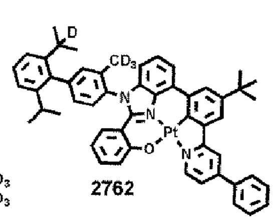
2762

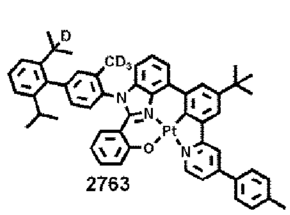
2763
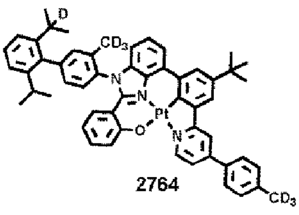
2764
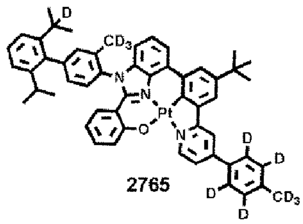
2765
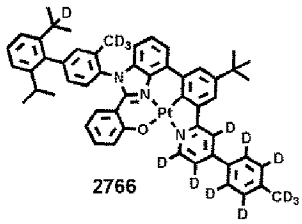
2766

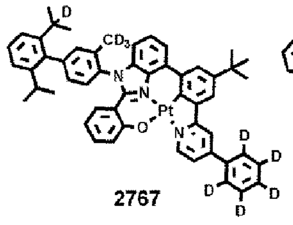
2767
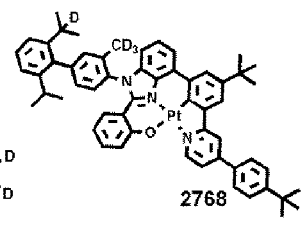
2768
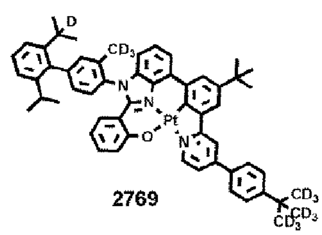
2769
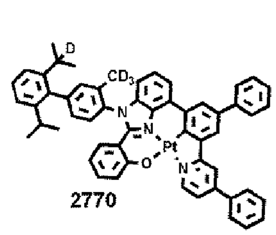
2770

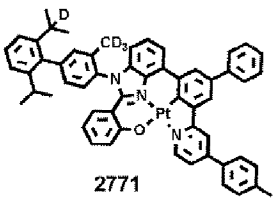
2771
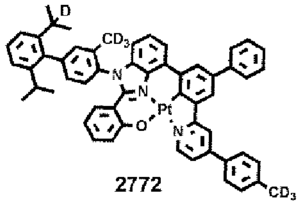
2772
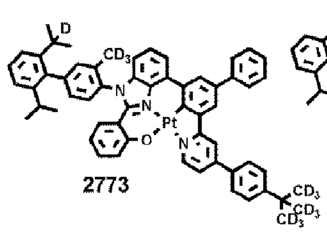
2773
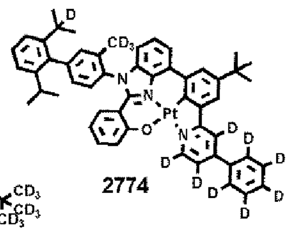
2774

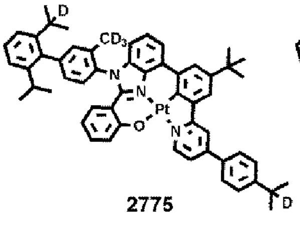
2775
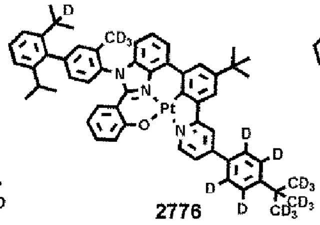
2776
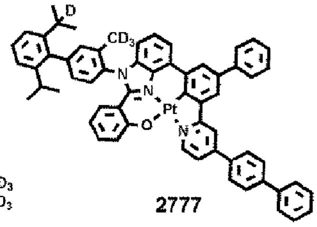
2777
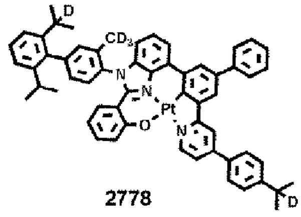
2778

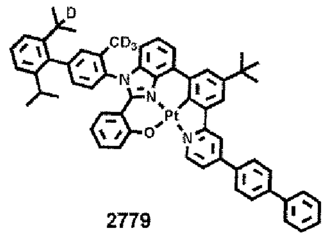
2779

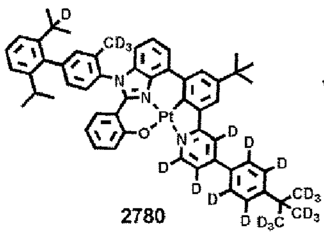
2780

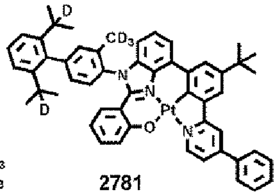
2781

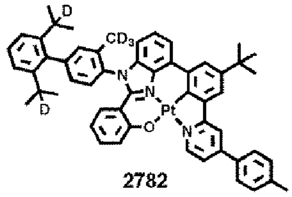
2782

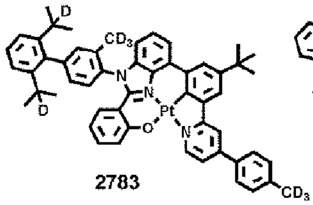
2783

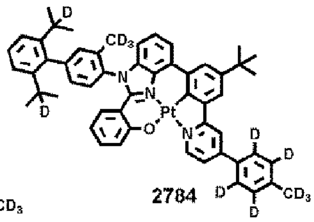
2784

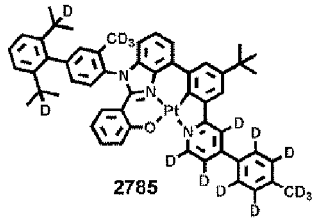
2785

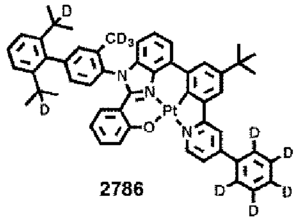
2786

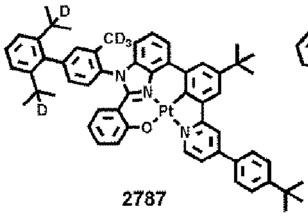
2787

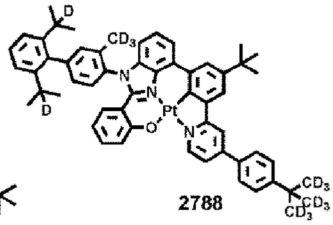
2788

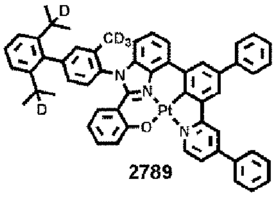
2789

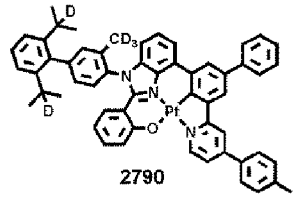
2790

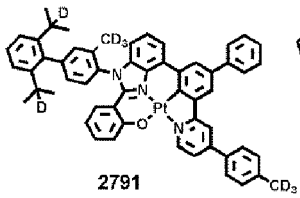
2791

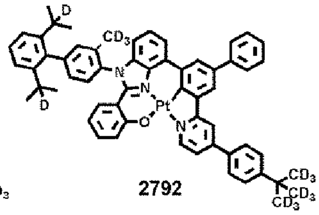
2792

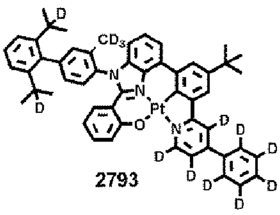
2793

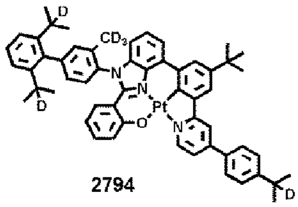
2794

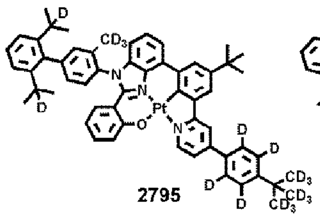
2795

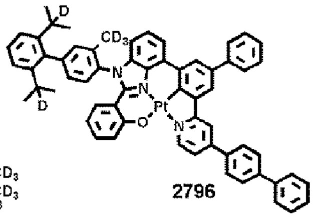
2796

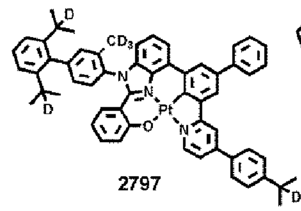
2797

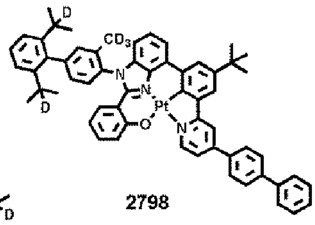
2798

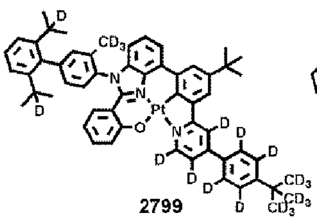
2799

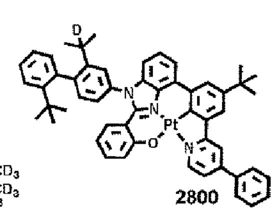
2800

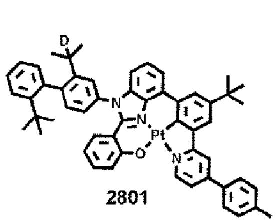
2801

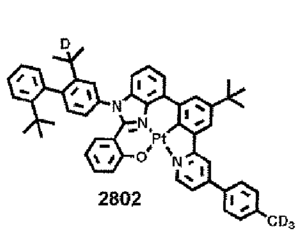
2802

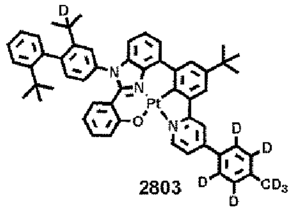
2803

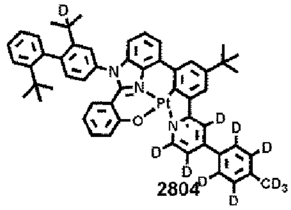
2804

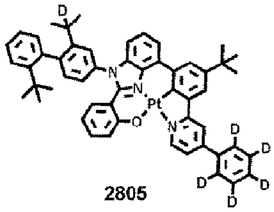
2805

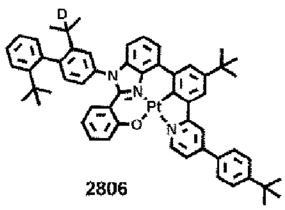
2806

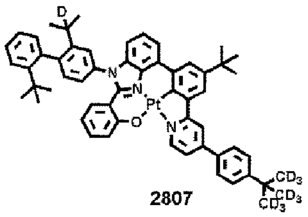
2807

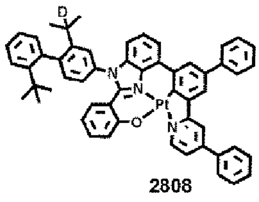
2808

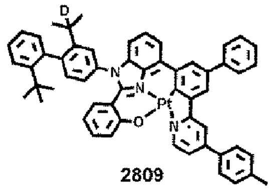
2809

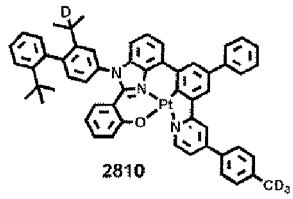
2810

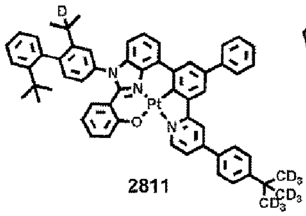
2811

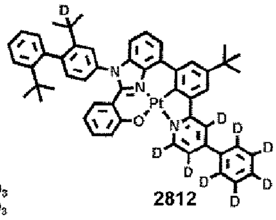
2812

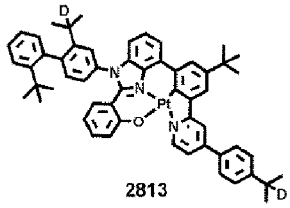
2813

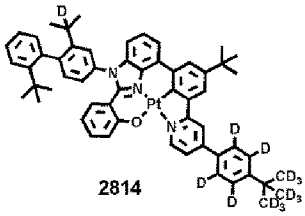
2814

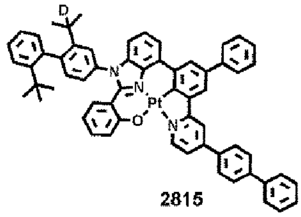
2815

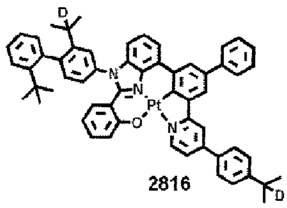
2816

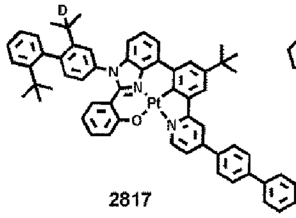
2817

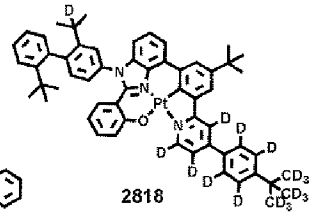
2818

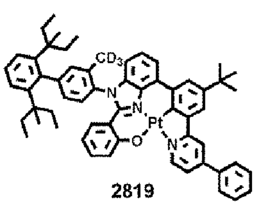
2819

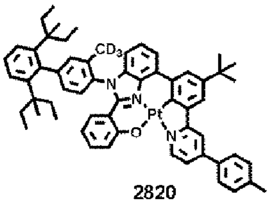
2820

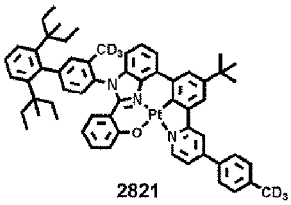
2821

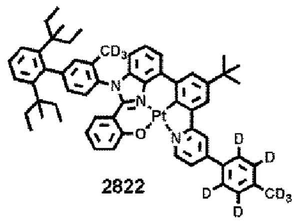
2822

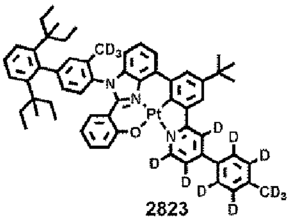
2823

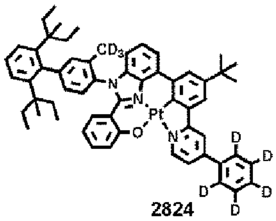
2824

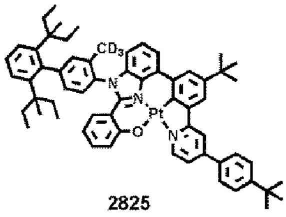
2825

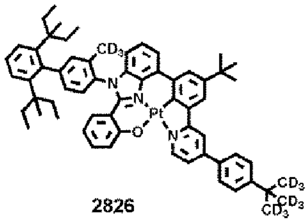
2826

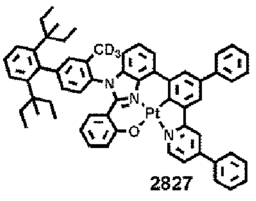
2827

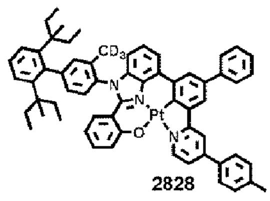
2828

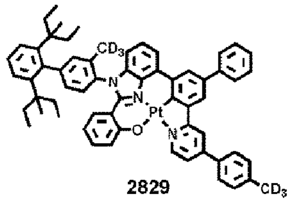
2829

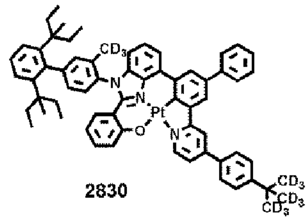
2830

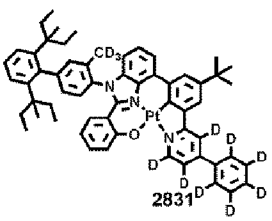
2831

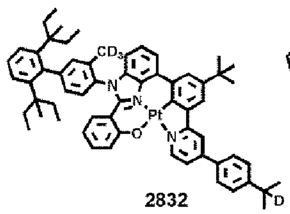
2832

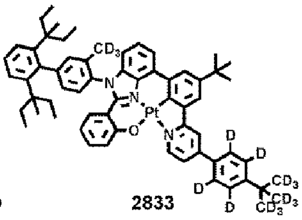
2833

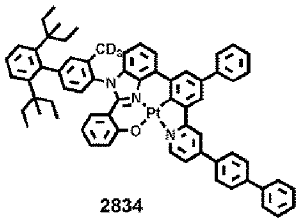
2834

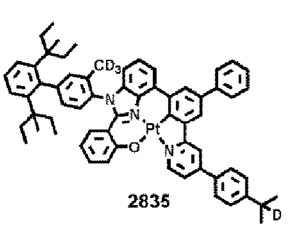
2835

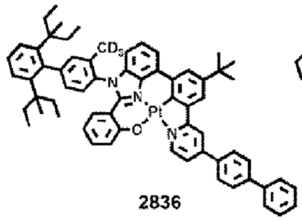
2836

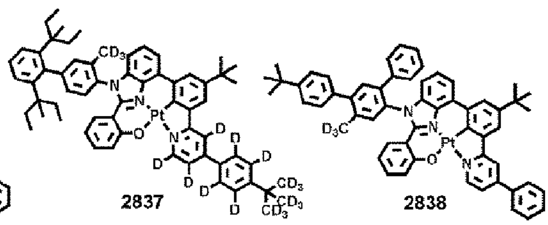
2837

2838

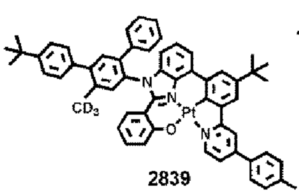
2839

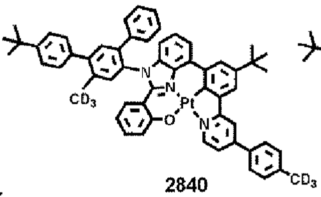
2840

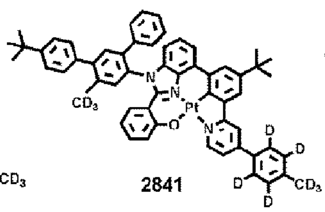
2841

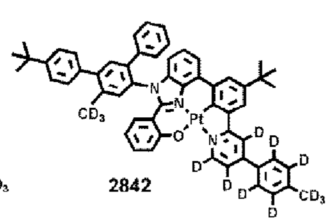
2842

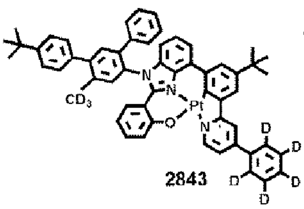
2843

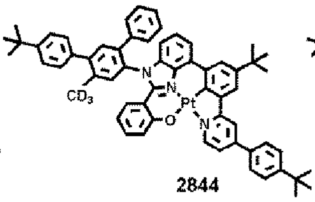
2844

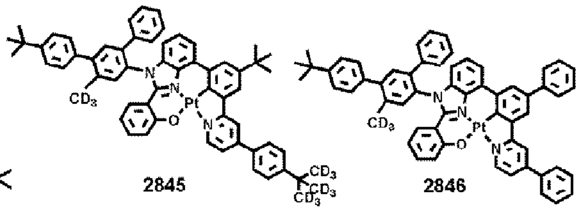
2845

2846

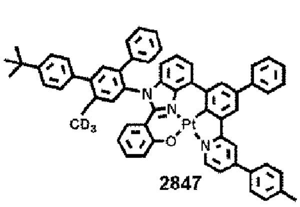
2847

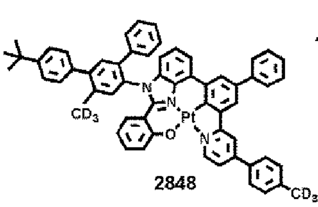
2848

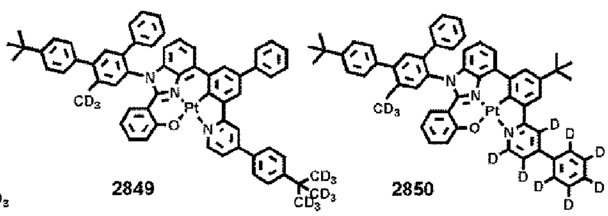
2849

2850

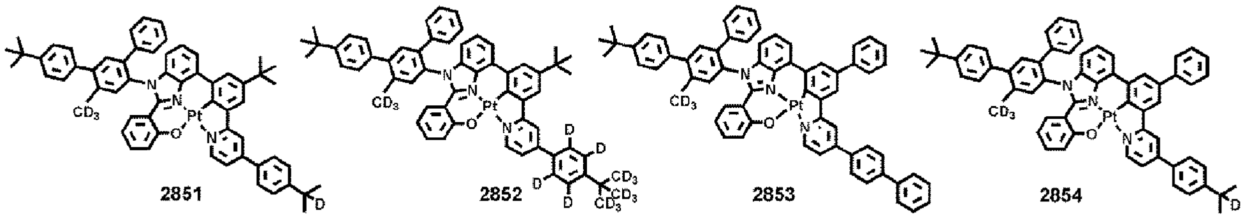

2851 2852 2853 2854

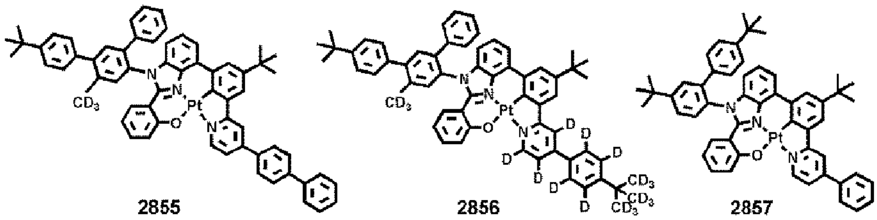

2855 2856 2857

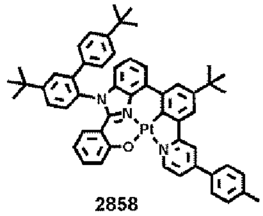

2858

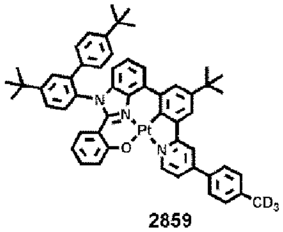

2859

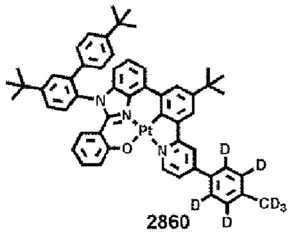

2860

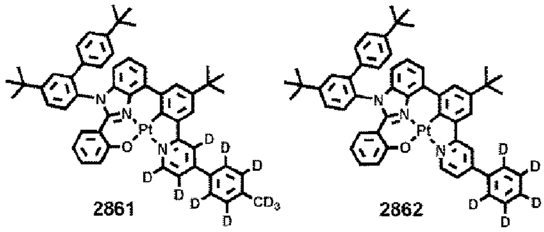

2861 2862

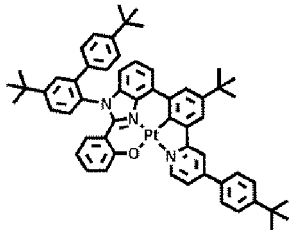

2863

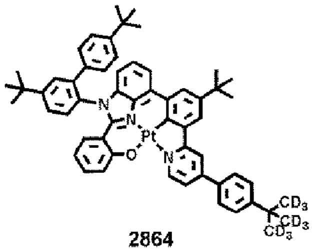

2864

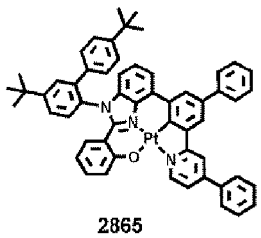

2865

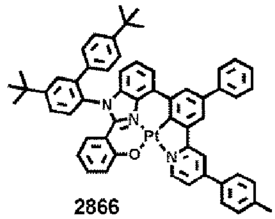

2866

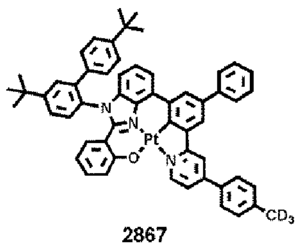

2867

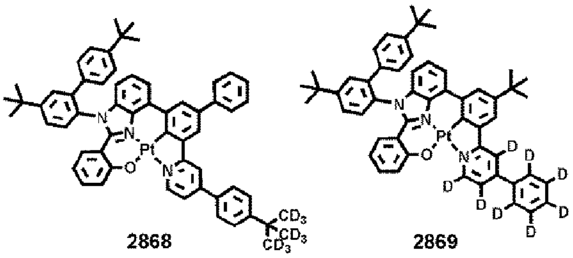

2868 2869

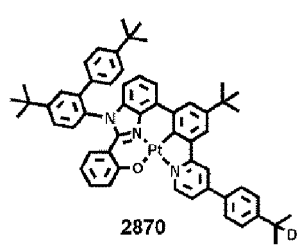

2870

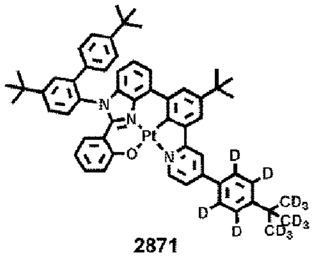

2871

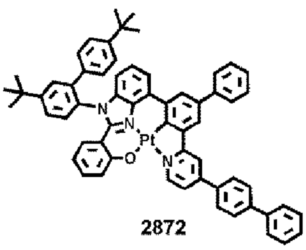

2872

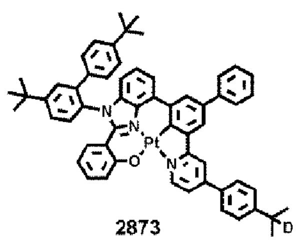

2873

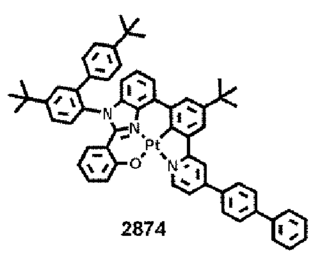

2874

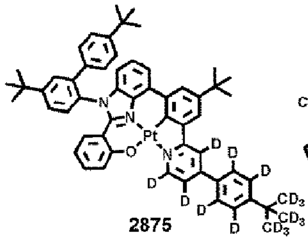

2875

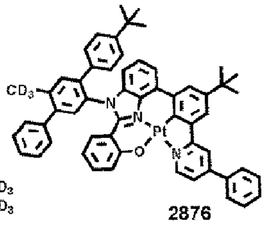

2876

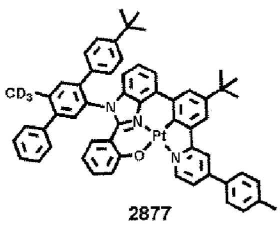

2877

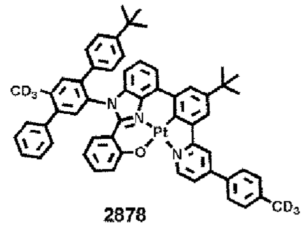

2878

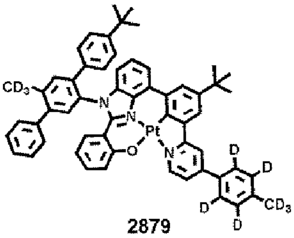

2879

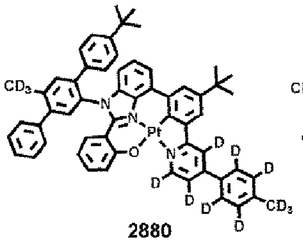

2880

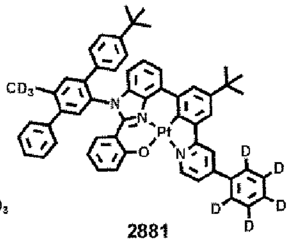

2881

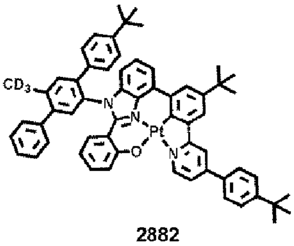

2882

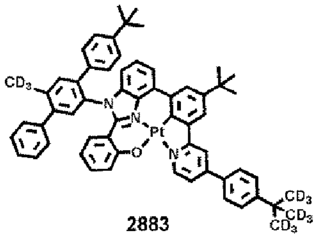

2883

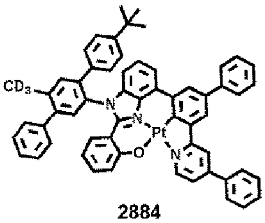

2884

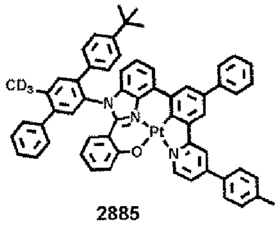

2885

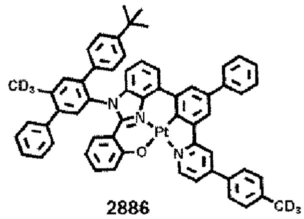

2886

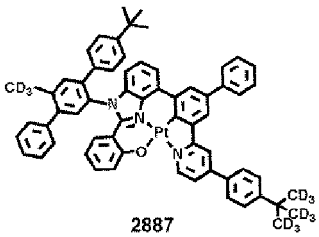

2887

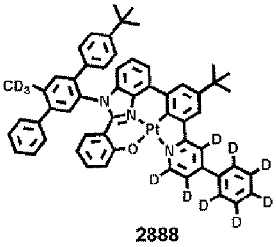

2888

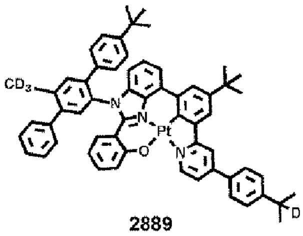

2889

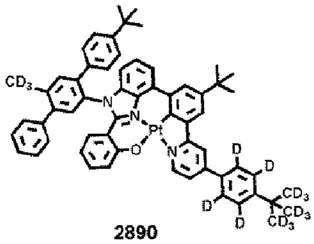

2890

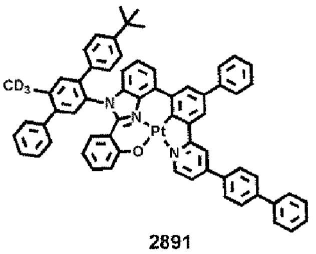

2891

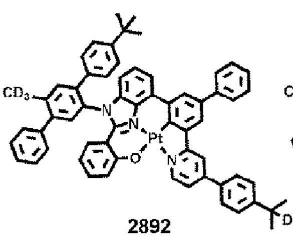

2892

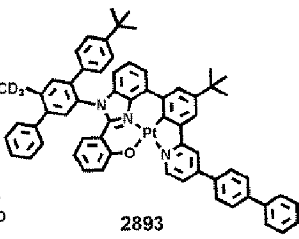

2893

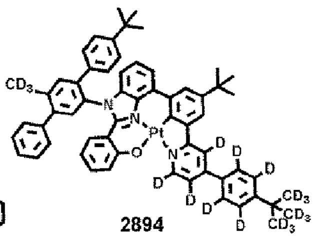

2894

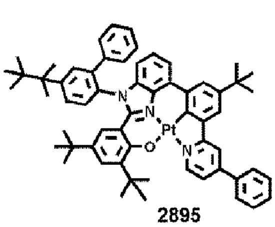
2895

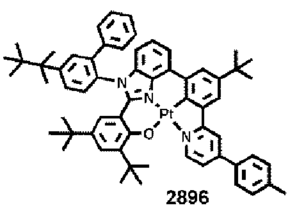
2896

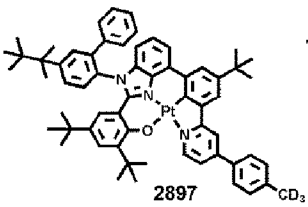
2897

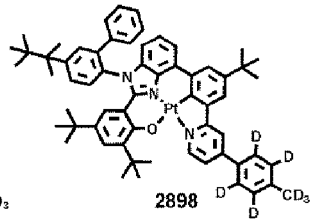
2898

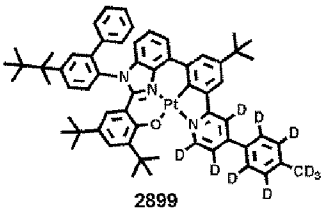
2899

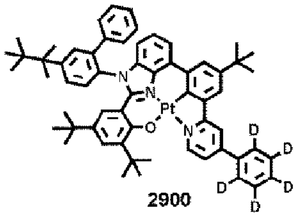
2900

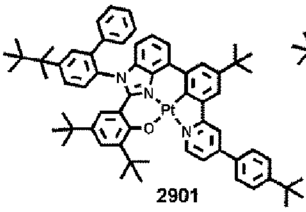
2901

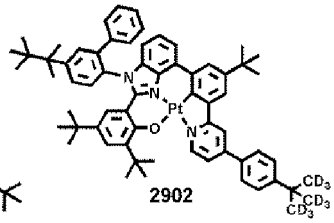
2902

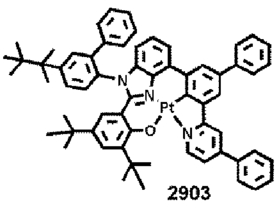
2903

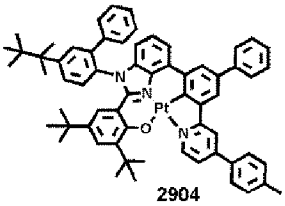
2904

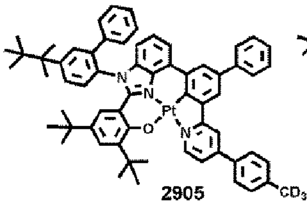
2905

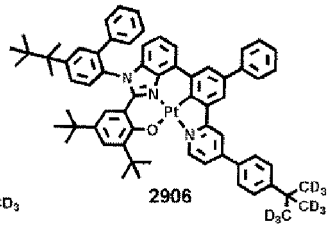
2906

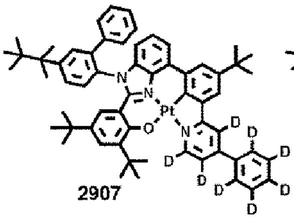
2907

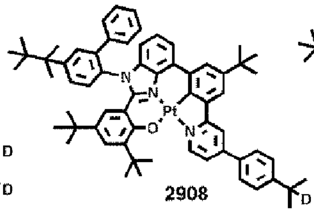
2908

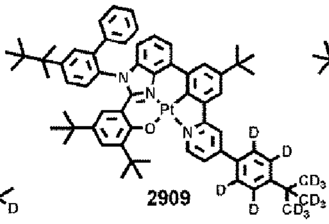
2909

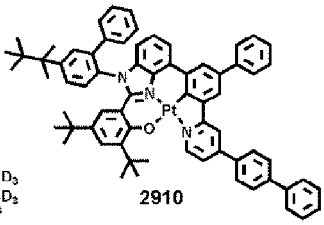
2910

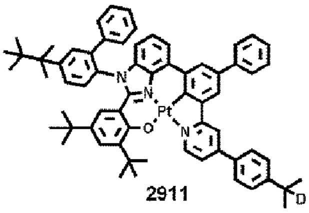
2911

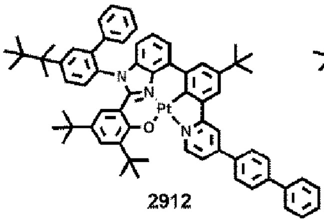
2912

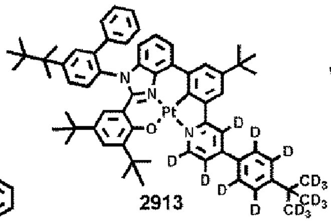
2913

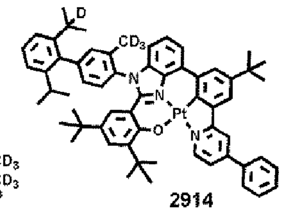
2914

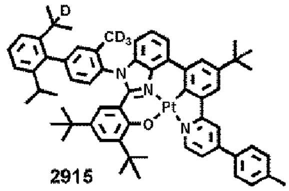
2915

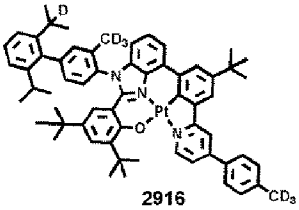
2916

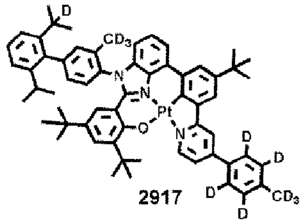
2917

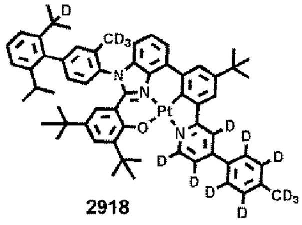
2918

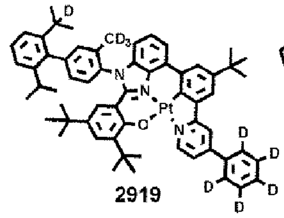
2919

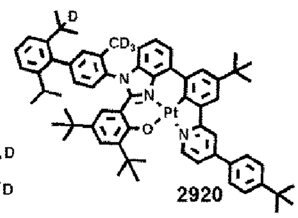
2920

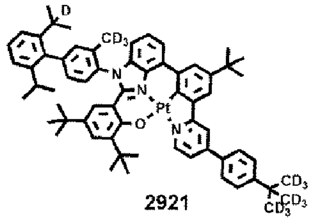
2921

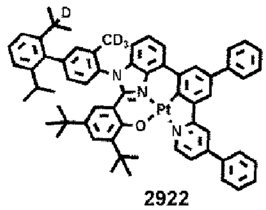
2922

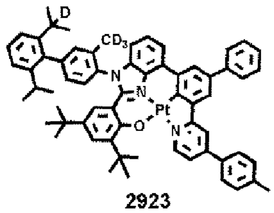
2923

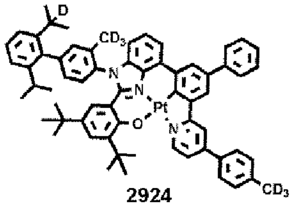
2924

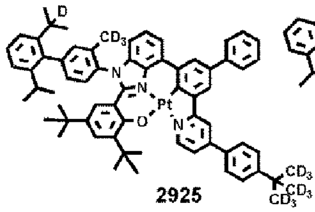
2925

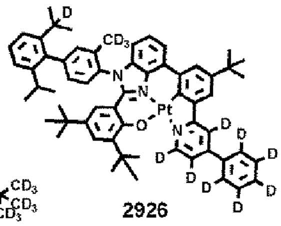
2926

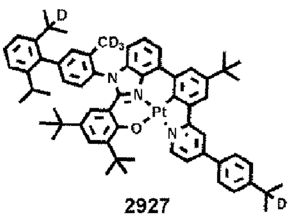
2927

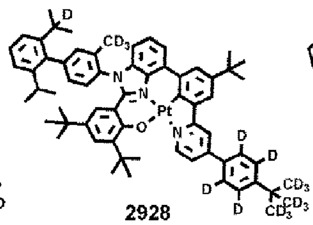
2928

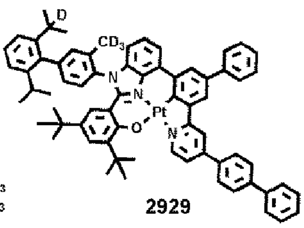
2929

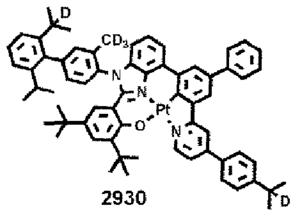
2930

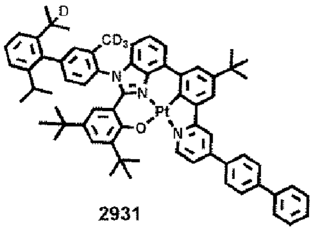
2931

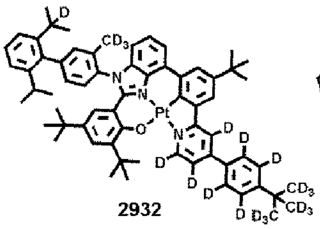
2932

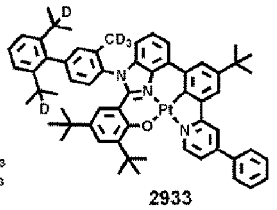
2933

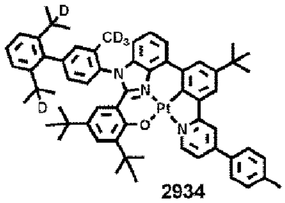
2934

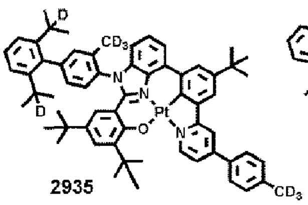
2935

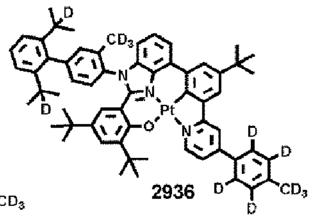
2936

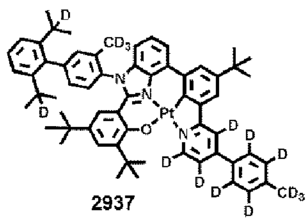
2937

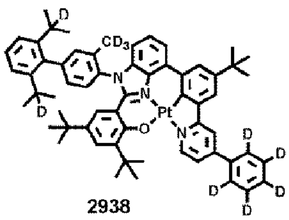
2938

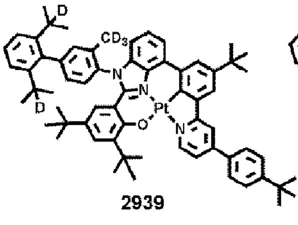
2939

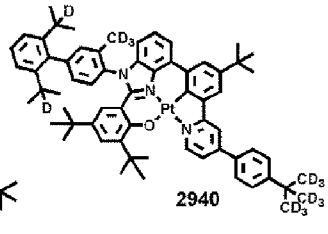
2940

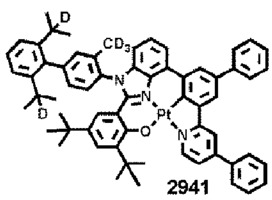
2941

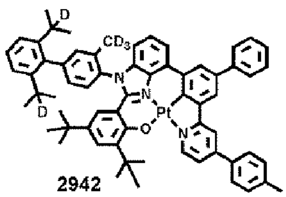
2942

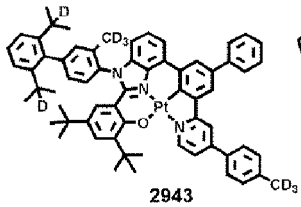
2943

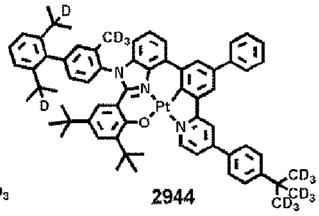
2944

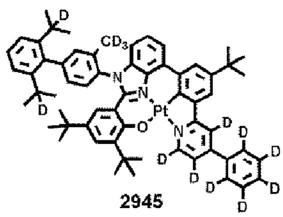
2945

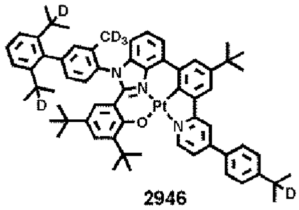
2946

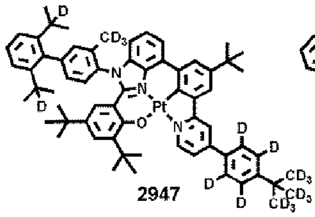
2947

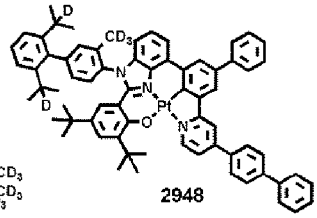
2948

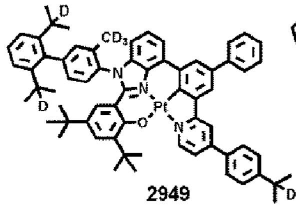
2949

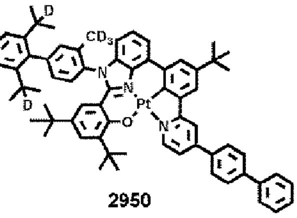
2950

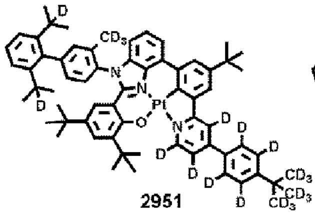
2951

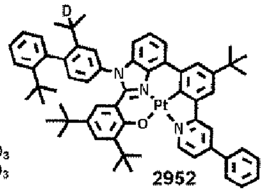
2952

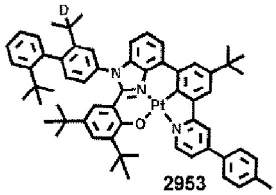
2953

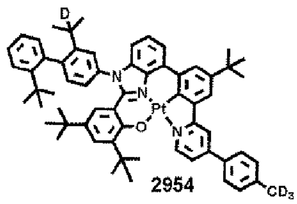
2954

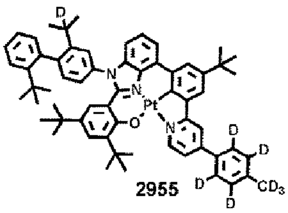
2955

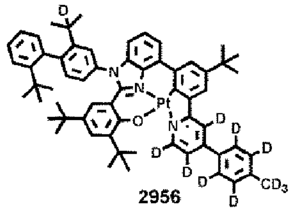
2956

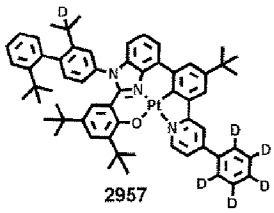
2957

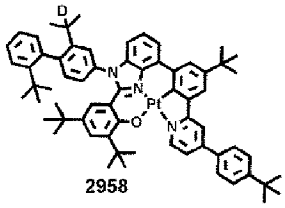
2958

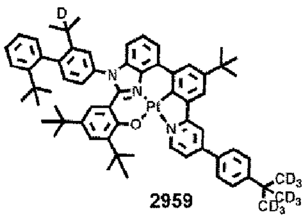
2959

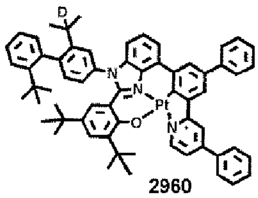
2960

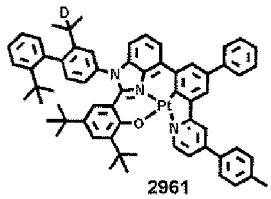
2961

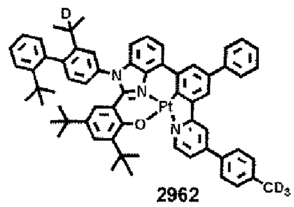
2962

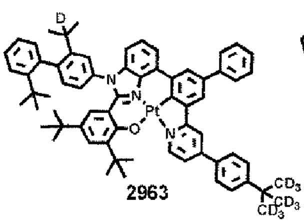
2963

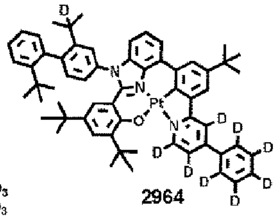
2964

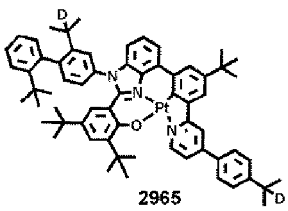
2965

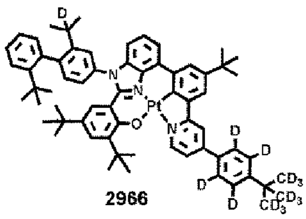
2966

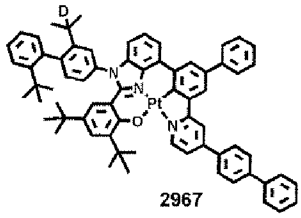
2967

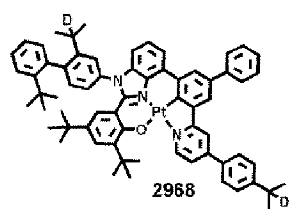
2968

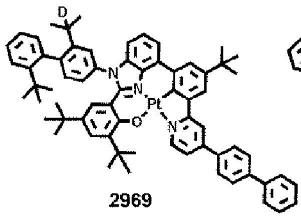
2969

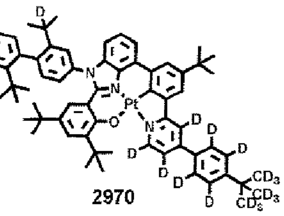
2970

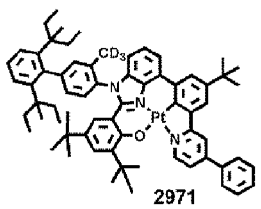
2971

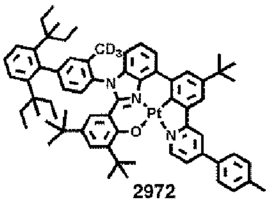
2972

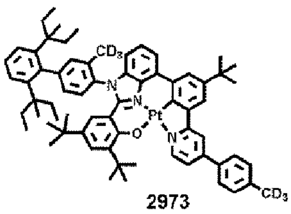
2973

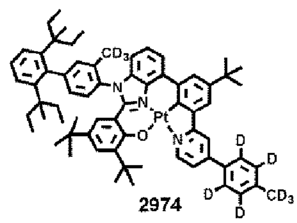
2974

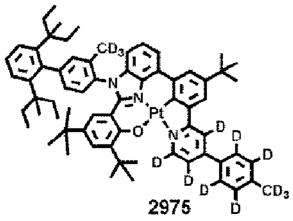
2975

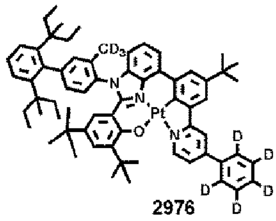
2976

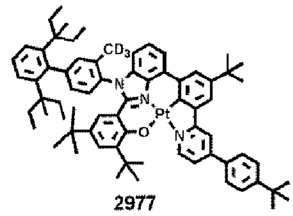
2977

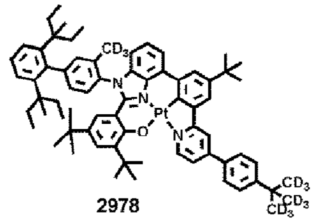
2978

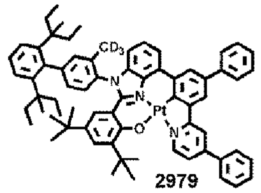
2979

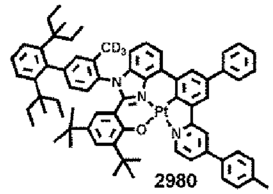
2980

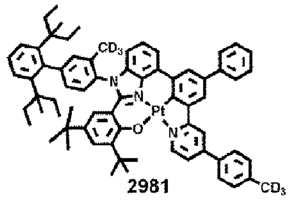
2981

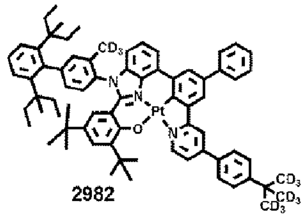
2982

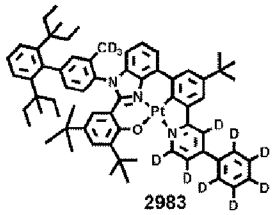
2983

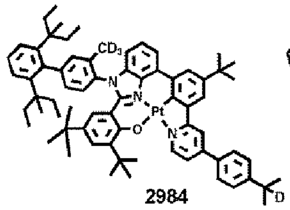
2984

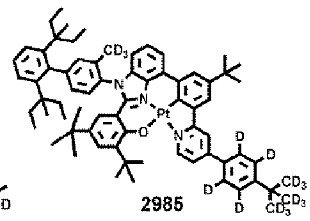
2985

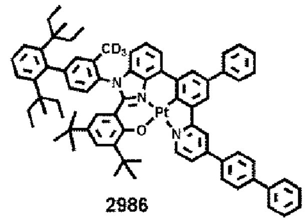
2986

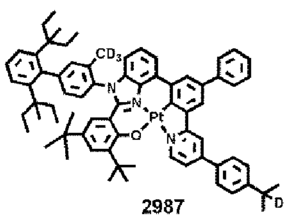
2987

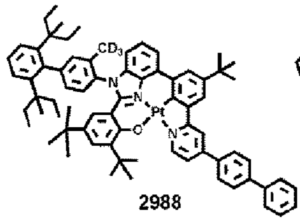
2988

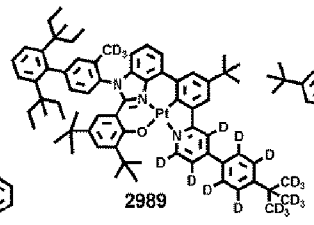
2989

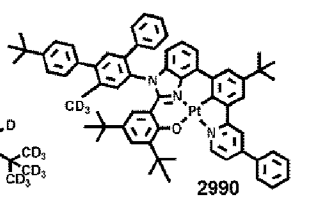
2990

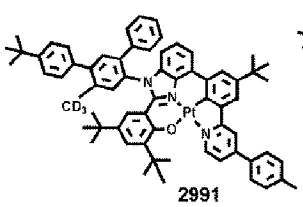
2991

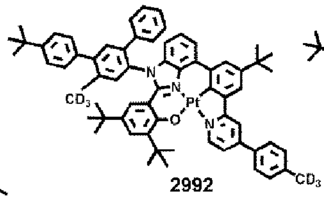
2992

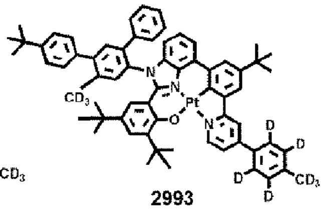
2993

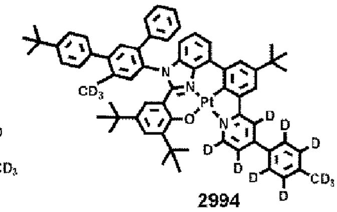
2994

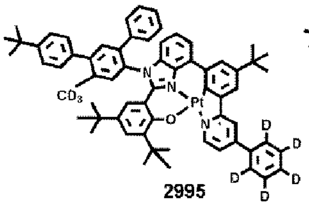
2995

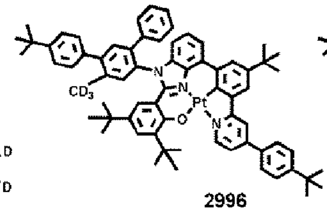
2996

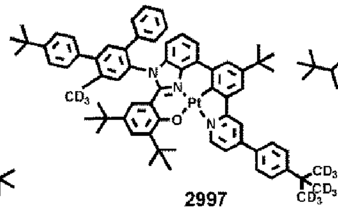
2997

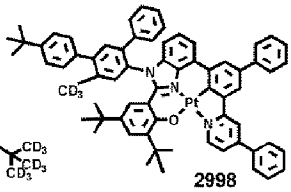
2998

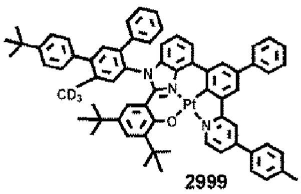
2999

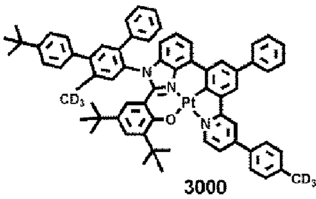
3000

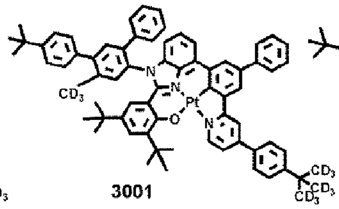
3001

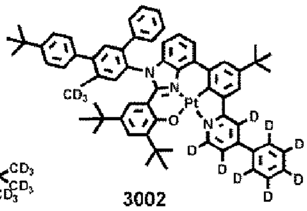
3002

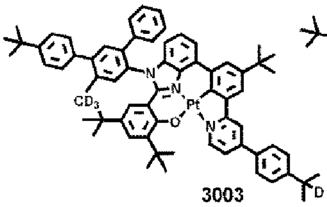
3003

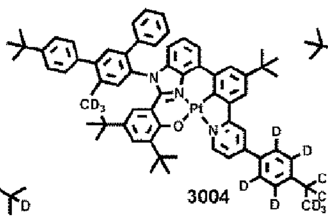
3004

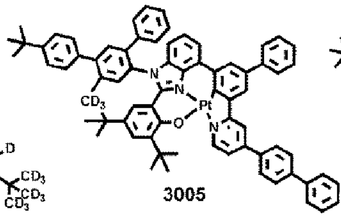
3005

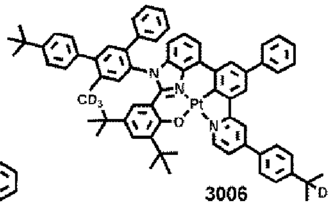
3006

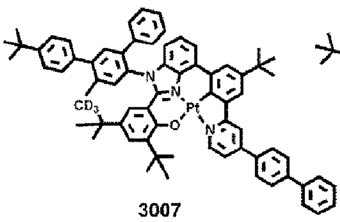
3007

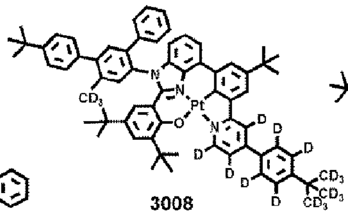
3008

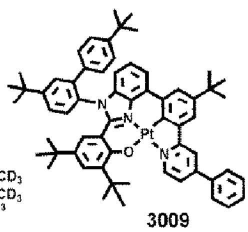
3009

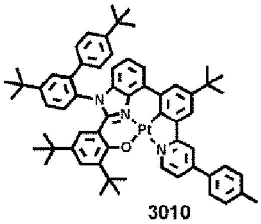
3010

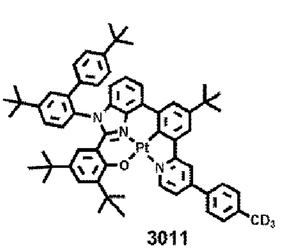
3011

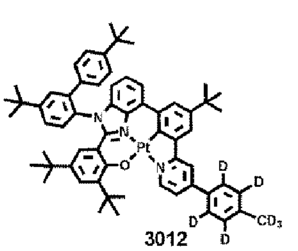
3012

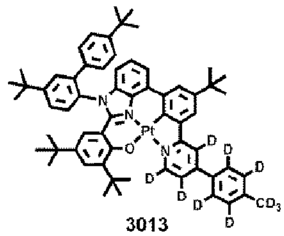
3013

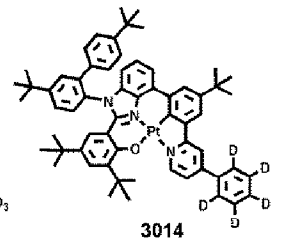
3014

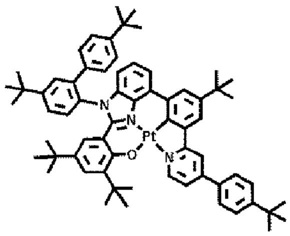
3015

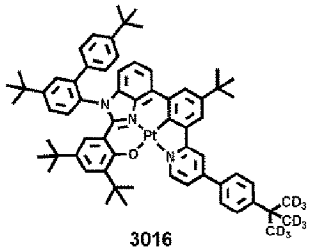
3016

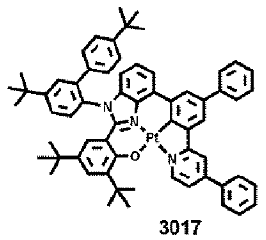
3017

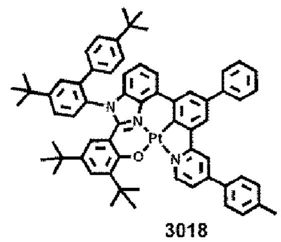
3018

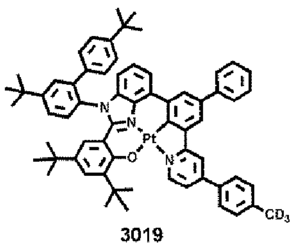
3019

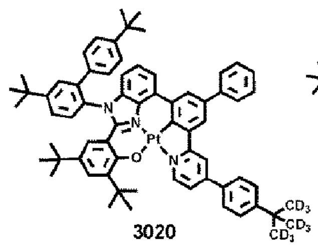
3020

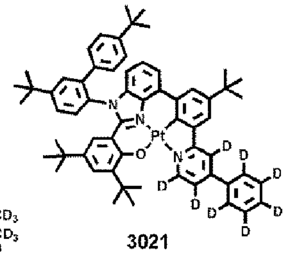
3021

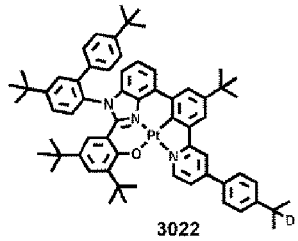
3022

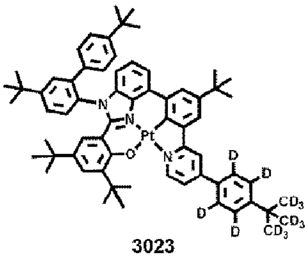
3023

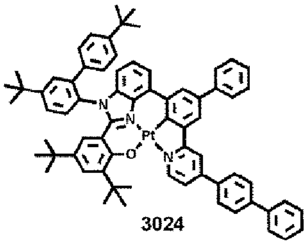
3024

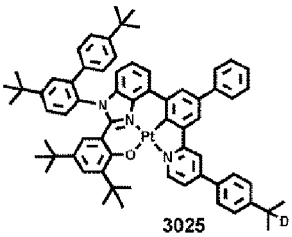
3025

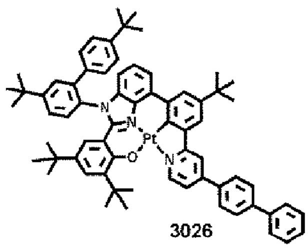
3026

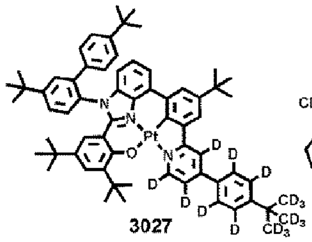
3027

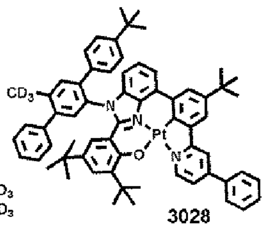
3028

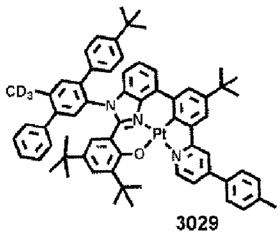
3029

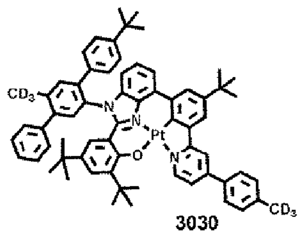
3030

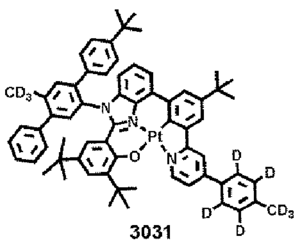
3031

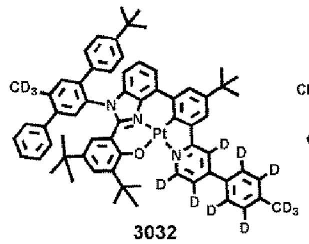
3032

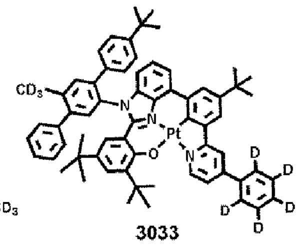
3033

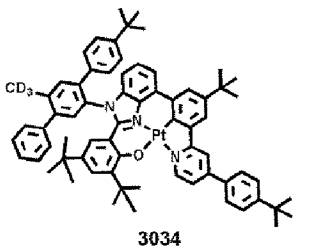
3034

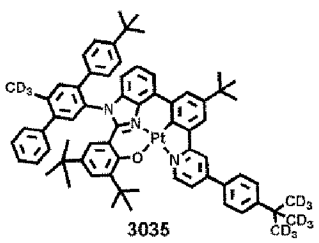
3035

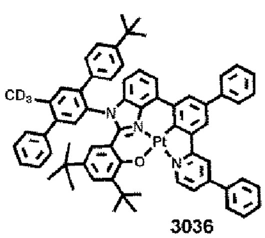
3036

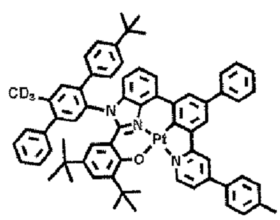
3037

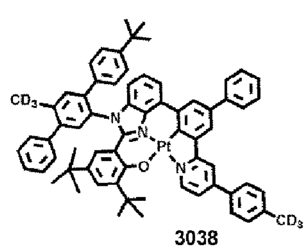
3038

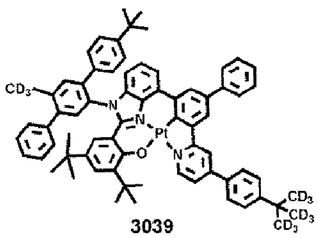
3039

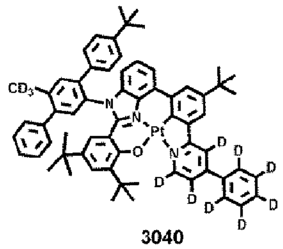
3040

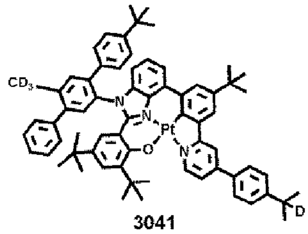
3041

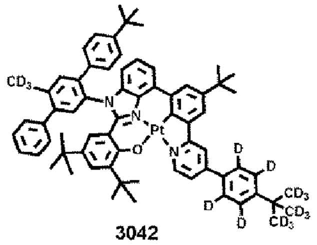
3042

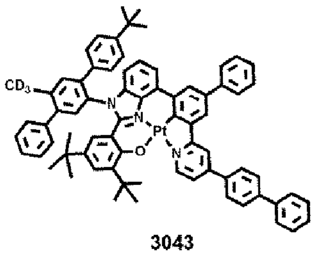
3043

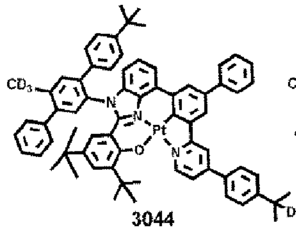
3044

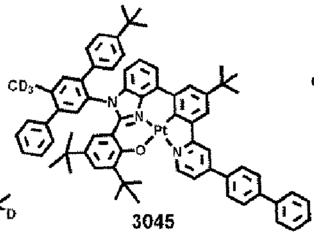
3045

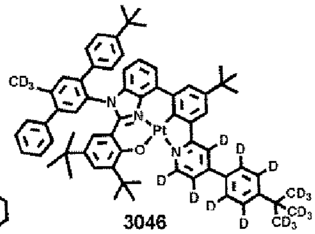
3046

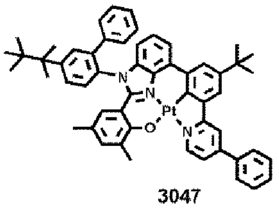
3047

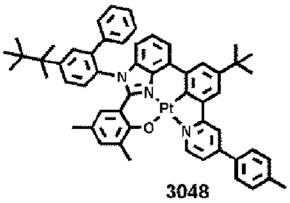
3048

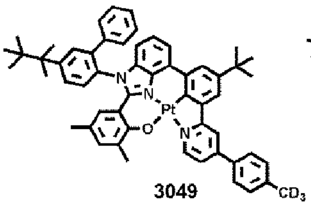
3049

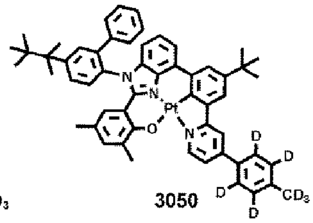
3050

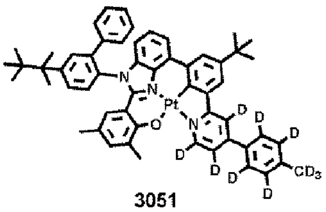
3051

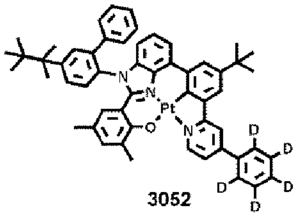
3052

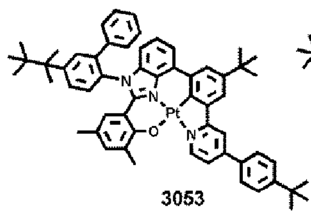
3053

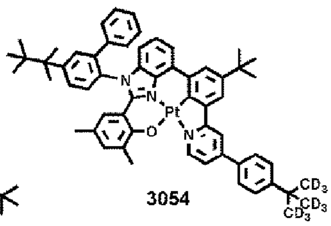
3054

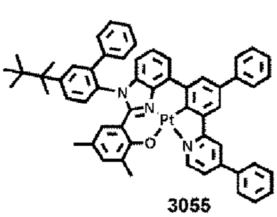
3055

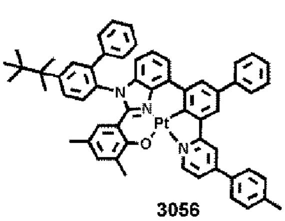
3056

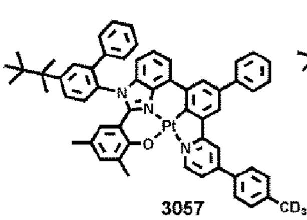
3057

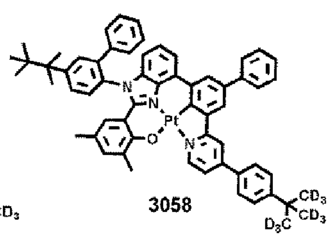
3058

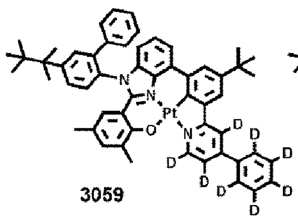
3059

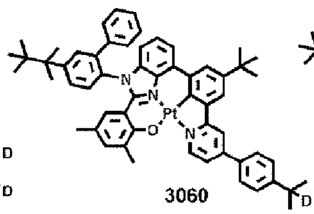
3060

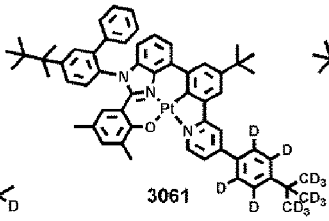
3061

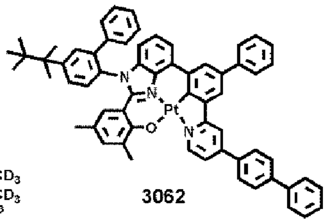
3062

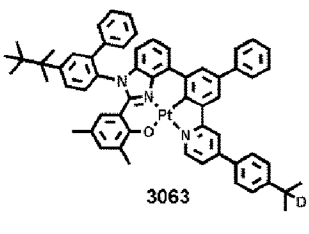
3063

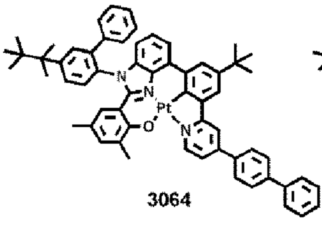
3064

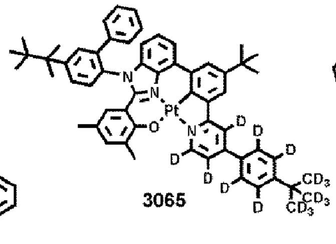
3065

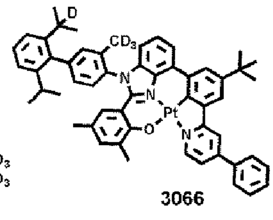
3066

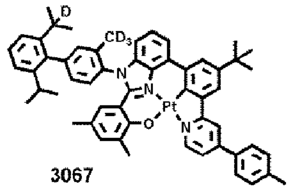
3067

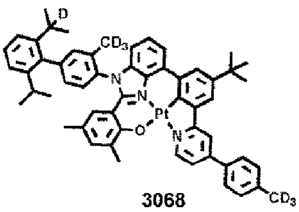
3068

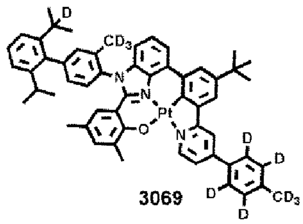
3069

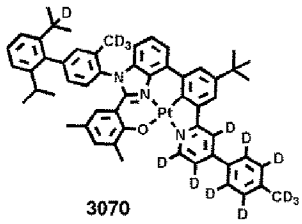
3070

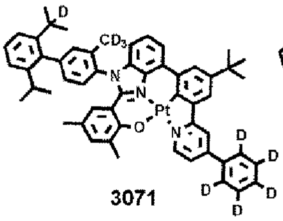
3071

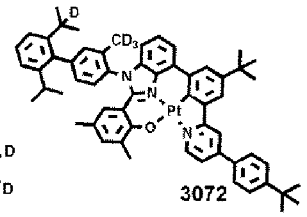
3072

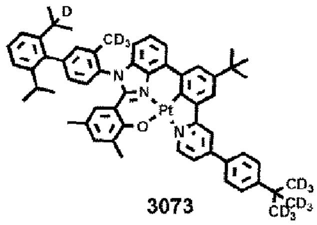
3073

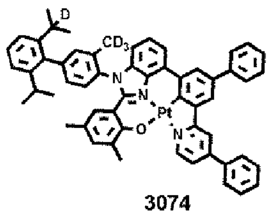
3074

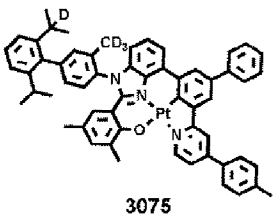
3075

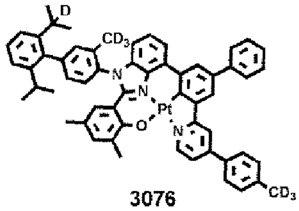
3076

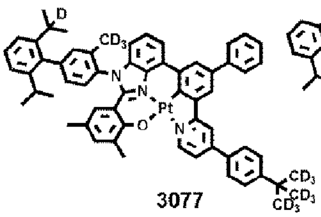
3077

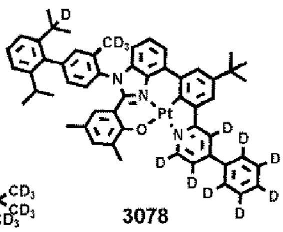
3078

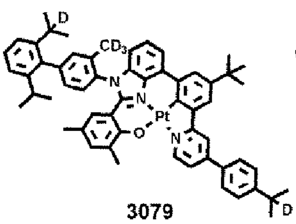
3079

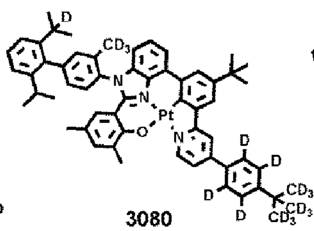
3080

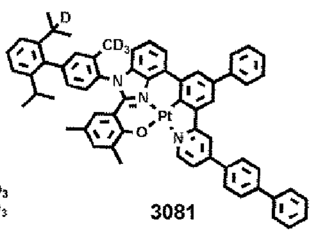
3081

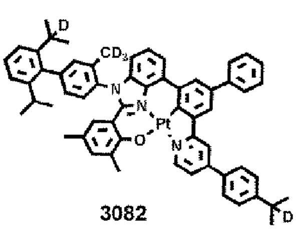
3082

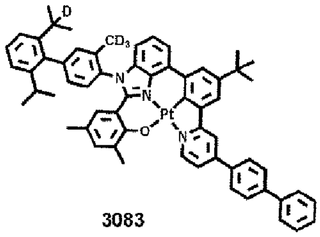
3083

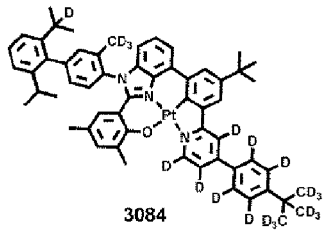
3084

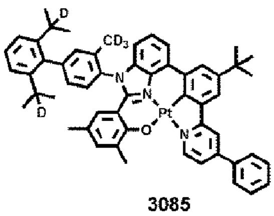
3085

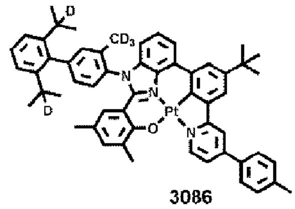
3086

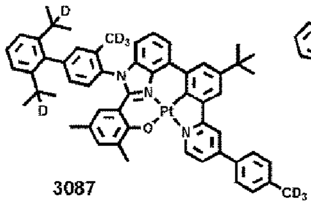
3087

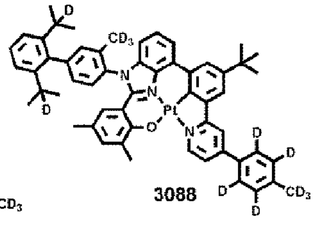
3088

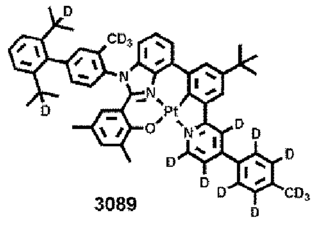
3089

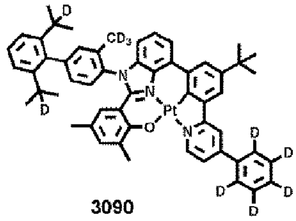
3090

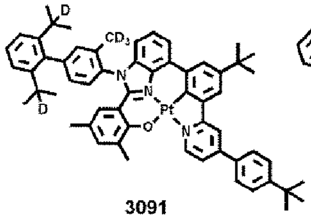
3091

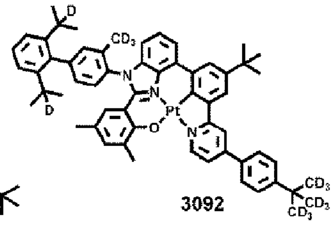
3092

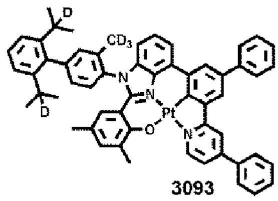
3093

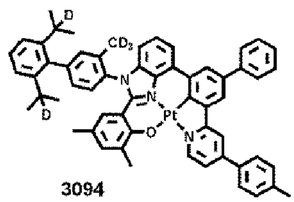
3094

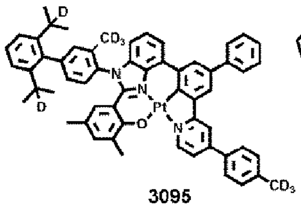
3095

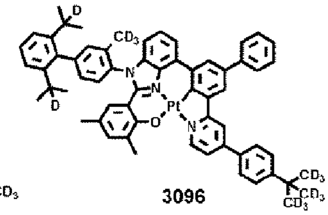
3096

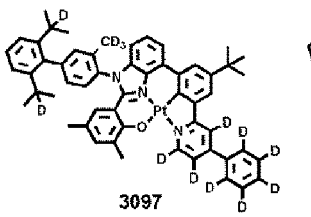
3097

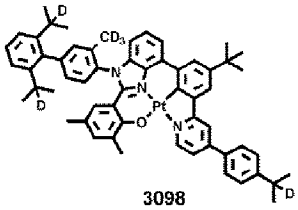
3098

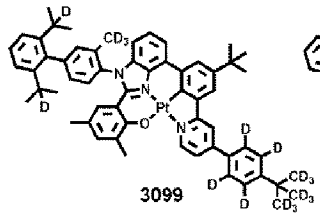
3099

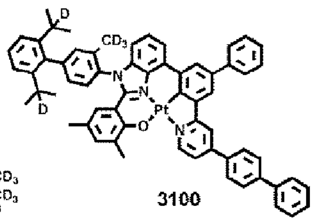
3100

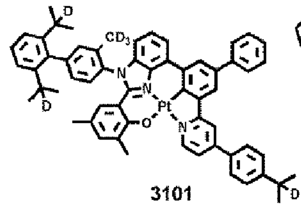
3101

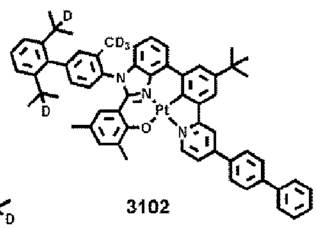
3102

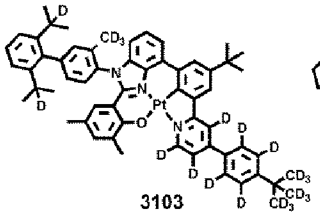
3103

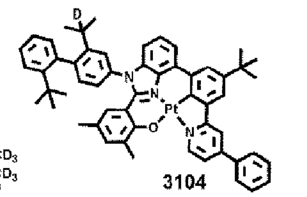
3104

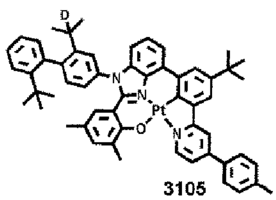
3105

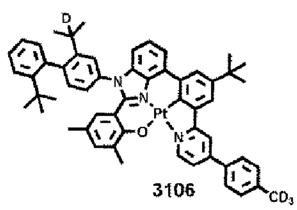
3106

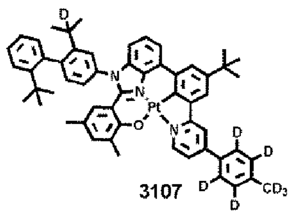
3107
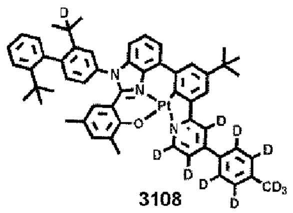
3108
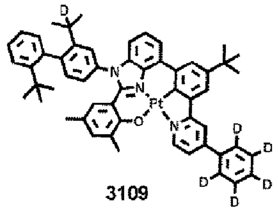
3109
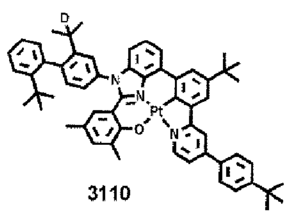
3110
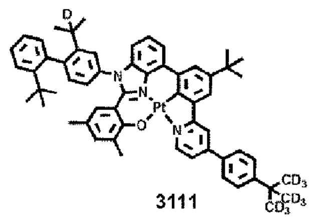
3111
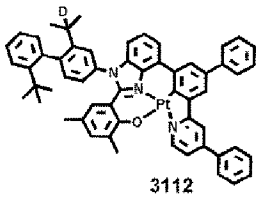
3112
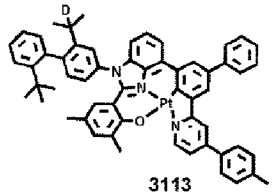
3113
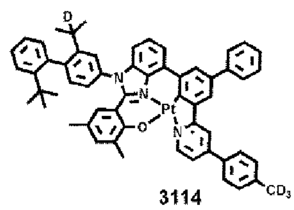
3114
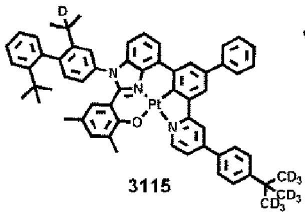
3115
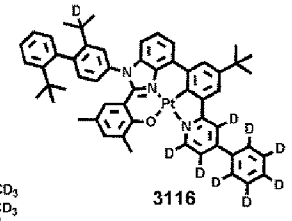
3116
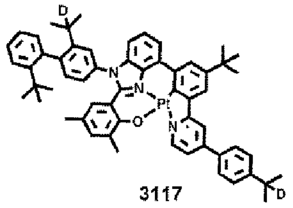
3117
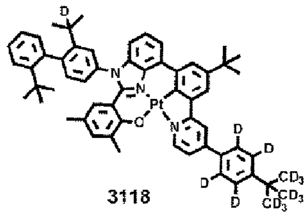
3118
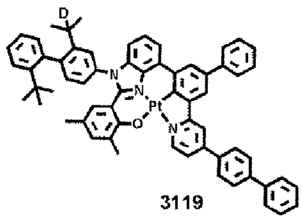
3119
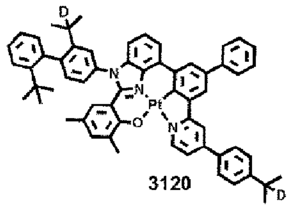
3120
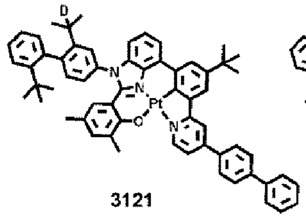
3121
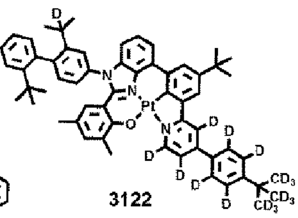
3122
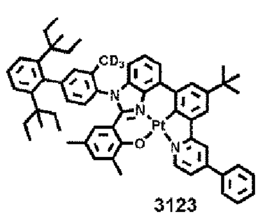
3123
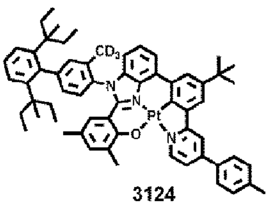
3124
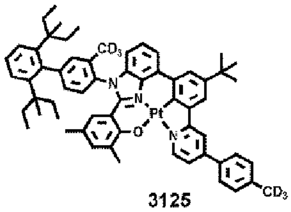
3125
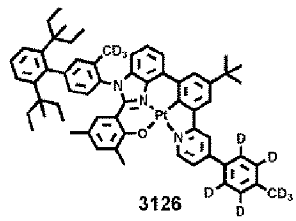
3126
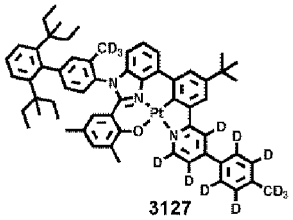
3127
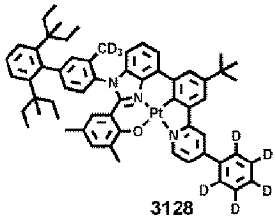
3128
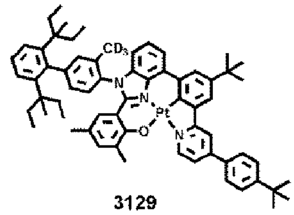
3129
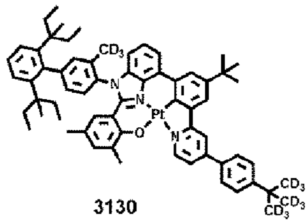
3130

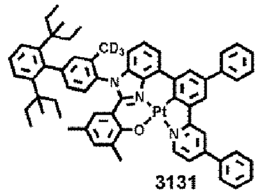
3131
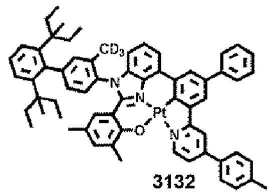
3132
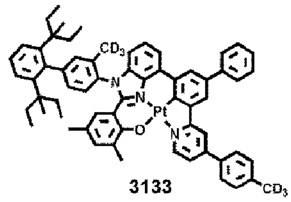
3133
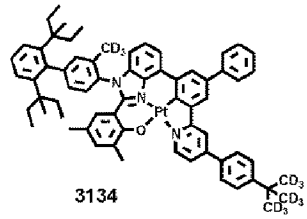
3134
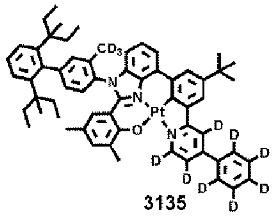
3135
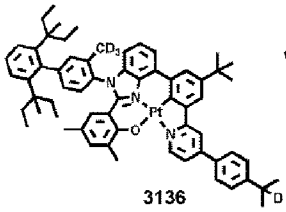
3136
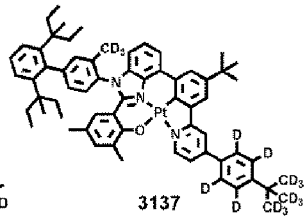
3137
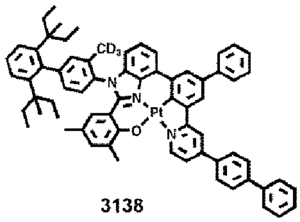
3138
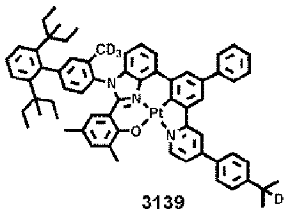
3139
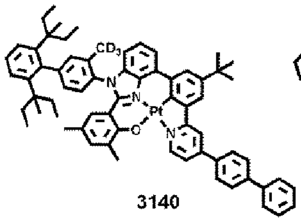
3140
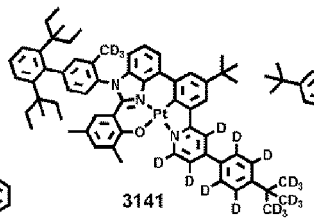
3141
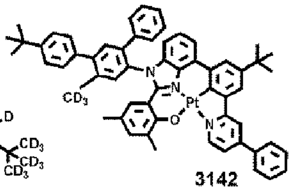
3142
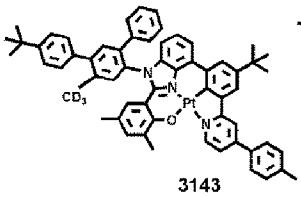
3143
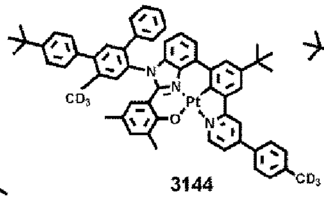
3144
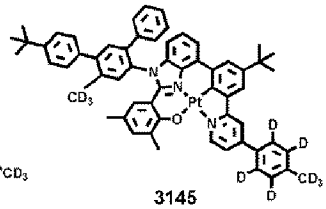
3145
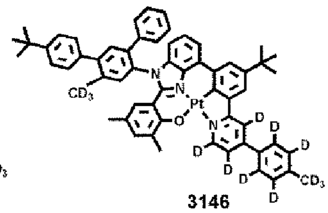
3146
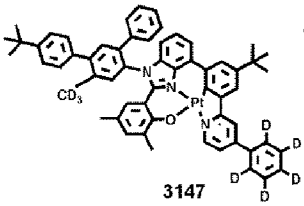
3147
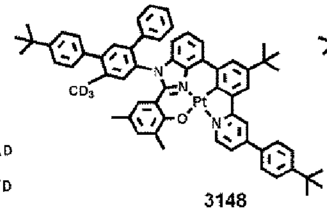
3148
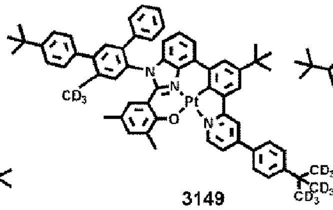
3149
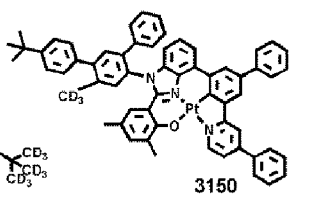
3150
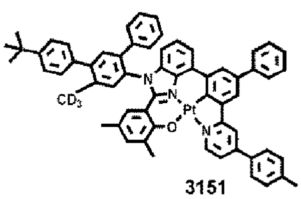
3151
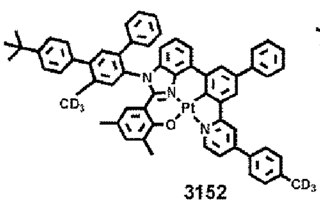
3152
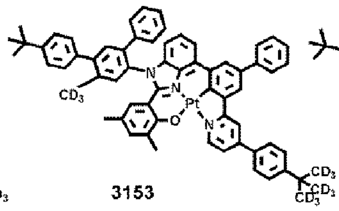
3153
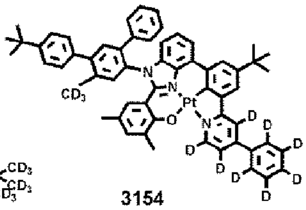
3154

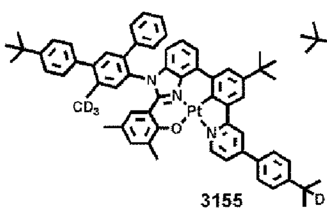
3155
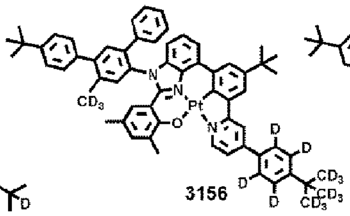
3156
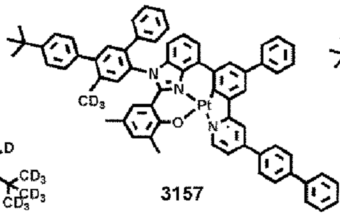
3157
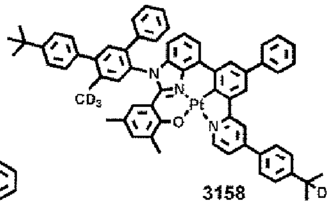
3158
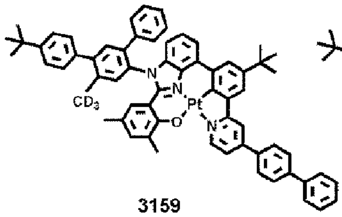
3159
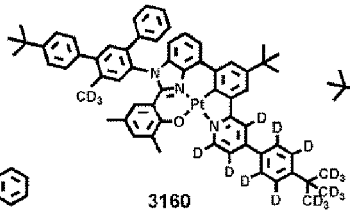
3160
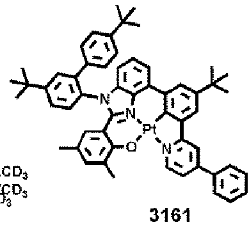
3161
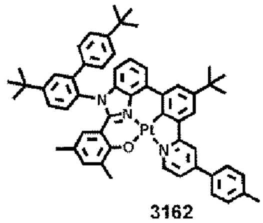
3162
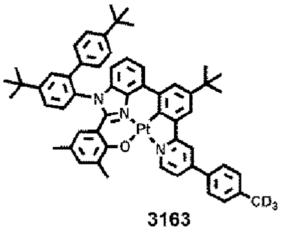
3163
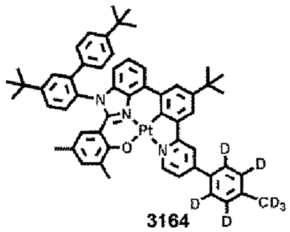
3164
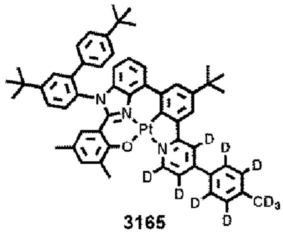
3165
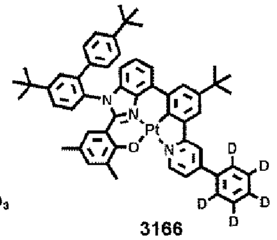
3166
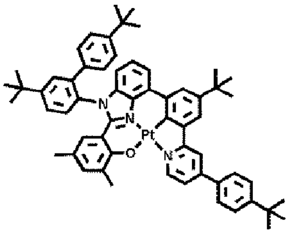
3167
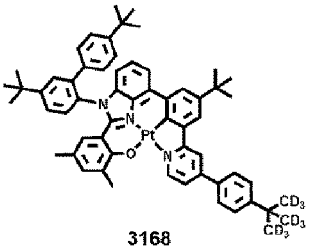
3168
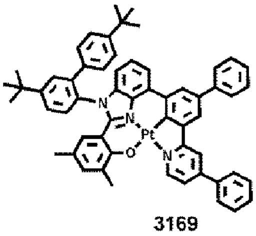
3169
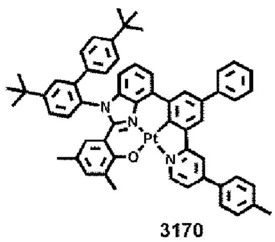
3170
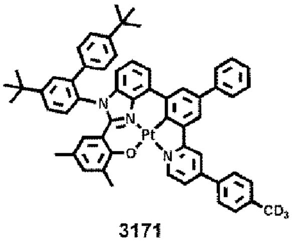
3171
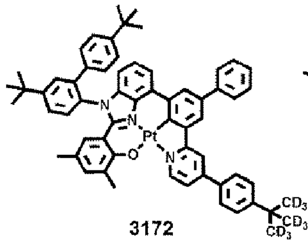
3172
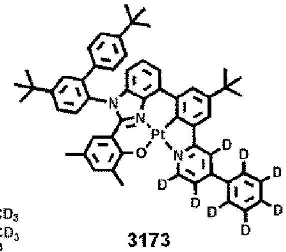
3173
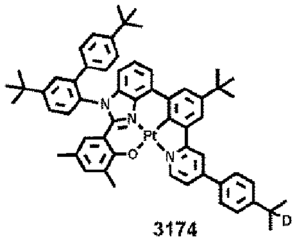
3174
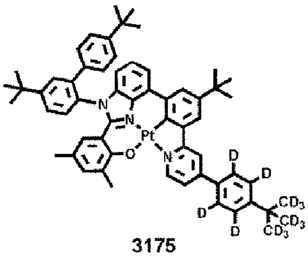
3175
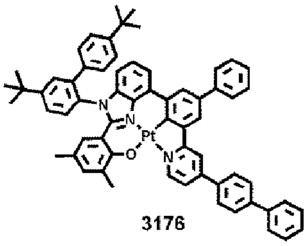
3176
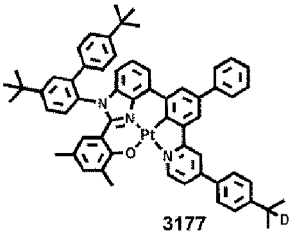
3177
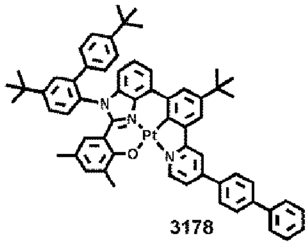
3178

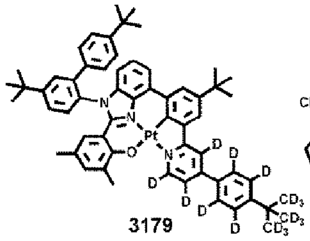
3179

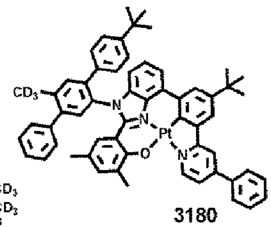
3180

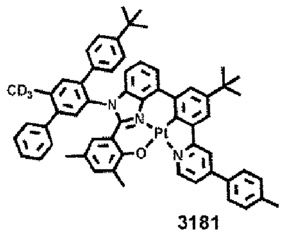
3181

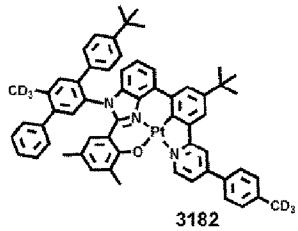
3182

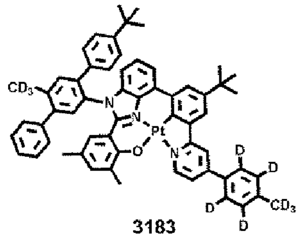
3183

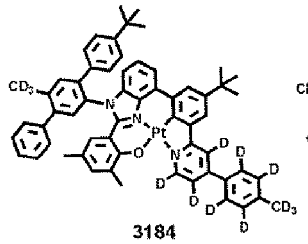
3184

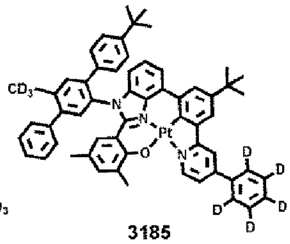
3185

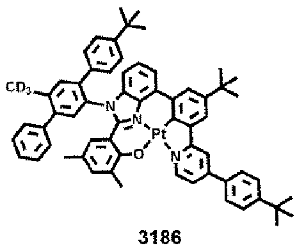
3186

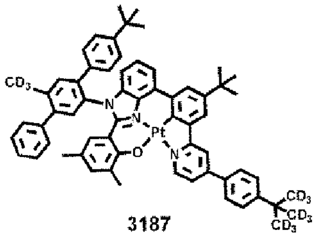
3187

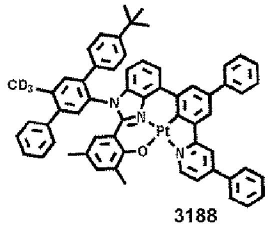
3188

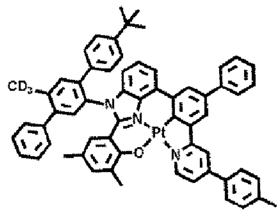
3189

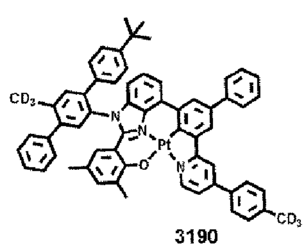
3190

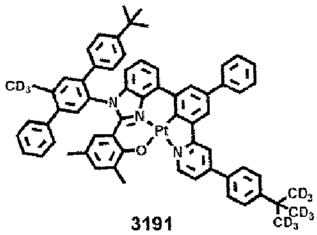
3191

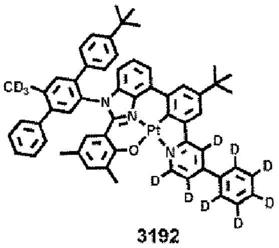
3192

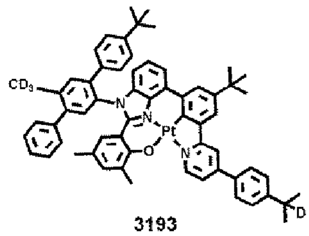
3193

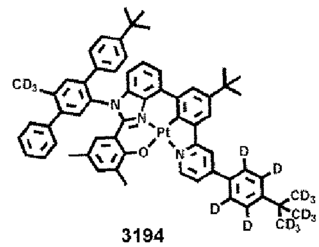
3194

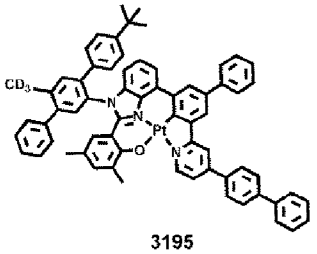
3195

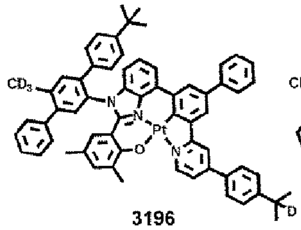
3196

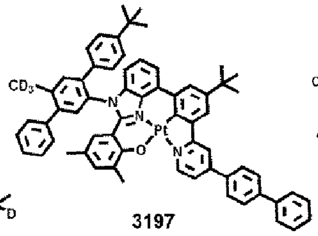
3197

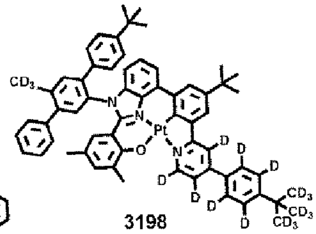
3198

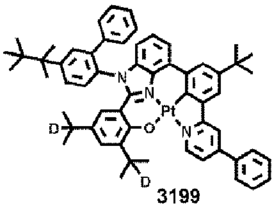
3199

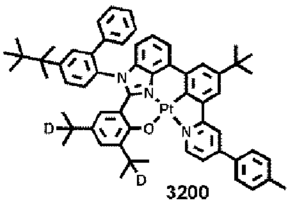
3200

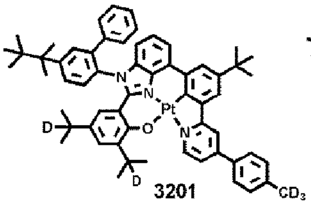
3201

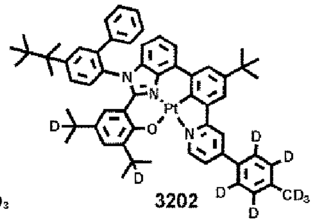
3202

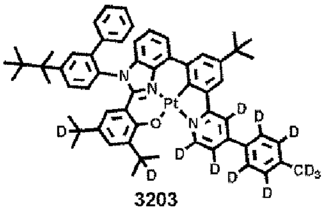
3203

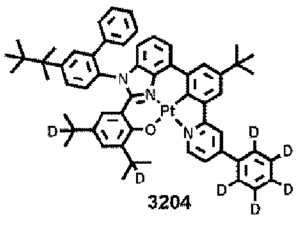
3204

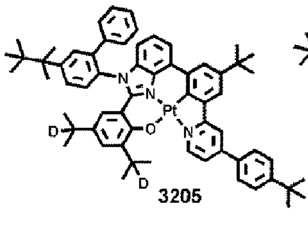
3205

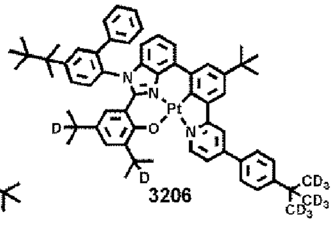
3206

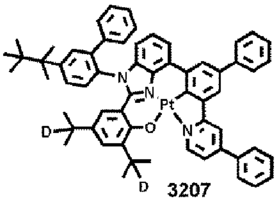
3207

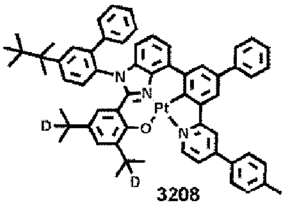
3208

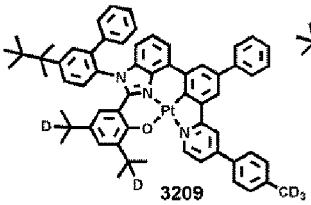
3209

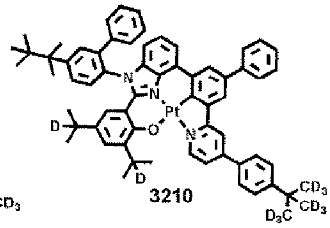
3210

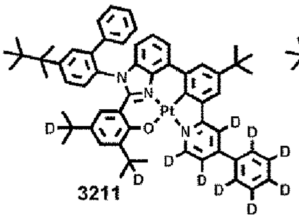
3211

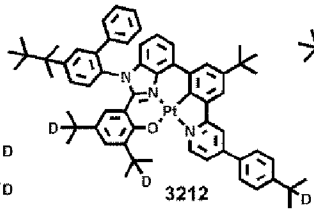
3212

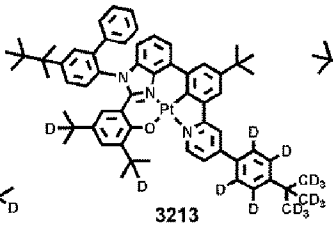
3213

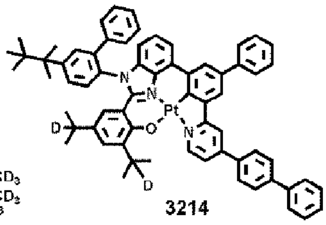
3214

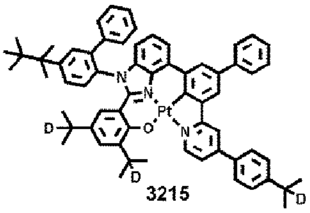
3215

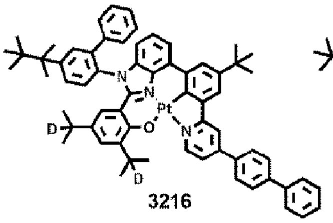
3216

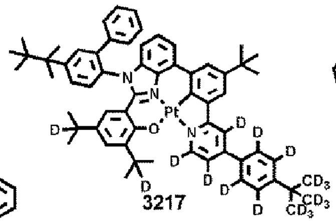
3217

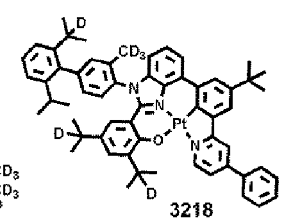
3218

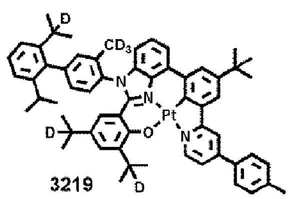
3219

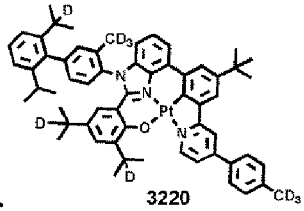
3220

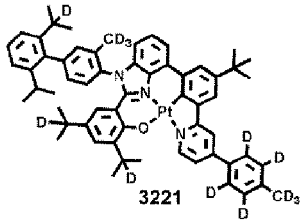
3221

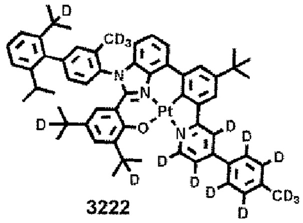
3222

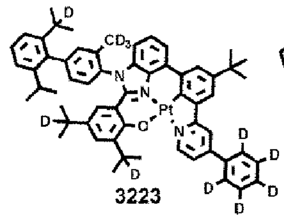
3223

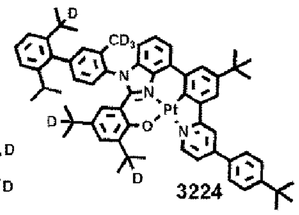
3224

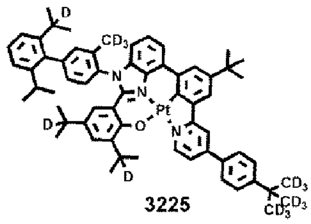
3225

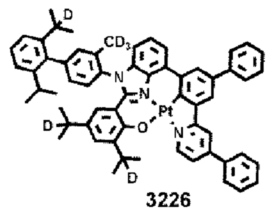
3226

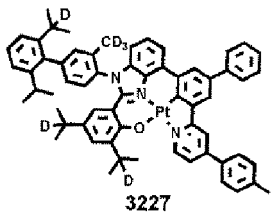
3227

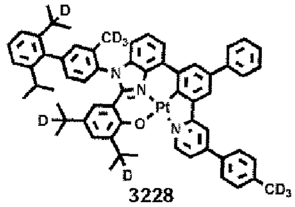
3228

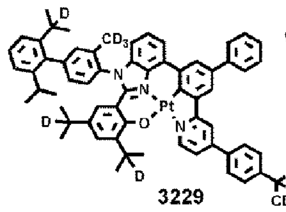
3229

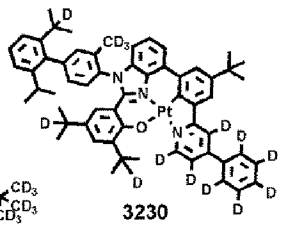
3230

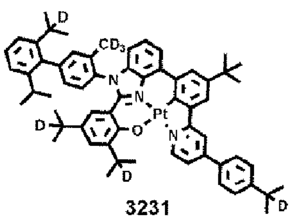
3231

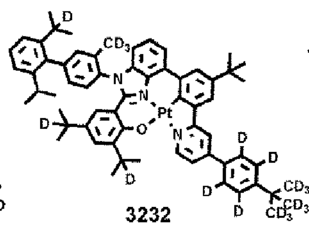
3232

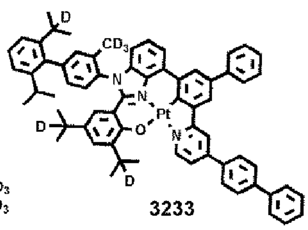
3233

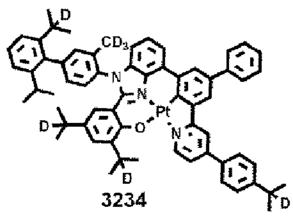
3234

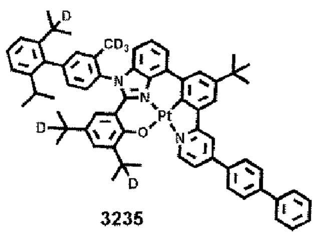
3235

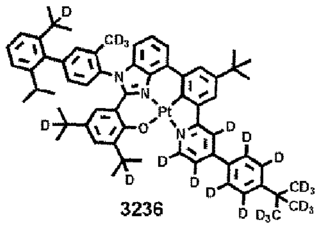
3236

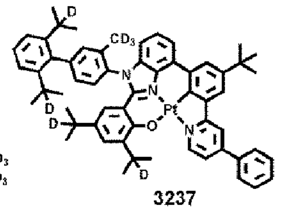
3237

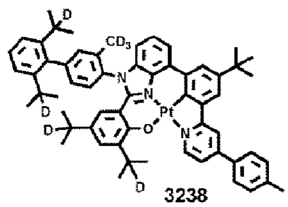
3238

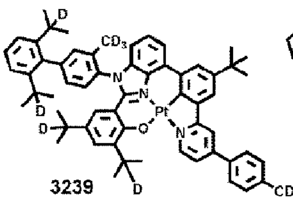
3239

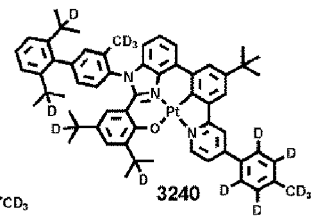
3240

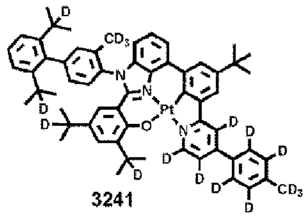
3241

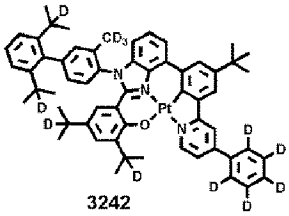
3242

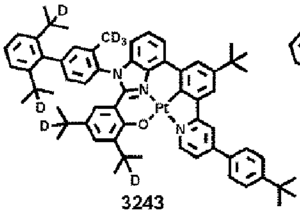
3243

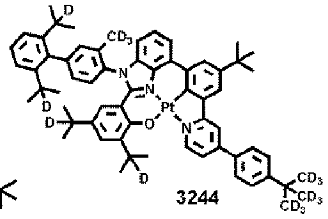
3244

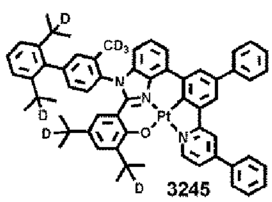
3245

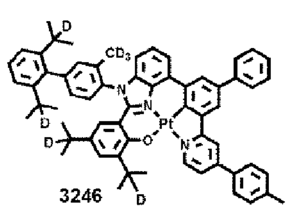
3246

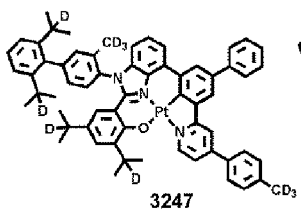
3247
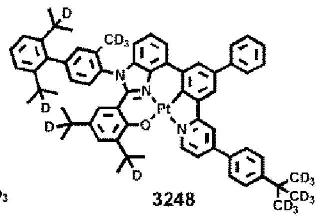
3248
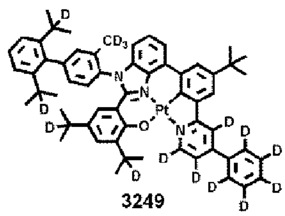
3249
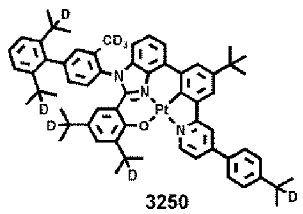
3250

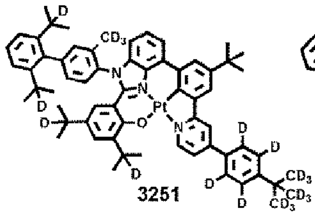
3251
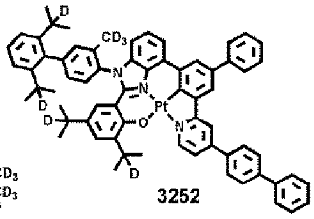
3252
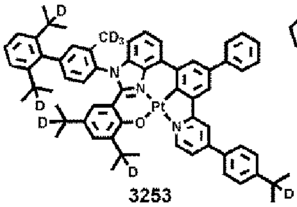
3253
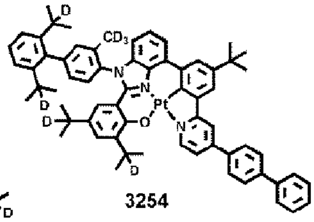
3254

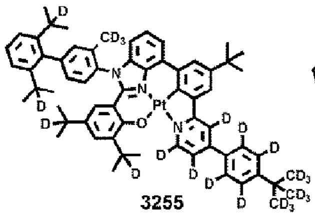
3255
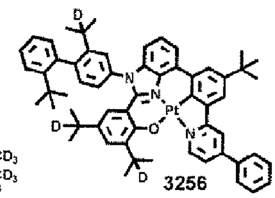
3256
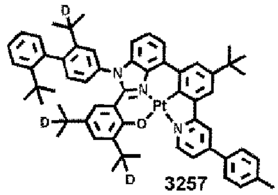
3257
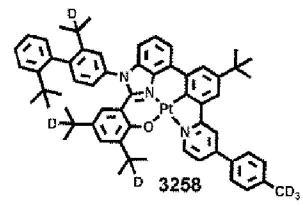
3258

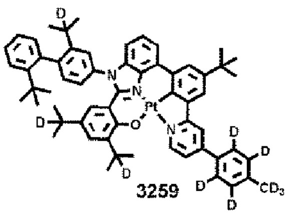
3259
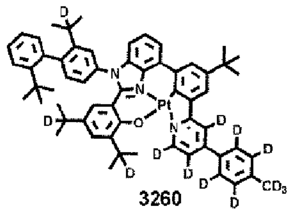
3260
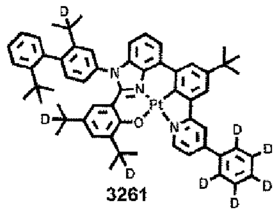
3261
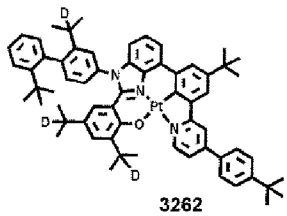
3262

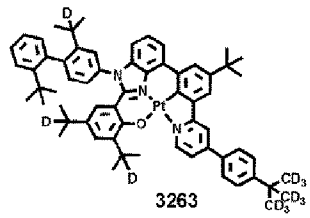
3263
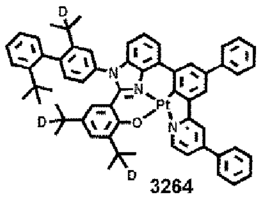
3264
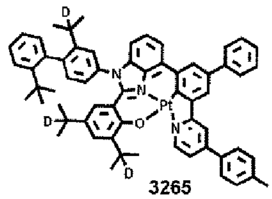
3265
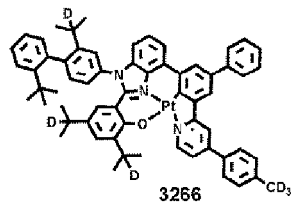
3266

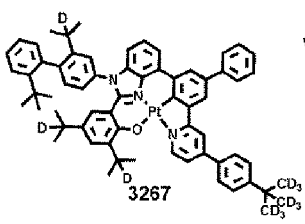
3267
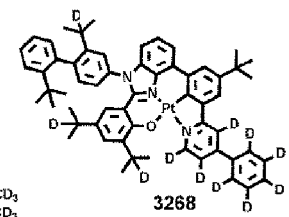
3268
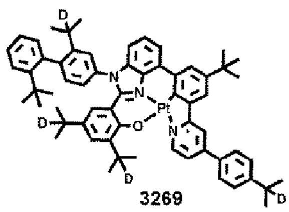
3269
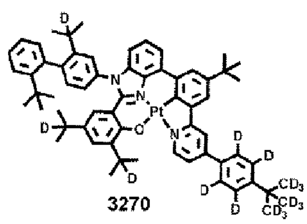
3270

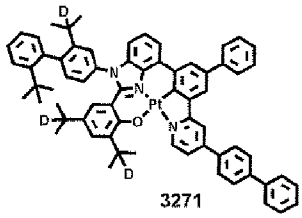
3271

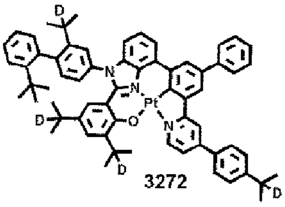
3272

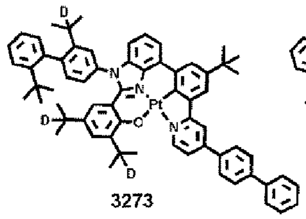
3273

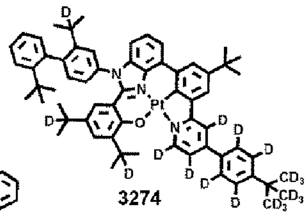
3274

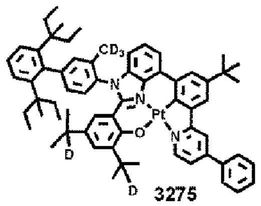
3275

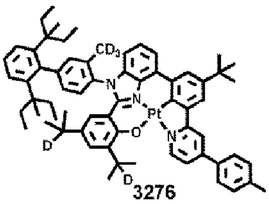
3276

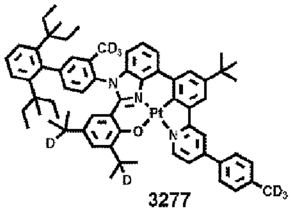
3277

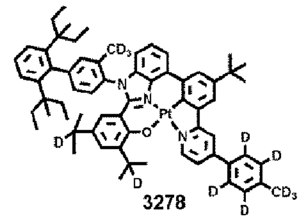
3278

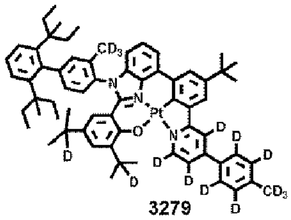
3279

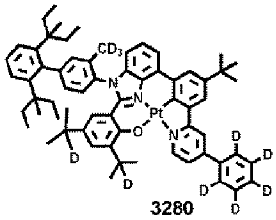
3280

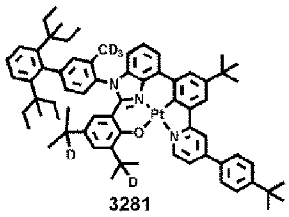
3281

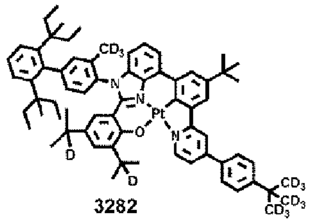
3282

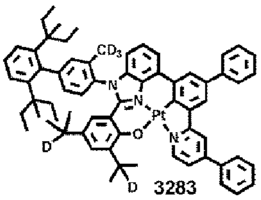
3283

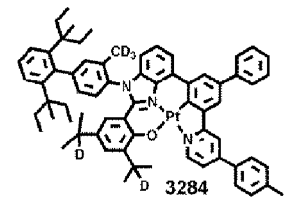
3284

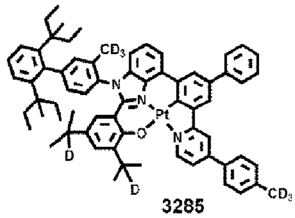
3285

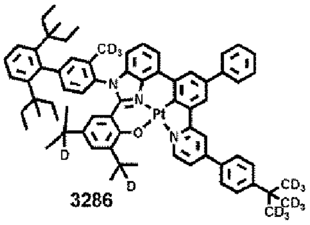
3286

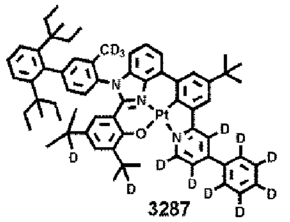
3287

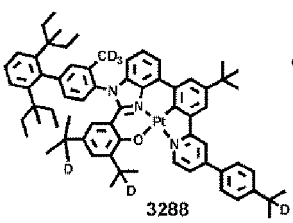
3288

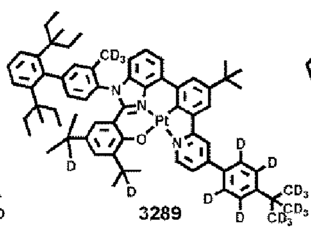
3289

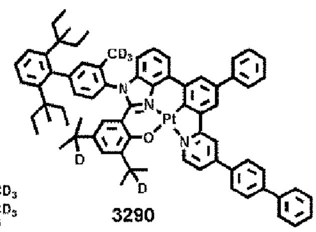
3290

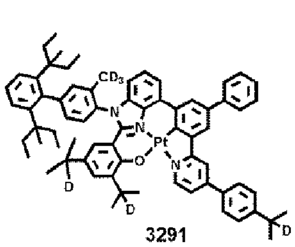
3291

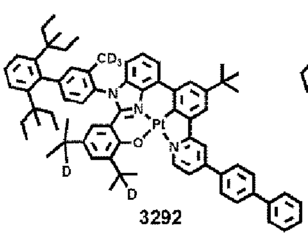
3292

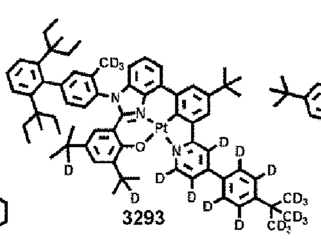
3293

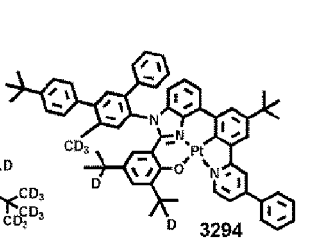
3294

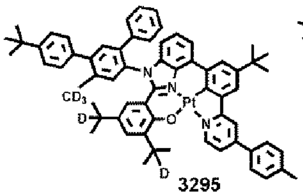
3295

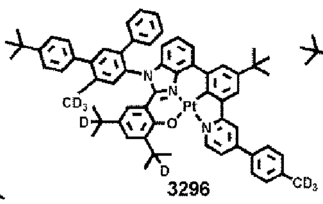
3296

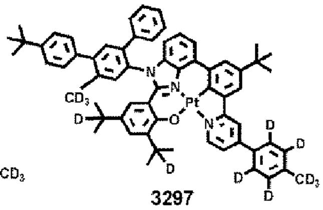
3297

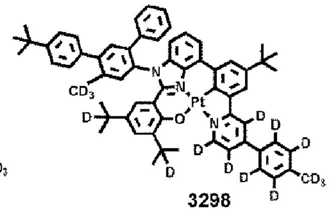
3298

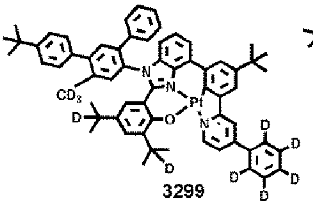
3299

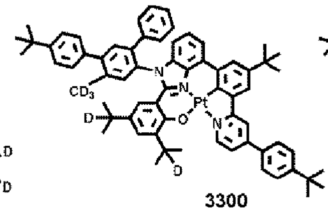
3300

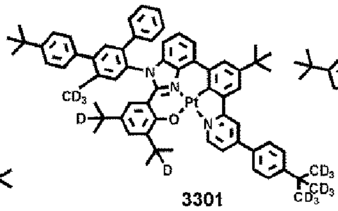
3301

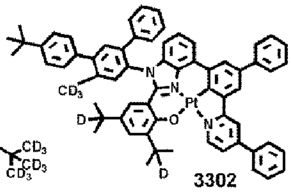
3302

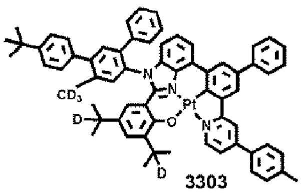
3303

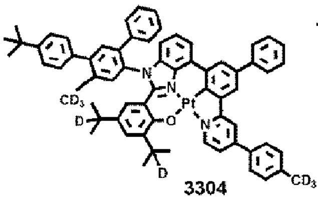
3304

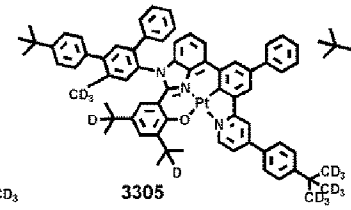
3305

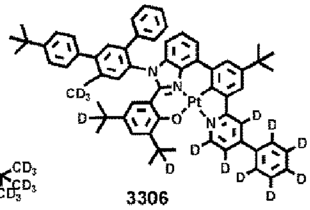
3306

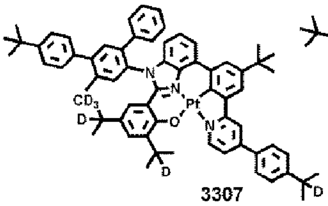
3307

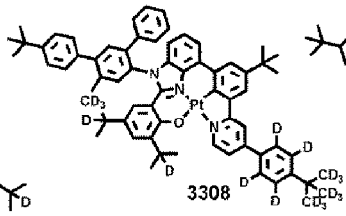
3308

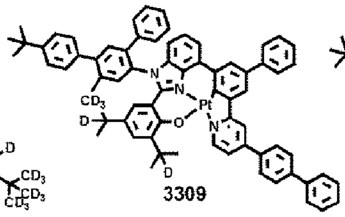
3309

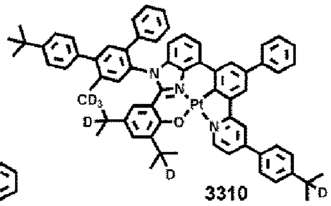
3310

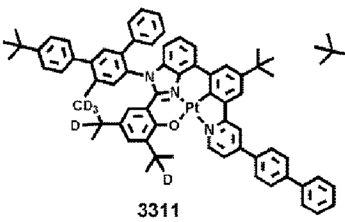
3311

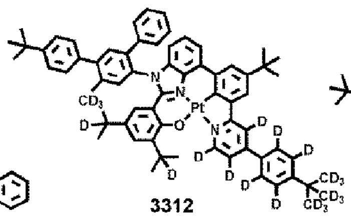
3312

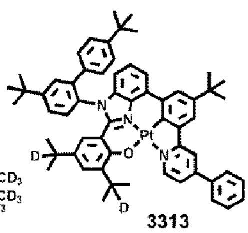
3313

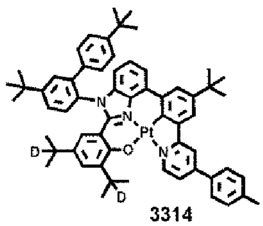
3314

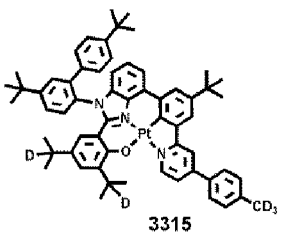
3315

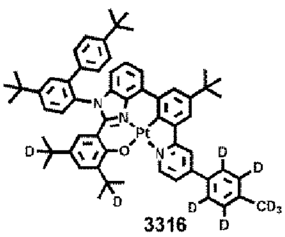
3316

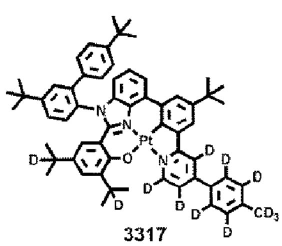
3317

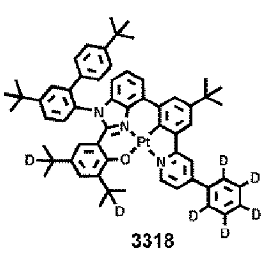
3318

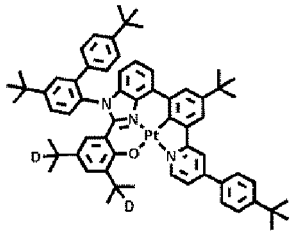
3319

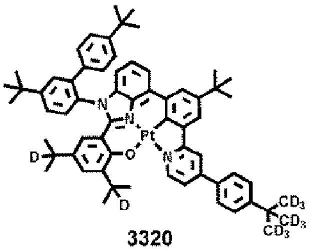
3320

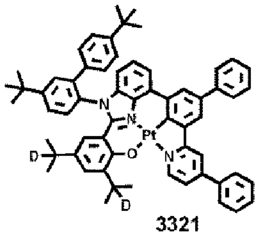
3321

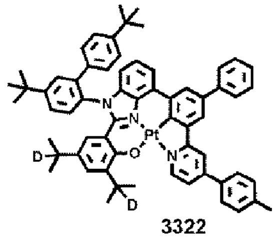
3322

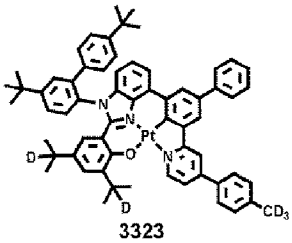
3323

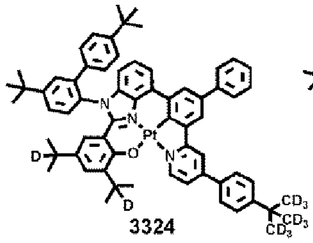
3324

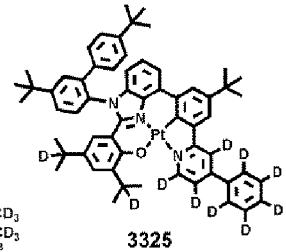
3325

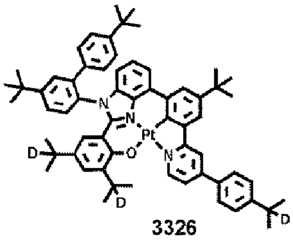
3326

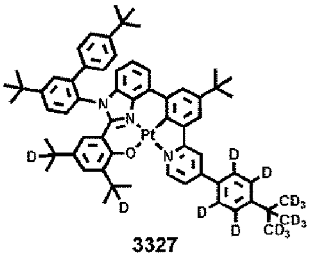
3327

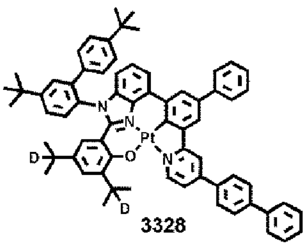
3328

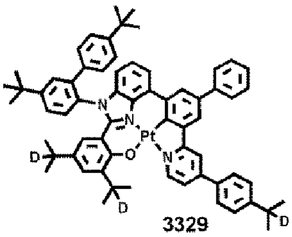
3329

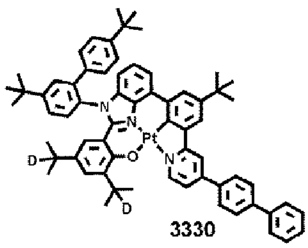
3330

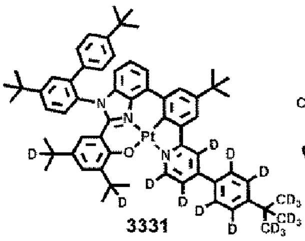
3331

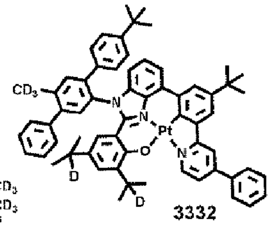
3332

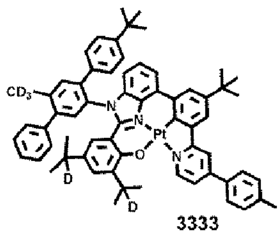
3333

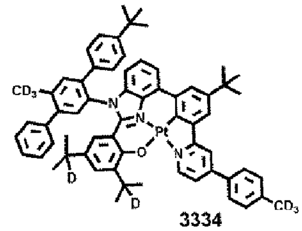
3334

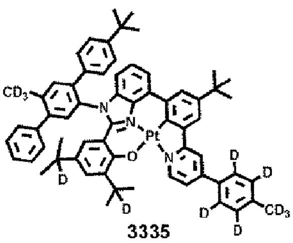
3335

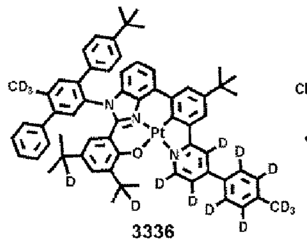
3336

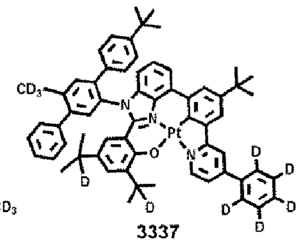
3337

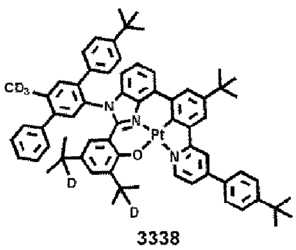
3338

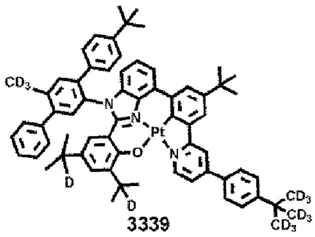
3339

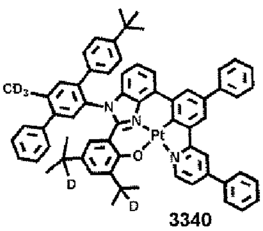
3340

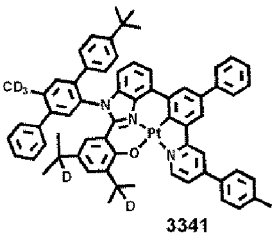
3341

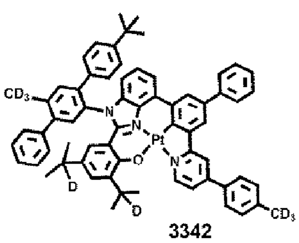
3342

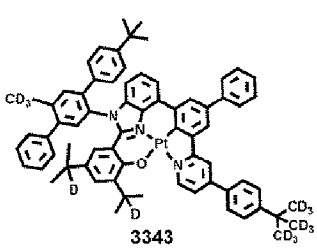
3343

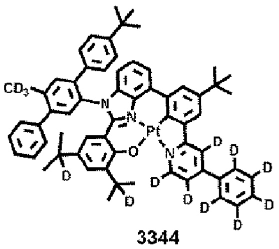
3344

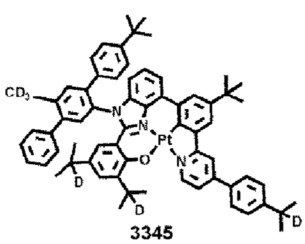
3345

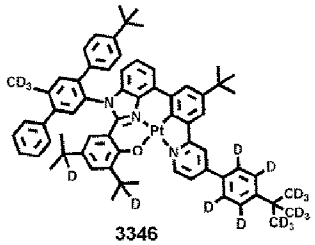
3346

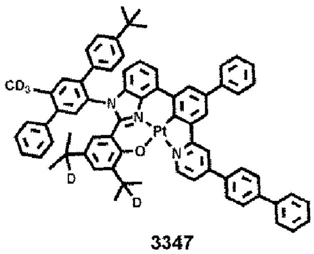
3347

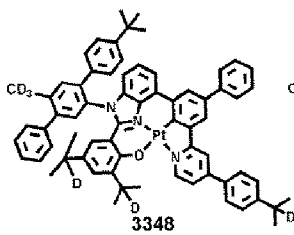
3348

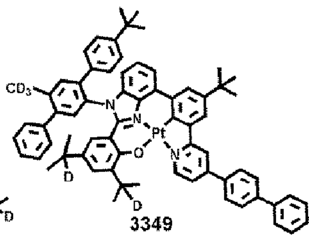
3349

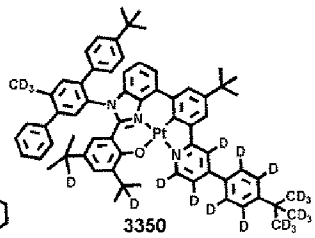
3350

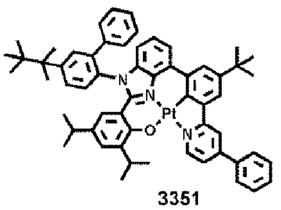
3351

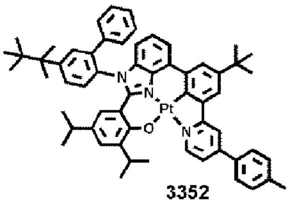
3352

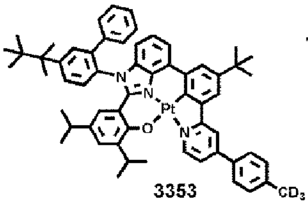
3353

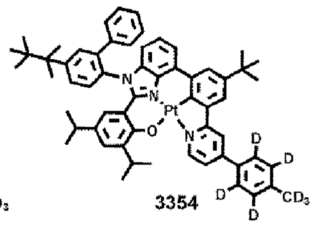
3354

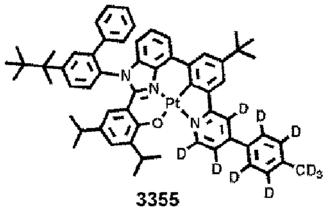
3355

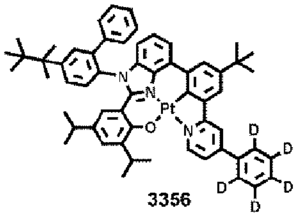
3356

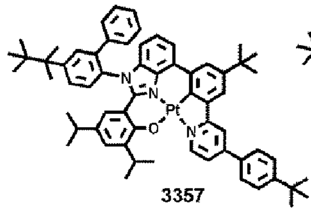
3357

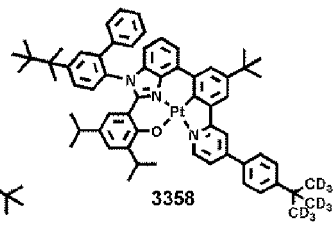
3358

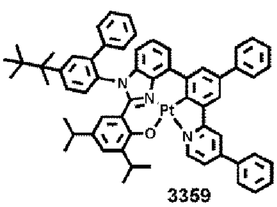
3359

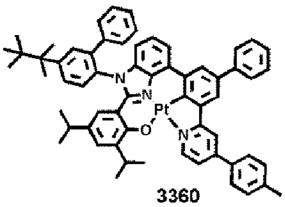
3360

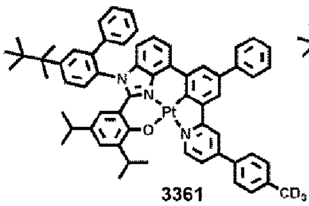
3361

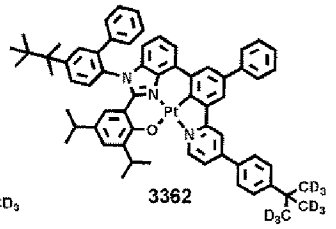
3362

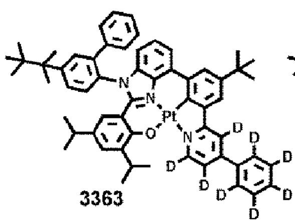
3363

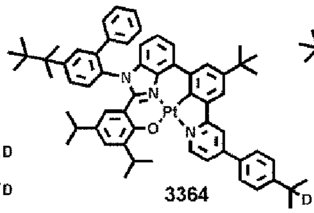
3364

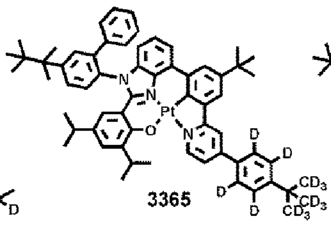
3365

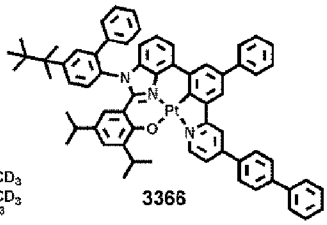
3366

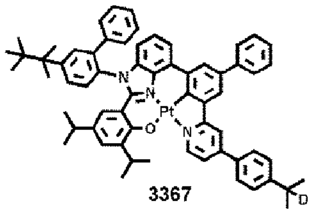
3367

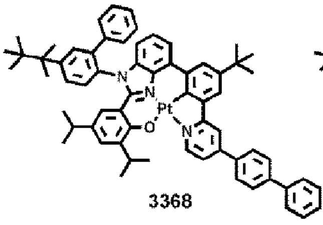
3368

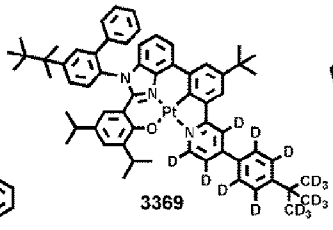
3369

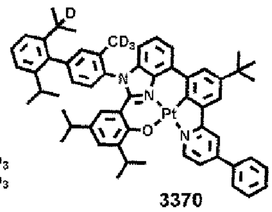
3370

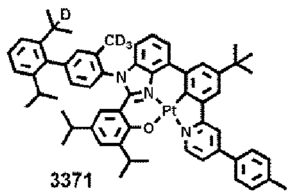
3371

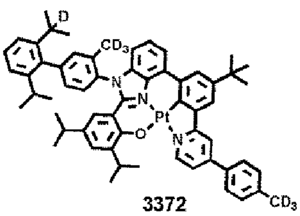
3372

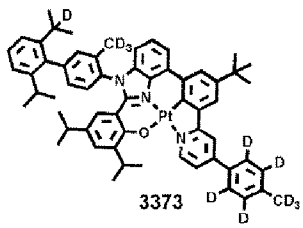
3373

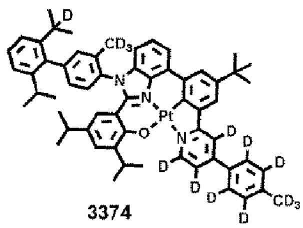
3374

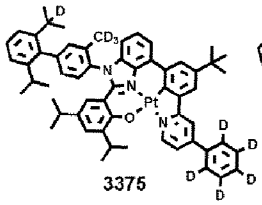
3375

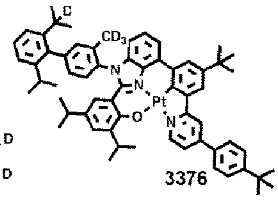
3376

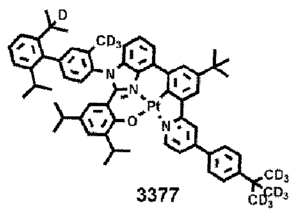
3377

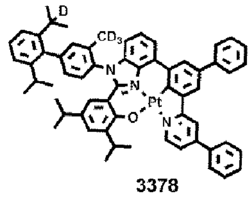
3378

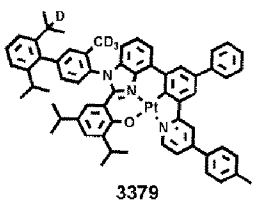
3379

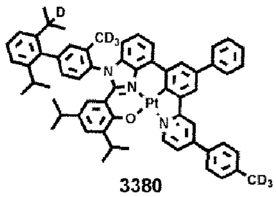
3380

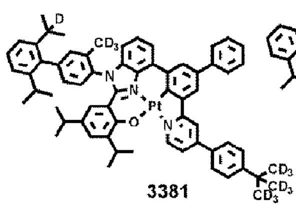
3381

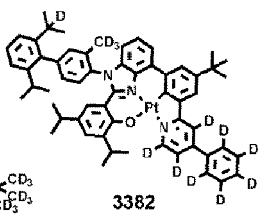
3382

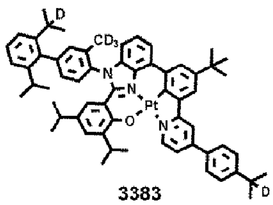
3383

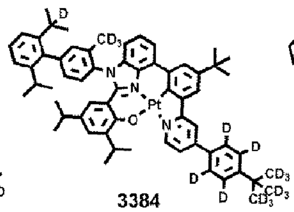
3384

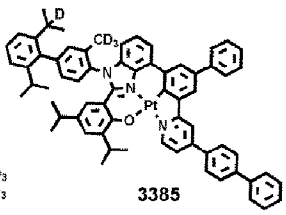
3385

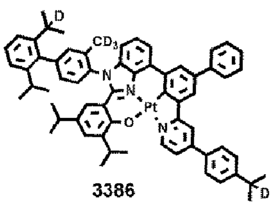
3386

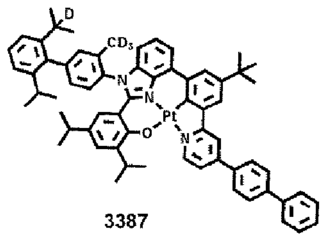
3387

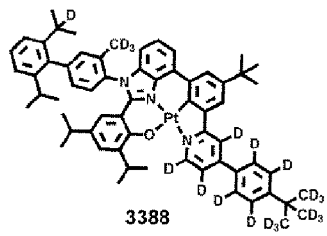
3388

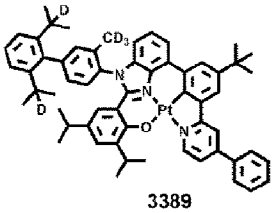
3389

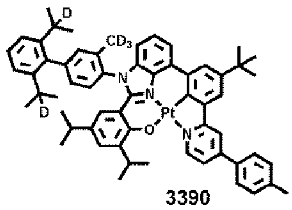
3390

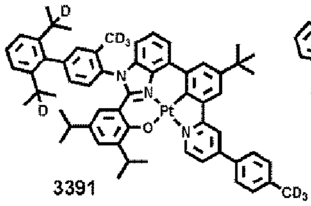
3391

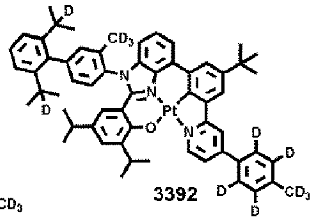
3392

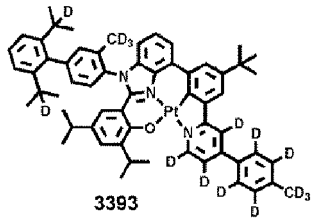
3393

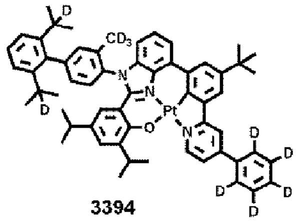
3394

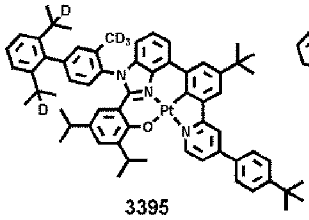
3395

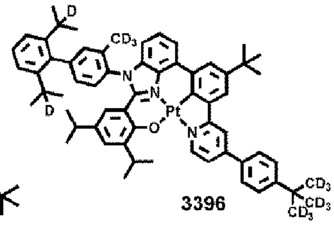
3396

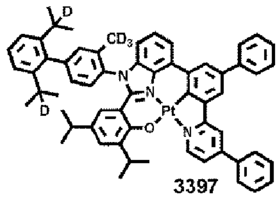
3397

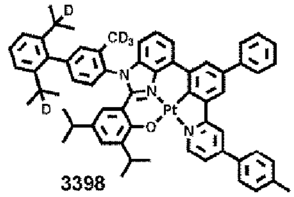
3398

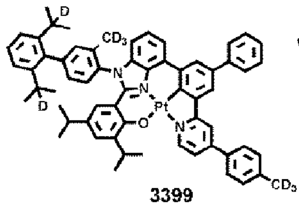
3399

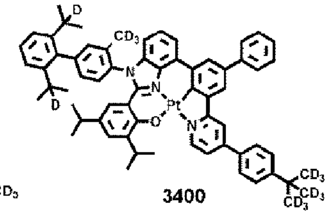
3400

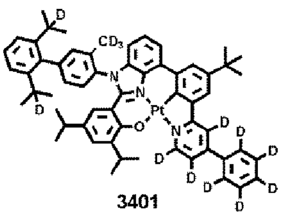
3401

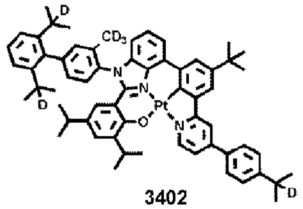
3402

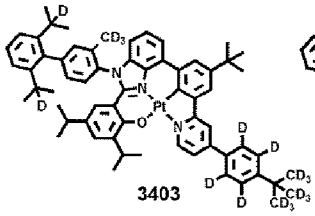
3403

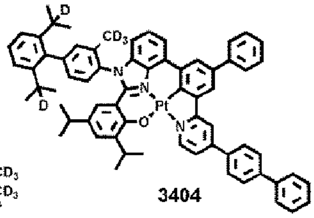
3404

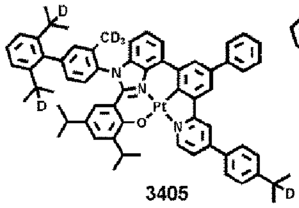
3405

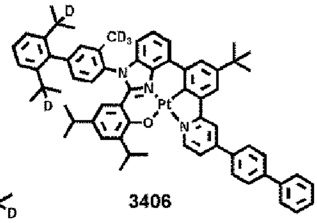
3406

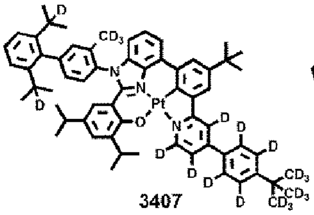
3407

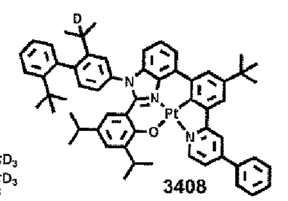
3408

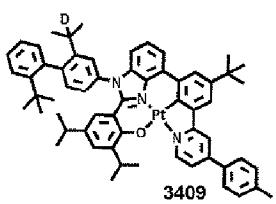
3409

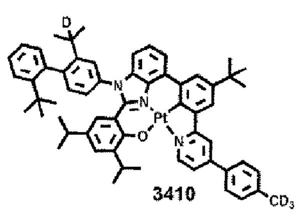
3410

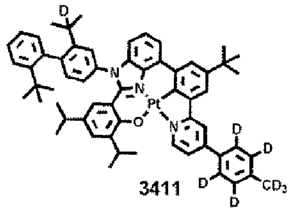
3411
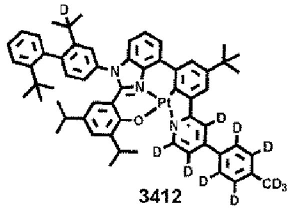
3412
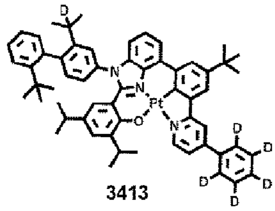
3413
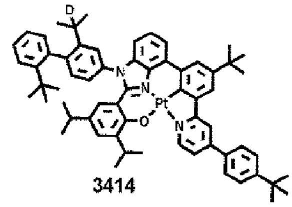
3414
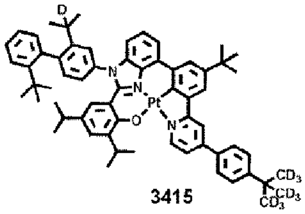
3415
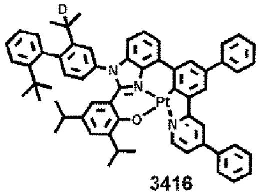
3416
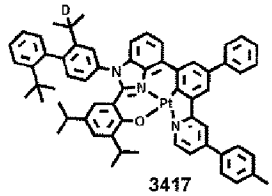
3417
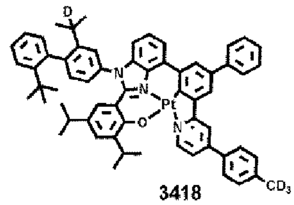
3418
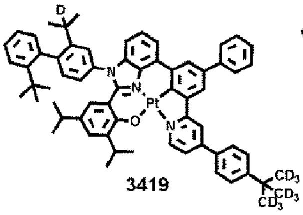
3419
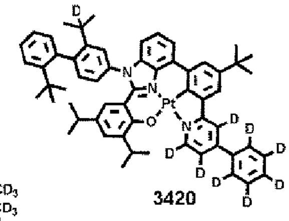
3420
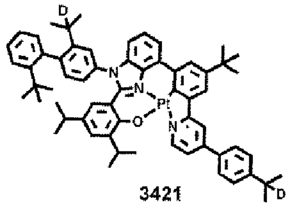
3421
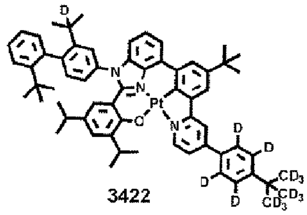
3422
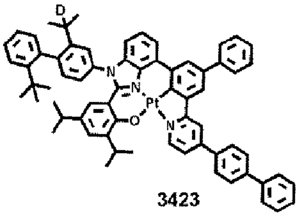
3423
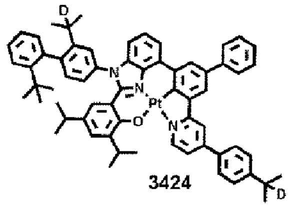
3424
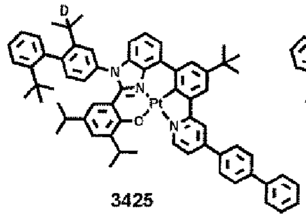
3425
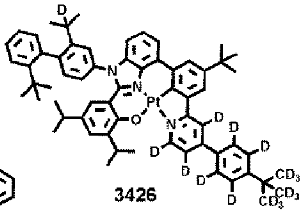
3426
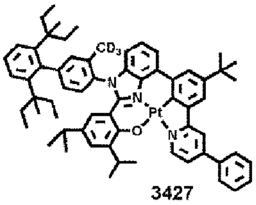
3427
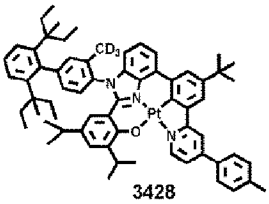
3428
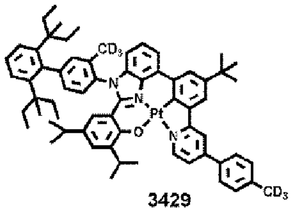
3429
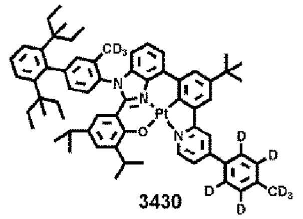
3430
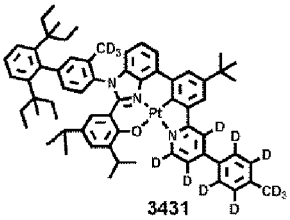
3431
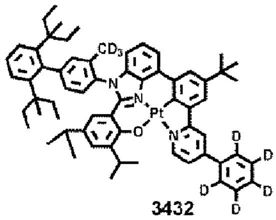
3432
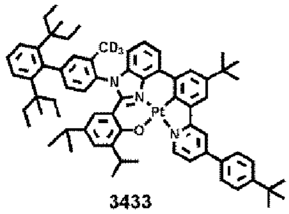
3433
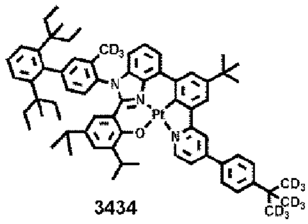
3434

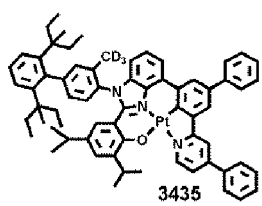
3435
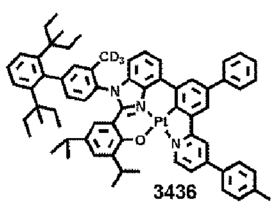
3436
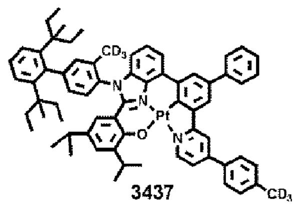
3437
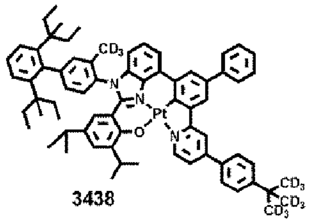
3438

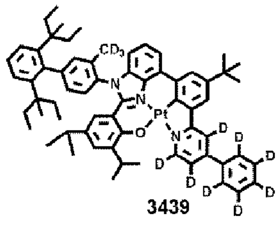
3439
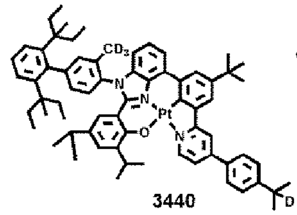
3440
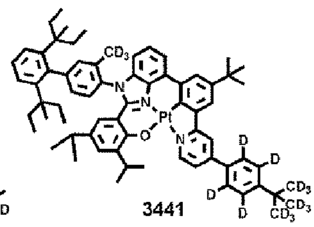
3441
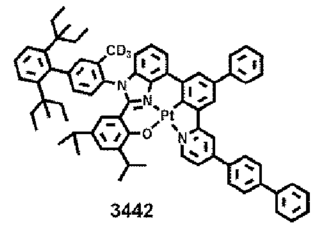
3442

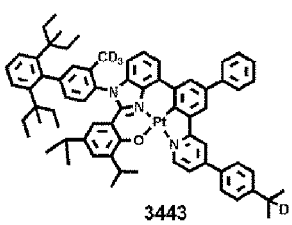
3443
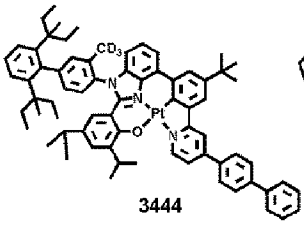
3444
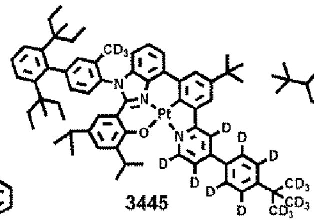
3445
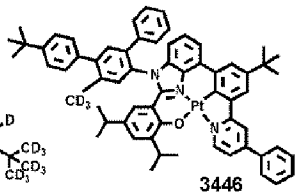
3446

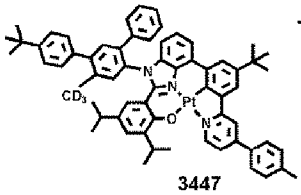
3447
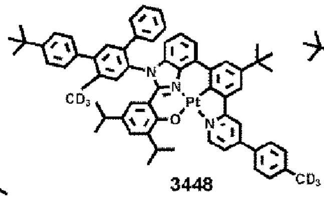
3448
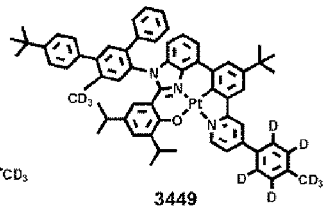
3449
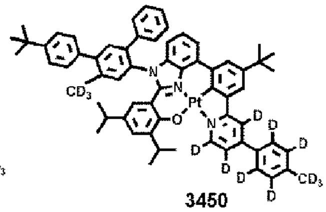
3450

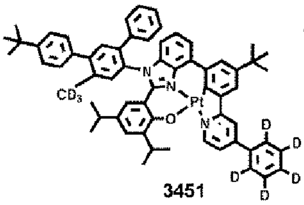
3451
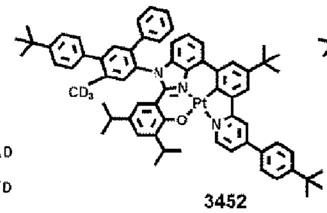
3452
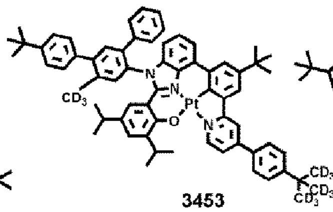
3453
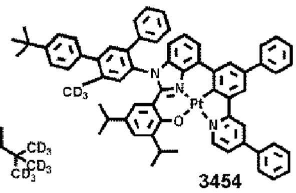
3454

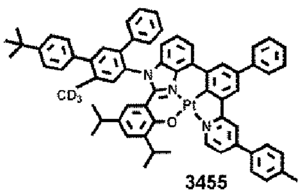
3455
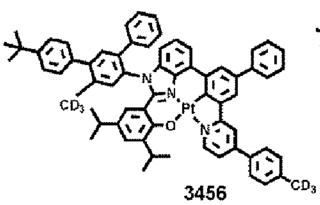
3456
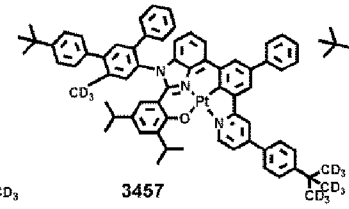
3457
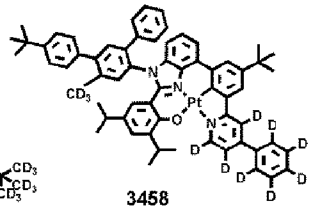
3458

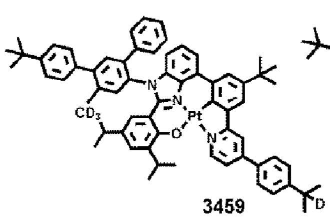
3459

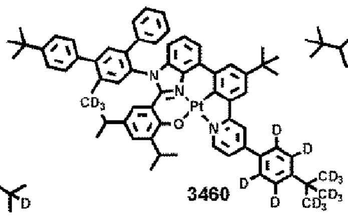
3460

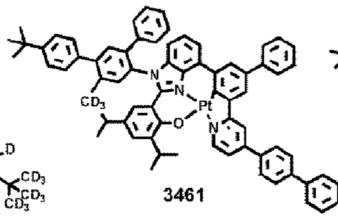
3461

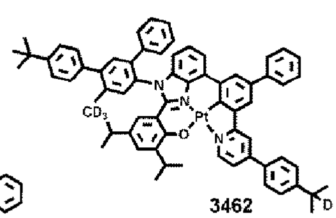
3462

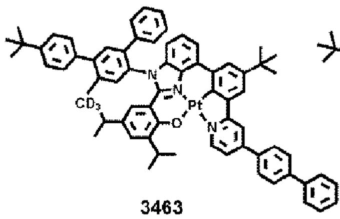
3463

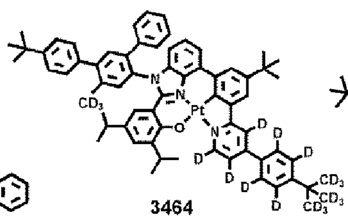
3464

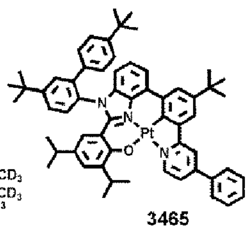
3465

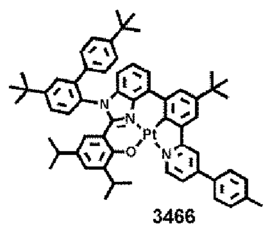
3466

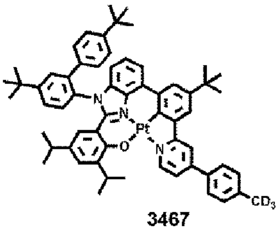
3467

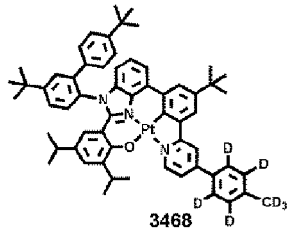
3468

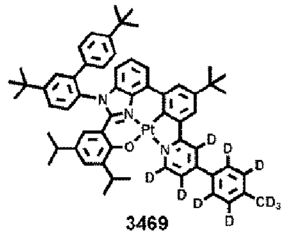
3469

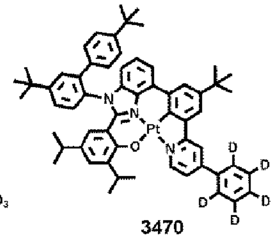
3470

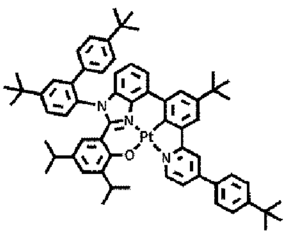
3471

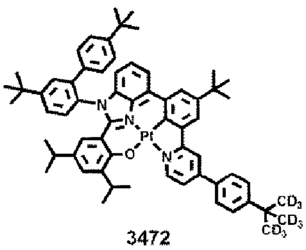
3472

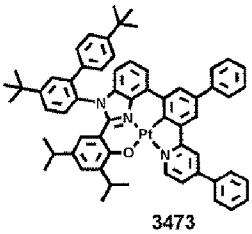
3473

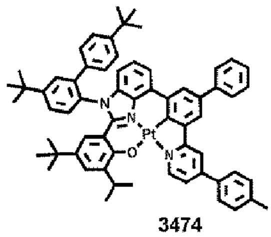
3474

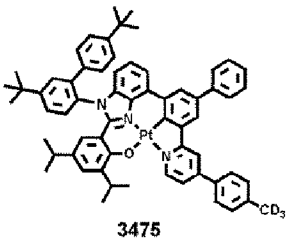
3475

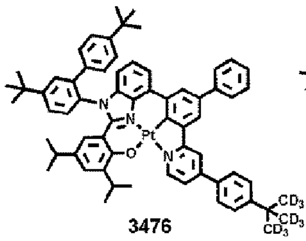
3476

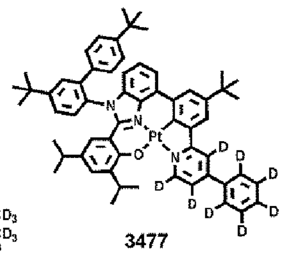
3477

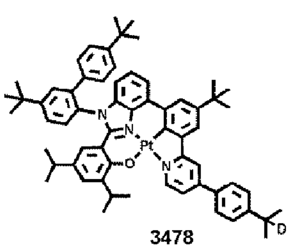
3478

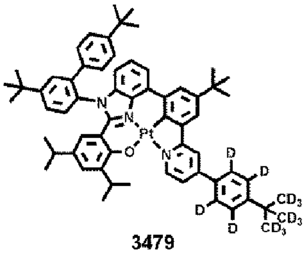
3479

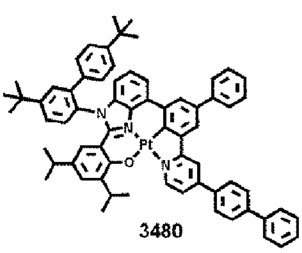
3480

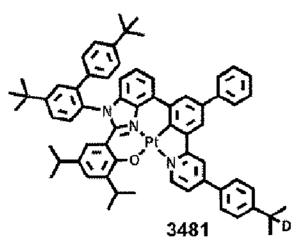
3481

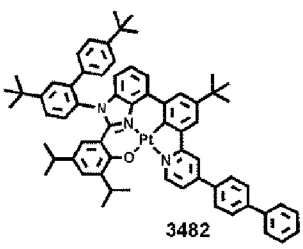
3482

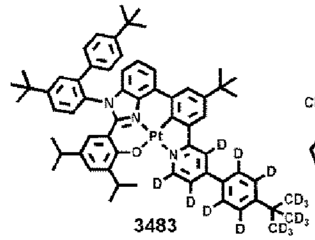
3483

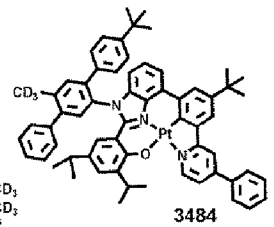
3484

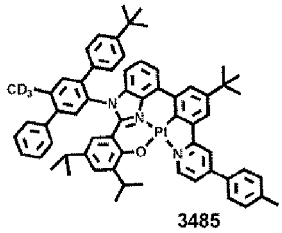
3485

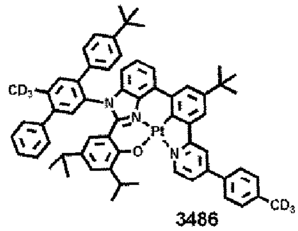
3486

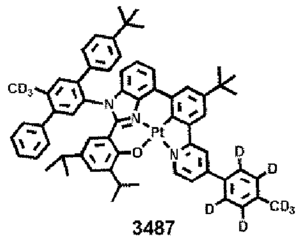
3487

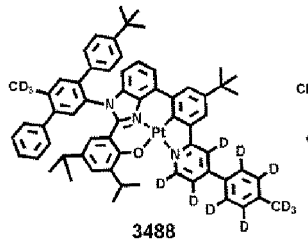
3488

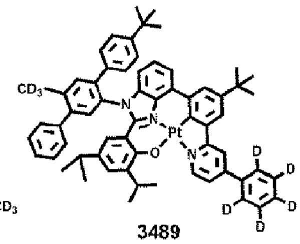
3489

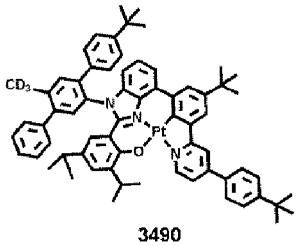
3490

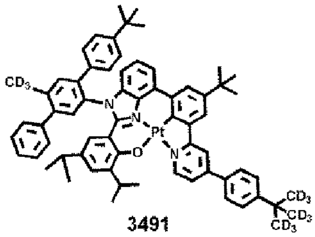
3491

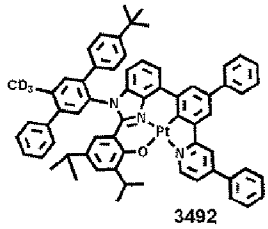
3492

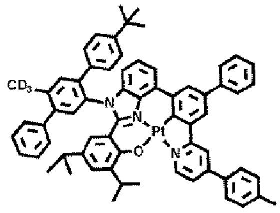
3493

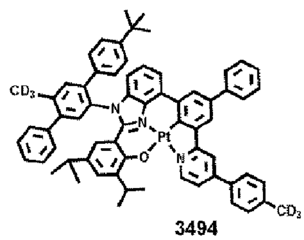
3494

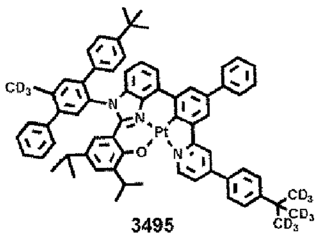
3495

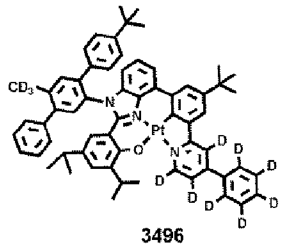
3496

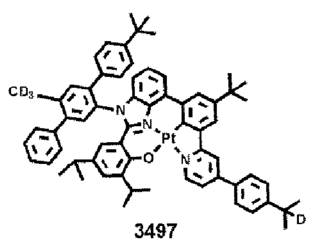
3497

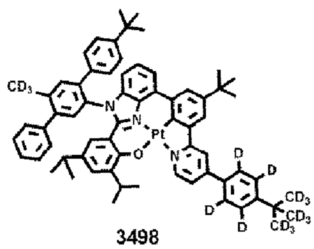
3498

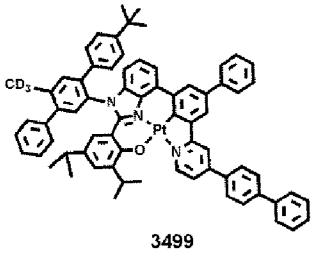
3499

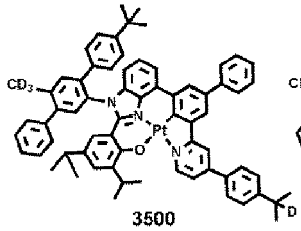
3500

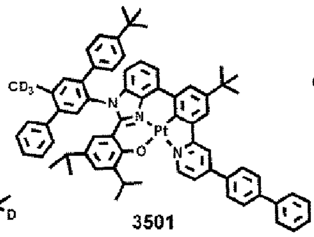
3501

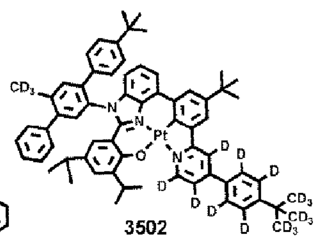
3502

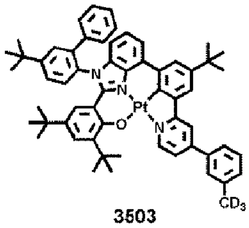
3503

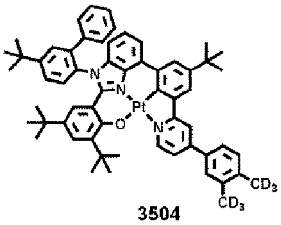
3504

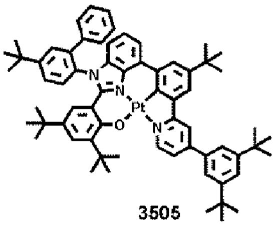
3505

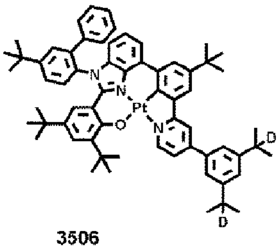
3506

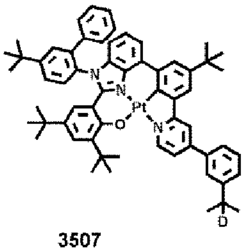
3507

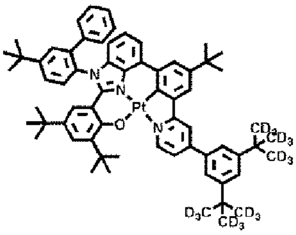
3508

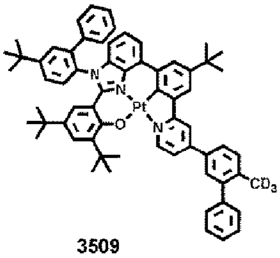
3509

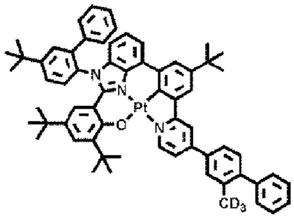
3510

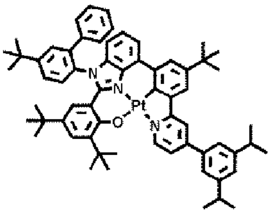
3511

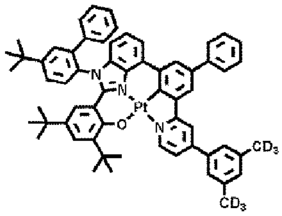
3512

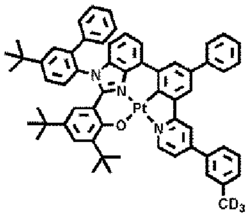
3513

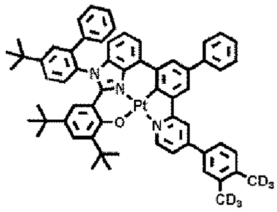
3514

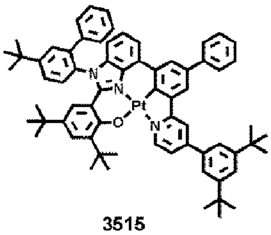
3515

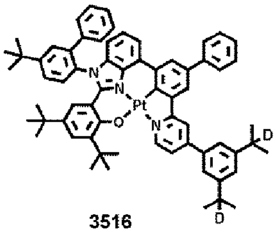
3516

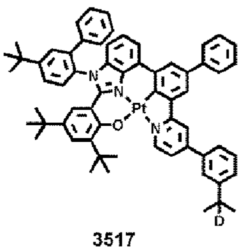
3517

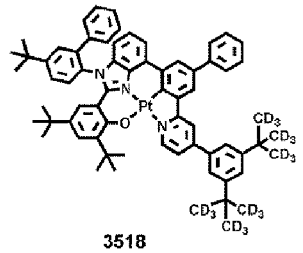
3518

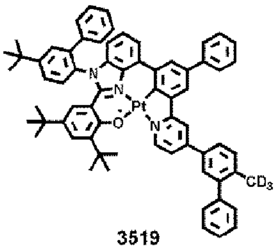
3519

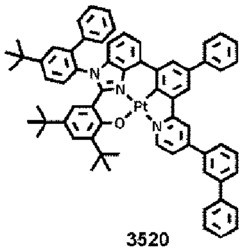
3520

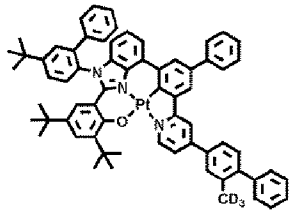
3521

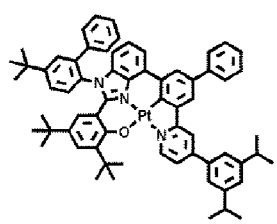
3522

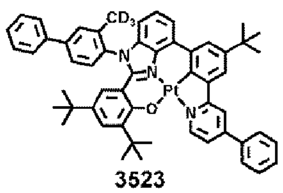
3523
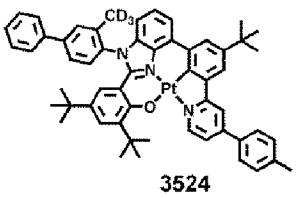
3524
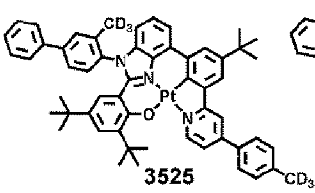
3525
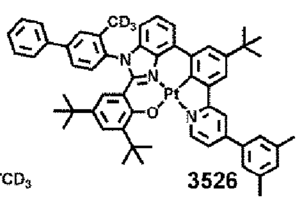
3526

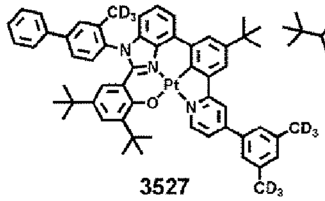
3527
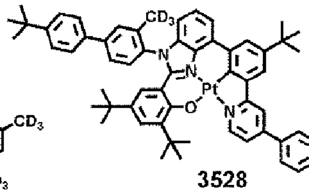
3528
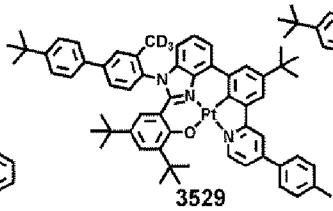
3529
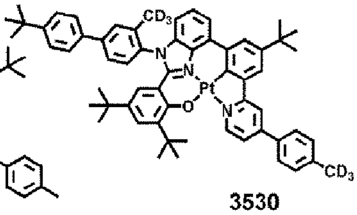
3530

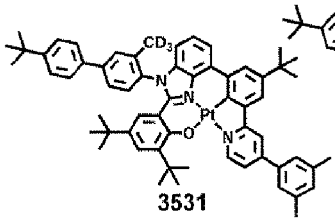
3531
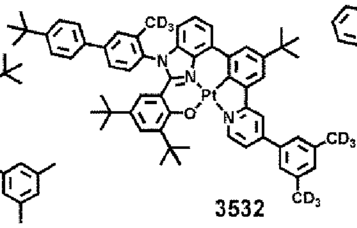
3532
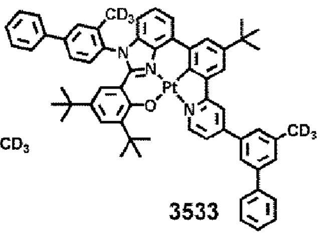
3533
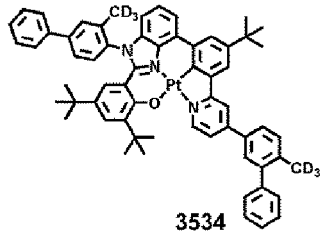
3534

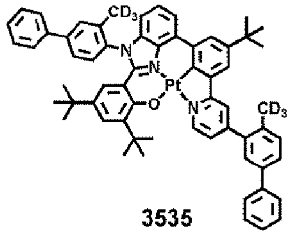
3535
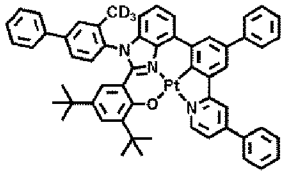
3536
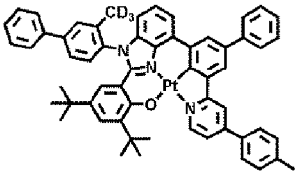
3537
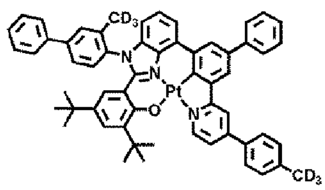
3538

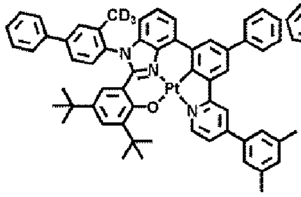
3539
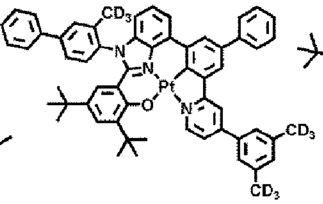
3540
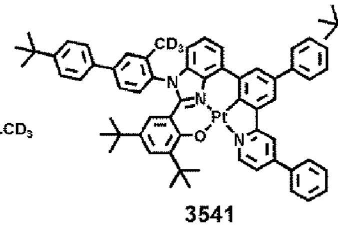
3541
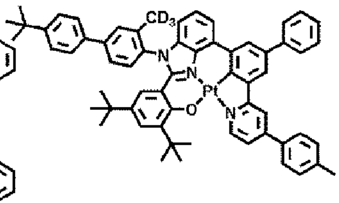
3542

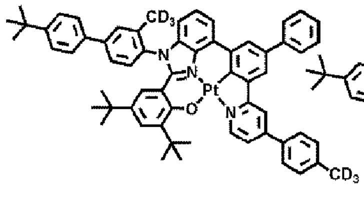
3543
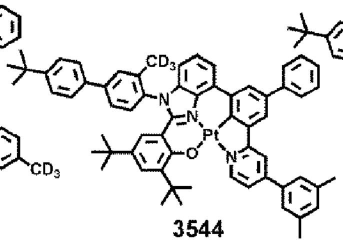
3544
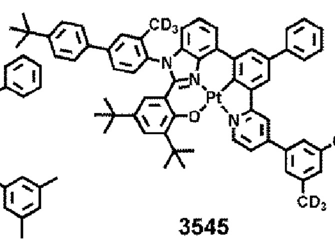
3545
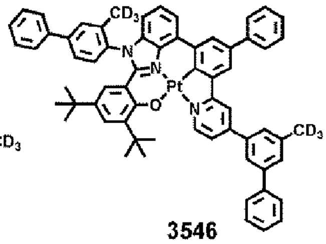
3546

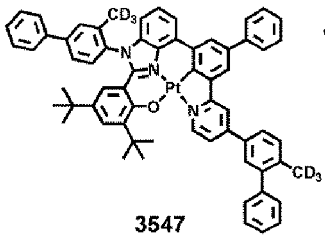

3547

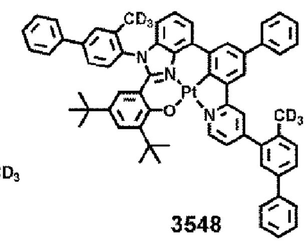

3548

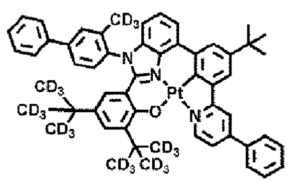

3549

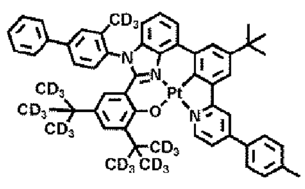

3550

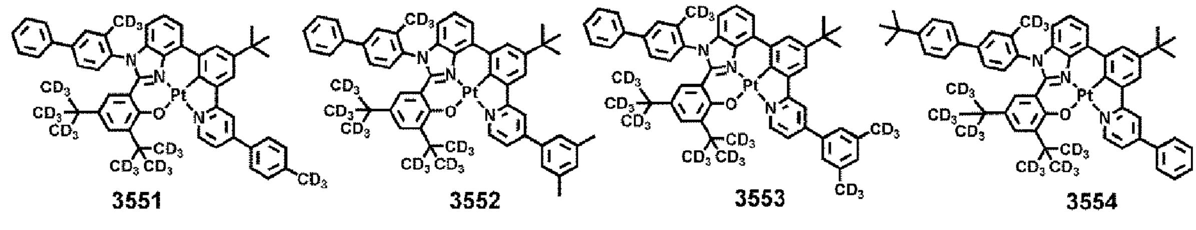

3551

3552

3553

3554

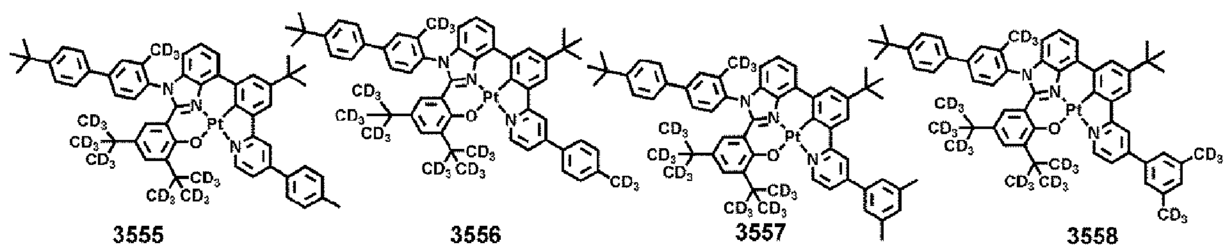

3555

3556

3557

3558

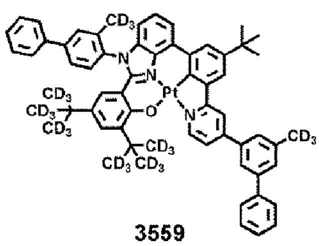

3559

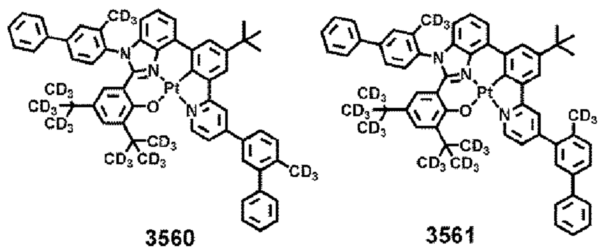

3560

3561

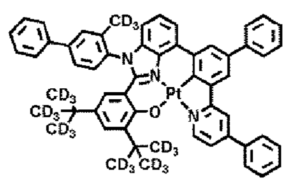

3562

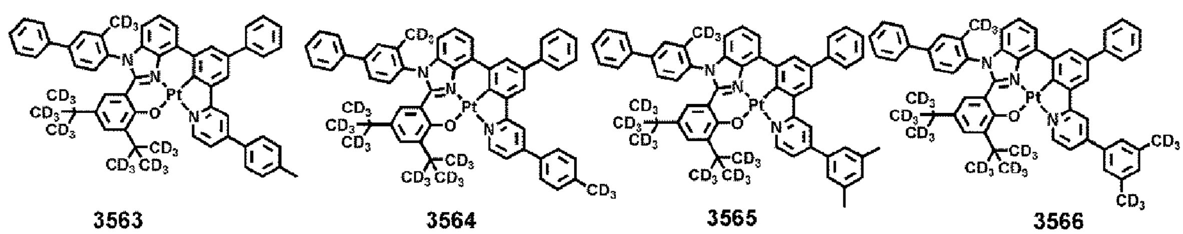

3563

3564

3565

3566

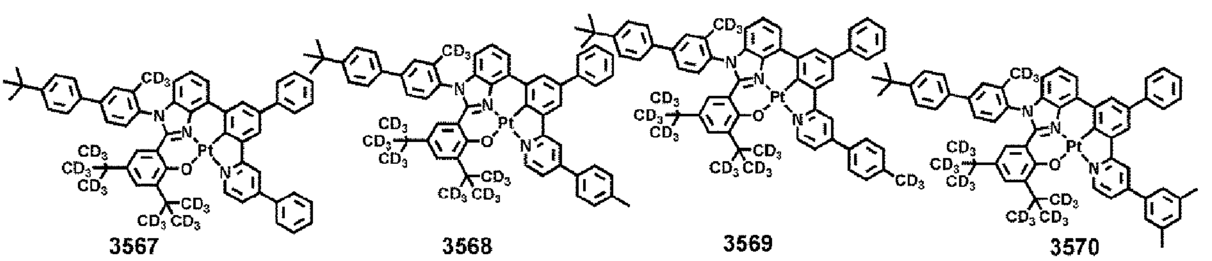

3567

3568

3569

3570

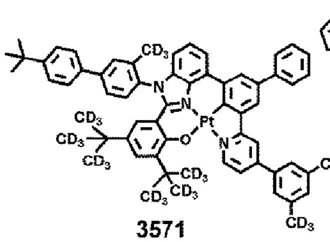
3571
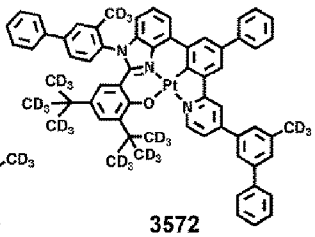
3572
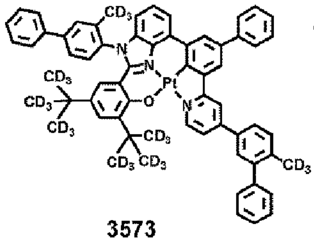
3573
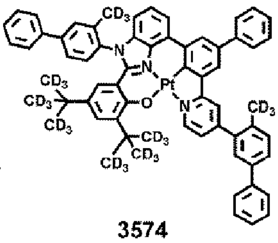
3574

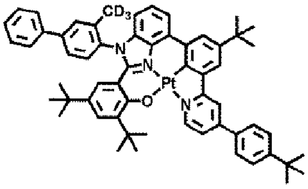
3575
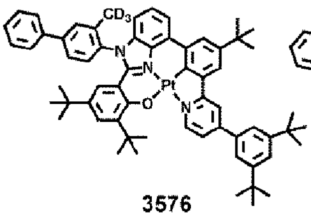
3576
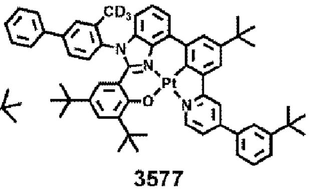
3577
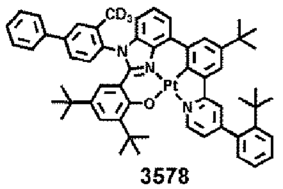
3578

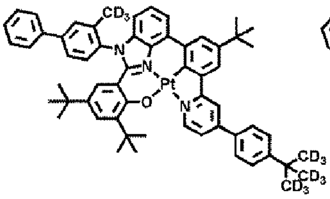
3579
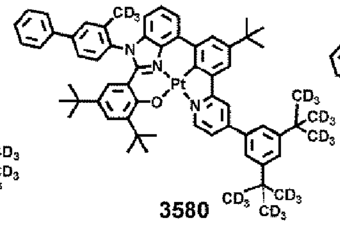
3580
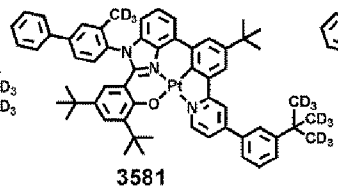
3581
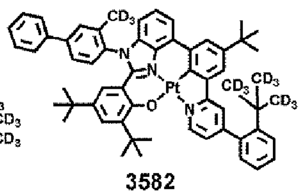
3582

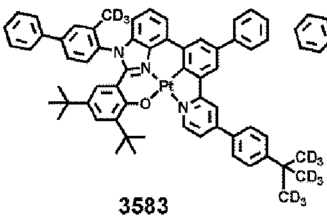
3583
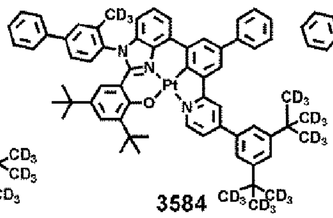
3584
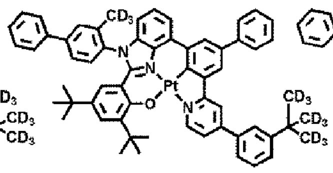
3585
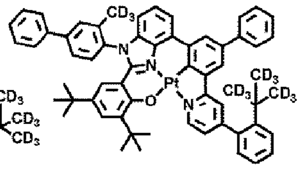
3586

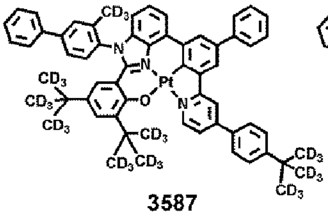
3587
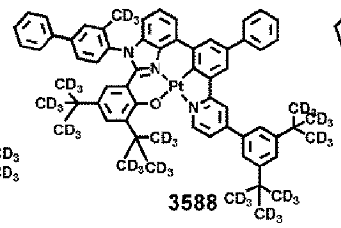
3588
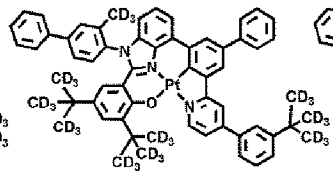
3589
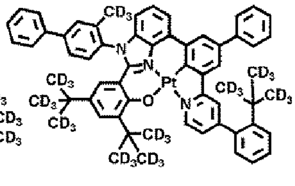
3590

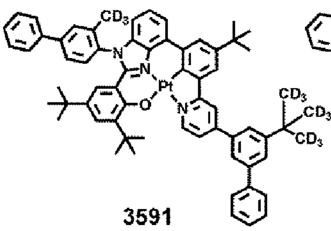
3591
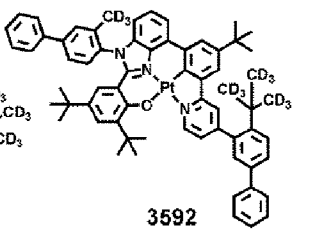
3592
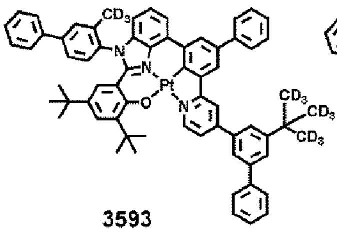
3593
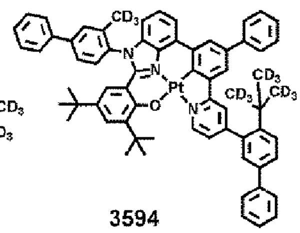
3594

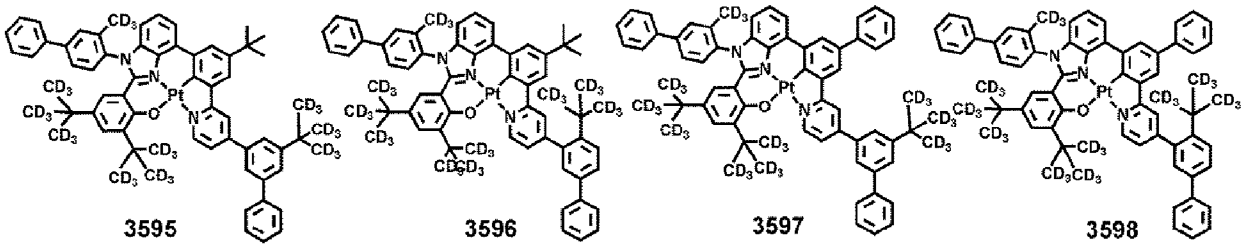

3595 3596 3597 3598

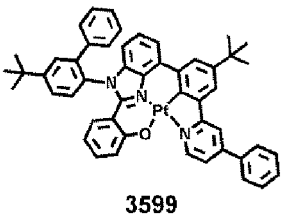

3599

## Group 1-3

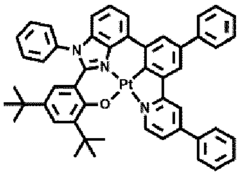

1

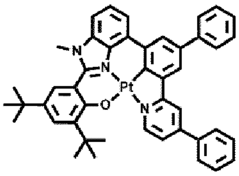

2

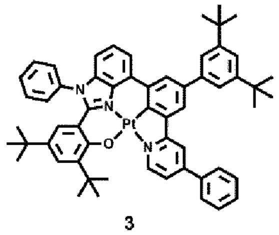

3

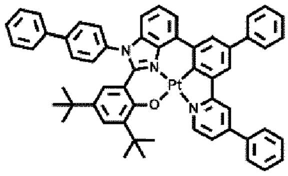

4

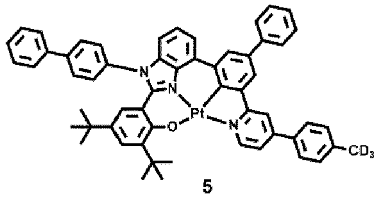

5

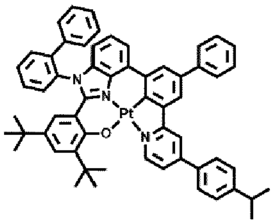

6

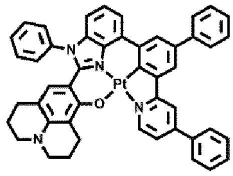

7

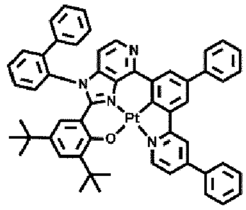

8

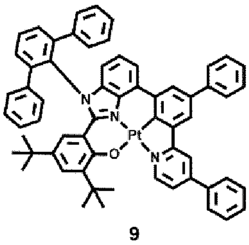

9

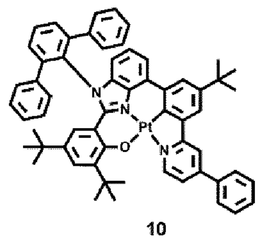

10

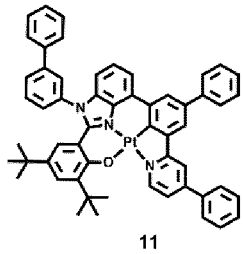

11

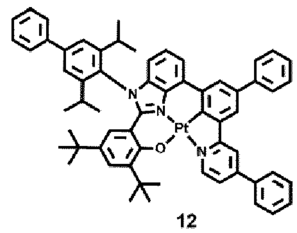

12

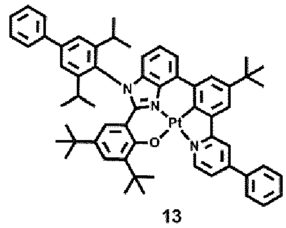

13

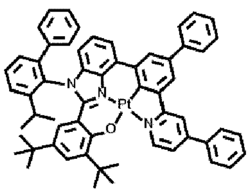

14

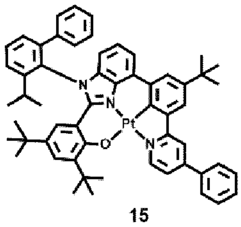

15

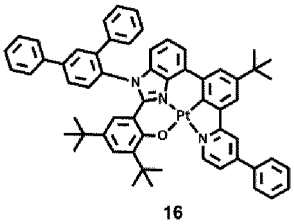

16

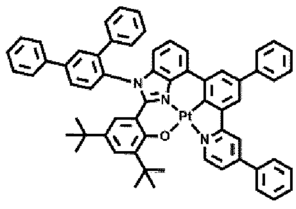

17

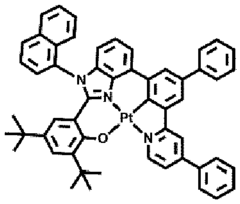

18

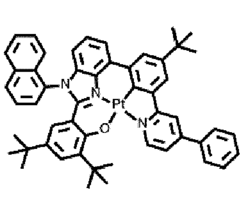

19

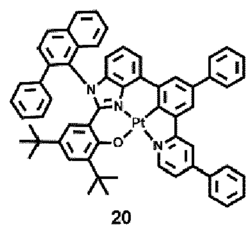

20

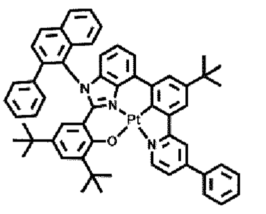

21

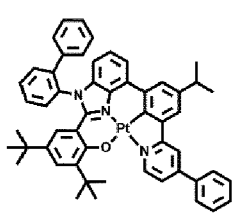

22

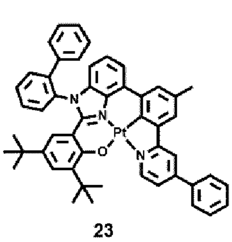

23

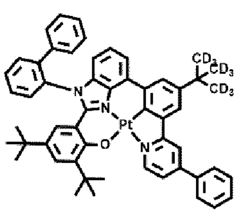

24

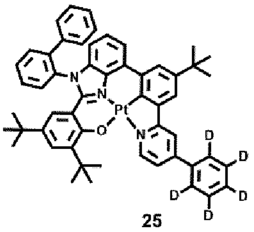
25

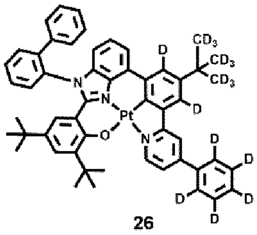
26

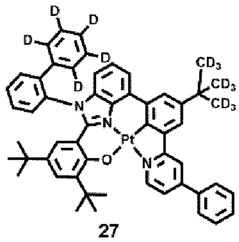
27

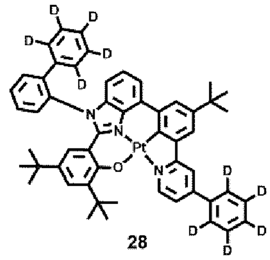
28

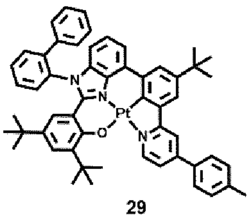
29

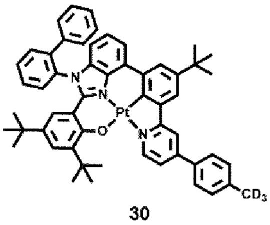
30

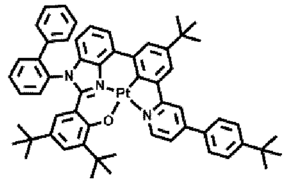
31

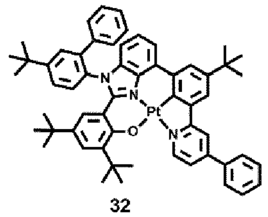
32

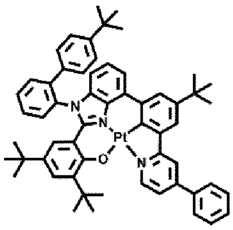
33

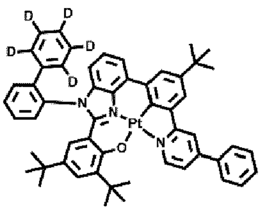
34

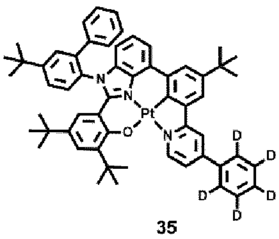
35

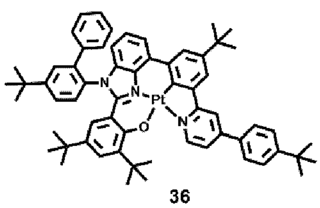
36

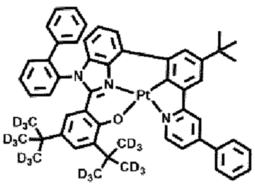
37

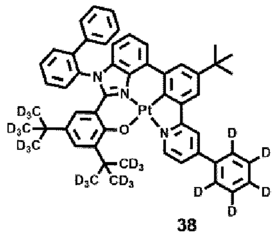
38

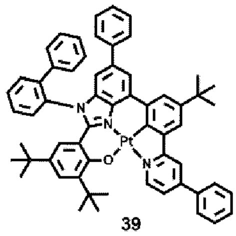
39

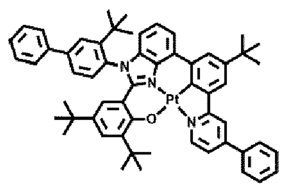
40

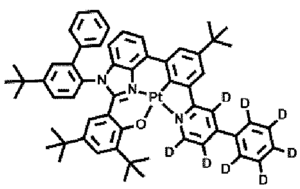
41

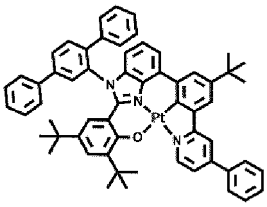
42

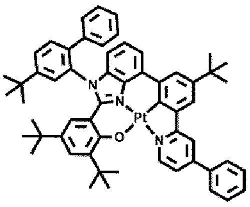
43

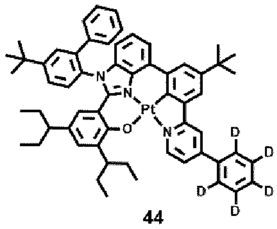
44

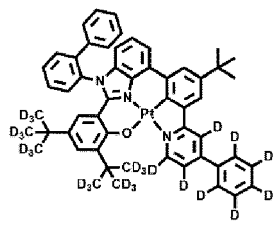
45

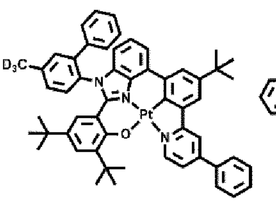
46

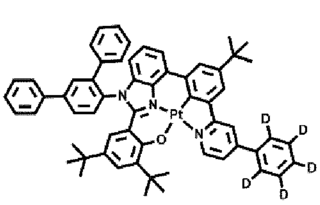
47

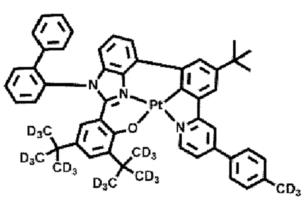
48

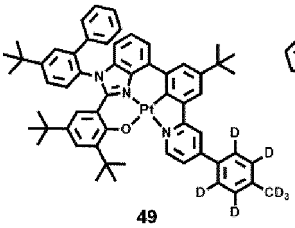
49
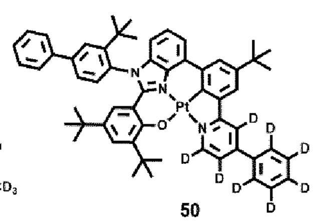
50
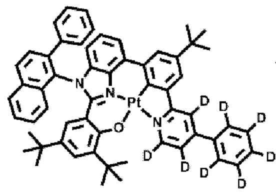
51
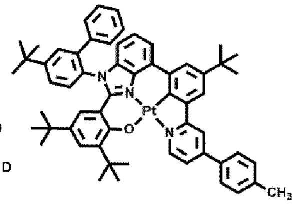
52

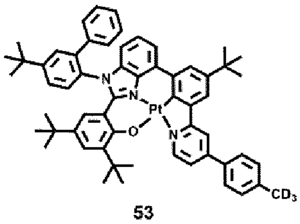
53
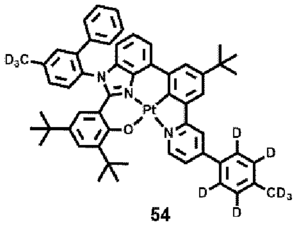
54
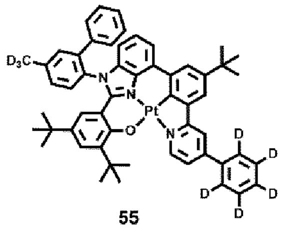
55
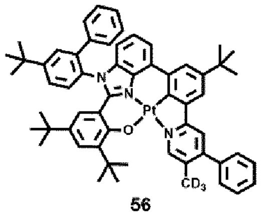
56

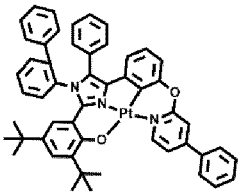
57
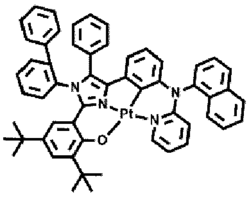
58
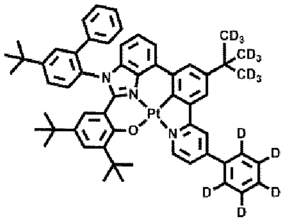
59
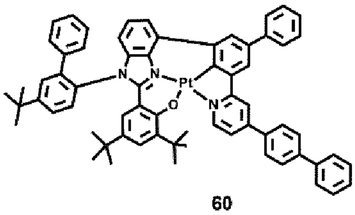
60

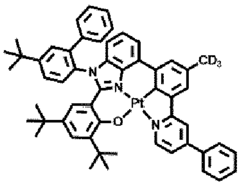
61
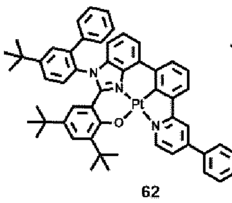
62
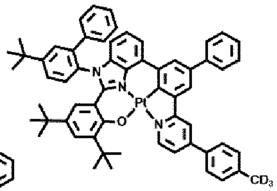
63
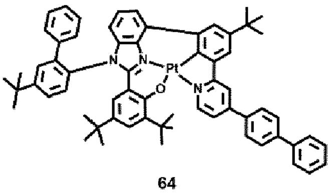
64

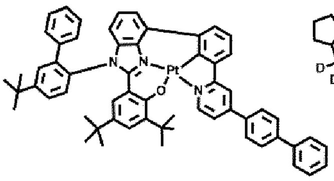
65
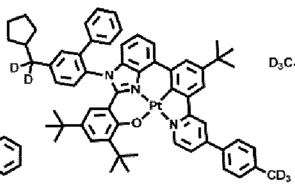
66
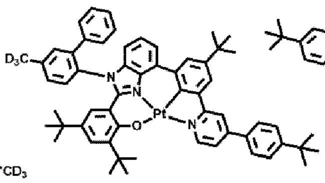
67
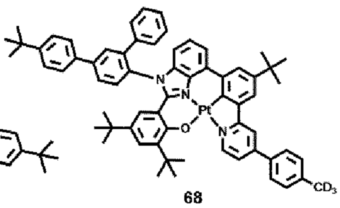
68

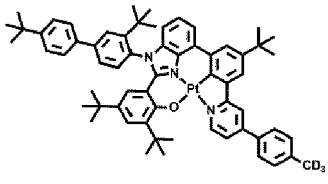
69
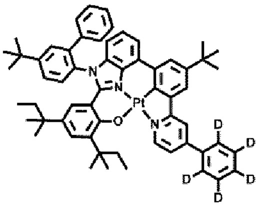
70
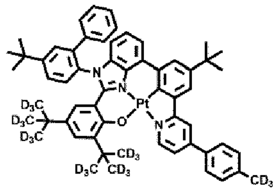
71
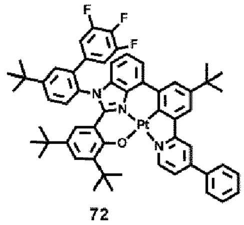
72

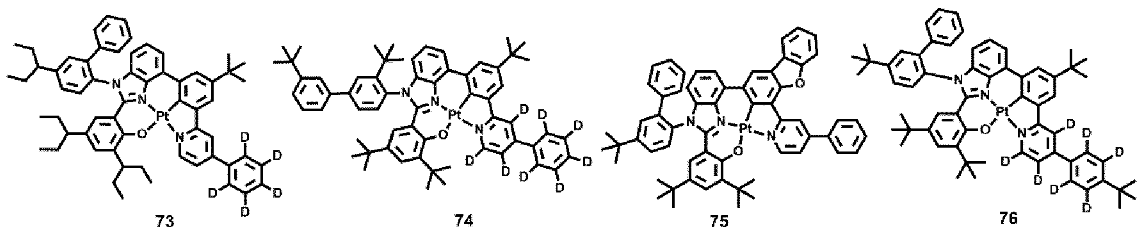

73 74 75 76

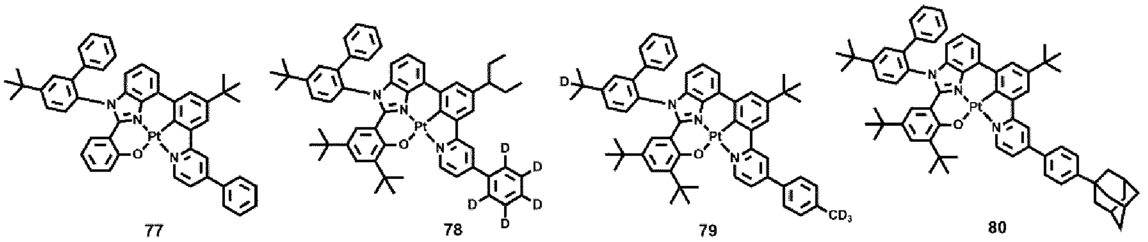

77 78 79 80

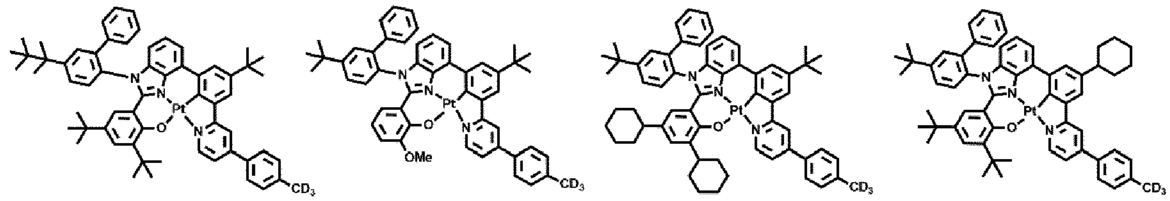

81 82 83 84

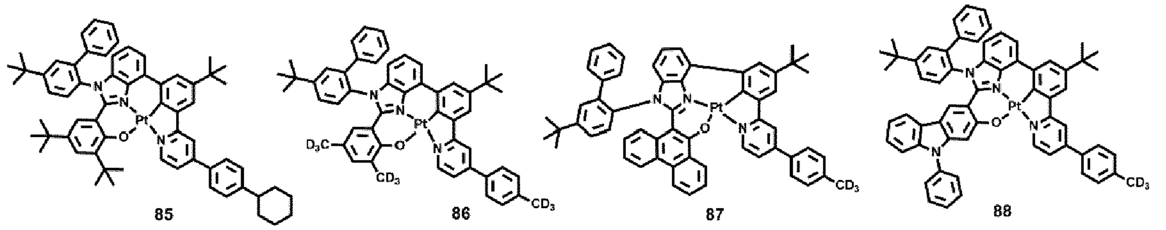

85 86 87 88

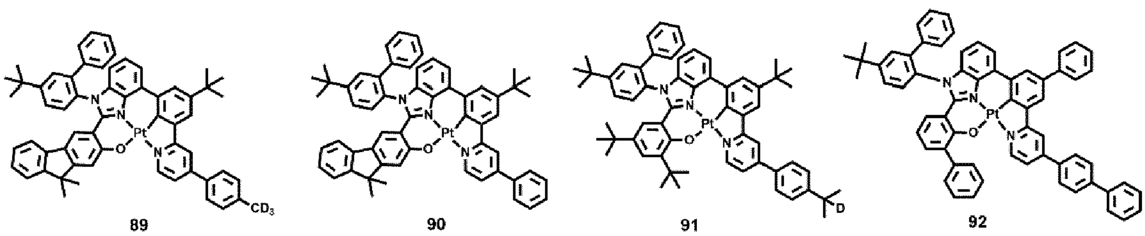

89 90 91 92

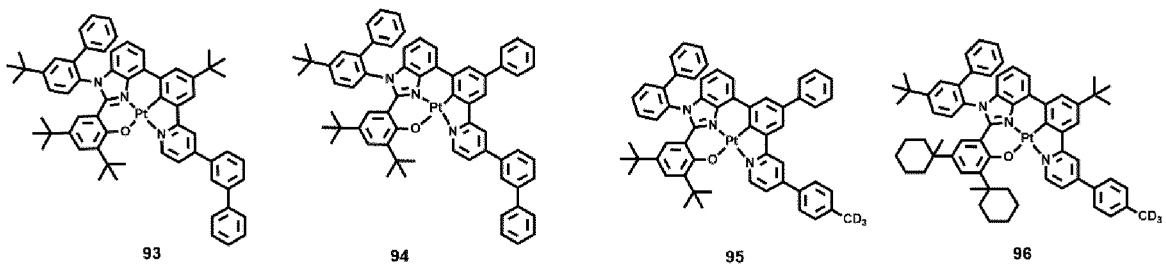

93 94 95 96

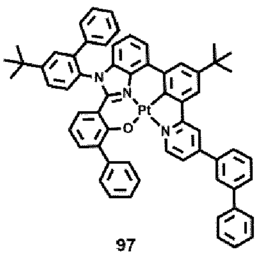
97
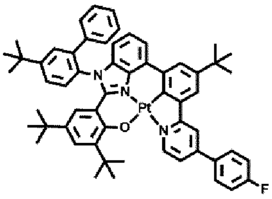
98
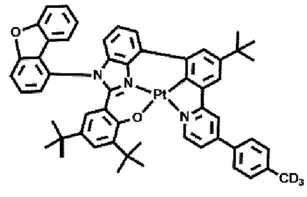
99
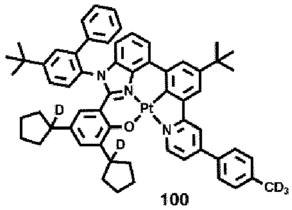
100

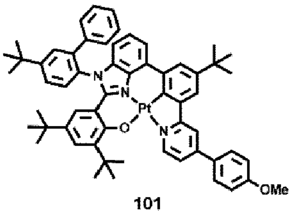
101
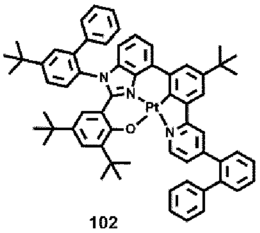
102
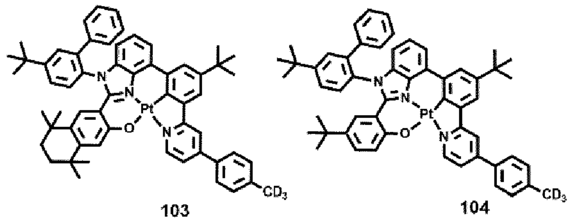
103
104

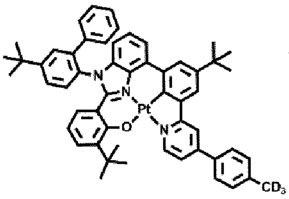
105
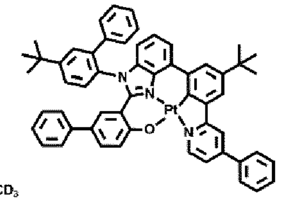
106
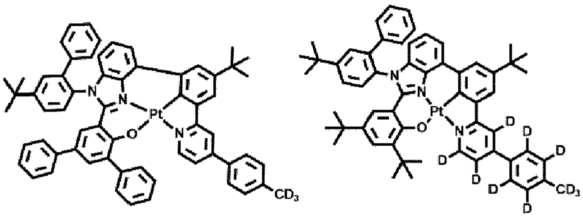
107
108

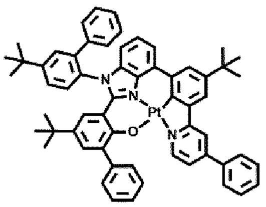
109
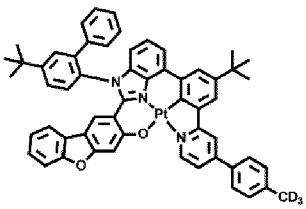
110
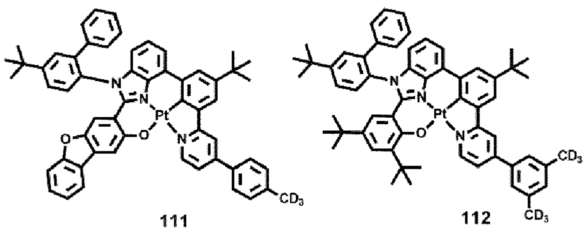
111
112

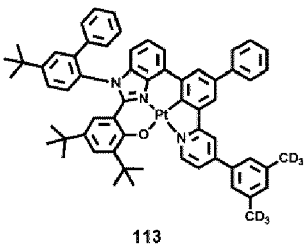
113
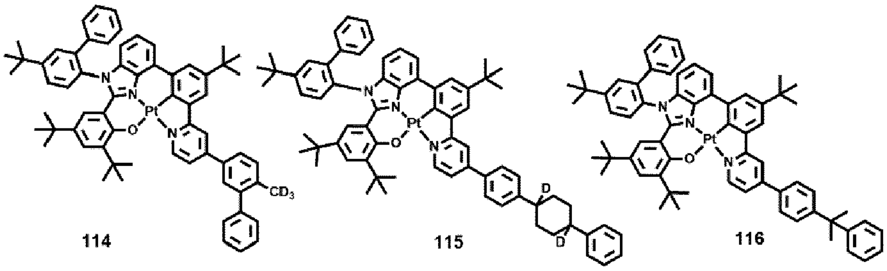
114
115
116

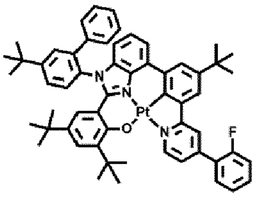
117
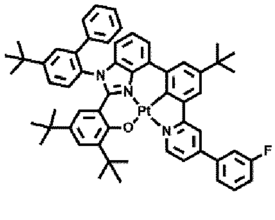
118
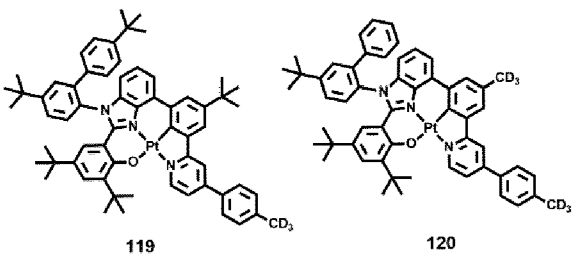
119
120

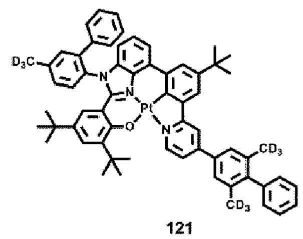
121

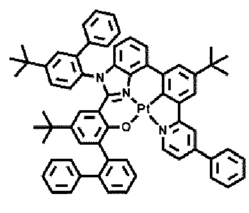
122

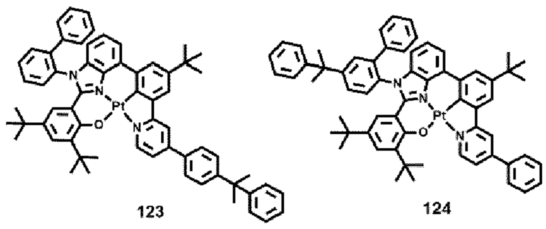
123

124

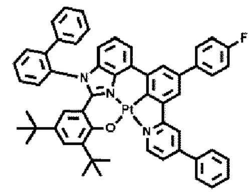
125

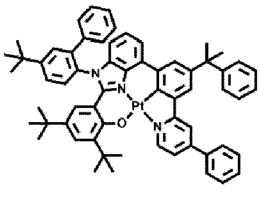
126

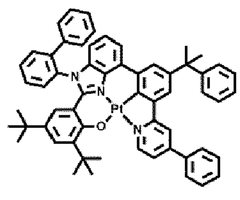
127

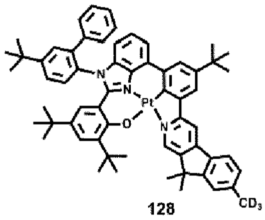
128

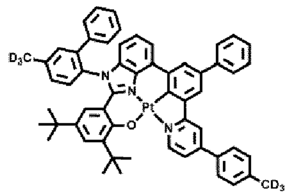
129

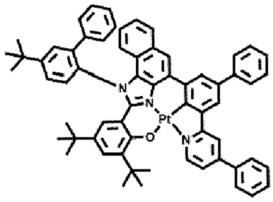
130

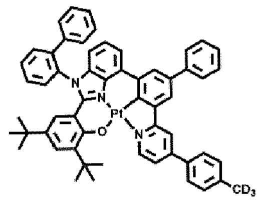
131

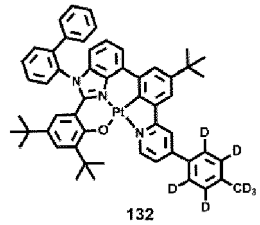
132

Group 1-4

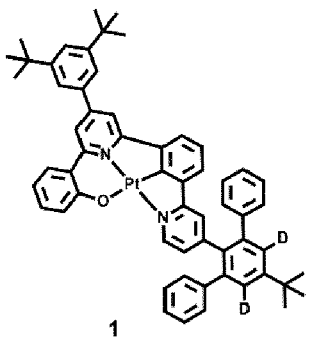
1

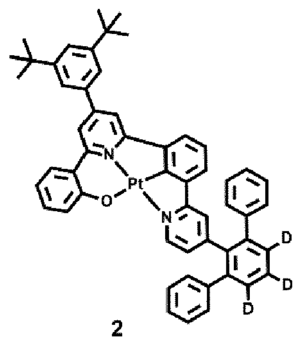
2

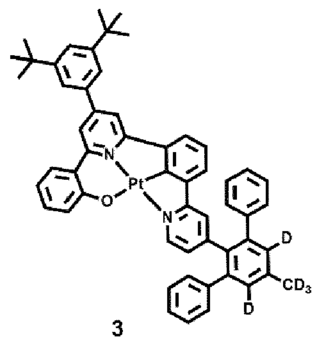
3

In one or more embodiments, the iridium-containing organometallic compound may be selected from compounds of [Group 2-1] to [Group 2-6]:

## Group 2-1

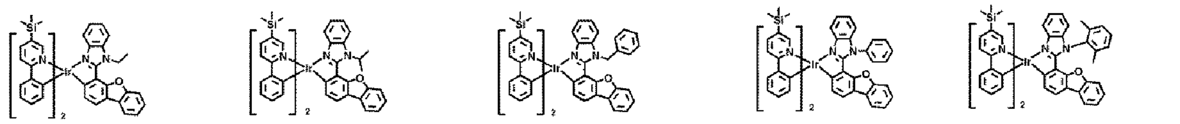

1 2 3 4 5

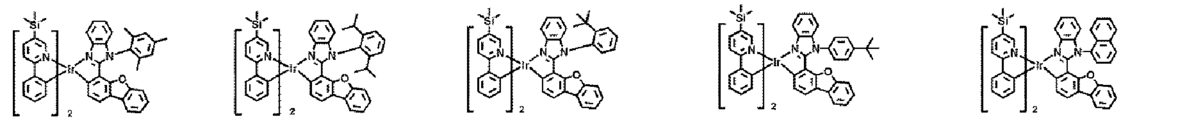

6 7 8 9 10

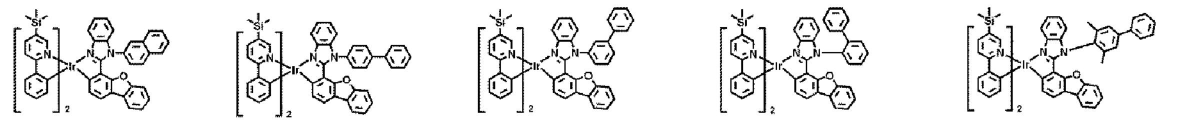

11 12 13 14 15

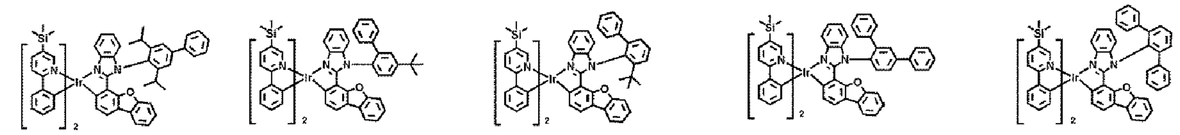

16 17 18 19 20

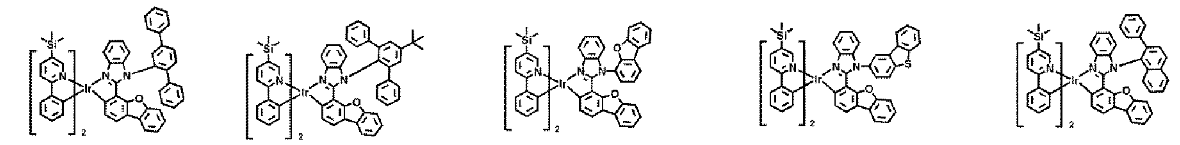

21 22 23 24 25

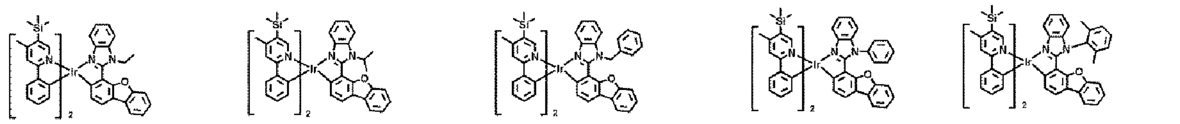

26 27 28 29 30

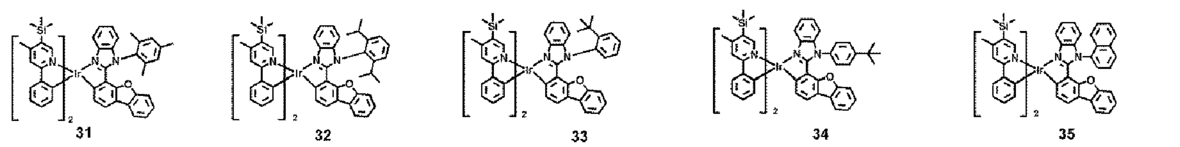

31 32 33 34 35

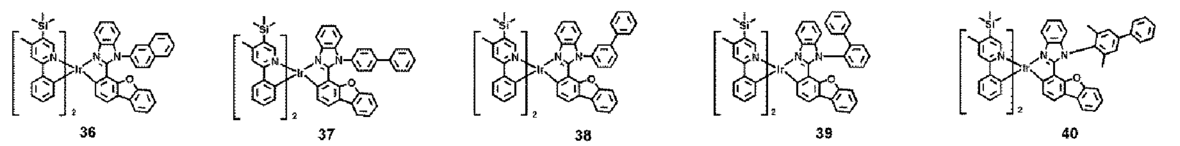

36 37 38 39 40

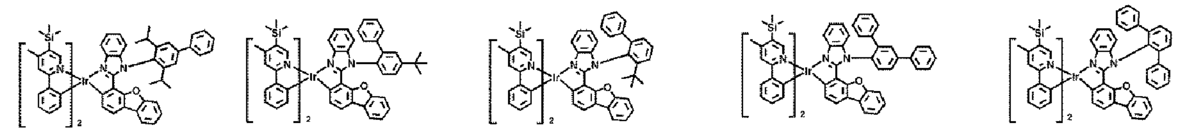

41 42 43 44 45

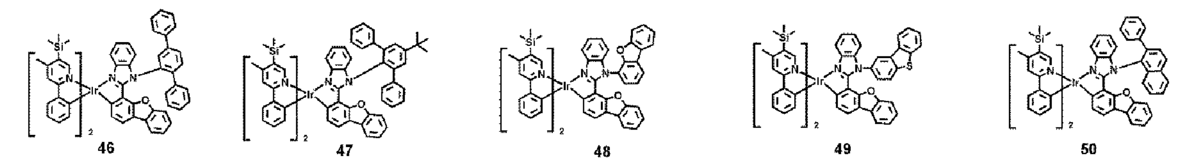

46 47 48 49 50

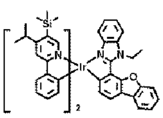
51
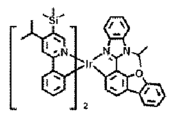
52
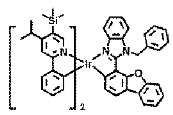
53
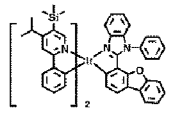
54
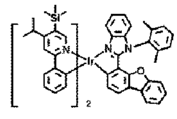
55

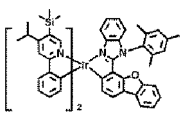
56
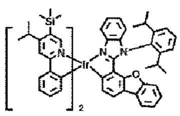
57
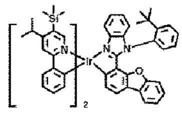
58
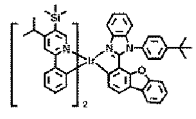
59
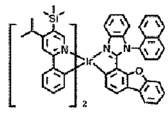
60

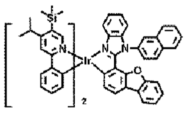
61
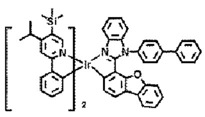
62
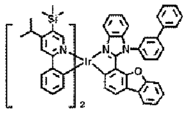
63
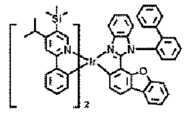
64
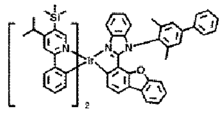
65

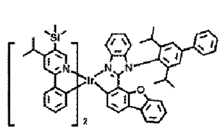
66
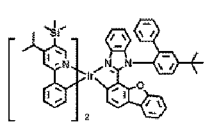
67
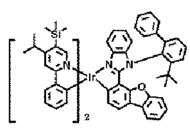
68
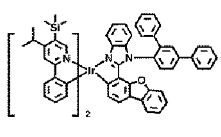
69
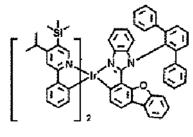
70

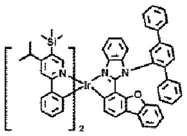
71
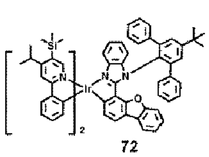
72
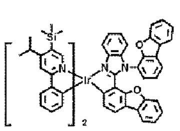
73
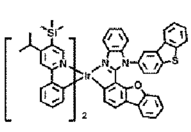
74
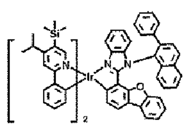
75

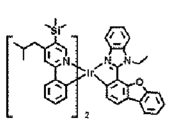
76
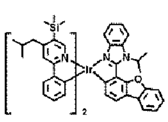
77
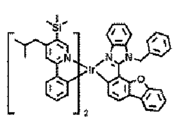
78
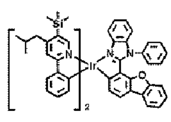
79
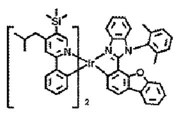
80

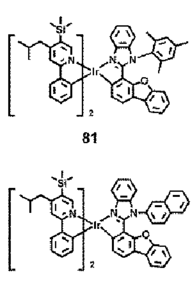
81
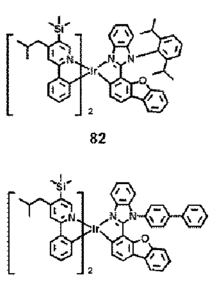
82
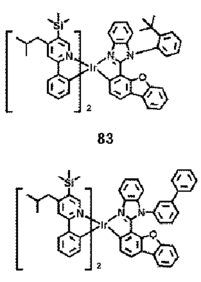
83
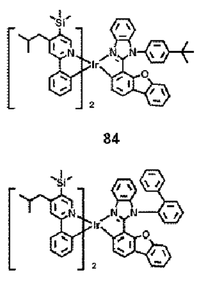
84
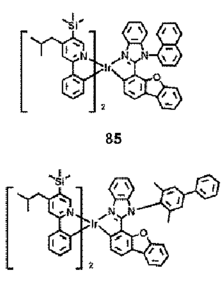
85

86

87

88

89

90

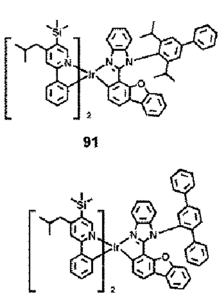
91
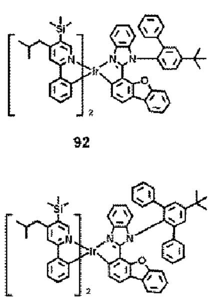
92
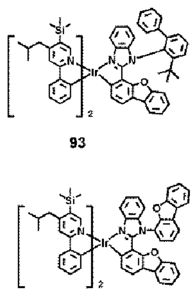
93
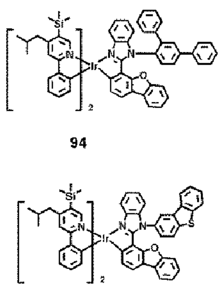
94
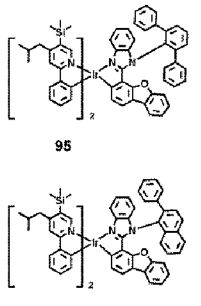
95

96

97

98

99

100

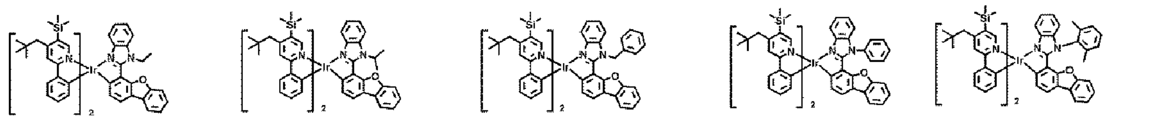

101 102 103 104 105

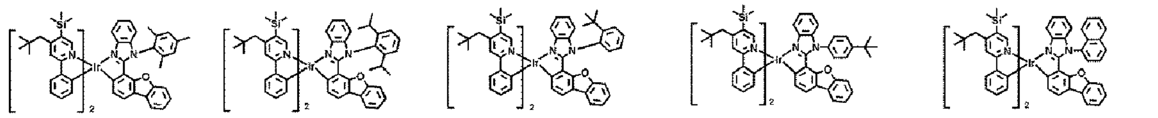

106 107 108 109 110

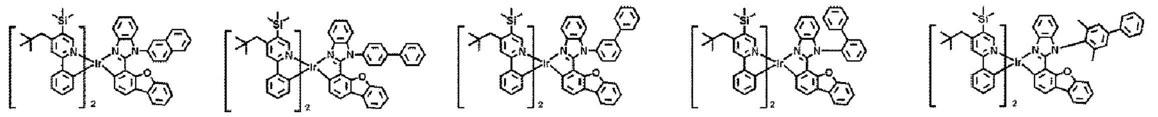

111 112 113 114 115

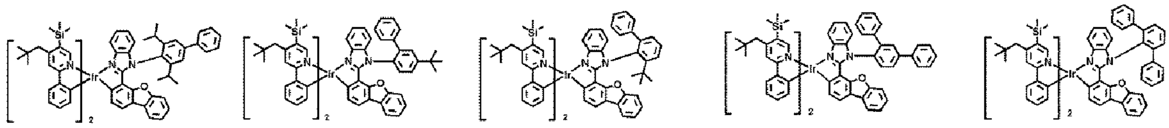

116 117 118 119 120

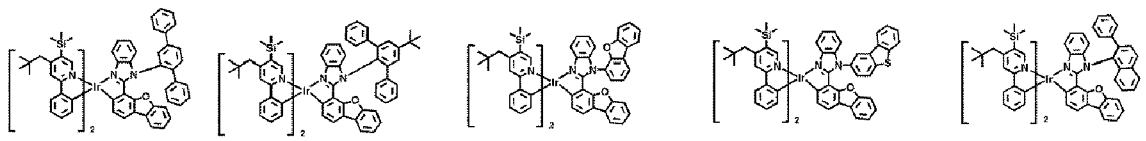

121 122 123 124 125

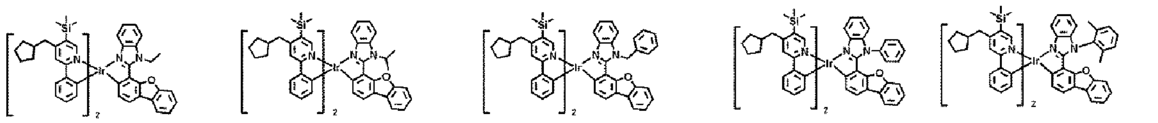

126 127 128 129 130

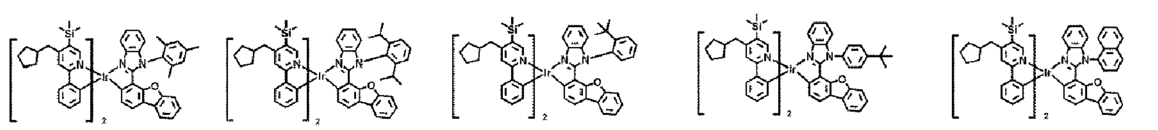

131 132 133 134 135

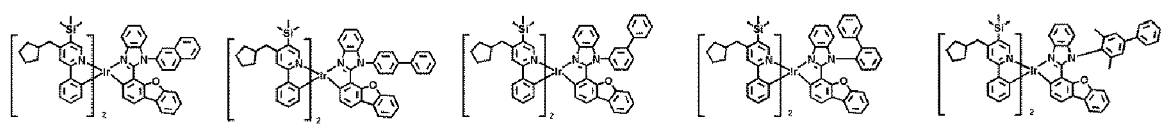

136 137 138 139 140

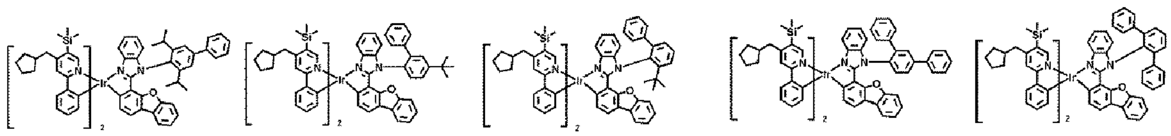

141 142 143 144 145

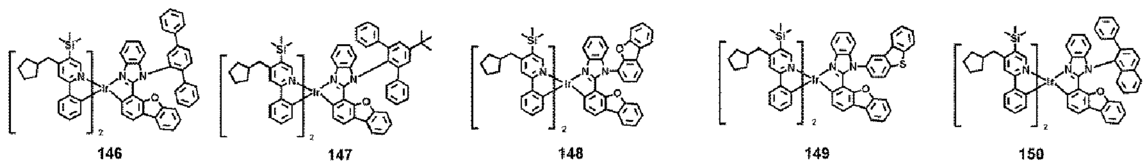

146 147 148 149 150

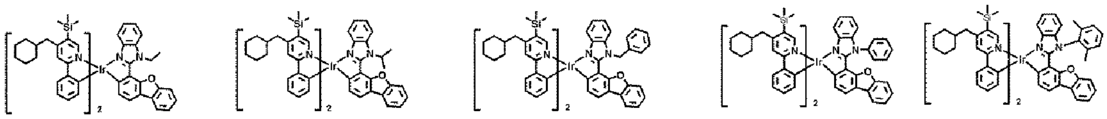
151 152 153 154 155

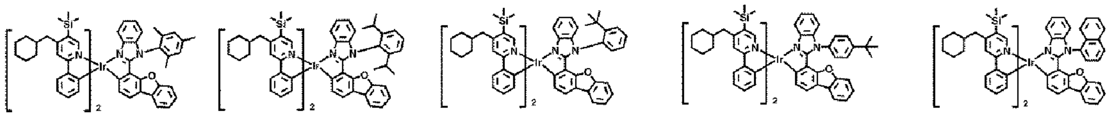
156 157 158 159 160

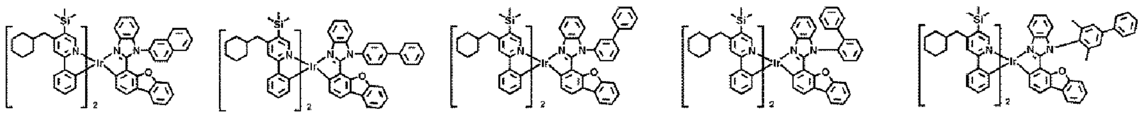
161 162 163 164 165

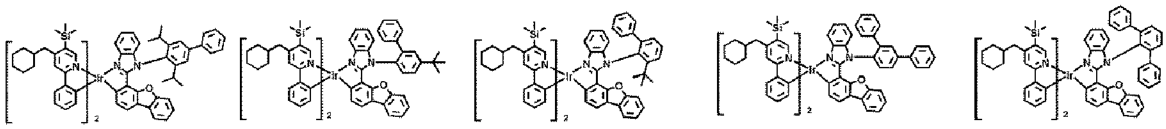
166 167 168 169 170

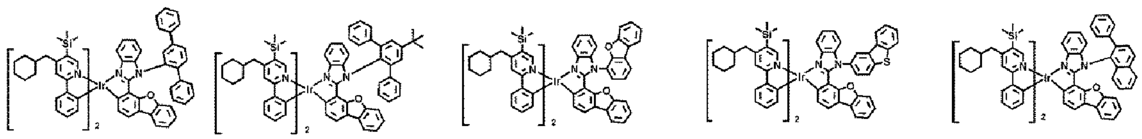
171 172 173 174 175

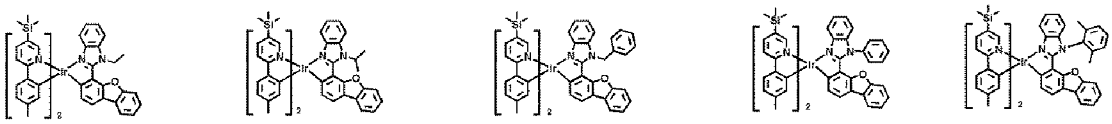
176 177 178 179 180

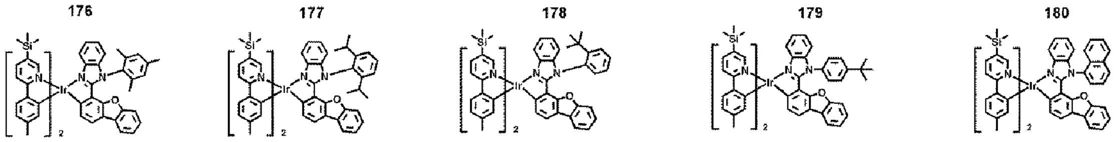
181 182 183 184 185

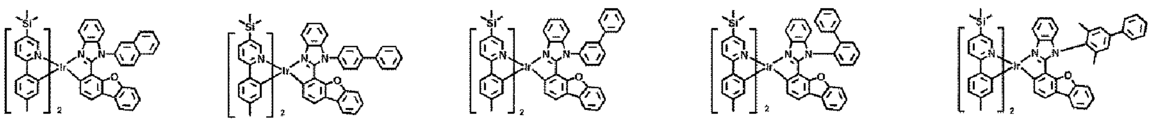
186 187 188 189 190

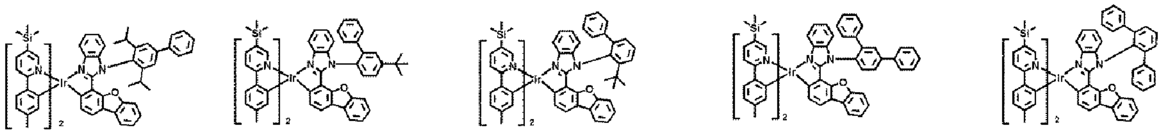
191 192 193 194 195

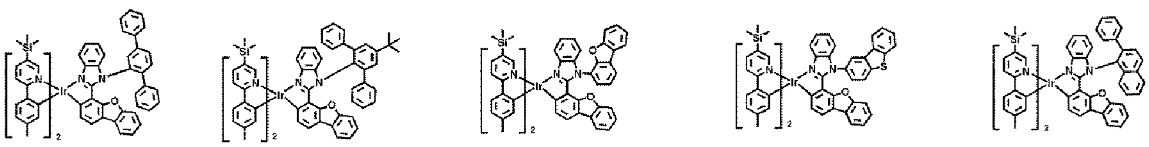
196 197 198 199 200

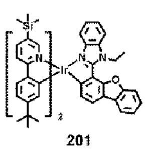
201
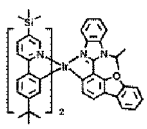
202
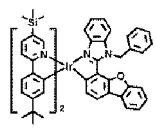
203
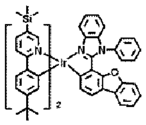
204
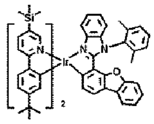
205
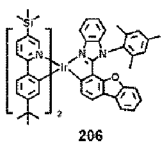
206
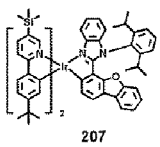
207
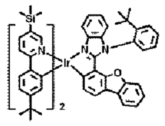
208
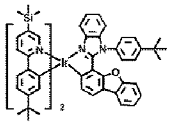
209
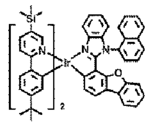
210
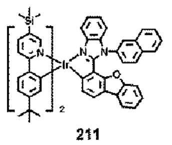
211
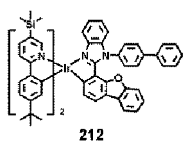
212
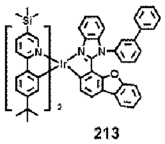
213
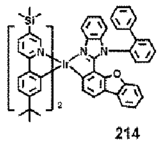
214
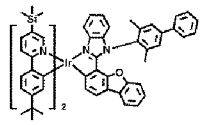
215
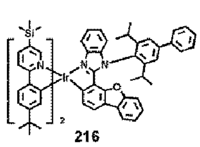
216
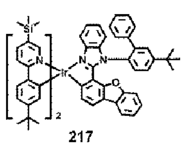
217
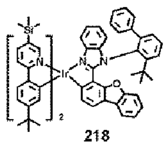
218
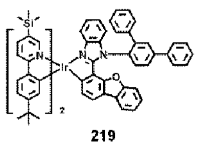
219
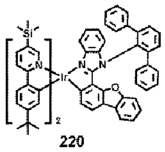
220
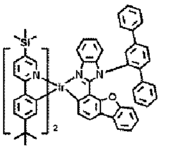
221
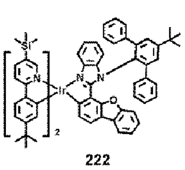
222
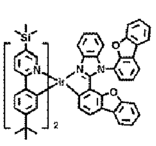
223
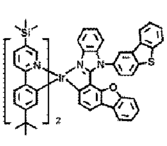
224
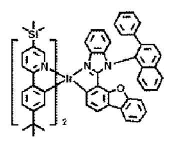
225
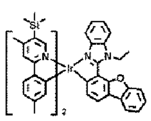
226
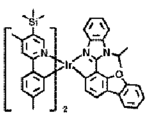
227
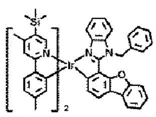
228
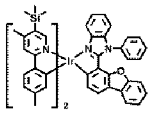
229
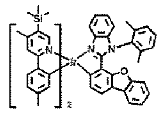
230
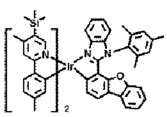
231
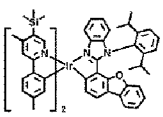
232
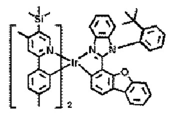
233
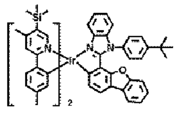
234
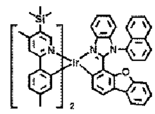
235
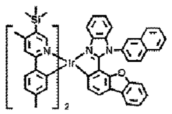
236
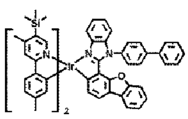
237
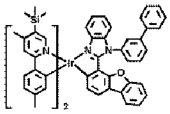
238
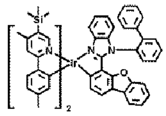
239
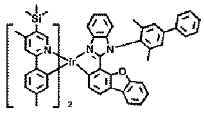
240
241
242
243
244
245
246
247
248
249
250

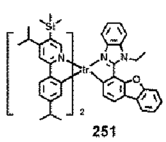
251
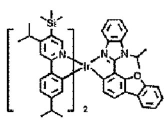
252
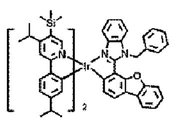
253
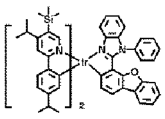
254
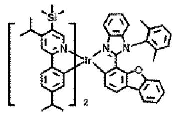
255
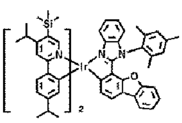
256
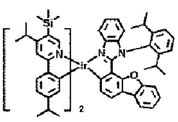
257
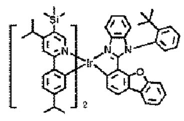
258
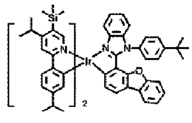
259
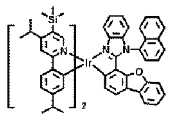
260
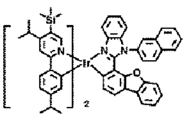
261
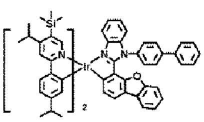
262
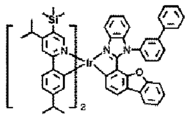
263
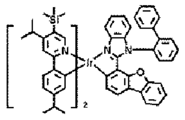
264
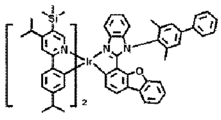
265
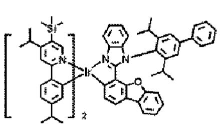
266
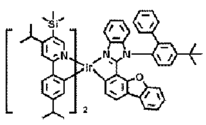
267
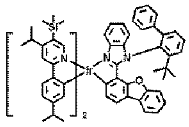
268
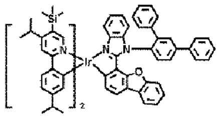
269
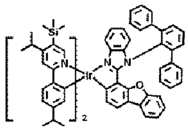
270
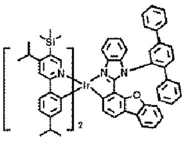
271
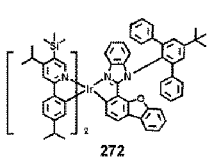
272
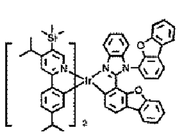
273
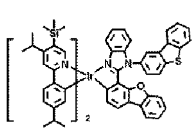
274
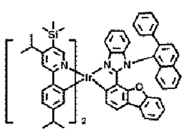
275
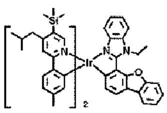
276
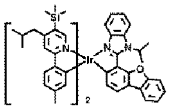
277
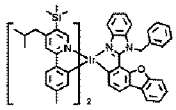
278
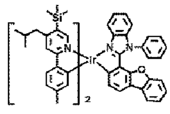
279
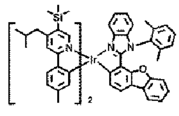
280
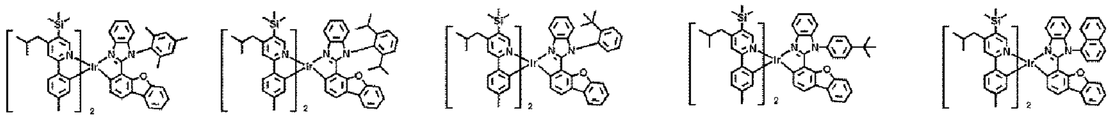
281 282 283 284 285
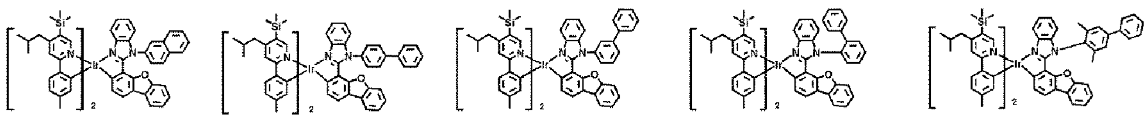
286 287 288 289 290
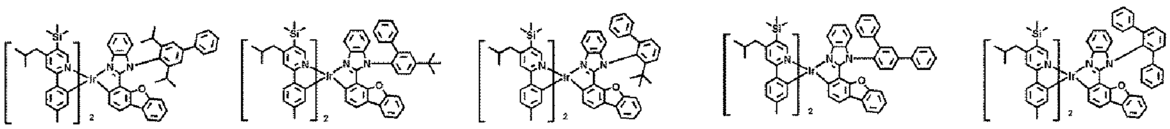
291 292 293 294 295
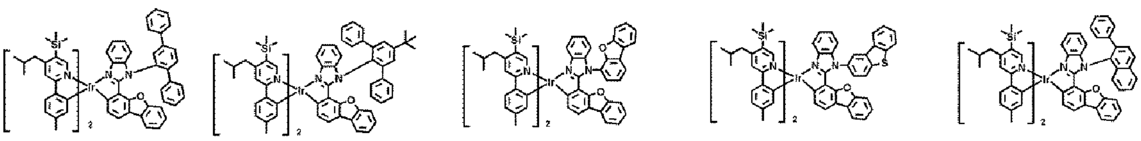
296 297 298 299 300

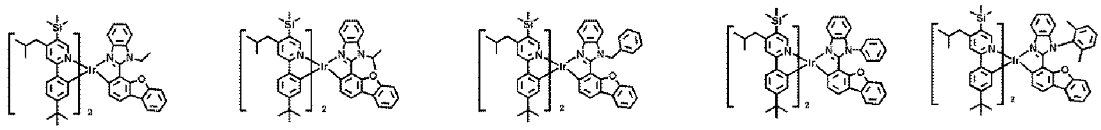
301 302 303 304 305

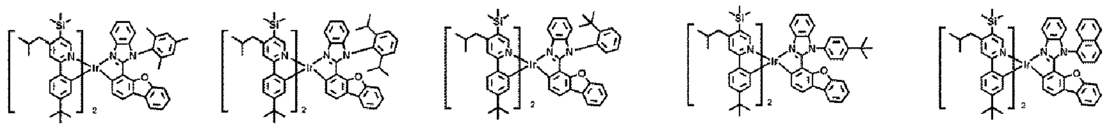
306 307 308 309 310

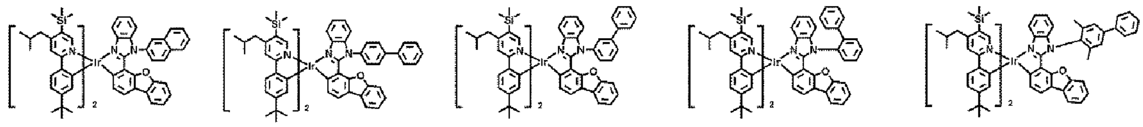
311 312 313 314 315

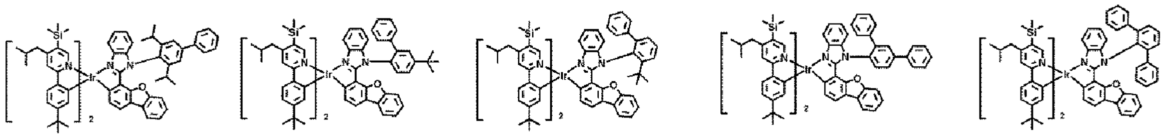
316 317 318 319 320

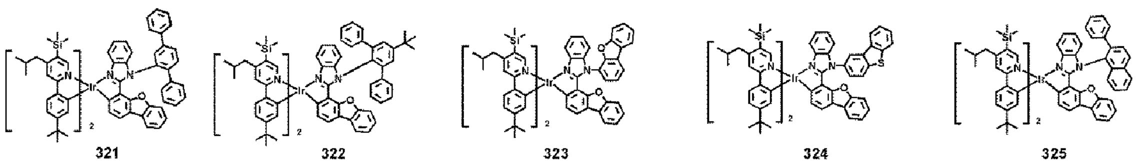
321 322 323 324 325

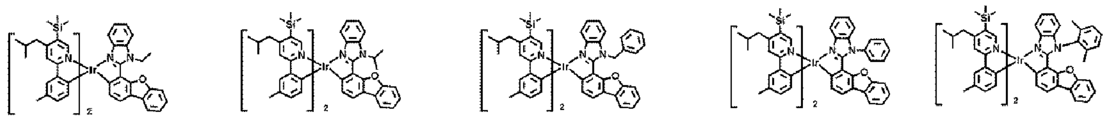
326 327 328 329 330

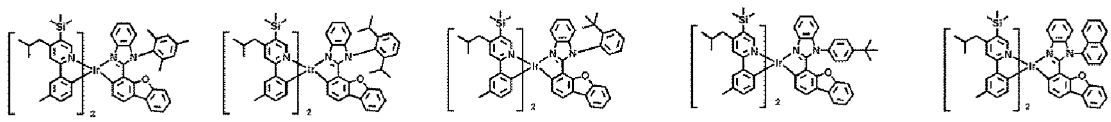
331 332 333 334 335

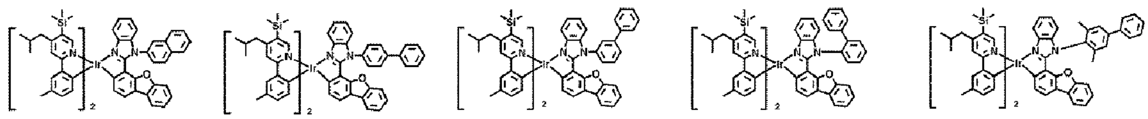
336 337 338 339 340

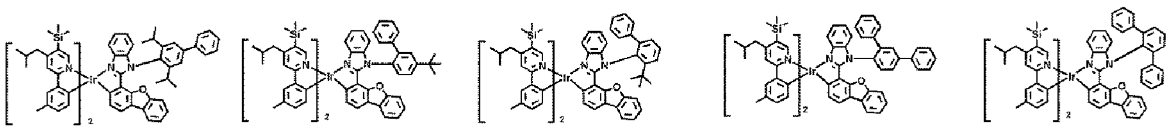
341 342 343 343 345

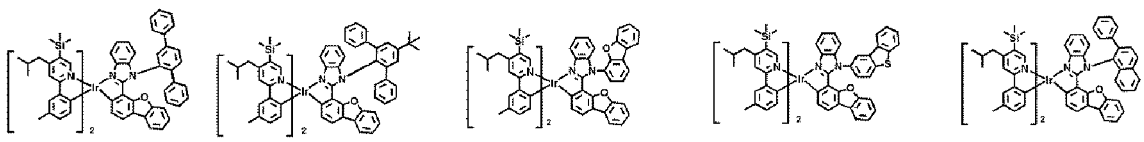
346 347 348 349 350

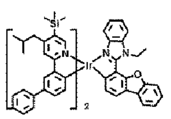
351

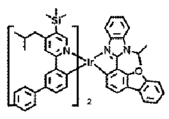
352

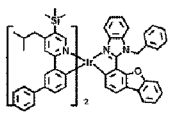
353

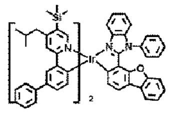
354

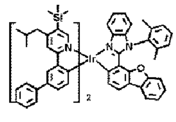
355

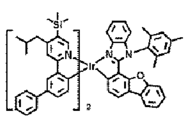
356

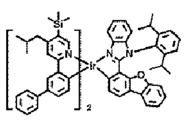
357

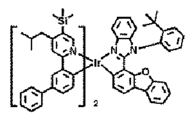
358

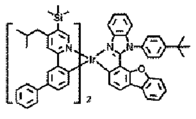
359

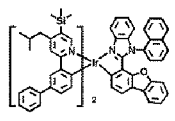
360

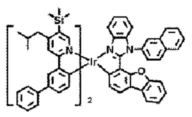
361

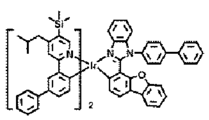
362

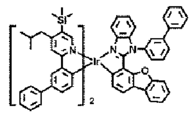
363

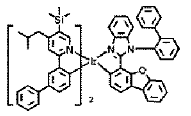
364

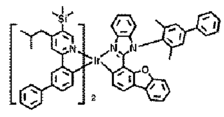
365

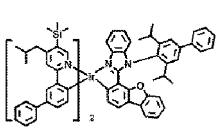
366

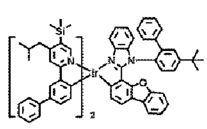
367

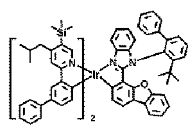
368

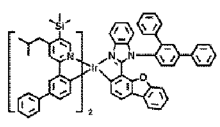
369

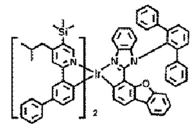
370

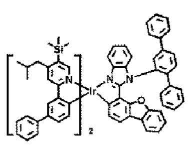
371

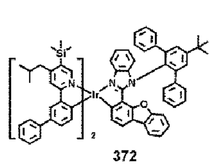
372

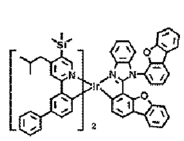
373

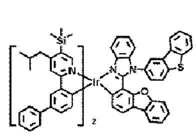
374

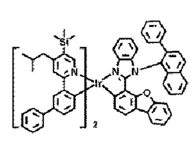
375

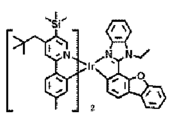
376

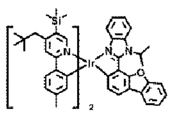
377

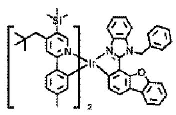
378

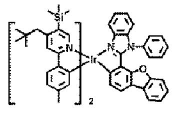
379

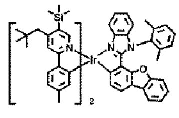
380

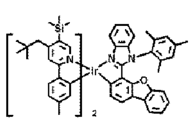
381

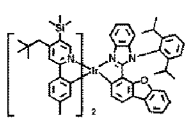
382

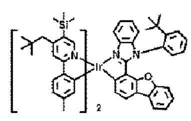
383

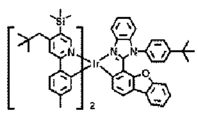
384

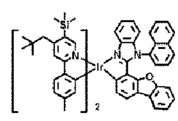
385

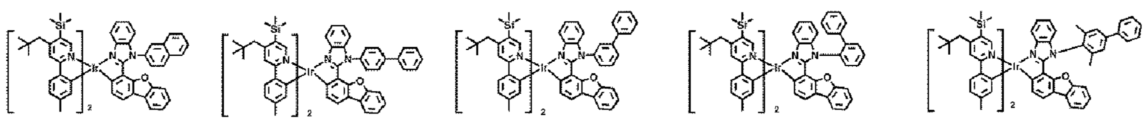
386 387 388 389 390

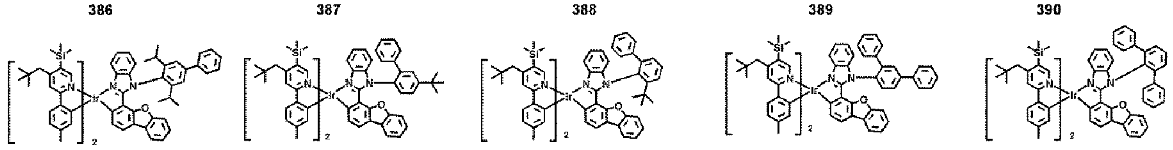
391 392 393 394 395

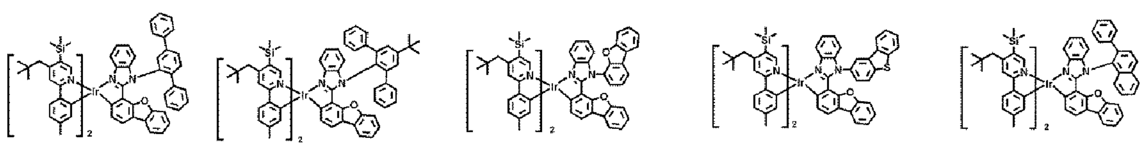
396 397 398 399 400

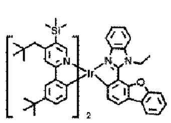
401
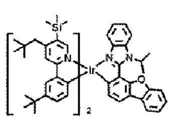
402
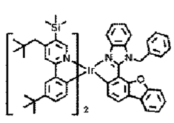
403
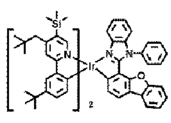
404
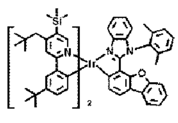
405
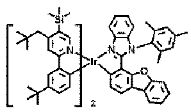
406
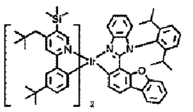
407
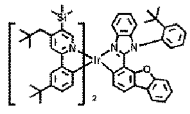
408
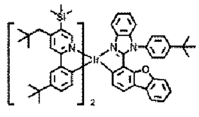
409
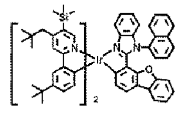
410
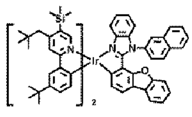
411
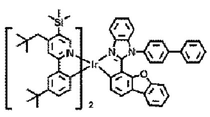
412
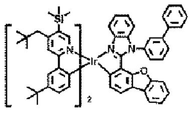
413
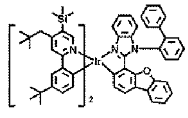
414
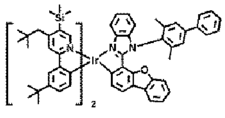
415
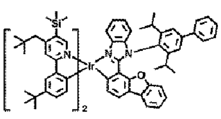
416
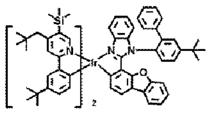
417
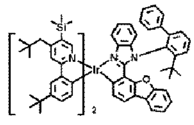
418
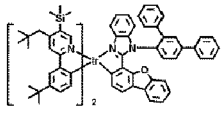
419
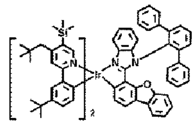
420
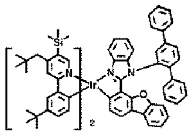
421
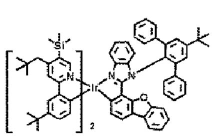
422
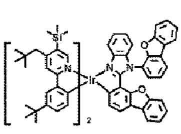
423
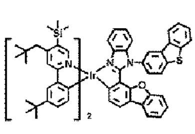
424
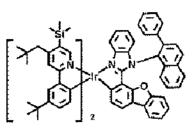
425
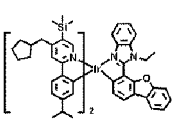
426
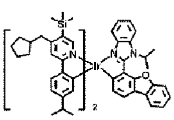
427
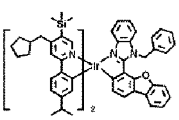
428
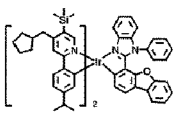
429
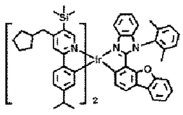
430
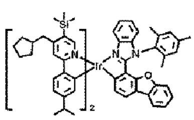
431
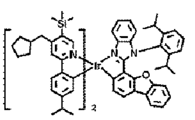
432
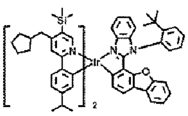
433
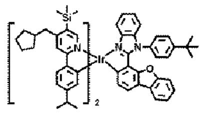
434
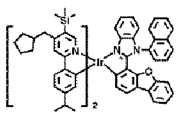
435
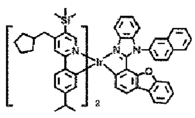
436
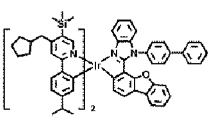
437
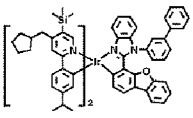
438
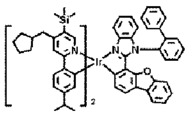
439
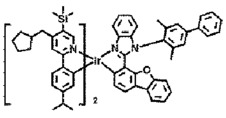
440
441
442
443
444
445
446
447
448
449
450

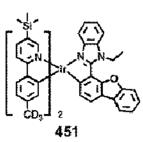
451
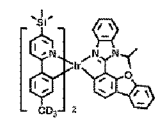
452
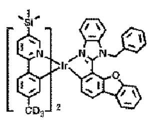
453
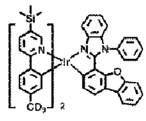
454
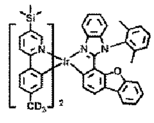
455
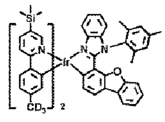
456
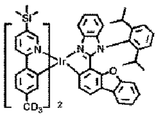
457
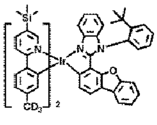
458
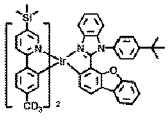
459
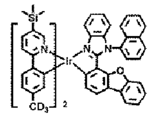
460
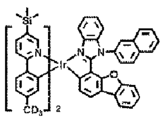
461
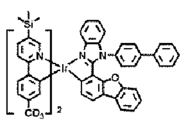
462
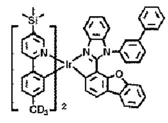
463
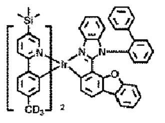
464
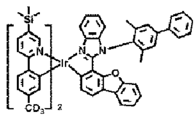
465
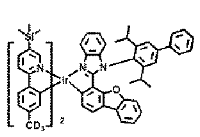
466
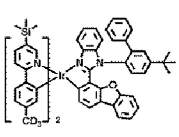
467
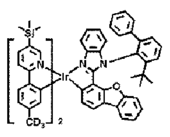
468
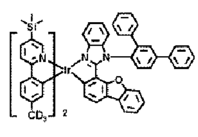
469
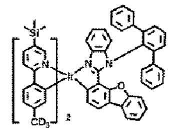
470
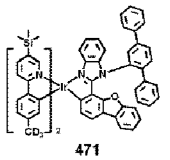
471
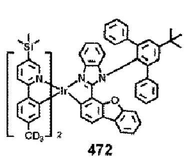
472
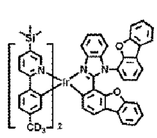
473
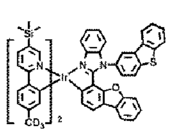
474
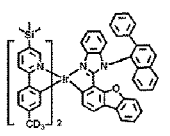
475
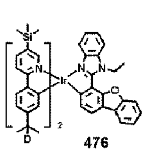
476
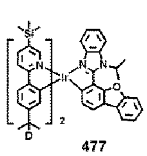
477
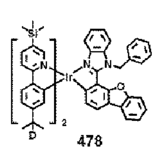
478
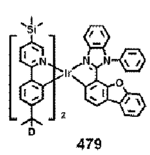
479
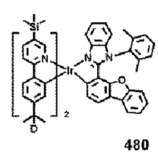
480
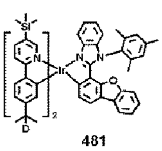
481
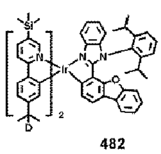
482
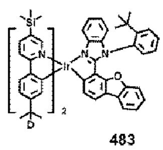
483
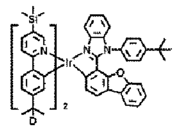
484
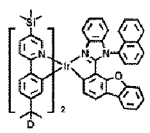
485
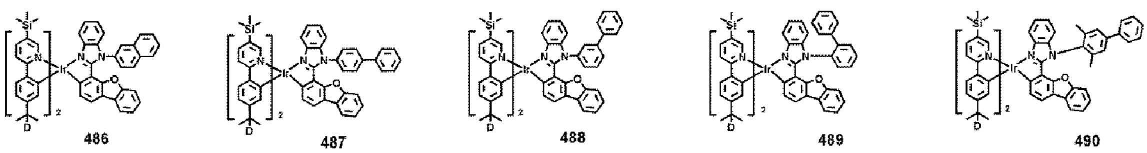
486 487 488 489 490
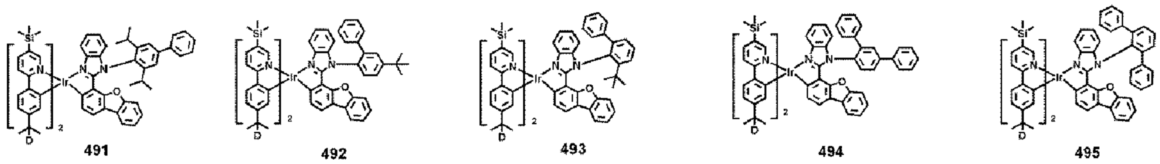
491 492 493 494 495
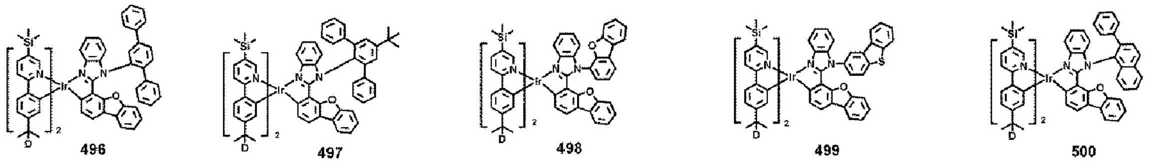
496 497 498 499 500

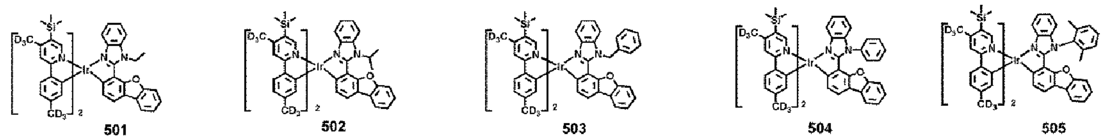
501 502 503 504 505

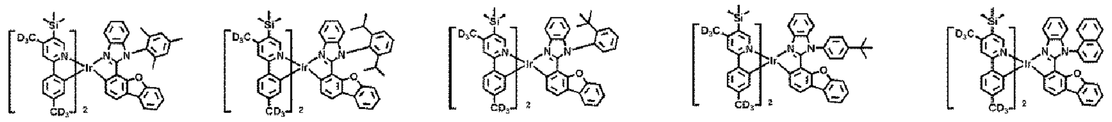
506 507 508 509 510

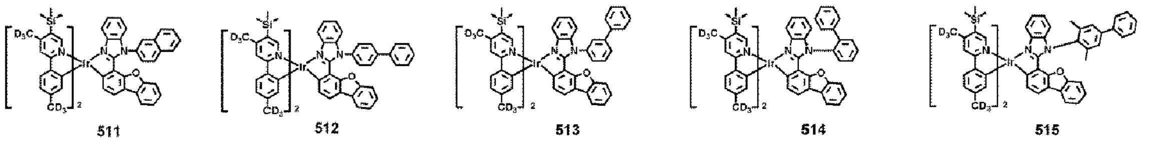
511 512 513 514 515

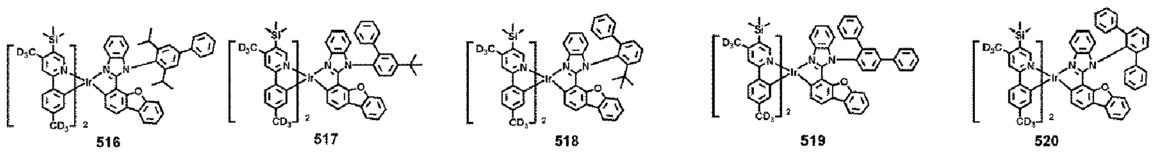
516 517 518 519 520

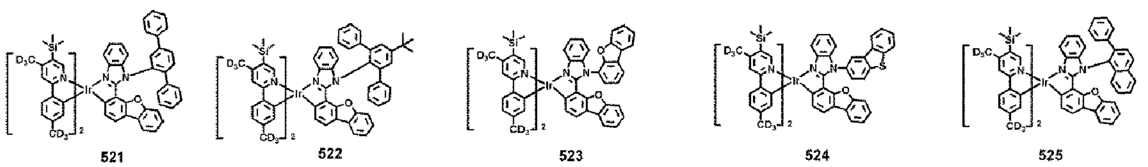
521 522 523 524 525

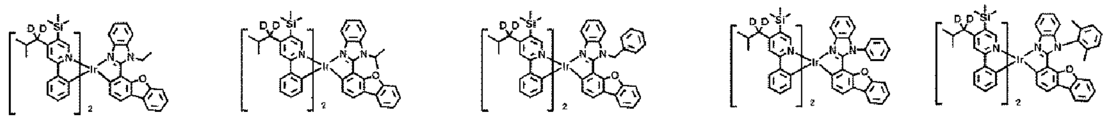
526 527 528 529 530

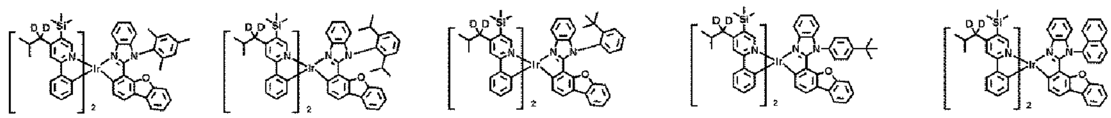
531 532 533 534 535

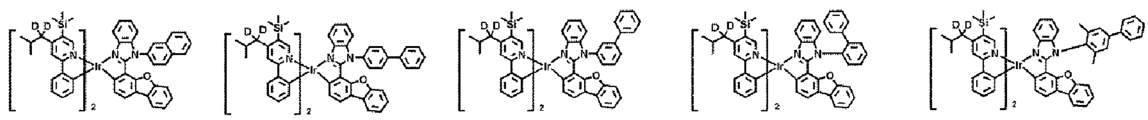
536 537 538 539 540

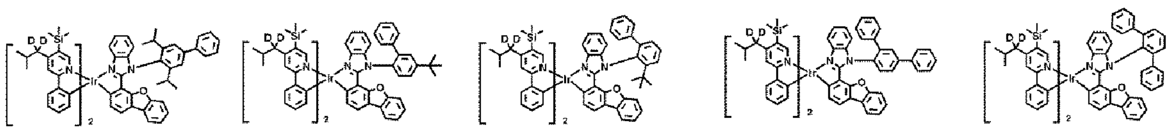
541 542 543 544 545

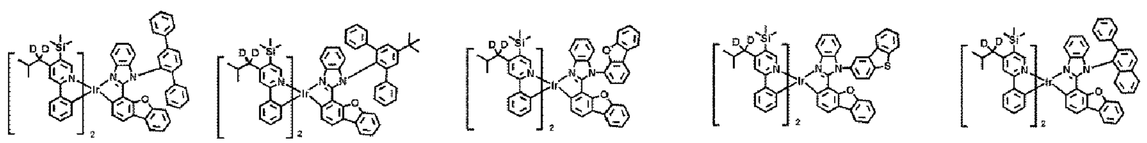
546 547 548 549 550

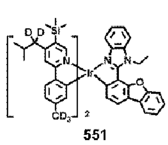
551
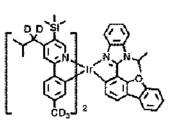
552
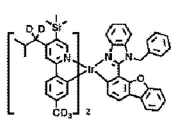
553
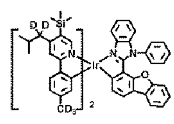
554
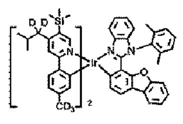
555
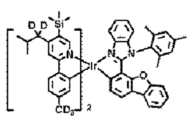
556
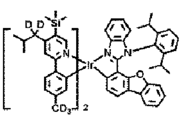
557
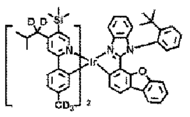
558
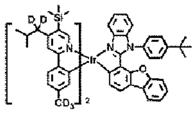
559
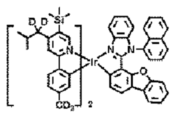
560
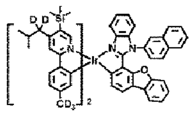
561
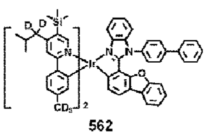
562
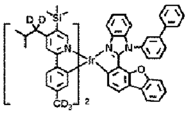
563
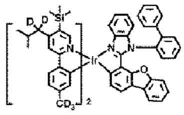
564
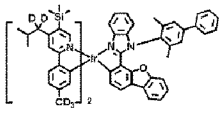
565
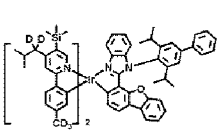
566
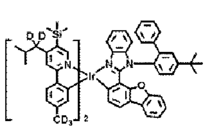
567
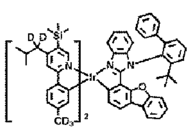
568
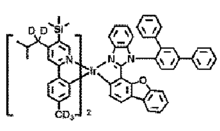
569
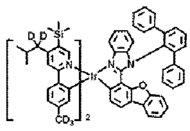
570
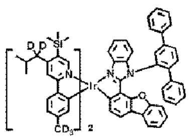
571
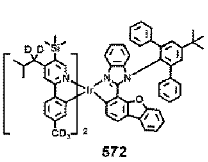
572
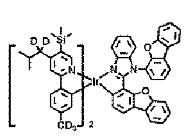
573
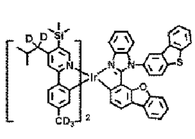
574
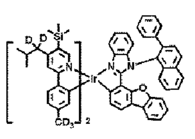
575
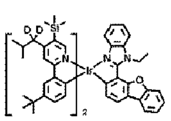
576
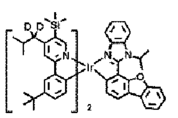
577
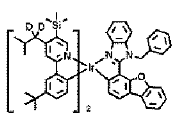
578
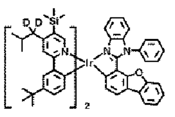
579
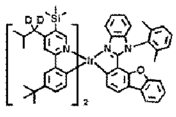
580
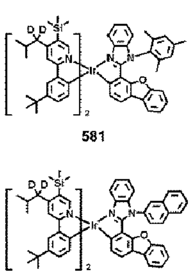
581
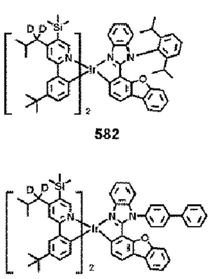
582
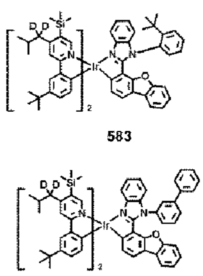
583
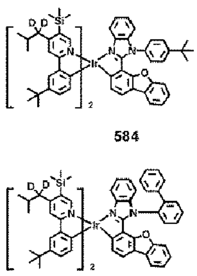
584
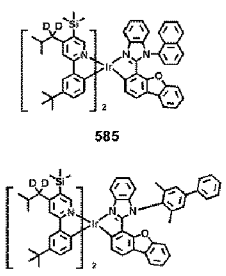
585
586
587
588
589
590
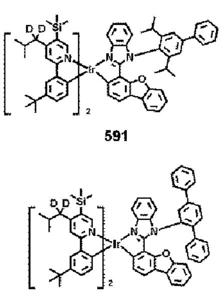
591
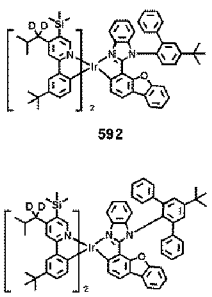
592
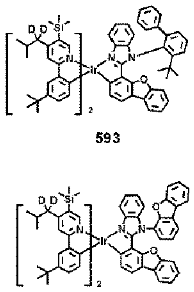
593
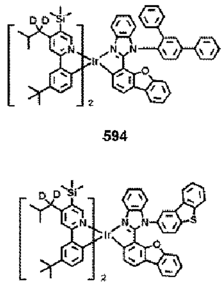
594
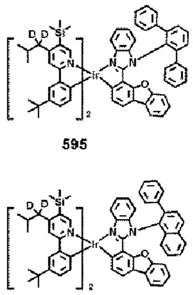
595
596
597
598
599
600

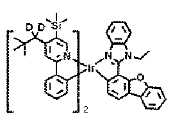
601
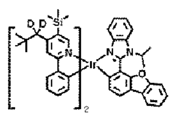
602
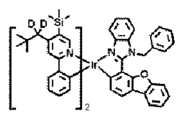
603
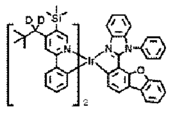
604
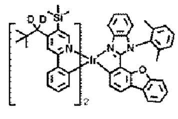
605
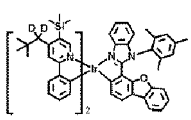
606
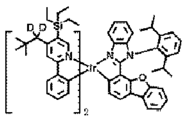
607
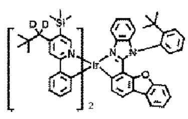
608
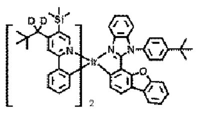
609
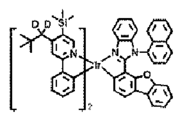
610
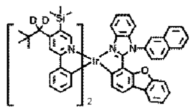
611
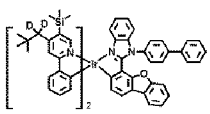
612
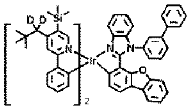
613
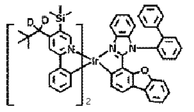
614
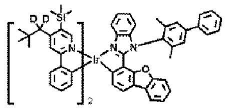
615
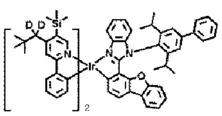
616
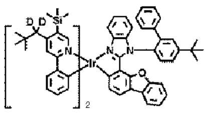
617
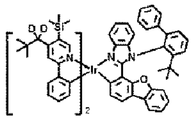
618
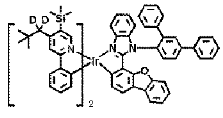
619
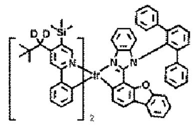
620
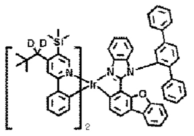
621
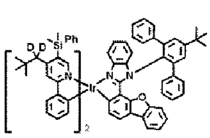
622
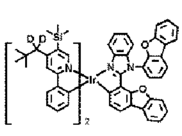
623
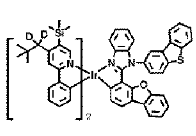
624
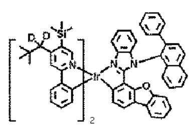
625
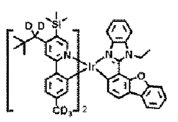
626
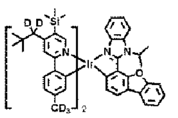
627
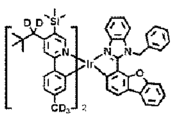
628
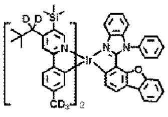
629
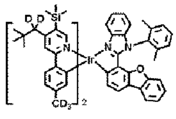
630
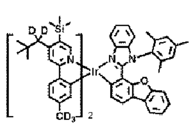
631
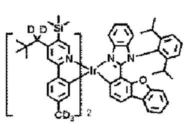
632
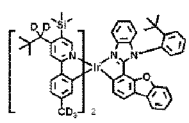
633
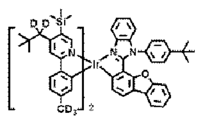
634
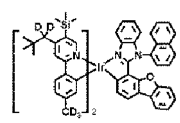
635
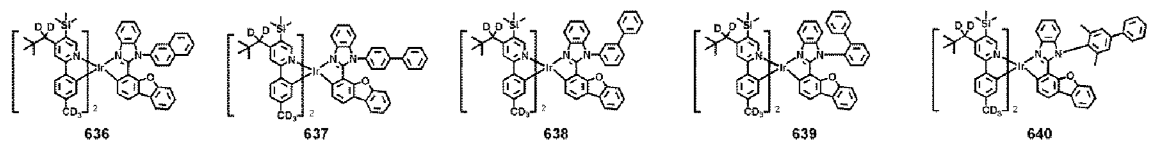
636 637 638 639 640
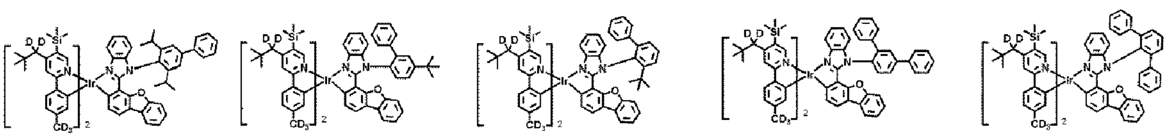
641 642 643 644 645
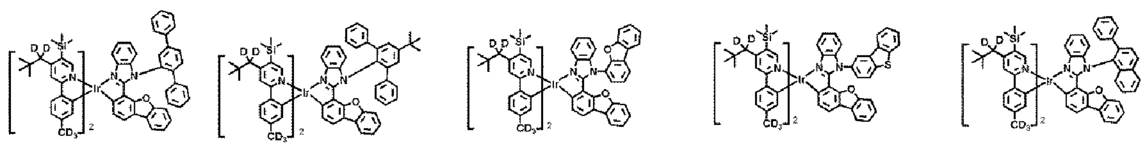
646 647 648 649 650

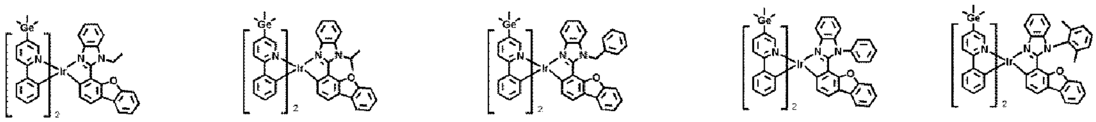
651 652 653 654 655

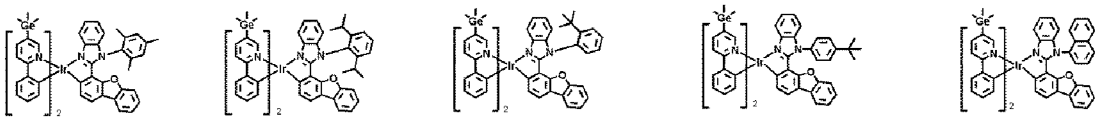
656 657 658 659 660

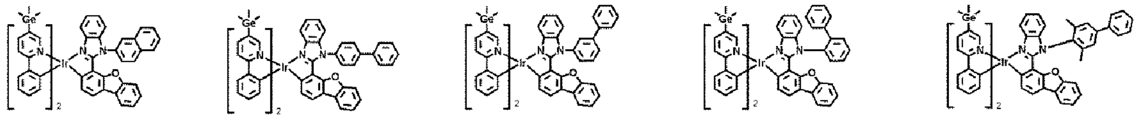
661 662 663 664 665

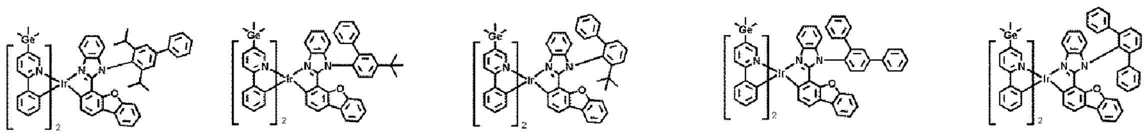
666 667 668 669 670

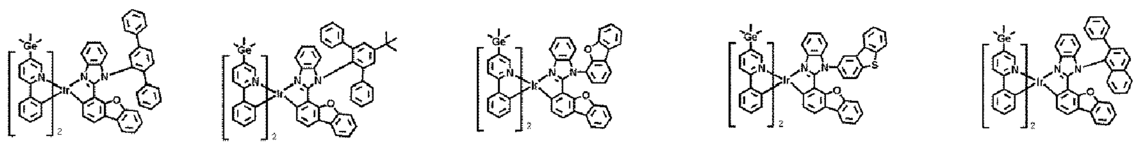
671 672 673 674 675

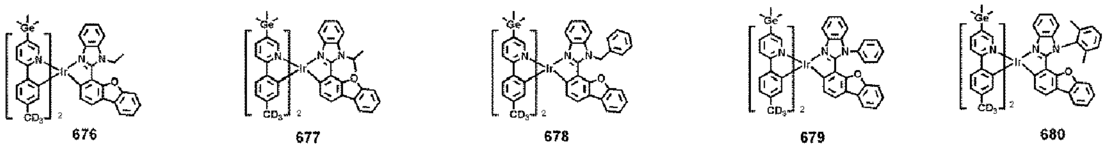
676 677 678 679 680

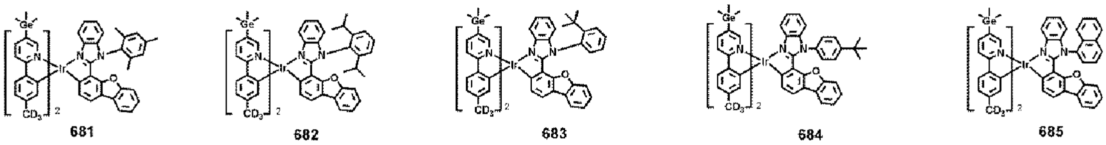
681 682 683 684 685

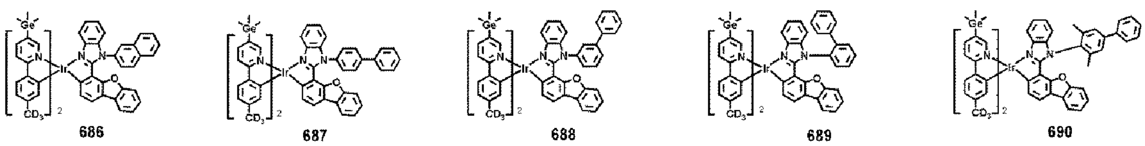
686 687 688 689 690

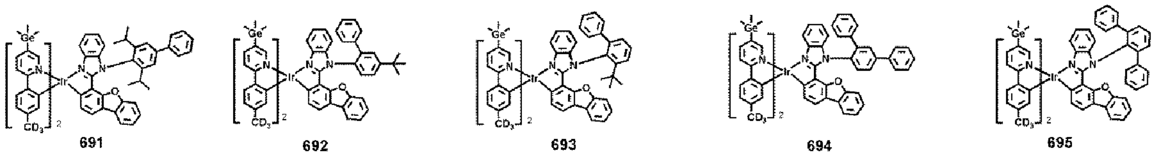
691 692 693 694 695

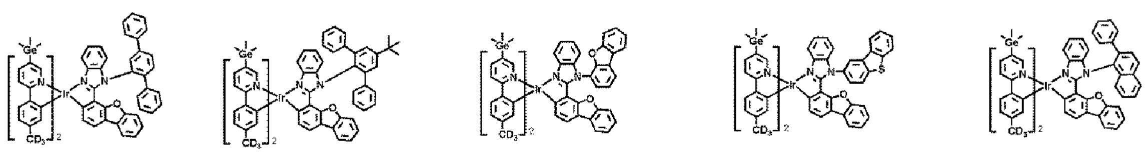
696 697 698 699 700

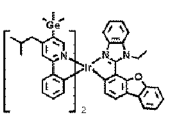
701
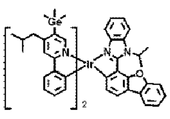
702
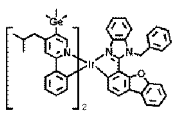
703
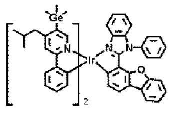
704
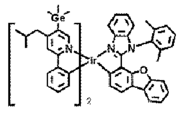
705
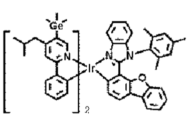
706
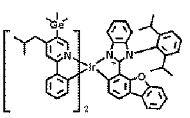
707
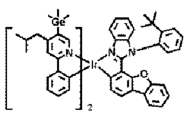
708
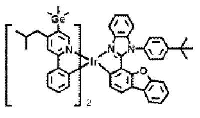
709
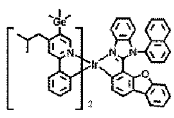
710
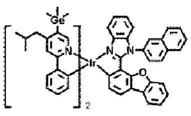
711
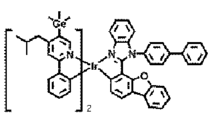
712
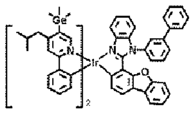
713
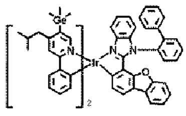
714
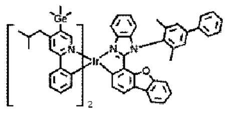
715
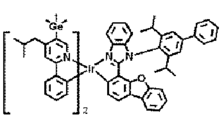
716
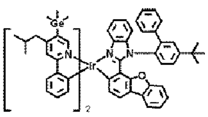
717
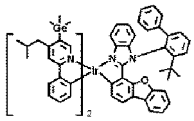
718
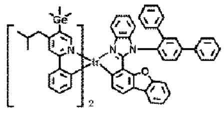
719
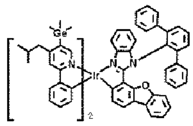
720
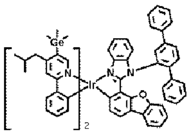
721
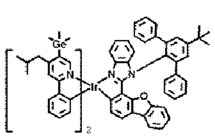
722
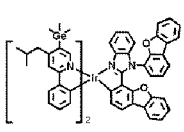
723
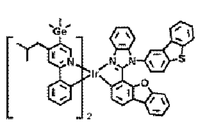
724
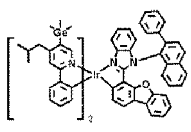
725
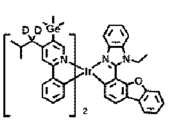
726
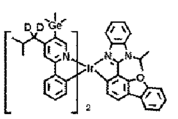
727
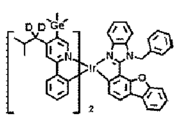
728
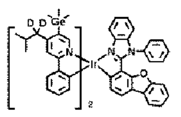
729
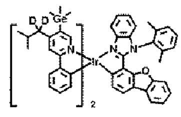
730
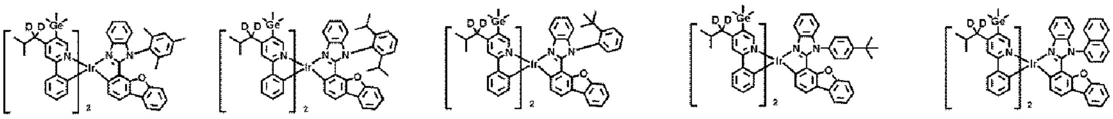
731 732 733 734 735
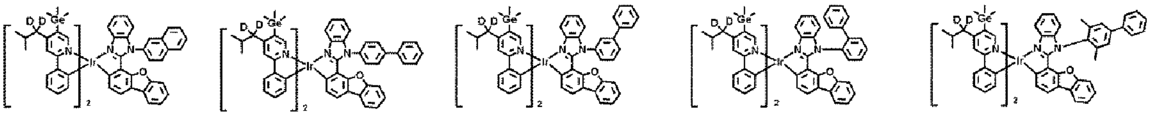
736 737 738 739 740
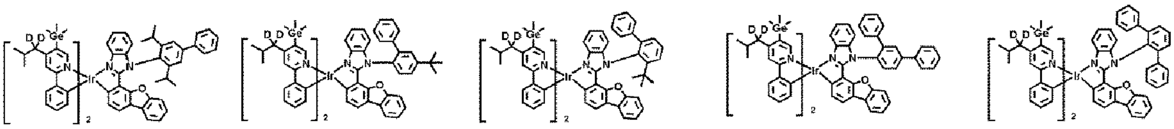
741 742 743 744 745
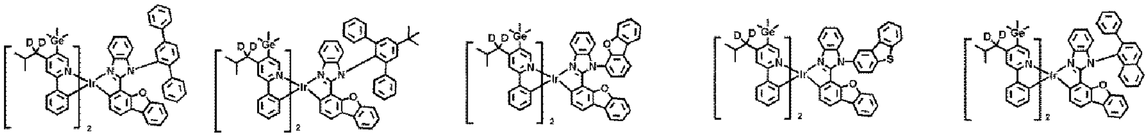
746 747 748 749 750

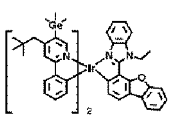
751
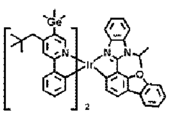
752
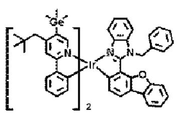
753
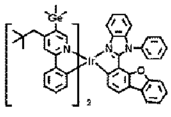
754
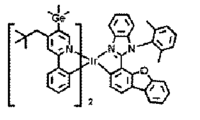
755
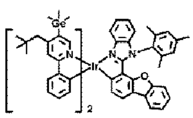
756
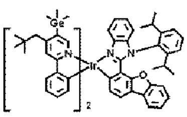
757
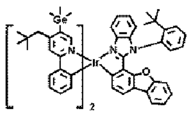
758
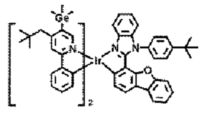
759
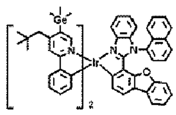
760
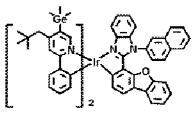
761
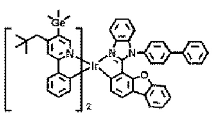
762
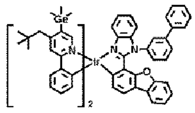
763
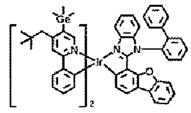
764
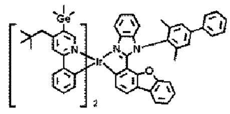
765
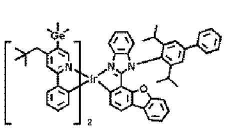
766
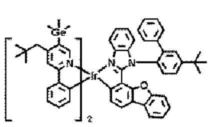
767
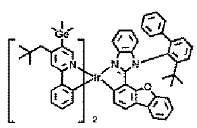
768
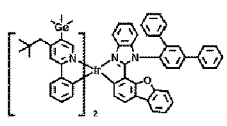
769
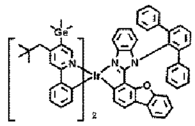
770
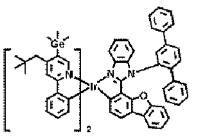
771
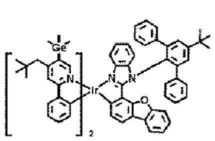
772
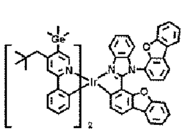
773
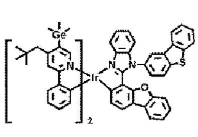
774
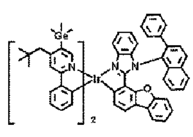
775
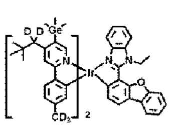
776
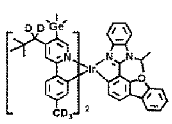
777
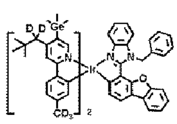
778
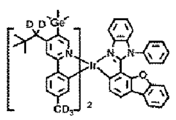
779
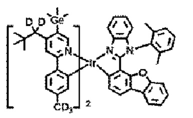
780
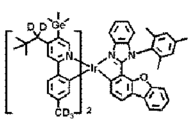
781
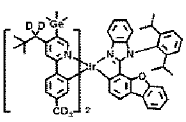
782
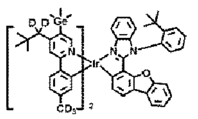
783
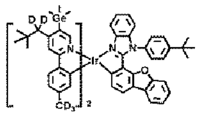
784
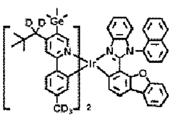
785
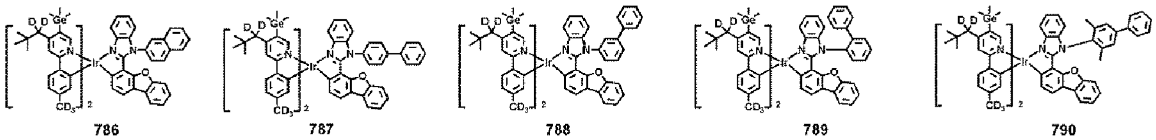
786
787
788
789
790
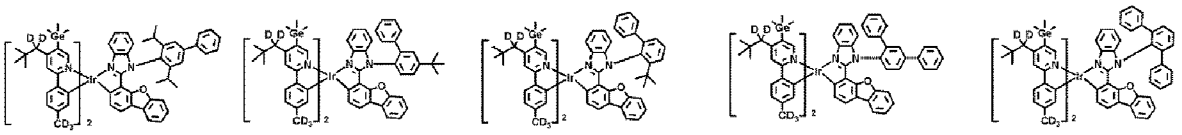
791
792
793
794
795
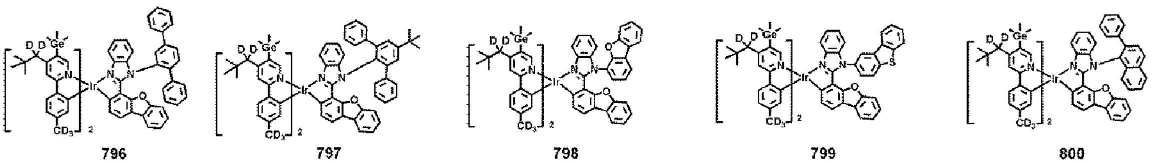
796
797
798
799
800

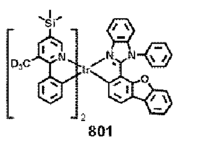
801
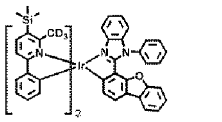
802
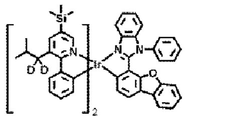
803
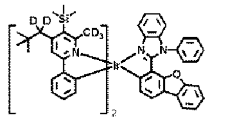
804
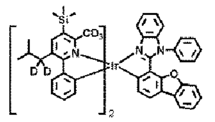
805
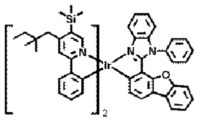
806
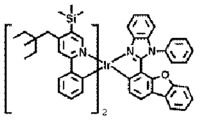
807
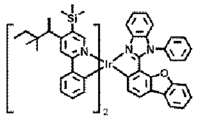
808
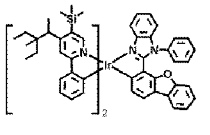
809
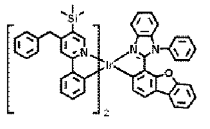
810
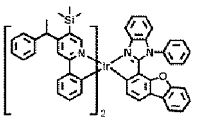
811
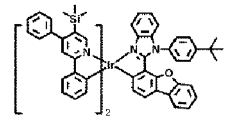
812
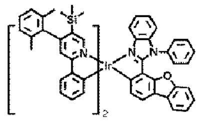
813
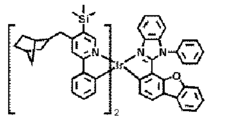
814
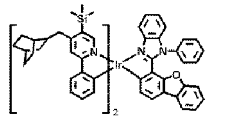
815
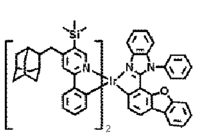
816
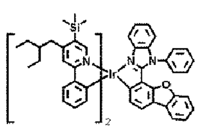
817
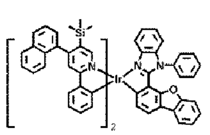
818
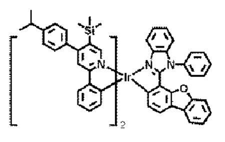
819
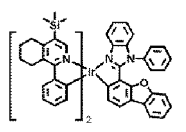
820
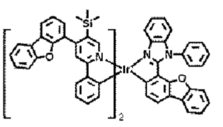
821
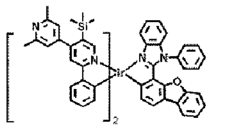
822
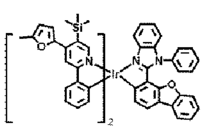
823
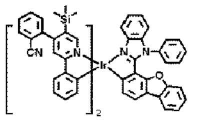
824
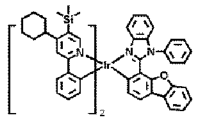
825
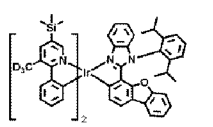
826
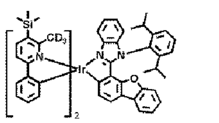
827
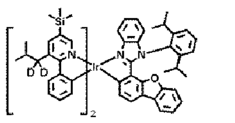
828
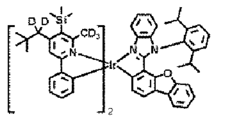
829
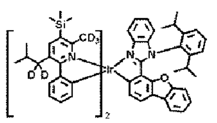
830
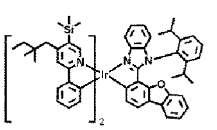
831
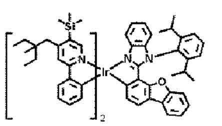
832
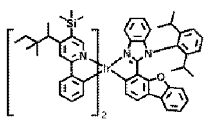
833
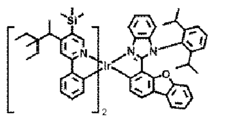
834
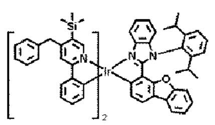
835
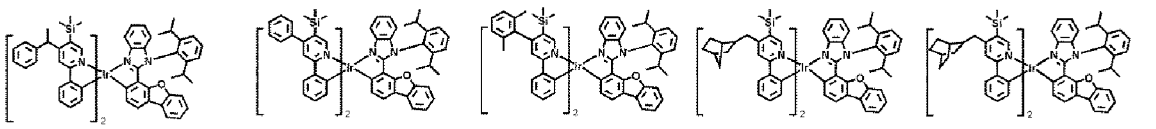
836 837 838 839 840
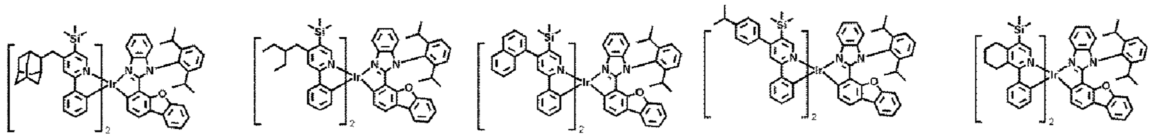
841 842 843 844 845
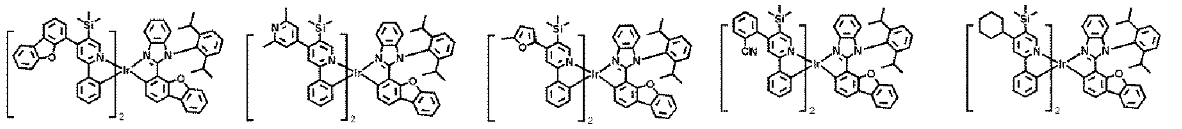
846 847 848 849 850

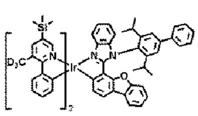
851
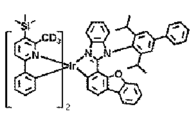
852
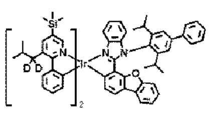
853
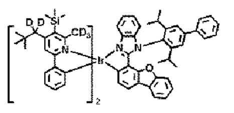
854
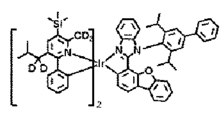
855

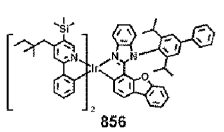
856
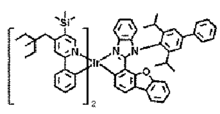
857
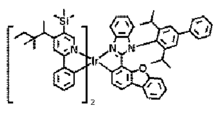
858
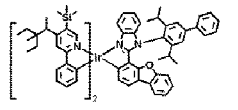
859
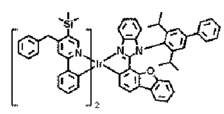
860

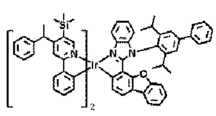
861
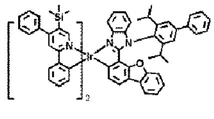
862
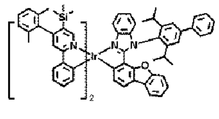
863
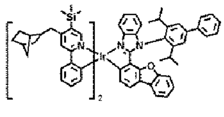
864
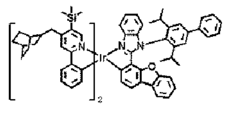
865

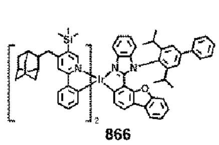
866
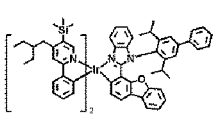
867
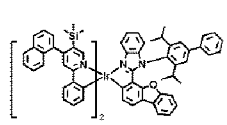
868
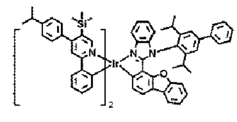
869
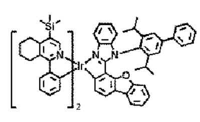
870

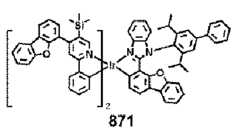
871
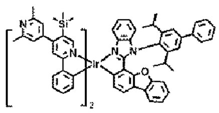
872
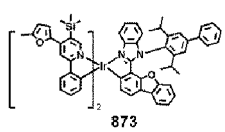
873
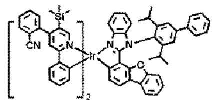
874
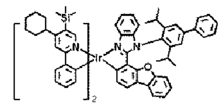
875

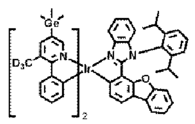
876
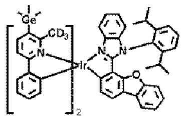
877
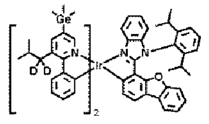
878
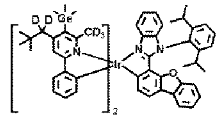
879
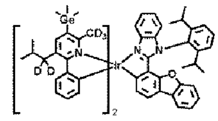
880

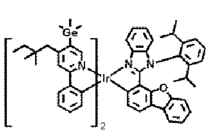
881
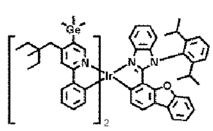
882
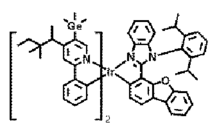
883
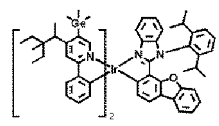
884
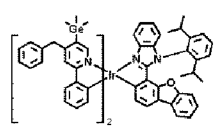
885

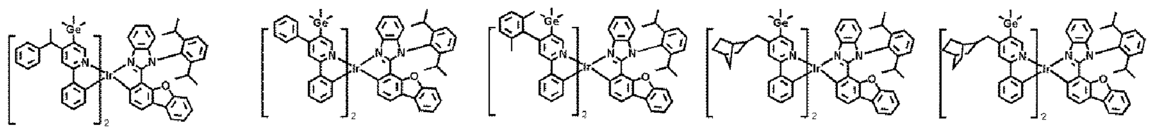
886
887
888
889
890

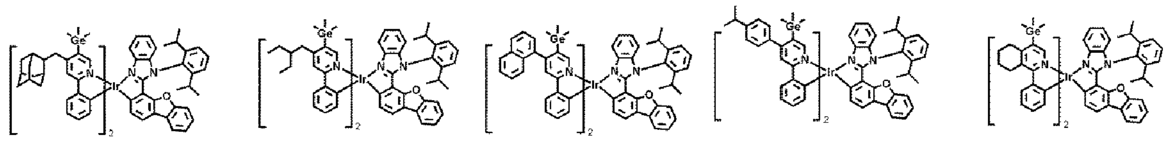
891
892
893
894
895

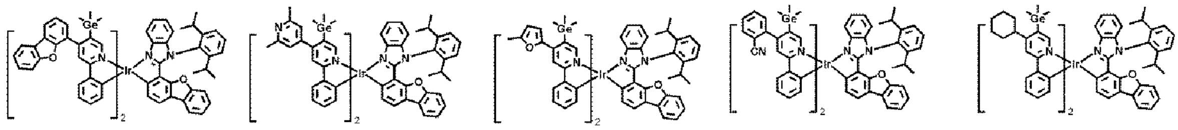
896
897
898
899
900

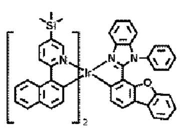
901
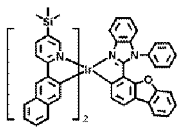
902
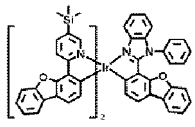
903
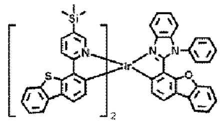
904
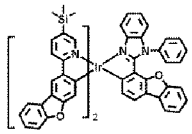
905
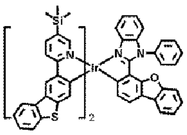
906
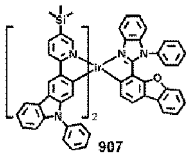
907
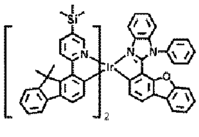
908
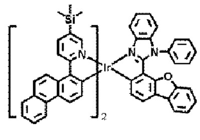
909
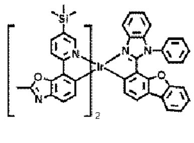
910
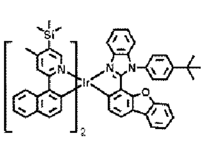
911
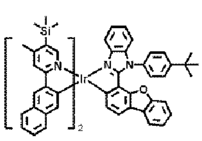
912
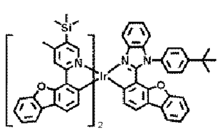
913
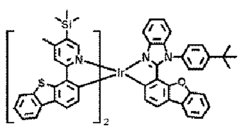
914
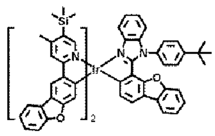
915
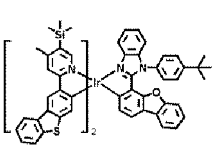
916
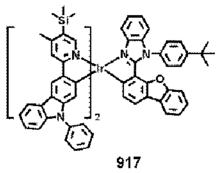
917
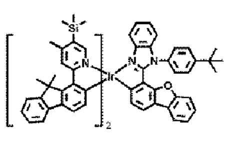
918
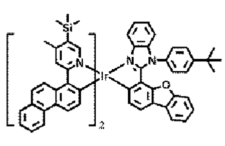
919
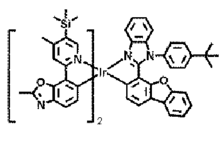
920
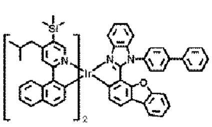
921
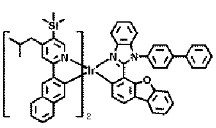
922
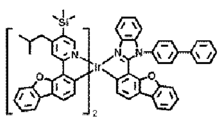
923
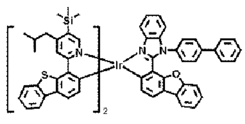
924
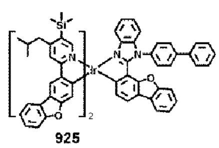
925
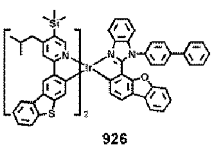
926
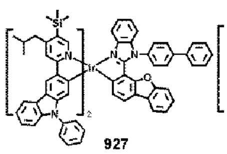
927
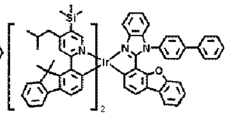
928
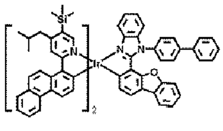
929
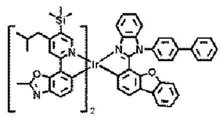
930
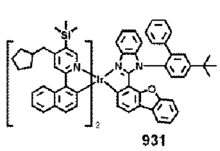
931
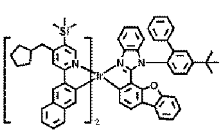
932
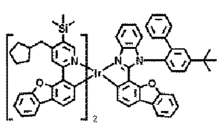
933
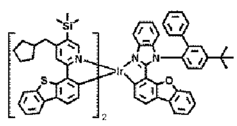
934
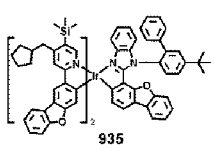
935
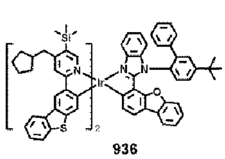
936
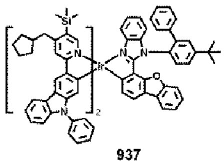
937
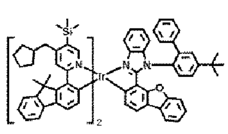
938
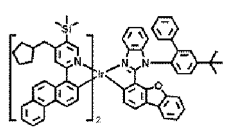
939
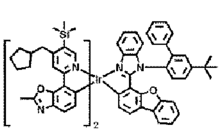
940

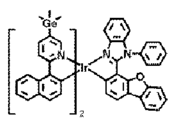
941

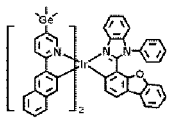
942

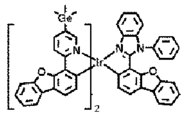
943

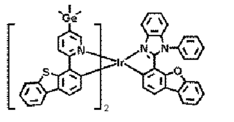
944

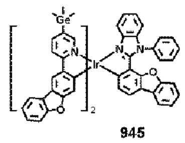
945

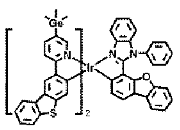
946

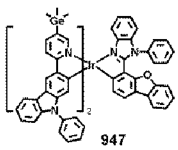
947

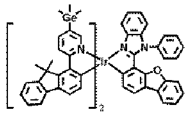
948

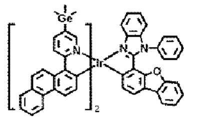
949

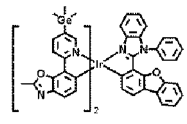
950

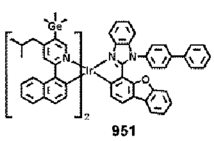
951

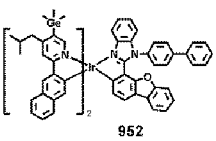
952

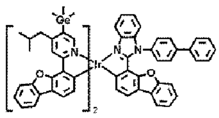
953

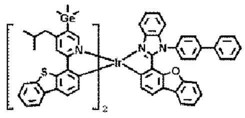
954

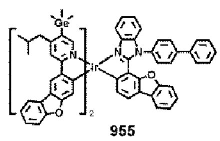
955

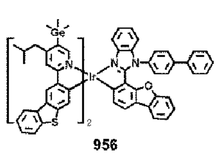
956

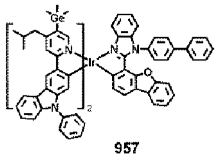
957

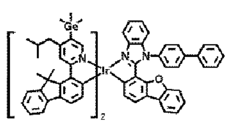
958

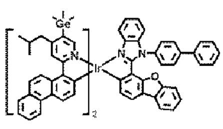
959

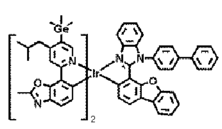
960

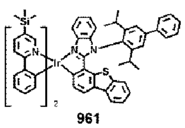
961

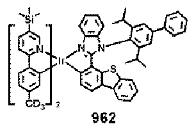
962

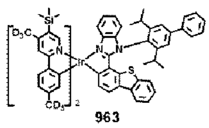
963

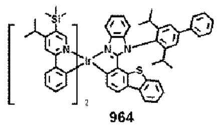
964

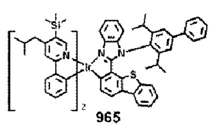
965

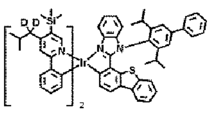
966

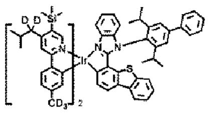
967

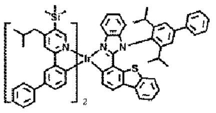
968

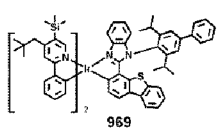
969

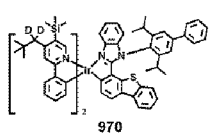
970

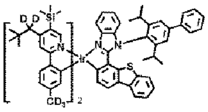
971

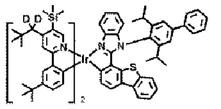
972

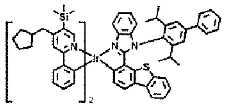
973

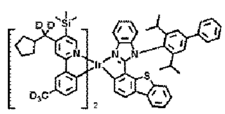
974

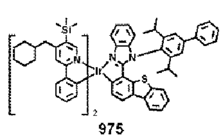
975

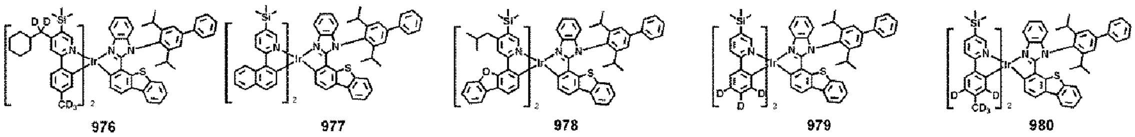
976 977 978 979 980

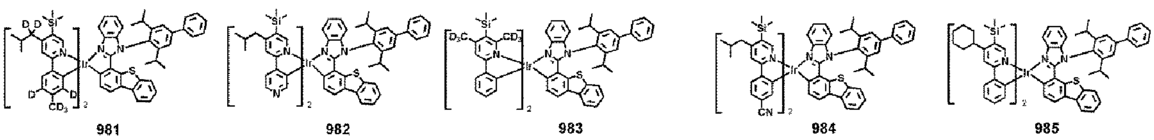
981 982 983 984 985

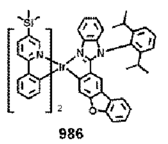
986
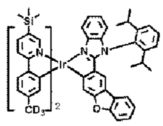
987
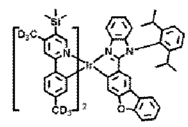
988
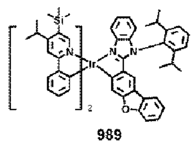
989
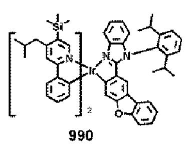
990
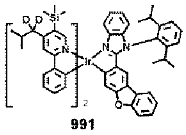
991
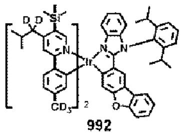
992
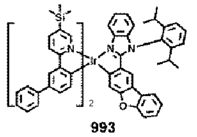
993
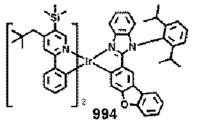
994
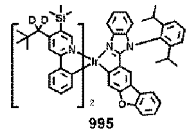
995
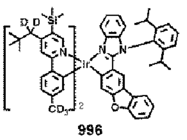
996
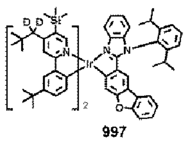
997
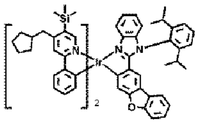
998
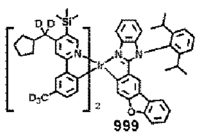
999
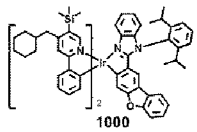
1000
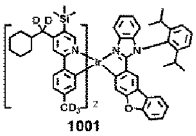
1001
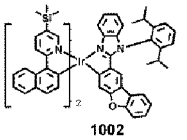
1002
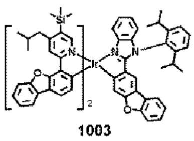
1003
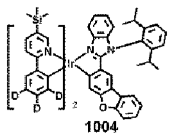
1004
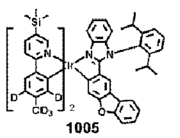
1005
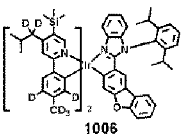
1006
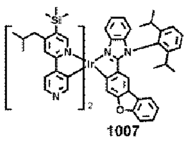
1007
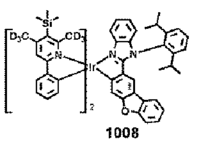
1008
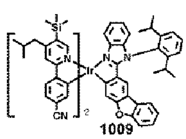
1009
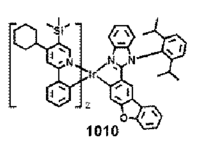
1010
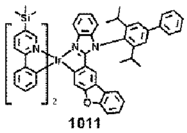
1011
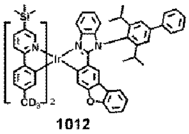
1012
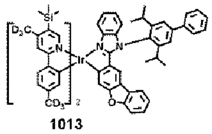
1013
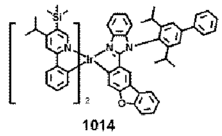
1014
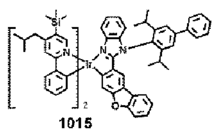
1015
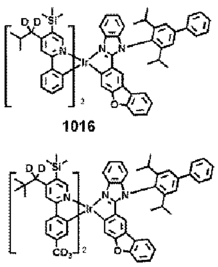
1016
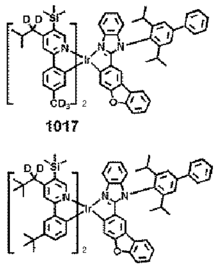
1017
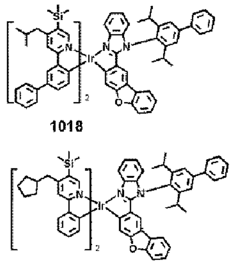
1018
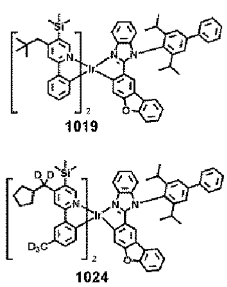
1019
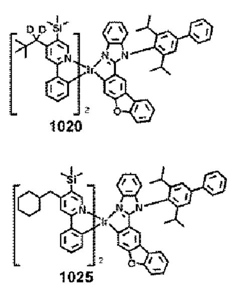
1020
1021
1022
1023
1024
1025
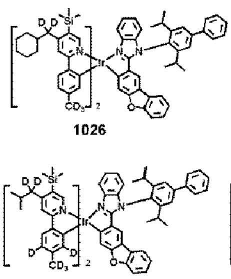
1026
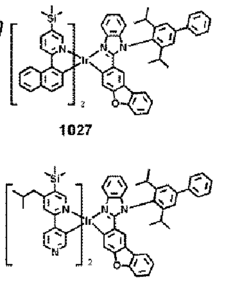
1027
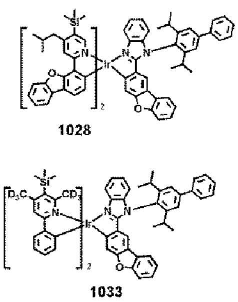
1028
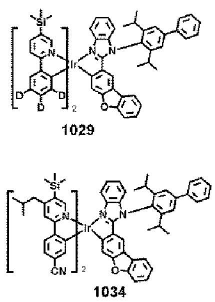
1029
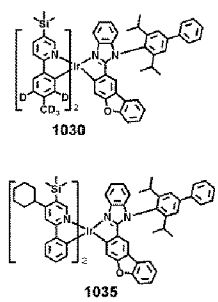
1030
1031
1032
1033
1034
1035

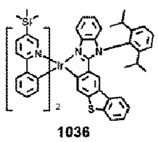
1036

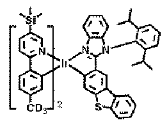
1037

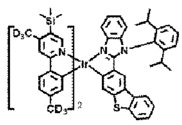
1038

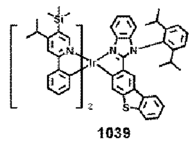
1039

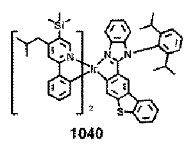
1040

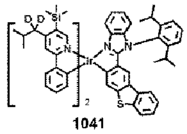
1041

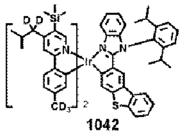
1042

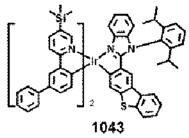
1043

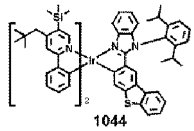
1044

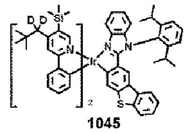
1045

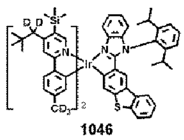
1046

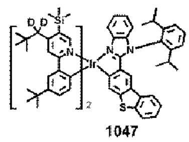
1047

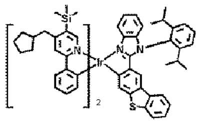
1048

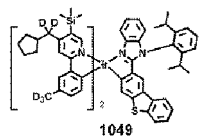
1049

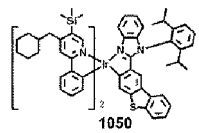
1050

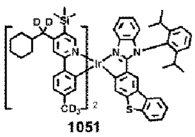
1051

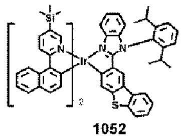
1052

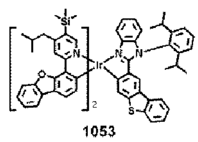
1053

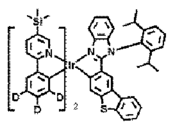
1054

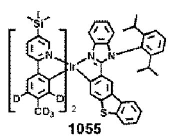
1055

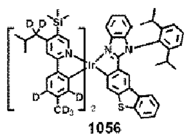
1056

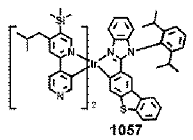
1057

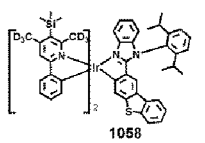
1058

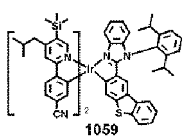
1059

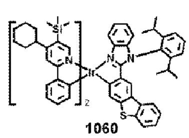
1060

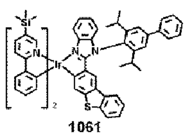
1061

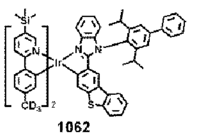
1062

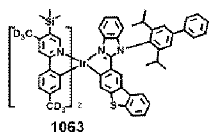
1063

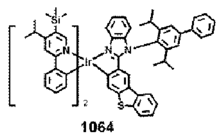
1064

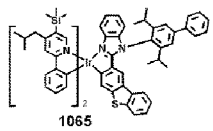
1065

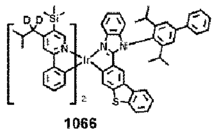
1066

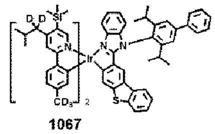
1067

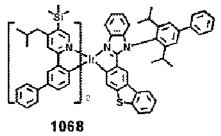
1068

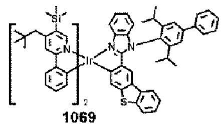
1069

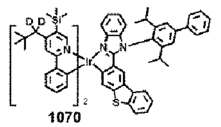
1070

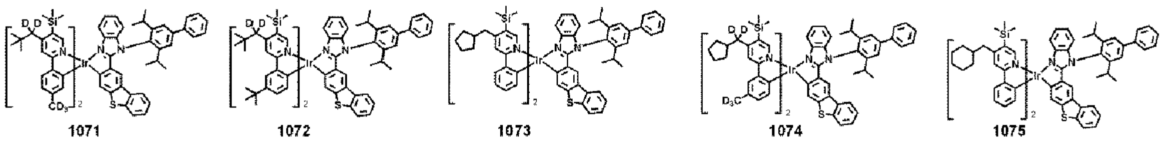
1071 1072 1073 1074 1075

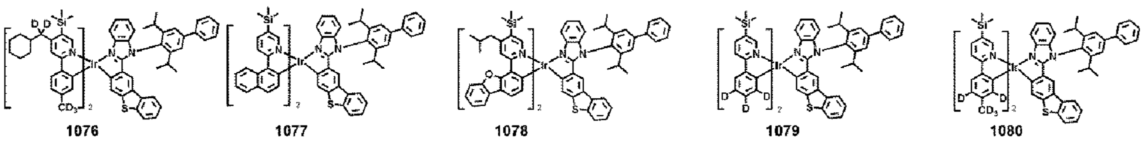
1076 1077 1078 1079 1080

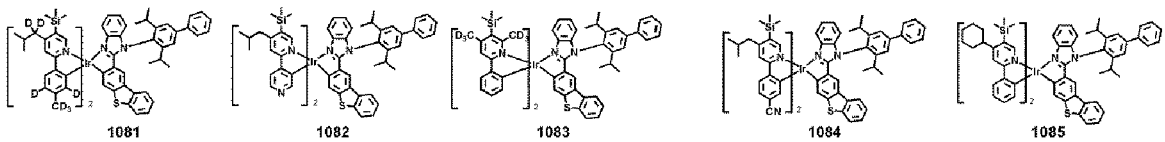
1081 1082 1083 1084 1085

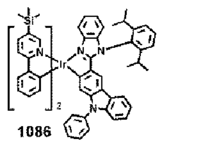
1086

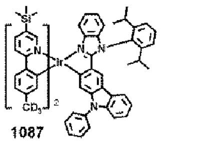
1087

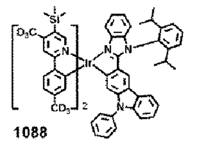
1088

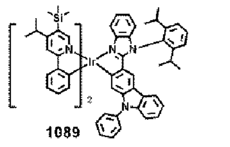
1089

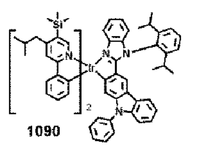
1090

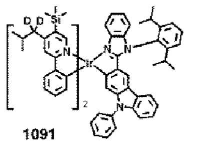
1091

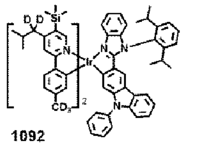
1092

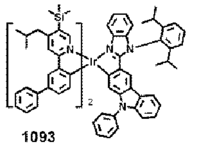
1093

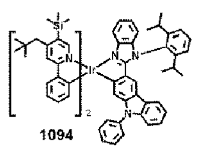
1094

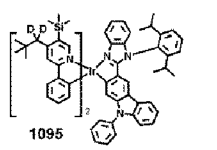
1095

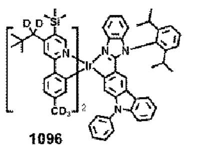
1096

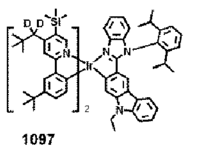
1097

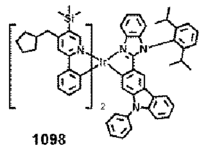
1098

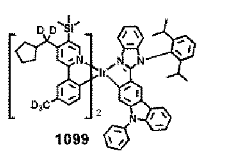
1099

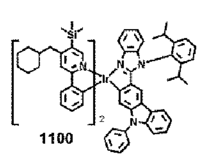
1100

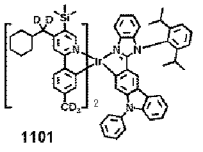
1101

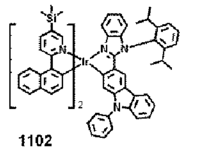
1102

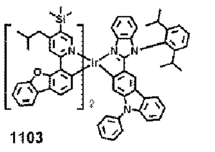
1103

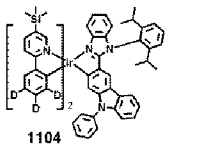
1104

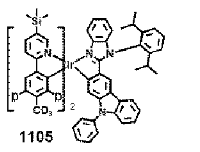
1105

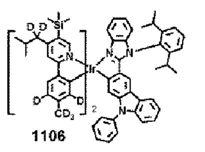
1106

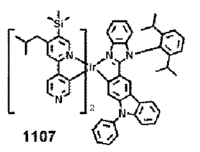
1107

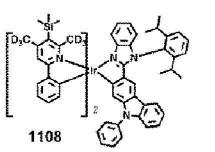
1108

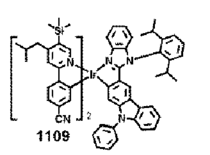
1109

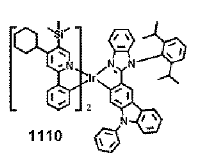
1110

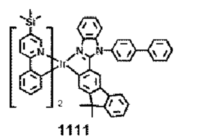
1111

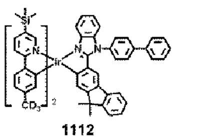
1112

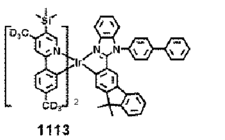
1113

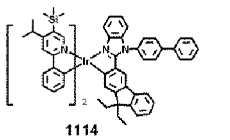
1114

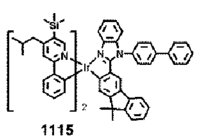
1115

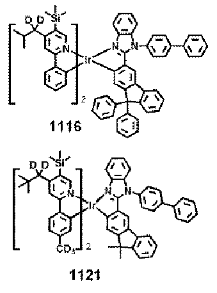
1116

1121

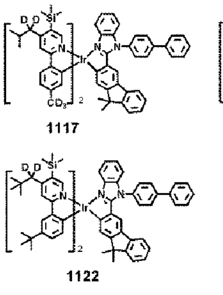
1117

1122

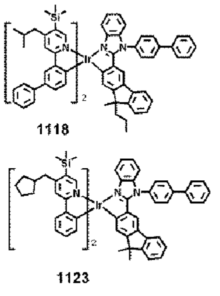
1118

1123

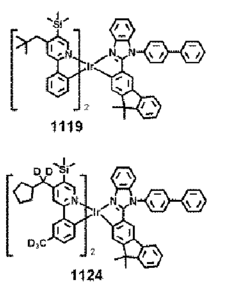
1119

1124

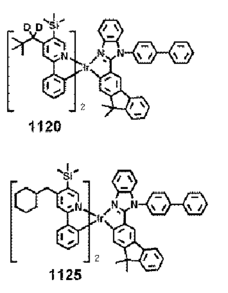
1120

1125

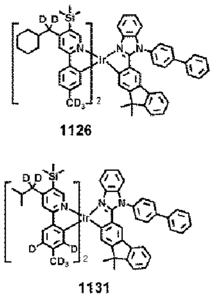
1126

1131

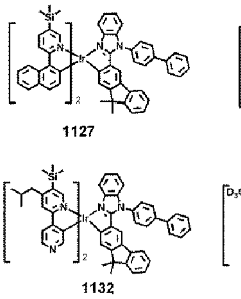
1127

1132

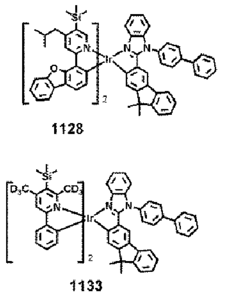
1128

1133

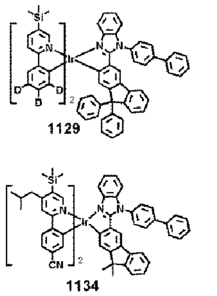
1129

1134

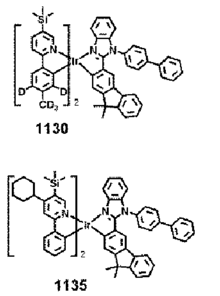
1130

1135

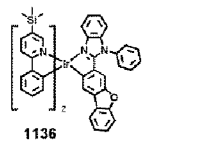
1136
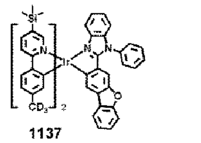
1137
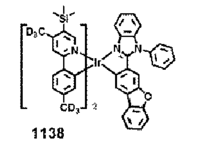
1138
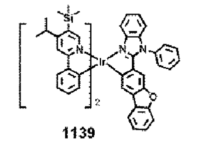
1139
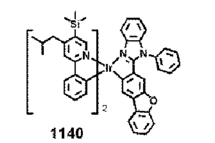
1140
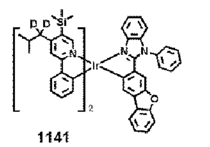
1141
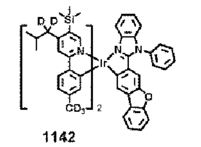
1142
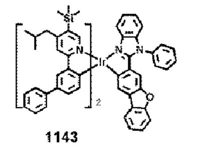
1143
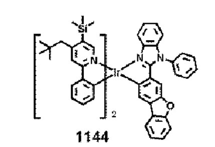
1144
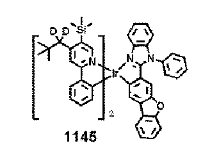
1145
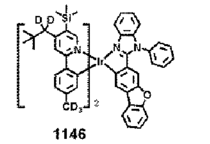
1146
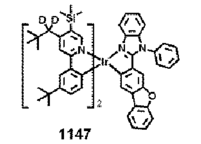
1147
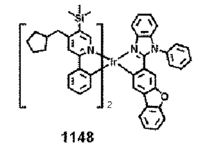
1148
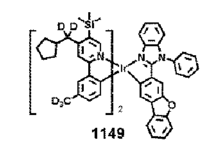
1149
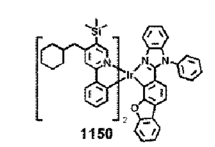
1150
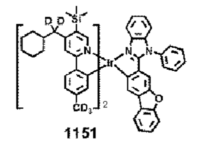
1151
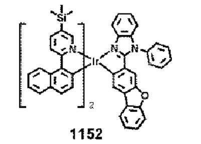
1152
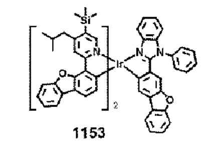
1153
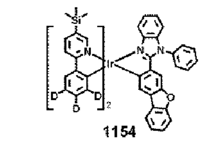
1154
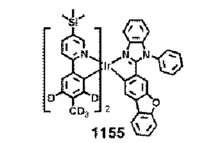
1155
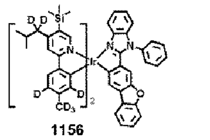
1156
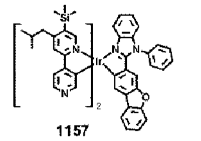
1157
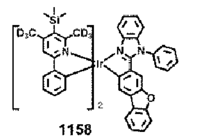
1158
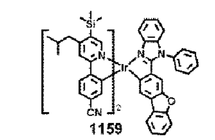
1159
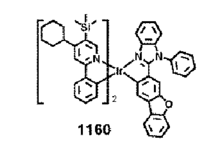
1160
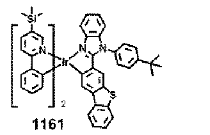
1161
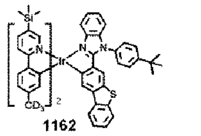
1162
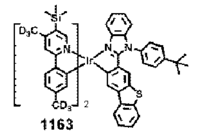
1163
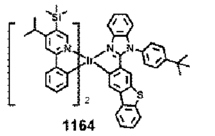
1164
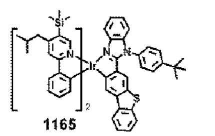
1165
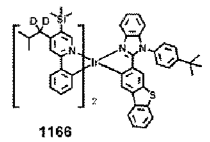
1166
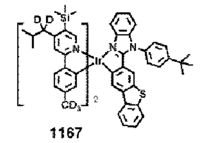
1167
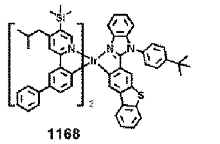
1168
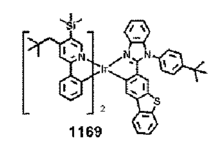
1169
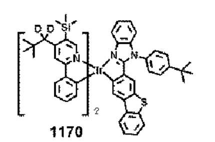
1170
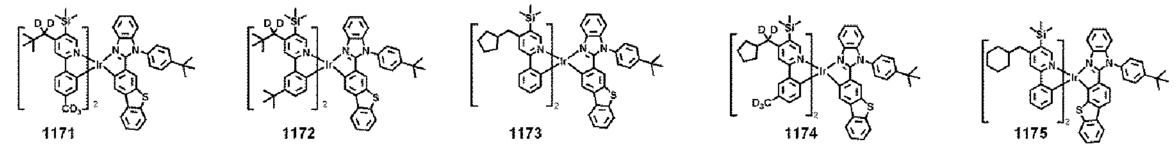
1171
1172
1173
1174
1175
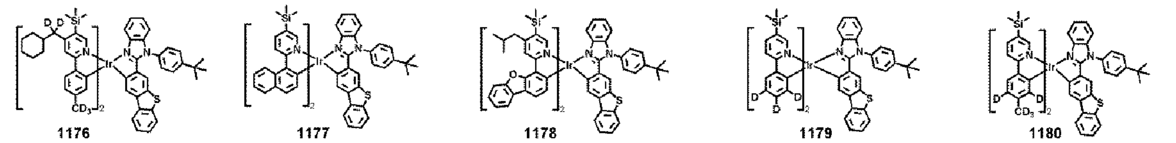
1176
1177
1178
1179
1180
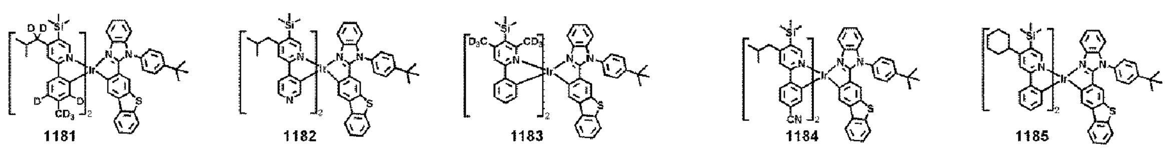
1181
1182
1183
1184
1185

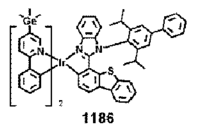
1186

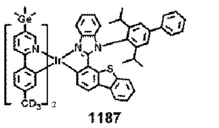
1187

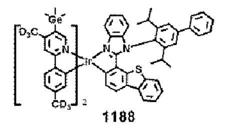
1188

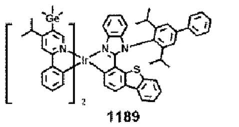
1189

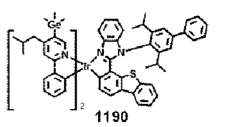
1190

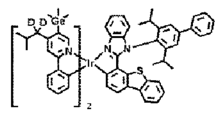
1191

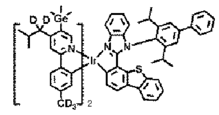
1192

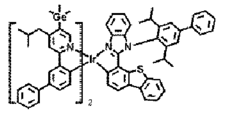
1193

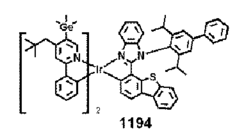
1194

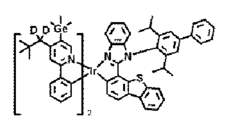
1195

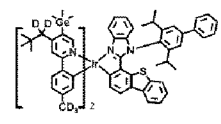
1196

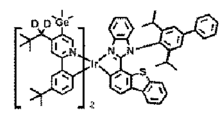
1197

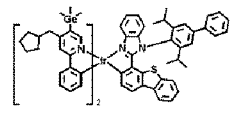
1198

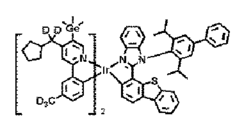
1199

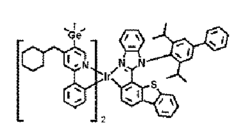
1200

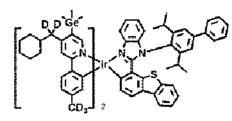
1201

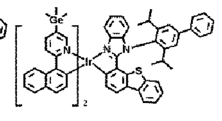
1202

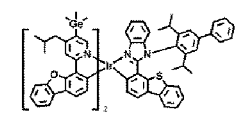
1203

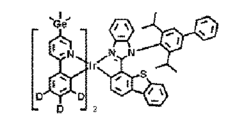
1204

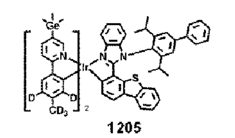
1205

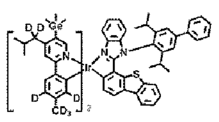
1206

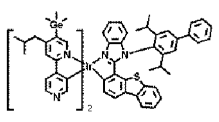
1207

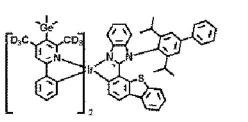
1208

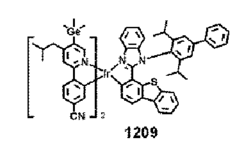
1209

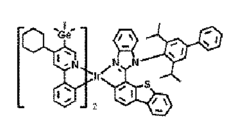
1210

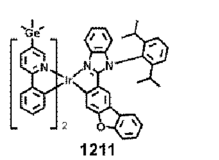
1211

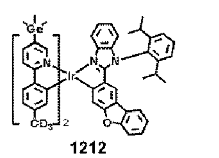
1212

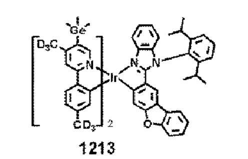
1213

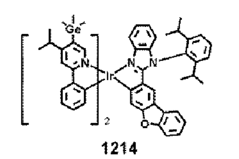
1214

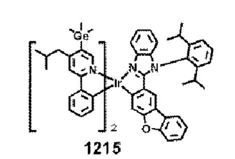
1215

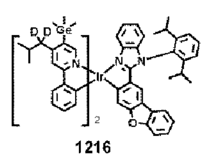
1216

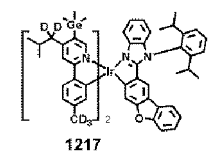
1217

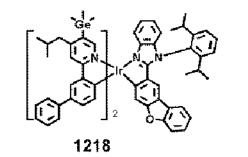
1218

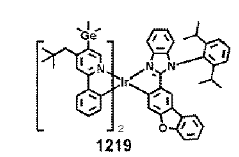
1219

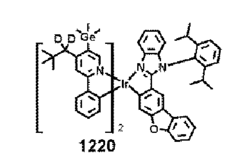
1220

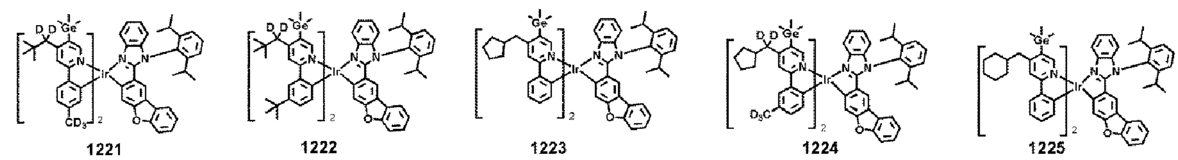
1221 1222 1223 1224 1225

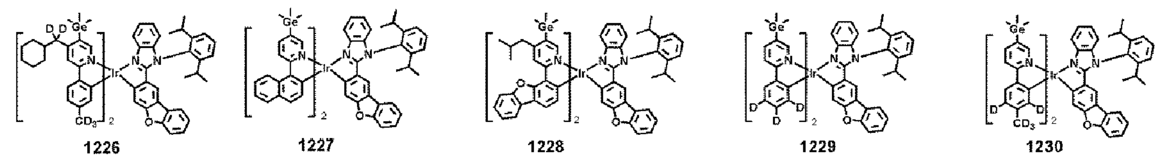
1226 1227 1228 1229 1230

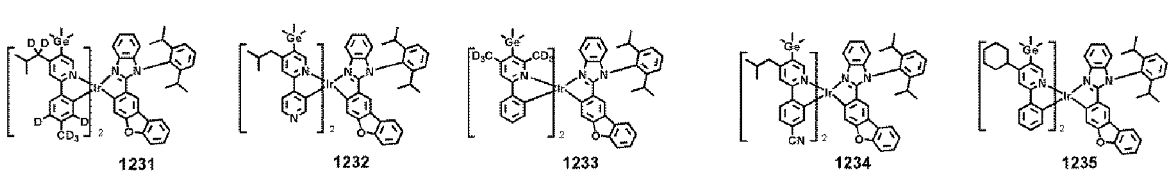
1231 1232 1233 1234 1235

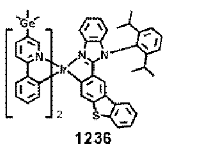
1236
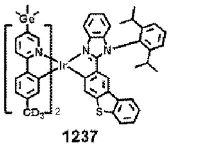
1237
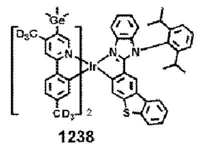
1238
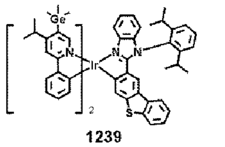
1239
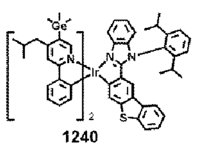
1240
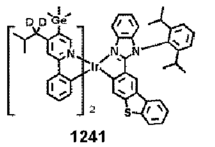
1241
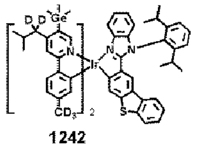
1242
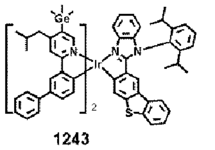
1243
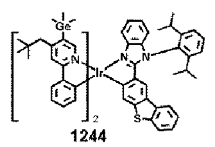
1244
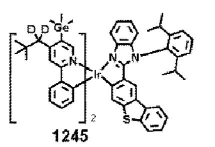
1245
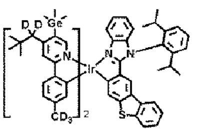
1246
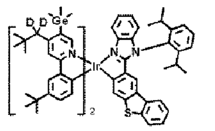
1247
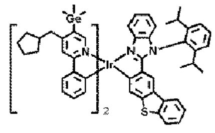
1248
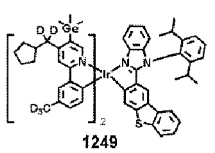
1249
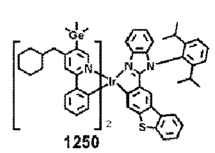
1250
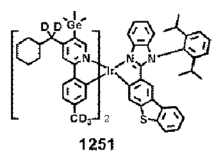
1251
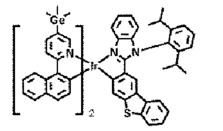
1252
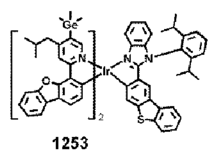
1253
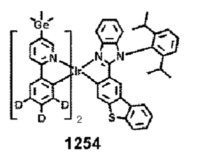
1254
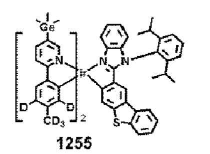
1255
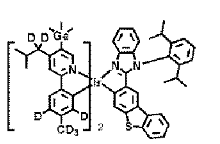
1256
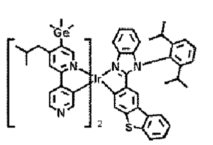
1257
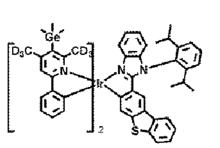
1258
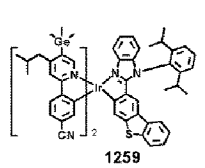
1259
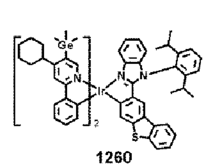
1260
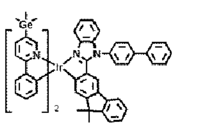
1261
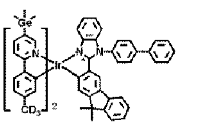
1262
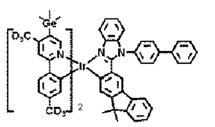
1263
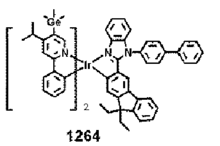
1264
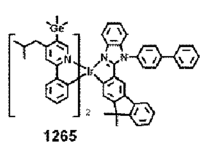
1265
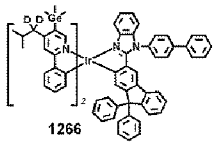
1266
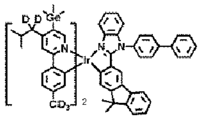
1267
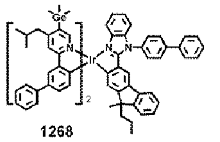
1268
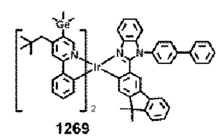
1269
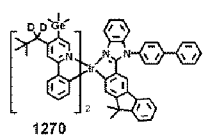
1270
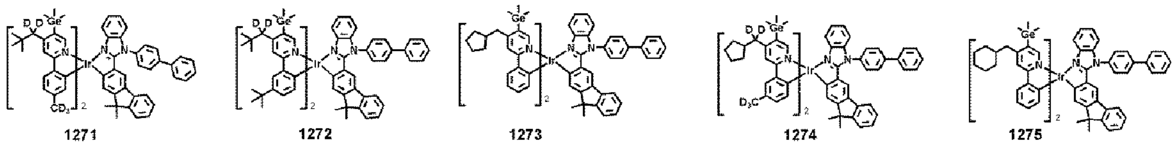
1271
1272
1273
1274
1275
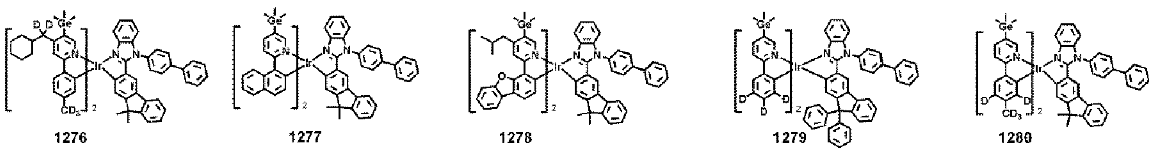
1276
1277
1278
1279
1280
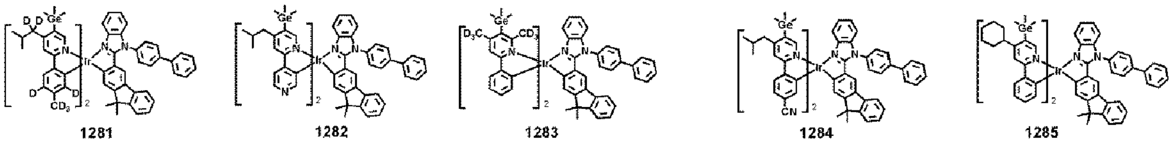
1281
1282
1283
1284
1285

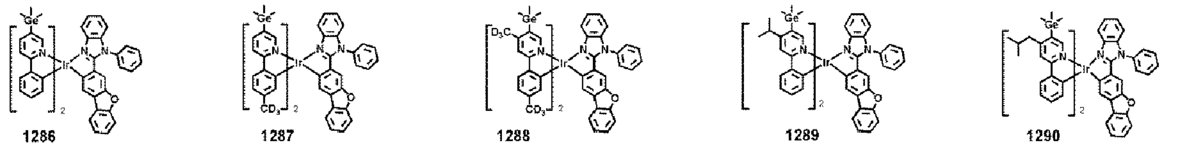

1286 1287 1288 1289 1290

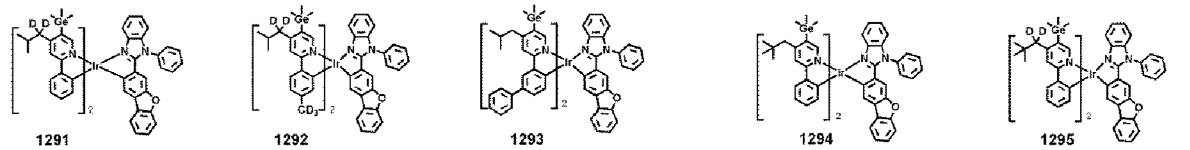

1291 1292 1293 1294 1295

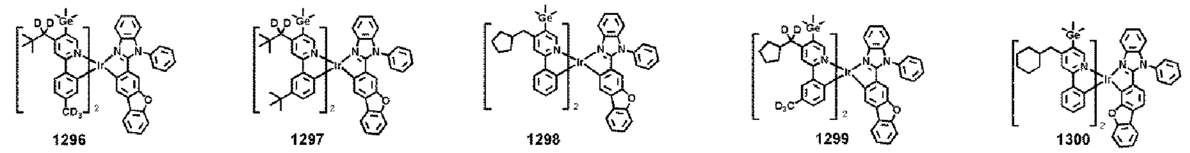

1296 1297 1298 1299 1300

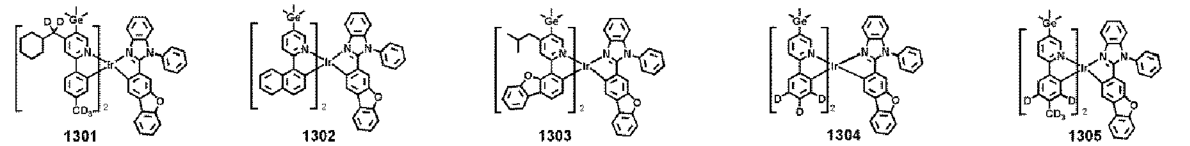

1301 1302 1303 1304 1305

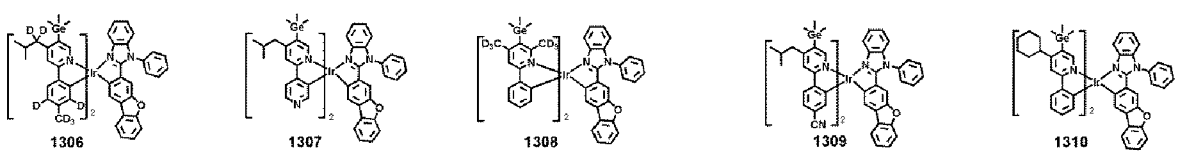

1306 1307 1308 1309 1310

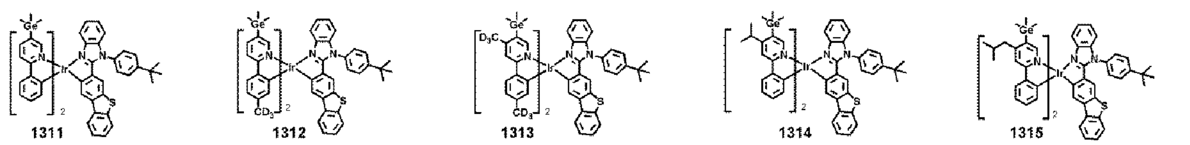

1311 1312 1313 1314 1315

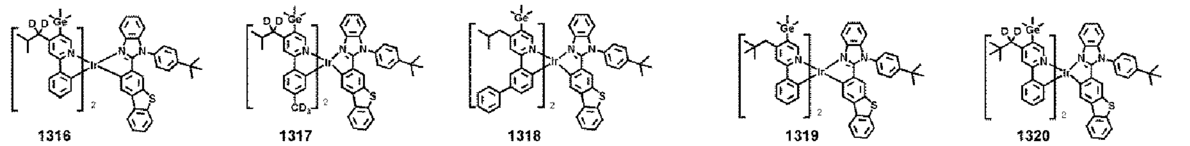

1316 1317 1318 1319 1320

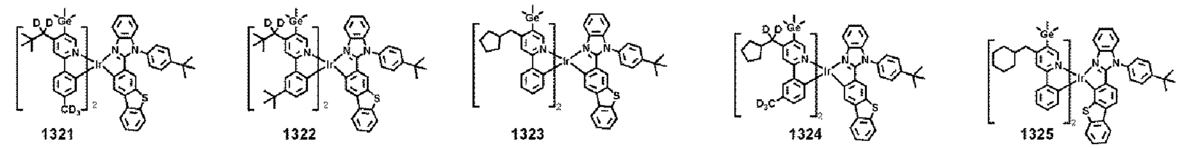

1321 1322 1323 1324 1325

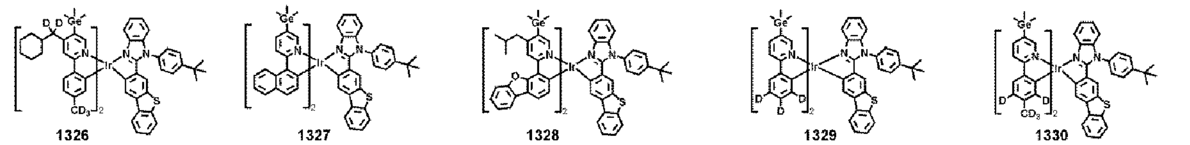

1326 1327 1328 1329 1330

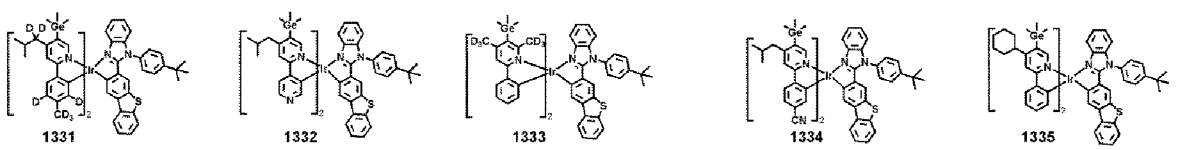

1331 1332 1333 1334 1335

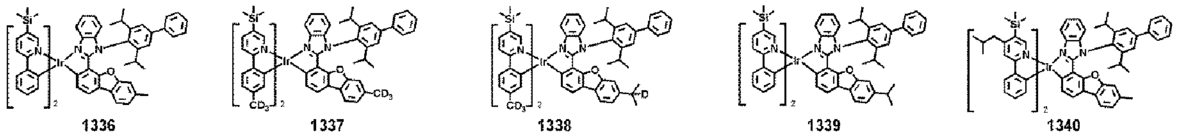
1336 1337 1338 1339 1340

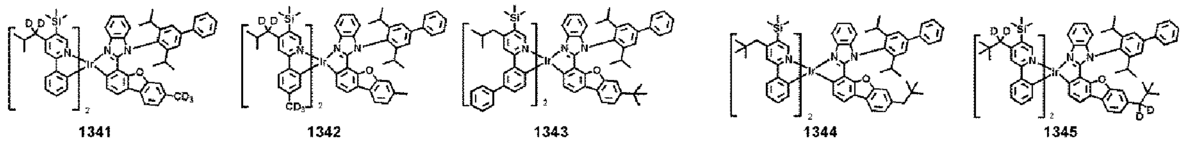
1341 1342 1343 1344 1345

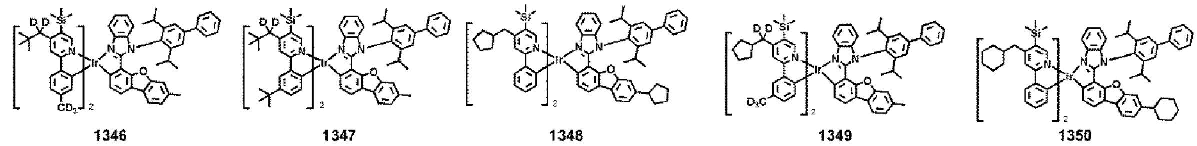
1346 1347 1348 1349 1350

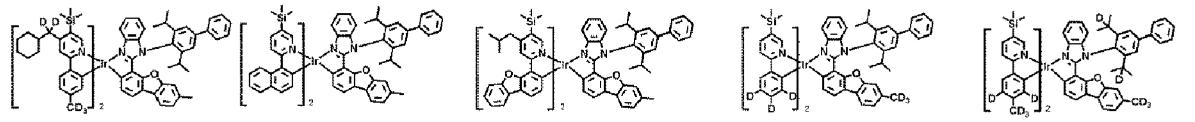
1351 1352 1353 1354 1355

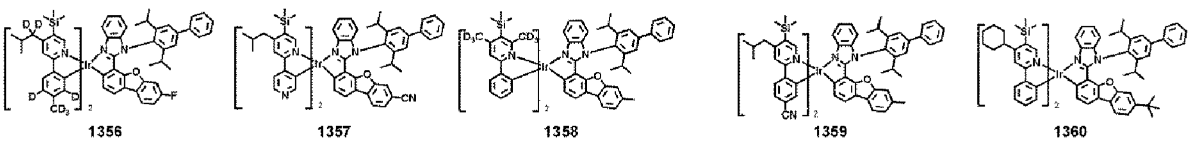
1356 1357 1358 1359 1360

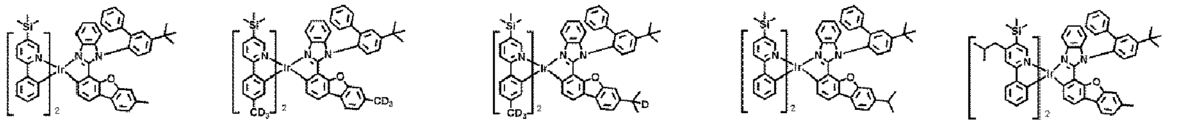
1361 1362 1363 1364 1365

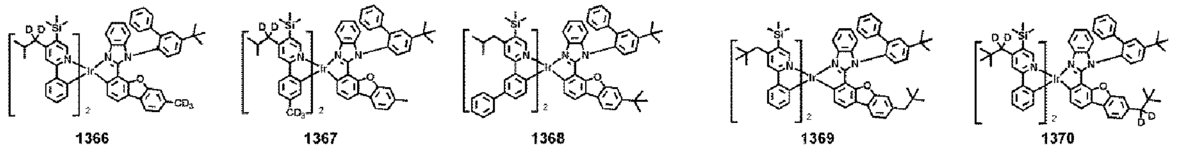
1366 1367 1368 1369 1370

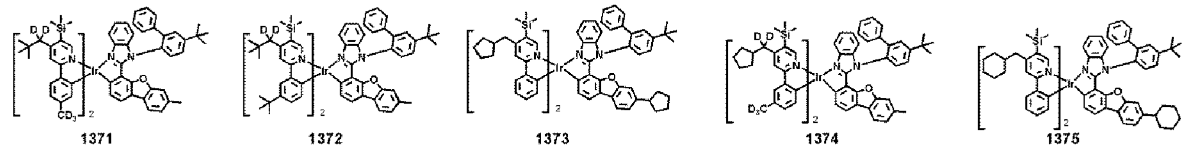
1371 1372 1373 1374 1375

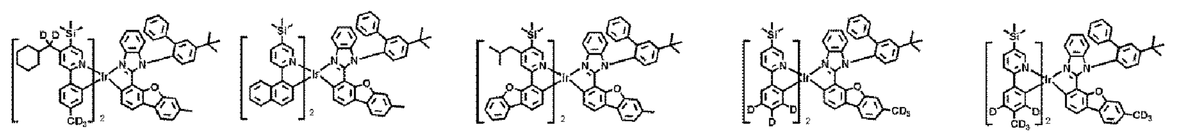
1376 1377 1378 1379 1380

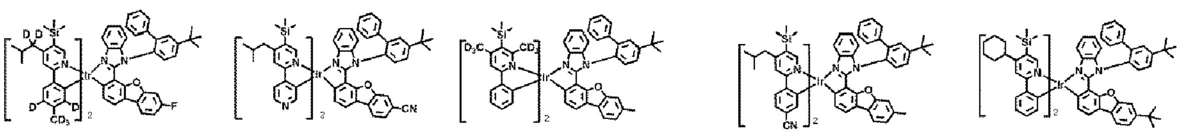
1381 1382 1383 1384 1385

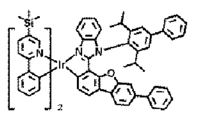
1386
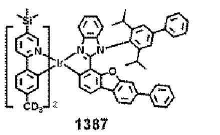
1387
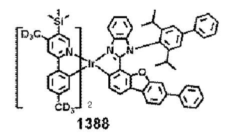
1388
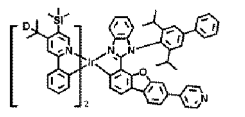
1389
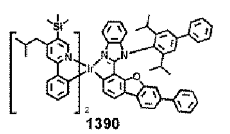
1390

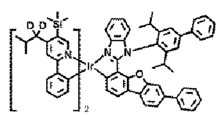
1391
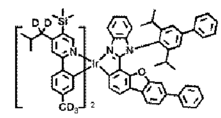
1392
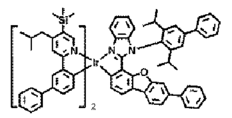
1393
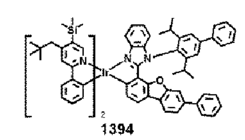
1394
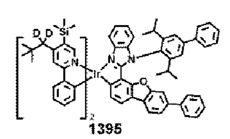
1395

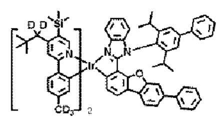
1396
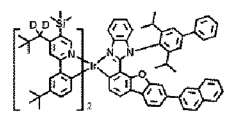
1397
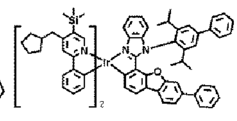
1398
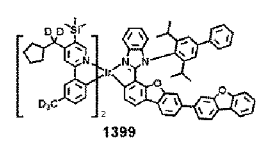
1399
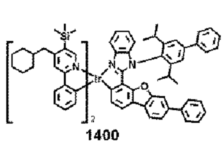
1400

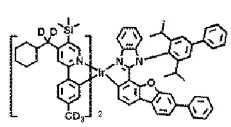
1401
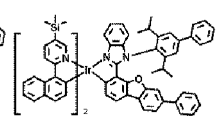
1402
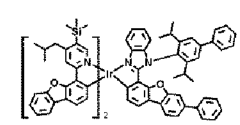
1403
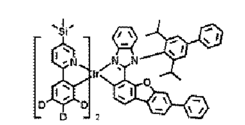
1404
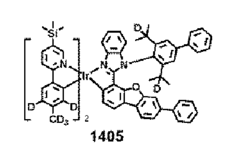
1405

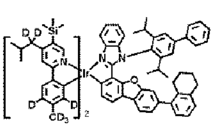
1406
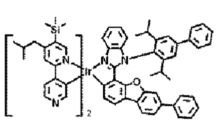
1407
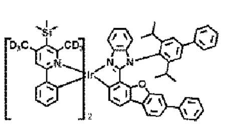
1408
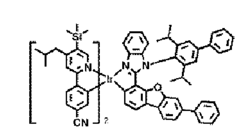
1409
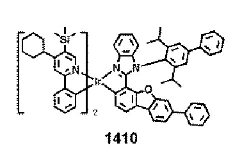
1410

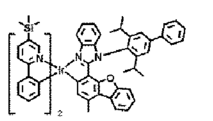
1411
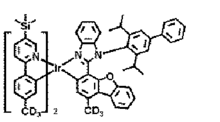
1412
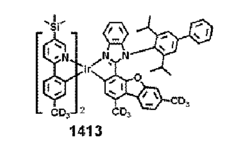
1413
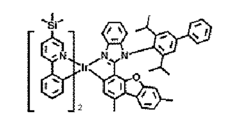
1414
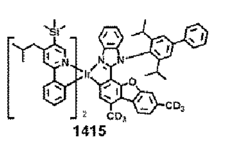
1415

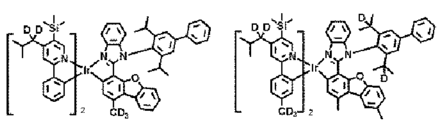
1416
1417
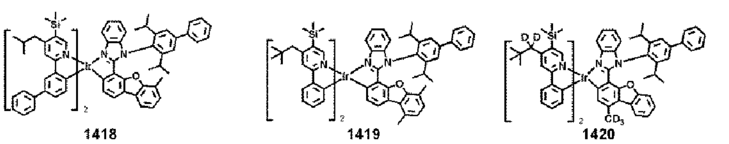
1418
1419
1420

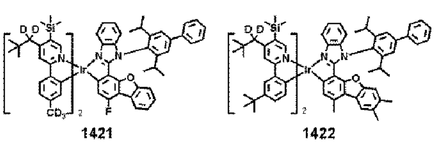
1421
1422
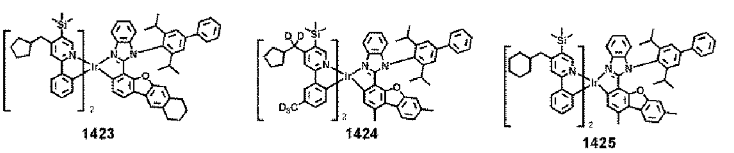
1423
1424
1425

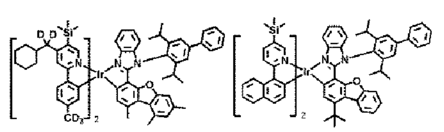
1426
1427
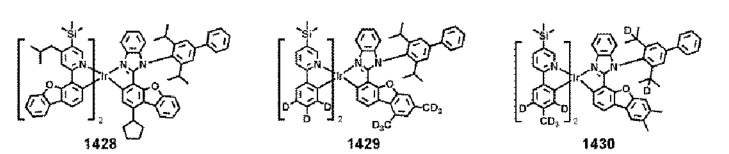
1428
1429
1430

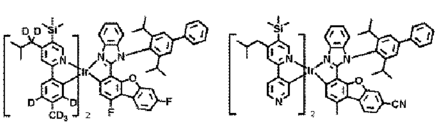
1431
1432
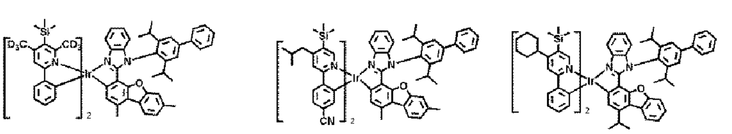
1433
1434
1435

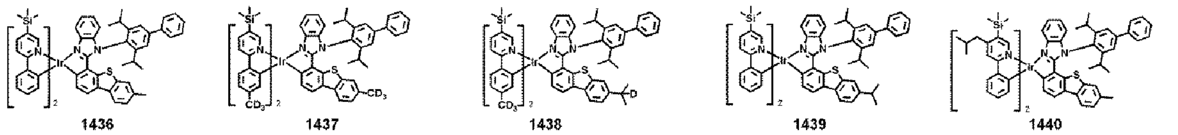
1436 1437 1438 1439 1440

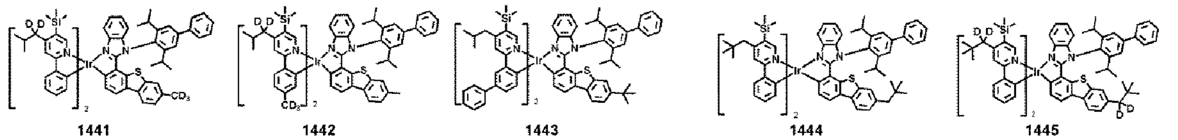
1441 1442 1443 1444 1445

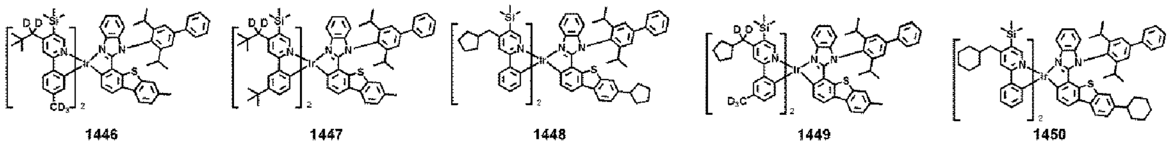
1446 1447 1448 1449 1450

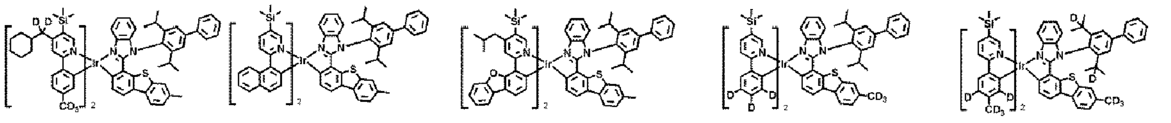
1451 1452 1453 1454 1455

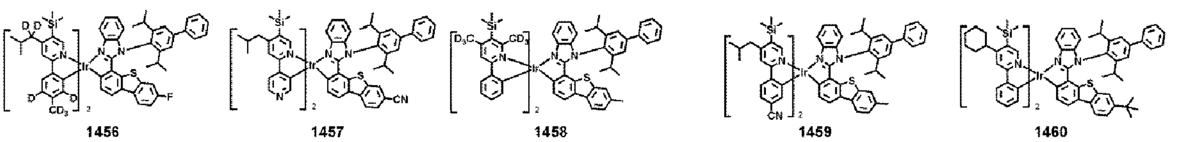
1456 1457 1458 1459 1460

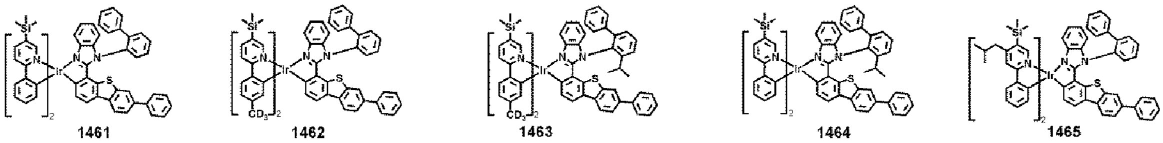
1461 1462 1463 1464 1465

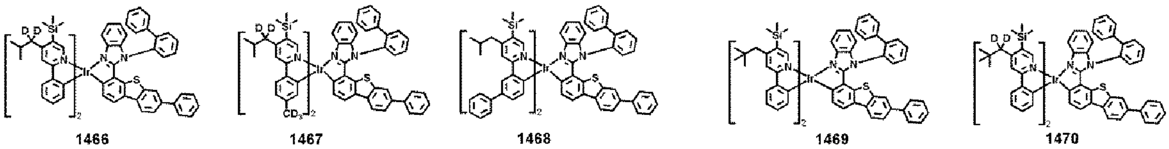
1466 1467 1468 1469 1470

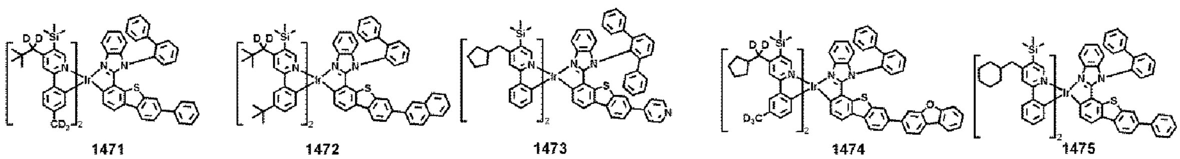
1471 1472 1473 1474 1475

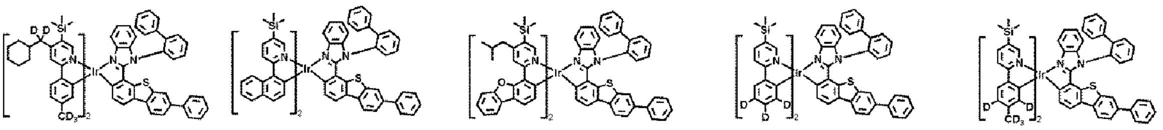
1476 1477 1478 1479 1480

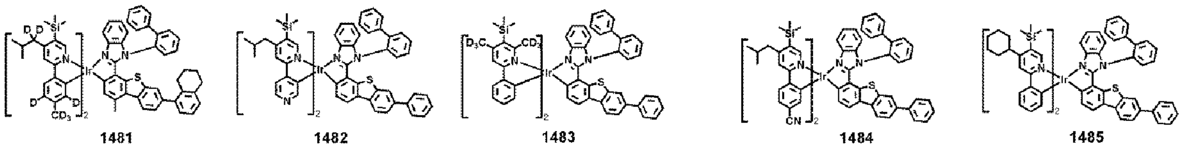
1481 1482 1483 1484 1485

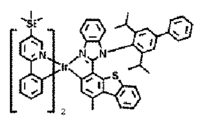
1486
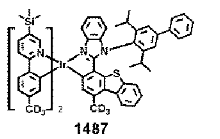
1487
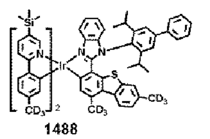
1488
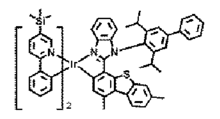
1489
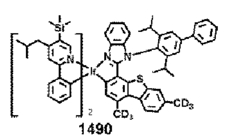
1490

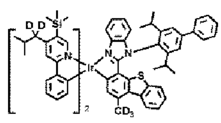
1491
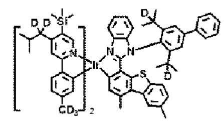
1492
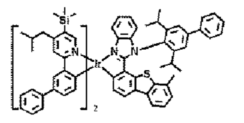
1493
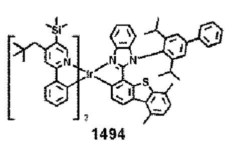
1494
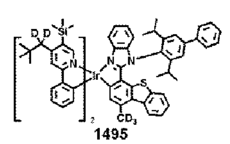
1495

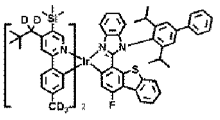
1496
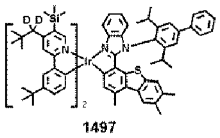
1497
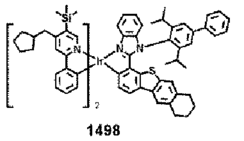
1498
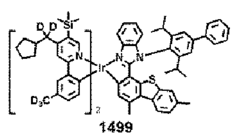
1499
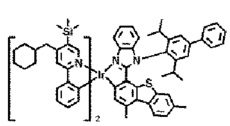
1500

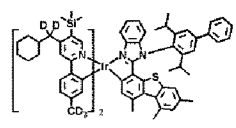
1501
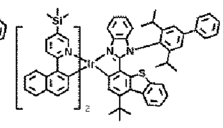
1502
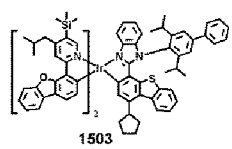
1503
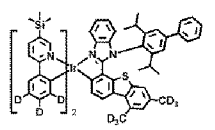
1504
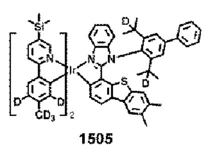
1505

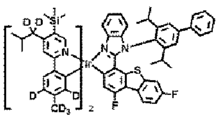
1506
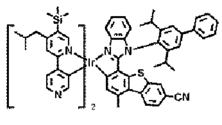
1507
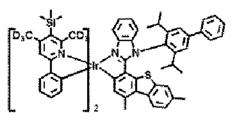
1508
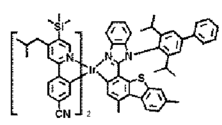
1509
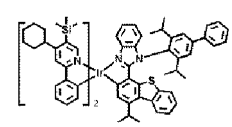
1510

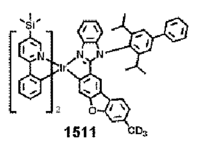
1511
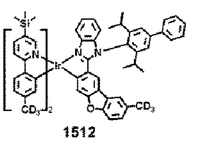
1512
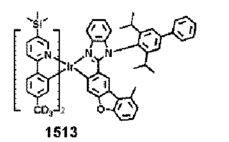
1513
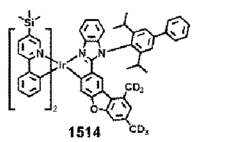
1514
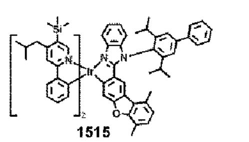
1515

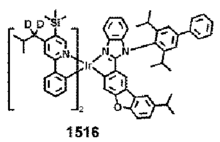
1516
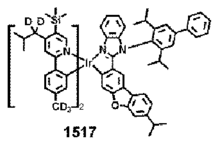
1517
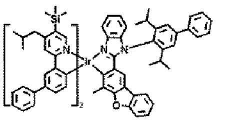
1518
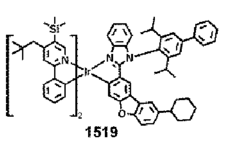
1519
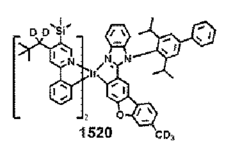
1520

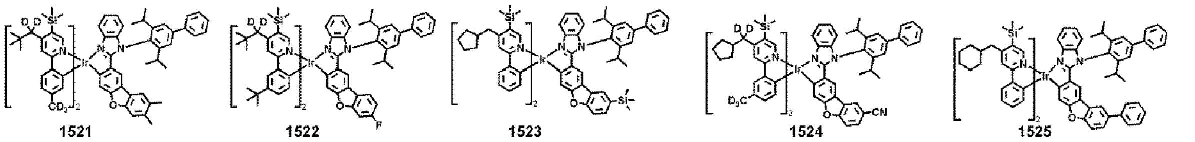
1521
1522
1523
1524
1525

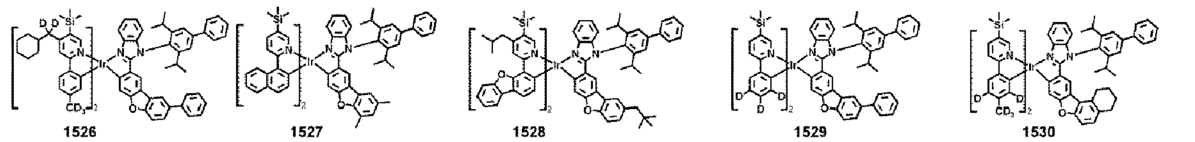
1526
1527
1528
1529
1530

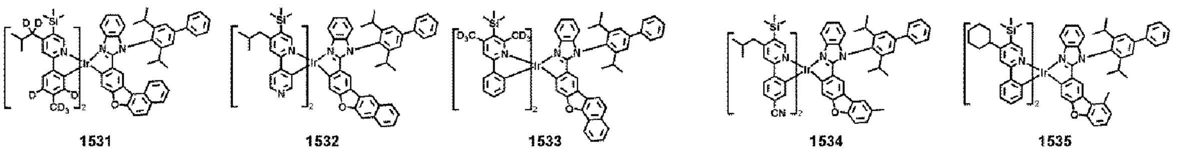
1531
1532
1533
1534
1535

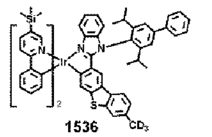
1536
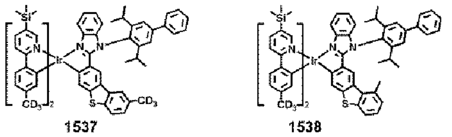
1537
1538
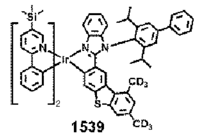
1539
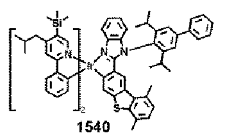
1540
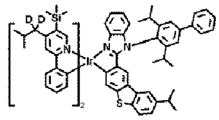
1541
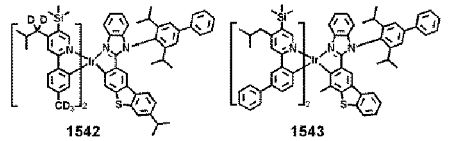
1542
1543
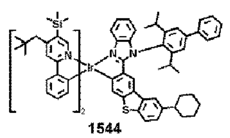
1544
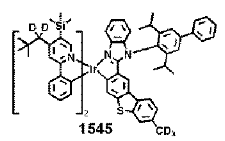
1545
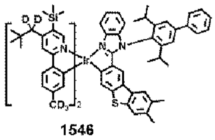
1546
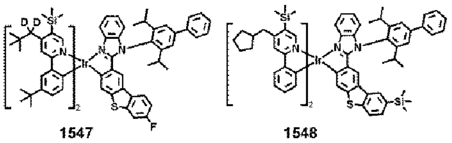
1547
1548
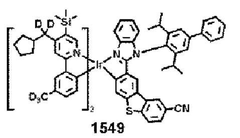
1549
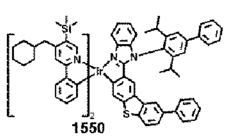
1550
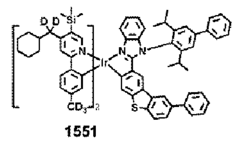
1551
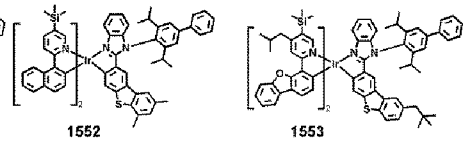
1552
1553
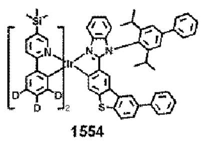
1554
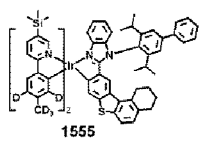
1555
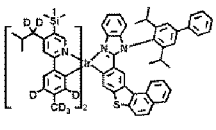
1556
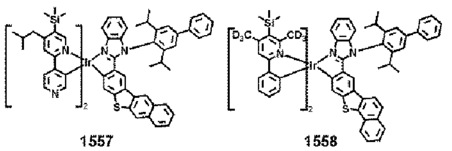
1557
1558
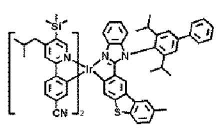
1559
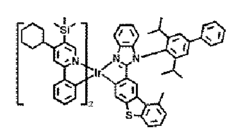
1560
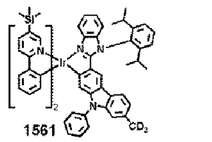
1561
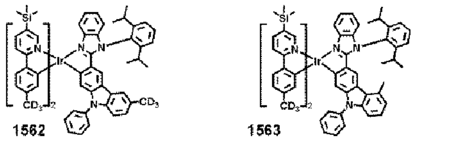
1562
1563
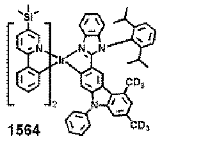
1564
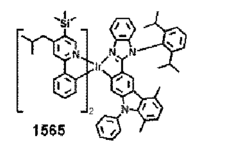
1565
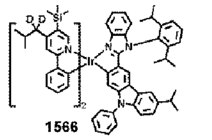
1566
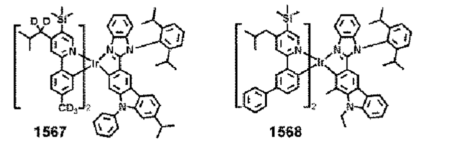
1567
1568
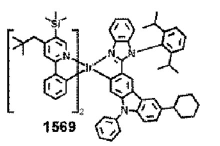
1569
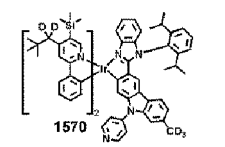
1570
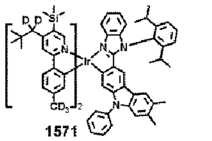
1571
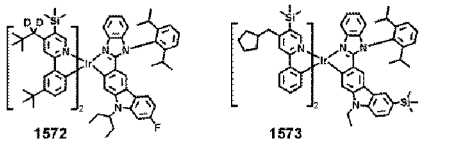
1572
1573
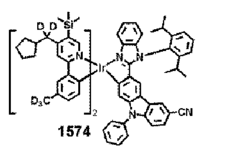
1574
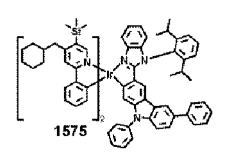
1575
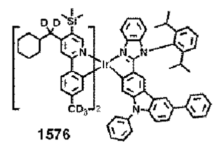
1576
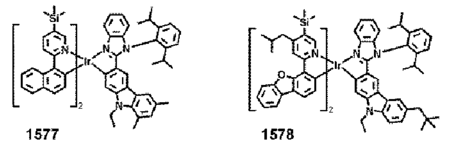
1577
1578
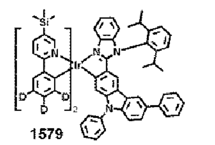
1579
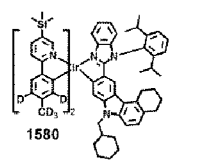
1580
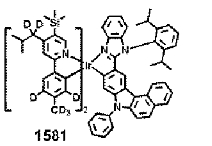
1581
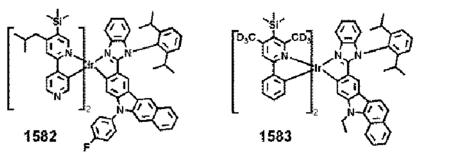
1582
1583
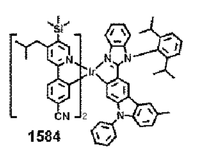
1584
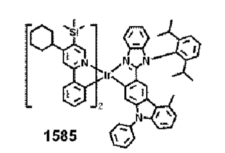
1585

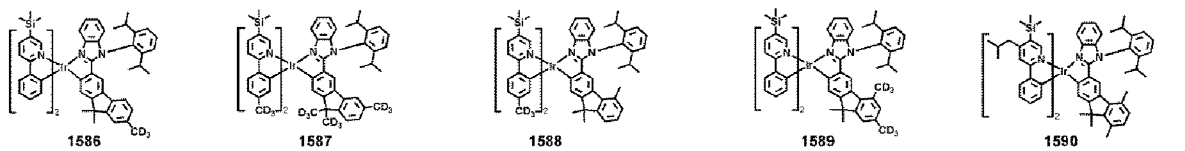
1586 1587 1588 1589 1590

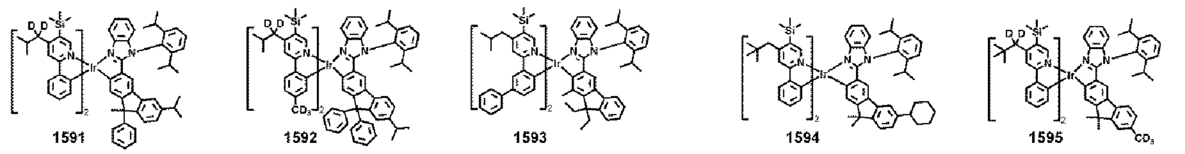
1591 1592 1593 1594 1595

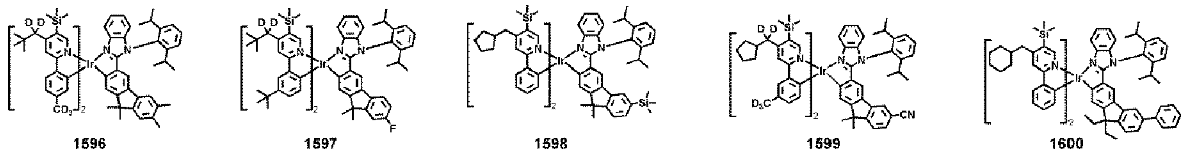
1596 1597 1598 1599 1600

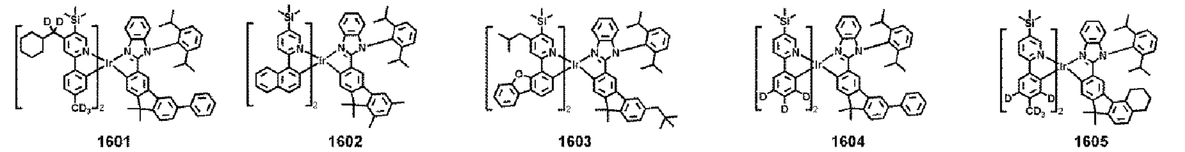
1601 1602 1603 1604 1605

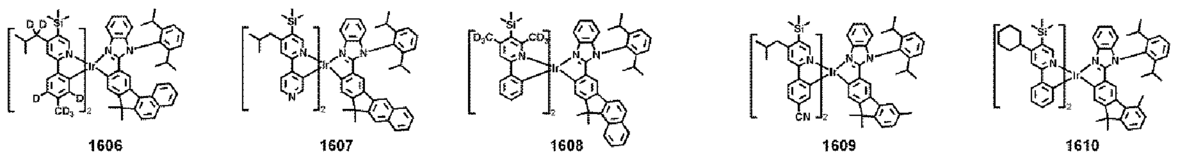
1606 1607 1608 1609 1610

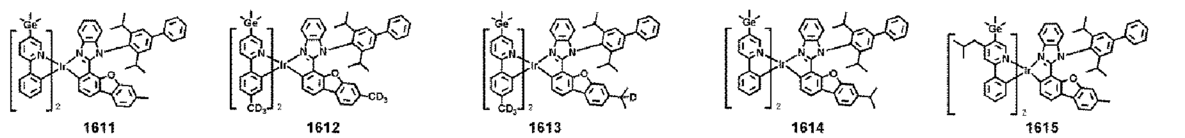
1611 1612 1613 1614 1615

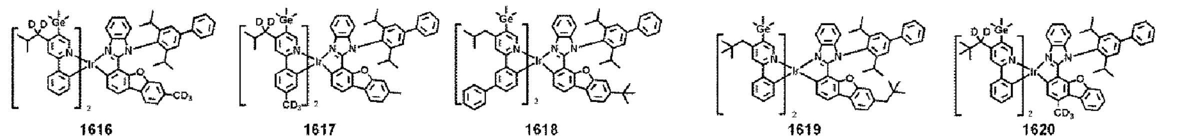
1616 1617 1618 1619 1620

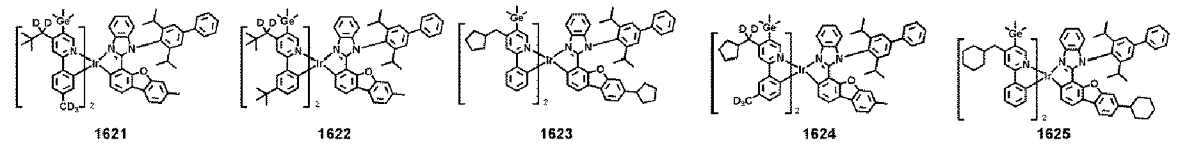
1621 1622 1623 1624 1625

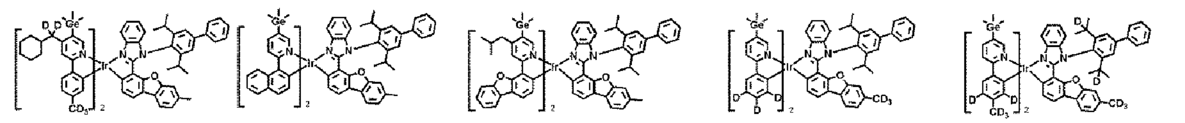
1626 1627 1628 1629 1630

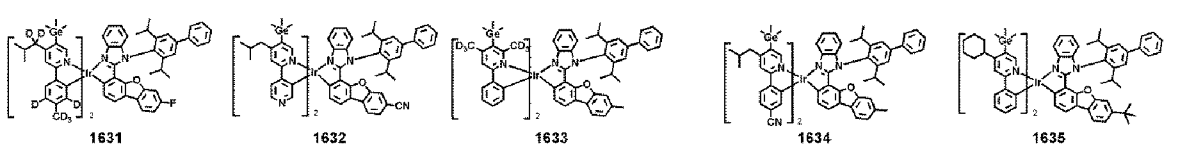
1631 1632 1633 1634 1635

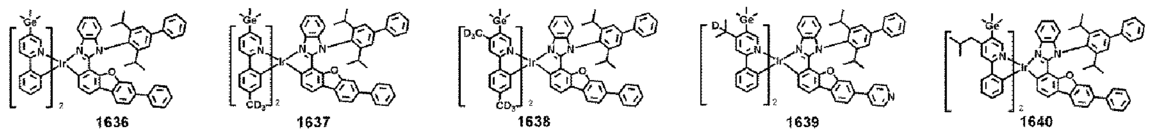

1636 1637 1638 1639 1640

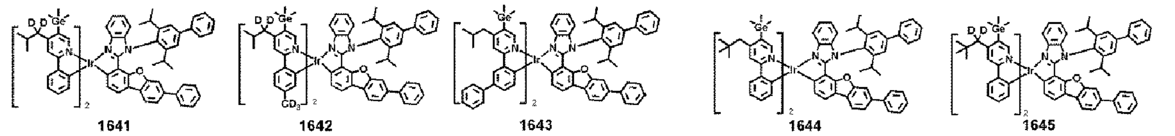

1641 1642 1643 1644 1645

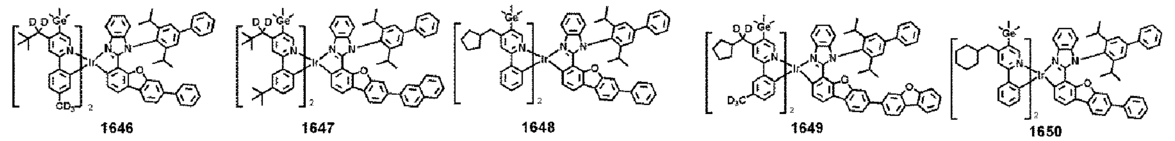

1646 1647 1648 1649 1650

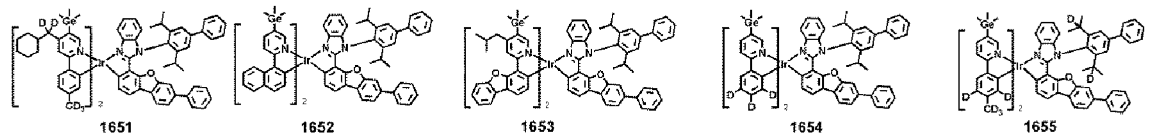

1651 1652 1653 1654 1655

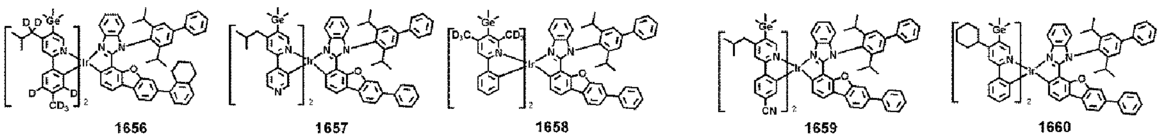

1656 1657 1658 1659 1660

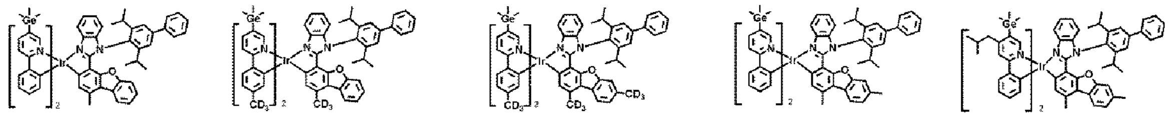

1661 1662 1663 1664 1665

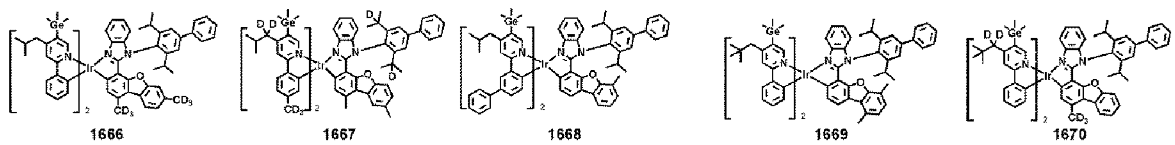

1666 1667 1668 1669 1670

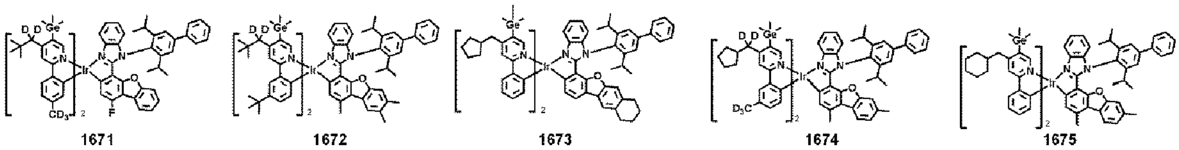

1671 1672 1673 1674 1675

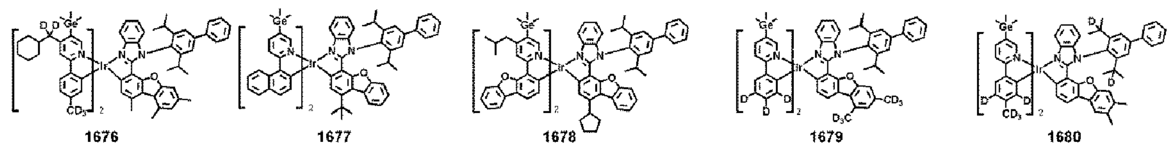

1676 1677 1678 1679 1680

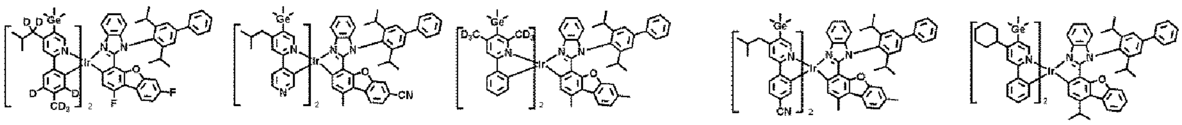

1681 1682 1683 1684 1685

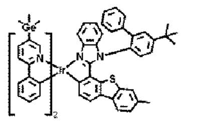
1686
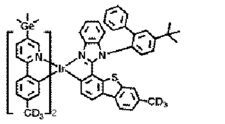
1687
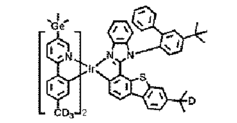
1688
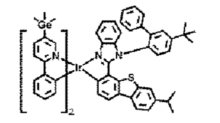
1689
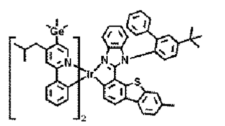
1690

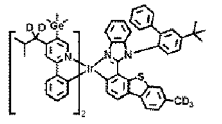
1691
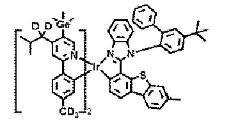
1692
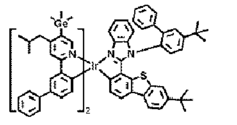
1693
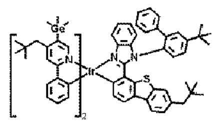
1694
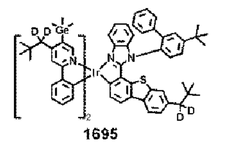
1695

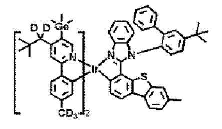
1696
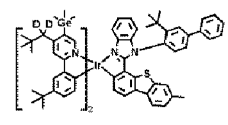
1697
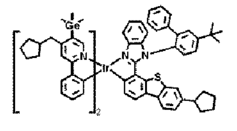
1698
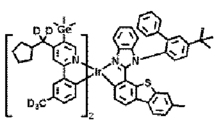
1699
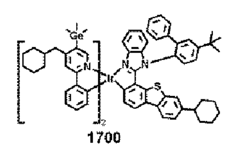
1700

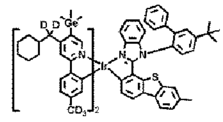
1701
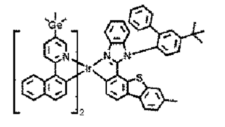
1702
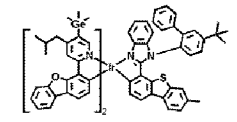
1703
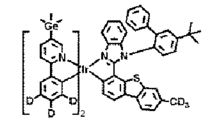
1704
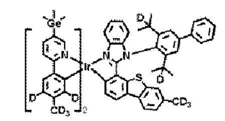
1705

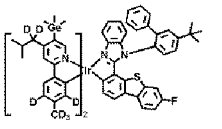
1706
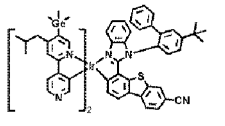
1707
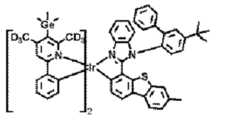
1708
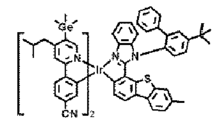
1709
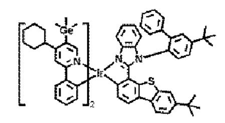
1710

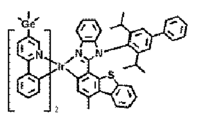
1711
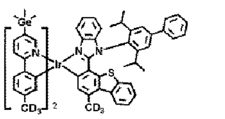
1712
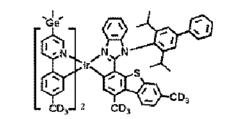
1713
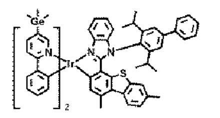
1714
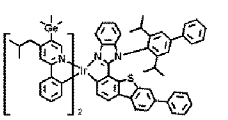
1715

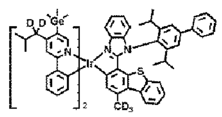
1716
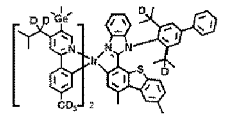
1717
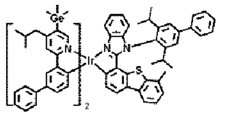
1718
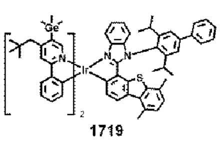
1719
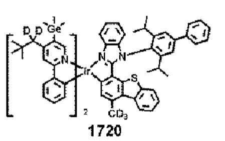
1720

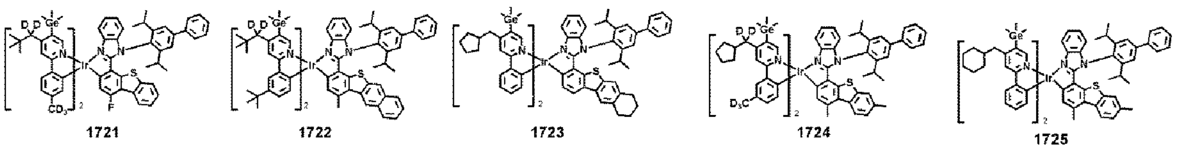
1721
1722
1723
1724
1725

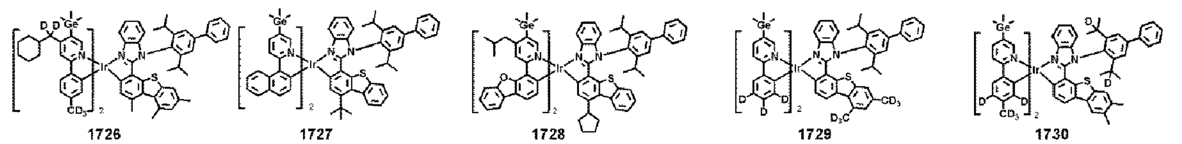
1726
1727
1728
1729
1730

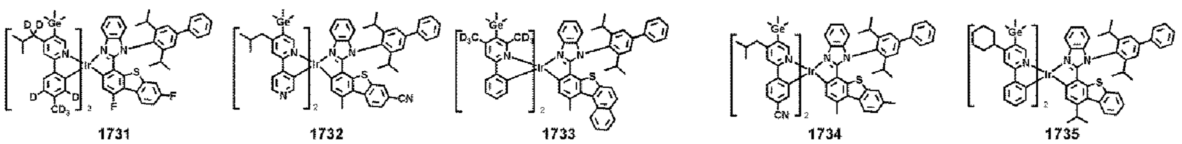
1731
1732
1733
1734
1735

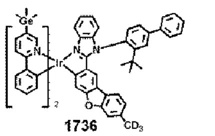
1736
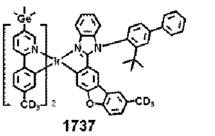
1737
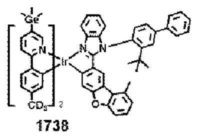
1738
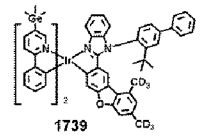
1739
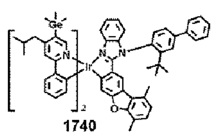
1740
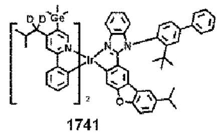
1741
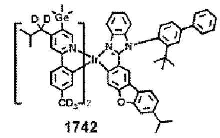
1742
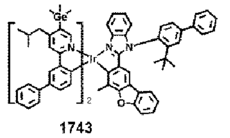
1743
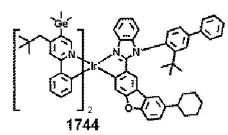
1744
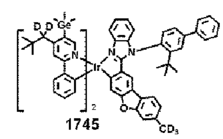
1745
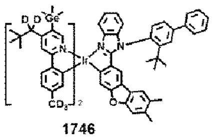
1746
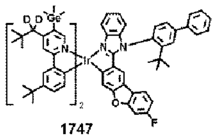
1747
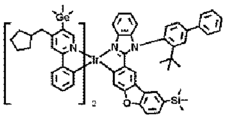
1748
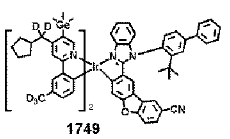
1749
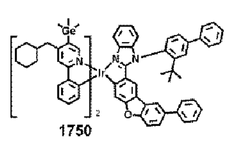
1750
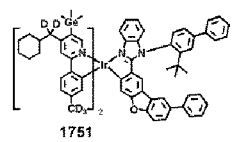
1751
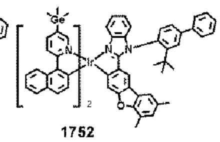
1752
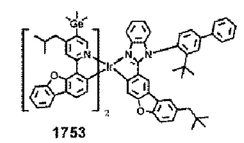
1753
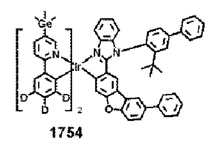
1754
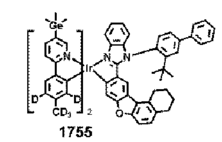
1755
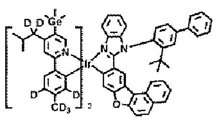
1756
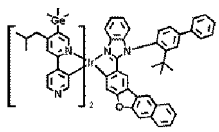
1757
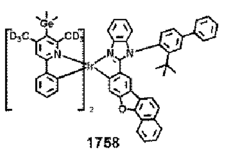
1758
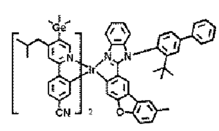
1759
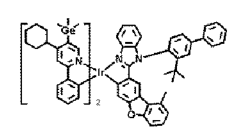
1760
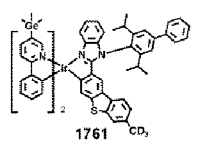
1761
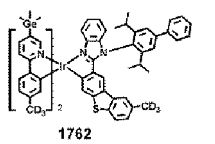
1762
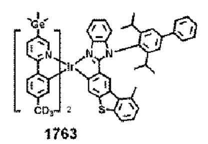
1763
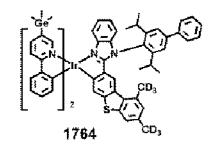
1764
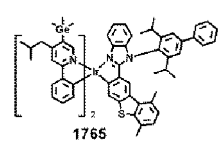
1765
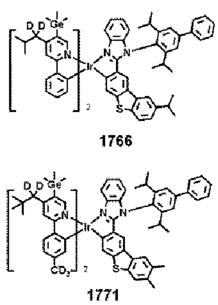
1766
1771
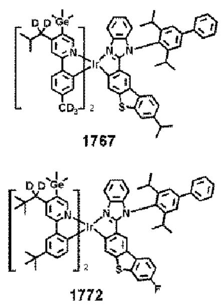
1767
1772
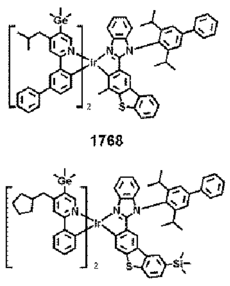
1768
1773
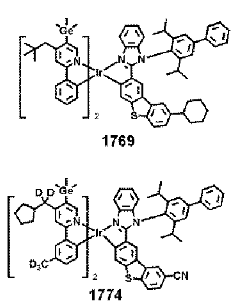
1769
1774
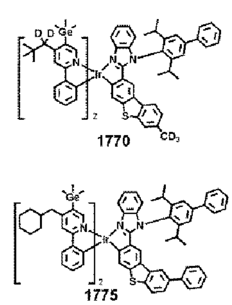
1770
1775
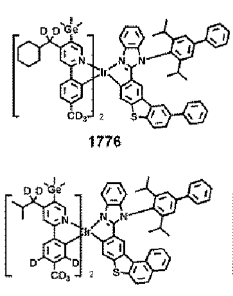
1776
1781
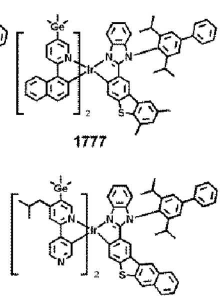
1777
1782
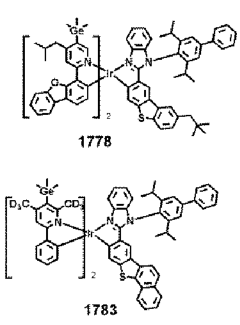
1778
1783
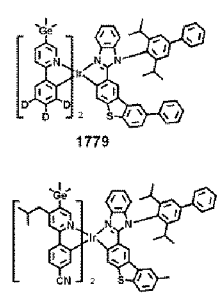
1779
1784
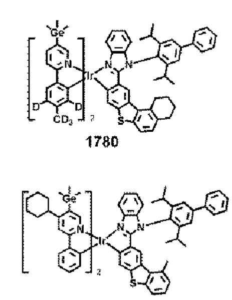
1780
1785

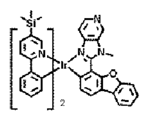
1786

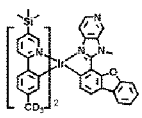
1787

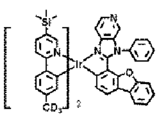
1788

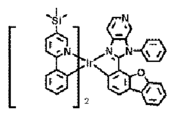
1789

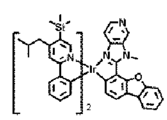
1790

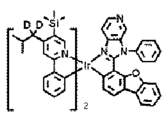
1791

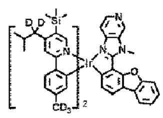
1792

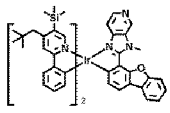
1793

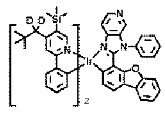
1794

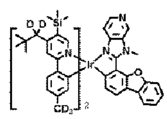
1795

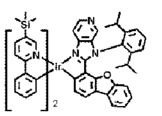
1796

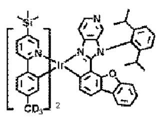
1797

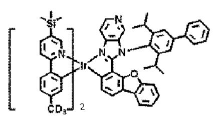
1798

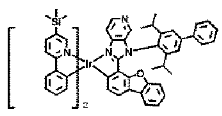
1799

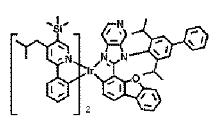
1800

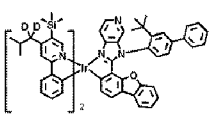
1801

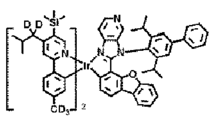
1802

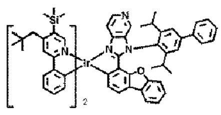
1803

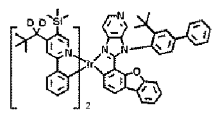
1804

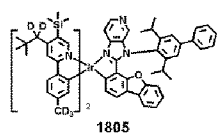
1805

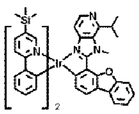
1806

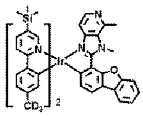
1807

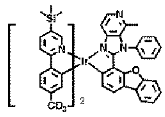
1808

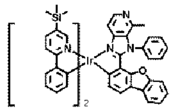
1809

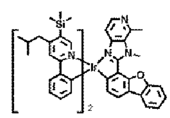
1810

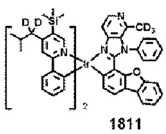
1811

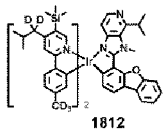
1812

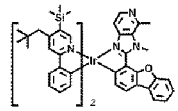
1813

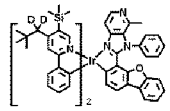
1814

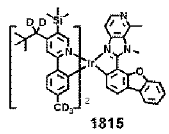
1815

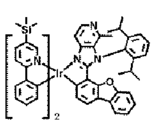
1816

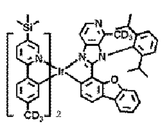
1817

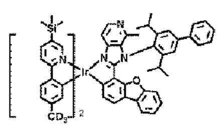
1818

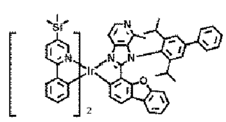
1819

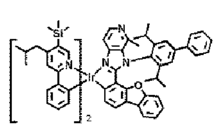
1820

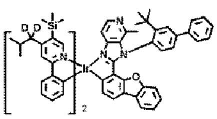
1821

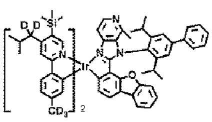
1822

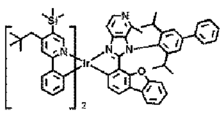
1823

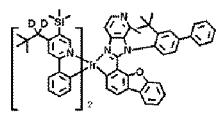
1824

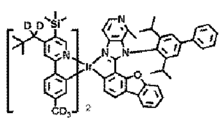
1825

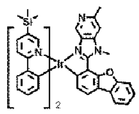
1826

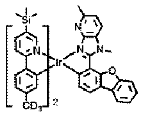
1827

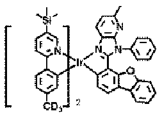
1828

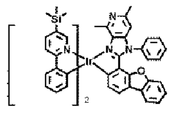
1829

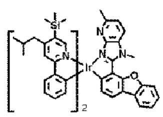
1830

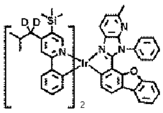
1831

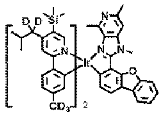
1832

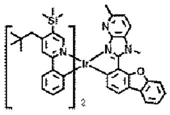
1833

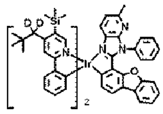
1834

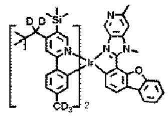
1835

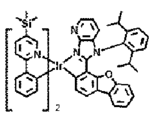
1836

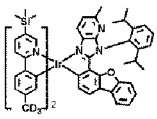
1837

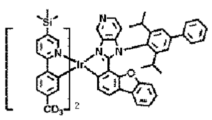
1838

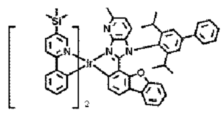
1839

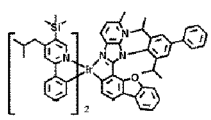
1840

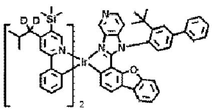
1841

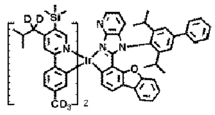
1842

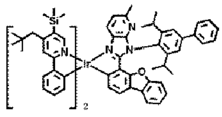
1843

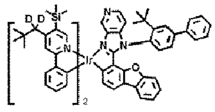
1844

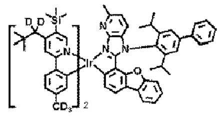
1845

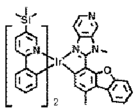
1846

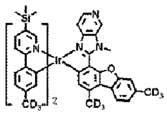
1847

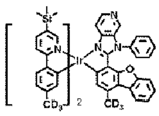
1848

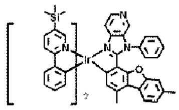
1849

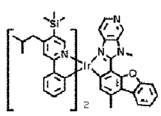
1850

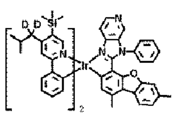
1851

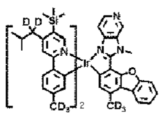
1852

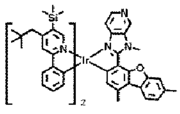
1853

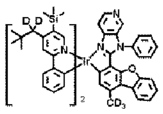
1854

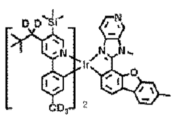
1855

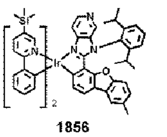
1856

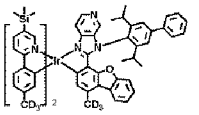
1857

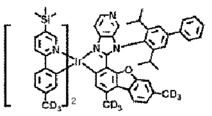
1858

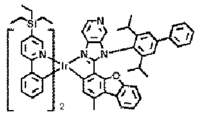
1859

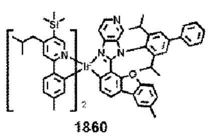
1860

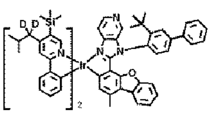
1861

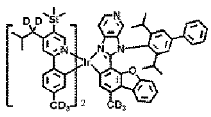
1862

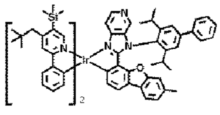
1863

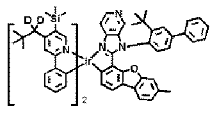
1864

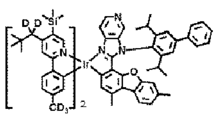
1865

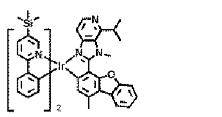
1866

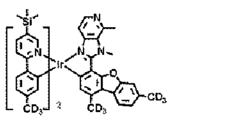
1867

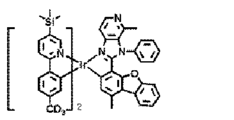
1868

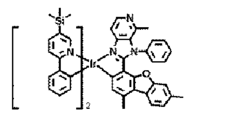
1869

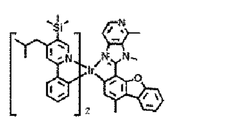
1870

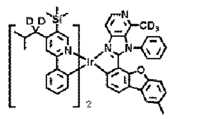
1871

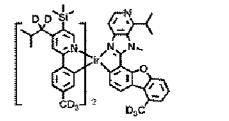
1872

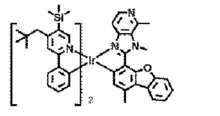
1873

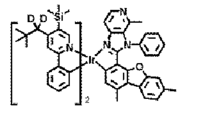
1874

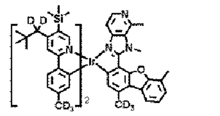
1875

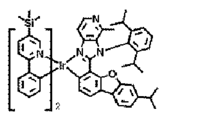
1876

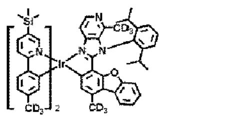
1877

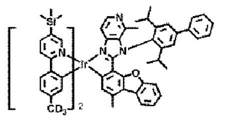
1878

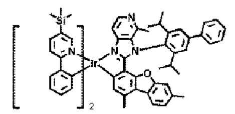
1879

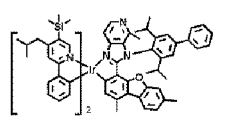
1880

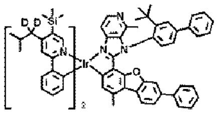
1881

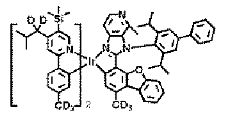
1882

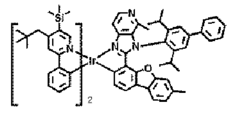
1883

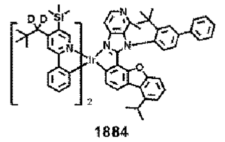
1884

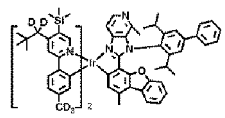
1885

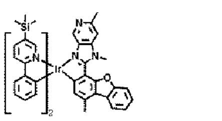
1886

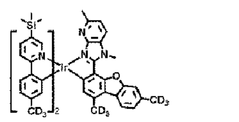
1887

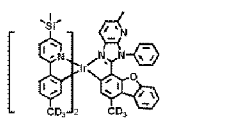
1888

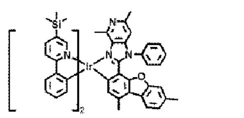
1889

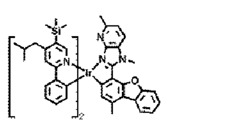
1890

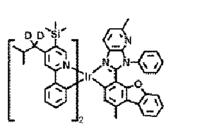
1891

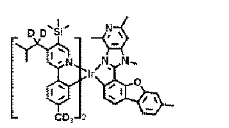
1892

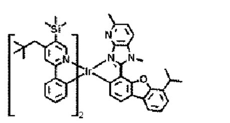
1893

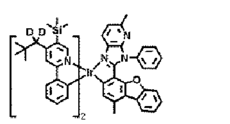
1894

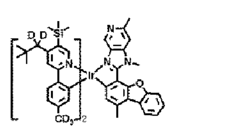
1895

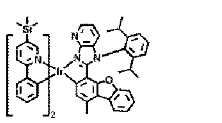
1896

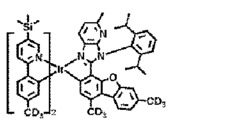
1897

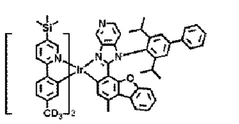
1898

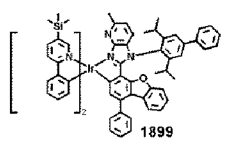
1899

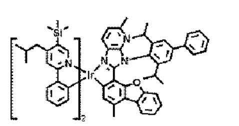
1900

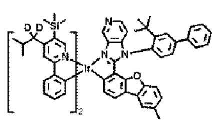
1901

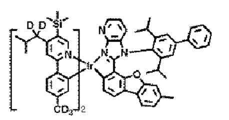
1902

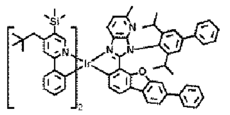
1903

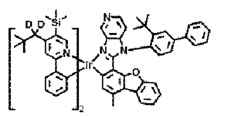
1904

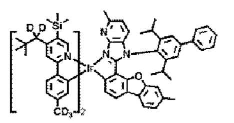
1905

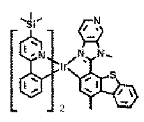
1906

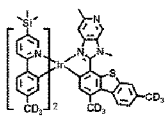
1907

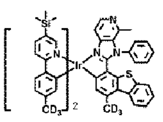
1908

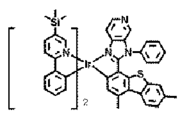
1909

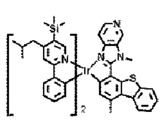
1910

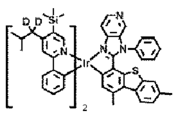
1911

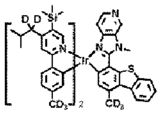
1912

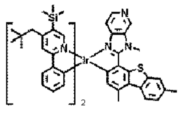
1913

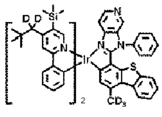
1914

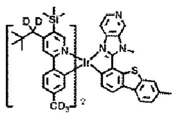
1915

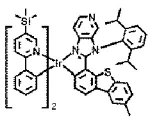
1916

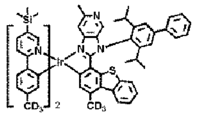
1917

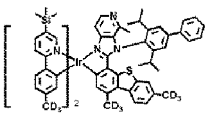
1918

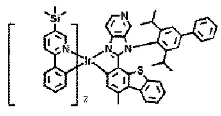
1919

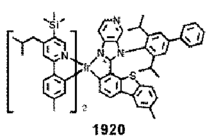
1920

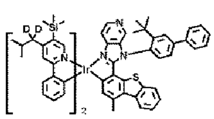
1921

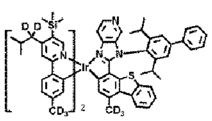
1922

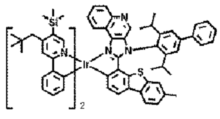
1923

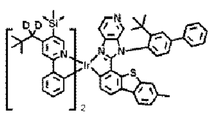
1924

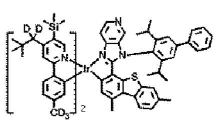
1925

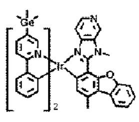
1926

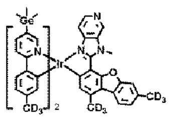
1927

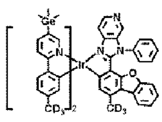
1928

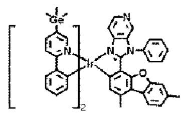
1929

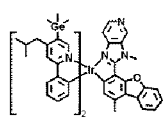
1930

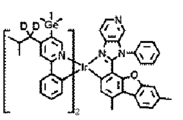
1931

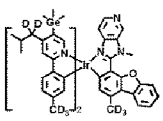
1932

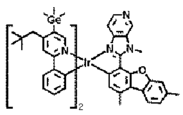
1933

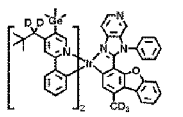
1934

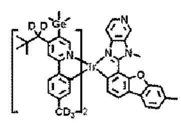
1935

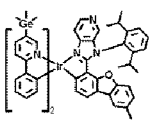
1936

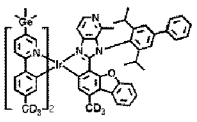
1937

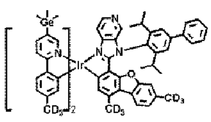
1938

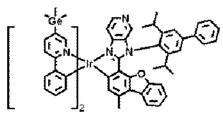
1939

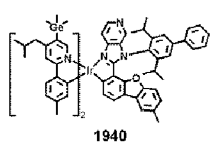
1940

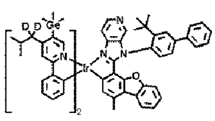
1941

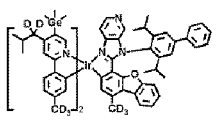
1942

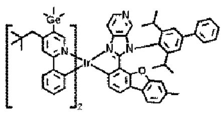
1943

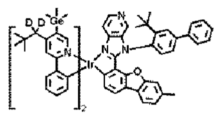
1944

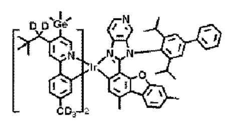
1945

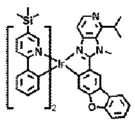
1946
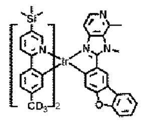
1947
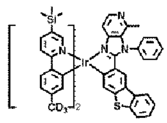
1948
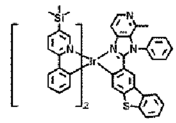
1949
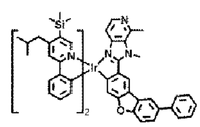
1950

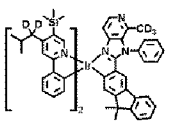
1951
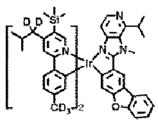
1952
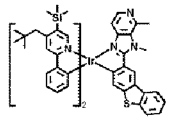
1953
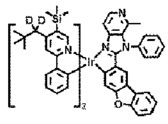
1954
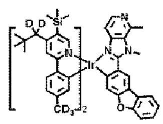
1955

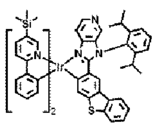
1956
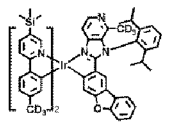
1957
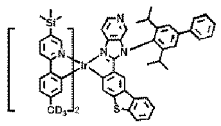
1958
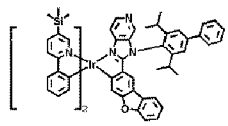
1959
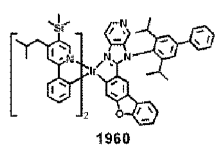
1960

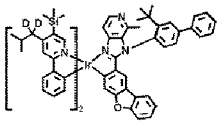
1961
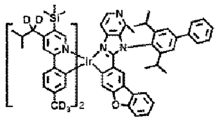
1962
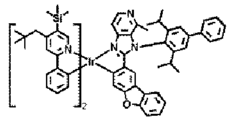
1963
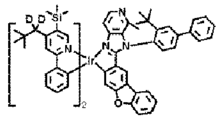
1964
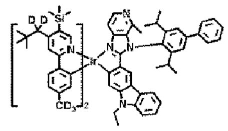
1965

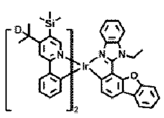
1966
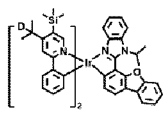
1967
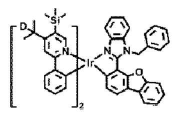
1968
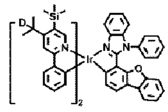
1969
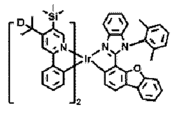
1970

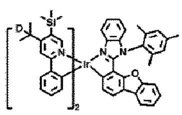
1971
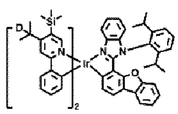
1972
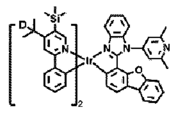
1973
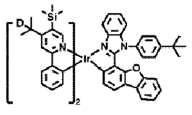
1974
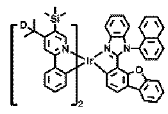
1975

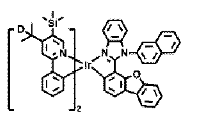
1976
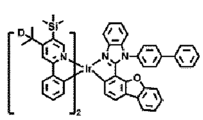
1977
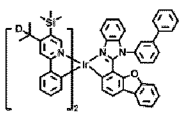
1978
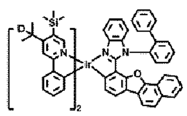
1979
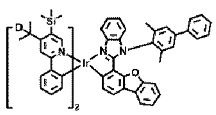
1980

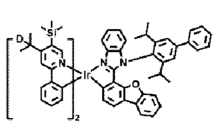
1981
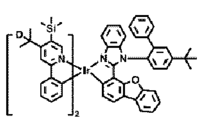
1982
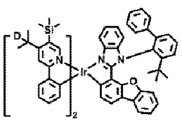
1983
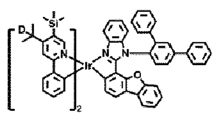
1984
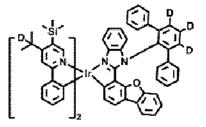
1985

1986
1987
1988
1989
1990

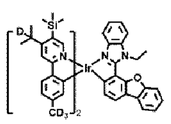
1991
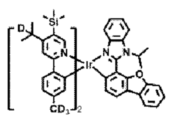
1992
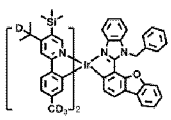
1993
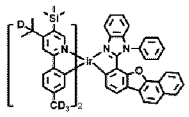
1994
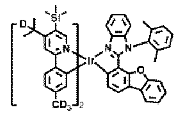
1995
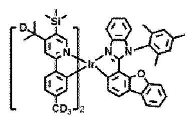
1996
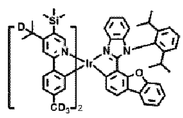
1997
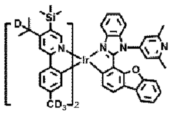
1998
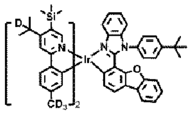
1999
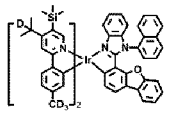
2000
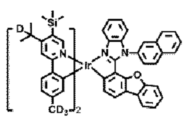
2001
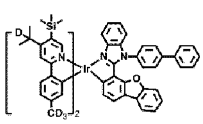
2002
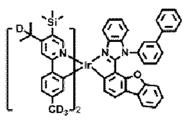
2003
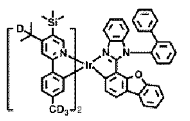
2004
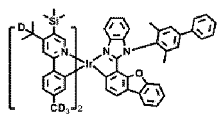
2005
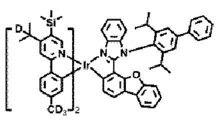
2006
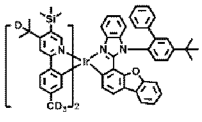
2007
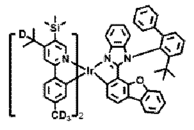
2008
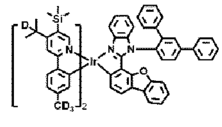
2009
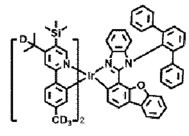
2010
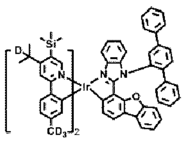
2011
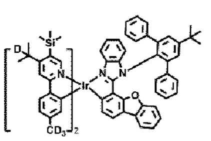
2012
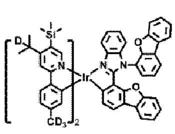
2013
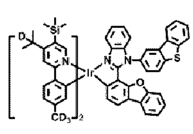
2014
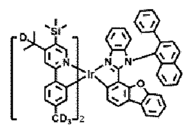
2015
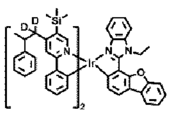
2016
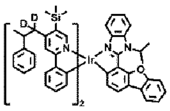
2017
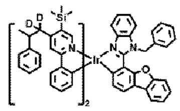
2018
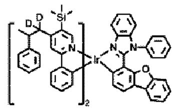
2019
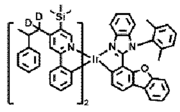
2020
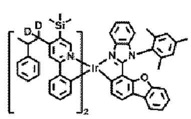
2021
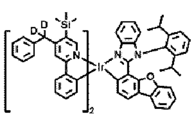
2022
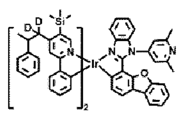
2023
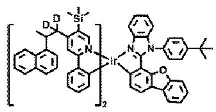
2024
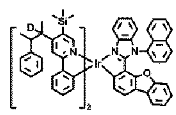
2025
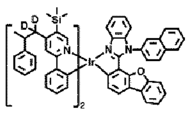
2026
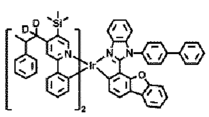
2027
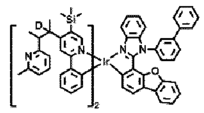
2028
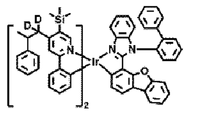
2029
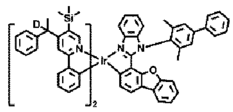
2030
2031
2032
2033
2034
2035
2036
2037
2038
2039
2040

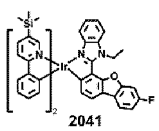
2041
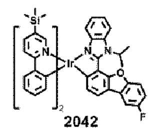
2042
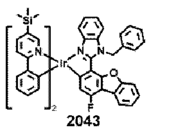
2043
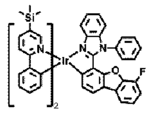
2044
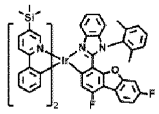
2045

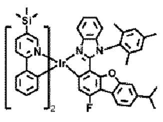
2046
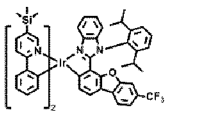
2047
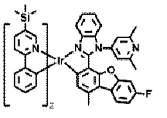
2048
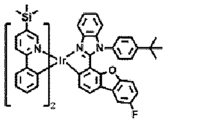
2049
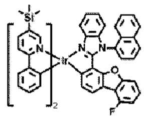
2050

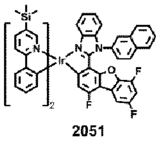
2051
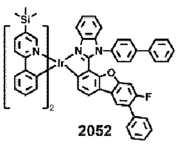
2052
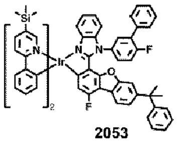
2053
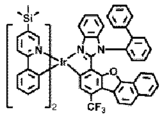
2054
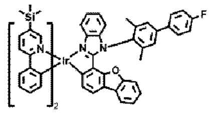
2055

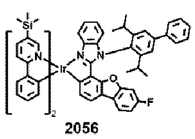
2056
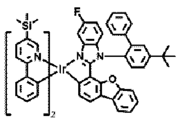
2057
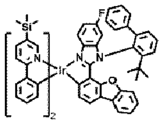
2058
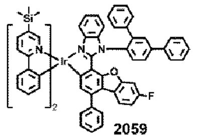
2059
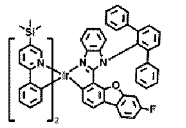
2060

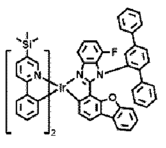
2061
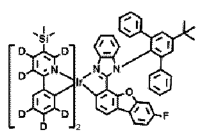
2062
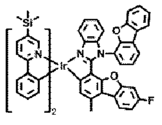
2063
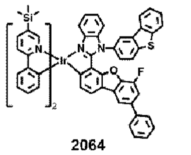
2064
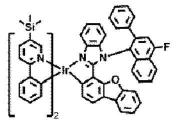
2065

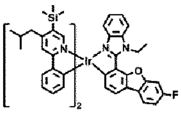
2066
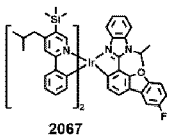
2067
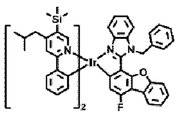
2068
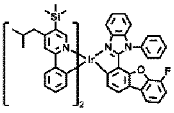
2069
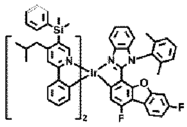
2070

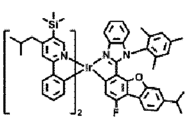
2071
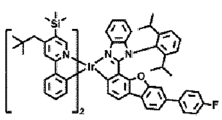
2072
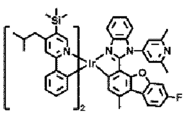
2073
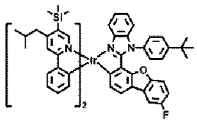
2074
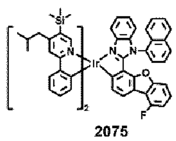
2075

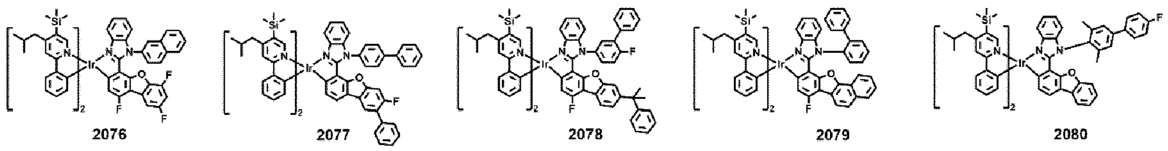
2076 2077 2078 2079 2080

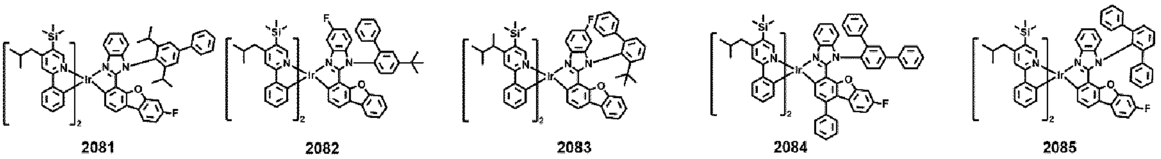
2081 2082 2083 2084 2085

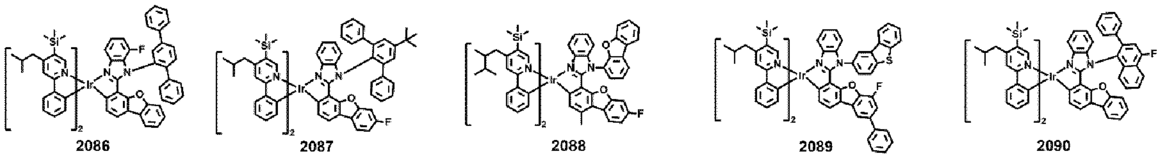
2086 2087 2088 2089 2090

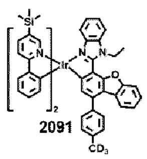
2091

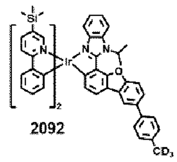
2092

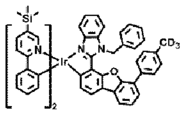
2093

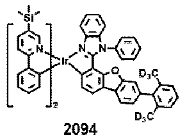
2094

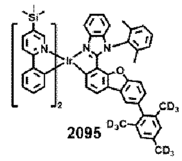
2095

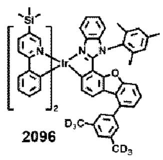
2096

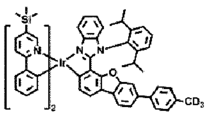
2097

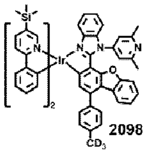
2098

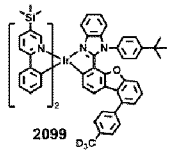
2099

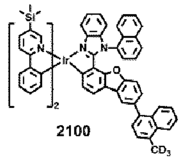
2100

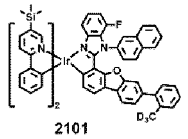
2101

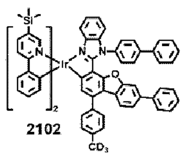
2102

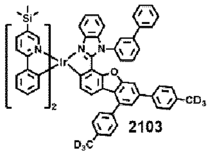
2103

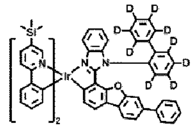
2104

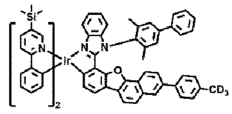
2105

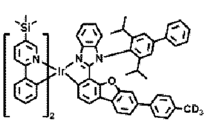
2106

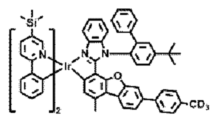
2107

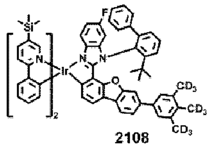
2108

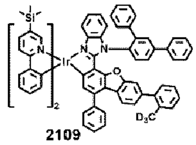
2109

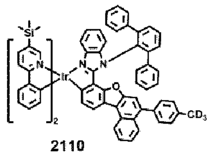
2110

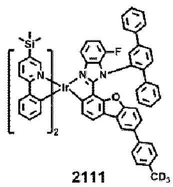
2111

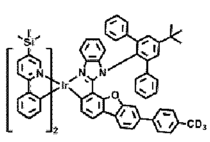
2112

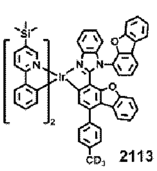
2113

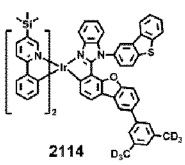
2114

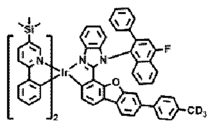
2115

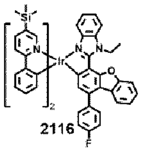
2116

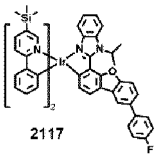
2117

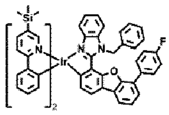
2118

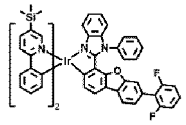
2119

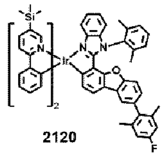
2120

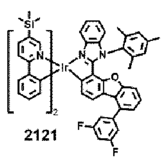
2121

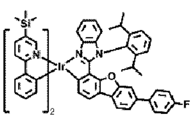
2122

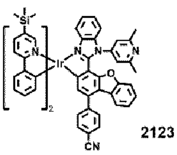
2123

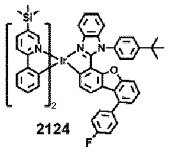
2124

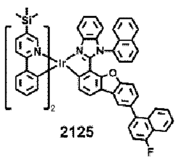
2125

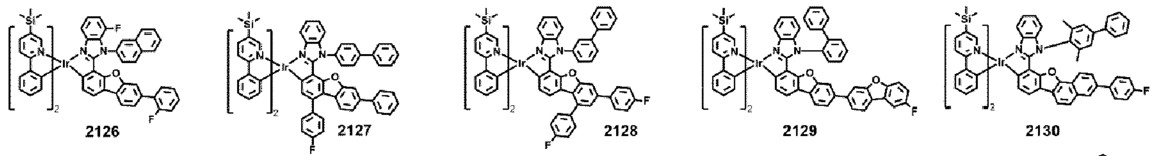
2126 2127 2128 2129 2130

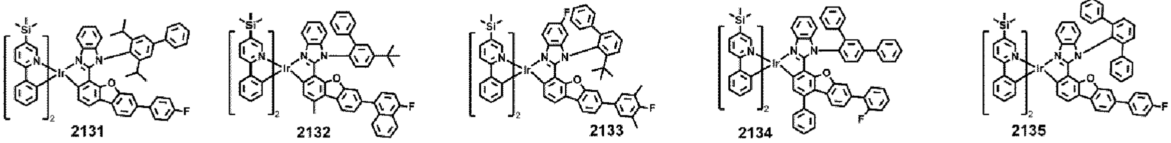
2131 2132 2133 2134 2135

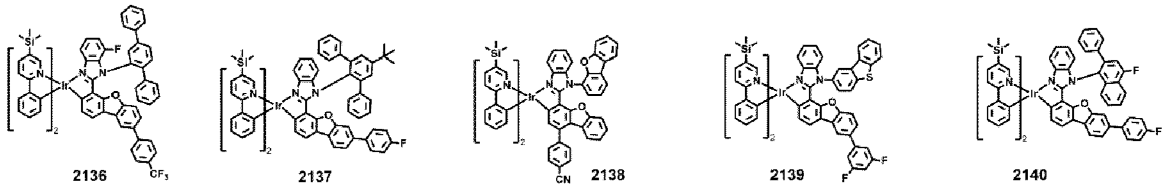
2136 2137 2138 2139 2140

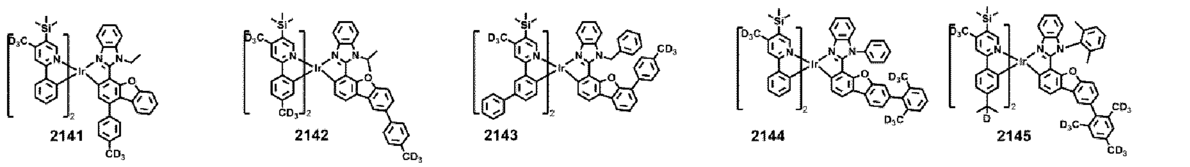

2141 2142 2143 2144 2145

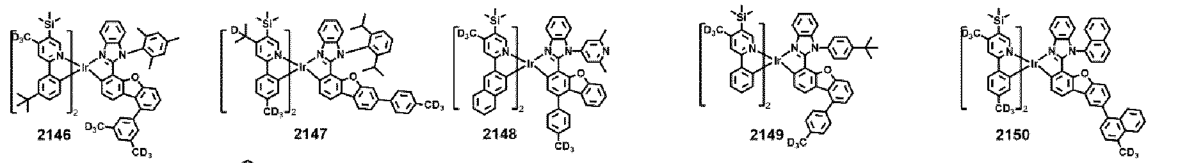

2146 2147 2148 2149 2150

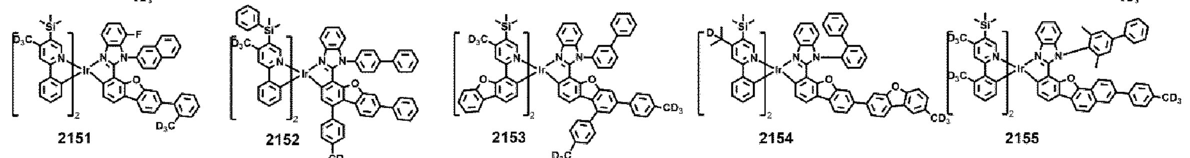

2151 2152 2153 2154 2155

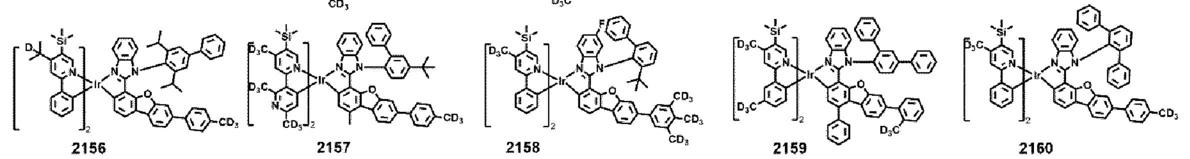

2156 2157 2158 2159 2160

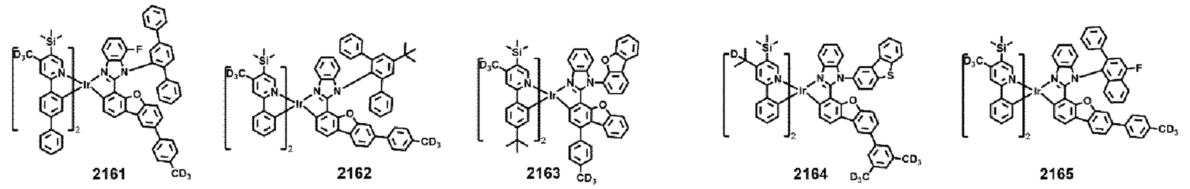

2161 2162 2163 2164 2165

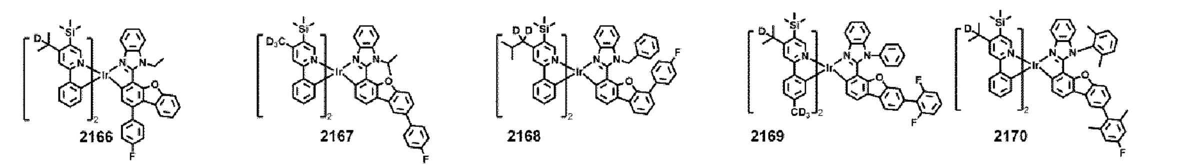

2166 2167 2168 2169 2170

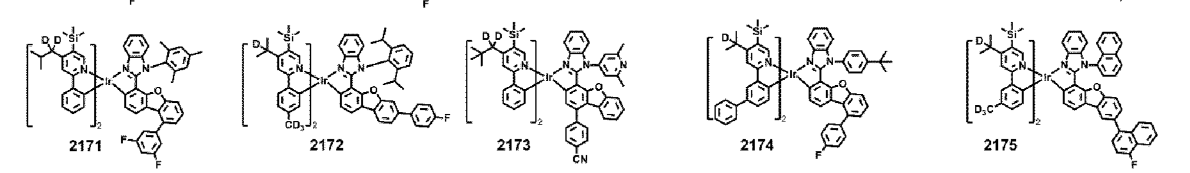

2171 2172 2173 2174 2175

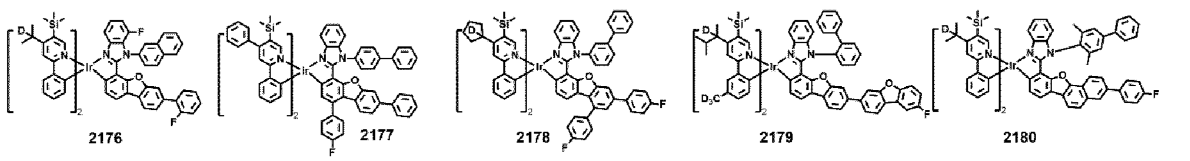

2176 2177 2178 2179 2180

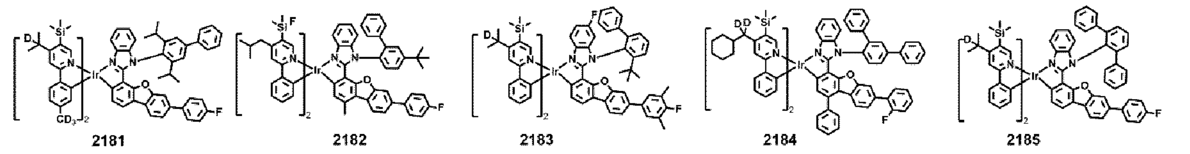

2181 2182 2183 2184 2185

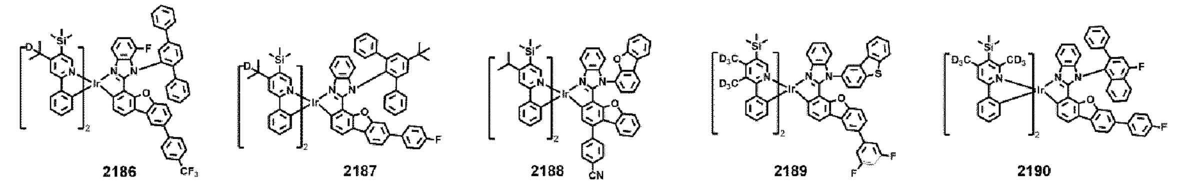

2186 2187 2188 2189 2190

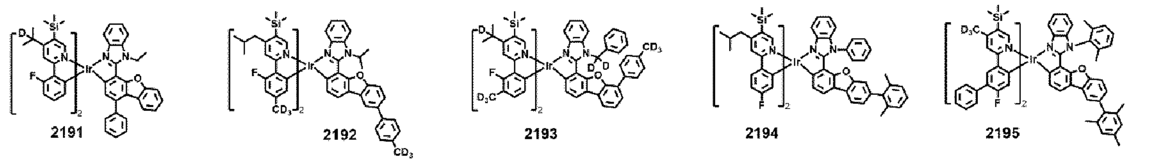

2191 2192 2193 2194 2195

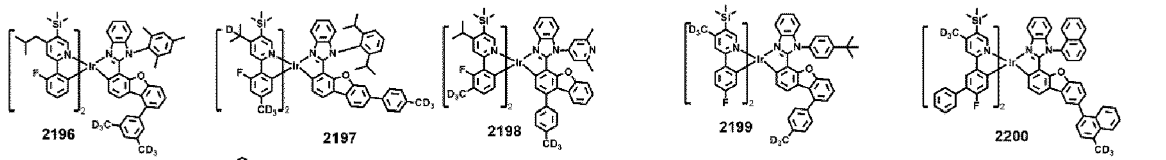

2196 2197 2198 2199 2200

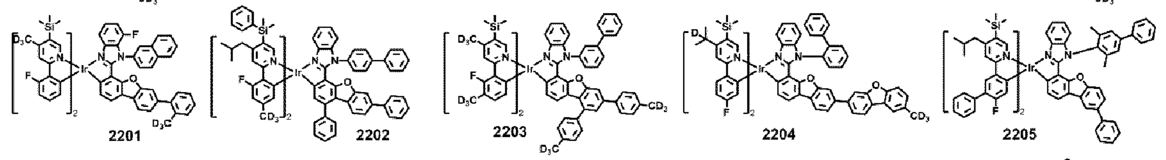

2201 2202 2203 2204 2205

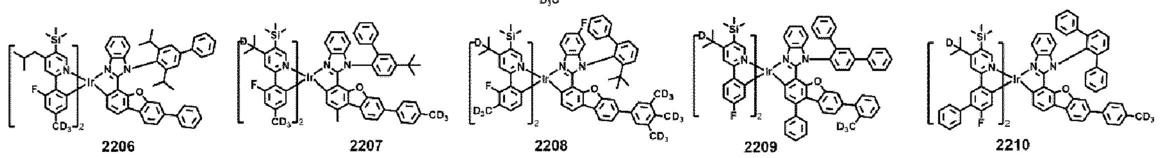

2206 2207 2208 2209 2210

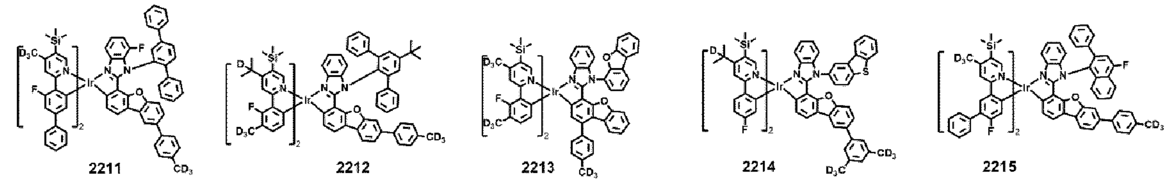

2211 2212 2213 2214 2215

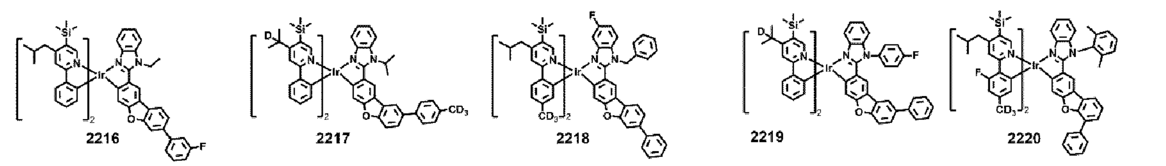

2216 2217 2218 2219 2220

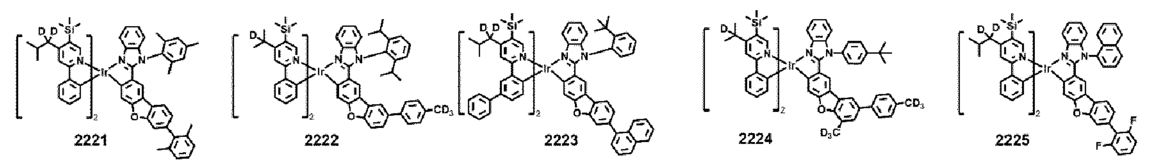

2221 2222 2223 2224 2225

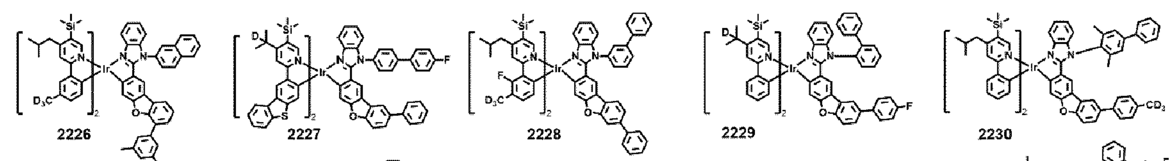

2226 2227 2228 2229 2230

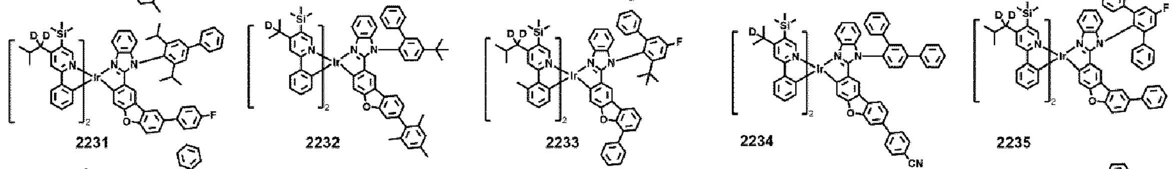

2231 2232 2233 2234 2235

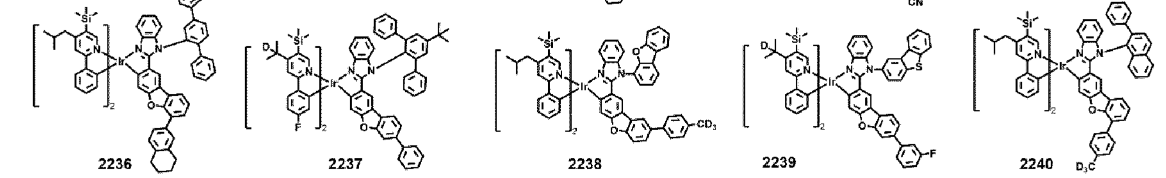

2236 2237 2238 2239 2240

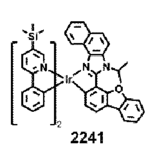
2241
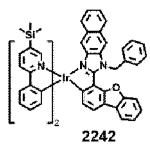
2242
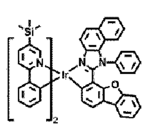
2243
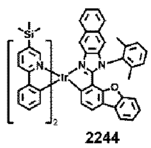
2244
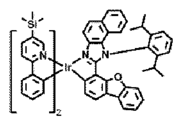
2245

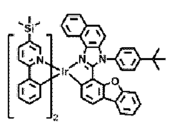
2246
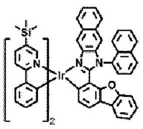
2247
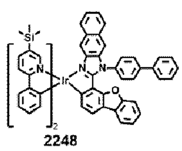
2248
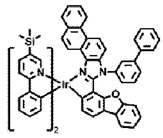
2249
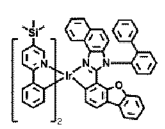
2250

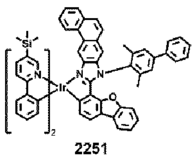
2251
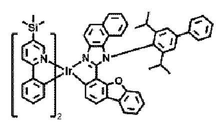
2252
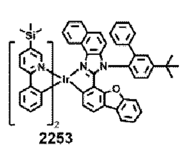
2253
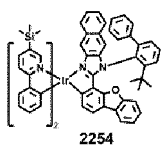
2254
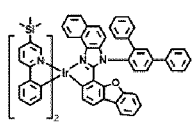
2255

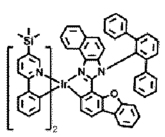
2256
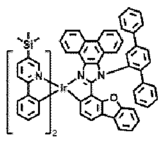
2257
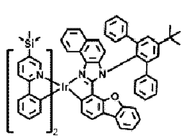
2258
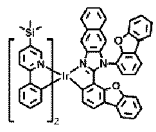
2259
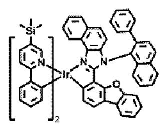
2260

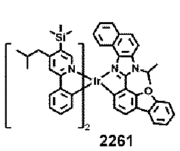
2261
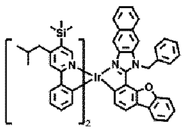
2262
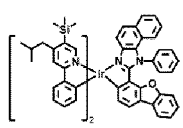
2263
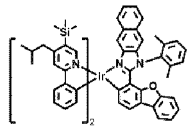
2264
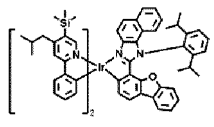
2265

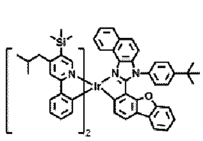
2266
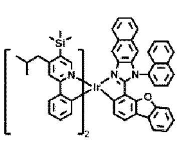
2267
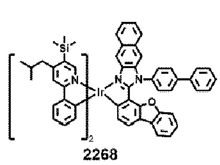
2268
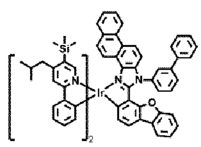
2269
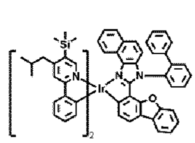
2270

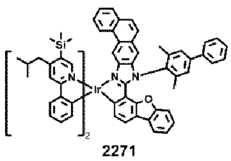
2271
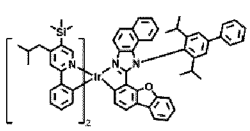
2272
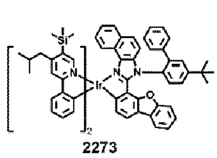
2273
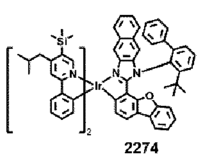
2274
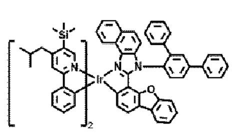
2275

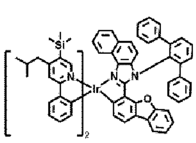
2276
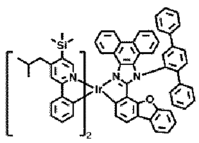
2277
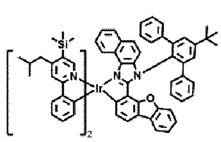
2278
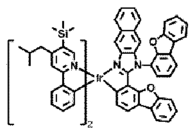
2279
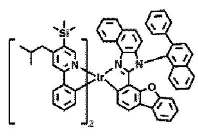
2280

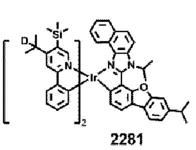
2281

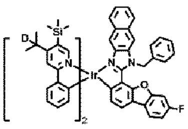
2282

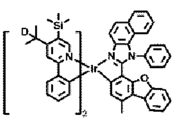
2283

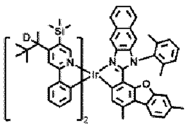
2284

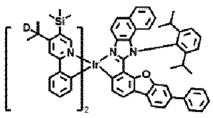
2285

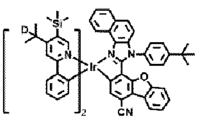
2286

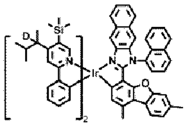
2287

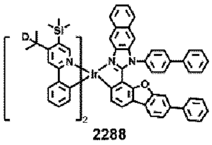
2288

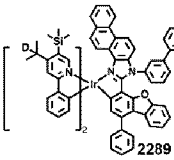
2289

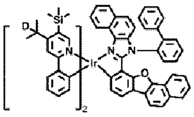
2290

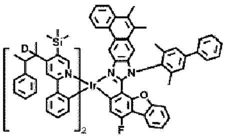
2291

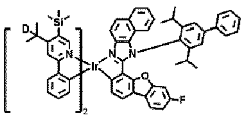
2292

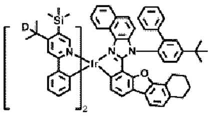
2293

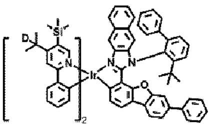
2294

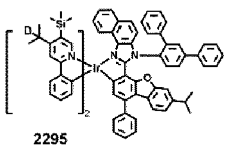
2295

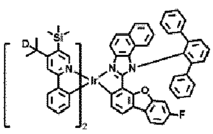
2296

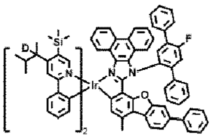
2297

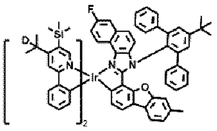
2298

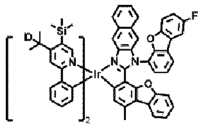
2299

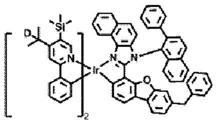
2300

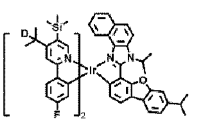
2301

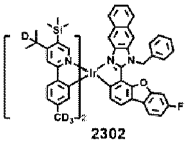
2302

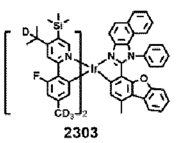
2303

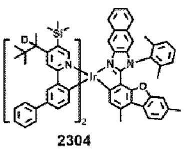
2304

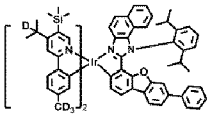
2305

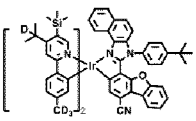
2306

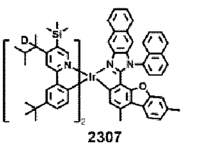
2307

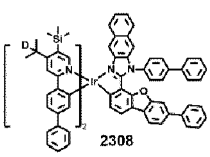
2308

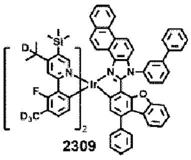
2309

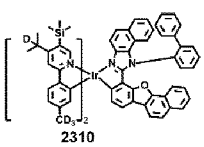
2310

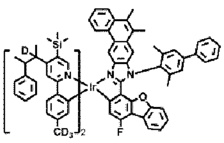
2311

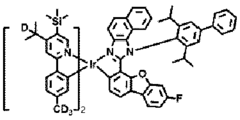
2312

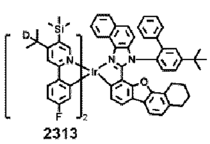
2313

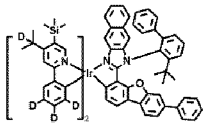
2314

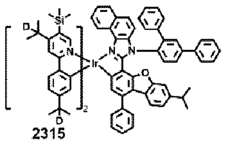
2315

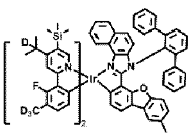
2316

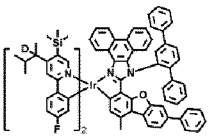
2317

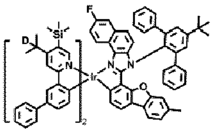
2318

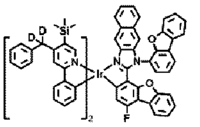
2319

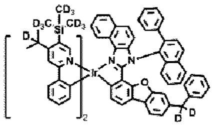
2320

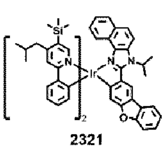
2321
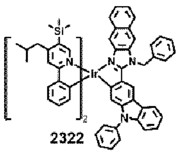
2322
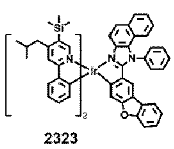
2323
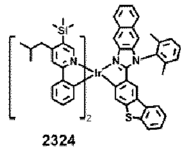
2324
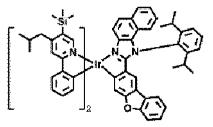
2325

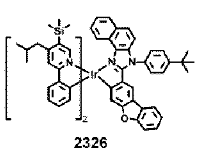
2326
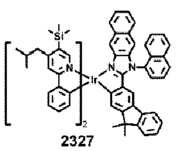
2327
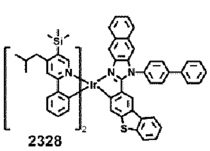
2328
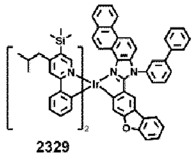
2329
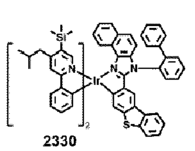
2330

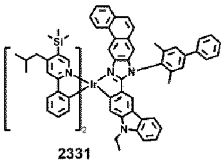
2331
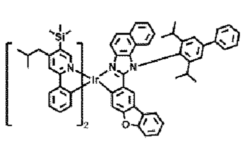
2332
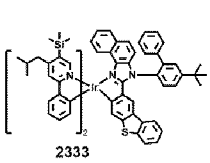
2333
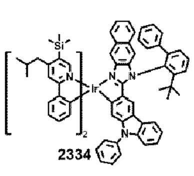
2334
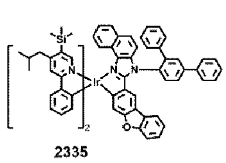
2335

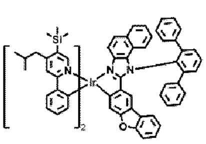
2336
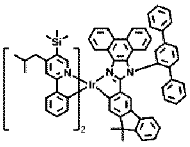
2337
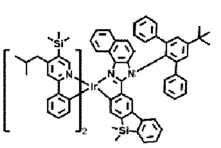
2338
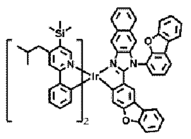
2339
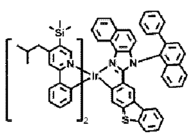
2340

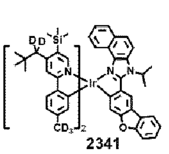
2341
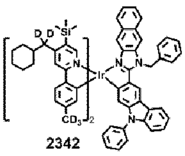
2342
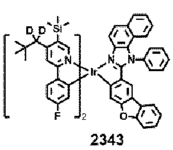
2343
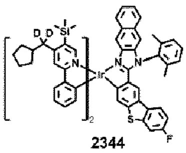
2344
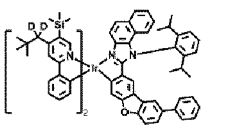
2345

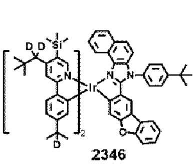
2346
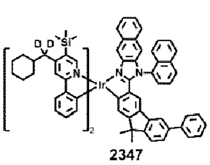
2347
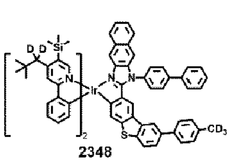
2348
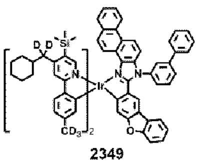
2349
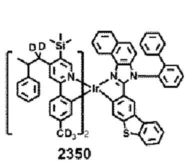
2350

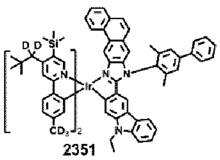
2351
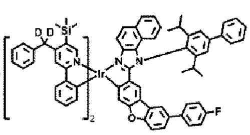
2352
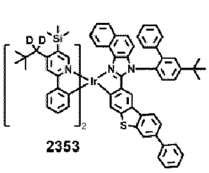
2353
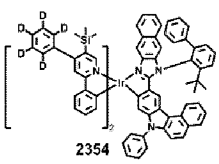
2354
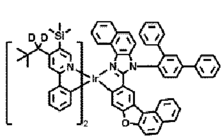
2355

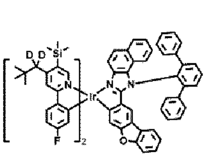
2356
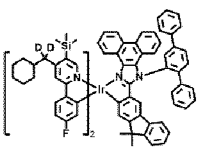
2357
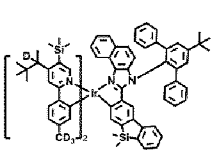
2358
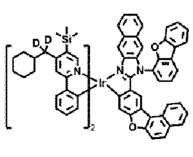
2359
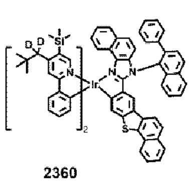
2360

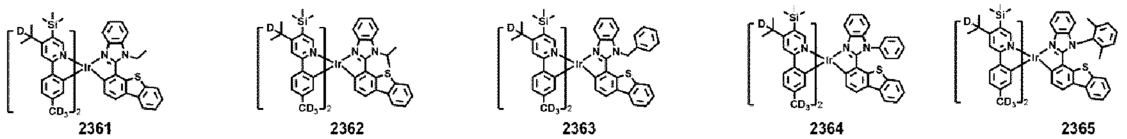
2361 2362 2363 2364 2365

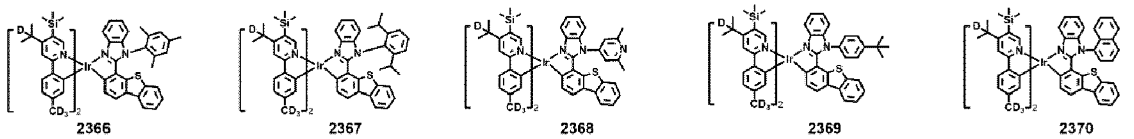
2366 2367 2368 2369 2370

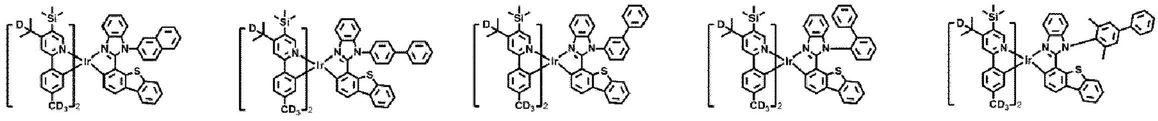
2371 2372 2373 2374 2375

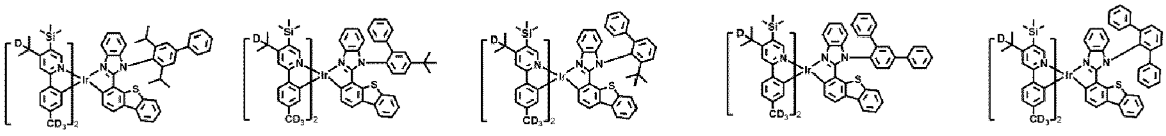
2376 2377 2378 2379 2380

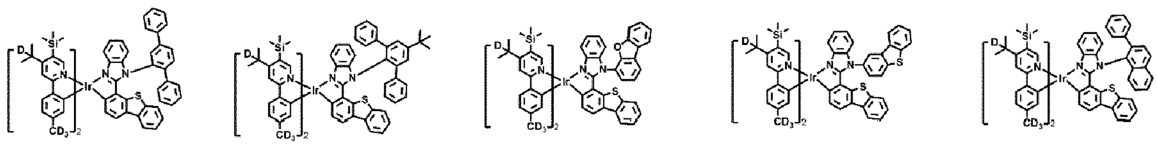
2381 2382 2383 2384 2385

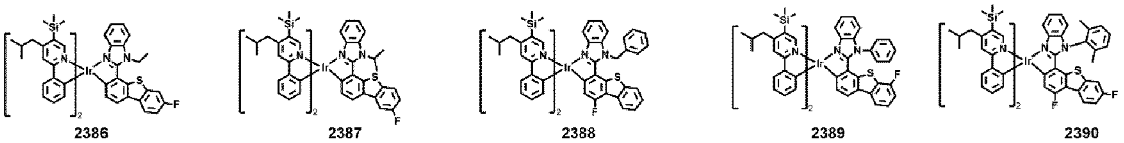
2386 2387 2388 2389 2390

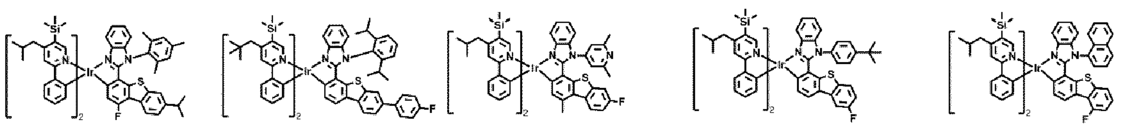
2391 2392 2393 2394 2395

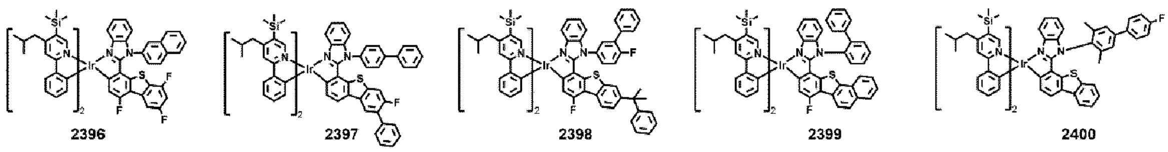
2396 2397 2398 2399 2400

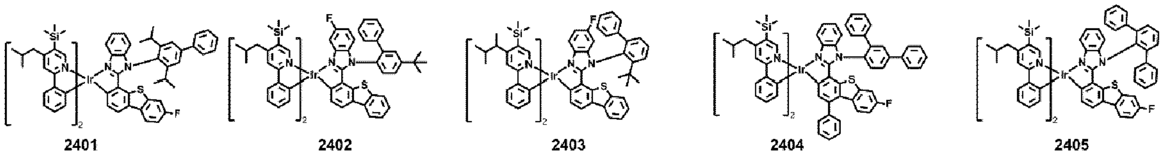
2401 2402 2403 2404 2405

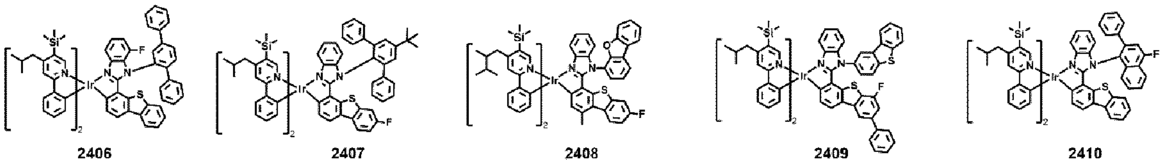
2406 2407 2408 2409 2410

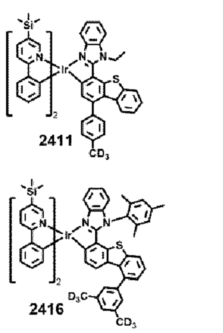
2411

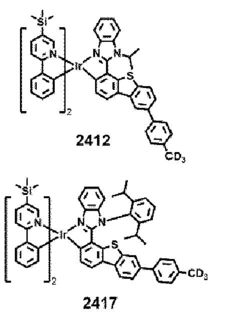
2412

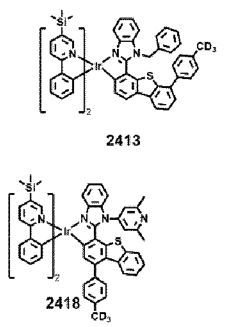
2413

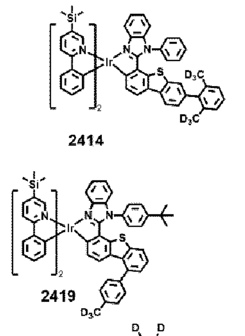
2414

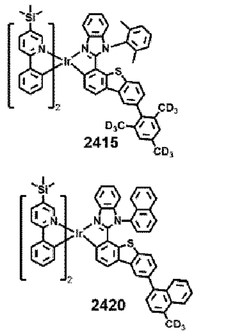
2415

2416

2417

2418

2419

2420

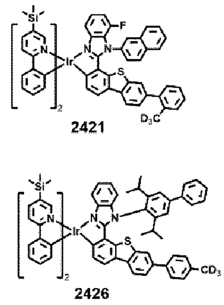
2421

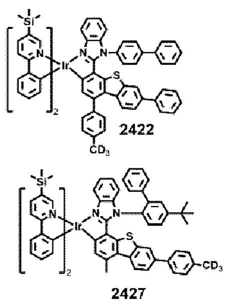
2422

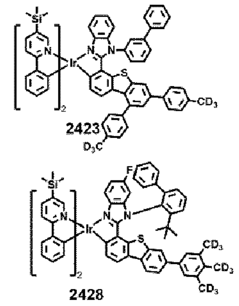
2423

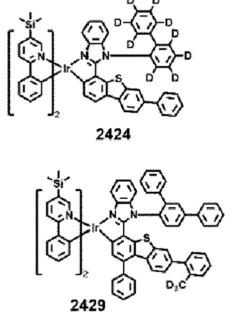
2424

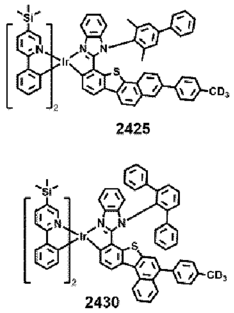
2425

2426

2427

2428

2429

2430

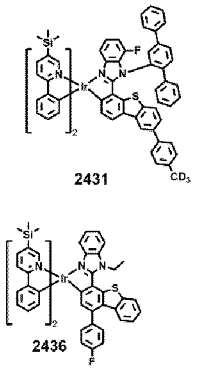
2431

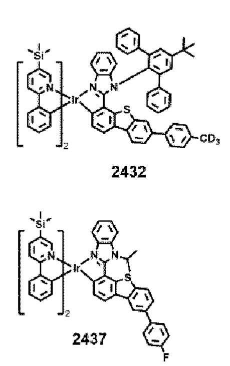
2432

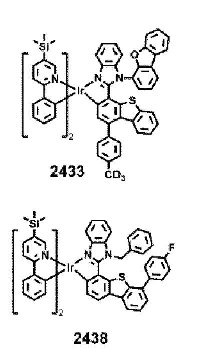
2433

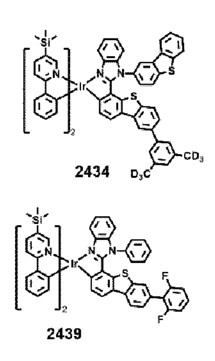
2434

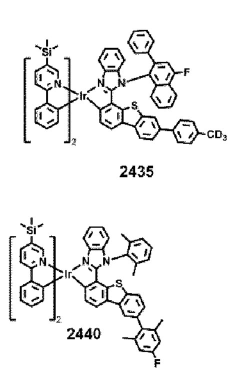
2435

2436

2437

2438

2439

2440

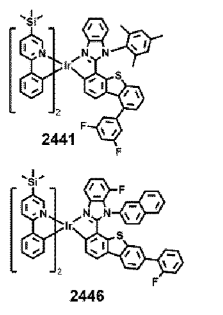
2441

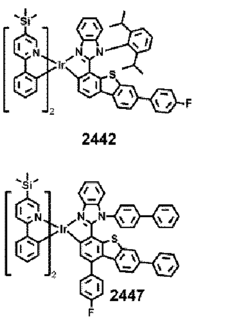
2442

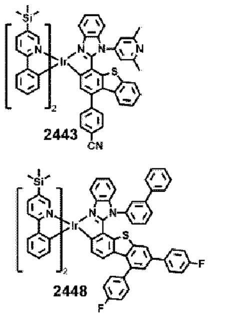
2443

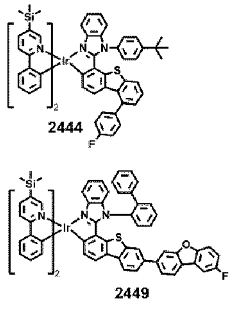
2444

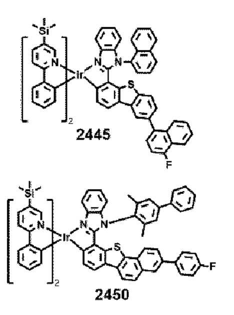
2445

2446

2447

2448

2449

2450

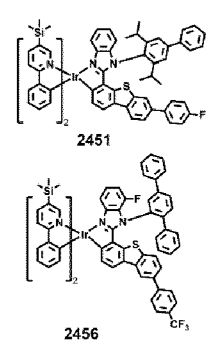
2451

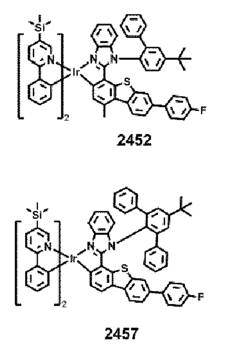
2452

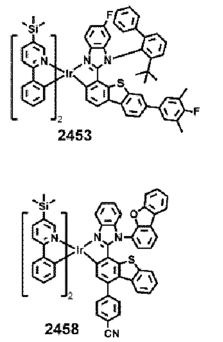
2453

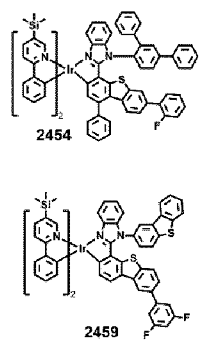
2454

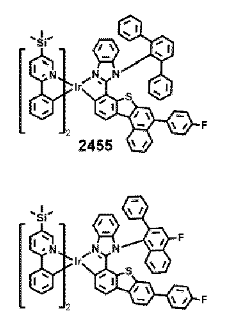
2455

2456

2457

2458

2459

2460

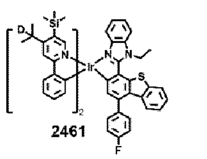
2461
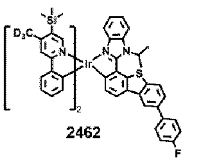
2462
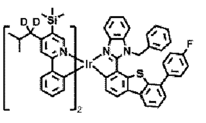
2463
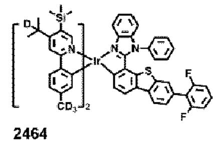
2464
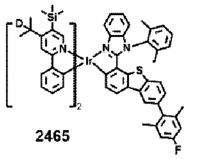
2465
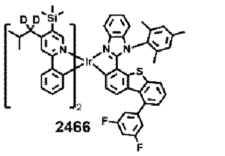
2466
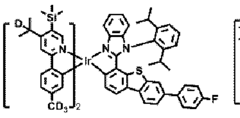
2467
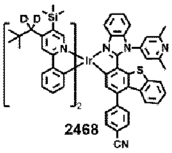
2468
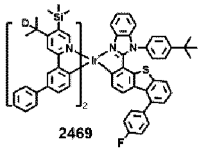
2469
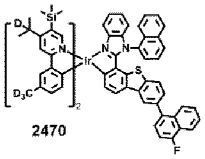
2470
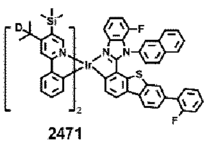
2471
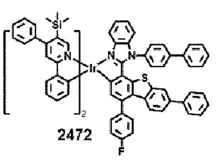
2472
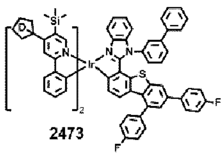
2473
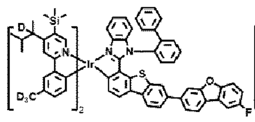
2474
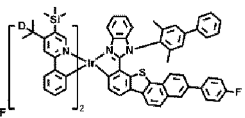
2475
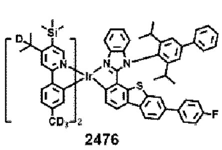
2476
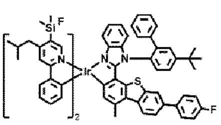
2477
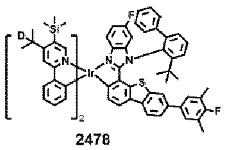
2478
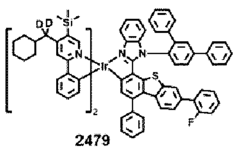
2479
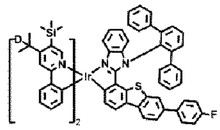
2480
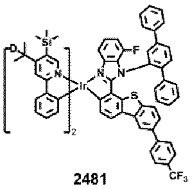
2481
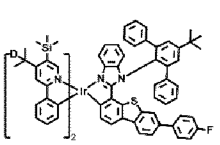
2482
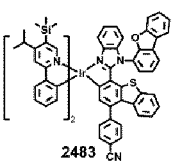
2483
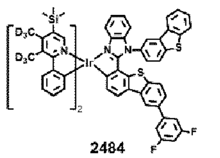
2484
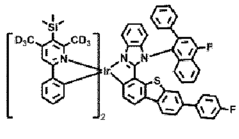
2485
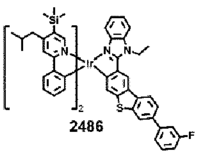
2486
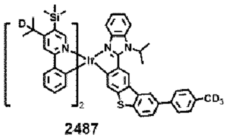
2487
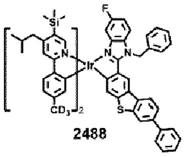
2488
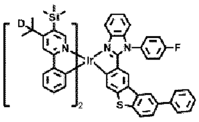
2489
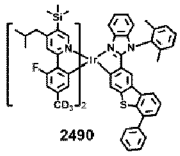
2490
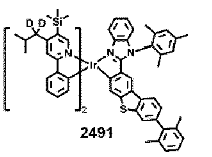
2491
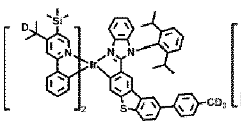
2492
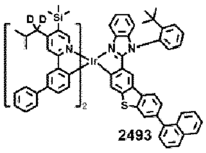
2493
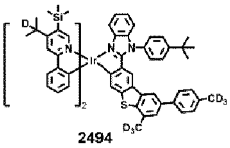
2494
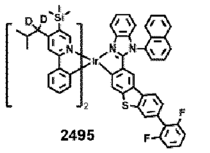
2495
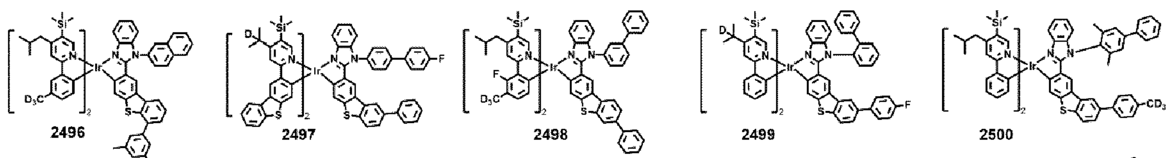
2496 2497 2498 2499 2500
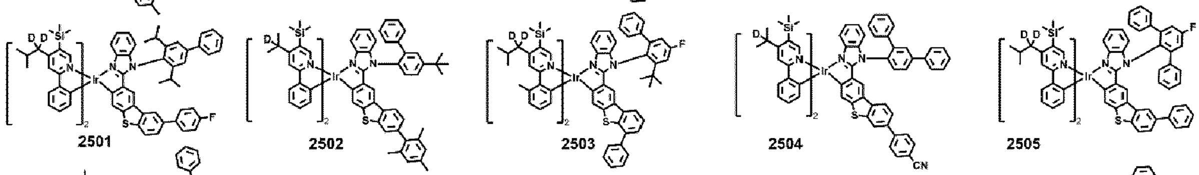
2501 2502 2503 2504 2505
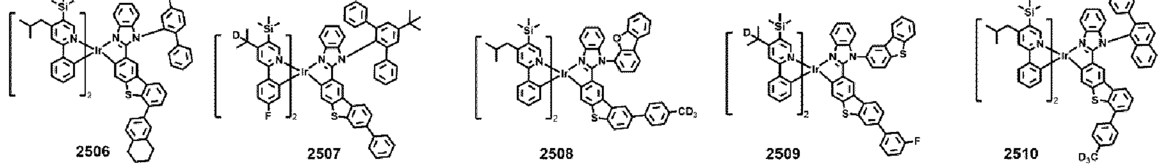
2506 2507 2508 2509 2510

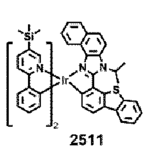
2511
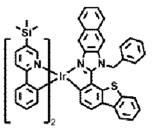
2512
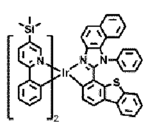
2513
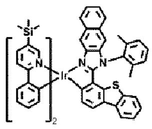
2514
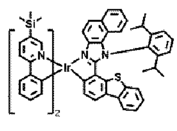
2515

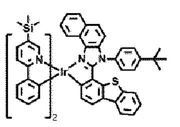
2516
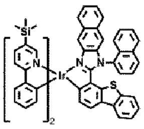
2517
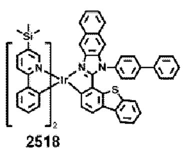
2518
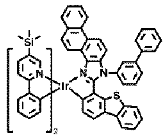
2519
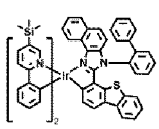
2520

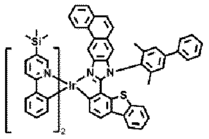
2521
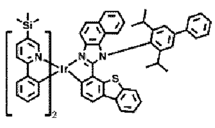
2522
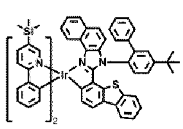
2523
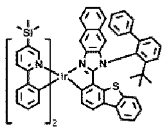
2524
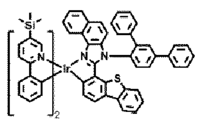
2525

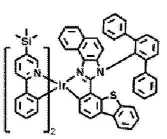
2526
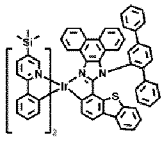
2527
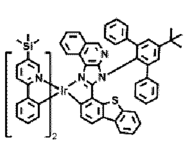
2528
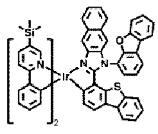
2529
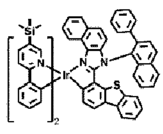
2530

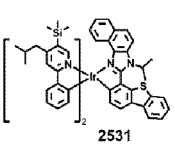
2531
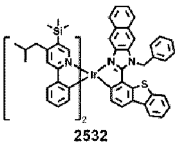
2532
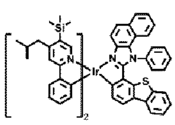
2533
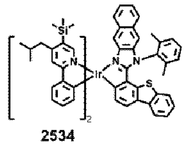
2534
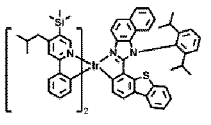
2535

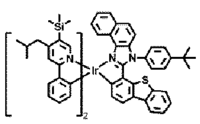
2536
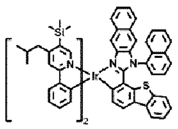
2537
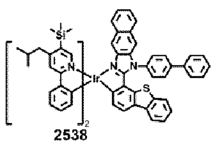
2538
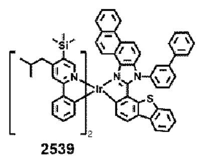
2539
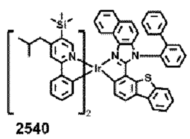
2540

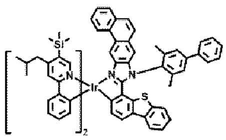
2541
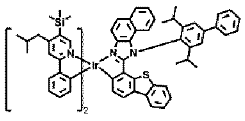
2542
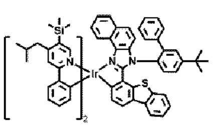
2543
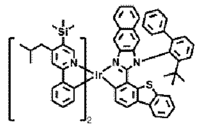
2544
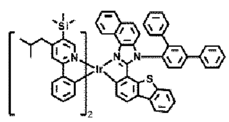
2545

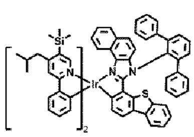
2546
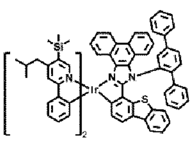
2547
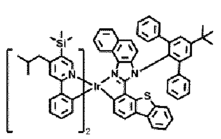
2548
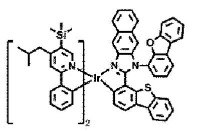
2549
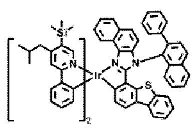
2550

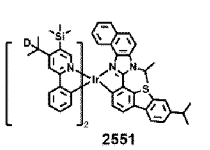
2551

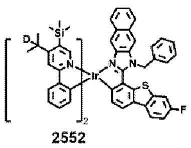
2552

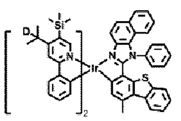
2553

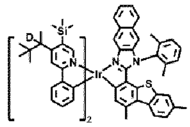
2554

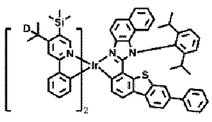
2555

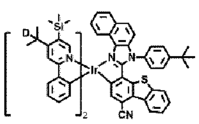
2556

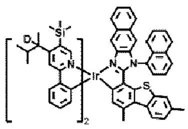
2557

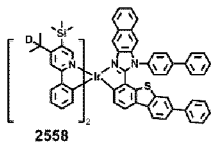
2558

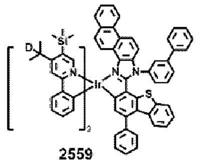
2559

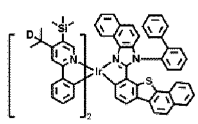
2560

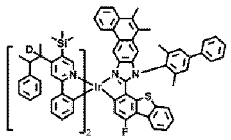
2561

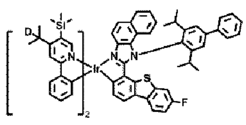
2562

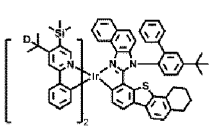
2563

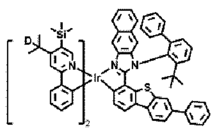
2564

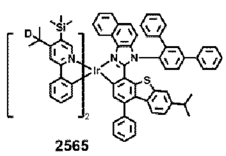
2565

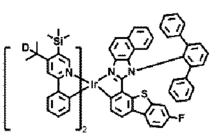
2566

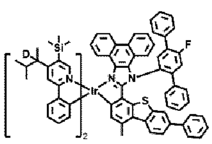
2567

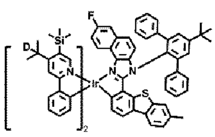
2568

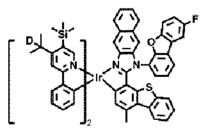
2569

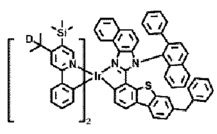
2570

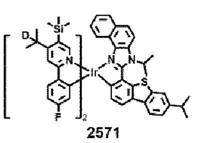
2571

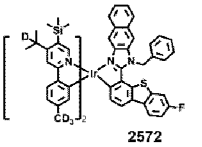
2572

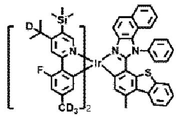
2573

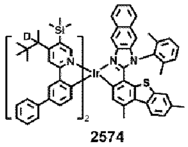
2574

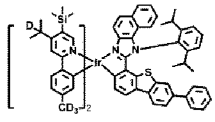
2575

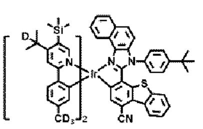
2576

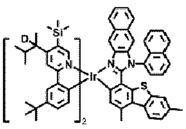
2577

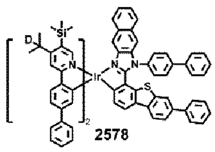
2578

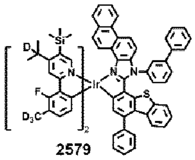
2579

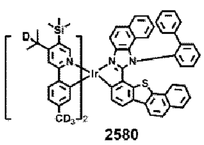
2580

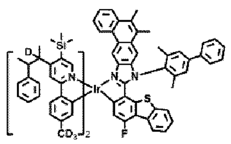
2581

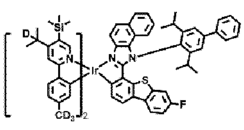
2582

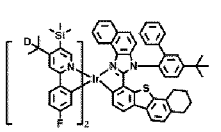
2583

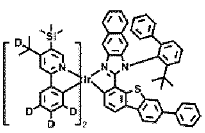
2584

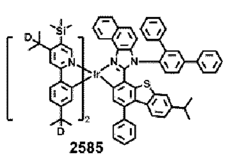
2585

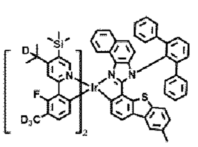
2586

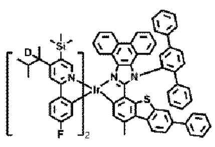
2587

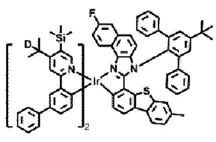
2588

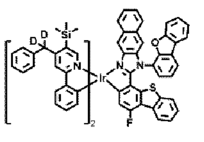
2589

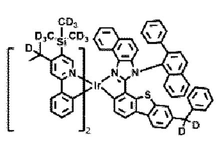
2590

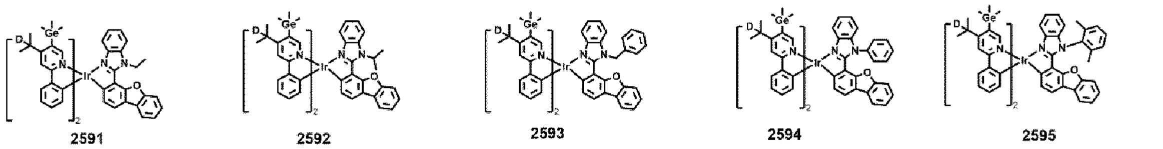
2591 2592 2593 2594 2595

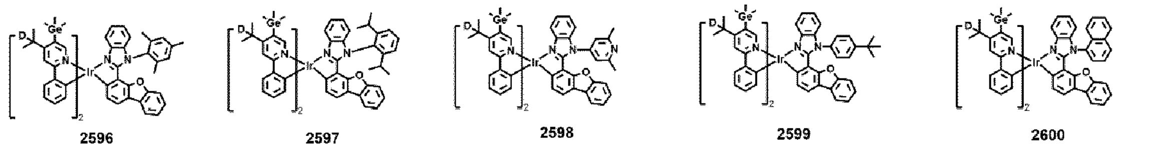
2596 2597 2598 2599 2600

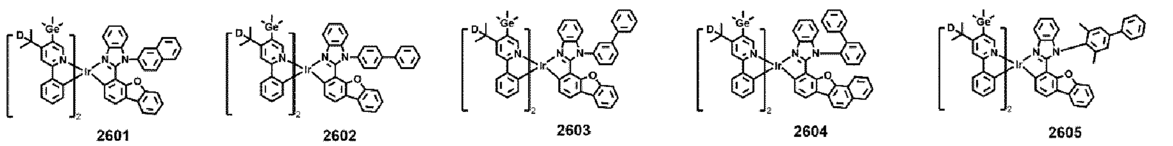
2601 2602 2603 2604 2605

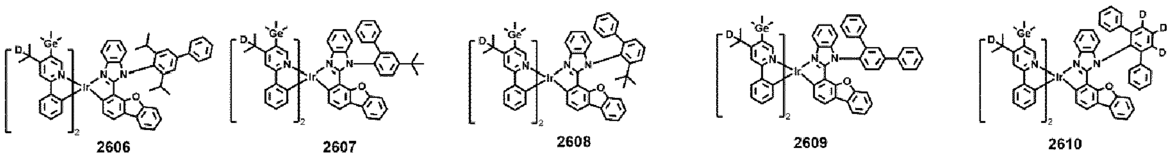
2606 2607 2608 2609 2610

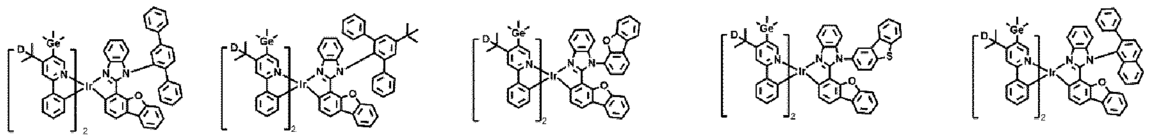
2611 2612 2613 2614 2615

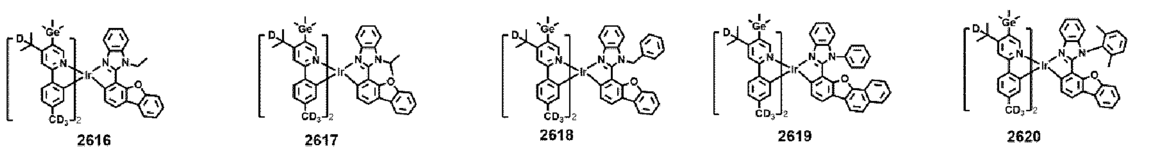
2616 2617 2618 2619 2620

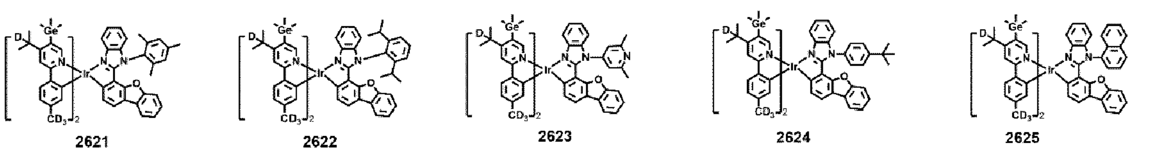
2621 2622 2623 2624 2625

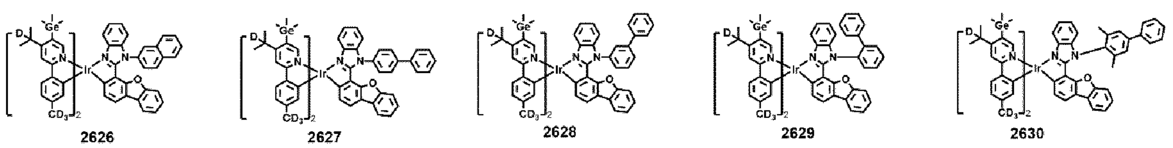
2626 2627 2628 2629 2630

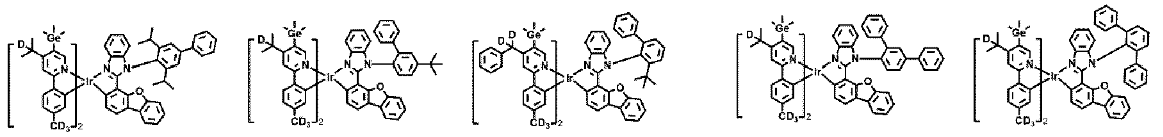
2631 2632 2633 2634 2635

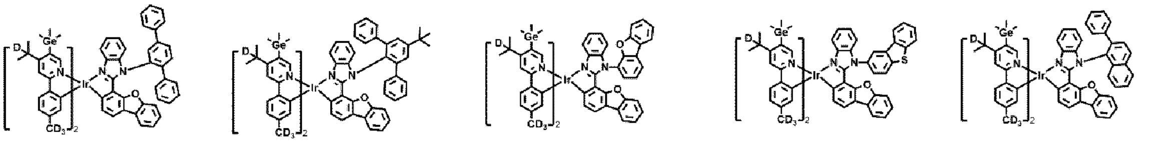
2636 2637 2638 2639 2640

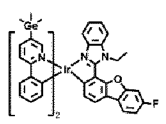
2641

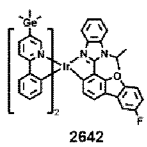
2642

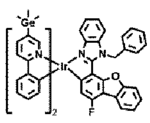
2643

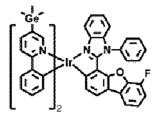
2644

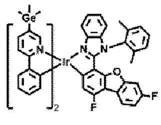
2645

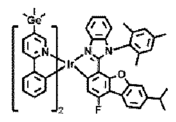
2646

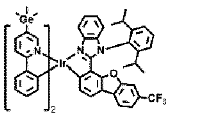
2647

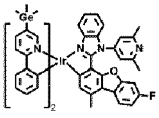
2648

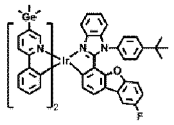
2649

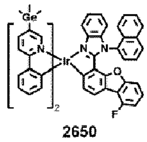
2650

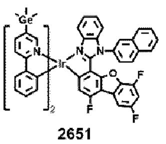
2651

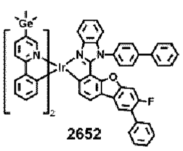
2652

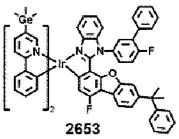
2653

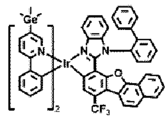
2654

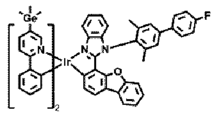
2655

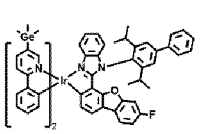
2656

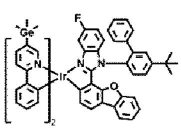
2657

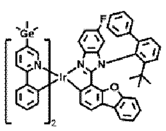
2658

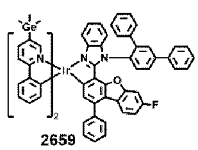
2659

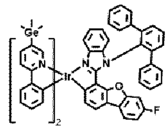
2660

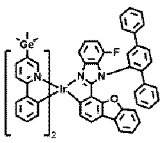
2661

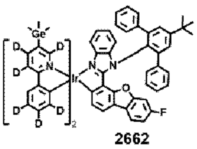
2662

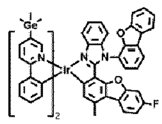
2663

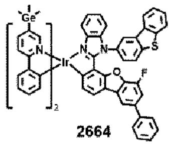
2664

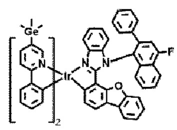
2665

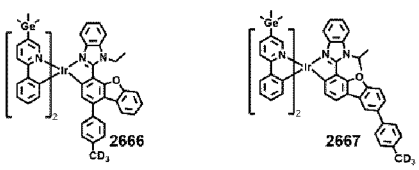
2666

2667

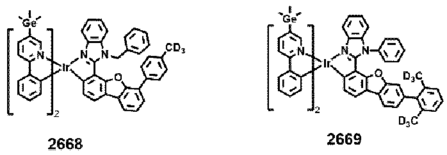
2668

2669

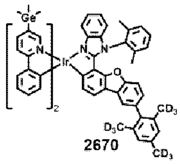
2670

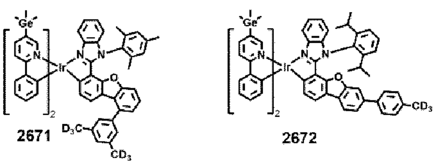
2671

2672

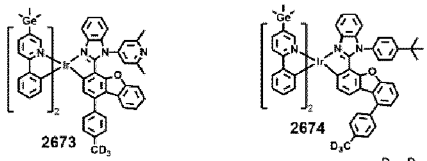
2673

2674

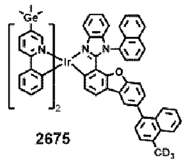
2675

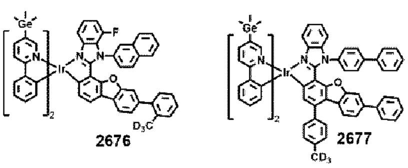
2676

2677

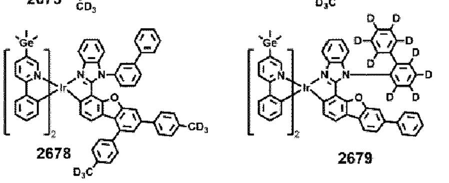
2678

2679

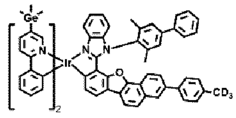
2680

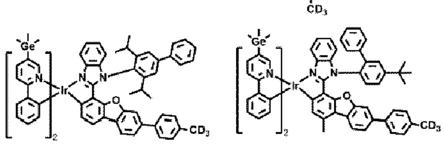
2681

2682

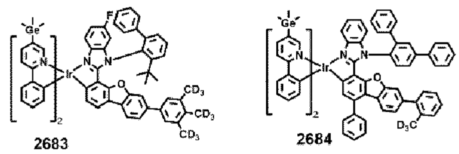
2683

2684

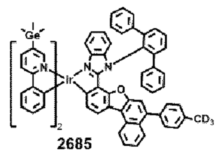
2685

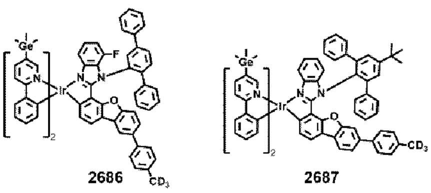
2686

2687

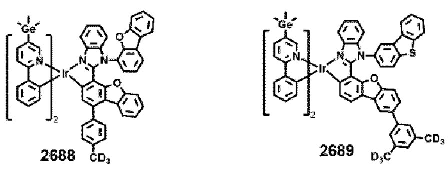
2688

2689

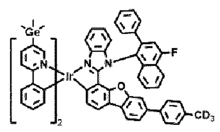
2690

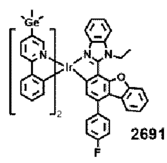
2691
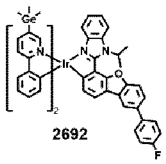
2692
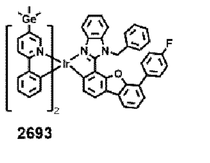
2693
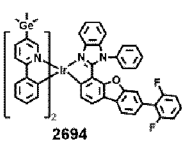
2694
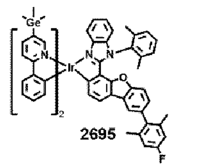
2695
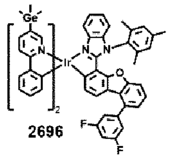
2696
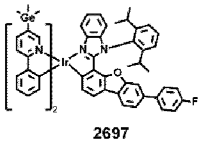
2697
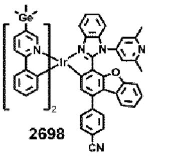
2698
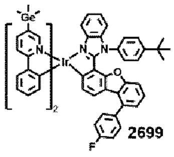
2699
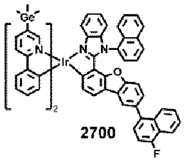
2700
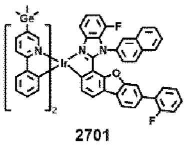
2701
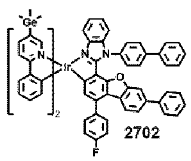
2702
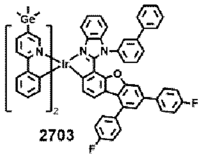
2703
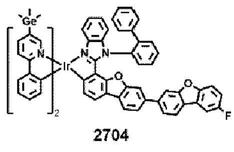
2704
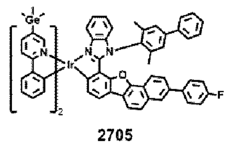
2705
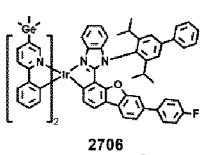
2706
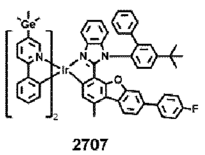
2707
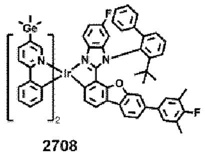
2708
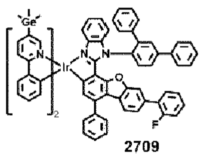
2709
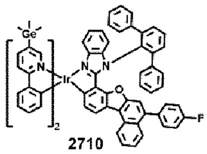
2710
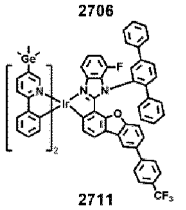
2711
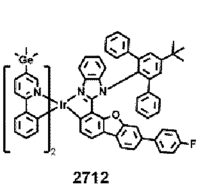
2712
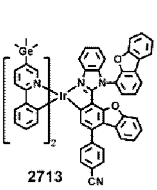
2713
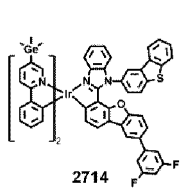
2714
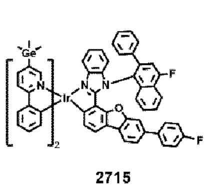
2715
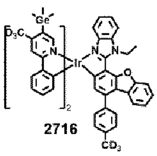
2716
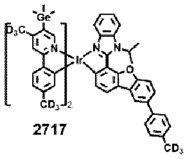
2717
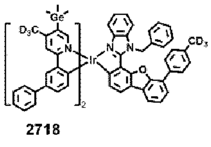
2718
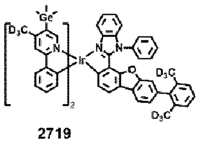
2719
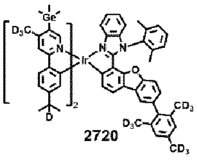
2720
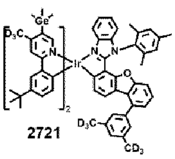
2721
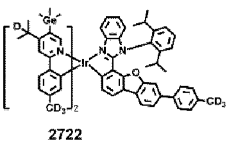
2722
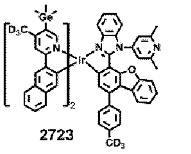
2723
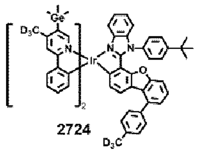
2724
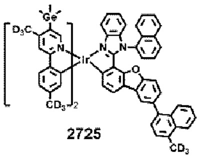
2725
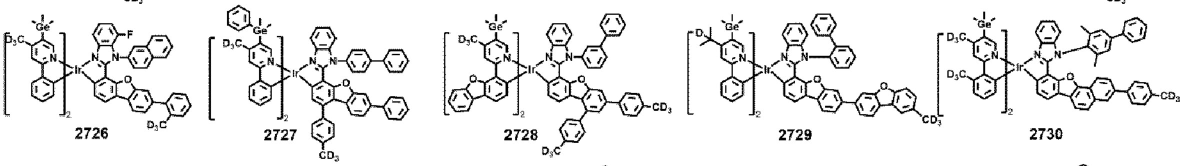
2726 2727 2728 2729 2730
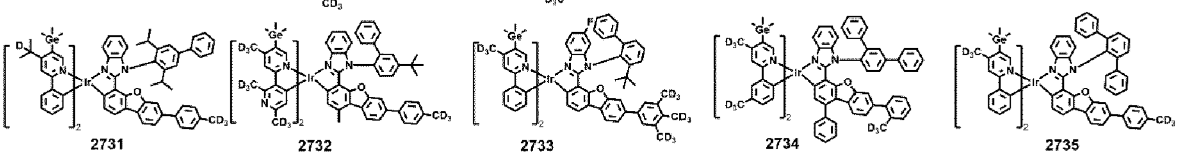
2731 2732 2733 2734 2735
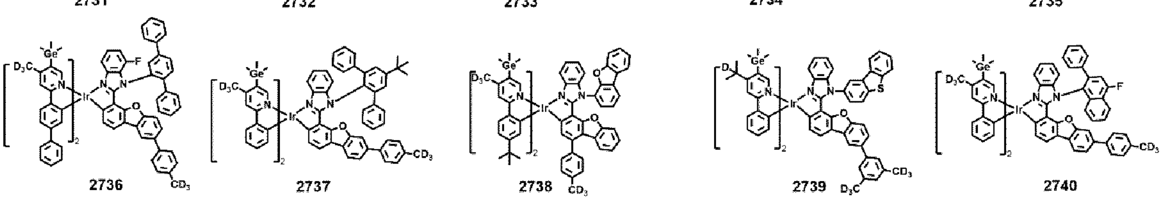
2736 2737 2738 2739 2740

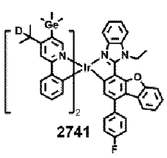
2741
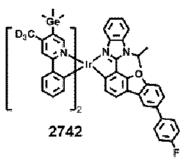
2742
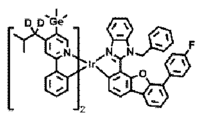
2743
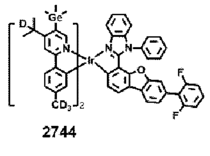
2744
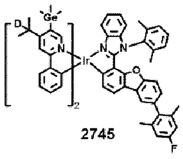
2745

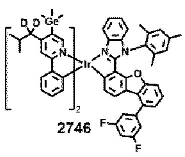
2746
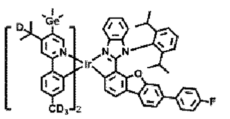
2747
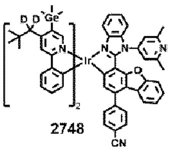
2748
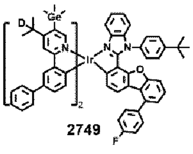
2749
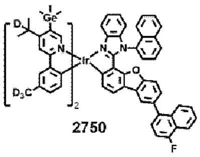
2750

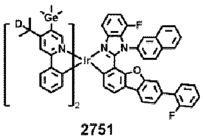
2751
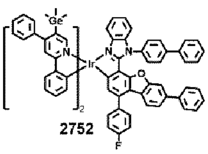
2752
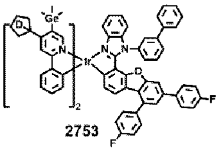
2753
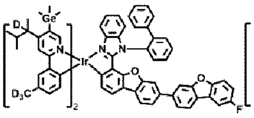
2754
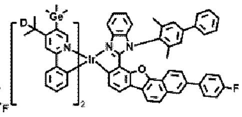
2755

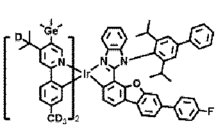
2756
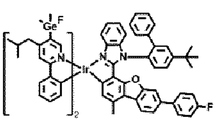
2757
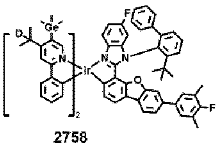
2758
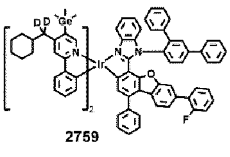
2759
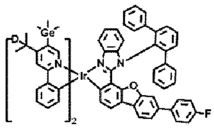
2760

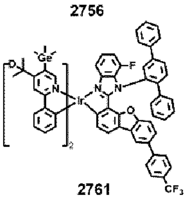
2761
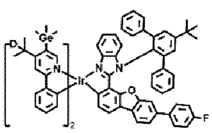
2762
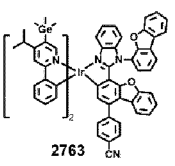
2763
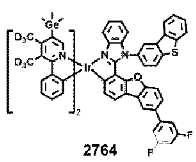
2764
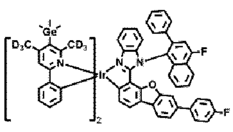
2765

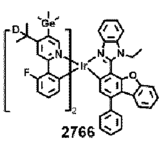
2766
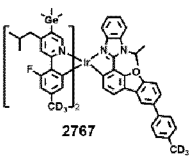
2767
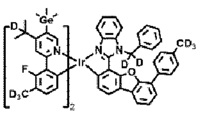
2768
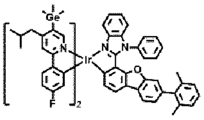
2769
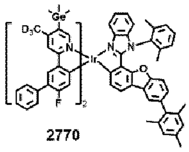
2770

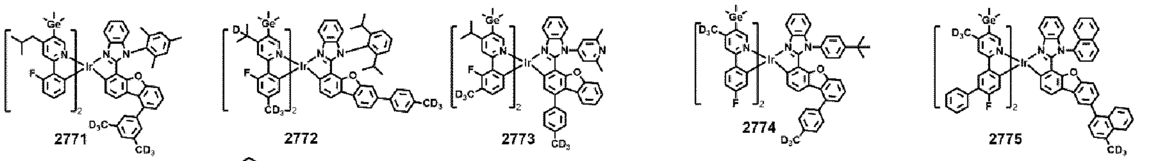
2771
2772
2773
2774
2775

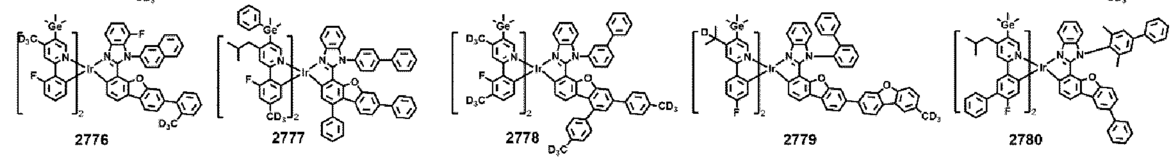
2776
2777
2778
2779
2780

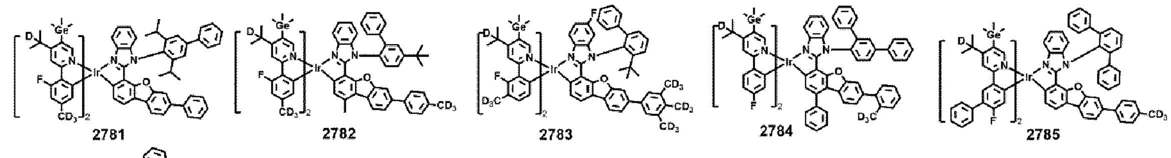
2781
2782
2783
2784
2785

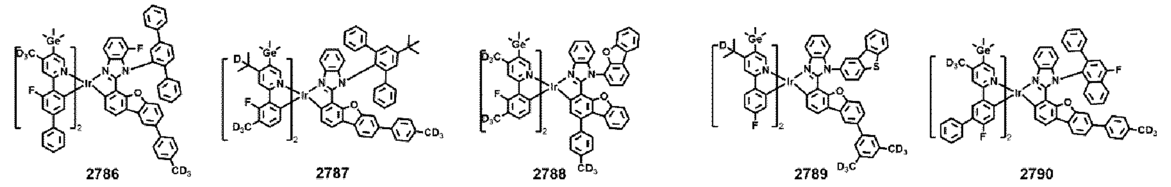
2786
2787
2788
2789
2790

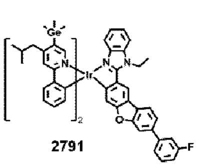
2791

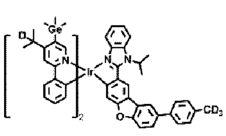
2792

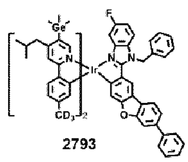
2793

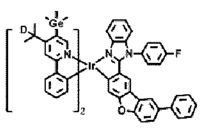
2794

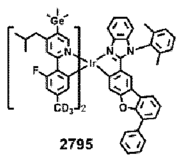
2795

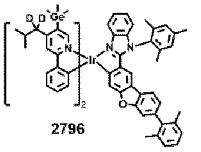
2796

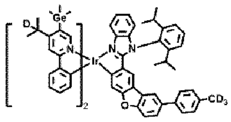
2797

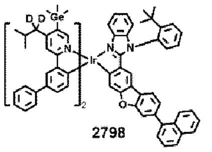
2798

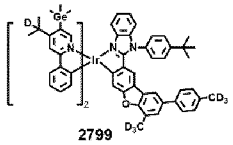
2799

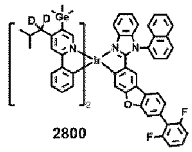
2800

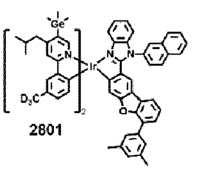
2801

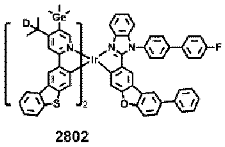
2802

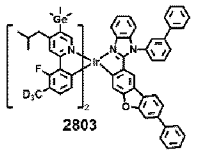
2803

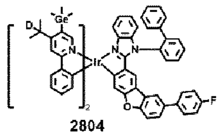
2804

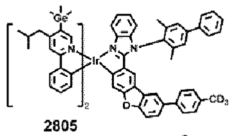
2805

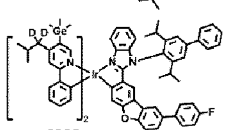
2806

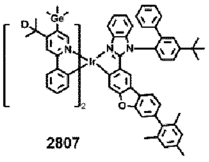
2807

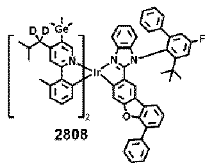
2808

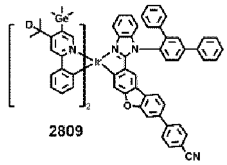
2809

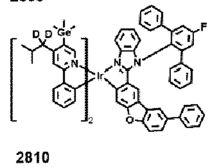
2810

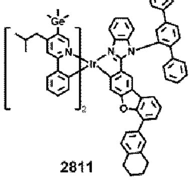
2811

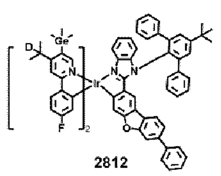
2812

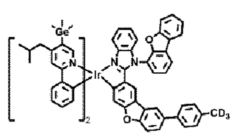
2813

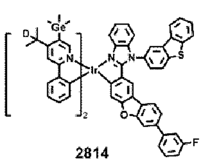
2814

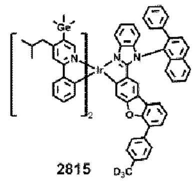
2815

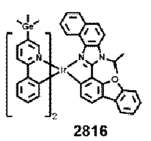
2816

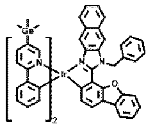
2817

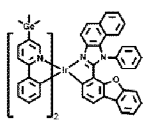
2818

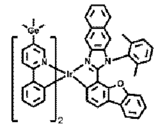
2819

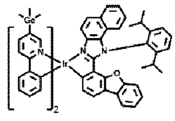
2820

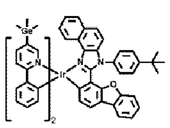
2821

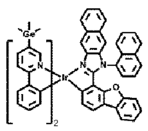
2822

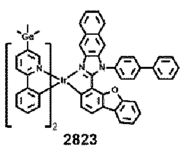
2823

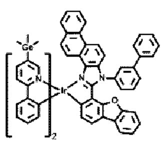
2824

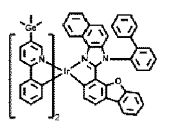
2825

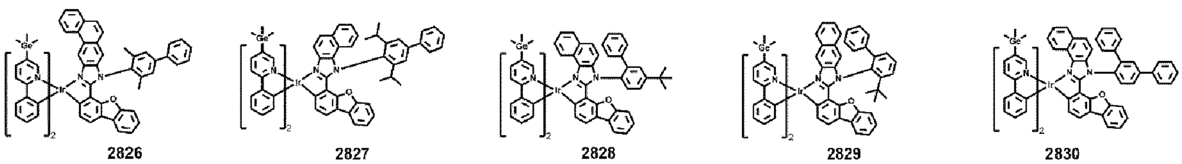
2826 2827 2828 2829 2830

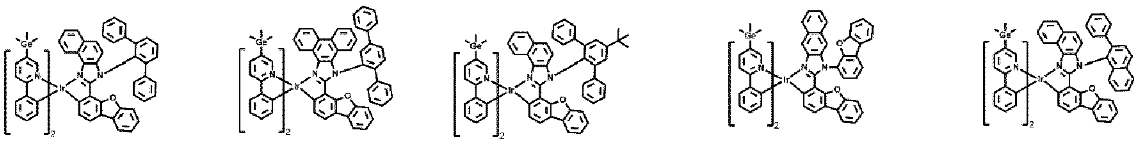
2831 2832 2833 2834 2835

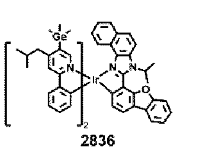
2836
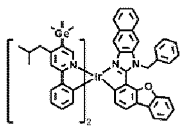
2837
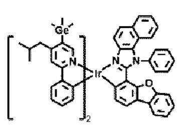
2838
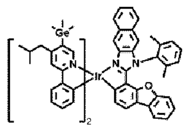
2839
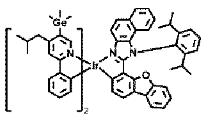
2840

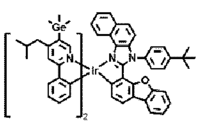
2841
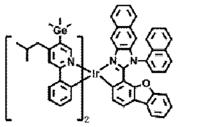
2842
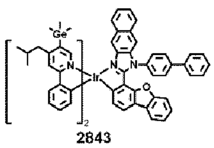
2843
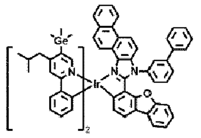
2844
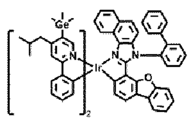
2845

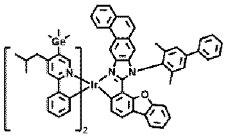
2846
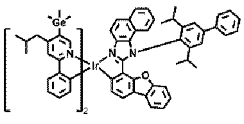
2847
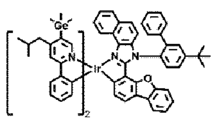
2848
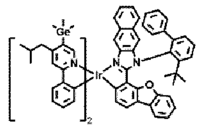
2849
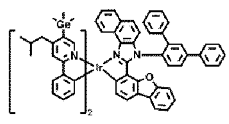
2850

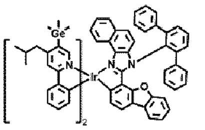
2851
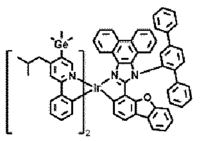
2852
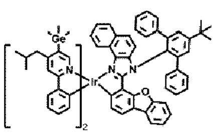
2853
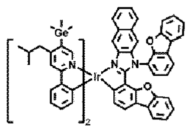
2854
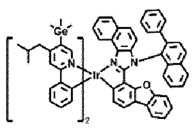
2855

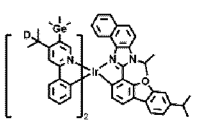
2856
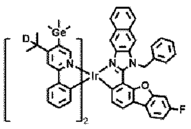
2857
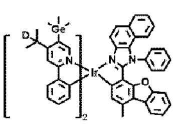
2858
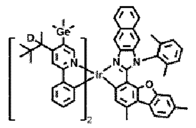
2859
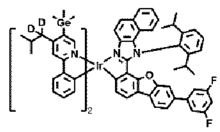
2860

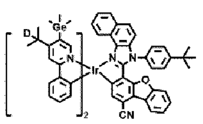
2861
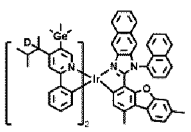
2862
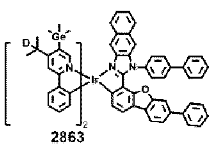
2863
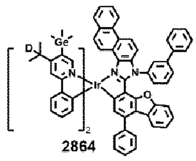
2864
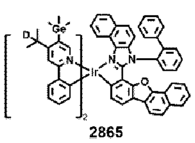
2865

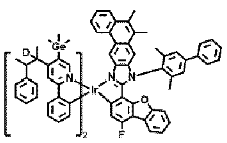
2866
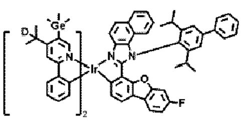
2867
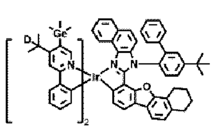
2868
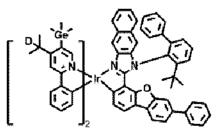
2869
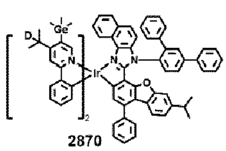
2870

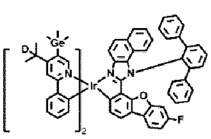
2871
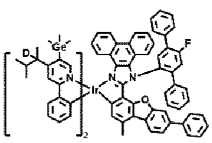
2872
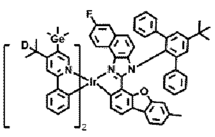
2873
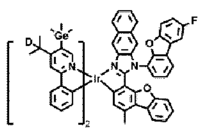
2874
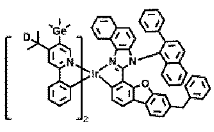
2875

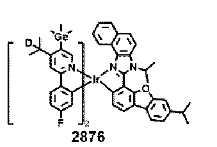
2876

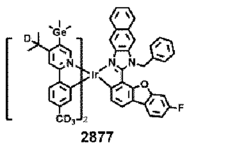
2877

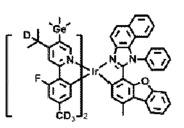
2878

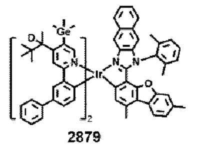
2879

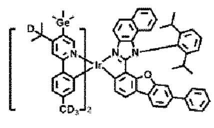
2880

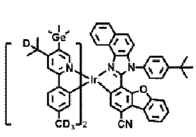
2881

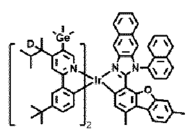
2882

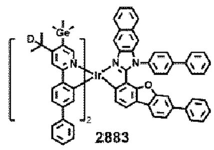
2883

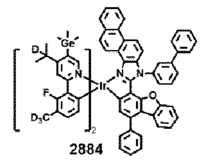
2884

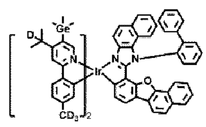
2885

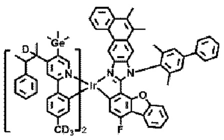
2886

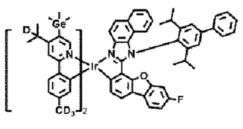
2887

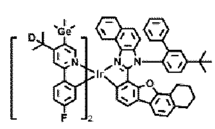
2888

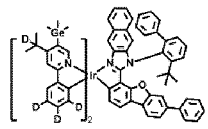
2889

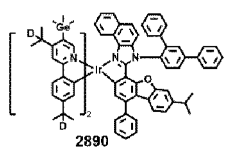
2890

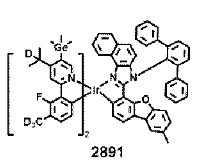
2891

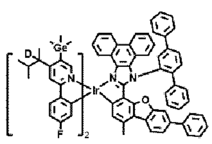
2892

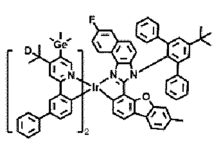
2893

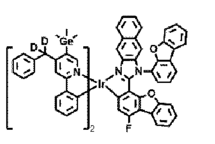
2894

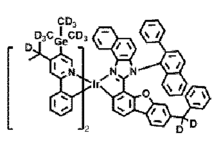
2895

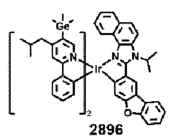
2896

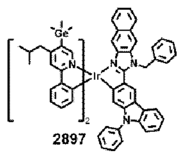
2897

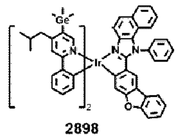
2898

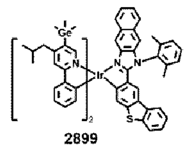
2899

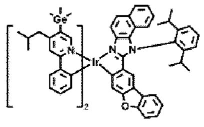
2900

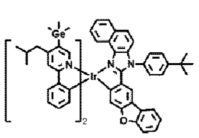
2901

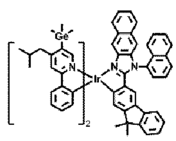
2902

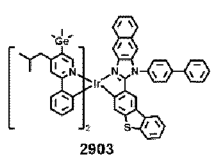
2903

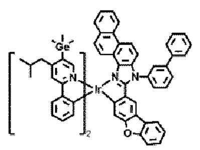
2904

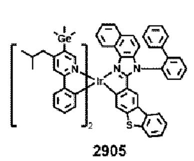
2905

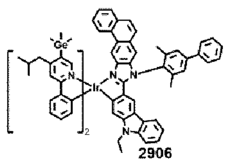
2906

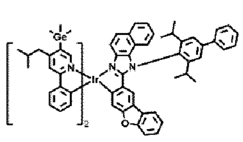
2907

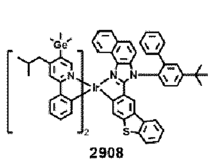
2908

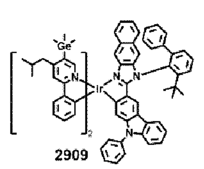
2909

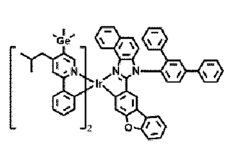
2910

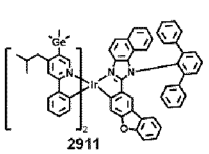
2911

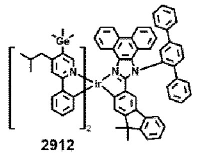
2912

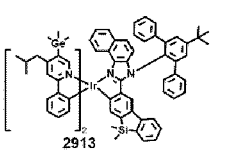
2913

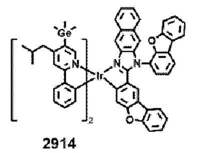
2914

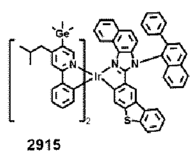
2915

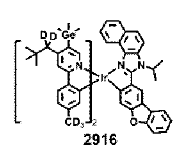
2916
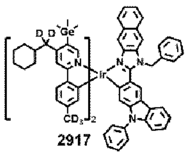
2917
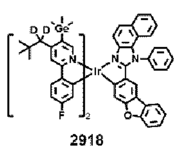
2918
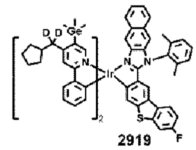
2919
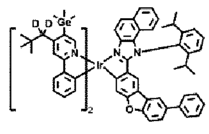
2920

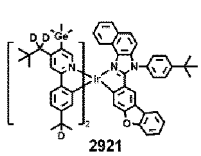
2921
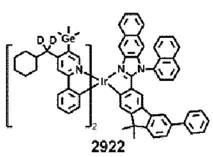
2922
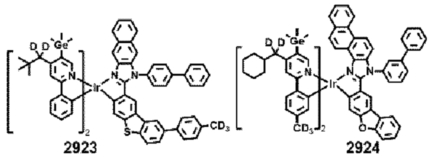
2923
2924
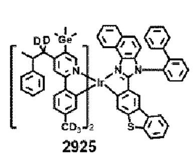
2925

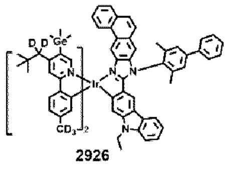
2926
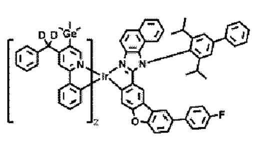
2927
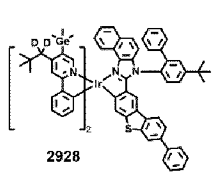
2928
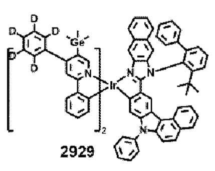
2929
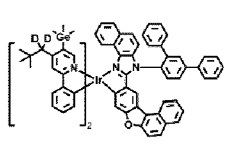
2930

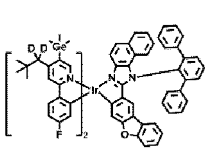
2931
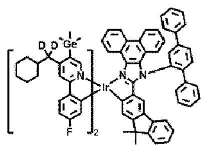
2932
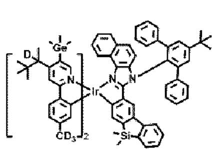
2933
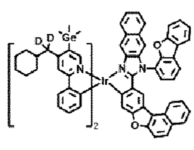
2934
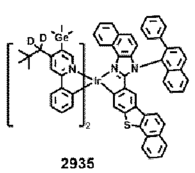
2935

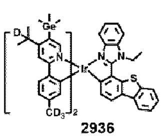
2936
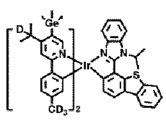
2937
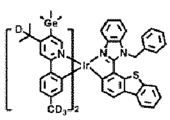
2938
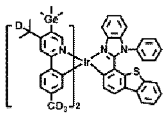
2939
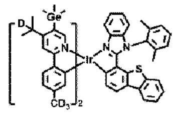
2940

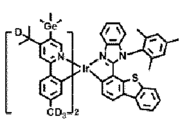
2941
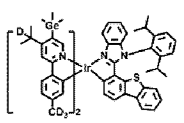
2942
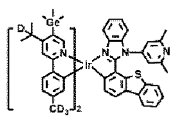
2943
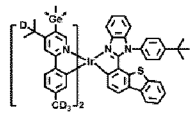
2944
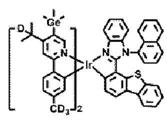
2945

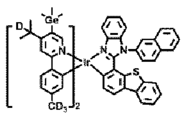
2946
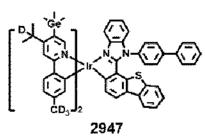
2947
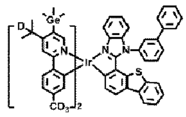
2948
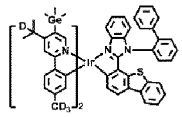
2949
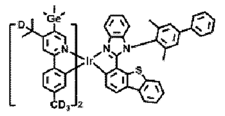
2950

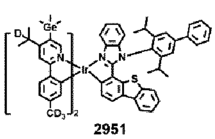
2951
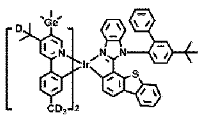
2952
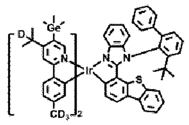
2953
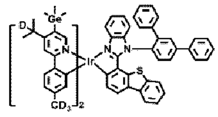
2954
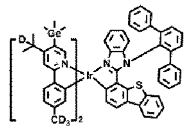
2955

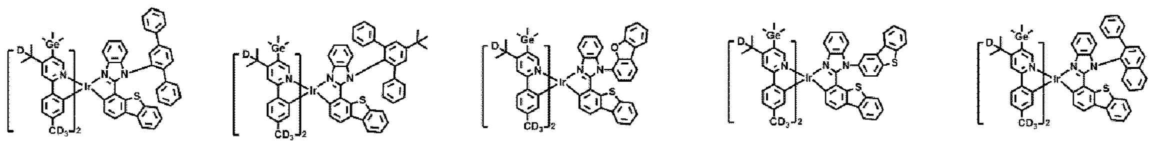
2956
2957
2958
2959
2960

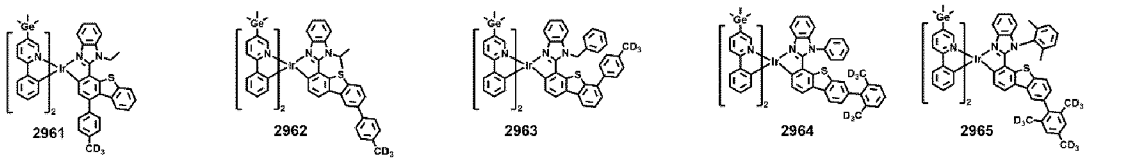

2961 2962 2963 2964 2965

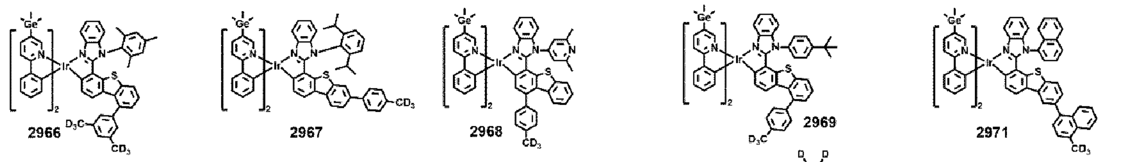

2966 2967 2968 2969 2971

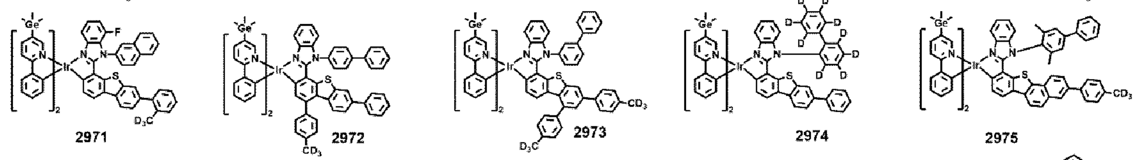

2971 2972 2973 2974 2975

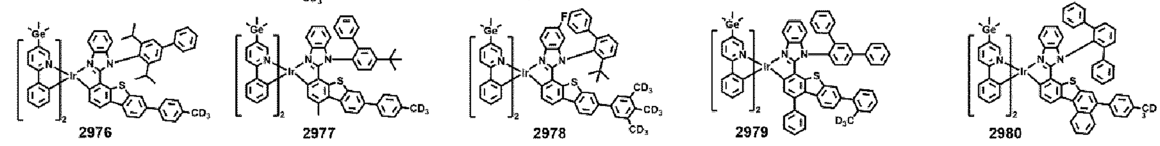

2976 2977 2978 2979 2980

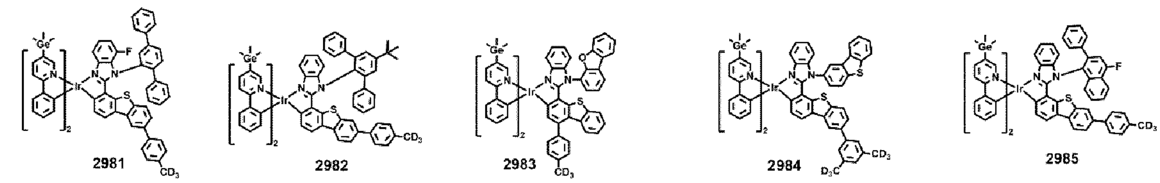

2981 2982 2983 2984 2985

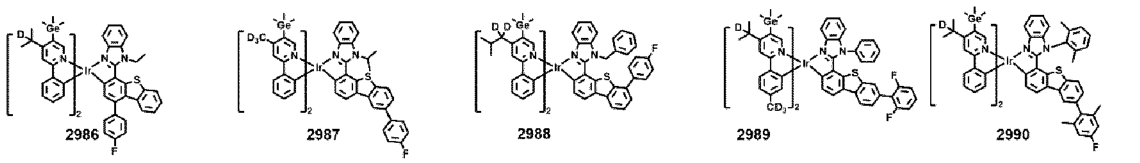

2986 2987 2988 2989 2990

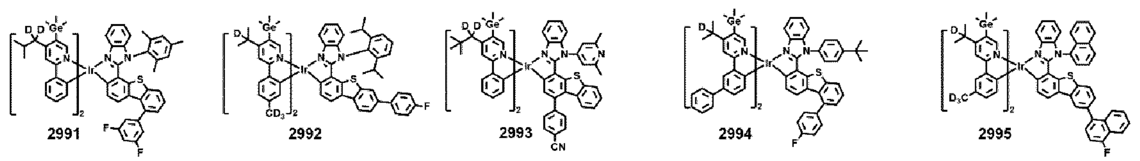

2991 2992 2993 2994 2995

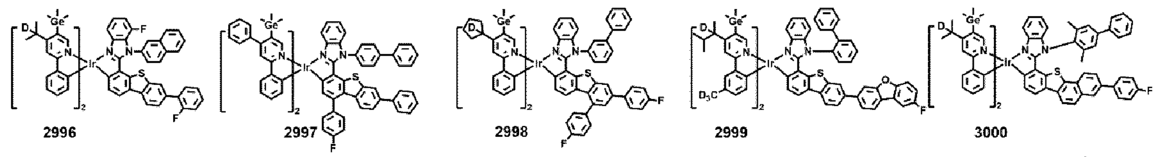

2996 2997 2998 2999 3000

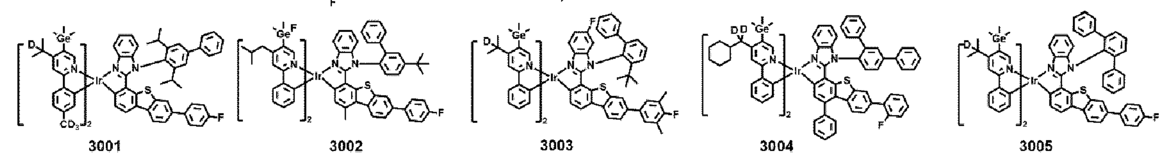

3001 3002 3003 3004 3005

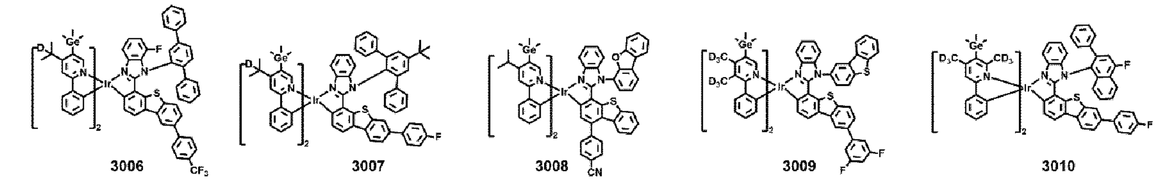

3006 3007 3008 3009 3010

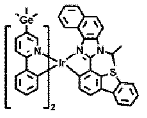
3011
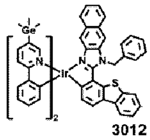
3012
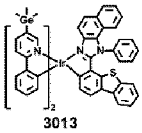
3013
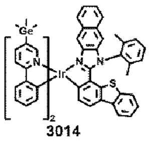
3014
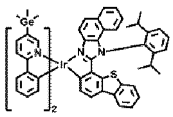
3015

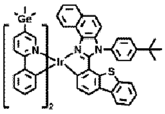
3016
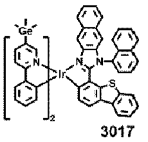
3017
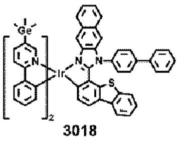
3018
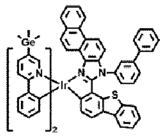
3019
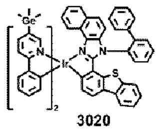
3020

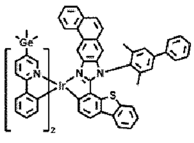
3021
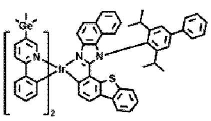
3022
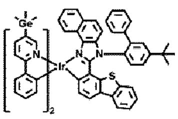
3023
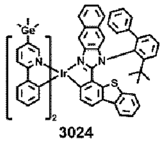
3024
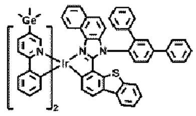
3025

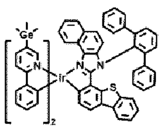
3026
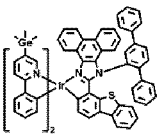
3027
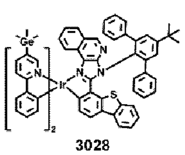
3028
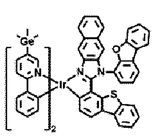
3029
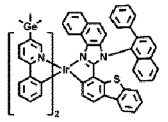
3030

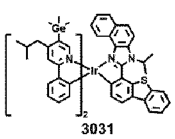
3031
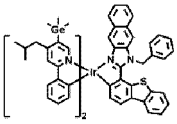
3032
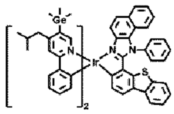
3033
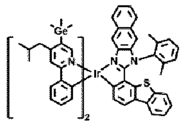
3034
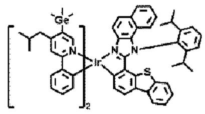
3035

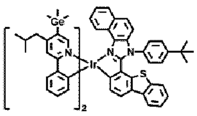
3036
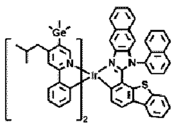
3037
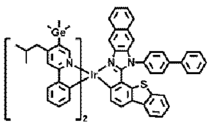
3038
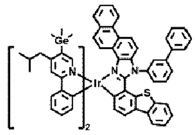
3039
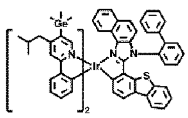
3040

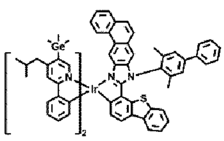
3041
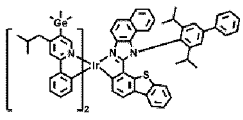
3042
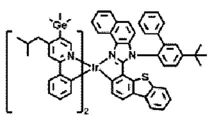
3043
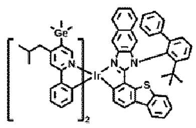
3044
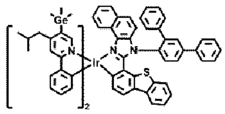
3045

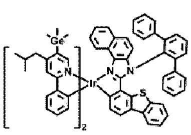
3046
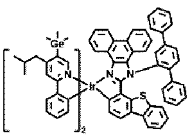
3047
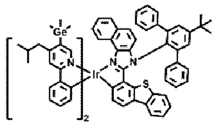
3048
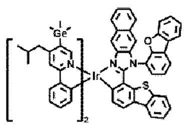
3049
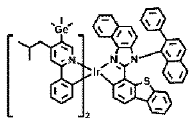
3050

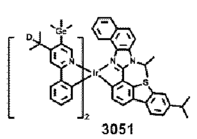
3051

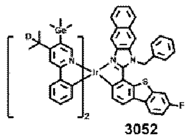
3052

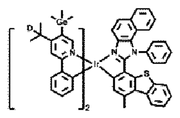
3053

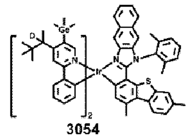
3054

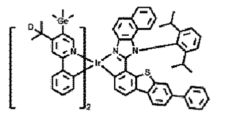
3055

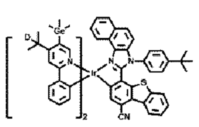
3056

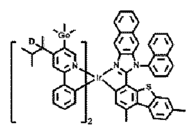
3057

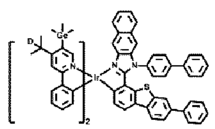
3058

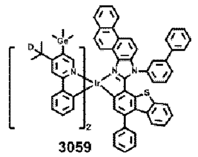
3059

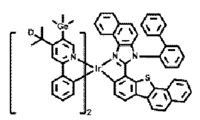
3060

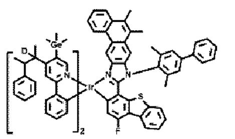
3061

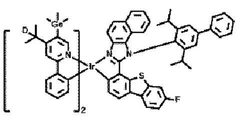
3062

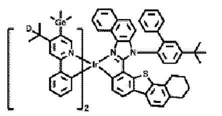
3063

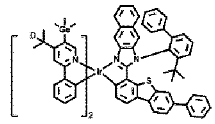
3064

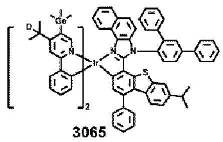
3065

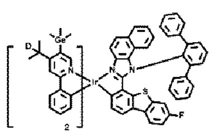
3066

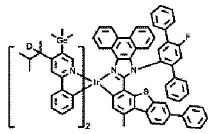
3067

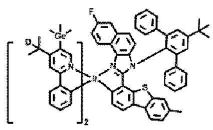
3068

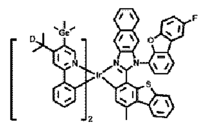
3069

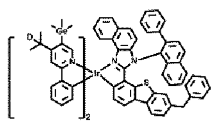
3070

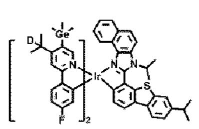
3071

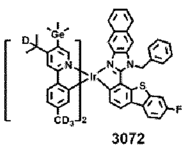
3072

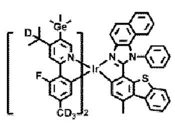
3073

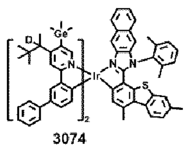
3074

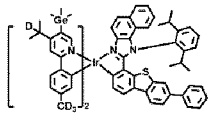
3075

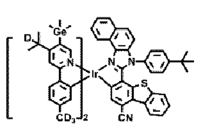
3076

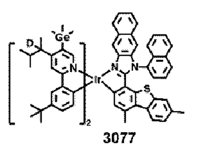
3077

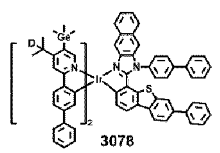
3078

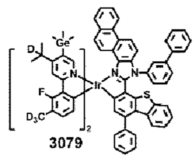
3079

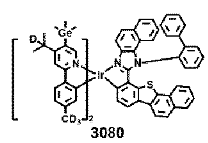
3080

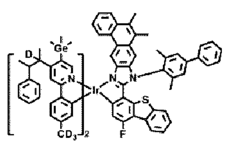
3081

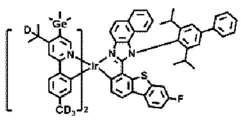
3082

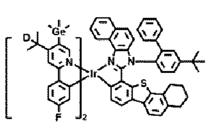
3083

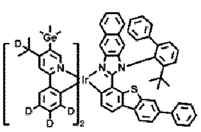
3084

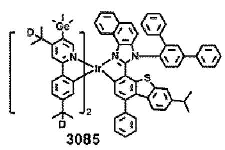
3085

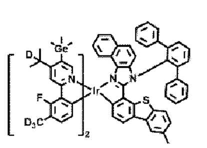
3086

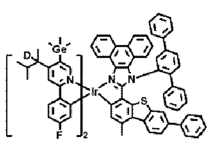
3087

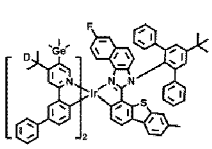
3088

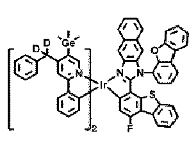
3089

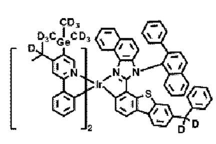
3090

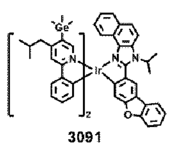
3091
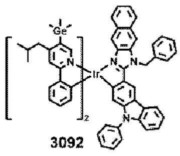
3092
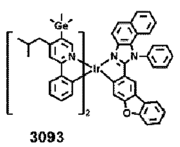
3093
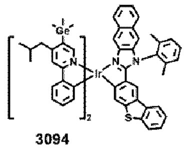
3094
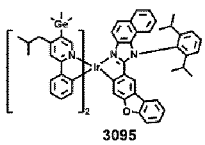
3095

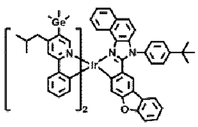
3096
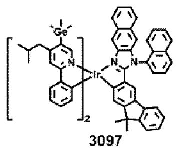
3097
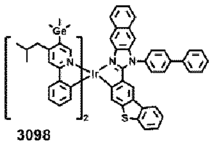
3098
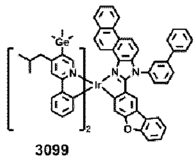
3099
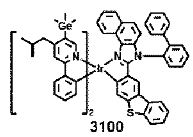
3100

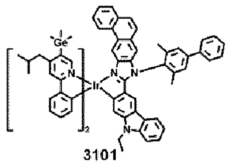
3101
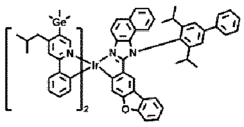
3102
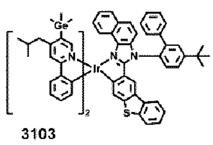
3103
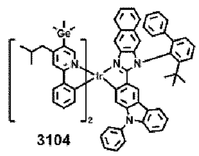
3104
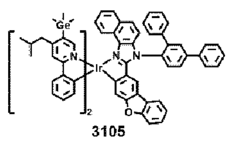
3105

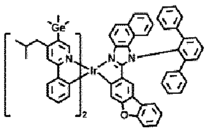
3106
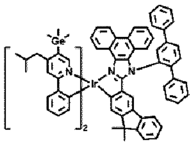
3107
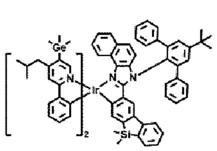
3108
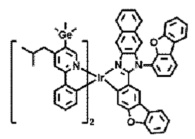
3109
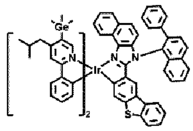
3110

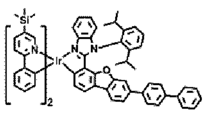
3111
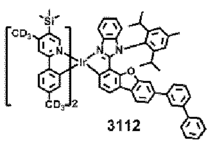
3112
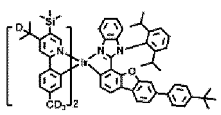
3113
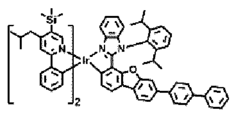
3114
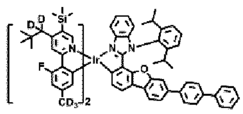
3115

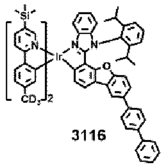
3116
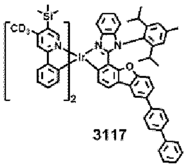
3117
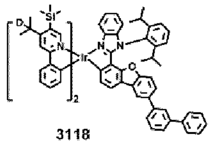
3118
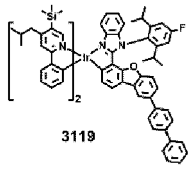
3119
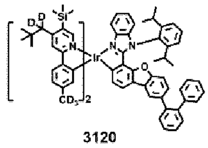
3120

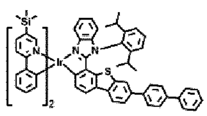
3121
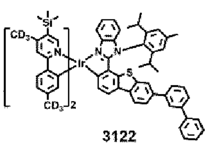
3122
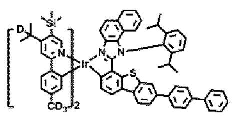
3123
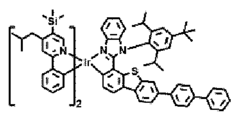
3124
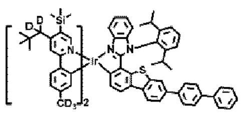
3125

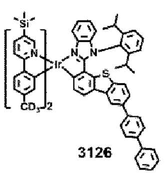
3126
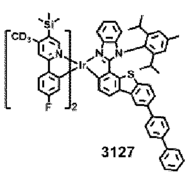
3127
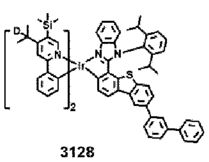
3128
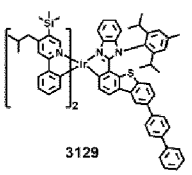
3129
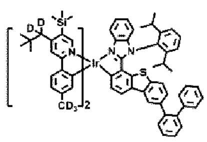
3130

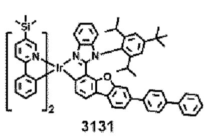
3131
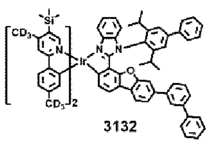
3132
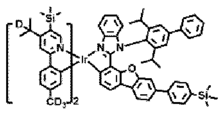
3133
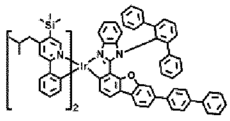
3134
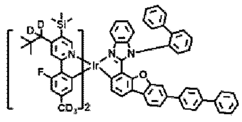
3135

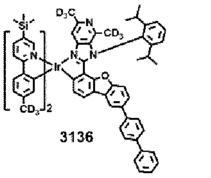
3136
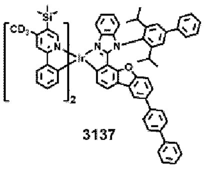
3137
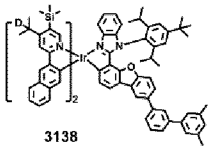
3138
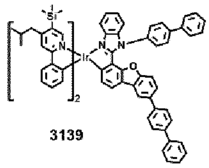
3139
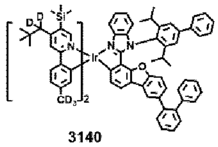
3140

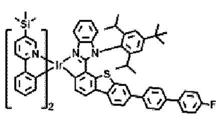
3141
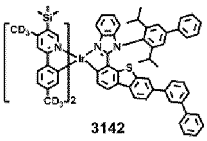
3142
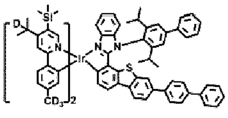
3143
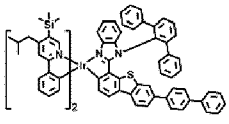
3144
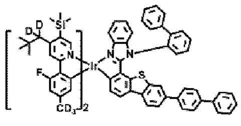
3145

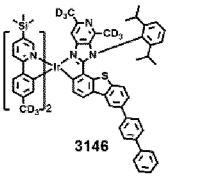
3146
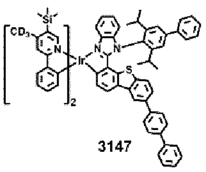
3147
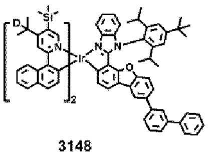
3148
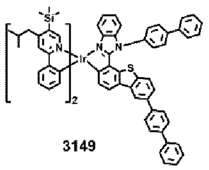
3149
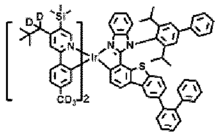
3150

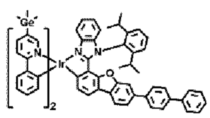
3151
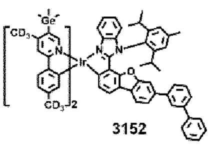
3152
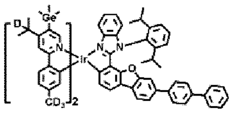
3153
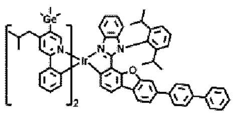
3154
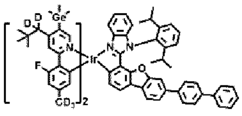
3155

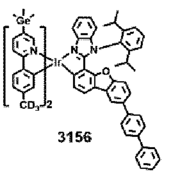
3156
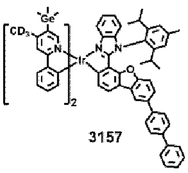
3157
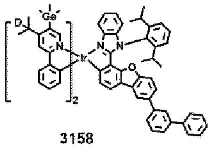
3158
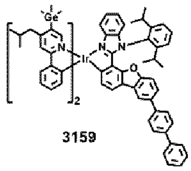
3159
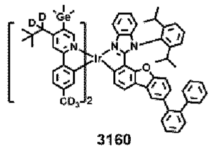
3160

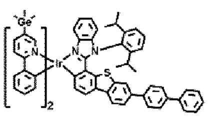
3161
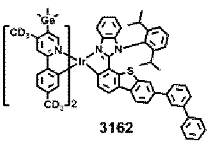
3162
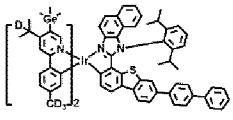
3163
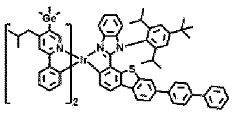
3164
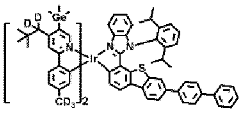
3165

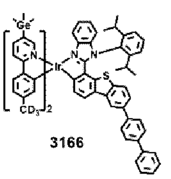
3166
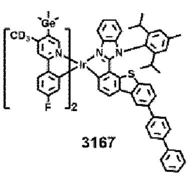
3167
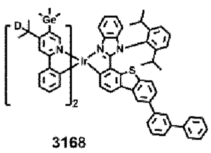
3168
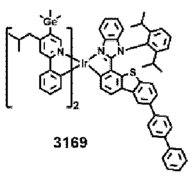
3169
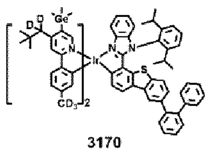
3170

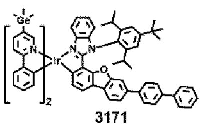
3171
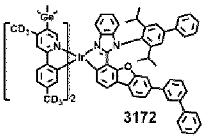
3172
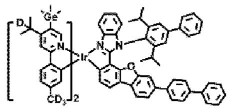
3173
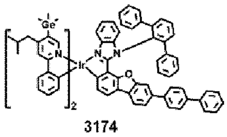
3174
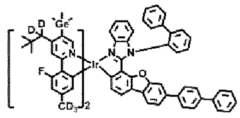
3175

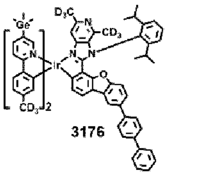
3176
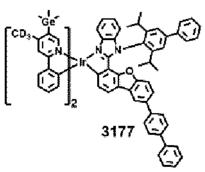
3177
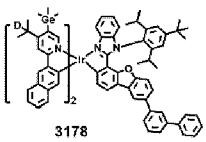
3178
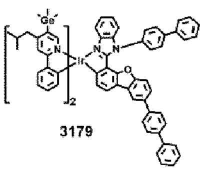
3179
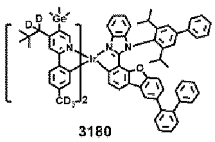
3180

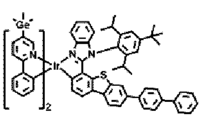
3181
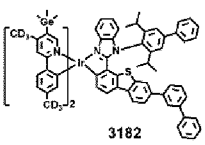
3182
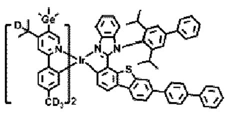
3183
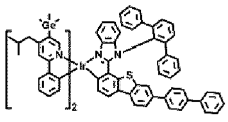
3184
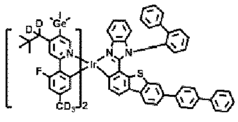
3185

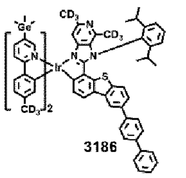
3186
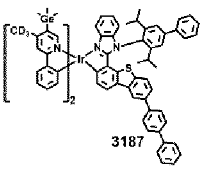
3187
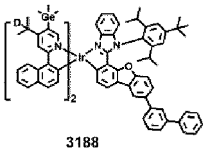
3188
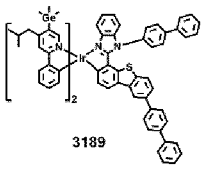
3189
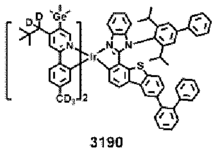
3190

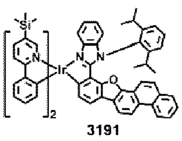
3191
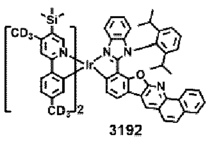
3192
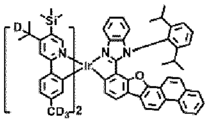
3193
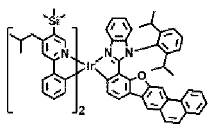
3194
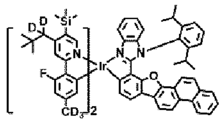
3195

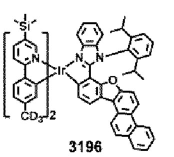
3196
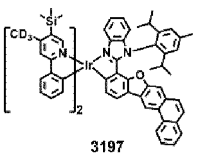
3197
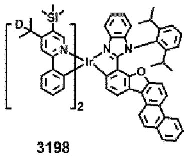
3198
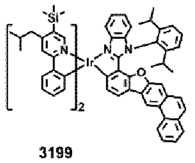
3199
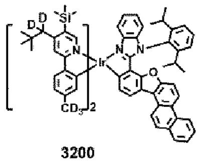
3200

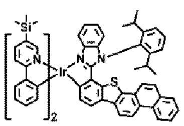
3201
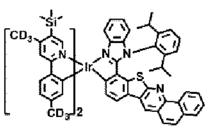
3202
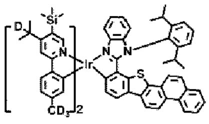
3203
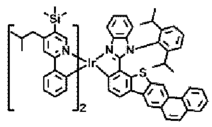
3204
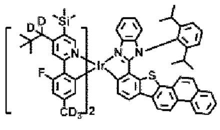
3205

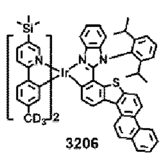
3206
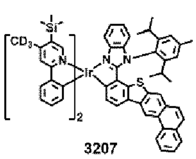
3207
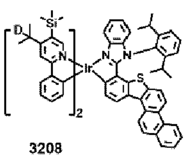
3208
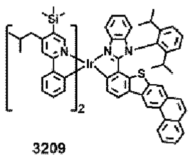
3209
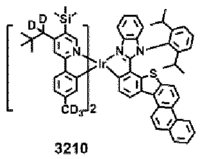
3210

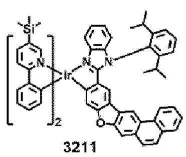
3211
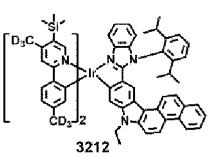
3212
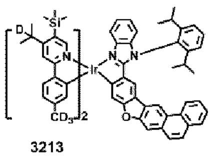
3213
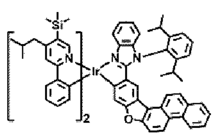
3214
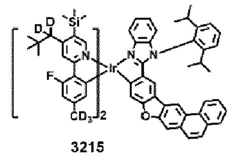
3215

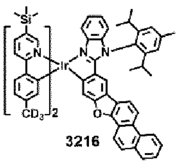
3216
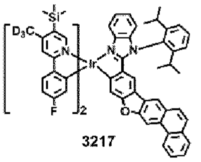
3217
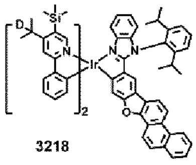
3218
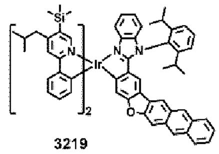
3219
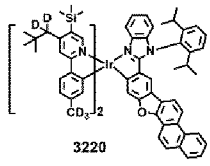
3220

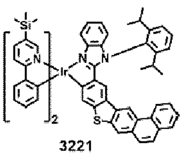
3221
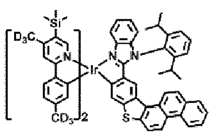
3222
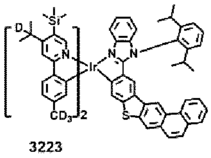
3223
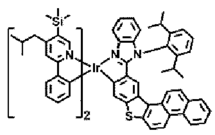
3224
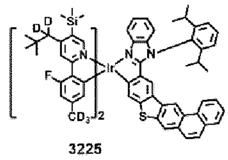
3225

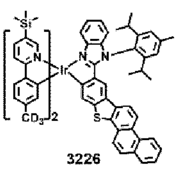
3226
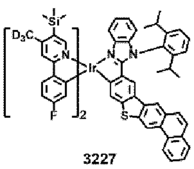
3227
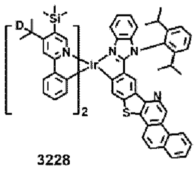
3228
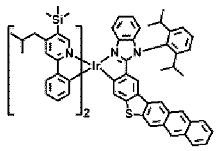
3229
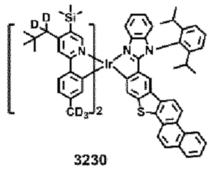
3230

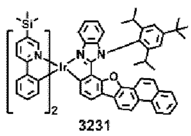
3231
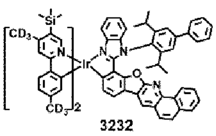
3232
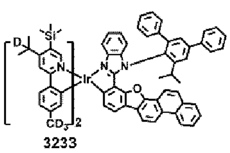
3233
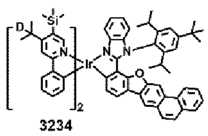
3234
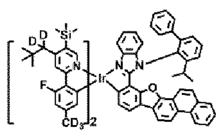
3235

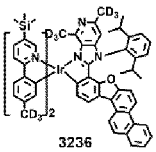
3236
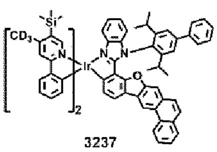
3237
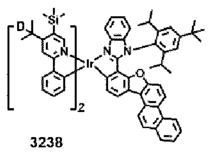
3238
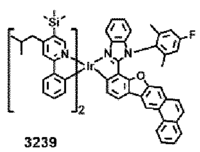
3239
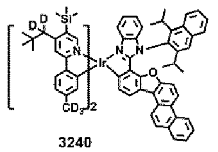
3240

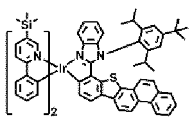
3241
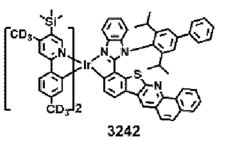
3242
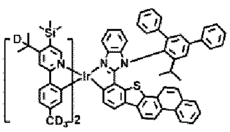
3243
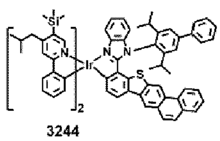
3244
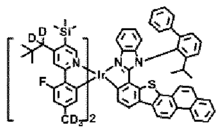
3245

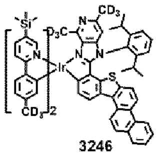
3246
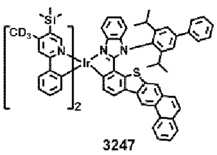
3247
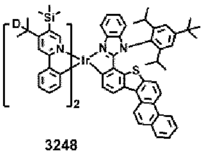
3248
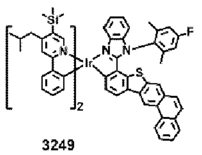
3249
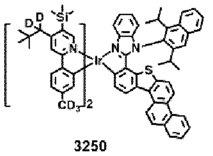
3250

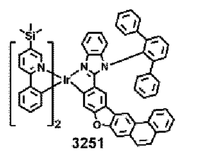
3251
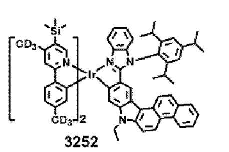
3252
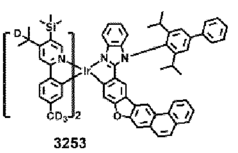
3253
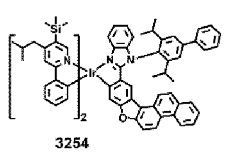
3254
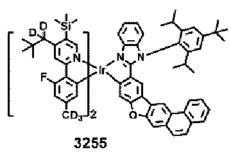
3255

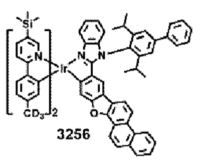
3256
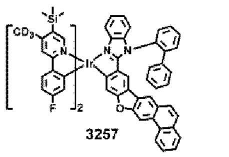
3257
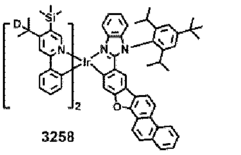
3258
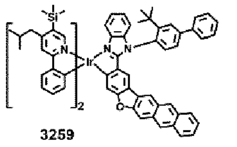
3259
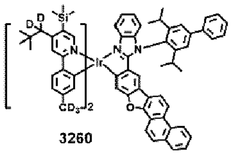
3260

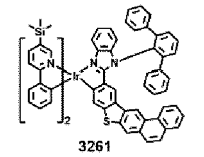
3261
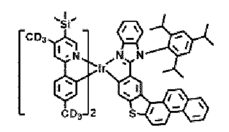
3262
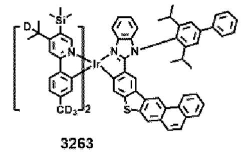
3263
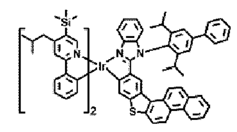
3264
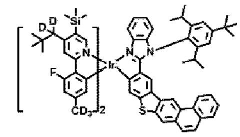
3265

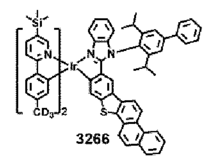
3266
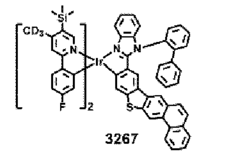
3267
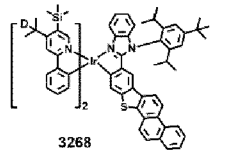
3268
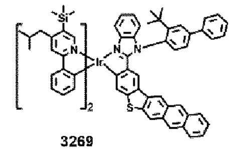
3269
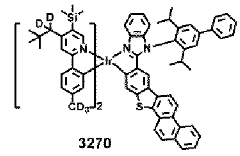
3270

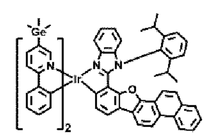
3271
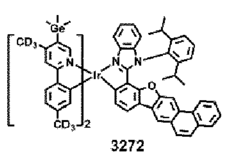
3272
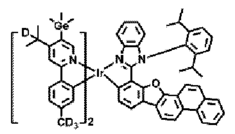
3273
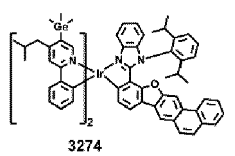
3274
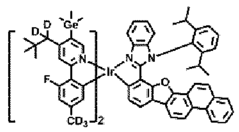
3275

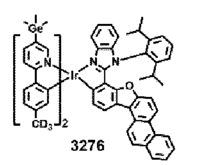
3276
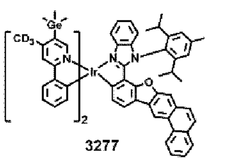
3277
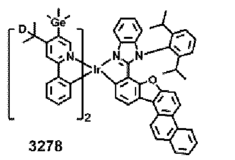
3278
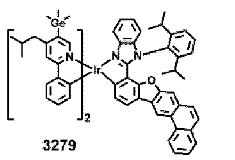
3279
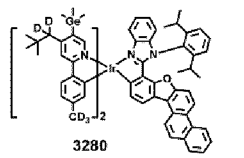
3280

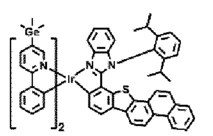
3281
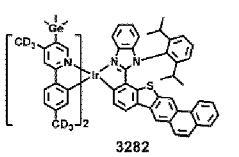
3282
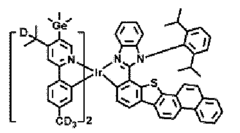
3283
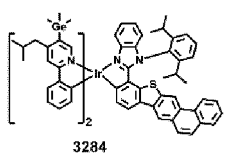
3284
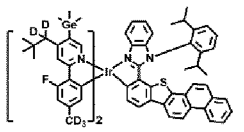
3285

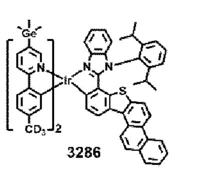
3286
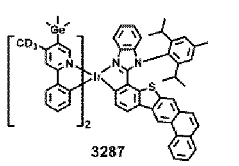
3287
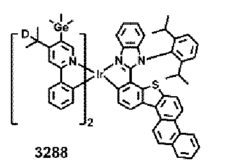
3288
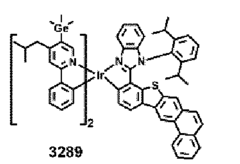
3289
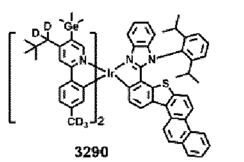
3290

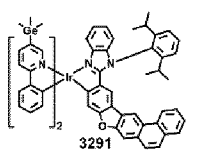
3291
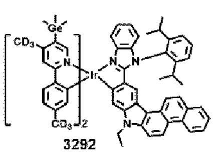
3292
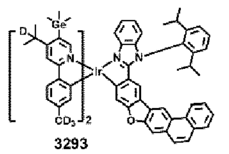
3293
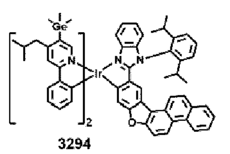
3294
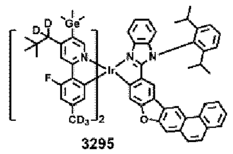
3295

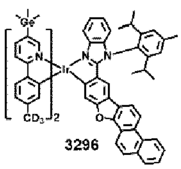
3296
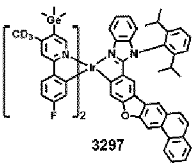
3297
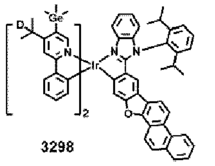
3298
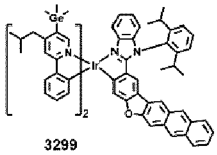
3299
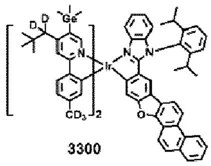
3300

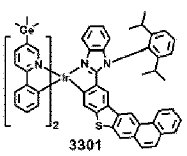
3301
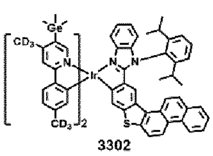
3302
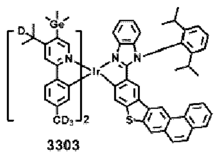
3303
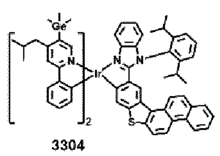
3304
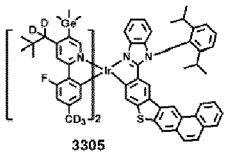
3305

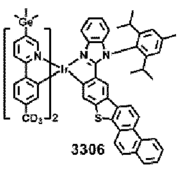
3306
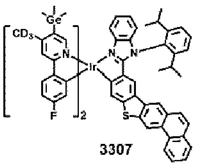
3307
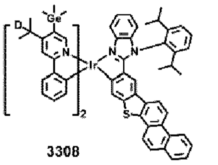
3308
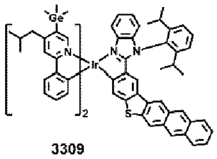
3309
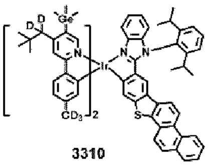
3310

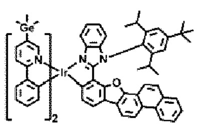
3311
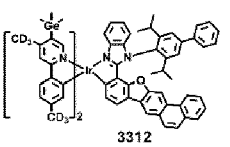
3312
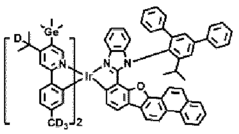
3313
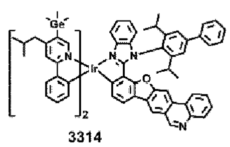
3314
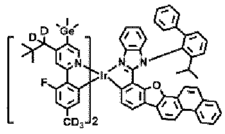
3315

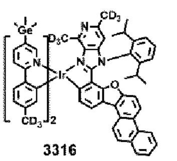
3316
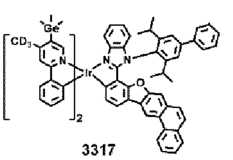
3317
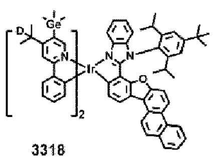
3318
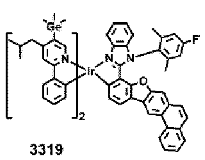
3319
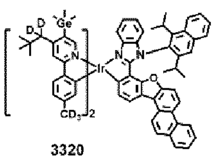
3320

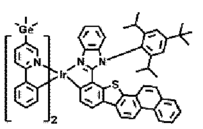
3321
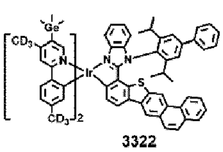
3322
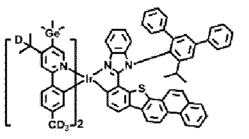
3323
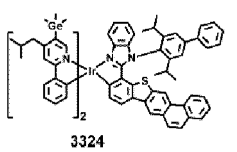
3324
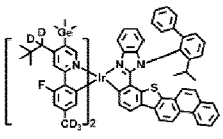
3325

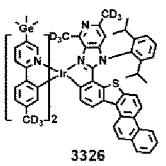
3326
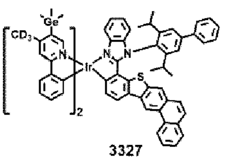
3327
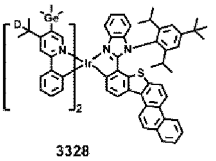
3328
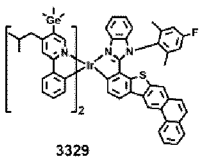
3329
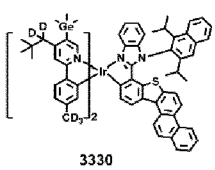
3330

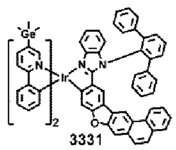 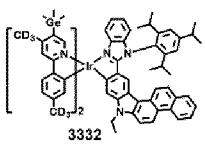 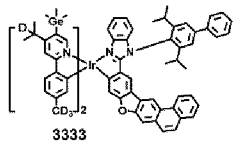 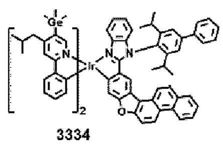 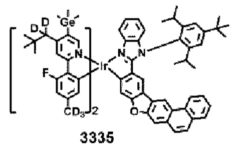

3331 3332 3333 3334 3335

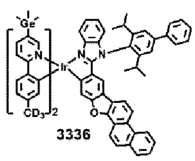 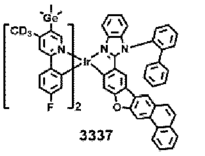 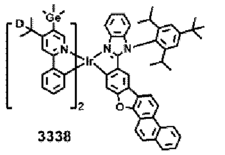 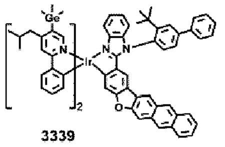 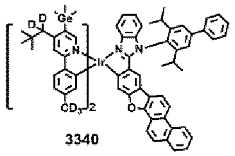

3336 3337 3338 3339 3340

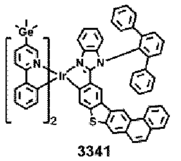 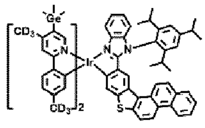 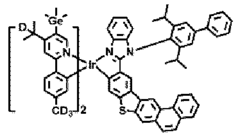 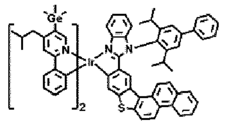 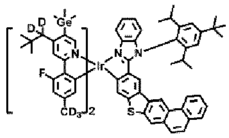

3341 3342 3343 3344 3345

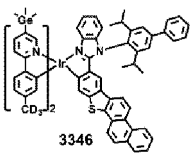 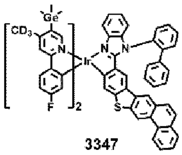 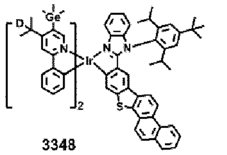 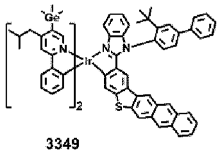 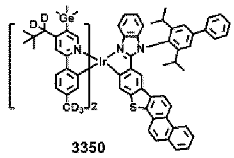

3346 3347 3348 3349 3350

## Group 2-2

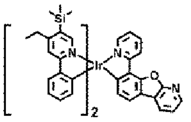 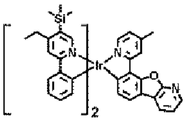 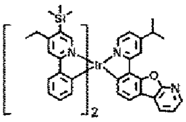 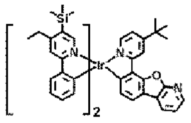 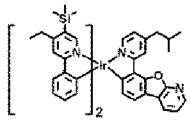

1 2 3 4 5

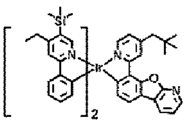 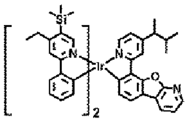 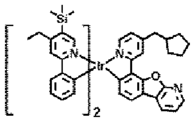 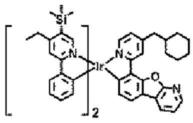 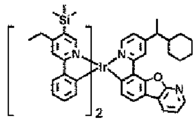

6 7 8 9 10

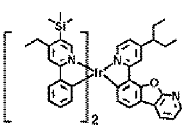 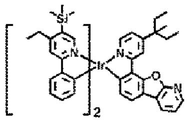 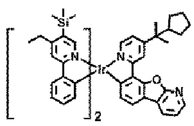 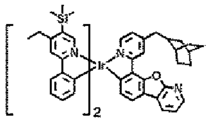 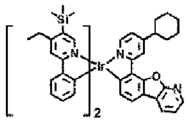

11 12 13 14 15

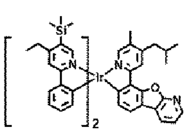 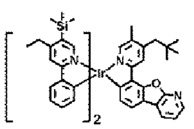 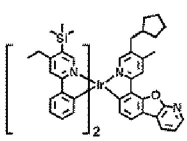 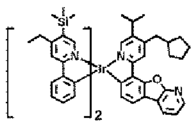 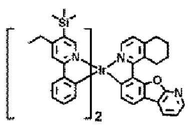

16 17 18 19 20

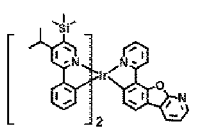
21

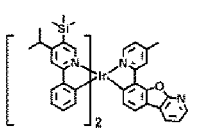
22

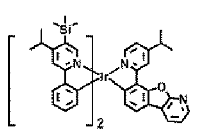
23

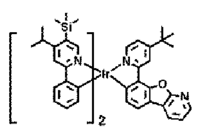
24

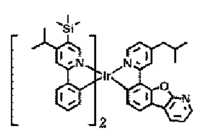
25

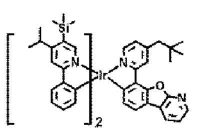
26

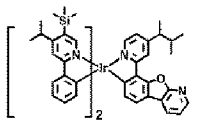
27

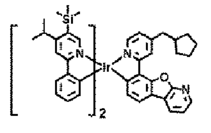
28

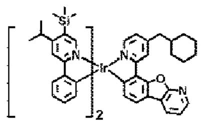
29

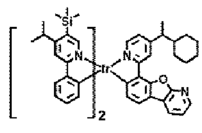
30

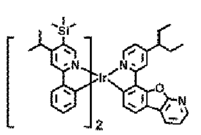
31

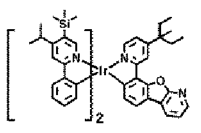
32

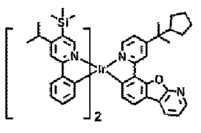
33

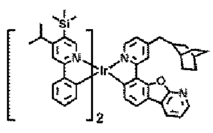
34

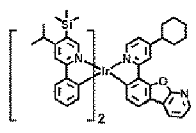
35

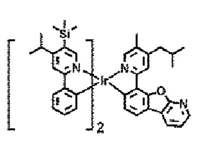
36

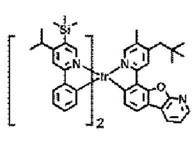
37

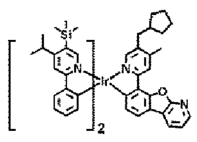
38

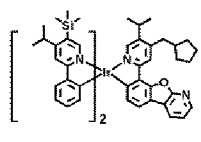
39

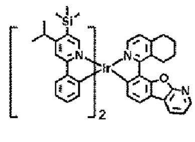
40

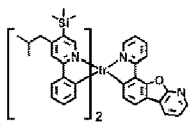
41

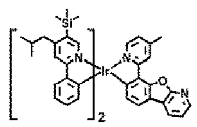
42

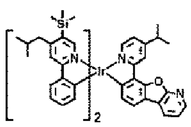
43

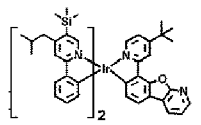
44

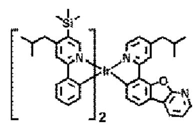
45

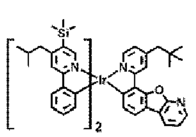
46

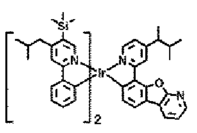
47

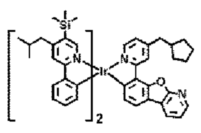
48

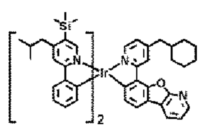
49

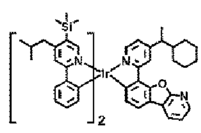
50

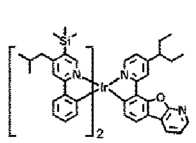
51

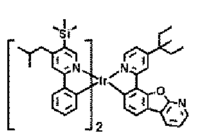
52

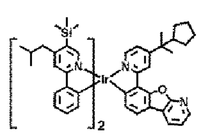
53

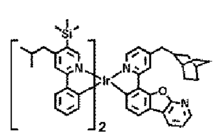
54

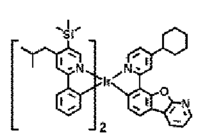
55

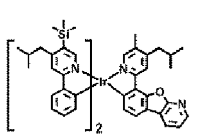
56

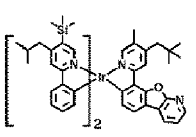
57

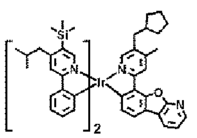
58

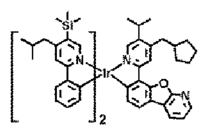
59

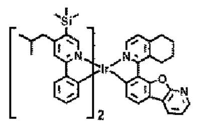
60

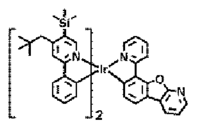
61

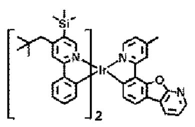
62

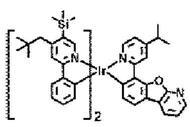
63

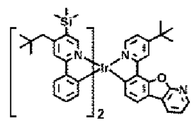
64

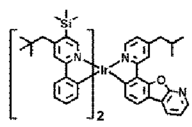
65

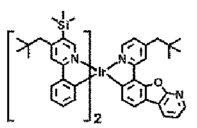
66

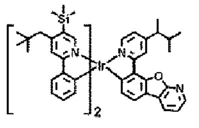
67

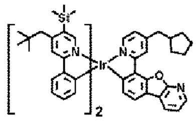
68

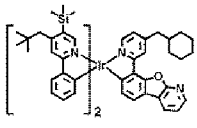
69

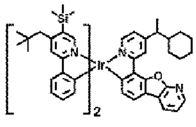
70

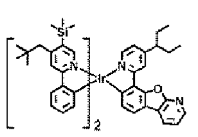
71

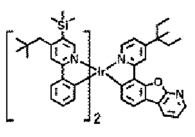
72

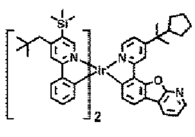
73

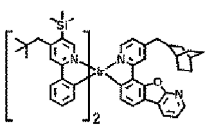
74

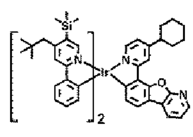
75

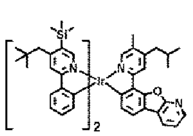
76

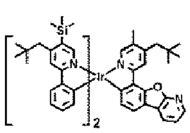
77

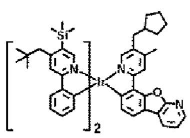
78

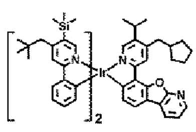
79

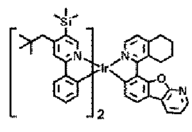
80

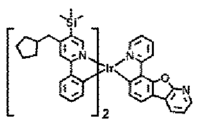
81

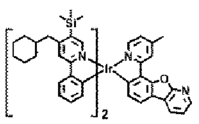
82

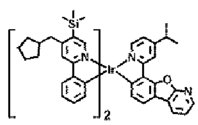
83

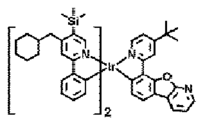
84

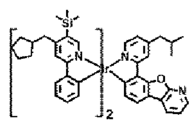
85

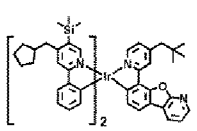
86

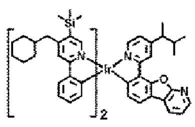
87

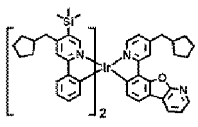
88

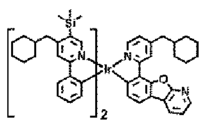
89

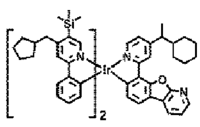
90

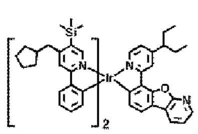
91

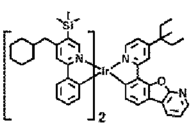
92

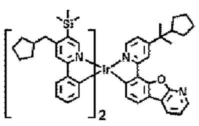
93

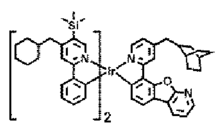
94

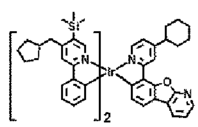
95

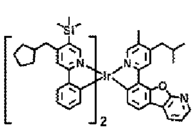
96

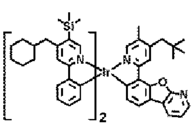
97

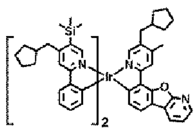
98

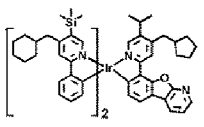
99

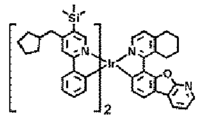
100

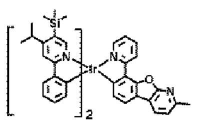
101
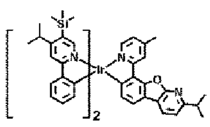
102
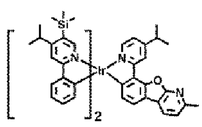
103
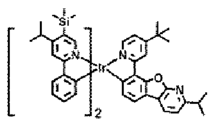
104
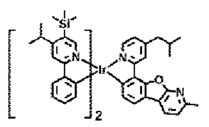
105

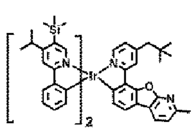
106
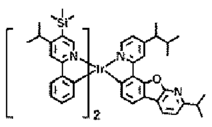
107
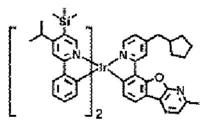
108
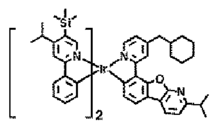
109
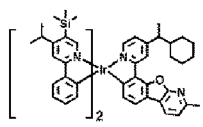
110

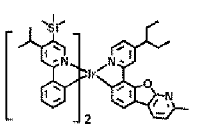
111
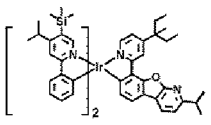
112
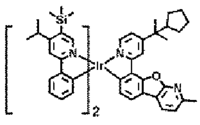
113
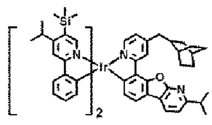
114
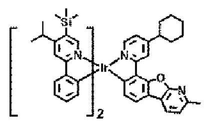
115

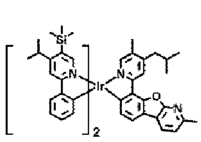
116
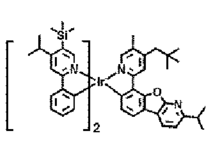
117
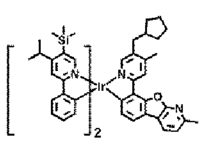
118
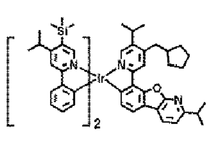
119
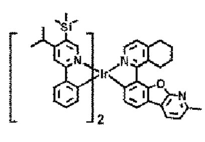
120

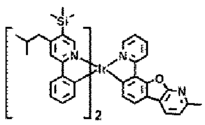
121
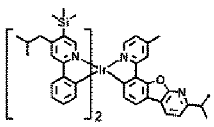
122
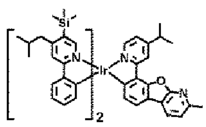
123
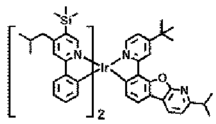
124
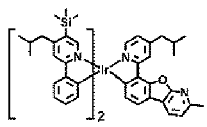
125

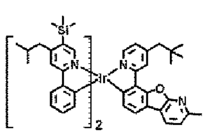
126
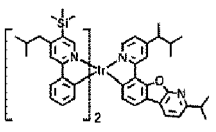
127
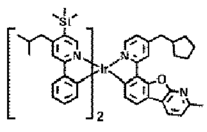
128
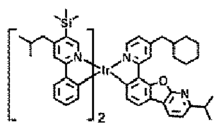
129
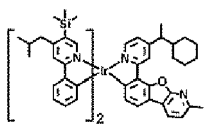
130

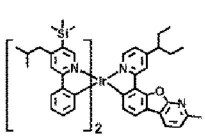
131
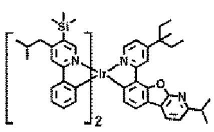
132
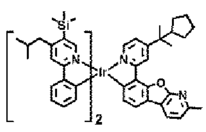
133
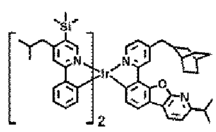
134
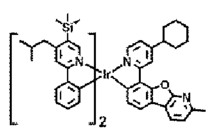
135

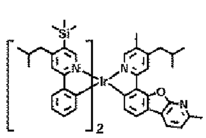
136
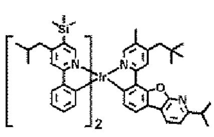
137
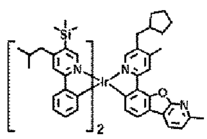
138
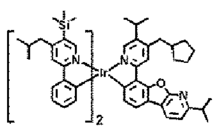
139
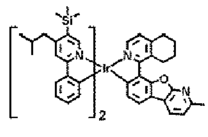
140

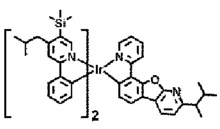
141
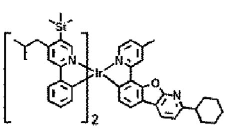
142
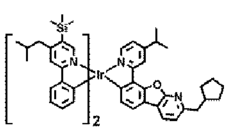
143
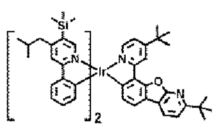
144
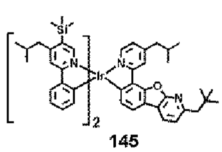
145

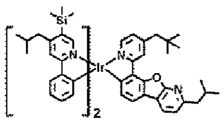
146
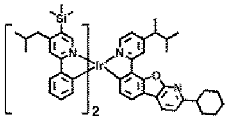
147
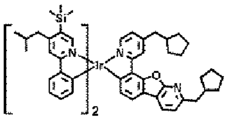
148
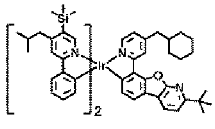
149
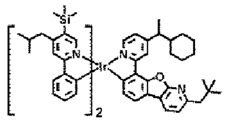
150

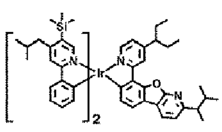
151
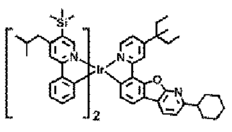
152
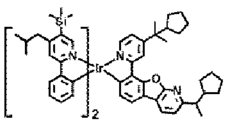
153
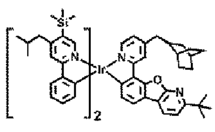
154
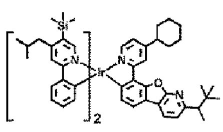
155

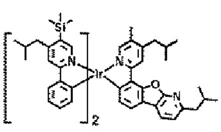
156
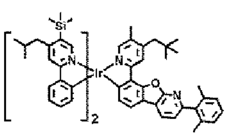
157
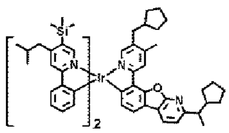
158
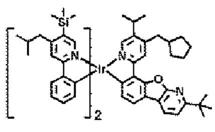
159
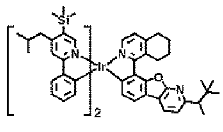
160

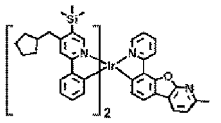
161
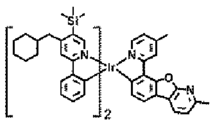
162
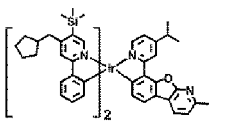
163
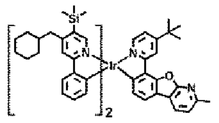
164
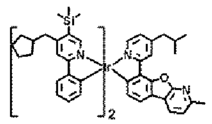
165

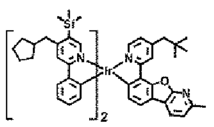
166
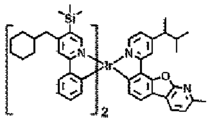
167
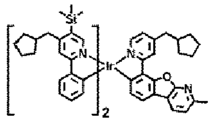
168
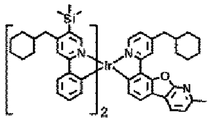
169
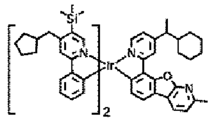
170

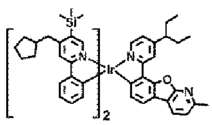
171
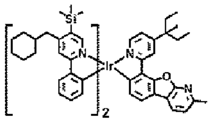
172
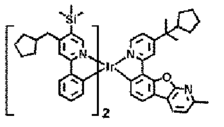
173
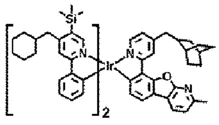
174
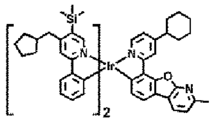
175

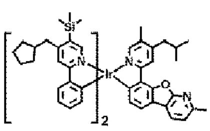
176
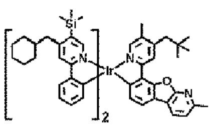
177
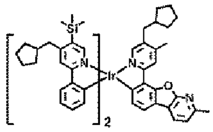
178
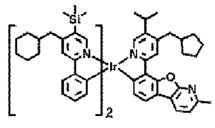
179
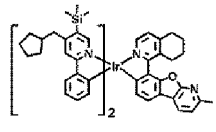
180

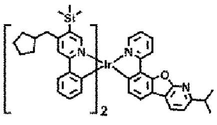
181
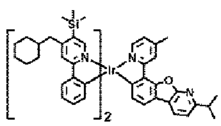
182
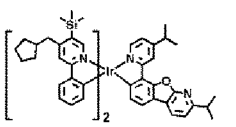
183
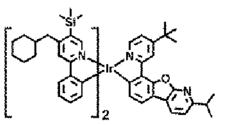
184
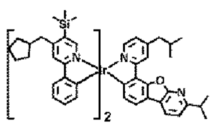
185

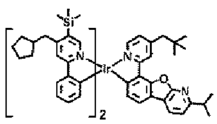
186
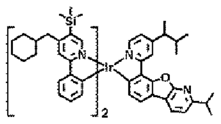
187
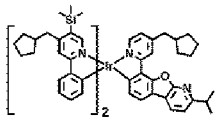
188
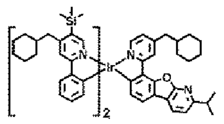
189
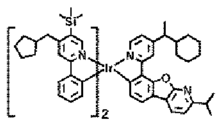
190

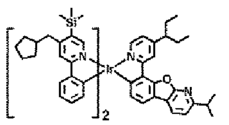
191
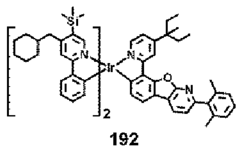
192
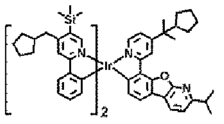
193
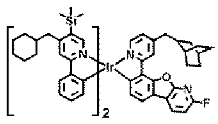
194
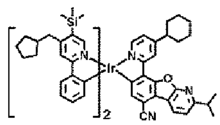
195

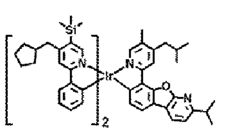
196
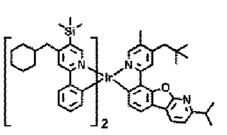
197
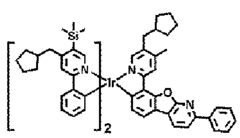
198
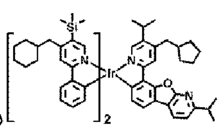
199
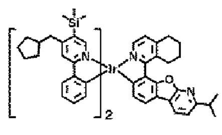
200

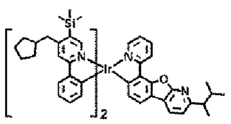
201
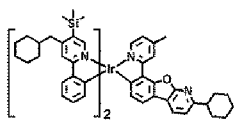
202
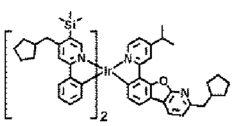
203
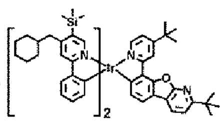
204
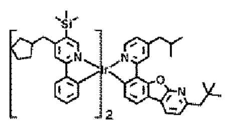
205

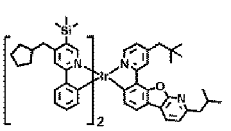
206
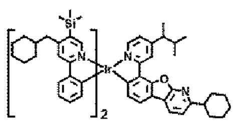
207
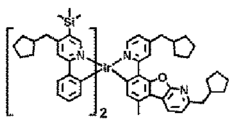
208
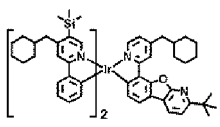
209
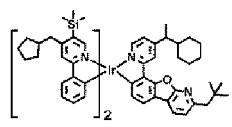
210

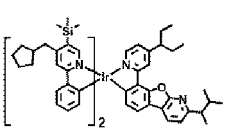
211
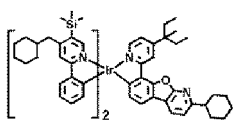
212
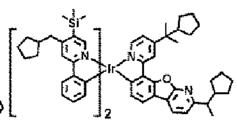
213
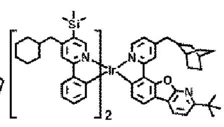
214
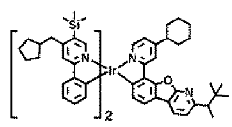
215

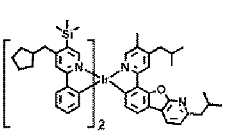
216
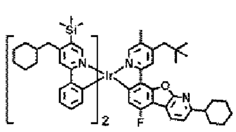
217
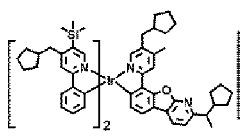
218
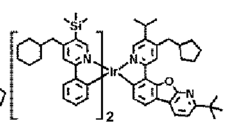
219
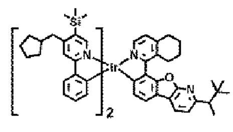
220

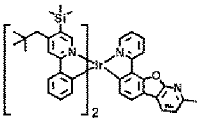
221
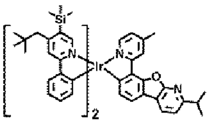
222
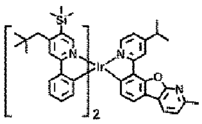
223
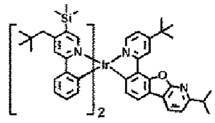
224
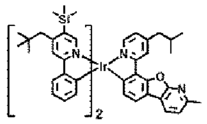
225

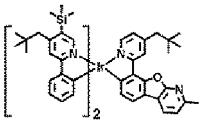
226
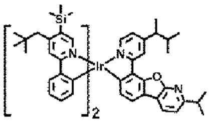
227
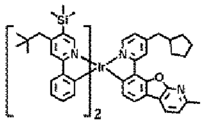
228
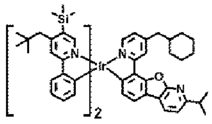
229
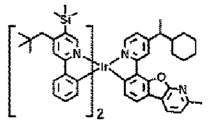
230

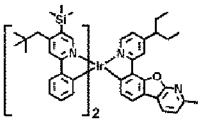
231
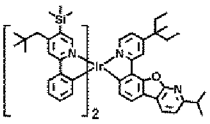
232
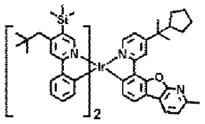
233
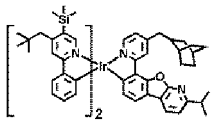
234
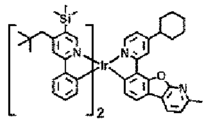
235

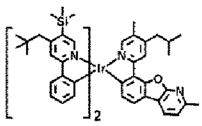
236
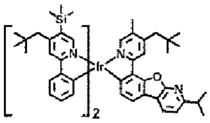
237
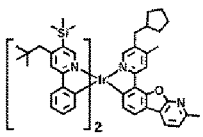
238
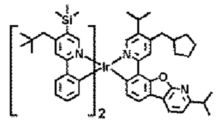
239
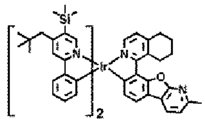
240

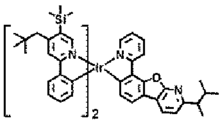
241
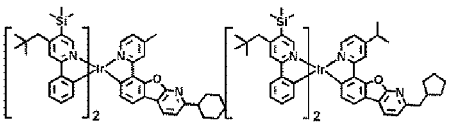
242
243
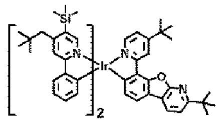
244
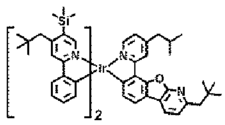
245

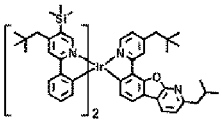
246
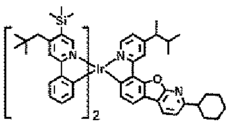
247
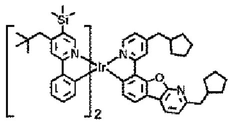
248
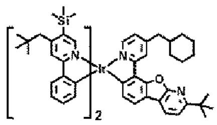
249
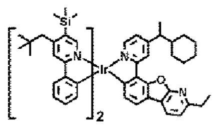
250

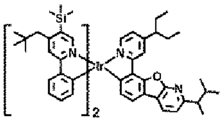
251
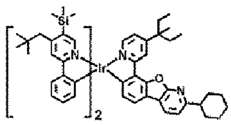
252
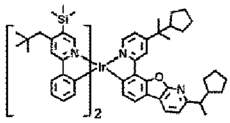
253
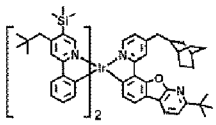
254
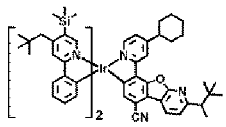
255

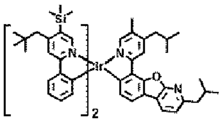
256
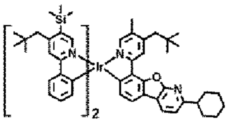
257
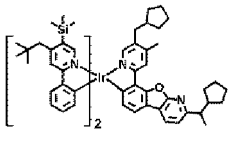
258
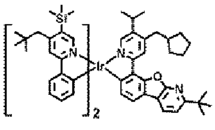
259
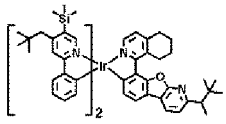
260

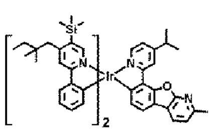
261
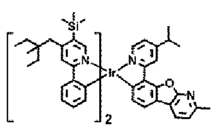
262
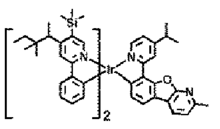
263
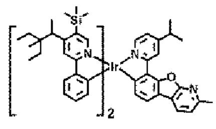
264
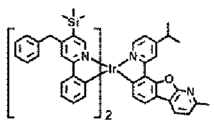
265
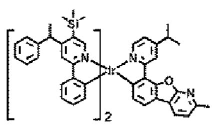
266
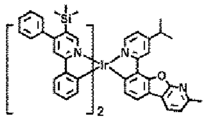
267
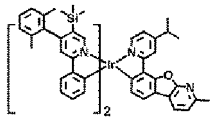
268
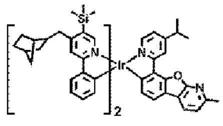
269
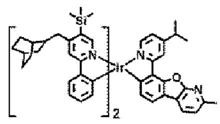
270
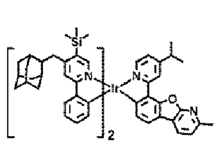
271
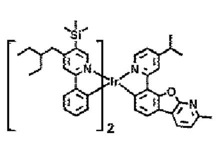
272
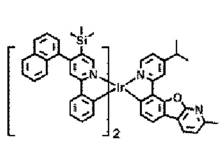
273
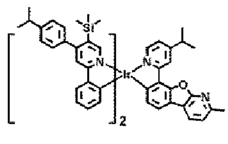
274
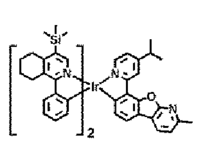
275
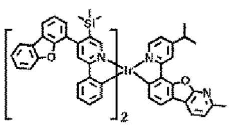
276
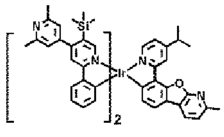
277
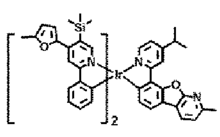
278
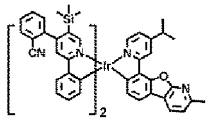
279
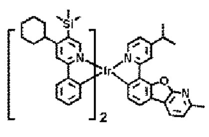
280
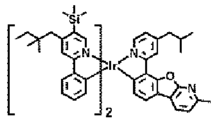
281
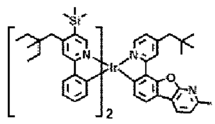
282
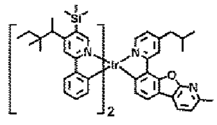
283
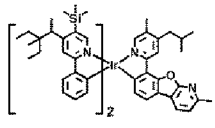
284
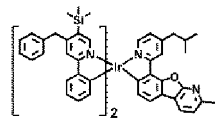
285
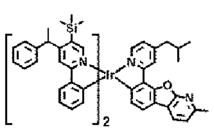
286
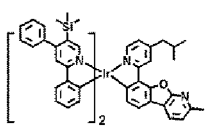
287
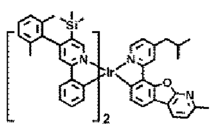
288
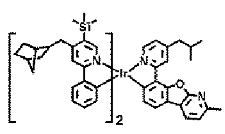
289
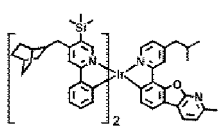
290
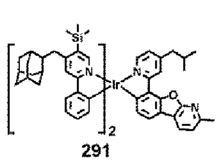
291
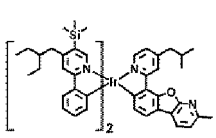
292
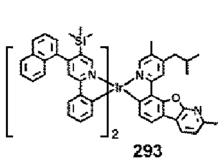
293
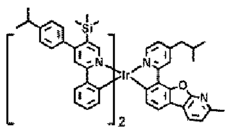
294
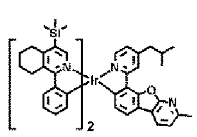
295
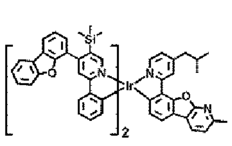
296
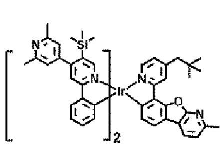
297
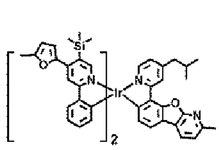
298
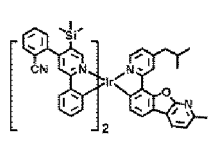
299
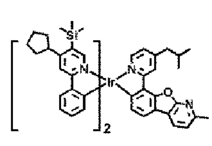
300

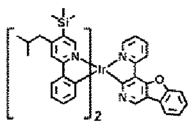
301

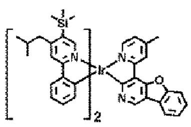
302

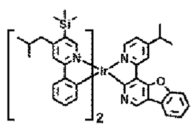
303

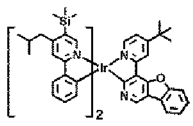
304

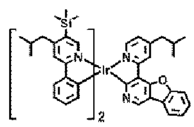
305

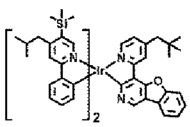
306

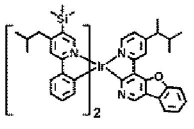
307

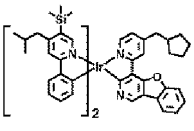
308

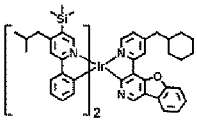
309

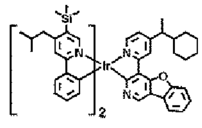
310

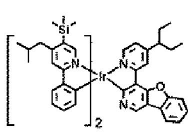
311

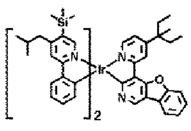
312

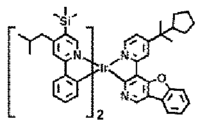
313

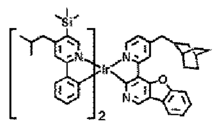
314

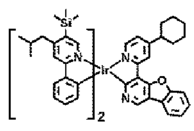
315

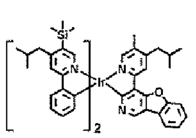
316

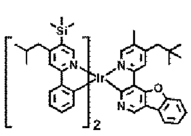
317

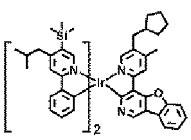
318

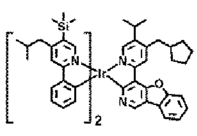
319

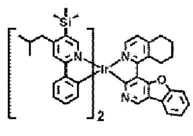
320

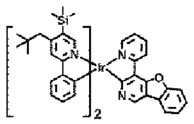
321

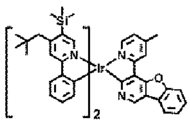
322

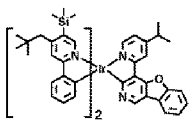
323

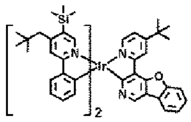
324

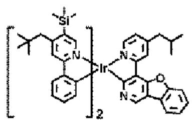
325

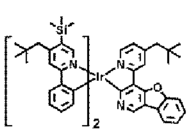
326

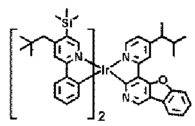
327

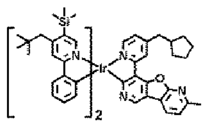
328

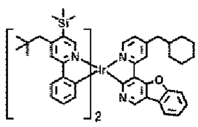
329

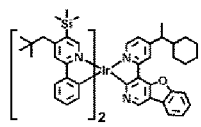
330

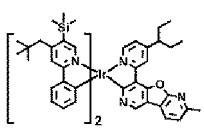
331

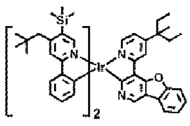
332

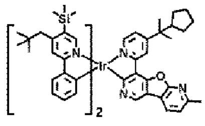
333

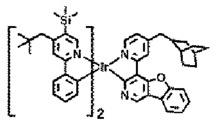
334

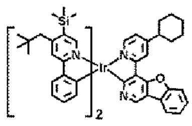
335

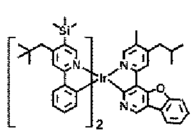
336

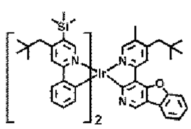
337

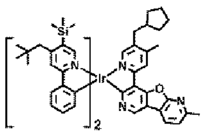
338

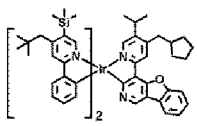
339

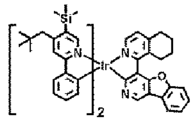
340

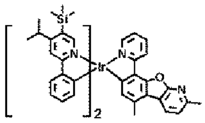
341

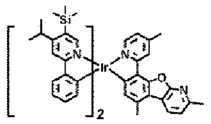
342

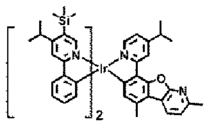
343

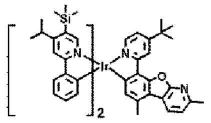
344

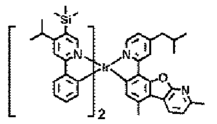
345

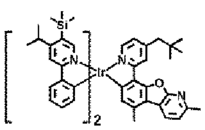
346

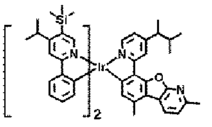
347

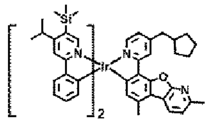
348

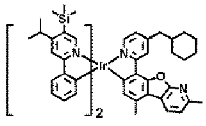
349

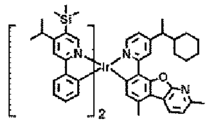
350

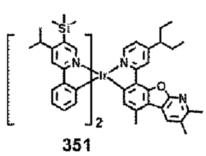
351

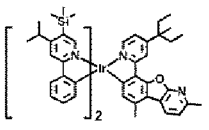
352

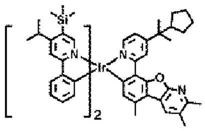
353

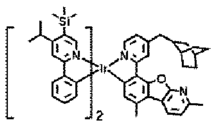
354

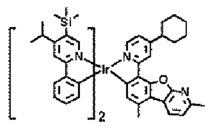
355

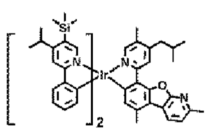
356

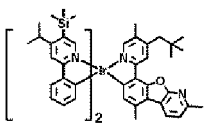
357

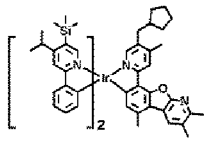
358

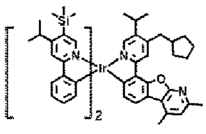
359

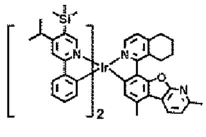
360

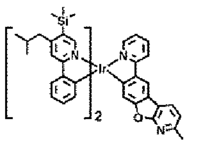
361

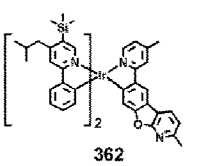
362

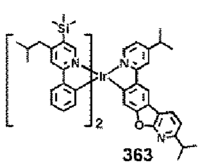
363

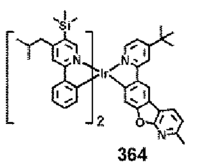
364

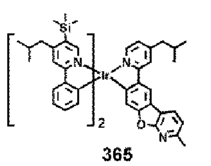
365

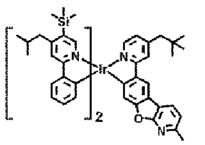
366

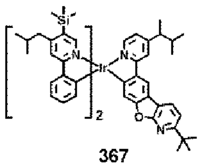
367

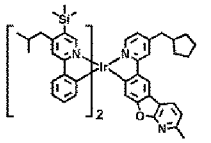
368

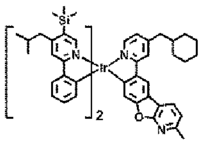
369

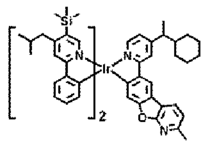
370

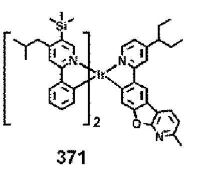
371

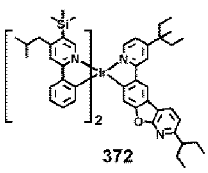
372

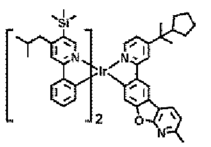
373

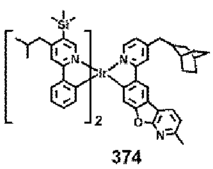
374

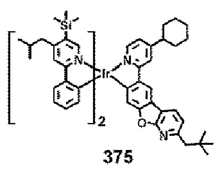
375

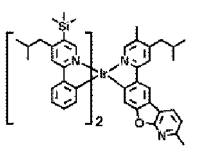
376

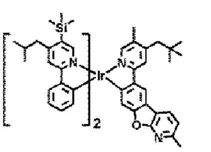
377

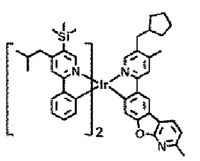
378

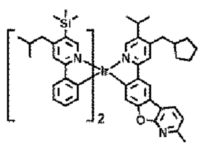
379

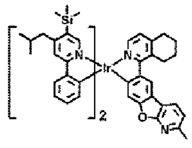
380

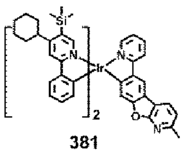
381
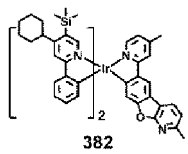
382
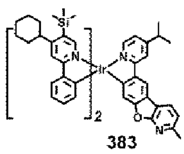
383
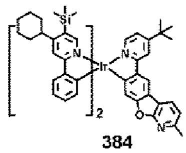
384
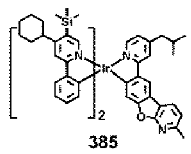
385
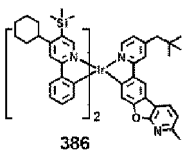
386
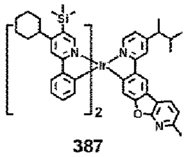
387
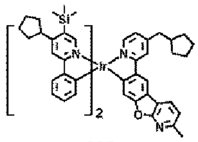
388
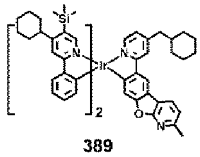
389
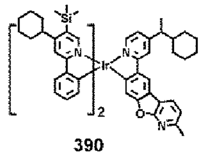
390
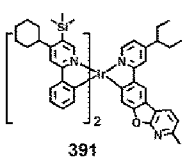
391
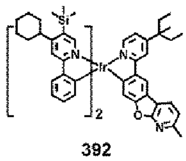
392
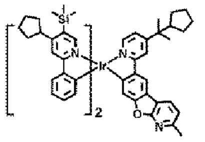
393
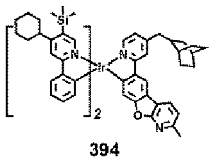
394
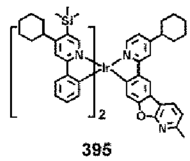
395
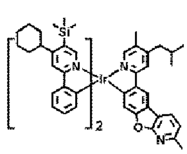
396
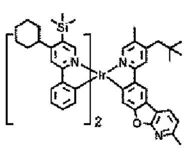
397
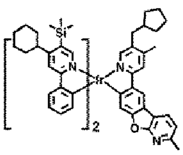
398
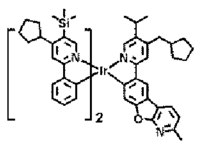
399
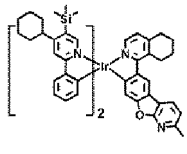
400
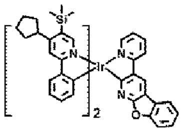
401
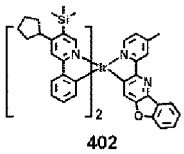
402
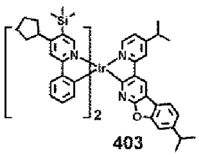
403
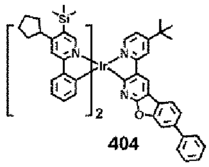
404
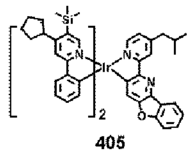
405
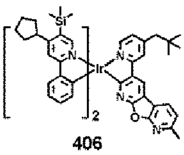
406
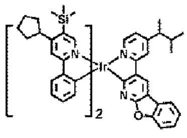
407
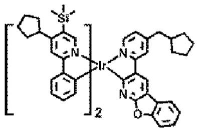
408
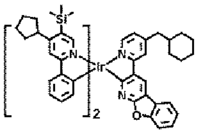
409
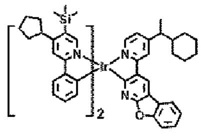
410
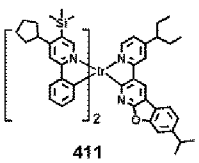
411
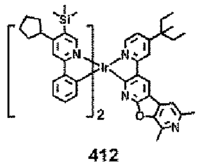
412
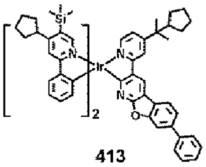
413
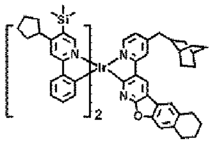
414
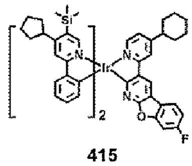
415
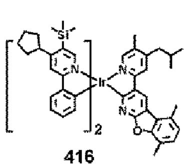
416
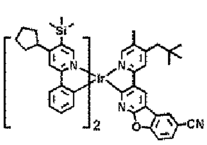
417
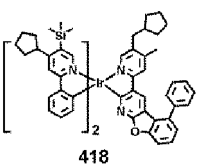
418
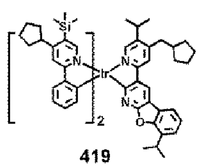
419
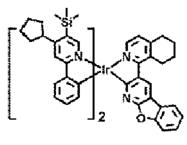
420

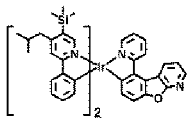
421
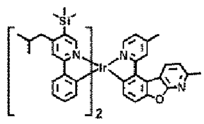
422
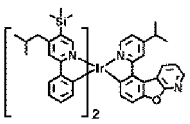
423
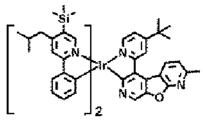
424
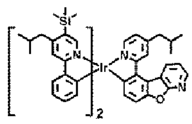
425

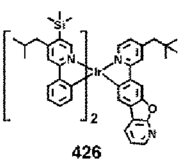
426
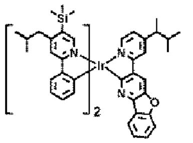
427
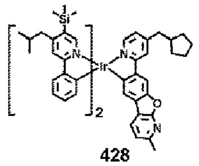
428
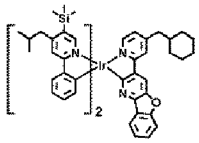
429
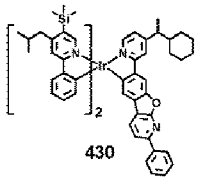
430

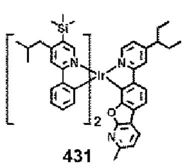
431
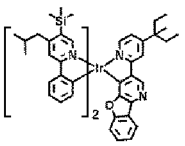
432
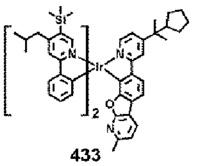
433
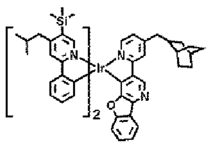
434
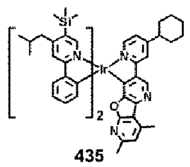
435

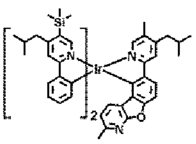
436
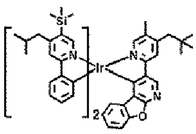
437
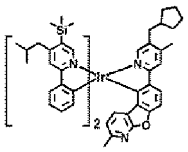
438
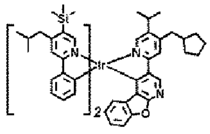
439
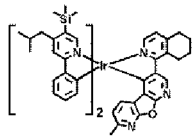
440

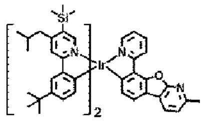
441
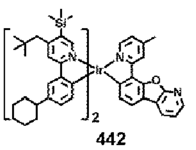
442
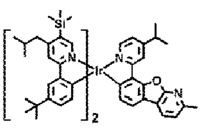
443
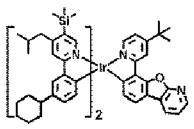
444
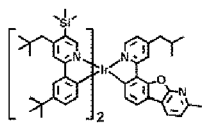
445

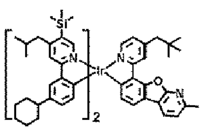
446
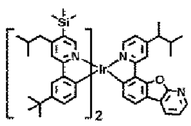
447
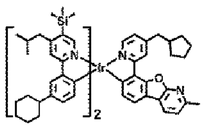
448
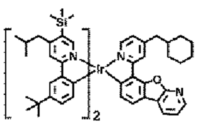
449
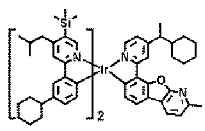
450

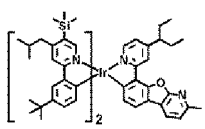
451
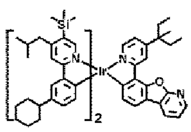
452
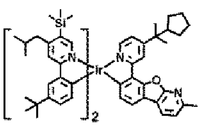
453
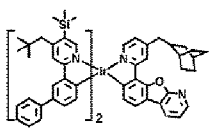
454
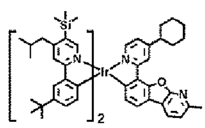
455

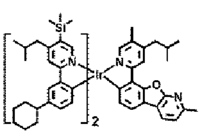
456
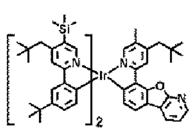
457
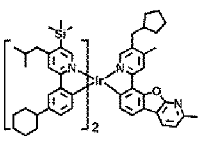
458
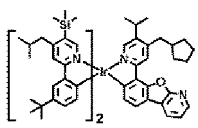
459
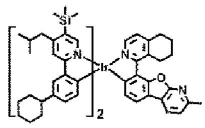
460

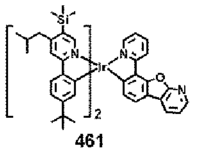
461

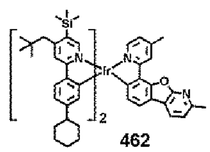
462

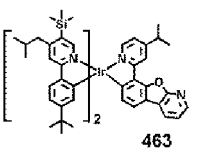
463

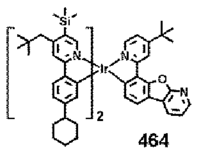
464

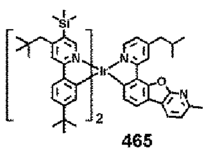
465

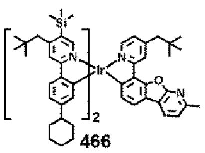
466

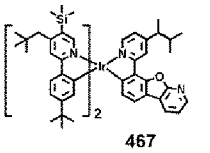
467

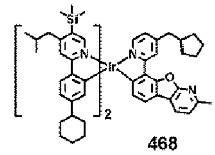
468

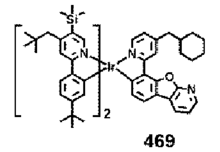
469

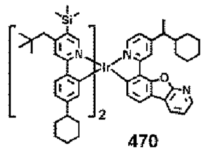
470

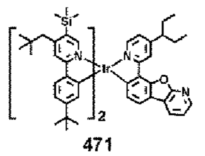
471

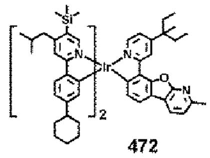
472

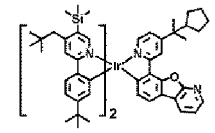
473

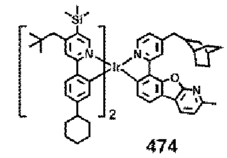
474

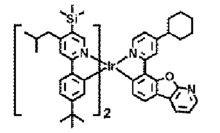
475

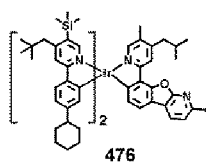
476

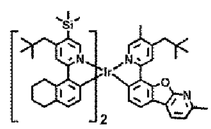
477

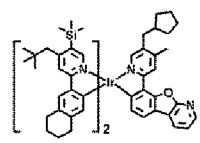
478

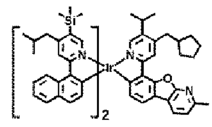
479

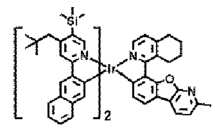
480

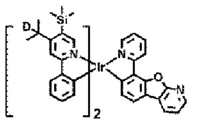
481

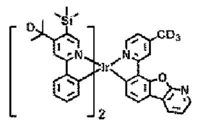
482

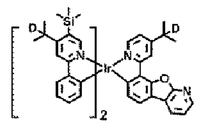
483

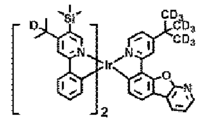
484

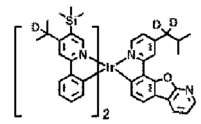
485

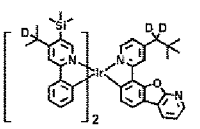
486

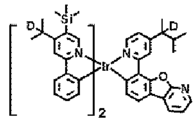
487

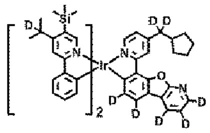
488

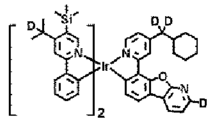
489

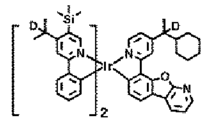
490

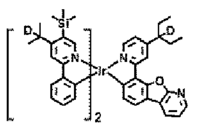
491

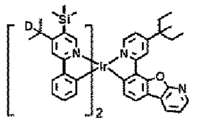
492

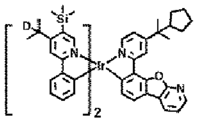
493

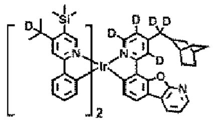
494

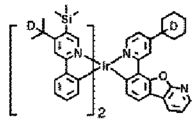
495

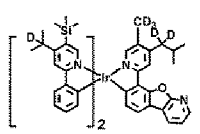
496

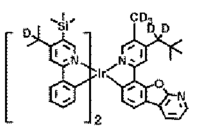
497

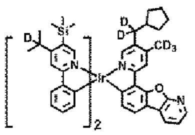
498

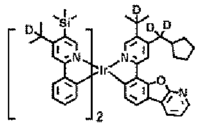
499

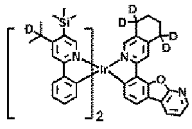
500

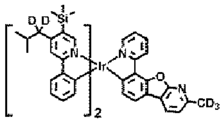
501
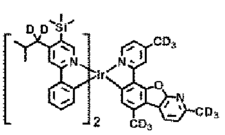
502
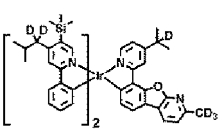
503
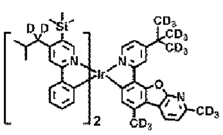
504
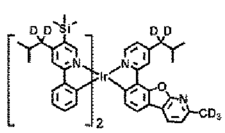
505

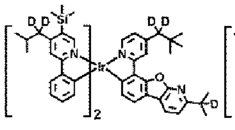
506
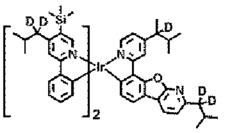
507
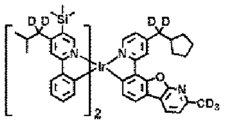
508
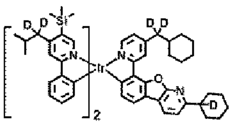
509
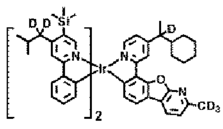
510

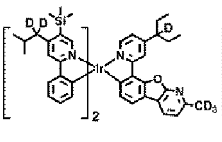
511
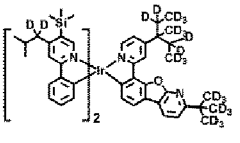
512
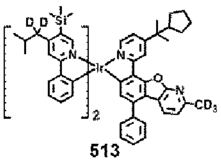
513
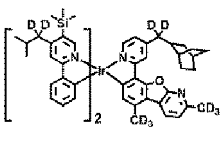
514
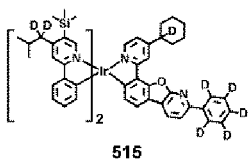
515

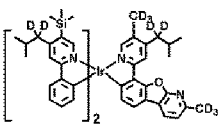
516
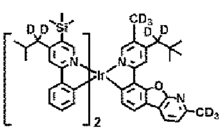
517
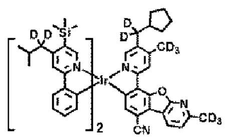
518
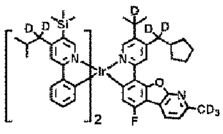
519
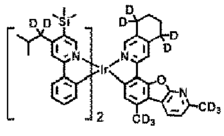
520

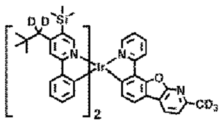
521
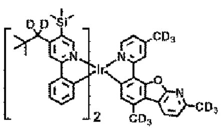
522
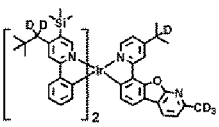
523
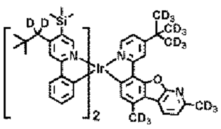
524
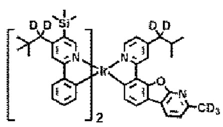
525

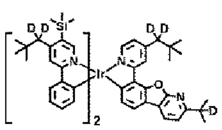
526
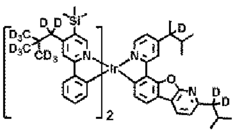
527
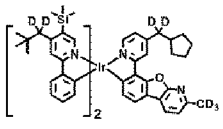
528
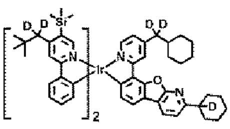
529
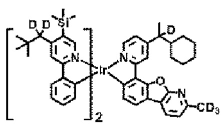
530

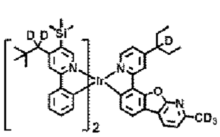
531
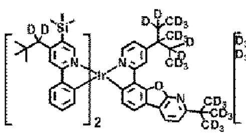
532
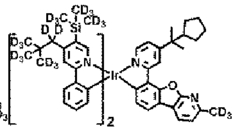
533
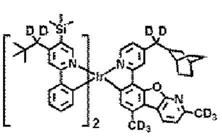
534
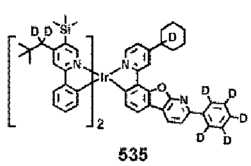
535

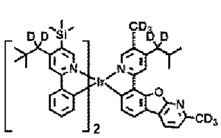
536
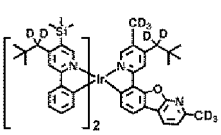
537
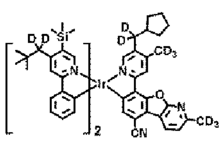
538
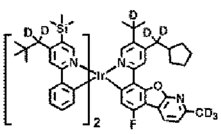
539
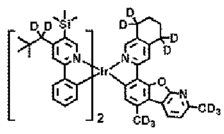
540

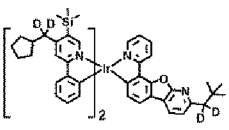
541
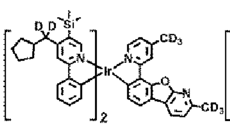
542
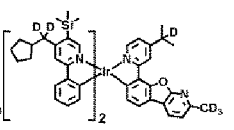
543
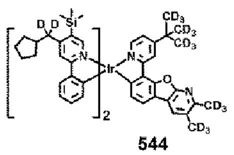
544
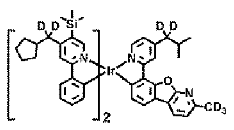
545

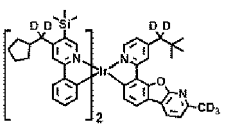
546
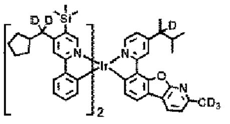
547
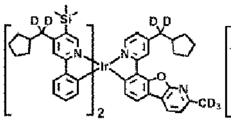
548
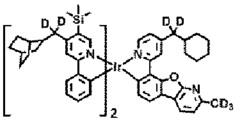
549
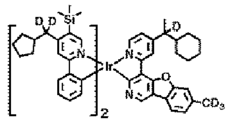
550

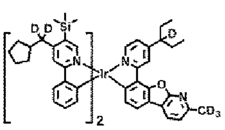
551
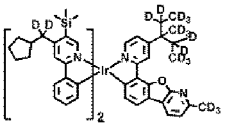
552
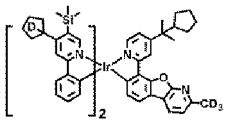
553
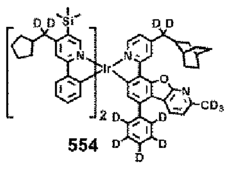
554
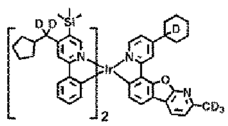
555

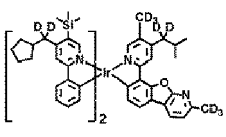
556
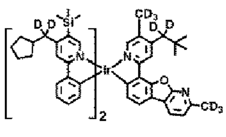
557
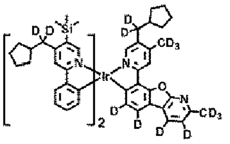
558
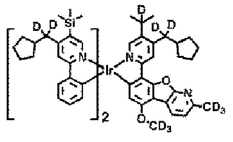
559
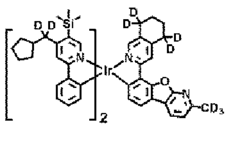
560

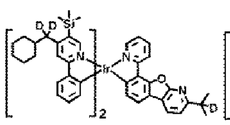
561
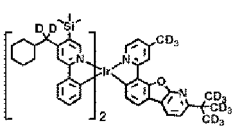
562
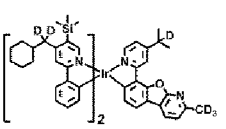
563
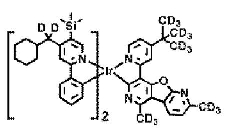
564
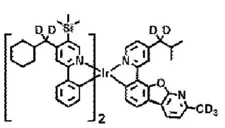
565

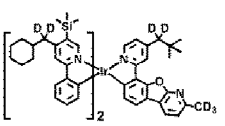
566
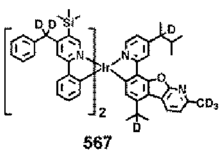
567
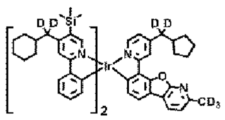
568
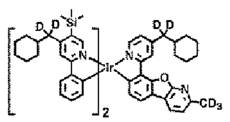
569
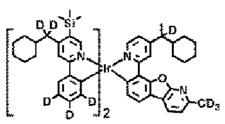
570

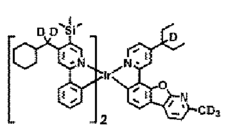
571
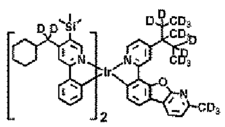
572
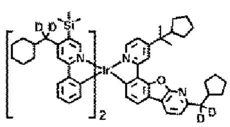
573
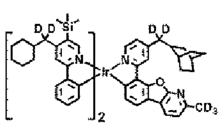
574
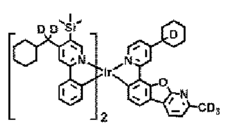
575

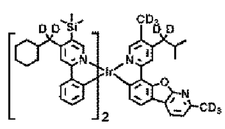
576
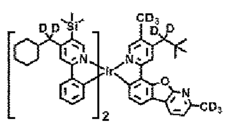
577
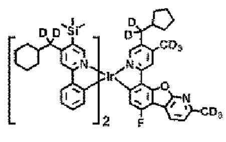
578
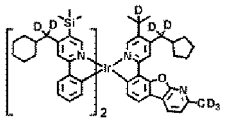
579
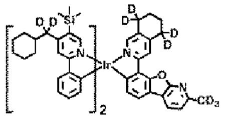
580

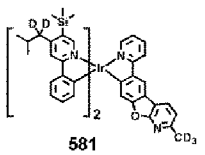
581

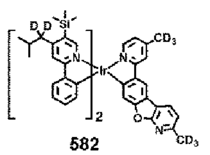
582

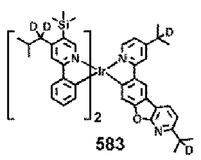
583

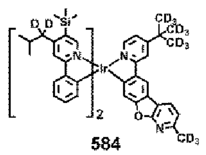
584

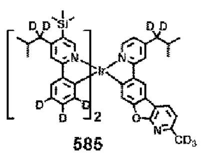
585

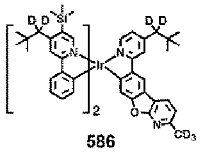
586

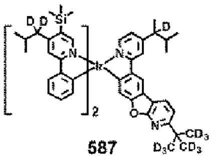
587

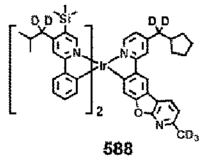
588

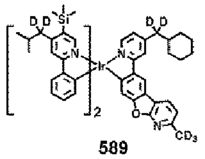
589

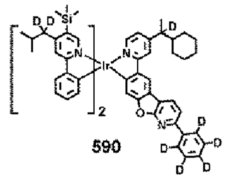
590

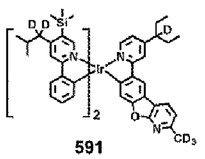
591

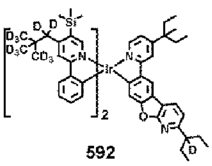
592

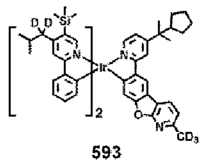
593

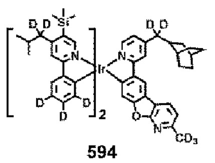
594

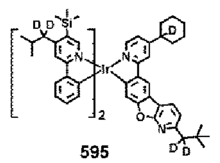
595

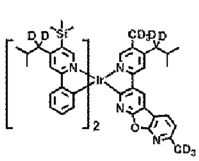
596

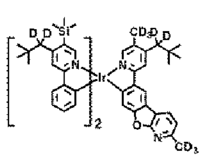
597

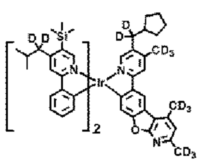
598

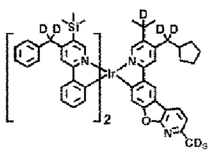
599

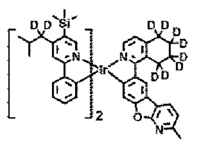
600

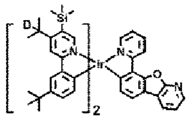
601

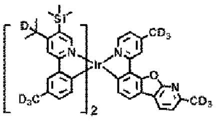
602

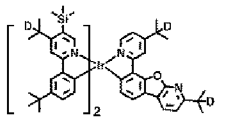
603

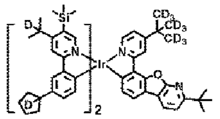
604

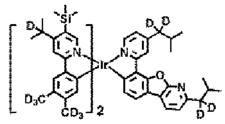
605

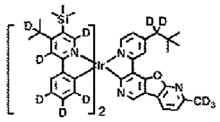
606

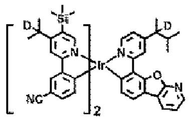
607

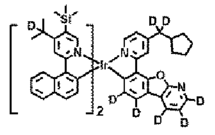
608

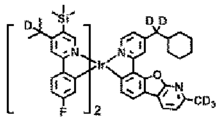
609

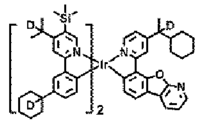
610

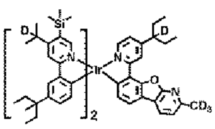
611

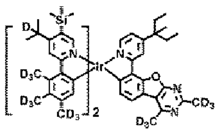
612

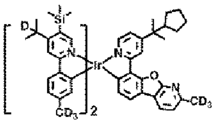
613

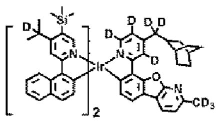
614

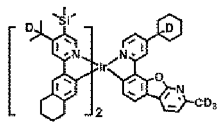
615

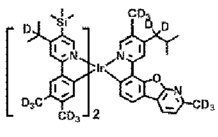
616

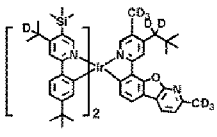
617

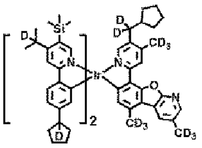
618

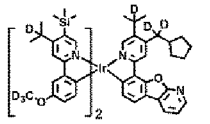
619

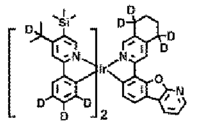
620

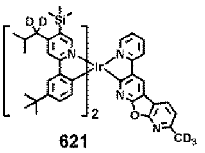
621

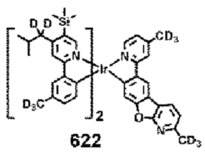
622

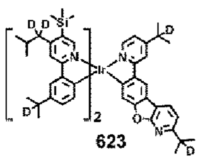
623

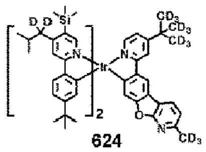
624

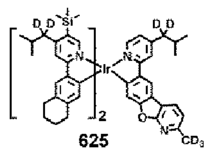
625

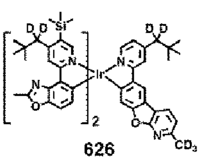
626

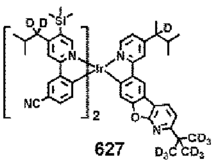
627

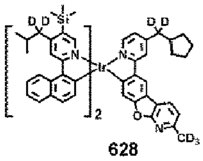
628

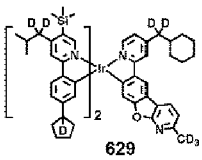
629

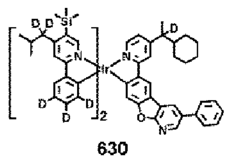
630

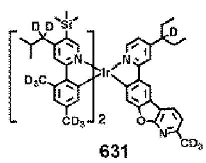
631

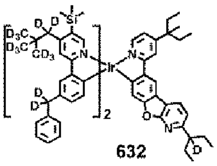
632

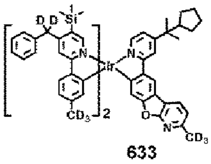
633

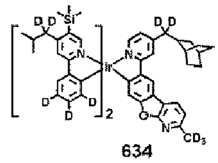
634

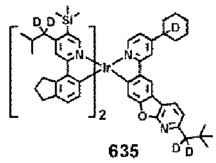
635

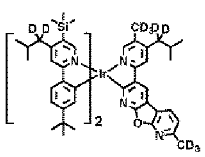
636

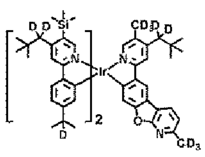
637

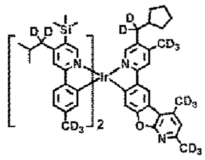
638

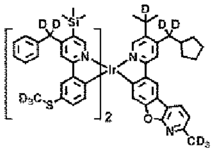
639

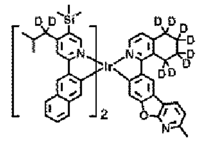
640

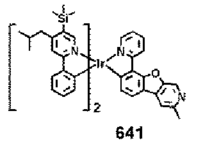
641

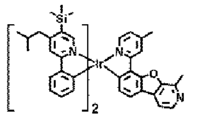
642

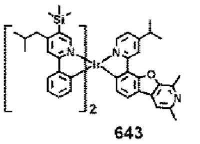
643

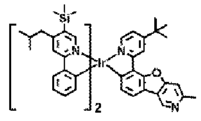
644

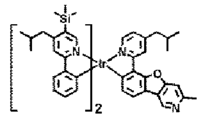
645

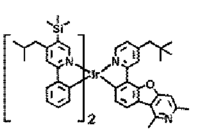
646

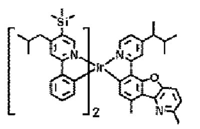
647

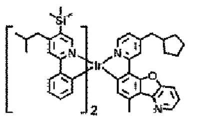
648

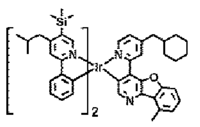
649

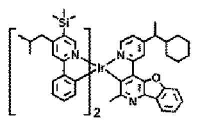
650

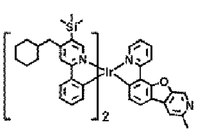
651

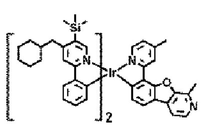
652

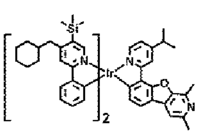
653

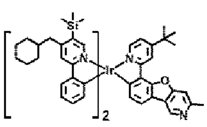
654

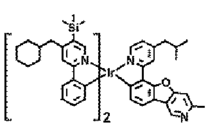
655

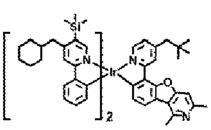
656

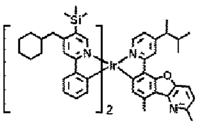
657

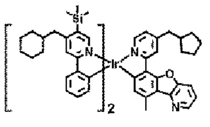
658

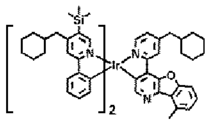
659

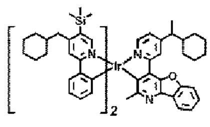
660

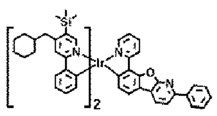
661
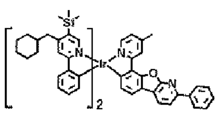
662
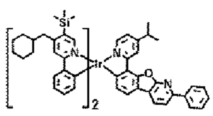
663
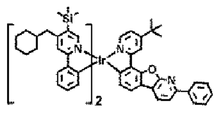
664
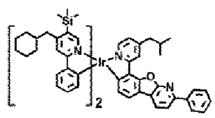
665

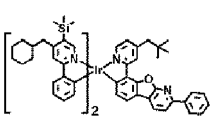
666
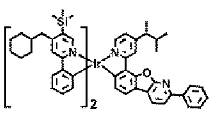
667
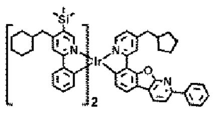
668
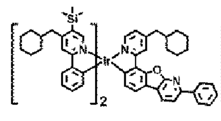
669
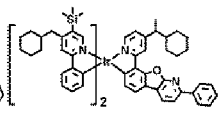
670

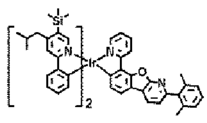
671
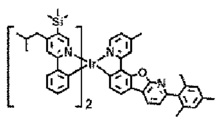
672
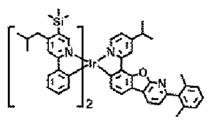
673
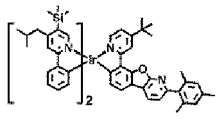
674
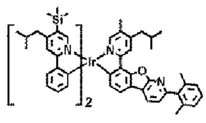
675

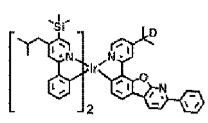
676
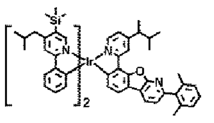
677
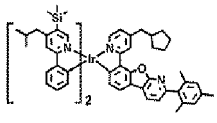
678
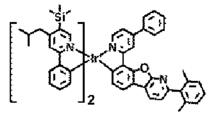
679
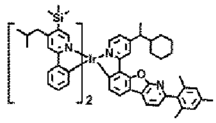
680

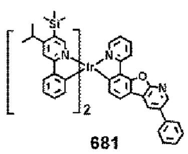
681
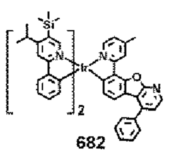
682
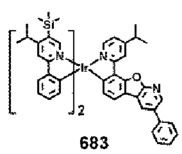
683
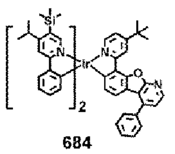
684
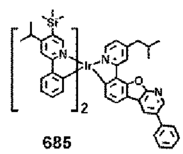
685

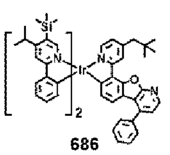
686
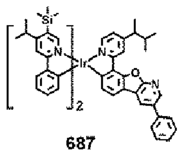
687
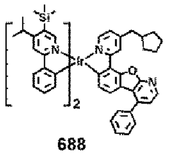
688
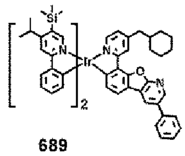
689
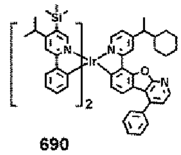
690

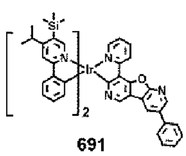
691
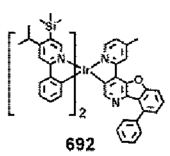
692
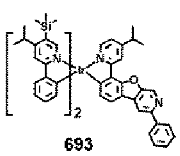
693
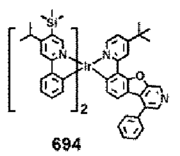
694
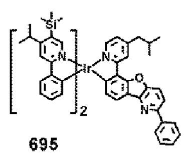
695

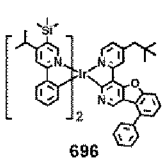
696
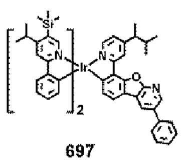
697
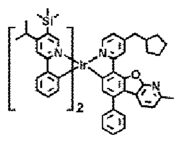
698
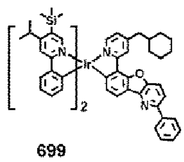
699
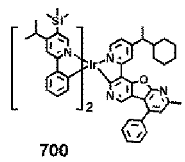
700

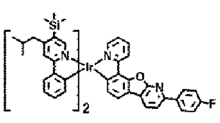
701
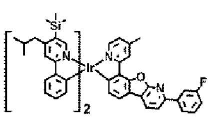
702
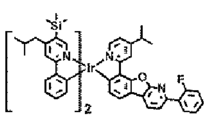
703
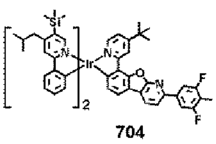
704
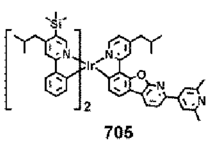
705

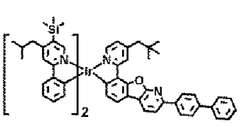
706
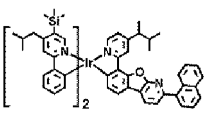
707
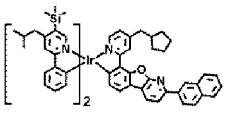
708
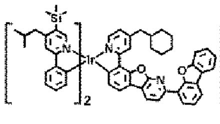
709
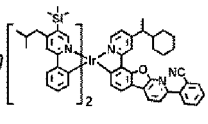
710

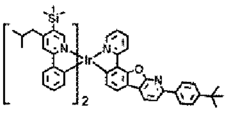
711
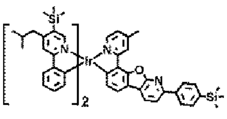
712
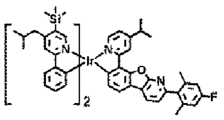
713
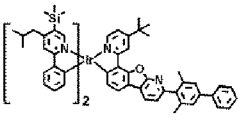
714
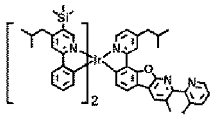
715

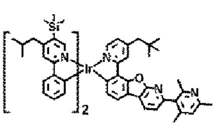
716
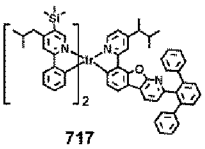
717
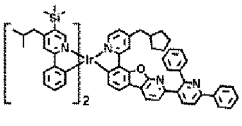
718
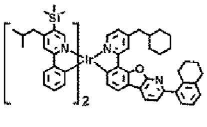
719
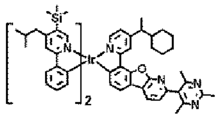
720

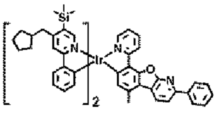
721
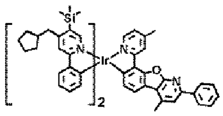
722
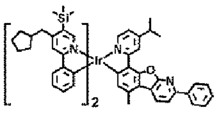
723
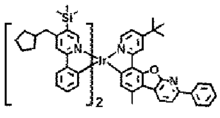
724
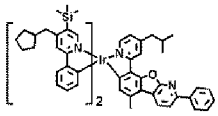
725

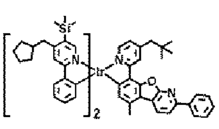
726
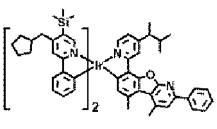
727
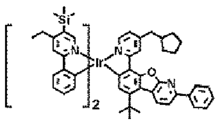
728
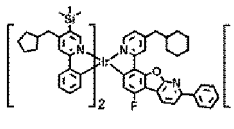
729
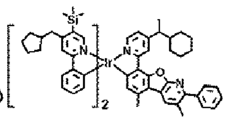
730

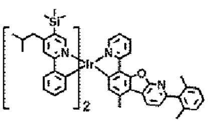
731
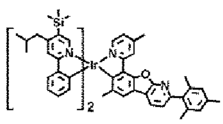
732
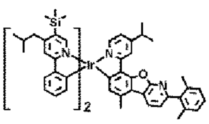
733
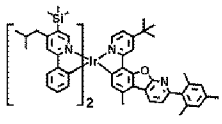
734
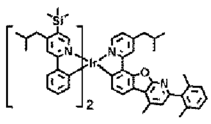
735

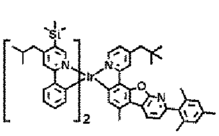
736
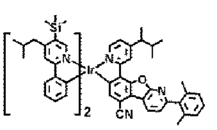
737
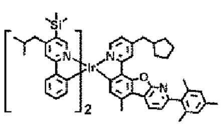
738
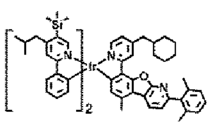
739
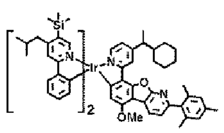
740

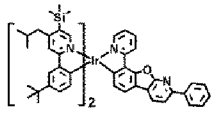
741
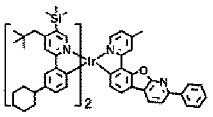
742
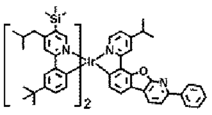
743
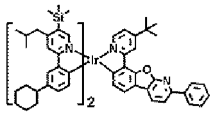
744
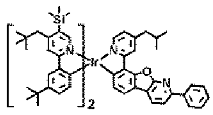
745

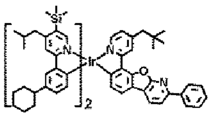
746
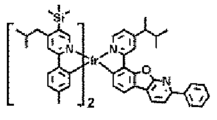
747
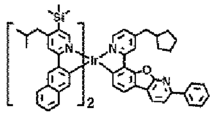
748
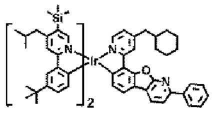
749
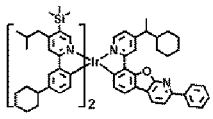
750

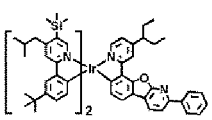
751
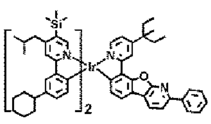
752
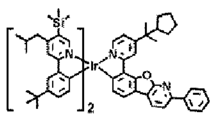
753
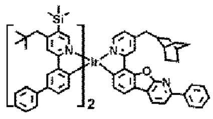
754
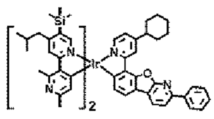
755

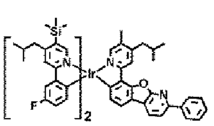
756
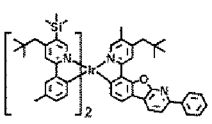
757
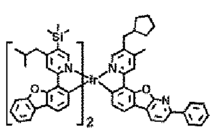
758
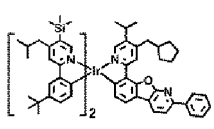
759
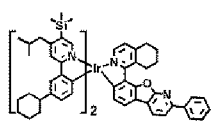
760

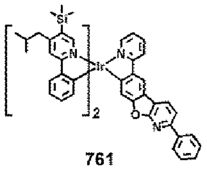
761
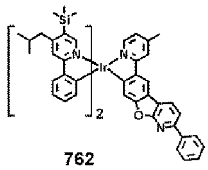
762
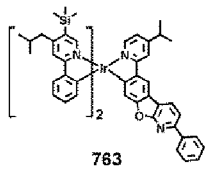
763
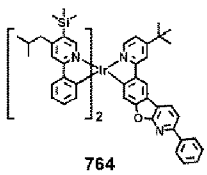
764
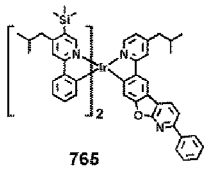
765

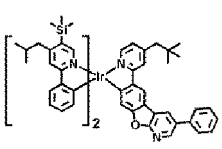
766
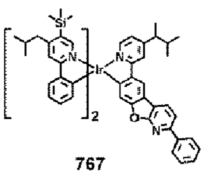
767
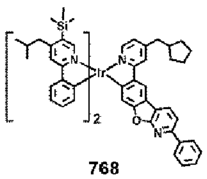
768
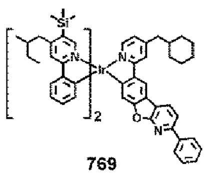
769
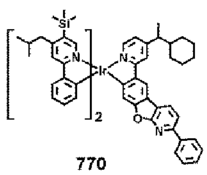
770

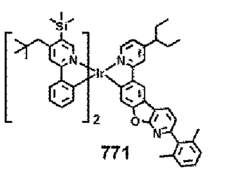
771
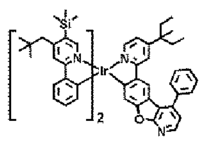
772
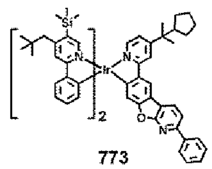
773
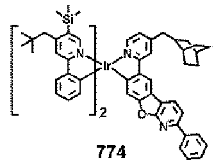
774
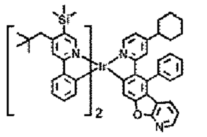
775

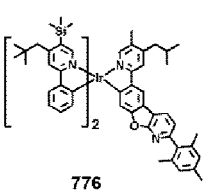
776
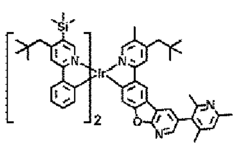
777
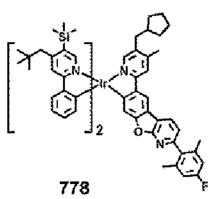
778
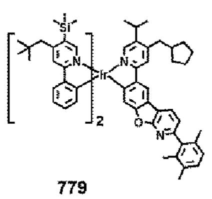
779
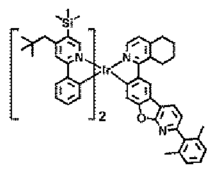
780

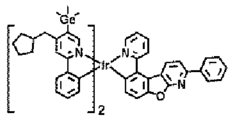
781
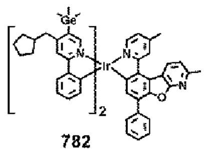
782
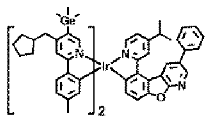
783
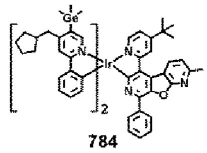
784
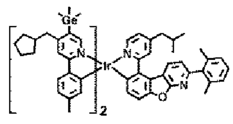
785

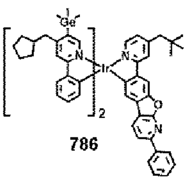
786
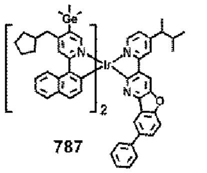
787
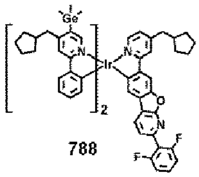
788
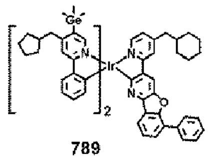
789
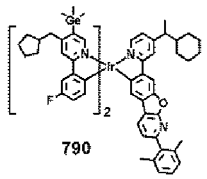
790

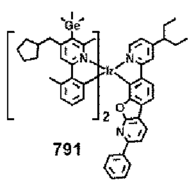
791
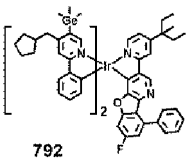
792
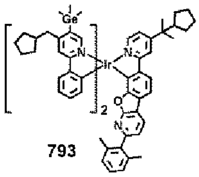
793
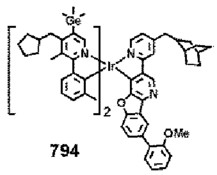
794
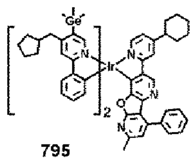
795

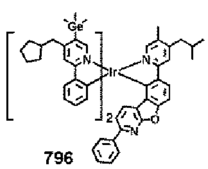
796
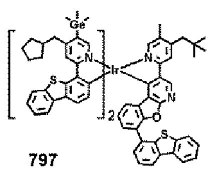
797
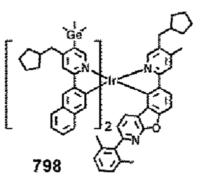
798
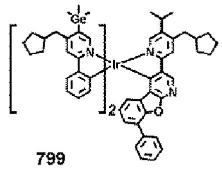
799
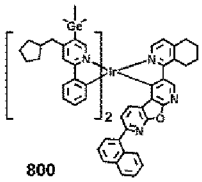
800

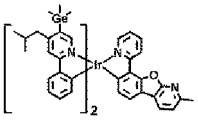
801
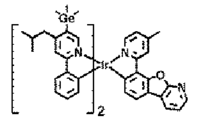
802
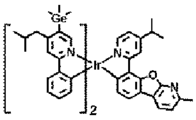
803
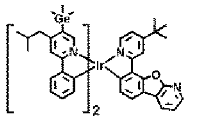
804
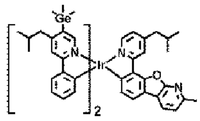
805

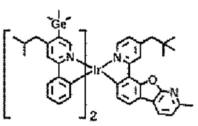
806
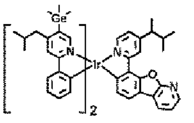
807
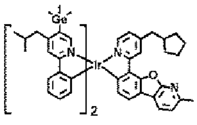
808
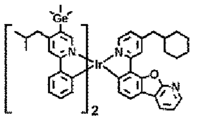
809
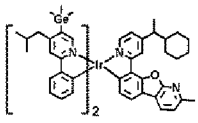
810

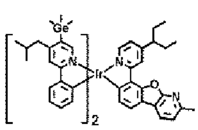
811
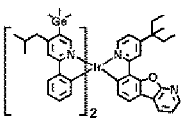
812
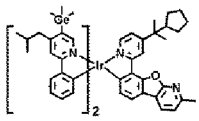
813
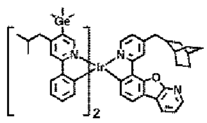
814
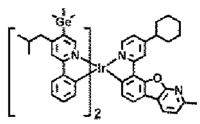
815

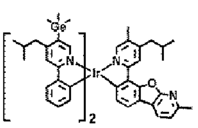
816
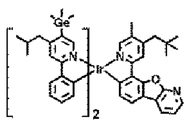
817
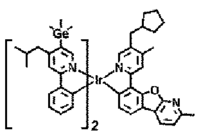
818
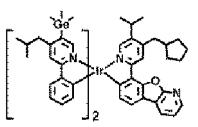
819
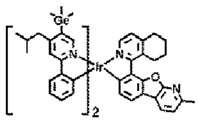
820

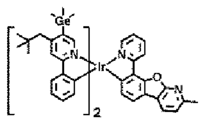
821

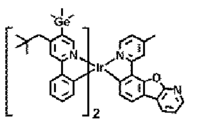
822

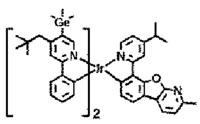
823

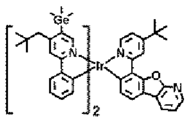
824

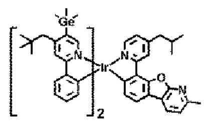
825

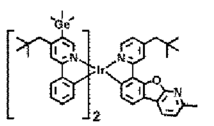
826

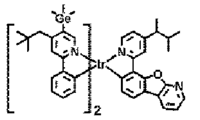
827

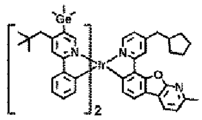
828

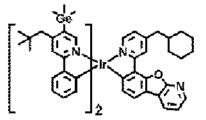
829

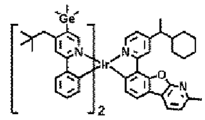
830

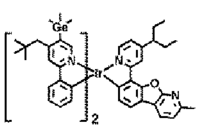
831

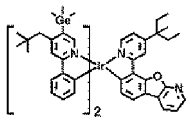
832

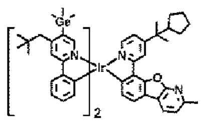
833

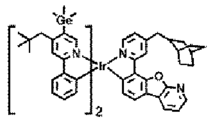
834

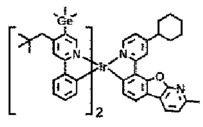
835

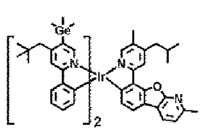
836

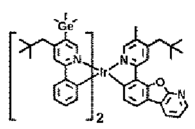
837

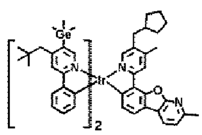
838

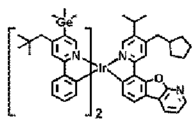
839

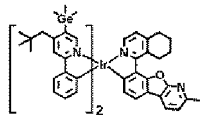
840

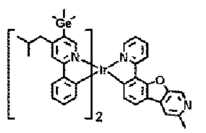
841

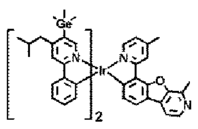
842

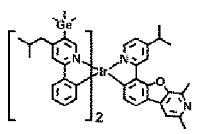
843

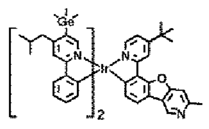
844

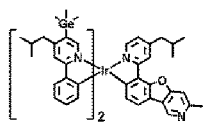
845

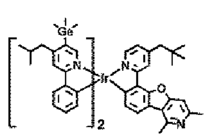
846

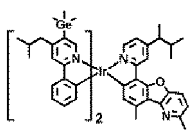
847

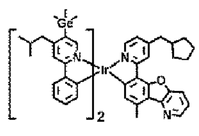
848

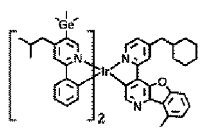
849

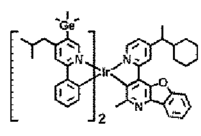
850

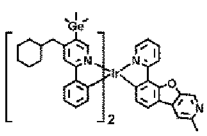
851

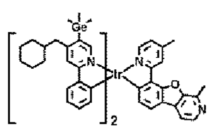
852

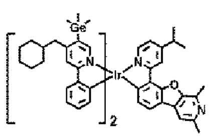
853

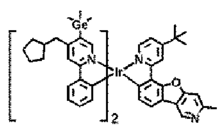
854

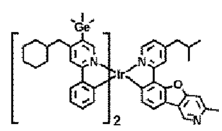
855

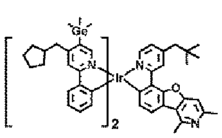
856

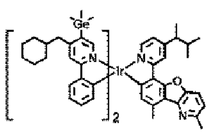
857

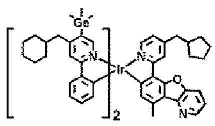
858

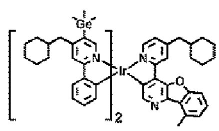
859

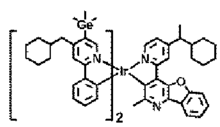
860

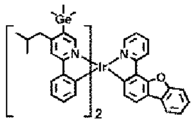
861
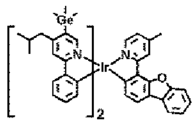
862
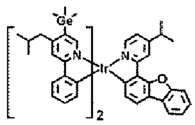
863
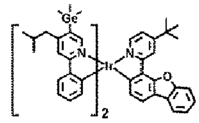
864
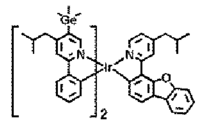
865

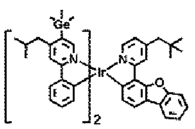
866
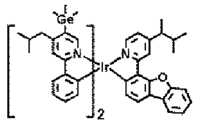
867
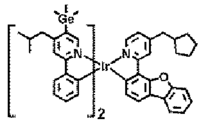
868
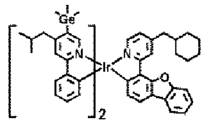
869
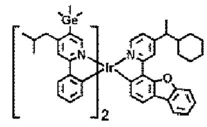
870

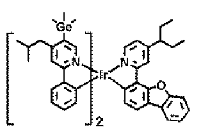
871
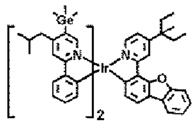
872
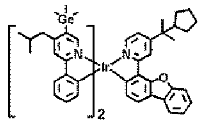
873
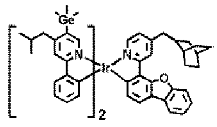
874
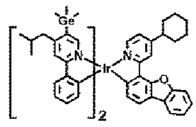
875

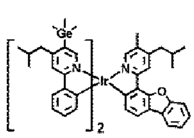
876
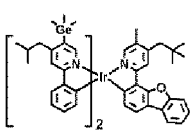
877
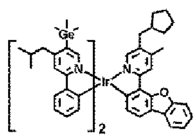
878
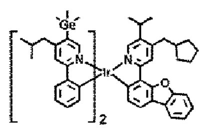
879
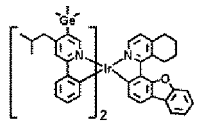
880

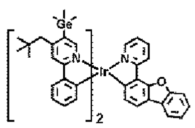
881
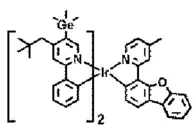
882
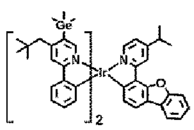
883
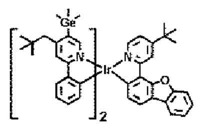
884
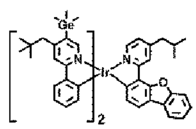
885

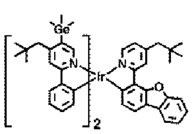
886
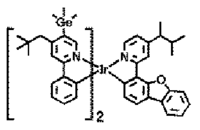
887
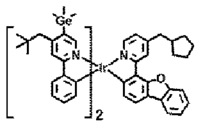
888
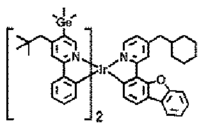
889
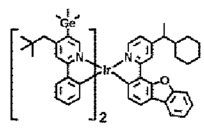
890

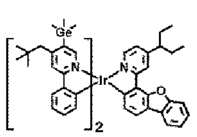
891
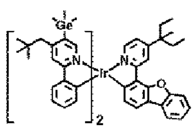
892
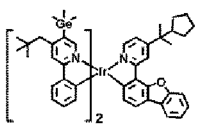
893
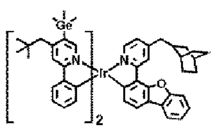
894
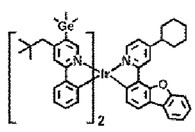
895

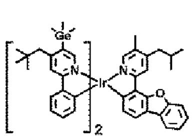
896
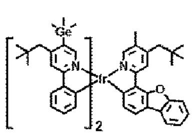
897
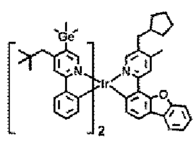
898
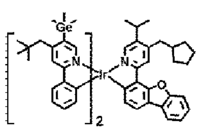
899
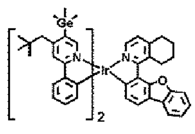
900

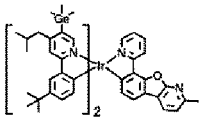
901

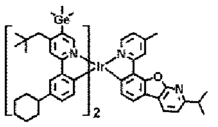
902

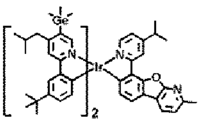
903

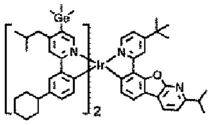
904

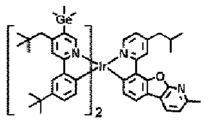
905

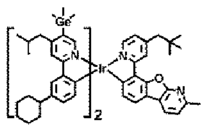
906

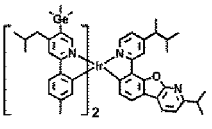
907

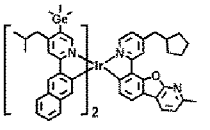
908

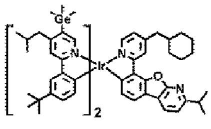
909

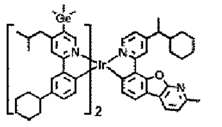
910

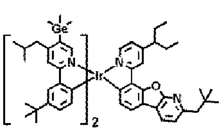
911

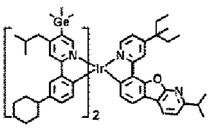
912

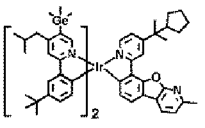
913

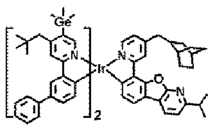
914

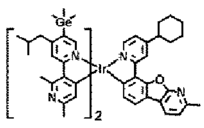
915

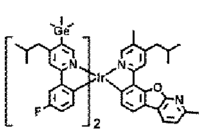
916

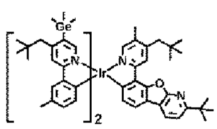
917

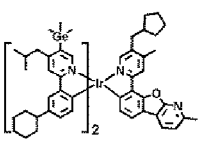
918

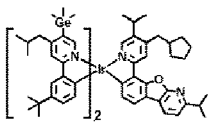
919

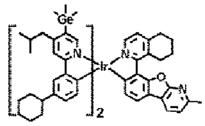
920

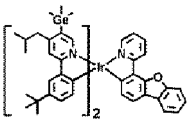
921

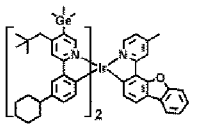
922

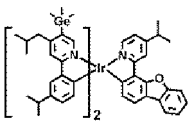
923

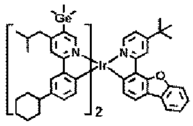
924

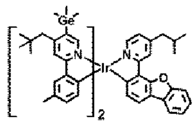
925

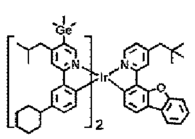
926

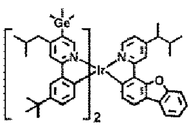
927

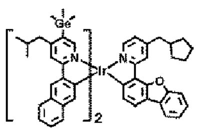
928

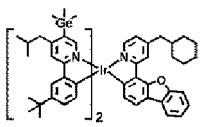
929

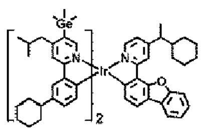
930

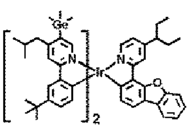
931

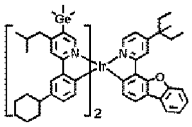
932

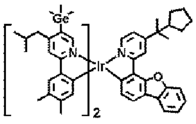
933

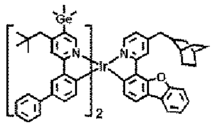
934

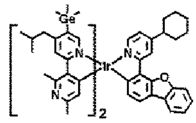
935

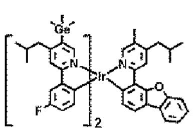
936

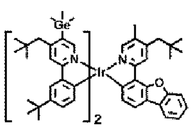
937

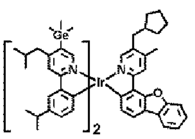
938

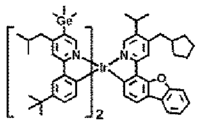
939

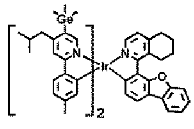
940

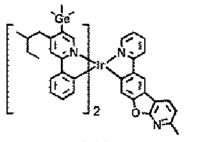
941
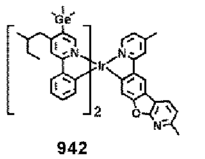
942
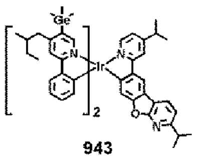
943
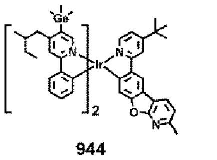
944
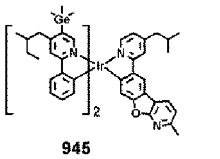
945

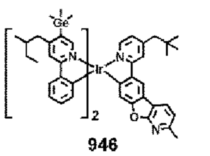
946
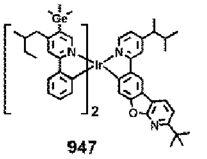
947
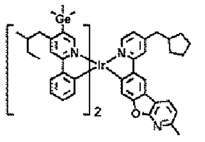
948
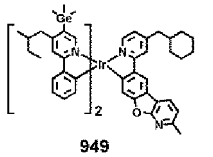
949
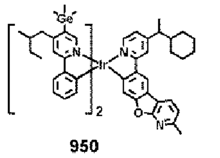
950

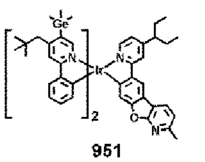
951
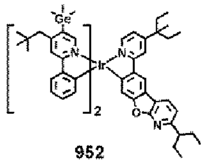
952
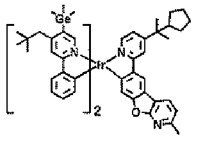
953
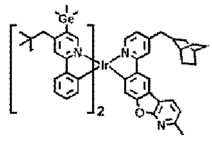
954
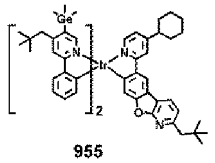
955

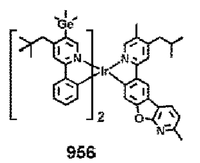
956
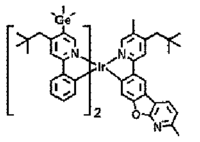
957
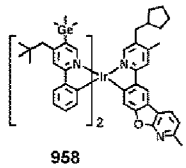
958
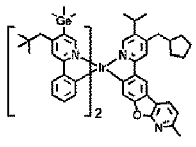
959
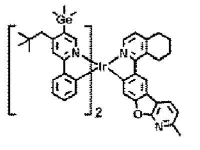
960

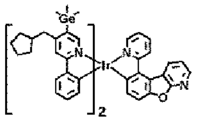
961
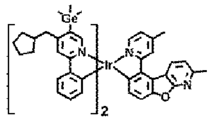
962
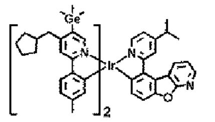
963
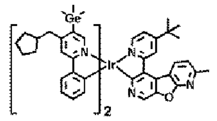
964
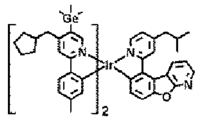
965

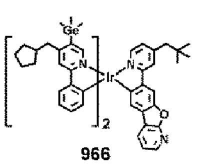
966
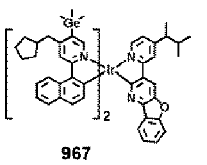
967
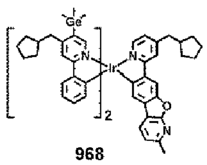
968
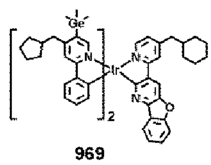
969
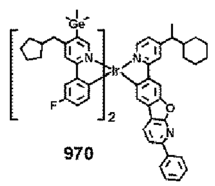
970

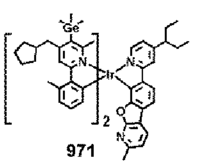
971
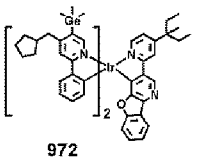
972
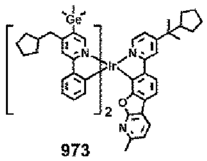
973
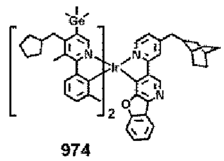
974
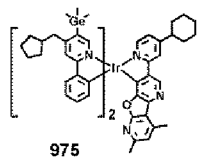
975

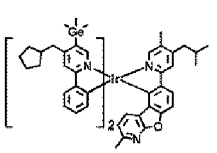
976
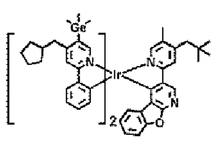
977
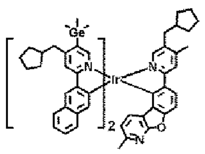
978
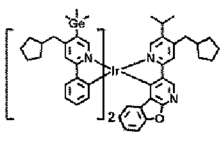
979
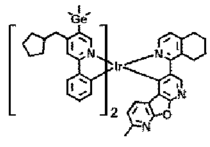
980

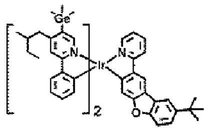
981
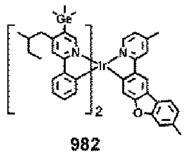
982
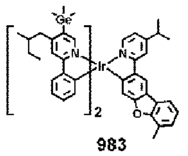
983
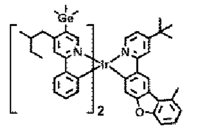
984
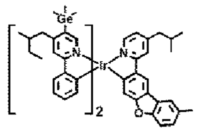
985

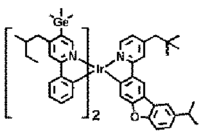
986
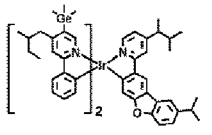
987
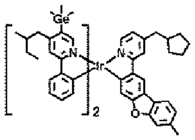
988
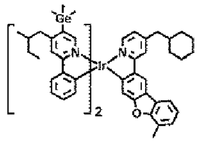
989
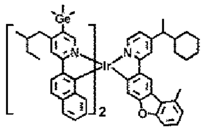
990

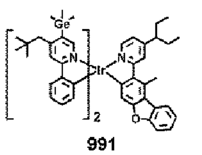
991
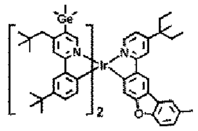
992
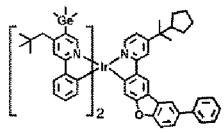
993
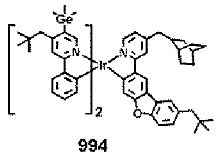
994
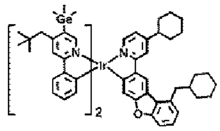
995

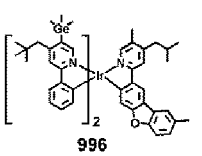
996
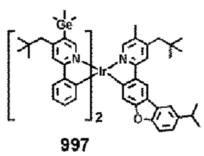
997
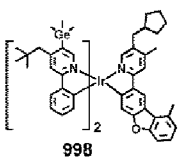
998
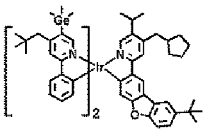
999
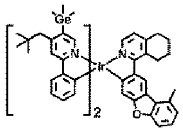
1000

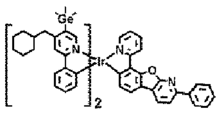
1001
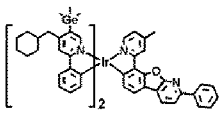
1002
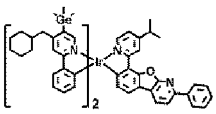
1003
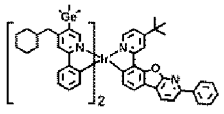
1004
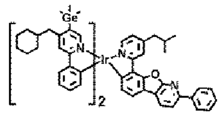
1005

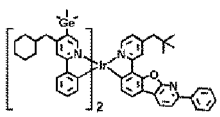
1006
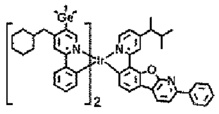
1007
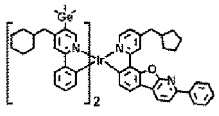
1008
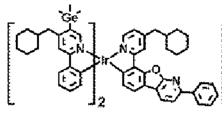
1009
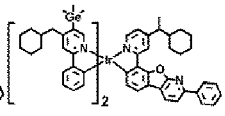
1010

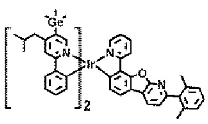
1011
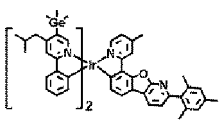
1012
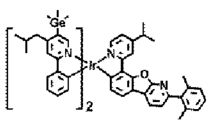
1013
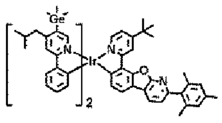
1014
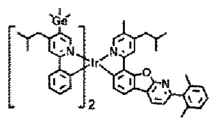
1015

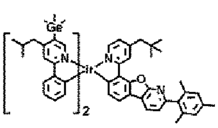
1016
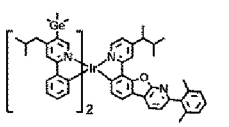
1017
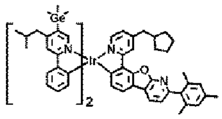
1018
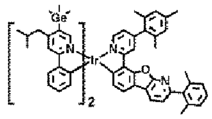
1019
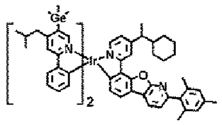
1020

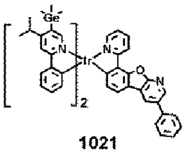
1021
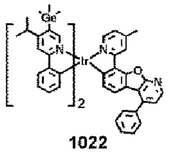
1022
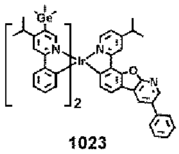
1023
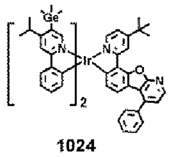
1024
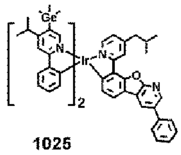
1025

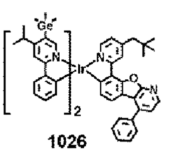
1026
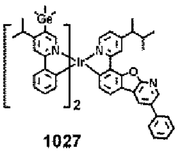
1027
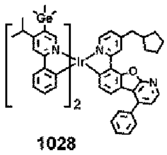
1028
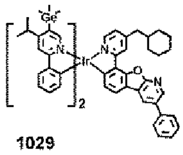
1029
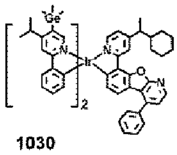
1030

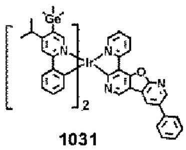
1031
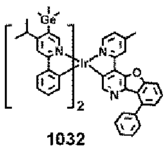
1032
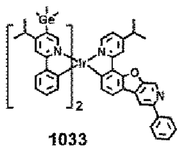
1033
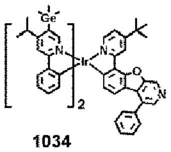
1034
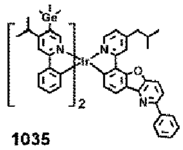
1035

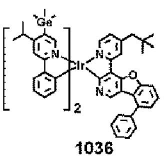
1036
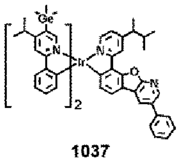
1037
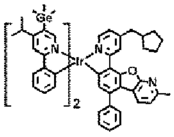
1038
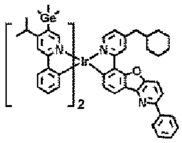
1039
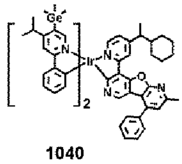
1040

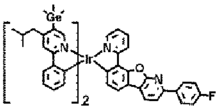
1041
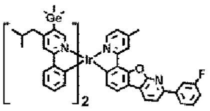
1042
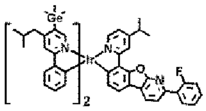
1043
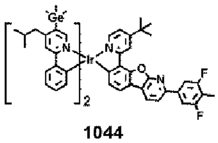
1044
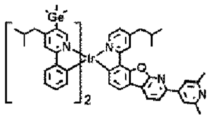
1045

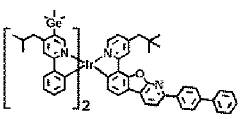
1046
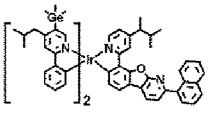
1047
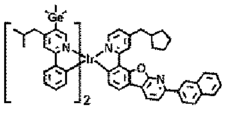
1048
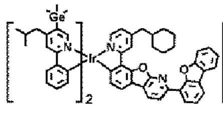
1049
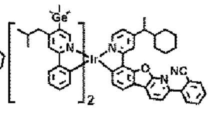
1050

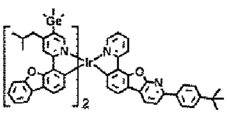
1051
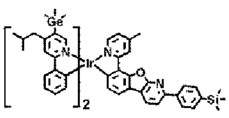
1052
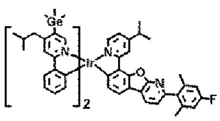
1053
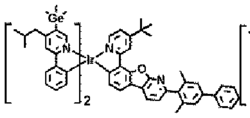
1054
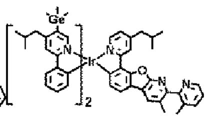
1055

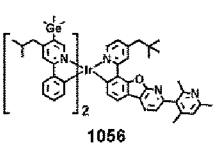
1056
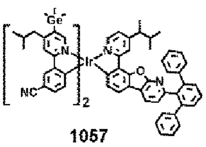
1057
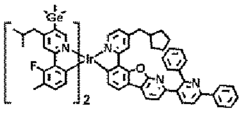
1058
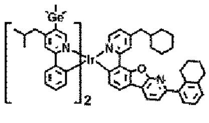
1059
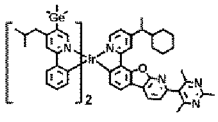
1060

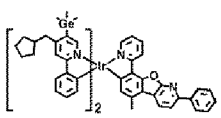
1061

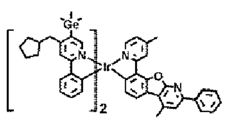
1062

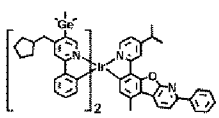
1063

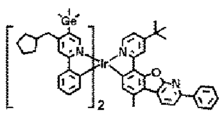
1064

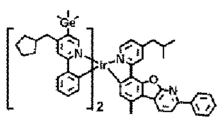
1065

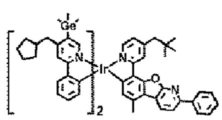
1066

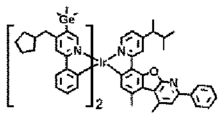
1067

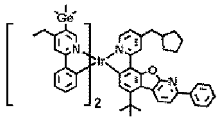
1068

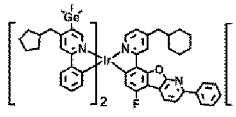
1069

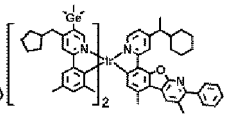
1070

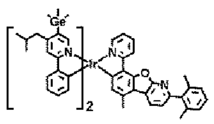
1071

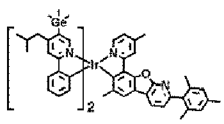
1072

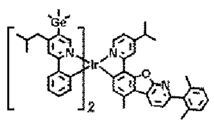
1073

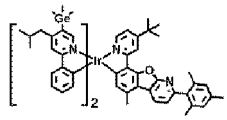
1074

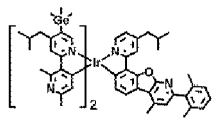
1075

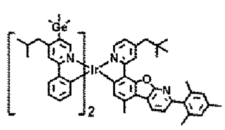
1076

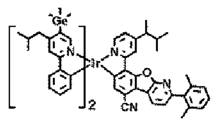
1077

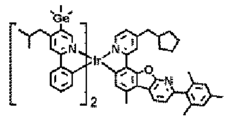
1078

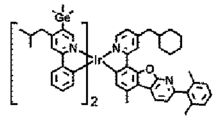
1079

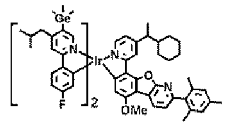
1080

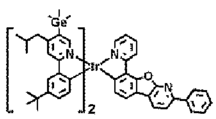
1081

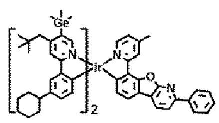
1082

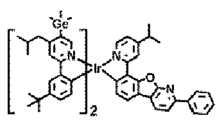
1083

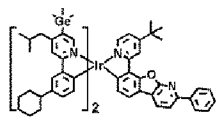
1084

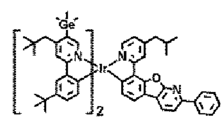
1085

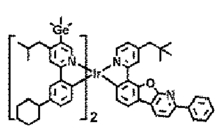
1086

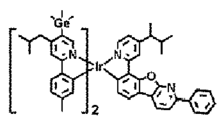
1087

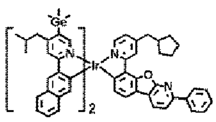
1088

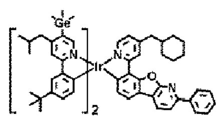
1089

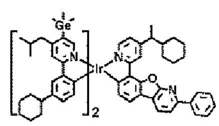
1090

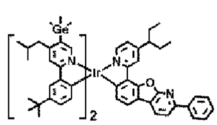
1091

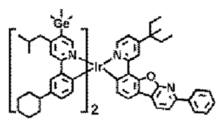
1092

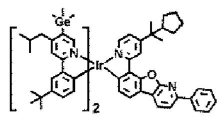
1093

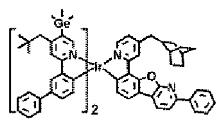
1094

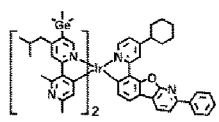
1095

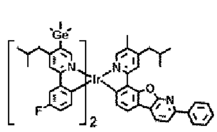
1096

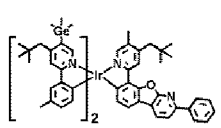
1097

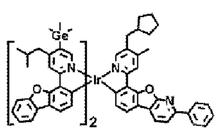
1098

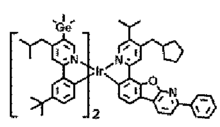
1099

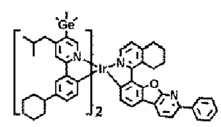
1100

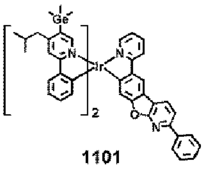
1101

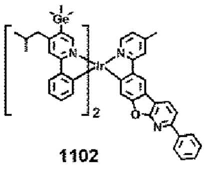
1102

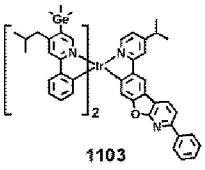
1103

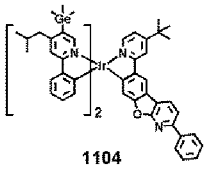
1104

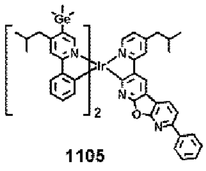
1105

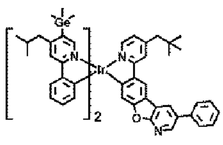
1106

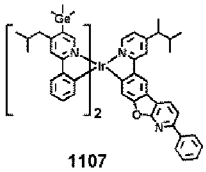
1107

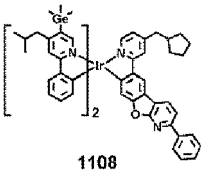
1108

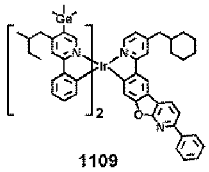
1109

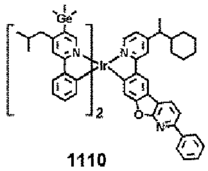
1110

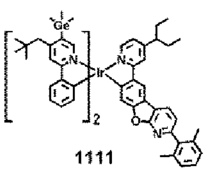
1111

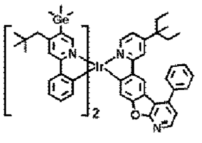
1112

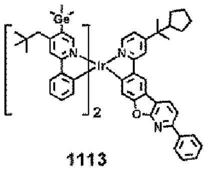
1113

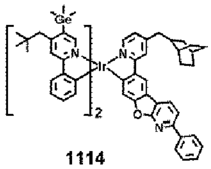
1114

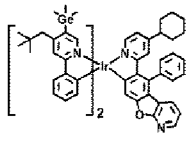
1115

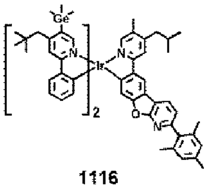
1116

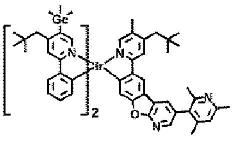
1117

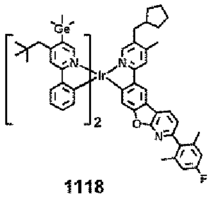
1118

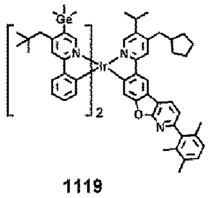
1119

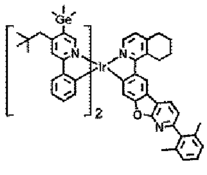
1120

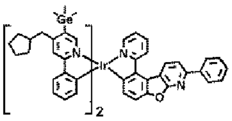
1121

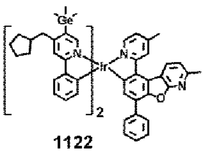
1122

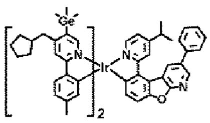
1123

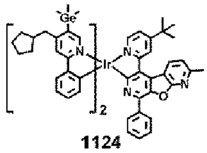
1124

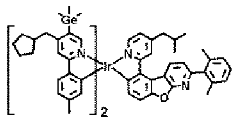
1125

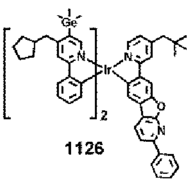
1126

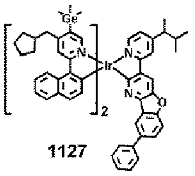
1127

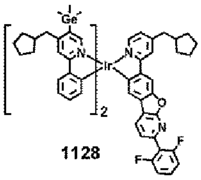
1128

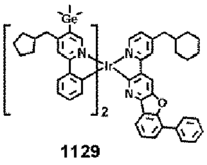
1129

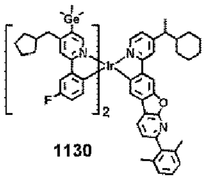
1130

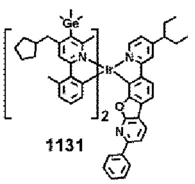
1131

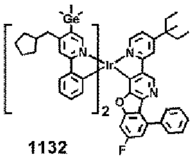
1132

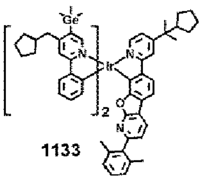
1133

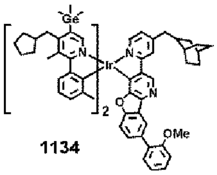
1134

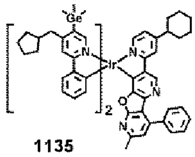
1135

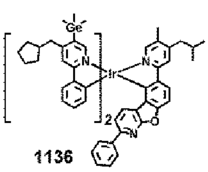
1136

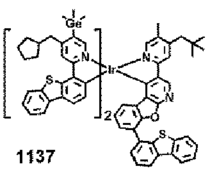
1137

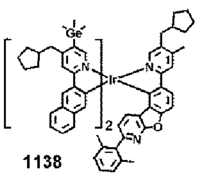
1138

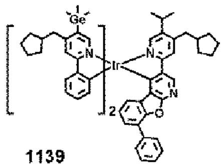
1139

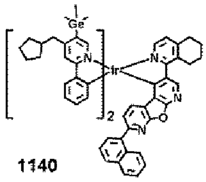
1140

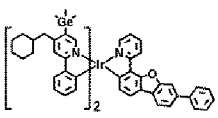
1141

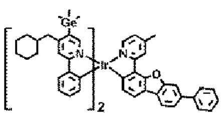
1142

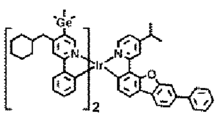
1143

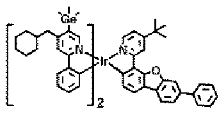
1144

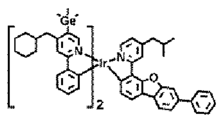
1145

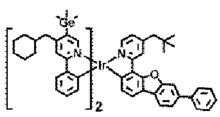
1146

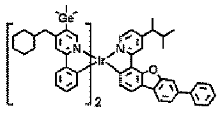
1147

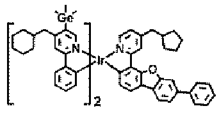
1148

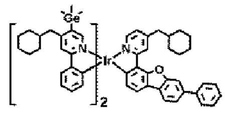
1149

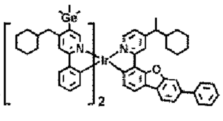
1150

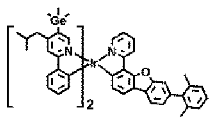
1151

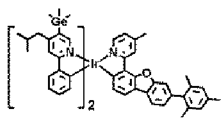
1152

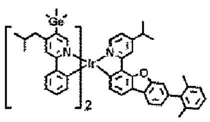
1153

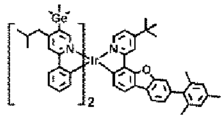
1154

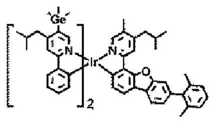
1155

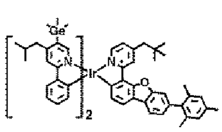
1156

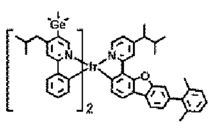
1157

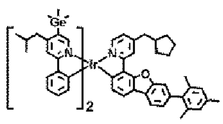
1158

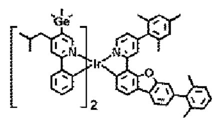
1159

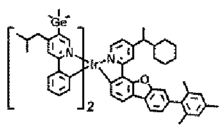
1160

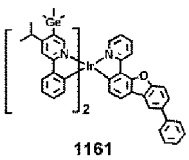
1161

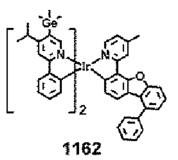
1162

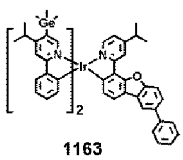
1163

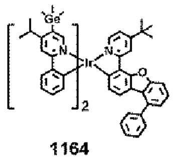
1164

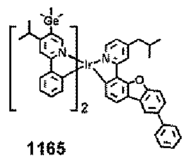
1165

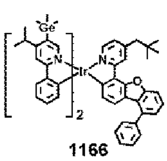
1166

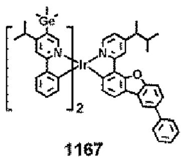
1167

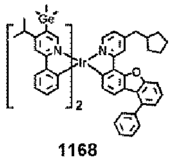
1168

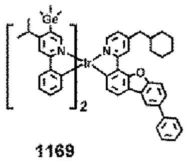
1169

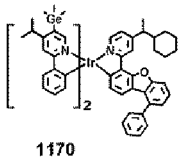
1170

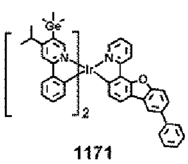
1171

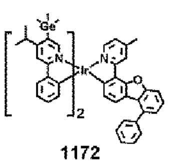
1172

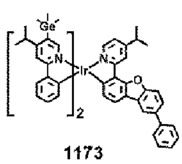
1173

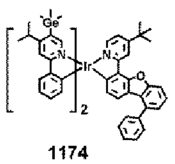
1174

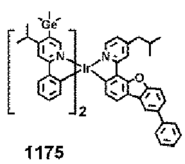
1175

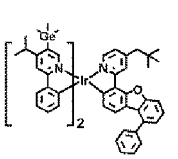
1176

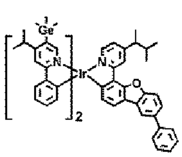
1177

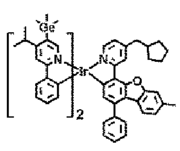
1178

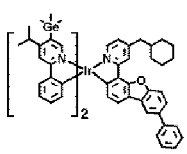
1179

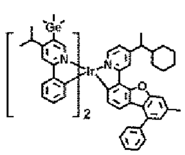
1180

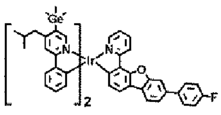
1181
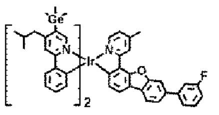
1182
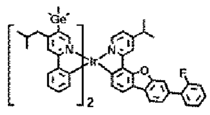
1183
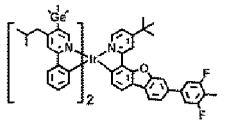
1184
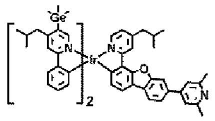
1185

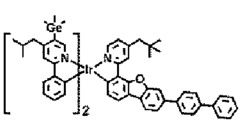
1186
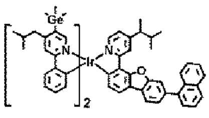
1187
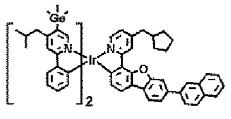
1188
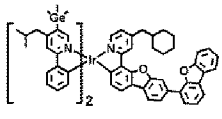
1189
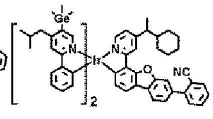
1190

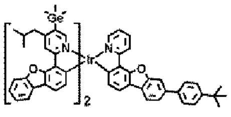
1191
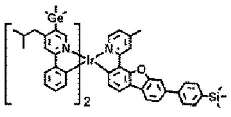
1192
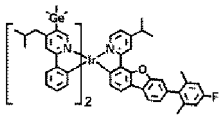
1193
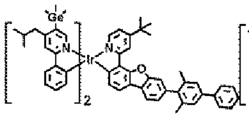
1194
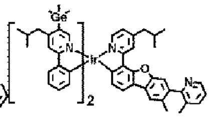
1195

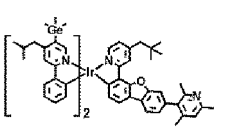
1196
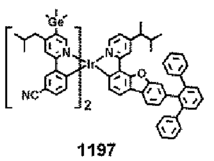
1197
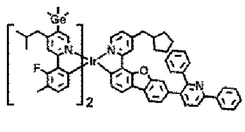
1198
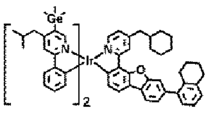
1199
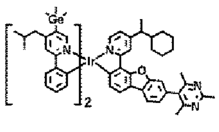
1200

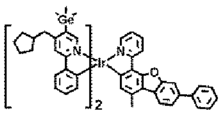
1201
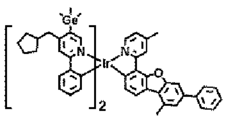
1202
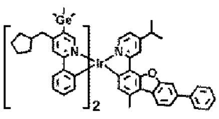
1203
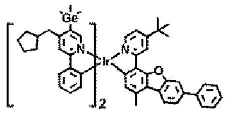
1204
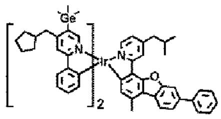
1205

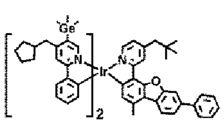
1206
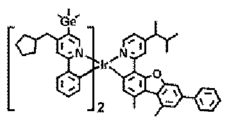
1207
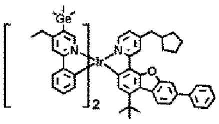
1208
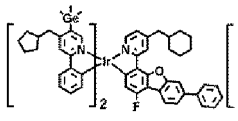
1209
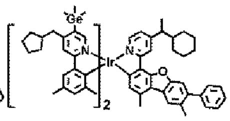
1210

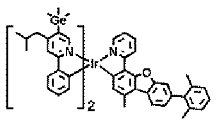
1211
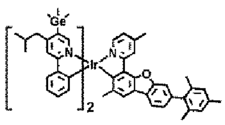
1212
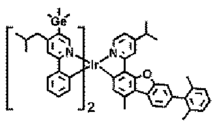
1213
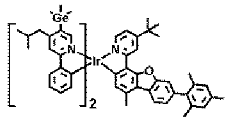
1214
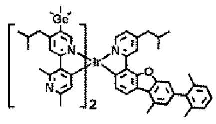
1215

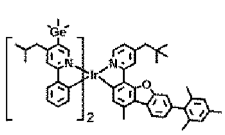
1216
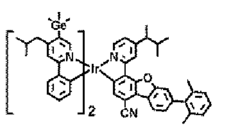
1217
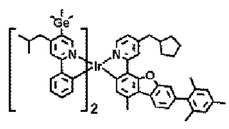
1218
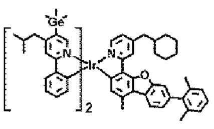
1219
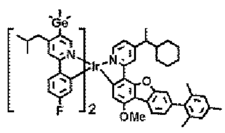
1220

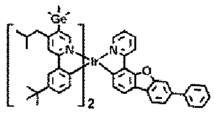
1221
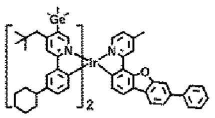
1222
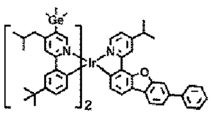
1223
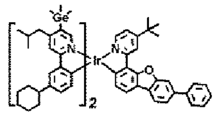
1224
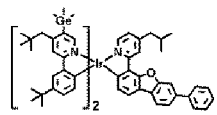
1225

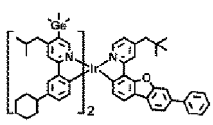
1226
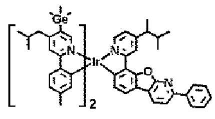
1227
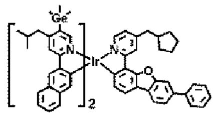
1228
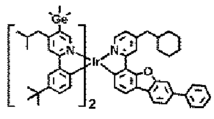
1229
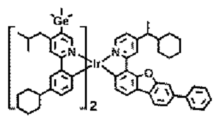
1230

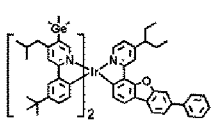
1231
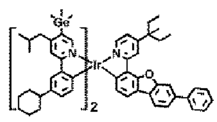
1232
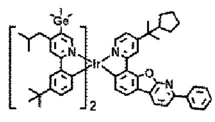
1233
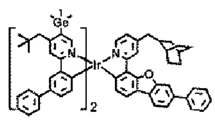
1234
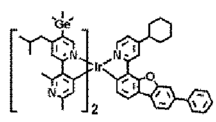
1235

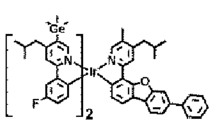
1236
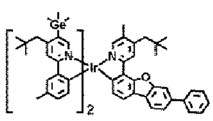
1237
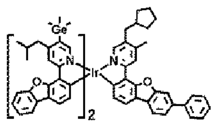
1238
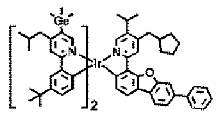
1239
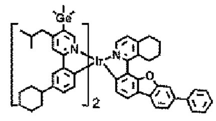
1240

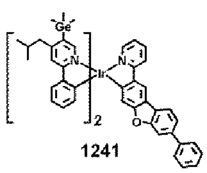
1241
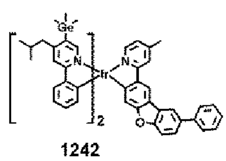
1242
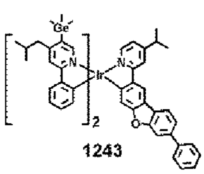
1243
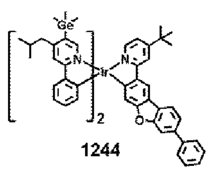
1244
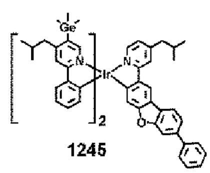
1245

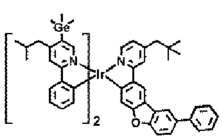
1246
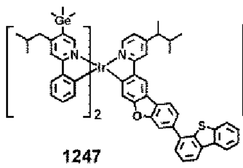
1247
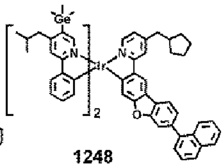
1248
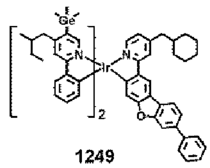
1249
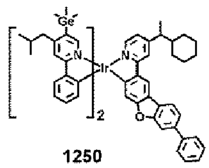
1250

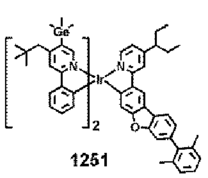
1251
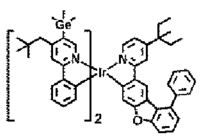
1252
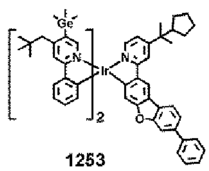
1253
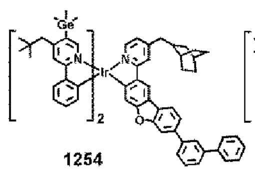
1254
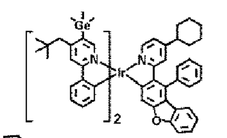
1255

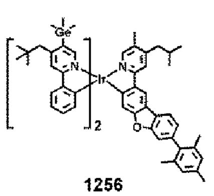
1256
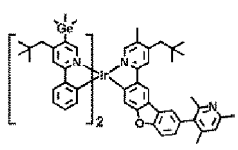
1257
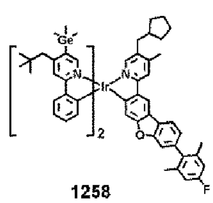
1258
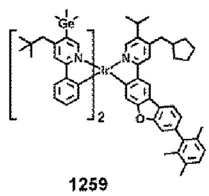
1259
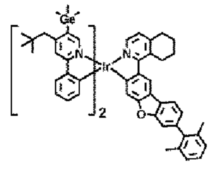
1260

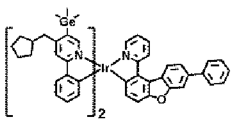
1261
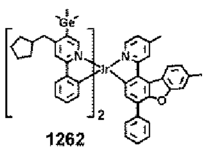
1262
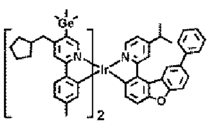
1263
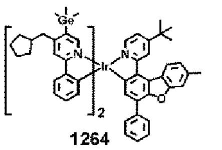
1264
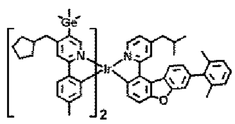
1265

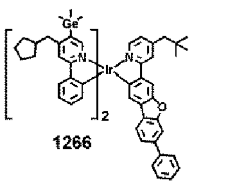
1266
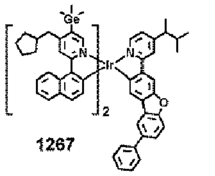
1267
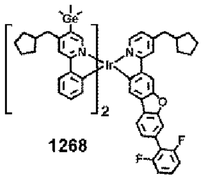
1268
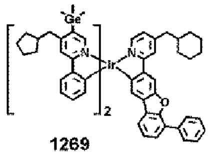
1269
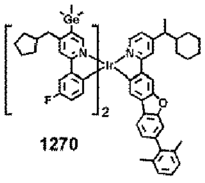
1270

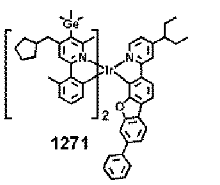
1271
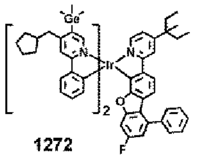
1272
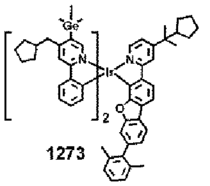
1273
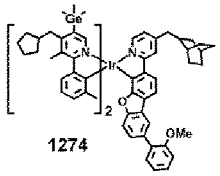
1274
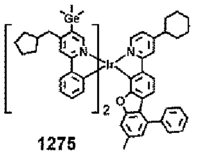
1275

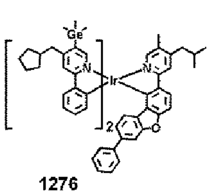
1276
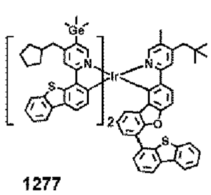
1277
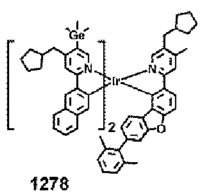
1278
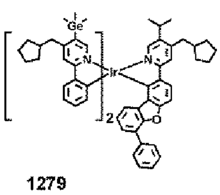
1279
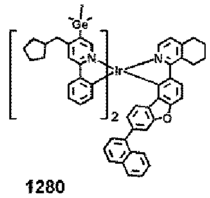
1280

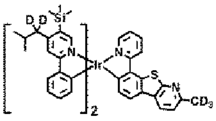
1281
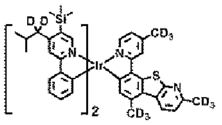
1282
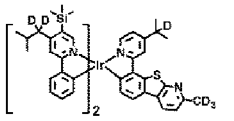
1283
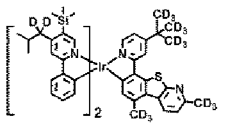
1284
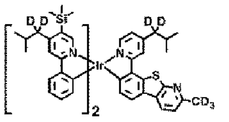
1285

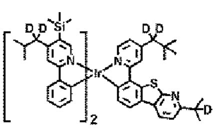
1286
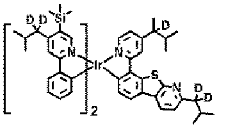
1287
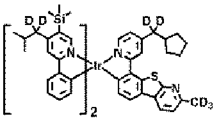
1288
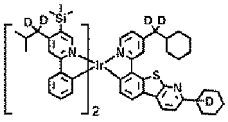
1289
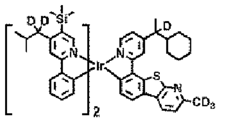
1290

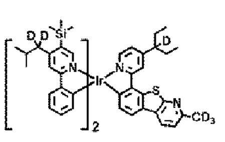
1291
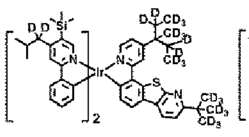
1292
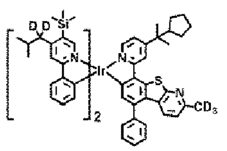
1293
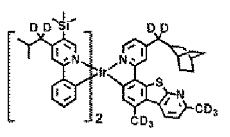
1294
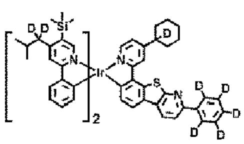
1295

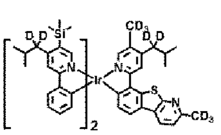
1296
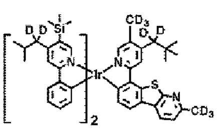
1297
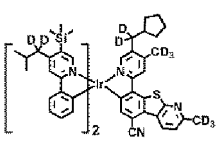
1298
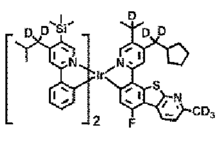
1299
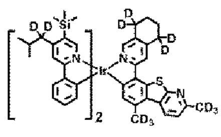
1300

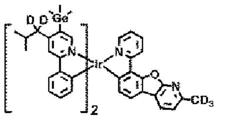
1301
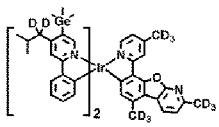
1302
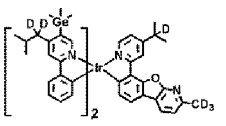
1303
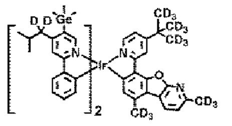
1304
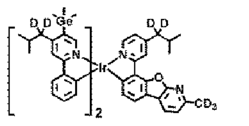
1305

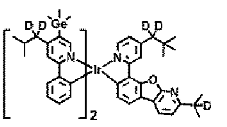
1306
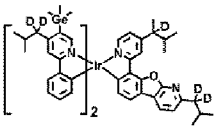
1307
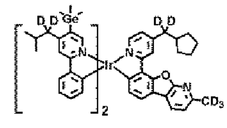
1308
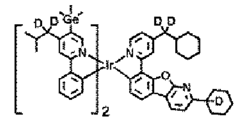
1309
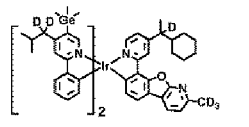
1310

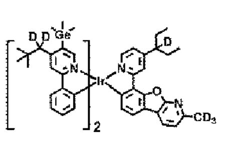
1311
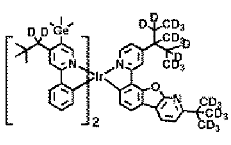
1312
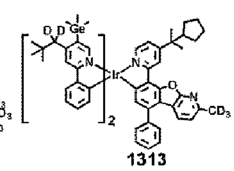
1313
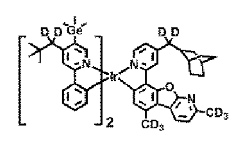
1314
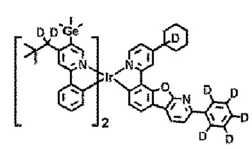
1315

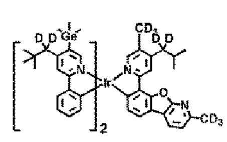
1316
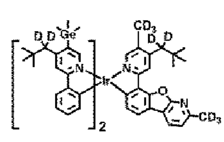
1317
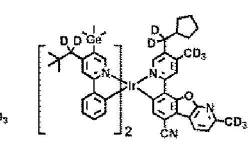
1318
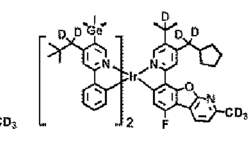
1319
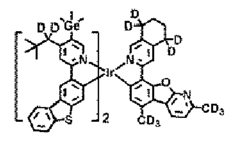
1320

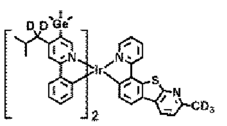
1321
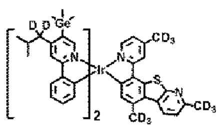
1322
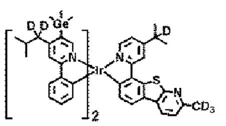
1323
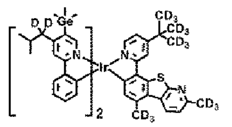
1324
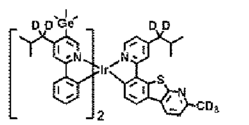
1325

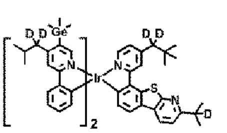
1326
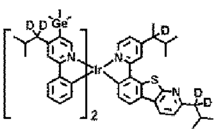
1327
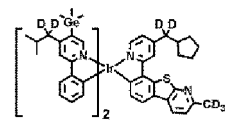
1328
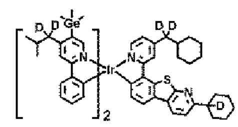
1329
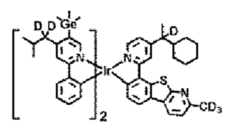
1330

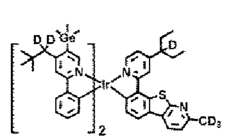
1331
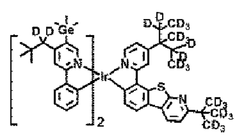
1332
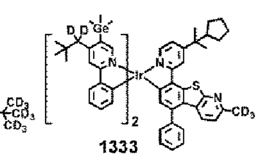
1333
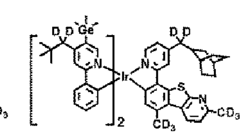
1334
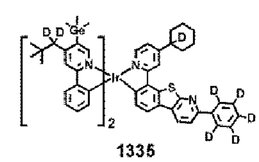
1335

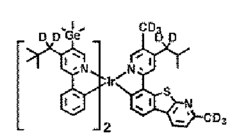
1336
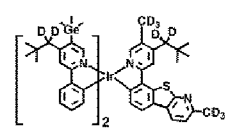
1337
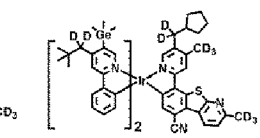
1338
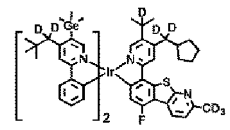
1339
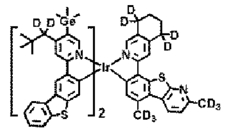
1340

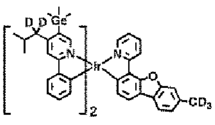 1341
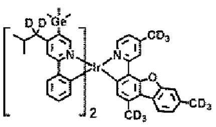 1342
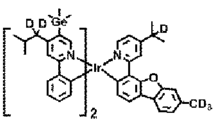 1343
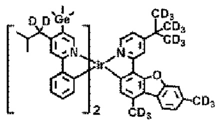 1344
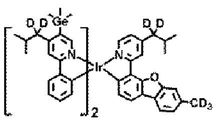 1345

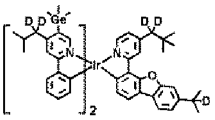 1346
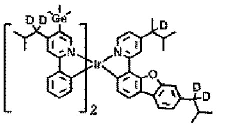 1347
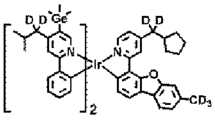 1348
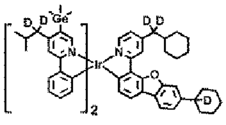 1349
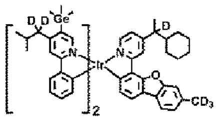 1350

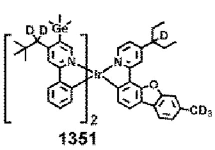 1351
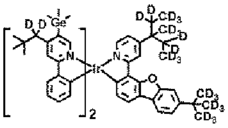 1352
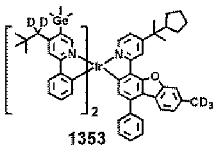 1353
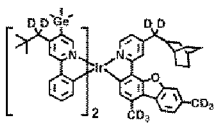 1354
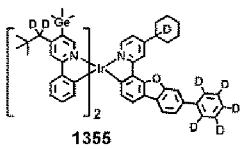 1355

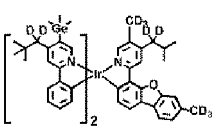 1356
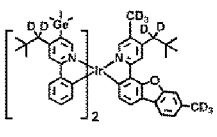 1357
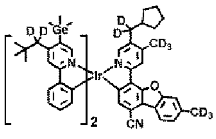 1358
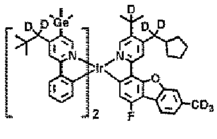 1359
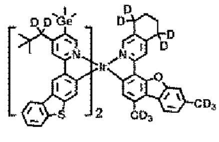 1360

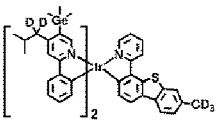 1361
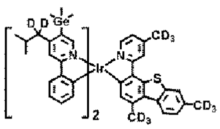 1362
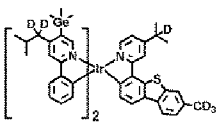 1363
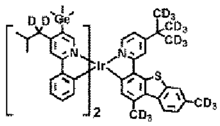 1364
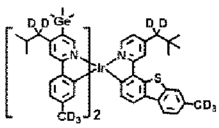 1365

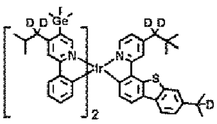 1366
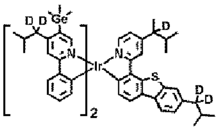 1367
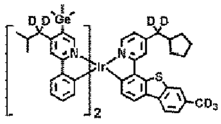 1368
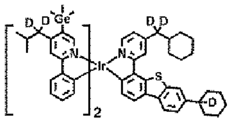 1369
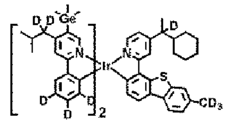 1370

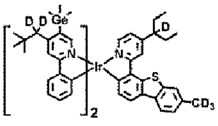 1371
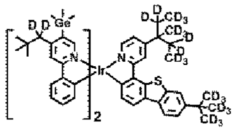 1372
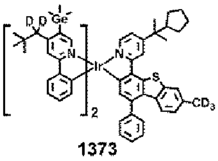 1373
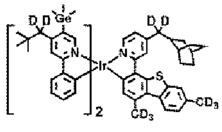 1374
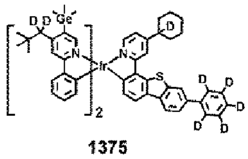 1375

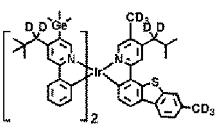 1376
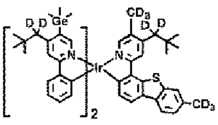 1377
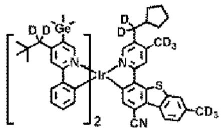 1378
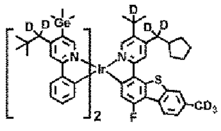 1379
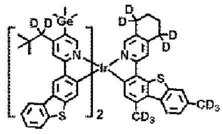 1380

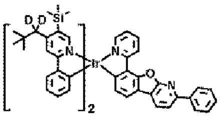
1381

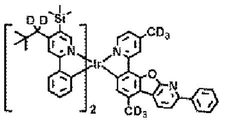
1382

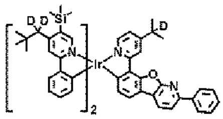
1383

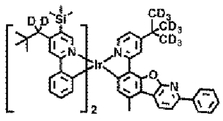
1384

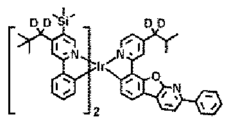
1385

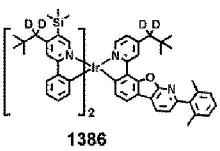
1386

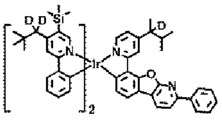
1387

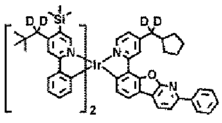
1388

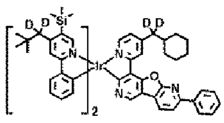
1389

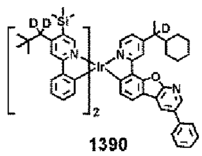
1390

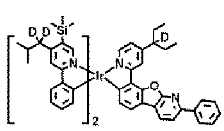
1391

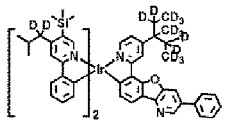
1392

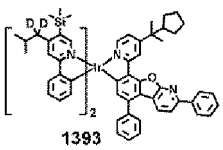
1393

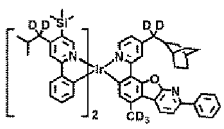
1394

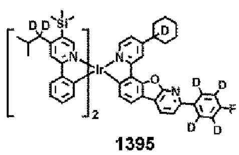
1395

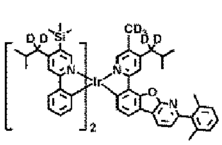
1396

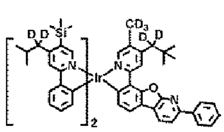
1397

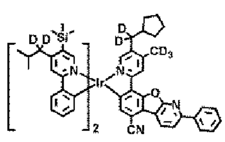
1398

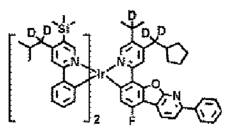
1399

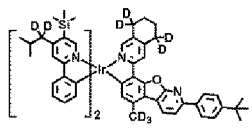
1400

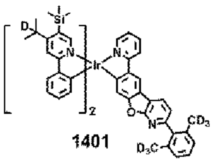
1401

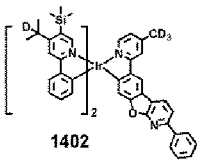
1402

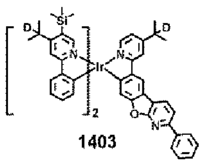
1403

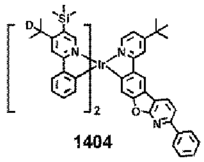
1404

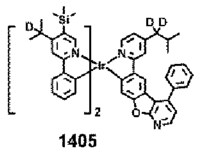
1405

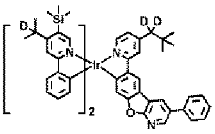
1406

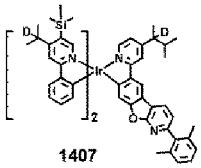
1407

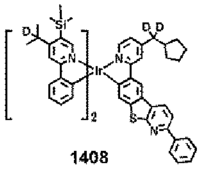
1408

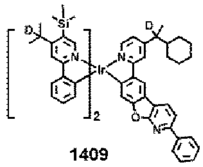
1409

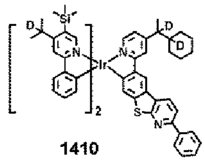
1410

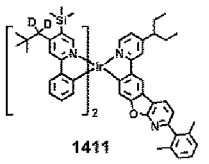
1411

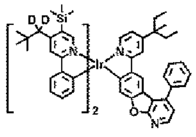
1412

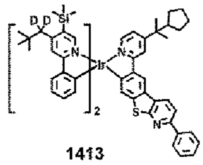
1413

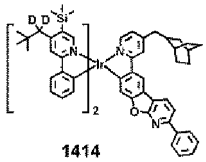
1414

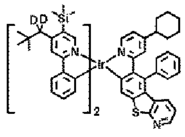
1415

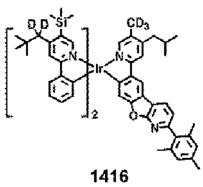
1416

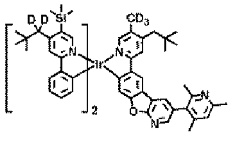
1417

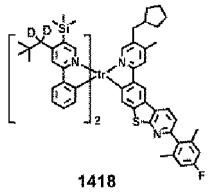
1418

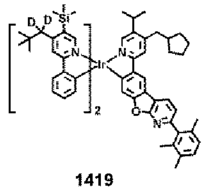
1419

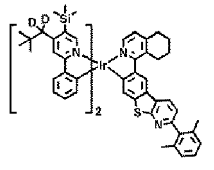
1420

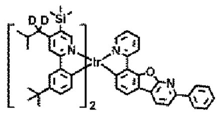
1421

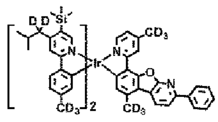
1422

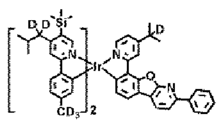
1423

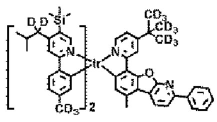
1424

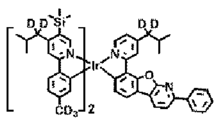
1425

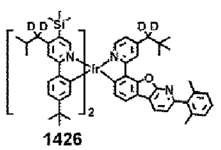
1426

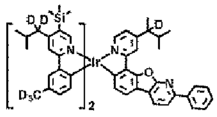
1427

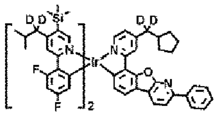
1428

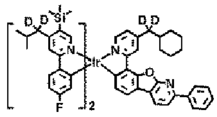
1429

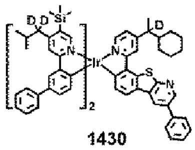
1430

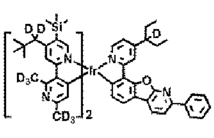
1431

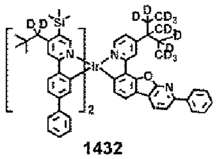
1432

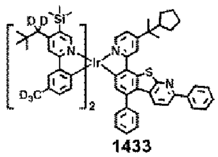
1433

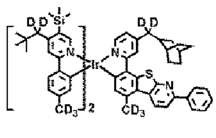
1434

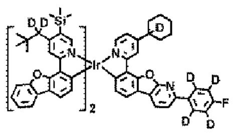
1435

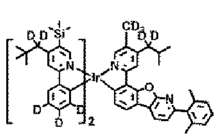
1436

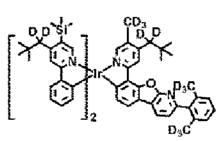
1437

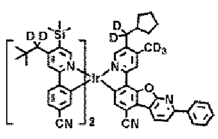
1438

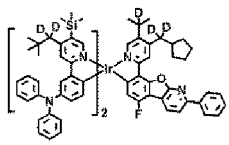
1439

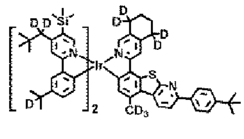
1440

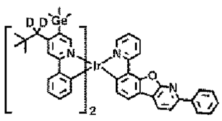
1441

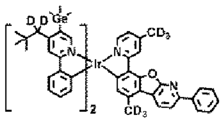
1442

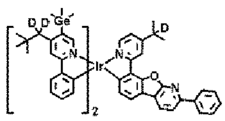
1443

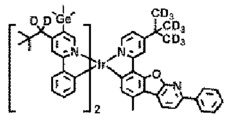
1444

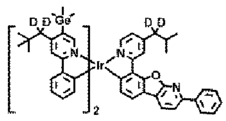
1445

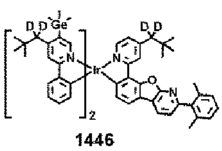
1446

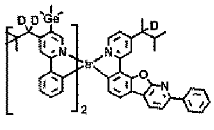
1447

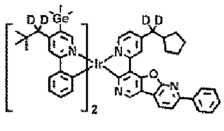
1448

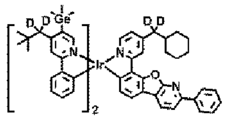
1449

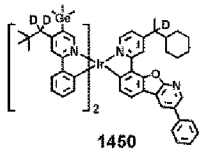
1450

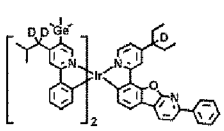
1451

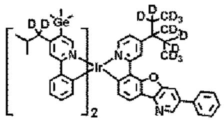
1452

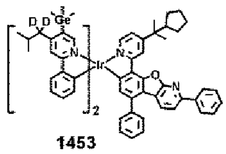
1453

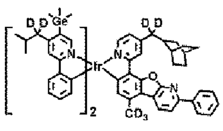
1454

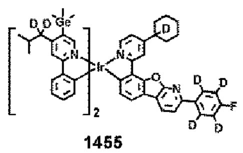
1455

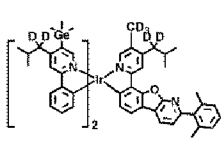
1456

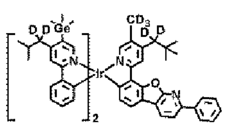
1457

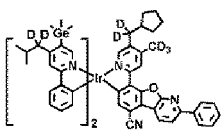
1458

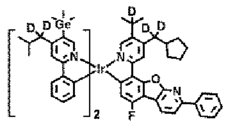
1459

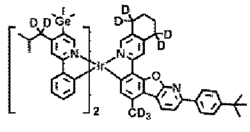
1460

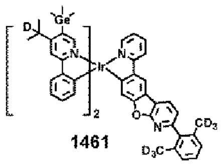
1461
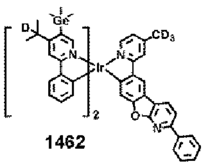
1462
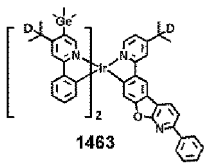
1463
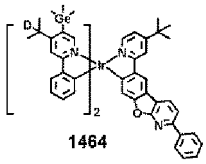
1464
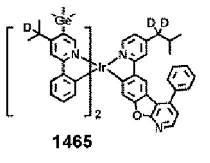
1465

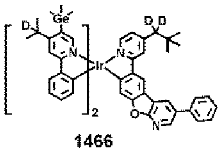
1466
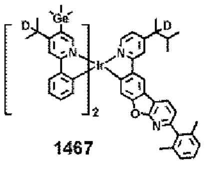
1467
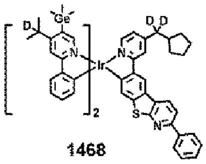
1468
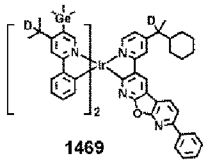
1469
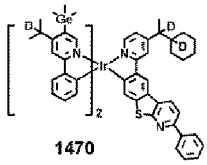
1470

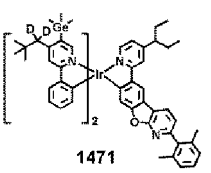
1471
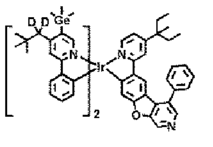
1472
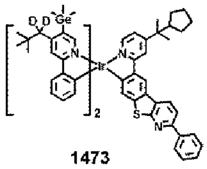
1473
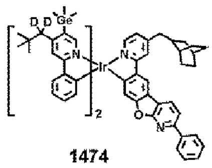
1474
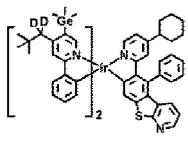
1475

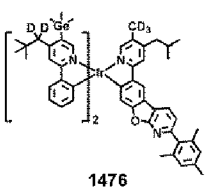
1476
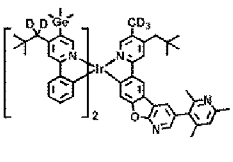
1477
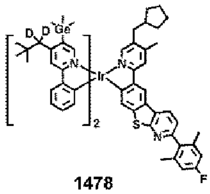
1478
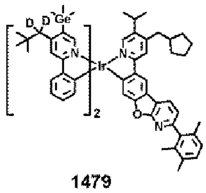
1479
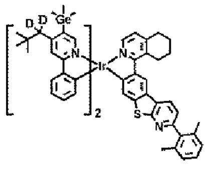
1480

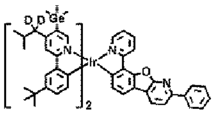
1481
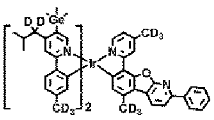
1482
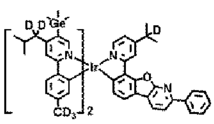
1483
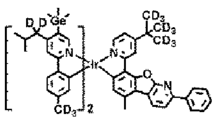
1484
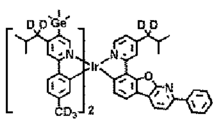
1485

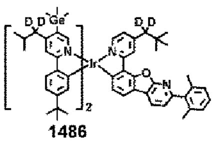
1486
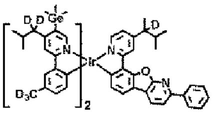
1487
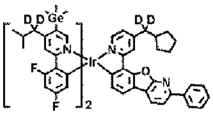
1488
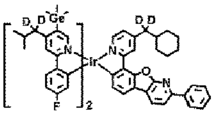
1489
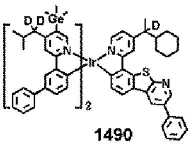
1490

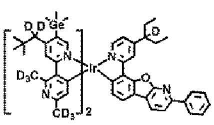
1491
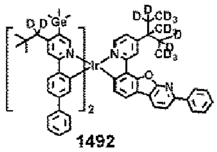
1492
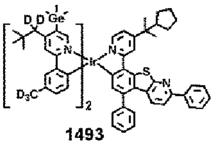
1493
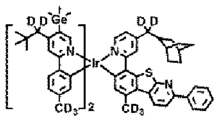
1494
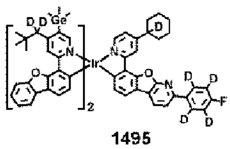
1495

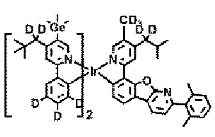
1496
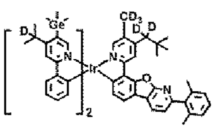
1497
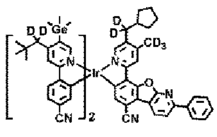
1498
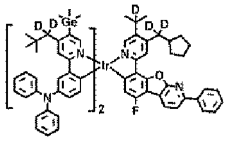
1499
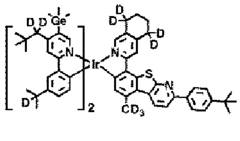
1500

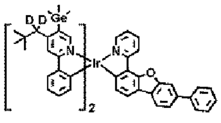
1501

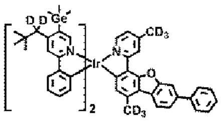
1502

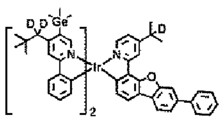
1503

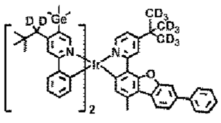
1504

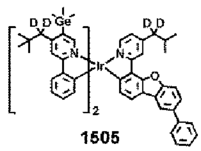
1505

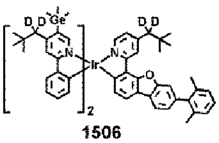
1506

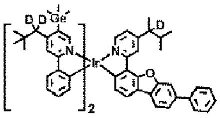
1507

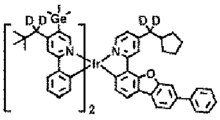
1508

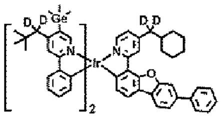
1509

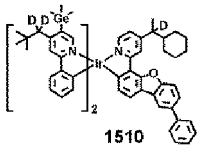
1510

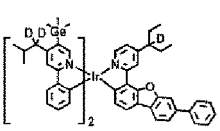
1511

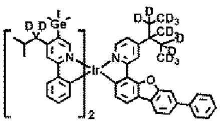
1512

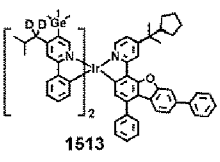
1513

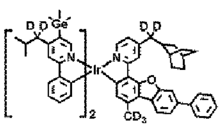
1514

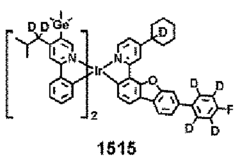
1515

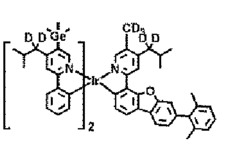
1516

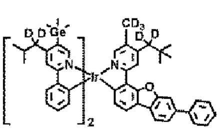
1517

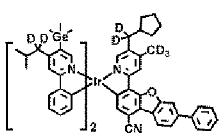
1518

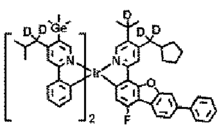
1519

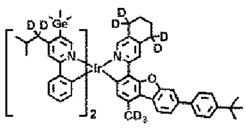
1520

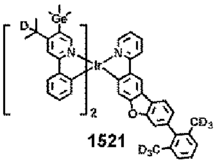
1521

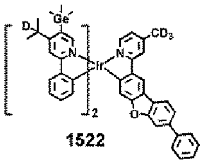
1522

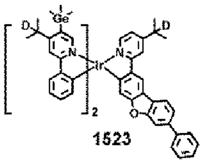
1523

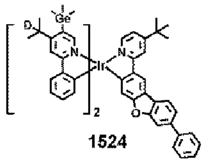
1524

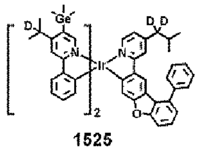
1525

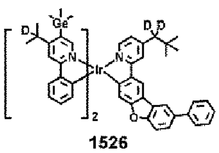
1526

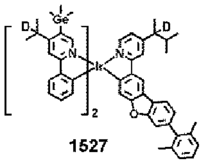
1527

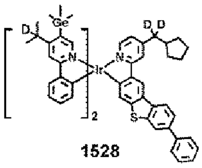
1528

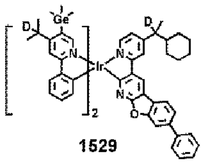
1529

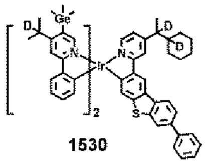
1530

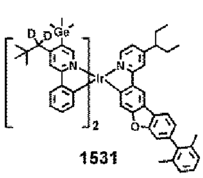
1531

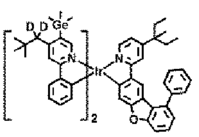
1532

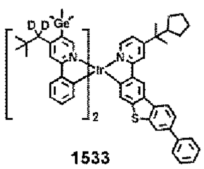
1533

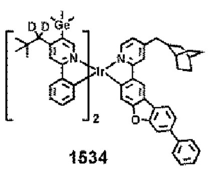
1534

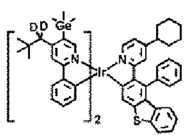
1535

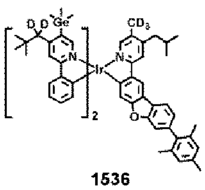
1536

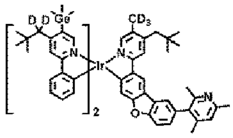
1537

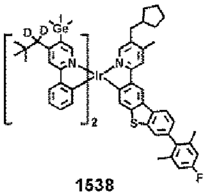
1538

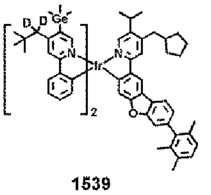
1539

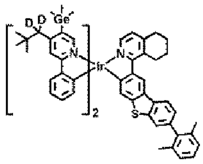
1540

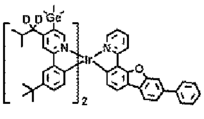 1541
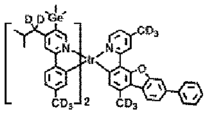 1542
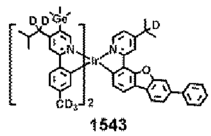 1543
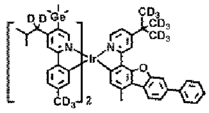 1544
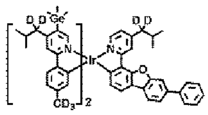 1545

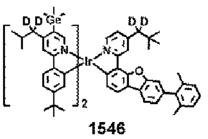 1546
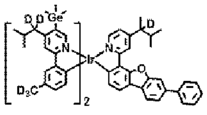 1547
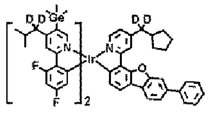 1548
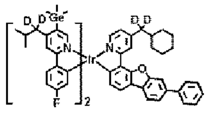 1549
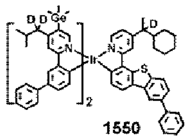 1550

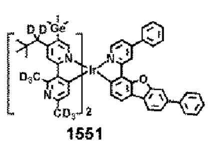 1551
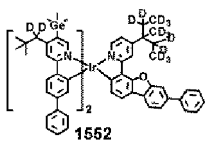 1552
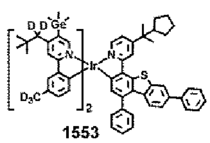 1553
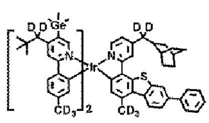 1554
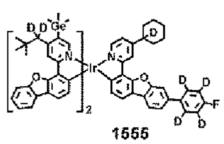 1555

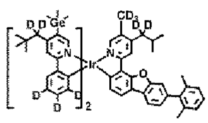 1556
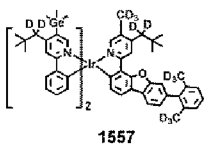 1557
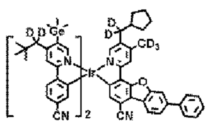 1558
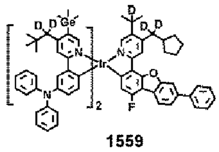 1559
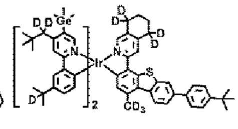 1560

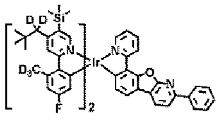 1561
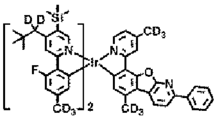 1562
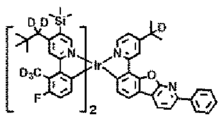 1563
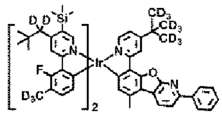 1564
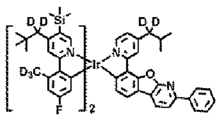 1565

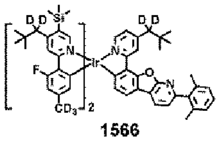 1566
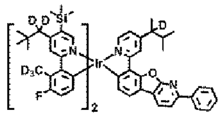 1567
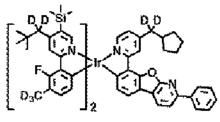 1568
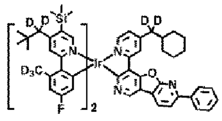 1569
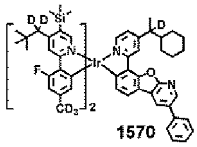 1570

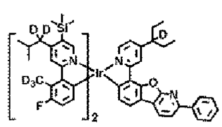 1571
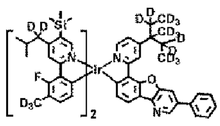 1572
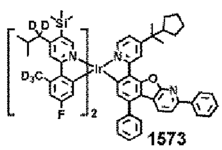 1573
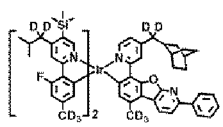 1574
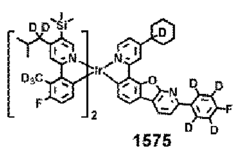 1575

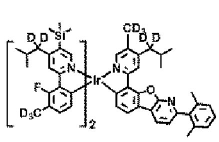 1576
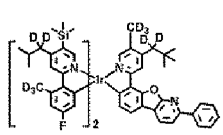 1577
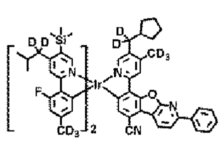 1578
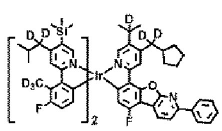 1579
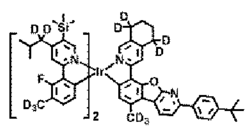 1580

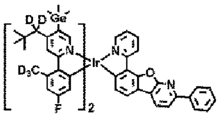
1581
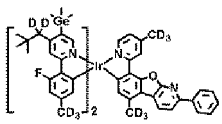
1582
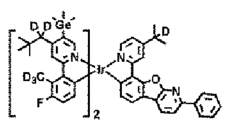
1583
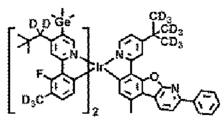
1584
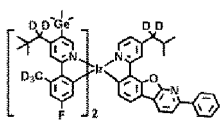
1585

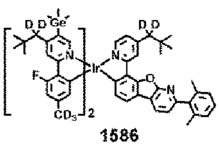
1586
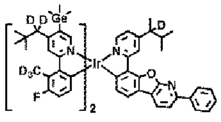
1587
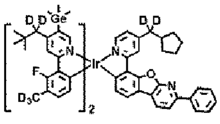
1588
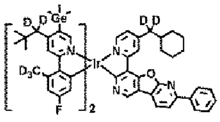
1589
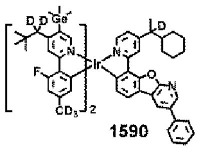
1590

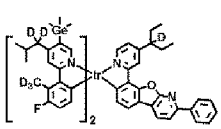
1591
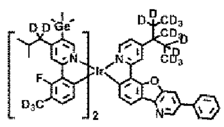
1592
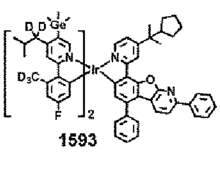
1593
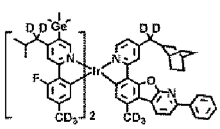
1594
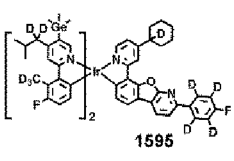
1595

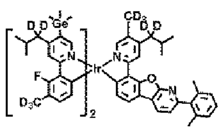
1596
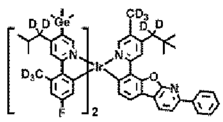
1597
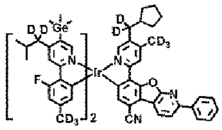
1598
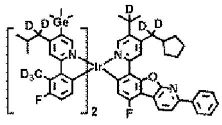
1599
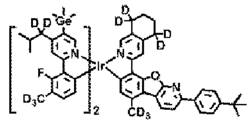
1600

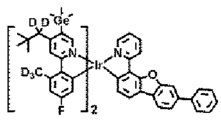
1601
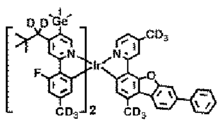
1602
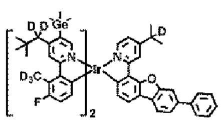
1603
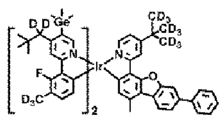
1604
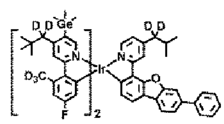
1605

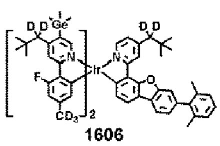
1606
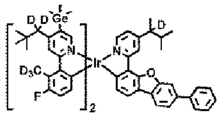
1607
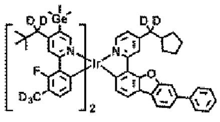
1608
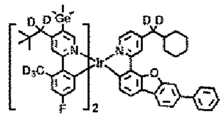
1609
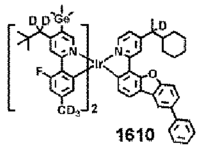
1610

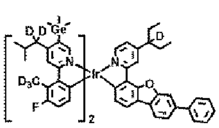
1611
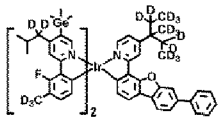
1612
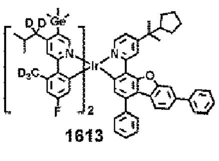
1613
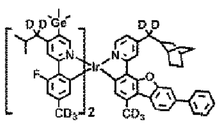
1614
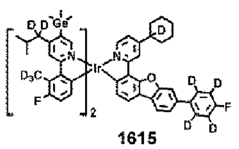
1615

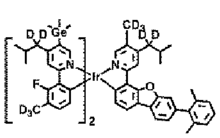
1616
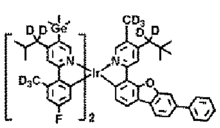
1617
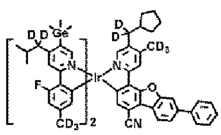
1618
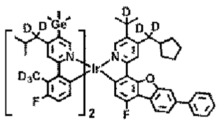
1619
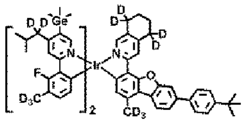
1620

## Group 2-3

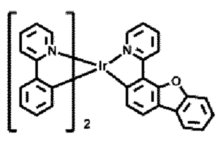
1

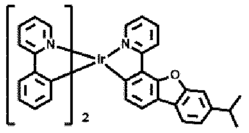
2

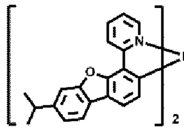
3

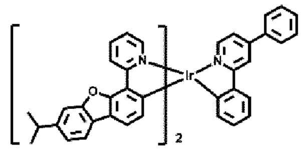
4

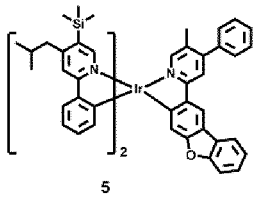
5

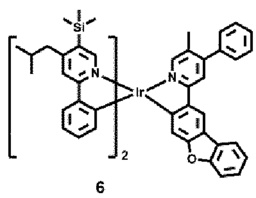
6

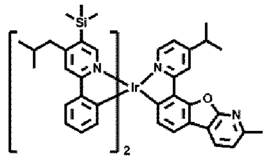
7

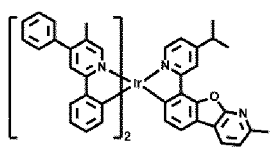
8

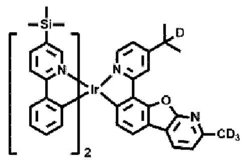
9

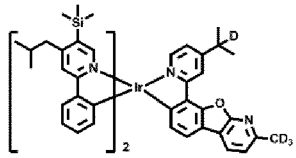
10

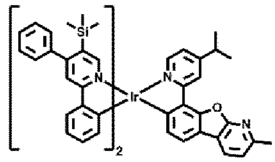
11

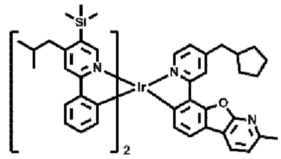
12

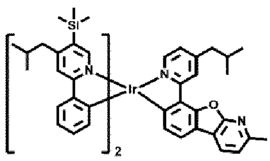
13

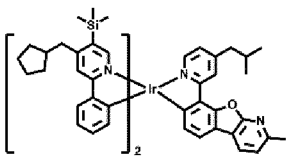
14

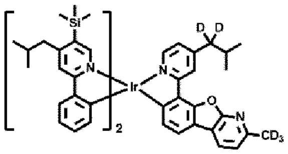
15

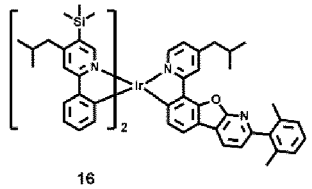
16

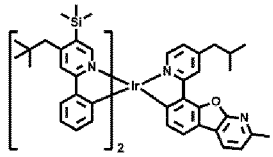
17

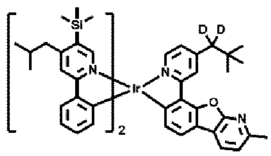
18

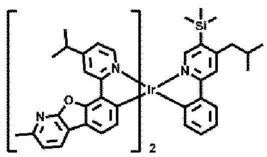
19

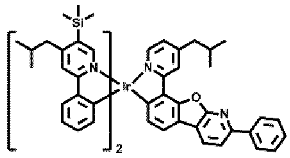
20

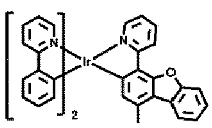
21

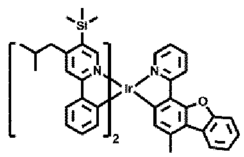
22

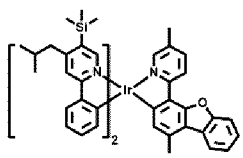
23

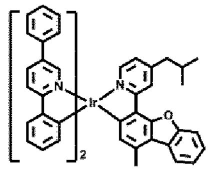
24

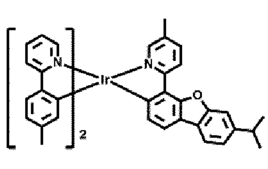

25

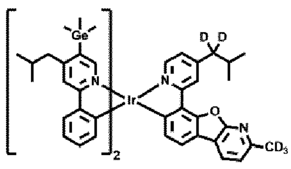

26

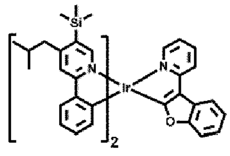

27

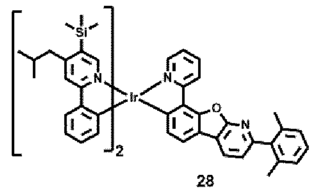

28

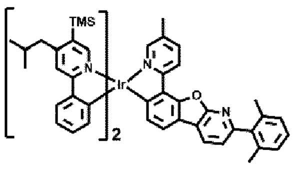

29

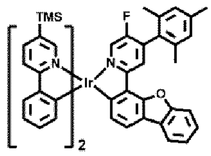

30

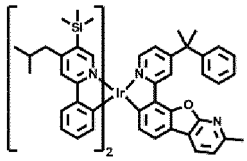

31

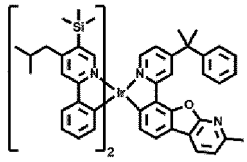

32

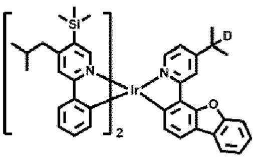

33

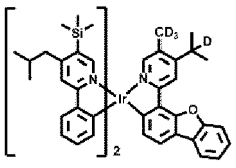

34

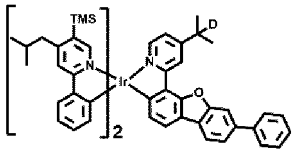

35

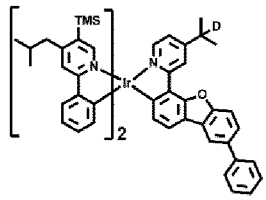

36

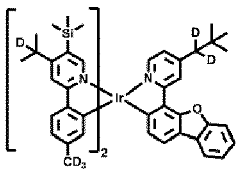

37

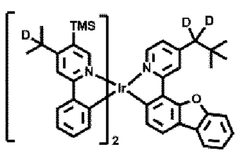

38

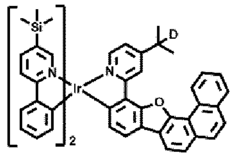

39

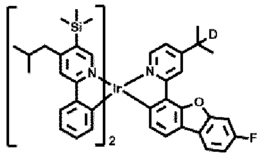

40

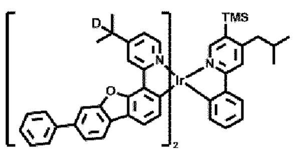

41

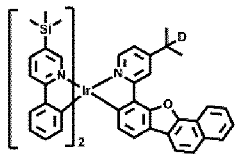

42

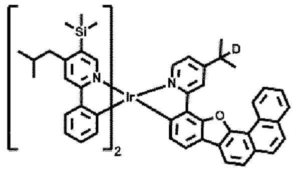

43

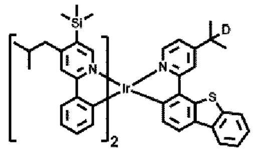

44

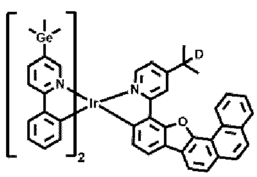

45

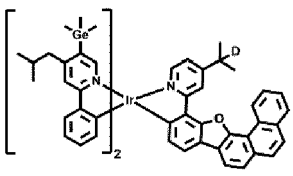

46

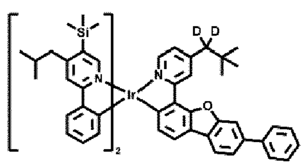

47

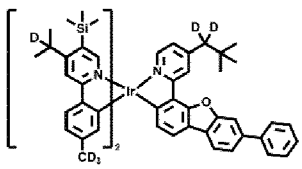

48

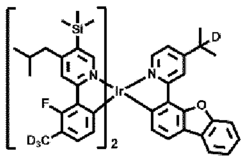
49

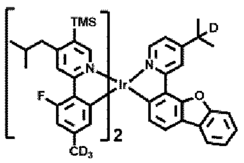
50

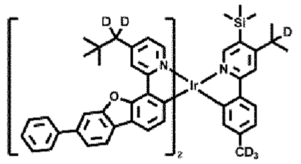
51

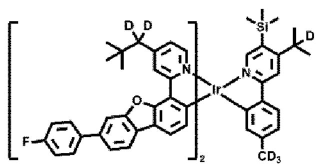
52

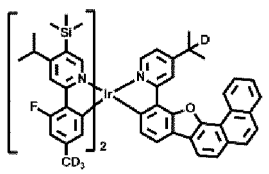
53

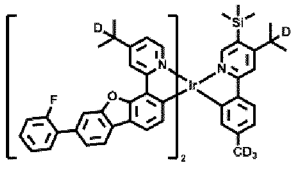
54

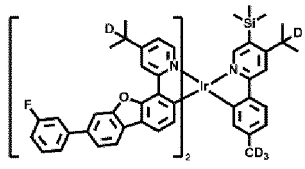
55

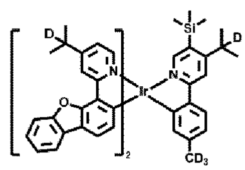
56

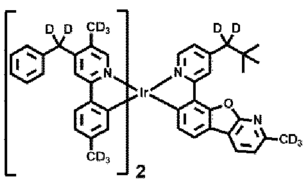
57

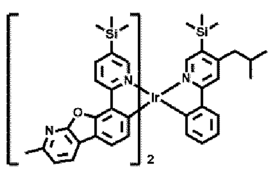
58

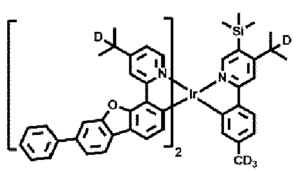
59

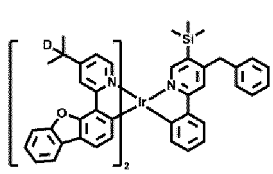
60

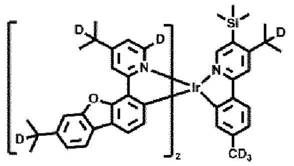
61

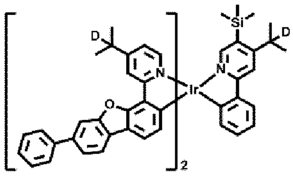
62

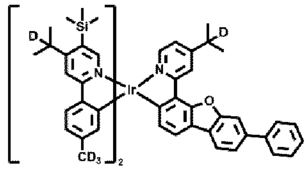
63

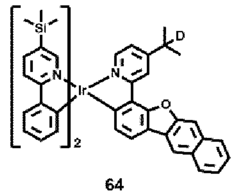
64

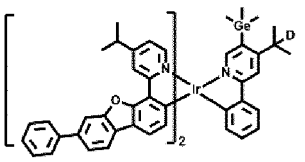
65

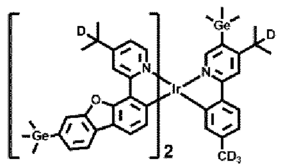
66

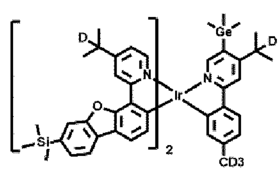
67

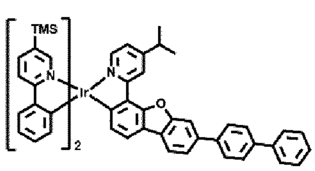
68

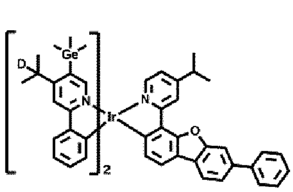
69

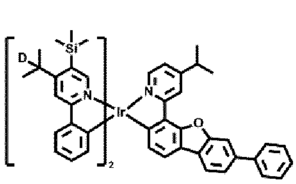
70

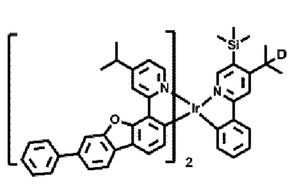
71

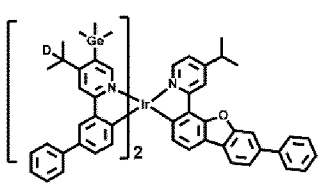
72

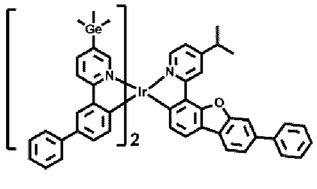

73

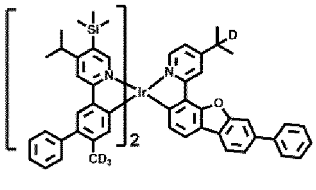

74

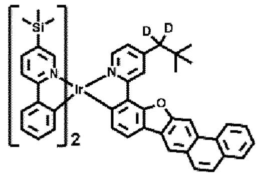

75

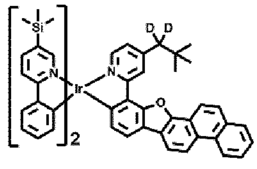

76

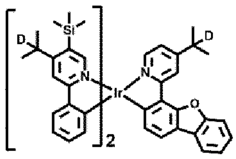

77

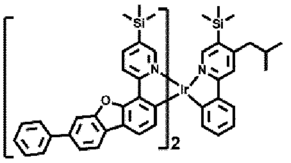

78

Group 2-4

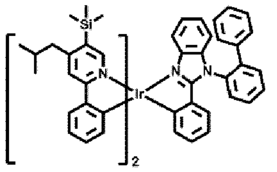

1

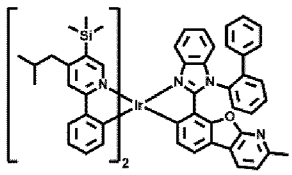

2

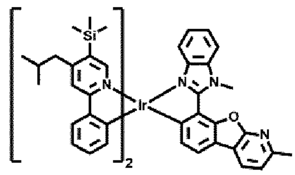

3

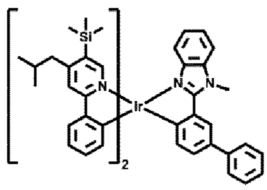

4

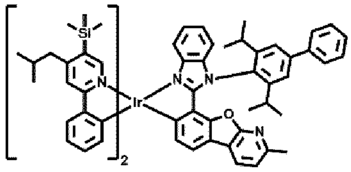

5

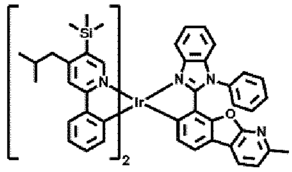

6

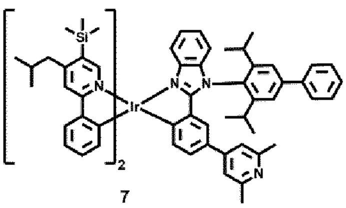

7

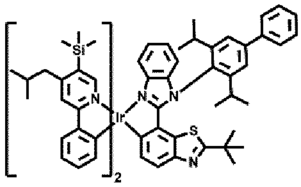

8

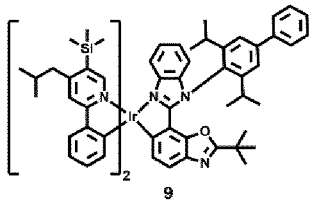

9

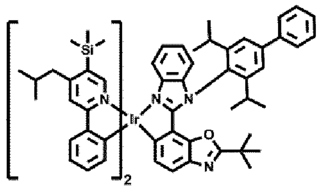

10

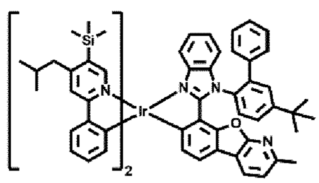

11

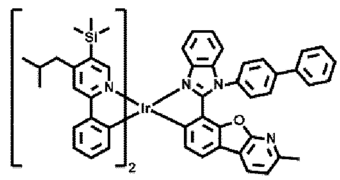

12

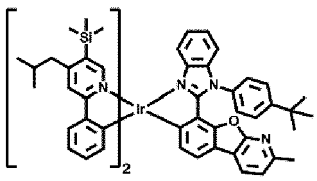

13

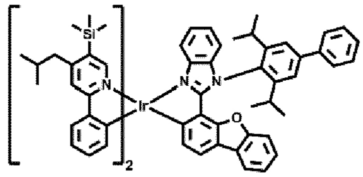

14

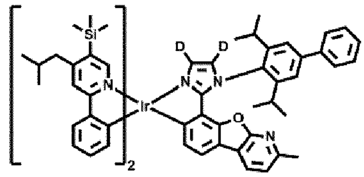

15

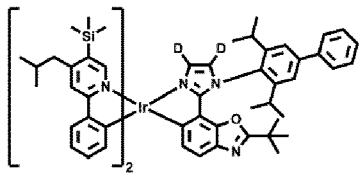

16

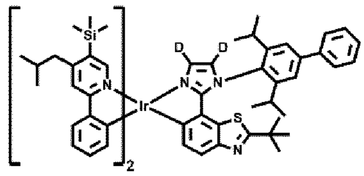

17

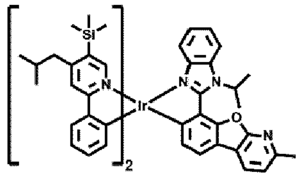

18

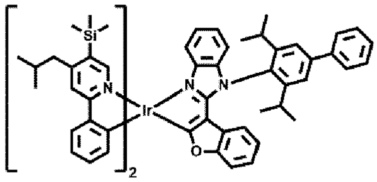

19

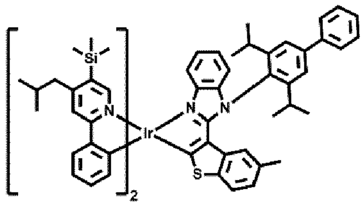

20

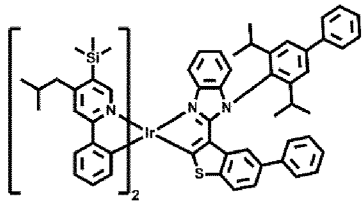

21

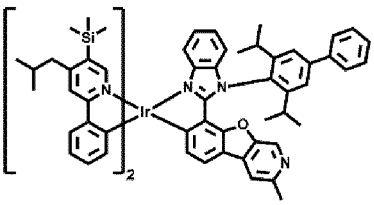

22

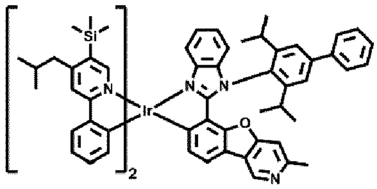

23

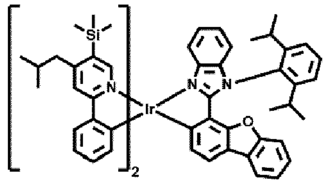

24

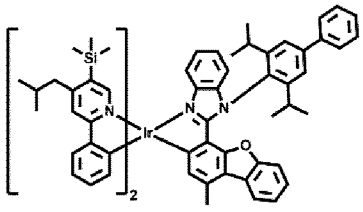

25

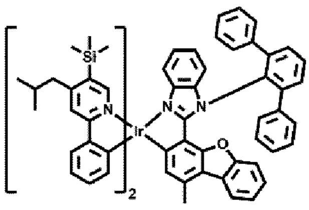

26

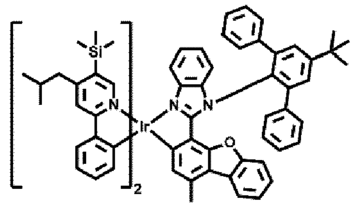

27

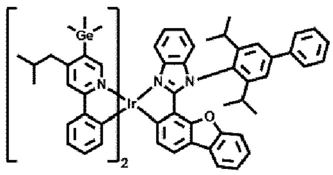

28

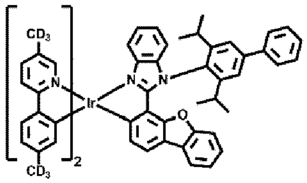

29

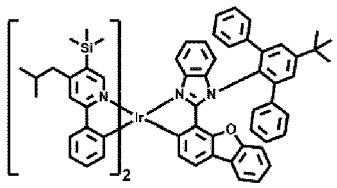

30

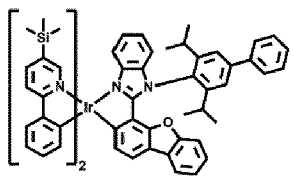

31

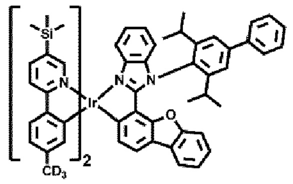

32

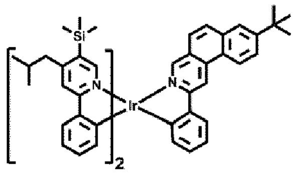

33

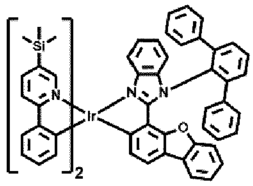

34

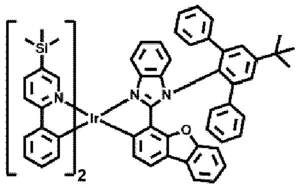

35

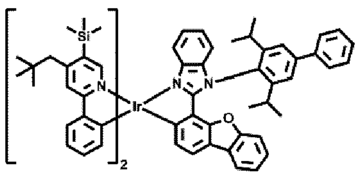

36

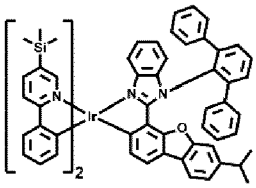

37

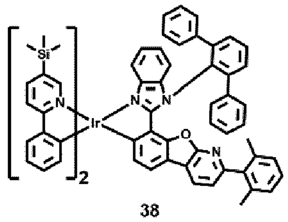

38

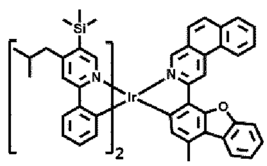

39

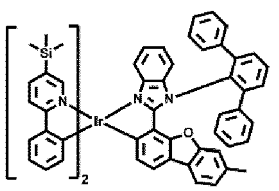

40

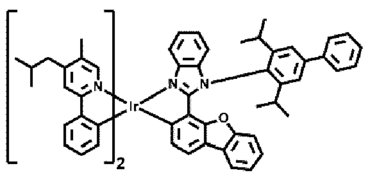

41

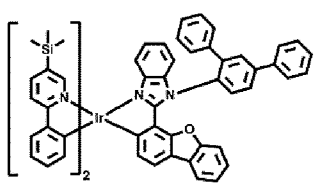

42

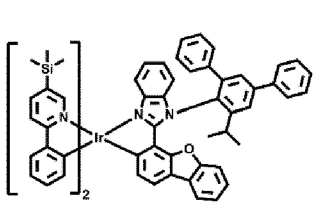

43

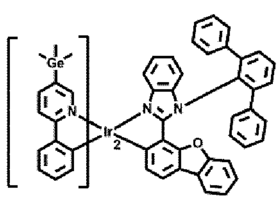

44

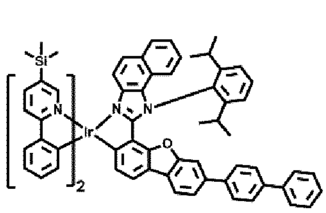

45

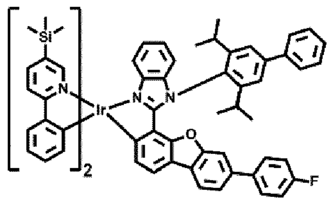

46

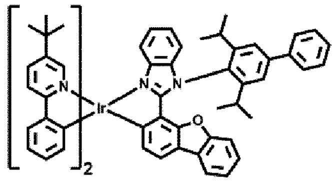

47

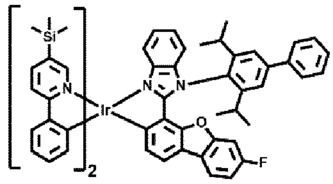

48

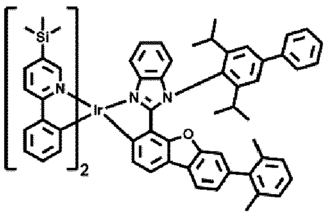

49

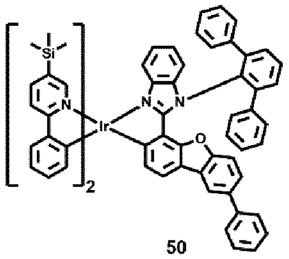

50

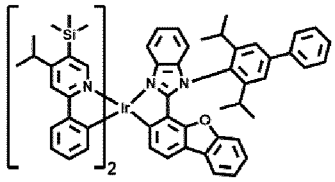

51

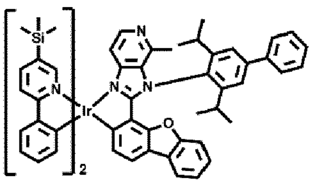

52

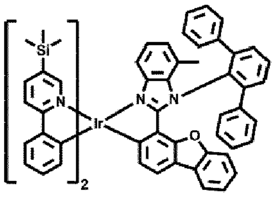

53

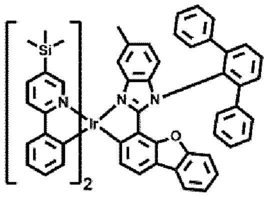

54

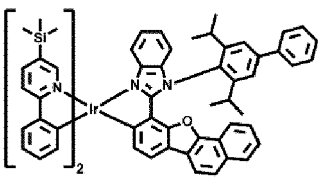

55

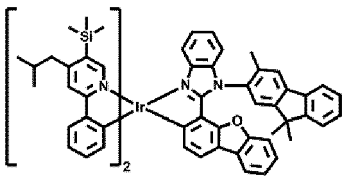

56

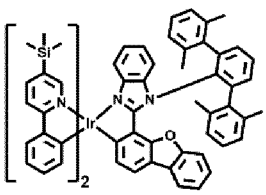

57

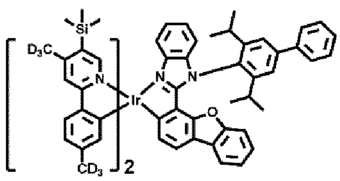

58

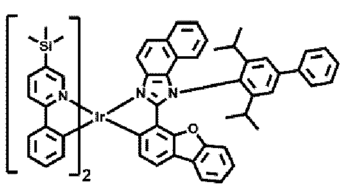

59

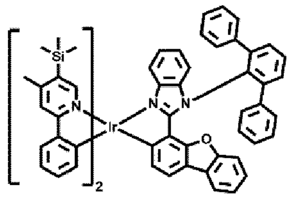

60

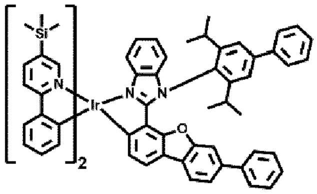

61

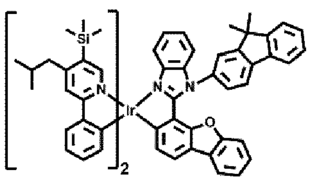

62

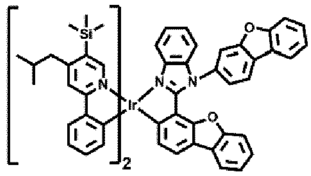

63

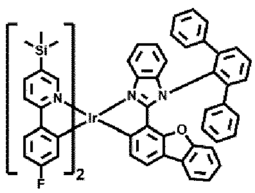
64

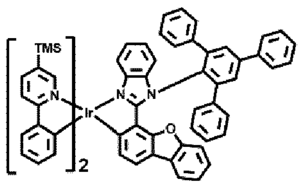
65

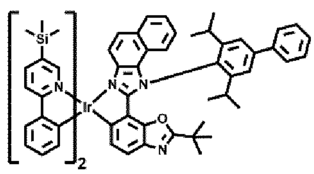
66

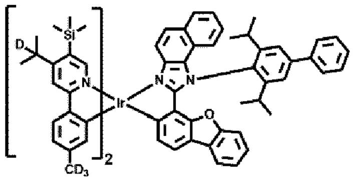
67

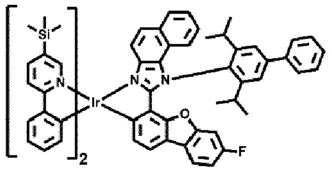
68

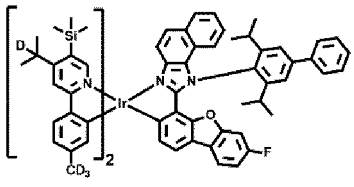
69

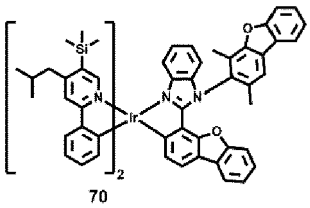
70

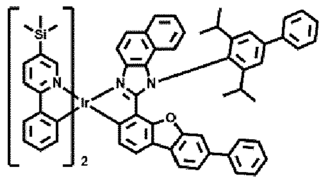
71

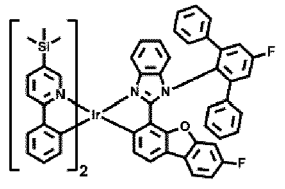
72

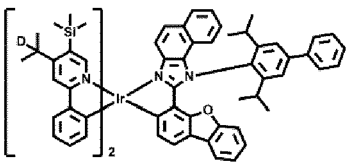
73

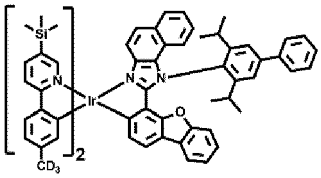
74

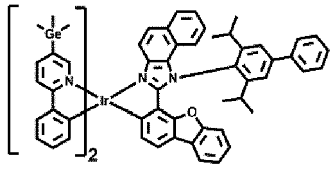
75

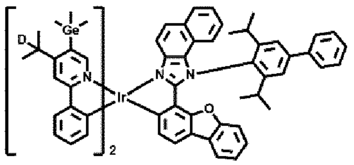
76

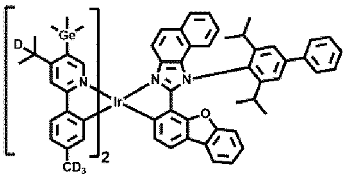
77

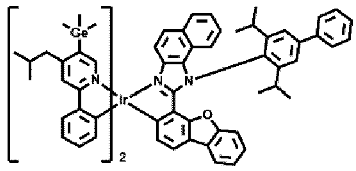
78

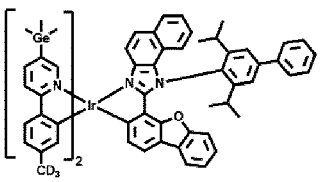
79

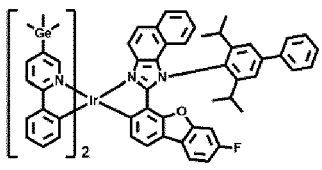
80

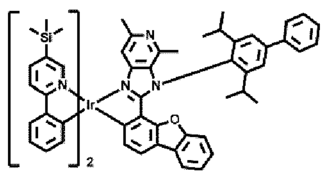
81

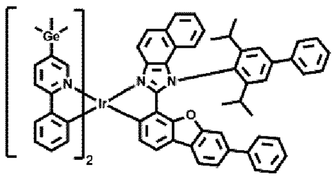

82

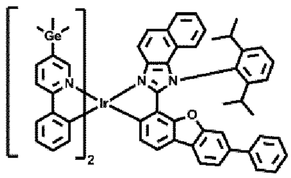

83

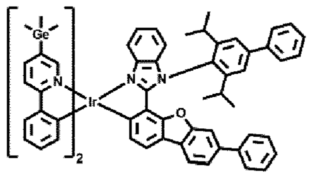

84

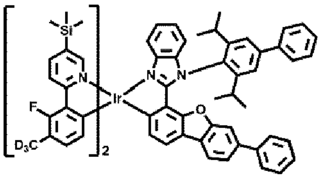

85

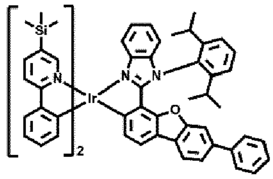

86

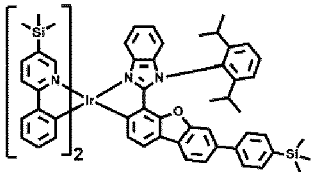

87

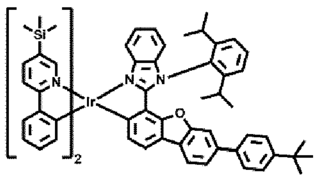

88

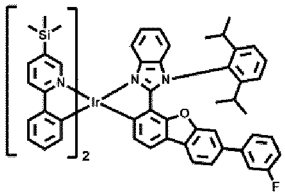

89

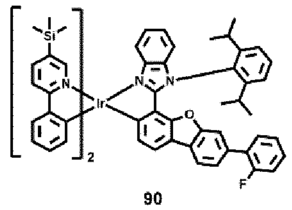

90

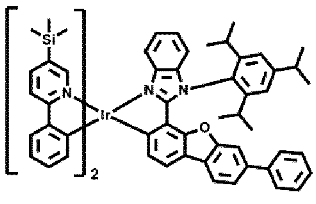

91

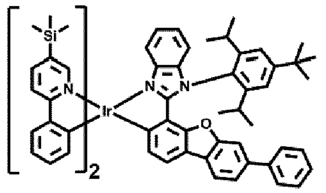

92

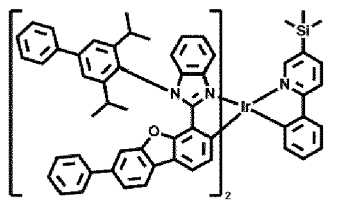

93

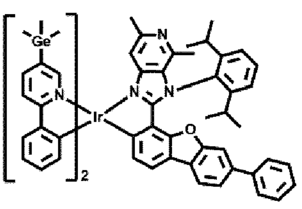

94

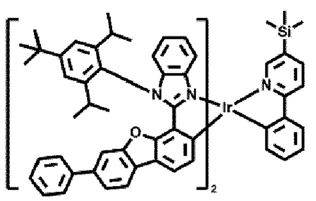

95

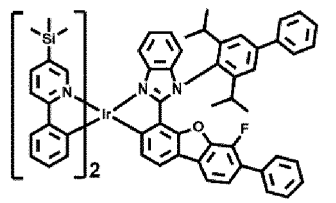

96

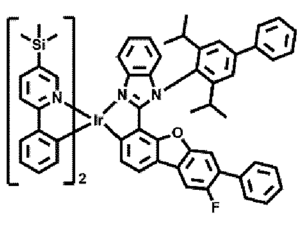

97

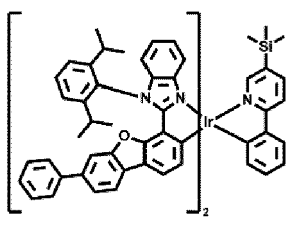

98

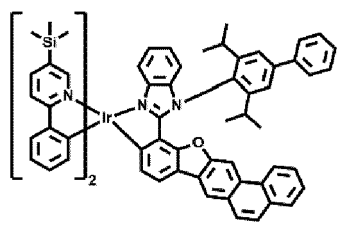

99

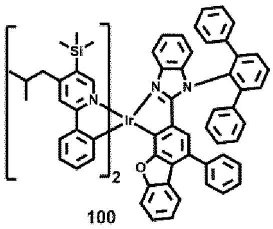
100

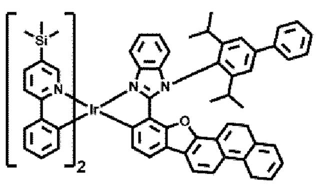
101

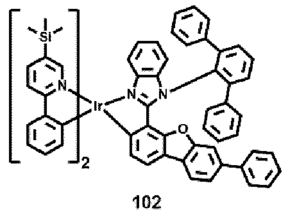
102

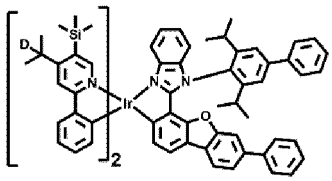
103

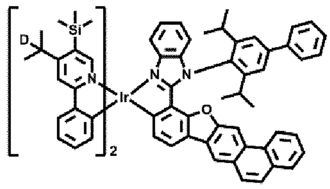
104

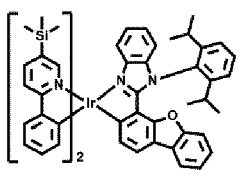
105

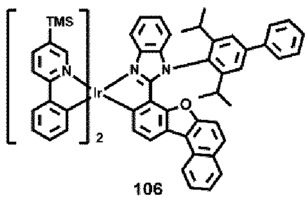
106

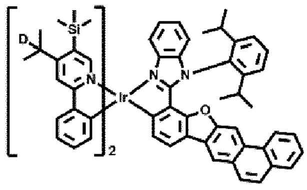
107

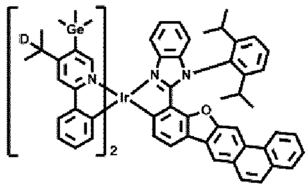
108

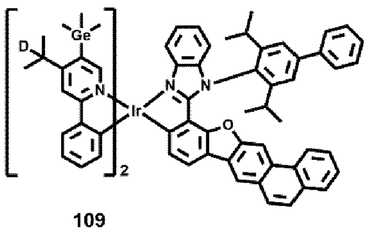
109

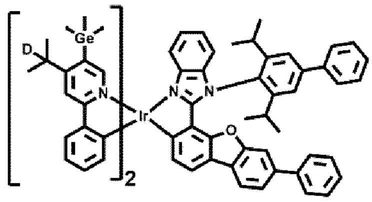
110

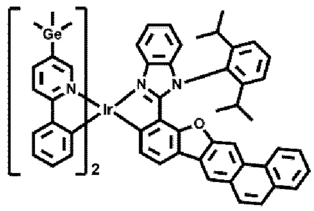
111

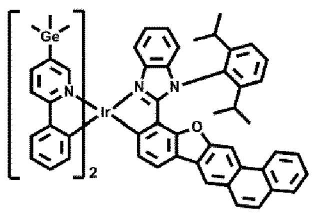
112

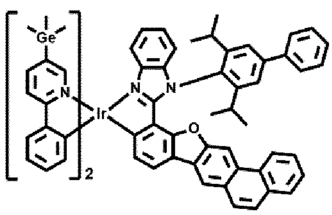
113

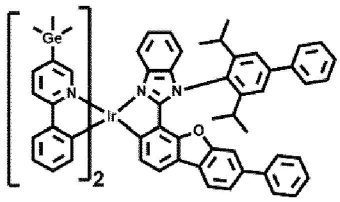
114

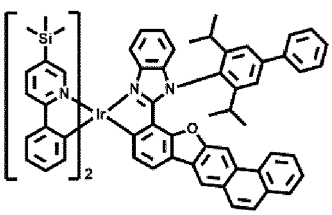
115

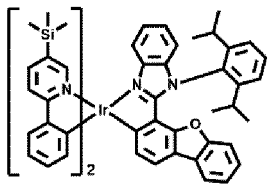
116

Group 2-5

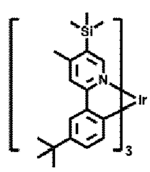
1

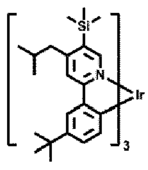
2

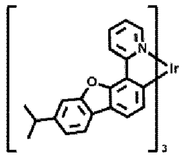
3

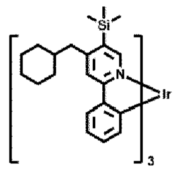
4

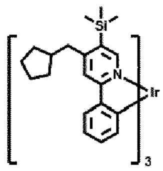
5

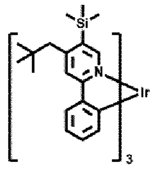
6

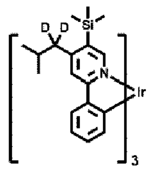
7

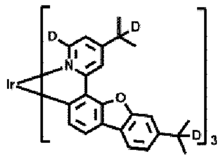
8

Group 2-6

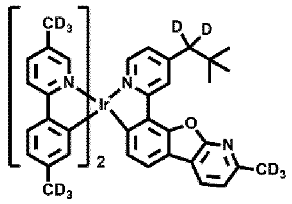
1

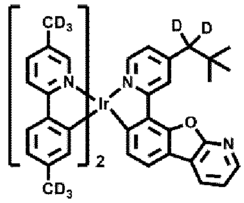
2

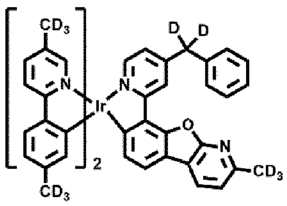
3

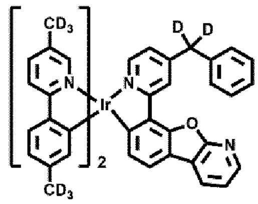
4

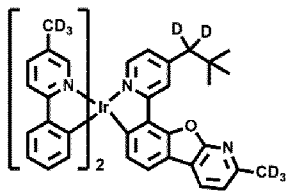
5

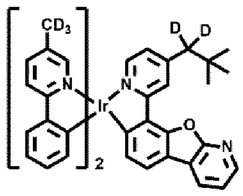
6

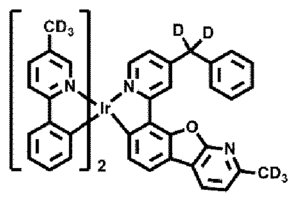
7

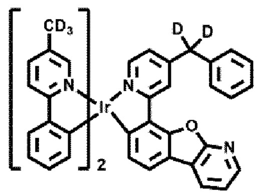
8

In the present specification, "OMe" refers to a methoxy group, "TMS" refers to a trimethylsilyl group, and "TMG" refers to a trimethylgermyl group.

In one or more embodiments, the iridium-containing organometallic compound may not be a compound of [Group B]:

Group B

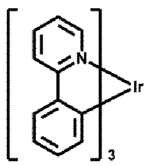 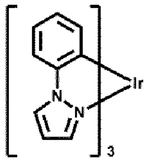 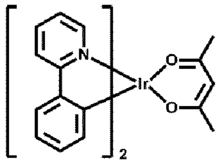 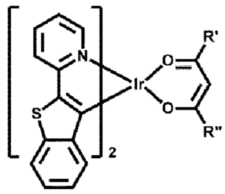 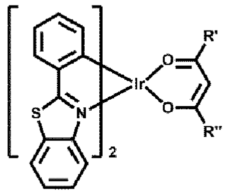

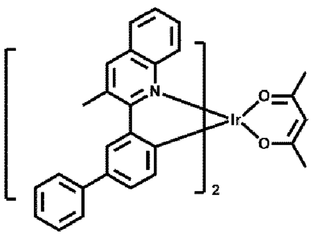 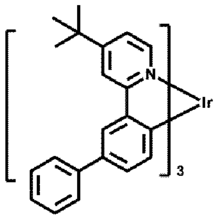 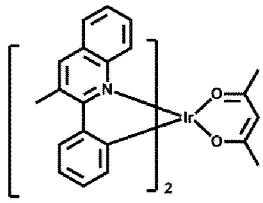 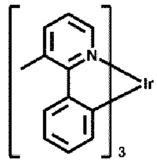

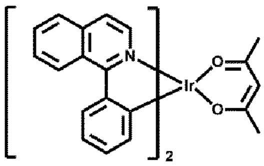 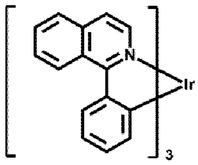 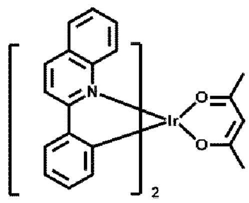 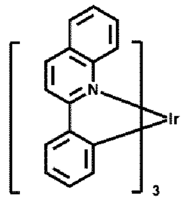

wherein R' and R" of [Group B] may each be an alkyl group.

The fluorescent compound

a) may not include a transition metal, and
b) may include i) boron (B), and ii) O, S, N, or a combination thereof.

In one or more embodiments, the fluorescent compound may include at least one 6-membered ring including at least one N and at least one B.

In one or more embodiments, the fluorescent compound may be a compound represented by Formula 3 or a compound represented by Formula 4:

Formula 3

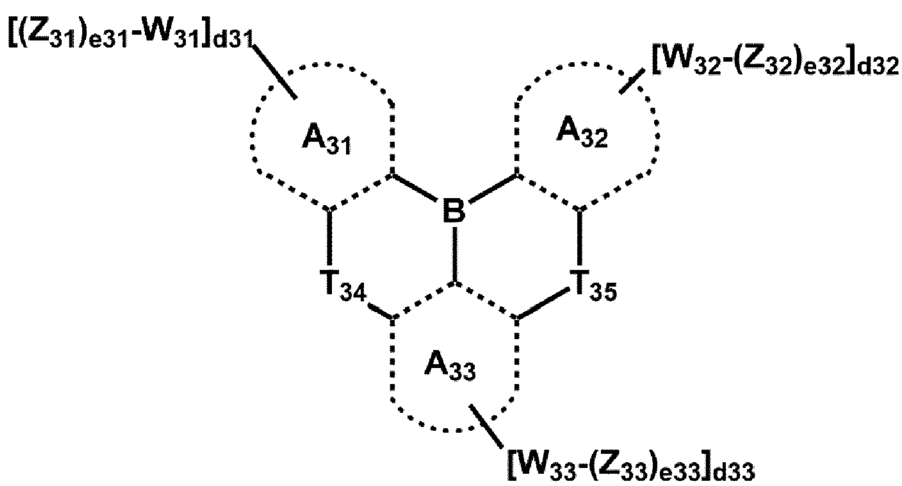

Formula 4

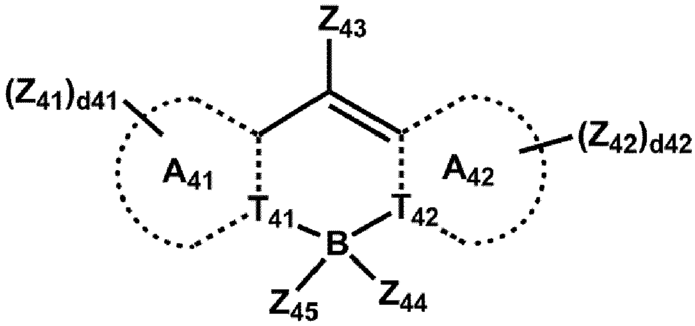

wherein, in Formulae 3 and 4,

ring $A_{31}$ to ring $A_{33}$, ring $A_{41}$, and ring $A_{42}$ may each independently be a $C_5$-$C_{30}$ carbocyclic group or a $C_1$-$C_{30}$ heterocyclic group,
$T_{34}$ may be O, S, or N-[$W_{34}$-$(Z_{34})_{e34}$],
$T_{35}$ may be O, S, or N-[$W_{36}$-$(Z_{36})_{e38}$],
$T_{41}$ and $T_{42}$ may each independently be N or C,
$W_{31}$ to $W_{33}$ are each as described in connection with $W_1$,
$Z_{31}$ to $Z_{35}$ and $Z_{41}$ to $Z_{45}$ are each as described in connection with $Z_1$,
e31 to e35 are each as described in connection with e1, and
d31 to d33 are each as described in connection with d1.

For example, ring $A_{31}$ to ring $A_{33}$, ring $A_{41}$, and ring $A_{42}$ are each as described in connection with ring $A_1$.

In one or more embodiments, in Formula 3, ring $A_{31}$ and ring $A_{32}$ may each be a benzene group, and ring $A_{33}$ may be a benzene group, a quinoline group, or an isoquinoline group.

In one or more embodiments, $T_{34}$ in Formula 3 may be N-[$W_{34}$-$(Z_{34})_{e34}$].

In one or more embodiments, $T_{34}$ in Formula 3 may be N-[$W_{34}$-$(Z_{34})_{e34}$], and $Z_{34}$ and ring $A_{31}$ and/or $Z_{34}$ and $Z_{31}$ may be bonded to each other via a single bond, or a linking group including O, S, N, B, C, or a combination thereof.

In one or more embodiments, $T_{35}$ in Formula 3 may be N-[$W_{35}$-$(Z_{35})_{e35}$].

In one or more embodiments, $T_{35}$ in Formula 3 may be N-[$W_{35}$-$(Z_{35})_{e35}$], and $Z_{35}$ and ring $A_{32}$ and/or $Z_{35}$ and $Z_{32}$ may be bonded to each other via a single bond, or a linking group including O, S, N, B, C, or a combination thereof.

In one or more embodiments, ring $A_{41}$ and ring $A_{42}$ in Formula 4 may each be a pyrrole group. For example, $T_{41}$ and $T_{42}$ may each be N.

For example, the fluorescent compound may be selected from compounds of [Group 3] and [Group 4]:

Group 3

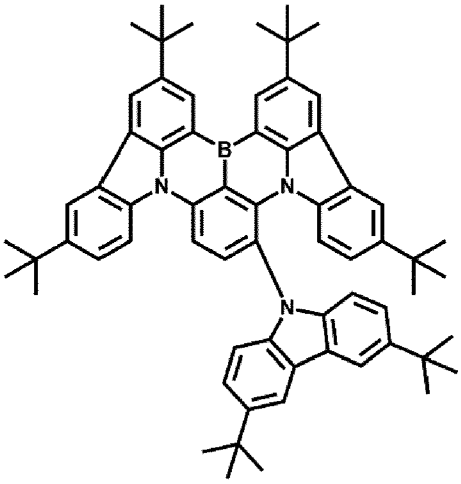

1

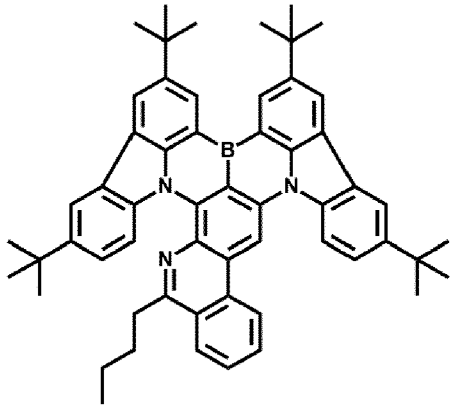

2

Group 4

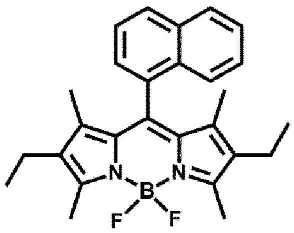

1

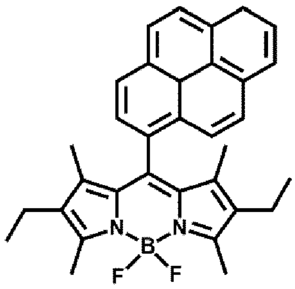

2

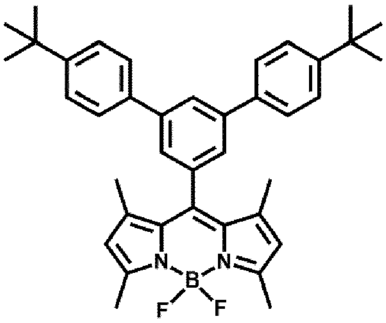

3

A weight ratio of the first compound to the second compound in the composition of the first compound and the second compound may be in range of about 90 : 10 to about 10 : 90, about 80:20 to about 20:80, about 70:30 to about 30:70, or about 60:40 to about 40:60.

Description of matrix material

The matrix material may be, for example, a host of an emission layer among materials for an organic light-emitting device.

In one or more embodiments, the matrix material may consist of only one compound (for example, a hole-transporting compound, an electron-transporting compound, or a bipolar compound).

In one or more embodiments, the matrix material may include a first host and a second host, and the first host and the second host may be different from each other.

The first host and the second host may each include a hole-transporting compound, an electron-transporting compound, a bipolar compound, or a combination thereof.

For example, the first host and the second host may each include a hole-transporting compound and an electron-transporting compound, and the hole-transporting compound and the electron-transporting compound may be different from each other.

In one or more embodiments, the hole-transporting compound may include at least one π electron-rich $C_3$-$C_{60}$ cyclic group (for example, a carbazole group, an indolocarbazole group, a benzene group, or the like), and may not include an electron-transporting group. Examples of the electron-transporting group may include a cyano group, a fluoro group, a π electron-deficient nitrogen-containing $C_1$-$C_{60}$ cyclic group, a phosphine oxide group, a sulfoxide group, and the like.

In one or more embodiments, the electron-transporting compound may be a compound including at least one electron-transporting group. The electron-transporting group may be a cyano group, a fluoro group, a $\pi$ electron-deficient nitrogen-containing $C_1$-$C_{60}$ cyclic group, a phosphine oxide group, a sulfoxide group, or a combination thereof.

In one or more embodiments, the hole-transporting compound may be at least one of Compounds H1-1 to H1-72 of Group 5-1 and Compounds H1-1 to H1-20 of Group 5-2:

Group 5-1

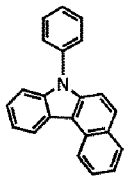
H1-1

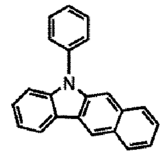
H1-2

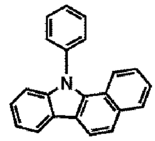
H1-3

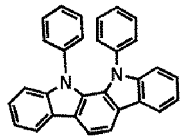
H1-4

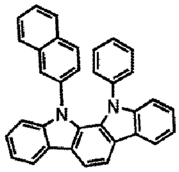
H1-5

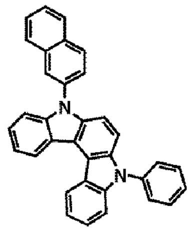
H1-6

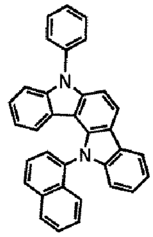
H1-7

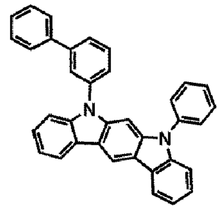
H1-8

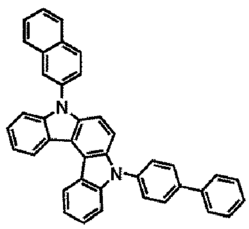
H1-9

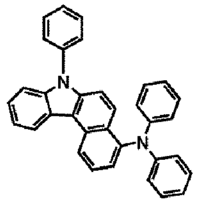
H1-10

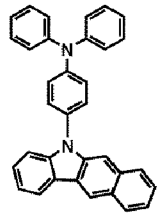
H1-11

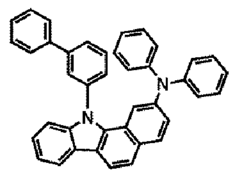
H1-12

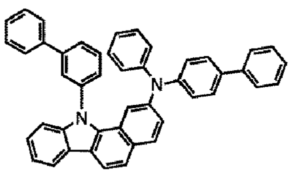
H1-13

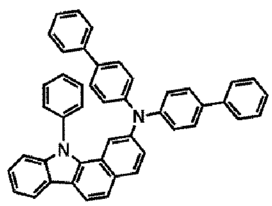
H1-14

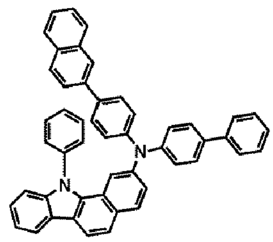
H1-15

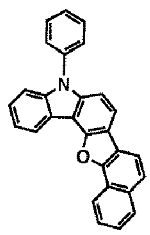
H1-16

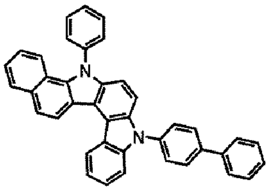

H1-17

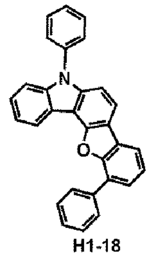

H1-18

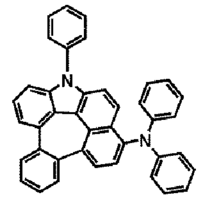

H1-19

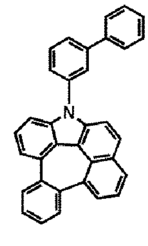

H1-20

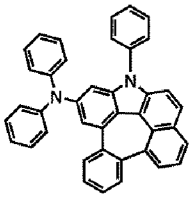

H1-21

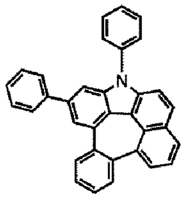

H1-22

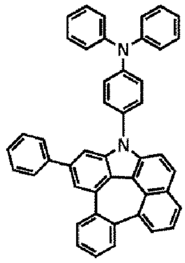

H1-23

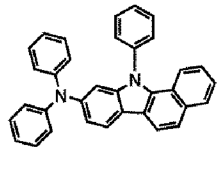

H1-24

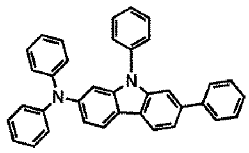

H1-25

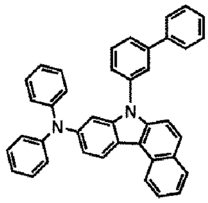

H1-26

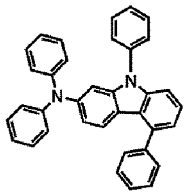

H1-27

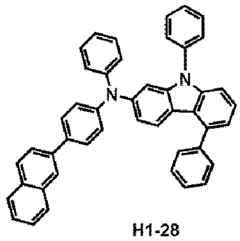

H1-28

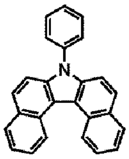

H1-29

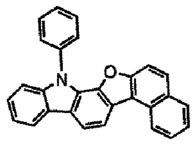

H1-30

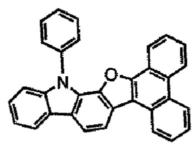

H1-31

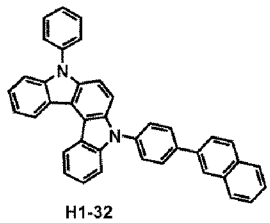

H1-32

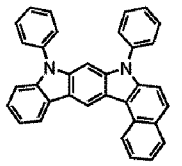
H1-33

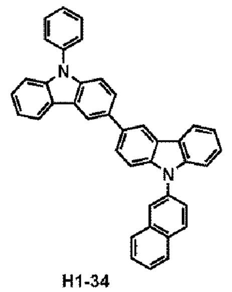
H1-34

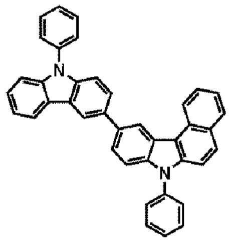
H1-35

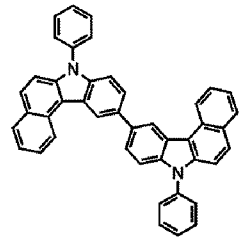
H1-36

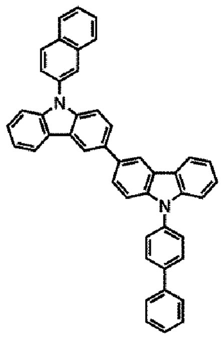
H1-37

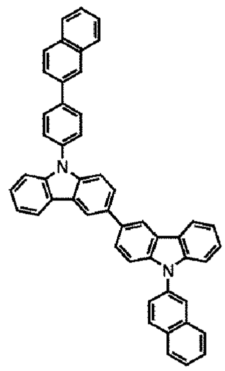
H1-38

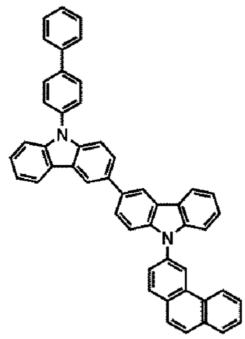
H1-39

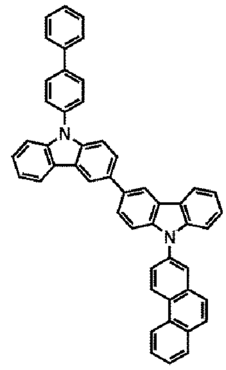
H1-40

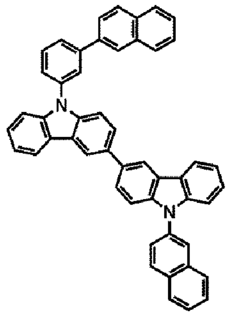
H1-41

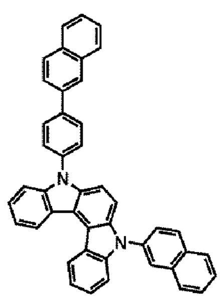
H1-42

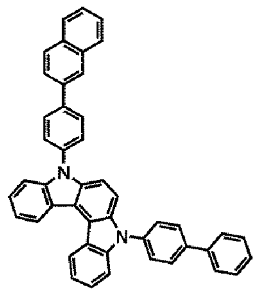
H1-43

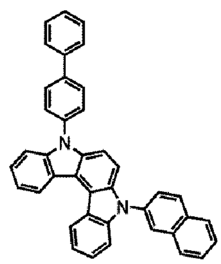
H1-44

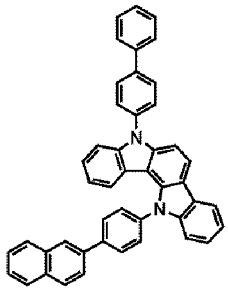
H1-45

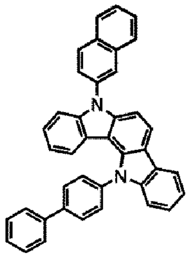
H1-46

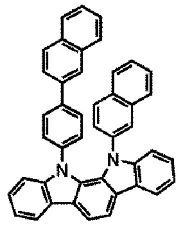
H1-47

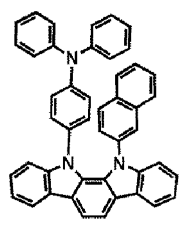
H1-48

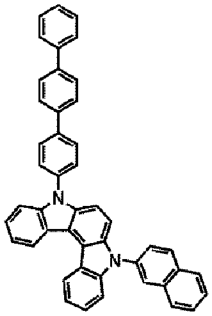
H1-49

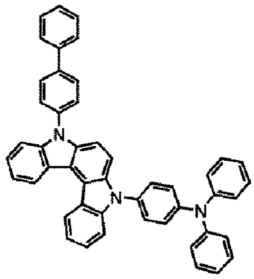
H1-50

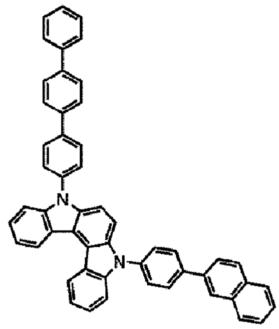
H1-51

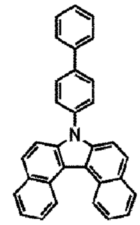
H1-52

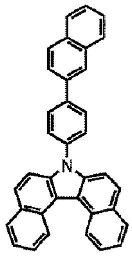
H1-53

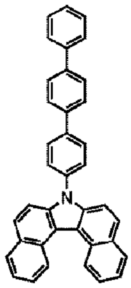
H1-54

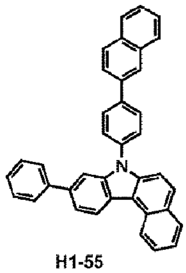
H1-55

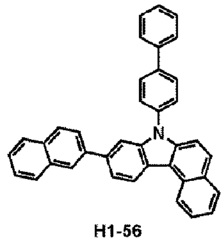
H1-56

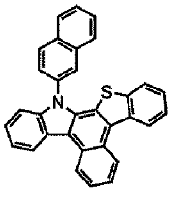
H1-57

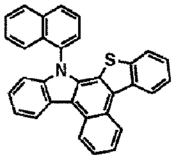
H1-58

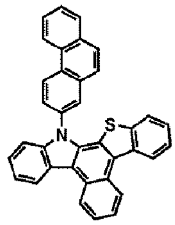
H1-59

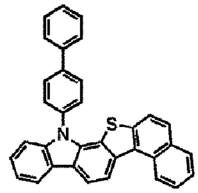
H1-60

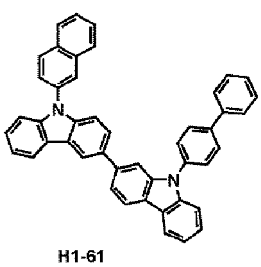
H1-61

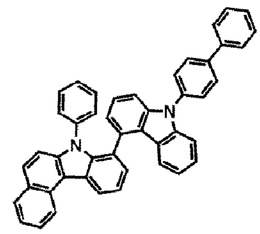
H1-62

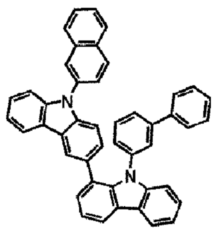
H1-63

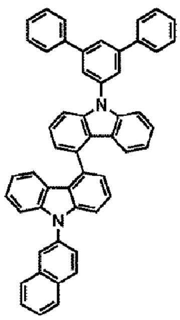
H1-64

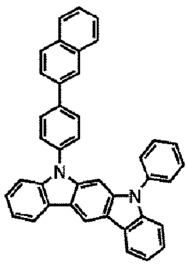
H1-65

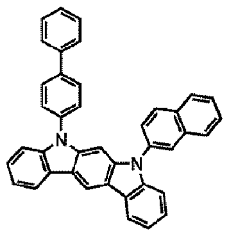
H1-66

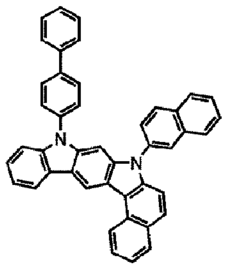
H1-67

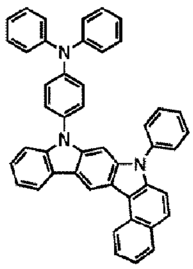
H1-68

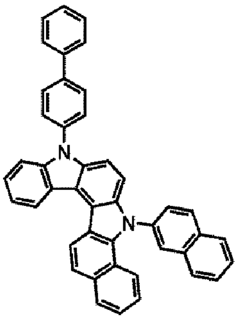
H1-69

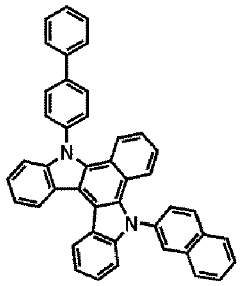
H1-70

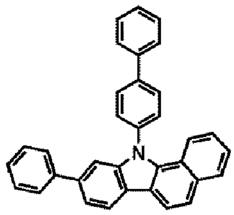
H1-71

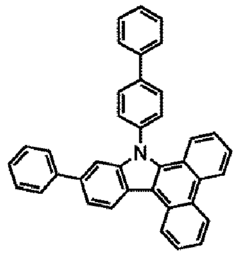
H1-72

Group 5-2

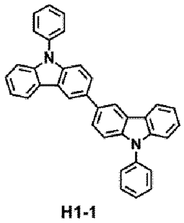
H1-1

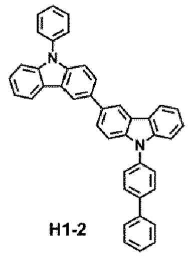
H1-2

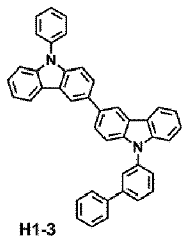
H1-3

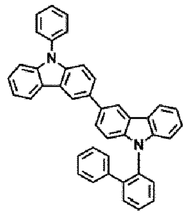
H1-4

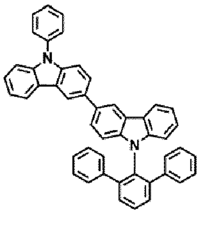
H1-5

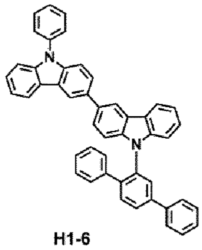
H1-6

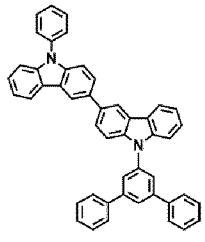
H1-7

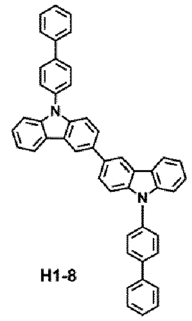
H1-8

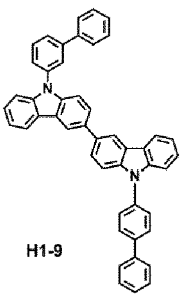
H1-9

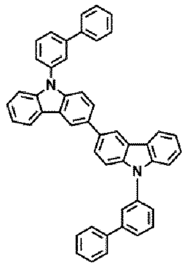
H1-10

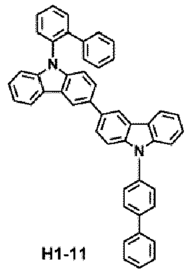
H1-11

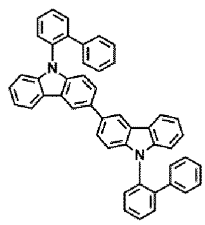
H1-12

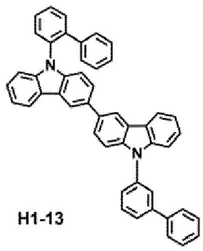
H1-13

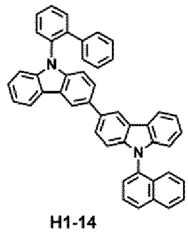
H1-14

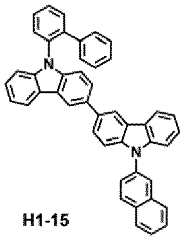
H1-15

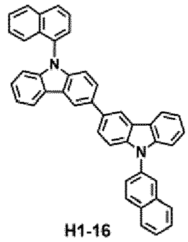
H1-16

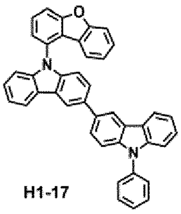
H1-17

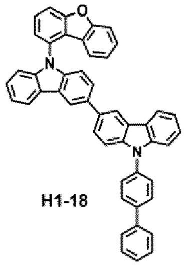
H1-18

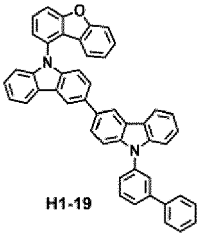
H1-19

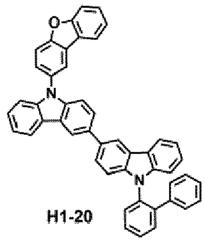
H1-20

In one or more embodiments, the electron-transporting compound may be at least one of Compounds E1-1 to E1-62:

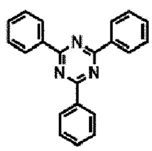
E1-1

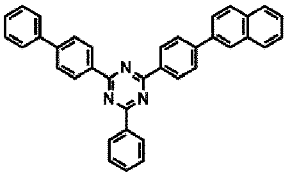
E1-2

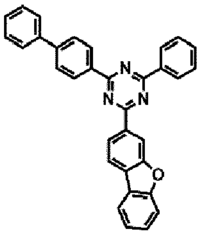
E1-3

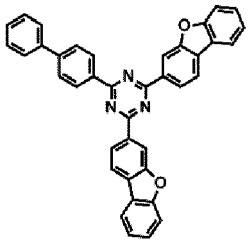
E1-4

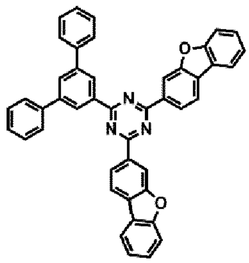
E1-5

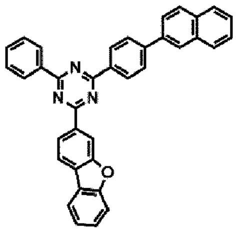
E1-6

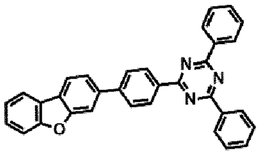
E1-7

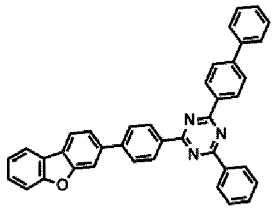
E1-8

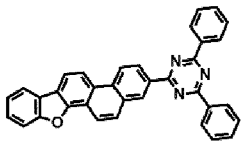
E1-9

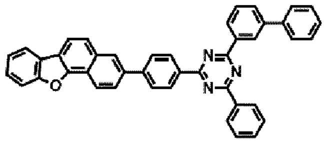
E1-10

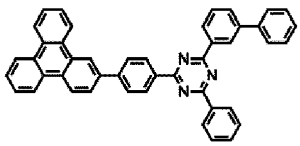
E1-11

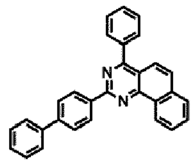
E1-12

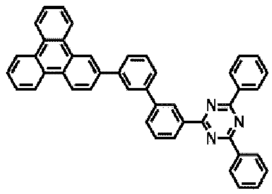
E1-13

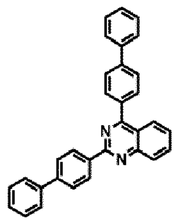
E1-14

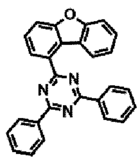
E1-15

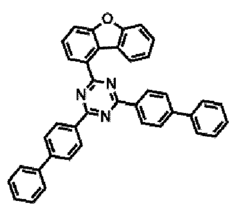
E1-16

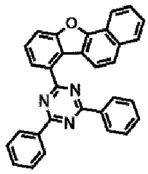
E1-17

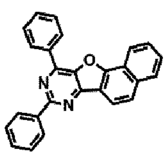
E1-18

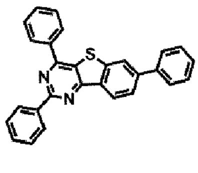
E1-19

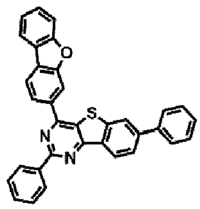
E1-20

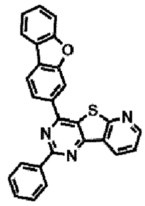
E1-21

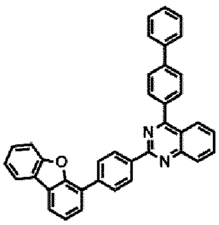
E1-22

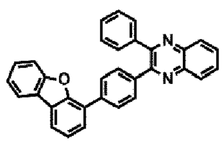
E1-23

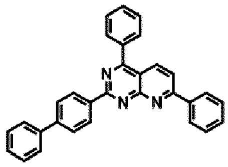
E1-24

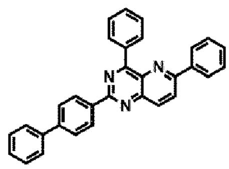
E1-25

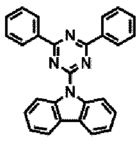
E1-26

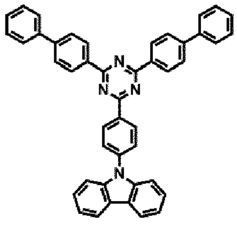
E1-27

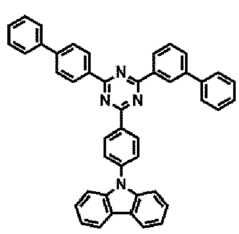
E1-28

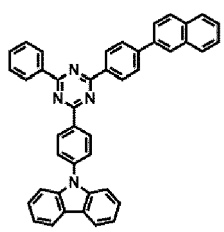
E1-29

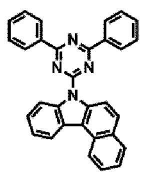
E1-30

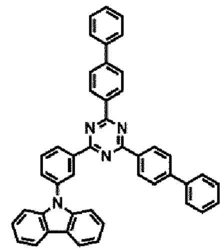
E1-31

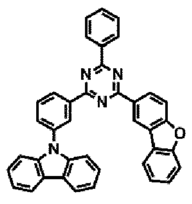
E1-32

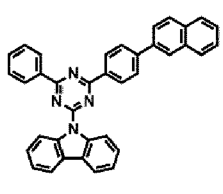
E1-33

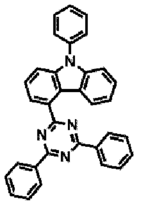
E1-34

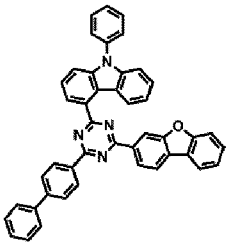
E1-35

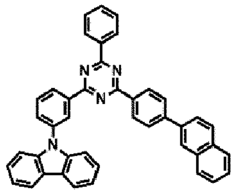
E1-36

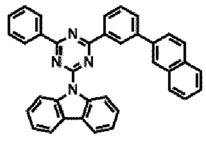
E1-37

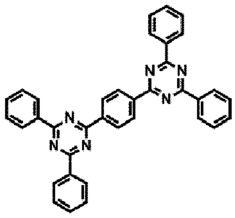
E1-38

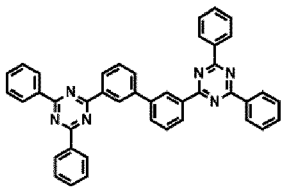
E1-39

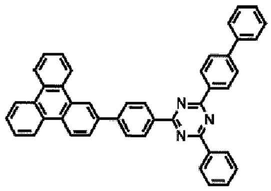
E1-40

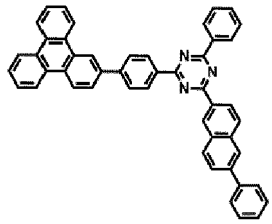
E1-41

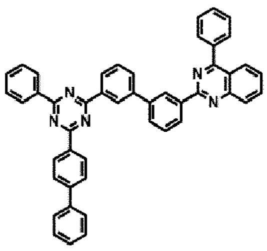
E1-42

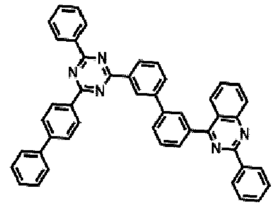
E1-43

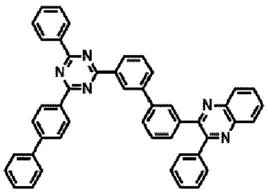
E1-44

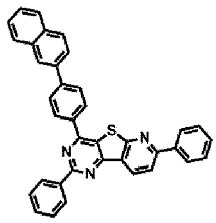
E1-45

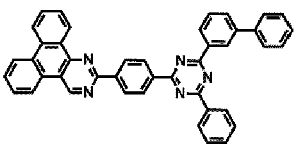
E1-46

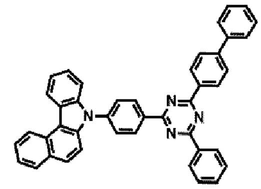
E1-47

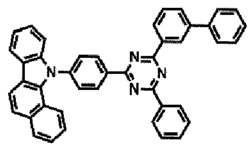
E1-48

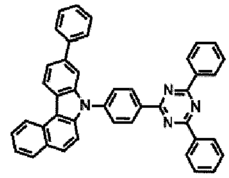
E1-49

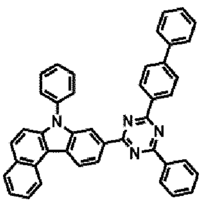
E1-50

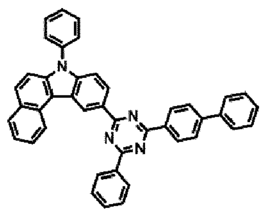
E1-51

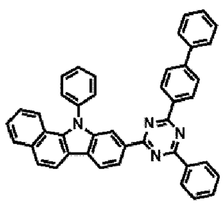
E1-52

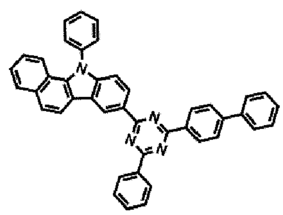
E1-53

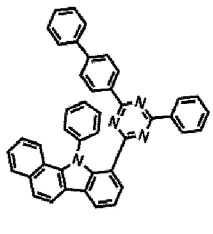
E1-54

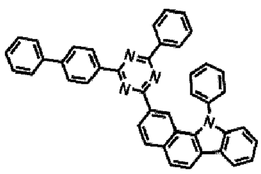
E1-55

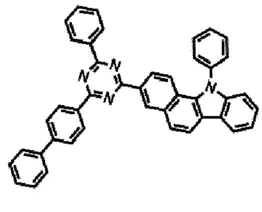
E1-56

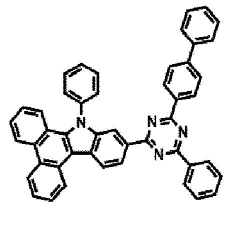
E1-57

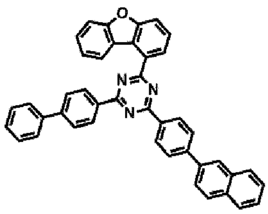
E1-58

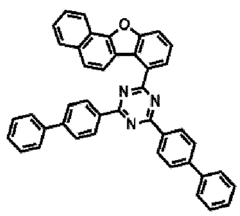
E1-59

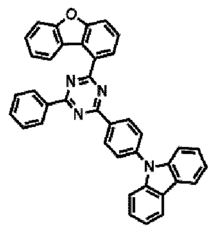
E1-60

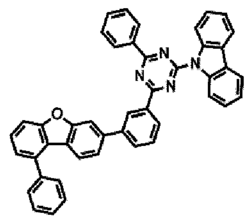
E1-61

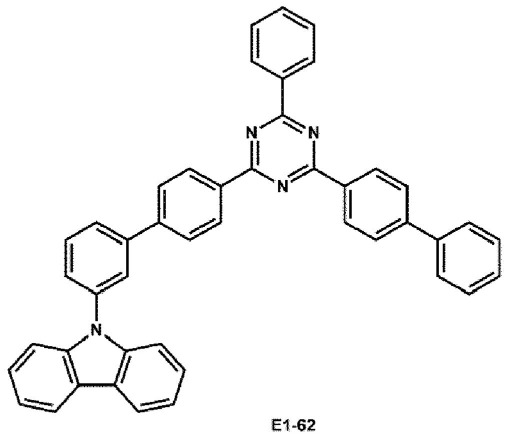
E1-62

In one or more embodiments, the bipolar compound may be at least one of Compounds BP1-1 to BP1-17:

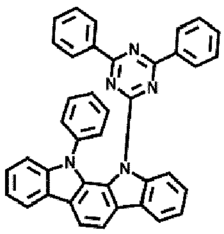
**BP1-1**

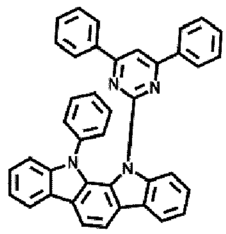
**BP1-2**

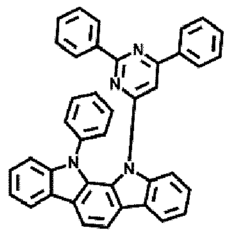
**BP1-3**

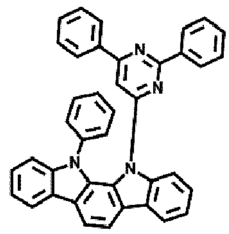
**BP1-4**

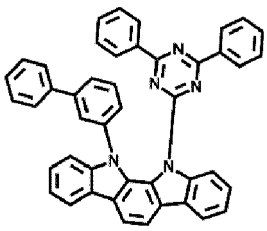
**BP1-5**

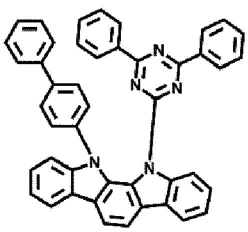
**BP1-6**

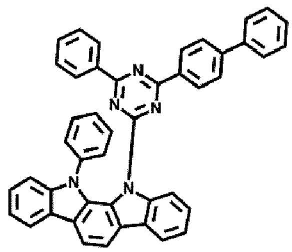
**BP1-7**

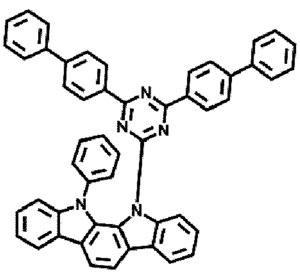
**BP1-8**

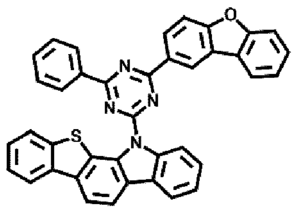
BP1-9

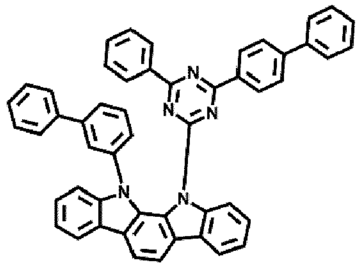
BP1-10

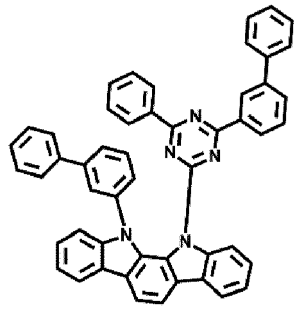
BP1-11

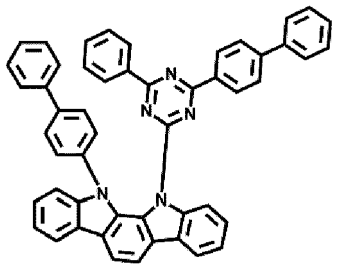
BP1-12

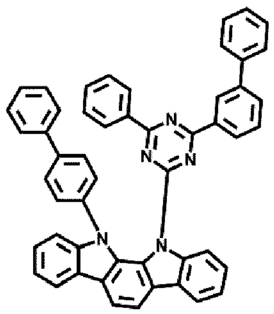
BP1-13

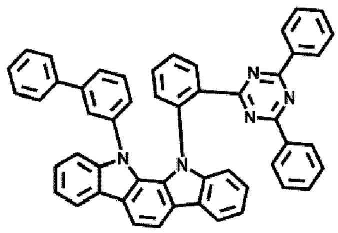
BP1-14

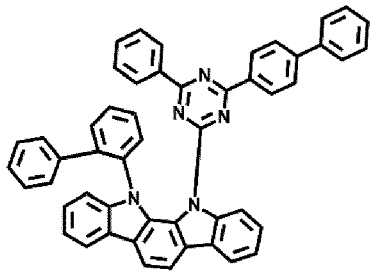
BP1-15

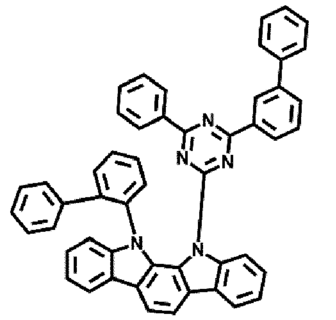
BP1-16

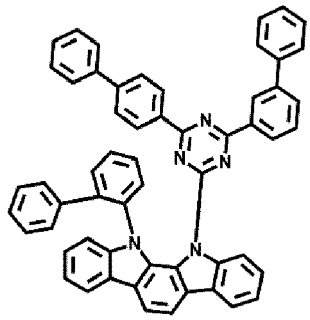
BP1-17

Meanwhile, the mixed layer 15 may not include compounds of Group A:

Group A

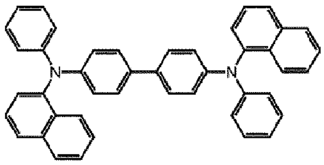

**NPB**

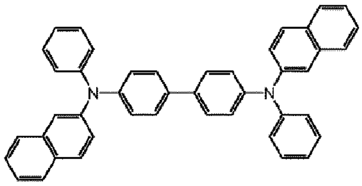

**β-NPB**

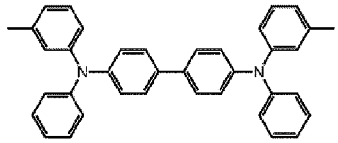

**TPD**

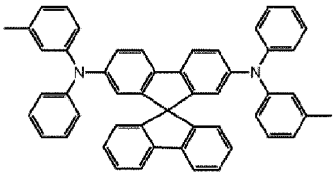

**Spiro-TPD**

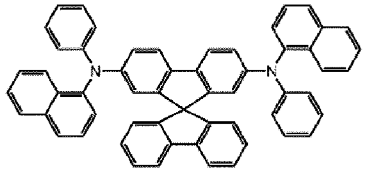

**Spiro-NPB**

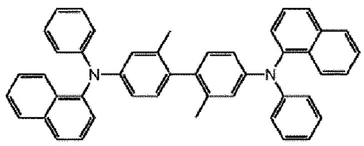

**methylated NPB**

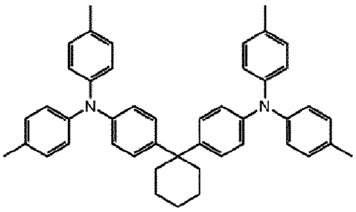

**TAPC**

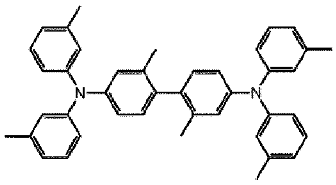

**HMTPD**

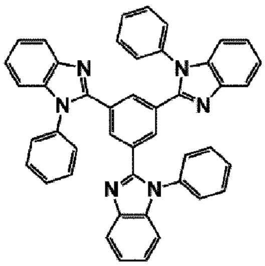

**TPBi**

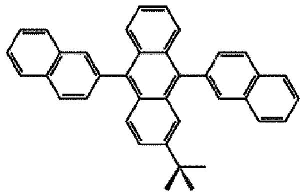

**TBADN**

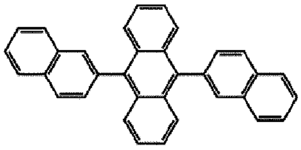

**ADN**

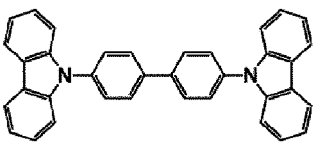

**CBP**

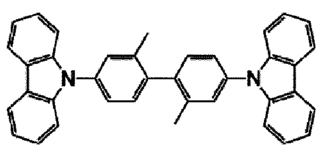

**CDBP**

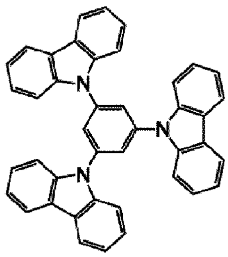

**TCP**

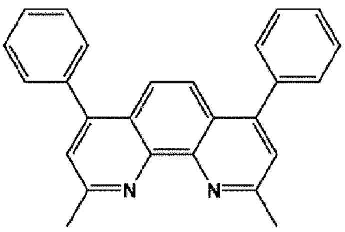

**BCP**

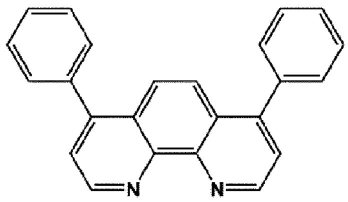

**Bphen**

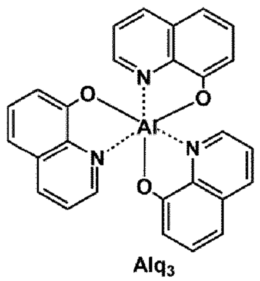

$Alq_3$

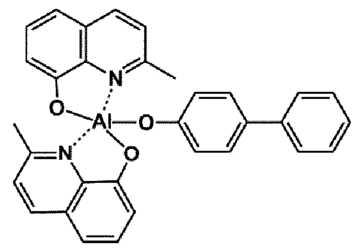

BAlq

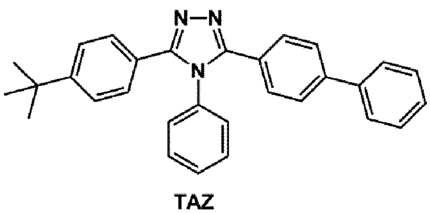

TAZ

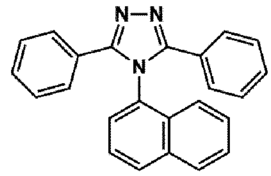

NTAZ

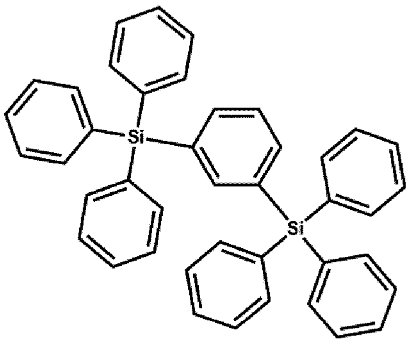

m-bis-(triphenylsilyl)benzene

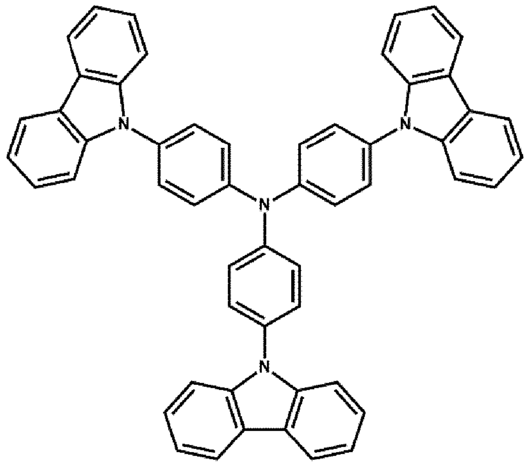

TCTA(4,4',4"-tris(carbazol-9-yl)triphenylamine)

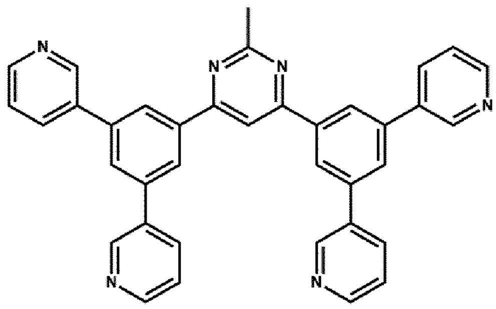

B3PYMPM(4,6-bis(3,5-di(pyridine-3-yl)phenyl)-2-methylpyrimidine)

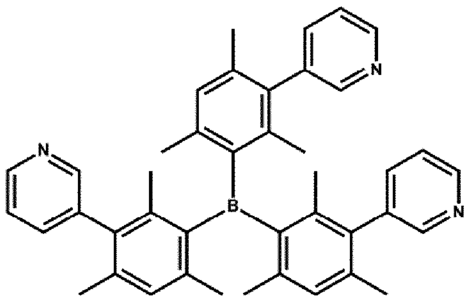

3TPYMB(tris(2,4,6-trimethyl-3-(pyridine-3-yl)phenyl)borane)

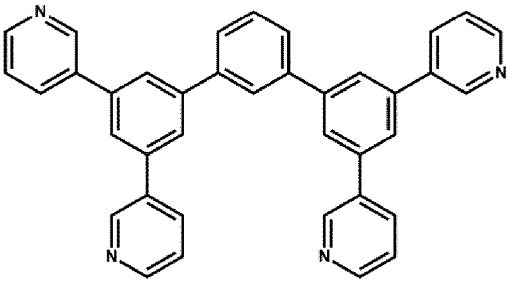

BmPyPhB(1,3-bis[3,5-di(pyridine-3-yl)phenyl]benzene)

Description of FIG. 11

FIG. 11 is a diagram schematically illustrating one or more embodiments of a light-emitting device 101 including the mixed layer 15. The light-emitting device 101 in FIG. 11 includes a first electrode 110, a second electrode 190 facing the first electrode 110, and an interlayer (not shown) arranged between the first electrode 110 and the second electrode 190, wherein the interlayer includes an emission layer 150 arranged between the first electrode 110 and the second electrode 190, a hole transport region 120 arranged between the first electrode 110 and the emission layer 150, and an electron transport region 170 arranged between the emission layer 150 and the second electrode 190. The emission layer 150 may be the mixed layer 15 as described herein.

A substrate may be additionally arranged under the first electrode 110 or above the second electrode 190. For use as the substrate, any substrate that is used in light-emitting devices of the related art may be used, and the substrate may be a glass substrate or a transparent plastic substrate, each having excellent mechanical strength, thermal stability, transparency, surface smoothness, ease of handling, and water resistance.

The first electrode 110 may be formed by providing, on the substrate, a material for forming the first electrode 110, by using a deposition or sputtering method. The first electrode 110 may be an anode. The material for forming the first electrode 110 may include materials with a high work function to facilitate hole injection. The first electrode 110 may be a reflective electrode. The material for forming the first electrode 110 may be indium tin oxide (ITO), indium zinc oxide (IZO), tin oxide ($SnO_2$), or zinc oxide (ZnO). In one or more embodiments, the material for forming the first electrode 110 may be metal, such as magnesium (Mg), aluminum (Al), silver (Ag), aluminum-lithium (Al-Li), calcium (Ca), magnesium-indium (Mg-In), or magnesium-silver (Mg-Ag).

The first electrode 110 may have a single-layered structure or a multi-layered structure including two or more layers. For example, the first electrode 110 may have a three-layered structure of ITO/Ag/ITO.

The hole transport region 120 may be arranged between the first electrode 110 and the emission layer 150.

The hole transport region 120 may include a hole injection layer, a hole transport layer, an electron blocking layer, a buffer layer, or a combination thereof.

The hole transport region 120 may include only a hole injection layer or only a hole transport layer. In one or more embodiments, the hole transport region 120 may have a hole injection layer/hole transport layer structure or a hole injection layer/hole transport layer/electron blocking layer structure, which are sequentially stacked in this stated order from the first electrode 110.

When the hole transport region 120 includes a hole injection layer, the hole injection layer may be formed on the first electrode 110 by using one or more suitable methods, for example, a vacuum deposition method, a spin coating method, a casting method, a Langmuir-Blodgett (LB) method, and/or an ink-jet printing method.

When a hole injection layer is formed by vacuum deposition, the deposition conditions may vary depending on a material that is used to form the hole injection layer, and the structure and thermal characteristics of the hole injection layer. For example, the deposition conditions may include a deposition temperature of about 100°C to about 500°C, a vacuum pressure of about $10^{-8}$ torr to about $10^{-3}$ torr, and a deposition rate of about 0.01 angstroms per second (Å/sec) to about 100 Å/sec.

When the hole injection layer is formed by spin coating, the coating conditions may vary depending on a material for forming the hole injection layer, and the structure and thermal characteristics of the hole injection layer. For example, the coating conditions may include a coating speed in a range of about 2,000 revolutions per minute (rpm) to about 5,000 rpm and a heat treatment temperature in a range of about 80°C to about 200°C for removing a solvent after coating.

The conditions for forming the hole transport layer and the electron blocking layer may be as the conditions for forming the hole injection layer.

The hole transport region 120 may include, for example, 4,4',4"-tris(3-methylphenylphenylamino)triphenylamine (m-MTDATA), 4,4',4"-tris(N,N-diphenylamino)triphenylamine (TDATA), 4,4',4"-tris{N-(2-naphthyl)-N-phenylamino}-triphenylamine (2-TNATA), N,N'-di(1-naphthyl)-N,N'-diphenylbenzidine (NPB), β-NPB, N,N'-bis(3-methylphenyl)-N,N'-diphenyl-[1,1-biphenyl]-4,4'-diamine (TPD), spiro-TPD, spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, a compound represented by Formula 202, or a combination thereof:

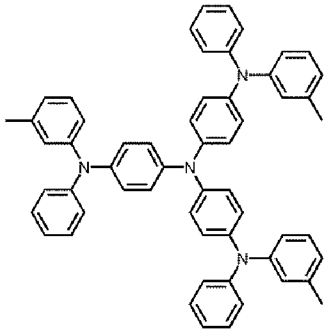

m-MTDATA

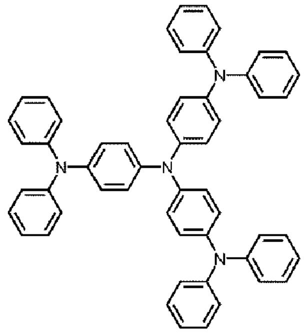

TDATA

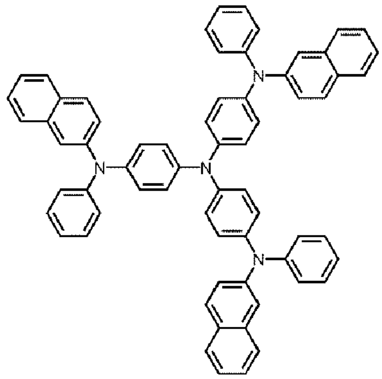

2-TNATA

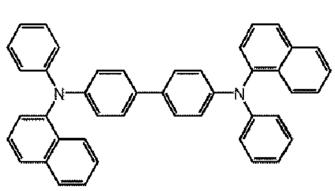

NPB

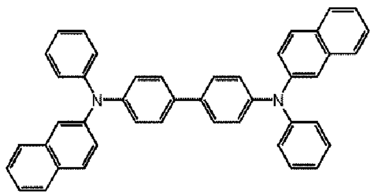

β-NPB

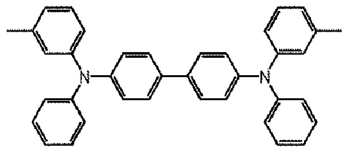

TPD

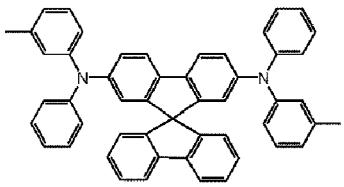

Spiro-TPD

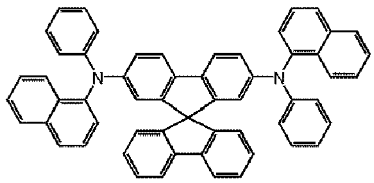

Spiro-NPB

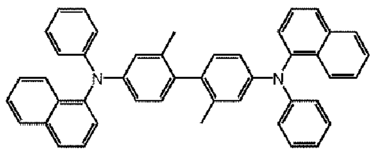

methylated NPB

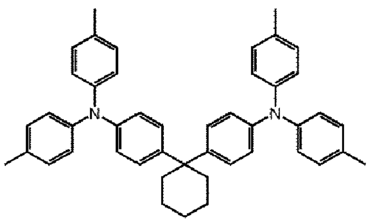

TAPC

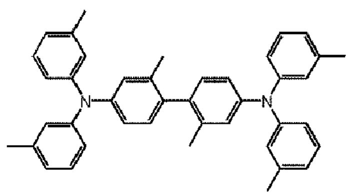

HMTPD

Formula 201

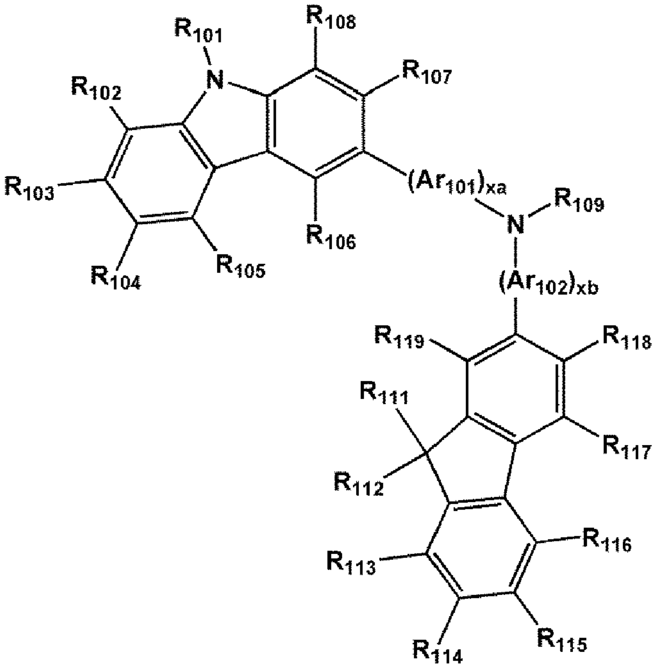

Formula 202

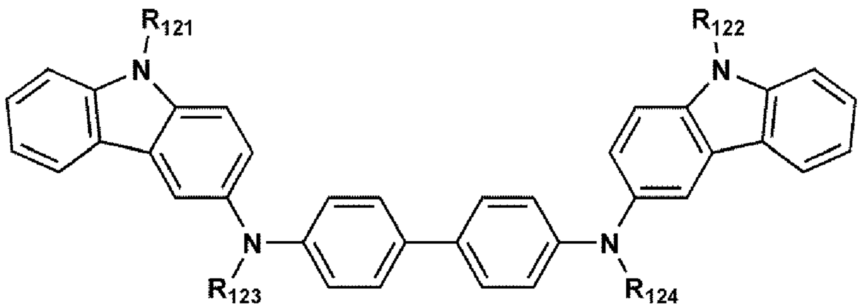

$Ar_{101}$ and $Ar_{102}$ in Formula 201 may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with deuterium, -F, -Cl, -Br, -I, $-SF_5$, a hydroxyl group, a cyano group, a nitro group, an amino group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, or a combination thereof.

xa and xb in Formula 201 may each independently be an integer from 0 to 5, or may each independently be 0, 1, or 2. For example, xa may be 1 and xb may be 0.

$R_{101}$ to $R_{108}$, $R_{111}$ to $R_{119}$, and $R_{121}$ to $R_{124}$ in Formulae 201 and 202 may each independently be:

hydrogen, deuterium, -F, -Cl, -Br, -I, $-SF_5$, a hydroxyl group, a cyano group, a nitro group, an amino group, a $C_1$-$C_{10}$ alkyl group (for example, a methyl group, an ethyl group, a propyl group, a butyl group, a pentyl group, a hexyl group, or the like), a $C_1$-$C_{10}$ alkoxy group (for example, a methoxy group, an ethoxy group, a propoxy group, a

butoxy group, a pentoxy group, or the like), or a $C_1$-$C_{10}$ alkylthio group;

a $C_1$-$C_{10}$ alkyl group, a $C_1$-$C_{10}$ alkoxy group, or a $C_1$-$C_{10}$ alkylthio group, each unsubstituted or substituted with at least one of deuterium, -F, -Cl, -Br, -I, - $SF_6$, a hydroxyl group, a cyano group, a nitro group, an amino group, or a combination thereof; or

a phenyl group, a naphthyl group, an anthracenyl group, a fluorenyl group, or a pyrenyl group, each unsubstituted or substituted with at least one of deuterium, -F, -Cl, -Br, -I, -$SF_5$, a hydroxyl group, a cyano group, a nitro group, an amino group, a $C_1$-$C_{10}$ alkyl group, a $C_1$-$C_{10}$ alkoxy group, a $C_1$-$C_{10}$ alkylthio group, or a combination thereof.

$R_{109}$ in Formula 201 may be a phenyl group, a naphthyl group, an anthracenyl group, or a pyridinyl group, each unsubstituted or substituted with deuterium, -F, -Cl, -Br, -I, -$SF_5$, a hydroxyl group, a cyano group, a nitro group, an amino group, a $C_1$-$C_{20}$ alkyl group, a $C_1$-$C_{20}$ alkoxy group, a $C_1$-$C_{20}$ alkylthio group, a phenyl group, a naphthyl group, an anthracenyl group, a pyridinyl group, or a combination thereof.

In one or more embodiments, the compound represented by Formula 201 may be represented by Formula 201A:

Formula 201A

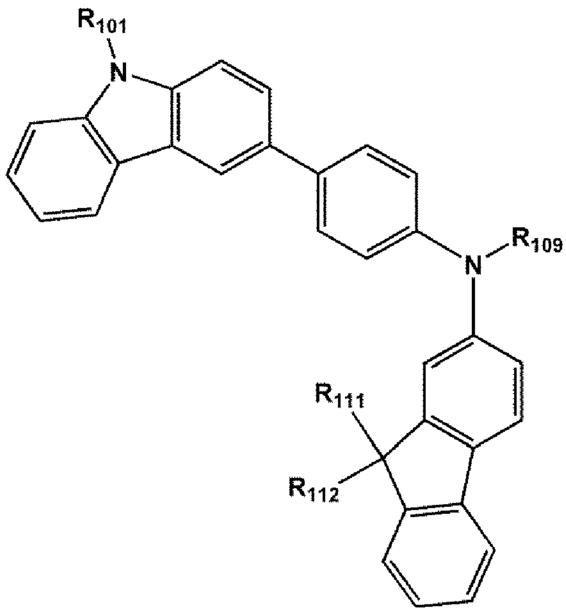

wherein, in Formula 201A, $R_{101}$, $R_{111}$, $R_{112}$, and $R_{109}$ are respectively as those described herein.

For example, the hole transport region 120 may include one of Compounds HT1 to HT20 or a combination thereof:

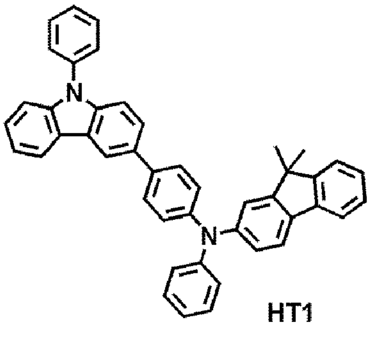

HT1

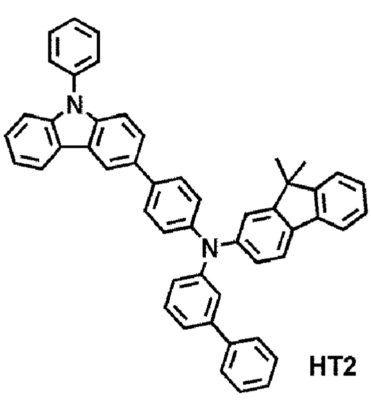

HT2

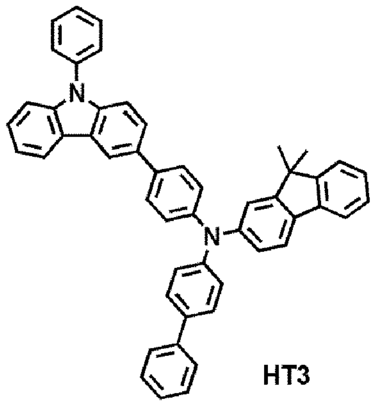

HT3

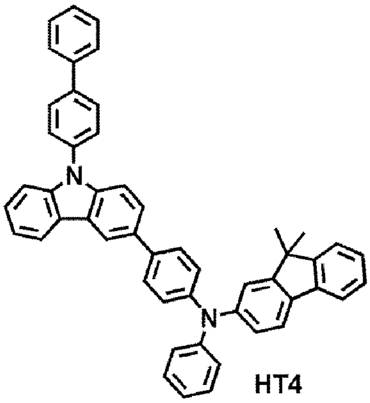

HT4

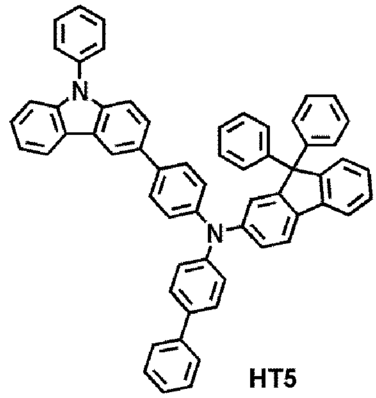

HT5

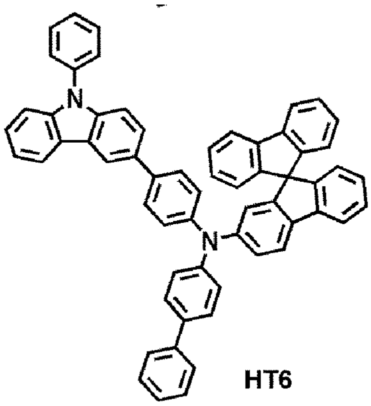

HT6

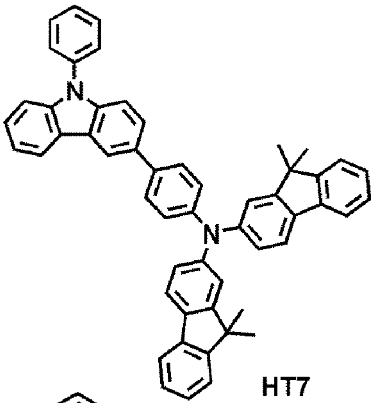

HT7

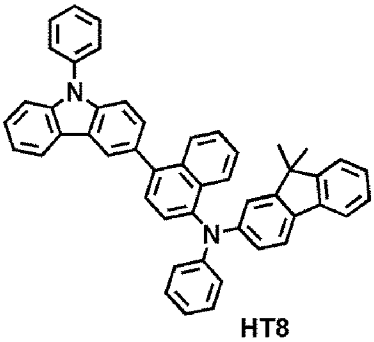

HT8

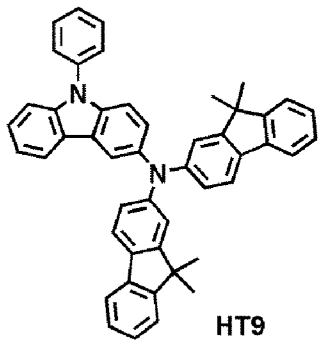

HT9

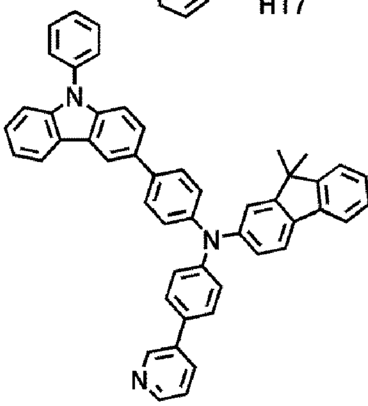

HT10

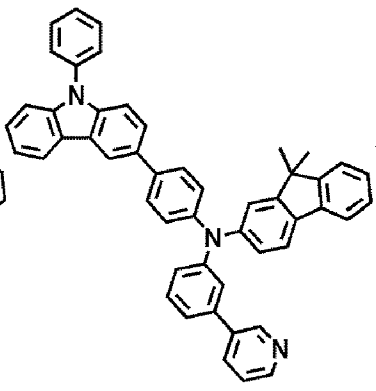

HT11

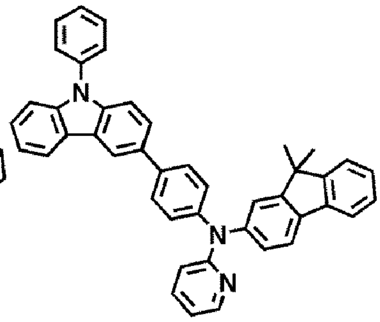

HT12

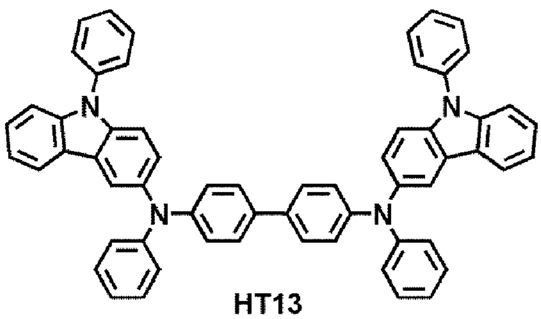

HT13

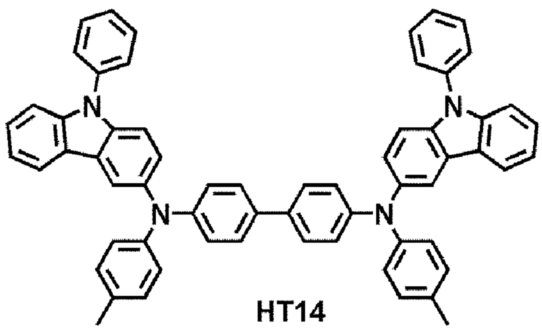

HT14

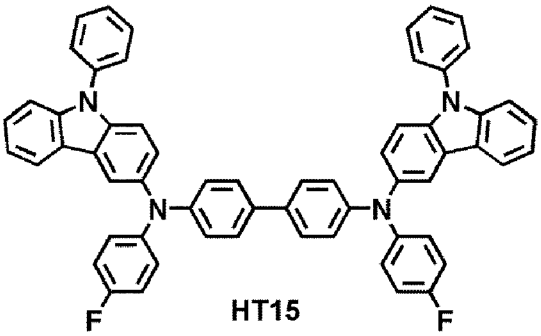
HT15

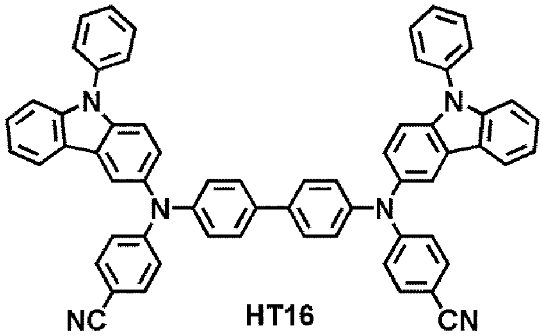
HT16

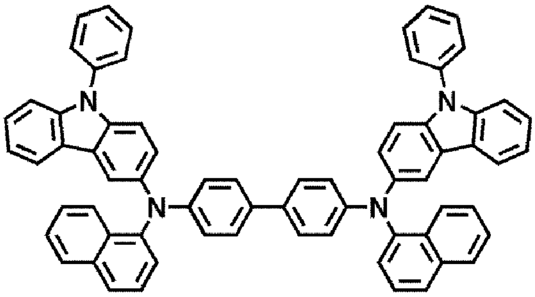
HT17

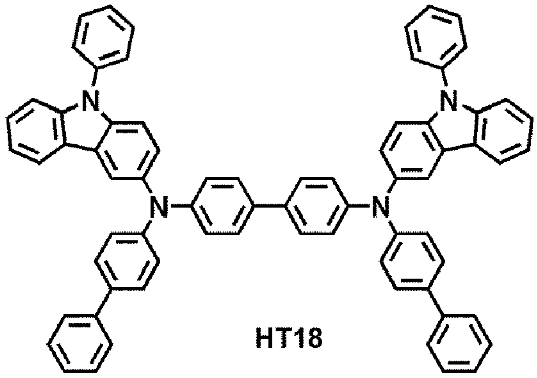
HT18

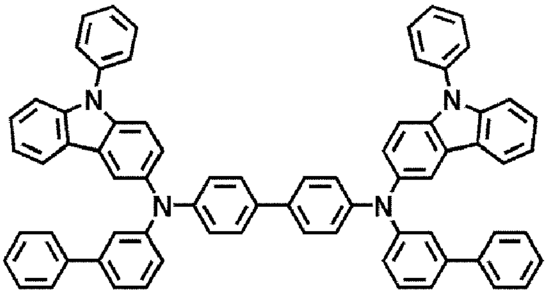
HT19

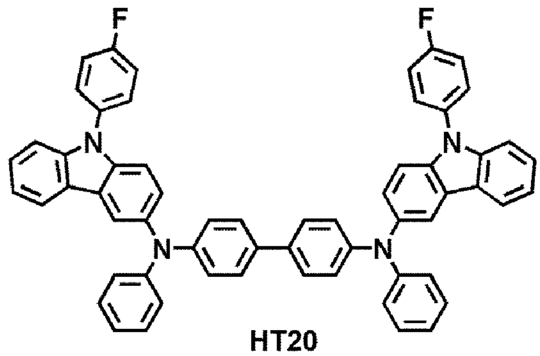
HT20

A thickness of the hole transport region 120 may be in a range of about 100 angstroms (Å) to about 10,000 Å, for example, about 100 Å to about 1,000 Å. When the hole transport region 120 includes a hole injection layer, a hole transport layer, an electron blocking layer, or a combination thereof, a thickness of the hole injection layer may be in a range of about 100 Å to about 10,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region 120, the hole injection layer, and the hole transport layer are within these ranges, satisfactory hole transporting characteristics may be obtained without a substantial increase in driving voltage.

In addition to the above-described materials, the hole transport region 120 may further include a charge-generation material to improve conductivity. The charge-generation material may be homogeneously or non-homogeneously dispersed in the hole transport region 120.

The charge-generation material may be, for example, a p-dopant. The p-dopant may be a quinone derivative, a metal oxide, a cyano group-containing compound, or a combination thereof. For example, the p-dopant may be a quinone derivative such as tetracyanoquinodimethane (TCNQ), 2,3,5,6-tetrafluoro-tetracyano-1,4-benzoquinonedimethane (F4-TCNQ), or F6-TCNNQ; metal oxide, such as tungsten oxide or molybdenum oxide; a cyano group-containing compound, such as Compound HT-D1; or a combination thereof:

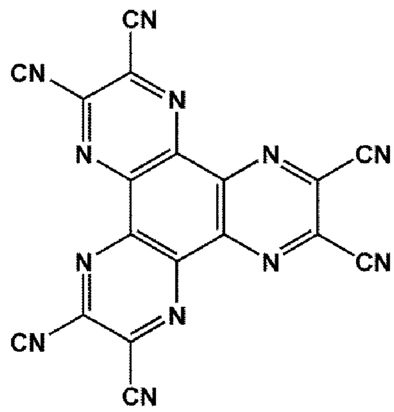

HT-D1

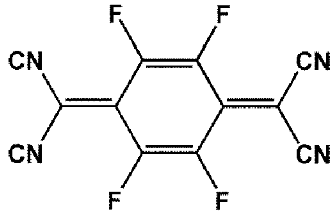

F4-TCNQ

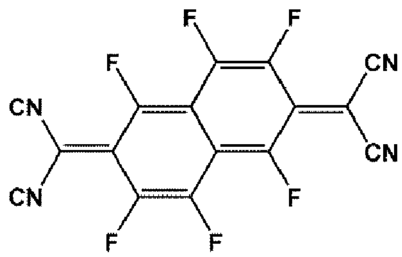

F6-TCNNQ

The hole transport region 120 may further include a buffer layer.

The buffer layer may compensate for an optical resonance distance according to a wavelength of light emitted from the emission layer to increase efficiency.

Meanwhile, when the hole transport region 120 includes an electron blocking layer, the material for the electron blocking layer may include a material that may be used in the hole transport region 120 as described above, a host material, or a combination thereof. For example, when the hole transport region 120 includes an electron blocking layer, the material for the electron blocking layer may be mCP or the like.

The emission layer 150 may be formed on the hole transport region 120 by using, for example, a vacuum deposition method, a spin coating method, a cast method, an LB method, and/or an ink-jet printing method.

The emission layer 150 may be as described in connection with the mixed layer 15.

A thickness of the emission layer 150 may be in a range of about 100 Å to about 1,000 Å, for example, about 200 Å to about 600 Å. When the thickness of the emission layer 150 is within these ranges, excellent light-emission characteristics may be obtained without a substantial increase in driving voltage.

When the light-emitting device is a full-color light-emitting device, the emission layer 150 may be patterned into a red emission layer, a green emission layer, and/or a blue emission layer.

Next, the electron transport region 170 may be arranged on the emission layer 150.

The electron transport region 170 may include a hole blocking layer, an electron transport layer, an electron injection layer, or a combination thereof.

For example, the electron transport region 170 may have a hole blocking layer/electron transport layer/electron injection layer structure or an electron transport layer/electron injection layer structure. The electron transport layer may have a single-layered structure or a multi-layered structure including two or more different materials.

The conditions for the forming the hole blocking layer, the electron transport layer, and the electron injection layer in the electron transport region 170 are as the conditions for the forming the hole injection layer.

When the electron transport region 170 includes a hole blocking layer, the hole blocking layer may include, for example, 2,9-dimethyl-4,7-diphenyl-1,10-phenanthroline (BCP), 4,7-diphenyl-1,10-phenanthroline (Bphen),bis(2-methyl-8-quinolinolato-N1,O8)-(1,1'-biphenyl-4-olato)aluminum (BAlq), or a combination thereof:

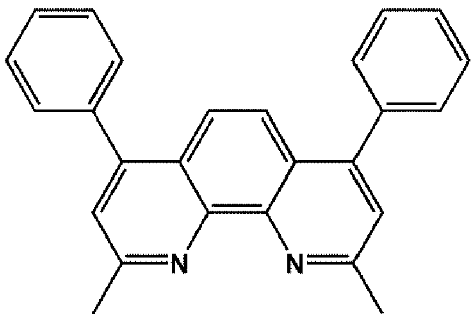

BCP

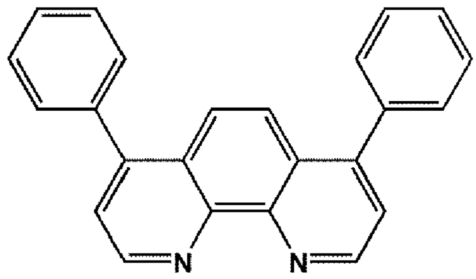

Bphen

In one or more embodiments, the hole blocking layer may include any host material, and a material for an electron transport layer, a material for an electron injection layer, or a combination thereof, which will be described later.

A thickness of the hole blocking layer may be in a range of about 20 Å to about 1,000 Å, for example, about 30 Å to about 600 Å. When the thickness of the hole block layer is within these ranges, excellent hole blocking characteristics may be obtained without a substantial increase in driving voltage.

The electron transport layer may include BCP, Bphen, 1,3,5-tri(1-phenyl-1H-benzo[d]imidazol-2-yl)phenyl (TPBi), tris(8-hydroxy-quinolinato)aluminum ($Alq_3$), bis(2-methyl-8-quinolinolato-N1,O8)-(1,1'-biphenyl-4-olato)aluminum (BAlq), 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), or a combination thereof:

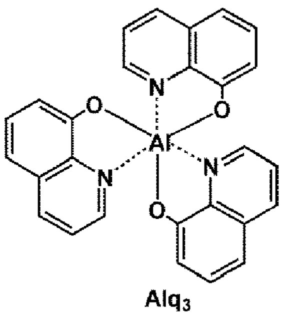

$Alq_3$

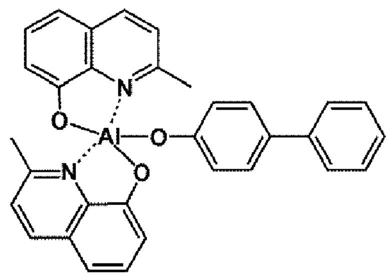

BAlq

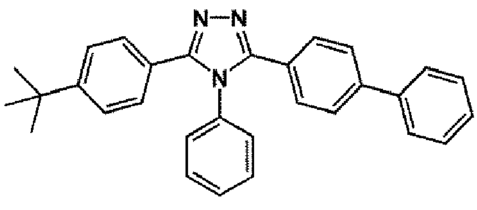

TAZ

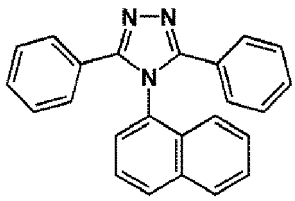

NTAZ

In one or more embodiments, the electron transport layer may include one of Compounds ET1 to ET25 or a combination thereof:

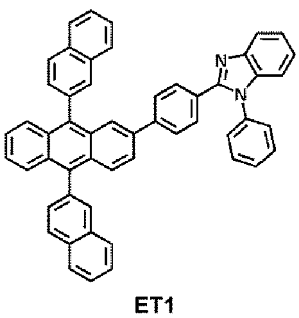

ET1

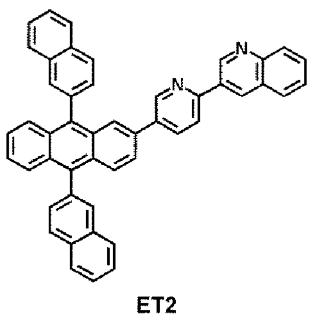

ET2

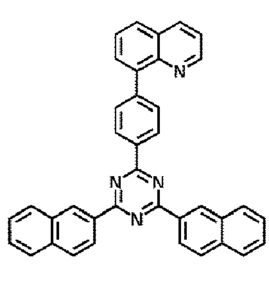

ET3

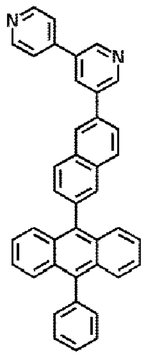

ET4

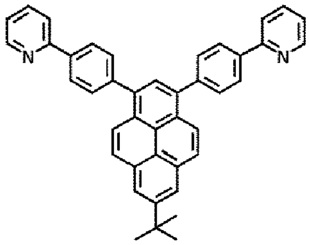

ET5

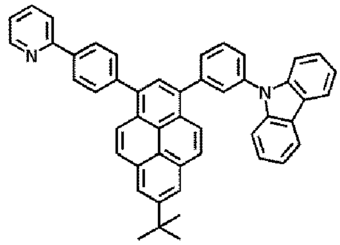

ET6

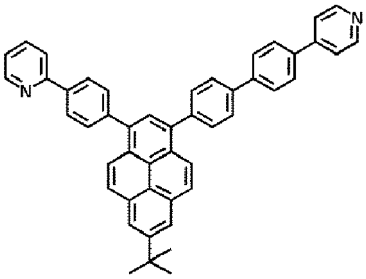

ET7

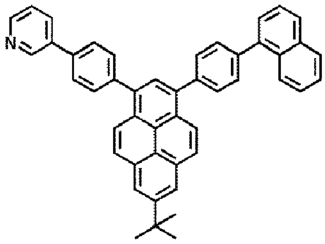

ET8

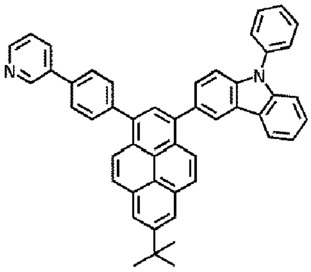

ET9

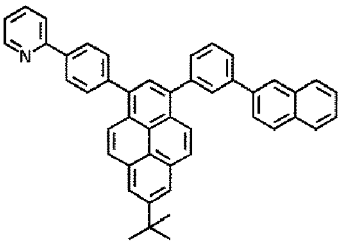

ET10

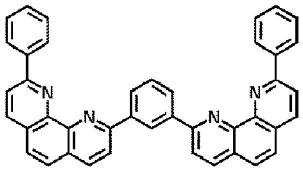

ET11

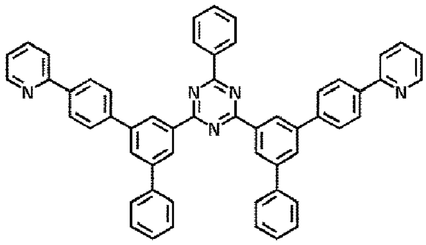

ET12

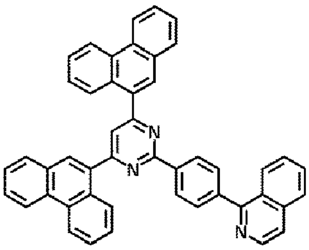

ET13

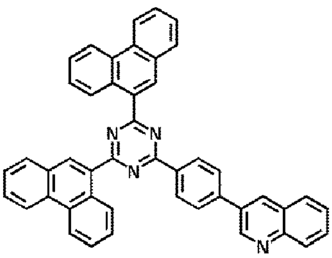

ET14

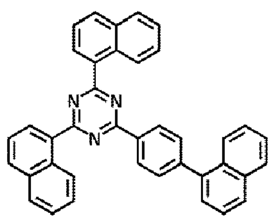

ET15

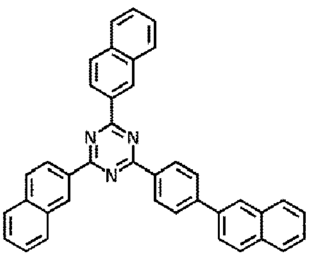

ET16

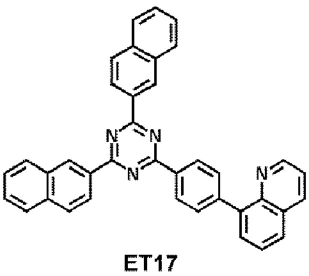

ET17

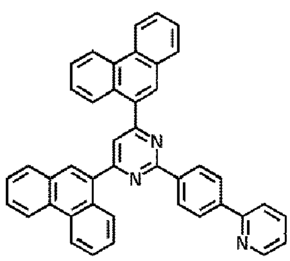

ET18

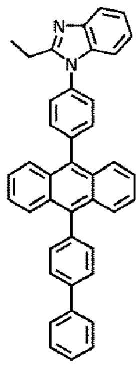
ET19

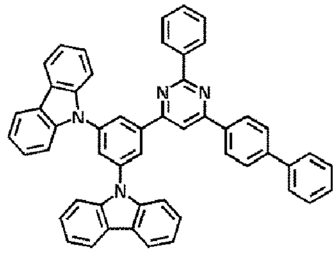
ET20

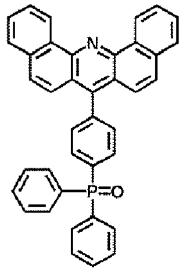
ET21

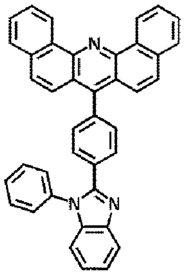
ET22

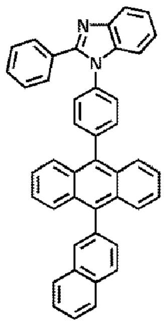
ET23

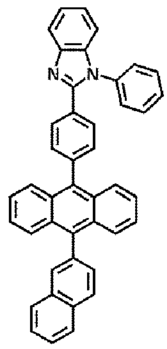
ET24

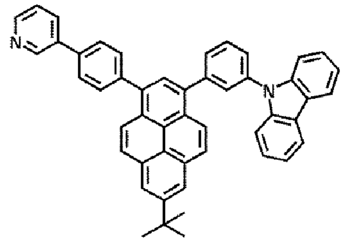
ET25

A thickness of the electron transport layer may be in a range of about 100 Å to about 1,000 Å, for example, about 150 Å to about 500 Å. When the thickness of the electron transport layer is within these ranges, satisfactory electron transporting characteristics may be obtained without a substantial increase in driving voltage.

The electron transport layer may include, in addition to the materials described above, a metal-containing material.

The metal-containing material may include a Li complex. The Li complex may include, for example, Compound ET-D1 or ET-D2:

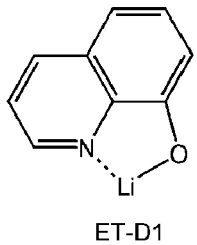
ET-D1

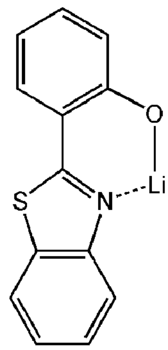
ET-D2

In one or more embodiments, the electron transport region 170 may include an electron injection layer that facilitates injection of electrons from the second electrode 190.

The electron injection layer may include LiF, NaCl, CsF, $Li_2O$, BaO, Yb, Compound ET-D1, Compound ET-D2, or a combination thereof.

A thickness of the electron injection layer may be in a range of about 1 Å to about 100 Å, for example, about 3 Å to about 90 Å. When the thickness of the electron injection layer is within these ranges, satisfactory electron injection characteristics may be obtained without a substantial increase in driving voltage.

The second electrode 190 may be arranged on the electron transport region 170. The second electrode 190

may be a cathode. A material for forming the second electrode 190 may be metal, an alloy, an electrically conductive compound, or a combination thereof, which have a relatively low work function. For example, lithium (Li), magnesium (Mg), aluminum (Al), silver (Ag), aluminum-lithium (Al-Li), calcium (Ca), magnesium-indium (Mg-In), magnesium-silver (Mg-Ag), or the like may be used as the material for forming the second electrode 190. In one or more embodiments, to manufacture a top-emission type light-emitting device, a transparent or semi-transparent electrode formed using ITO or IZO may be used as the second electrode 190.

Description of FIG. 12

FIG. 12 is a diagram schematically illustrating a cross-section of a light-emitting device 100 according to one or more embodiments.

The light-emitting device 100 in FIG. 12 includes a first electrode 110, a second electrode 190 facing the first electrode 110, and a first light-emitting unit 151 and a second light-emitting unit 152 stacked between the first electrode 110 and the second electrode 190. A charge generation layer 141 is arranged between the first light-emitting unit 151 and the second light-emitting unit 152. The charge generation layer 141 may include an n-type charge generation layer, a p-type charge generation layer, or a combination thereof. The charge generation layer 141 is a layer that generates charge and supplies the charge to neighboring light-emitting units, and any known material may be used therefor.

The first light-emitting unit 151 may include a first emission layer 151-EM, and the second light-emitting unit 152 may include a second emission layer 152-EM. At least one of the first emission layer 151-EM and the second emission layer 152-EM may be the mixed layer 15 described herein.

A hole transport region 120 is arranged between the first light-emitting unit 151 and the first electrode 110, and the second light-emitting unit 152 includes a second hole transport region 122 arranged on the side of the first electrode 110.

An electron transport region 170 is arranged between the second light-emitting unit 152 and the second electrode 190, and the first light-emitting unit 151 includes a first electron transport region 171 arranged between the charge generation layer 141 and the first emission layer 151-EM.

The first electrode 110 and the second electrode 190 in FIG. 12 may be as described in connection with the first electrode 110 and the second electrode 190 in FIG. 1.

The hole transport region 120 and the second hole transport region 122 in FIG. 12 may each be as described in connection with the hole transport region 120 in FIG. 11.

The electron transport region 170 and the first electron transport region 171 in FIG. 12 may each be as described in connection with the electron transport region 170 in FIG. 11.

Hereinbefore, one or more embodiments of a tandem light-emitting device has been described with reference to FIG. 12, but the tandem light-emitting device may have various modifications. For example, the tandem light-emitting device may include three or more light-emitting units.

Explanation of terms

The term "$C_1$-$C_{60}$ alkyl group" as used herein refers to a linear or branched saturated aliphatic hydrocarbons monovalent group having 1 to 60 carbon atoms, and the term "$C_1$-$C_{60}$ alkylene group" as used here refers to a divalent group having the same structure as the $C_1$-$C_{60}$ alkyl group.

Examples of the $C_1$-$C_{60}$ alkyl group, the $C_1$-$C_{20}$ alkyl group, and/or the $C_1$-$C_{10}$ alkyl group may include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or a combination thereof. For example, Formula 9-33 is a branched $C_6$ alkyl group, for example, a tert-butyl group that is substituted with two methyl groups.

The term "$C_1$-$C_{60}$ alkoxy group" as used herein refers to a monovalent group represented by $-OA_{101}$ (wherein $A_{101}$ is the $C_1$-$C_{60}$ alkyl group), and examples thereof include a methoxy group, an ethoxy group, a propoxy group, a butoxy group, and a pentoxy group.

The term "$C_1$-$C_{60}$ alkylthio group" as used herein refers to a monovalent group having the formula of -$SA_{101}$ (wherein $A_{101}$ is the $C_1$-$C_{60}$ alkyl group).

The term "$C_2$-$C_{60}$ alkenyl group" as used herein refers to a hydrocarbon group formed by substituting at least one carbon-carbon double bond in the middle or at the terminus of the $C_2$-$C_{60}$ alkyl group, and examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a hydrocarbon group formed by substituting at least one carbon-carbon triple bond in the middle or at the terminus of the $C_2$-$C_{60}$ alkyl group, and examples thereof include an ethynyl group, and a propynyl group. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent saturated hydrocarbon cyclic group having 3 to 10 carbon atoms, and the term "$C_3$-$C_{10}$ cycloalkylene group" as used herein refers to a divalent group having the same structure as the $C_3$-$C_{10}$ cycloalkyl group.

Examples of the $C_3$-$C_{10}$ cycloalkyl group may include a cyclopropyl group, a cyclobutyl group, a cyclopentyl, cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1.1]hexyl group, and a bicyclo[2.2.2]octyl group.

The term "$C_1$-$C_{10}$ heterocycloalkyl group" as used herein refers to a monovalent saturated cyclic group that includes at least one heteroatom selected from N, O, P, Si, S, Se, Ge, and B as a ring-forming atom and 1 to 10 carbon atoms, and the term "$C_1$-$C_{10}$ heterocycloalkylene group" as used herein refers to a divalent group having the same structure as the $C_1$-$C_{10}$ heterocycloalkyl group.

Examples of the $C_1$-$C_{10}$ heterocycloalkyl group may include a silolanyl group, a silinanyl group, tetrahydrofuranyl group, a tetrahydro-2H-pyranyl group, and a tetrahydrothiophenyl group.

The term "$C_3$-$C_{10}$ cycloalkenyl group" as used herein refers to a monovalent monocyclic group that has 3 to 10 carbon atoms and at least one double bond in the ring thereof and no aromaticity, and examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent monocyclic group that has at least one heteroatom selected from N, O, P, Si, S, Se, Ge, and B as a ring-forming atom, 1 to 10 carbon atoms, and at least one carbon-carbon double bond in its ring. Examples of the $C_1$-$C_{10}$ heterocycloalkenyl group include a 2,3-dihydrofuranyl group and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms, and the term "$C_6$-$C_{60}$ arylene group" as used herein refers to a divalent group having a carbocyclic aromatic system having 6 to 60 carbon atoms. Examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the two or more rings may be fused to each other.

The term "$C_7$-$C_{60}$ alkyl aryl group" as used herein refers to a $C_6$-$C_{60}$ aryl group substituted with at least one $C_1$-$C_{60}$ alkyl group.

The term "$C_7$-$C_{60}$ aryl alkyl group" as used herein refers to a $C_1$-$C_{60}$ alkyl group substituted with at least one $C_6$-$C_{60}$ aryl group.

The term "$C_1$-$C_{60}$ heteroaryl group" as used herein refers to a monovalent group that includes at least one heteroatom selected from N, O, P, Si, S, Se, Ge, and B as a ring-forming atom and a cyclic aromatic system having 1 to 60 carbon atoms, and the term "$C_1$-$C_{60}$ heteroarylene group" as used herein refers to a divalent group that includes at least one heteroatom selected from N, O, P, Si, S, Se, Ge, and B as a ring-forming atom and a carbocyclic aromatic system having 1 to 60 carbon atoms. Examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_6$-$C_{60}$ heteroaryl group and the $C_6$-$C_{60}$ heteroarylene group each include two or more rings, the two or more rings may be fused to each other.

The term "$C_2$-$C_{60}$ alkyl heteroaryl group" as used herein refers to a $C_1$-$C_{60}$ heteroaryl group substituted with at least one $C_1$-$C_{60}$ alkyl group.

The term "$C_2$-$C_{60}$ heteroaryl alkyl group" as used herein refers to a $C_1$-$C_{60}$ alkyl group substituted with at least one $C_1$-$C_{60}$ heteroaryl group.

The term "$C_6$-$C_{60}$ aryloxy group" as used herein indicates -$OA_{102}$ (wherein $A_{102}$ is the $C_6$-$C_{60}$ aryl group), and the term "$C_6$-$C_{60}$ arylthio group" as used herein indicates - $SA_{103}$ (wherein $A_{103}$ is the $C_6$-$C_{60}$ aryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic

condensed polycyclic group include a fluorenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 1 to 60 carbon atoms) having two or more rings condensed to each other, at least one heteroatom selected from N, O, P, Si, S, Se, Ge, and B, other than carbon atoms, as a ring-forming atom, and no aromaticity in its entire molecular structure. Examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "$C_5$-$C_{30}$ carbocyclic group" as used herein refers to a saturated or unsaturated cyclic group including 5 to 30 carbon atoms only as ring-forming atoms. The $C_5$-$C_{30}$ carbocyclic group may be a monocyclic group or a polycyclic group. Examples of the "$C_5$-$C_{30}$ carbocyclic group (unsubstituted or substituted with at least one $R_{10a}$)" as used herein may include an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, and a fluorene group (each unsubstituted or substituted with at least one $R_{10a}$).

The term "$C_1$-$C_{30}$ heterocyclic group" as used herein refers to a saturated or unsaturated cyclic group having, as a ring-forming atom, at least one heteroatom selected from N, O, P, Si, S, Se, Ge, and B other than 1 to 30 carbon atoms. The $C_1$-$C_{30}$ heterocyclic group may be a monocyclic group or a polycyclic group. Examples of the "$C_1$-$C_{30}$ heterocyclic group (unsubstituted or substituted with at least one $R_{10a}$)" as used herein may include a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, and a 5,6,7,8-tetrahydroquinoline group (each unsubstituted or substituted with at least one $R_{10a}$).

In one or more embodiments, examples of the "$C_5$-$C_{30}$ carbocyclic group" and "$C_1$-$C_{30}$ heterocyclic group" as used herein include i) a first ring, ii) a second ring, iii) a condensed ring in which two or more first rings are condensed with each other, iv) a condensed ring in which two or more second rings are condensed with each other, or v) a condensed ring in which at least one first ring and at least one second ring are condensed with each other,

the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and

the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

The terms "fluorinated $C_1$-$C_{60}$ alkyl group (or, a fluorinated $C_1$-$C_{20}$ alkyl group or the like)", "fluorinated $C_3$-$C_{10}$ cycloalkyl group", "fluorinated $C_1$-$C_{10}$ heterocycloalkyl group," and "fluorinated phenyl group" as used herein respectively refer to a $C_1$-$C_{60}$ alkyl group (or, a $C_1$-$C_{20}$ alkyl group or the like), a $C_3$-$C_{10}$ cycloalkyl group, a $C_1$-$C_{10}$ heterocycloalkyl group, and a phenyl group, each substituted with at least one fluoro group. For example, the term "fluorinated $C_1$ alkyl group (that is, a fluorinated methyl group)" includes $-CF_3$, $-CF_2H$, and $-CFH_2$. The "fluorinated $C_1$-$C_{60}$ alkyl group (or, a fluorinated $C_1$-$C_{20}$ alkyl group or the like)", "the fluorinated $C_3$-$C_{10}$ cycloalkyl group", "the fluorinated $C_1$-$C_{10}$ heterocycloalkyl group", or "the fluorinated a phenyl group" may be i) a fully fluorinated $C_1$-$C_{60}$ alkyl group (or, a fully fluorinated $C_1$-$C_{20}$ alkyl group or the like), a fully fluorinated $C_3$-$C_{10}$ cycloalkyl group, a fully fluorinated $C_1$-$C_{10}$ heterocycloalkyl

group, or a fully fluorinated phenyl group, wherein, in each group, all hydrogen included therein is substituted with a fluoro group, or ii) a partially fluorinated $C_1$-$C_{60}$ alkyl group (or, a partially fluorinated $C_1$-$C_{20}$ alkyl group or the like), a partially fluorinated $C_3$-$C_{10}$ cycloalkyl group, a partially fluorinated $C_1$-$C_{10}$ heterocycloalkyl group, or a partially fluorinated phenyl group, wherein, in each group, not all hydrogen included therein is substituted with a fluoro group.

The terms "deuterated $C_1$-$C_{60}$ alkyl group (or, a deuterated $C_1$-$C_{20}$ alkyl group or the like)", "deuterated $C_3$-$C_{10}$ cycloalkyl group", "deuterated $C_1$-$C_{10}$ heterocycloalkyl group," and "deuterated phenyl group" as used herein respectively refer to a $C_1$-$C_{60}$ alkyl group (or, a $C_1$-$C_{20}$ alkyl group or the like), a $C_3$-$C_{10}$ cycloalkyl group, a $C_1$-$C_{10}$ heterocycloalkyl group, and a phenyl group, each substituted with at least one deuterium. For example, the "deuterated $C_1$ alkyl group (that is, a deuterated methyl group)" may include $-CD_3$, $-CD_2H$, and $-CDH_2$, and examples of the "deuterated $C_3$-$C_{10}$ cycloalkyl group" are, for example, Formula 10-501 and the like. The "deuterated $C_1$-$C_{60}$ alkyl group (or, the deuterated $C_1$-$C_{20}$ alkyl group or the like)", "the deuterated $C_3$-$C_{10}$ cycloalkyl group", "the deuterated $C_1$-$C_{10}$ heterocycloalkyl group", or "the deuterated phenyl group" may be i) a fully deuterated $C_1$-$C_{60}$ alkyl group (or, a fully deuterated $C_1$-$C_{20}$ alkyl group or the like), a fully deuterated $C_3$-$C_{10}$ cycloalkyl group, a fully deuterated $C_1$-$C_{10}$ heterocycloalkyl group, or a fully deuterated phenyl group, in which, in each group, all hydrogen included therein are substituted with deuterium, or ii) a partially deuterated $C_1$-$C_{60}$ alkyl group (or, a partially deuterated $C_1$-$C_{20}$ alkyl group or the like), a partially deuterated $C_3$-$C_{10}$ cycloalkyl group, a partially deuterated $C_1$-$C_{10}$ heterocycloalkyl group, or a partially deuterated phenyl group, in which, in each group, not all hydrogen included therein are substituted with deuterium.

The term "($C_1$-$C_{20}$ alkyl) 'X' group" as used herein refers to a 'X' group that is substituted with at least one $C_1$-$C_{20}$ alkyl group. For example, the term "($C_1$-$C_{20}$ alkyl)$C_3$-$C_{10}$ cycloalkyl group" as used herein refers to a $C_3$-$C_{10}$ cycloalkyl group substituted with at least one $C_1$-$C_{20}$ alkyl group, and the term "($C_1$-$C_{20}$ alkyl)phenyl group" as used herein refers to a phenyl group substituted with at least one $C_1$-$C_{20}$ alkyl group. An example of the term "($C_1$ alkyl)phenyl group" is a toluyl group.

The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" respectively refer to heterocyclic groups having the same backbones as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, and a dibenzothiophene 5,5-dioxide group," in which, in each group, at least one carbon selected from ring-forming carbons is substituted with nitrogen.

At least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group may be:

deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group;

a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with at least one of deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, $-Ge(Q_{13})(Q_{14})(Q_{15})$, $- B(Q_{16})(Q_{17})$, $-P(=O)(Q_{18})(Q_{19})$, $-P(Q_{18})(Q_{19})$, or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each unsubstituted or substituted with at least one of deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-Ge(Q_{23})(Q_{24})(Q_{25})$, $-B(Q_{26})(Q_{27})$, $-P(=O)(Q_{28})(Q_{29})$, $-P(Q_{28})(Q_{29})$, or a combination thereof;

$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, $-P(=O)(Q_{38})(Q_{39})$, or $-P(Q_{38})(Q_{39})$; or a combination thereof.

$Q_1$ to $Q_9$, $Q_{11}$ to $Q_{19}$, $Q_{21}$ to $Q_{29}$, and $Q_{31}$ to $Q_{39}$ as used herein may each independently be: hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each unsubstituted or substituted with at least one of deuterium, a $C_1$-$C_{60}$ alkyl group, a $C_6$-$C_{60}$ aryl group, or a combination thereof.

For example, $Q_1$ to $Q_9$, $Q_{11}$ to $Q_{19}$, $Q_{21}$ to $Q_{29}$, and $Q_{31}$ to $Q_{39}$ as used herein may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, or $-CD_2CDH_2$; or

an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, a $C_1$-$C_{10}$ alkyl group, a phenyl group, or a combination thereof.

Examples

Evaluation Example 1 (Evaluation of melting point and/or fusion temperature)

The melting point and/or fusion temperature of each of Pre-mixed composition A1, Pre-mixed composition A2, Ir-1, and Pt-1 were evaluated, and the results thereof are summarized in Table 1. Pre-mixed composition A1 is a composition prepared by physically mixing Ir-1 and Pt-1 at a weight ratio of 1:1, and pre-mixed composition A2 is a composition prepared by solidifying Ir-1 and Pt-1 after sublimation and purification at a weight ratio of 1:1. The melting point was measured using a DSC evaluation device of TA Instruments Inc., and the fusion temperature was measured using a melting point measuring device of BUCHI Inc.

Table 1

| | Pre-mixed composition A1 | Pre-mixed composition A2 | Ir-1 | Pt-1 |
|---|---|---|---|---|
| Melting point (°C) | 305 | N.D. (amorphous) | 388 | 326 |
| Fusion temperature (°C) | 302 | 247 (the temperature at which the volume changed after heating was measured) | 387 | 325 |

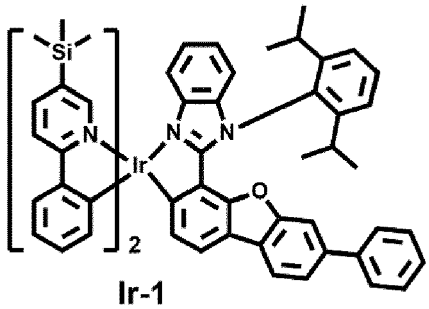

Ir-1

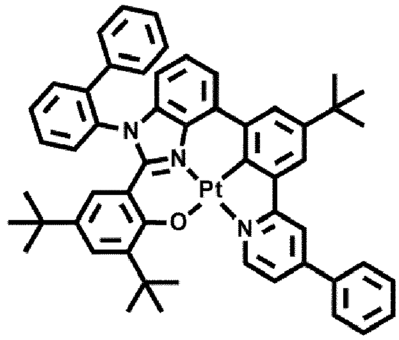

Pt-1

Referring to Table 1, it was confirmed that the melting point of Pre-mixed composition A1 and the fusion temperature of Pre-mixed composition A2 were lower than the melting points of Ir-1 and Pt-1, respectively.

Evaluation Example 2 (Evaluation of heat resistance)

The purity of each of Pre-mixed composition A1, Ir-1, and Pt-1 was evaluated using high performance liquid chromatography (HPLC), and the results thereof are summarized in Table 2.

Next, each of Pre-mixed composition A1, Ir-1, and Pt-1 was heated for 300 hours in a chamber maintained at a vacuum degree of 1.2 $\times$ $10^{-2}$ torr and an internal temperature of 310°C, and then collected and subjected again to purity evaluation using the HPLC. The results thereof are summarized in Table 2.

Table 2

| | | Purity before heating (%) | Purity after heating (%) |
|---|---|---|---|
| Pt-1 | | 99.75 | 99.65 |
| Ir-1 | | 99.17 | 99.16 |
| Pre-mixed composition A1 | Pt-1 | 55 | 5.09 |
| | Ir-1 | 45 | 67 |

Referring to Table 2, it was confirmed that Pt-1 and Ir-1, which have melting points higher than 310°C, showed little change in purity before and after heating, and thus were substantially free from thermal denaturation due to heating at 310°C for 300 hours.

However, pre-mixed composition A1, which has a melting point lower than 310°C, showed a significant change in purity before and after heating, and thus, it was confirmed that a significant amount of Pt-1 and/or Ir-1 included in pre-mixed composition A1 was decomposed due to thermal denaturation due to heating at 310°C for 300 hours.

Manufacture of OLED 1

As an anode, an ITO-patterned glass substrate was cut to a size of 50 millimeters (mm) x 50 mm x 0.5 mm, sonicated with isopropyl alcohol and pure water, each for 5 minutes, and then cleaned by exposure to ultraviolet rays and ozone for 30 minutes. The resultant glass substrate was loaded onto a vacuum deposition apparatus.

HT3 and F6-TCNNQ were vacuum-co-deposited on the anode at a weight ratio of 98:2 to form a hole injection layer having a thickness of 100 Å, and HT3 was vacuum-deposited on the hole injection layer to form a hole transport layer having a thickness of 1,350 Å. H-H1 was vacuum-deposited on the hole transport layer to form an electron blocking layer having a thickness of 300 Å.

Next, a host and a dopant were co-deposited at a weight ratio of 88:12 on the electron blocking layer to form an emission layer having a thickness of 400 Å. As the host, H-H1 and H-H2 were used at a weight ratio of 5:5, and as the dopant, Pt-1 and Ir-1 were used at a weight ratio of 1:1.

The emission layer was formed by performing the reciprocating process of the deposition source moving unit 350 described with reference to FIGS. 2A to 2G two consecutive times by using the first deposition source 300 as described herein. Here, as Pt-1 and Ir-1, Pt-1 and Ir-1 collected after the heat resistance evaluation of Evaluation Example 2 were used, wherein Pt-1 and Ir-1 were not mixed with each other in the first deposition source 300, and a vapor-state

composition formed by mixing vapor-state Pt-1 and vapor-state Ir-1 released from the first deposition source 300 was deposited together with a vapor-state host.

Then, ET3 and ET-D1 were co-deposited at a volume ratio of 50:50 on the emission layer to form an electron transport layer having a thickness of 350 Å, ET-D1 was vacuum-deposited on the electron transport layer to form an electron injection layer having a thickness of 10 Å, and Al was vacuum-deposited on the electron injection layer to form a cathode having a thickness of 1,000 Å, thereby completing the manufacture of a light-emitting device.

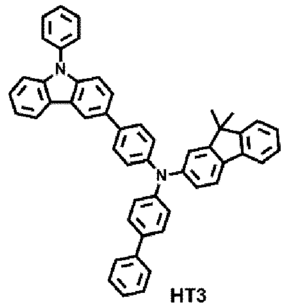
HT3

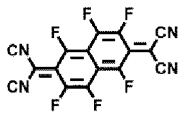
F6-TCNNQ

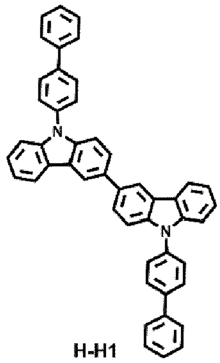
H-H1

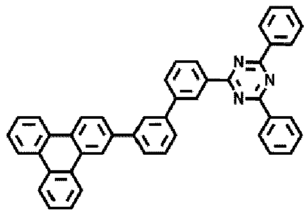
H-H2

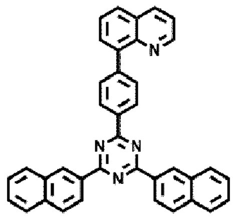
ET3

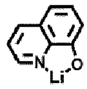
ET-D1

Manufacture of OLED A

OLED A was manufactured in a similar manner as used to manufacture OLED 1, except that, in forming an emission layer, Pre-mixed composition A1 collected after the heat resistance evaluation of Evaluation Example 2 was used instead of Pt-1 and Ir-1 collected after the heat resistance evaluation of Evaluation Example 2.

Manufacture of OLED B

OLED B was manufactured in a similar manner as used to manufacture OLED 1, except that, in forming an emission layer, the deposition source B1 loaded with Pt-1 and the deposition source B2 loaded with Ir-1 were each used instead of the first deposition source 300 in which Pt-1 and Ir-1 are not mixed with each other.

Evaluation Example 3: Evaluation of device characteristics

The driving voltage (Volts, V), the external quantum luminescence efficiency (EQE, %), and the lifespan ($T_{97}$, %) of each of OLED 1, OLED A, and OLED B were evaluated, and the results thereof are shown in Table 3. As evaluation devices, a currentvoltmeter (Keithley 2400) and a luminance meter (Minolta Cs-1000A) were used, and the lifespan ($T_{97}$) (at 16,000 candela per square meter, or nits) was evaluated as the time taken for luminance to be reduced to 97% of the initial luminance of 100%.

Table 3

| | Dopant deposition source used in forming emission layer | Driving voltage (V) | External quantum Luminescence efficiency (%) | Lifespan ($T_{97}$) (at 16,000 cd/$m^2$) |
|---|---|---|---|---|
| OLED 1 | First deposition source 300 as described in FIG. 2A, including Pt-1 and Ir-1 not mixed with each other | 4.0 | 24.4 | 100% |

(continued)

| | Dopant deposition source used in forming emission layer | Driving voltage (V) | External quantum Luminescence efficiency (%) | Lifespan ($T_{97}$) (at 16,000 cd/$m^2$) |
|---|---|---|---|---|
| OLED A | Pre-mixed composition A1 collected after heat resistance evaluation of Evaluation Example 2 | 3.94 | 23.8 | 5% |
| OLED B | Deposition source B1 loaded with Pt-1 and Deposition source B2 loaded with Ir-1 | 4.1 | 23.0 | 50% |

Referring to Table 3, it was confirmed that OLED 1 had a driving voltage equal to or higher than those of OLED A and OLED B, and showed improved external quantum luminescence efficiency and lifetime characteristics compared to those of OLED A and OLED B. In detail, from the device data of OLED A, it is determined that when the heating conditions of 310°C for 300 hours are the desired deposition temperature and deposition time conditions, it is not suitable to use Pre-mixed composition A1 as a deposition object, and, in order to perform a deposition process without thermal denaturation of Pt-1 and Ir-1 while using Pre-mixed composition A1 as the deposition object, it is necessary to select a deposition temperature that is lower than the melting point of Pre-mixed composition A1.

In the mixed layer as described above, a first dopant and a second dopant are effectively doped at substantially the same time (e.g., at the same time) without thermal denaturation. Accordingly, a light-emitting device including the mixed layer may have excellent luminescence efficiency and/or a long lifespan. By using the light-emitting device, a high-quality electronic apparatus may be manufactured. In addition, the method of preparing a mixed layer as described above may provide excellent process stability and reduction of manufacturing costs. Accordingly, by using the method of preparing a mixed layer, high-quality light-emitting devices and electronic apparatuses may be economically manufactured in large quantities.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

**1.** A mixed layer, comprising:

a matrix material; and
a dopant composition,
wherein the dopant composition is doped in the matrix material,
wherein the dopant composition comprises a first dopant and a second dopant,
an amount by weight of the matrix material in the mixed layer is greater than an amount by weight of the dopant composition in the mixed layer,
the matrix material, the first dopant, and the second dopant are different from each other,
the matrix material does not comprise a transition metal,
the first dopant comprises a transition metal,
the mixed layer is a layer formed by deposition of the matrix material, the first dopant, and the second dopant,
the mixed layer has a concentration profile of the dopant composition with respect to a thickness of the mixed layer,
provided that $T_{m1} > T_p > T_{m1+2}$ is satisfied,
wherein,
$T_{m1}$ is a melting point of the first dopant,
$T_p$ is a deposition temperature used in forming the mixed layer, and
$T_{m1+2}$ is
a melting point of a pre-mixed composition of the first dopant and the second dopant, wherein the pre-mixed composition is crystalline; and
a fusion temperature of the pre-mixed composition of the first dopant and the second dopant, wherein the pre-mixed composition is amorphous,
wherein the pre-mixed composition comprises the first dopant and the second dopant, and is not doped in the matrix material.

**2.** The mixed layer of claim 1, wherein the matrix material comprises a holetransporting compound, an electron-transporting compound, a bipolar compound, or a combination thereof.

**3.** The mixed layer of claims 1 or 2, wherein the first dopant comprises iridium or platinum.

**4.** The mixed layer of any of claims 1-3, wherein the mixed layer is a layer formed by deposition of a vapor-state matrix material and a vapor-state dopant composition, and
the vapor-state dopant composition comprises a vapor-state first dopant and a vapor-state second dopant.

**5.** The mixed layer of any of claims 1-4, wherein the second dopant comprises a transition metal;

preferably wherein the second dopant comprises iridium or platinum;
preferably wherein $T_{m2} > T_p$ is satisfied,
$T_p$ is as described in claim 1, and
$T_{m2}$ is a melting point of the second dopant.

**6.** The mixed layer of any of claims 1-5, wherein the second dopant does not comprise a transition metal.

**7.** The mixed layer of any of claims 1-6, wherein the second dopant comprises a cyclic group including a boron atom and a nitrogen atom as ring forming atoms.

**8.** The mixed layer of any of claims 1-7, wherein the mixed layer is an emission layer, and

each of the first dopant and the second dopant is an emitter;
the first dopant is an emitter, and the second dopant is a sensitizer; or
the first dopant is a sensitizer, and the second dopant is an emitter.

**9.** The mixed layer of any of claims 1-8, wherein the mixed layer is an emission layer, and

each of the first dopant and the second dopant emits red light;
each of the first dopant and the second dopant emits green light; or
each of the first dopant and the second dopant emits blue light.

**10.** A method of preparing the mixed layer of any of claims 1-9, the method comprising:
preparing:

a substrate,
a first deposition source comprising the first dopant and the second dopant,
a second deposition source comprising the matrix material, and

a vapor-state dopant composition provision unit configured to provide a vapor-state dopant composition from the first deposition source, wherein the vapor-state dopant composition comprises a vapor-state first dopant and a vapor-state second dopant;

preparing a deposition source moving unit on which the first deposition source and the second deposition source are arranged with a distance therebetween such that a region wherein the vapor-state dopant composition is present overlaps a region wherein a vapor-state matrix material is present, the vapor-state matrix material being released from the second deposition source;
arranging the deposition source moving unit at a first end below a surface of the substrate such that the substrate faces the deposition source moving unit; and
depositing the matrix material, the first dopant, and the second dopant on the surface of the substrate by performing a one-way process of moving the deposition source moving unit in a direction away from the first end below the surface of the substrate toward a second end, or
performing, one or more times, a reciprocating process of moving the deposition source moving unit in a direction

away from the first end below the surface of the substrate and toward a second end, and then immediately moving the deposition source moving unit in a direction away from the second end and toward the first end, wherein the first deposition source comprises a first region and a second region, wherein the first region comprises the first dopant and does not comprise the second dopant, and wherein the second region comprises the second dopant and does not comprise the first dopant, wherein the first dopant and the second dopant in the first deposition source are not mixed with each other.

**11.** The method of claim 10, wherein the first deposition source further comprises a separation unit configured to separate the first region and the second region; and/or
wherein the vapor-state dopant composition provision unit comprises:
a first unit configured to form the vapor-state dopant composition, and a second unit configured to discharge the vapor-state dopant composition from the first unit.

**12.** The method of claims 10 or 11, wherein a deposition temperature of the depositing is less than a melting point of the first dopant, and

when a pre-mixed composition of the first dopant and the second dopant is crystalline, the deposition temperature of the depositing is greater than a melting point of the pre-mixed composition, and
when the pre-mixed composition of the first dopant and the second dopant is amorphous, the deposition temperature of the depositing is greater than a fusion temperature of the pre-mixed composition.

**13.** A light-emitting device, comprising:

a first electrode;
a second electrode facing the first electrode; and
an interlayer arranged between the first electrode and the second electrode,
wherein the interlayer comprises the mixed layer of any of claims 1-9;
preferably wherein the mixed layer is an emission layer.

**14.** The light-emitting device of claim 13, wherein the interlayer comprises:

m light-emitting units that comprise at least one emission layer; and
m-1 charge generation layers arranged between two neighboring light-emitting units of the m light-emitting units, wherein m is an integer of 2 or greater, and
at least one light-emitting unit of the m light-emitting units comprises the mixed layer of any of claims 1-9;
preferably wherein the at least one light-emitting unit of the m light-emitting units emits green light, and
at least one light-emitting unit of the remaining light-emitting units emits blue light.

**15.** An electronic apparatus, comprising the light-emitting device of claims 13 or 14.

FIG. 1

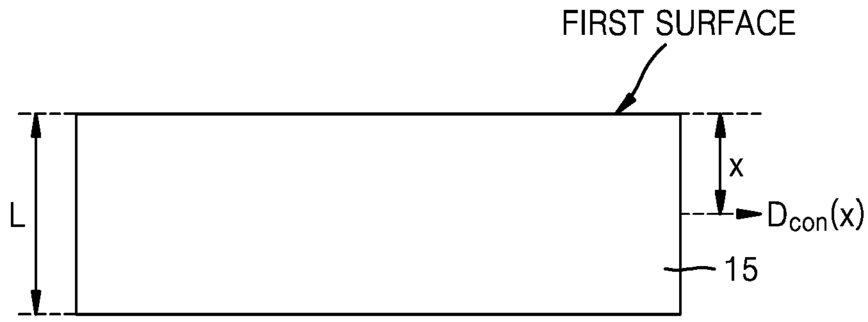
FIRST SURFACE
L
x
$D_{con}(x)$
15

FIG. 2A

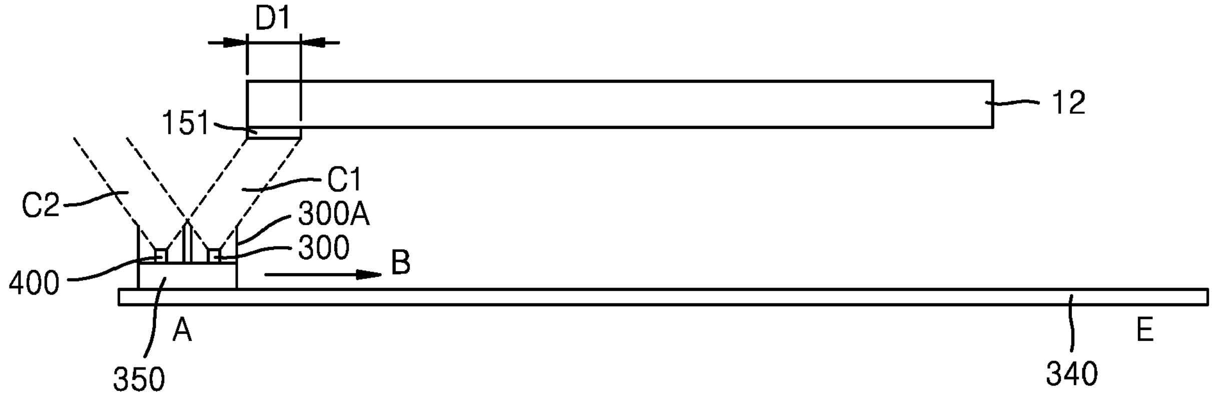
D1
151
12
C1
C2
300A
300
B
400
A
E
350
340

FIG. 2B

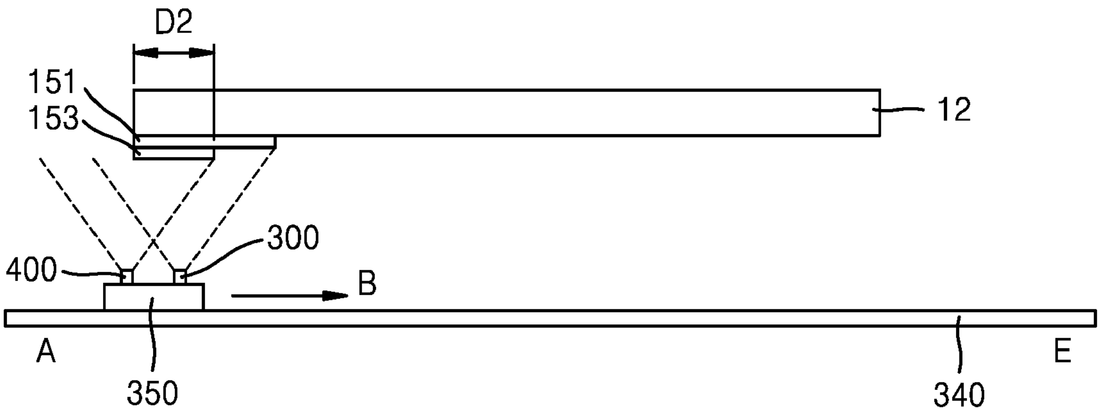
D2
151
153
12
300
400
B
A
350
340
E

FIG. 2C

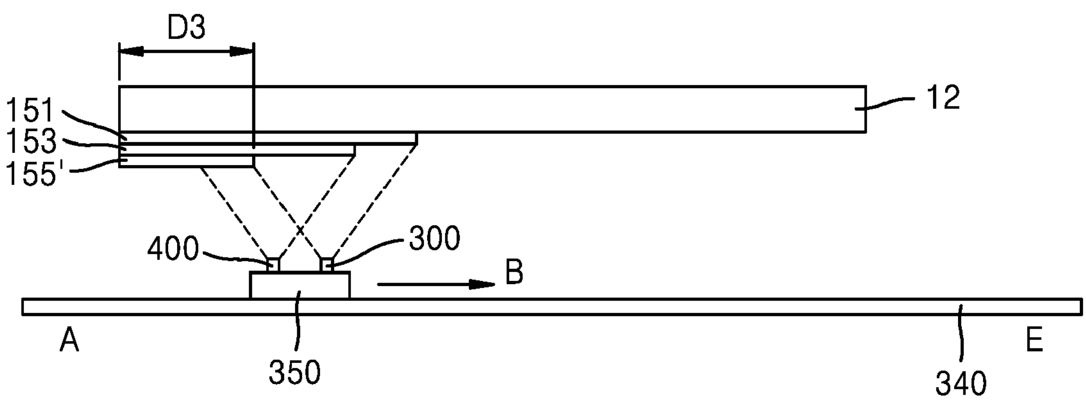
D3
151
153
155'
12
400
300
B
A
350
340
E

FIG. 2D

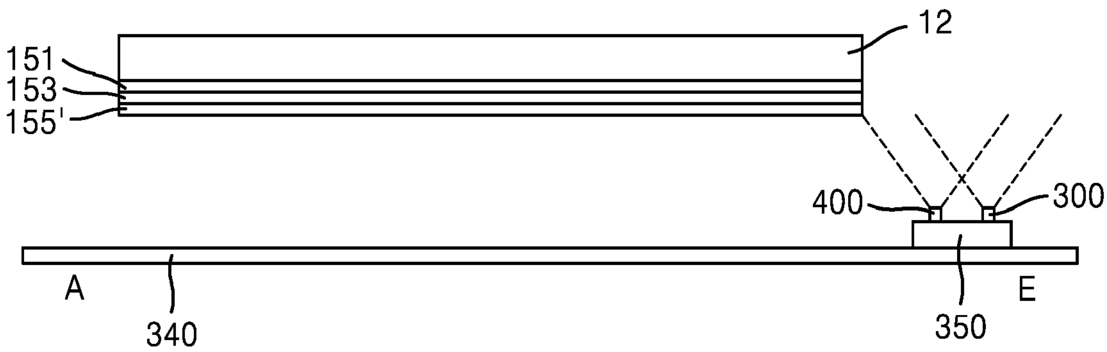
12
151
153
155'
400
300
A
340
350
E

FIG. 2E

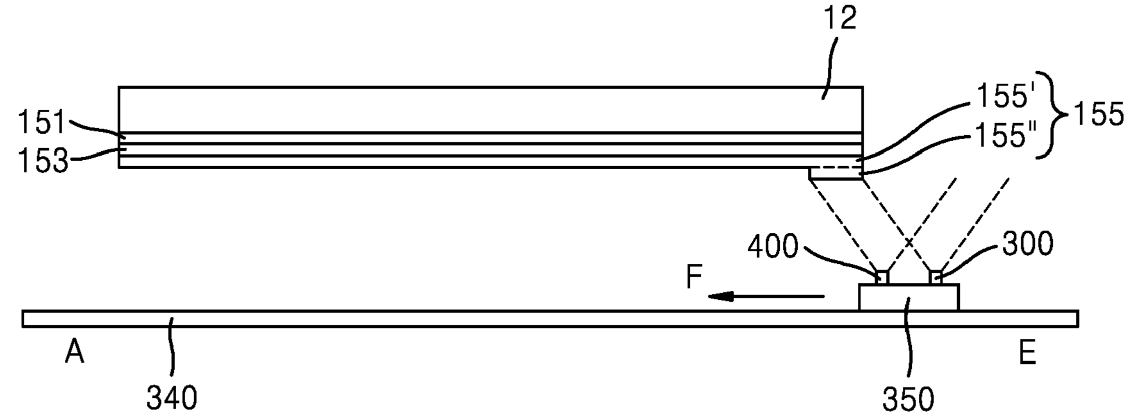
12
155'
155
155"
151
153
400
300
F
A
340
350
E

# FIG. 2F

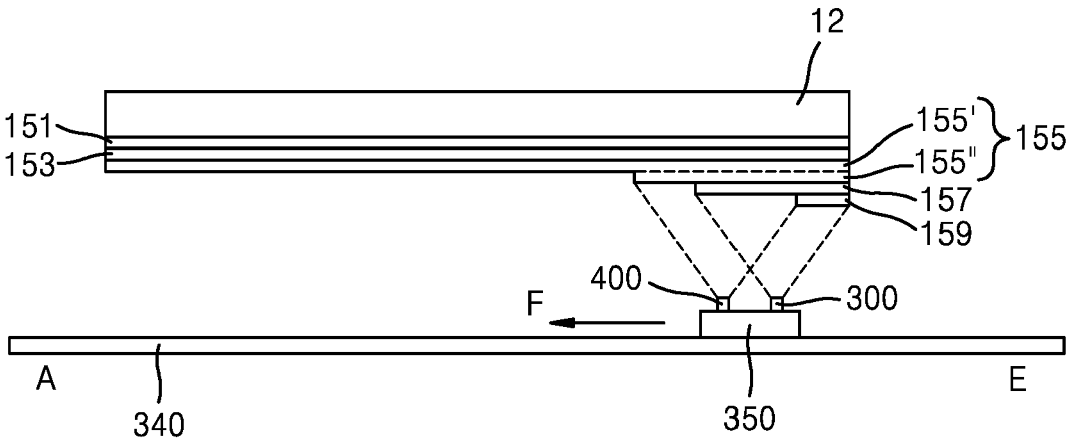
12
151
153
155'
155"
155
157
159
400
300
F
A
E
340
350

# FIG. 2G

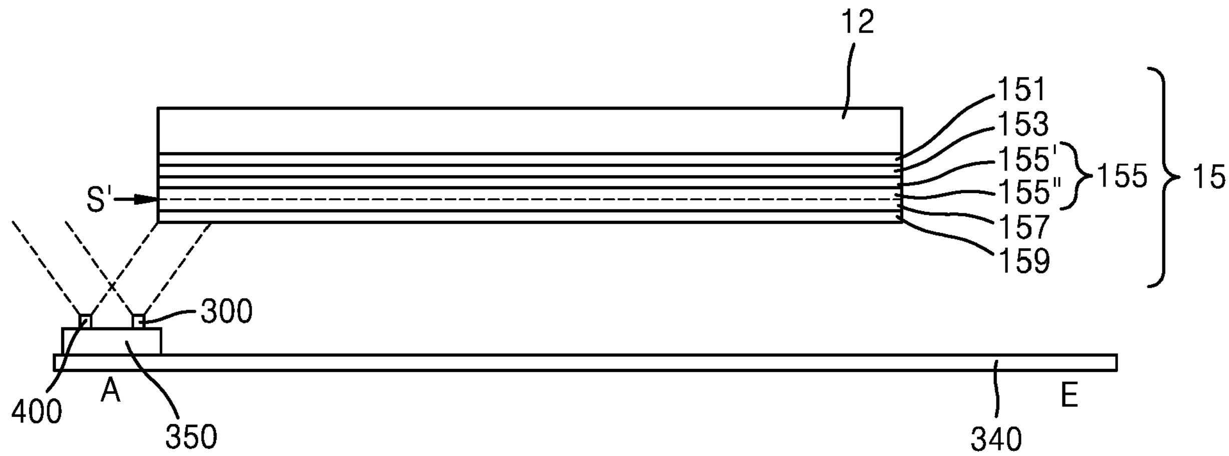
12
151
153
155'
155"
155
15
157
159
S'
300
400
A
350
E
340

FIG. 3

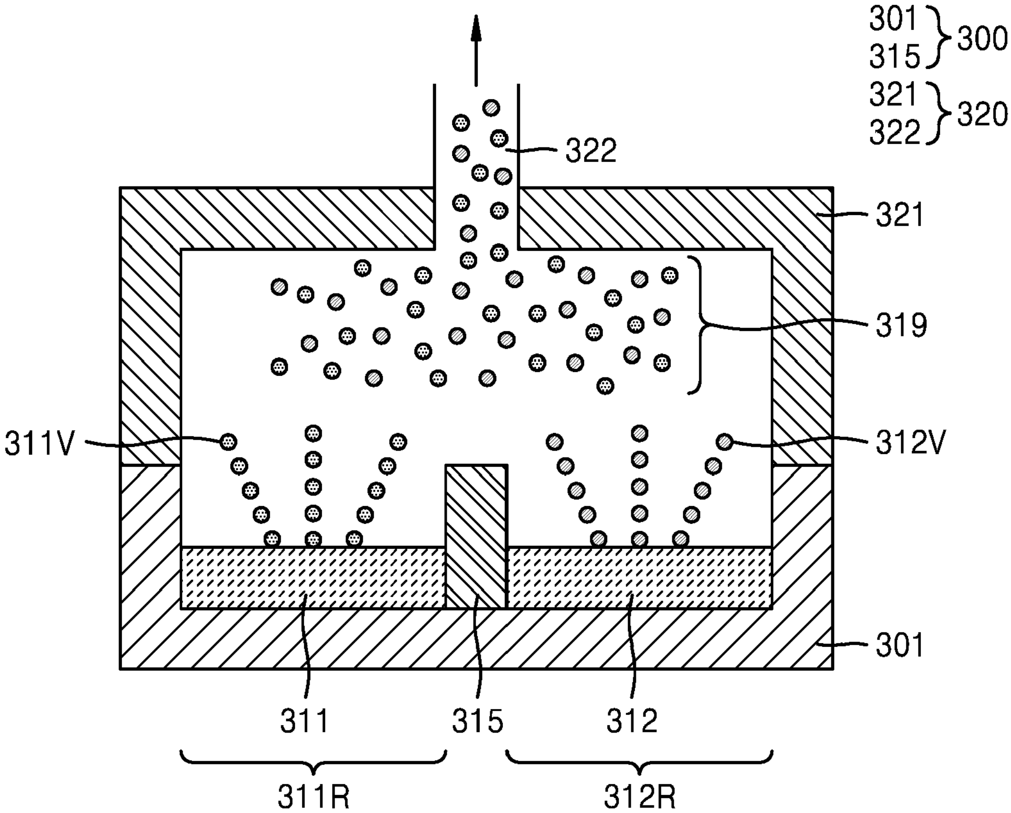

301
315
300
321
322
320
322
321
319
311V
312V
301
311
315
312
311R
312R

# FIG. 4

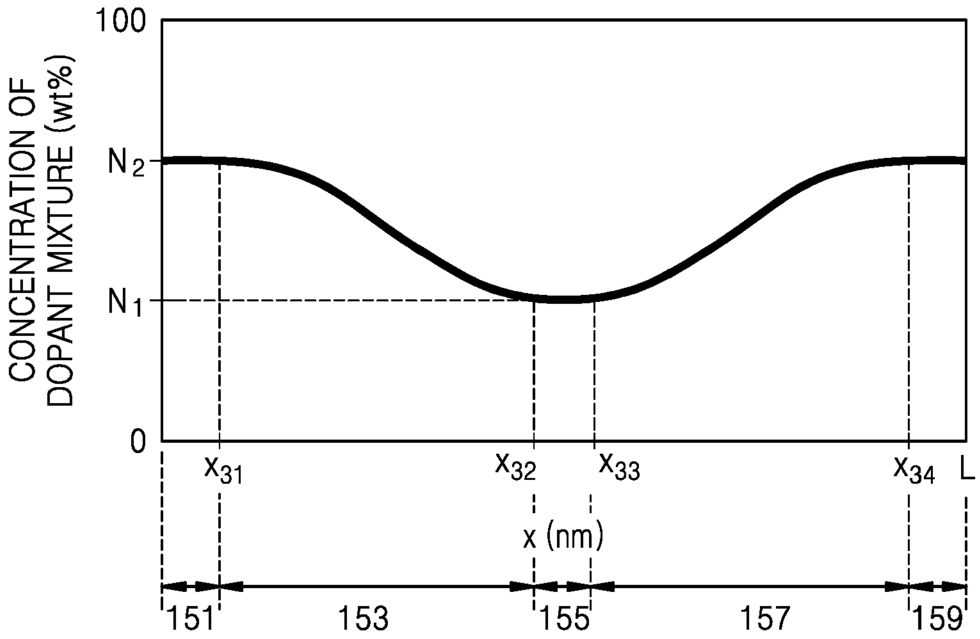

100
N2
N1
0
CONCENTRATION OF DOPANT MIXTURE (wt%)
x31
x32
x33
x34
L
x (nm)
151
153
155
157
159


# FIG. 5

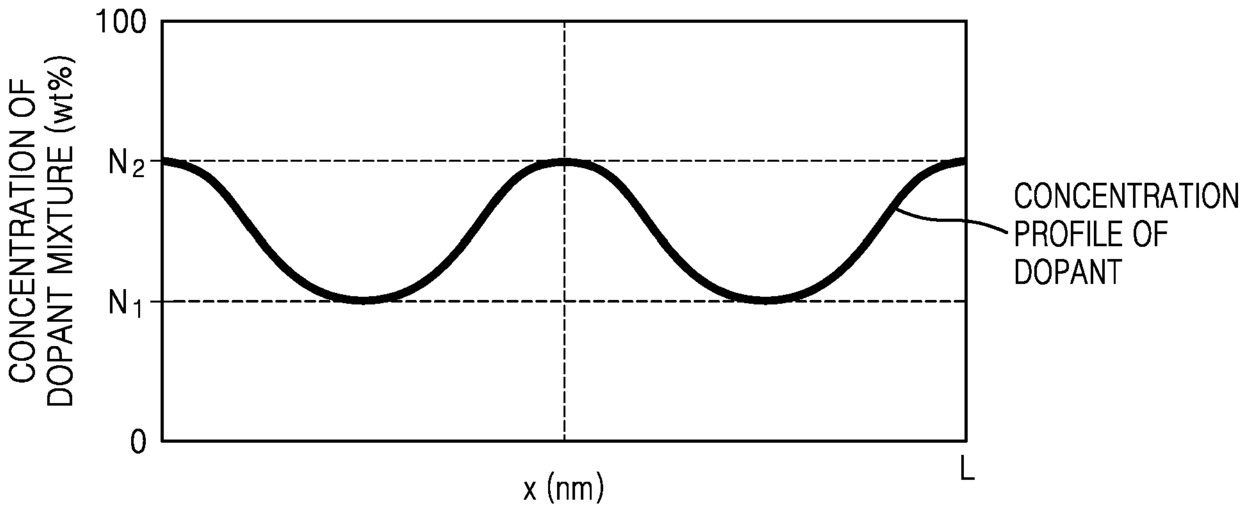

100
N2
N1
0
CONCENTRATION OF DOPANT MIXTURE (wt%)
CONCENTRATION PROFILE OF DOPANT
x (nm)
L

FIG. 6

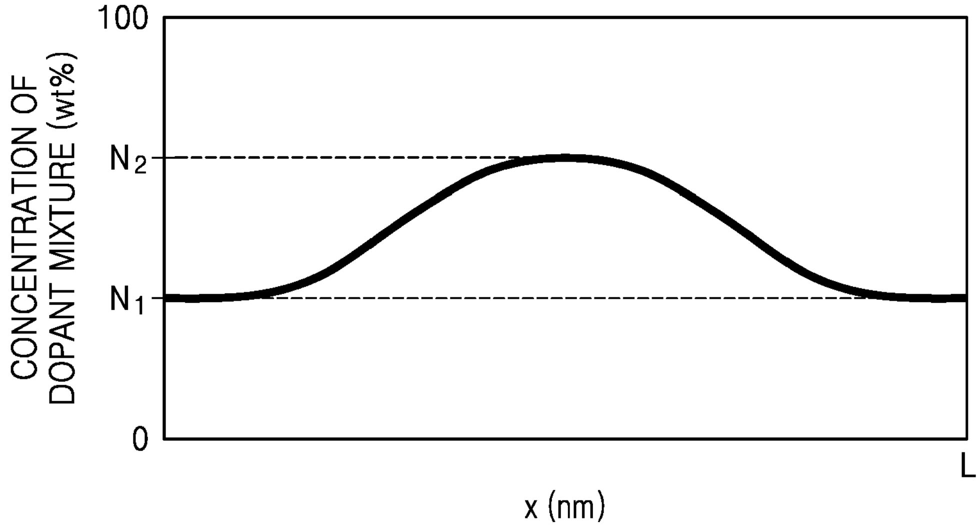
100
CONCENTRATION OF DOPANT MIXTURE (wt%)
N2
N1
0
L
x (nm)

FIG. 7

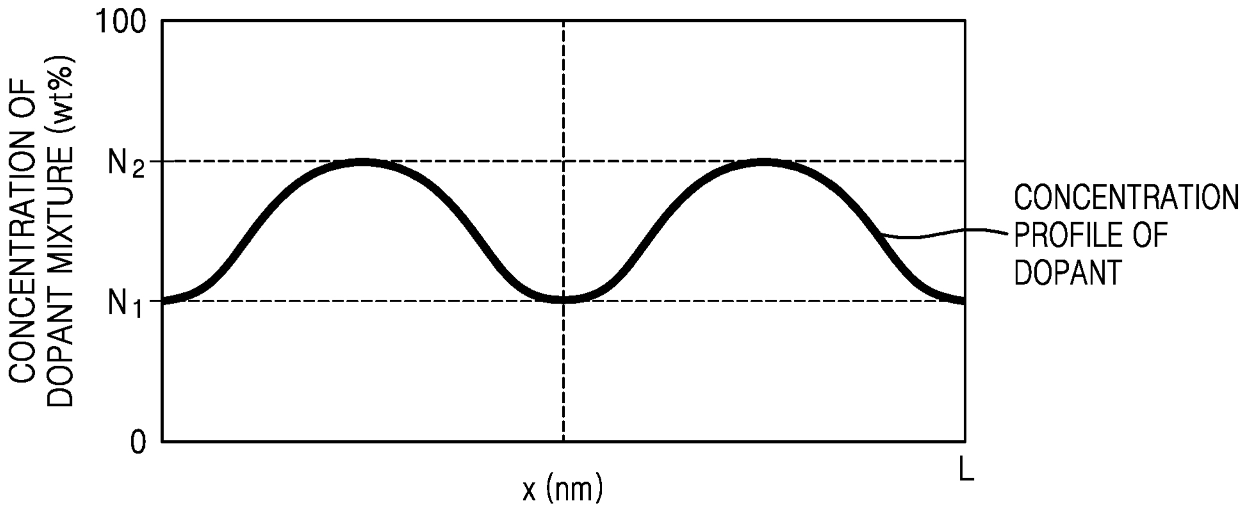
100
CONCENTRATION OF DOPANT MIXTURE (wt%)
N2
N1
0
L
x (nm)
CONCENTRATION PROFILE OF DOPANT

FIG. 8

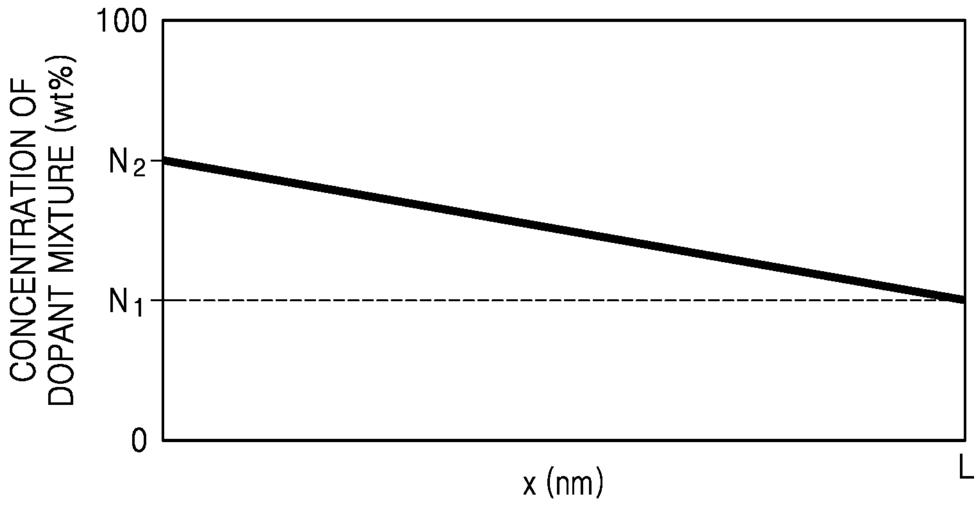
100
N2
N1
0
CONCENTRATION OF
DOPANT MIXTURE (wt%)
x (nm)
L

FIG. 9

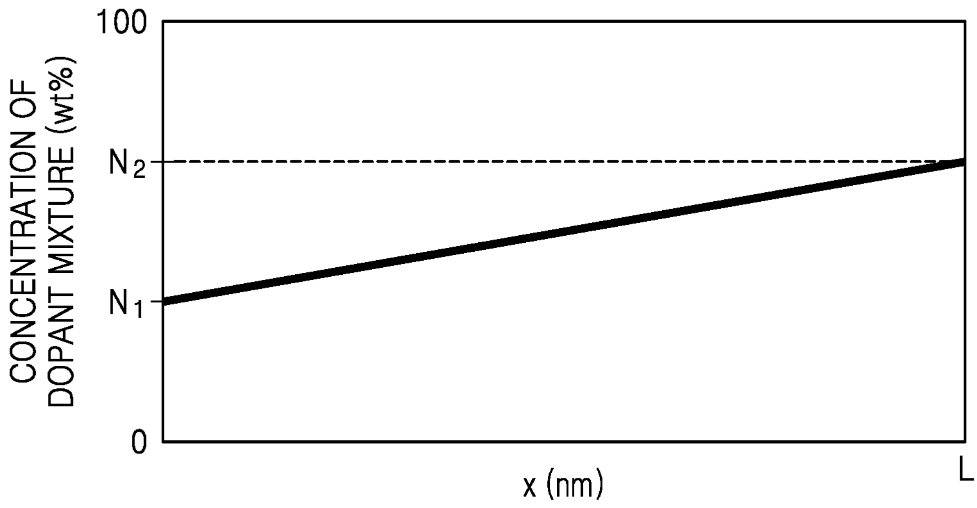
100
N2
N1
0
CONCENTRATION OF
DOPANT MIXTURE (wt%)
x (nm)
L

FIG. 10

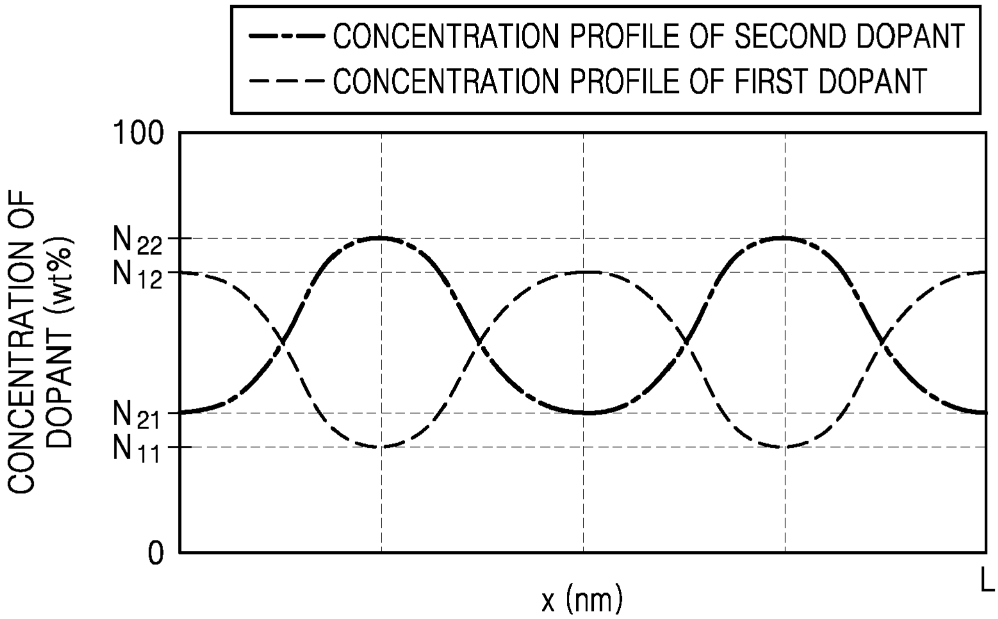
CONCENTRATION PROFILE OF SECOND DOPANT
CONCENTRATION PROFILE OF FIRST DOPANT
100
N22
N12
N21
N11
0
CONCENTRATION OF DOPANT (wt%)
x (nm)
L

FIG. 11

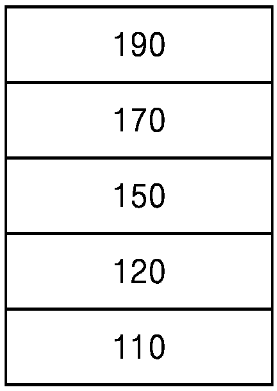
190
170
150
120
110

FIG. 12

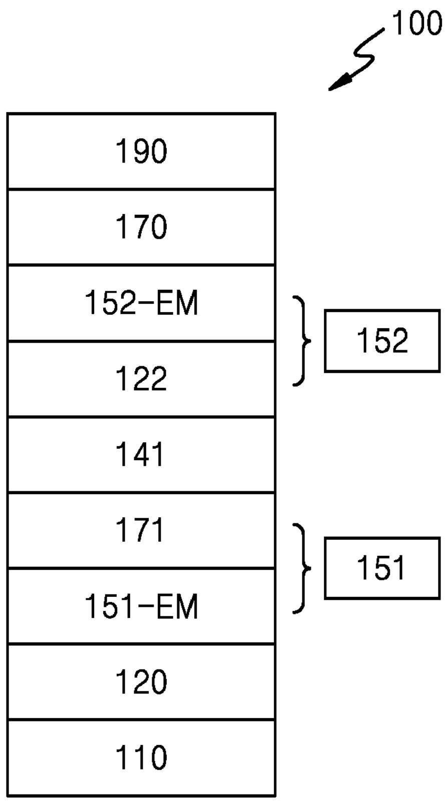

Europäisches Patentamt
European Patent Office
Office européen des brevets

# EUROPEAN SEARCH REPORT

Application Number
EP 22 21 3777

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2019/202851 A1 (STOESSEL PHILIPP [DE] ET AL) 4 July 2019 (2019-07-04)<br>* paragraph [0407]; figures 6A-6G *<br>----- | 10-12 | INV.<br>C23C14/24<br>C23C14/12<br>H10K71/16<br>H10K85/30<br>H10K50/12 |
| X<br><br>Y | US 2019/165292 A1 (HONG SEOKHWAN [KR] ET AL) 30 May 2019 (2019-05-30)<br>* paragraphs [0001], [0002], [0184], [0187], [0195], [0334], [0337]; tables 2, 4 *<br>----- | 1-9, 13-15<br>10-12 | |
| X | US 2017/218500 A1 (OCHI TAKASHI [JP] ET AL) 3 August 2017 (2017-08-03)<br>* paragraphs [0279], [0281]; figure 6 *<br>----- | 1,3,15 | |

| TECHNICAL FIELDS SEARCHED (IPC) |
|---|
| C23C<br>H10K |

The present search report has been drawn up for all claims

1

| Place of search | Date of completion of the search | Examiner |
|---|---|---|
| The Hague | 8 May 2023 | Schuhmacher, Jörg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

# ANNEX TO THE EUROPEAN SEARCH REPORT ON EUROPEAN PATENT APPLICATION NO. EP 22 21 3777

This annex lists the patent family members relating to the patent documents cited in the above-mentioned European search report. The members are as contained in the European Patent Office EDP file on
The European Patent Office is in no way liable for these particulars which are merely given for the purpose of information.

08-05-2023

| Patent document cited in search report | Publication date | Patent family member(s) | Publication date |
|---|---|---|---|
| US 2019202851 A1 | 04-07-2019 | CN 109641926 A | 16-04-2019 |
| | | EP 3507294 A1 | 10-07-2019 |
| | | JP 7039566 B2 | 22-03-2022 |
| | | JP 2019534244 A | 28-11-2019 |
| | | KR 101836041 B1 | 07-03-2018 |
| | | KR 20180025315 A | 08-03-2018 |
| | | TW 201815811 A | 01-05-2018 |
| | | US 2019202851 A1 | 04-07-2019 |
| US 2019165292 A1 | 30-05-2019 | KR 20190060408 A | 03-06-2019 |
| | | US 2019165292 A1 | 30-05-2019 |
| US 2017218500 A1 | 03-08-2017 | CN 106574358 A | 19-04-2017 |
| | | JP 6302786 B2 | 28-03-2018 |
| | | JP 2016035089 A | 17-03-2016 |
| | | US 2017218500 A1 | 03-08-2017 |
| | | WO 2016017538 A1 | 04-02-2016 |

EPO FORM P0459

For more details about this annex : see Official Journal of the European Patent Office, No. 12/82